# EUROPEAN PATENT SPECIFICATION

(11) **EP 4 276 924 B1**
(45) Date of publication and mention of the grant of the patent: **02.04.2025**
(21) Application number: 22760081.4
(22) Date of filing: 24.02.2022
(51) Int. Cl.: C09K 11/06, H10K 85/60, H10K 50/11, H10K 101/10, H10K 101/00

(54) **ORGANIC LIGHT EMITTING DEVICE**
ORGANISCHE LICHTEMITTIERENDE VORRICHTUNG
DISPOSITIF ÉLECTROLUMINESCENT ORGANIQUE

(30) Priority: 24.02.2021 KR 20210024903
(43) Date of publication of application: 15.11.2023
(73) Proprietor: LG Chem, Ltd., Seoul 07336 (KR)
(72) Inventor: KIM, Minjun, Daejeon 34122 (KR); LEE, Dong Hoon, Daejeon 34122 (KR); SUH, Sang Duk, Daejeon 34122 (KR); KIM, Young Seok, Daejeon 34122 (KR); KIM, Donghee, Daejeon 34122 (KR); OH, Joongsuk, Daejeon 34122 (KR); LEE, Da Jung, Daejeon 34122 (KR)
(74) Representative: Hoffmann Eitle
(86) International application number: PCT/KR2022/002714
(87) International publication number: WO 2022/182165

(56) References cited:
- WO-A1-2018/155942
- WO-A1-2020/027389
- WO-A1-2020/222569
- WO-A1-2021/029616
- CN-A- 110 734 431
- CN-A- 112 341 449
- KR-A- 20180 099 487
- KR-A- 20200 072 211
- KR-A- 20210 000 203
- KR-B1- 101 777 454

## Description

### [Technical Field]

### CROSS-REFERENCE TO RELATED APPLICATION(S)

This application claims the benefit of Korean Patent Application No. 10-2021-0024903 filed on February 24, 2021 with the Korean Intellectual Property Office.

The present disclosure relates to an organic light emitting device having improved driving voltage, efficiency and lifetime.

### [BACKGROUND ART]

In general, an organic light-emitting phenomenon refers to a phenomenon where electric energy is converted into light energy by using an organic material. The organic light emitting device using the organic light-emitting phenomenon has characteristics such as a wide viewing angle, an excellent contrast, a fast response time, an excellent luminance, driving voltage and response speed, and thus many studies have proceeded.

The organic light emitting device generally has a structure which comprises an anode, a cathode, and an organic material layer interposed between the anode and the cathode. The organic material layer frequently has a multilayered structure that comprises different materials in order to enhance efficiency and stability of the organic light emitting device, and for example, the organic material layer may be formed of a hole injection layer, a hole transport layer, a light emitting layer, an electron transport layer, an electron injection layer, and the like. In the structure of the organic light emitting device, if a voltage is applied between two electrodes, the holes are injected from an anode into the organic material layer and the electrons are injected from the cathode into the organic material layer, and when the injected holes and electrons meet each other, an exciton is formed, and light is emitted when the exciton falls to a ground state again.

In the organic light emitting devices as described above, there is a continuing need for the development of an organic light emitting device having improved driving voltage, efficiency and lifetime.

### [Prior Art Literature]

### [Patent Literature]

(Patent Literature 0001) Korean Unexamined Patent Publication No. 10-2000-0051826
(Patent Literature 0002) WO 2018/155942 A1
(Patent Literature 0003) WO 2021/029616 A1
(Patent Literature 0004) WO 2020/222569 A1
(Patent Literature 0005) KR 101 777 454 B1
(Patent Literature 0006) CN 110 734 431 A
(Patent Literature 0007) KR10-2020-0072211
(Patent Literature 0008) KR20200026079 A
(Patent Literature 0009) KR20180099487A

### [DETAILED DESCRIPTION OF THE INVENTION]

### [Technical Problem]

It is an object of the present disclosure to provide an organic light emitting device having improved driving voltage, efficiency and lifetime.

### [Technical Solution]

The present disclosure provides the following organic light emitting device:
An organic light emitting device comprising:
an anode;
a cathode; and
a light emitting layer interposed between the anode and the cathode,
wherein the light emitting layer comprises (i) a compound represented by the following Chemical Formula 1, and (ii) a compound represented by the following Chemical Formula 2 or the following Chemical Formula 3: 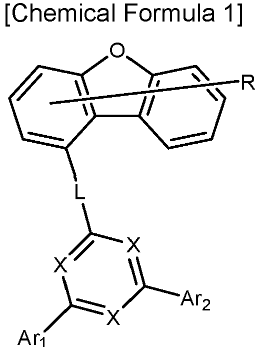
wherein in Chemical Formula 1,
L is a single bond; or a substituted or unsubstituted C₆₋₆₀ arylene,
X's are N; or CH, with the proviso that at least two or more of X are N,
R is hydrogen, deuterium, a substituted or unsubstituted C₆₋₆₀ aryl; or a substituted or unsubstituted C₂₋₆₀ heteroaryl containing any one or more selected from the group consisting of N, O and S,
Ar₁ and Ar₂ are each independently a substituted or unsubstituted C₆₋₆₀ aryl; or a substituted or unsubstituted C₂₋₆₀ heteroaryl containing any one or more selected from the group consisting of N, O and S, 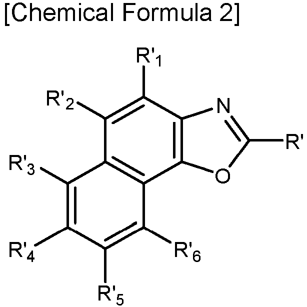 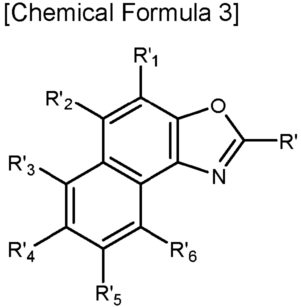
wherein in Chemical Formulas 2 and 3,
R' is a substituent represented by the following Chemical Formula 4, or a substituted or unsubstituted C₆₋₆₀ aryl,
when R' is a substituent represented by the following Chemical Formula 4, R'₁ to R'₆ are each independently hydrogen or deuterium,
when R' is not a substituent represented by the following Chemical Formula 4, any one of R'₁ to R'₆ is a substituent represented by the following Chemical Formula 4, and the rest are each independently hydrogen or deuterium; 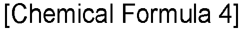 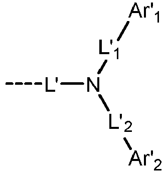
wherein in Chemical Formula 4,
L' is a single bond, a substituted or unsubstituted C₆₋₆₀ arylene, or a substituted or unsubstituted C₂₋₆₀ heteroarylene containing any one or more selected from the group consisting of N, O and S,
L'₁ and L'₂ are each independently a single bond, a substituted or unsubstituted C₆₋₆₀ arylene, or a substituted or unsubstituted C₂₋₆₀ heteroarylene containing any one or more selected from the group consisting of N, O and S, and
Ar'₁ and Ar'₂ are each independently a substituted or unsubstituted C₆₋₆₀ aryl, or a substituted or unsubstituted C₂₋₆₀ heteroaryl containing any one or more selected from the group consisting of N, O and S.

### [ADVANTAGEOUS EFFECTS]

The above-mentioned organic light emitting device is excellent in the driving voltage, efficiency and lifetime.

### [BRIEF DESCRIPTION OF THE DRAWINGS]

FIG. 1 shows an example of an organic light emitting device comprising a substrate 1, an anode 2, a light emitting layer 3 and a cathode 4.
FIG. 2 shows an example of an organic light emitting device comprising a substrate 1, an anode 2, a hole injection layer 5, a hole transport layer 6, a light emitting layer 7, an electron transport layer 8, and a cathode 4.

### [DETAILED DESCRIPTION OF THE EMBODIMENTS]

Hereinafter, embodiments of the present disclosure will be described in more detail to assist in the understanding of the invention.

As used herein, the notation 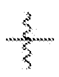 or 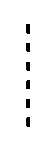 means a bond linked to another substituent group.

As used herein, the term "substituted or unsubstituted" means being unsubstituted or substituted with one or more substituents selected from the group consisting of deuterium; a halogen group; a nitrile group; a nitro group; a hydroxy group; a carbonyl group; an ester group; an imide group; an amino group; a phosphine oxide group; an alkoxy group; an aryloxy group; an alkylthioxy group; an arylthioxy group; an alkylsulfoxy group; an arylsulfoxy group; a silyl group; a boron group; an alkyl group; a cycloalkyl group; an alkenyl group; an aryl group; an aralkyl group; an aralkenyl group; an alkylaryl group; an alkylamine group; an aralkylamine group; a heteroarylamine group; an arylamine group; an arylphosphine group; and a heterocyclic group containing at least one of N, O and S atoms, or being unsubstituted or substituted with a substituent to which two or more substituents of the above-exemplified substituents are linked. For example, "a substituent in which two or more substituents are linked" may be a biphenyl group. Namely, a biphenyl group may be an aryl group, or it may also be interpreted as a substituent in which two phenyl groups are linked.

In the present disclosure, the carbon number of a carbonyl group is not particularly limited, but is preferably 1 to 40. Specifically, the carbonyl group may be a substituent group having the following structural formulas, but is not limited thereto.

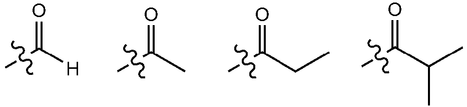

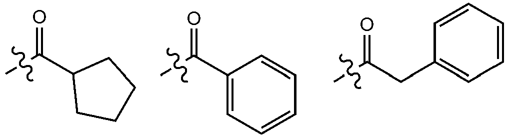

In the present disclosure, an ester group may have a structure in which oxygen of the ester group may be substituted by a straight-chain, branched-chain, or cyclic alkyl group having 1 to 25 carbon atoms, or an aryl group having 6 to 25 carbon atoms. Specifically, the ester group may be a substituent group having the following structural formulas, but is not limited thereto.

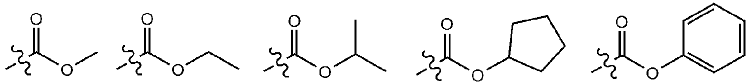

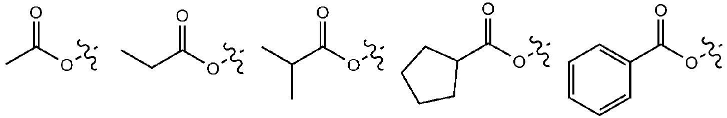

In the present disclosure, the carbon number of an imide group is not particularly limited, but is preferably 1 to 25. Specifically, the imide group may be a substituent group having the following structural formulas, but is not limited thereto.

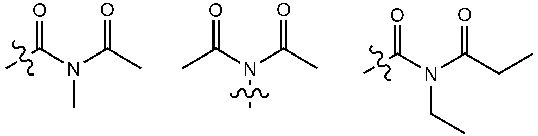

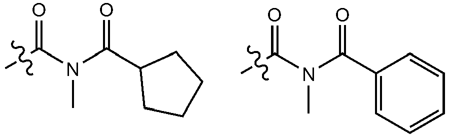

**In** the present disclosure, a silyl group specifically includes a trimethylsilyl group, a triethylsilyl group, a t-butyldimethylsilyl group, a vinyldimethylsilyl group, a propyldimethylsilyl group, a triphenylsilyl group, a diphenylsilyl group, a phenylsilyl group, and the like, but is not limited thereto.

**In** the present disclosure, a boron group specifically includes a trimethylboron group, a triethylboron group, a t-butyldimethylboron group, a triphenylboron group, and a phenylboron group, but is not limited thereto.

In the present disclosure, examples of a halogen group include fluorine, chlorine, bromine, or iodine.

In the present disclosure, the alkyl group may be straight-chain or branched-chain, and the carbon number thereof is not particularly limited, but is preferably 1 to 40. According to one embodiment, the carbon number of the alkyl group is 1 to 20. According to another embodiment, the carbon number of the alkyl group is 1 to 10. According to another embodiment, the carbon number of the alkyl group is 1 to 6. Specific examples of the alkyl group include methyl, ethyl, propyl, n-propyl, isopropyl, butyl, n-butyl, isobutyl, tert-butyl, sec-butyl, 1-methylbutyl, 1-ethyl-butyl, pentyl, n-pentyl, isopentyl, neopentyl, tert-pentyl, hexyl, n-hexyl, 1-methylpentyl, 2-methylpentyl, 4-methyl-2-pentyl, 3,3-dimethylbutyl, 2-ethylbutyl, heptyl, n-heptyl, 1-methylhexyl, cyclopentylmethyl, cyclohexylmethyl, octyl, n-octyl, tert-octyl, 1-methylheptyl, 2-ethylhexyl, 2-propylpentyl, n-nonyl, 2,2-dimethylheptyl, 1-ethyl-propyl, 1,1-dimethyl-propyl, isohexyl, 2-methylpentyl, 4-methylhexyl, 5-methylhexyl, and the like, but are not limited thereto.

In the present disclosure, the alkenyl group may be straight-chain or branched-chain, and the carbon number thereof is not particularly limited, but is preferably 2 to 40. According to one embodiment, the carbon number of the alkenyl group is 2 to 20. According to another embodiment, the carbon number of the alkenyl group is 2 to 10. According to still another embodiment, the carbon number of the alkenyl group is 2 to 6. Specific examples thereof include vinyl, 1-propenyl, isopropenyl, 1-butenyl, 2-butenyl, 3-butenyl, 1-pentenyl, 2-pentenyl, 3-pentenyl, 3-methyl-1-butenyl, 1,3-butadienyl, allyl, 1-phenylvinyl-1-yl, 2-phenylvinyl-1-yl, 2,2-diphenylvinyl-1-yl, 2-phenyl-2-(naphthyl-1-yl)vinyl-1-yl, 2,2-bis(diphenyl-1-yl)vinyl-1-yl, a stilbenyl group, a styrenyl group, and the like, but are not limited thereto.

In the present disclosure, a cycloalkyl group is not particularly limited, but the carbon number thereof is preferably 3 to 60. According to one embodiment, the carbon number of the cycloalkyl group is 3 to 30. According to another embodiment, the carbon number of the cycloalkyl group is 3 to 20. According to still another embodiment, the carbon number of the cycloalkyl group is 3 to 6. Specific examples thereof include cyclopropyl, cyclobutyl, cyclopentyl, 3-methylcyclopentyl, 2,3-dimethylcyclopentyl, cyclohexyl, 3-methylcyclohexyl, 4-methylcyclohexyl, 2,3-dimethylcyclohexyl, 3,4,5-trimethylcyclohexyl, 4-tert-butylcyclohexyl, cycloheptyl, cyclooctyl, and the like, but are not limited thereto.

In the present disclosure, an aryl group is not particularly limited, but the carbon number thereof is preferably 6 to 60, and it may be a monocyclic aryl group or a polycyclic aryl group. According to one embodiment, the carbon number of the aryl group is 6 to 30. According to one embodiment, the carbon number of the aryl group is 6 to 20. The aryl group may be a phenyl group, a biphenyl group, a terphenyl group or the like as the monocyclic aryl group, but is not limited thereto. The polycyclic aryl group includes a naphthyl group, an anthracenyl group, a phenanthryl group, a pyrenyl group, a perylenyl group, a chrysenyl group, a fluorenyl group, or the like, but is not limited thereto.

In the present disclosure, the fluorenyl group may be substituted, and two substituents may be connected to each other to form a spiro structure. **In** the case where the fluorenyl group is substituted, 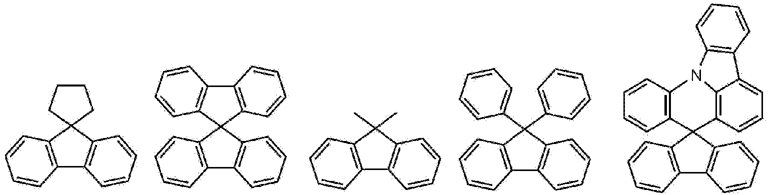 and the like can be formed. However, the structure is not limited thereto

In the present disclosure, a heterocyclic group is a heterocyclic group containing at least one of O, N, Si and S as a heteroatom, and the carbon number thereof is not particularly limited, but is preferably 2 to 60. Examples of the heterocyclic group include a thiophene group, a furan group, a pyrrole group, an imidazole group, a thiazole group, an oxazol group, an oxadiazol group, a triazol group, a pyridyl group, a bipyridyl group, a pyrimidyl group, a triazine group, an acridyl group, a pyridazine group, a pyrazinyl group, a quinolinyl group, a quinazoline group, a quinoxalinyl group, a phthalazinyl group, a pyridopyrimidinyl group, a pyridopyrazinyl group, a pyrazinopyrazinyl group, an isoquinoline group, an indole group, a carbazole group, a benzoxazole group, a benzoimidazole group, a benzothiazol group, a benzocarbazole group, a benzothiophene group, a dibenzothiophene group, a benzofuranyl group, a phenanthroline group, an isoxazolyl group, a thiadiazolyl group, a phenothiazinyl group, a dibenzofuranyl group, and the like, but are not limited thereto.

In the present disclosure, the aryl group in the aralkyl group, the aralkenyl group, the alkylaryl group and the arylamine group is the same as the above-mentioned examples of the aryl group. In the present disclosure, the alkyl group in the aralkyl group, the alkylaryl group and the alkylamine group is the same as the above-mentioned examples of the alkyl group. In the present disclosure, the heteroaryl in the heteroarylamine may be applied to the above-mentioned description of the heterocyclic group. In the present disclosure, the alkenyl group in the aralkenyl group is the same as the above-mentioned examples of the alkenyl group. In the present disclosure, the above-mentioned description of the aryl group may be applied except that the arylene is a divalent group. In the present disclosure, the above-mentioned description of the heterocyclic group may be applied except that the heteroarylene is a divalent group. In the present disclosure, the above-mentioned description of the aryl group or cycloalkyl group may be applied except that the hydrocarbon ring is not a monovalent group but formed by combining two substituent groups. In the present disclosure, the above-mentioned description of the heterocyclic group may be applied, except that the heterocycle is not a monovalent group but formed by combining two substituent groups.

Hereinafter, the present disclosure will be described in detail for each configuration.

### Anode and Cathode

The anode and cathode used herein mean electrodes used in an organic light emitting device.

As the anode material, generally, a material having a large work function is preferably used so that holes can be smoothly injected into the organic material layer. Specific examples of the anode material include metals such as vanadium, chrome, copper, zinc, and gold, or an alloy thereof; metal oxides such as zinc oxides, indium oxides, indium tin oxides (ITO), and indium zinc oxides (IZO); a combination of metals and oxides, such as ZnO:Al or SnO₂:Sb; conductive polymers such as poly(3-methylthiophene), poly[3,4-(ethylene-1,2-dioxy)thiophene](PEDOT), polypyrrole, and polyaniline, and the like, but are not limited thereto.

As the cathode material, generally, a material having a small work function is preferably used so that electrons can be easily injected into the organic material layer. Specific examples of the cathode material include metals such as magnesium, calcium, sodium, potassium, titanium, indium, yttrium, lithium, gadolinium, aluminum, silver, tin, and lead, or an alloy thereof; a multilayered structure material such as LiF/Al or LiO₂/Al, and the like, but are not limited thereto.

### Light Emitting Layer

The light emitting layer used in the present disclosure means a layer that can emit light in the visible light region by combining holes and electrons transported from the anode and the cathode. Generally, the light emitting layer includes a host material and a dopant material, and in the present disclosure, both (i) the compound represented by Chemical Formula 1, and (ii) the compound represented by Chemical Formula 2 or Chemical Formula 3 are included as a host.

In Chemical Formula 1, preferably, L is a single bond; phenylene; biphenyldiyl; or naphthylene. More preferably, L is a single bond; 1,4-phenylene; 1,3-phenylene; 1,2-phenylene; or 1,4-naphthylene.

Preferably, all of X are N.

Preferably, R is hydrogen, deuterium, phenyl, biphenylyl, terphenylyl, naphthyl, phenylnaphthyl, naphthylphenyl, phenanthrenyl, triphenylenyl, fluoranthenyl, dibenzofuranyl, benzonaphthofuranyl, dibenzothiophenyl, or benzonaphthothiophenyl.

Preferably, Ar₁ and Ar₂ are each independently phenyl, biphenylyl, terphenylyl, naphthyl, naphthylphenyl, phenylnaphthyl, phenanthrenyl, dibenzofuranyl, or dibenzothiophenyl,
Representative examples of the compound represented by Chemical Formula 1 are as follows:

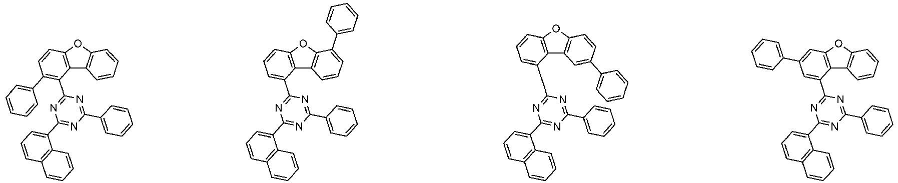

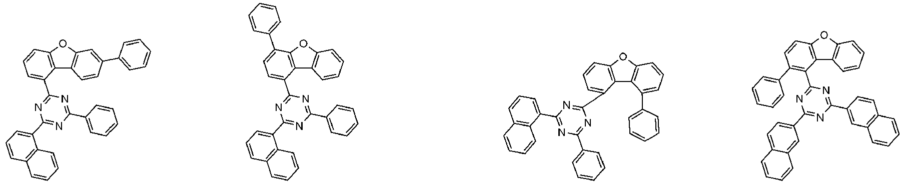

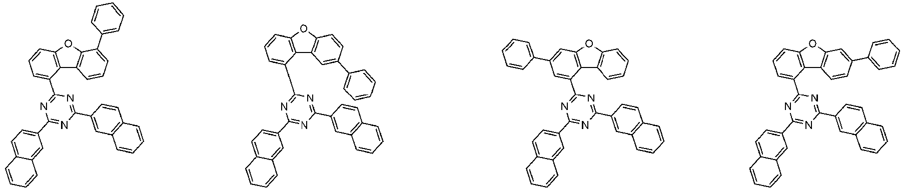

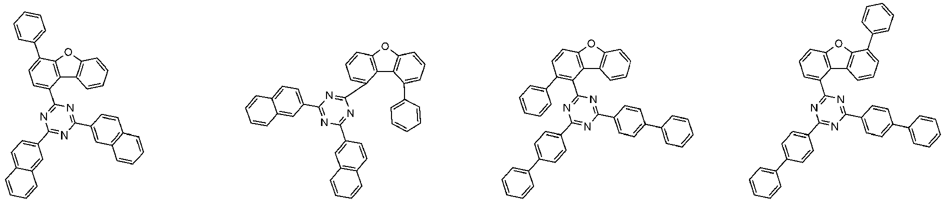

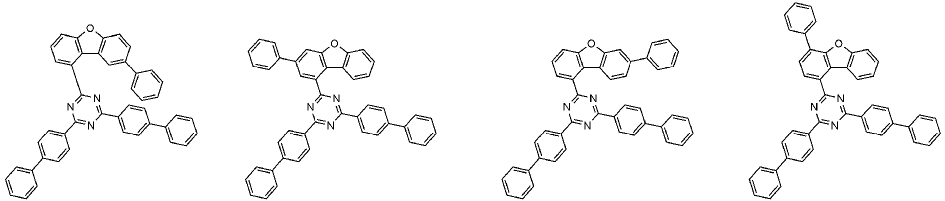

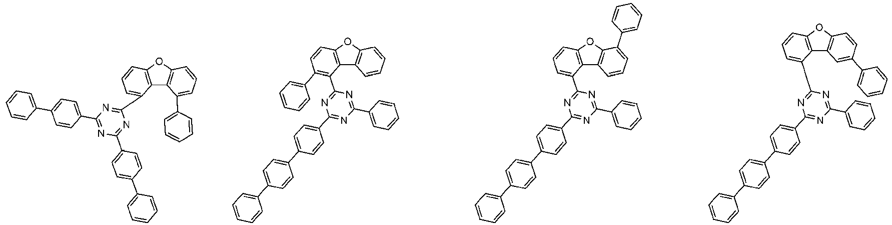

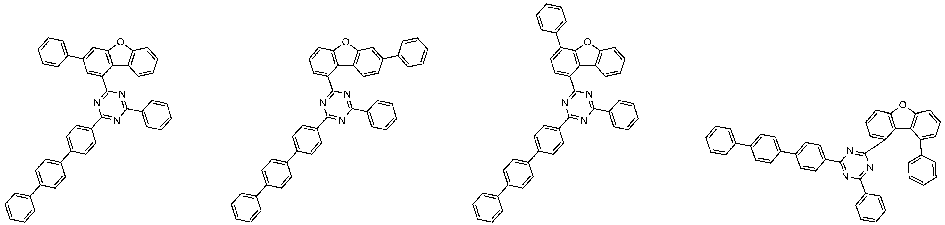

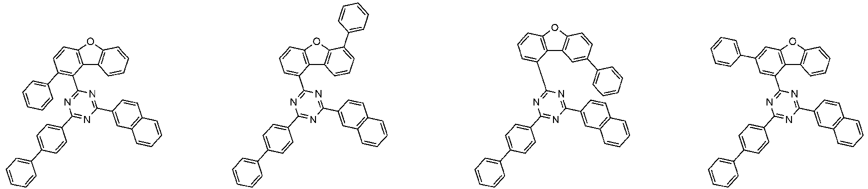

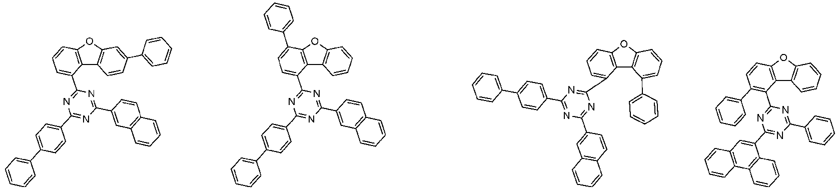

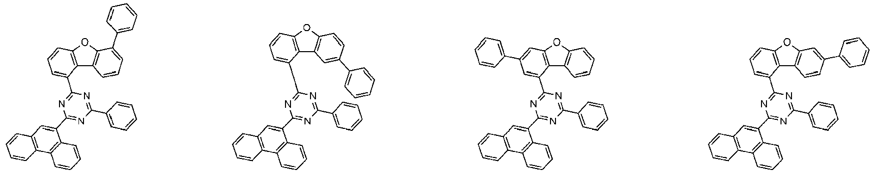

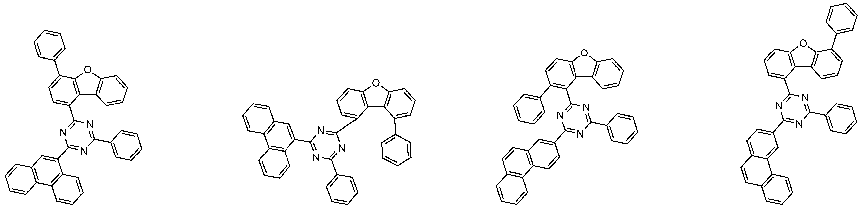

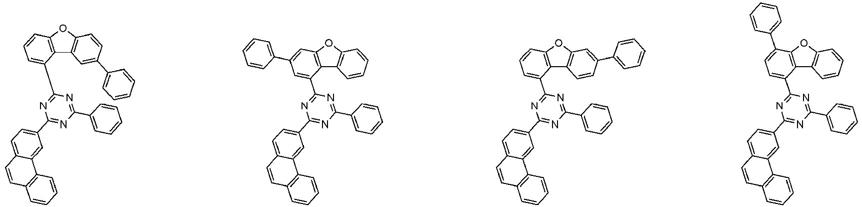

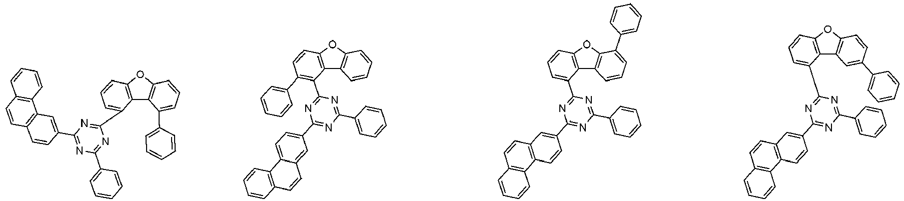

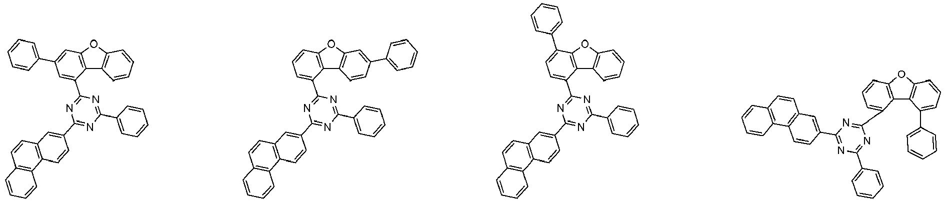

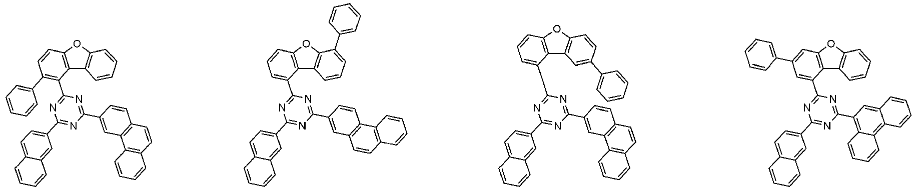

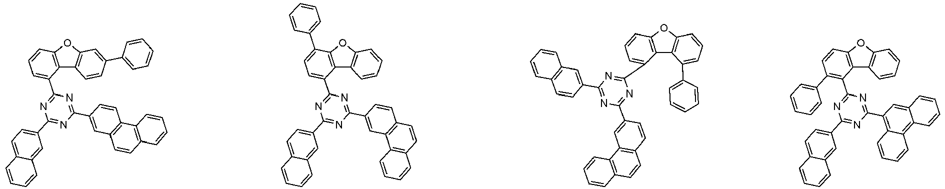

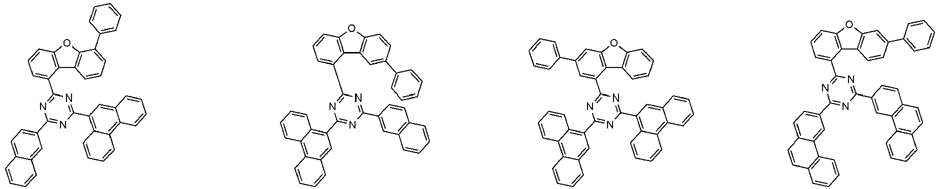

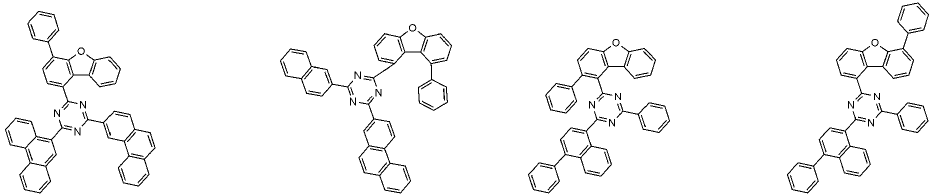

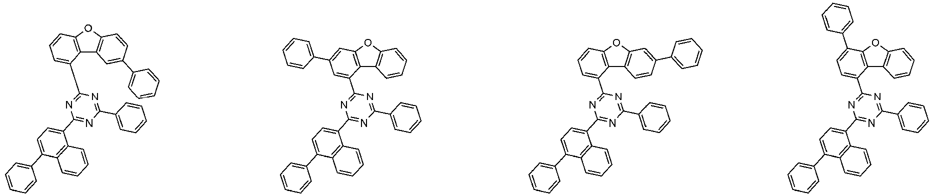

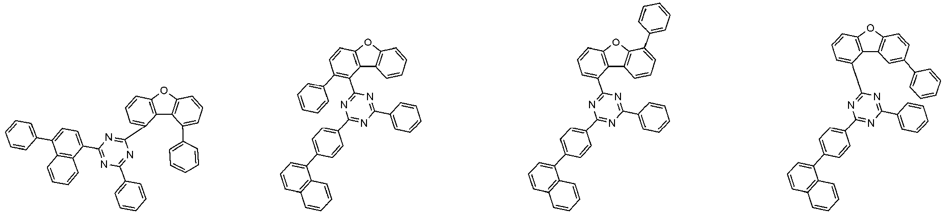

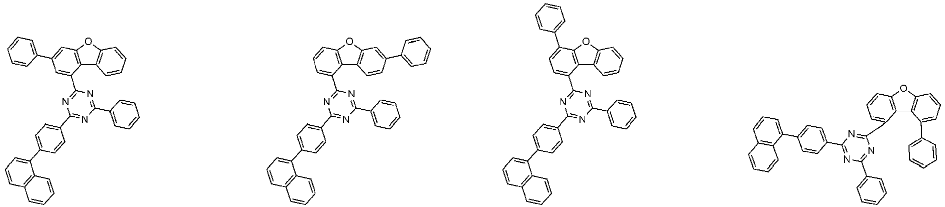

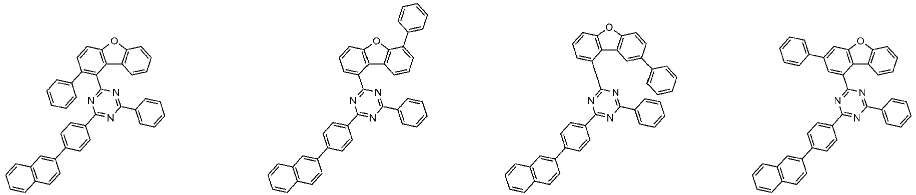

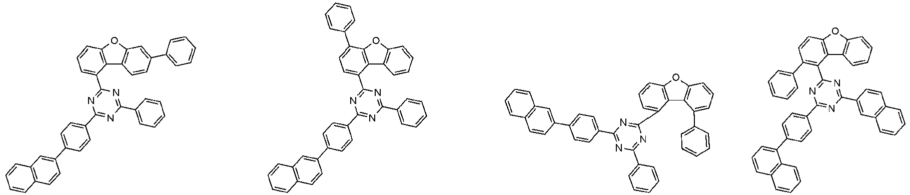

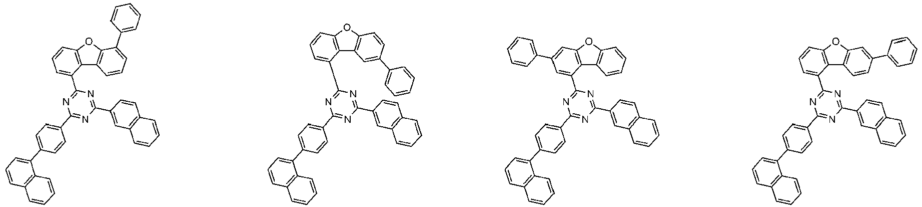

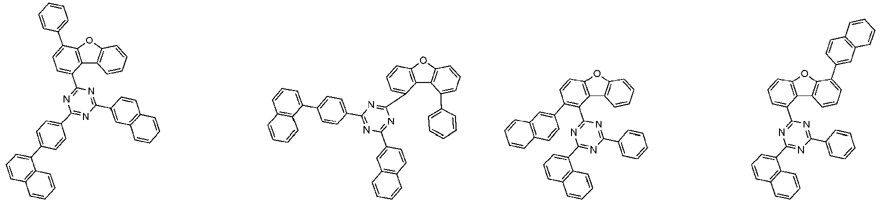

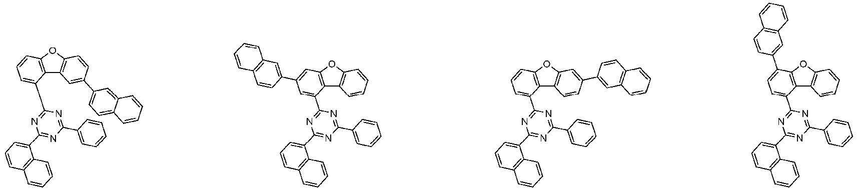

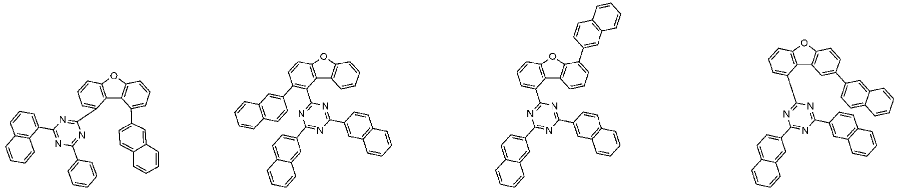

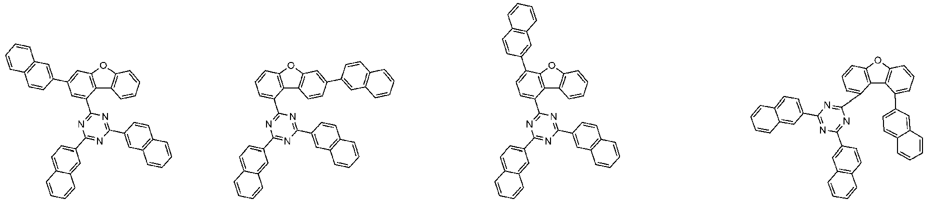

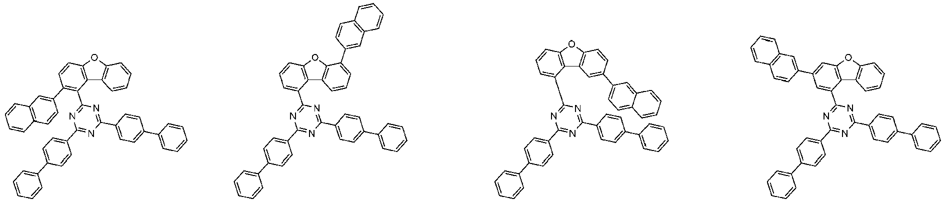

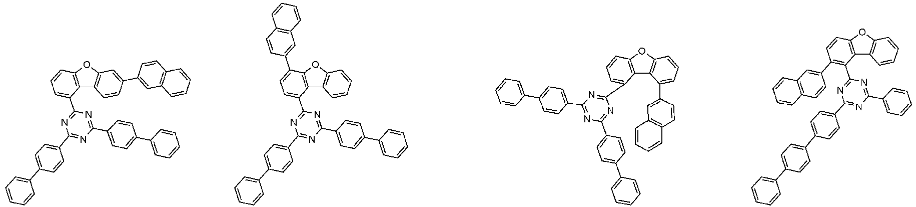

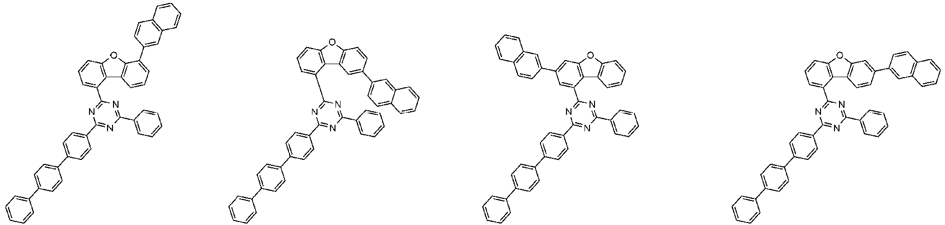

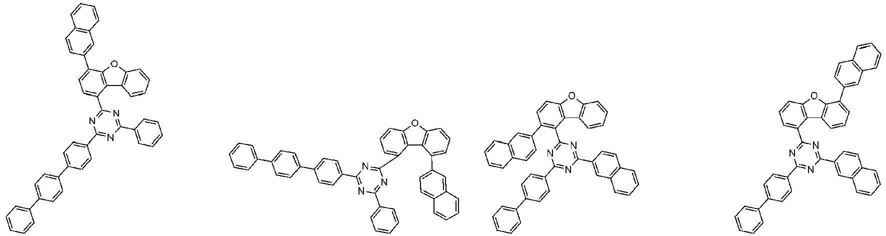

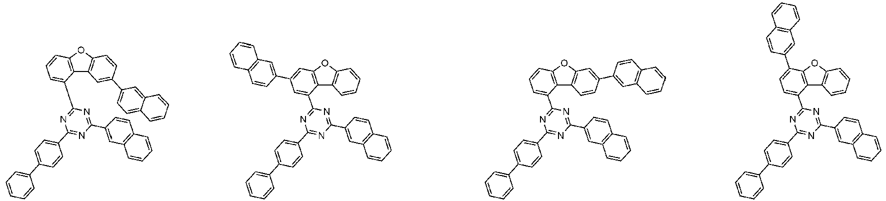

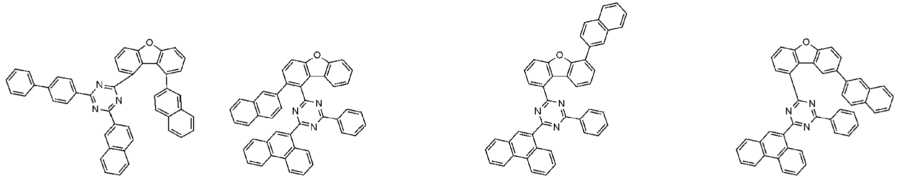

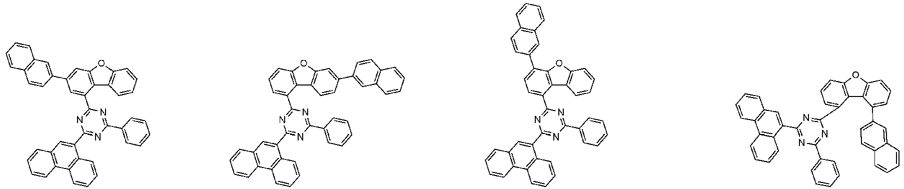

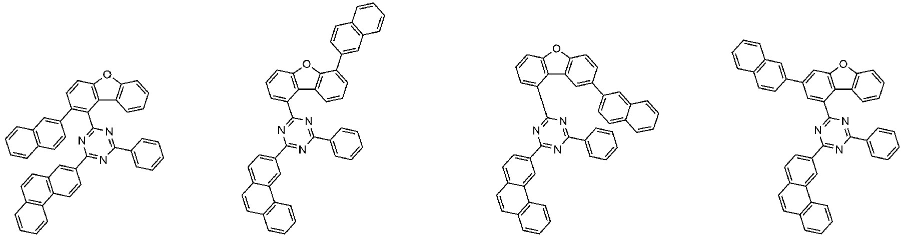

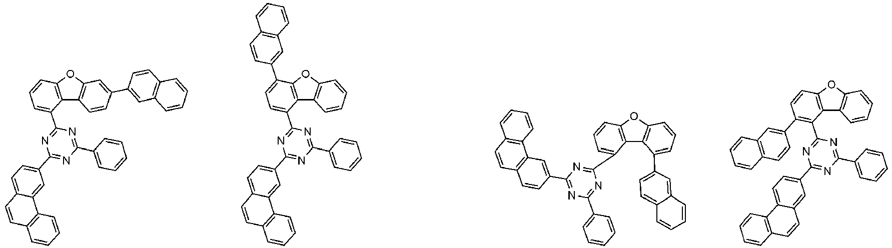

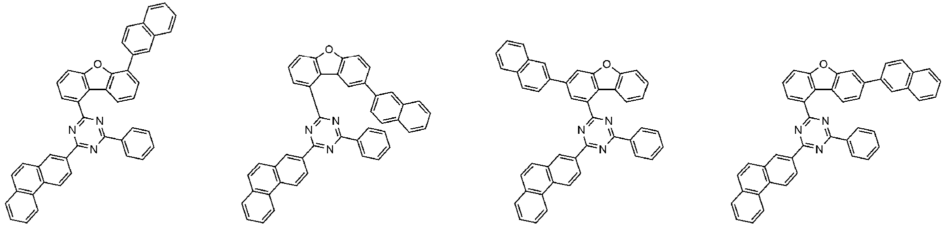

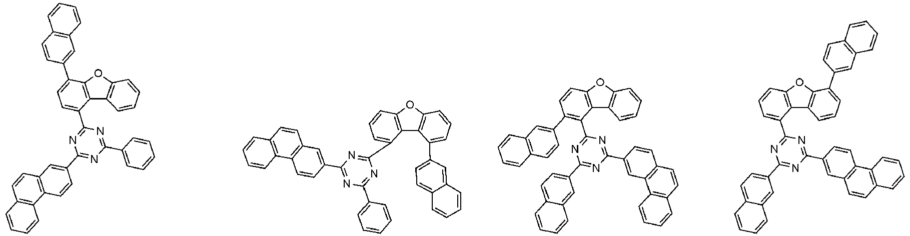

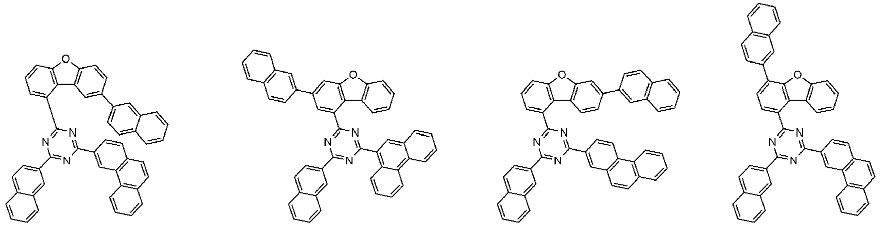

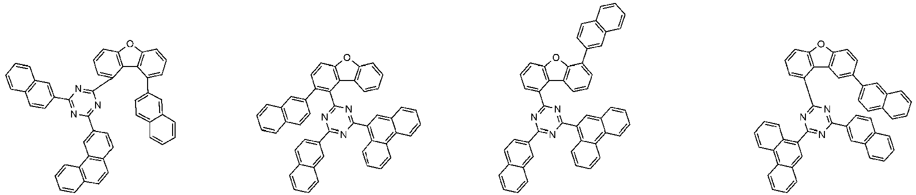

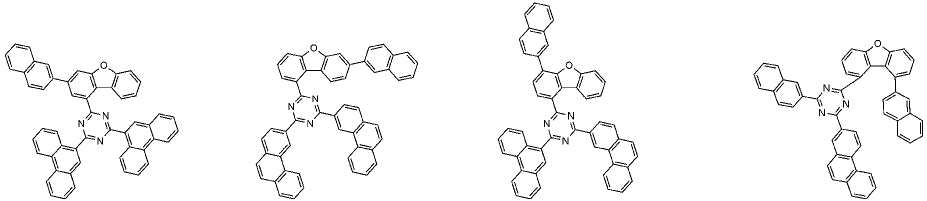

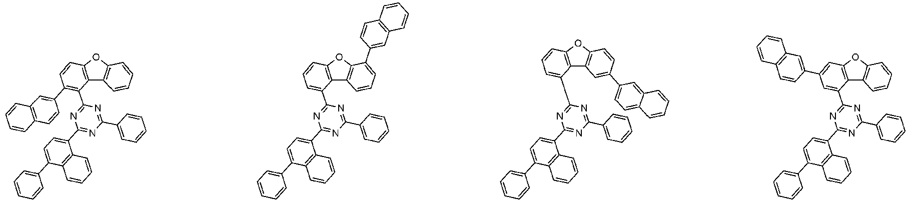

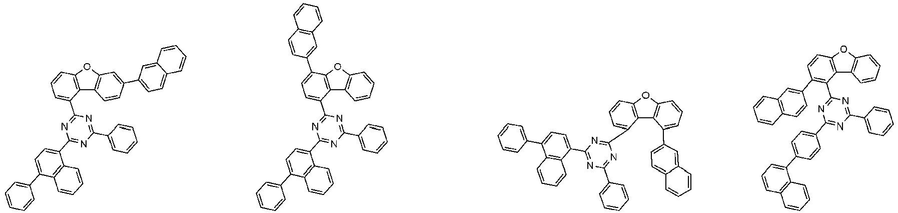

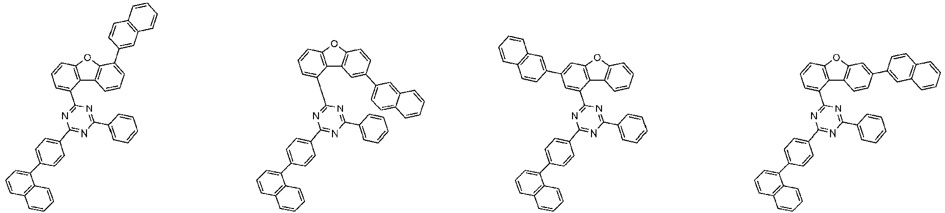

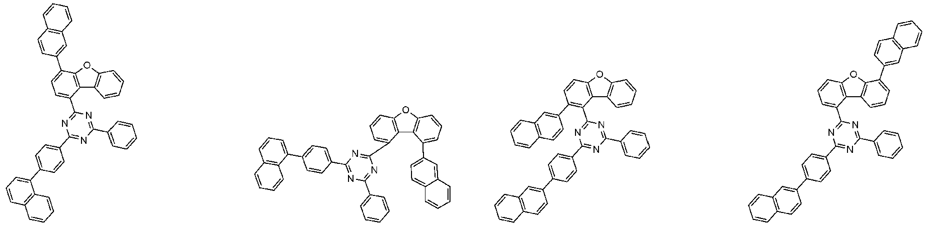

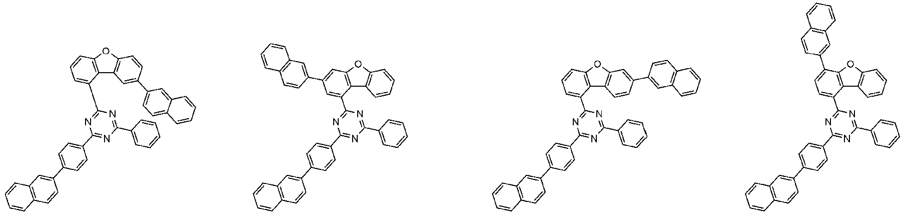

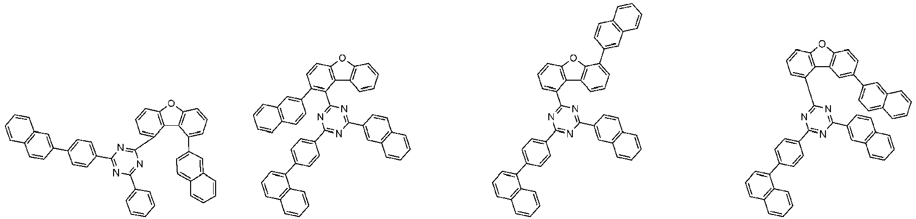

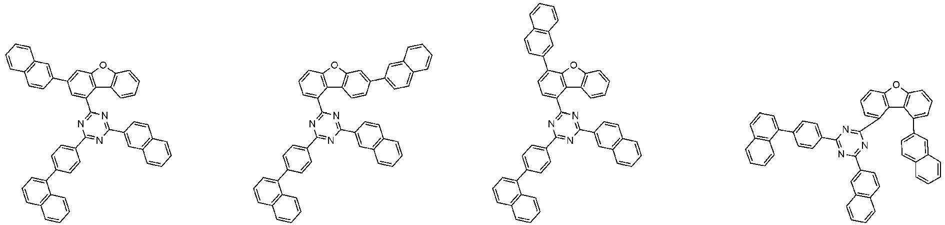

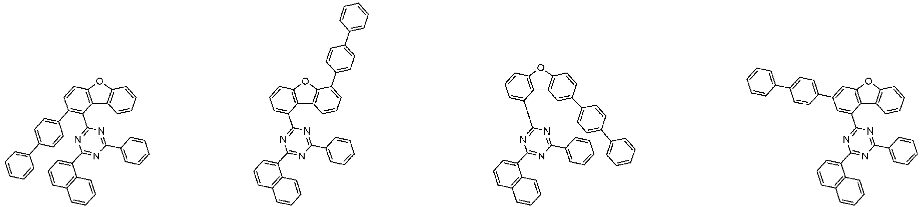

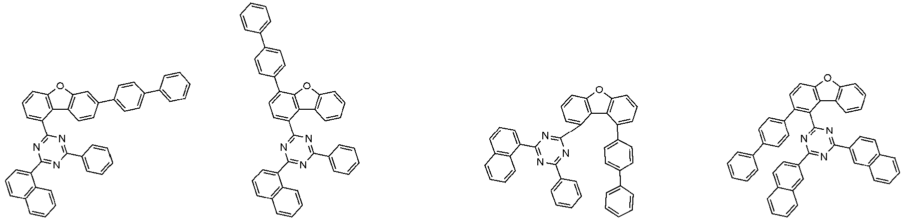

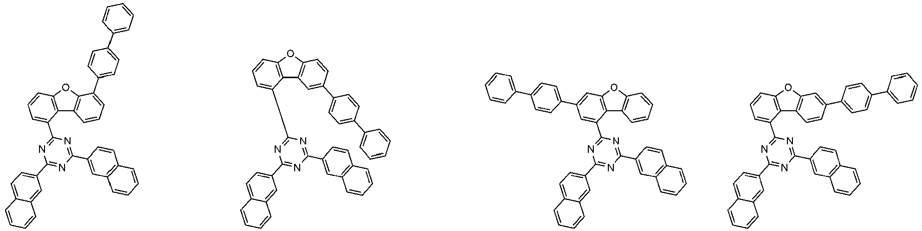

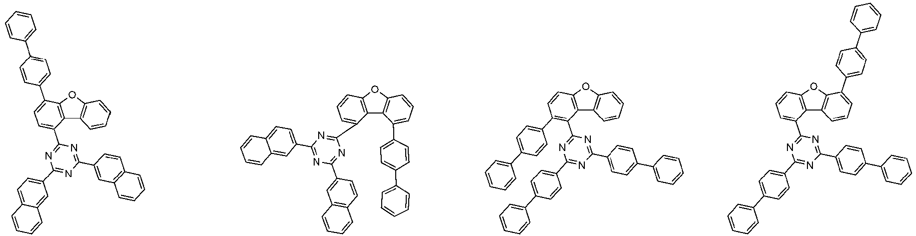

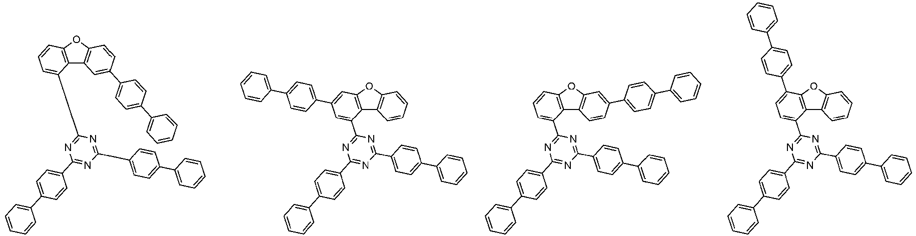

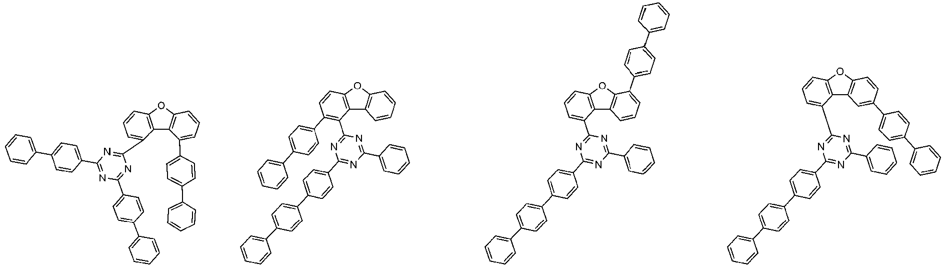

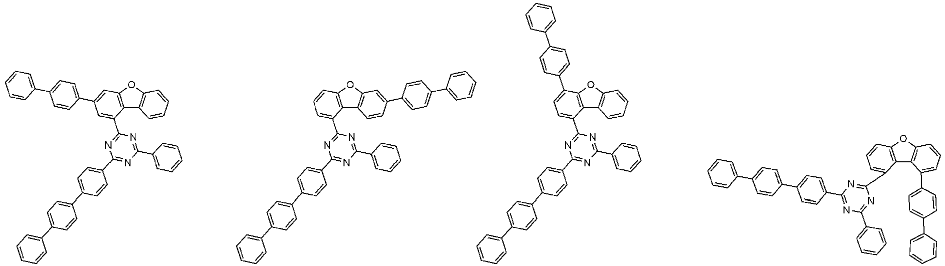

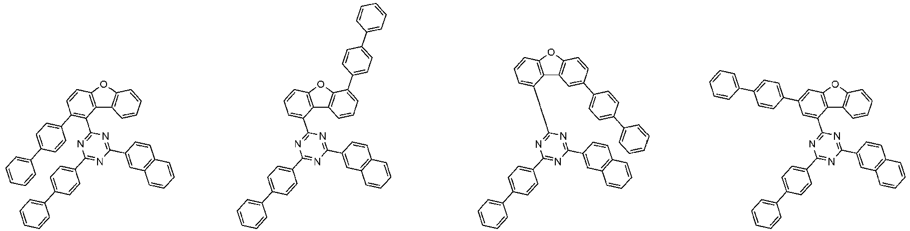

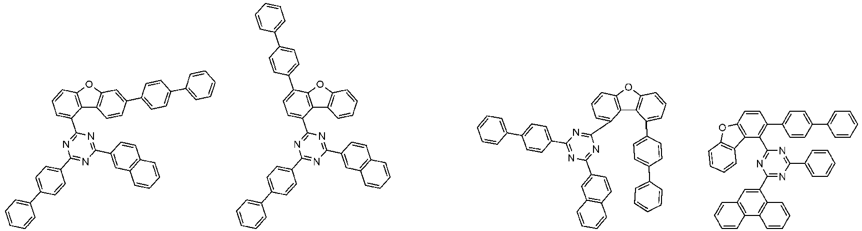

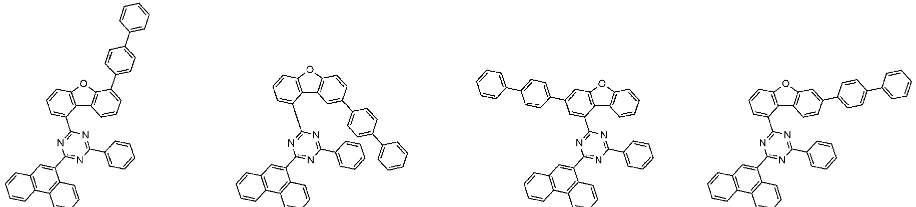

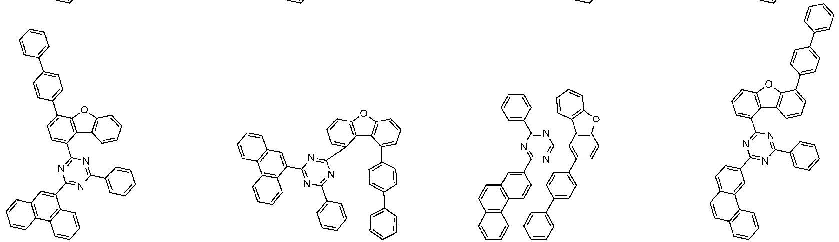

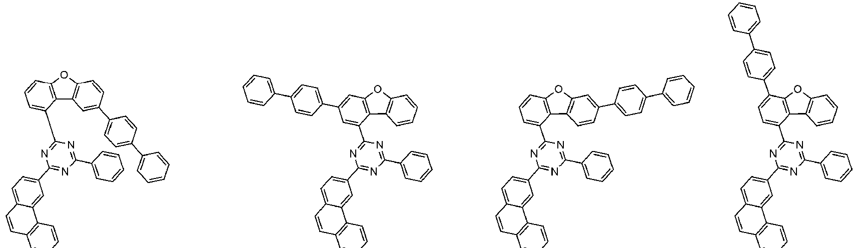

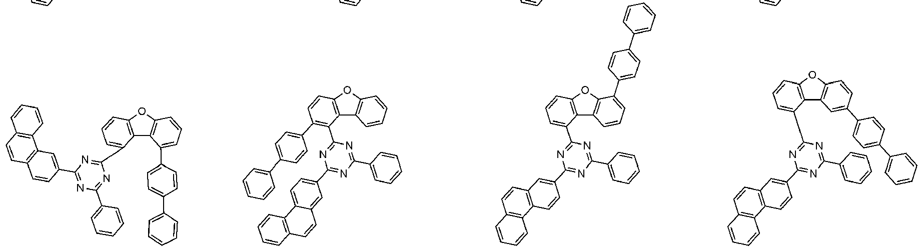

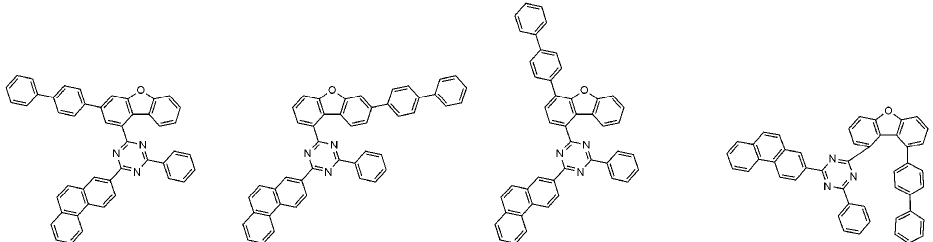

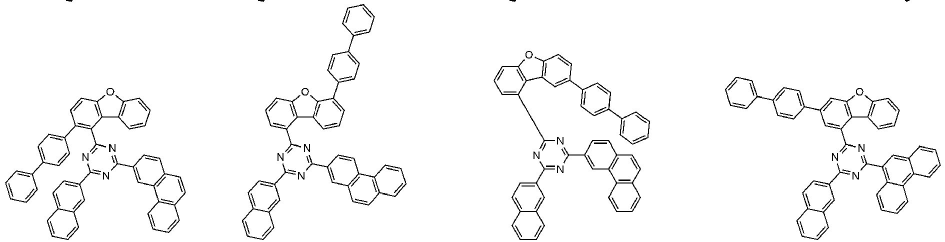

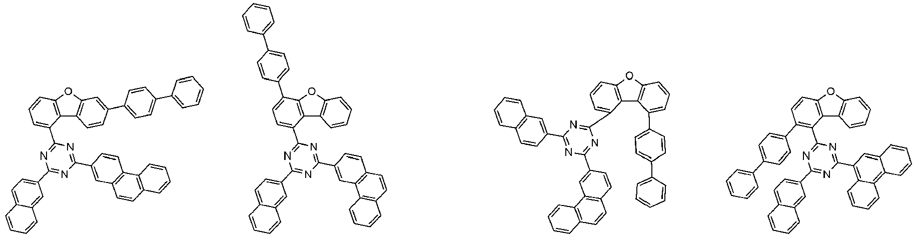

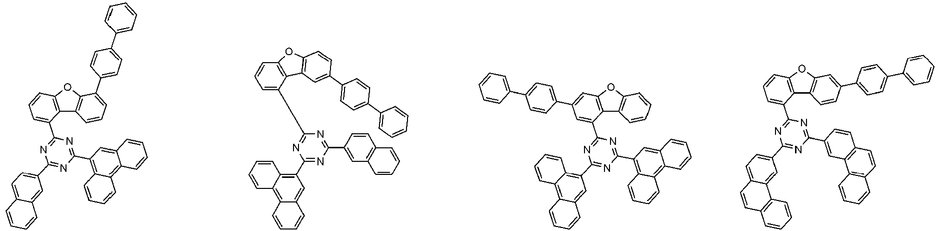

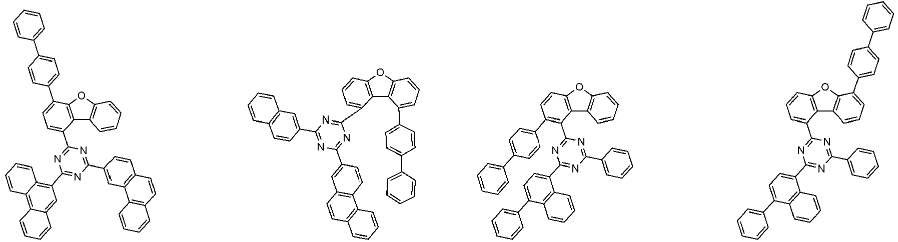

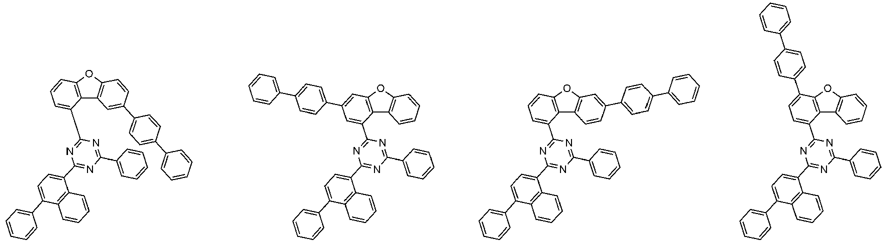

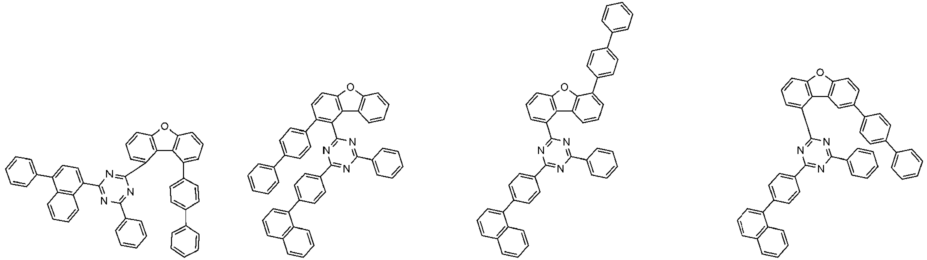

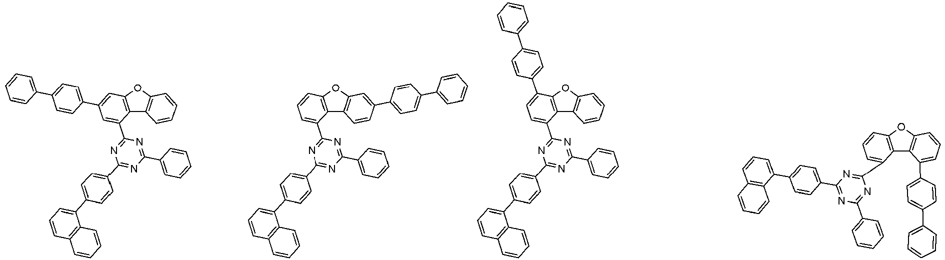

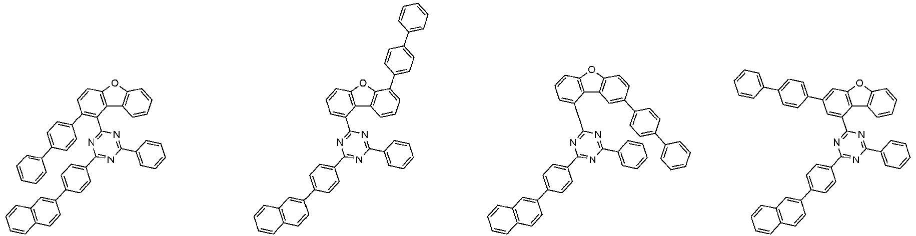

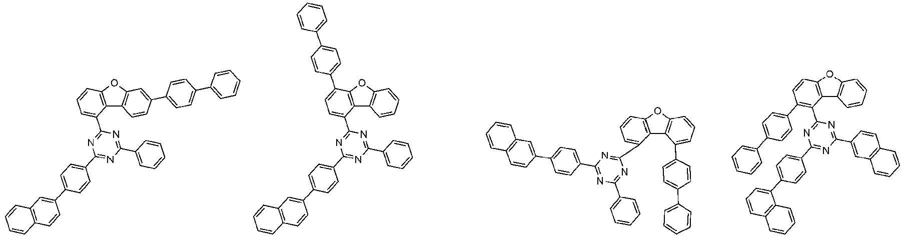

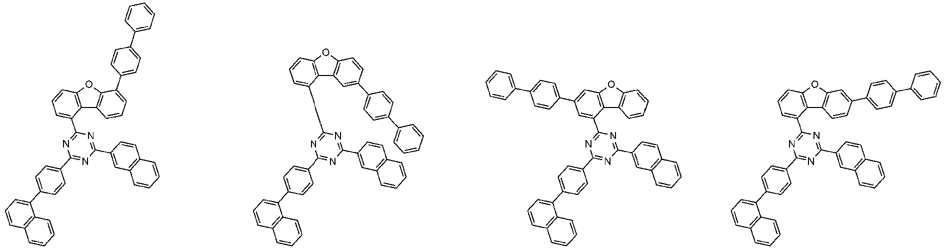

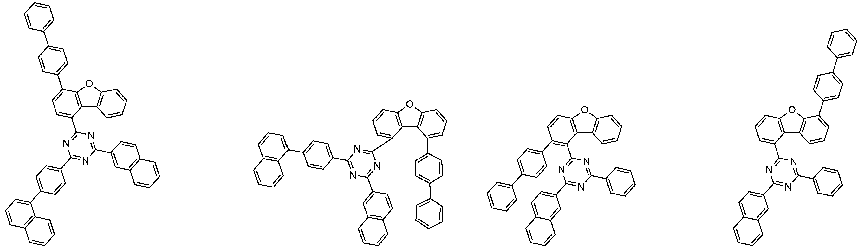

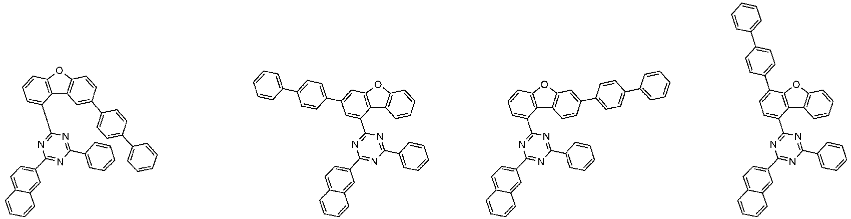

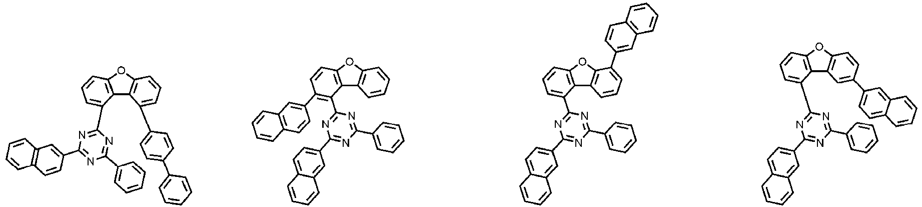

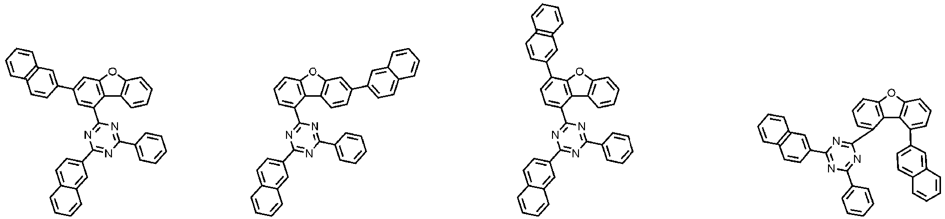

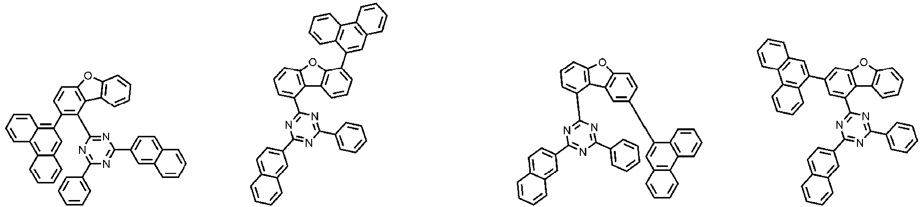

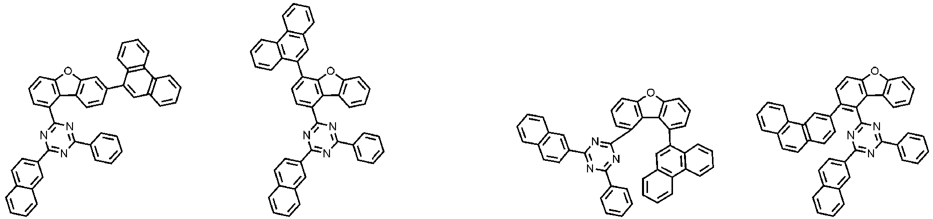

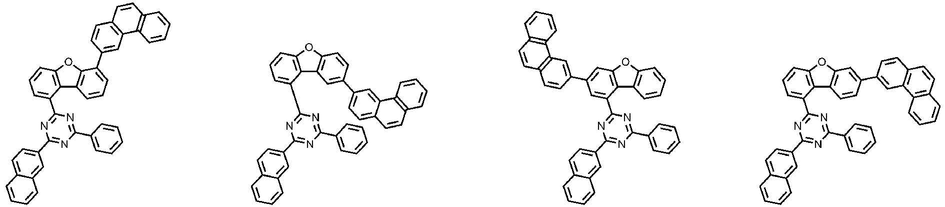

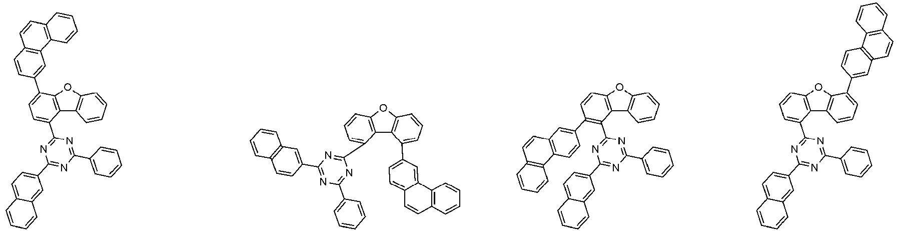

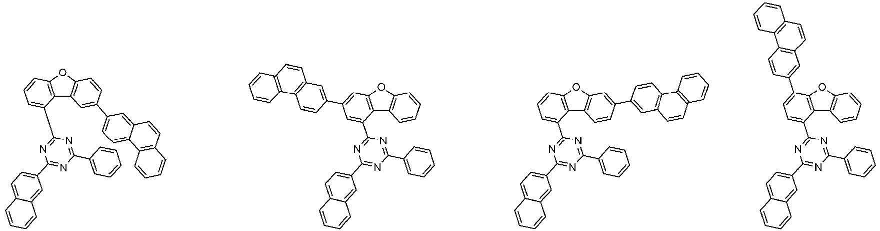

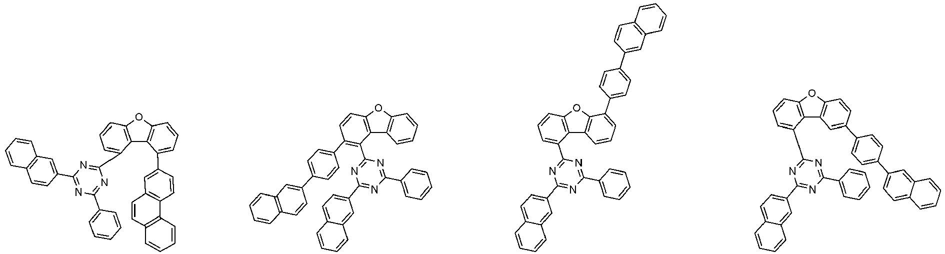

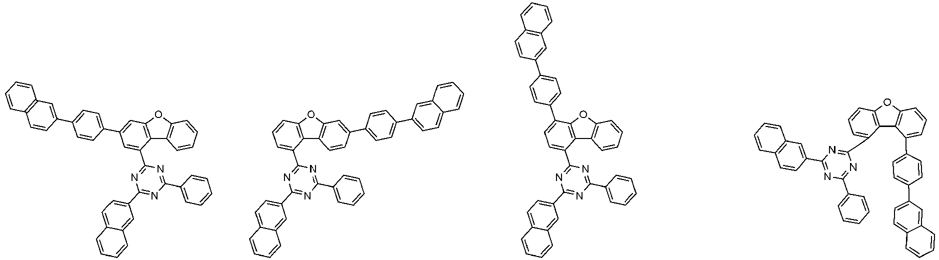

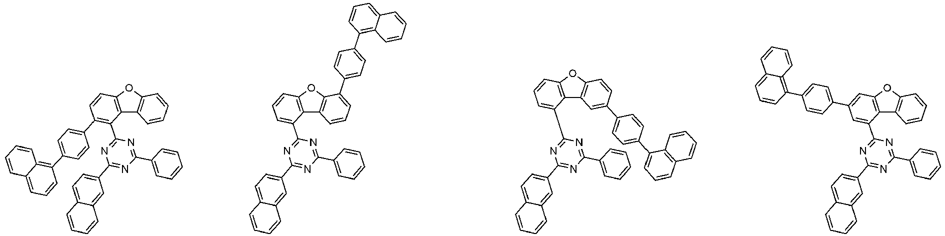

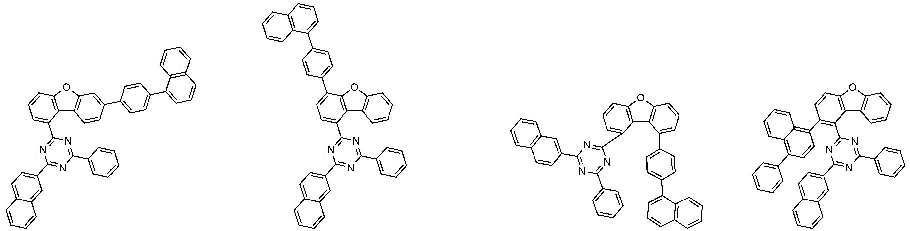

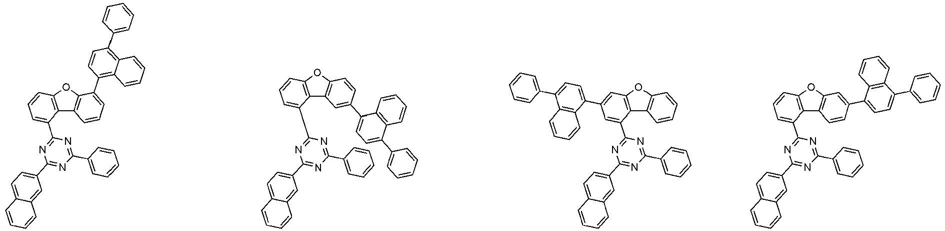

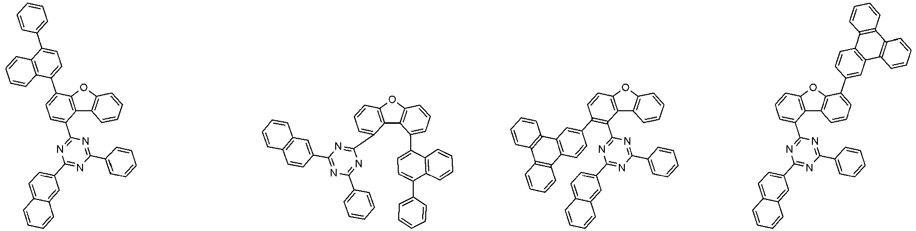

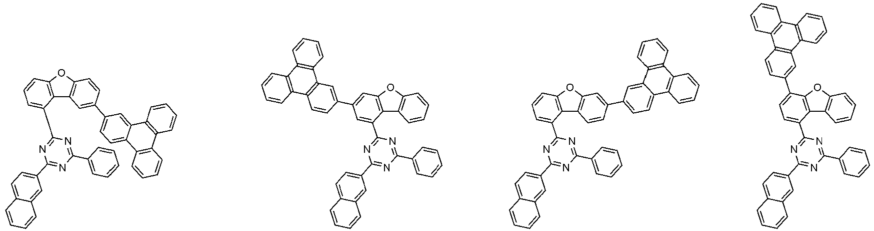

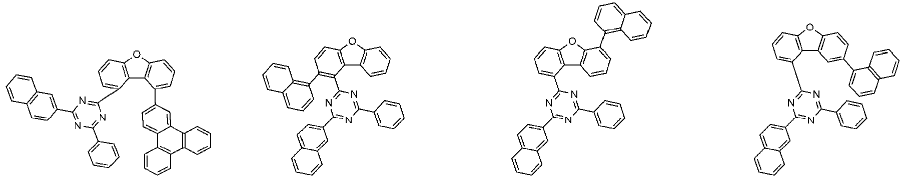

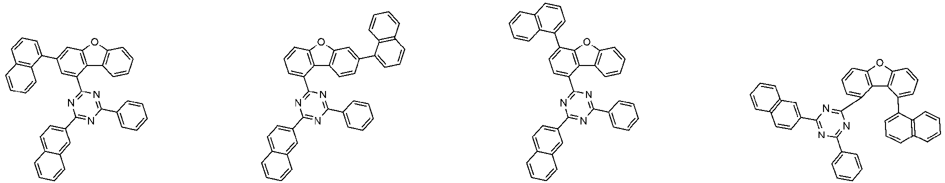

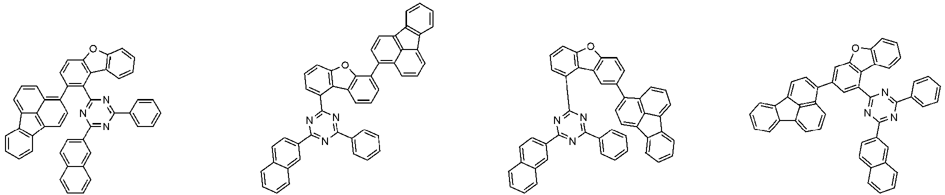

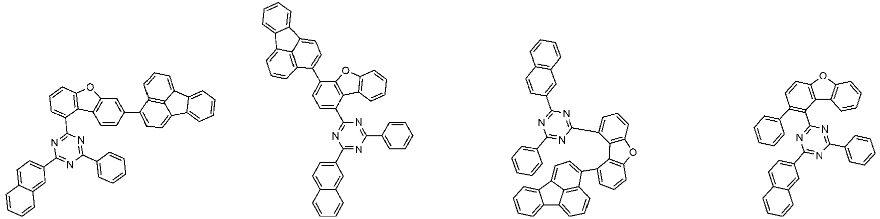

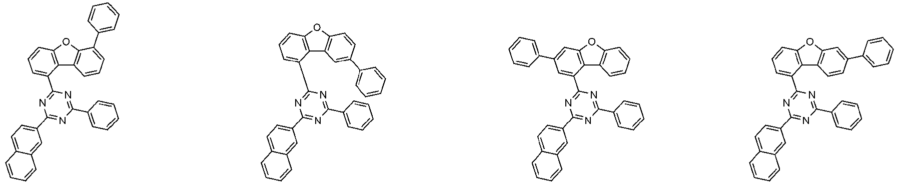

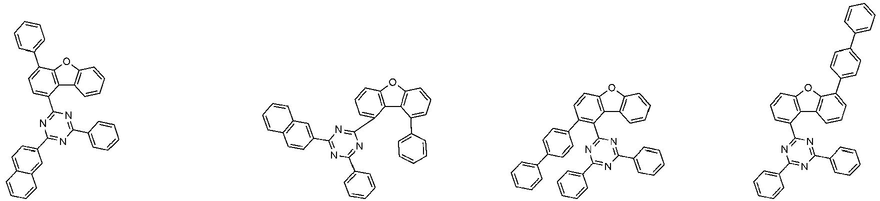

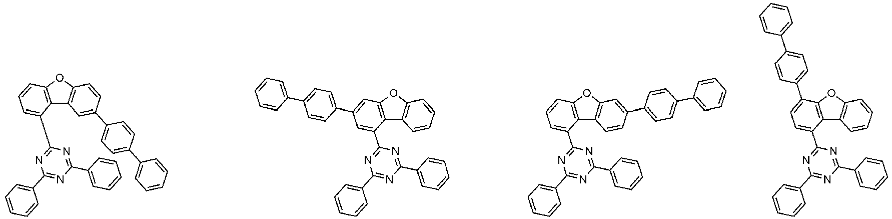

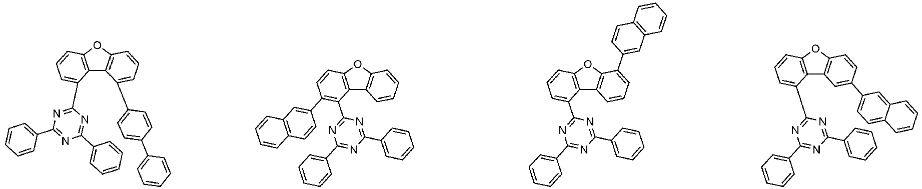

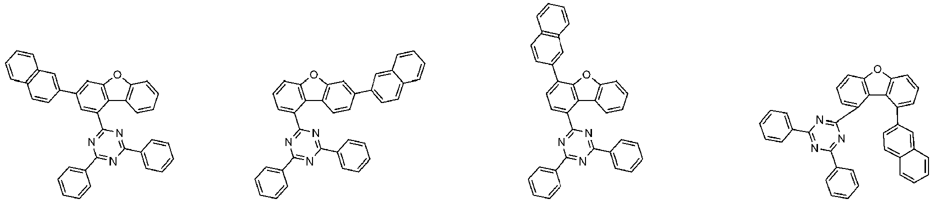

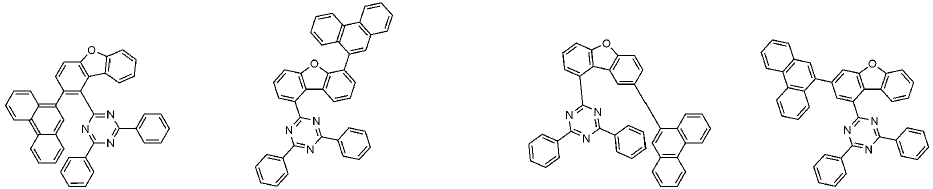

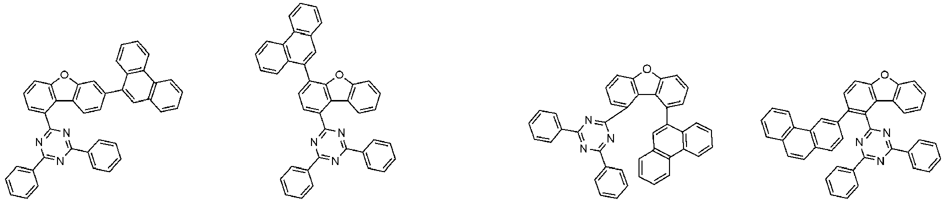

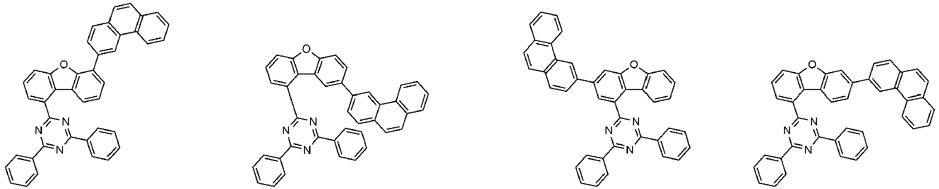

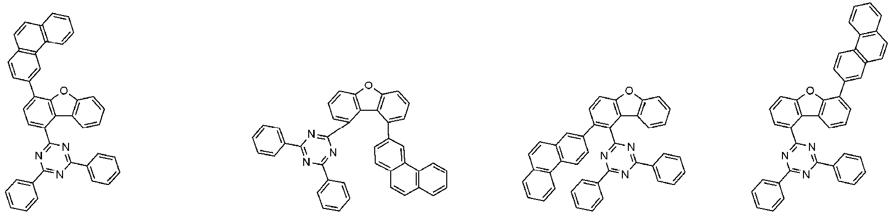

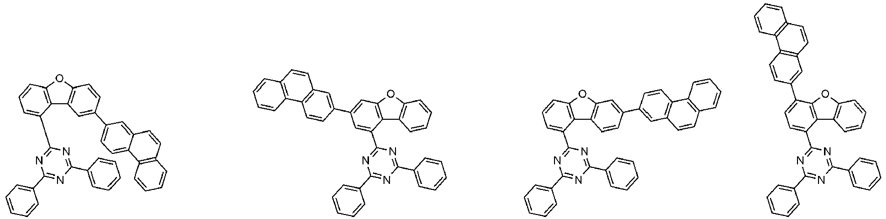

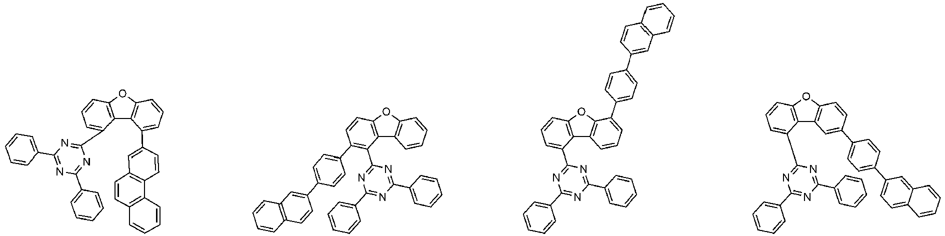

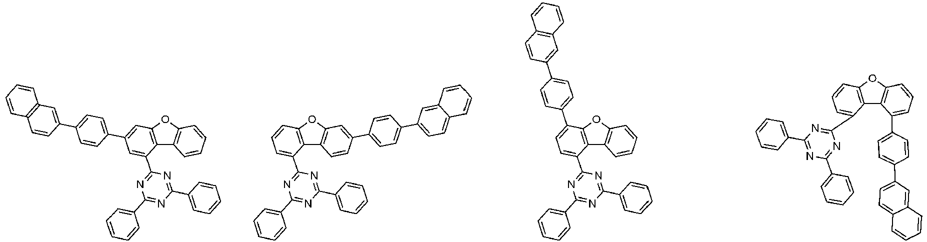

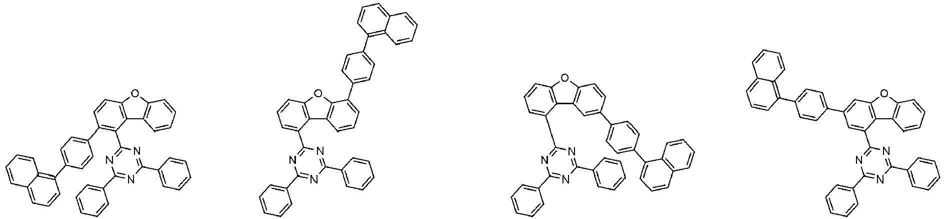

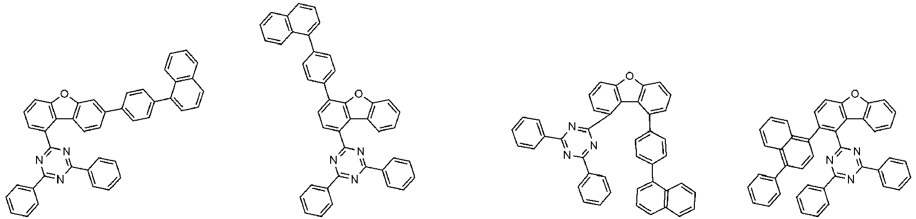

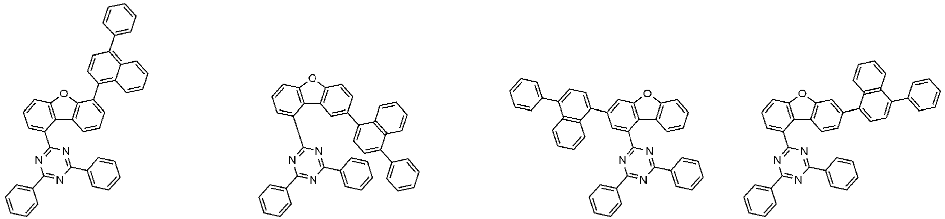

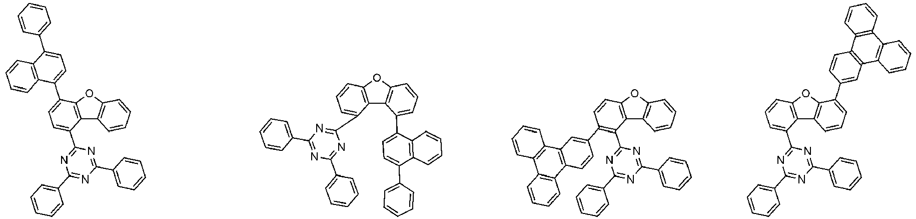

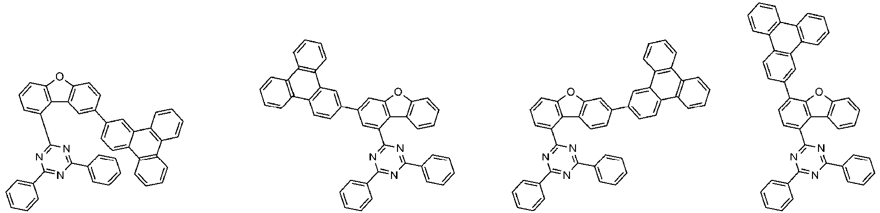

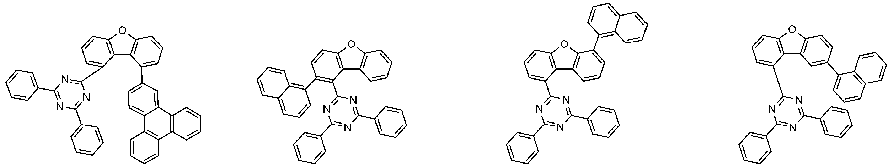

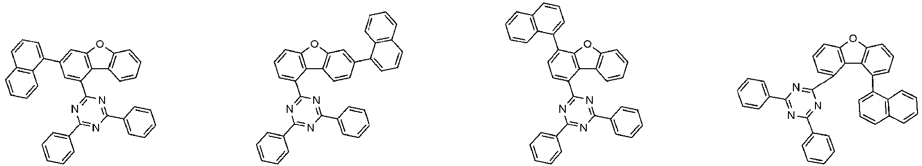

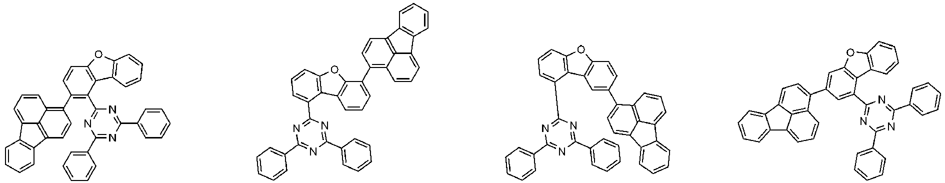

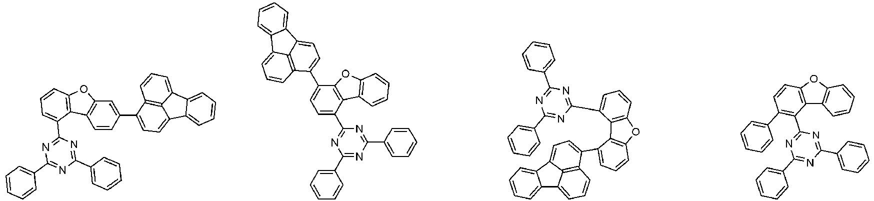

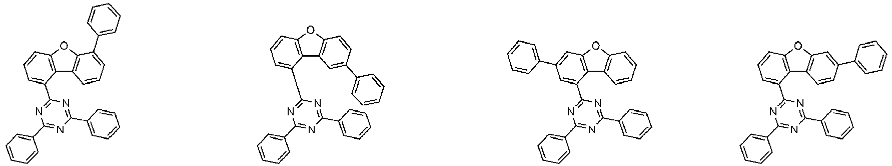

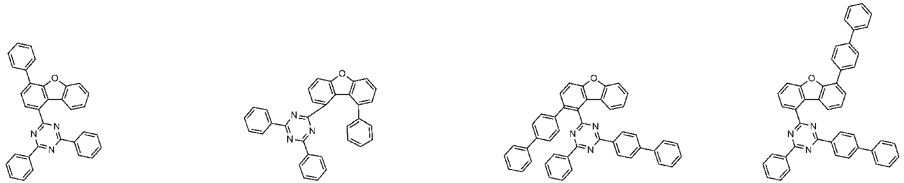

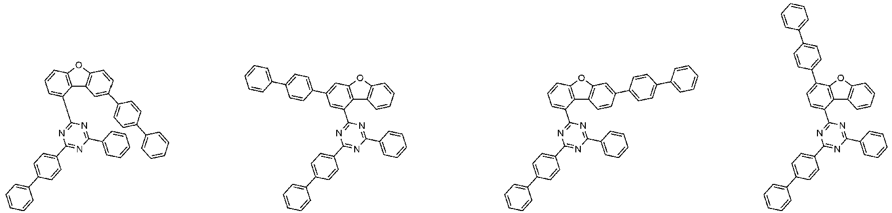

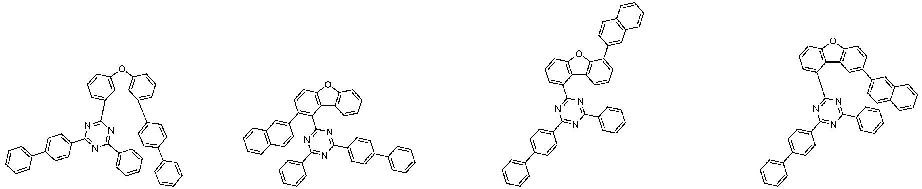

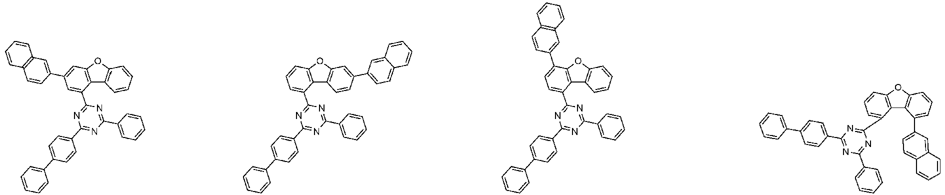

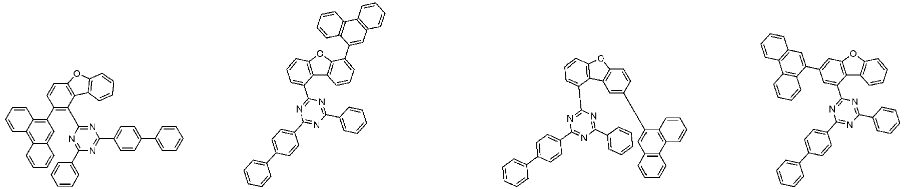

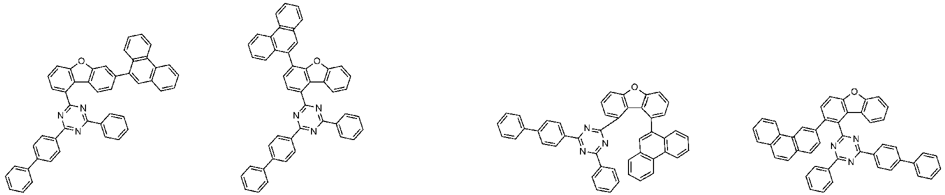

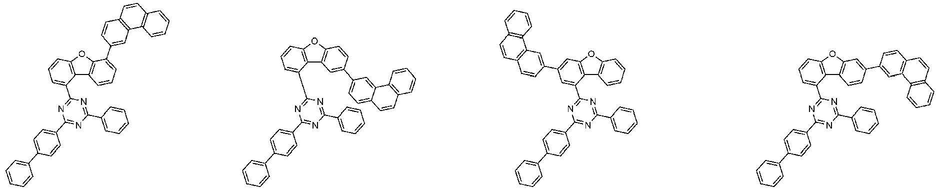

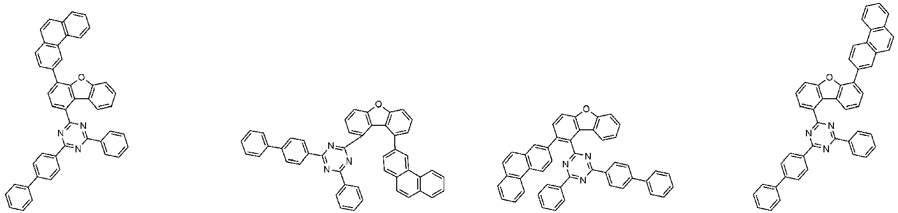

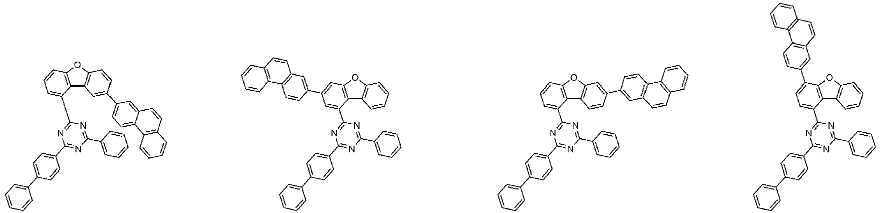

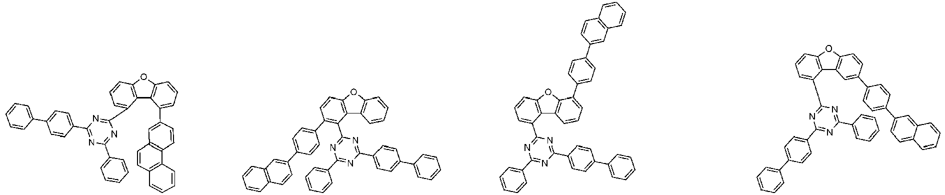

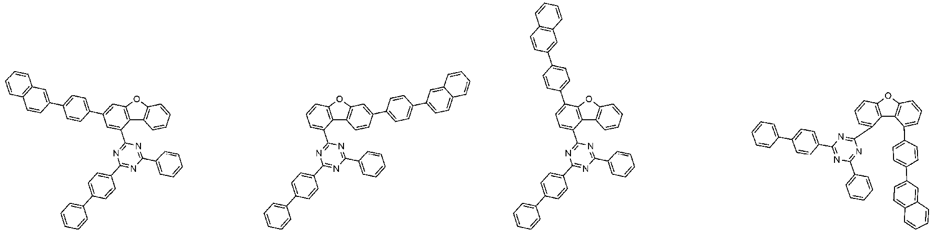

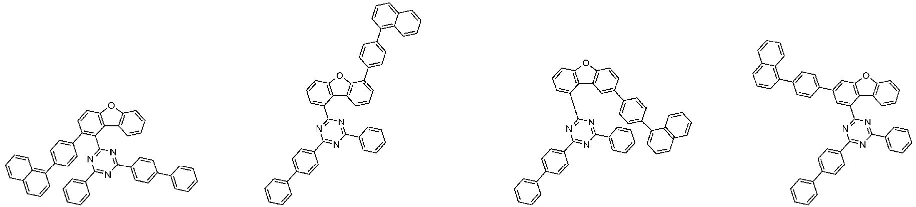

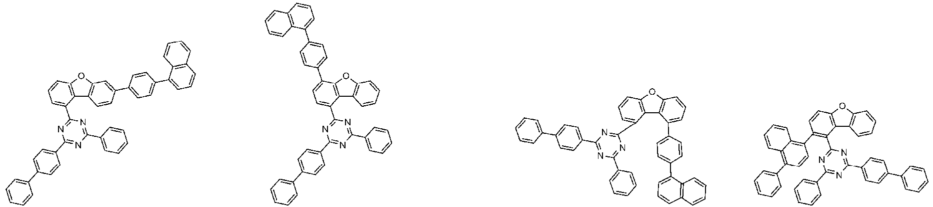

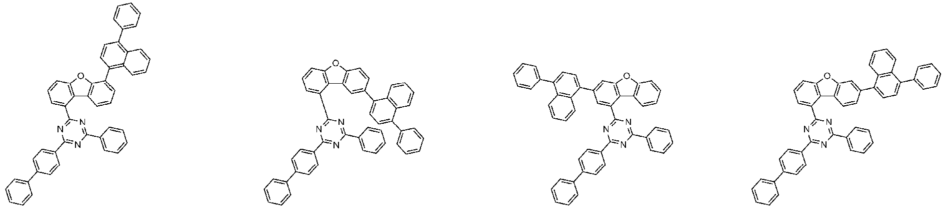

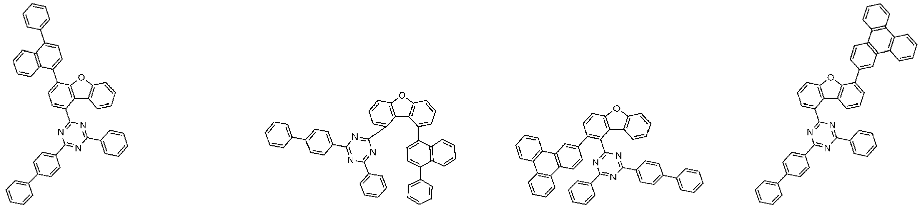

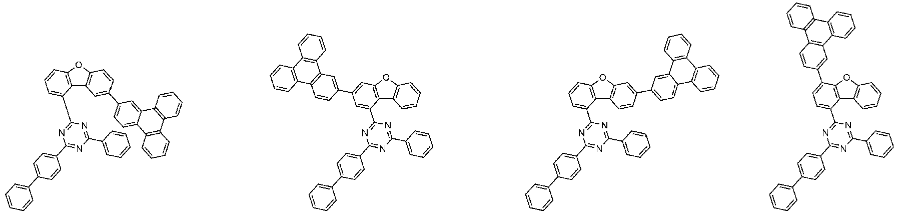

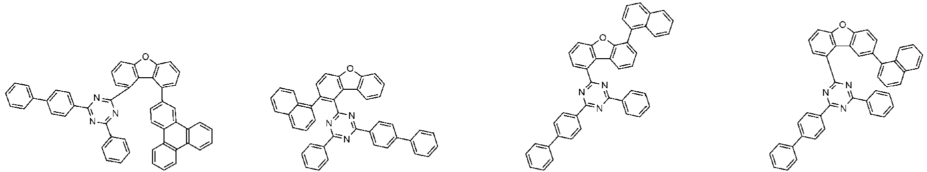

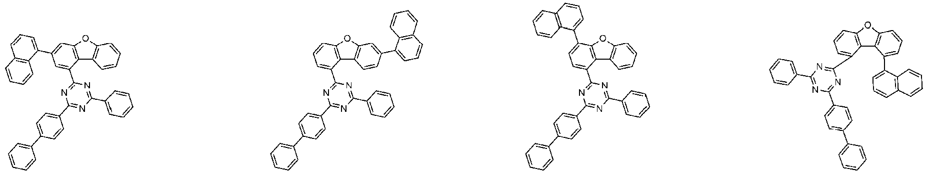

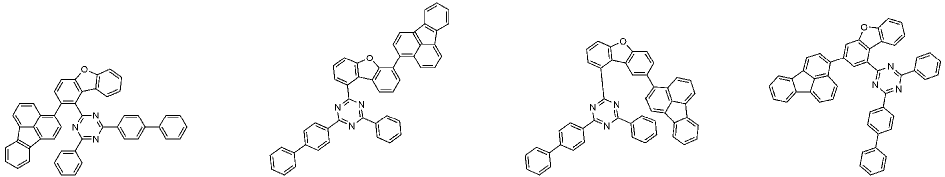

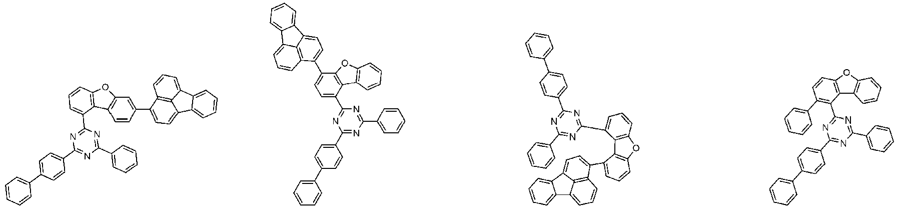

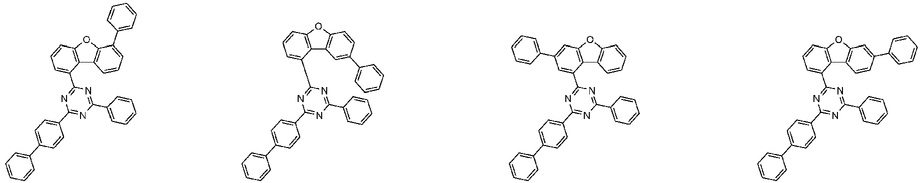

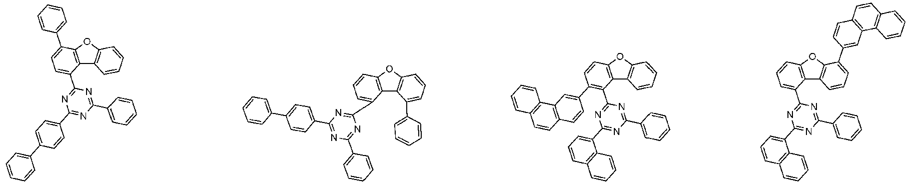

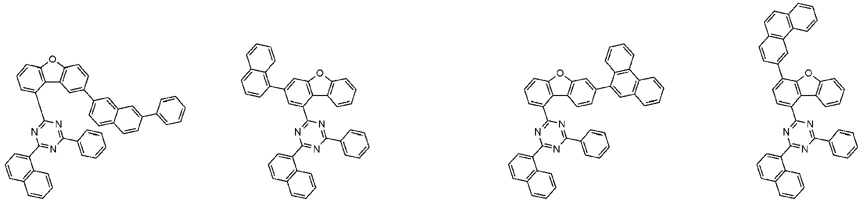

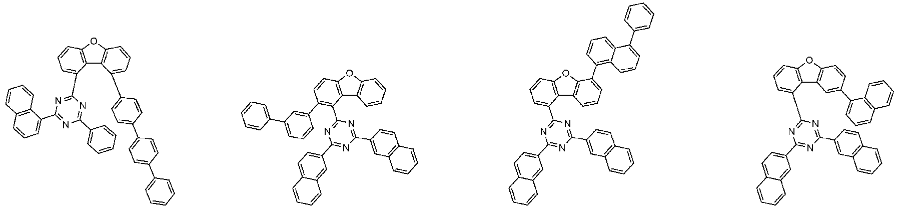

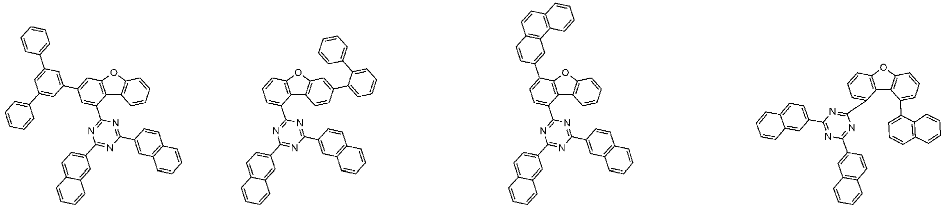

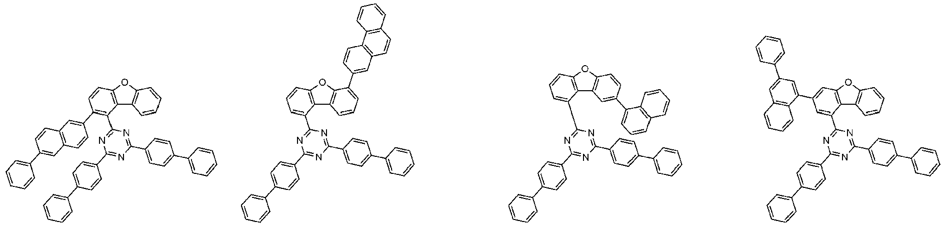

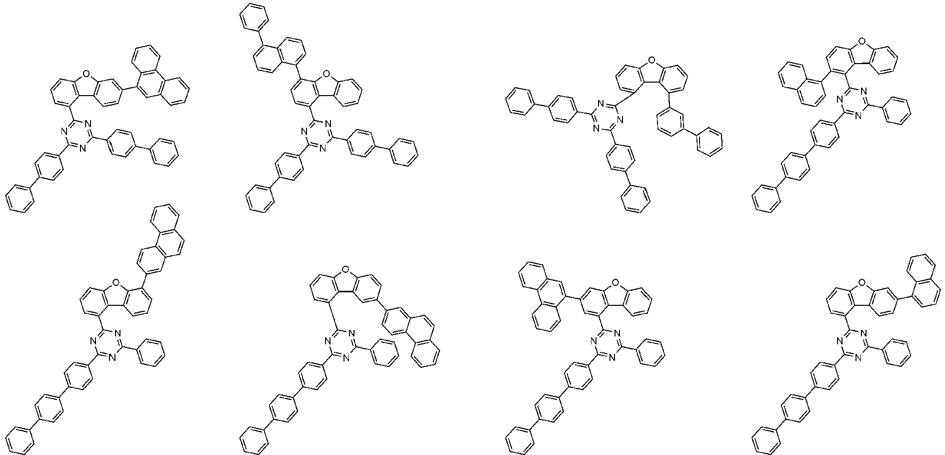

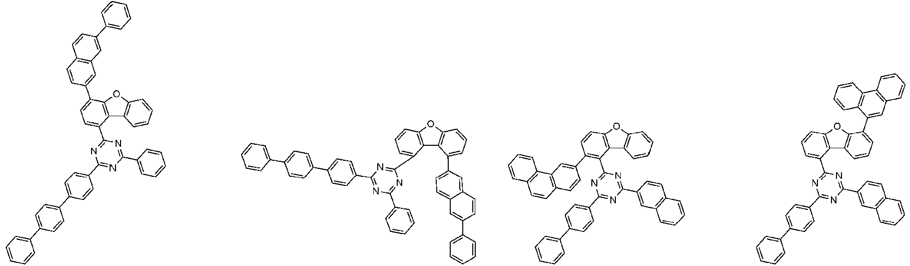

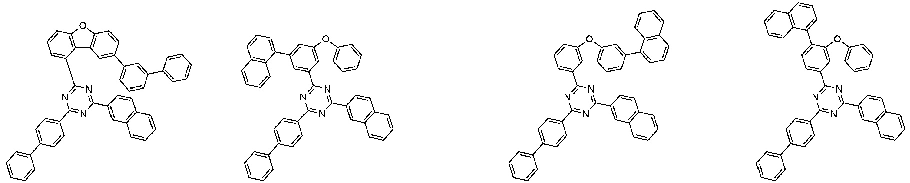

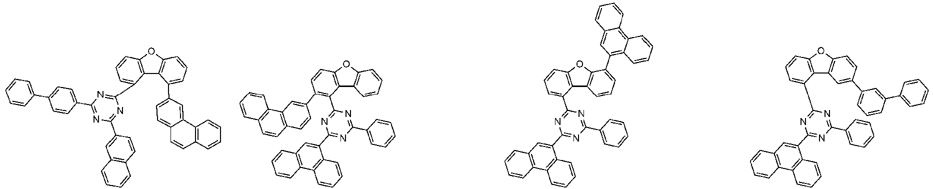

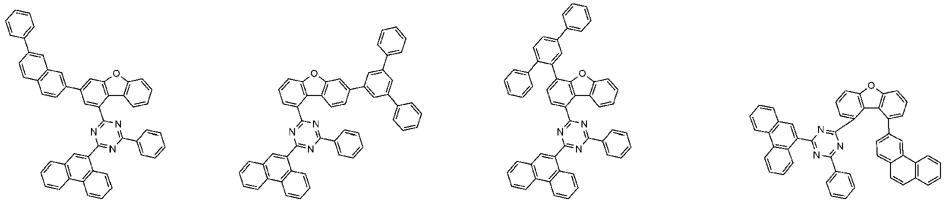

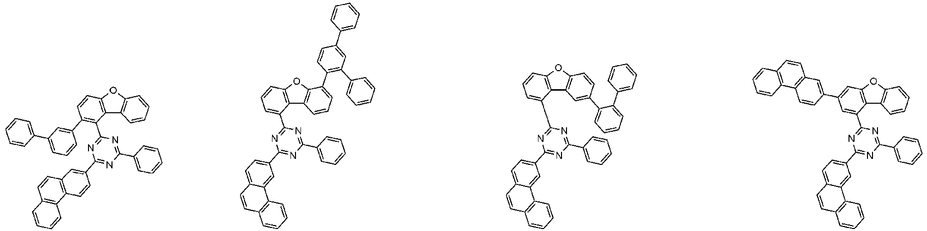

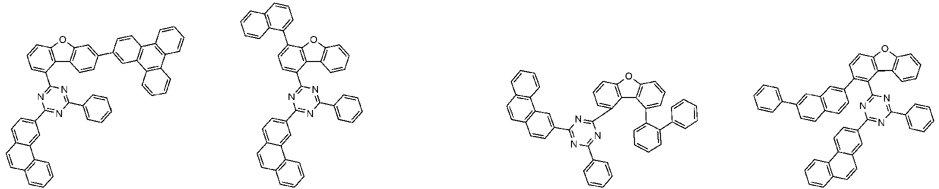

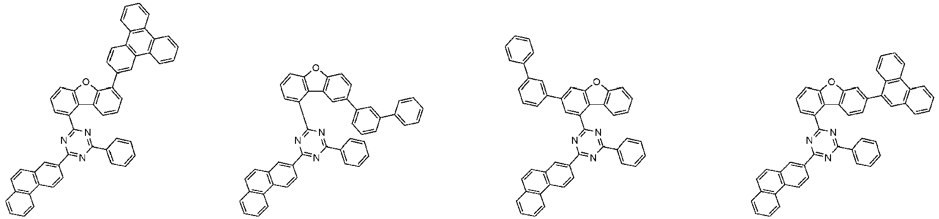

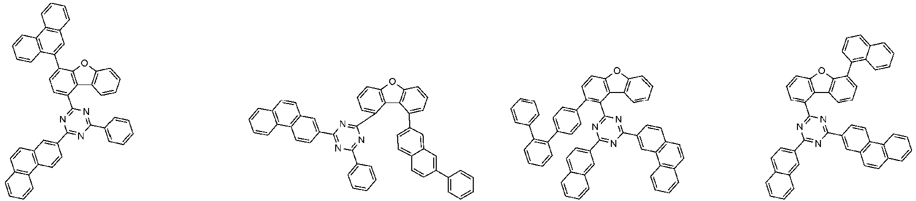

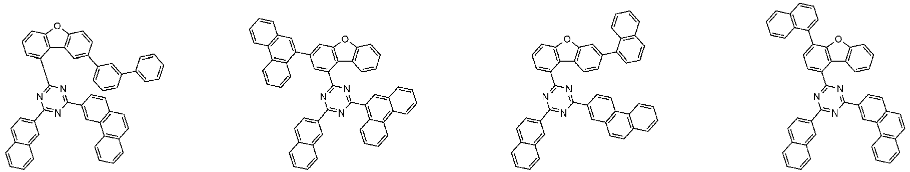

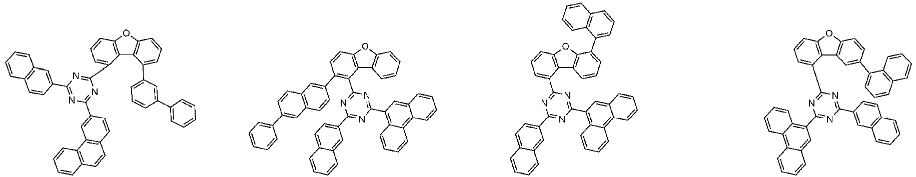

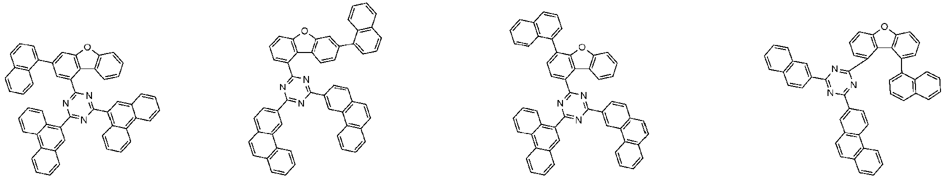

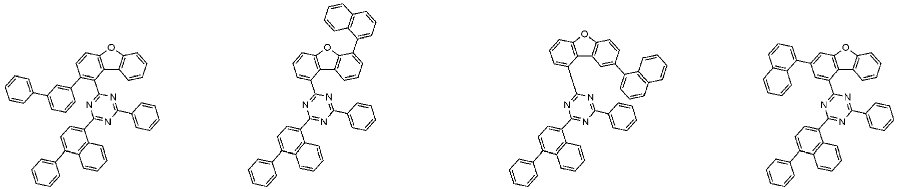

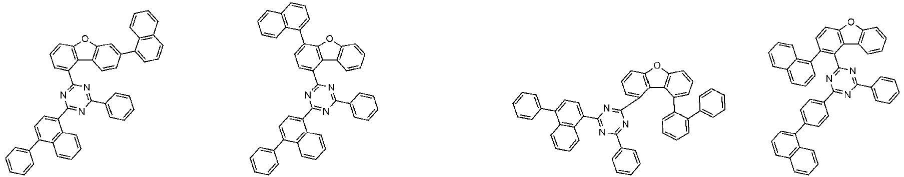

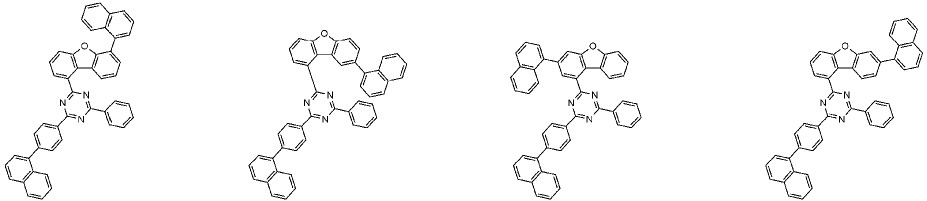

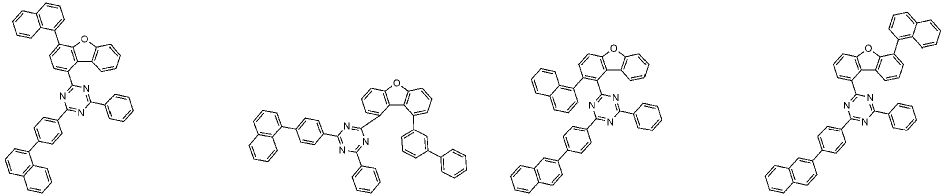

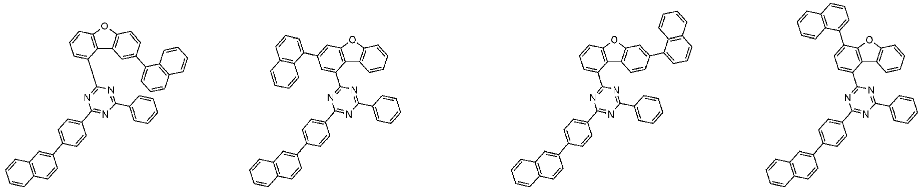

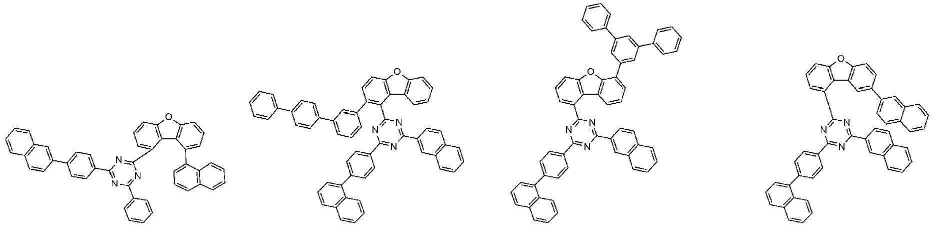

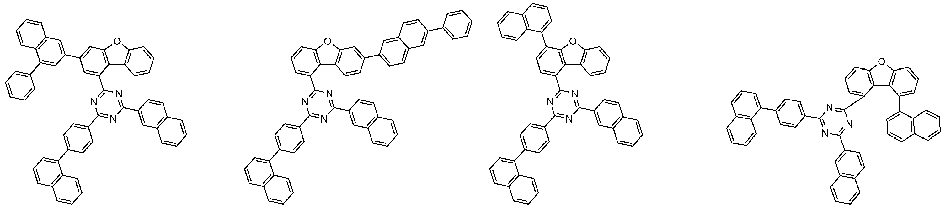

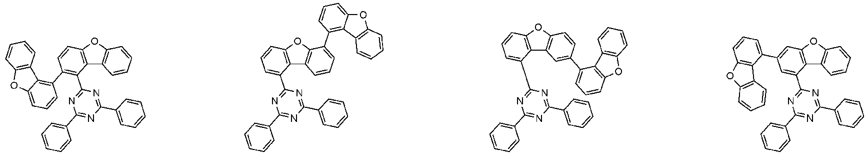

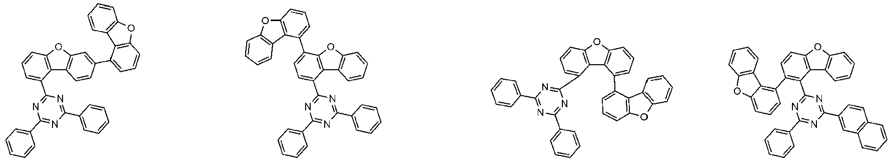

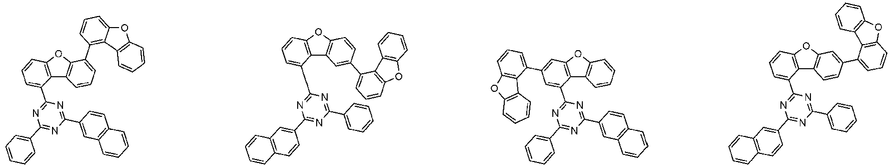

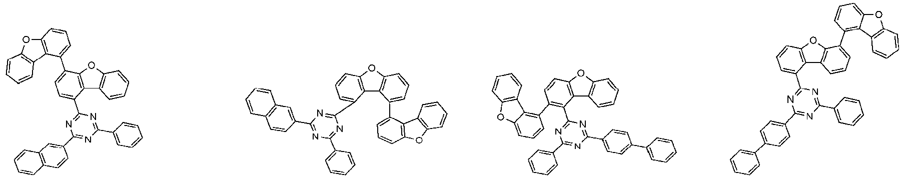

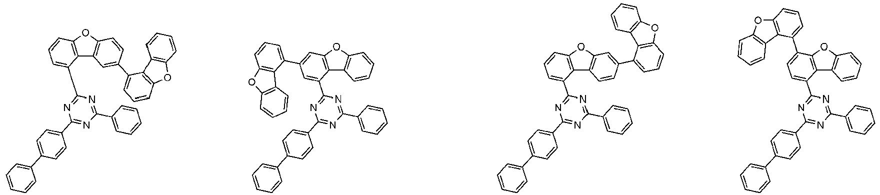

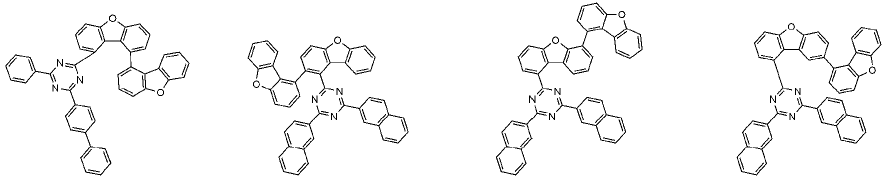

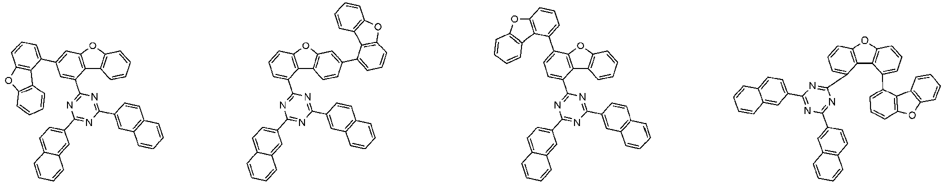

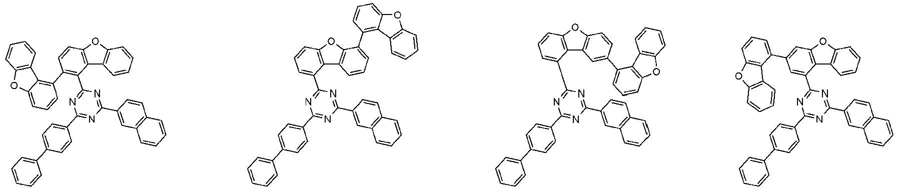

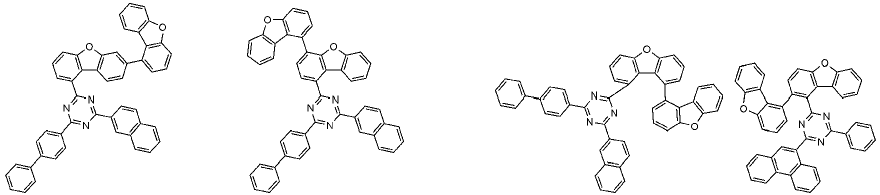

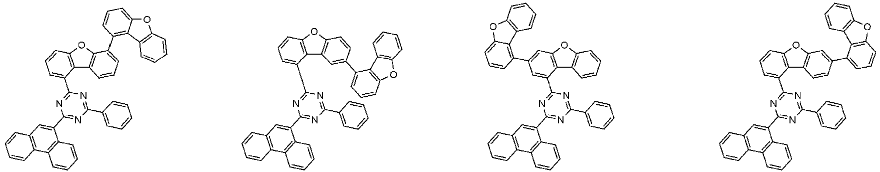

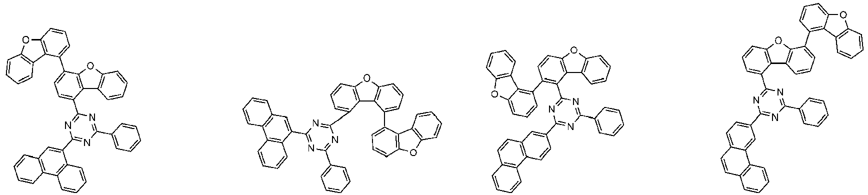

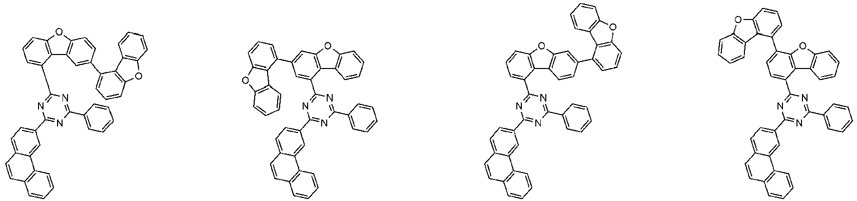

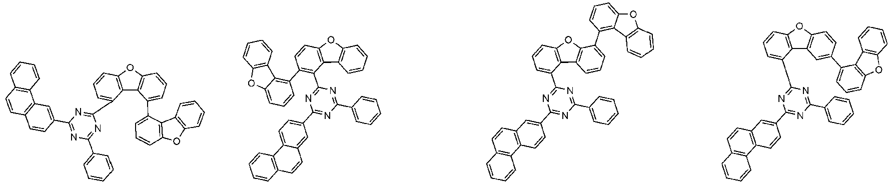

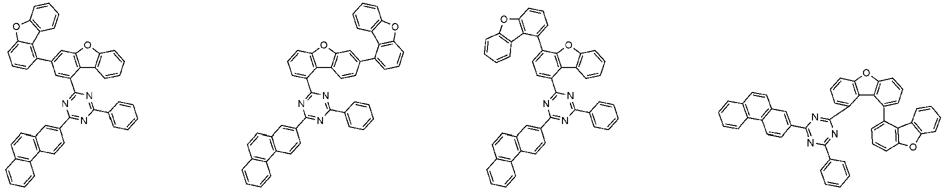

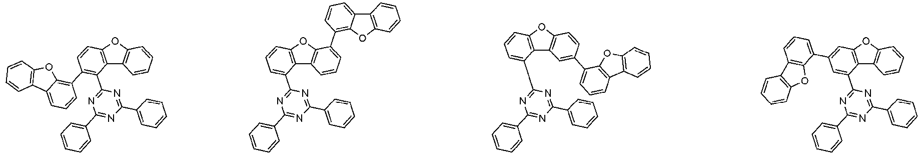

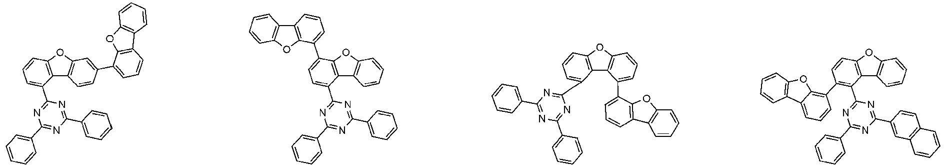

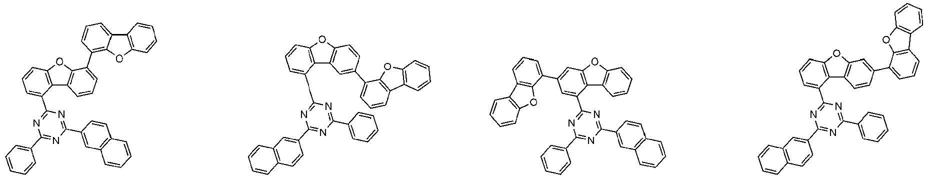

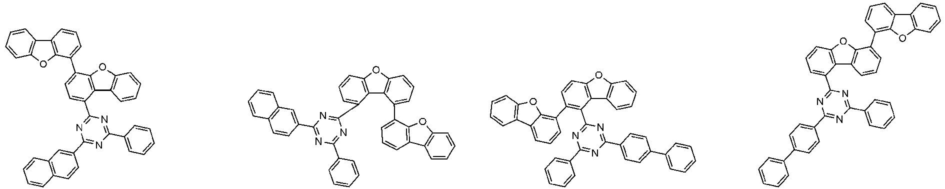

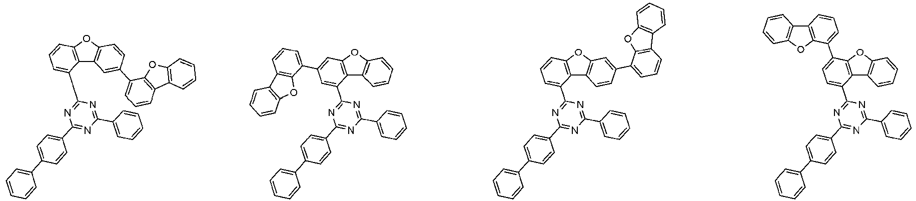

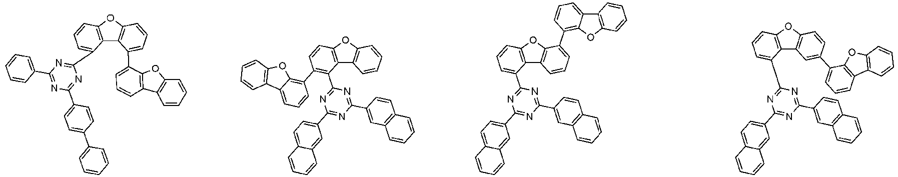

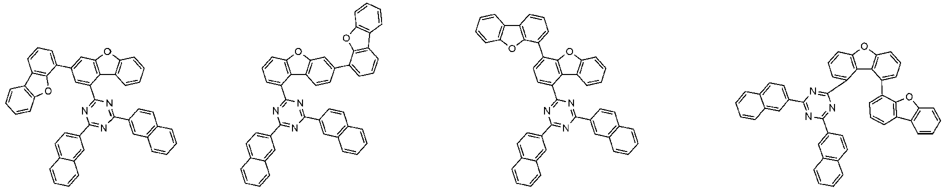

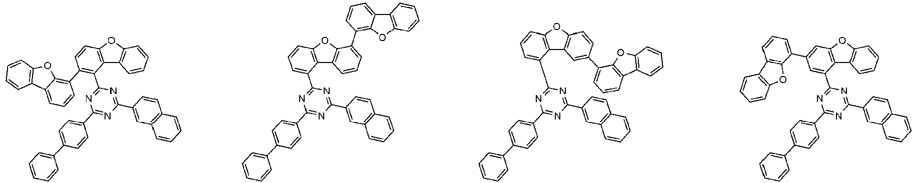

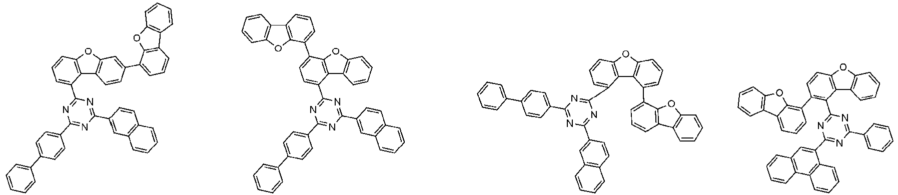

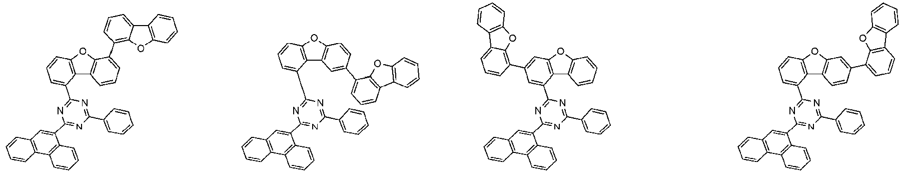

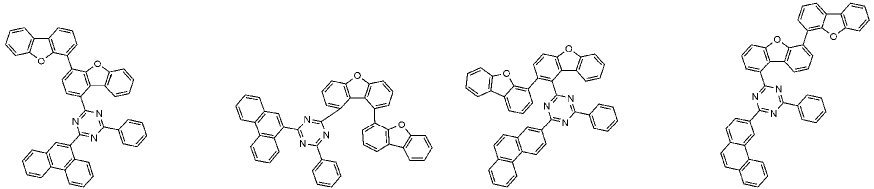

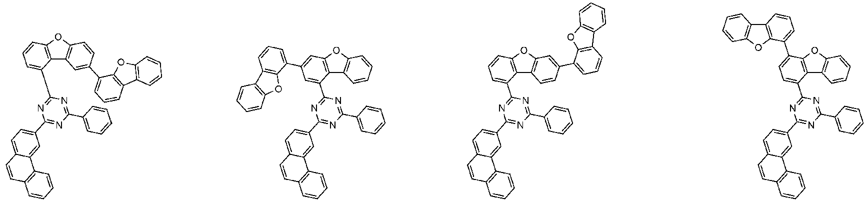

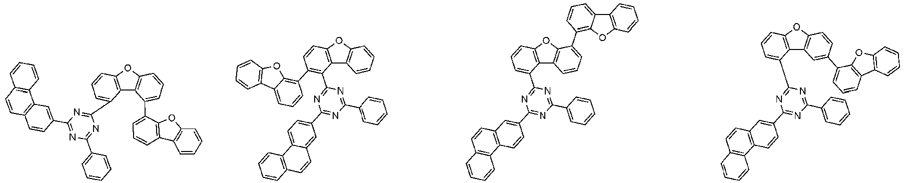

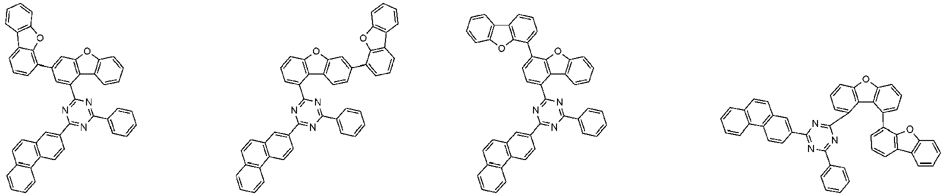

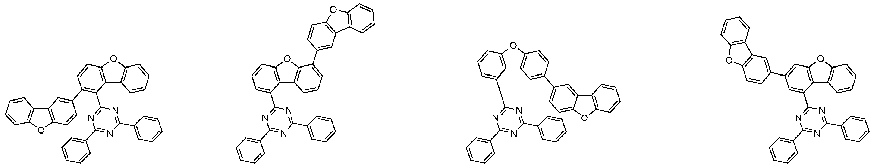

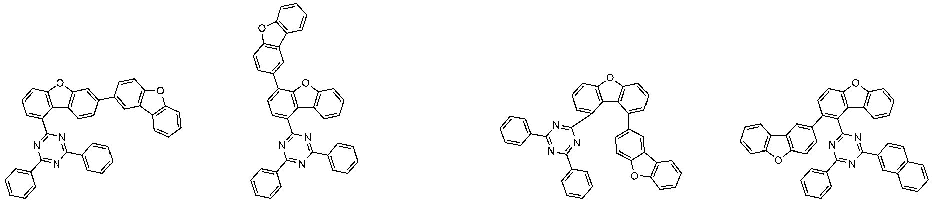

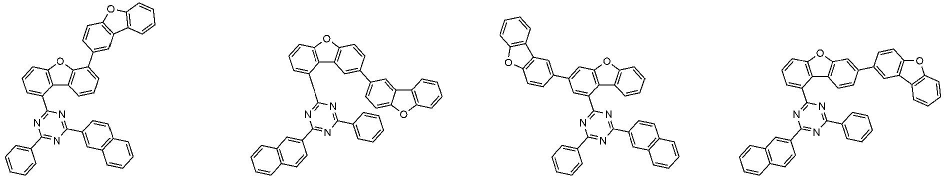

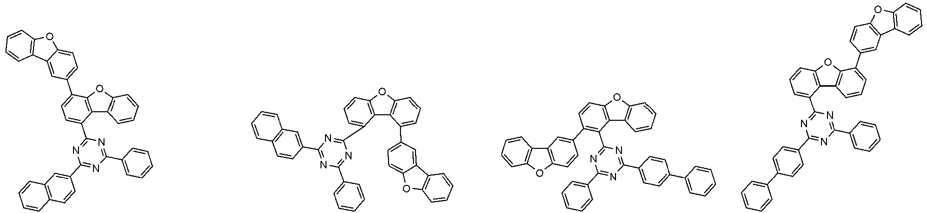

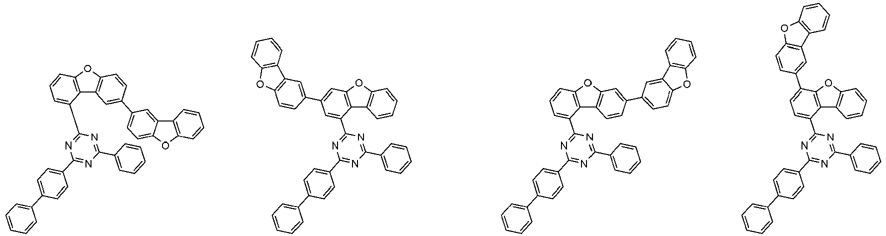

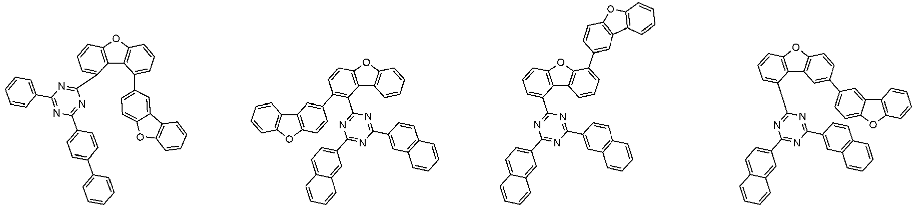

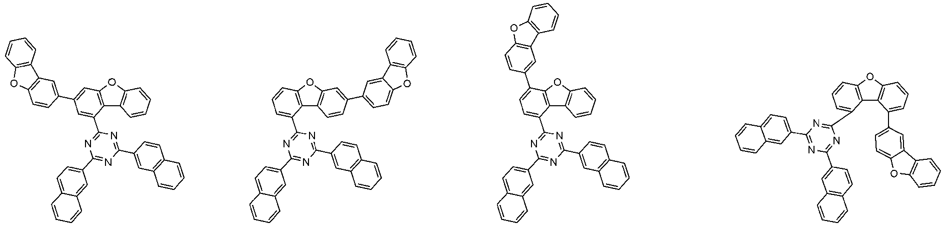

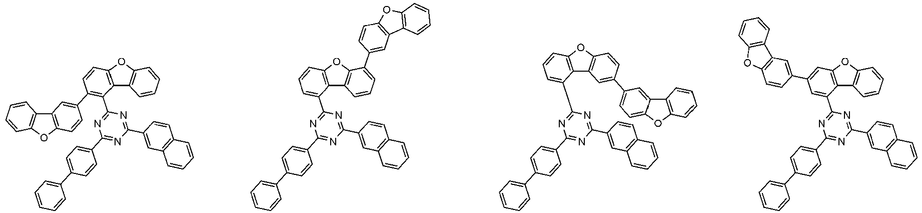

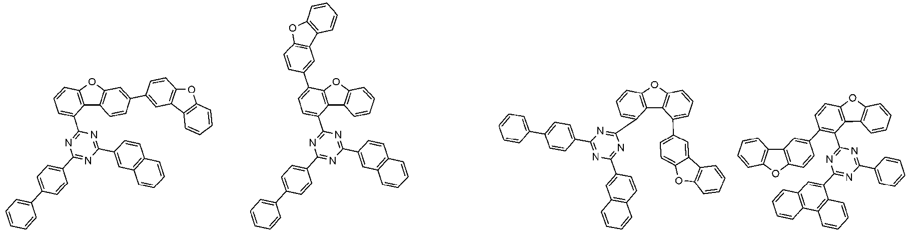

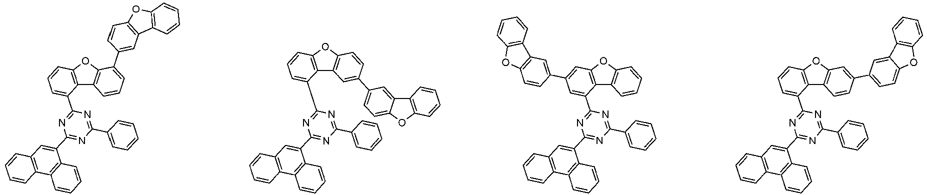

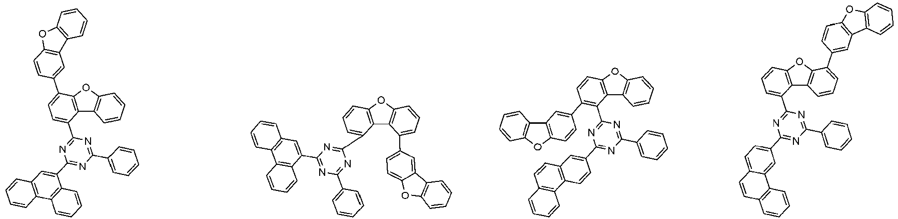

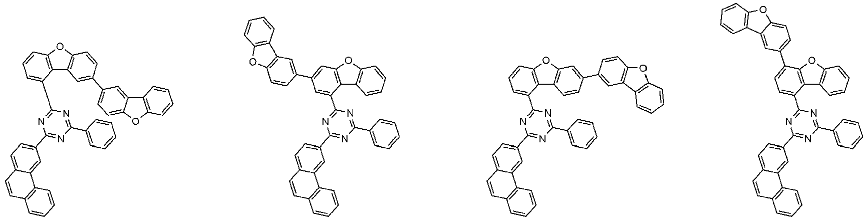

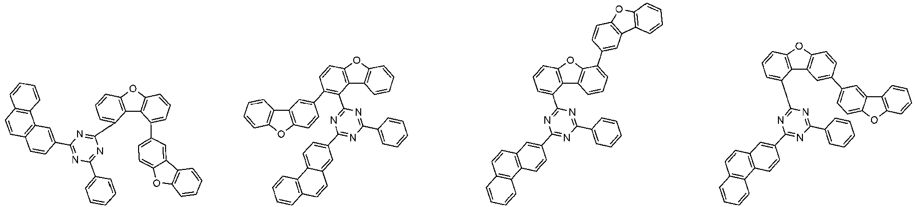

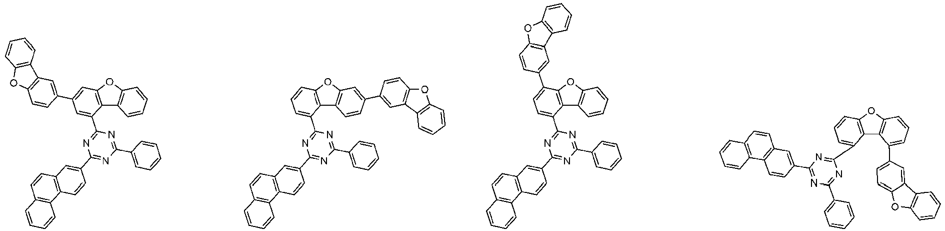

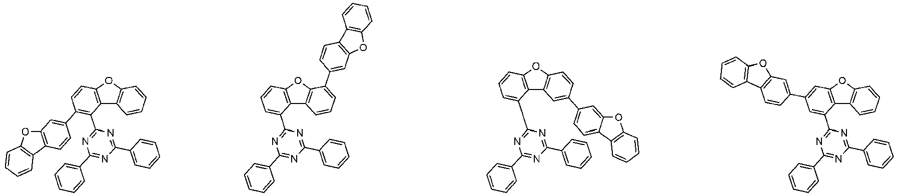

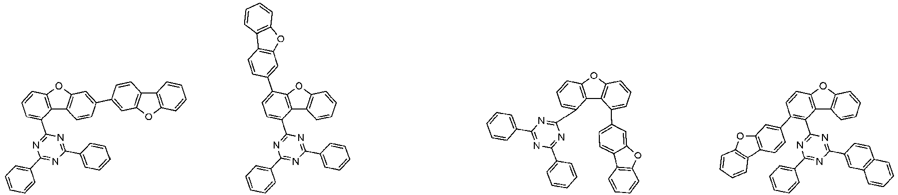

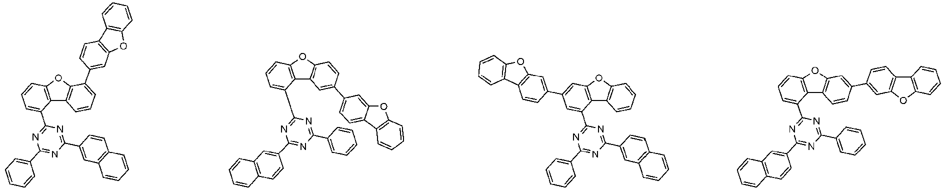

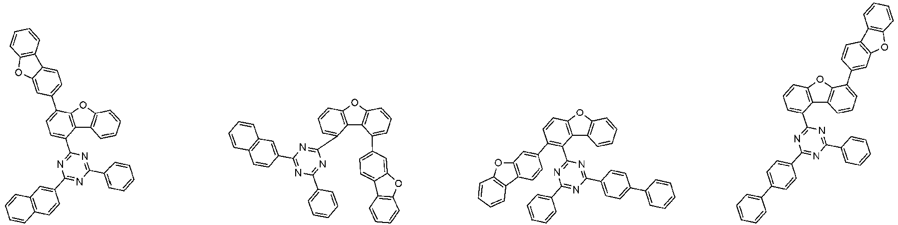

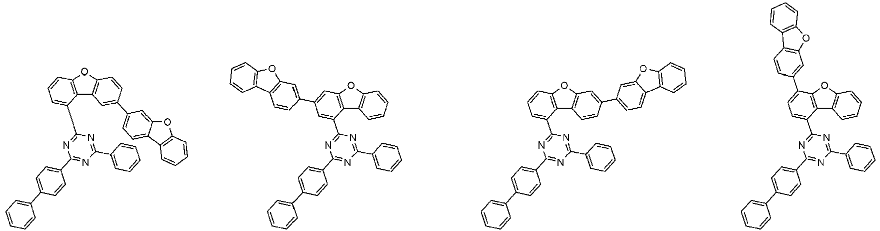

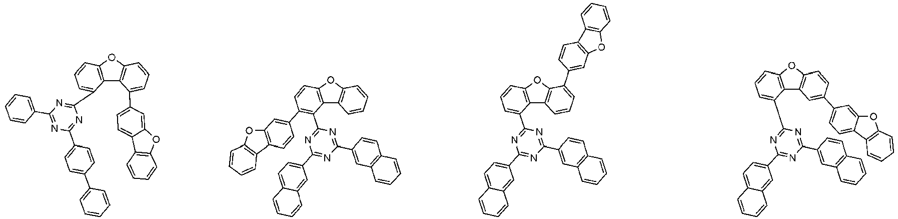

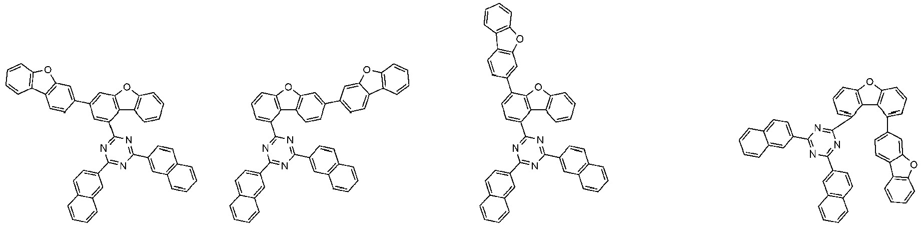

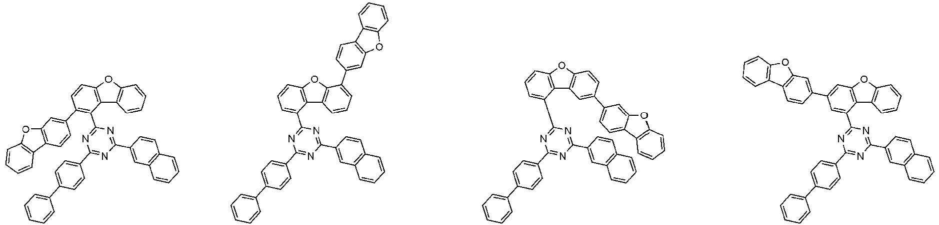

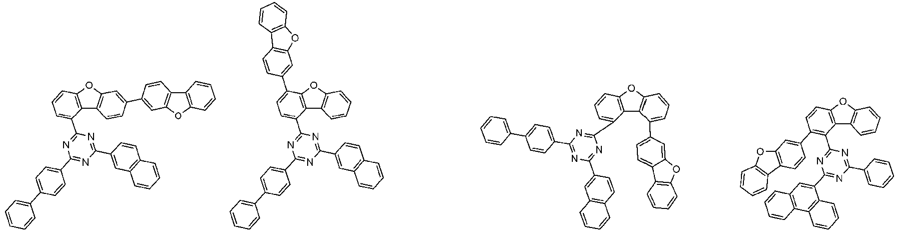

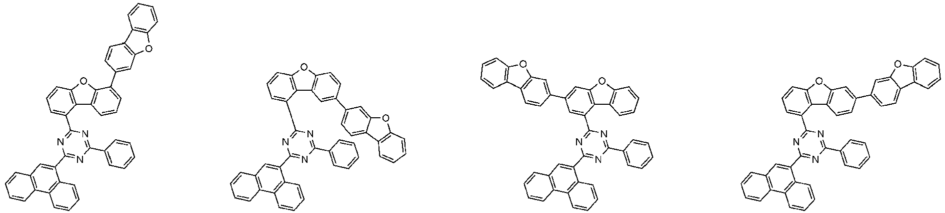

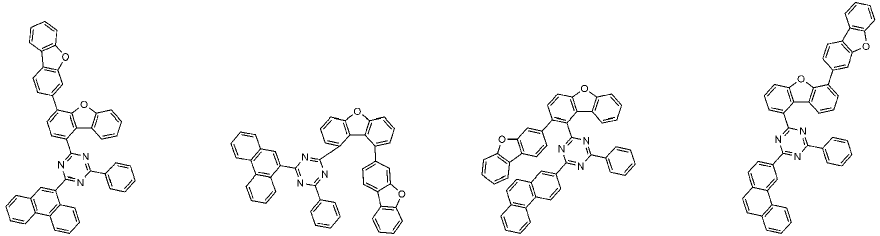

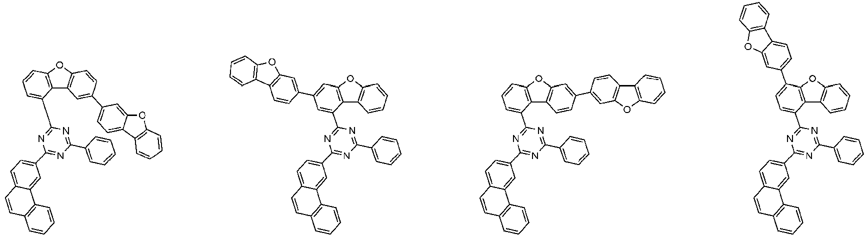

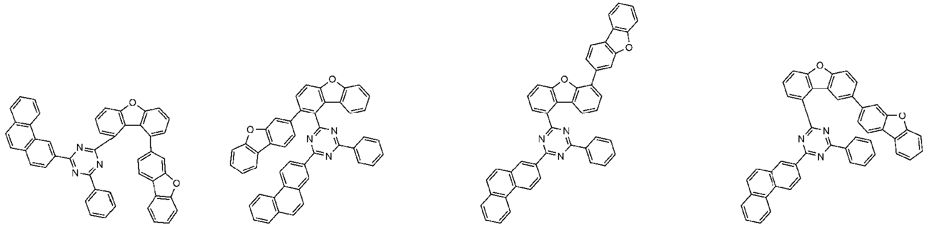

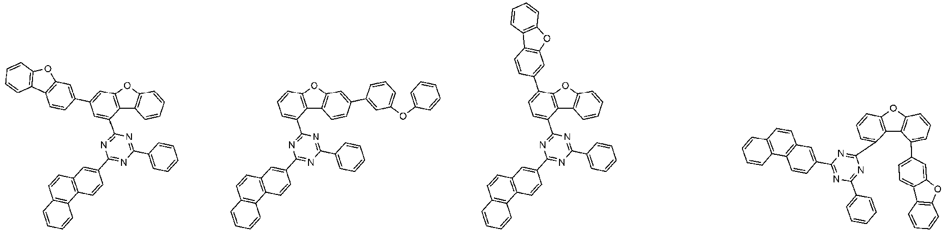

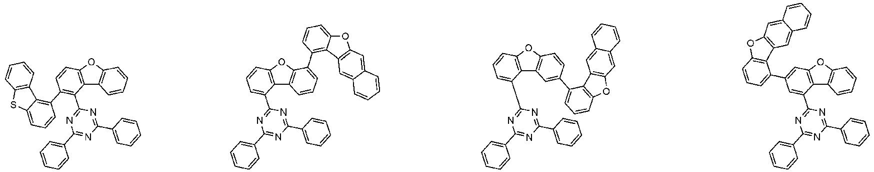

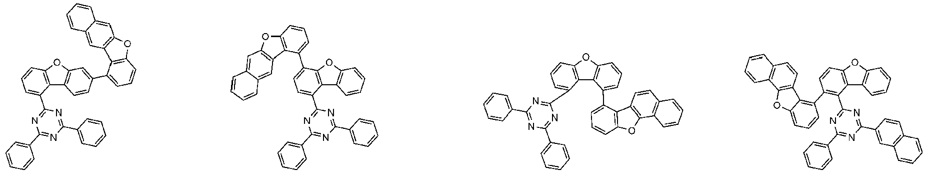

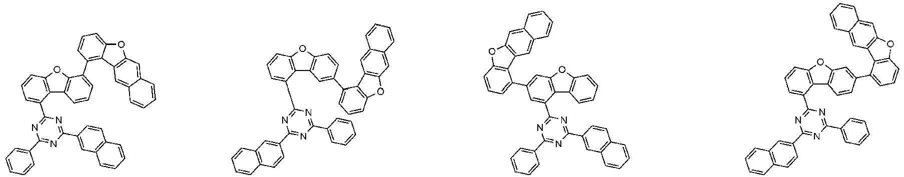

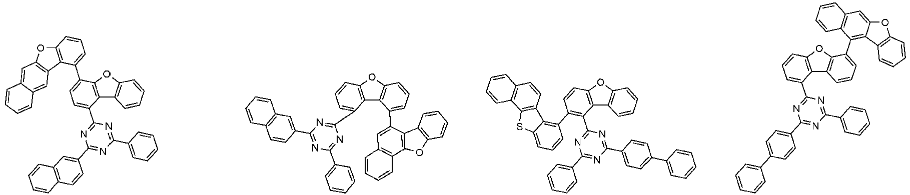

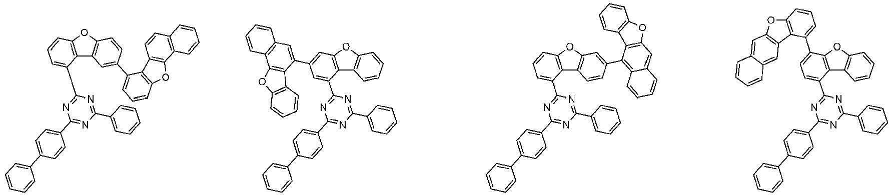

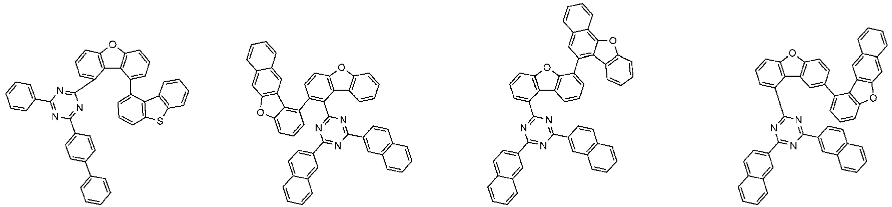

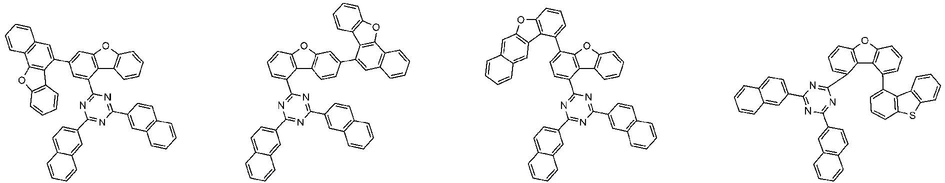

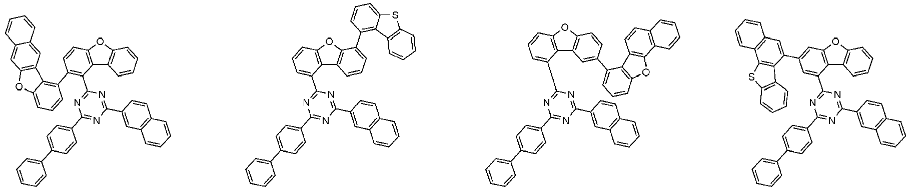

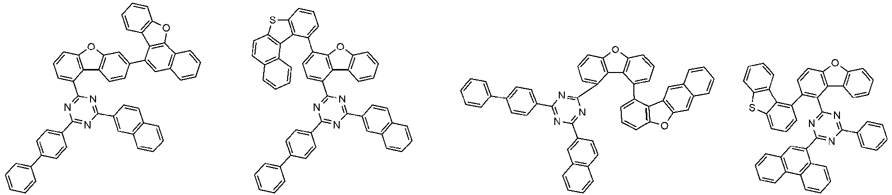

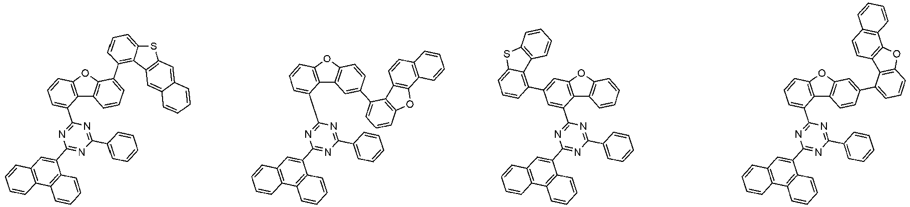

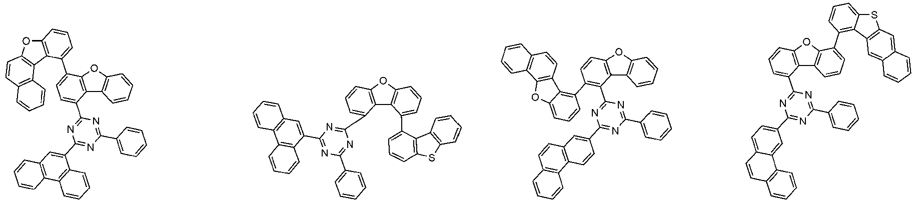

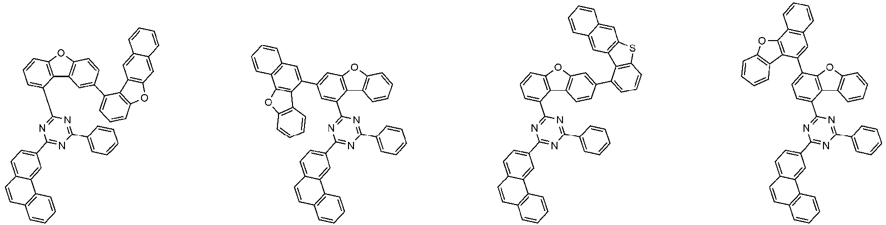

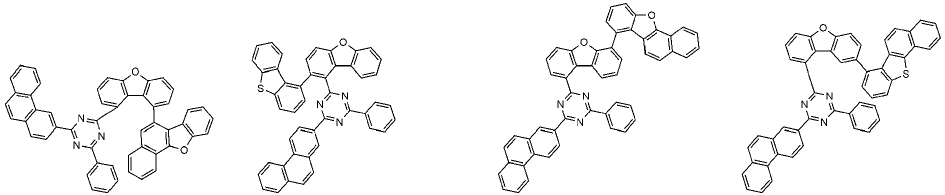

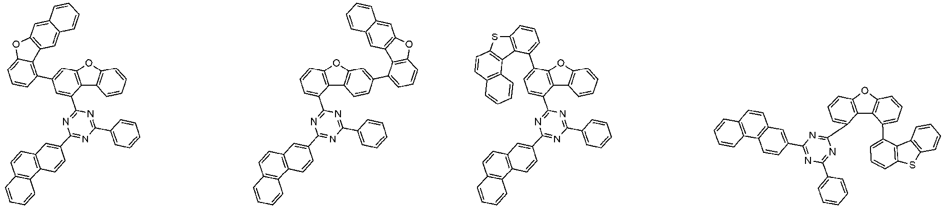

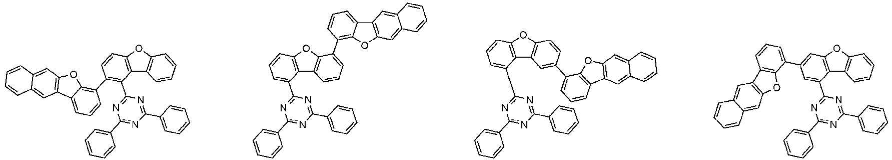

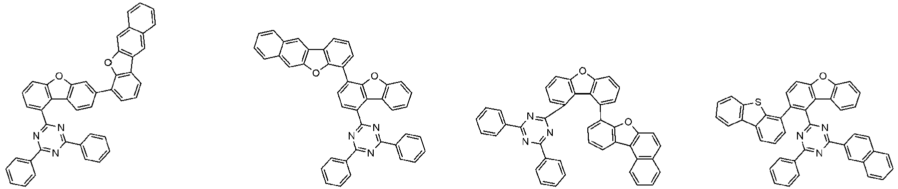

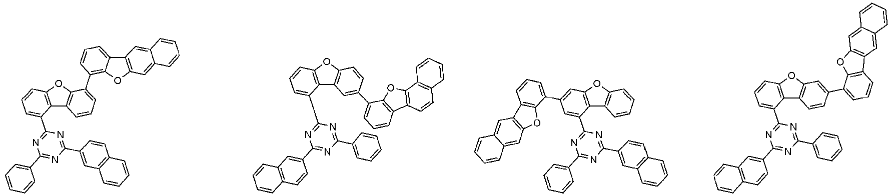

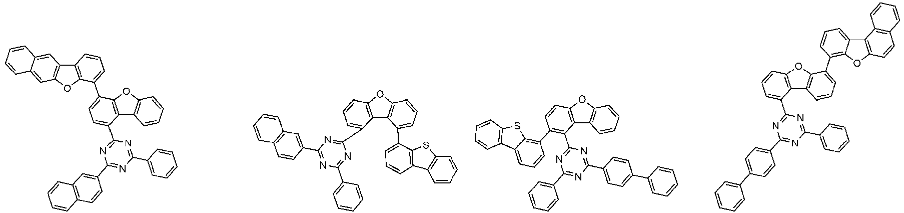

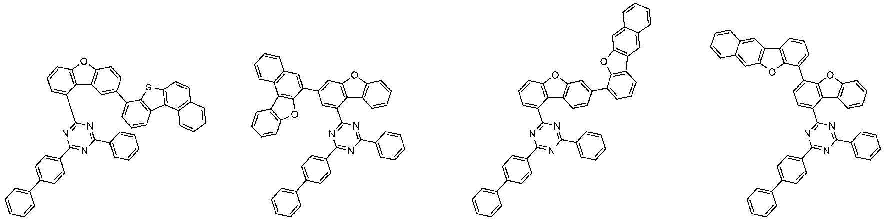

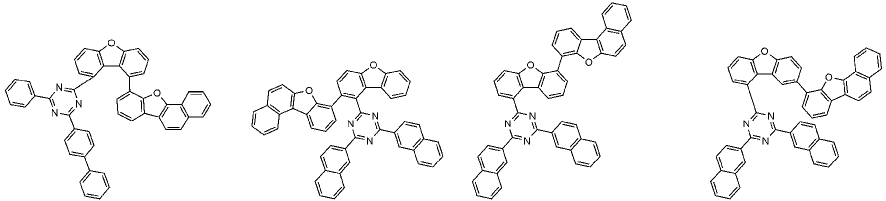

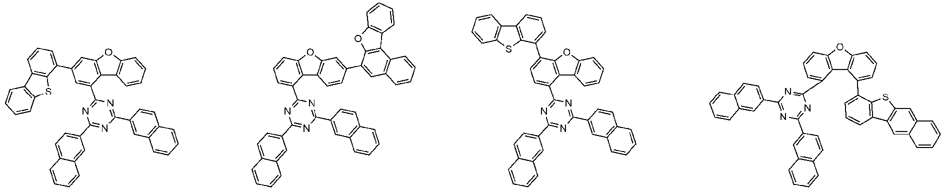

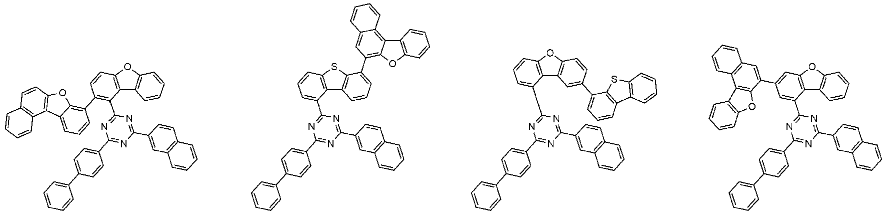

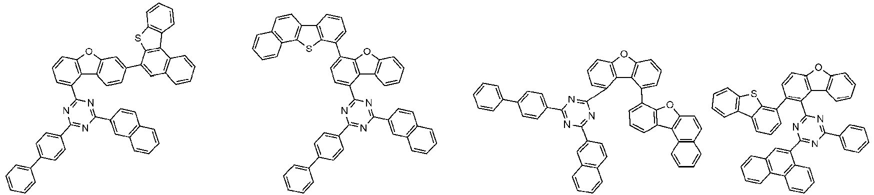

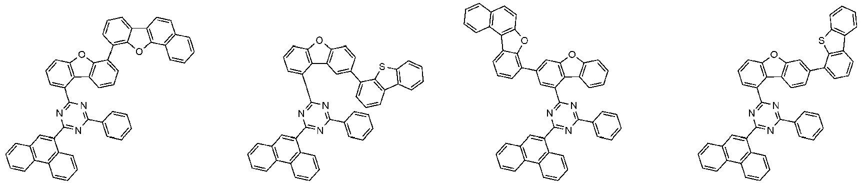

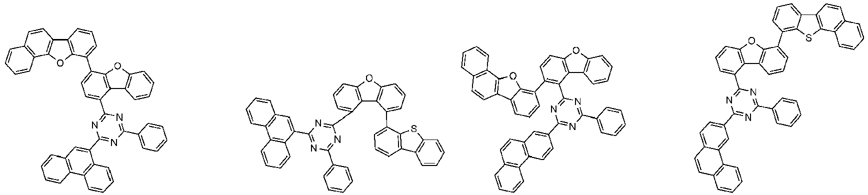

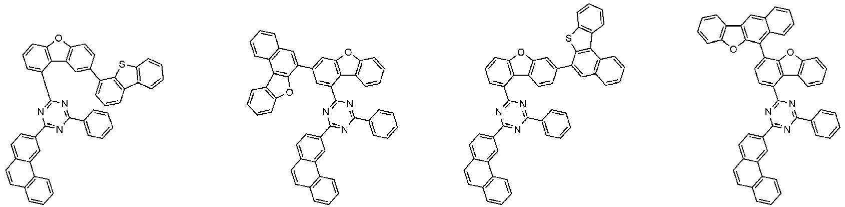

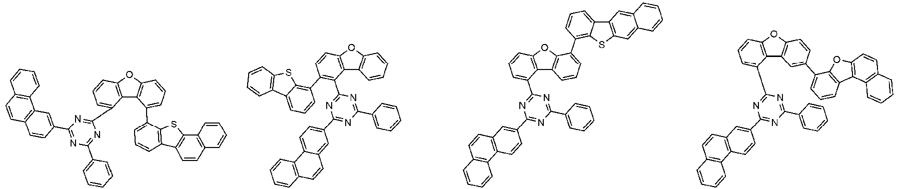

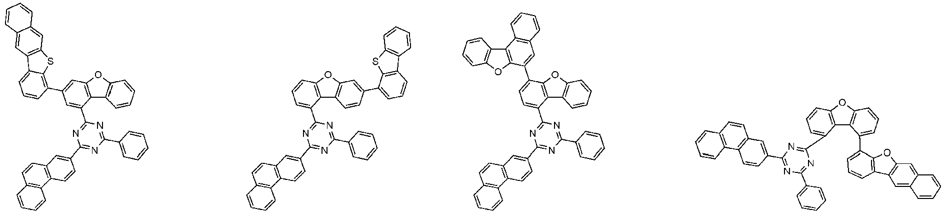

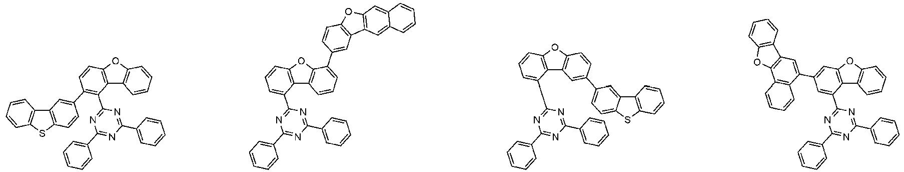

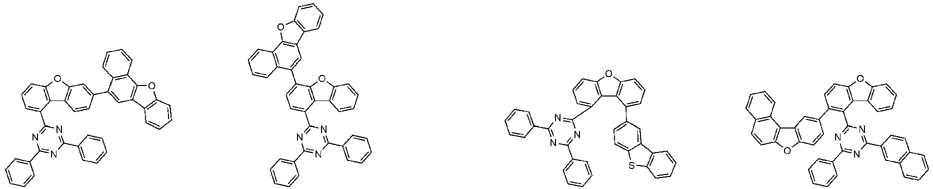

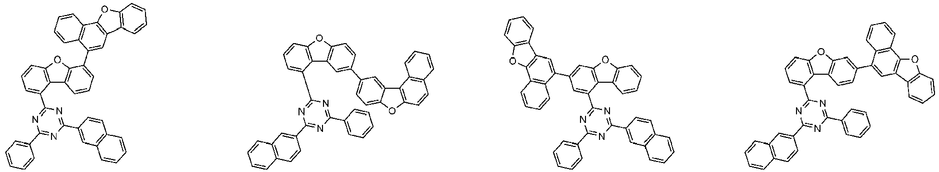

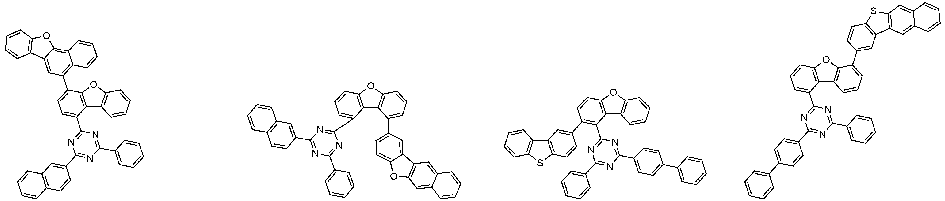

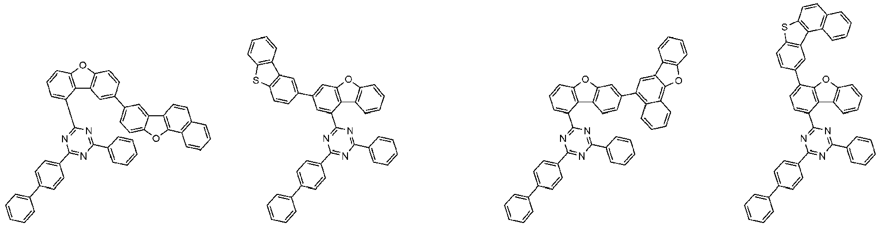

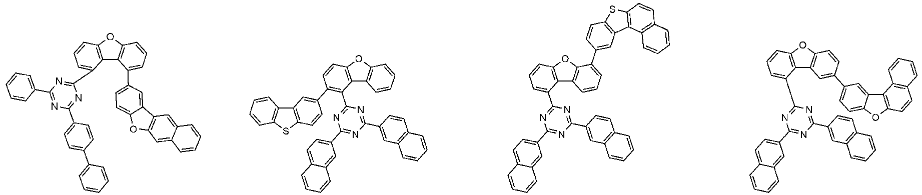

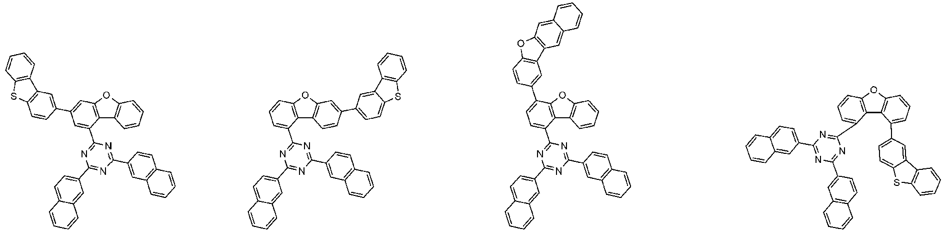

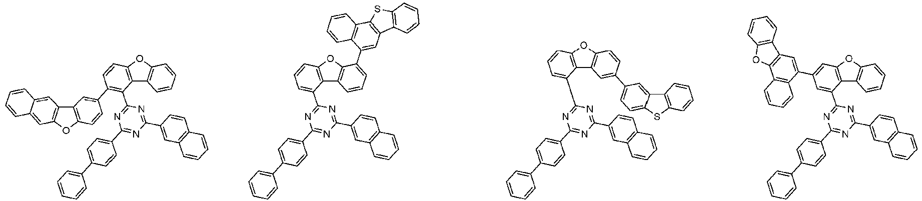

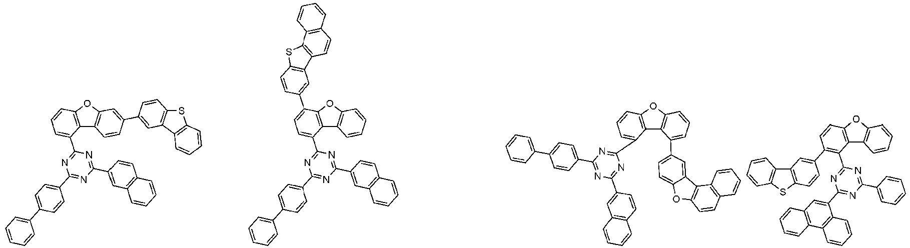

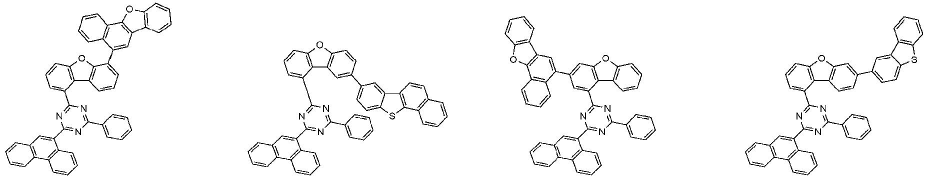

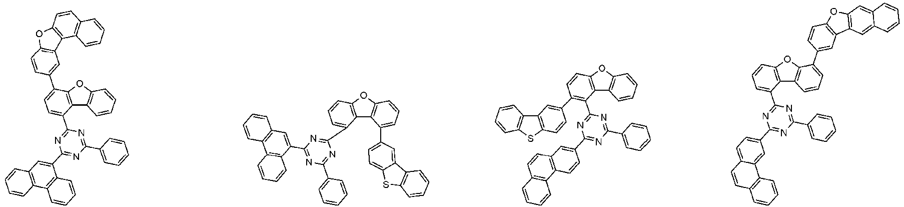

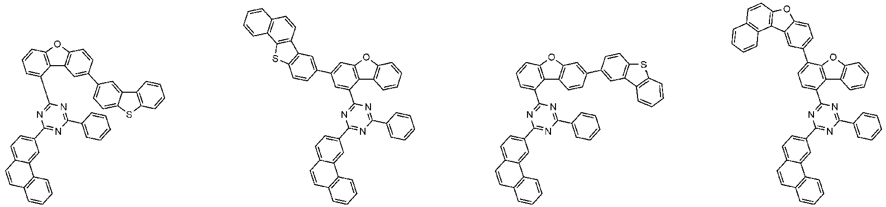

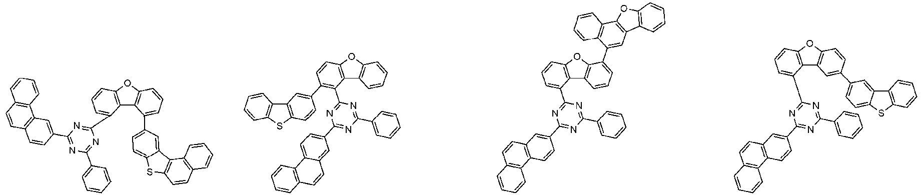

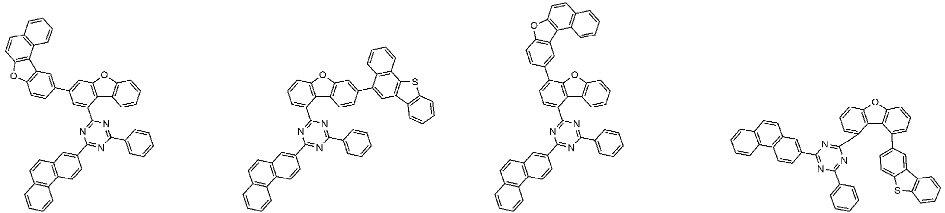

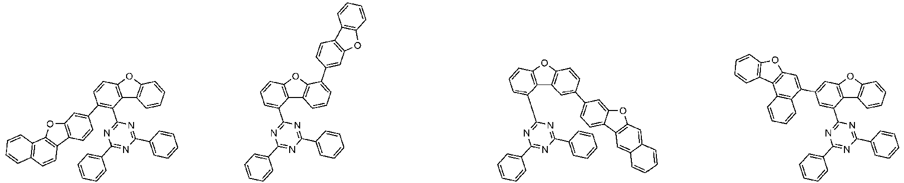

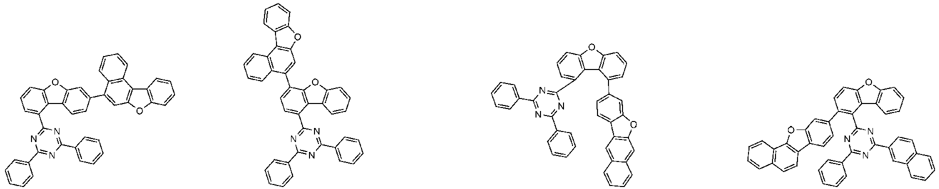

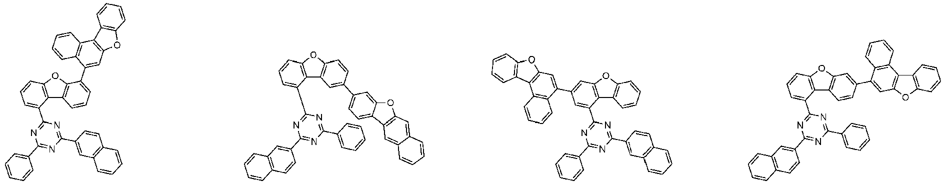

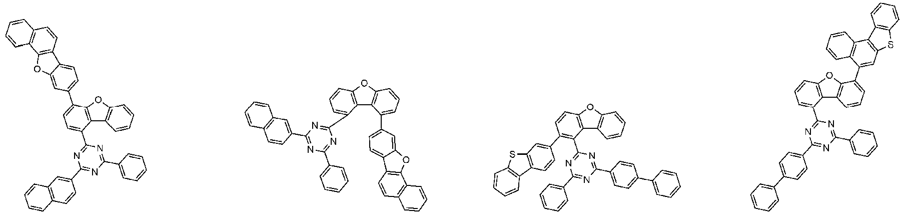

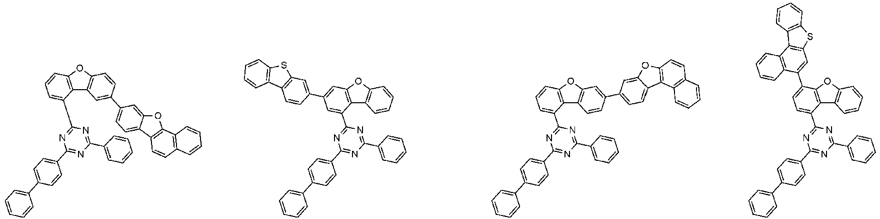

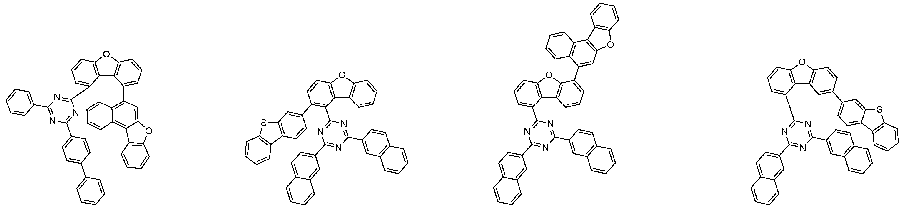

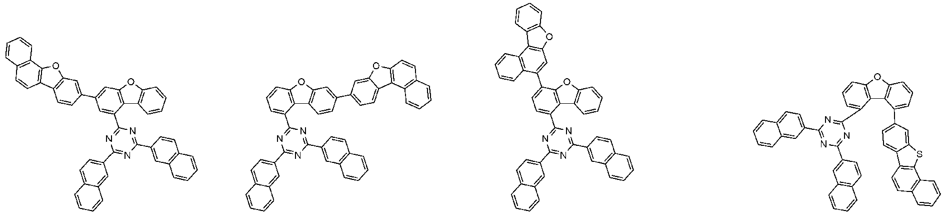

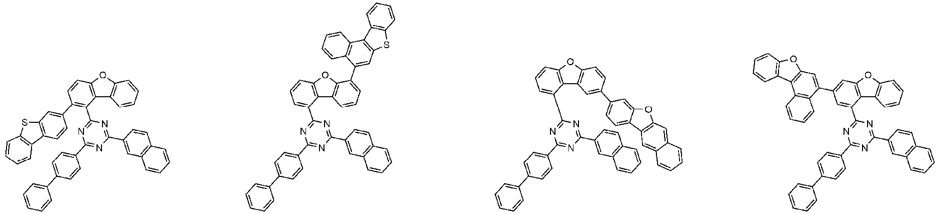

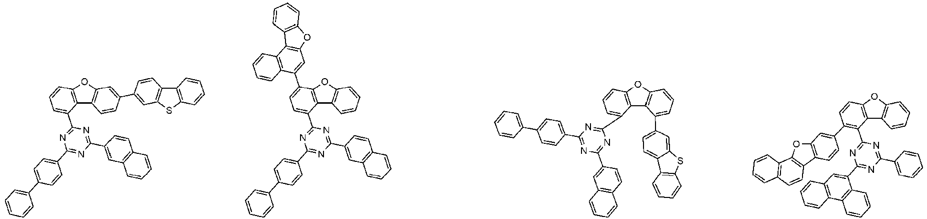

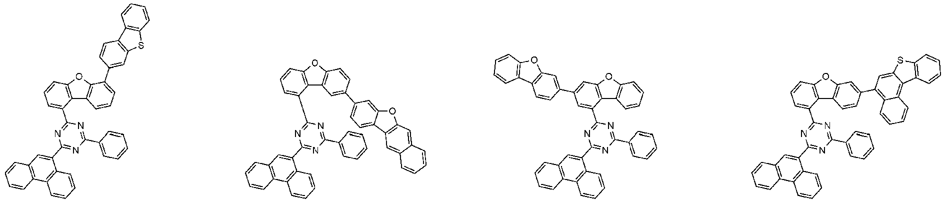

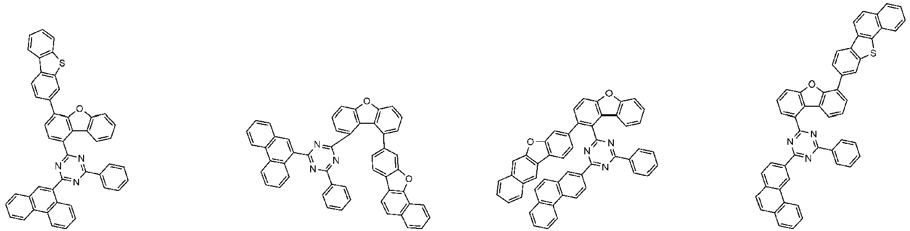

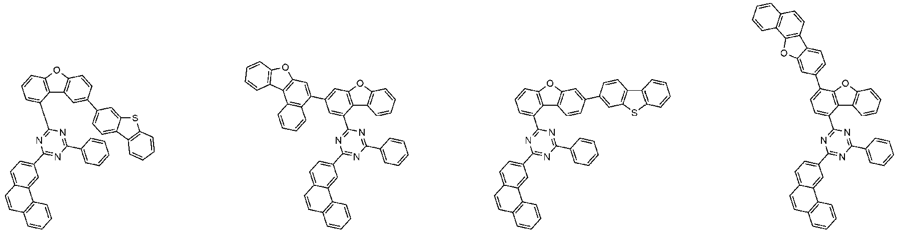

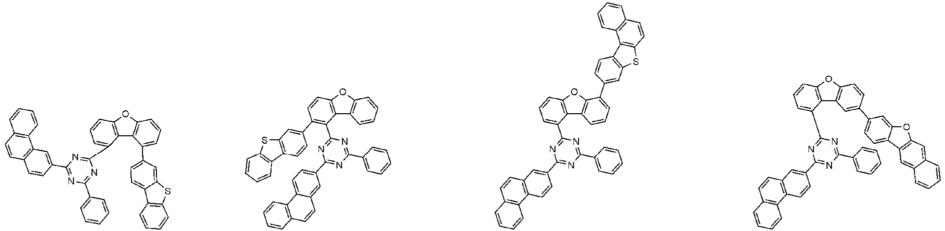

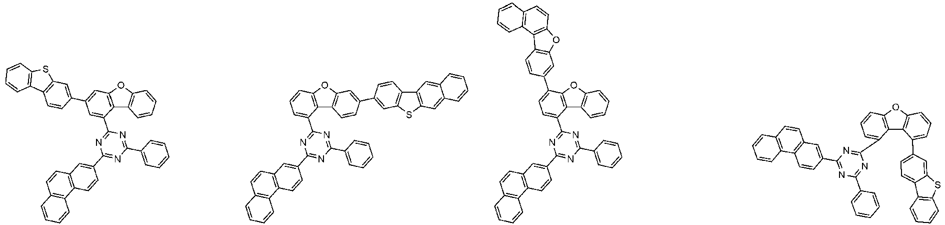

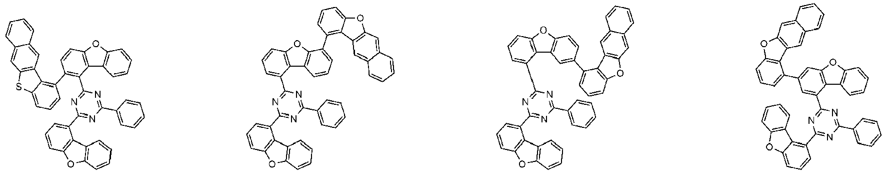

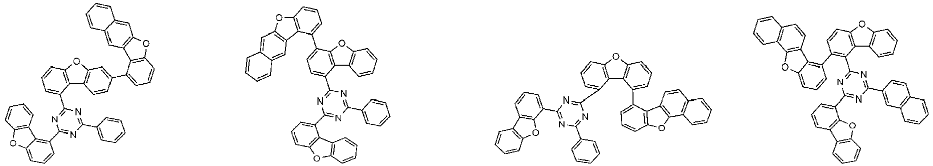

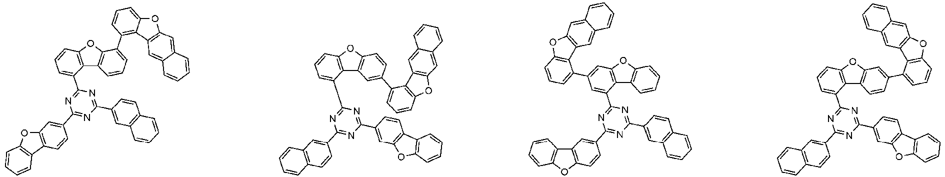

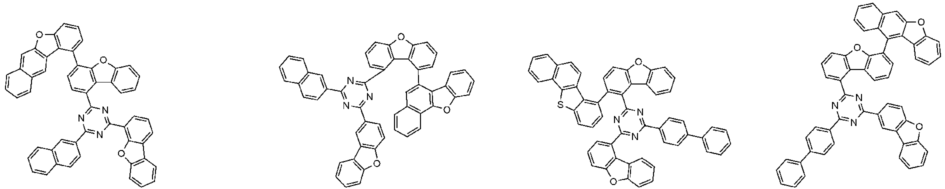

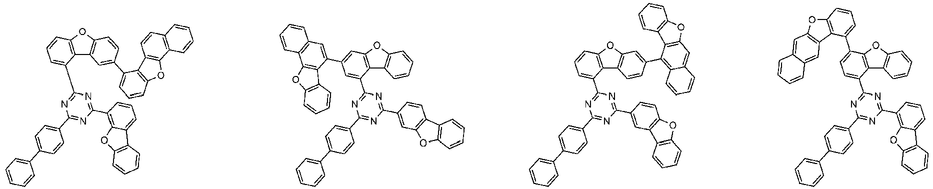

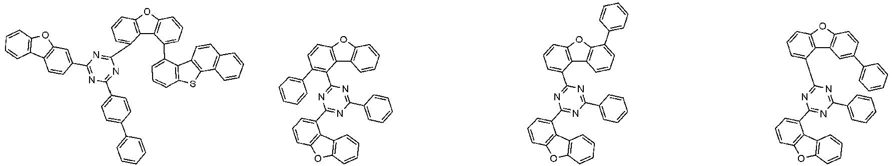

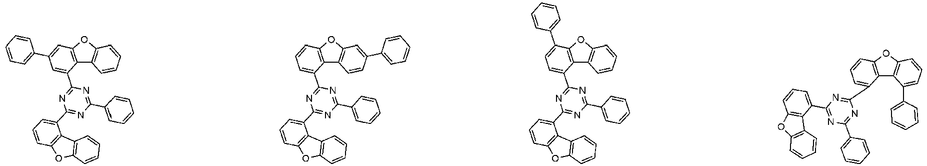

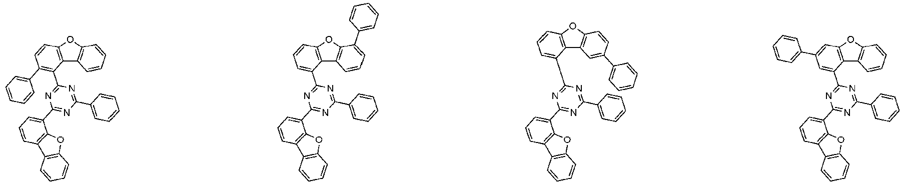

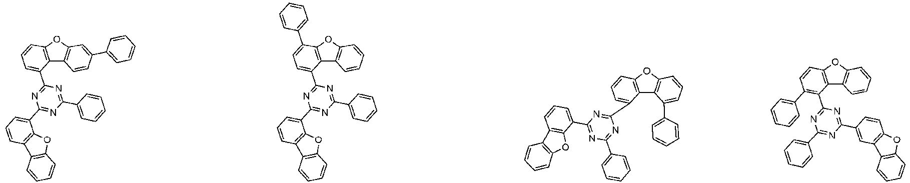

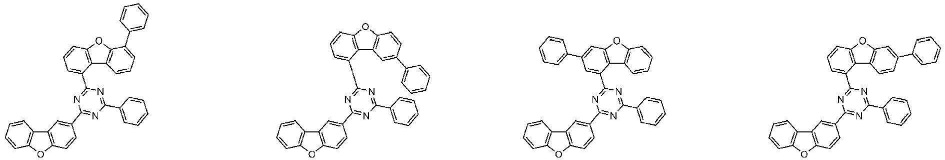

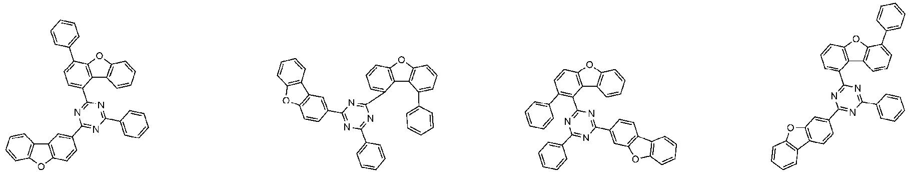

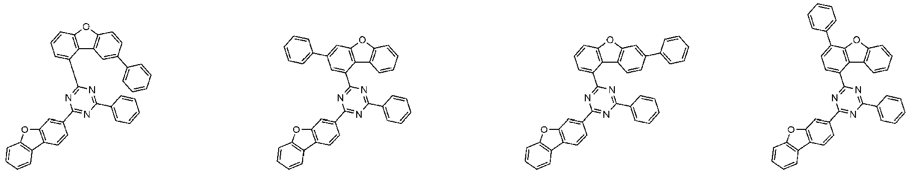

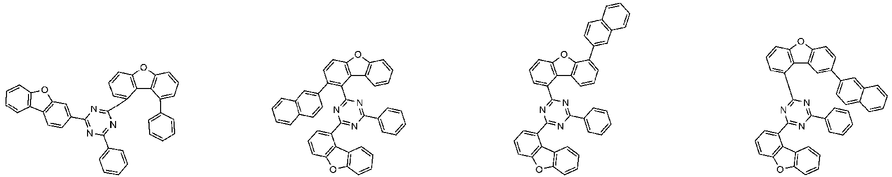

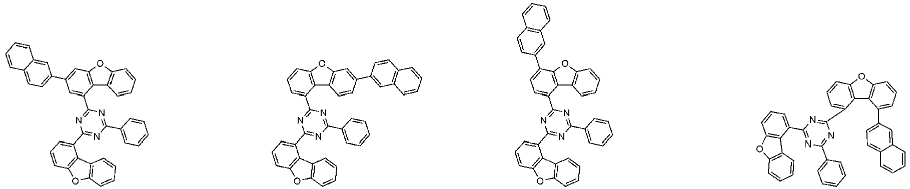

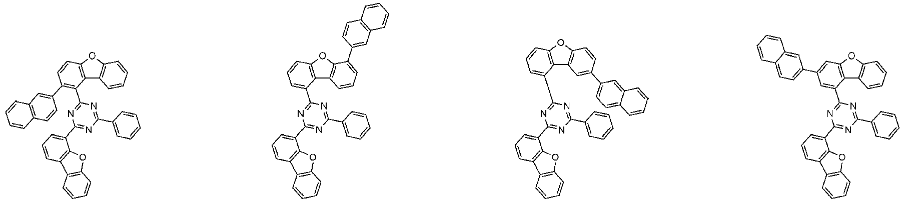

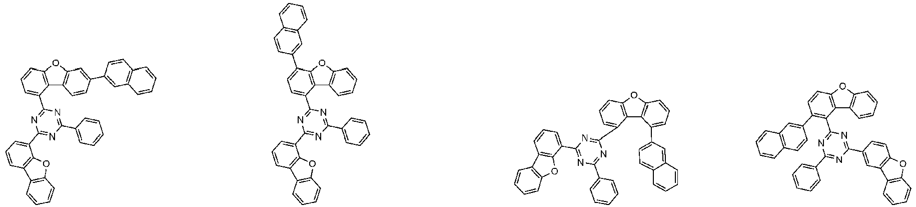

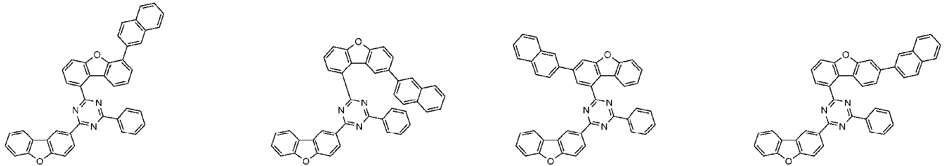

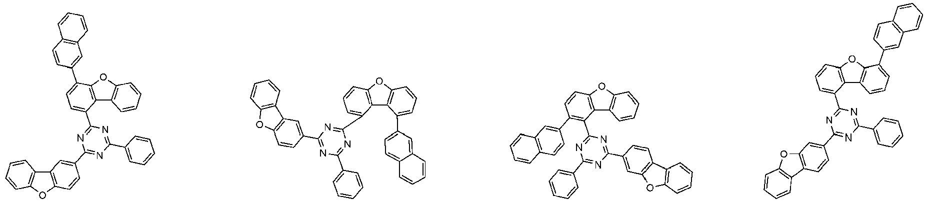

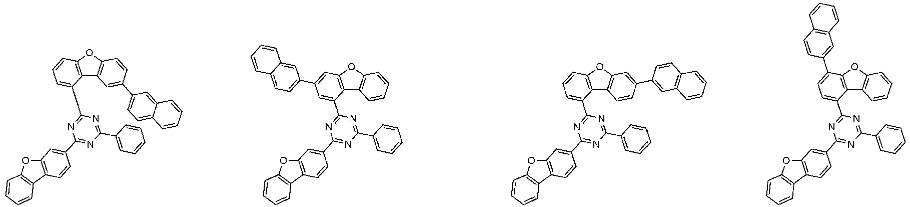

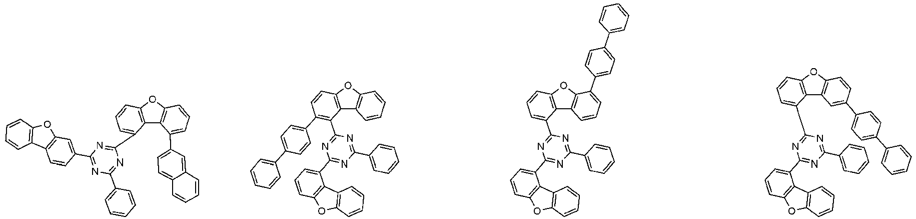

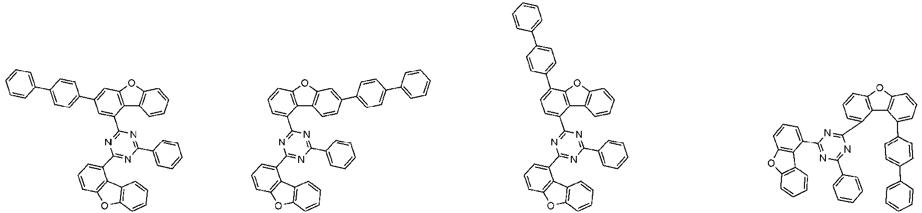

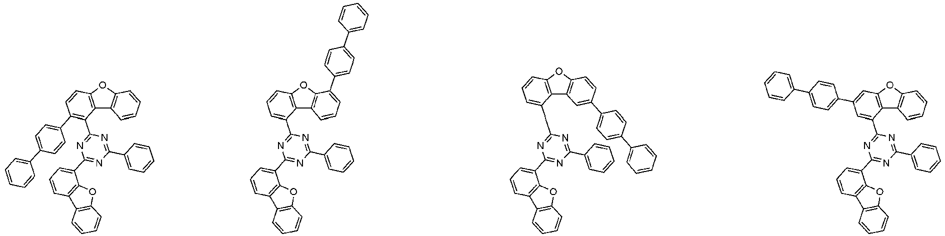

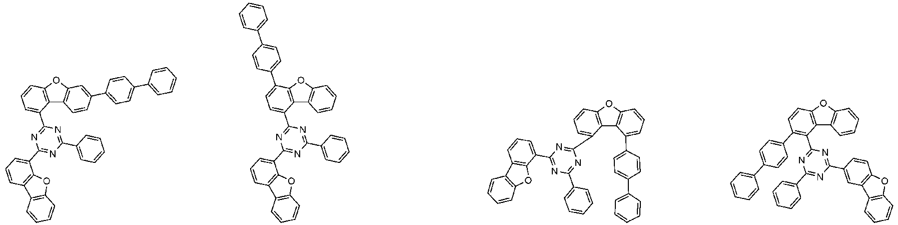

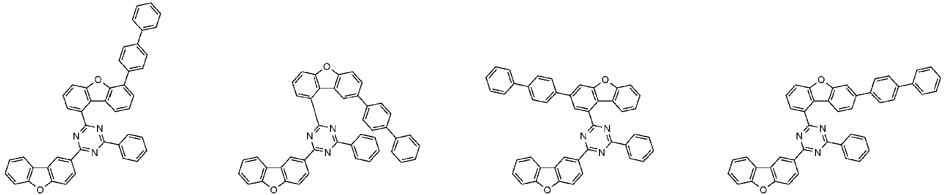

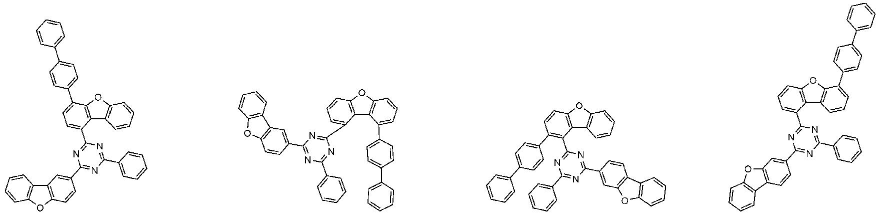

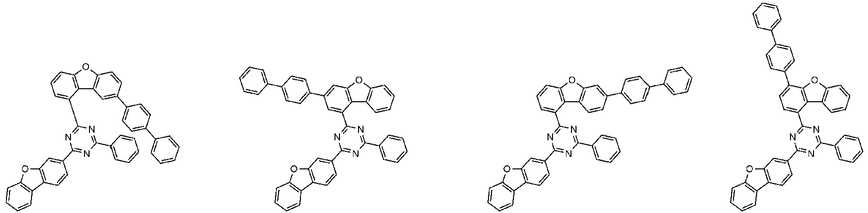

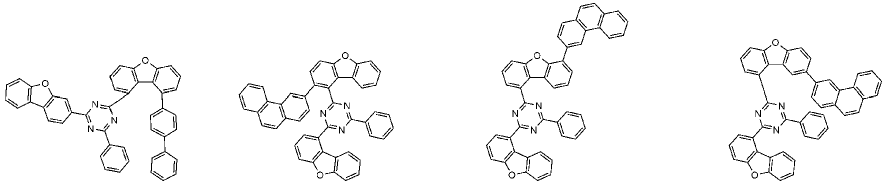

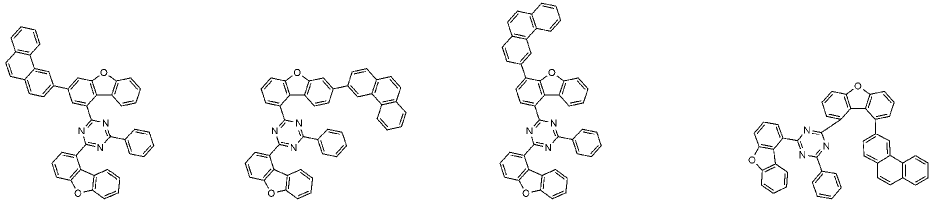

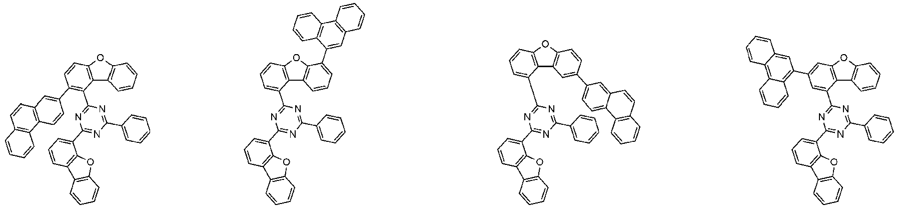

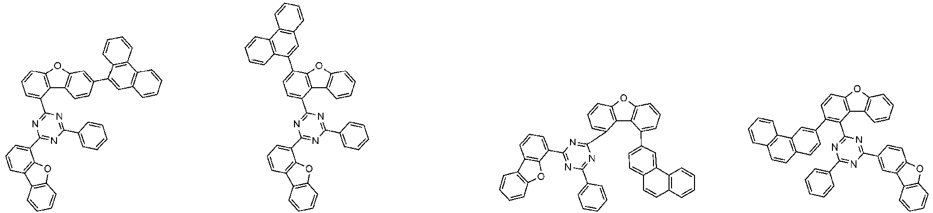

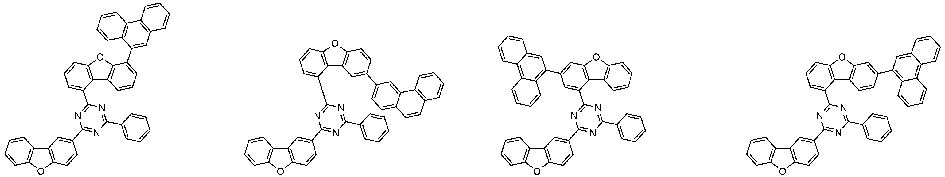

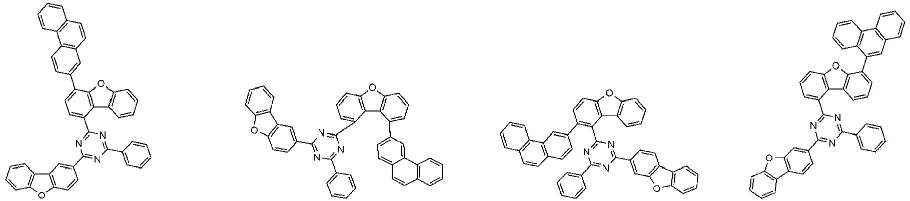

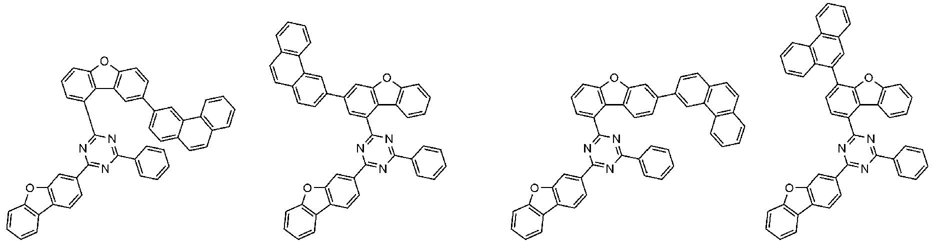

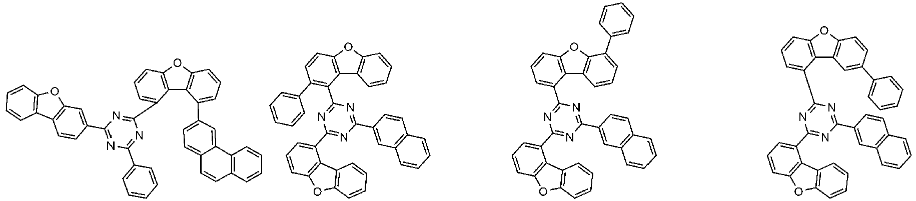

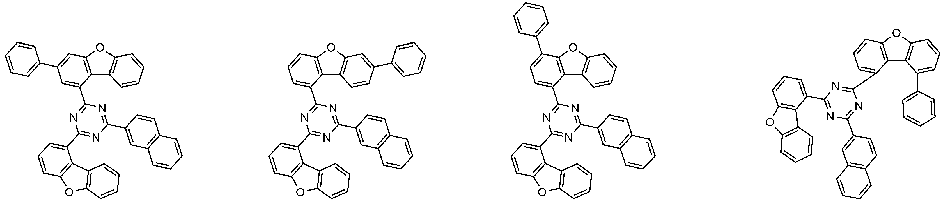

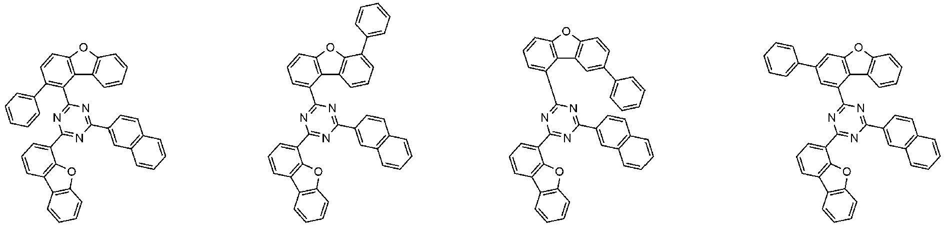

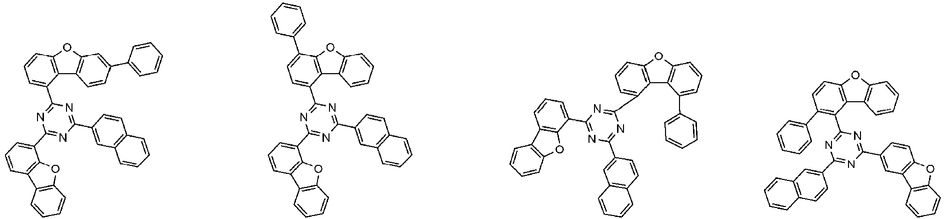

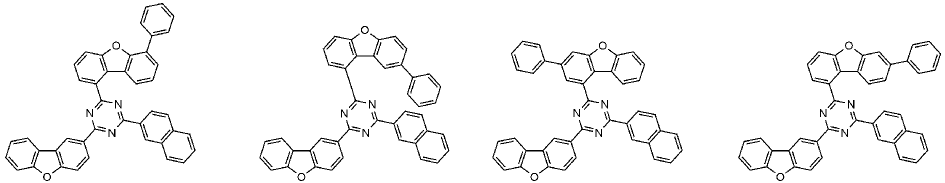

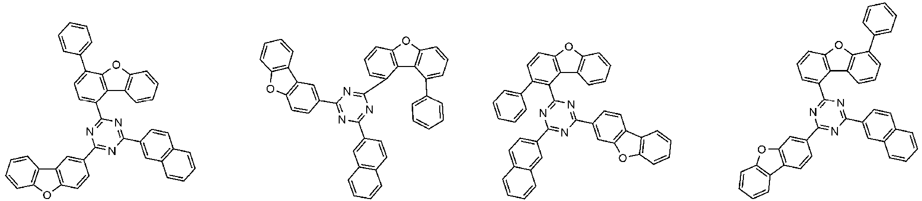

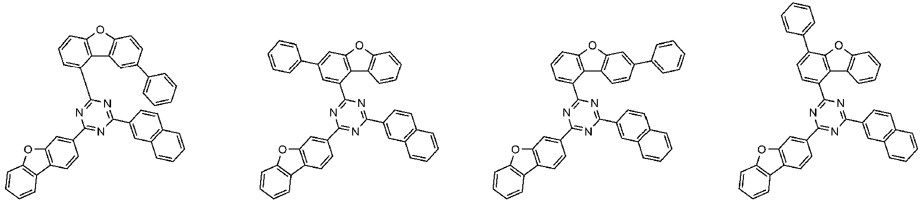

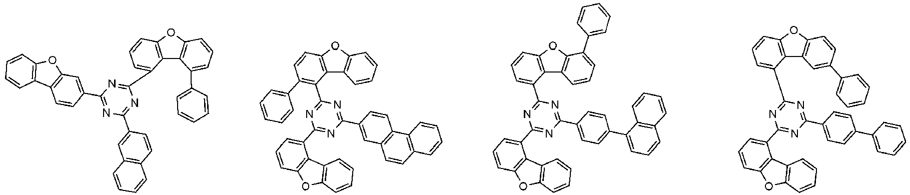

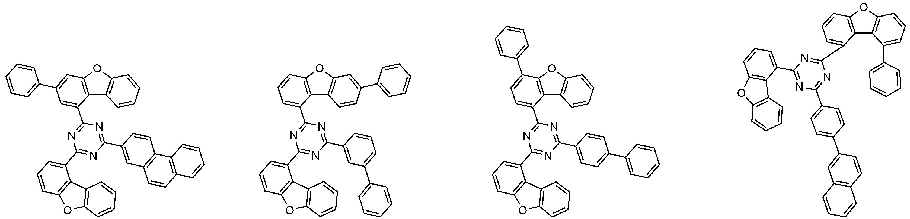

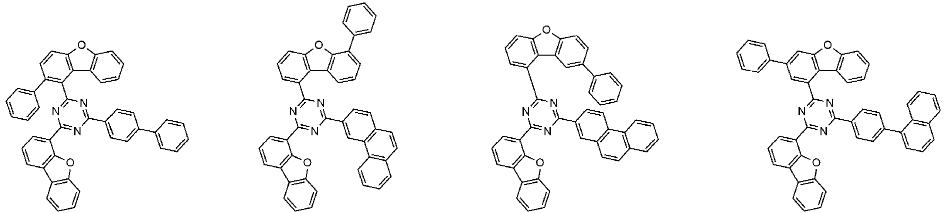

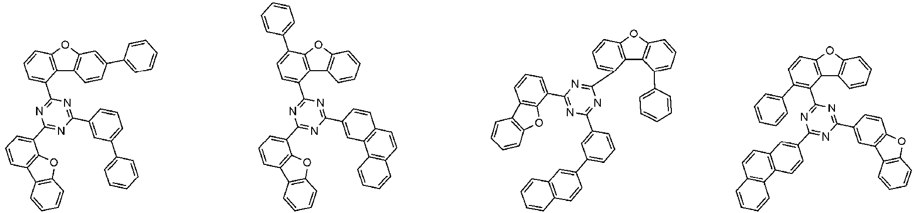

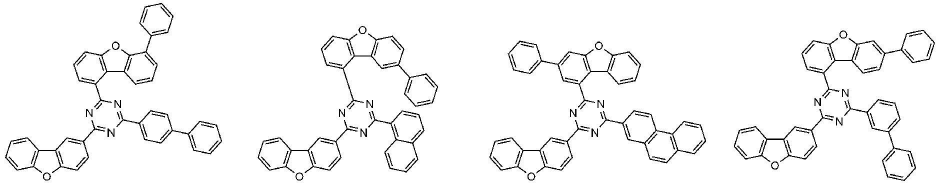

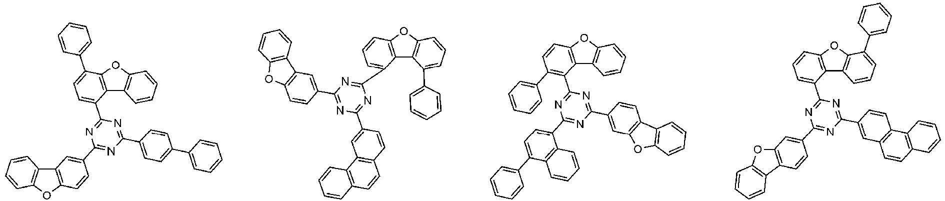

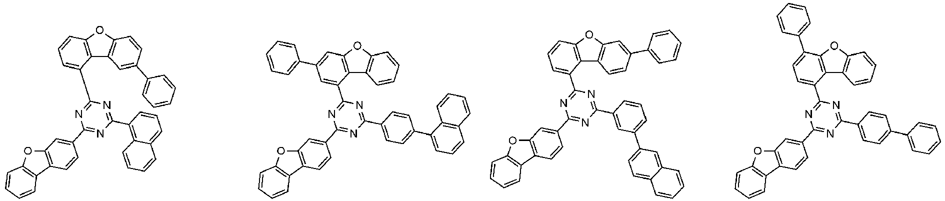

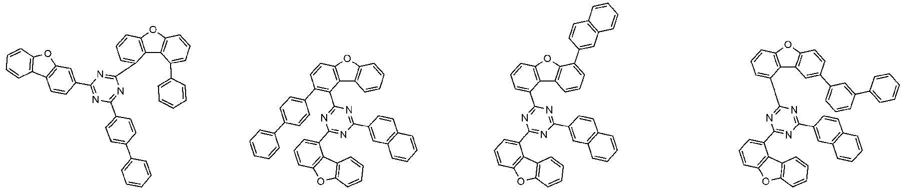

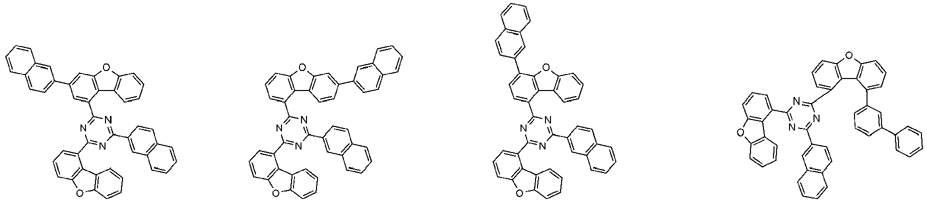

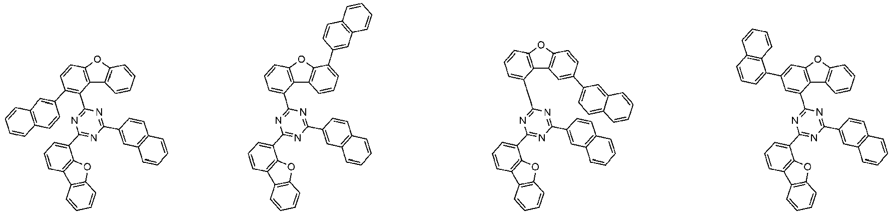

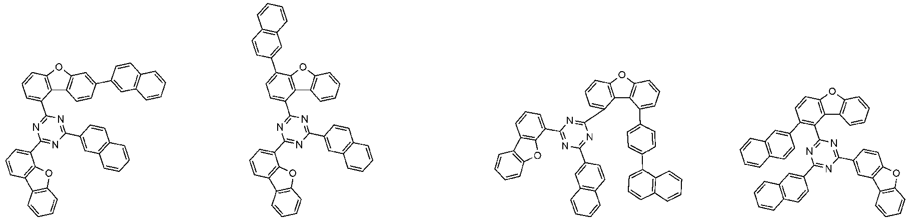

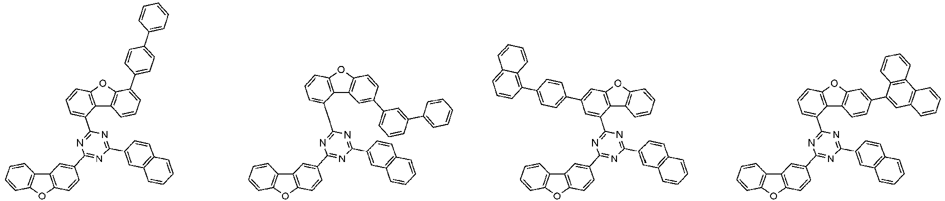

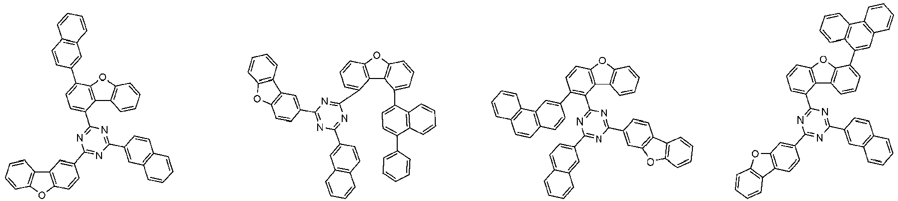

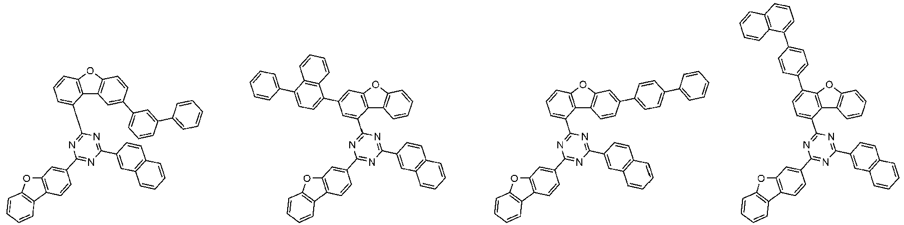

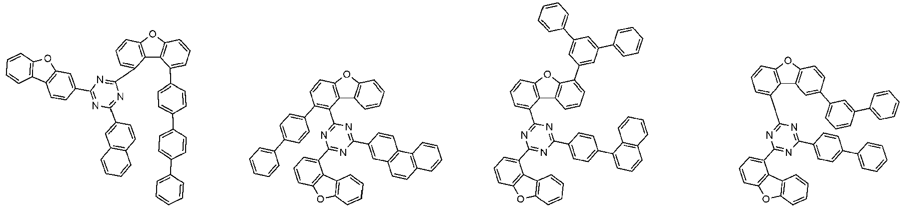

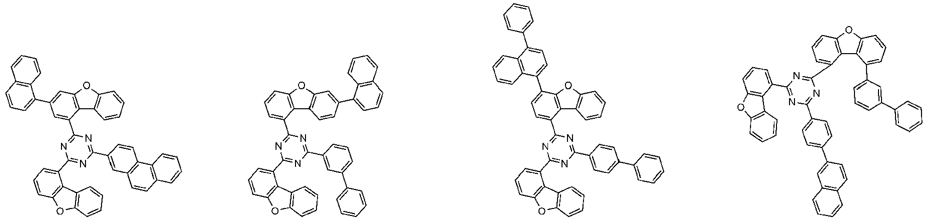

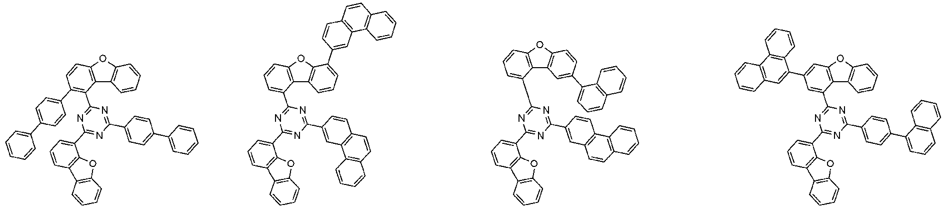

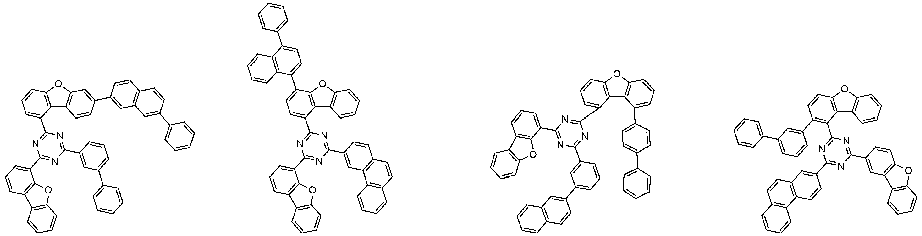

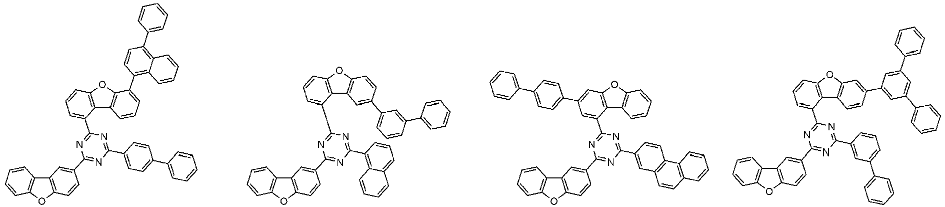

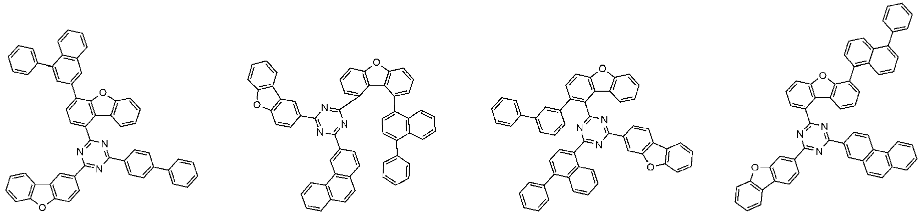

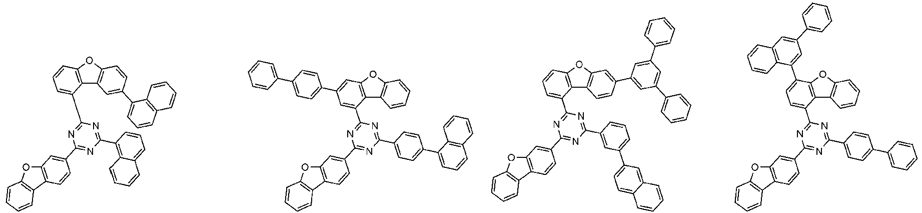

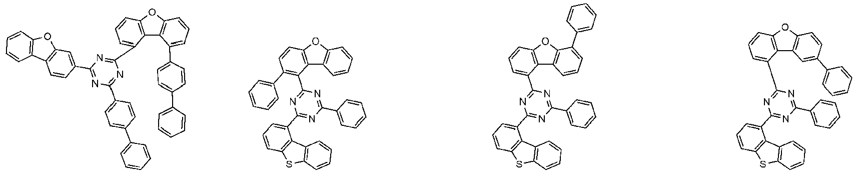

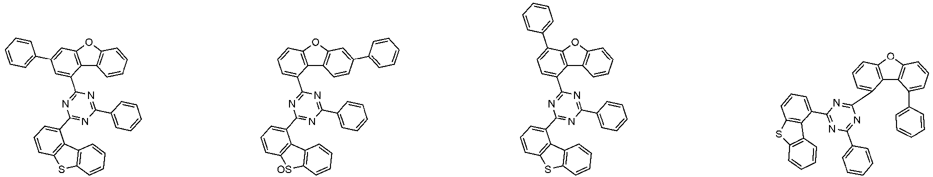

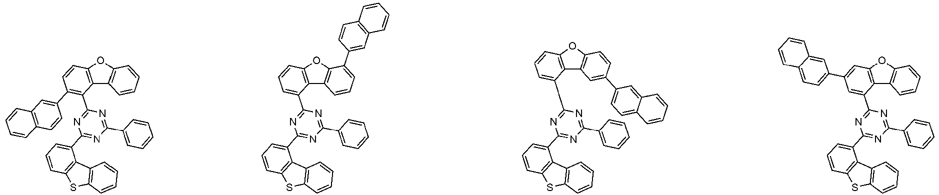

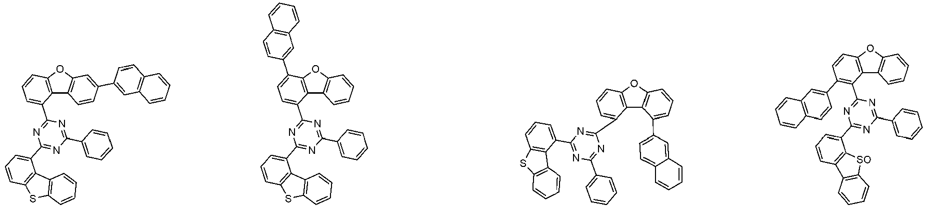

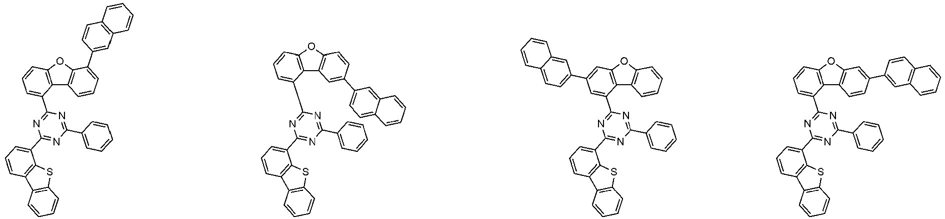

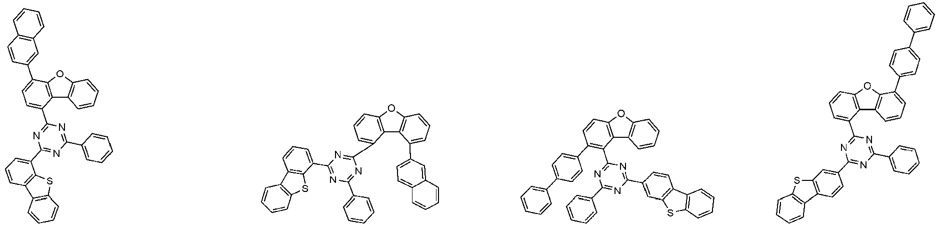

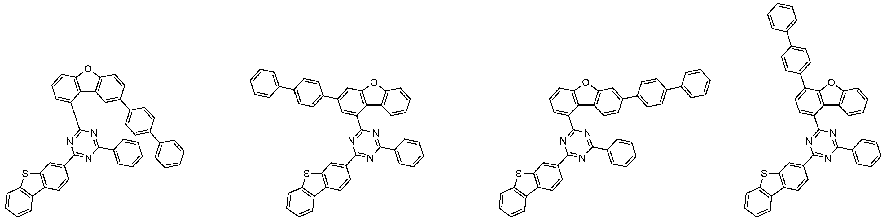

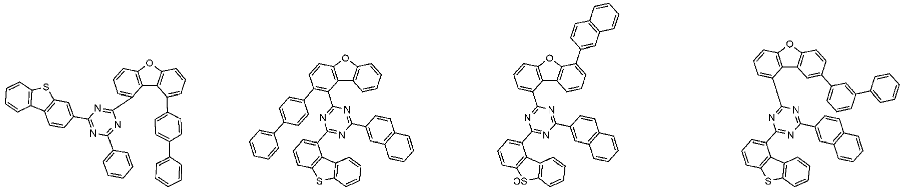

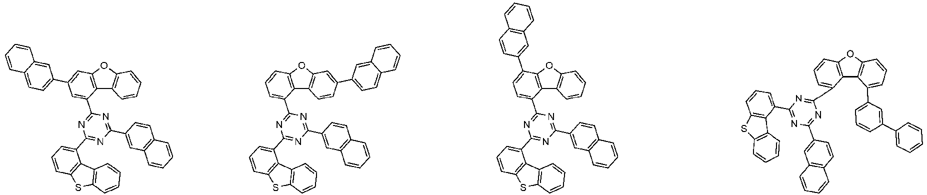

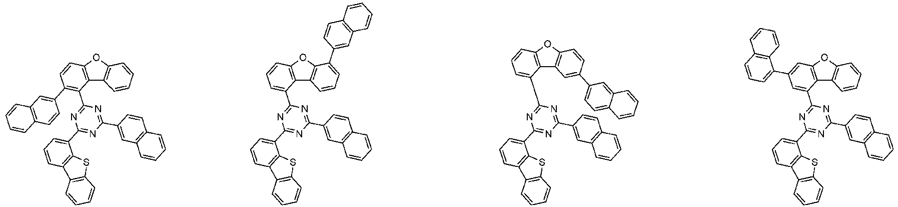

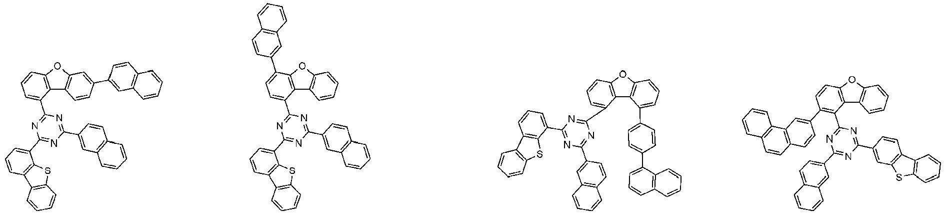

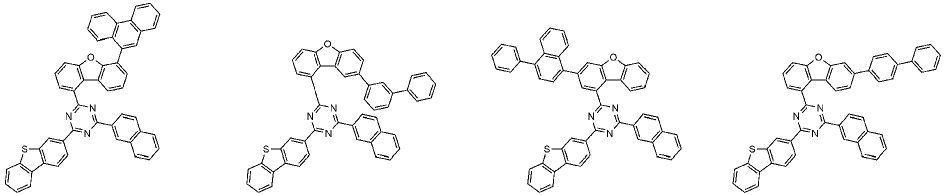

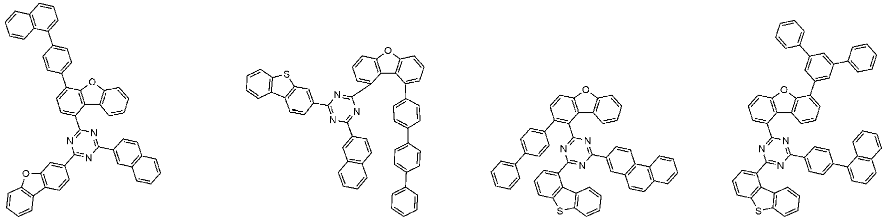

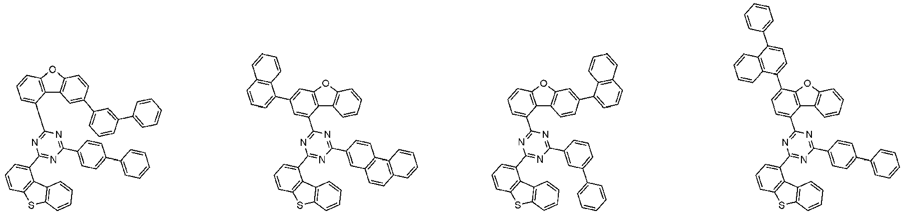

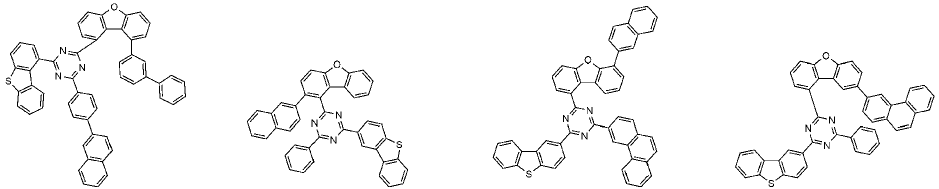

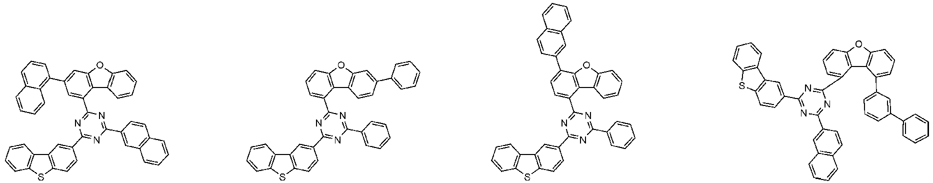

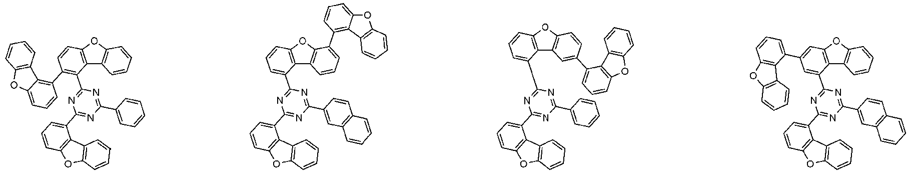

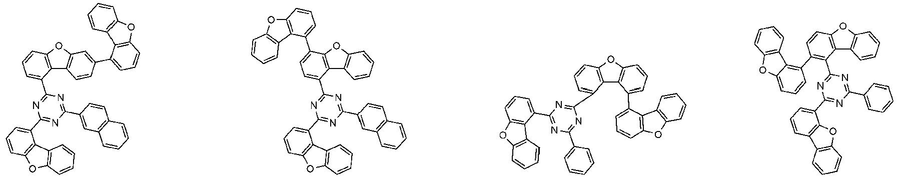

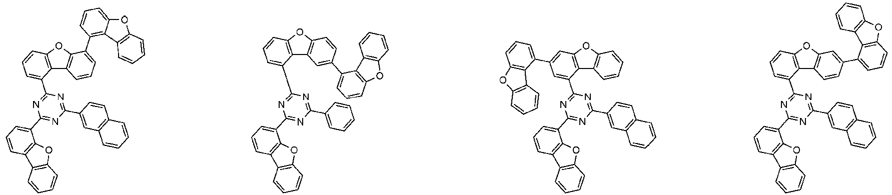

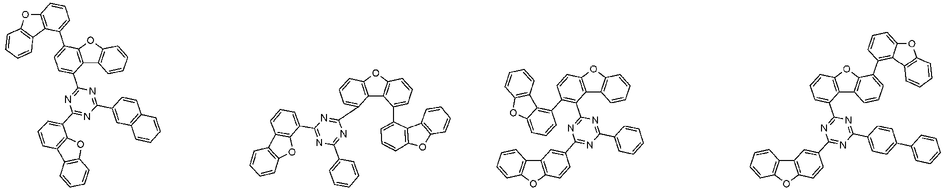

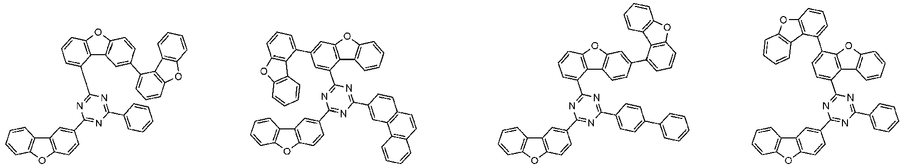

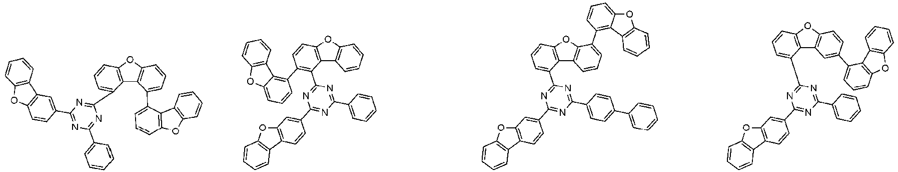

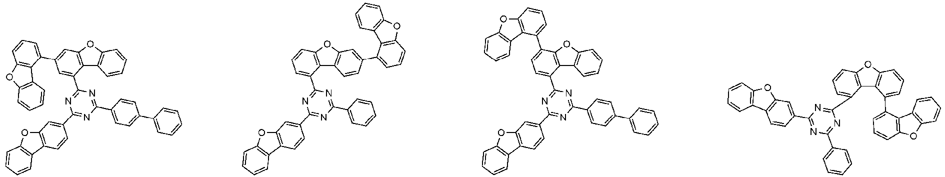

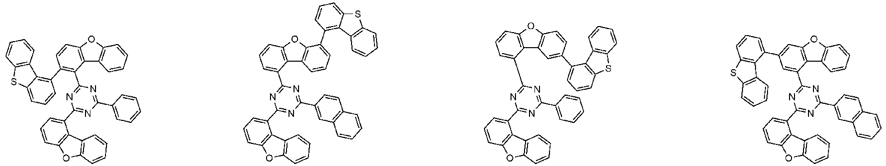

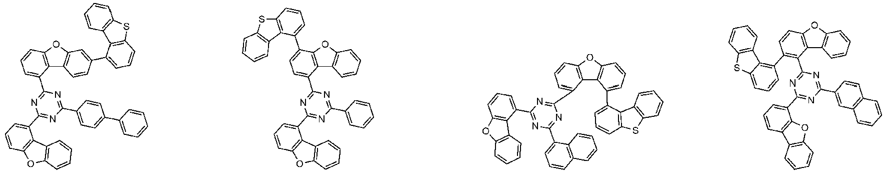

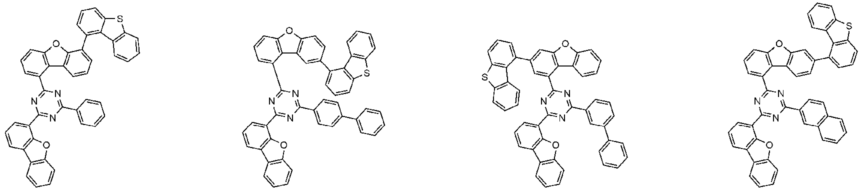

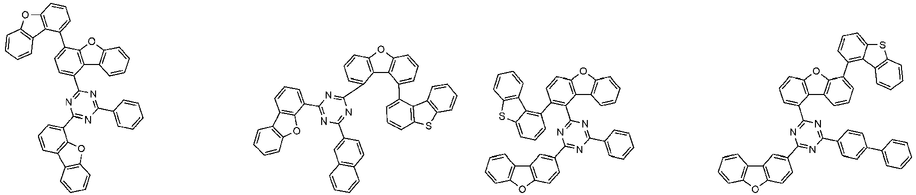

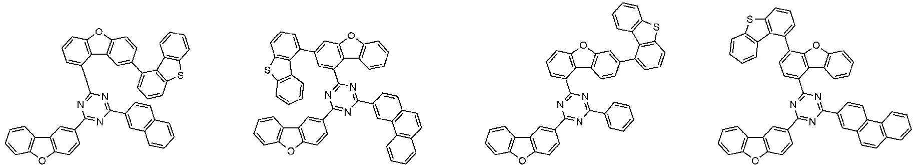

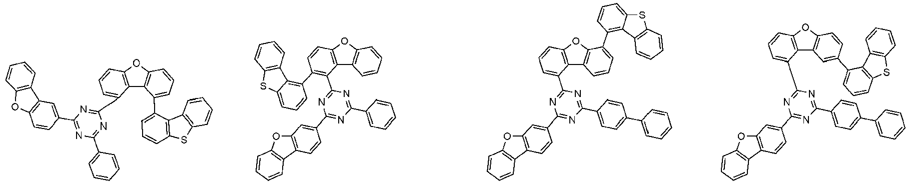

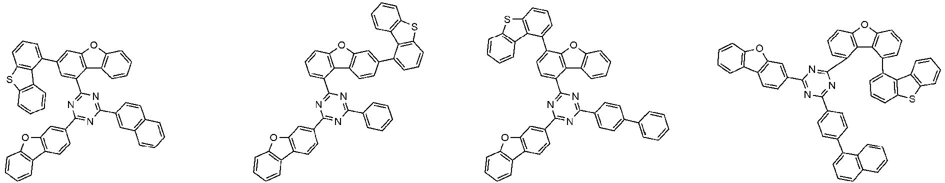

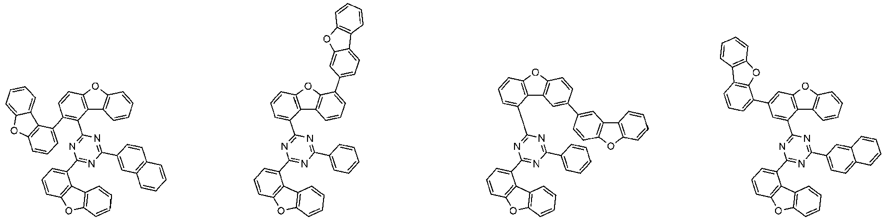

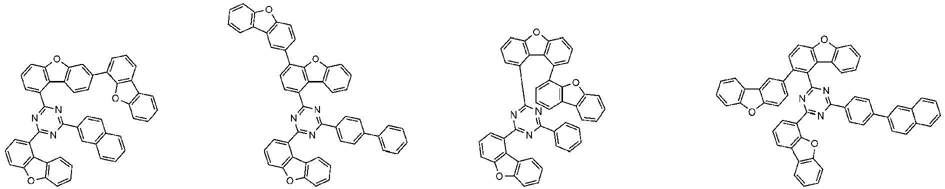

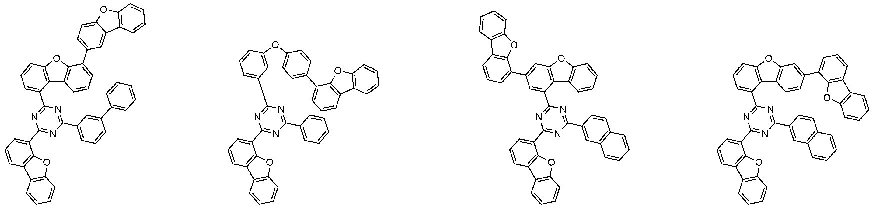

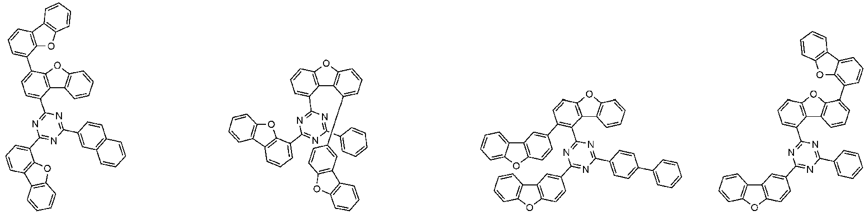

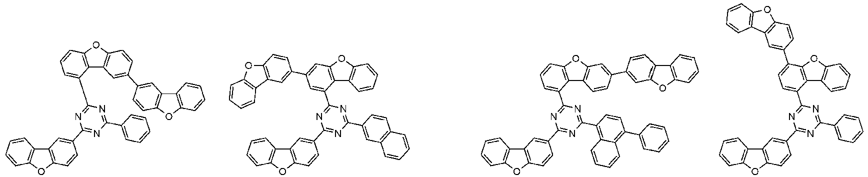

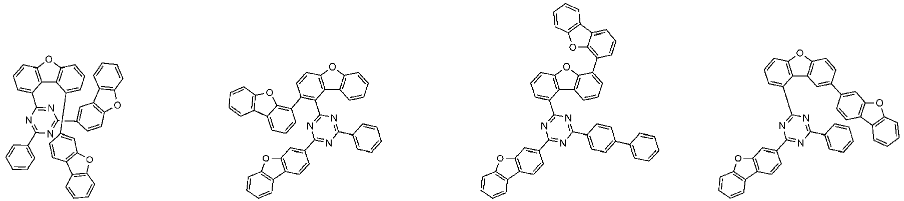

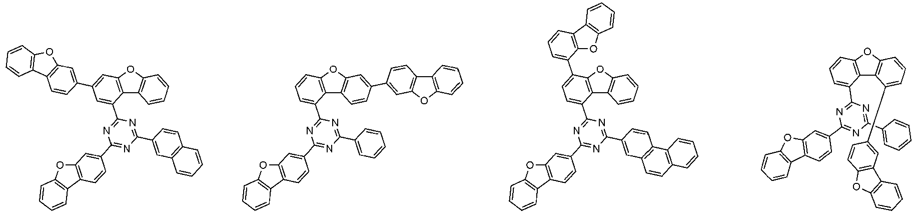

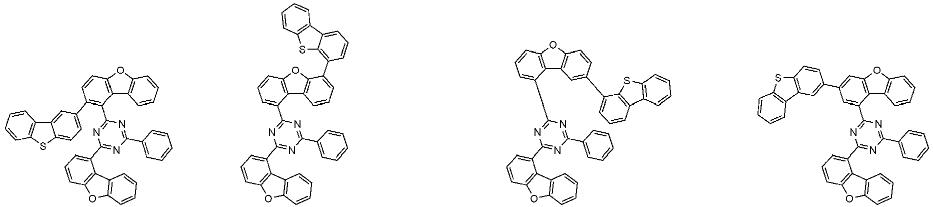

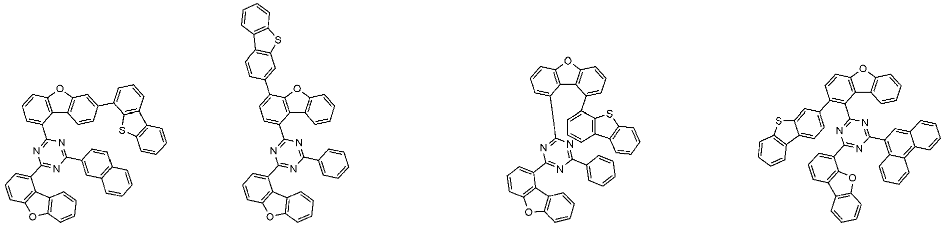

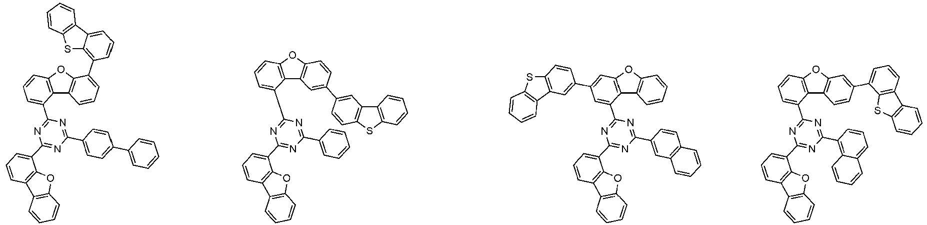

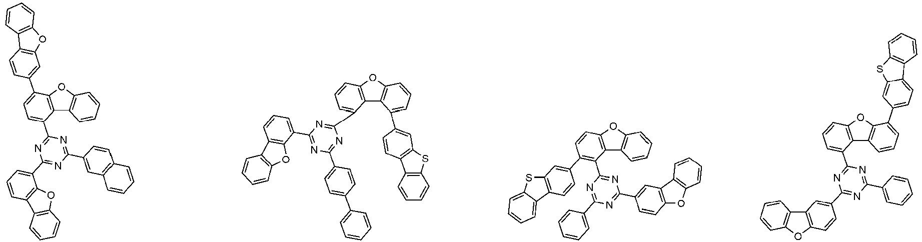

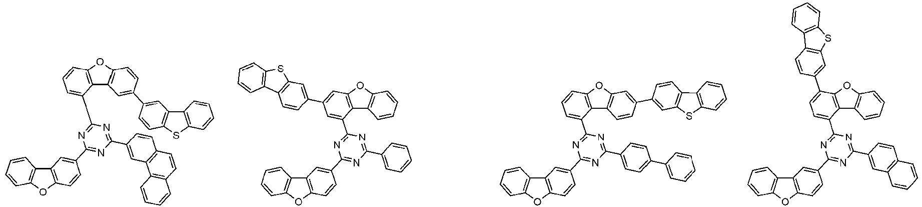

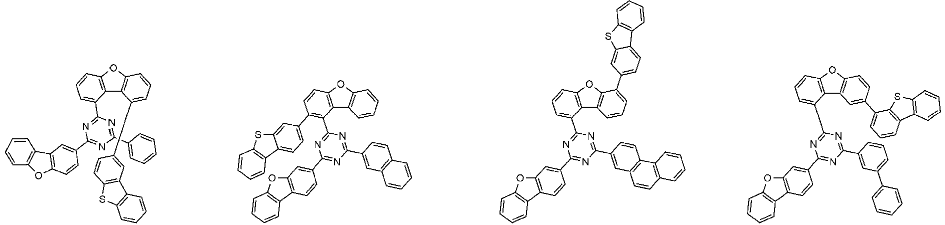

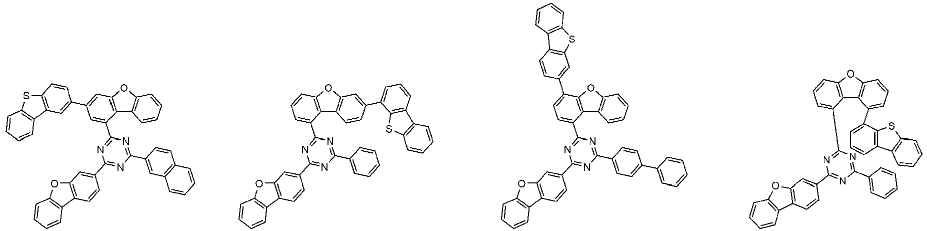

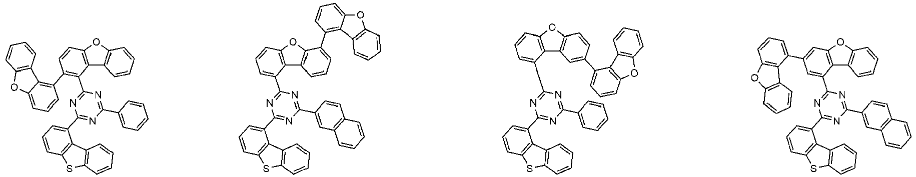

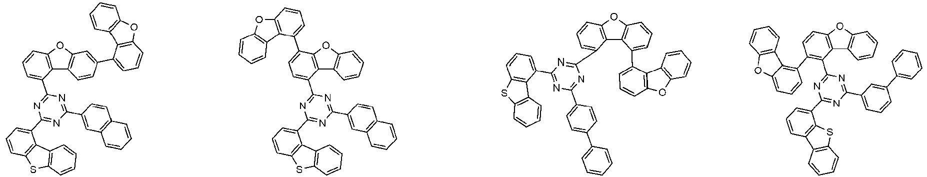

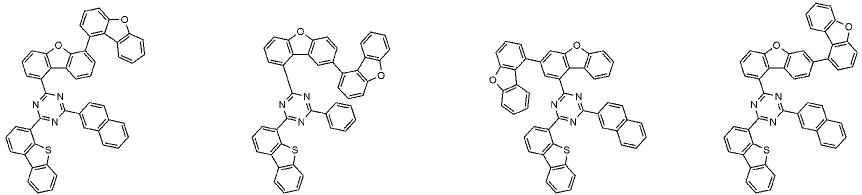

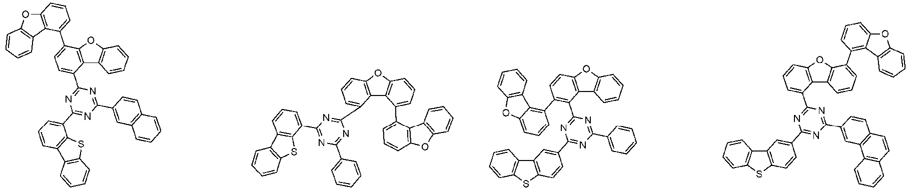

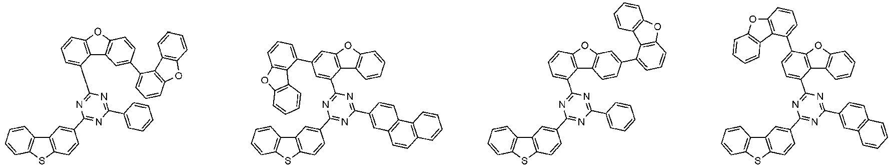

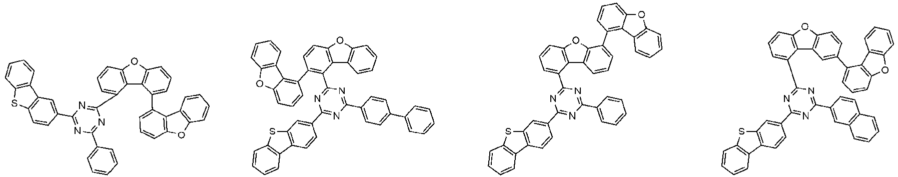

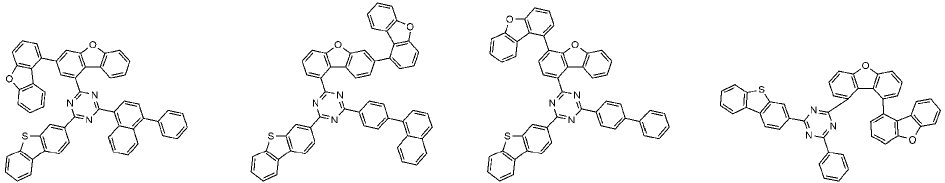

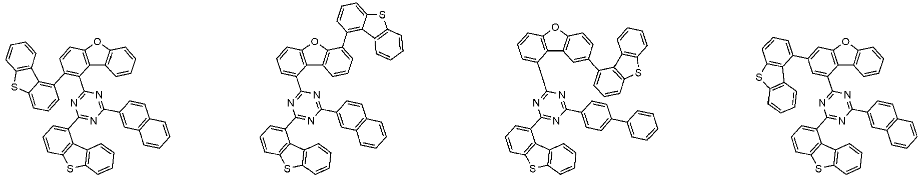

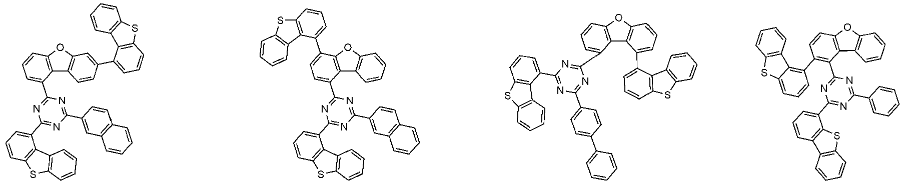

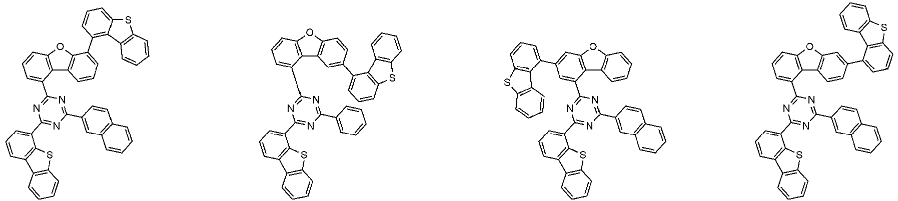

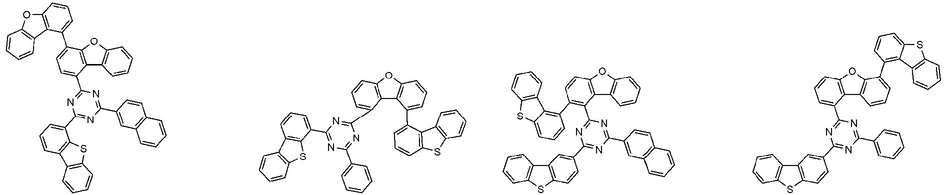

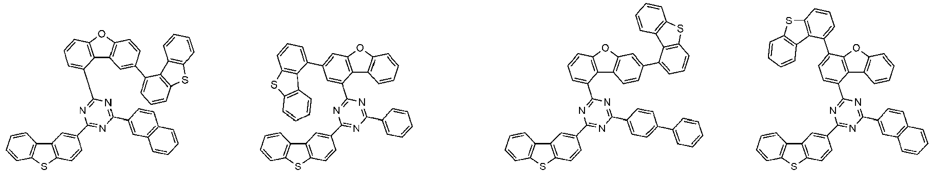

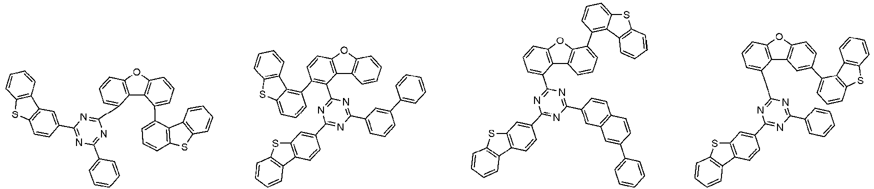

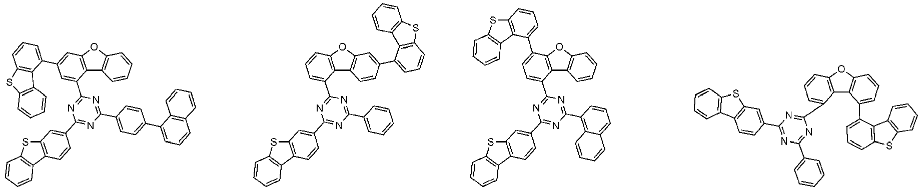

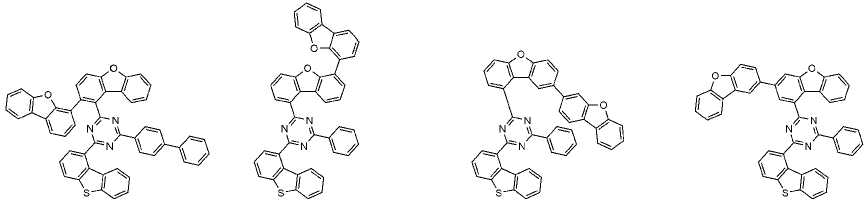

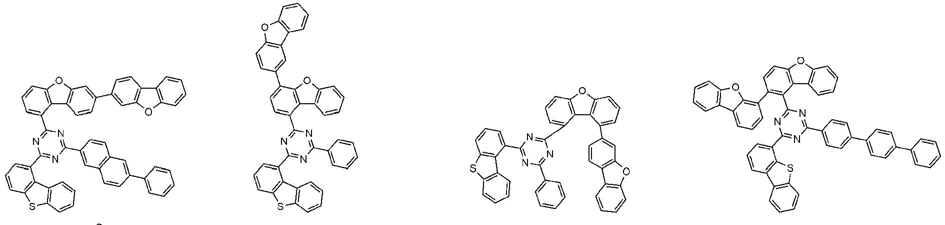

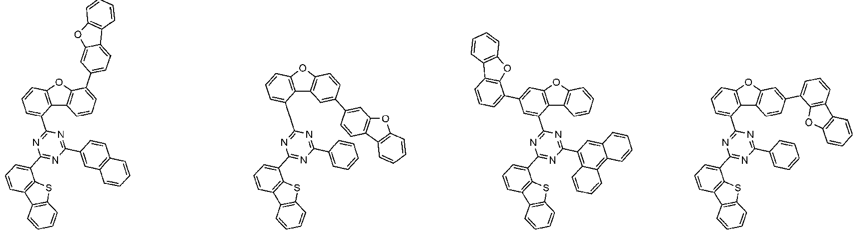

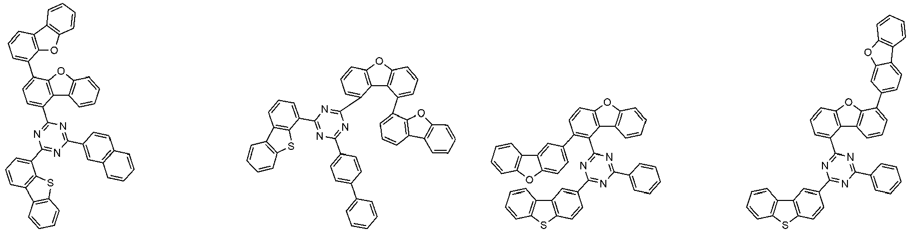

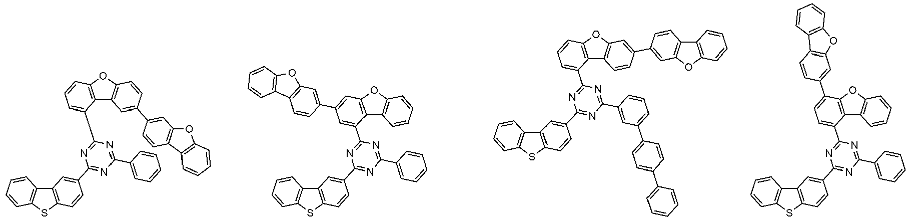

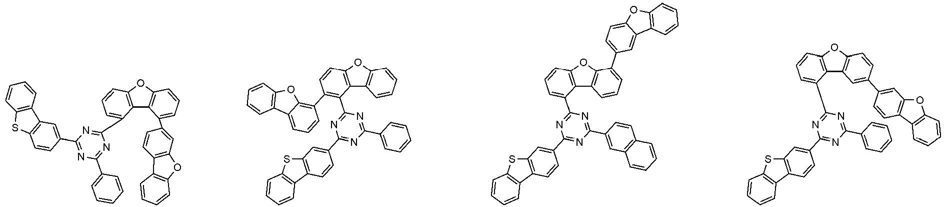

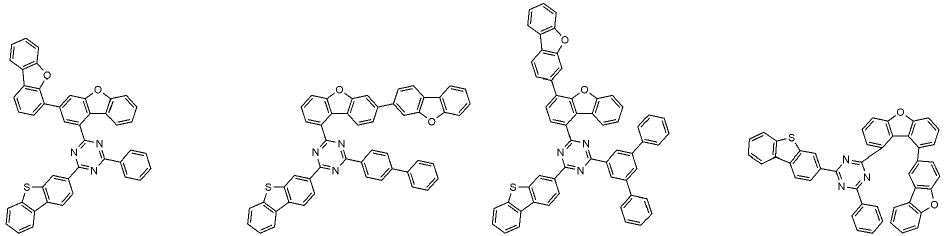

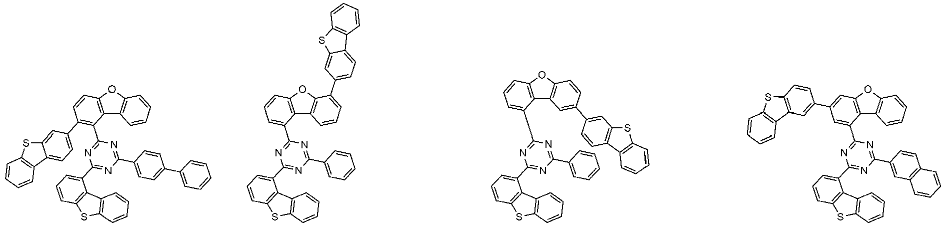

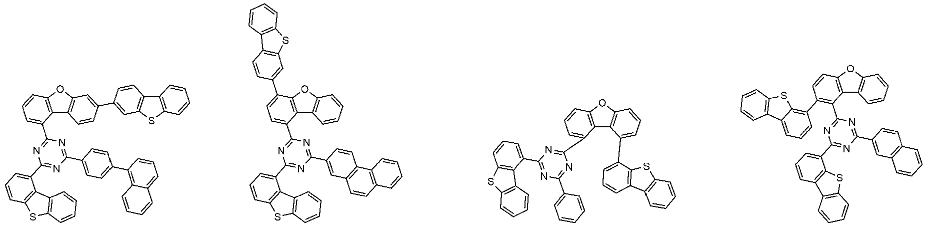

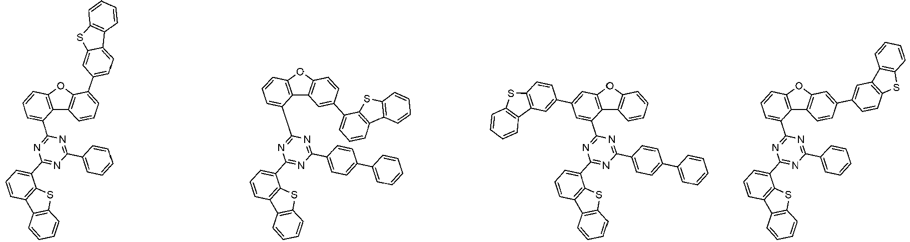

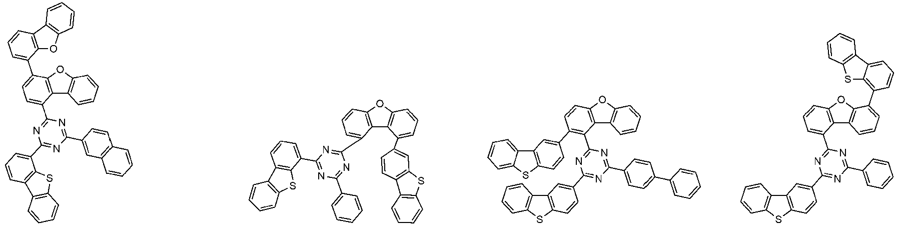

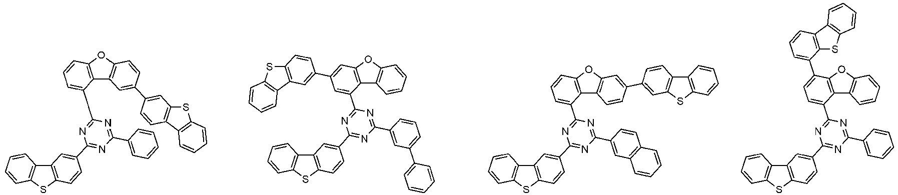

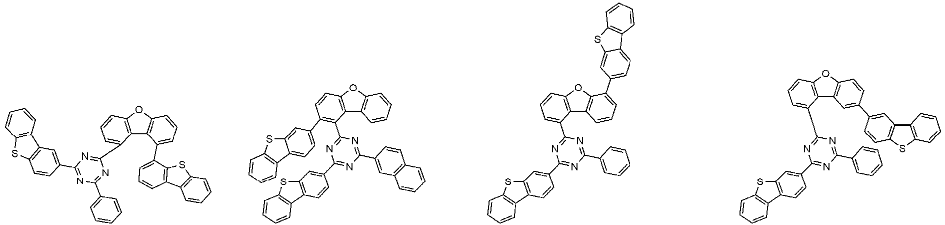

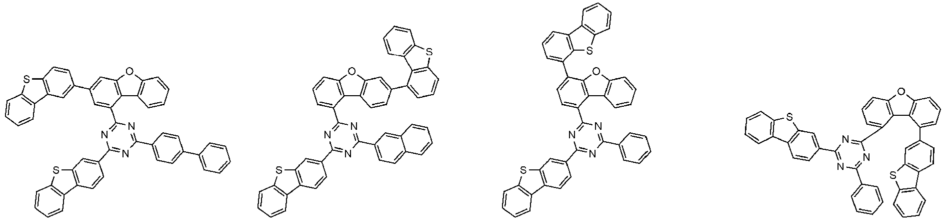

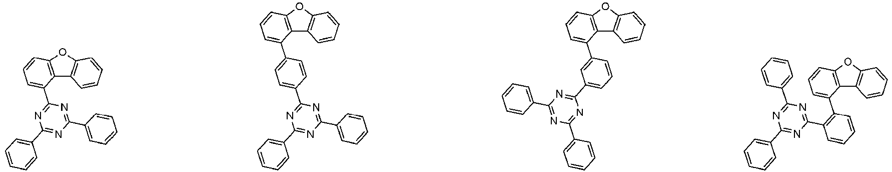

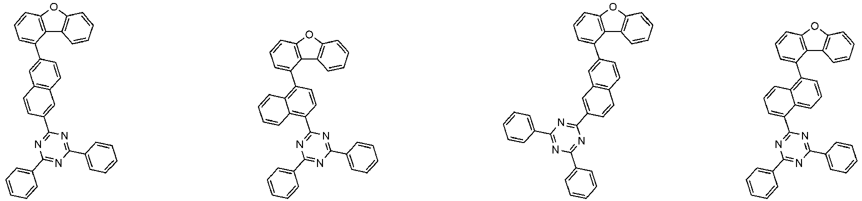

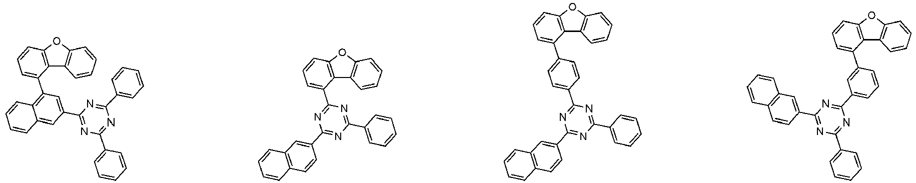

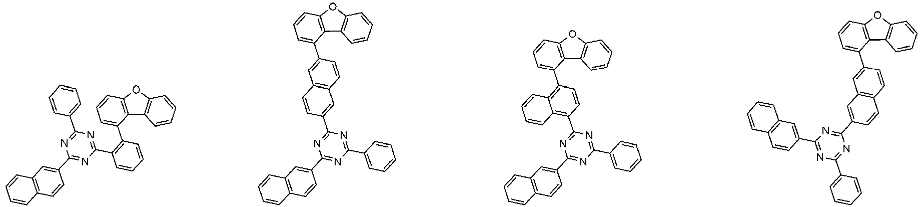

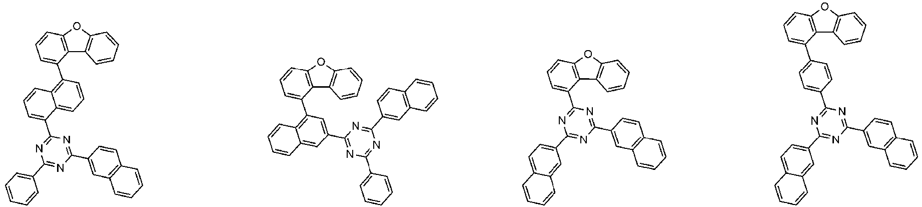

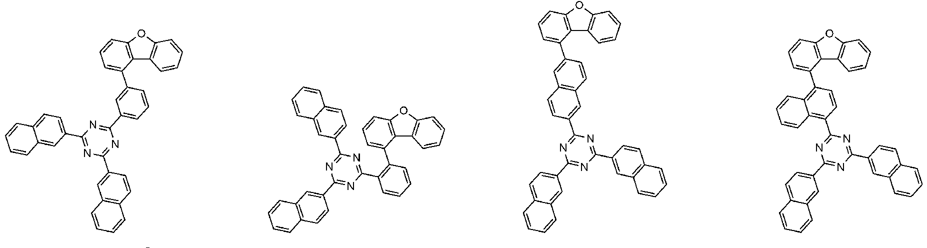

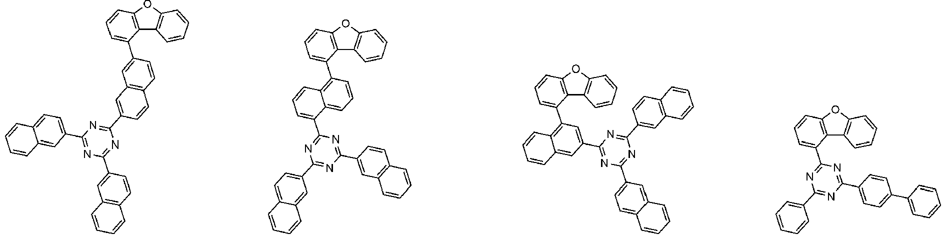

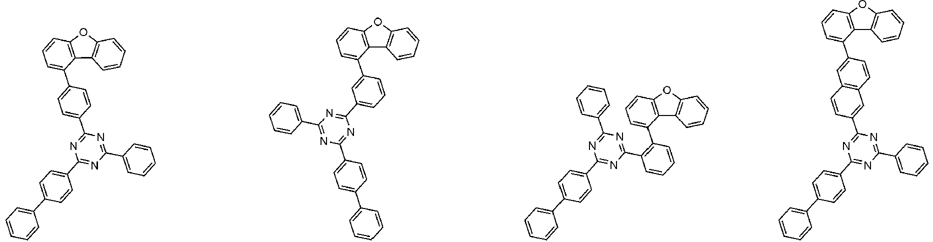

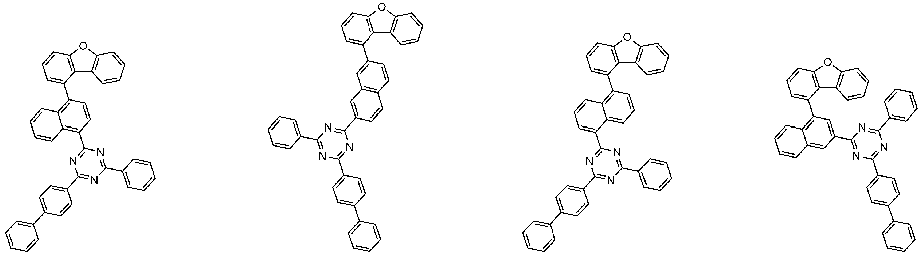

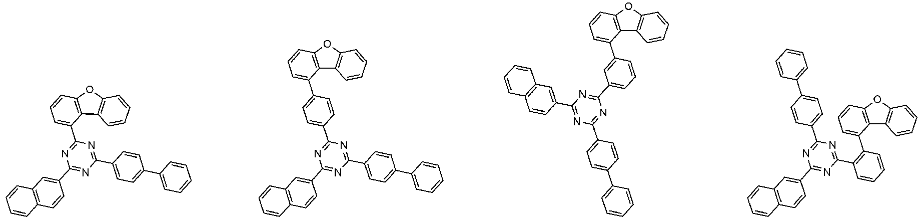

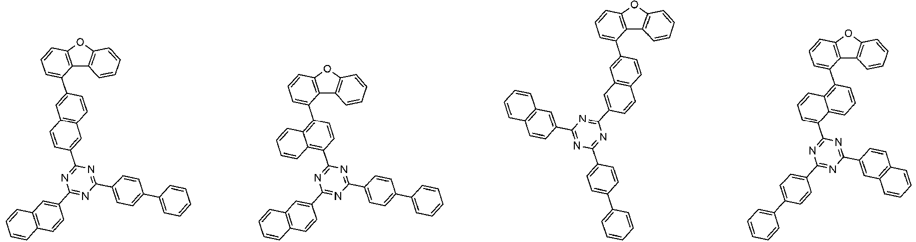

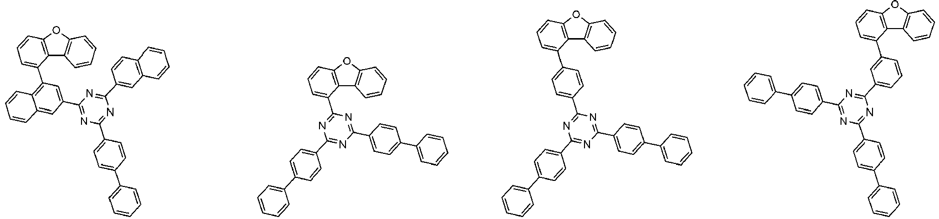

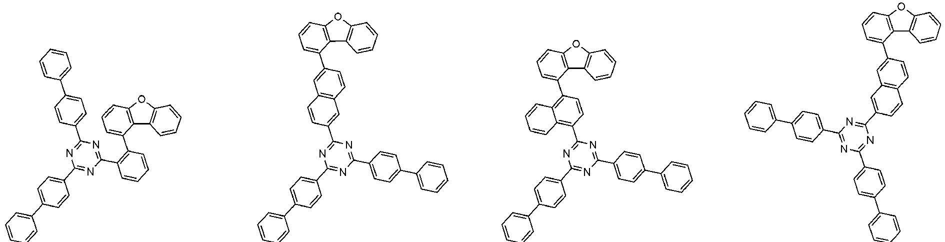

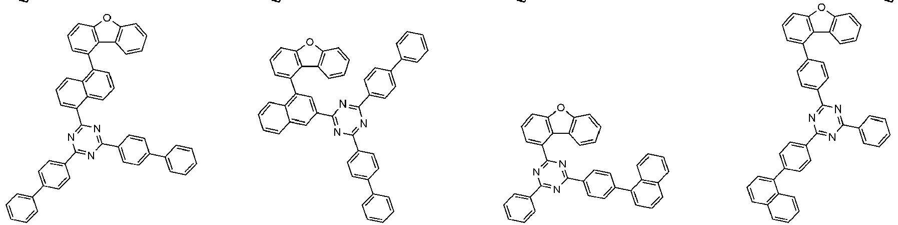

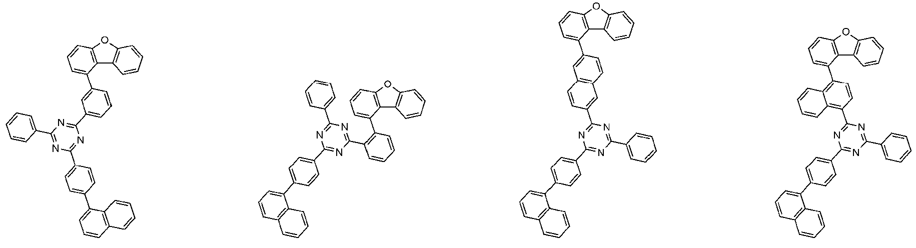

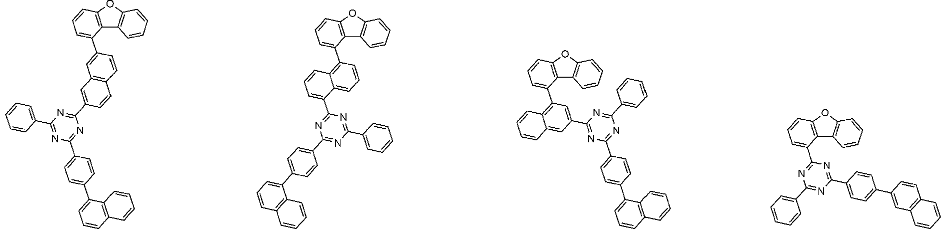

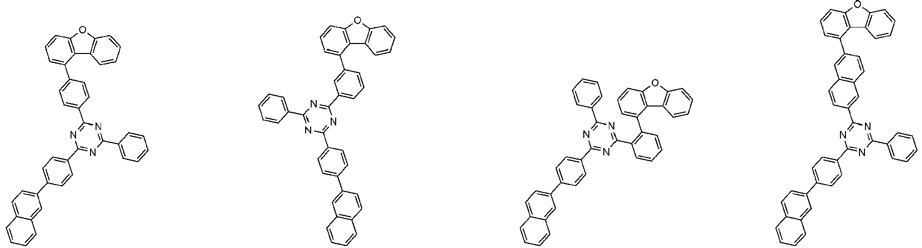

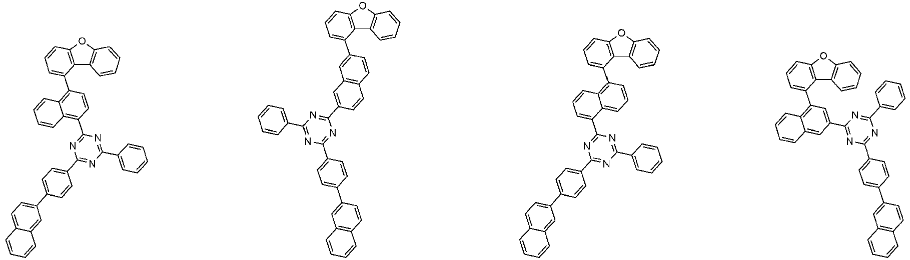

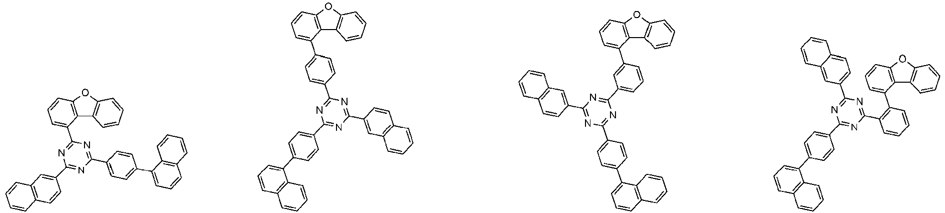

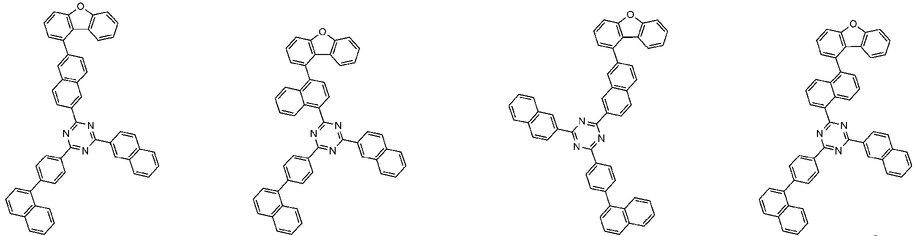

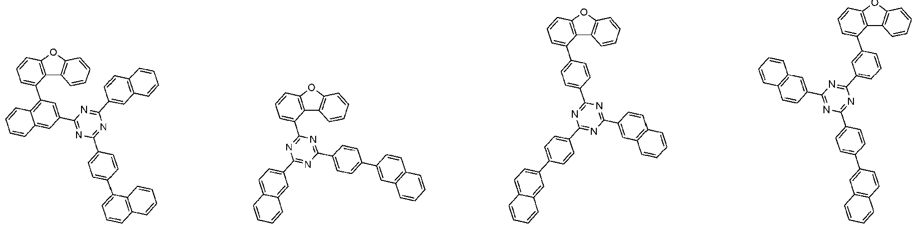

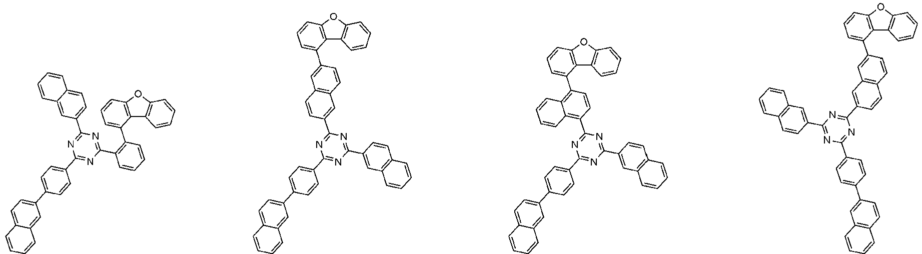

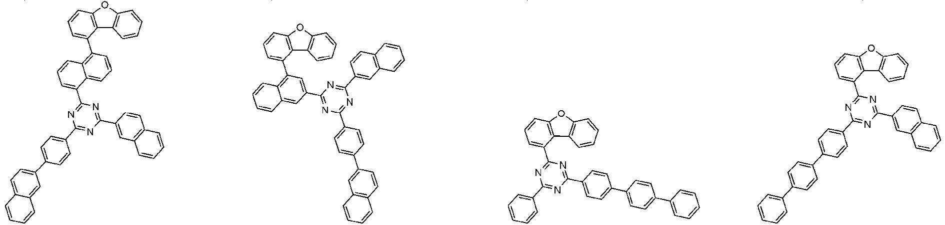

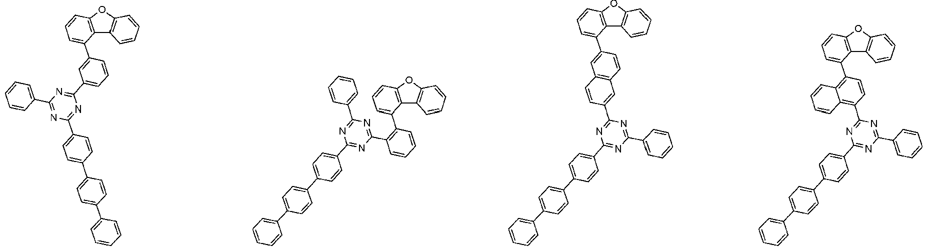

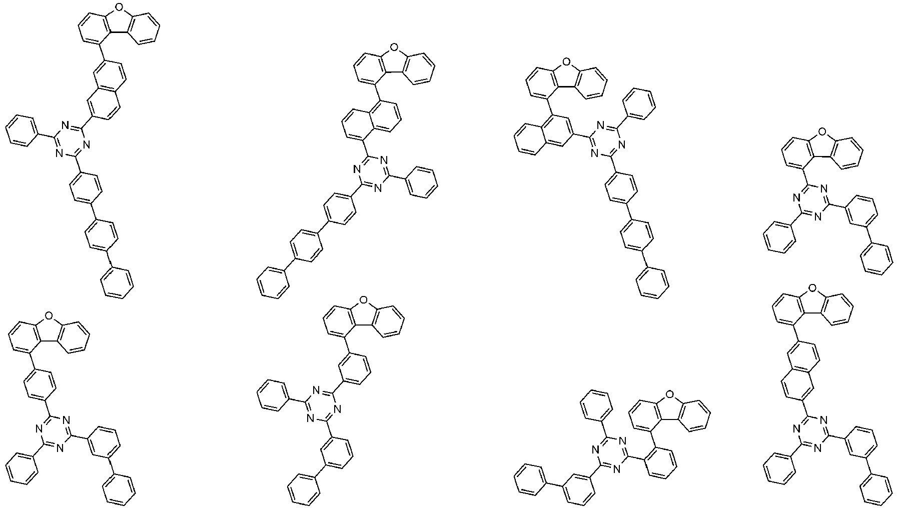

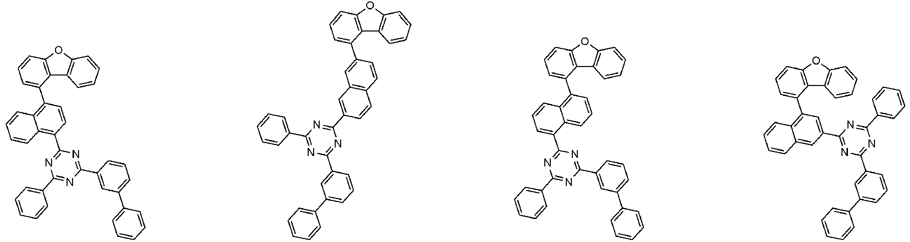

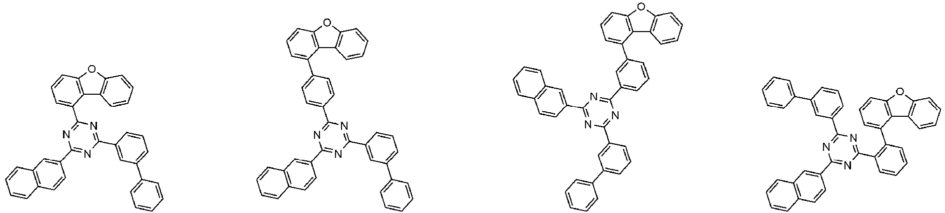

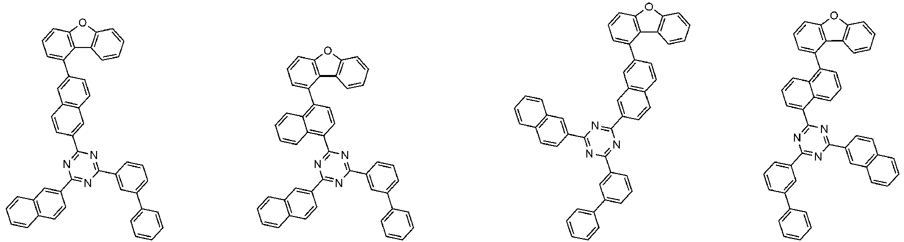

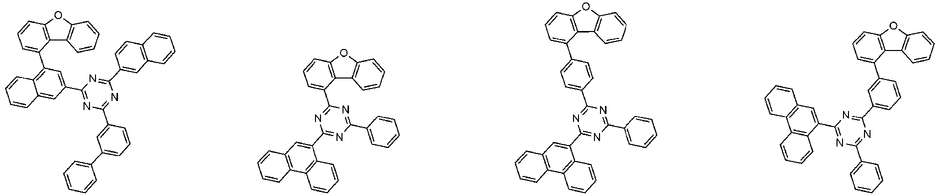

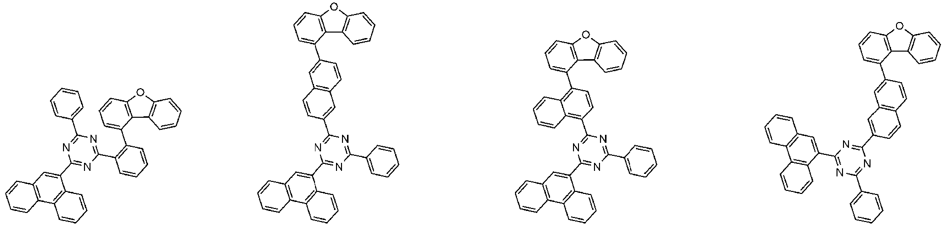

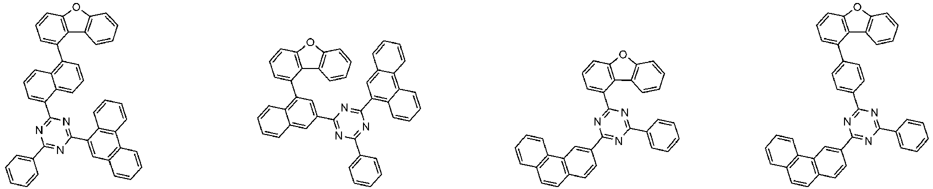

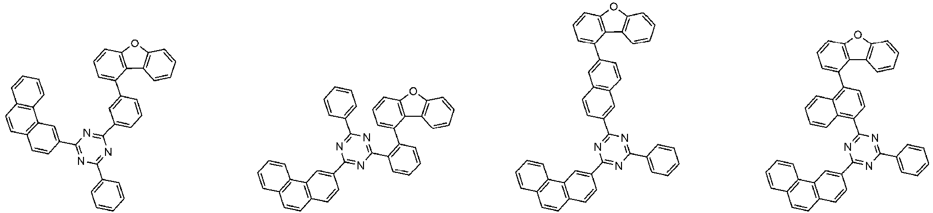

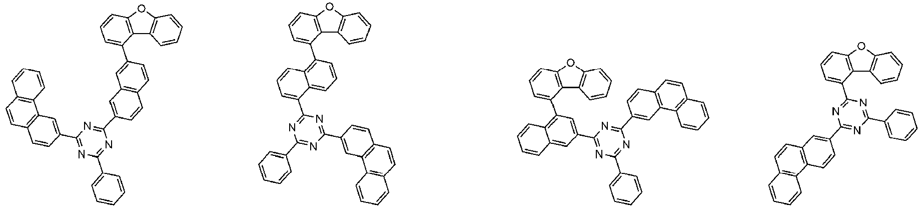

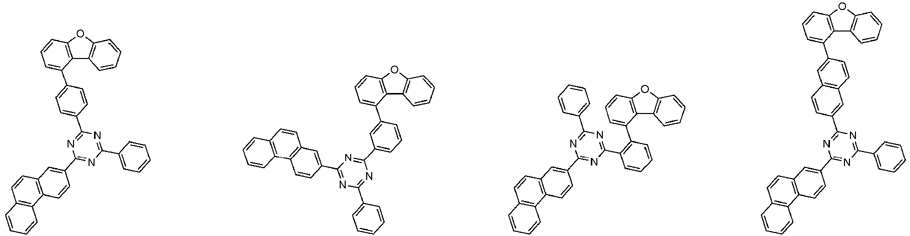

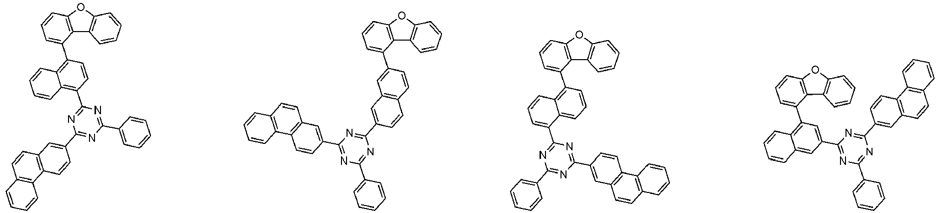

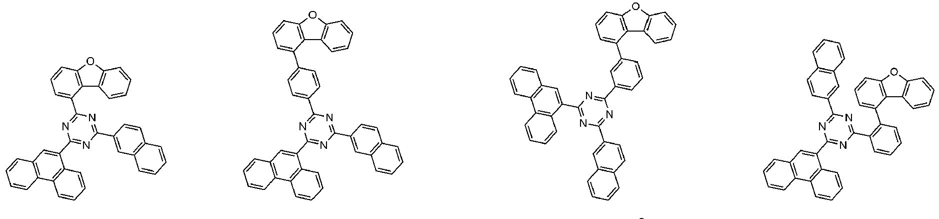

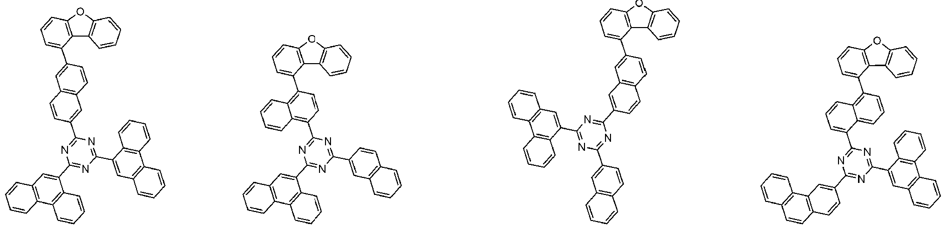

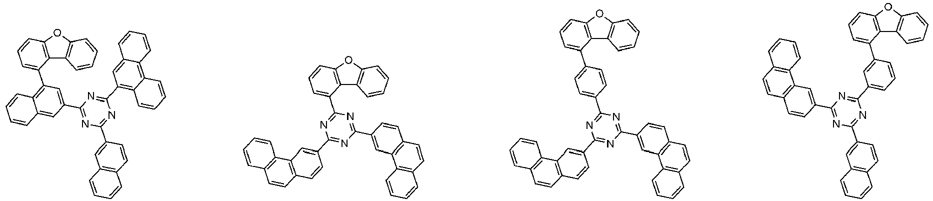

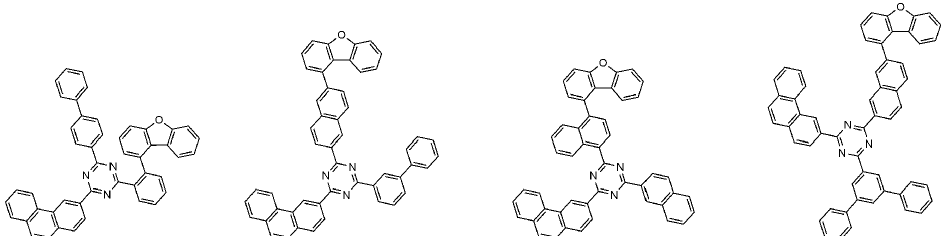

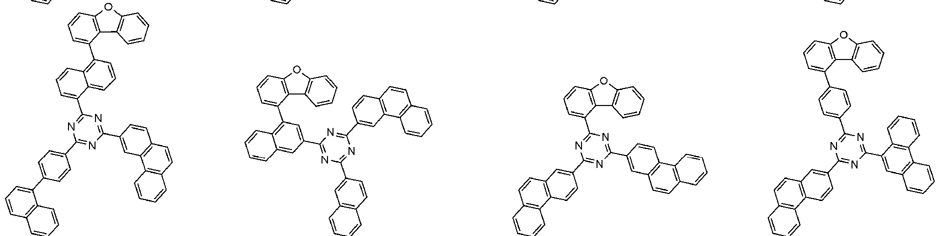

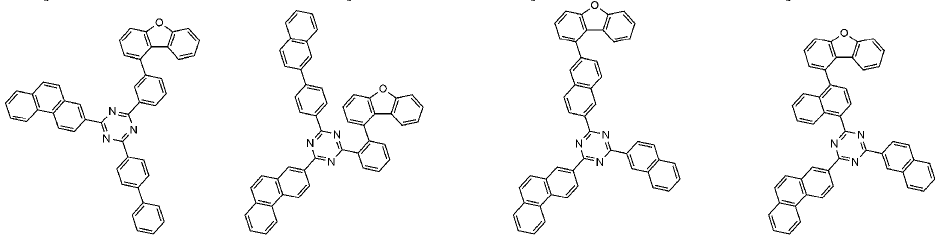

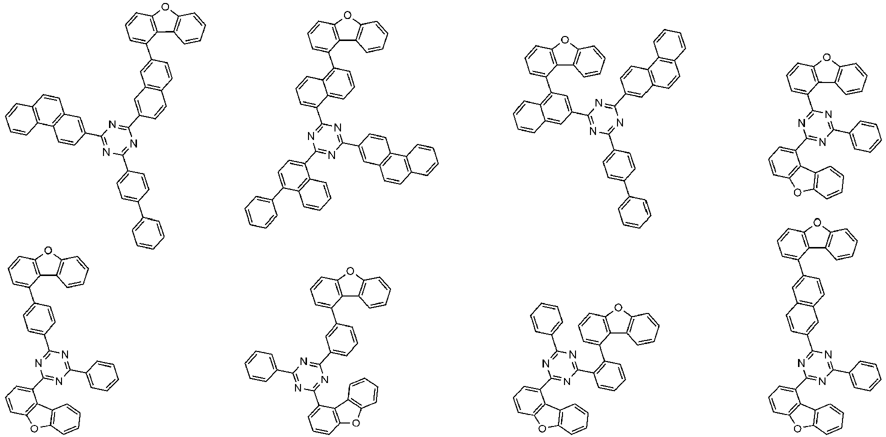

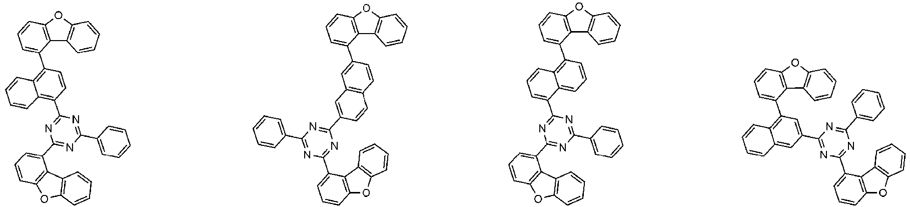

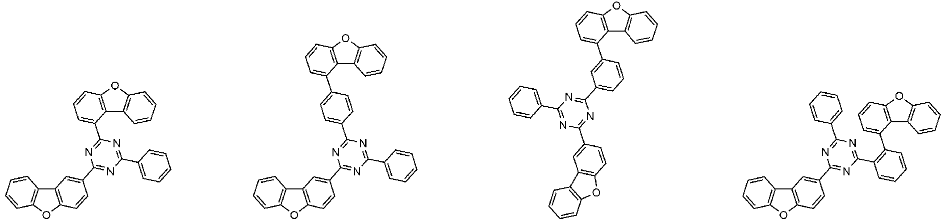

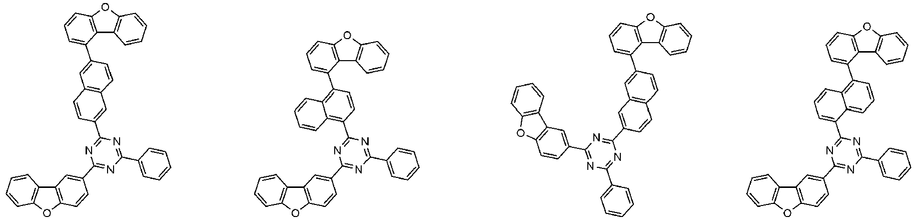

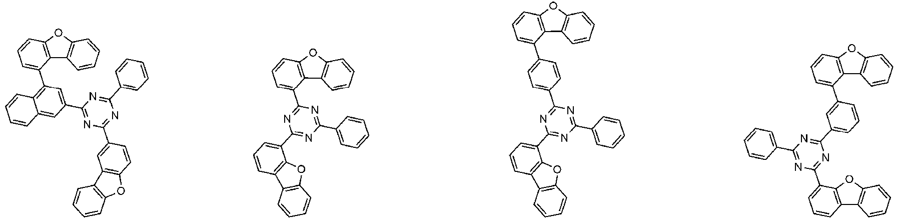

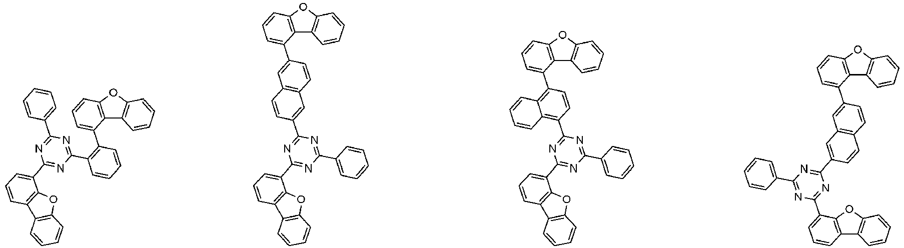

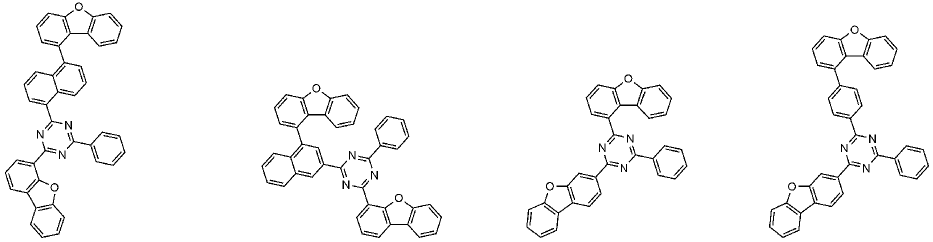

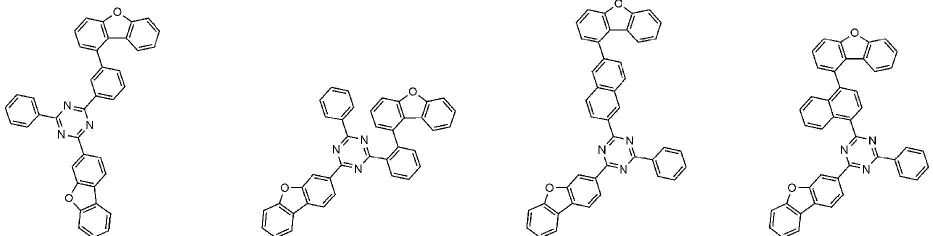

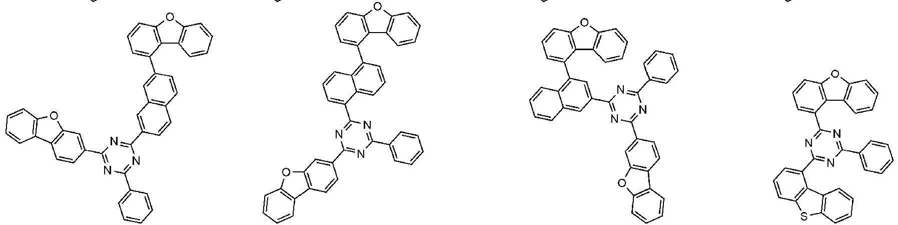

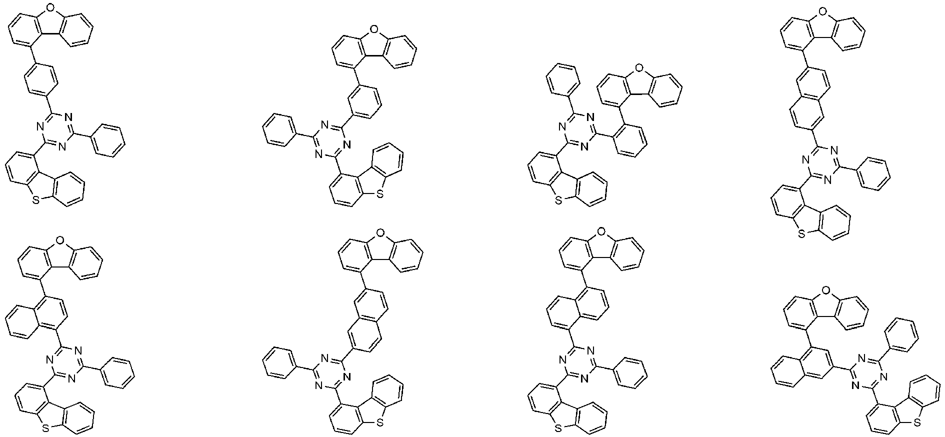

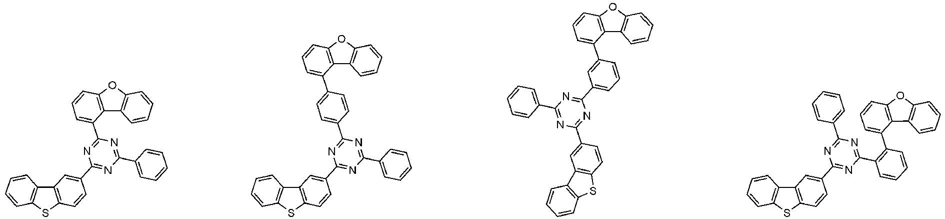

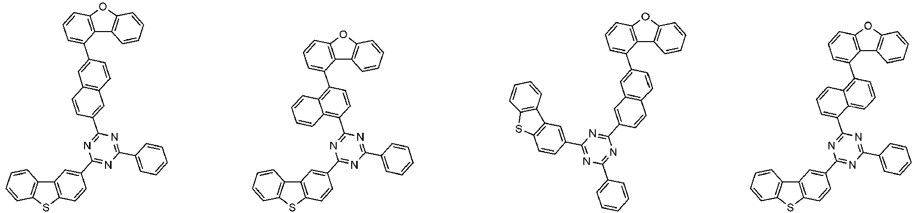

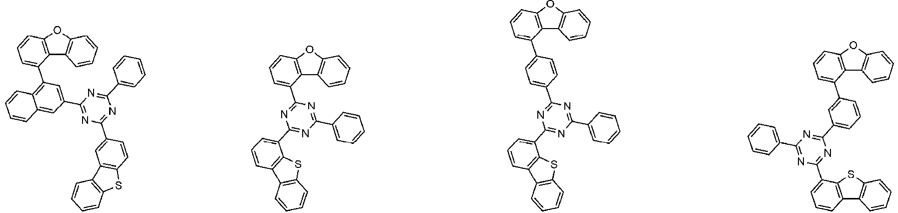

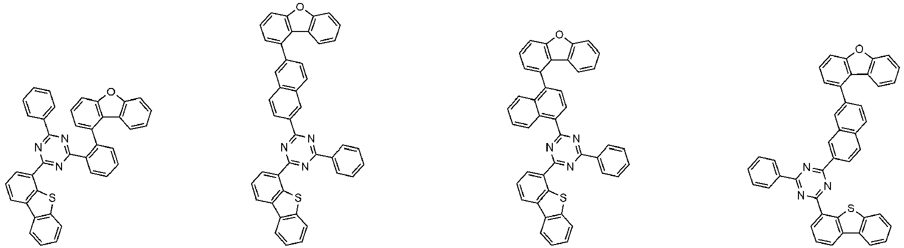

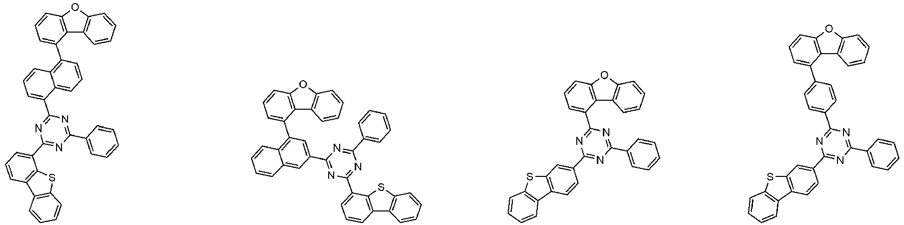

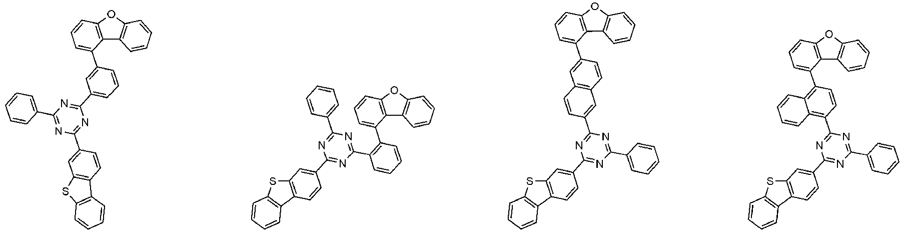

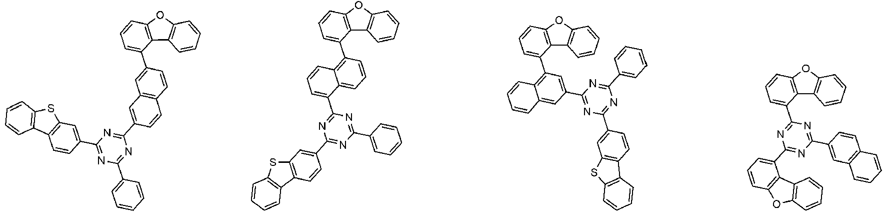

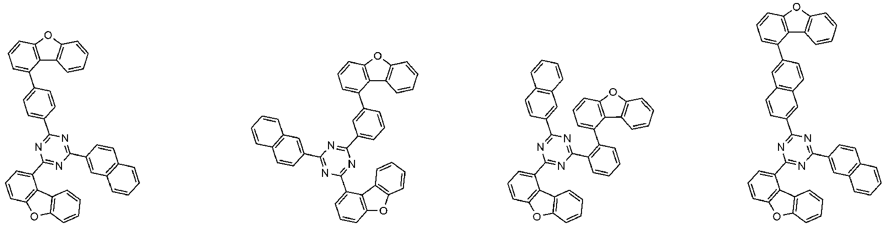

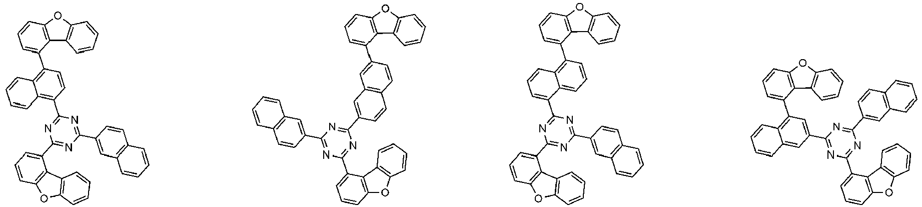

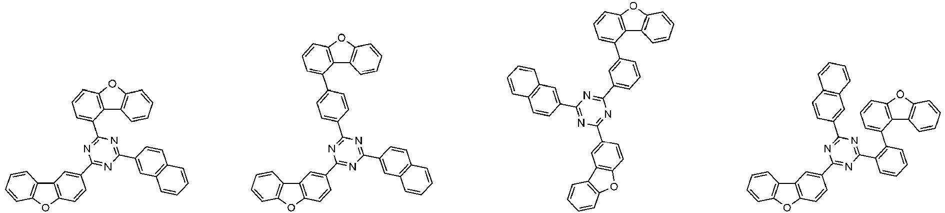

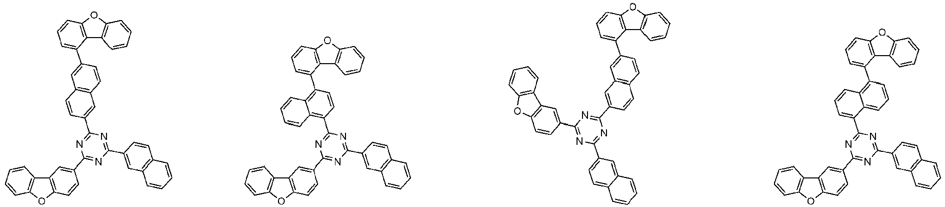

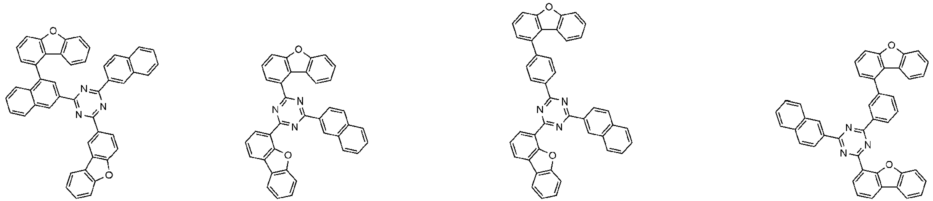

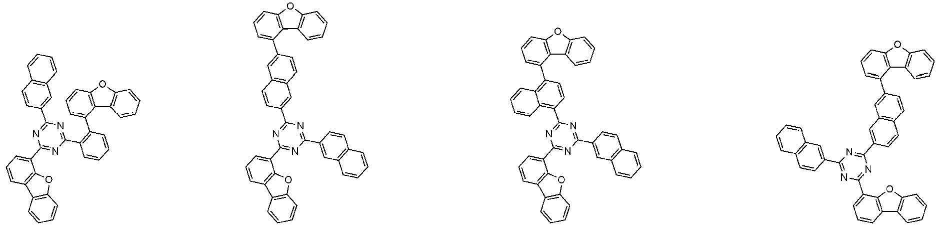

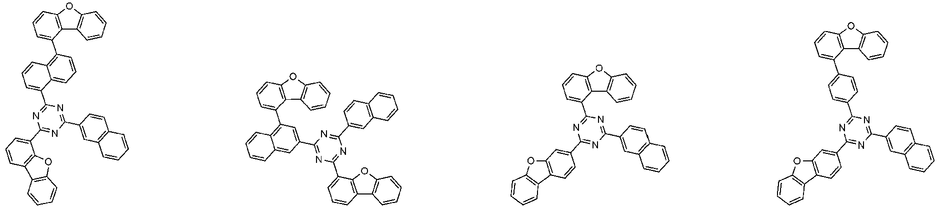

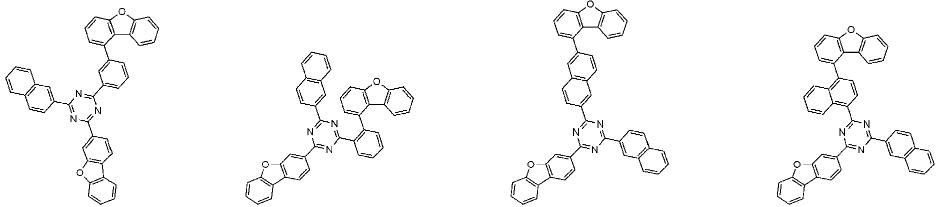

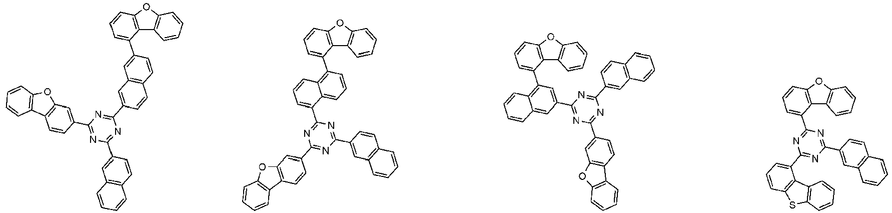

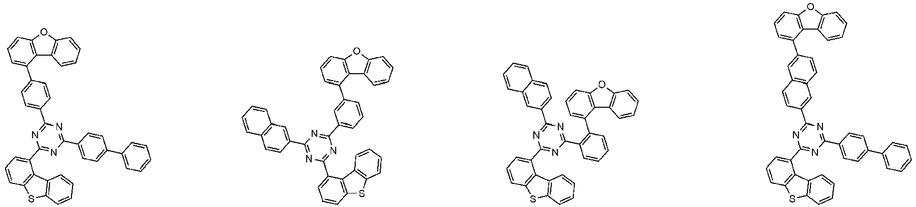

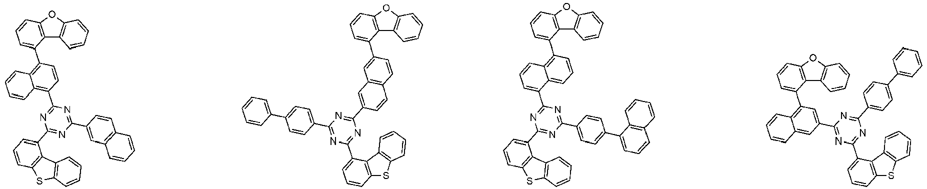

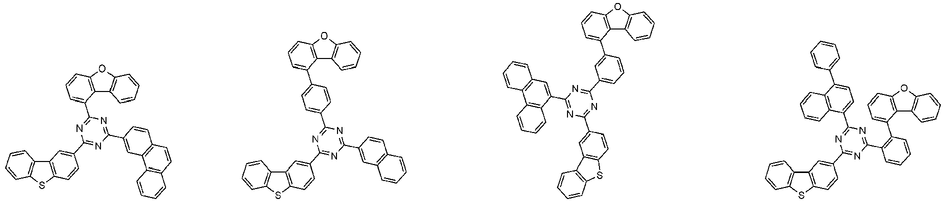

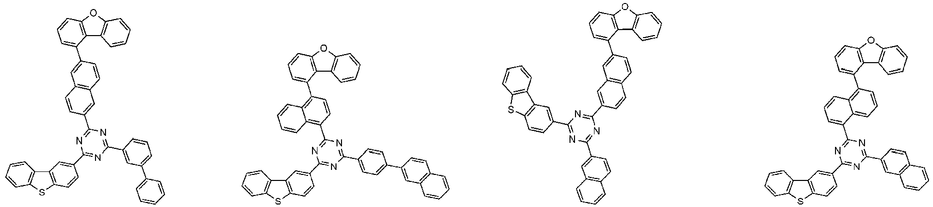

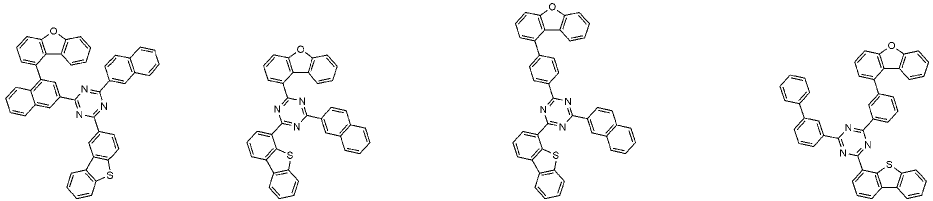

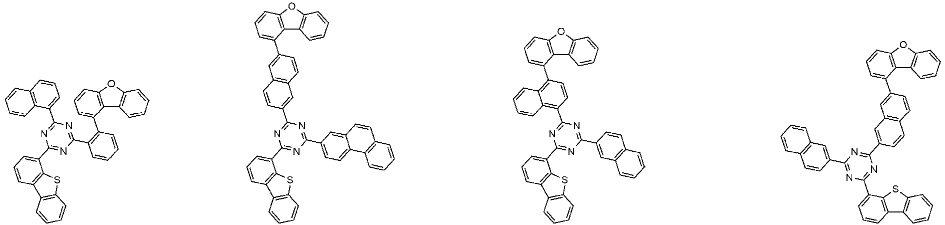

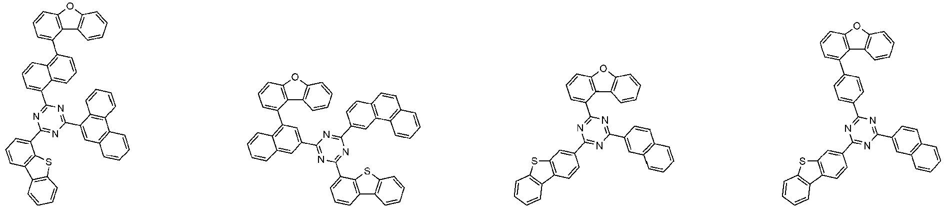

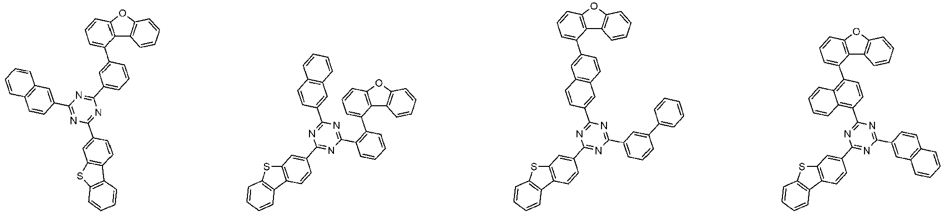

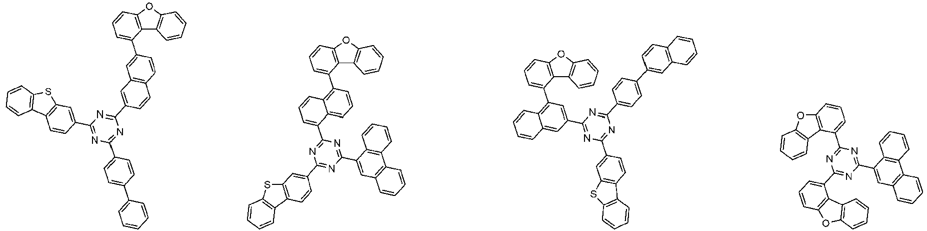

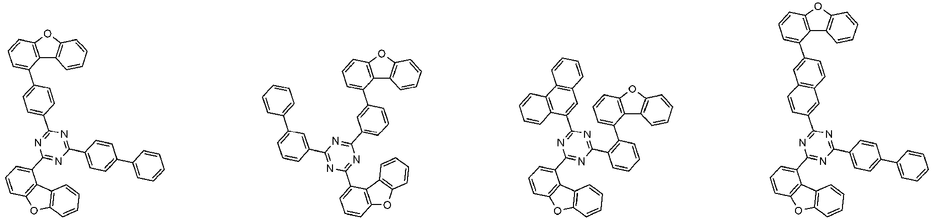

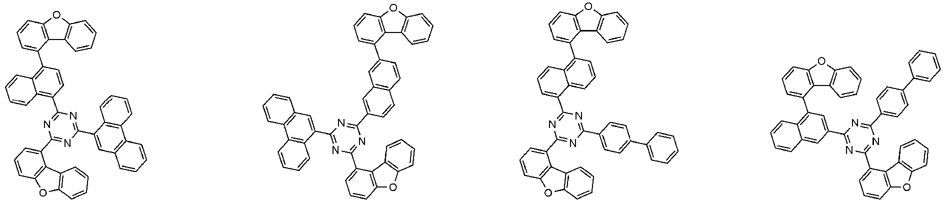

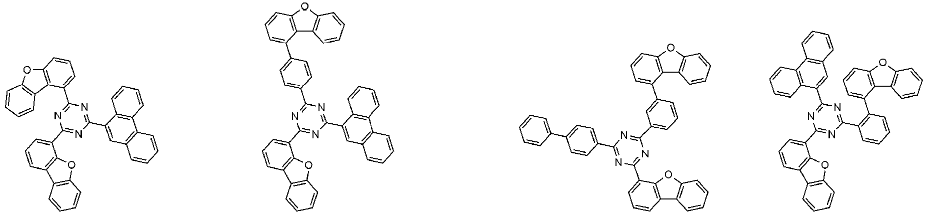

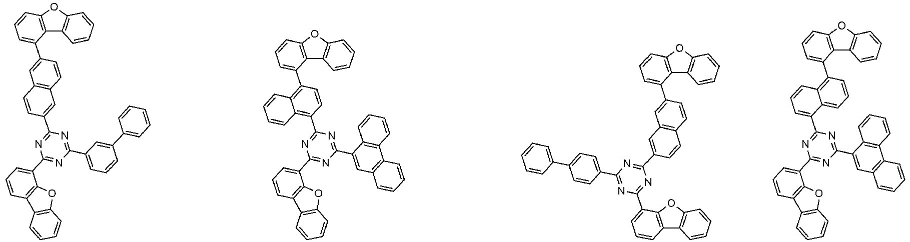

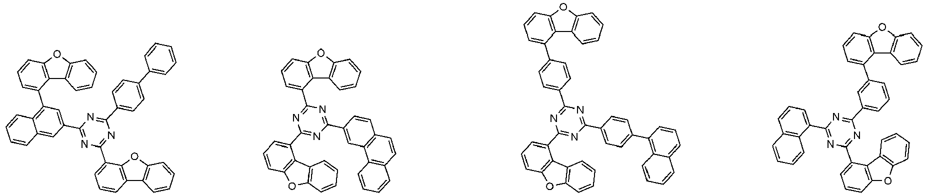

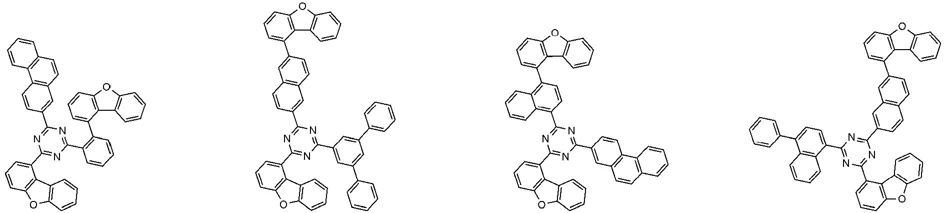

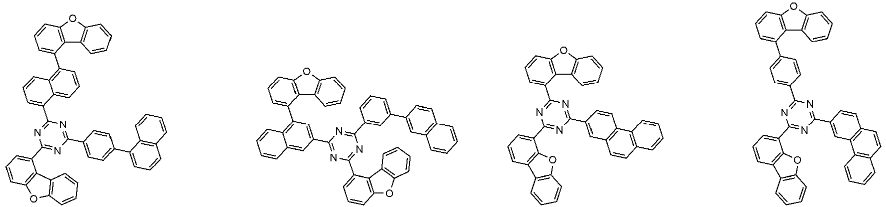

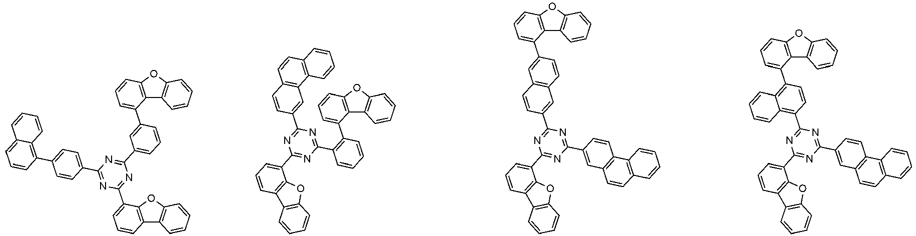

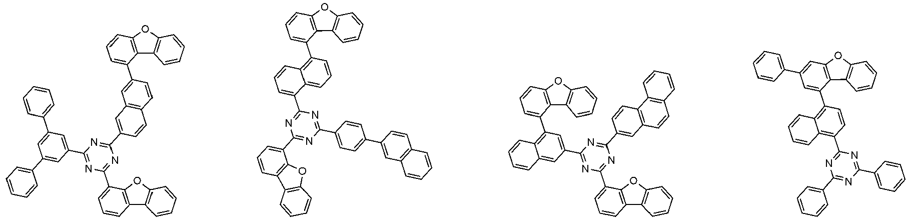

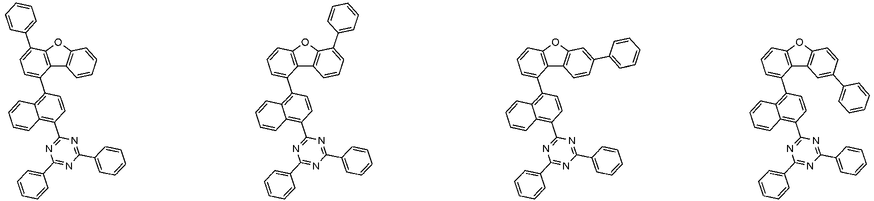

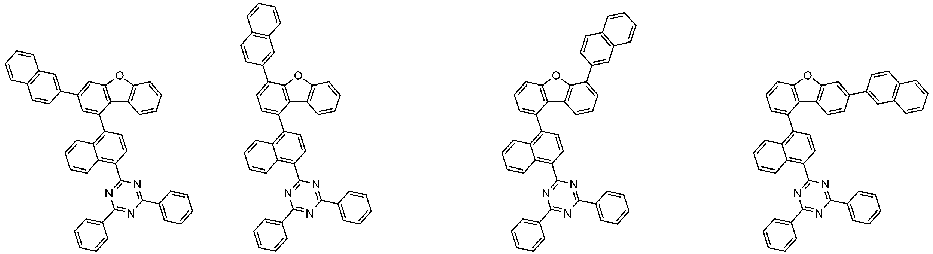

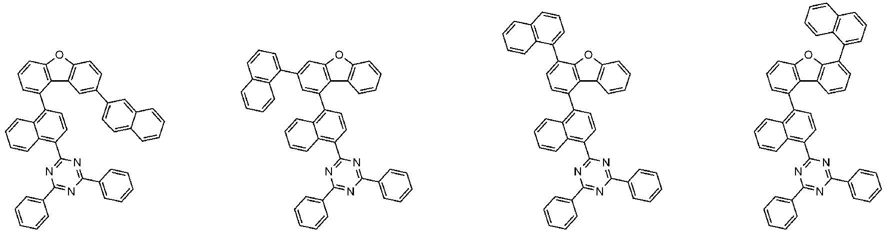

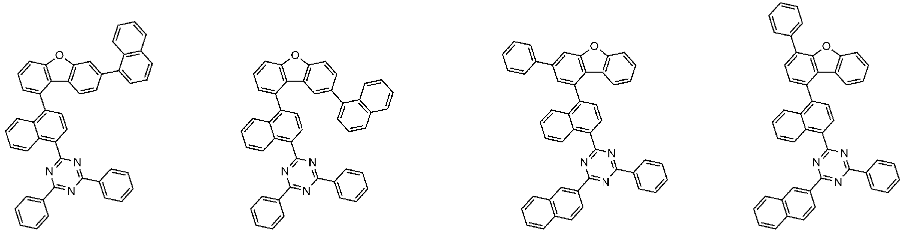

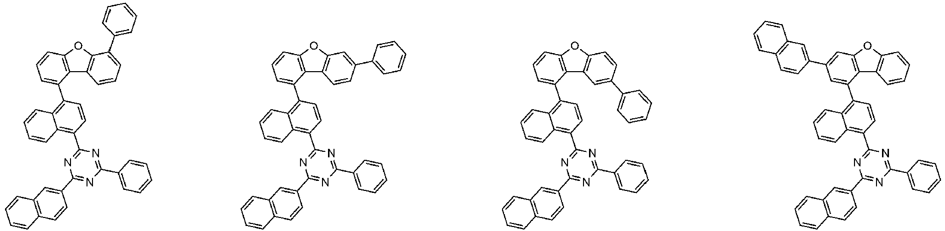

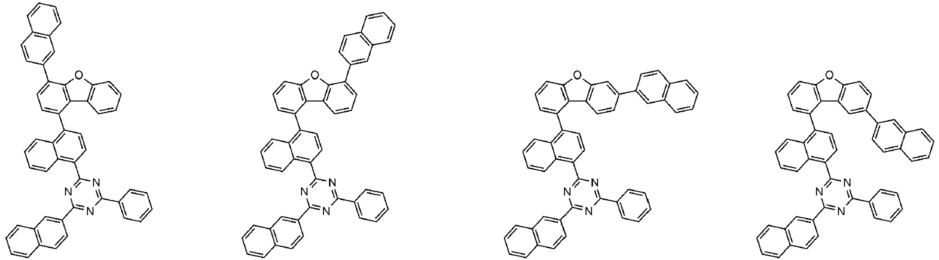

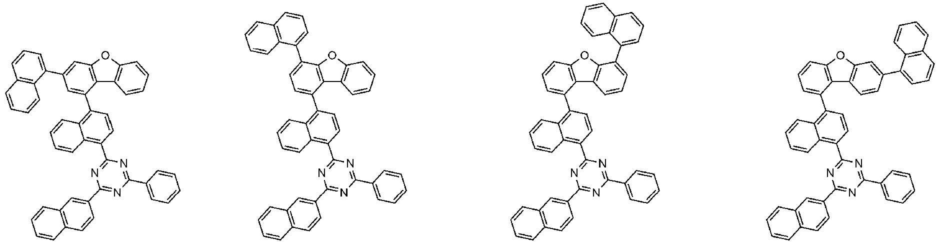

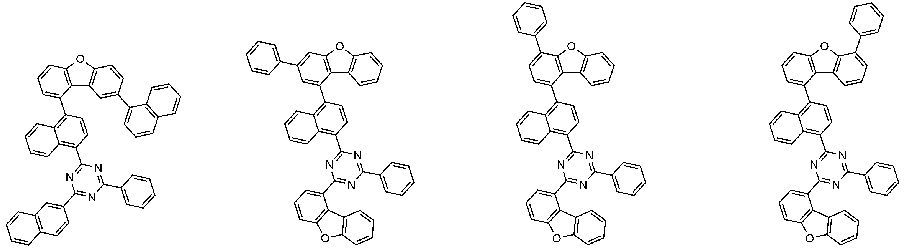

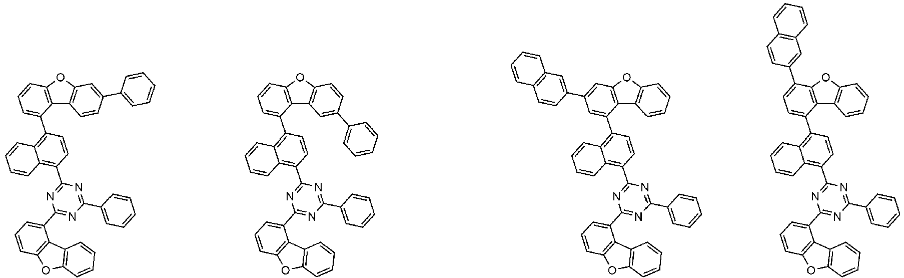

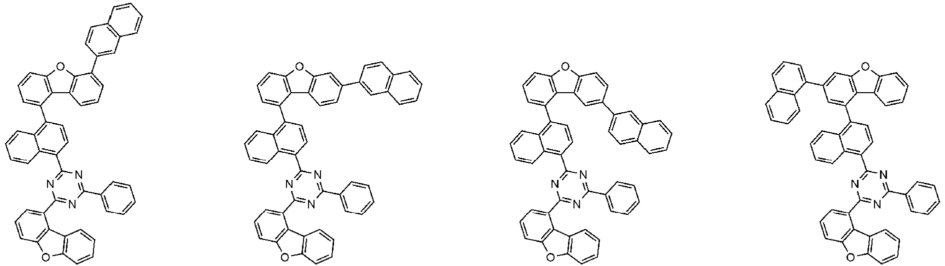

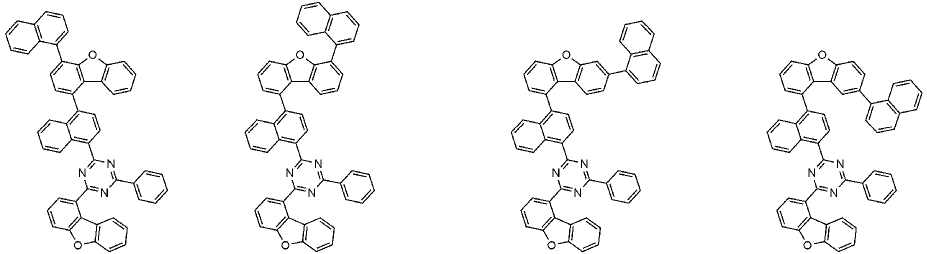

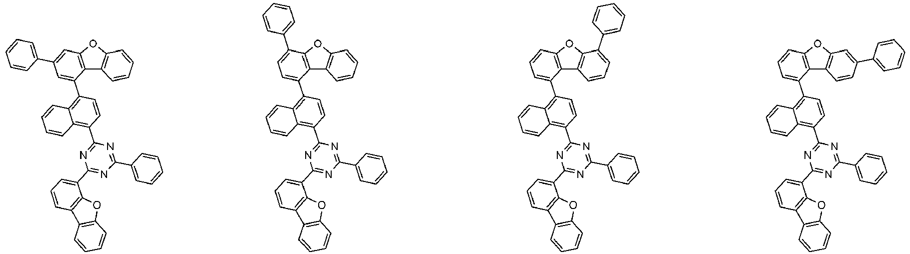

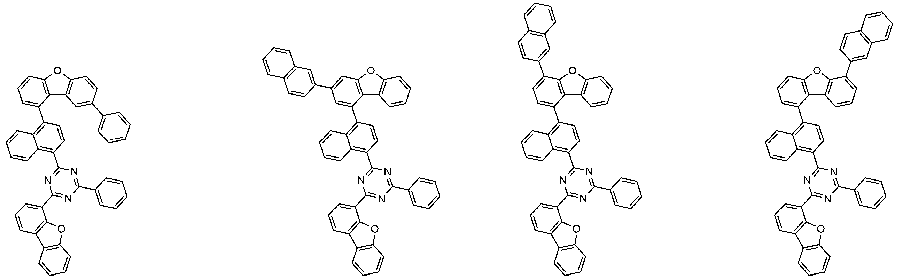

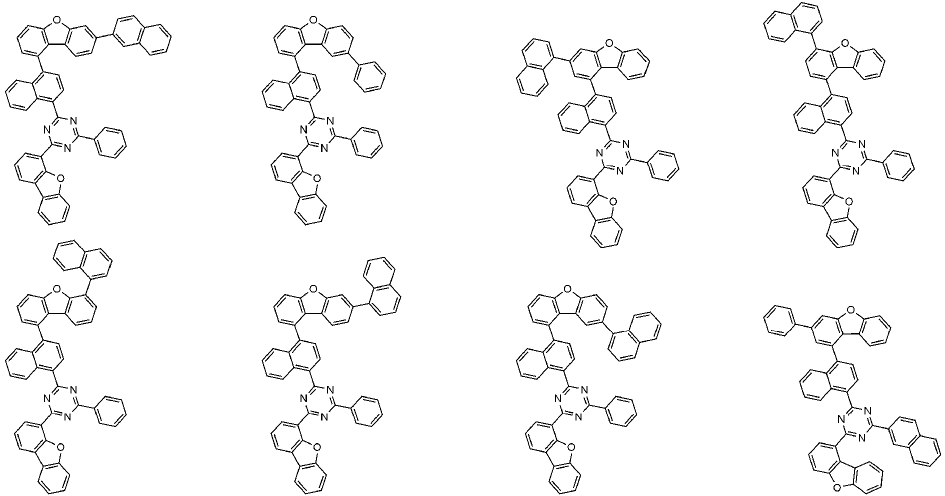

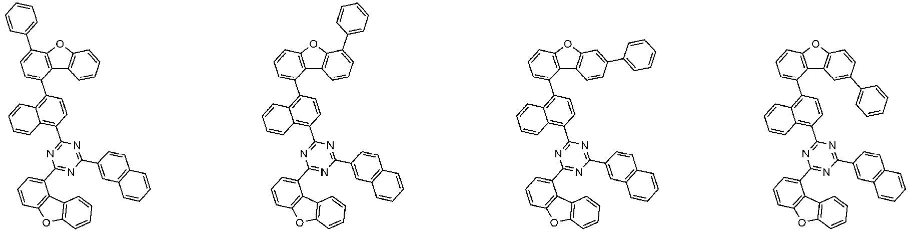

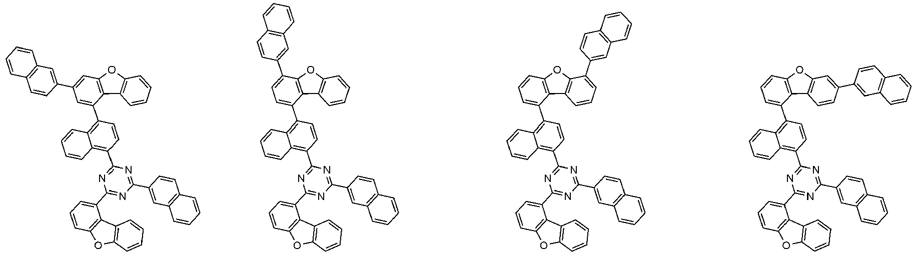

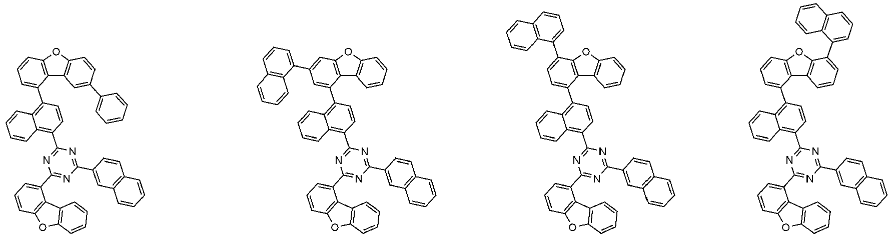

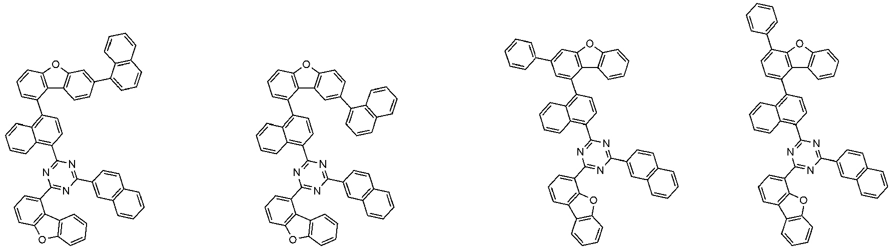

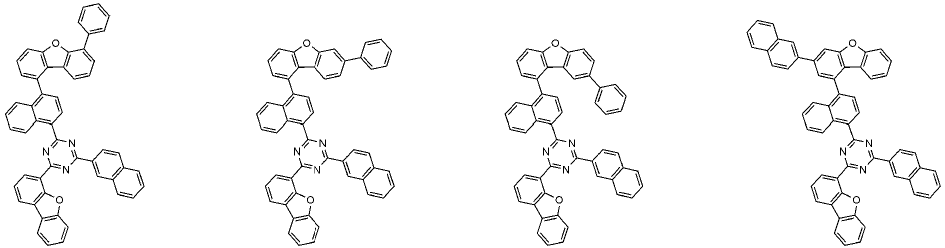

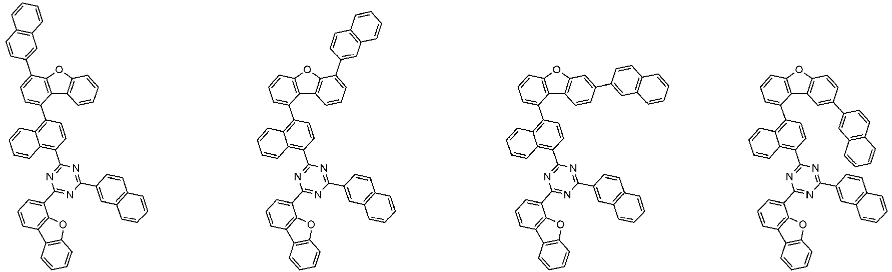

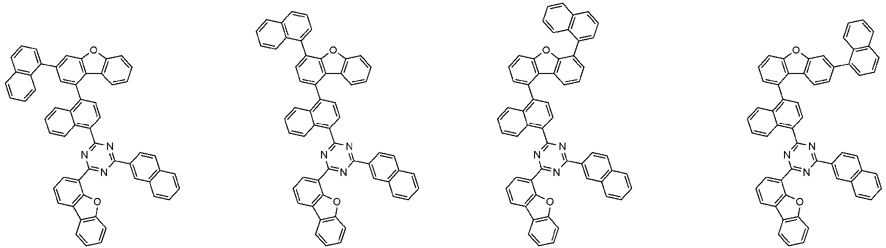

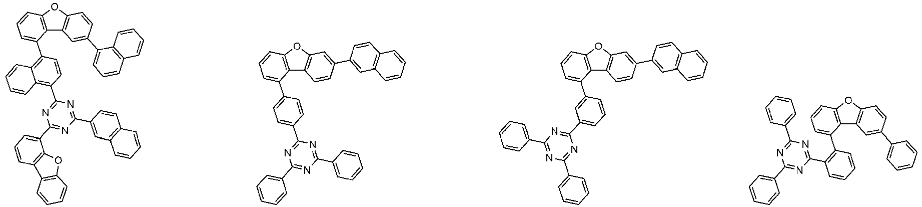

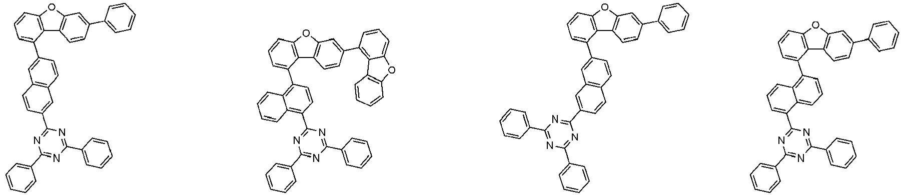

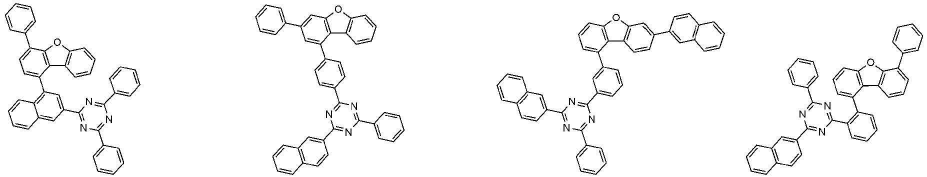

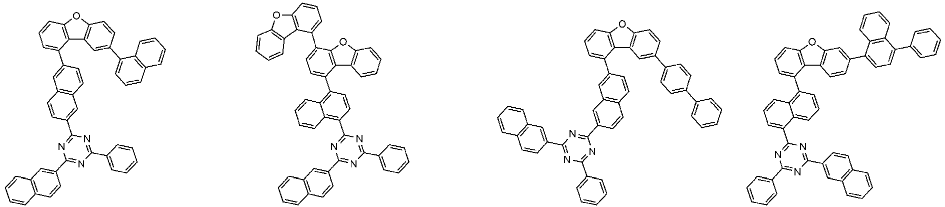

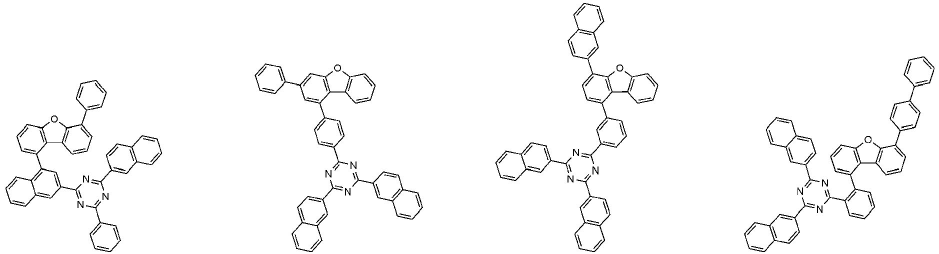

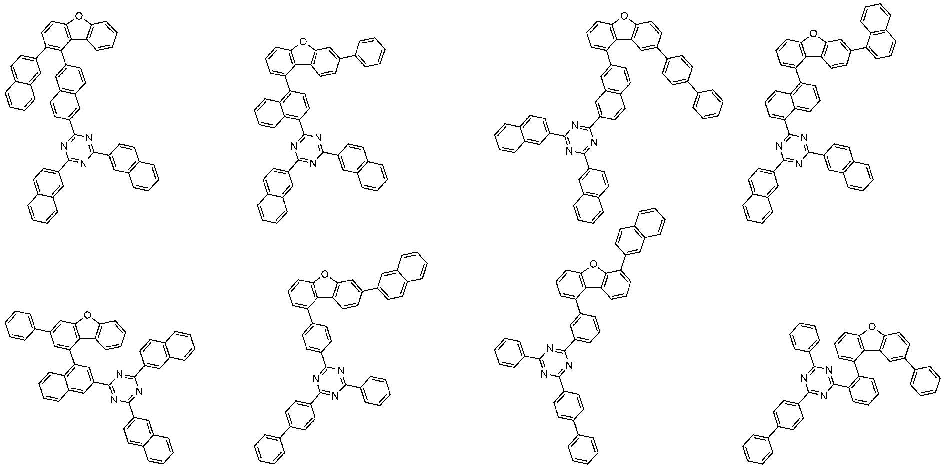

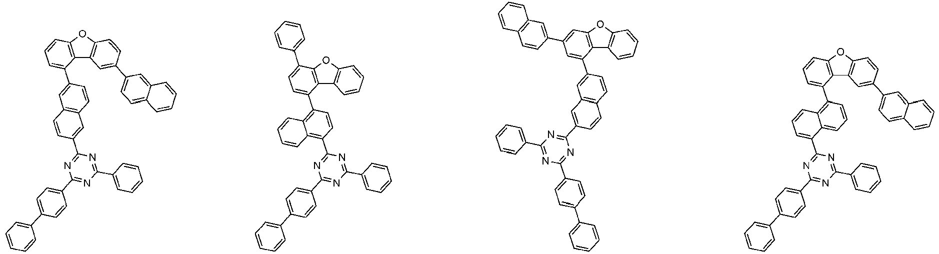

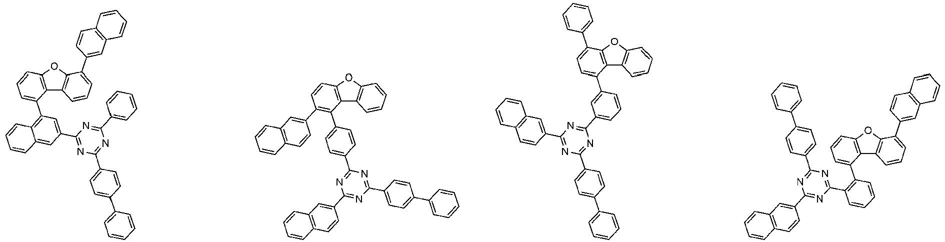

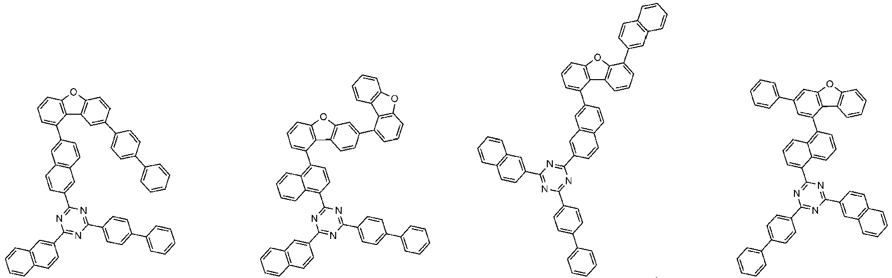

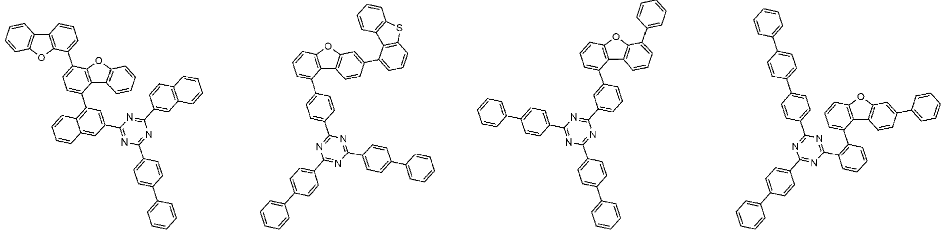

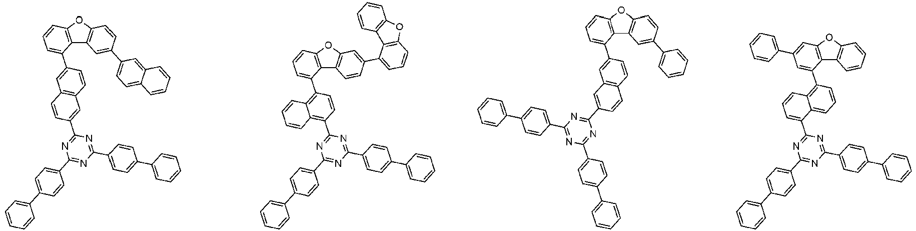

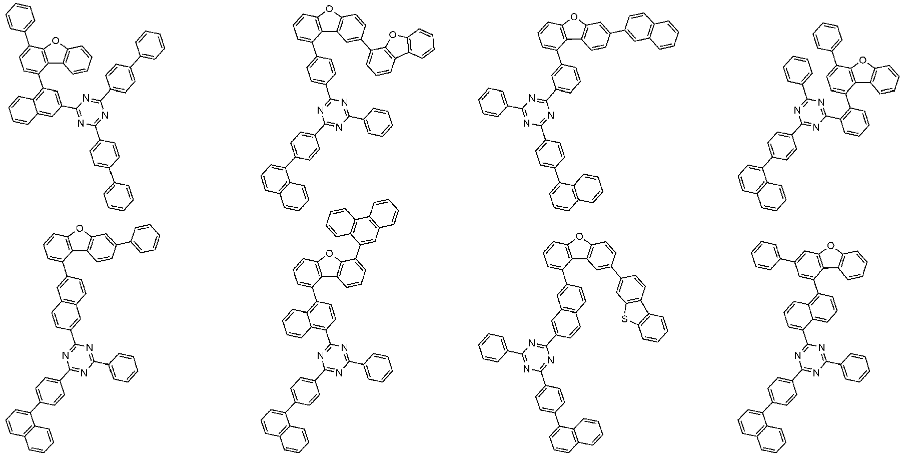

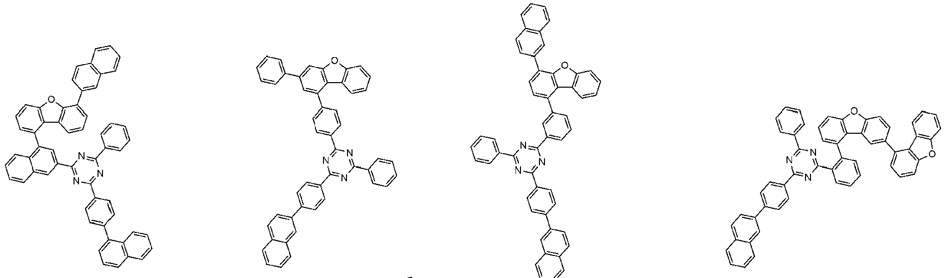

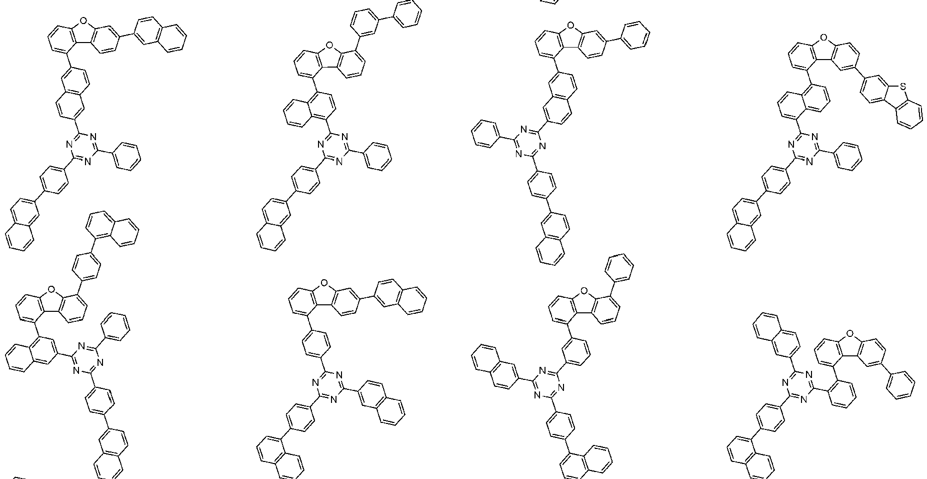

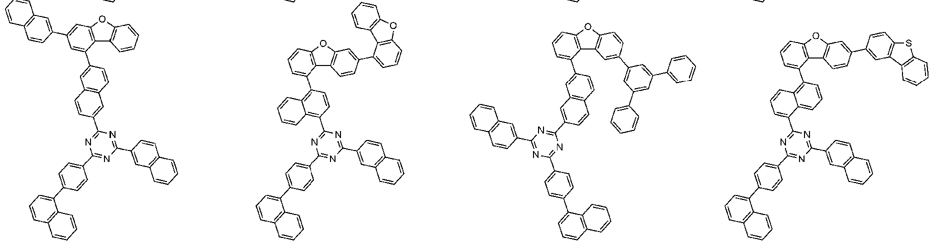

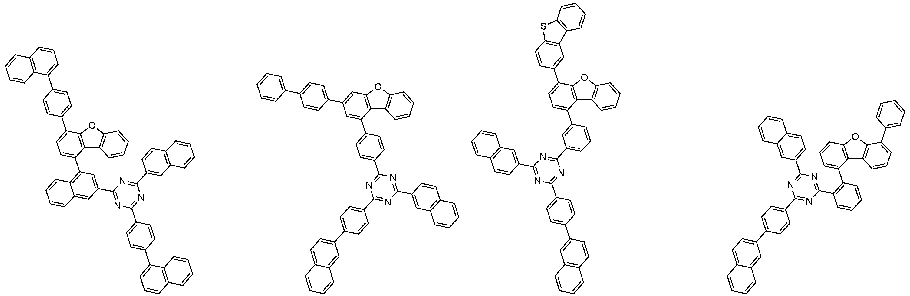

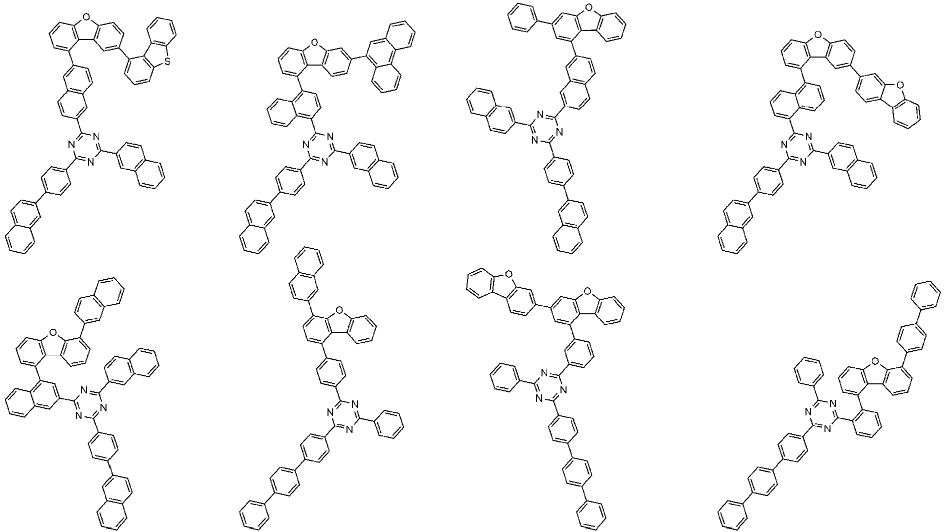

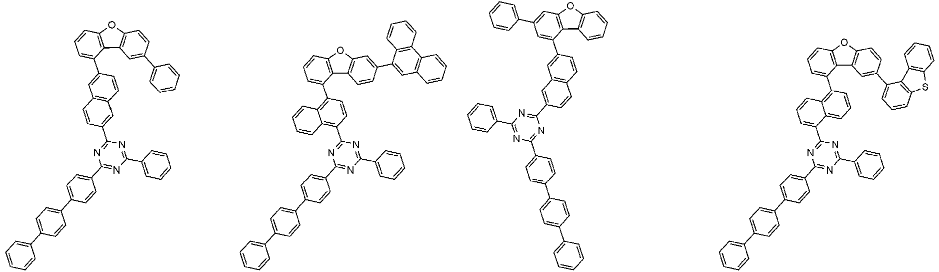

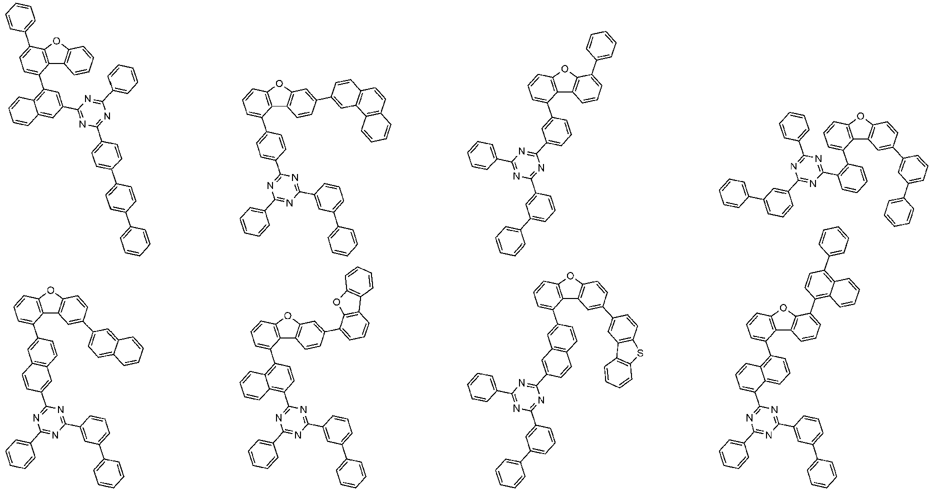

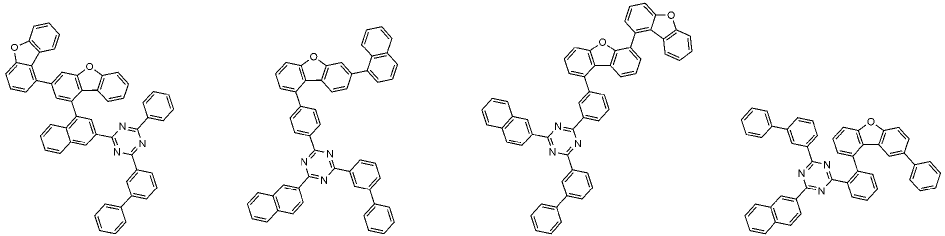

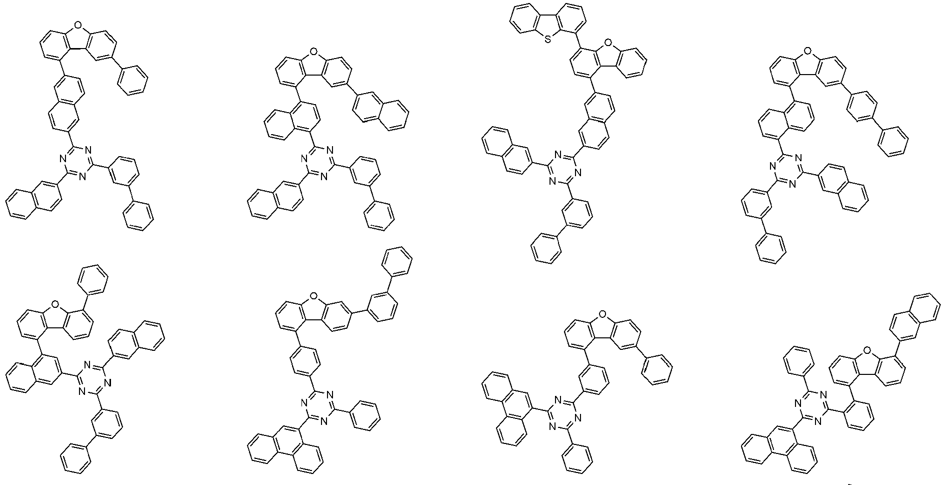

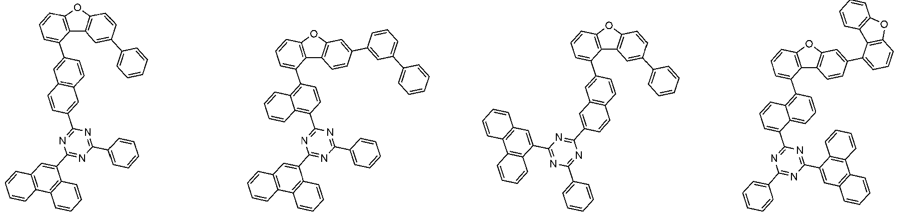

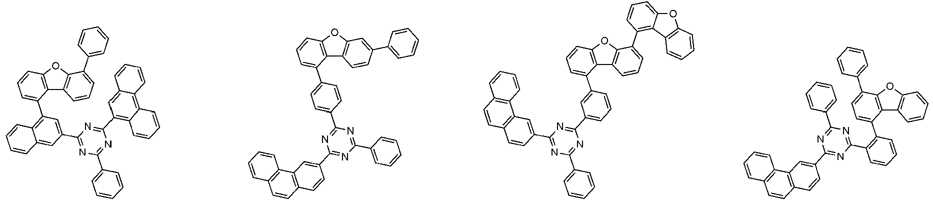

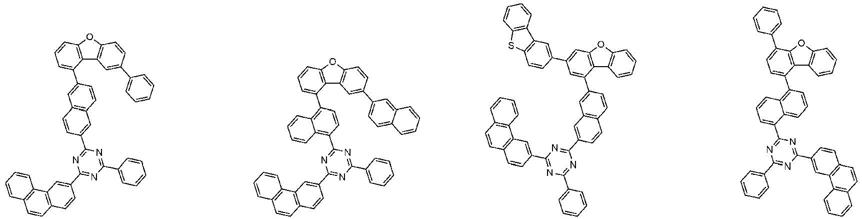

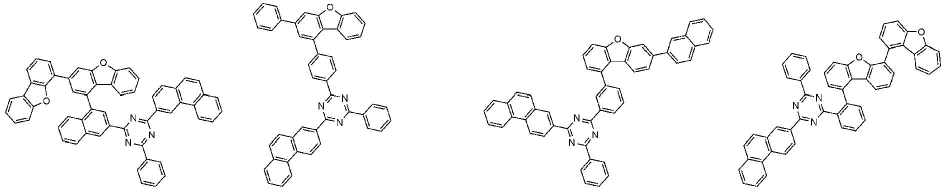

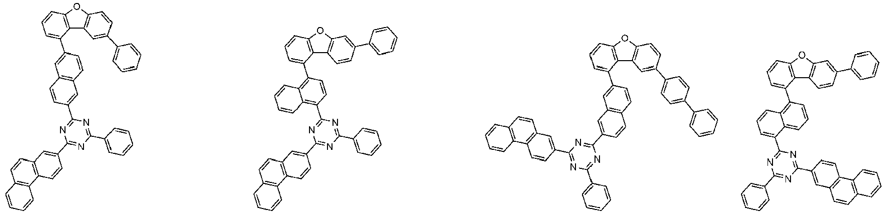

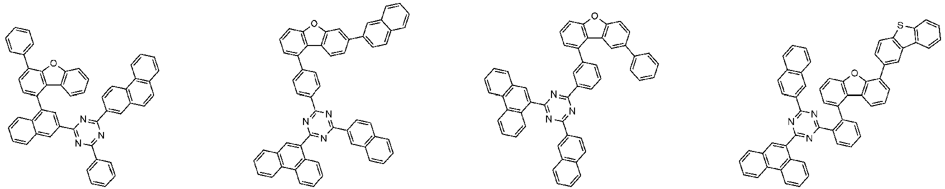

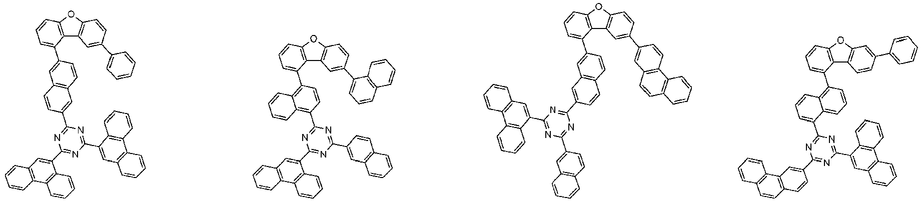

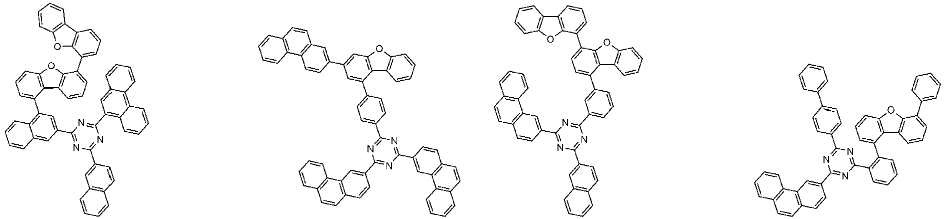

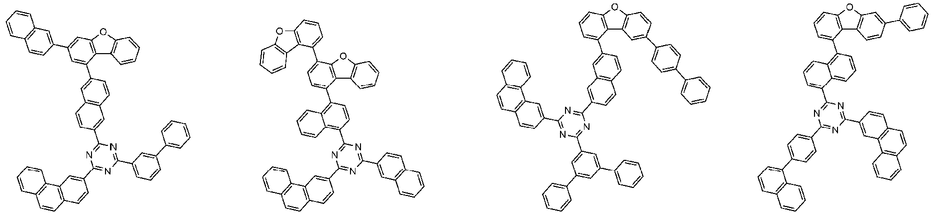

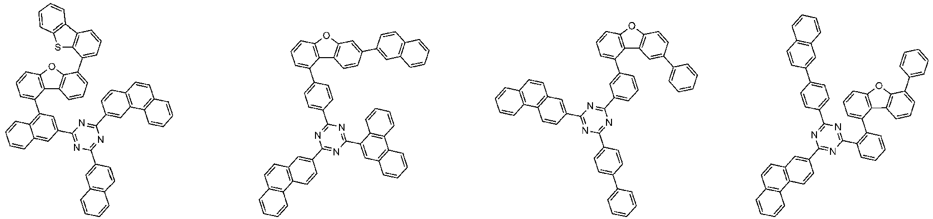

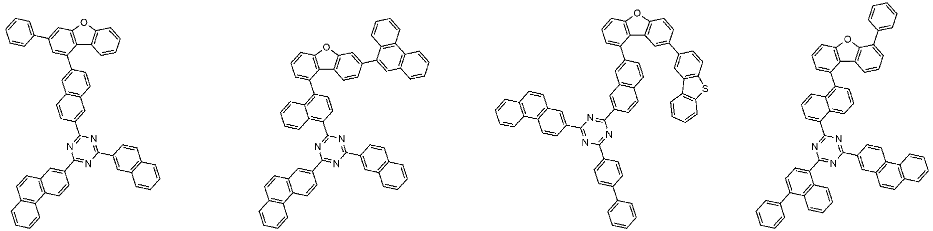

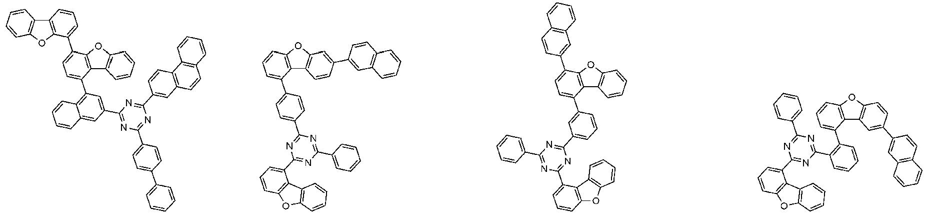

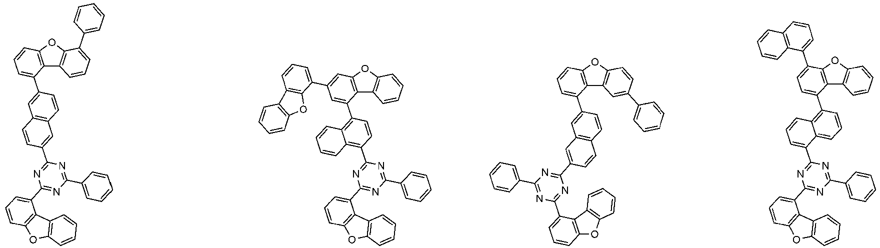

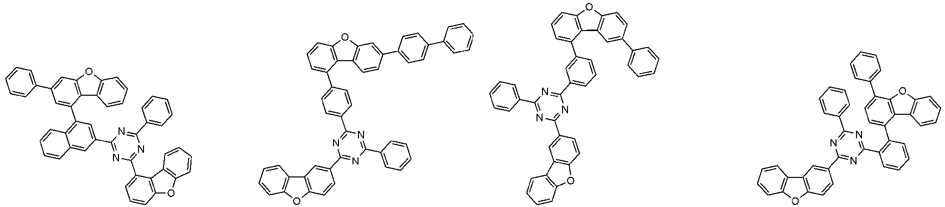

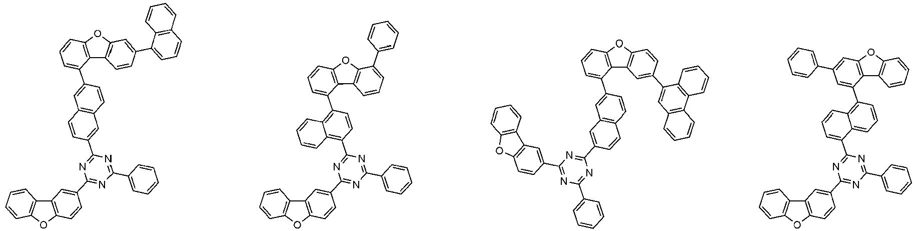

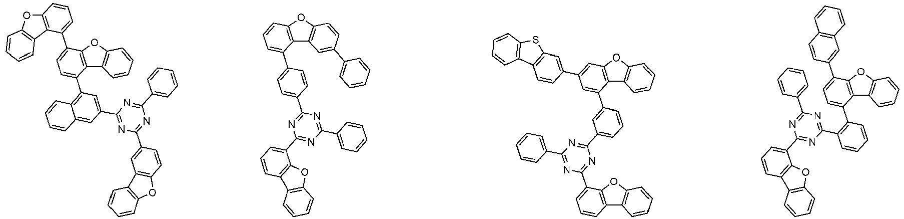

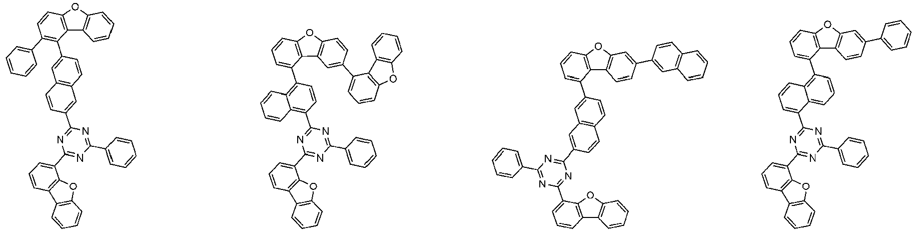

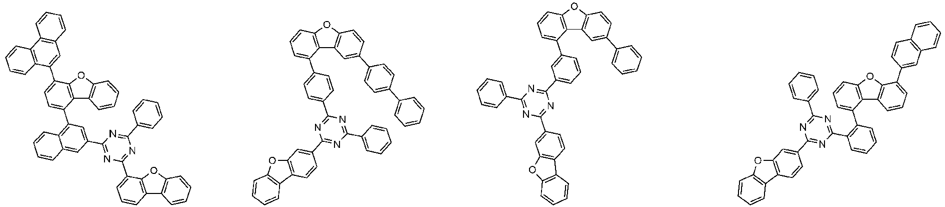

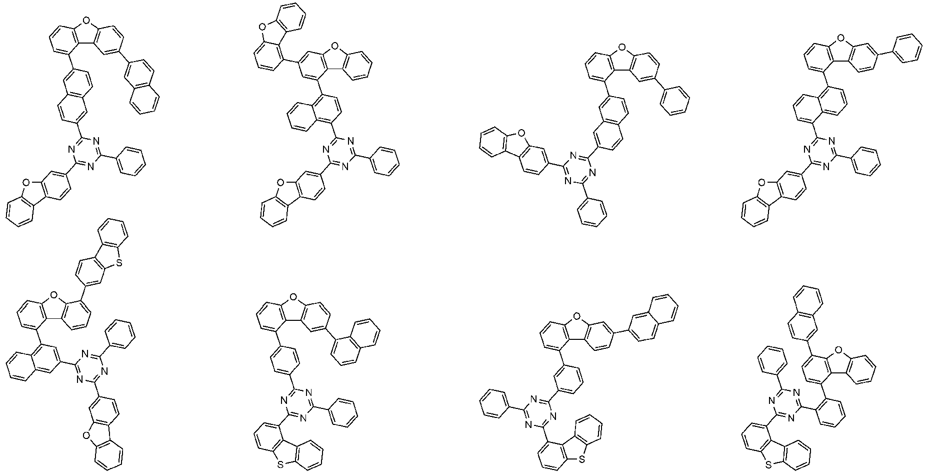

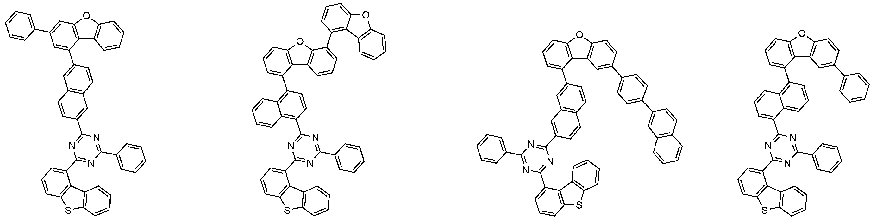

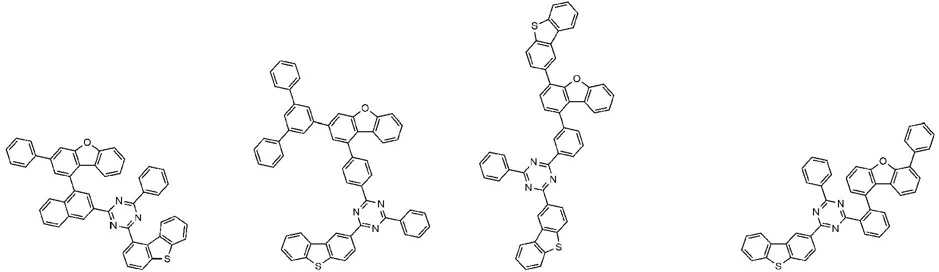

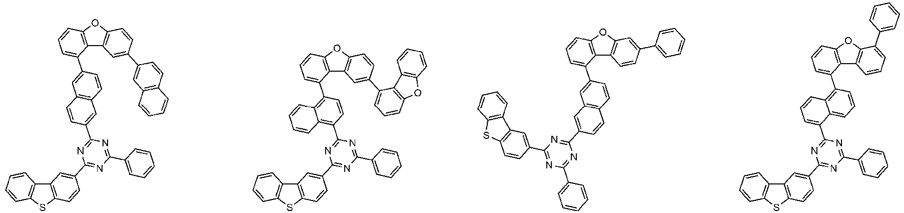

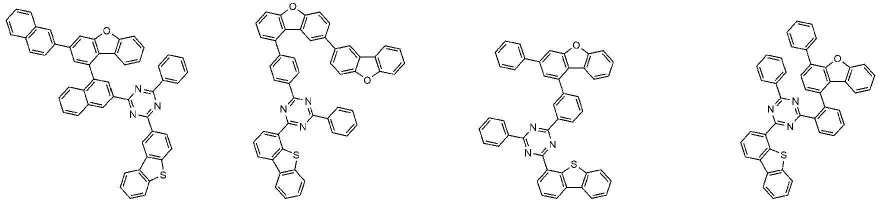

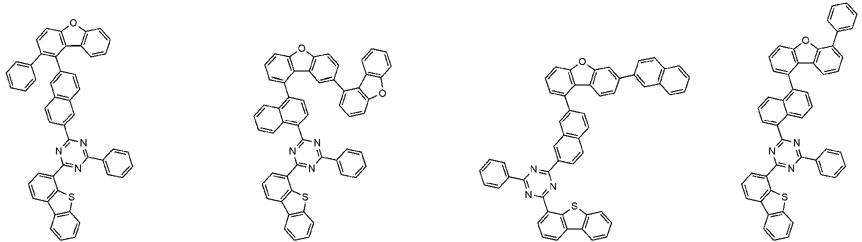

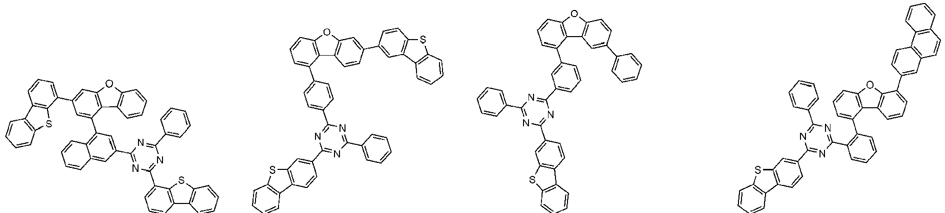

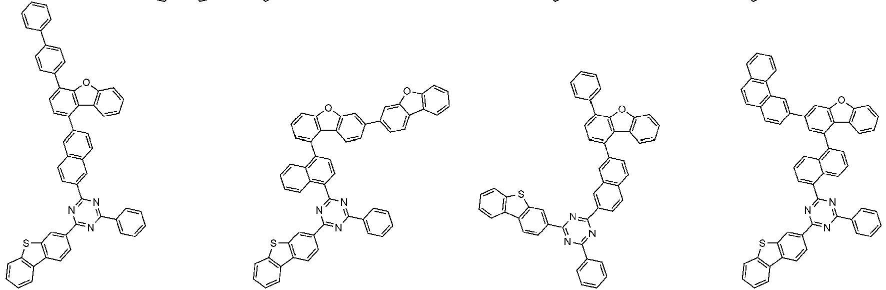

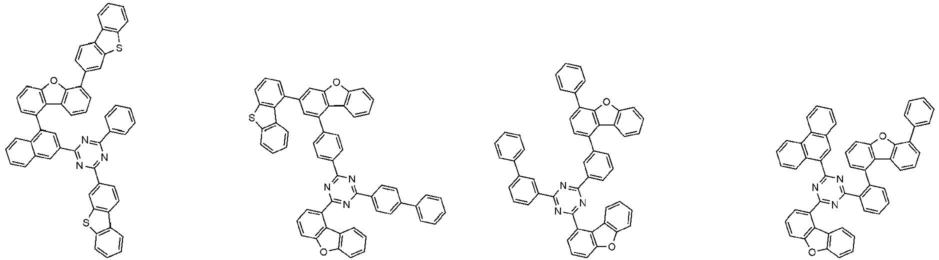

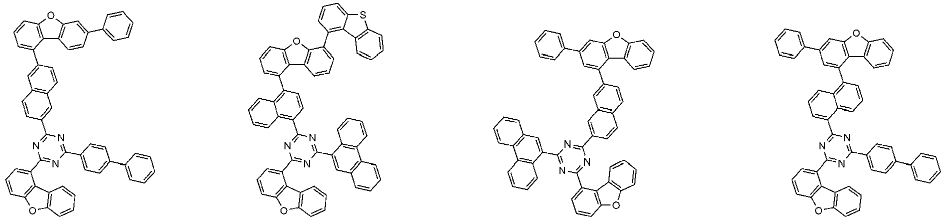

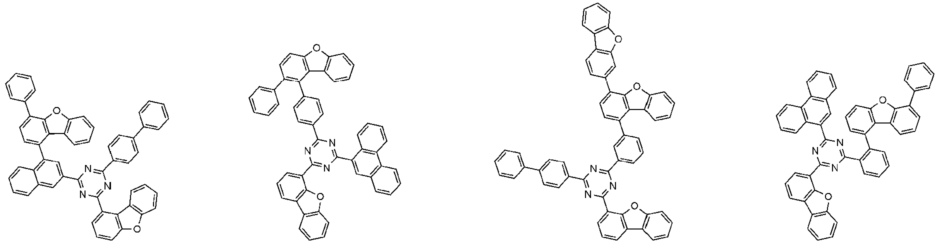

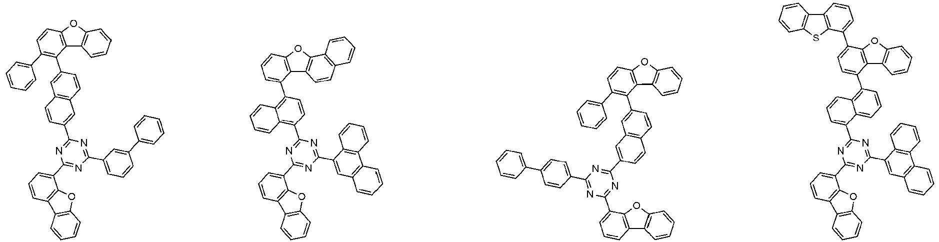

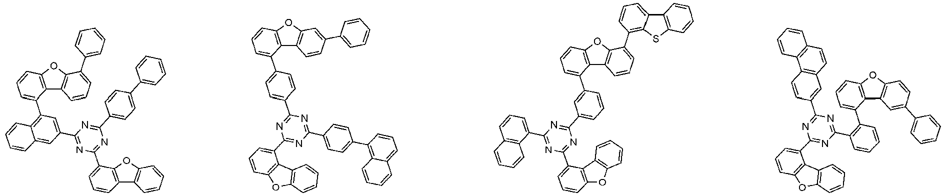

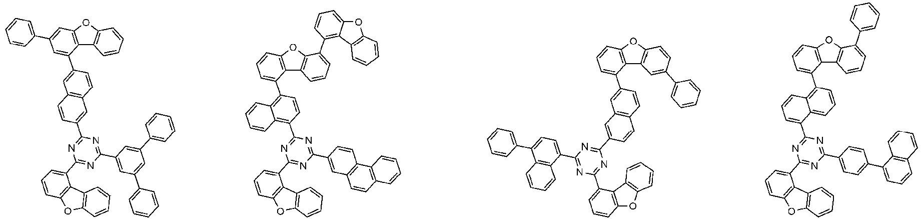

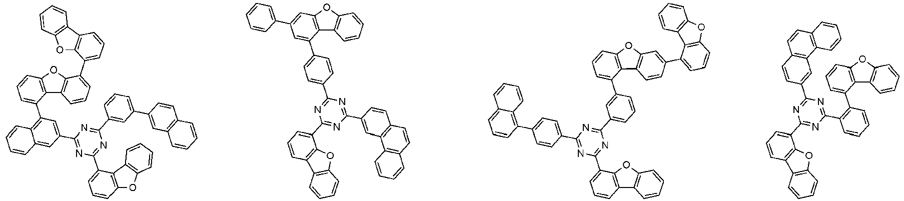

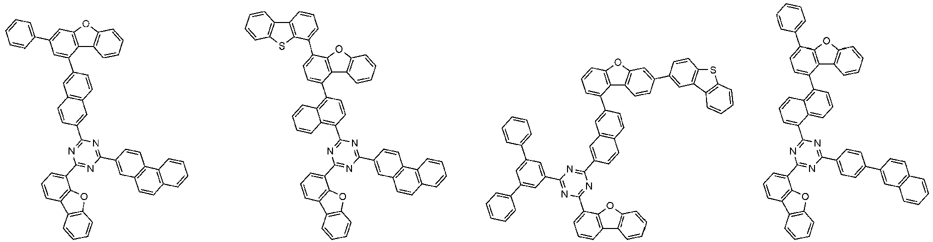

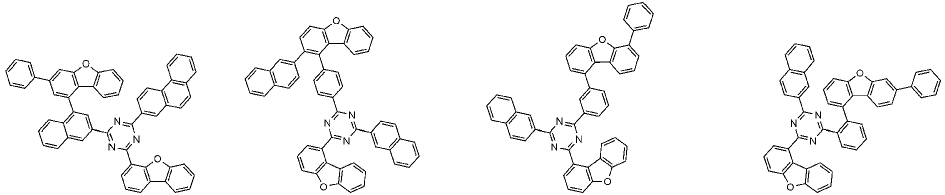

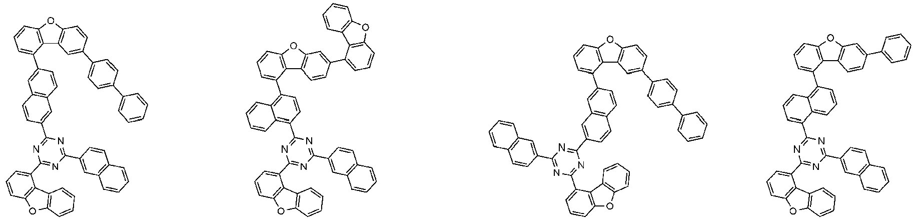

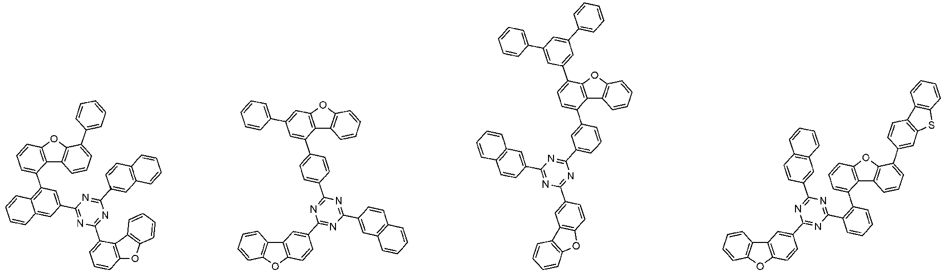

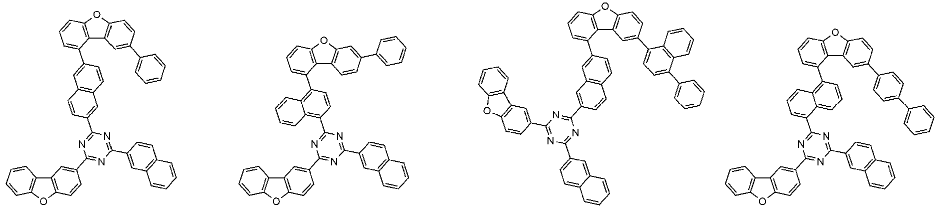

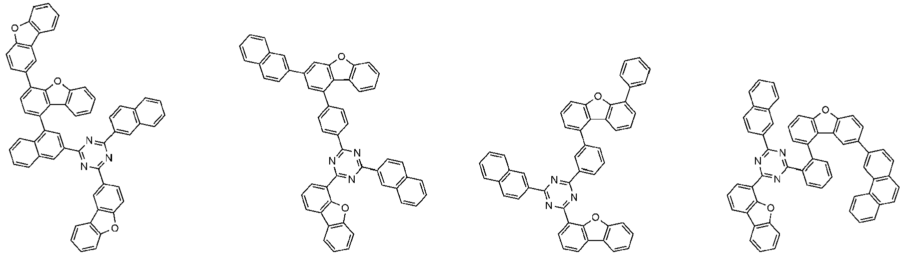

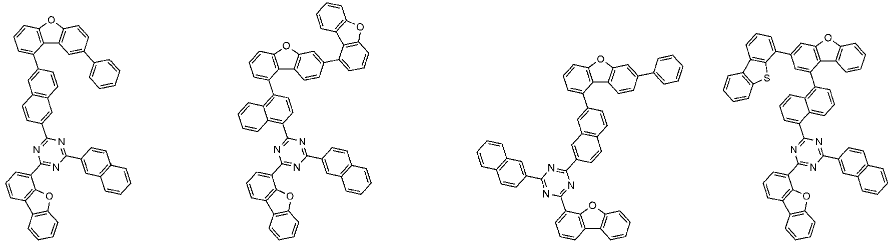

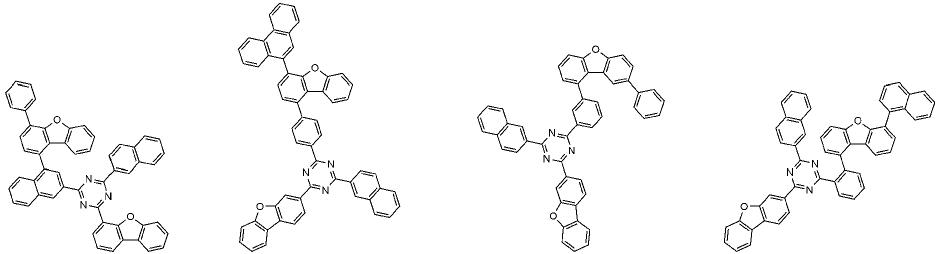

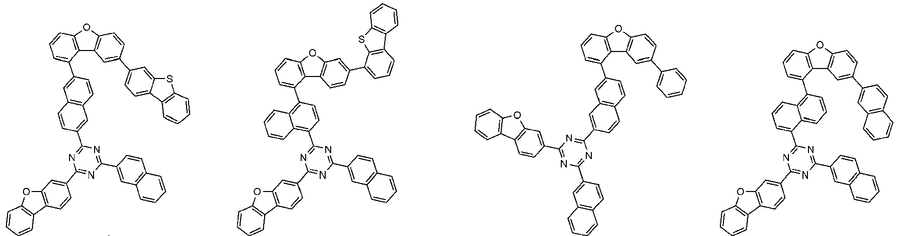

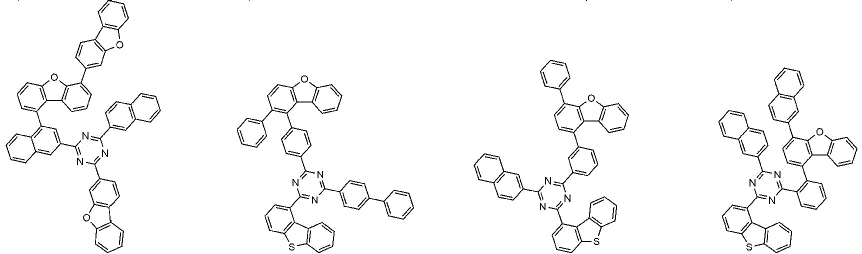

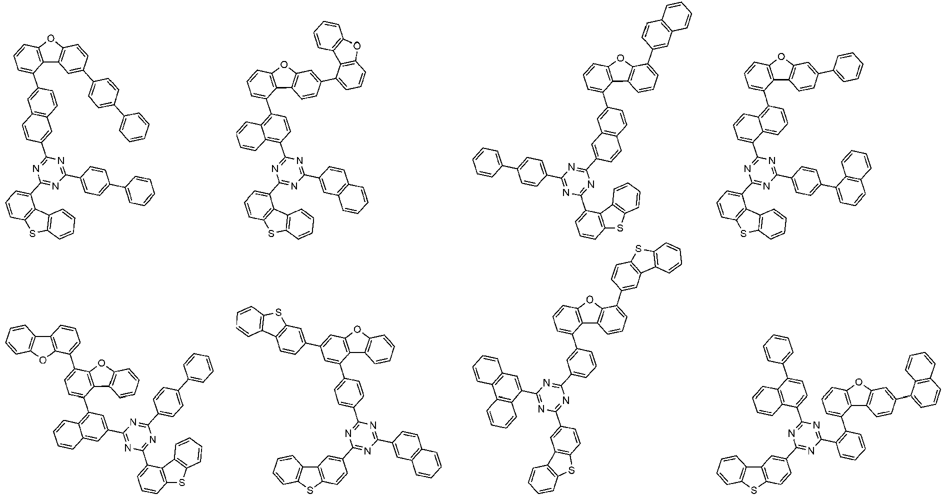

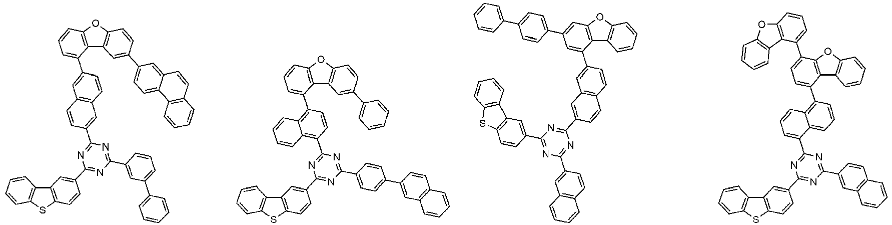

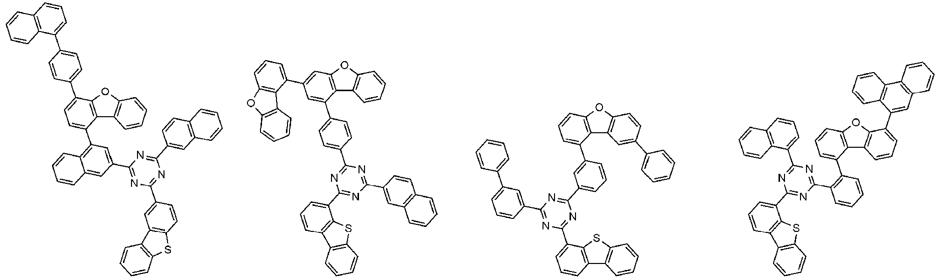

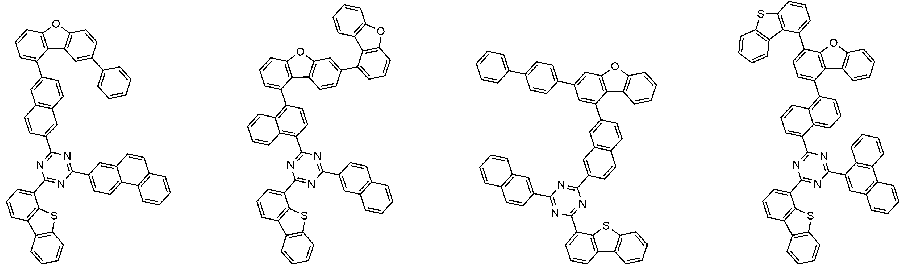

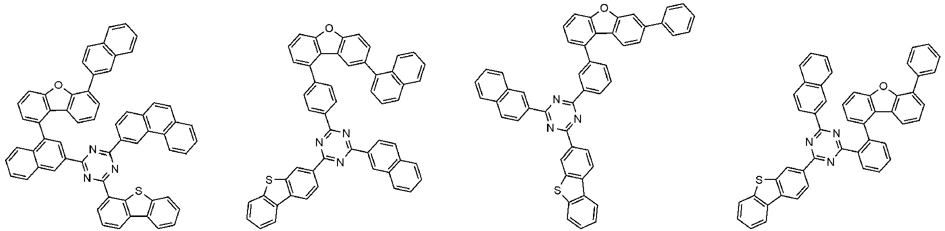

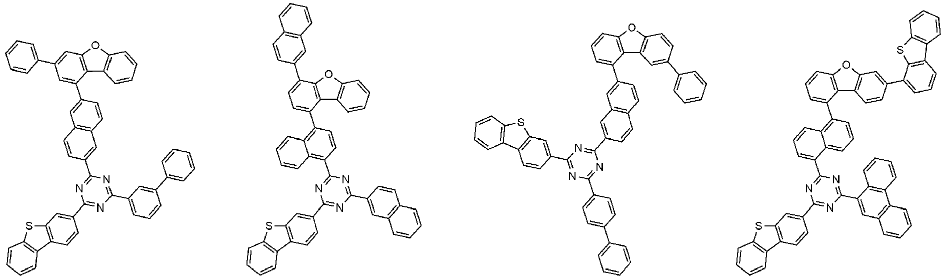

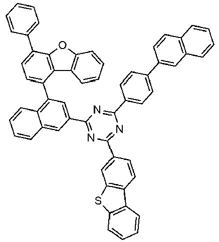

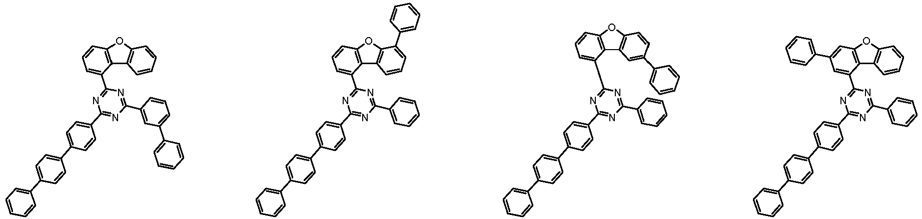

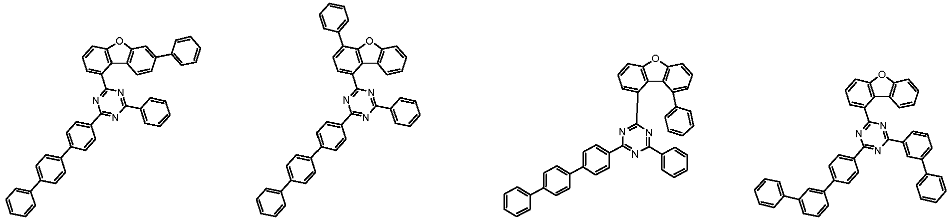

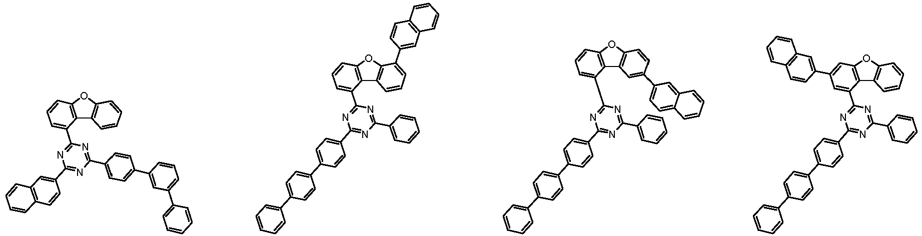

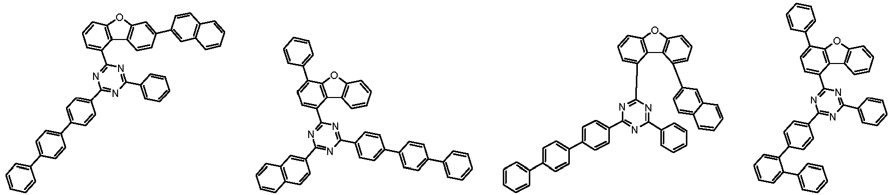

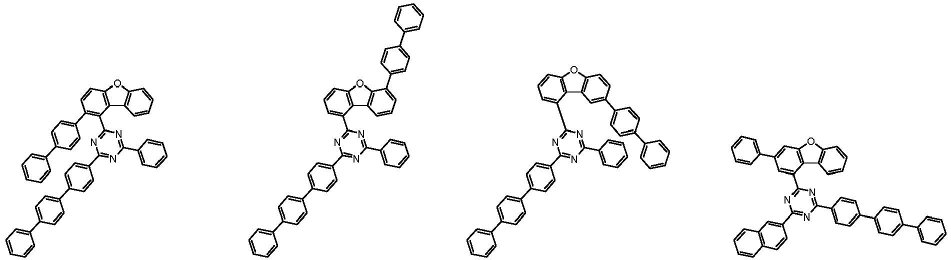

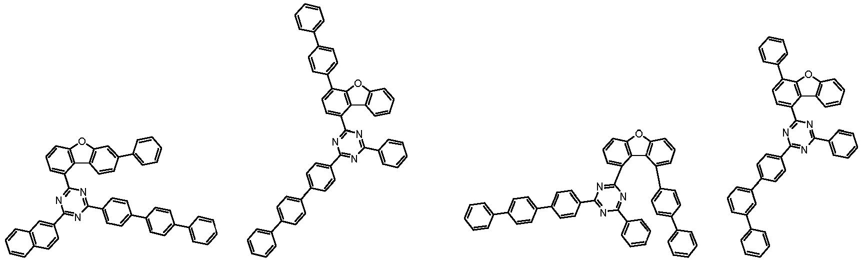

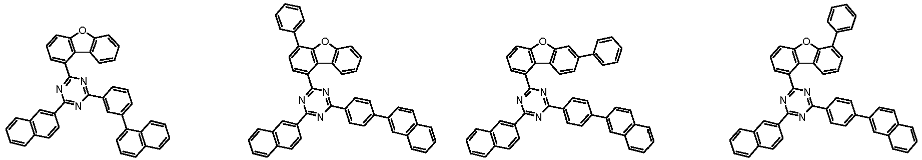

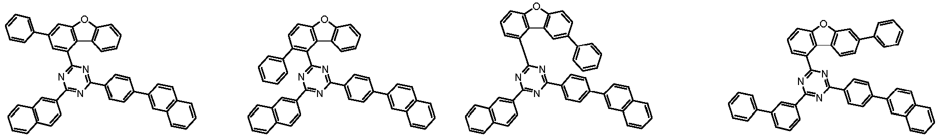

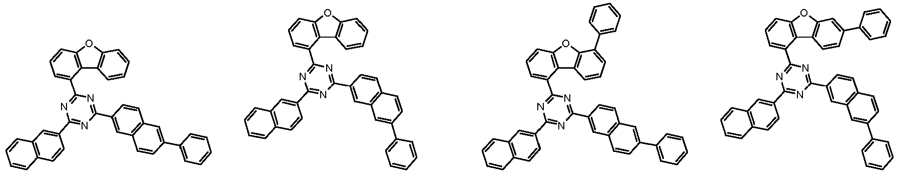

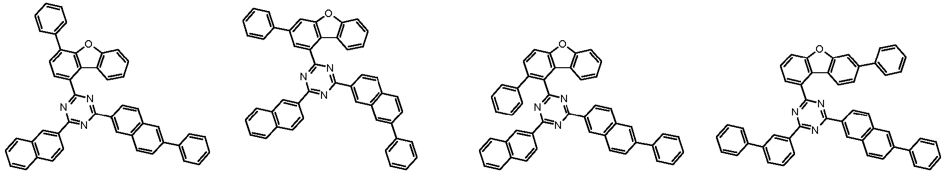

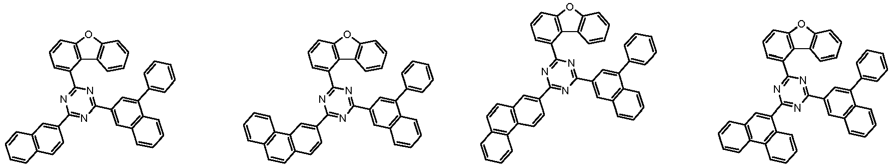

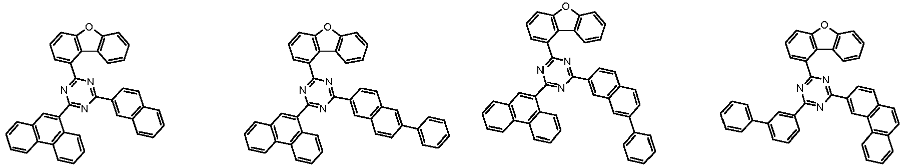

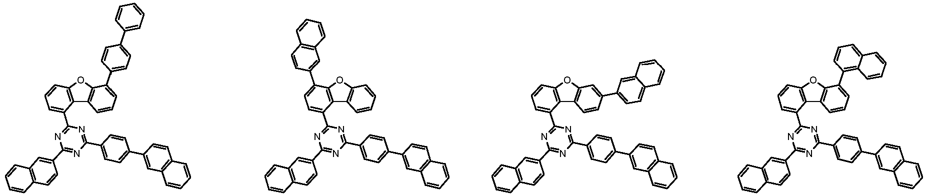

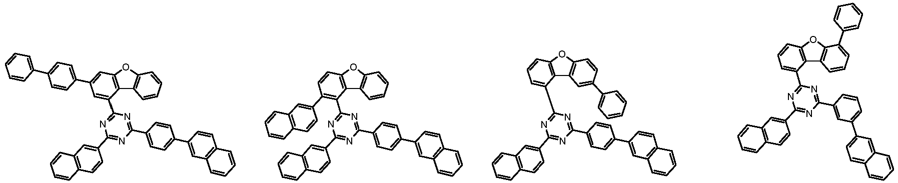

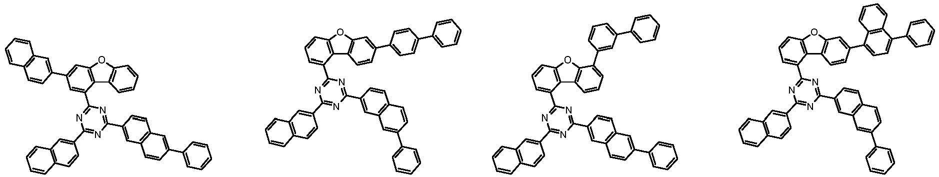

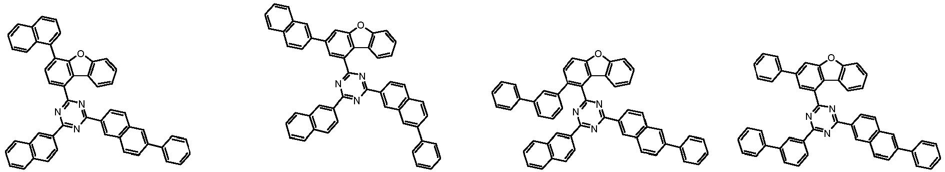

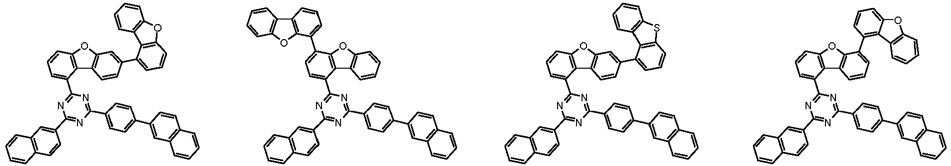

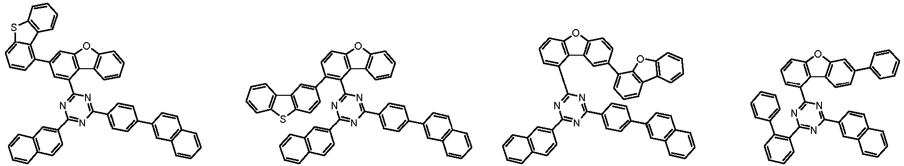

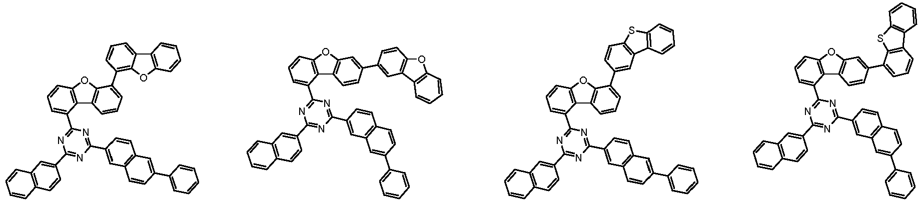

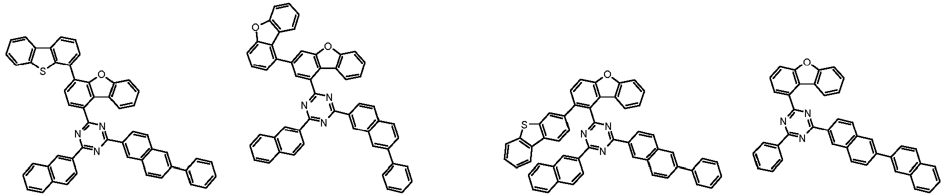

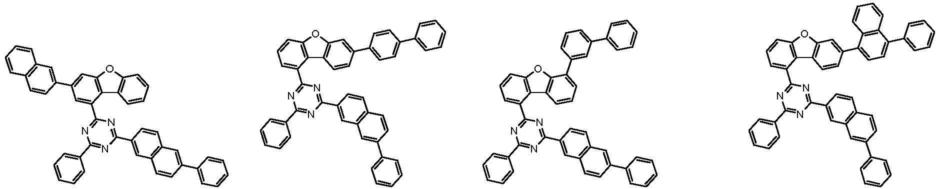

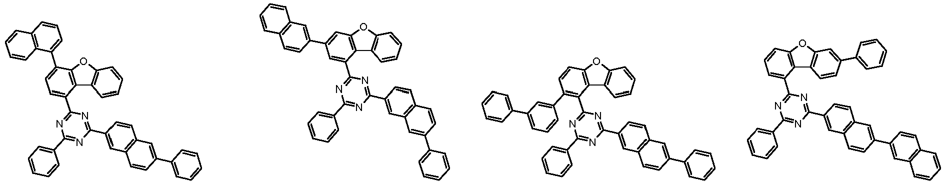

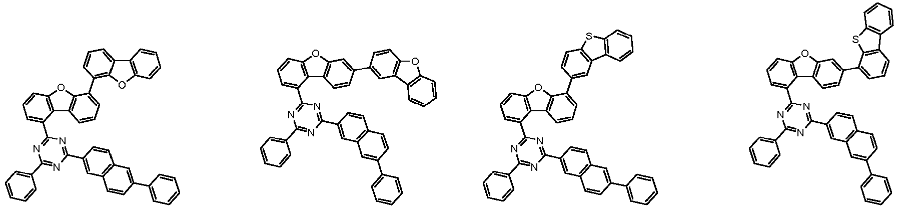

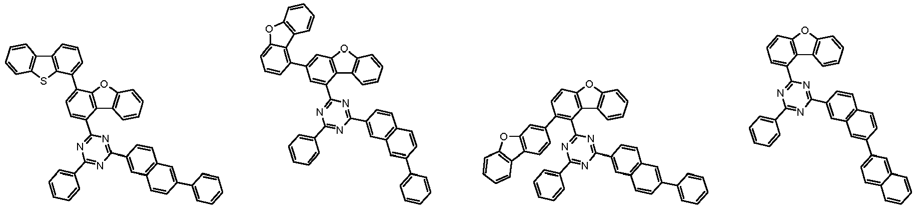

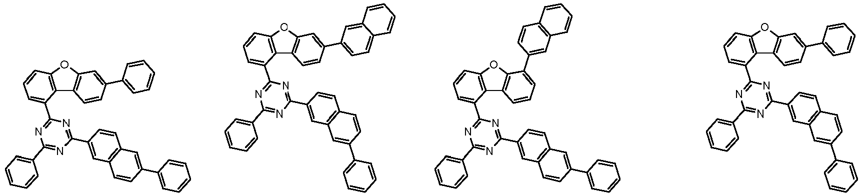

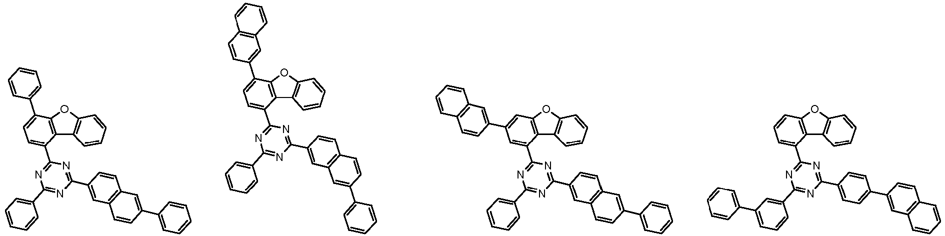

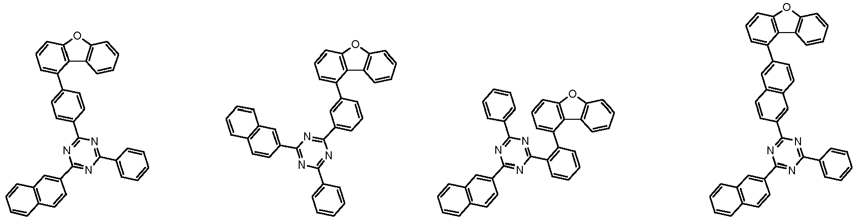

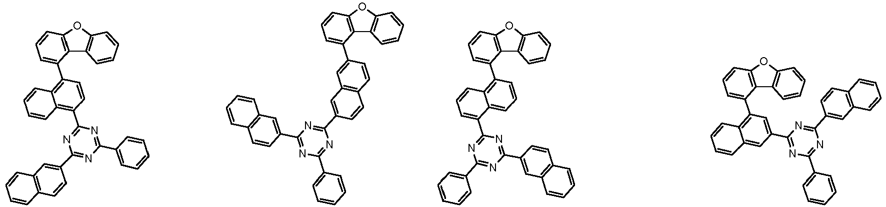

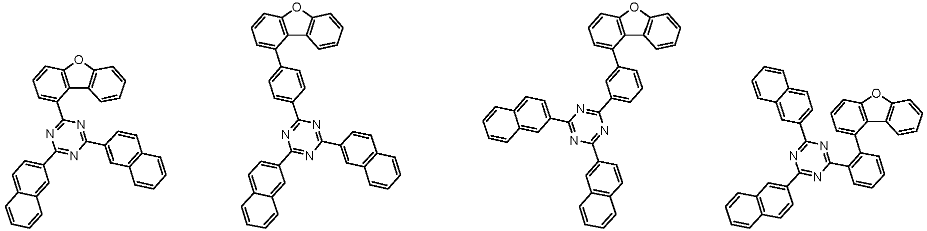

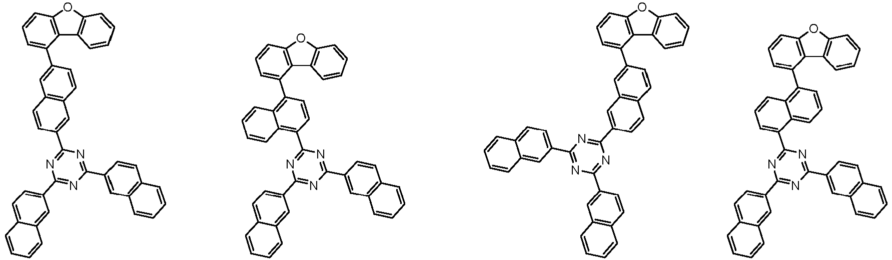

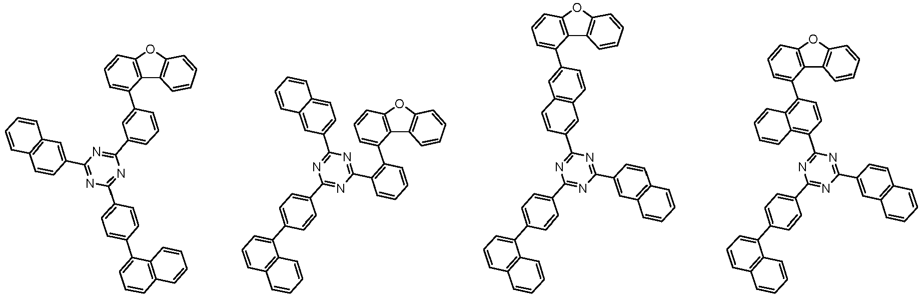

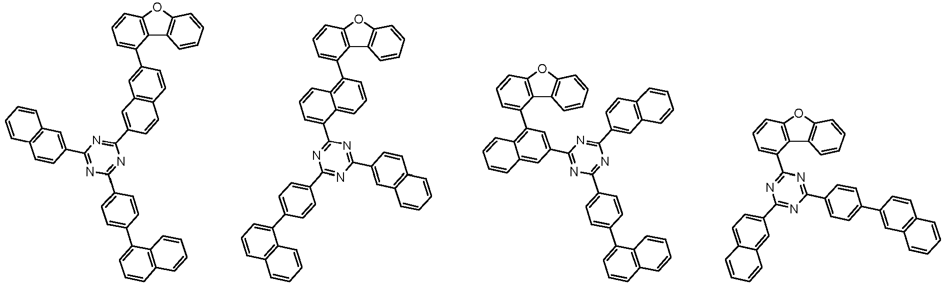

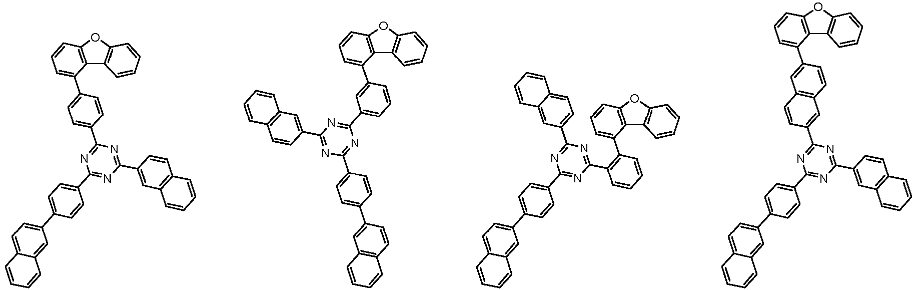

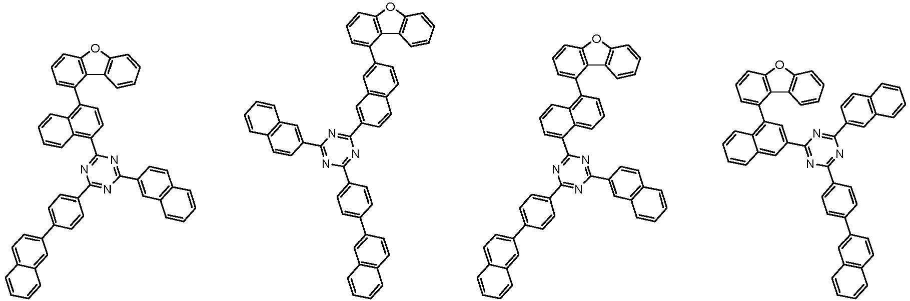

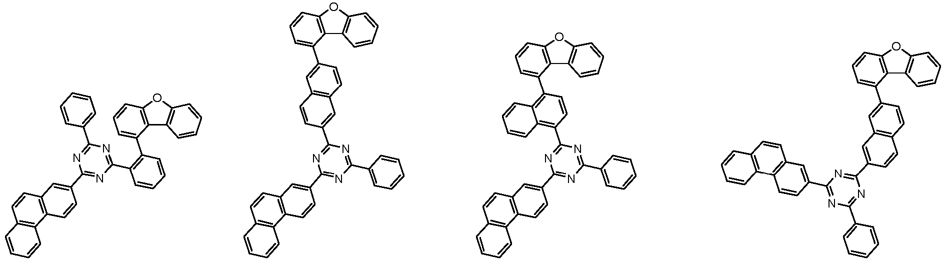

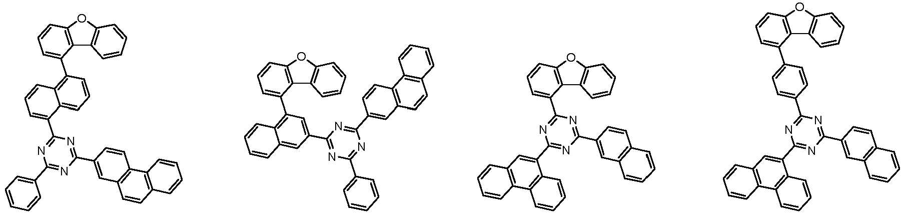

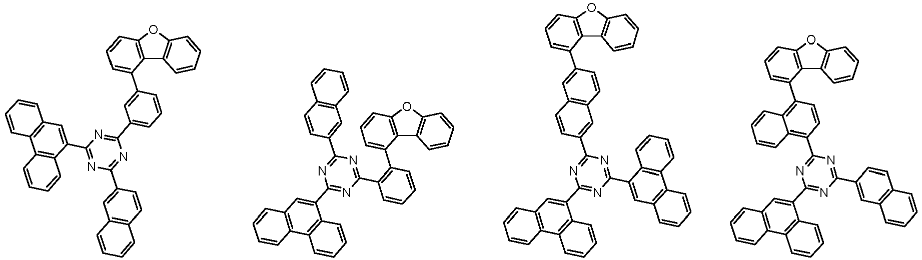

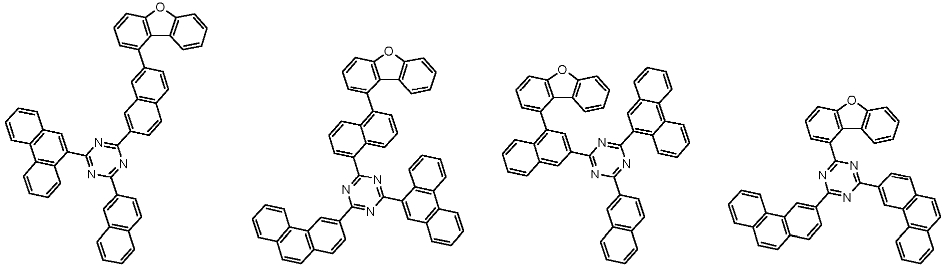

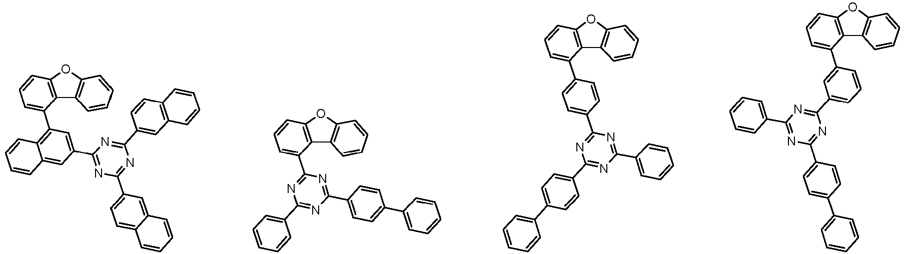

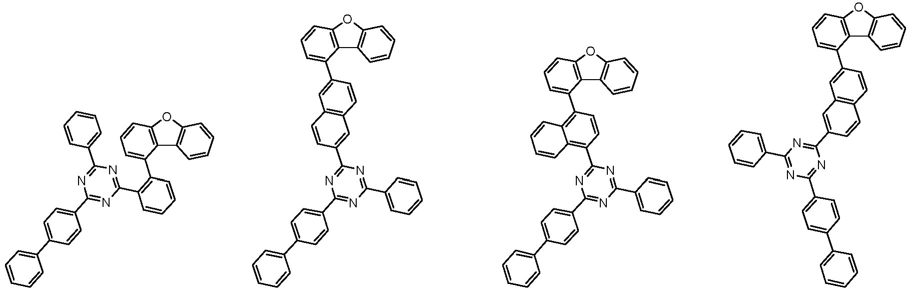

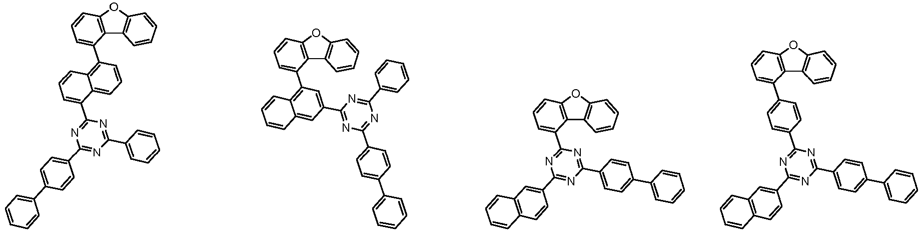

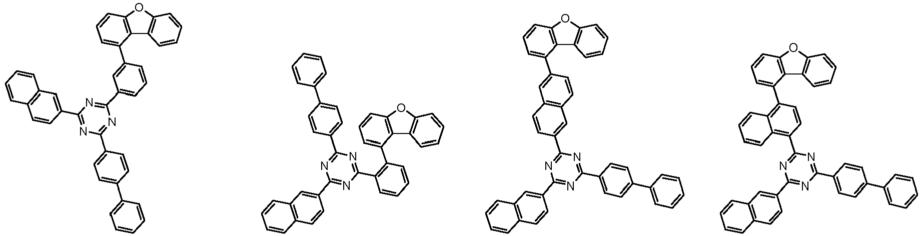

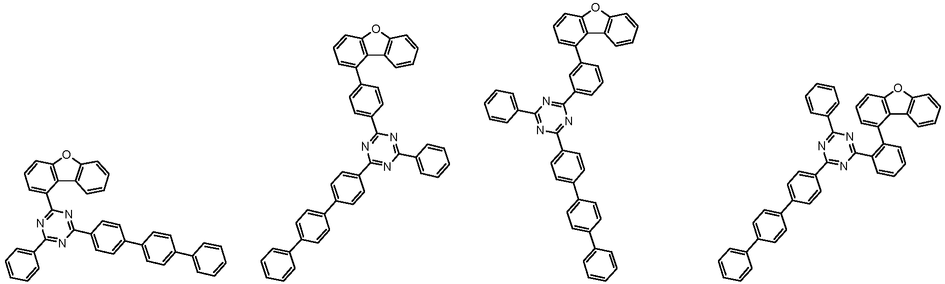

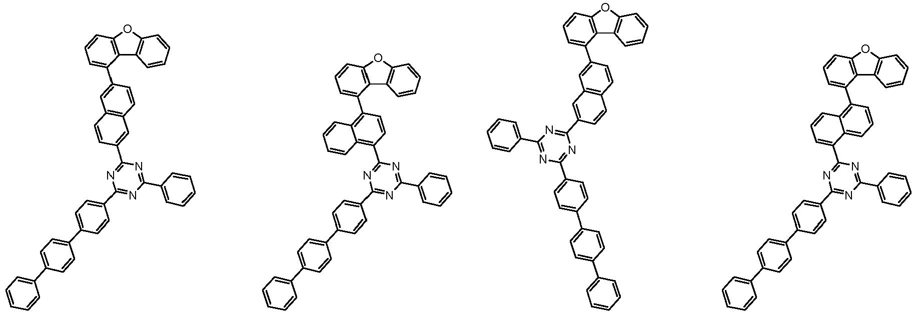

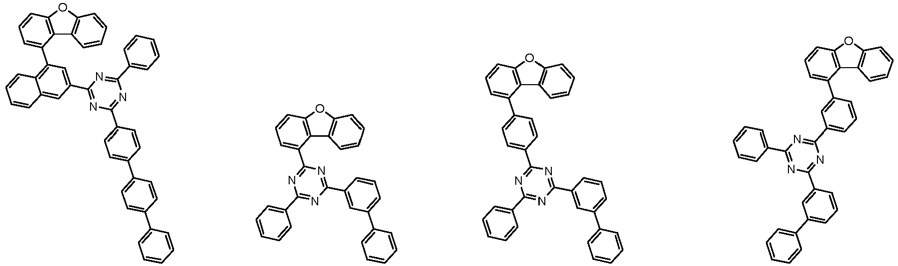

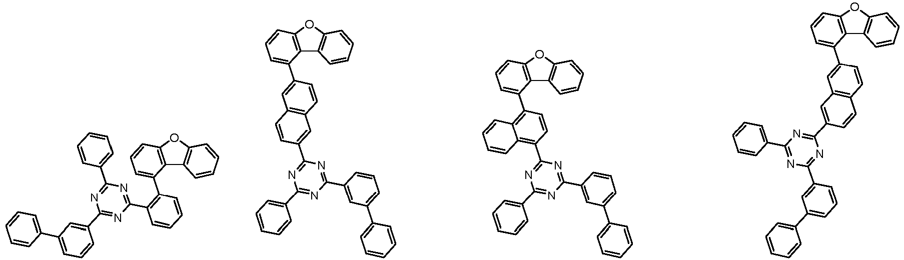

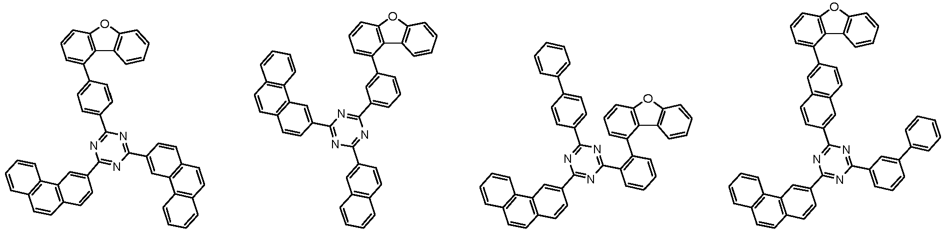

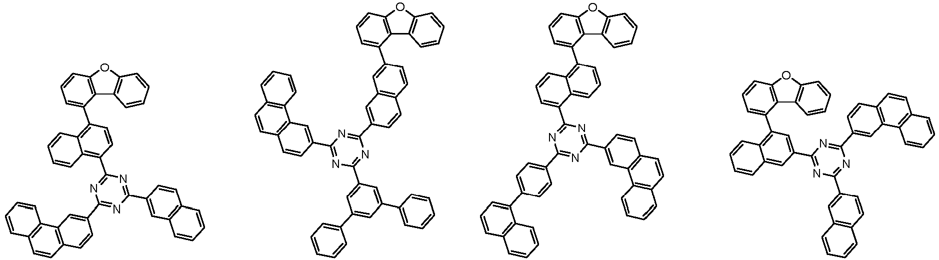

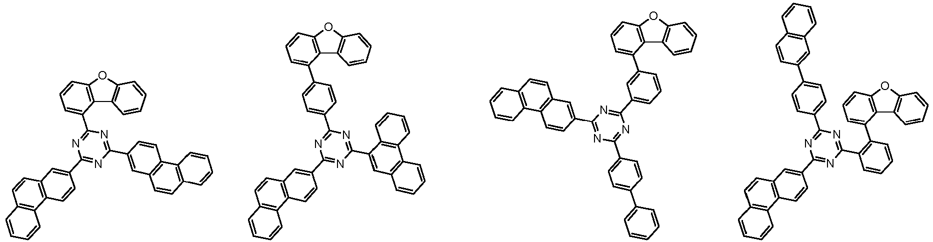

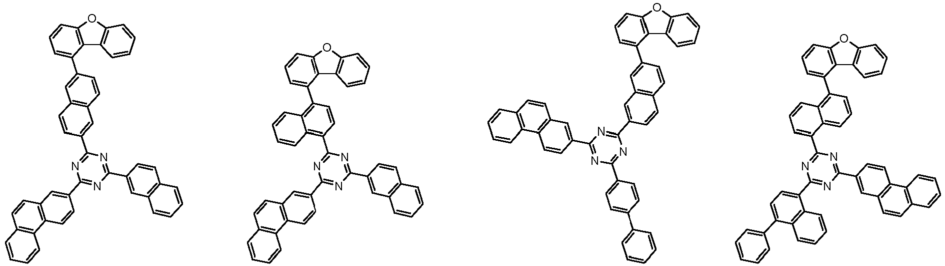

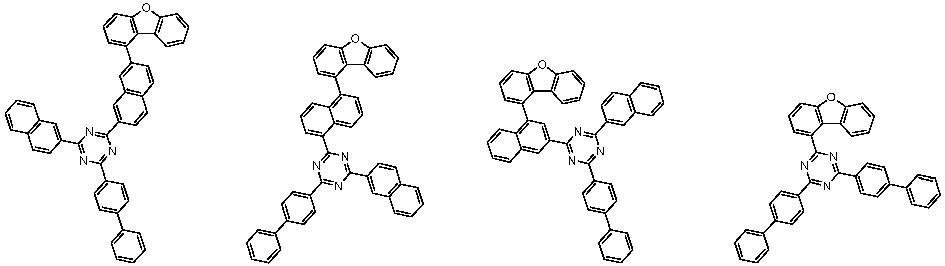

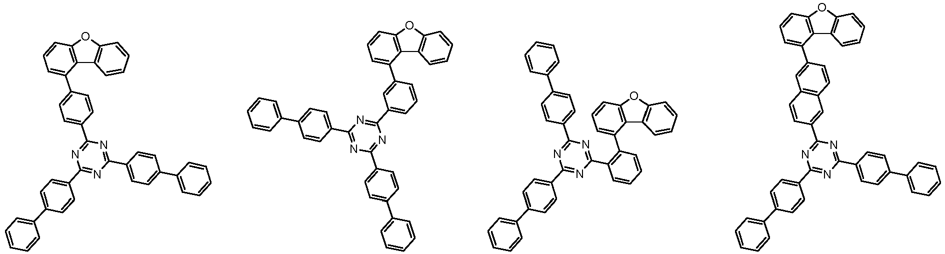

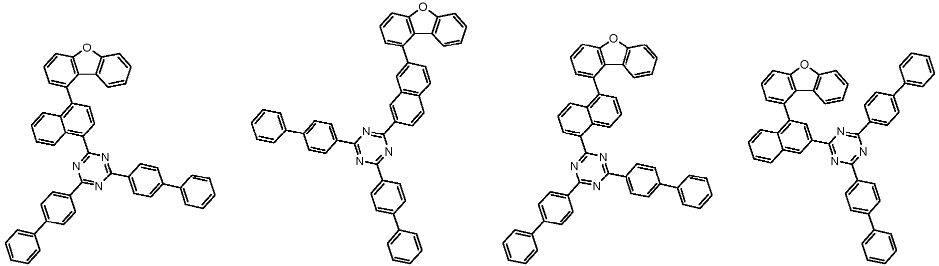

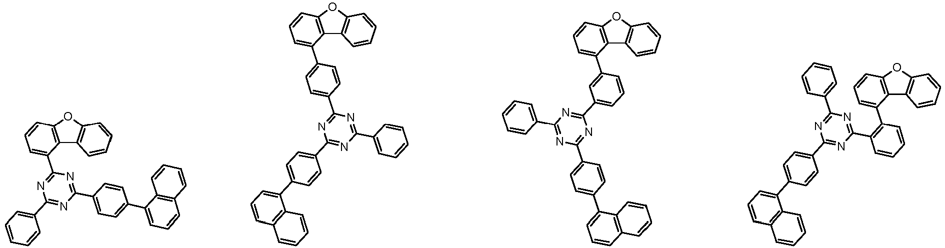

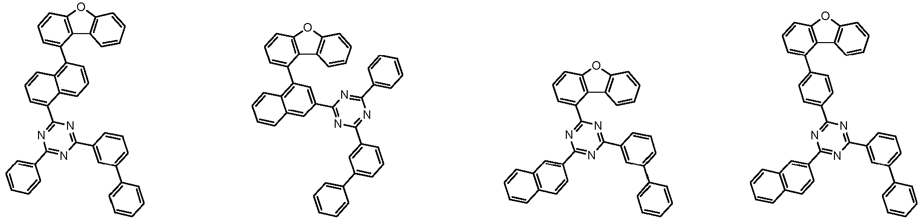

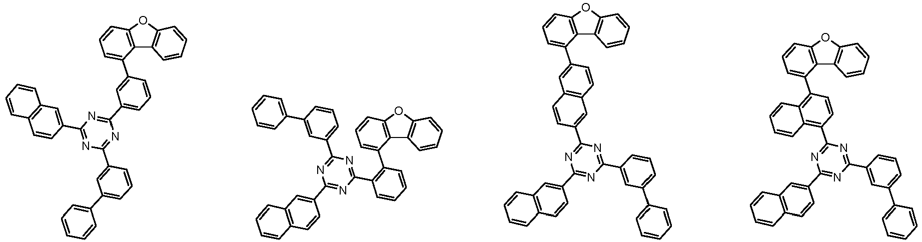

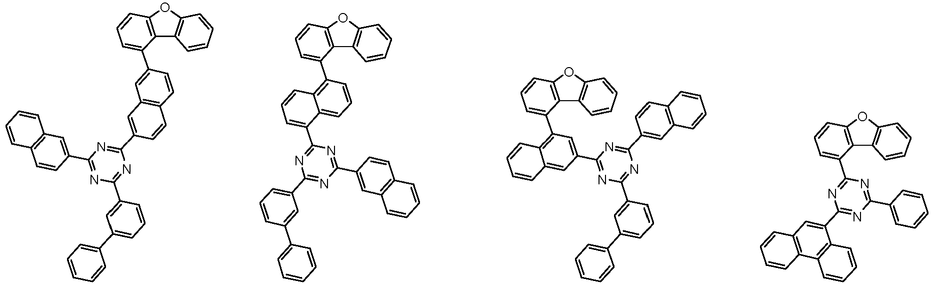

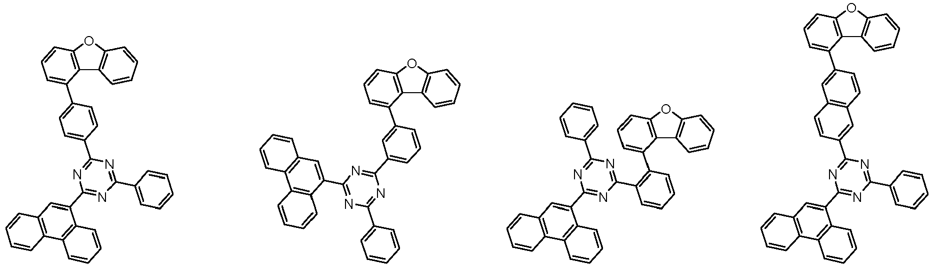

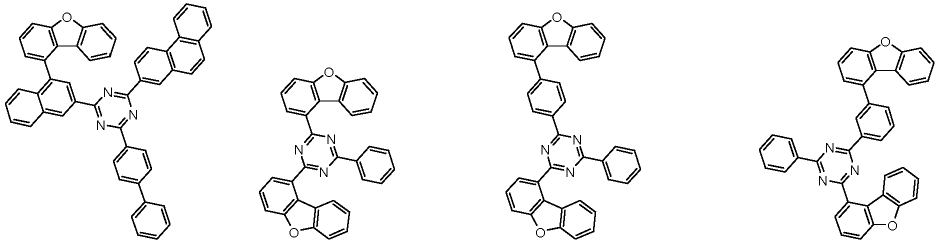

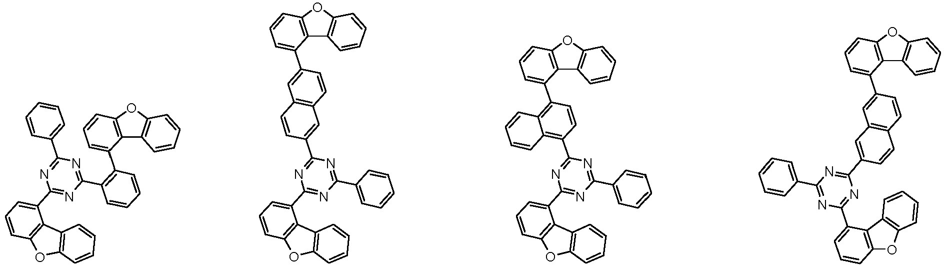

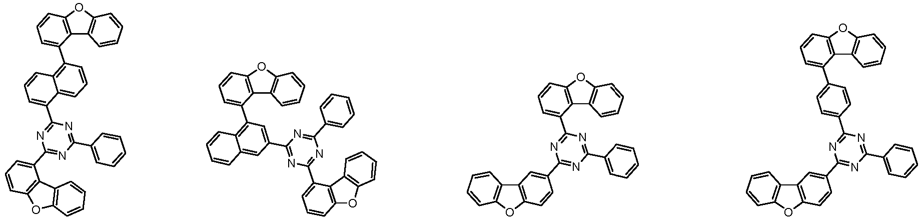

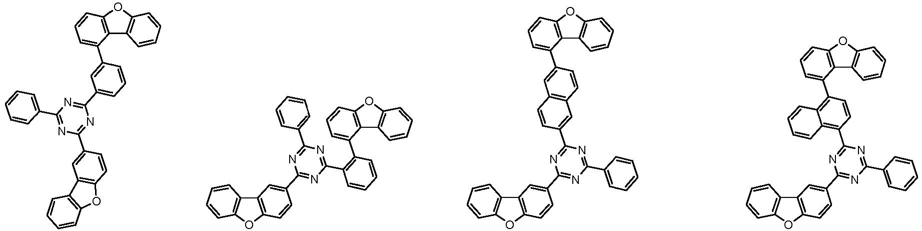

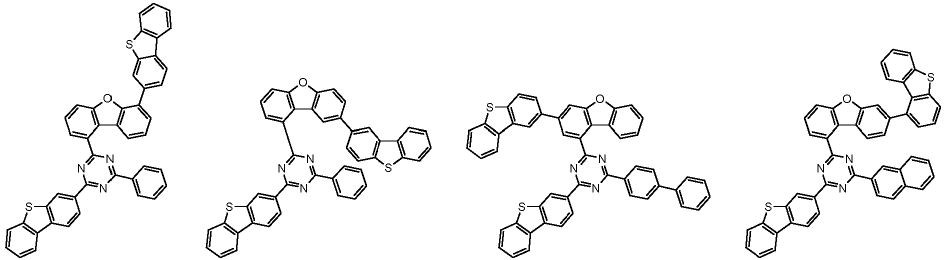

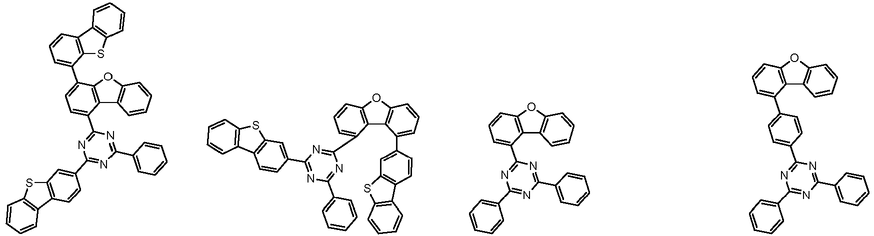

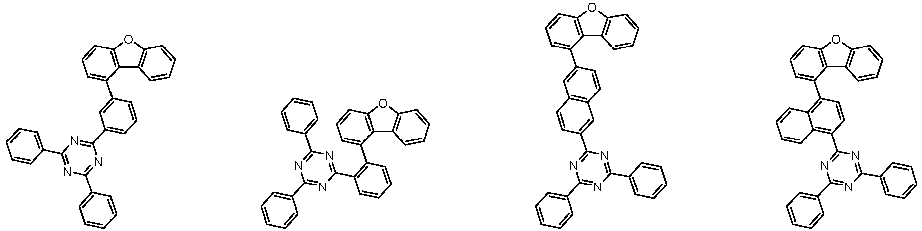

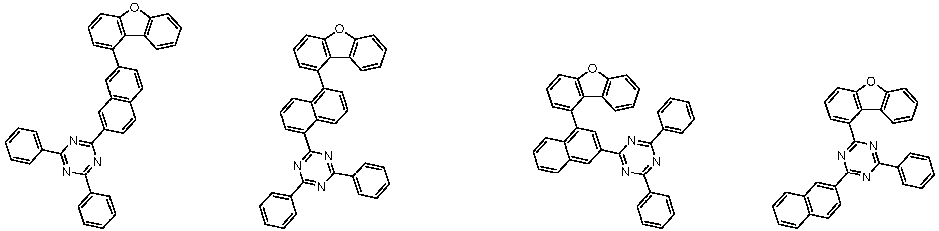

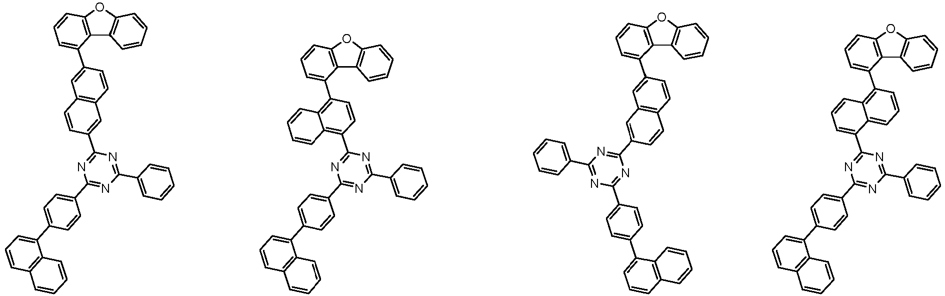

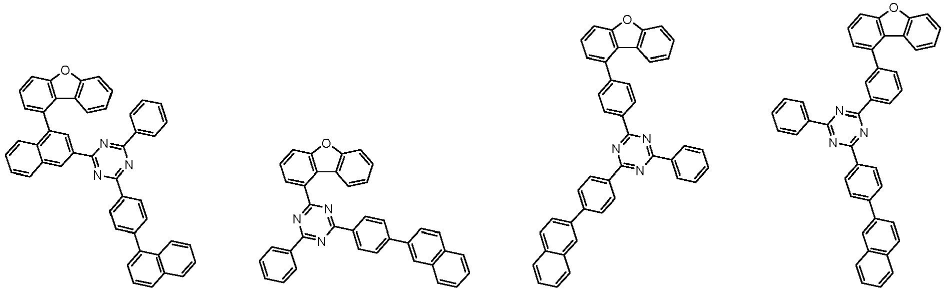

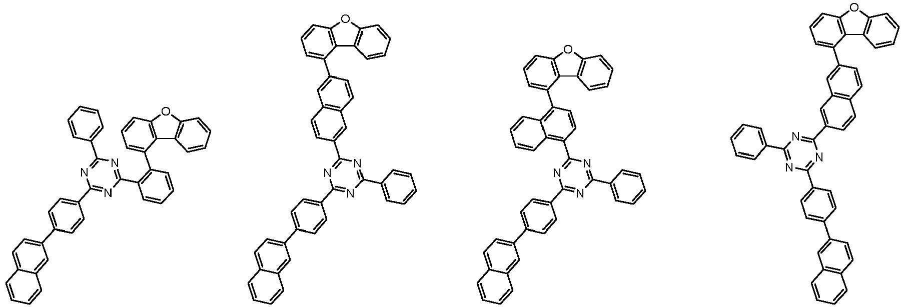

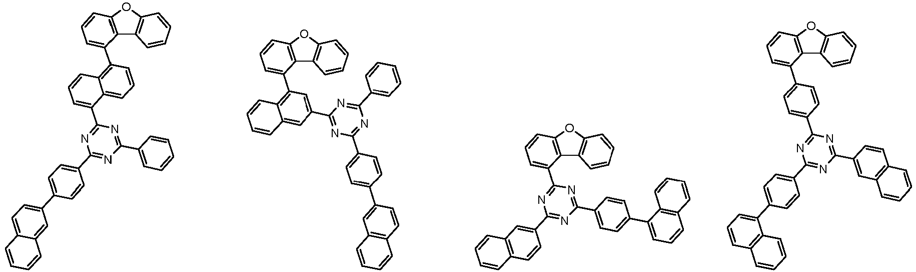

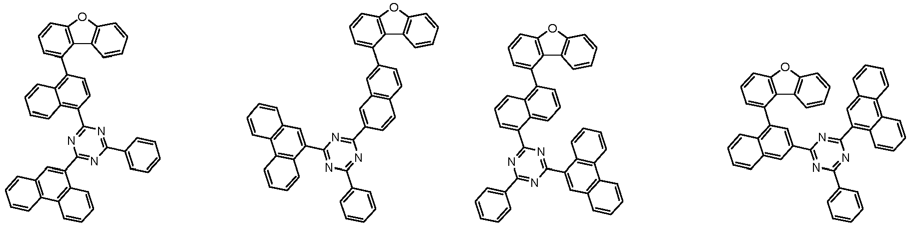

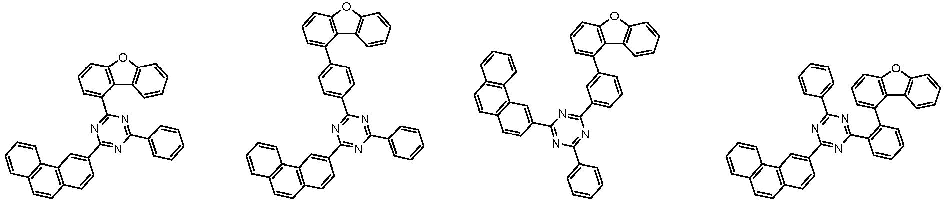

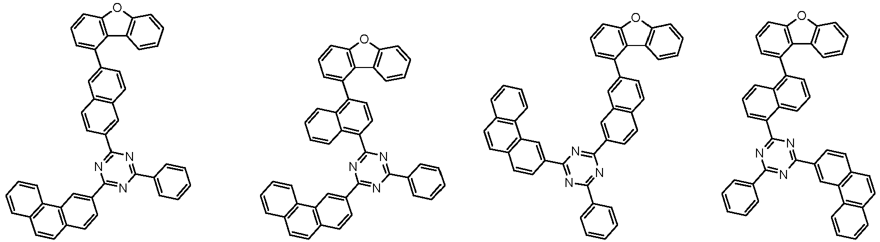

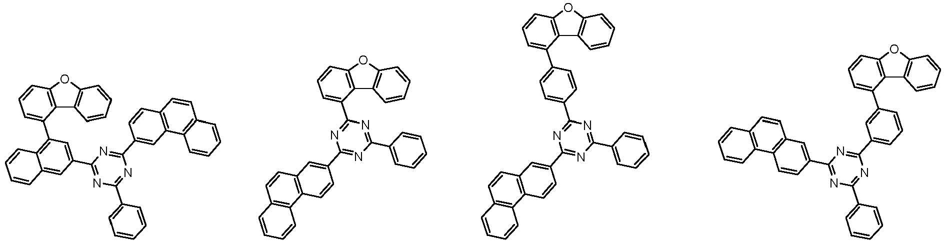

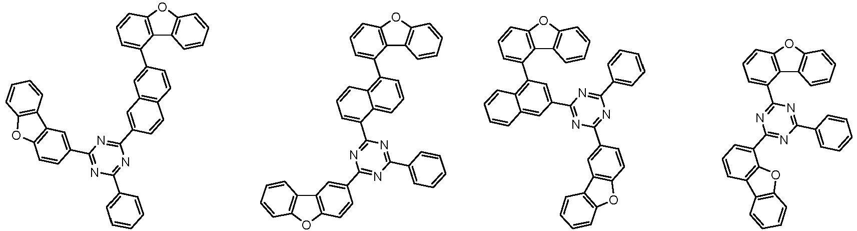

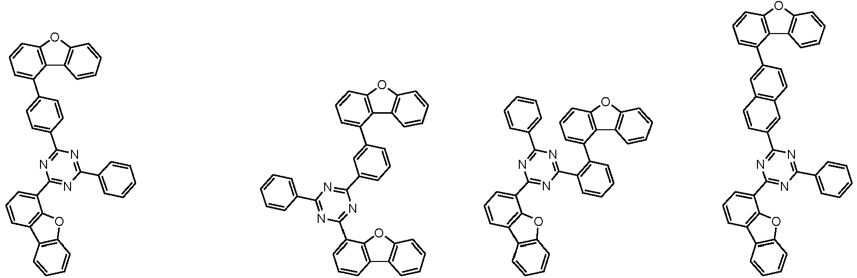

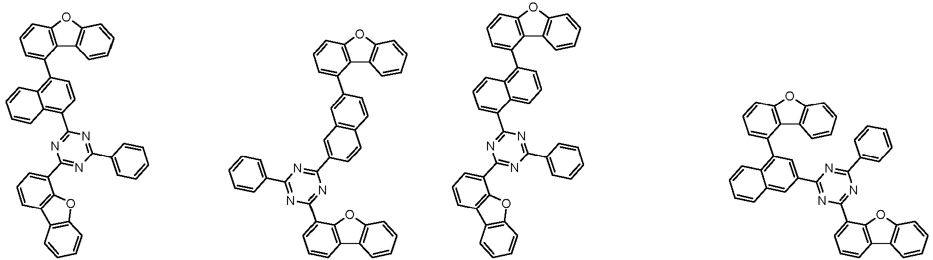

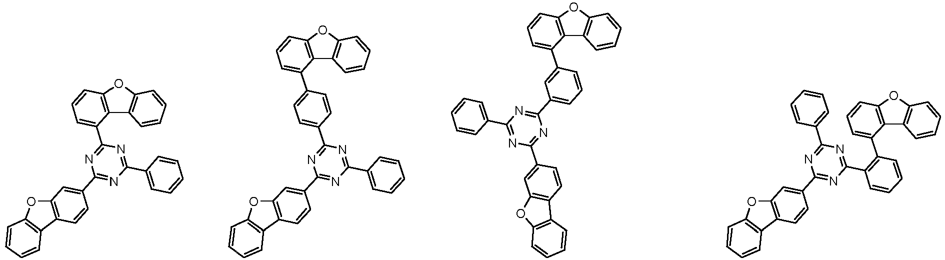

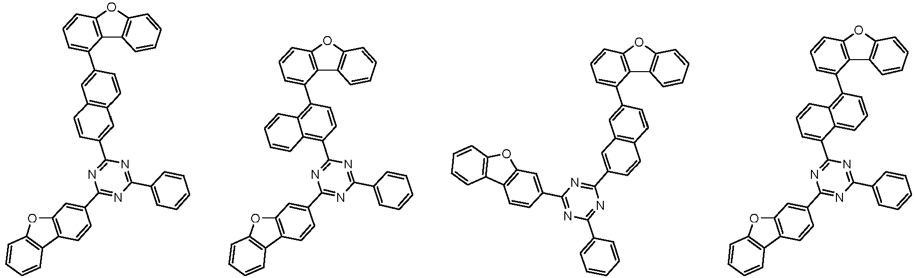

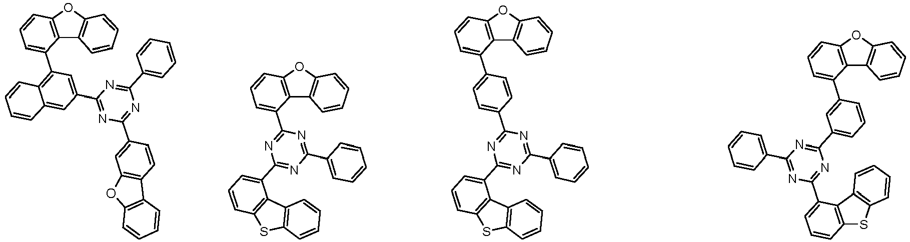

Further, the present disclosure provides a method for preparing the compound represented by Chemical Formula 1 as shown in the following Reaction Scheme 1:

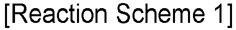

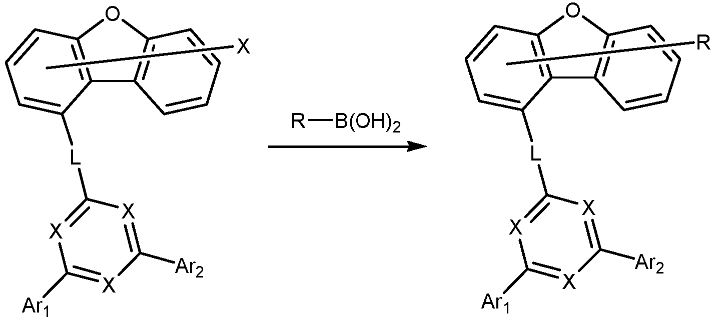

In Reaction Scheme 1, the definition of the remaining substituents except for X are the same as defined above, and X is halogen, preferably bromo or chloro. Reaction Scheme 1 is a Suzuki coupling reaction, which is preferably carried out in the presence of a palladium catalyst and a base, and a reactive group for the above reaction can be changed as known in the art. The above preparation method can be further embodied in Preparation Examples described hereinafter.

In Chemical Formulas 2 and 3, preferably, R' is a substituent represented by Chemical Formula 4, or a substituted or unsubstituted C₆₋₁₂ aryl. More preferably, R' is a substituent represented by Chemical Formula 4, or phenyl, biphenyl, or naphthyl.

Preferably, L' is a single bond, a substituted or unsubstituted C₆₋₁₂ arylene. More preferably, L' is a single bond, phenylene, biphenyldiyl, terphenyldiyl, naphthylene, or -(phenylene)-(naphthylene)-. More preferably, L' is a single bond, 1,4-phenylene, 4,4'-biphenyldiyl, or 2,6-naphthylene.

Preferably, L'₁ and L'₂ are each independently a single bond, or a substituted or unsubstituted C₆₋₁₂ arylene. Preferably, L'₁ and L'₂ are each independently a single bond, phenylene, or biphenyldiyl. More preferably, L'₁ and L'₂ are each independently a single bond, 1,4-phenylene, or 4,4'-biphenyldiyl.

Preferably, Ar'₁ and Ar'₂ are each independently phenyl, biphenylyl, terphenylyl, naphthyl, naphthylphenyl, phenylnaphthyl, phenanthrenyl, dimethylfluorenyl, diphenylfluorenyl, dibenzofuranyl, dibenzothiophenyl, 9H-carbazol-9-yl, or 9-phenyl-9H-carbazolyl.

Preferably, any one of R'₁ to R'₄ is a substituent represented by Chemical Formula 4, the rest are each independently hydrogen or deuterium, and R'₅ and R'₆ are each independently hydrogen or deuterium.

Preferably, R'₁ to R'₄ are each independently hydrogen or deuterium; any one of R'₅ and R'₆ is a substituent represented by Chemical Formula 4, and the rest is hydrogen, or deuterium. Here, preferably, Ar'₁ and Ar'₂ are each independently terphenylyl, naphthyl, phenanthrenyl, dimethylfluorenyl, diphenylfluorenyl, dibenzofuranyl, dibenzothiophenyl, 9H-carbazol-9-yl, or 9-phenyl-9H-carbazolyl. Alternatively, preferably, Ar'₁ is phenyl, Ar'₂ is phenyl, biphenyl, terphenylyl, naphthyl, phenanthrenyl, dibenzofuranyl, dibenzothiophenyl, 9H-carbazol-9-yl, or 9-phenyl-9H-carbazolyl; or Ar'₁ is biphenylyl, Ar'₂ is terphenylyl, phenanthrenyl, dibenzofuranyl, dibenzothiophenyl, 9H-carbazol-9-yl, or 9-phenyl-9H-carbazolyl. Here, preferably, L'₁ and L'₂ are each independently a single bond, phenylene, or biphenyldiyl, more preferably, L'₁ and L'₂ are each independently a single bond, 1,4-phenylene, or 4,4'-biphenyldiyl.

Representative examples of the compound represented by Chemical Formula 2 or 3 are as follows.

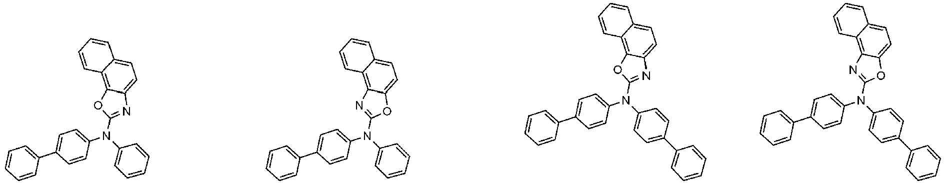

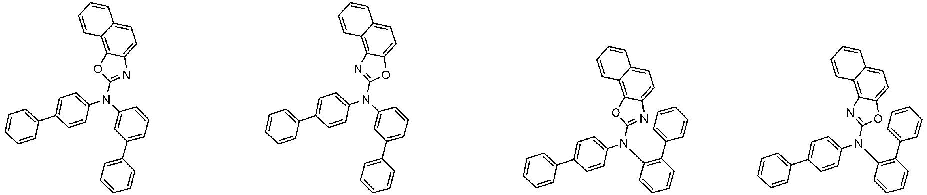

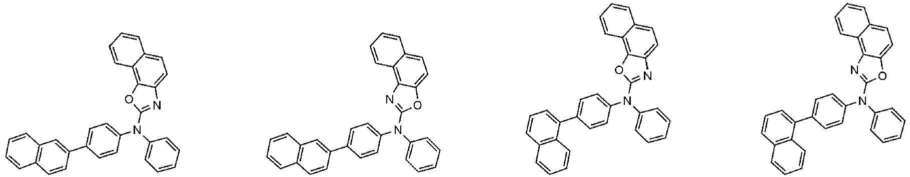

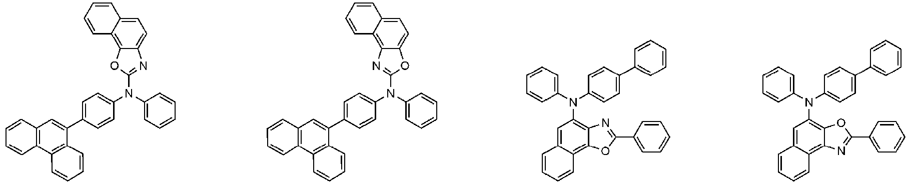

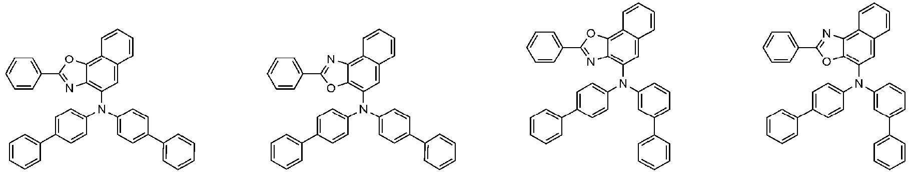

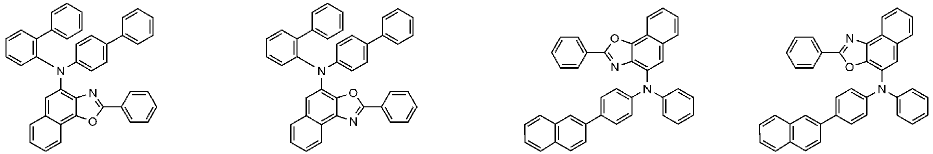

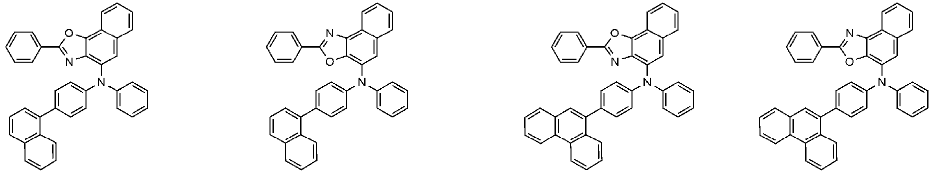

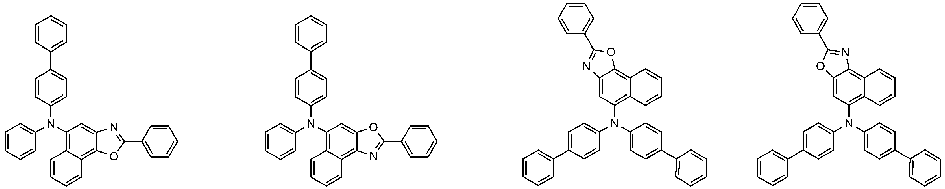

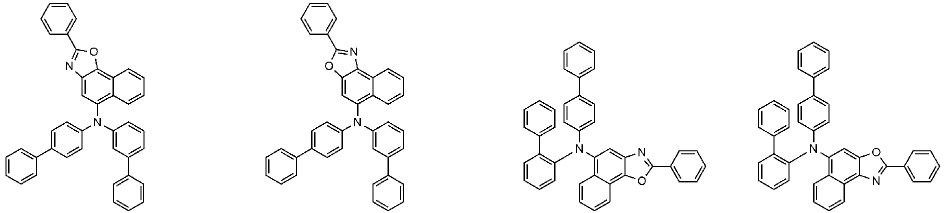

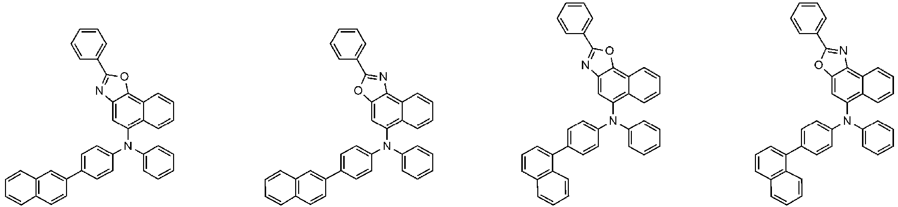

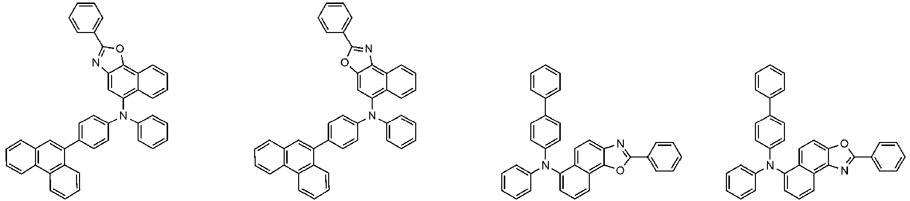

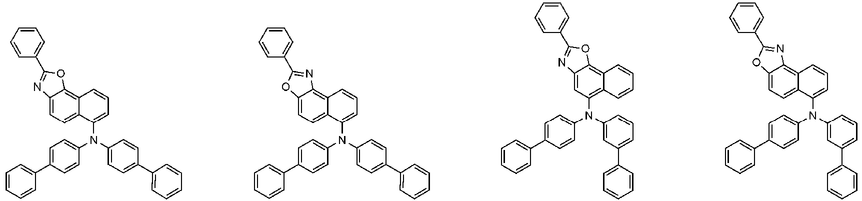

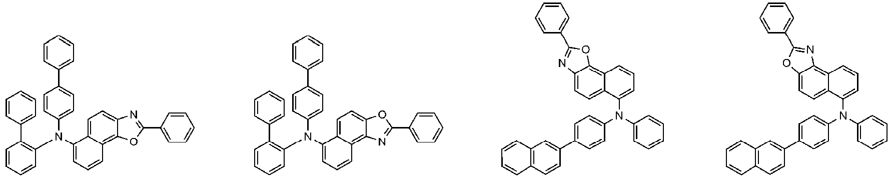

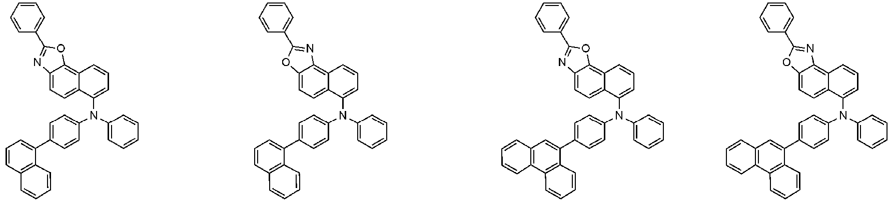

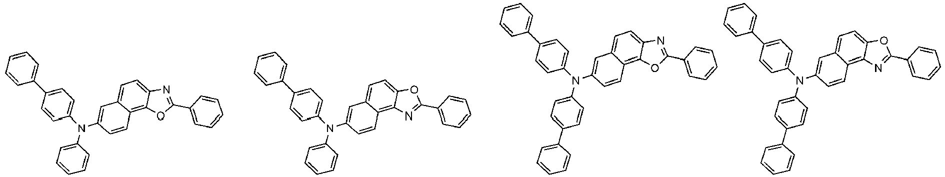

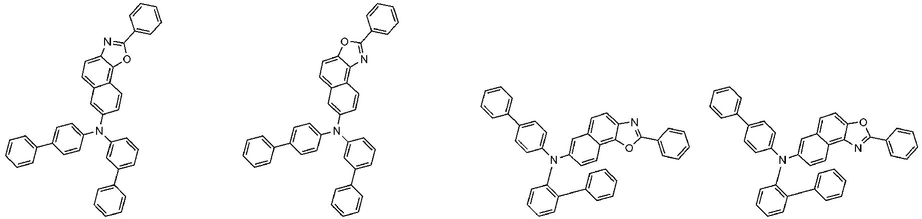

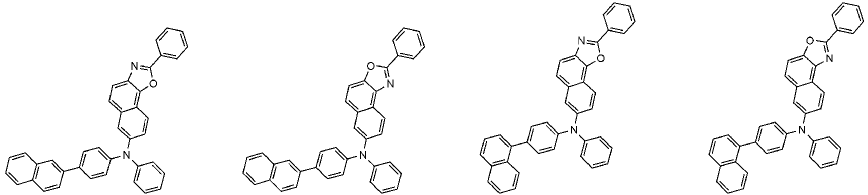

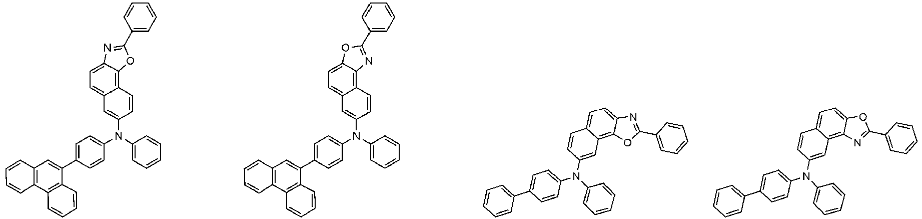

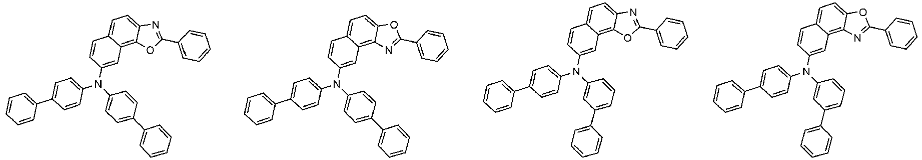

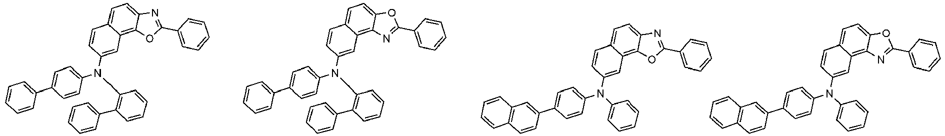

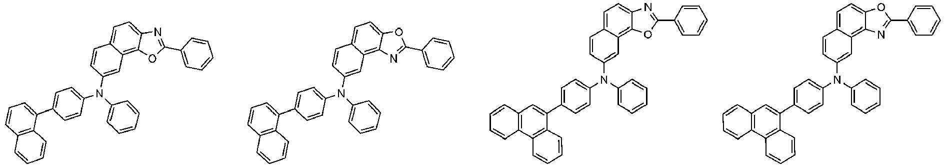

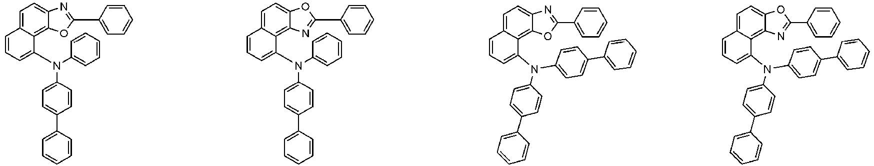

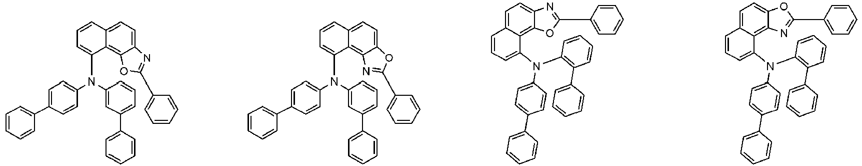

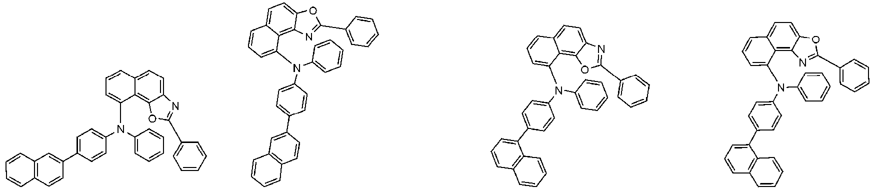

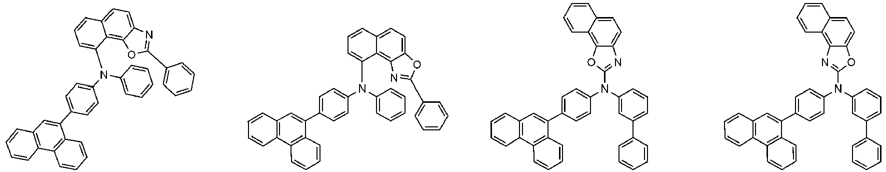

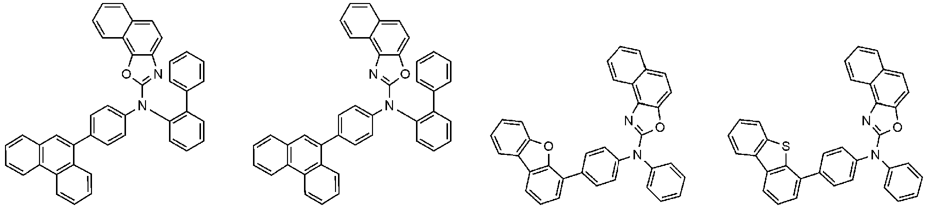

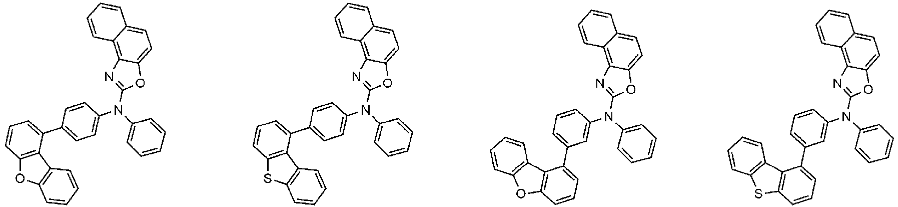

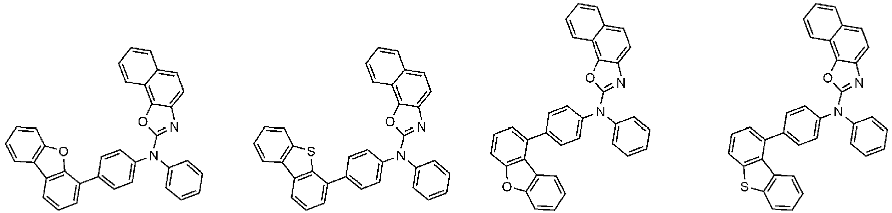

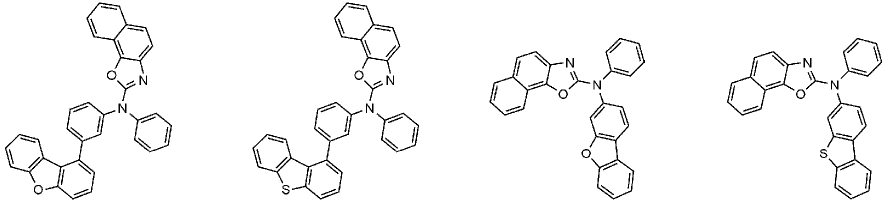

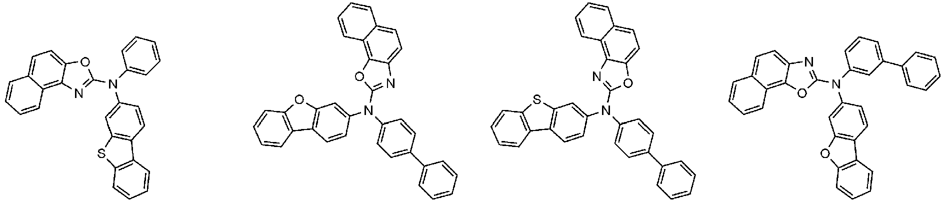

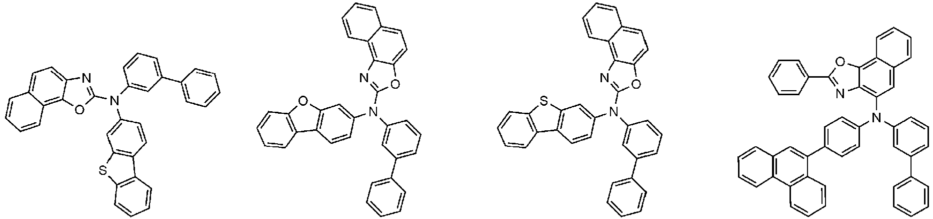

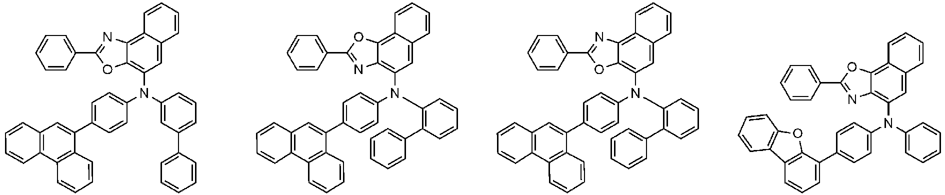

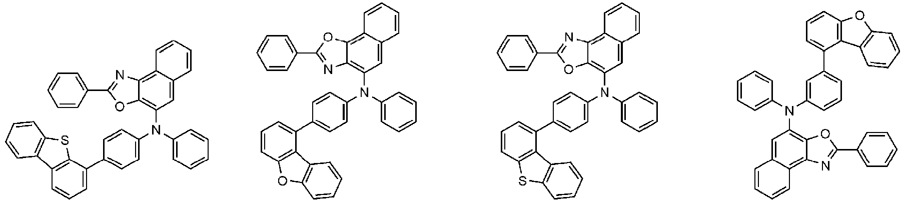

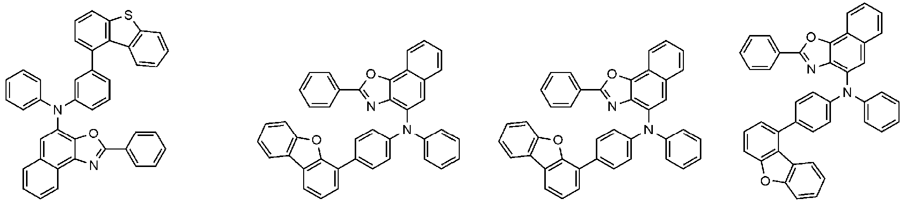

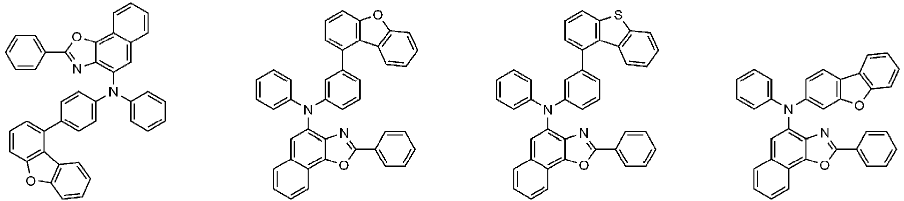

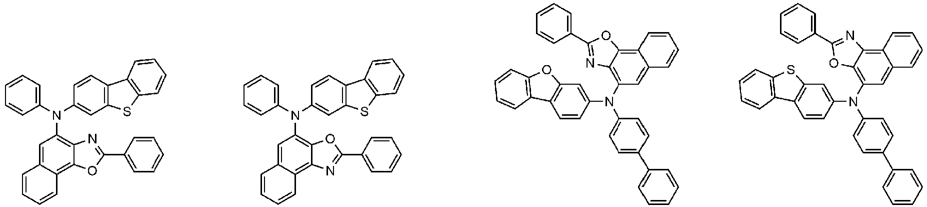

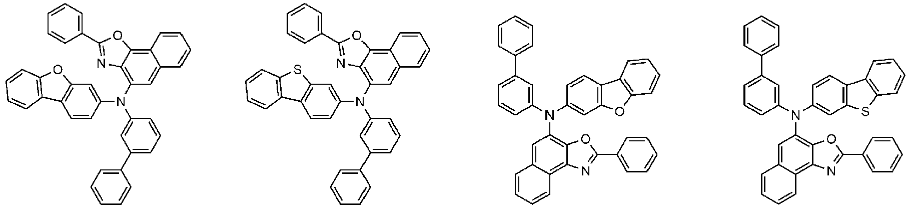

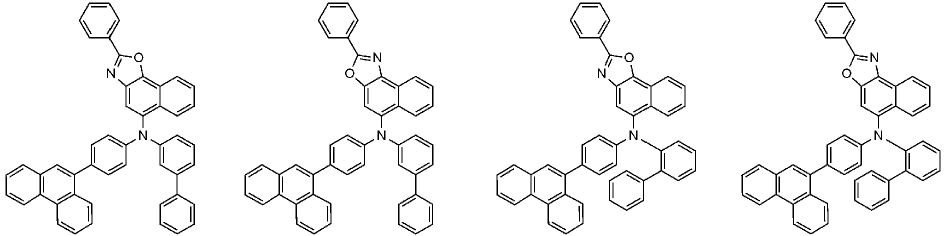

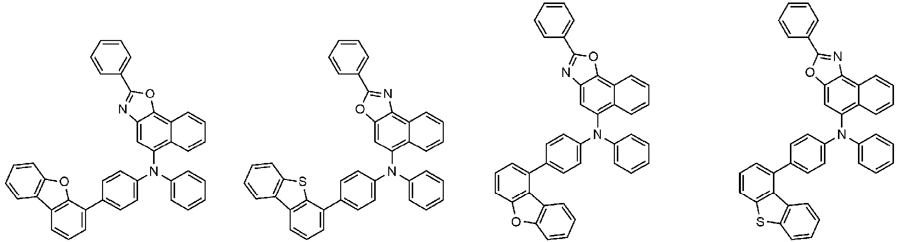

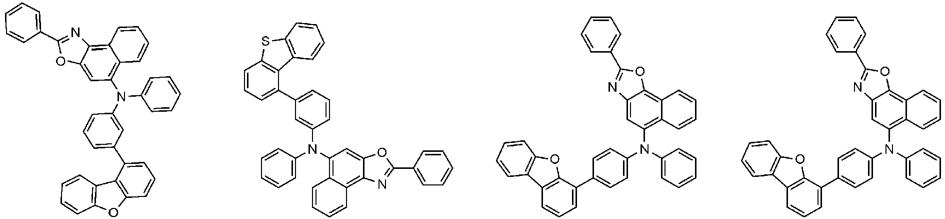

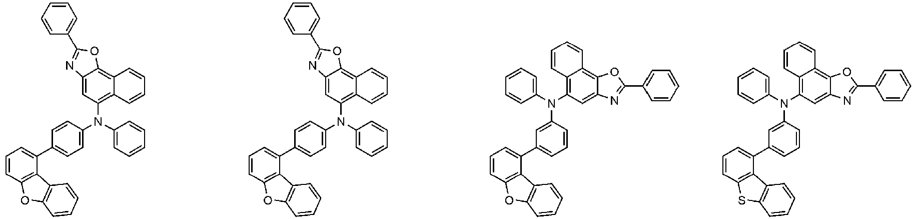

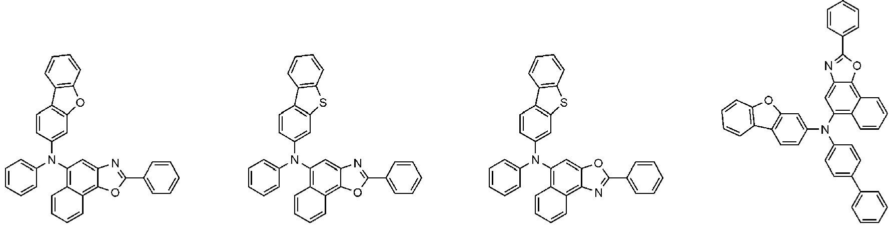

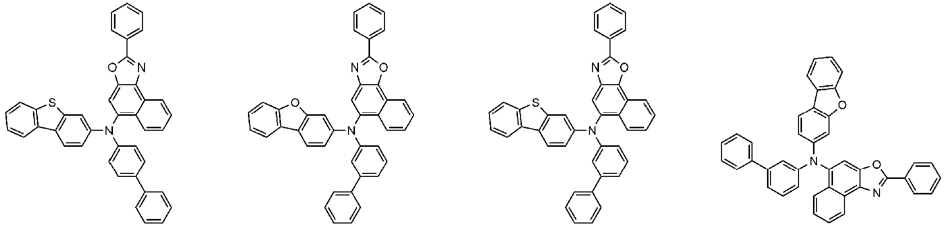

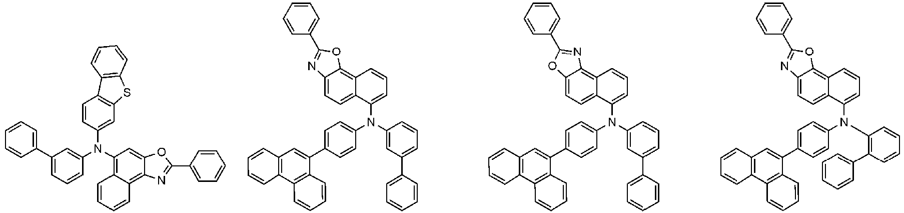

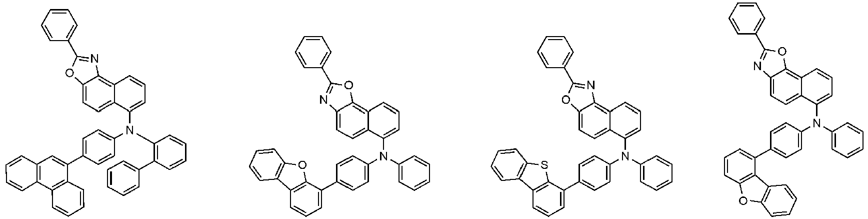

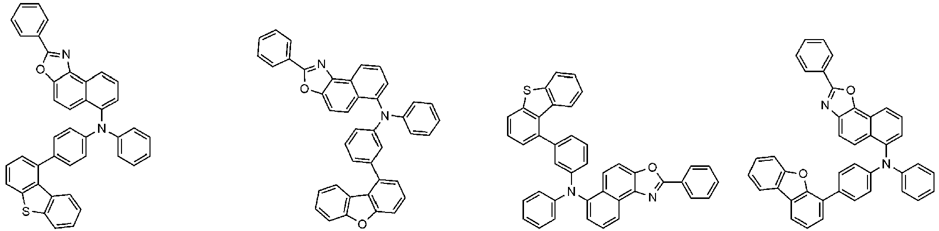

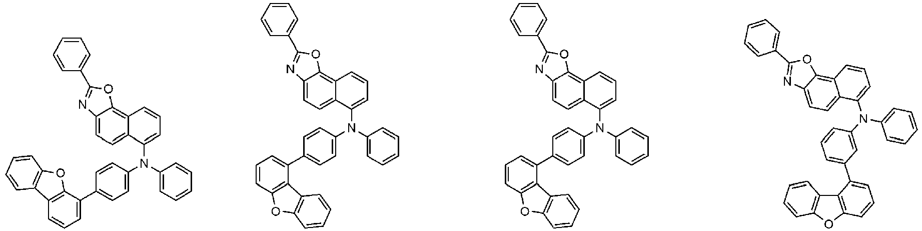

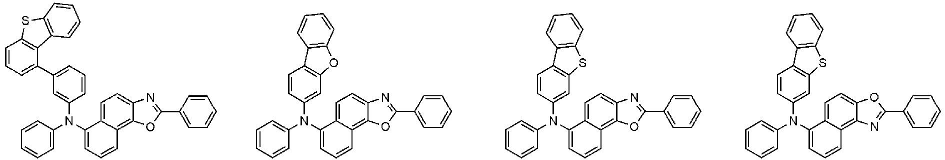

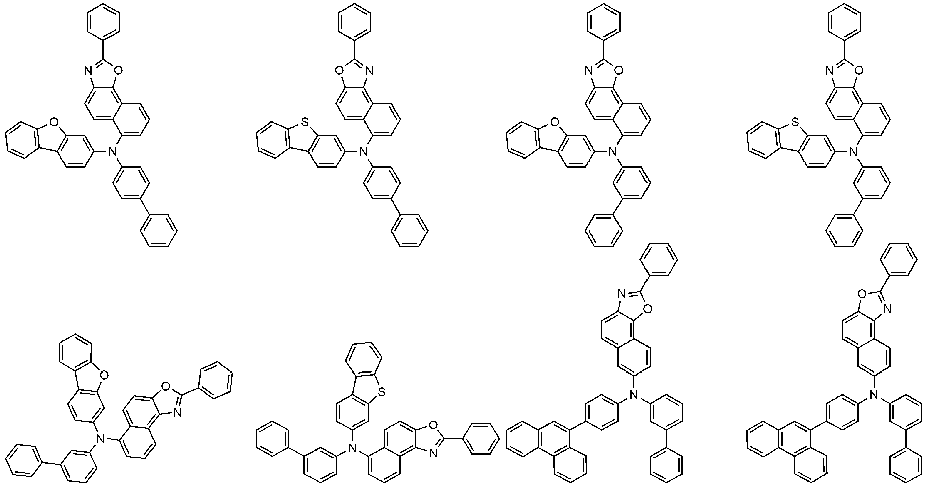

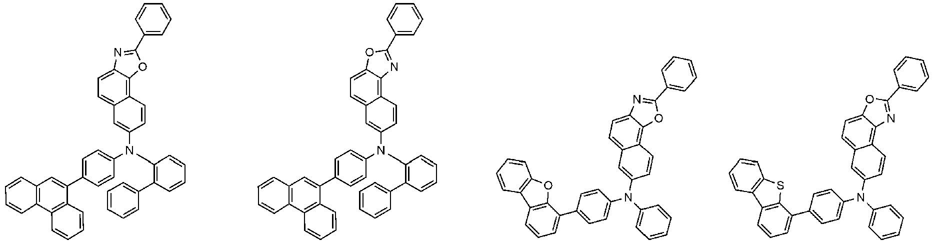

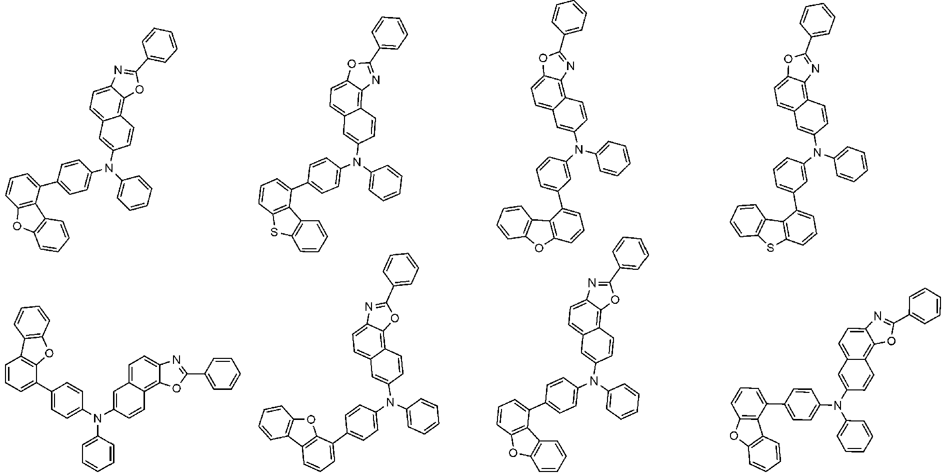

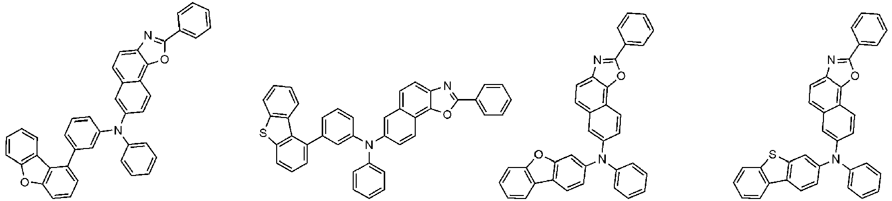

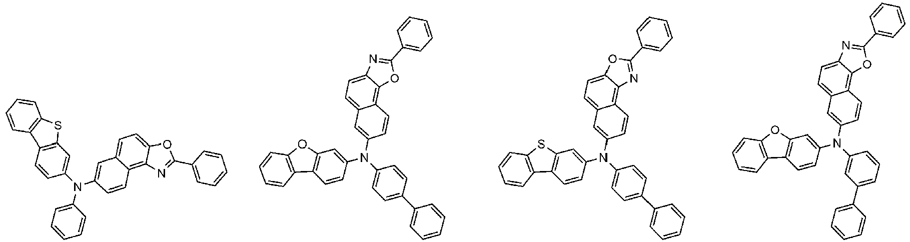

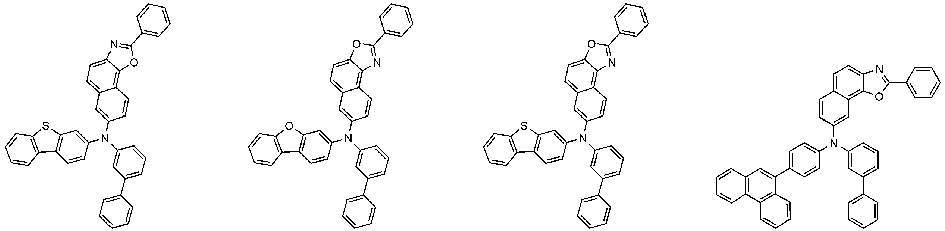

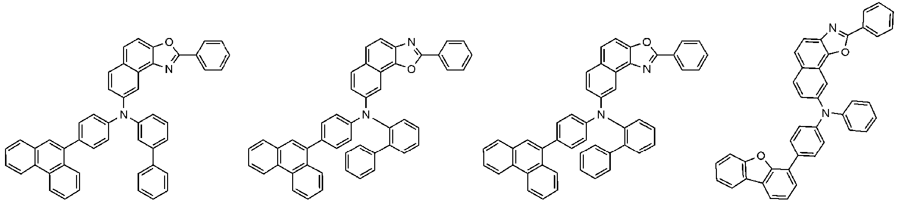

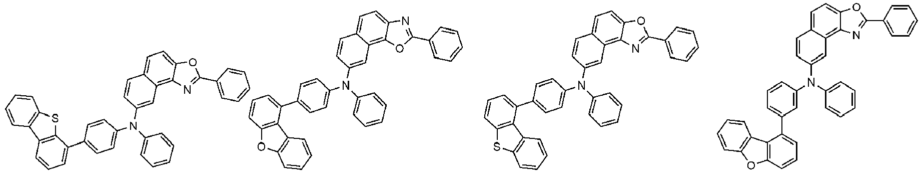

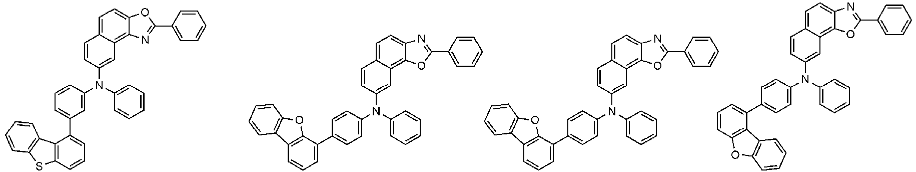

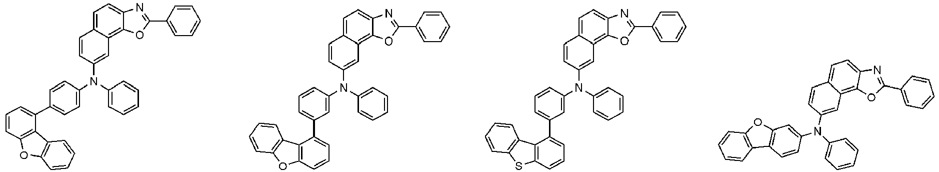

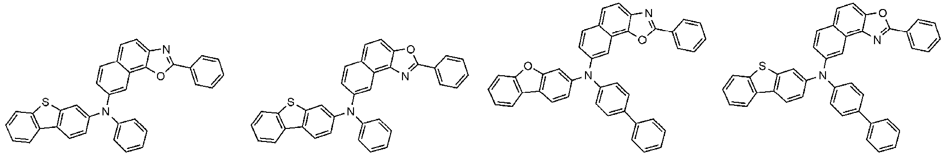

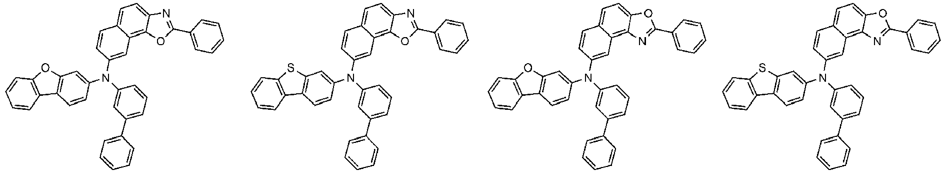

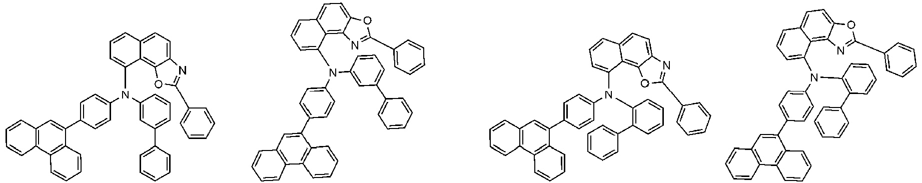

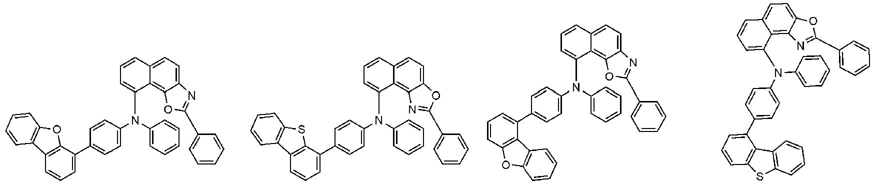

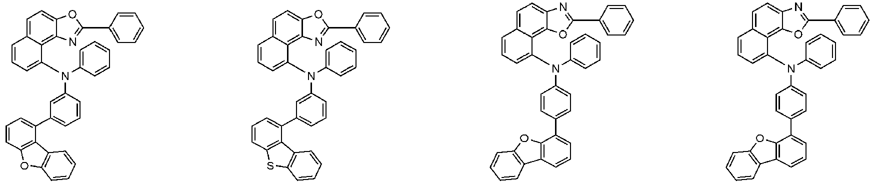

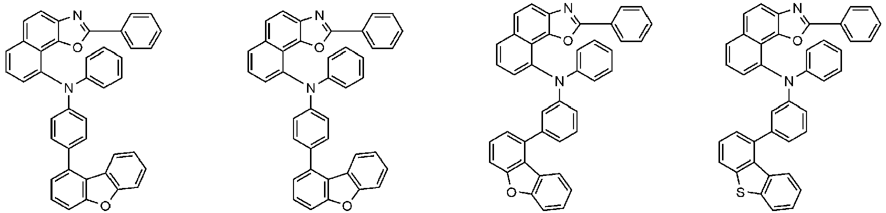

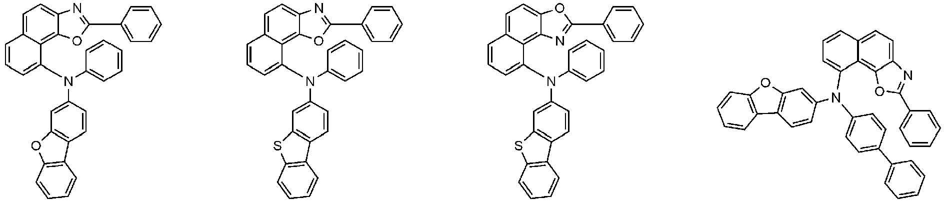

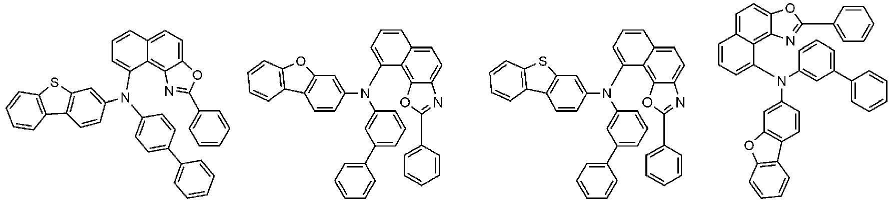

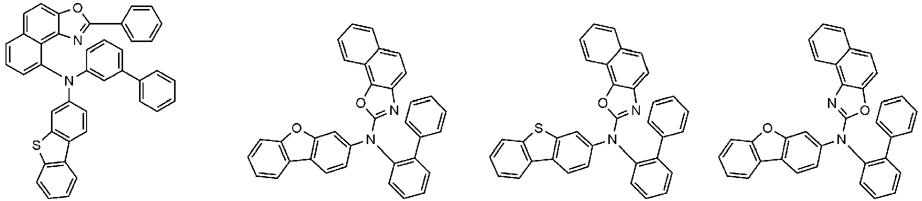

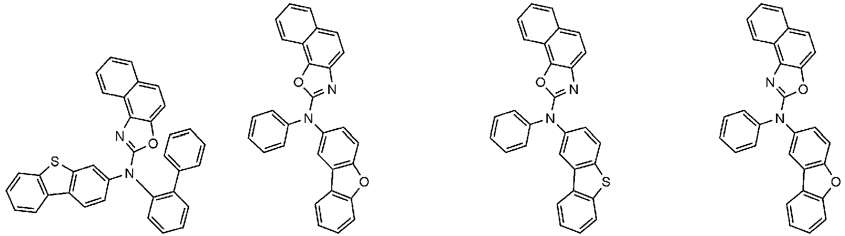

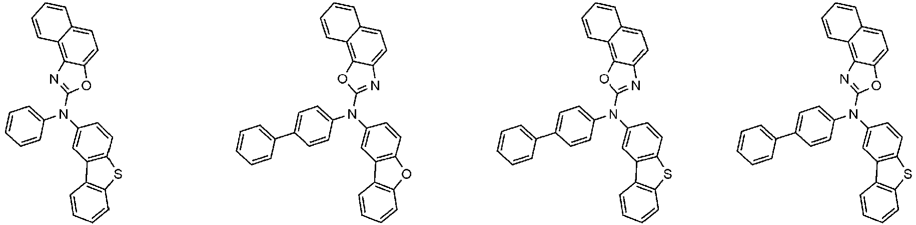

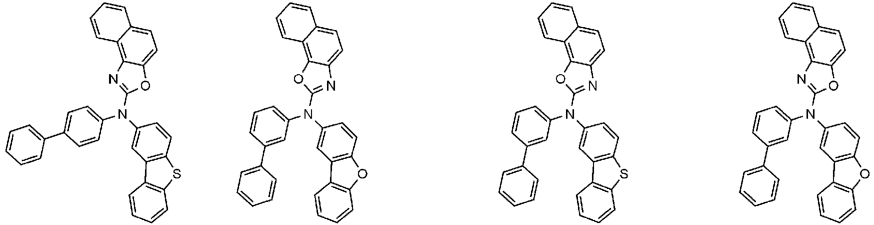

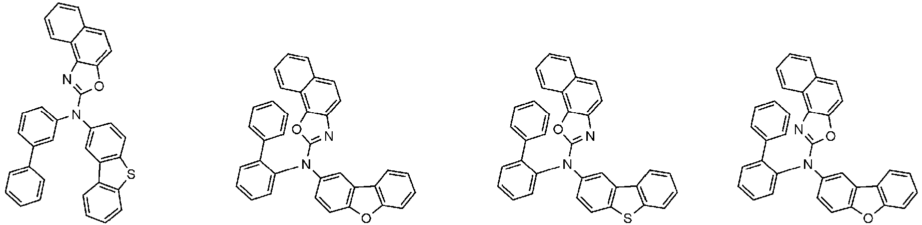

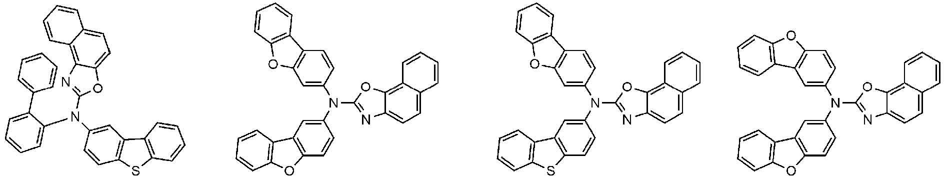

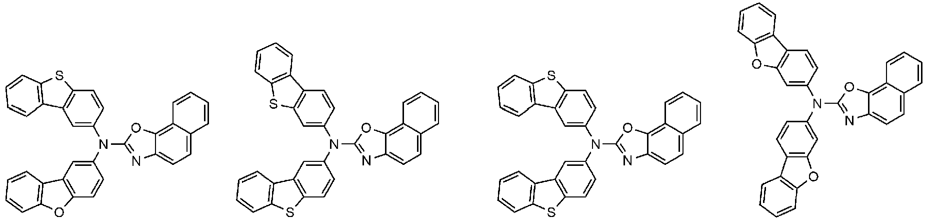

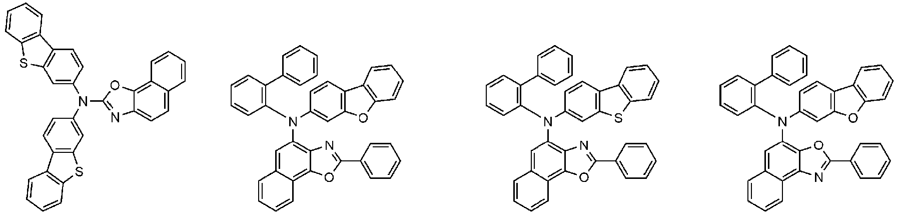

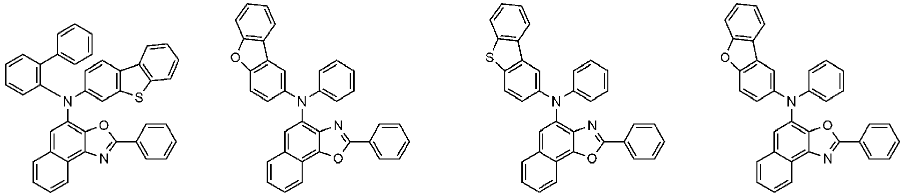

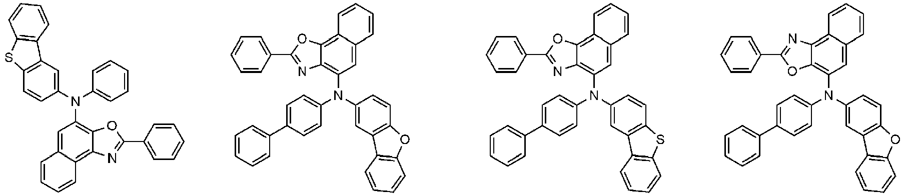

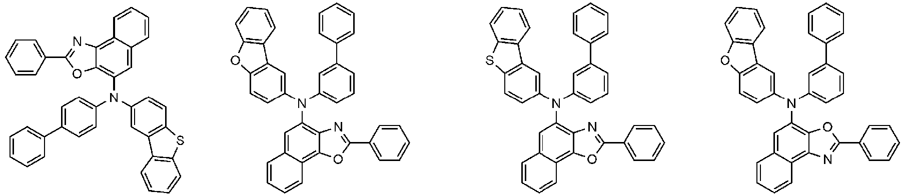

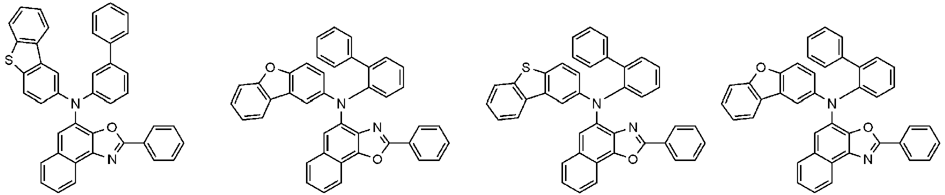

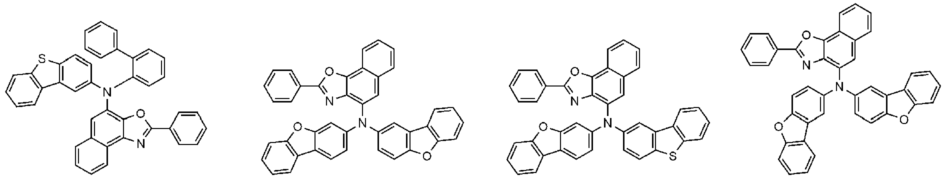

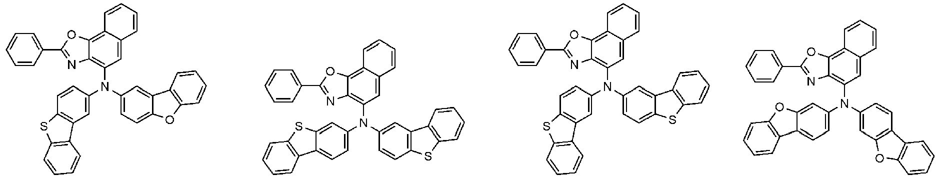

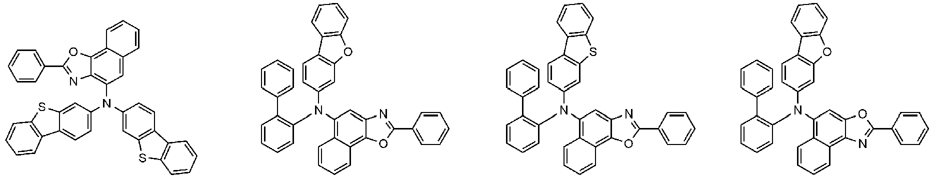

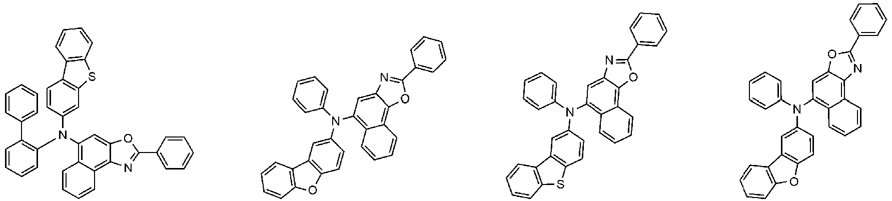

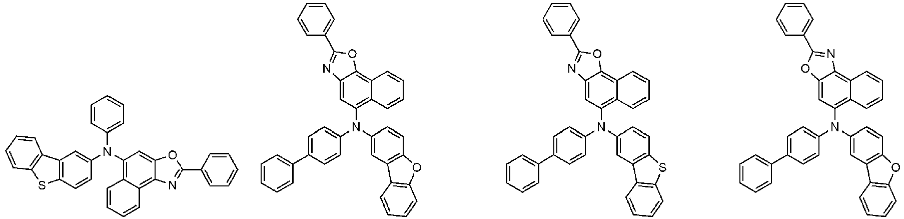

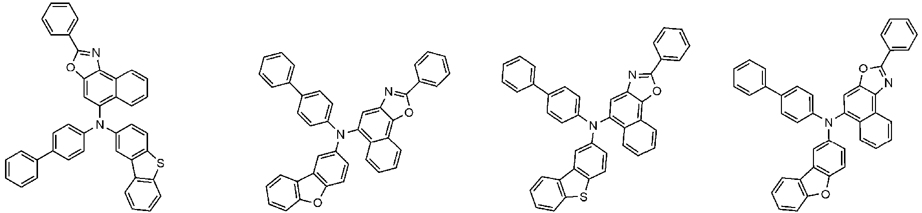

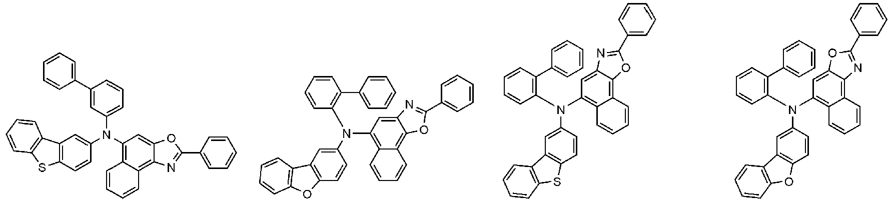

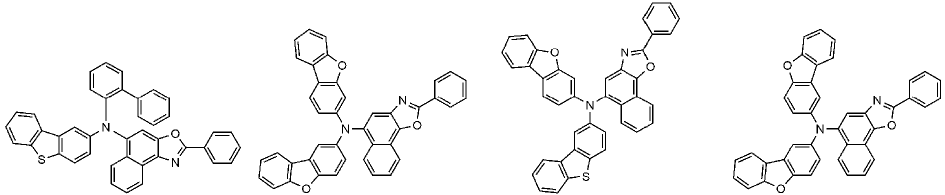

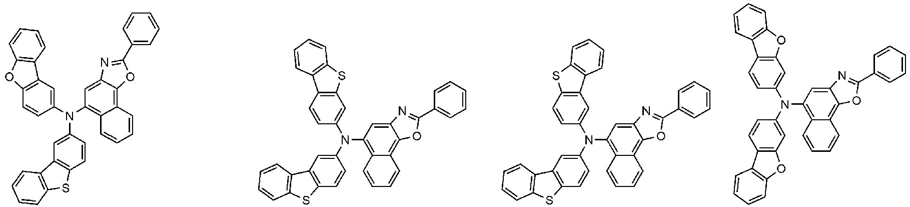

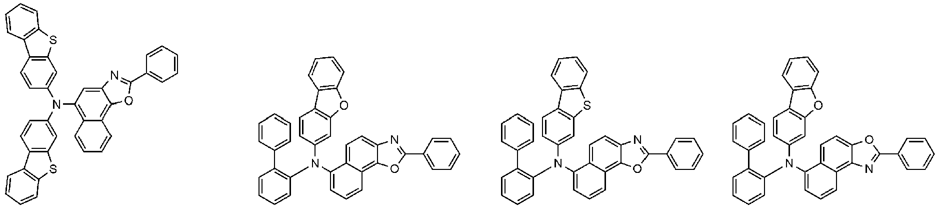

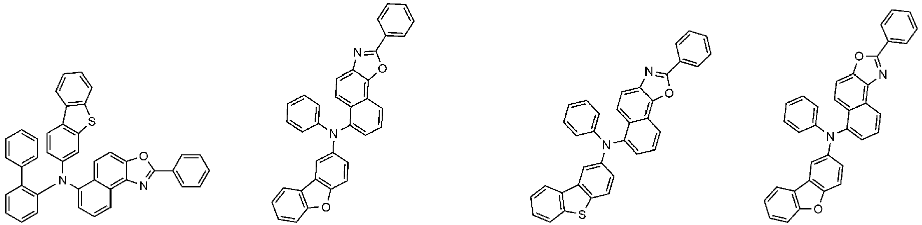

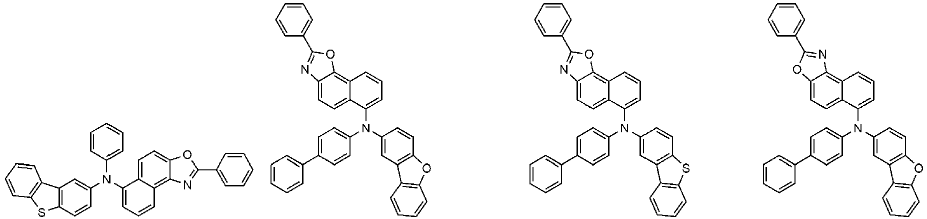

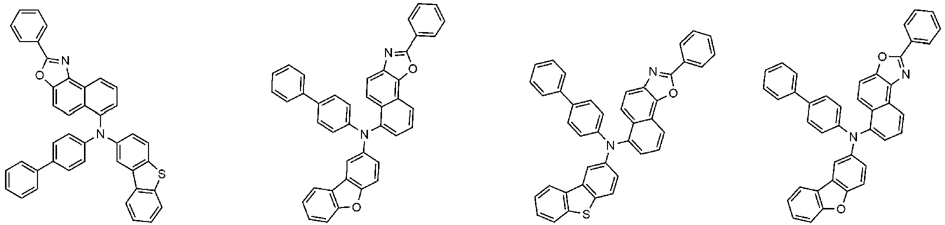

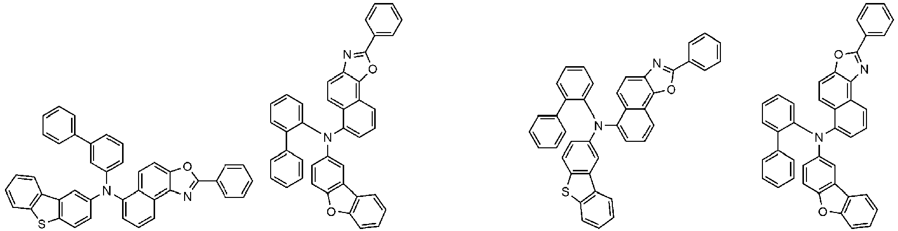

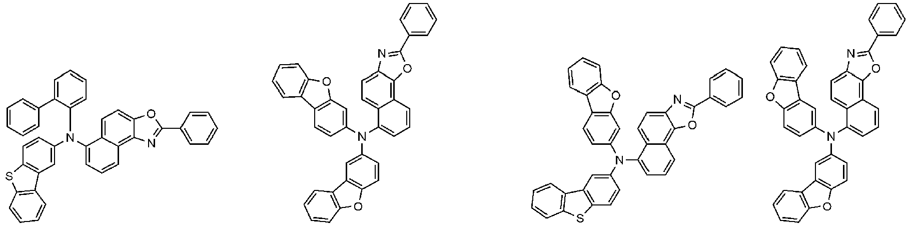

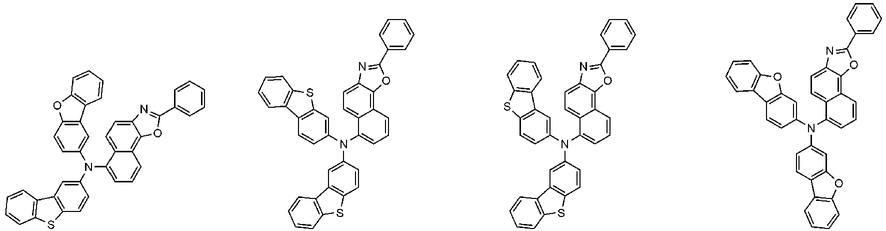

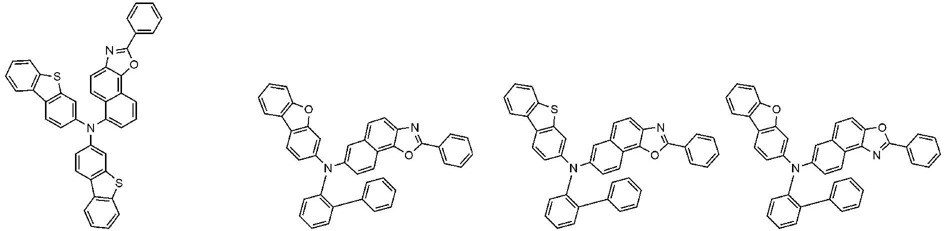

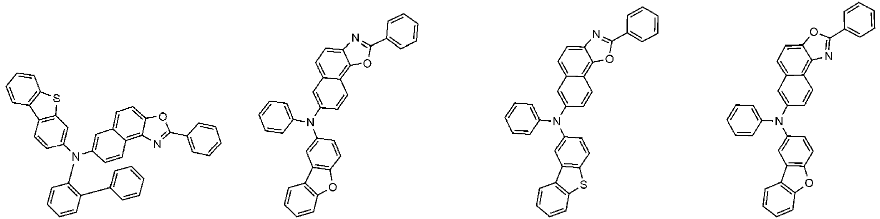

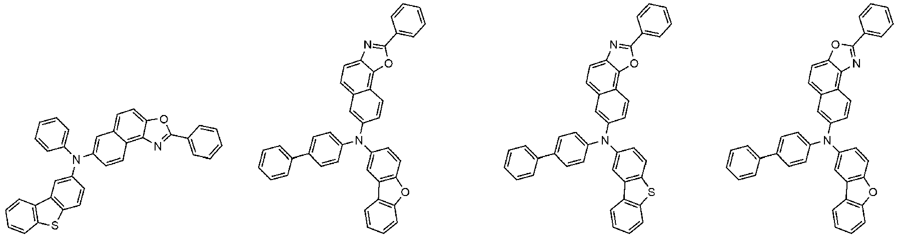

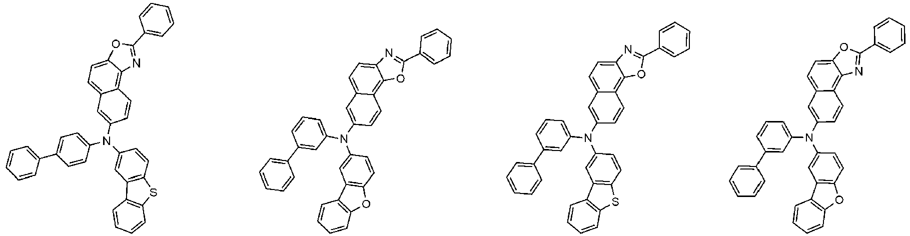

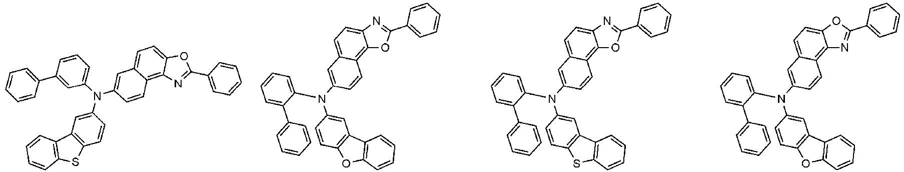

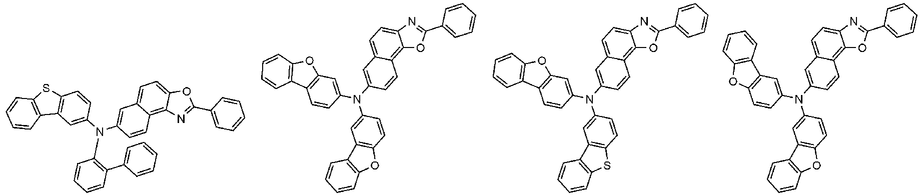

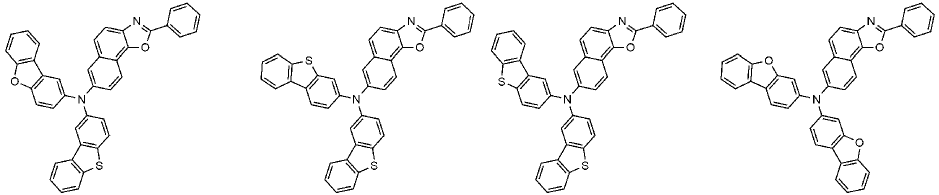

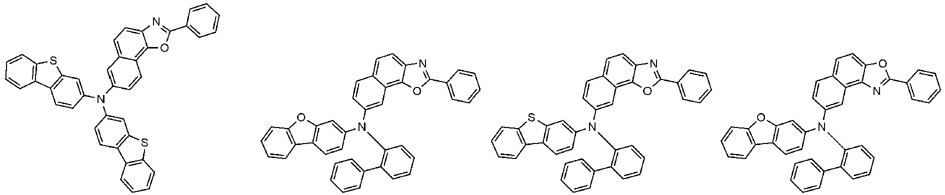

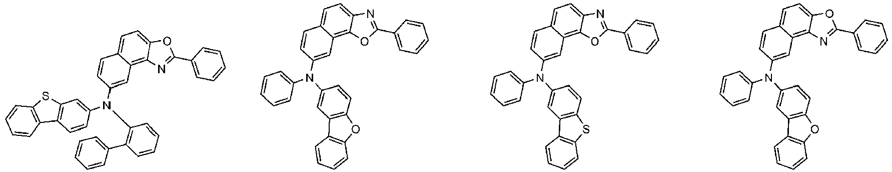

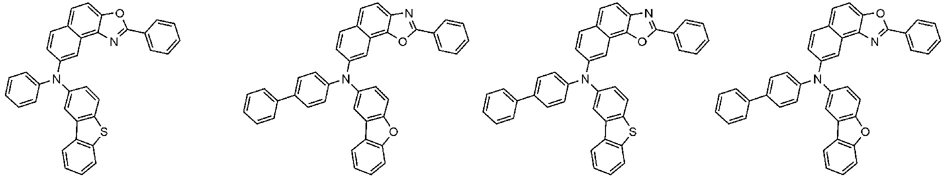

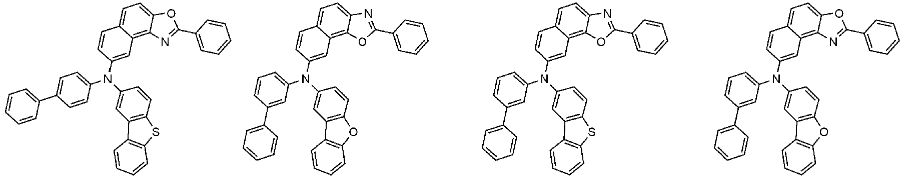

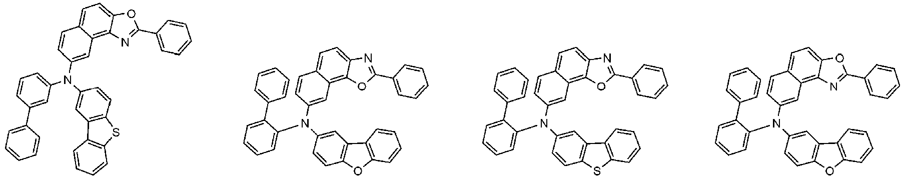

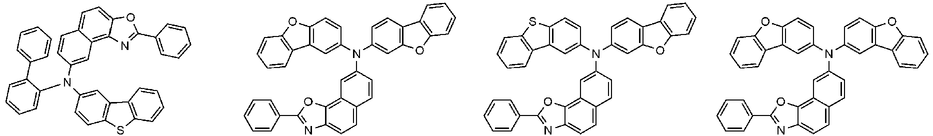

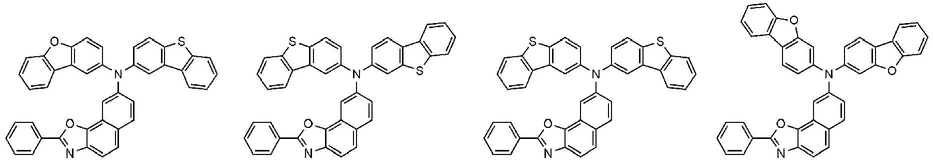

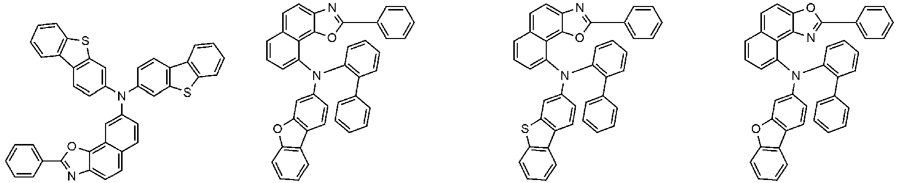

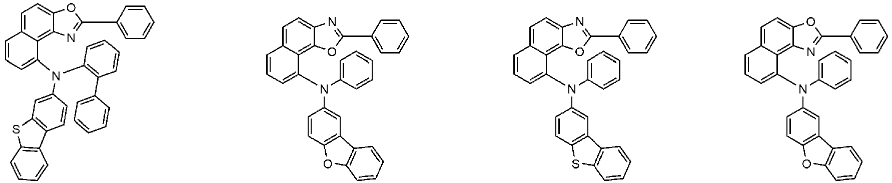

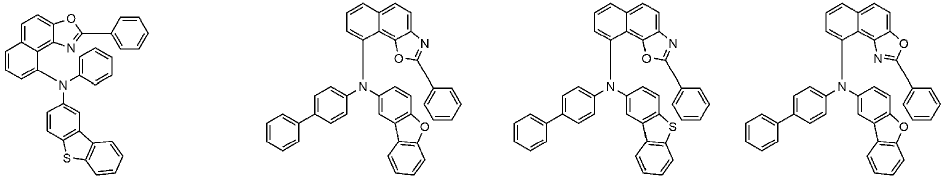

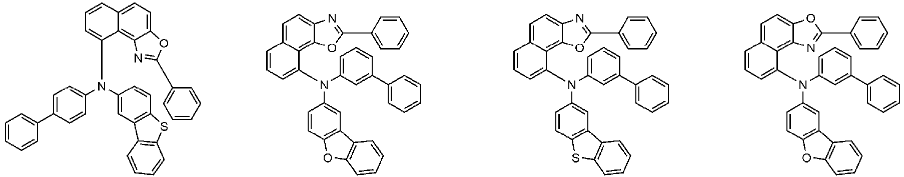

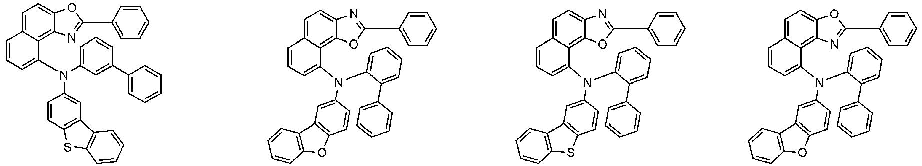

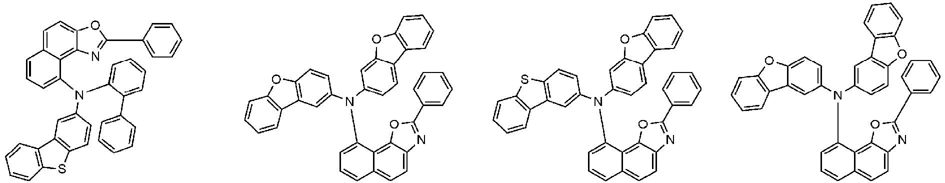

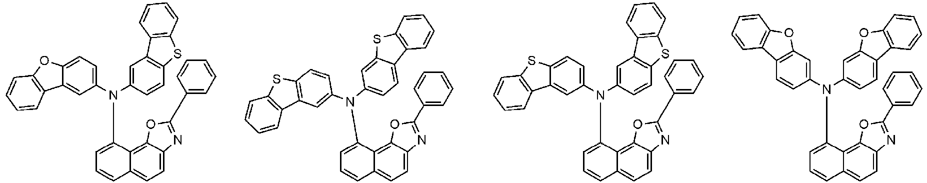

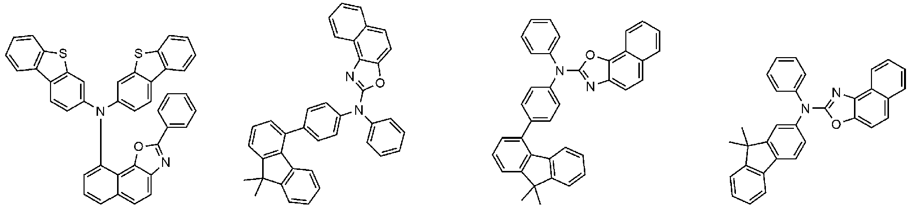

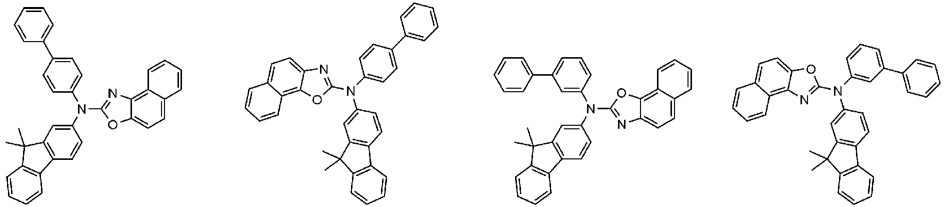

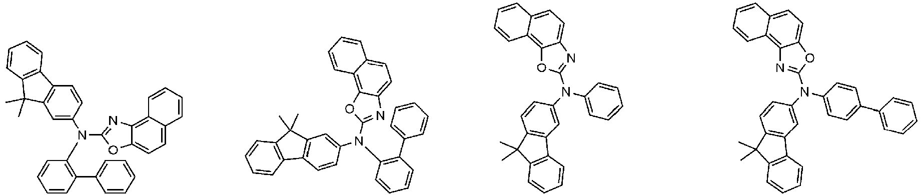

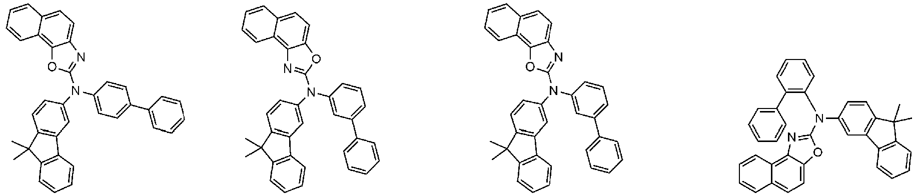

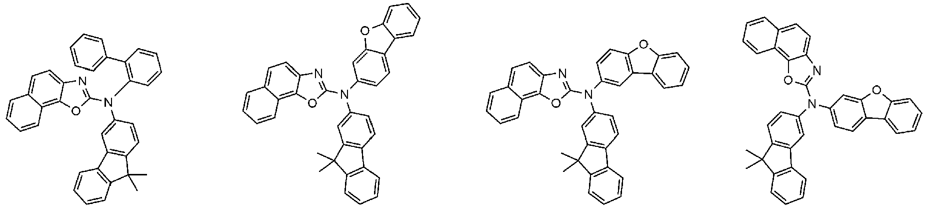

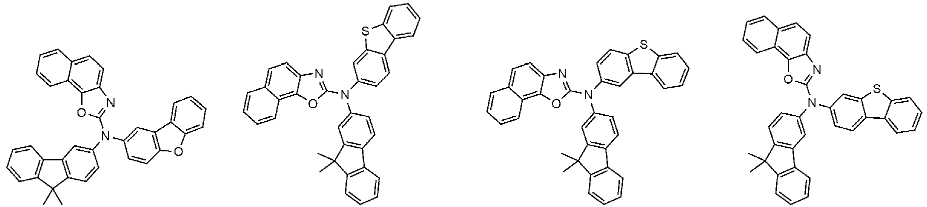

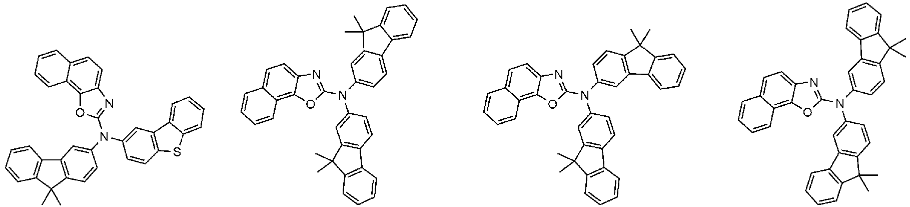

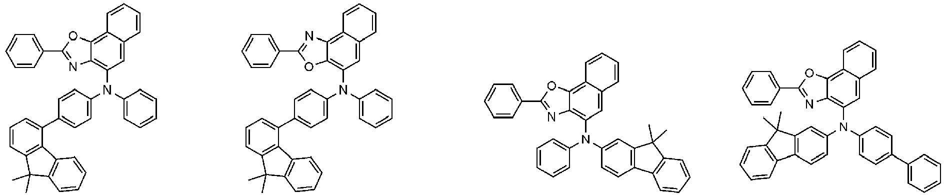

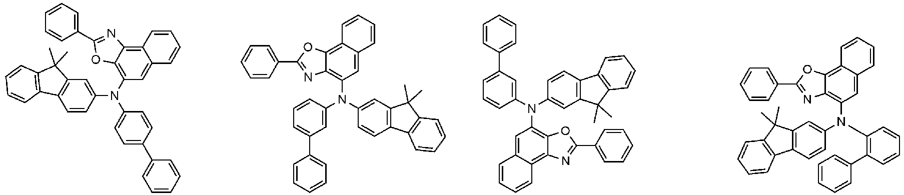

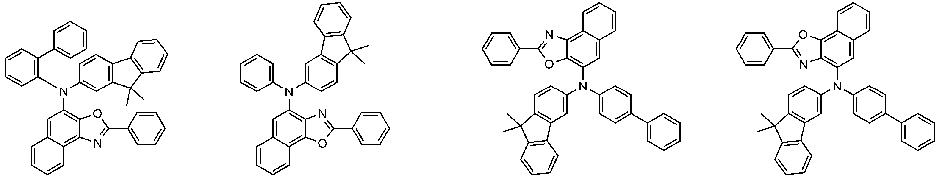

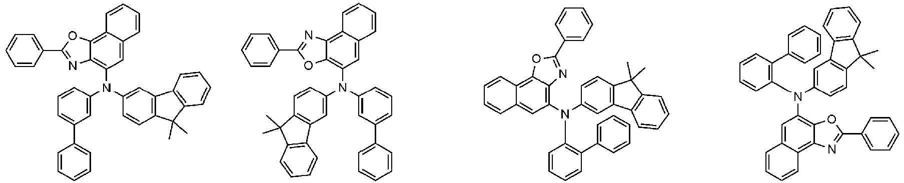

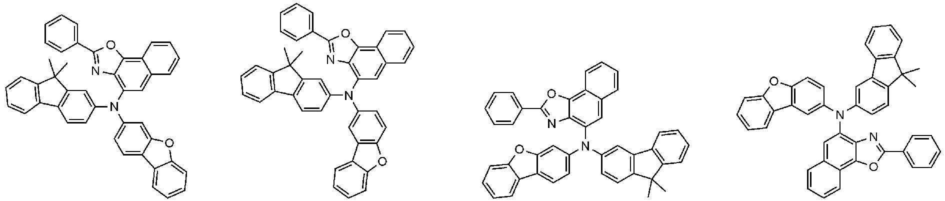

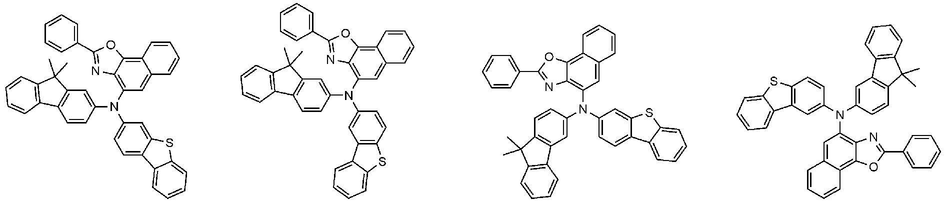

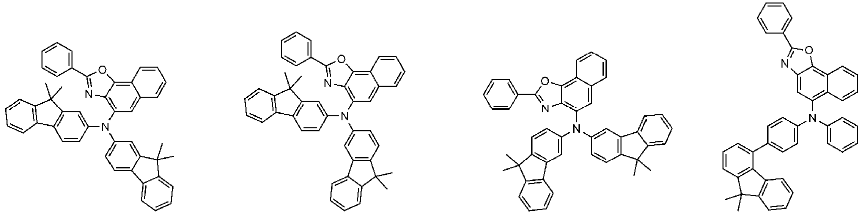

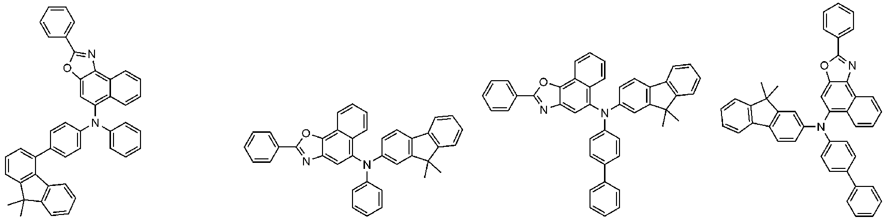

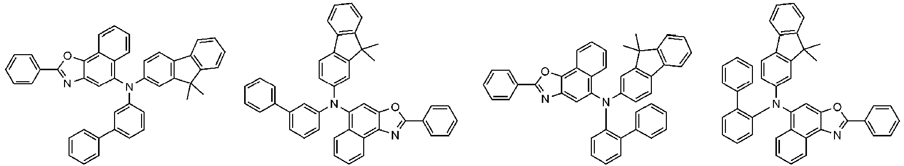

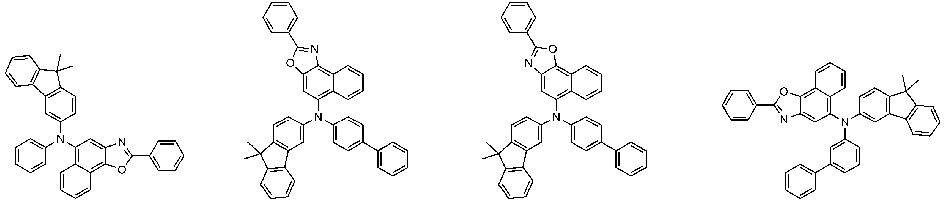

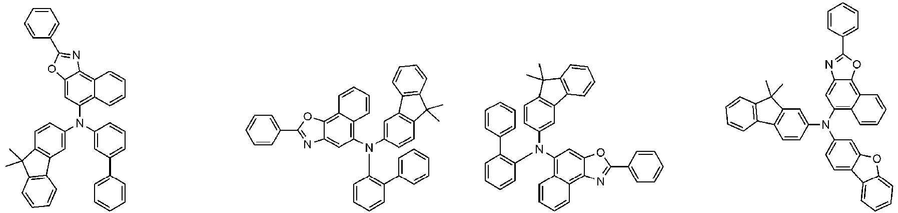

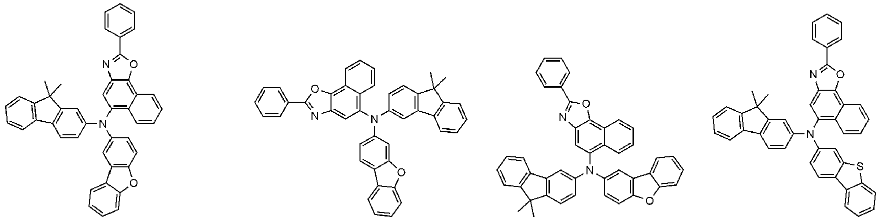

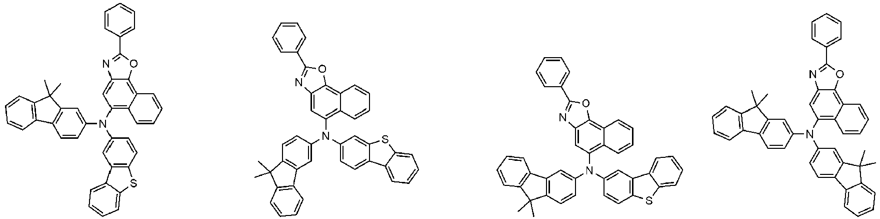

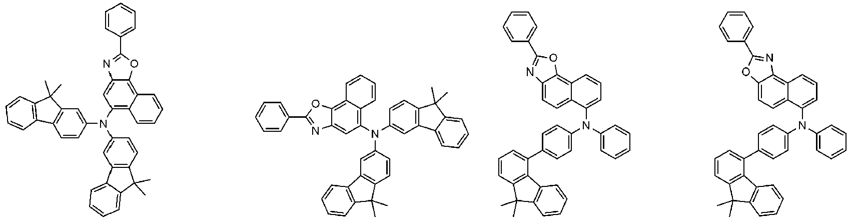

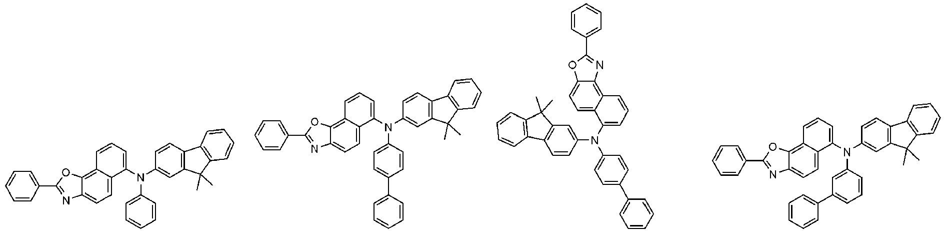

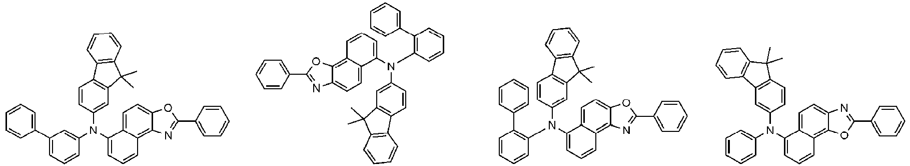

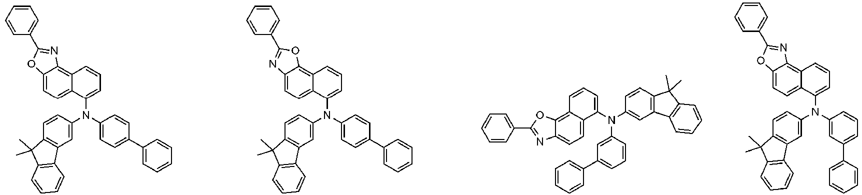

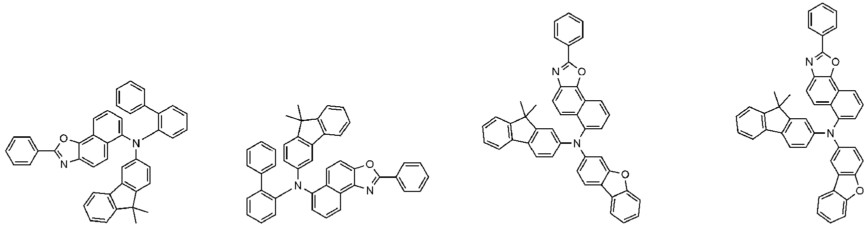

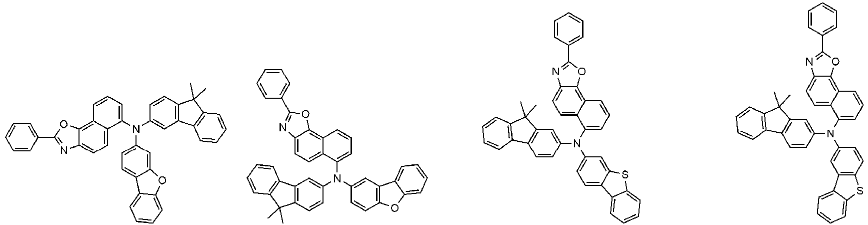

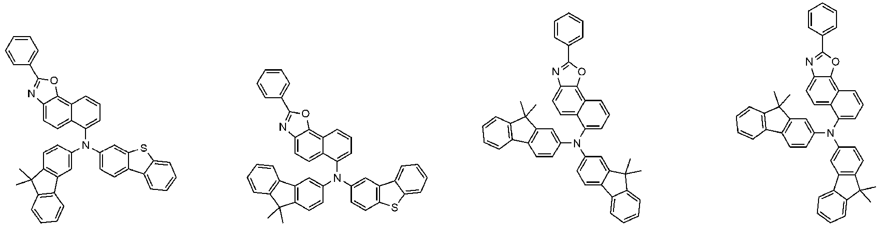

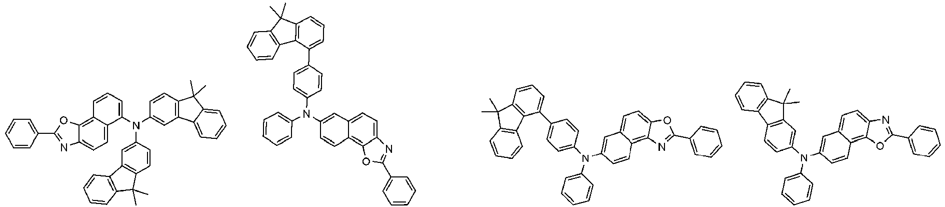

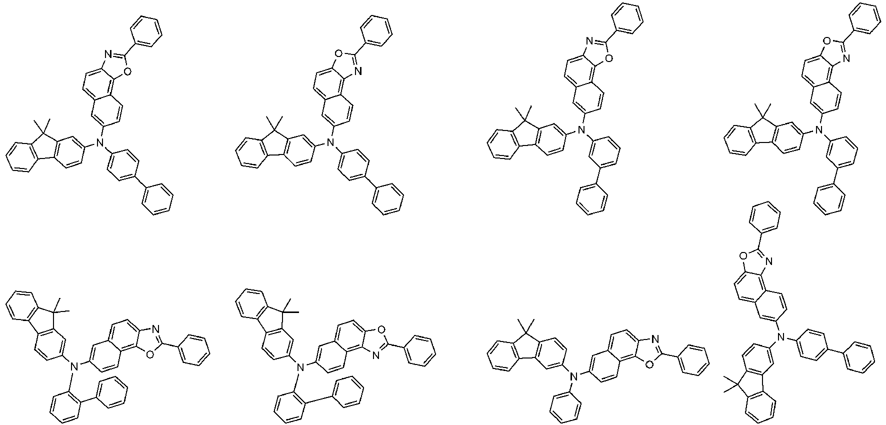

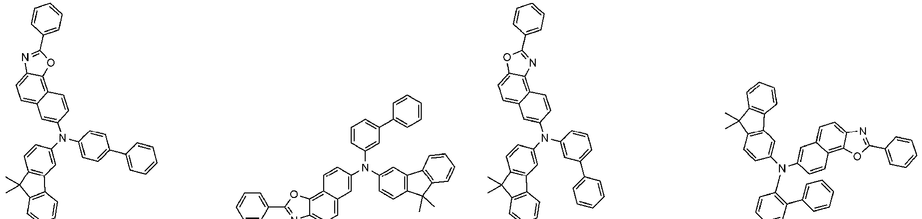

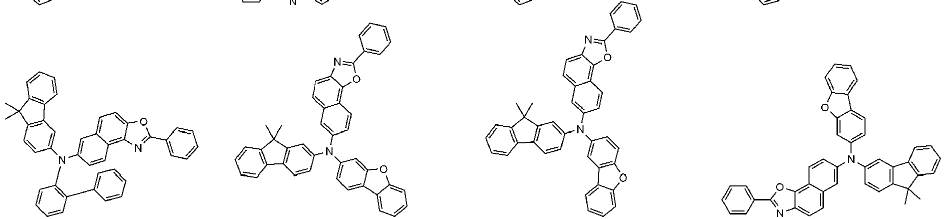

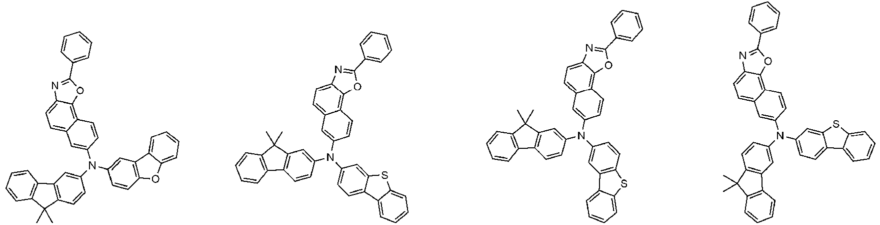

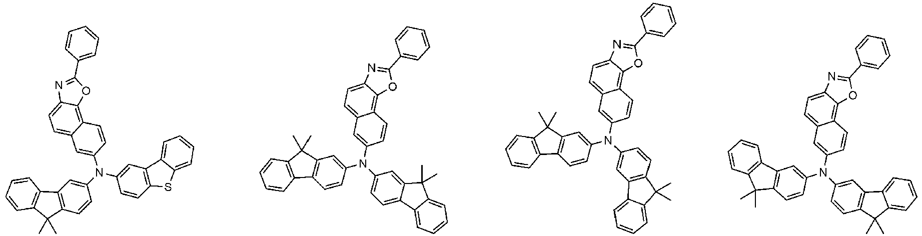

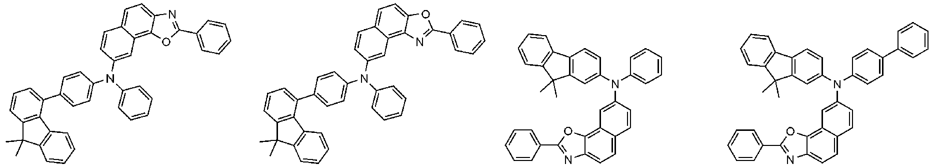

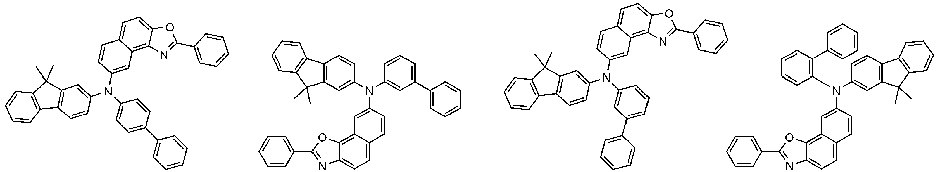

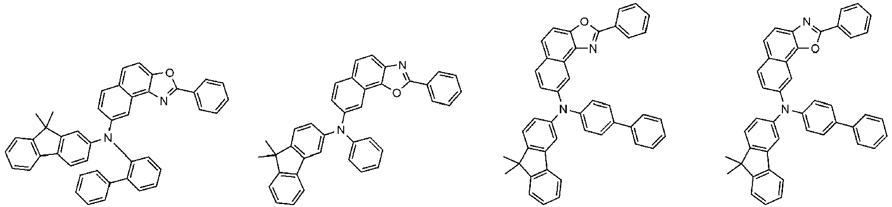

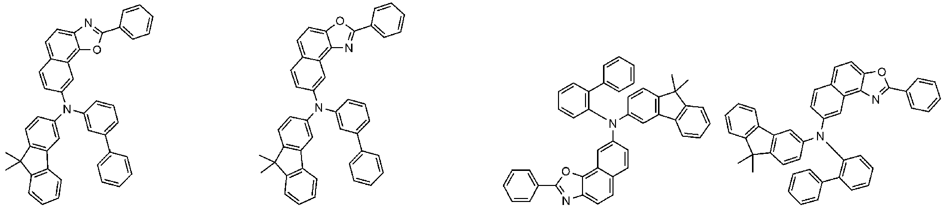

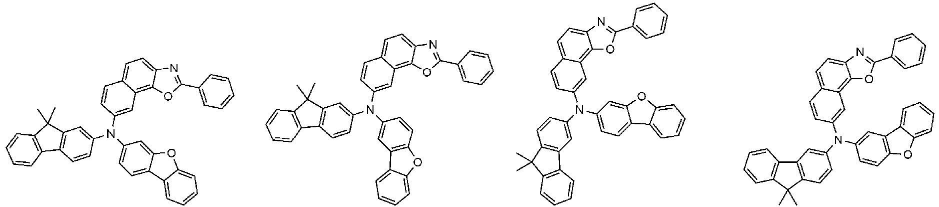

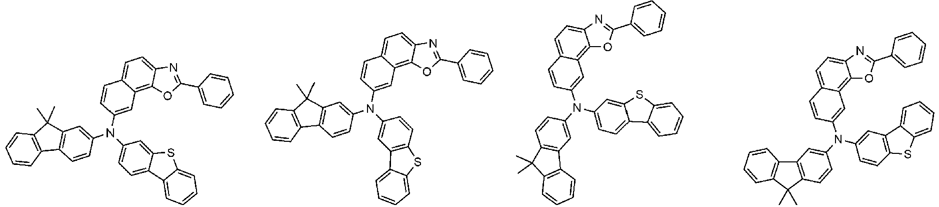

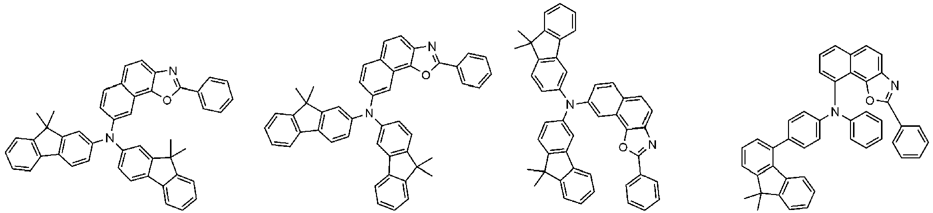

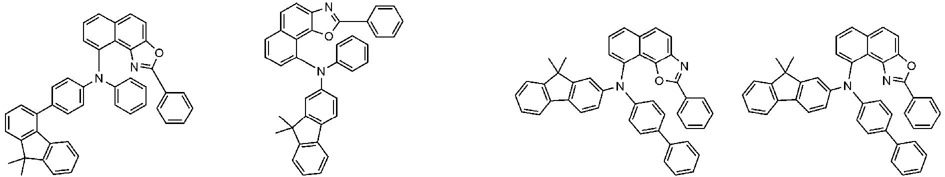

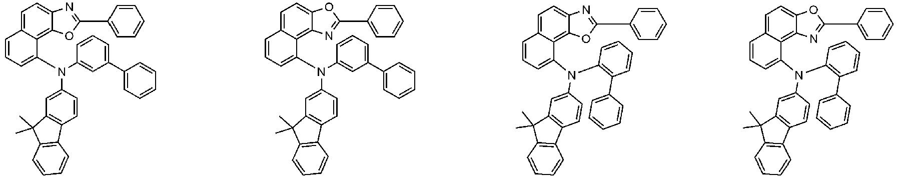

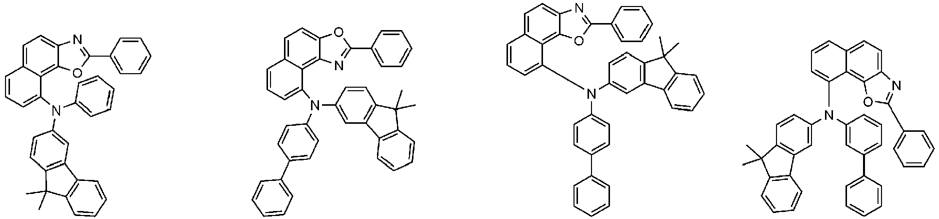

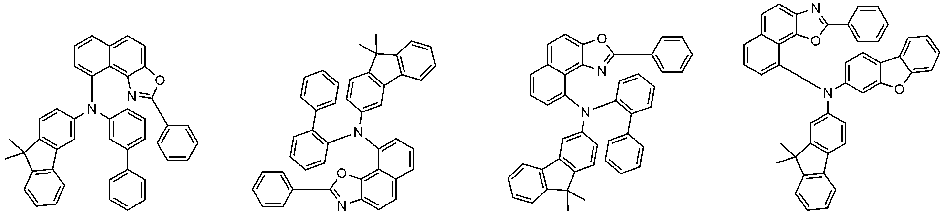

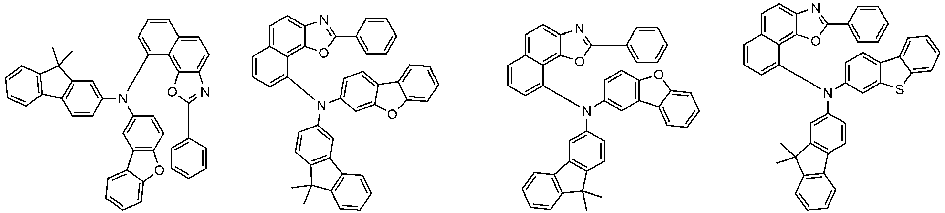

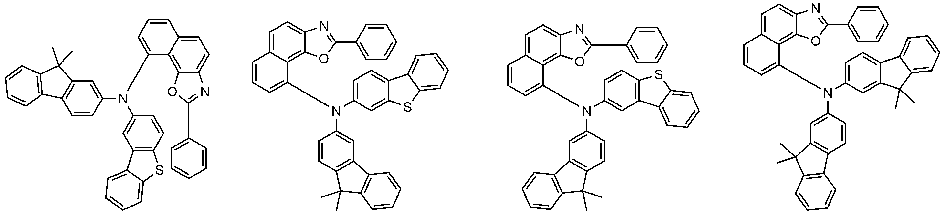

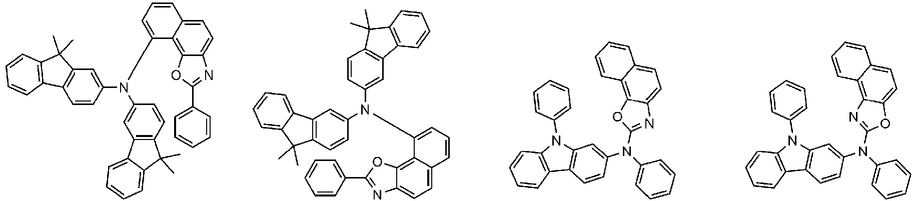

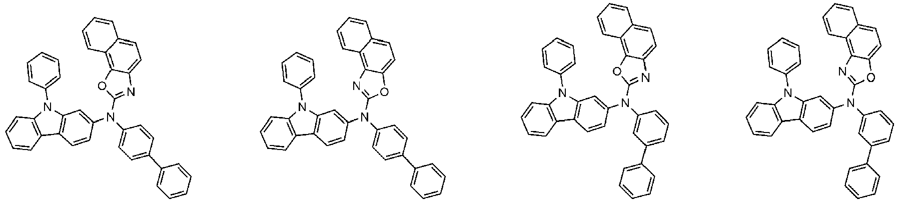

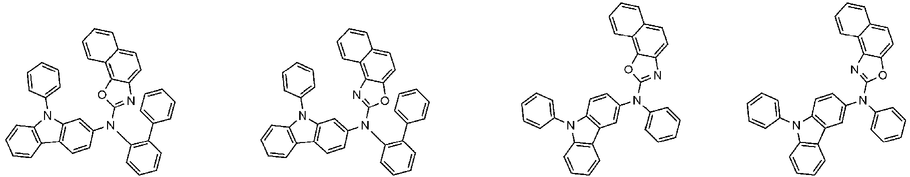

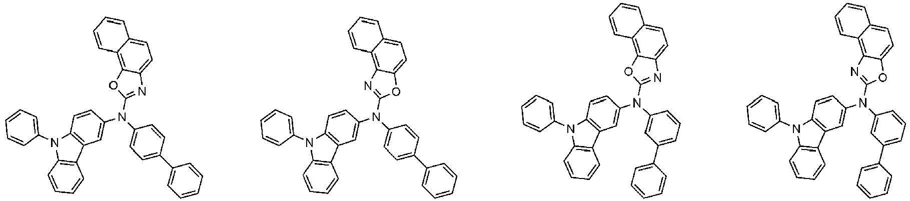

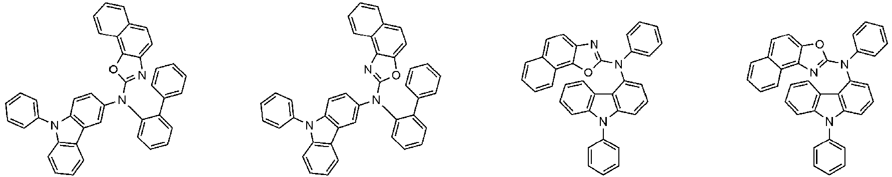

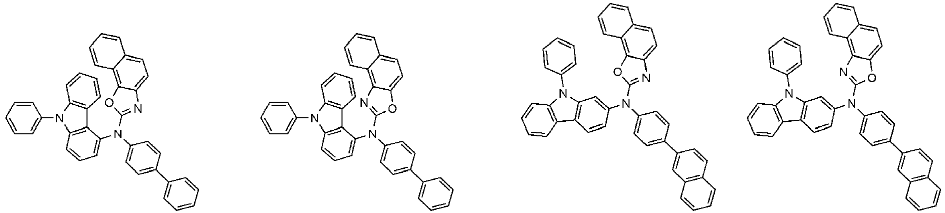

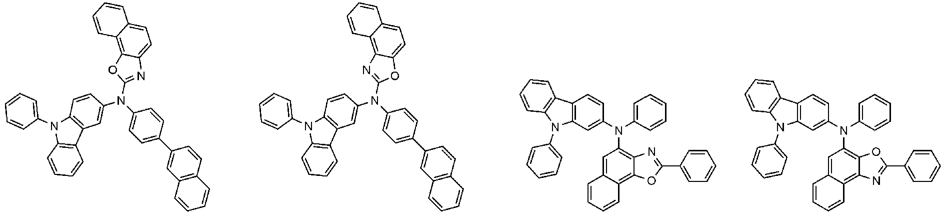

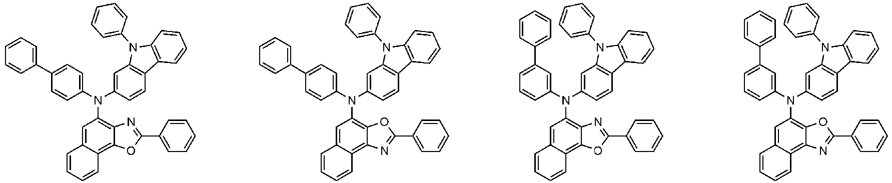

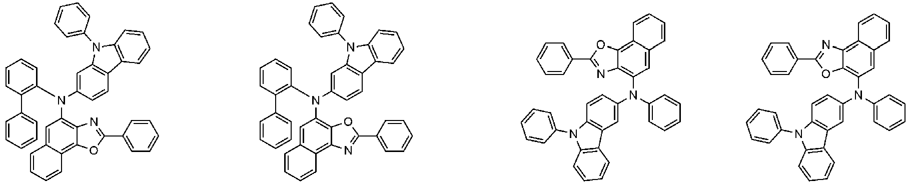

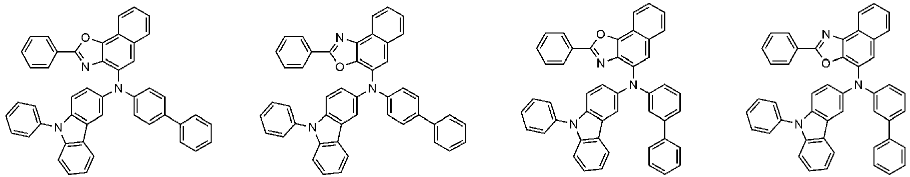

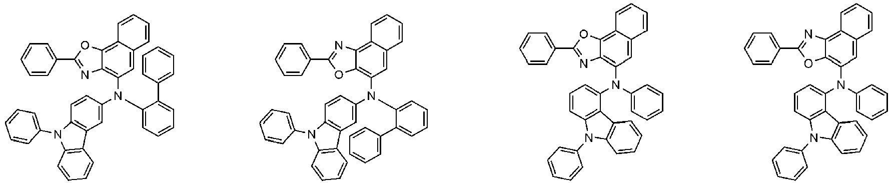

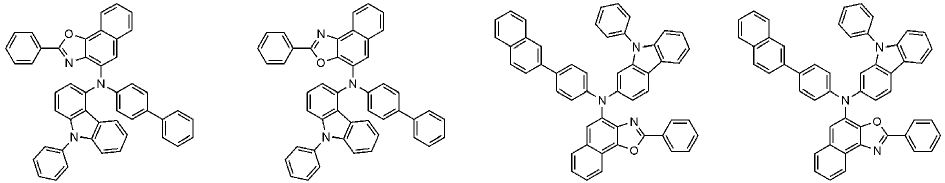

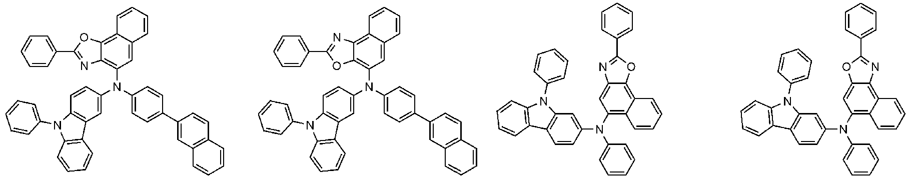

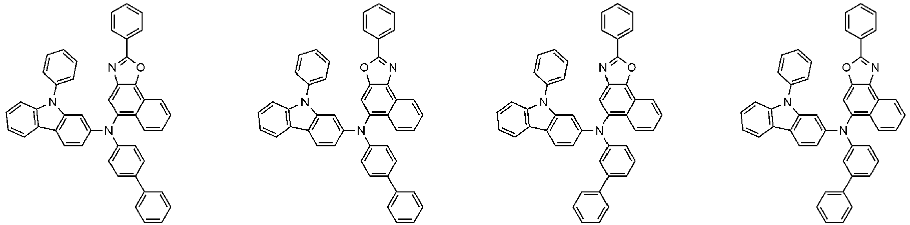

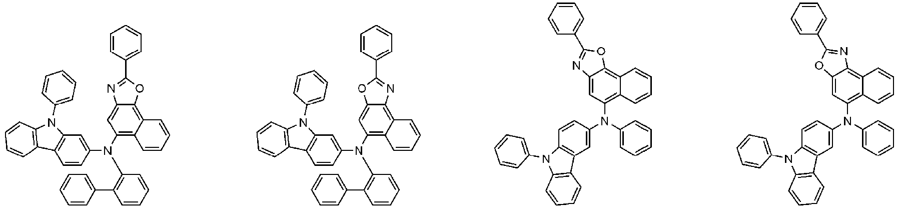

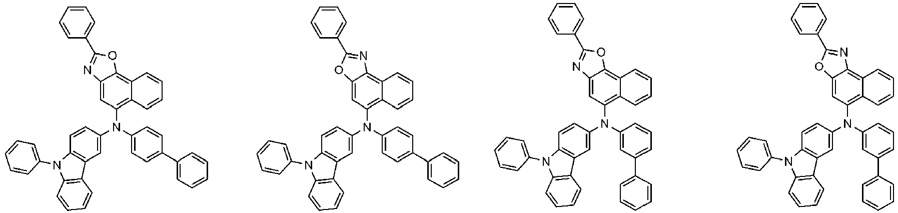

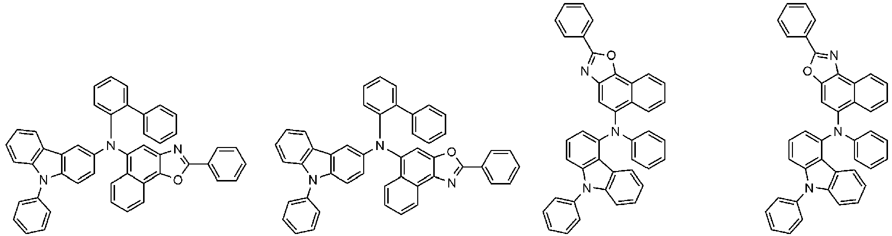

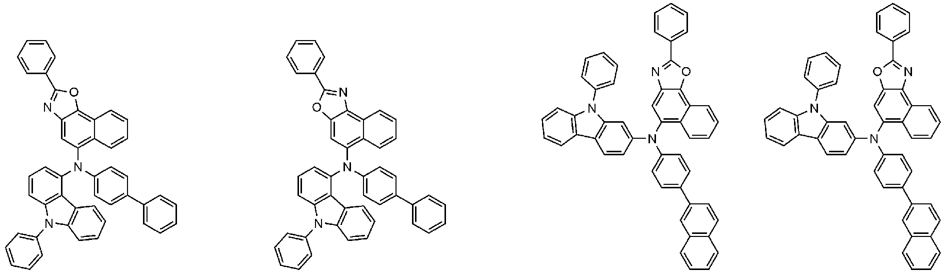

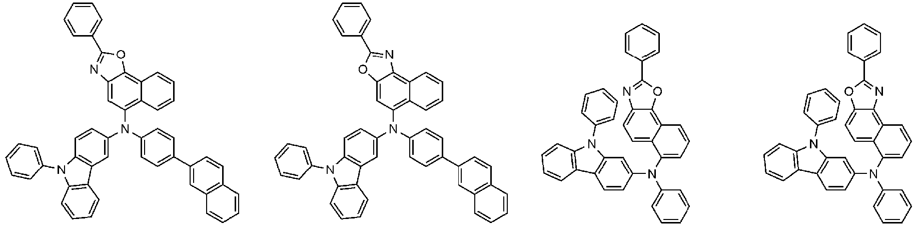

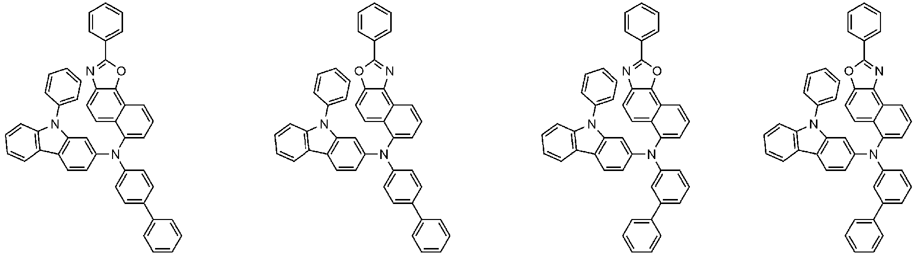

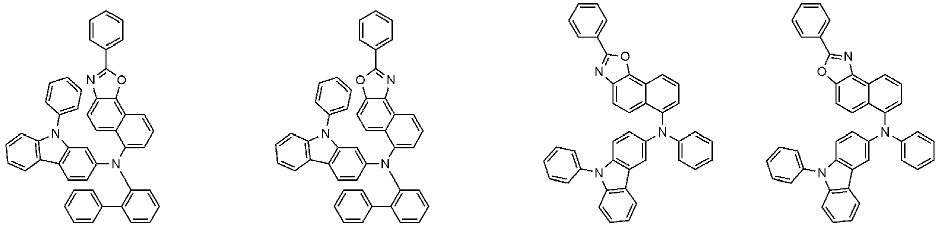

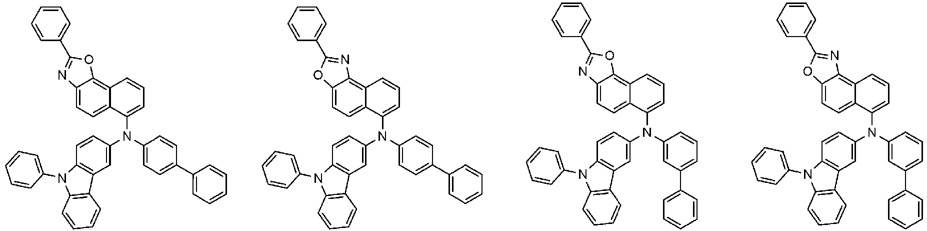

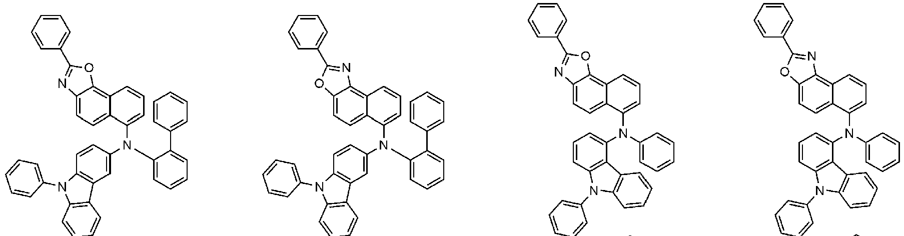

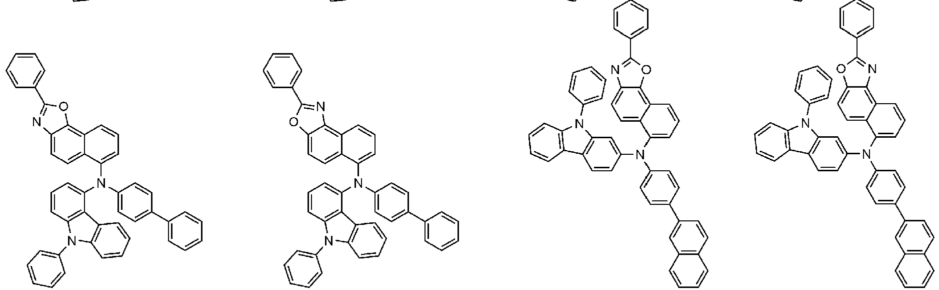

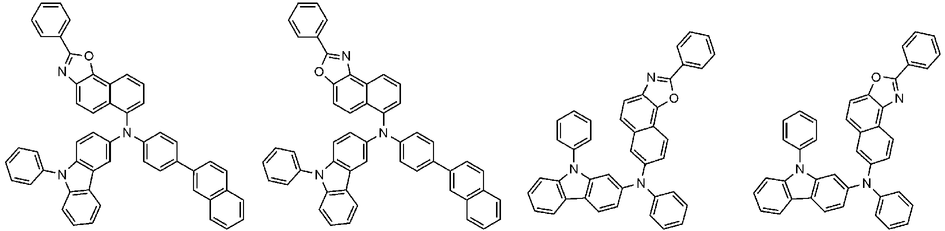

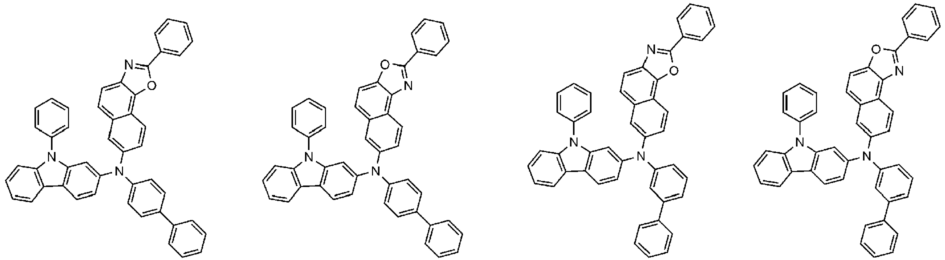

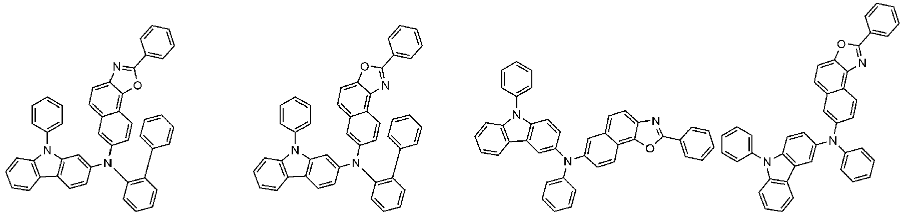

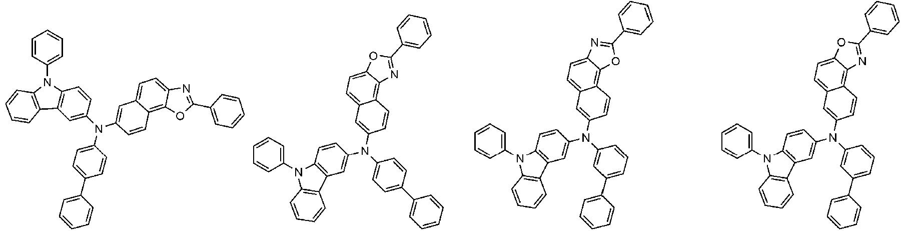

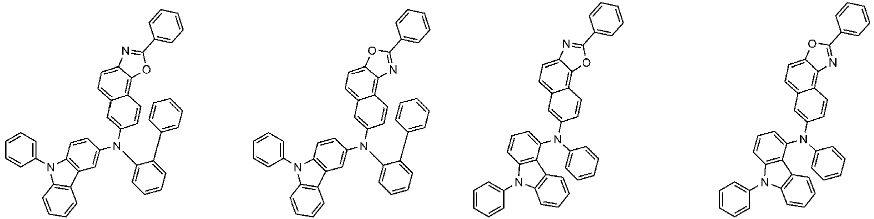

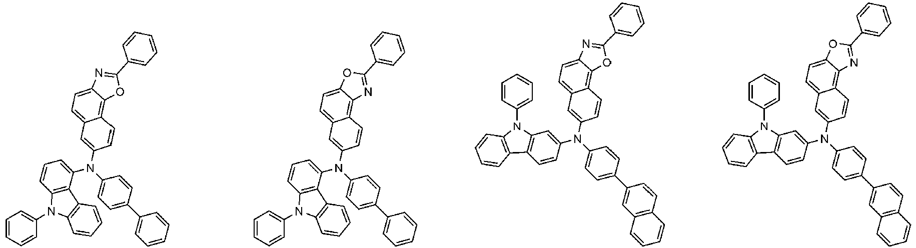

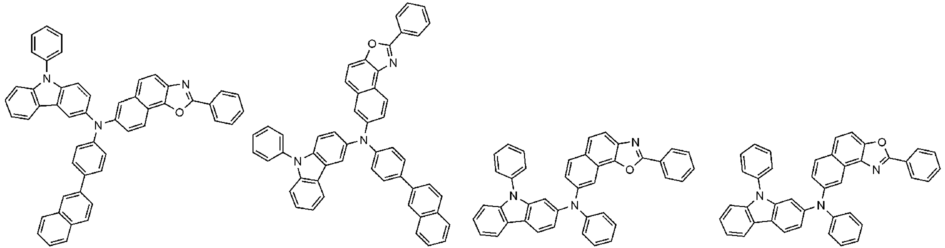

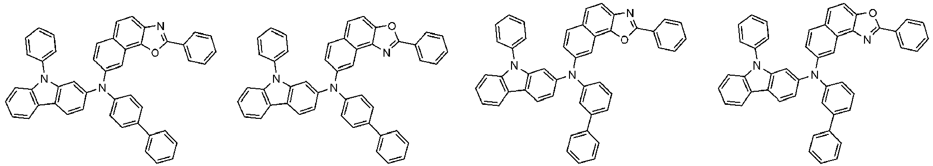

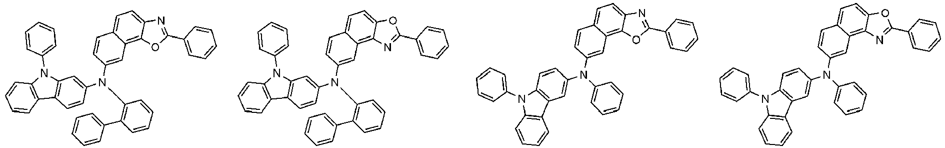

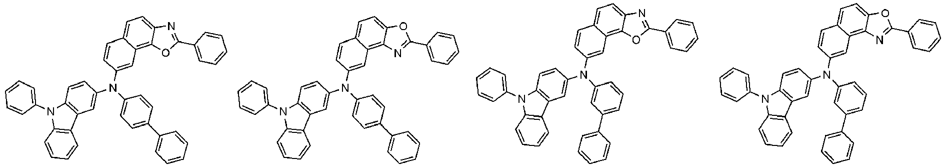

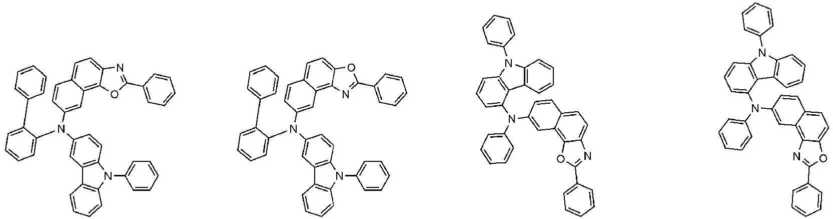

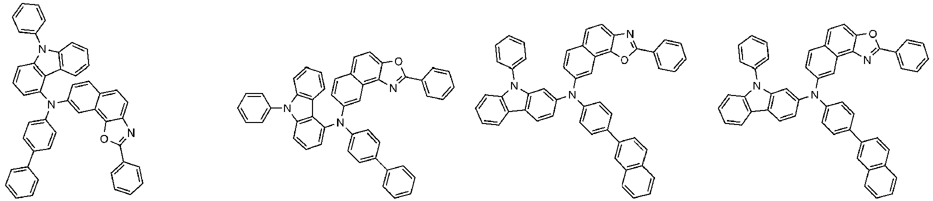

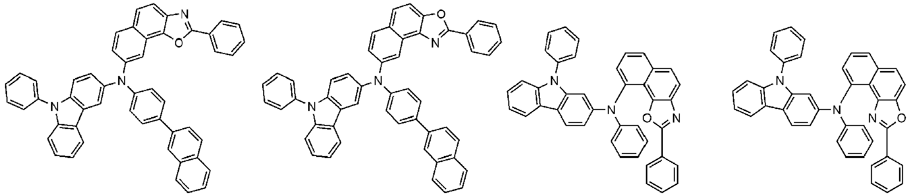

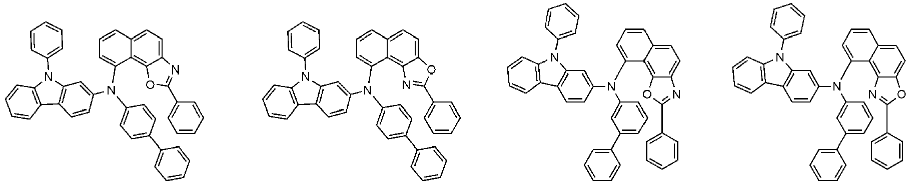

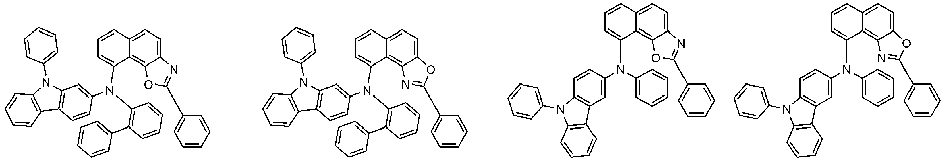

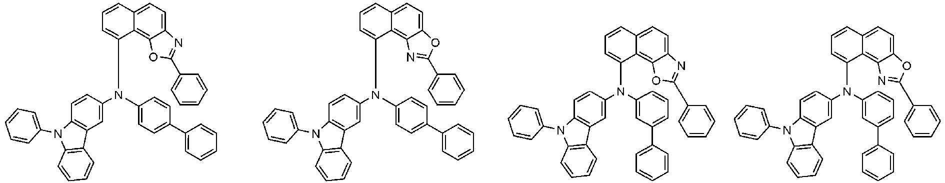

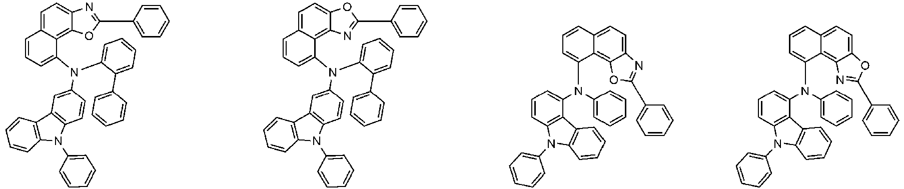

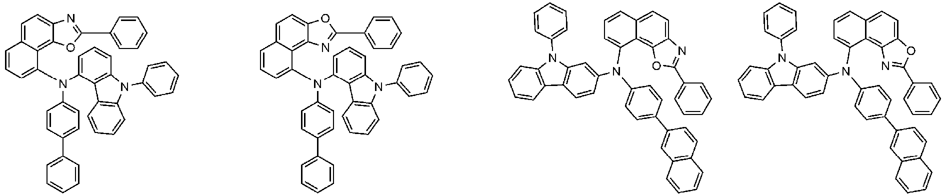

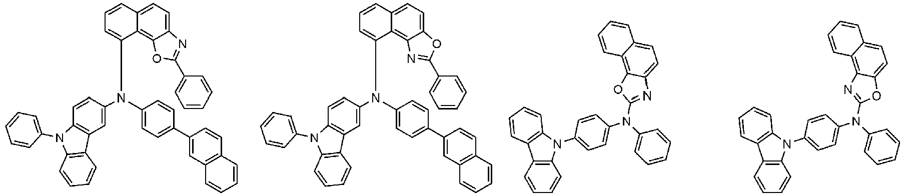

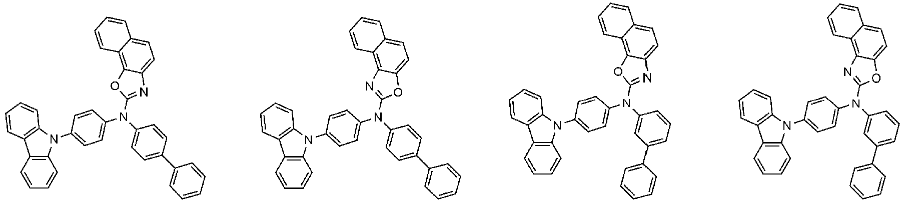

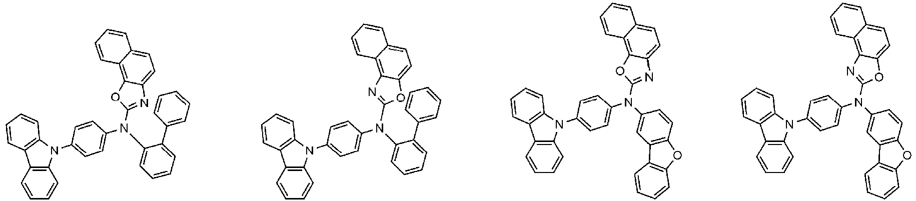

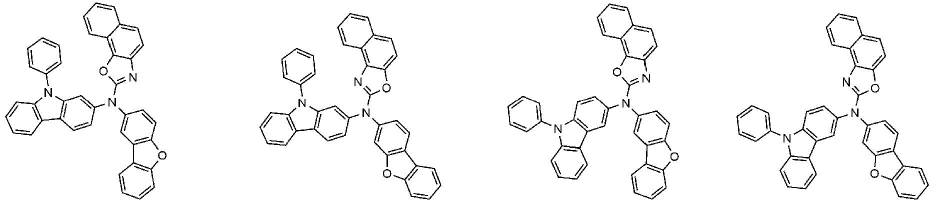

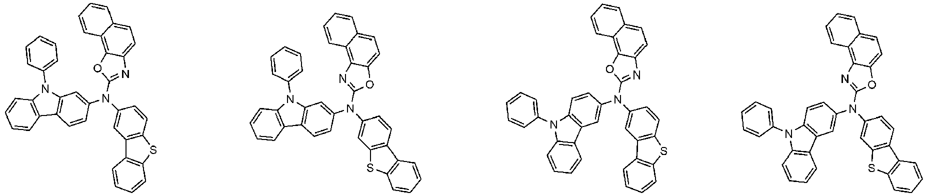

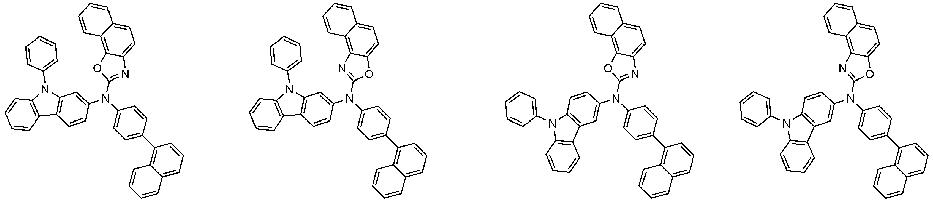

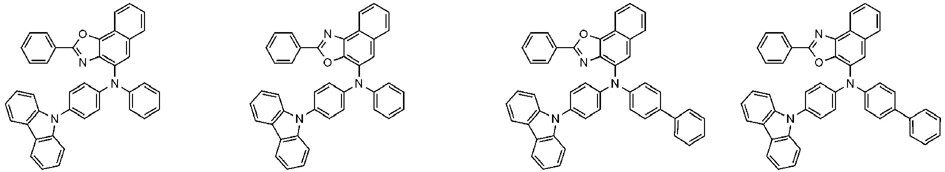

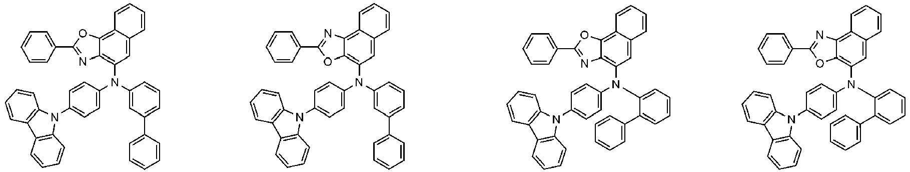

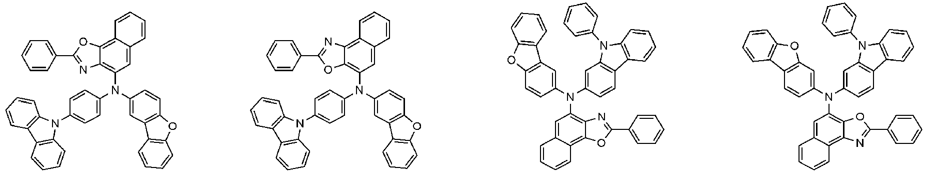

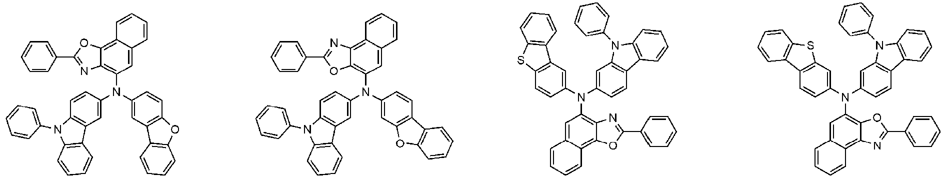

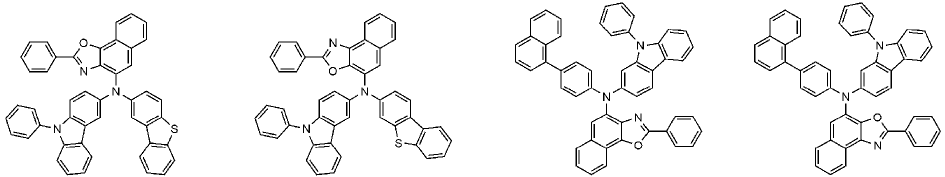

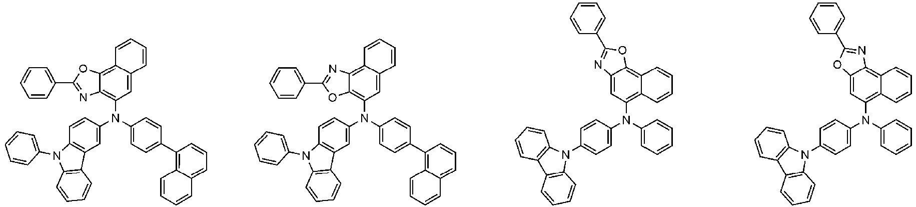

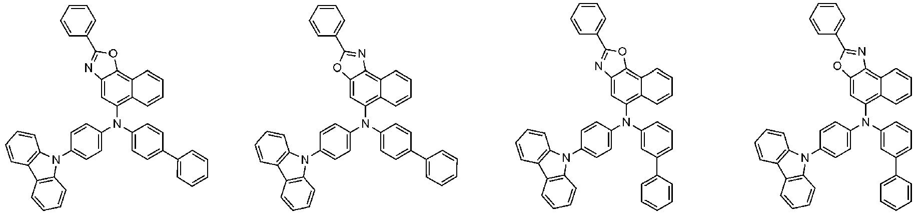

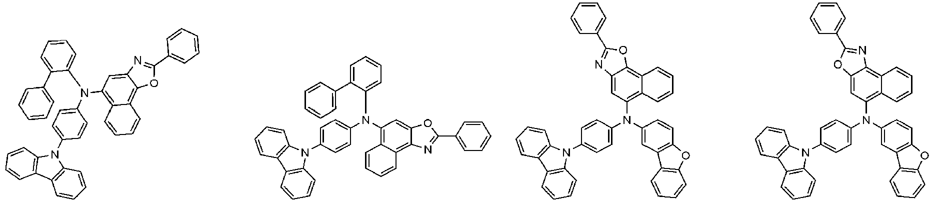

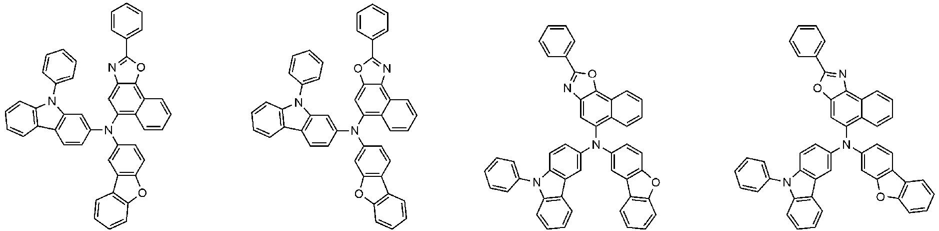

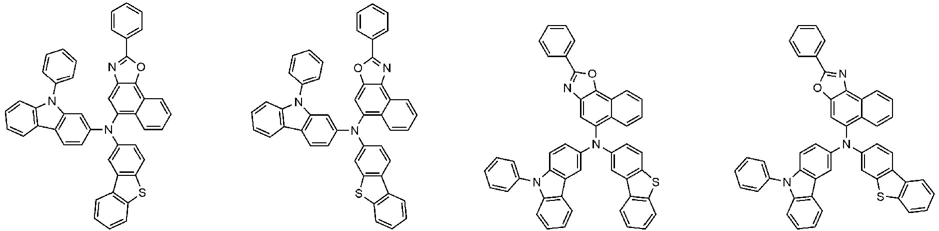

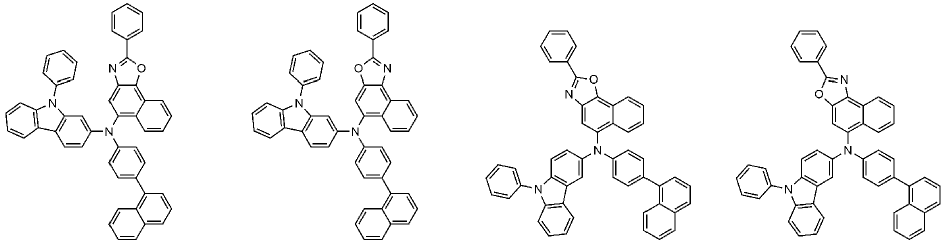

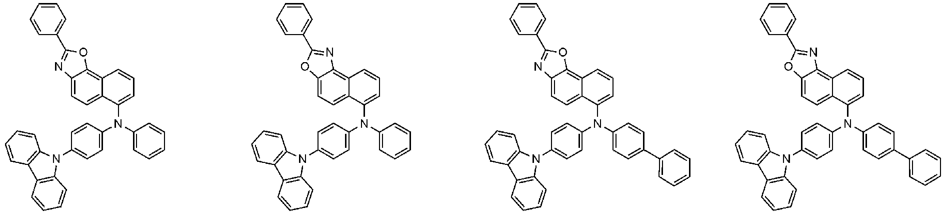

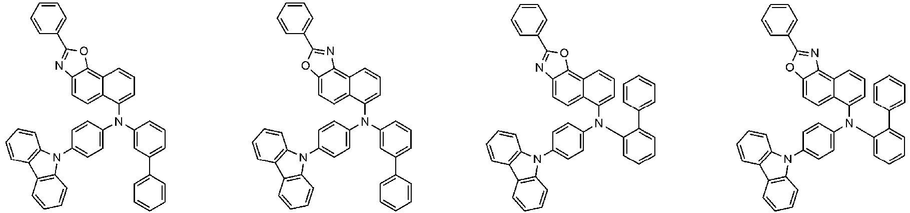

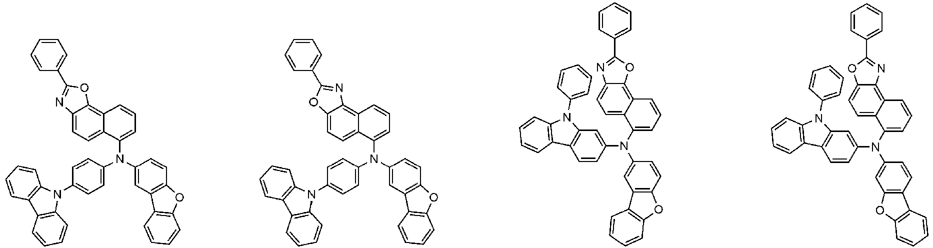

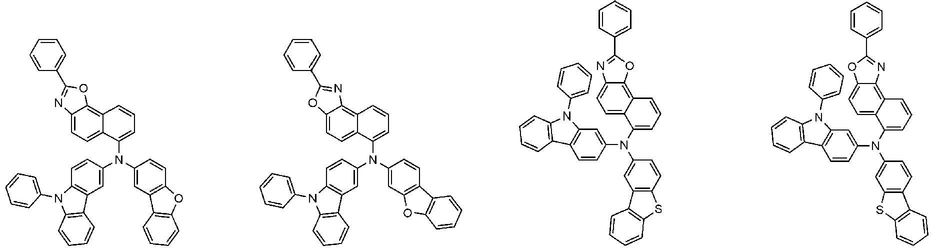

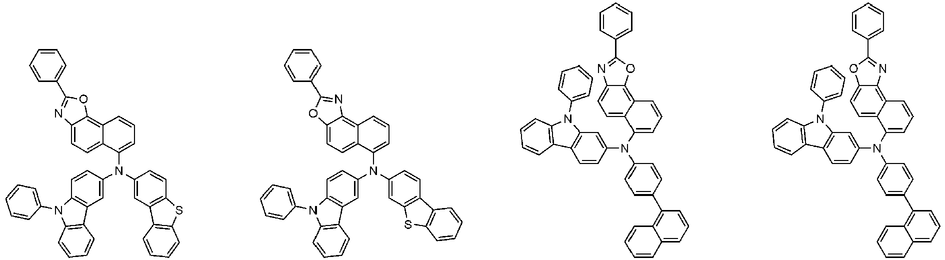

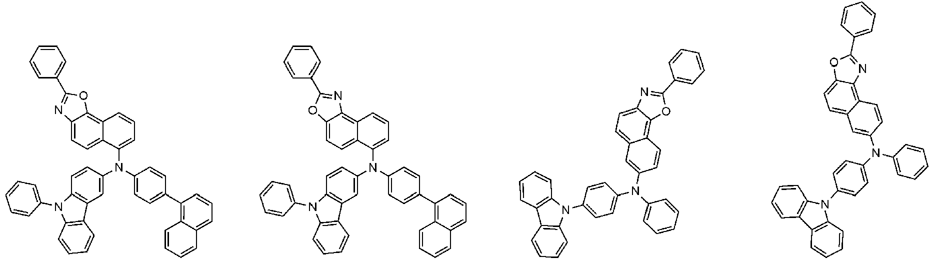

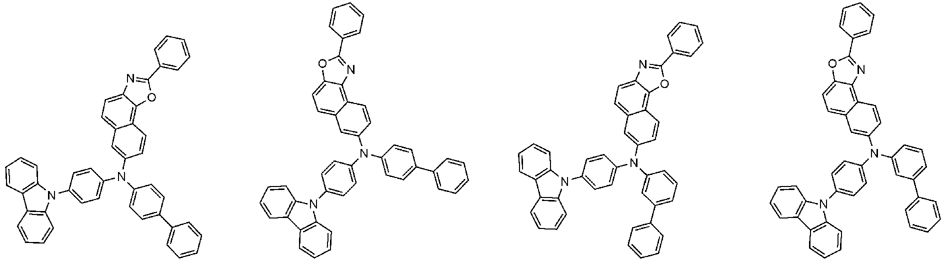

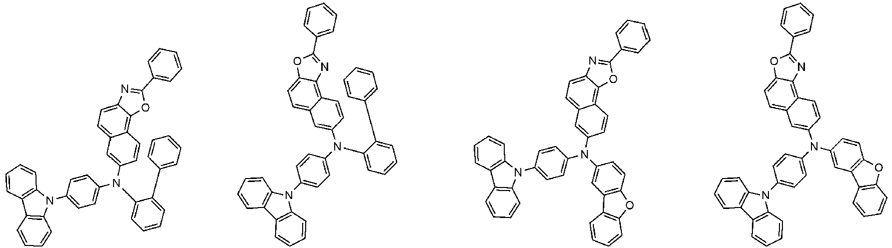

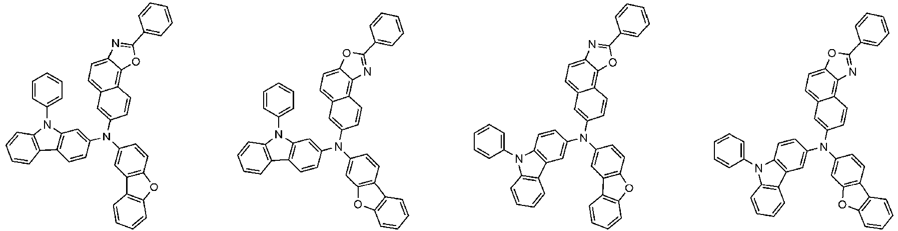

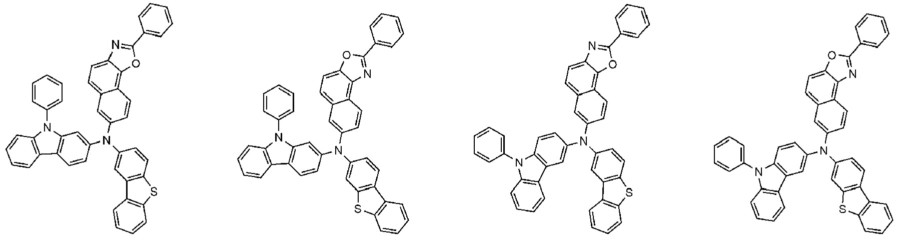

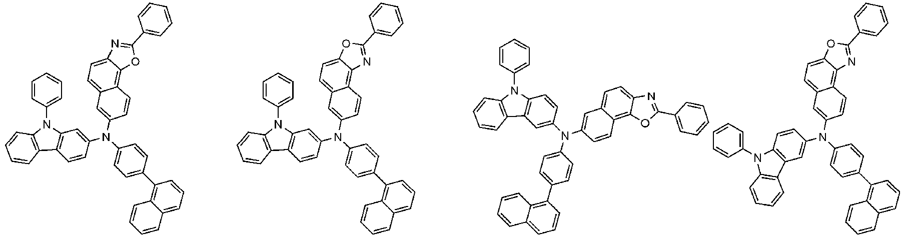

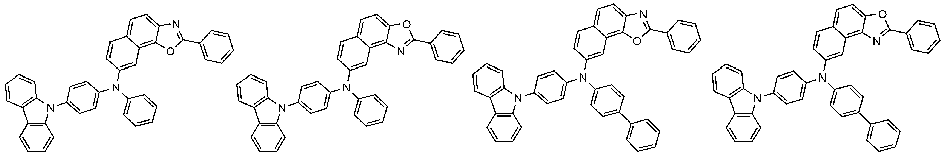

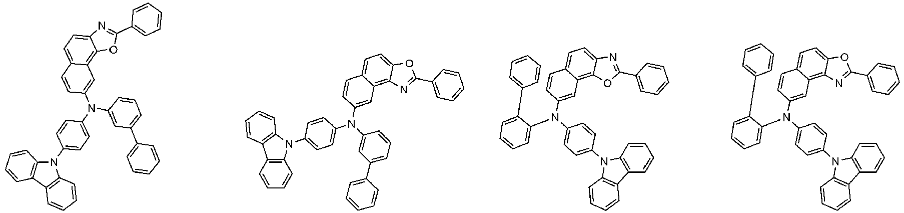

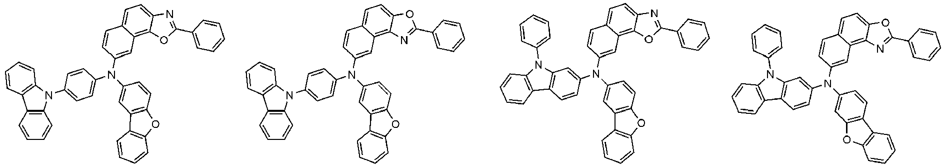

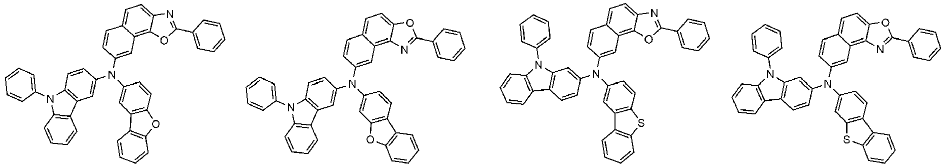

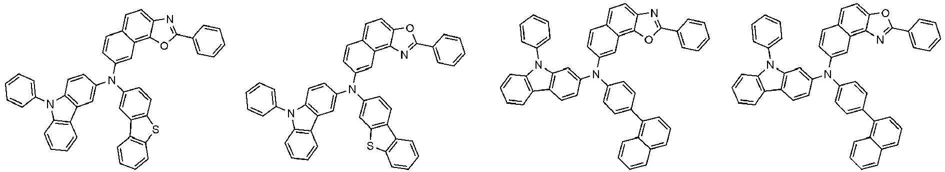

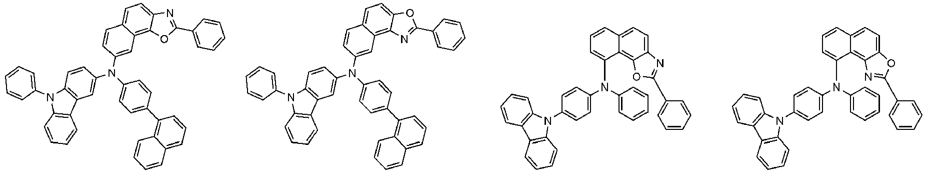

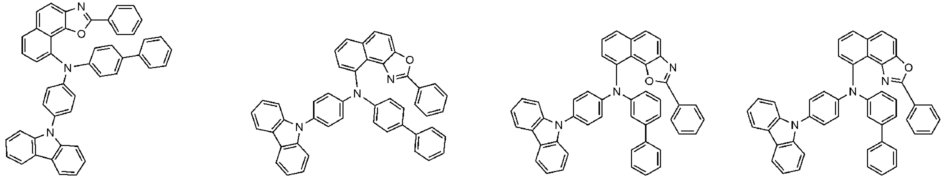

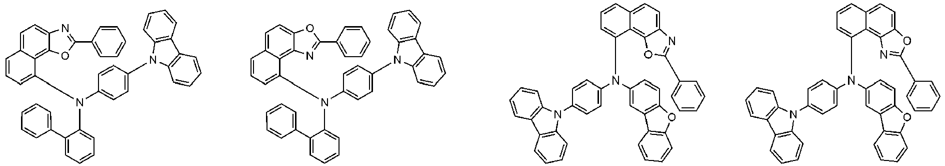

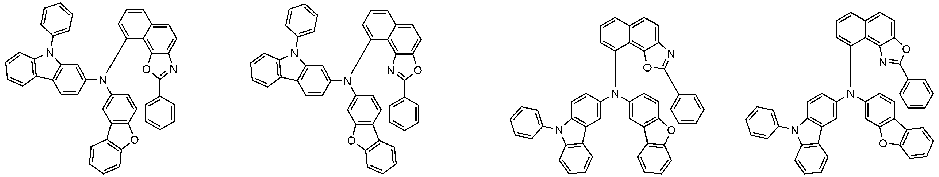

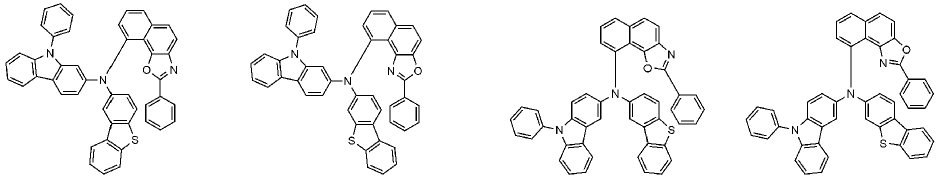

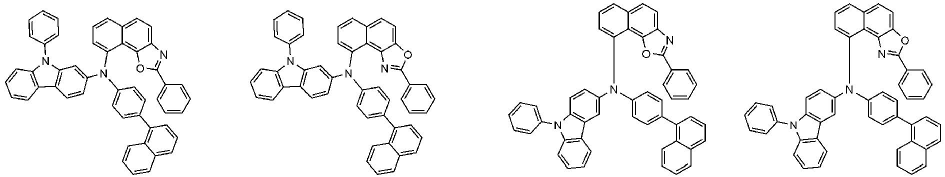

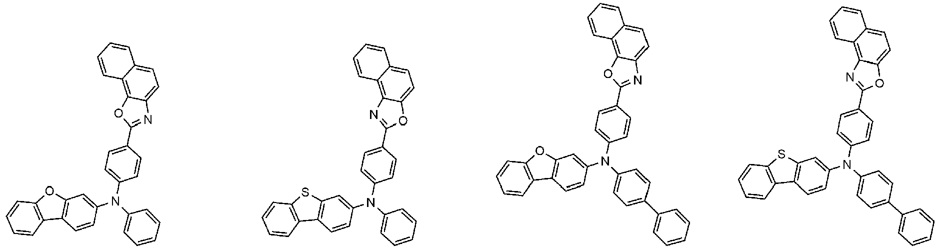

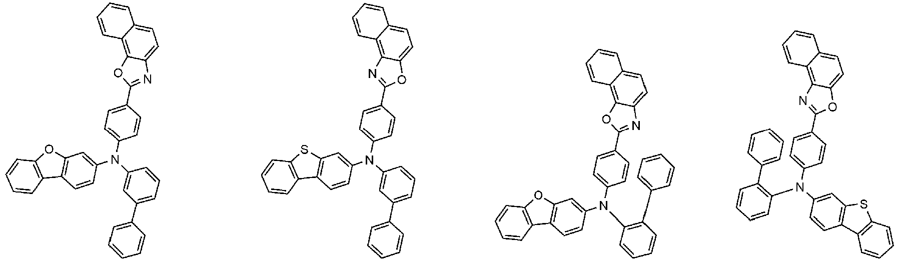

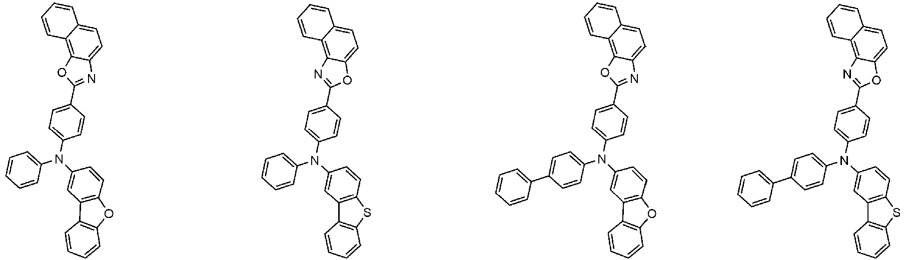

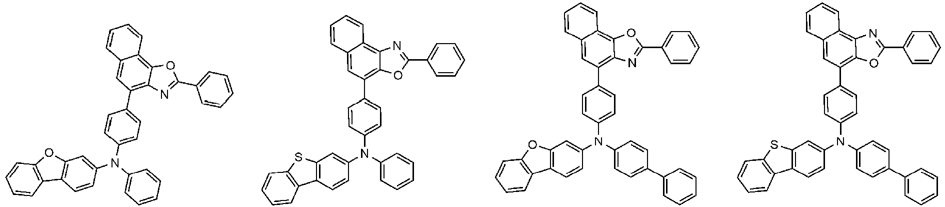

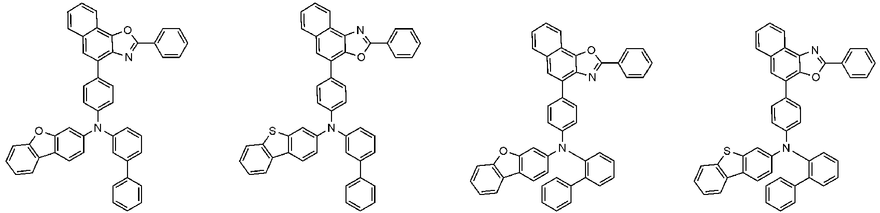

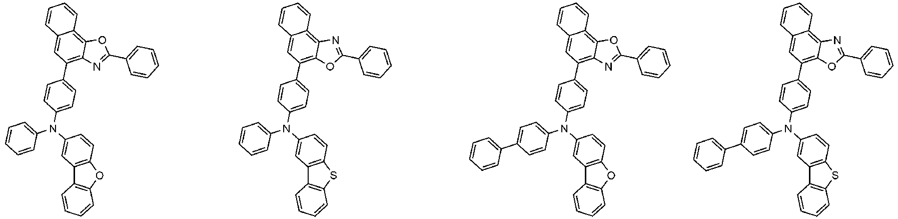

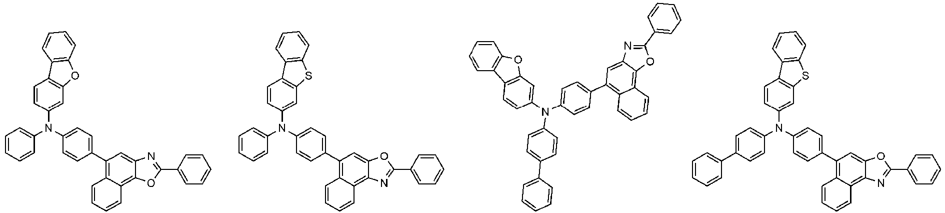

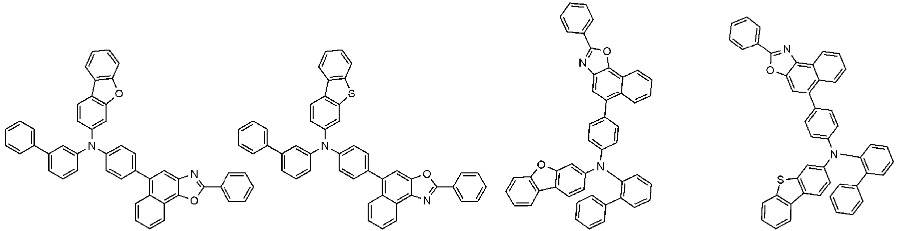

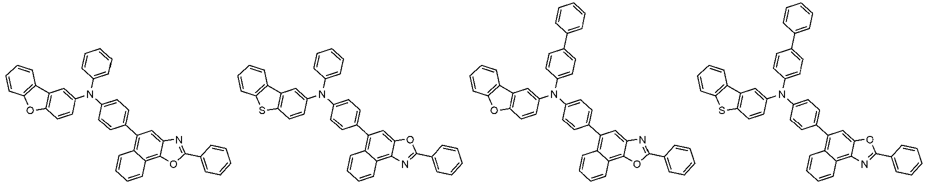

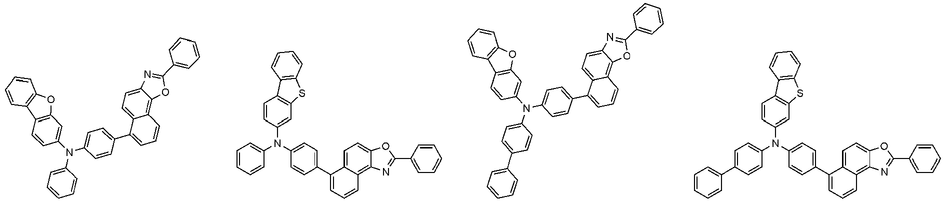

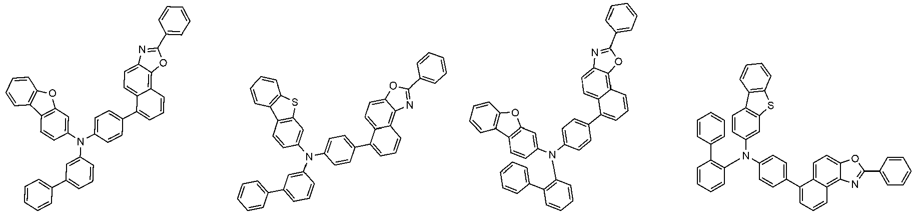

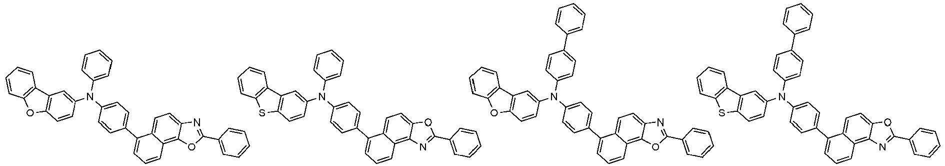

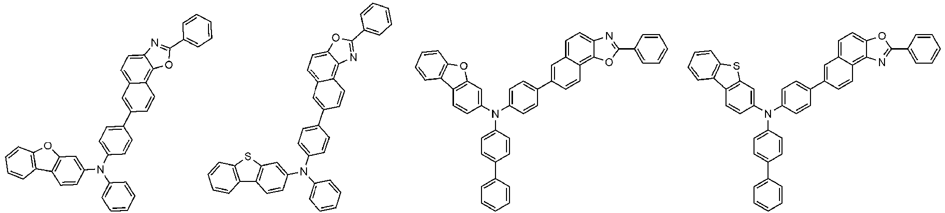

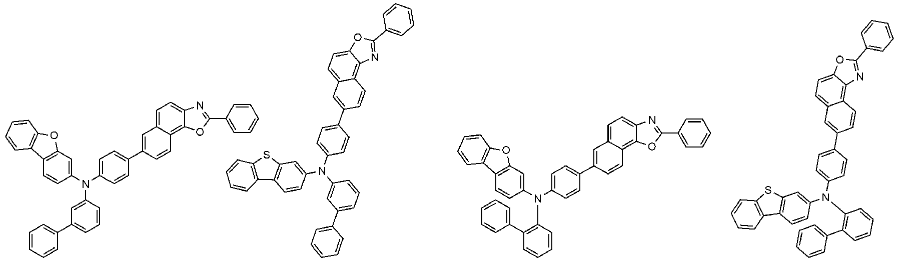

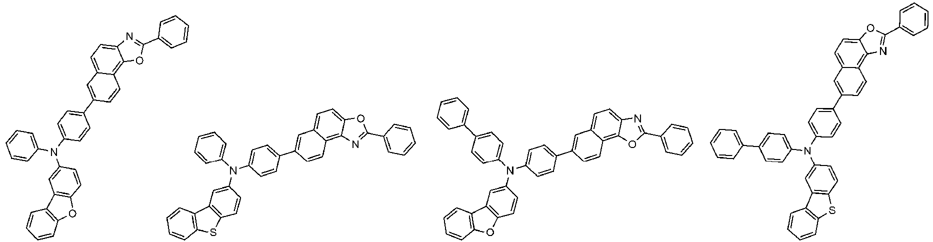

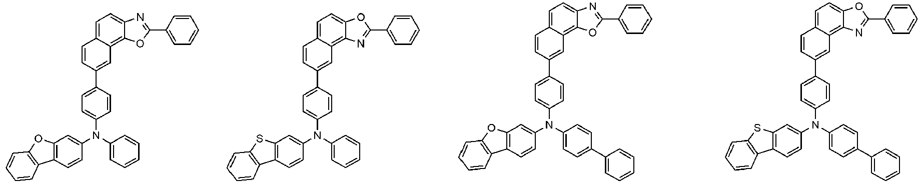

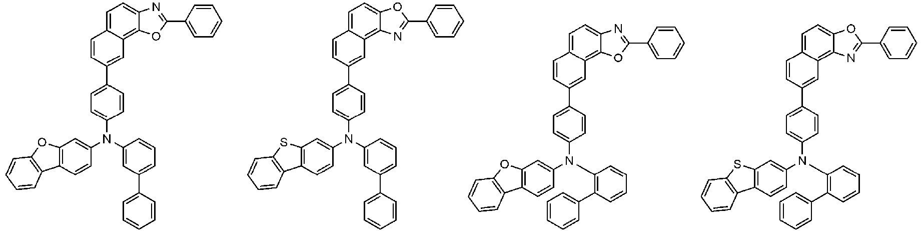

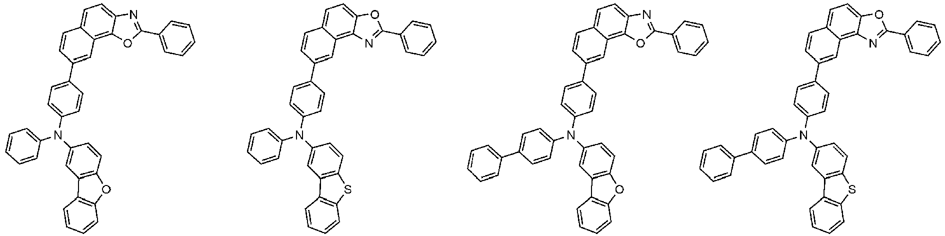

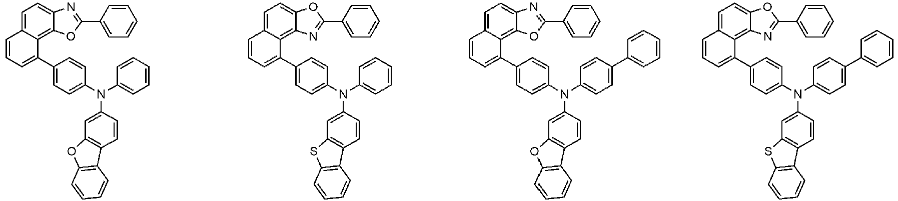

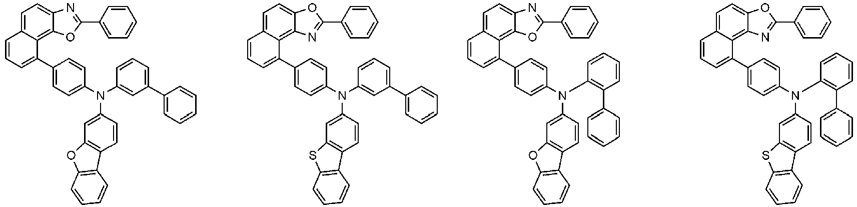

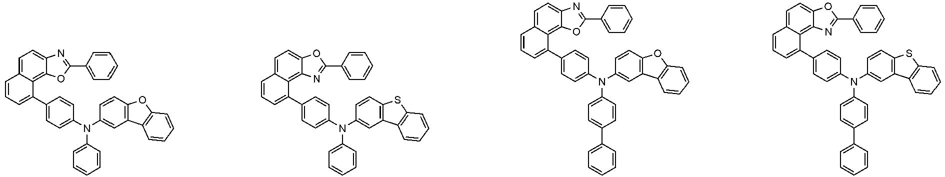

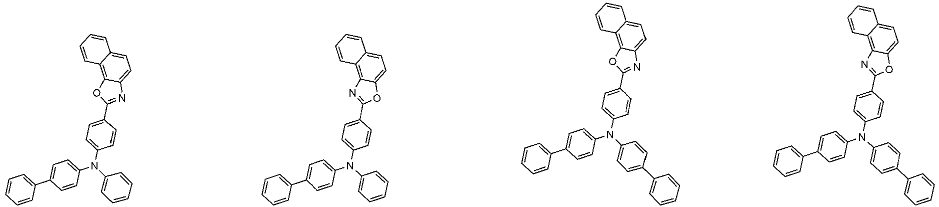

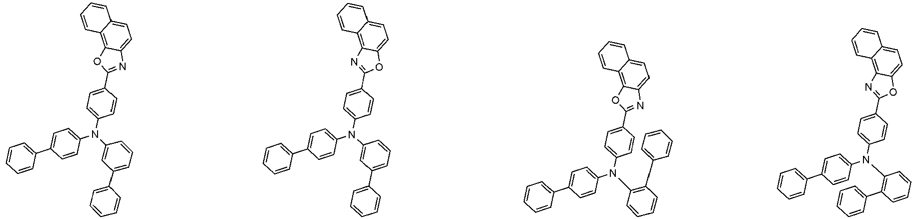

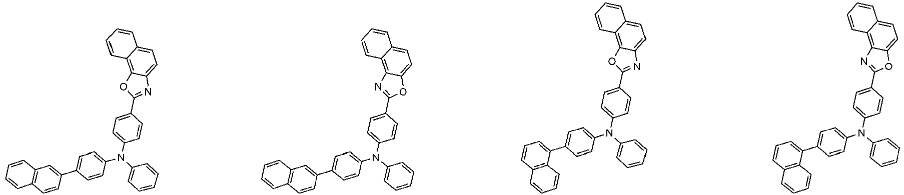

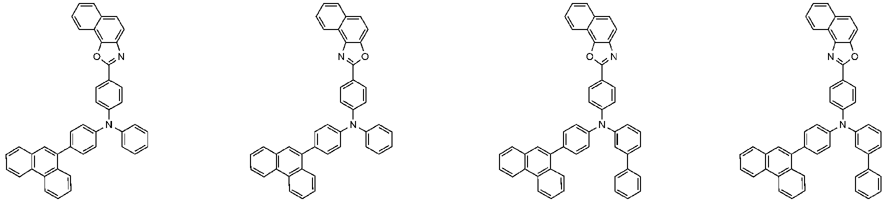

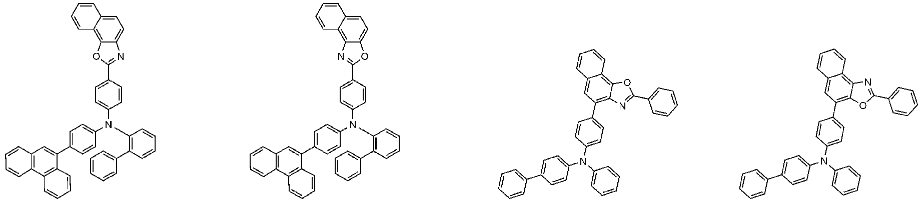

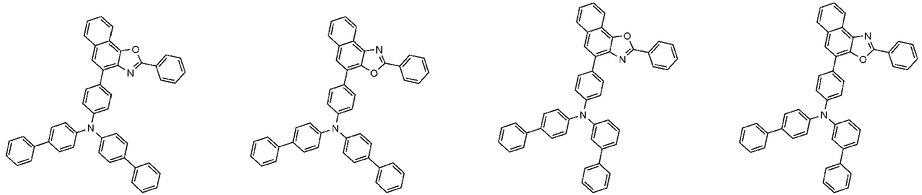

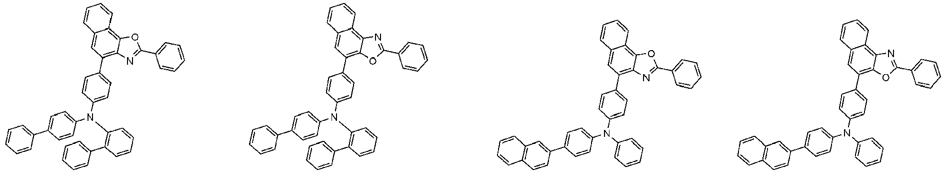

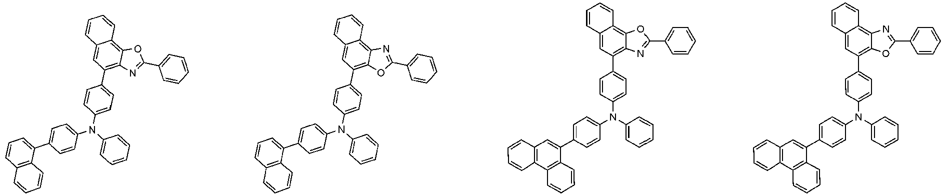

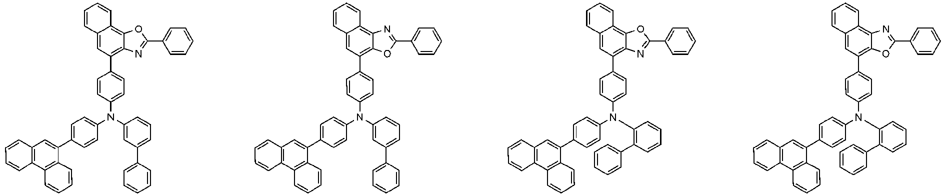

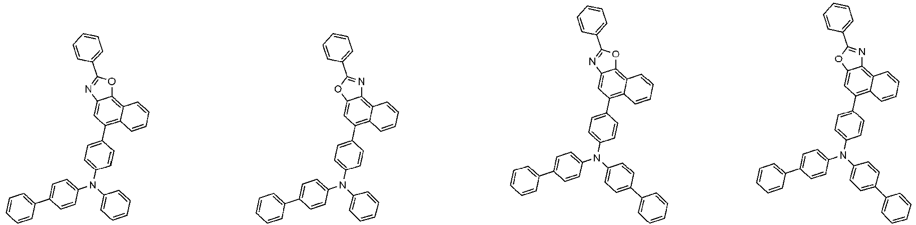

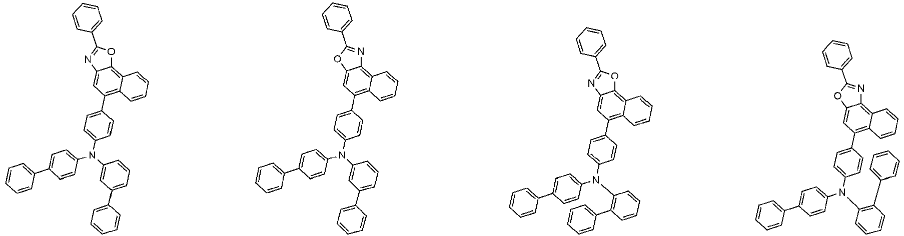

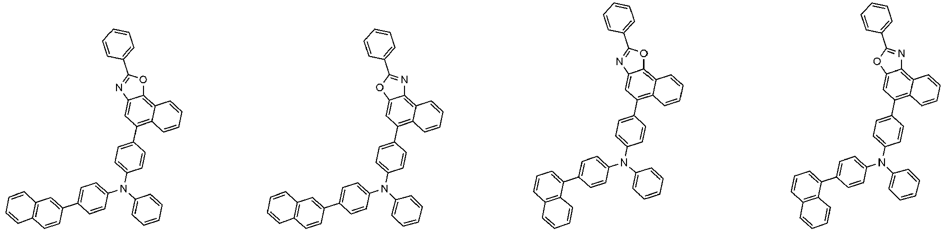

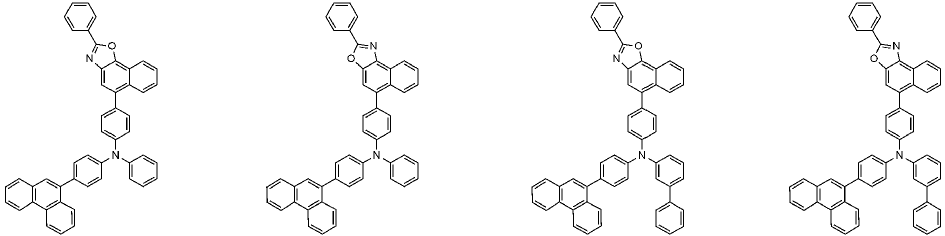

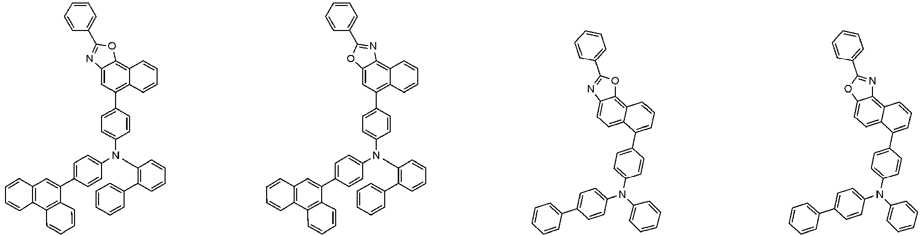

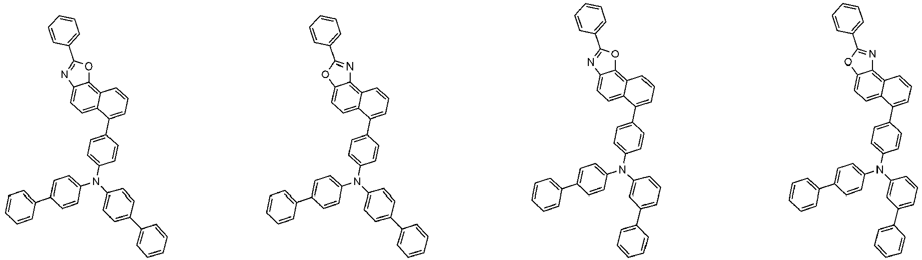

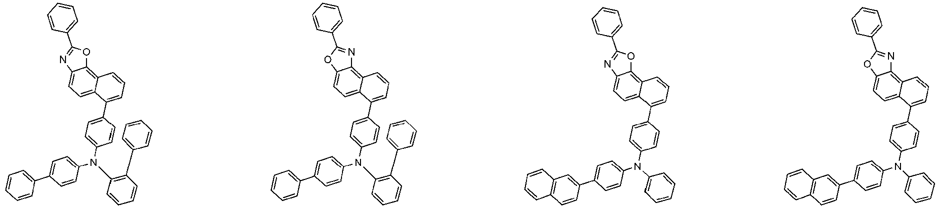

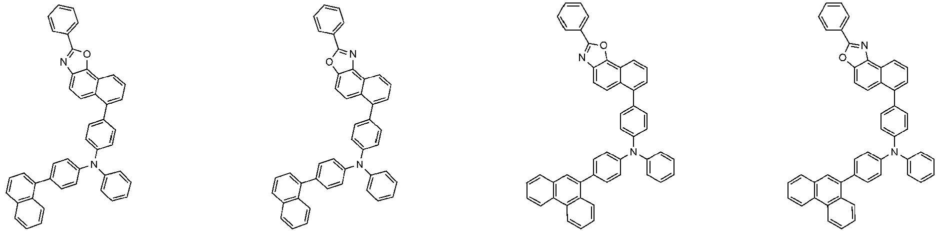

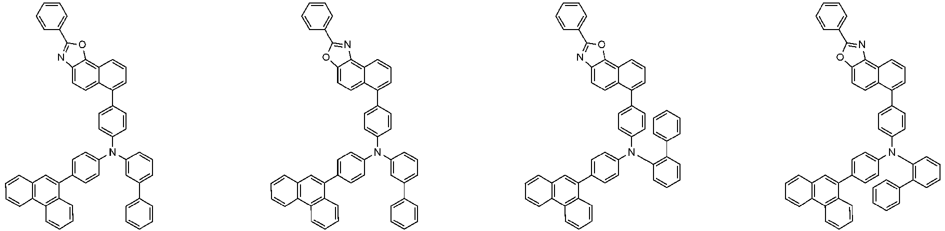

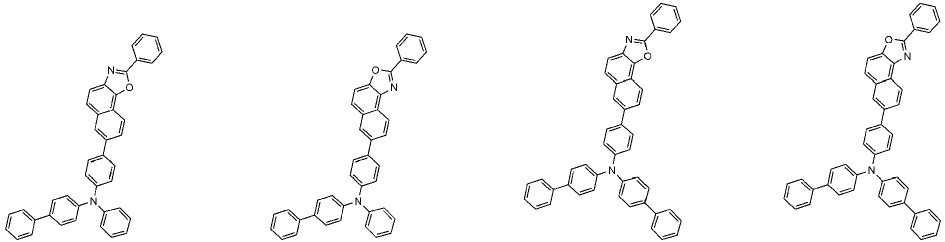

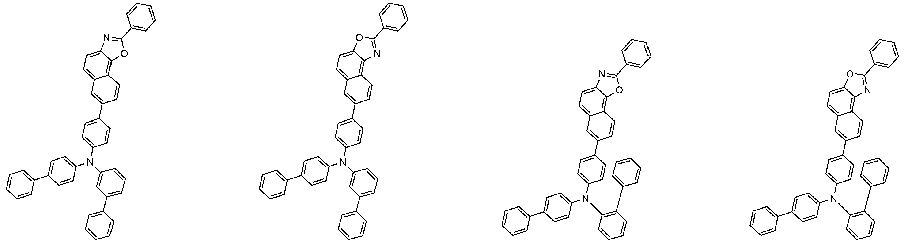

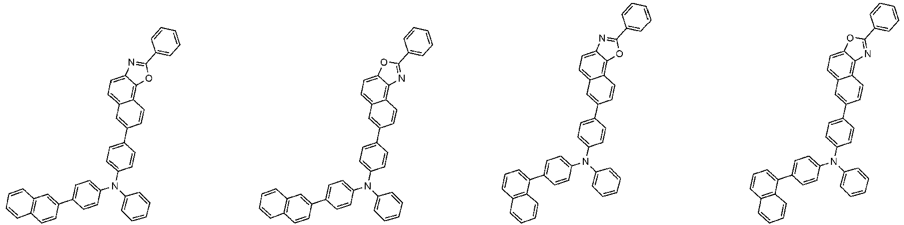

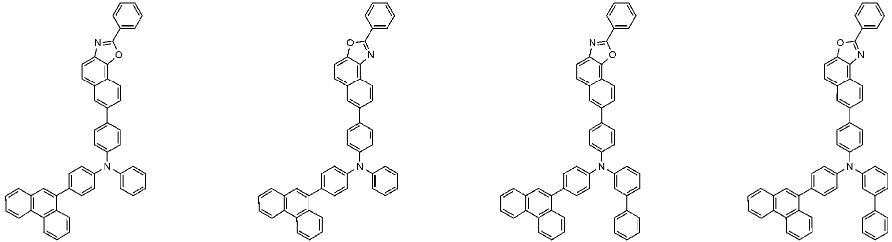

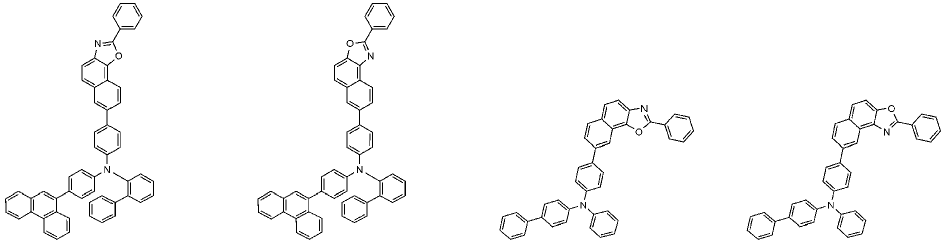

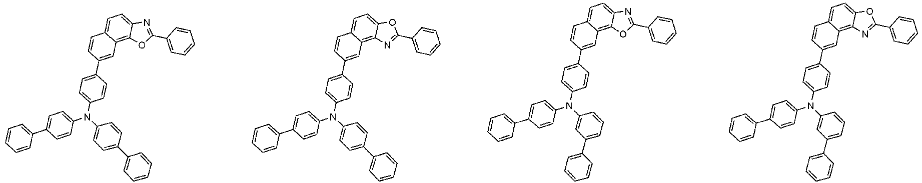

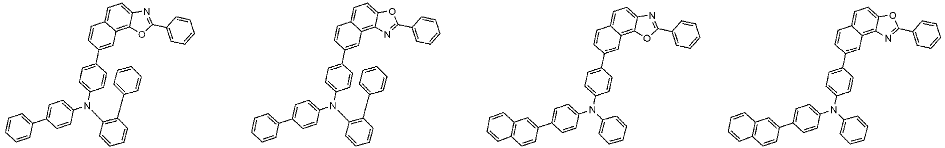

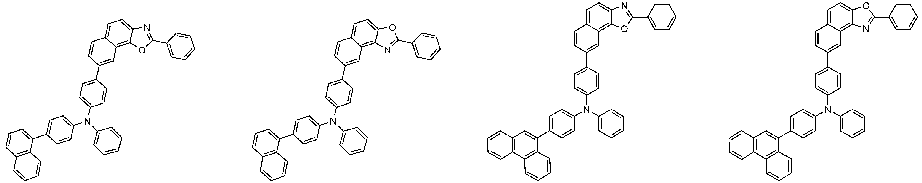

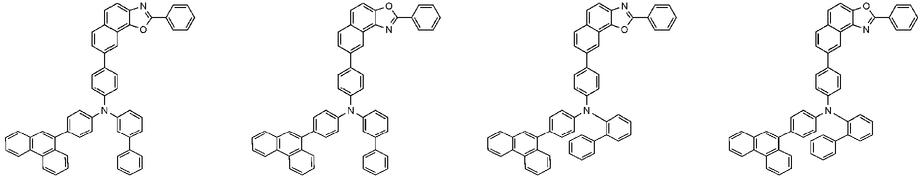

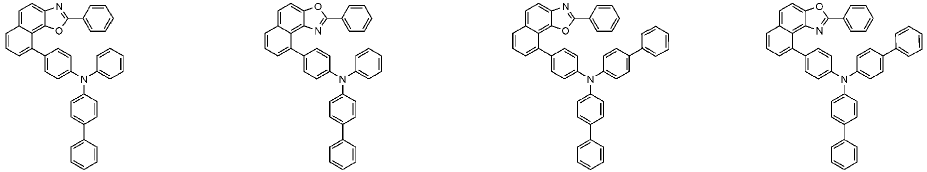

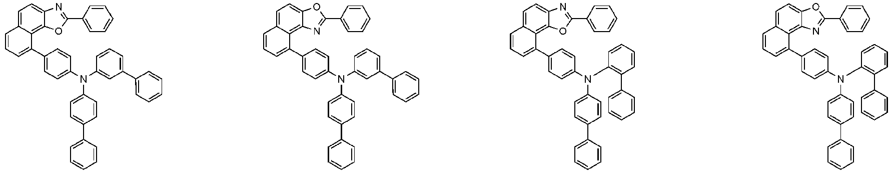

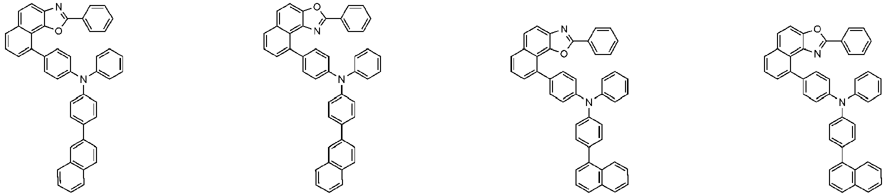

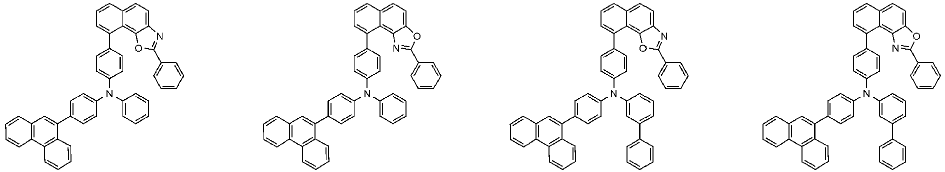

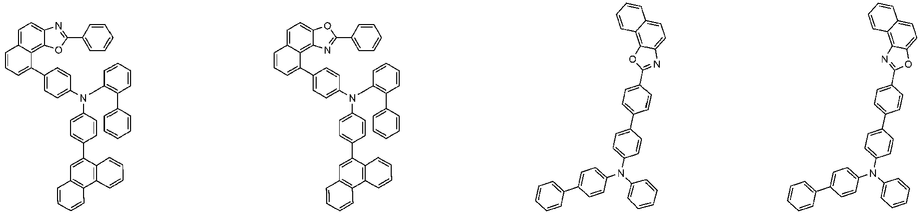

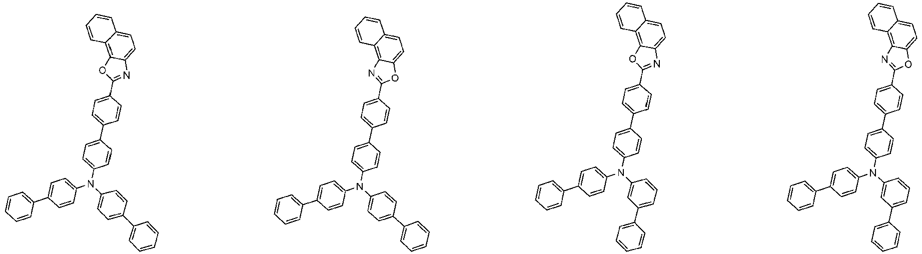

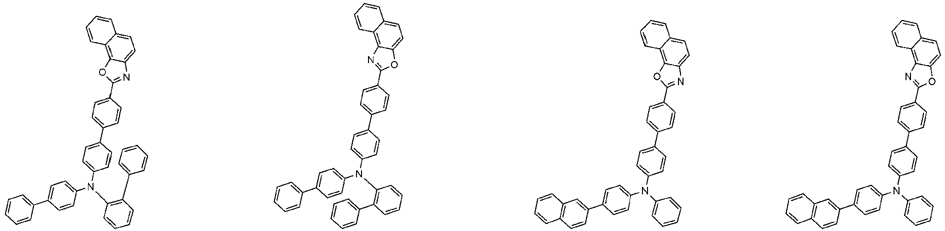

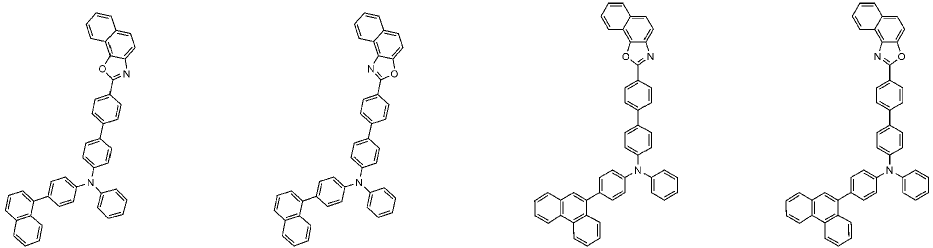

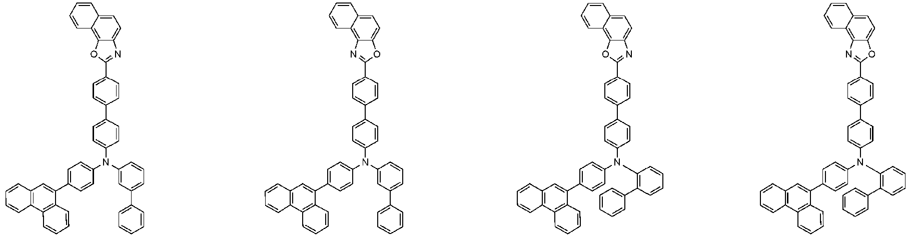

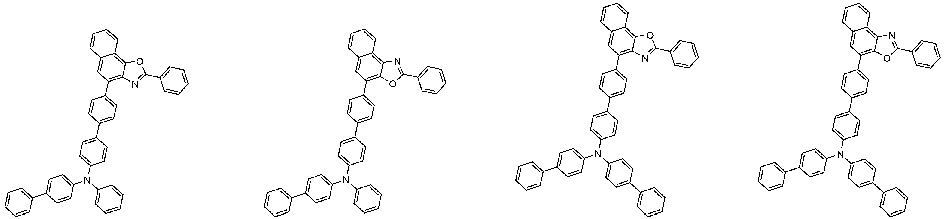

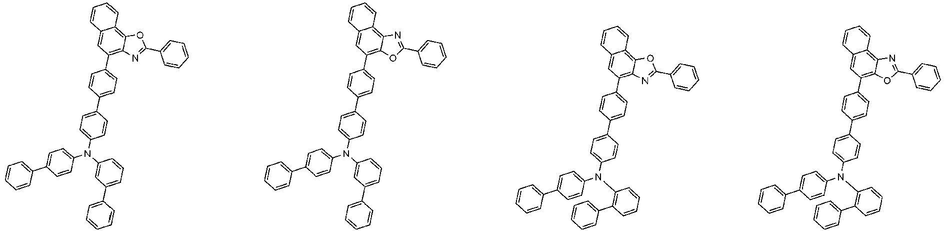

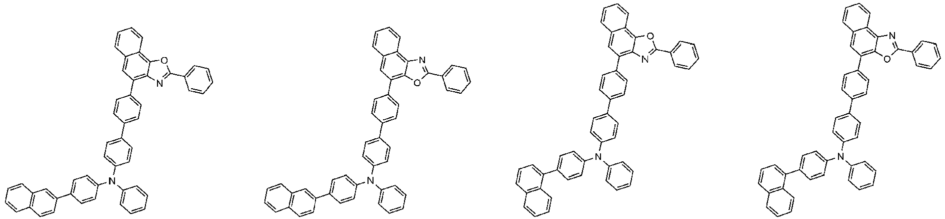

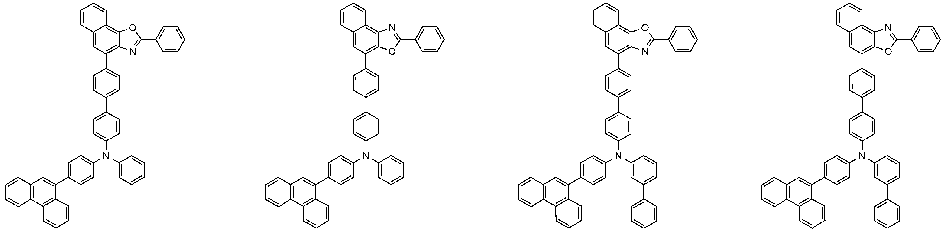

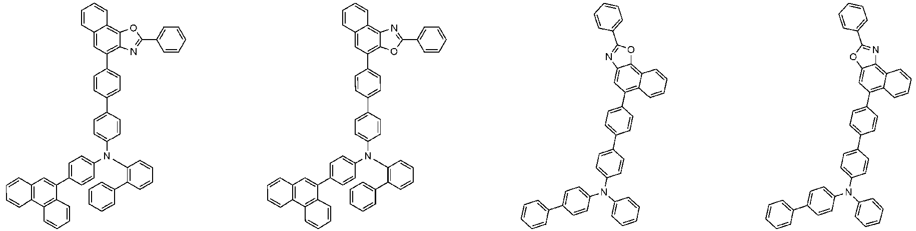

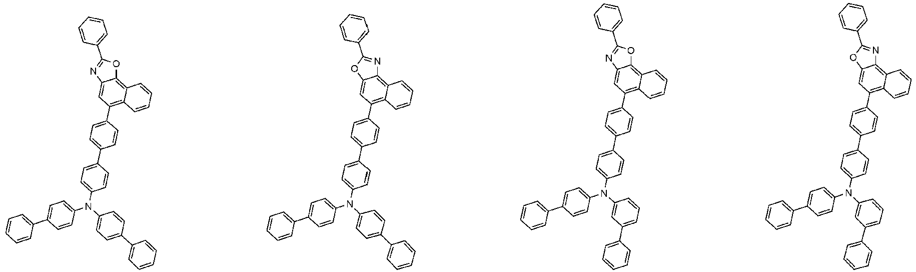

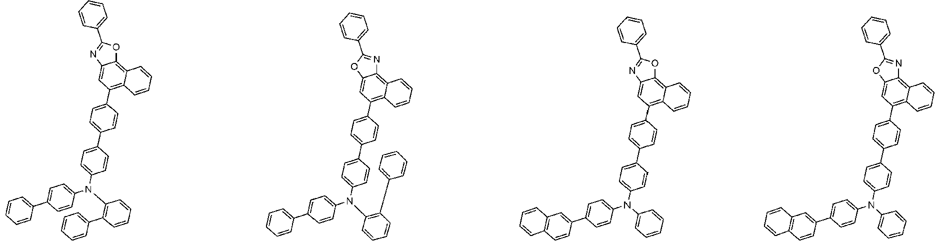

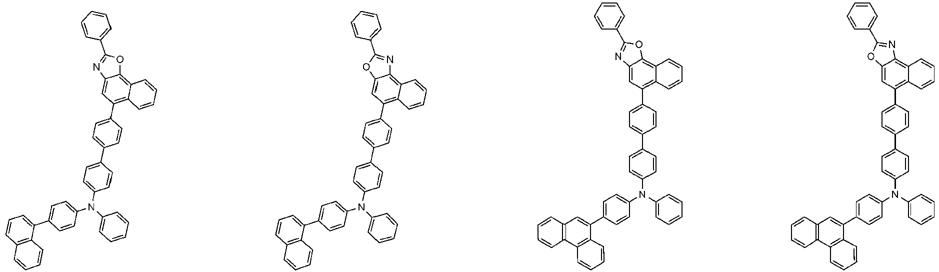

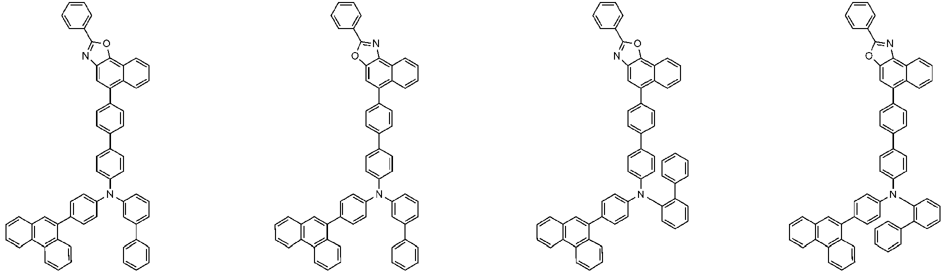

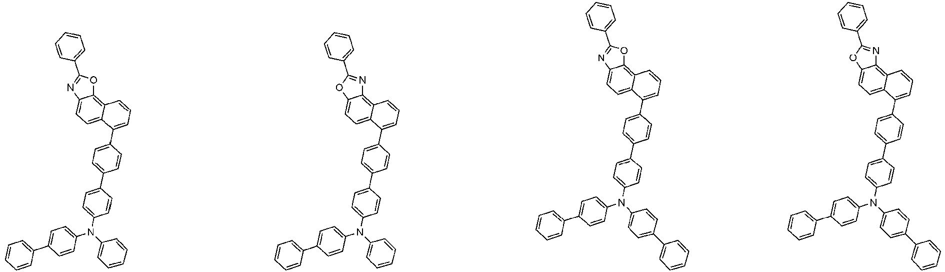

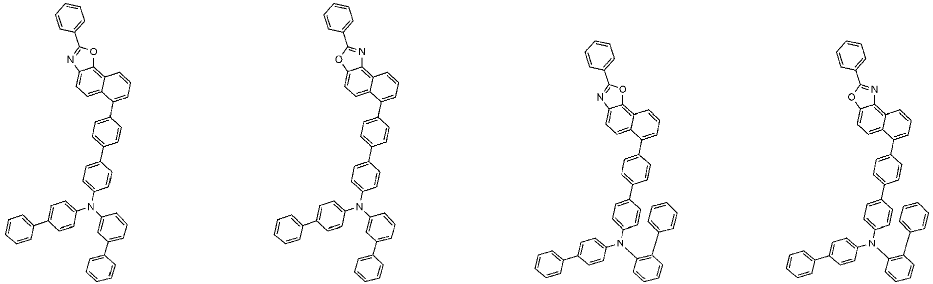

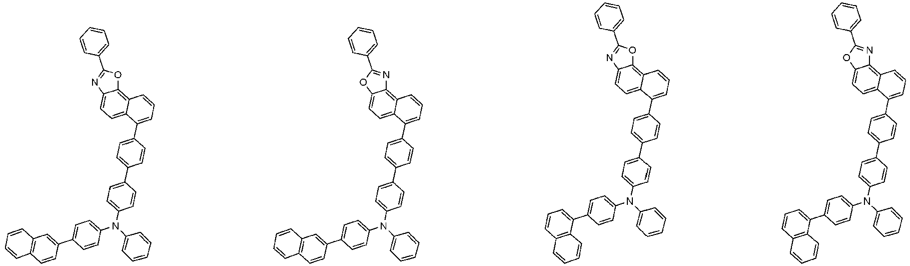

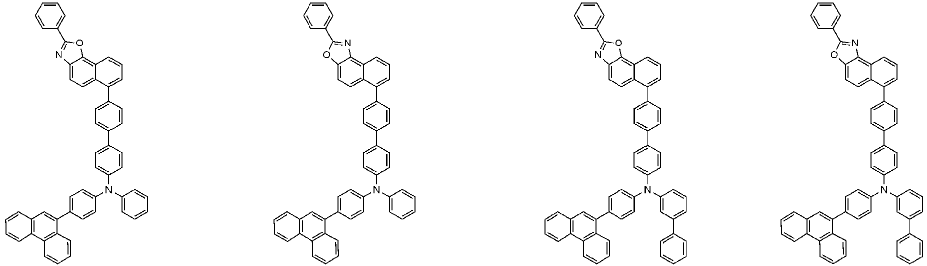

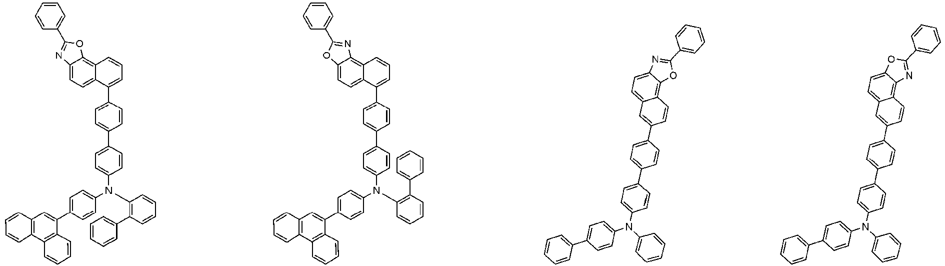

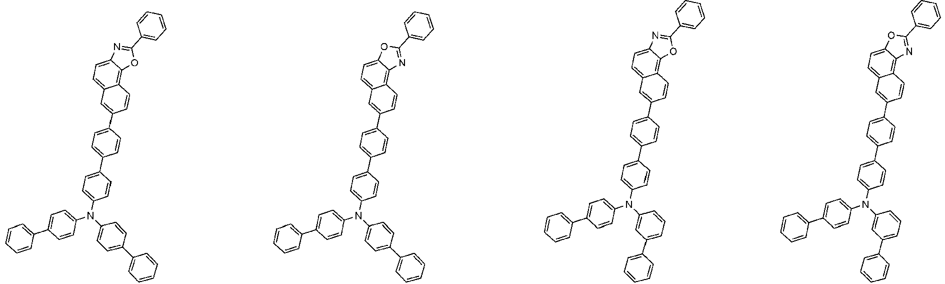

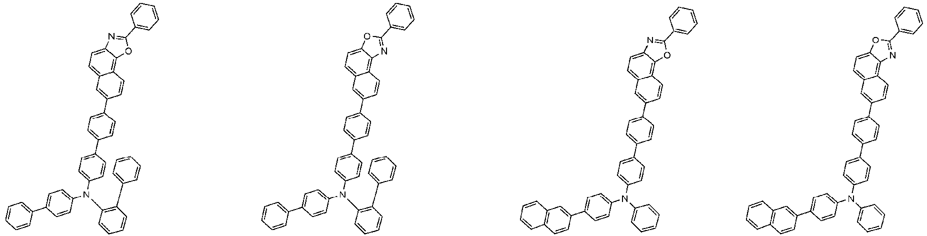

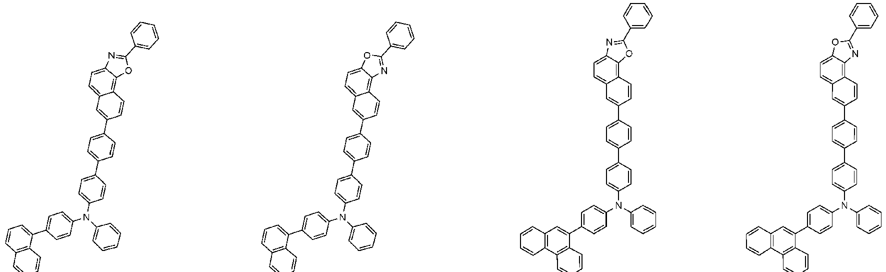

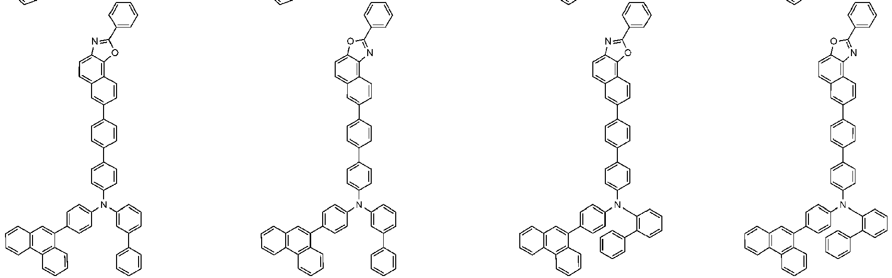

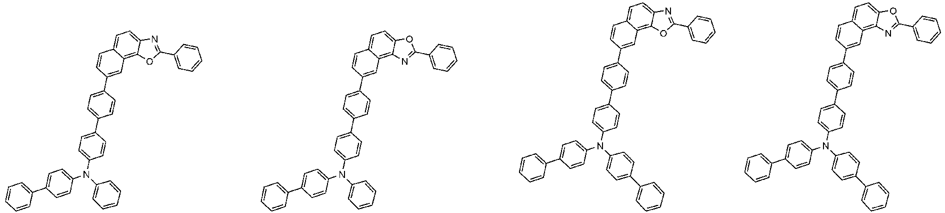

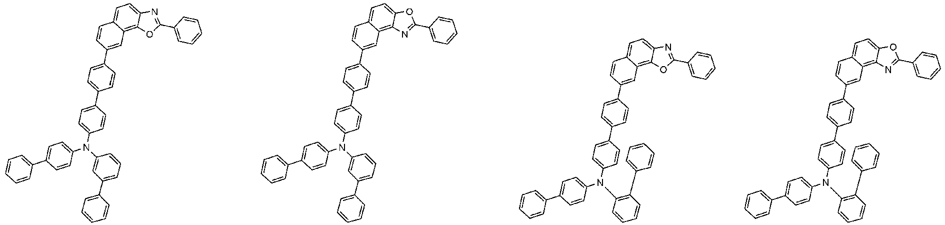

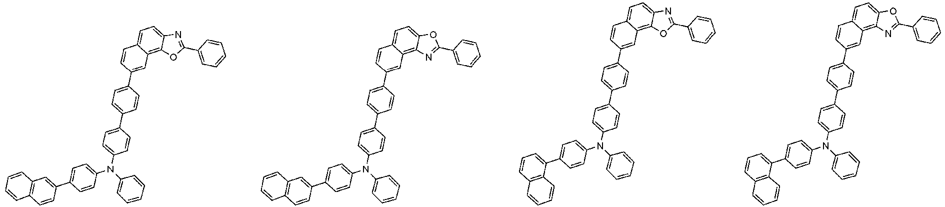

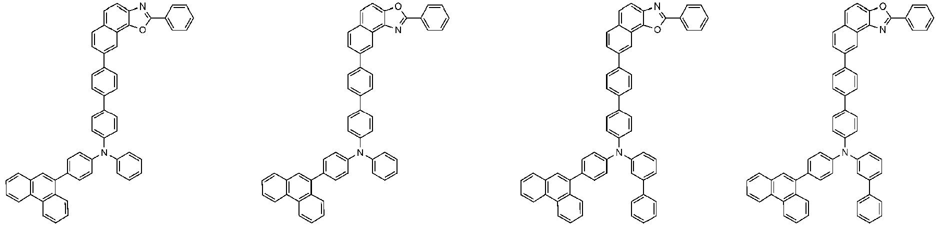

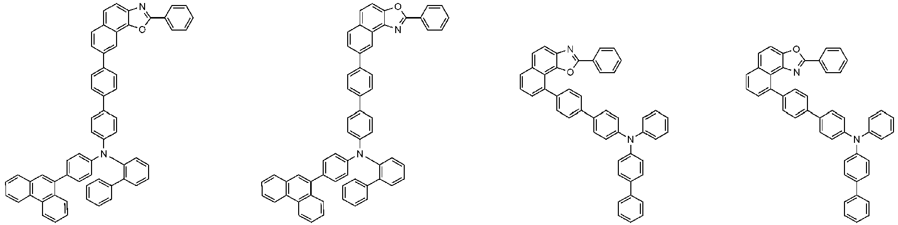

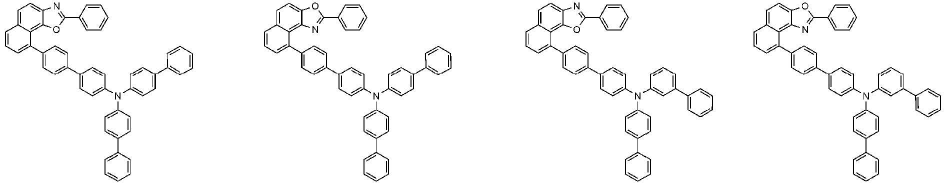

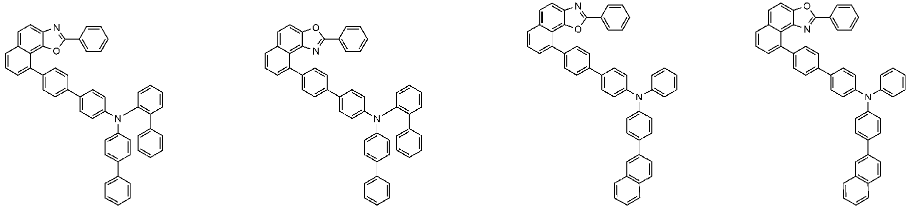

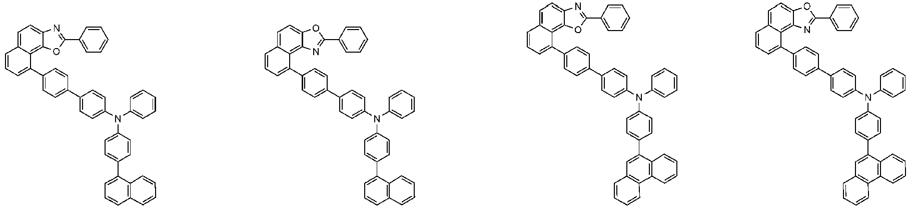

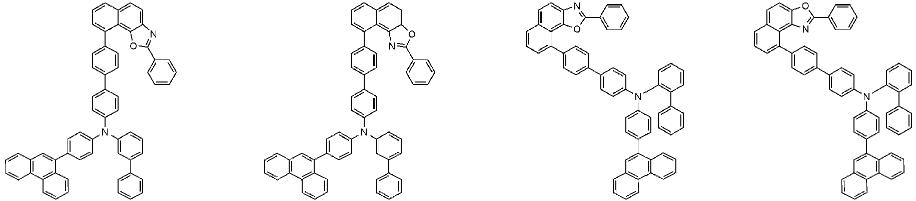

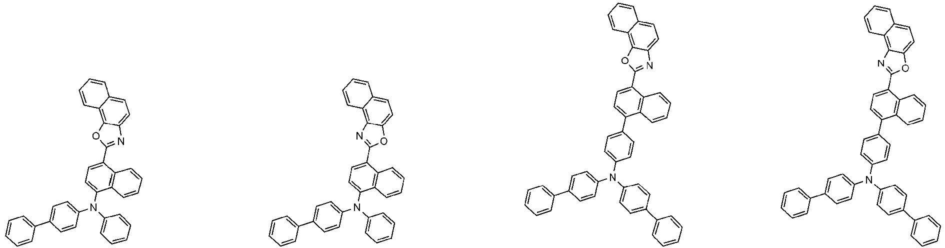

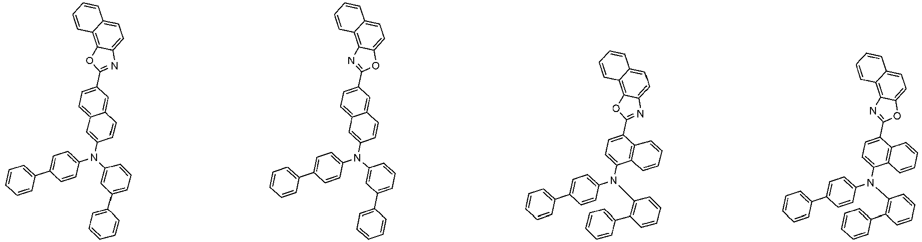

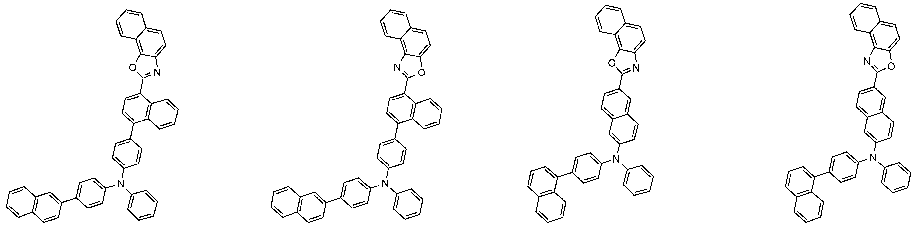

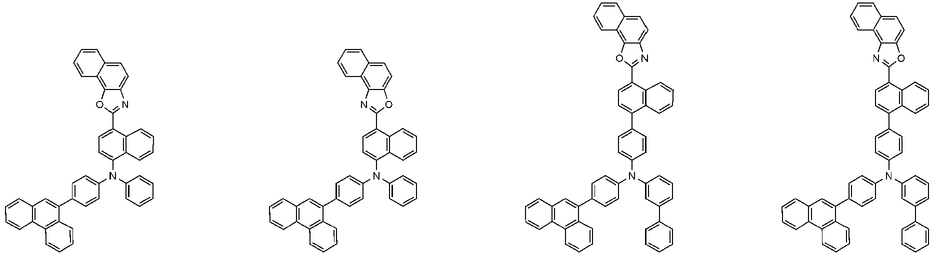

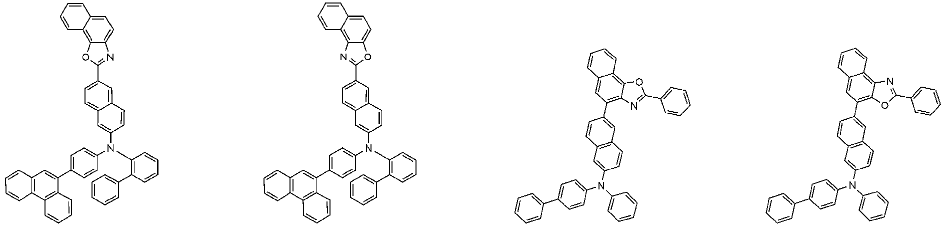

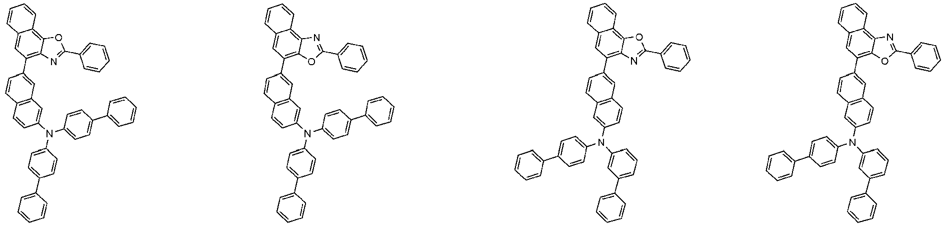

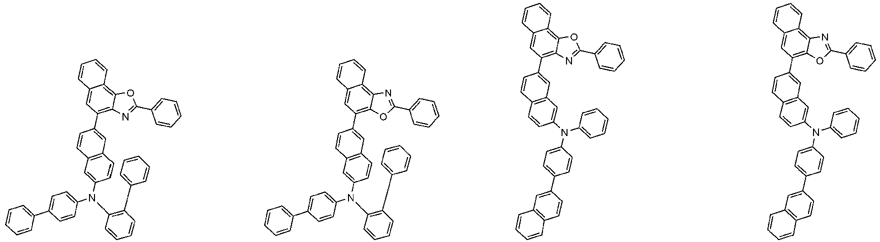

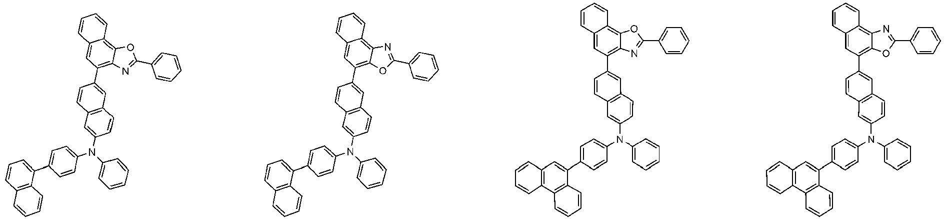

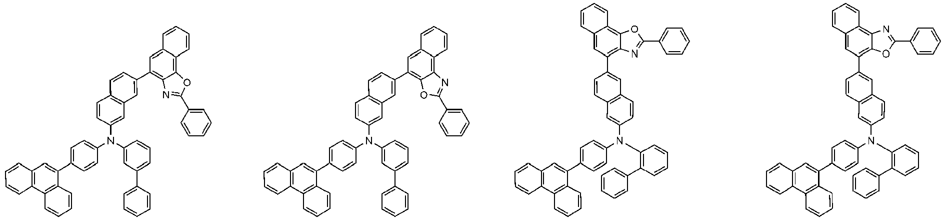

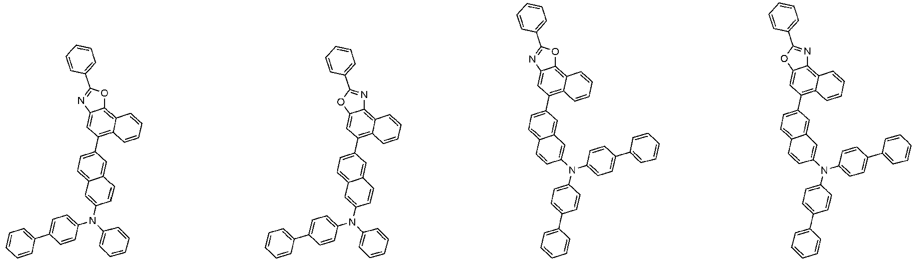

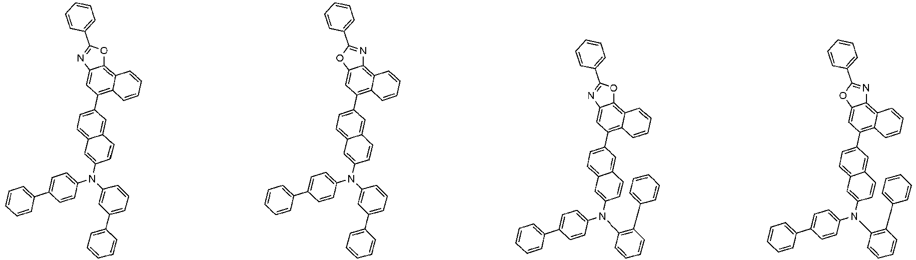

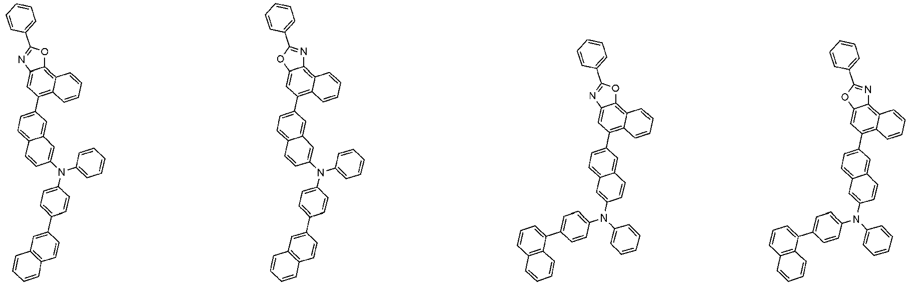

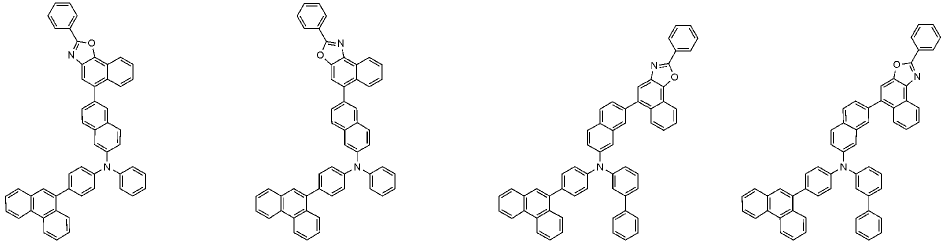

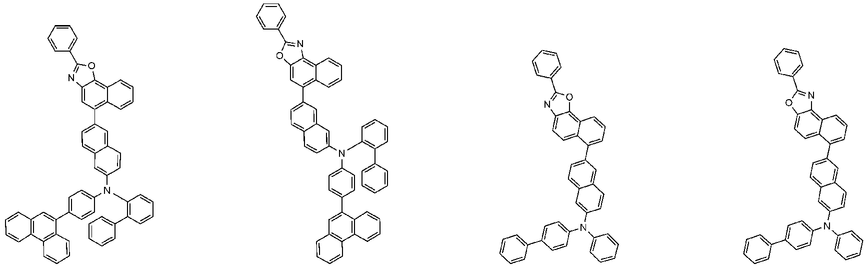

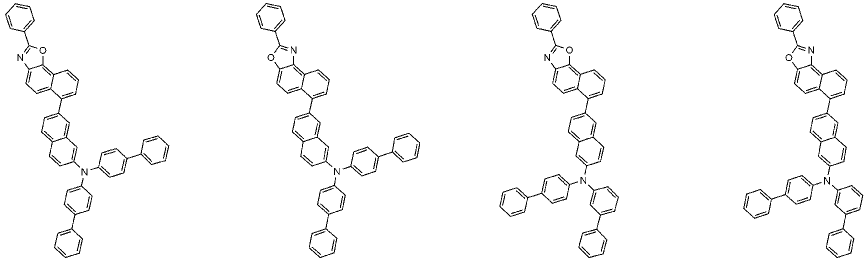

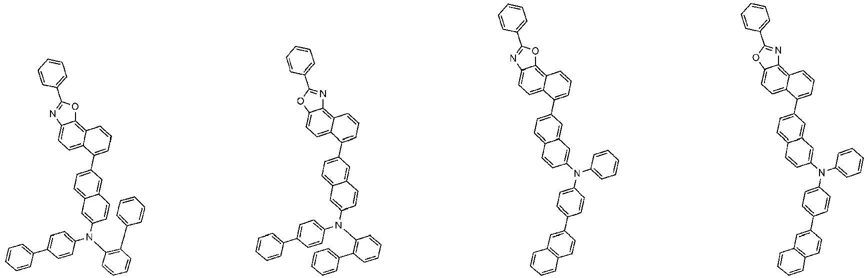

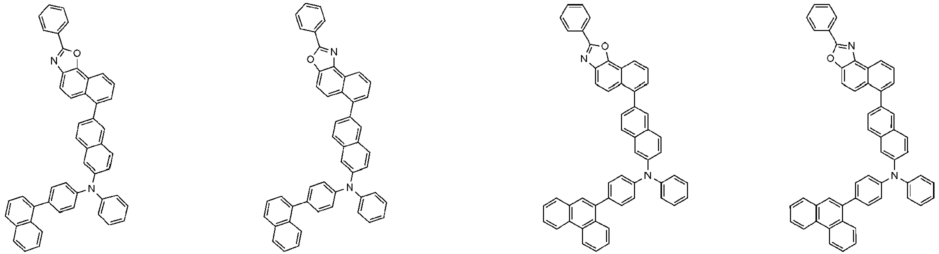

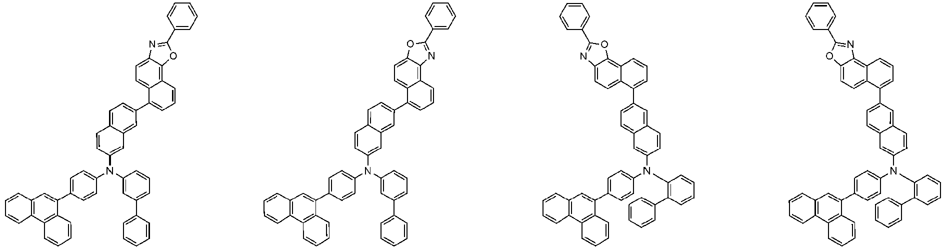

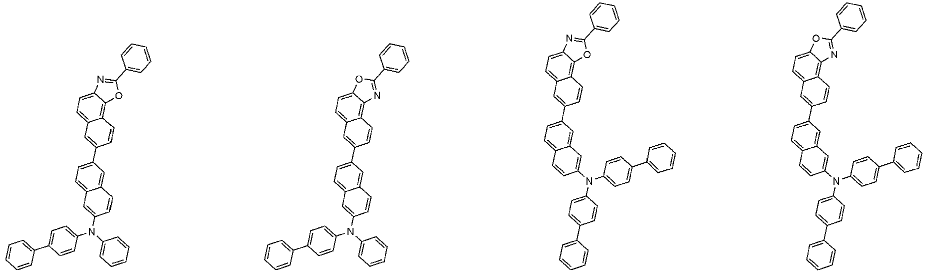

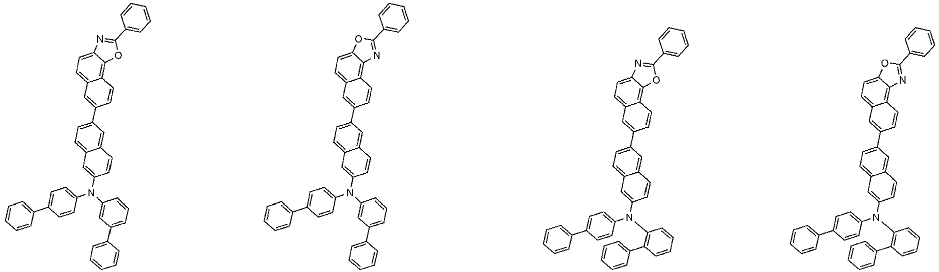

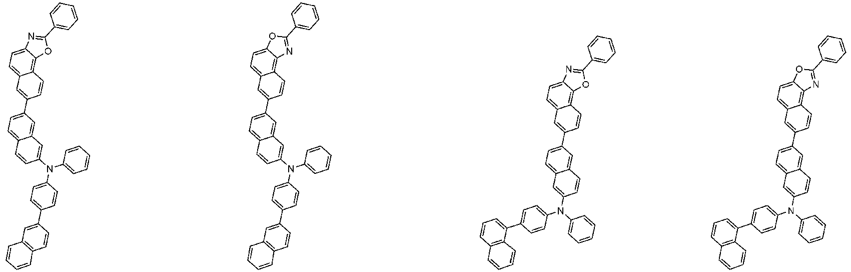

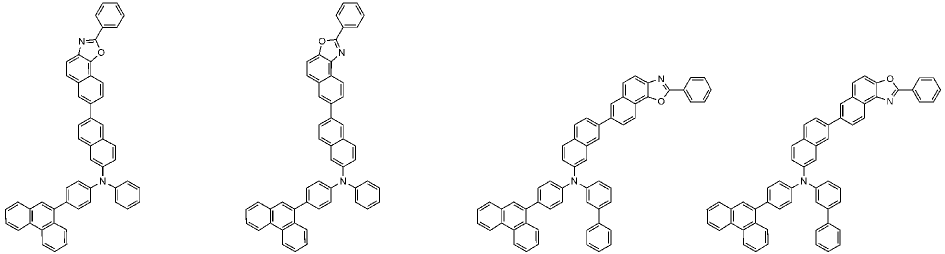

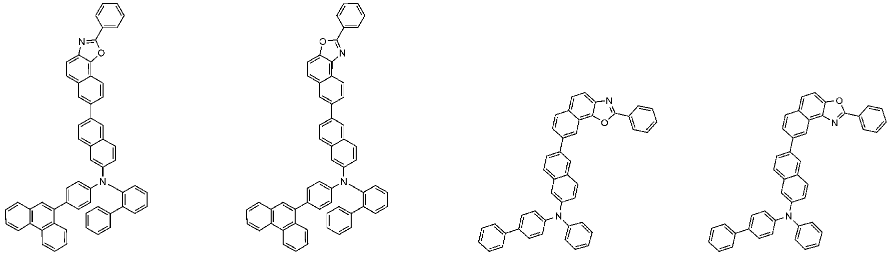

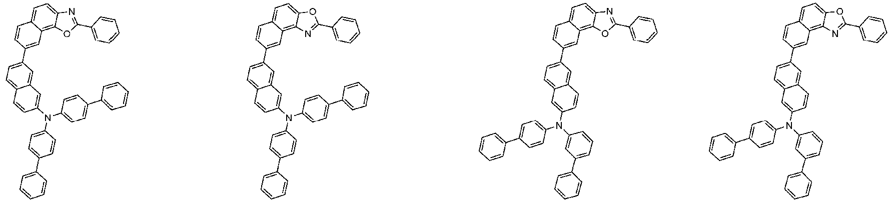

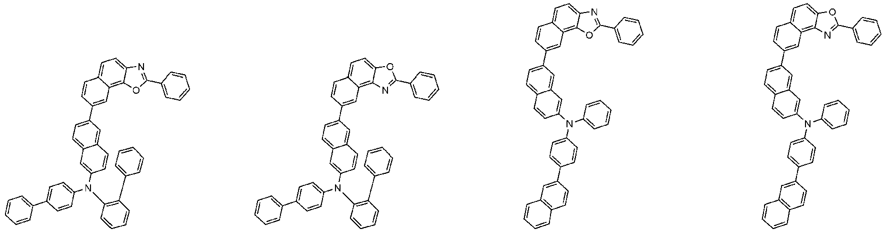

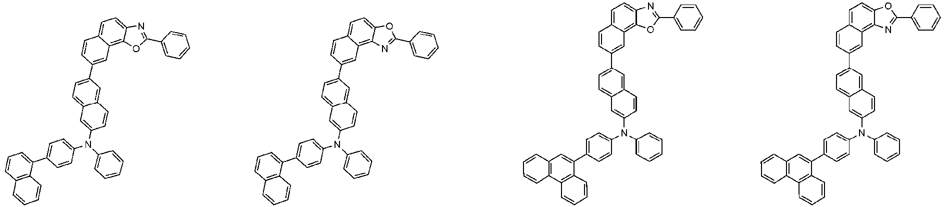

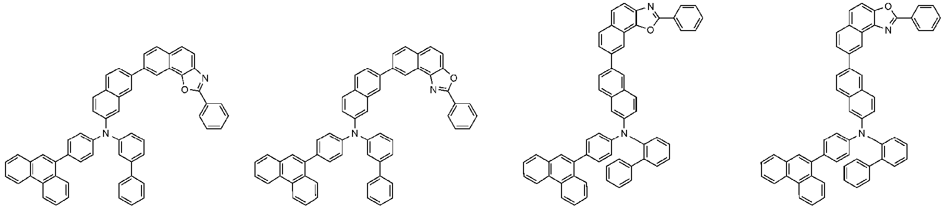

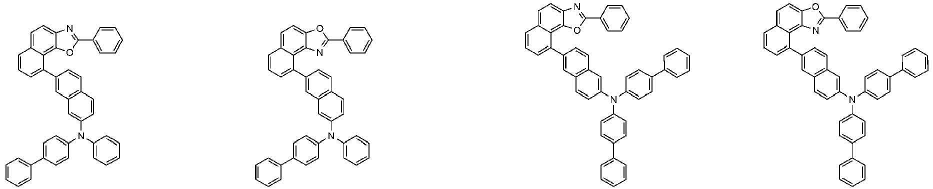

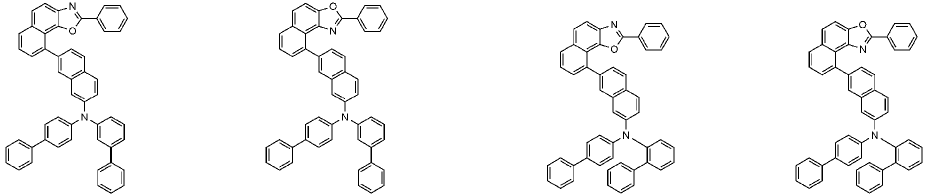

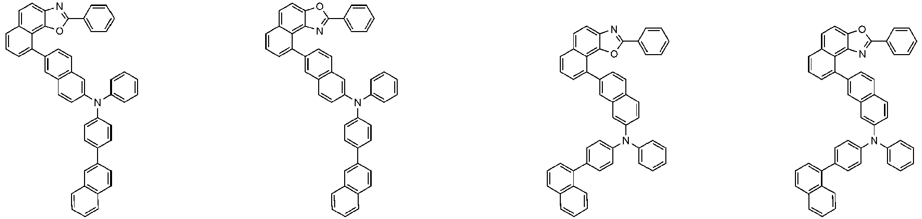

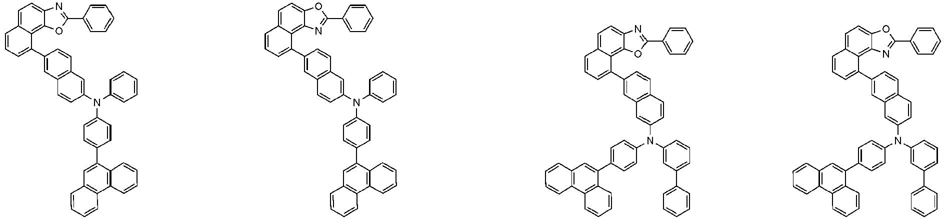

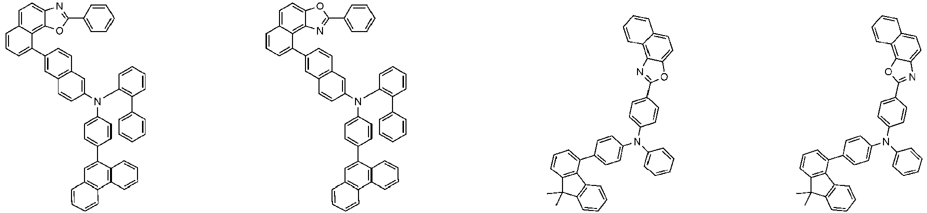

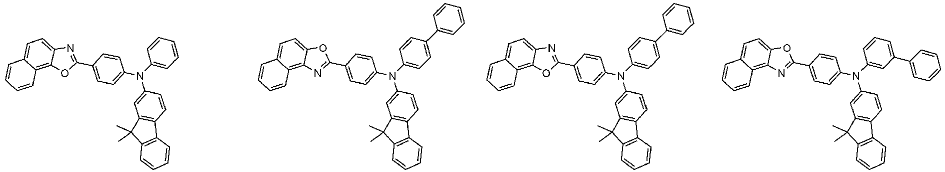

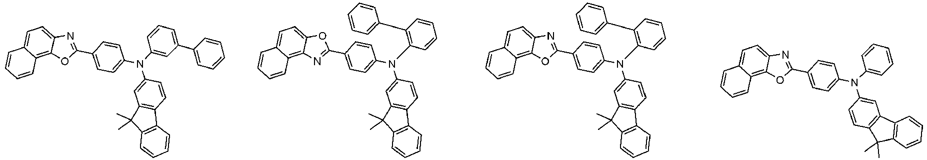

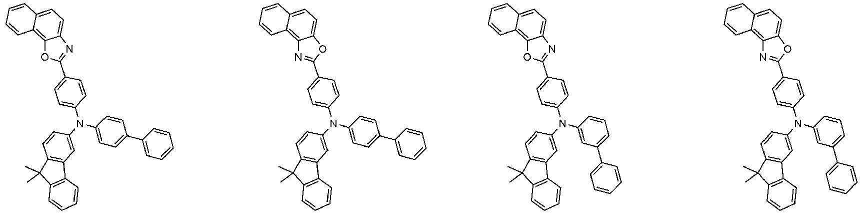

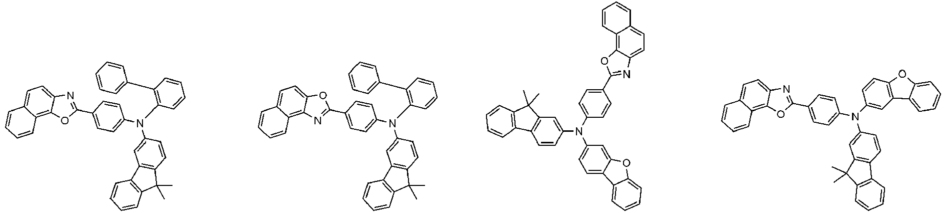

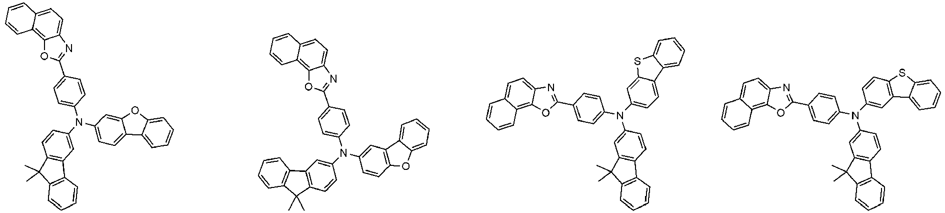

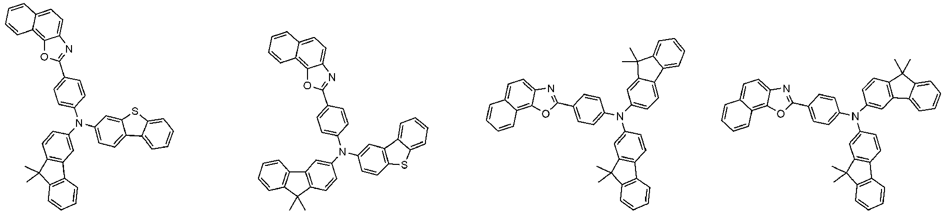

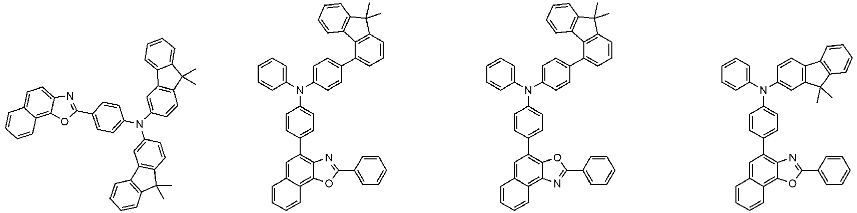

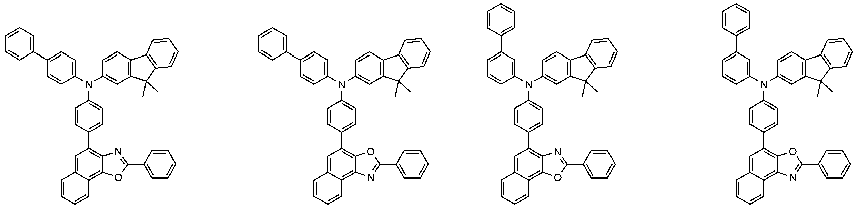

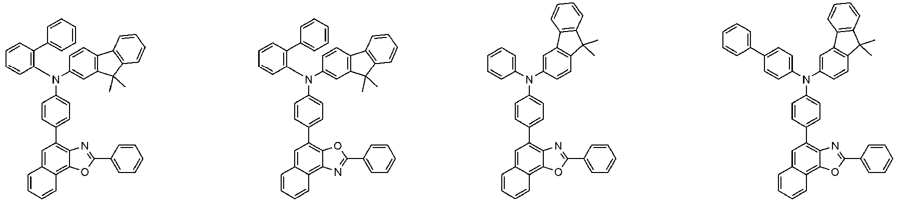

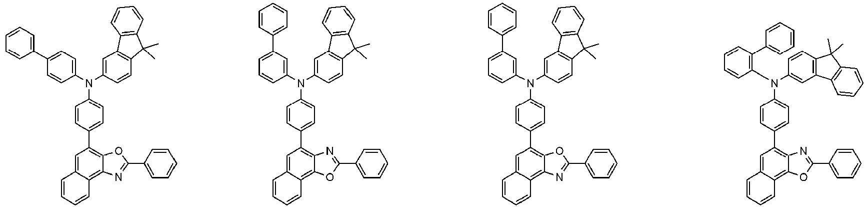

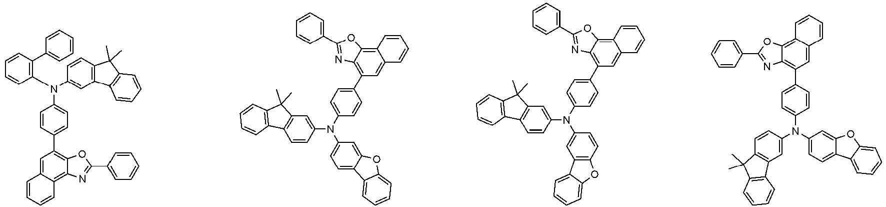

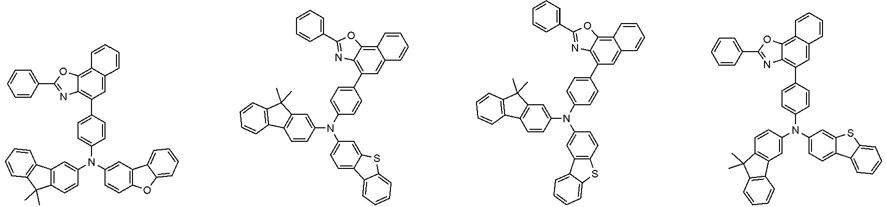

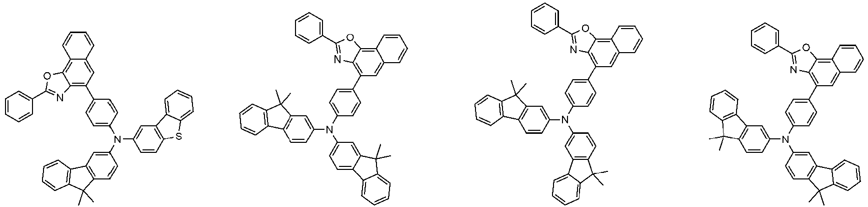

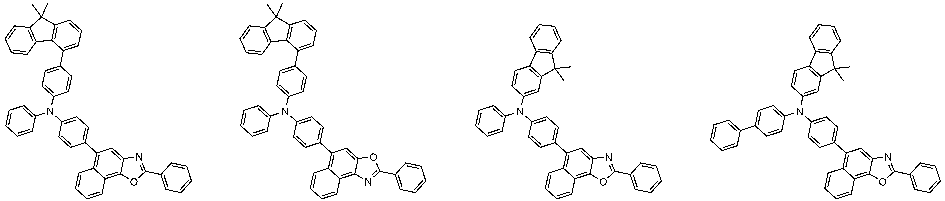

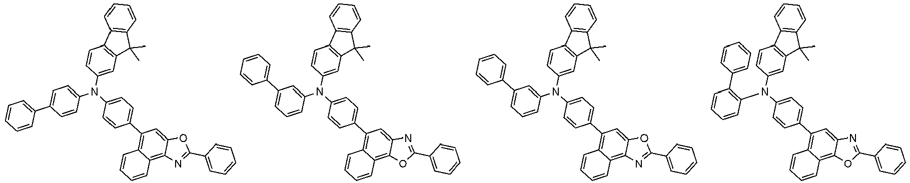

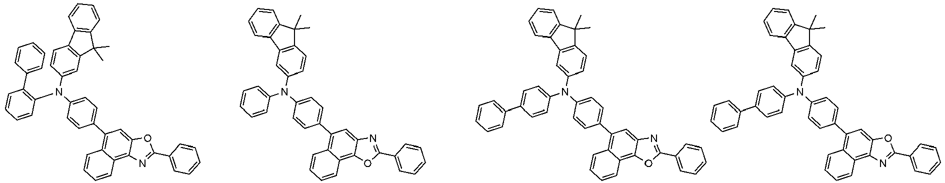

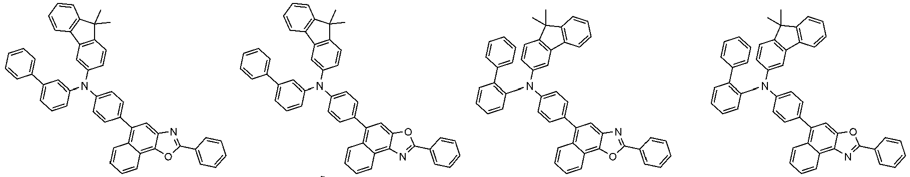

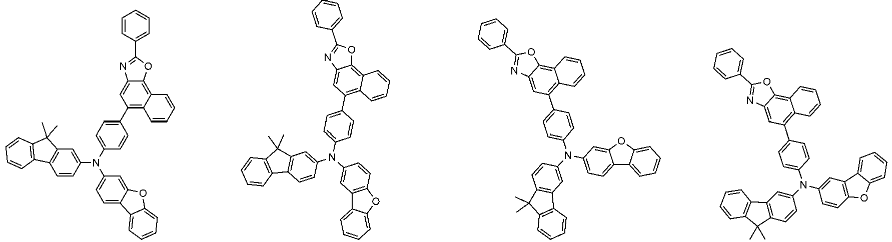

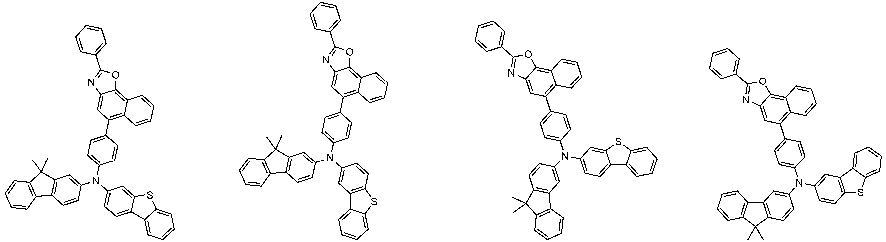

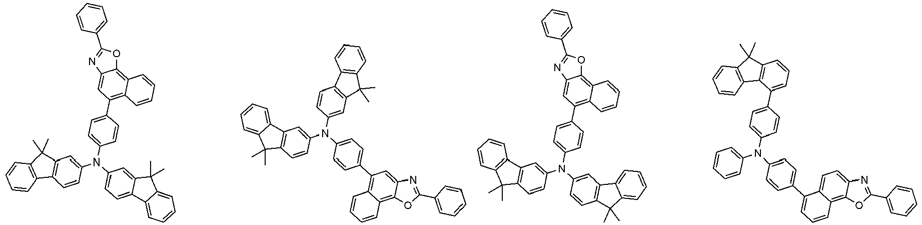

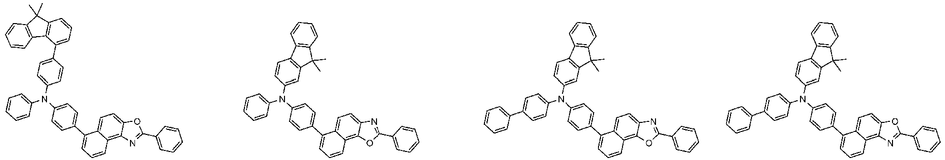

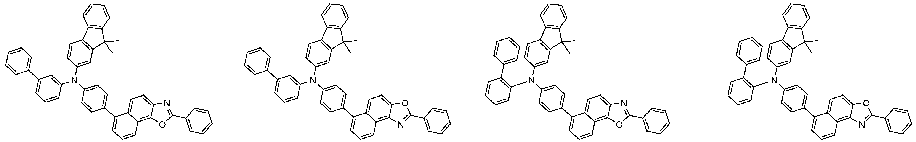

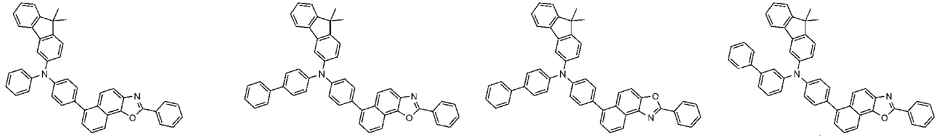

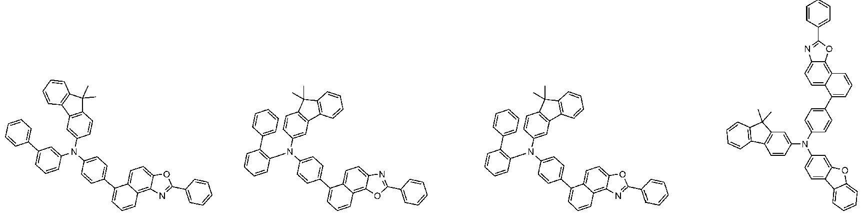

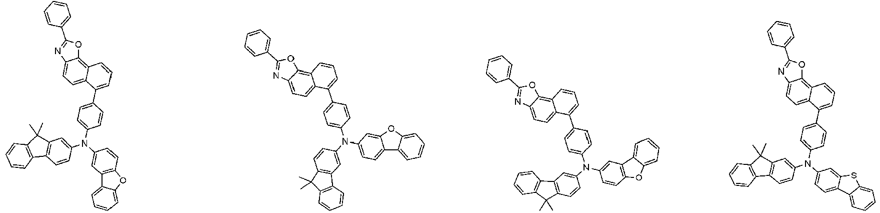

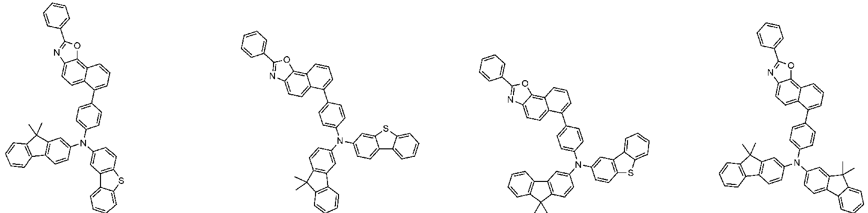

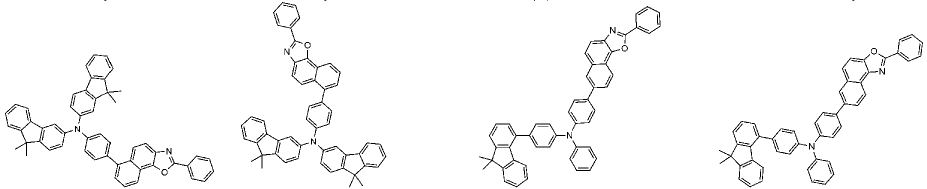

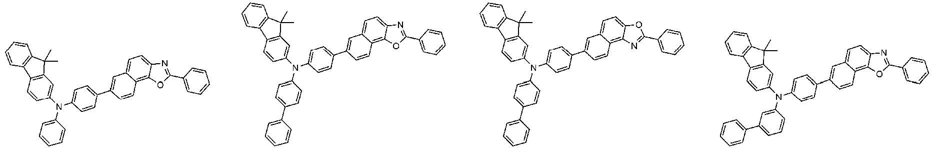

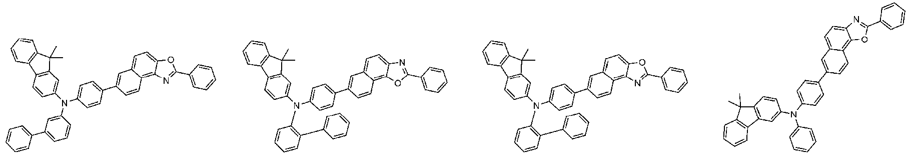

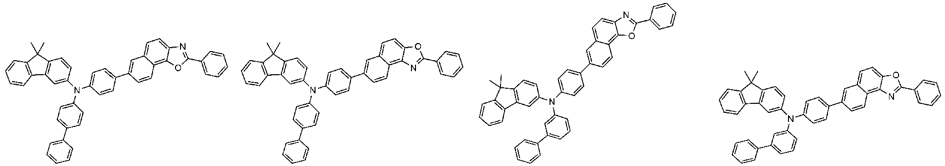

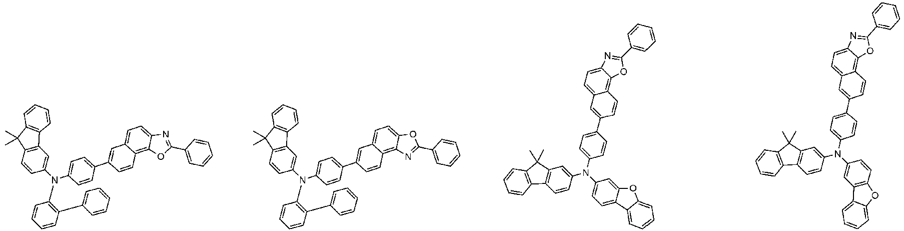

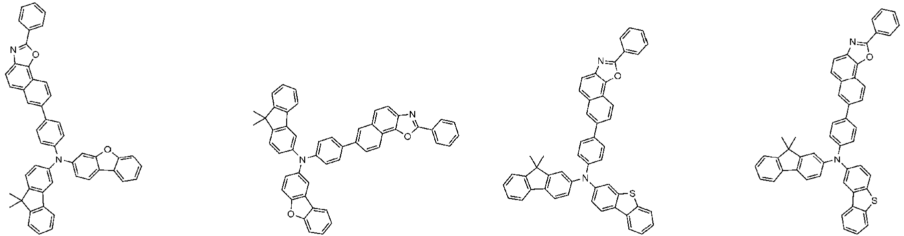

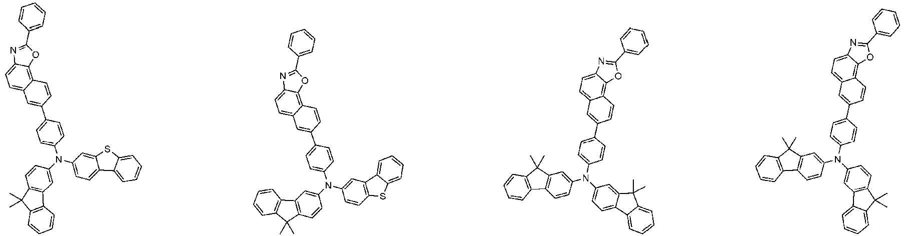

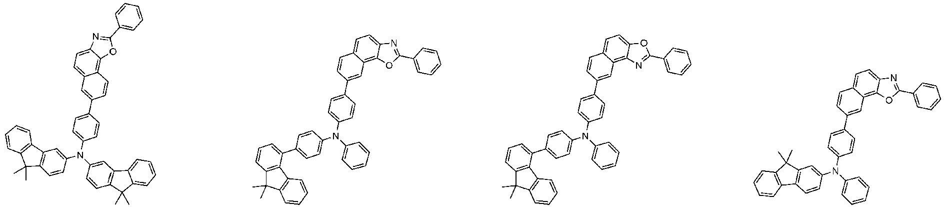

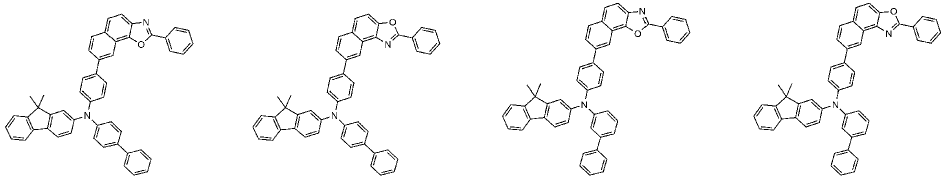

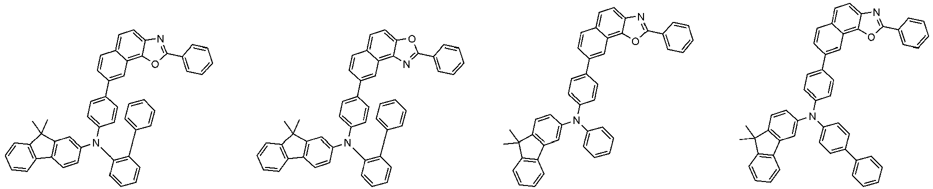

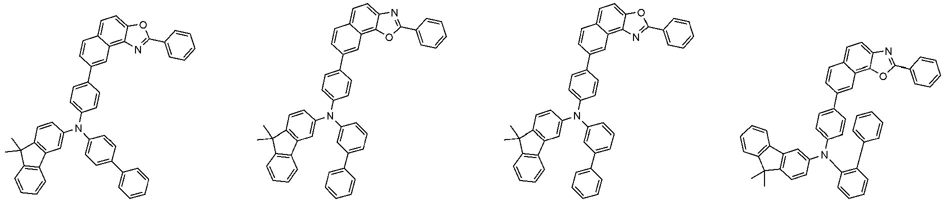

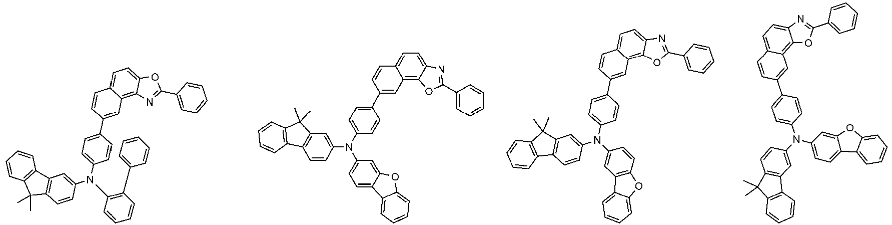

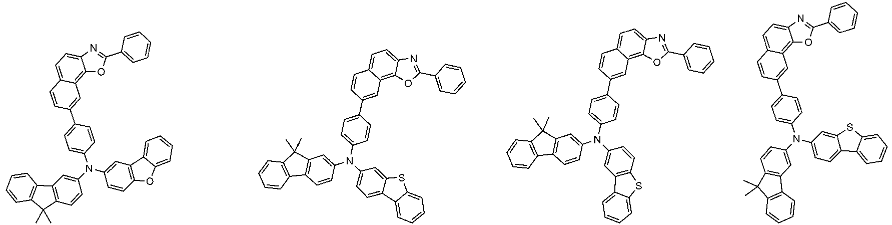

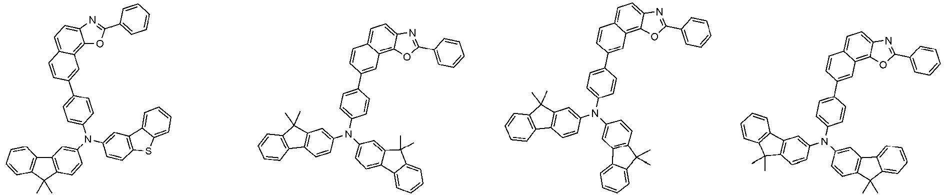

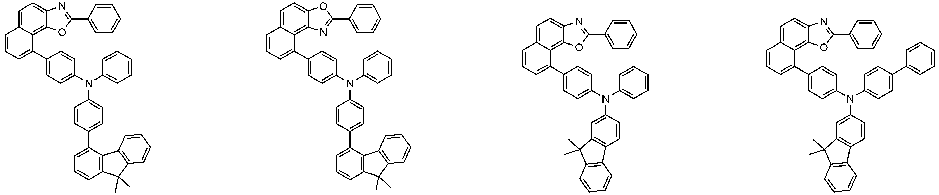

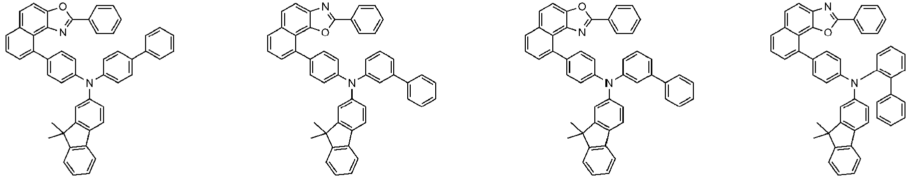

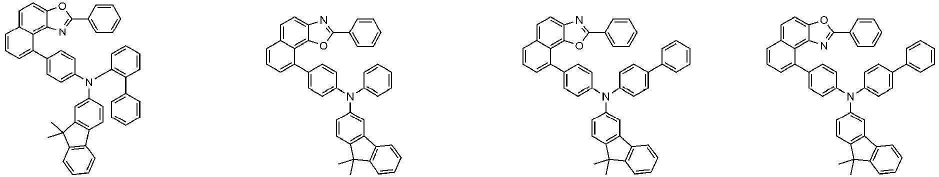

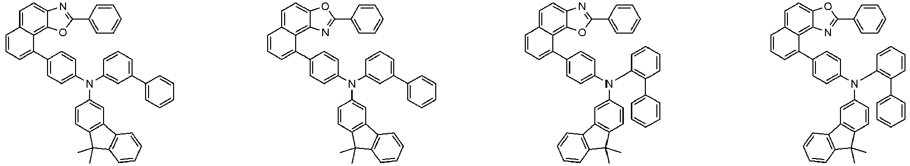

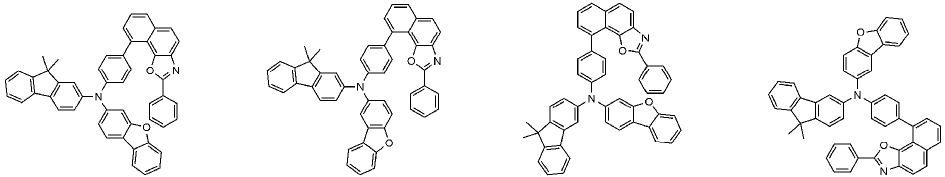

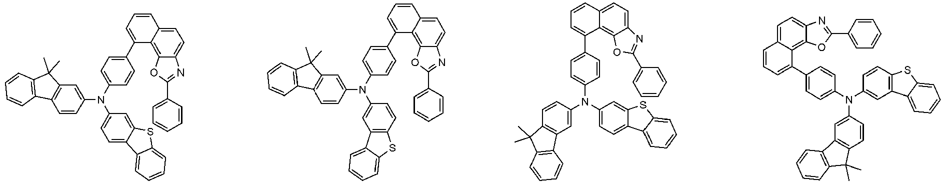

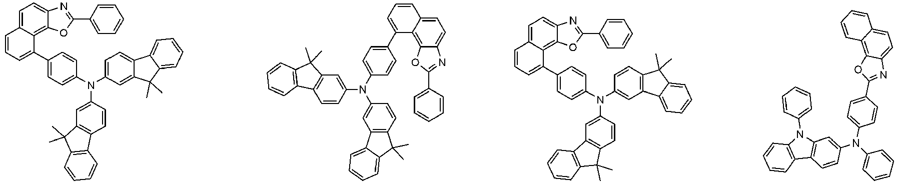

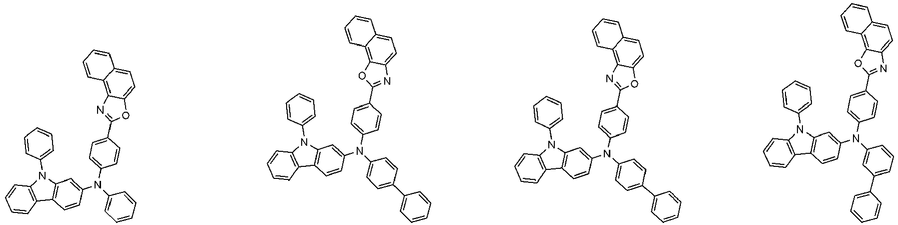

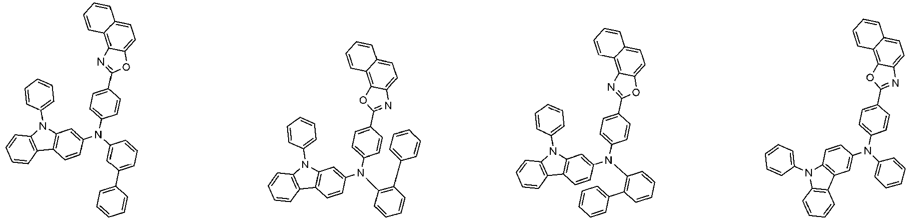

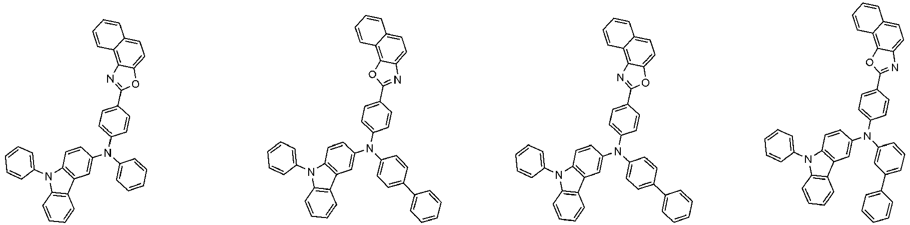

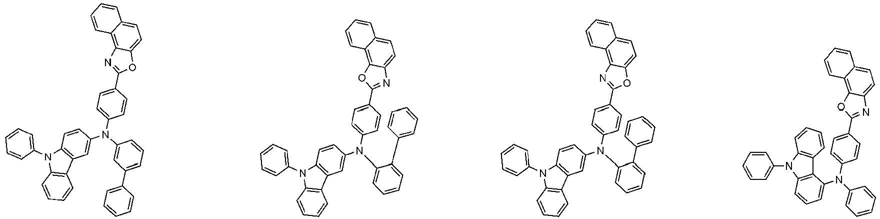

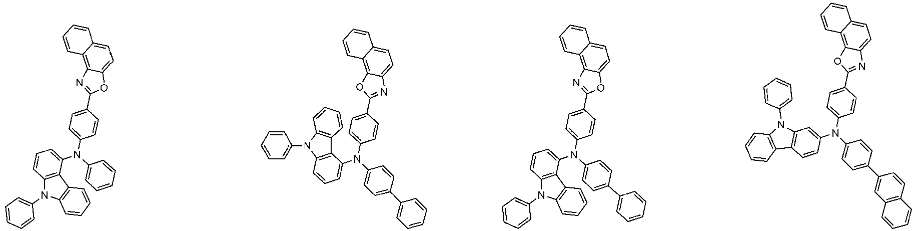

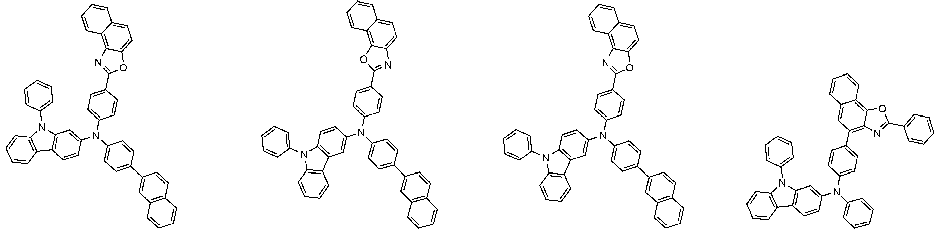

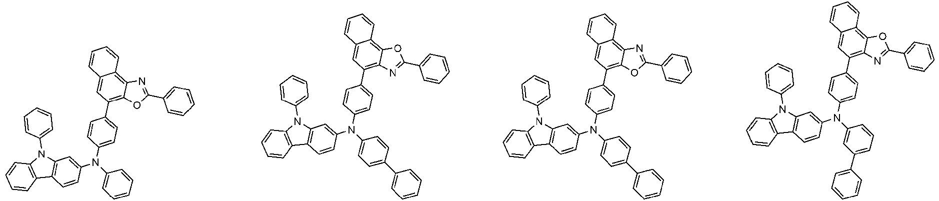

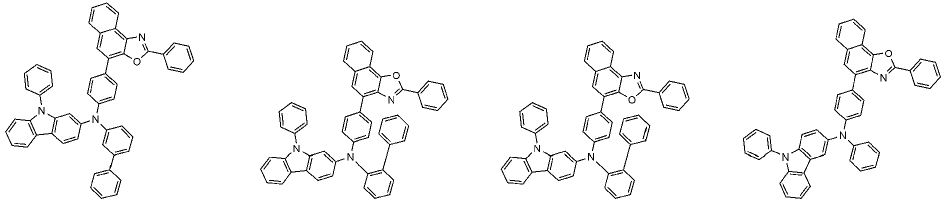

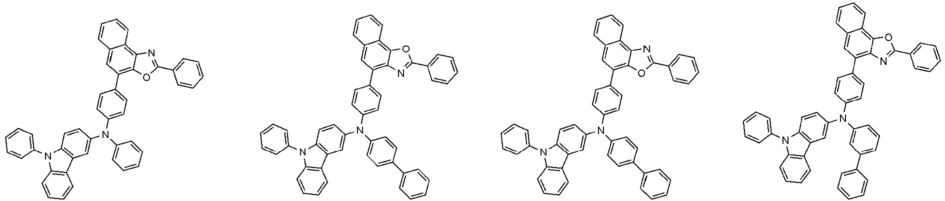

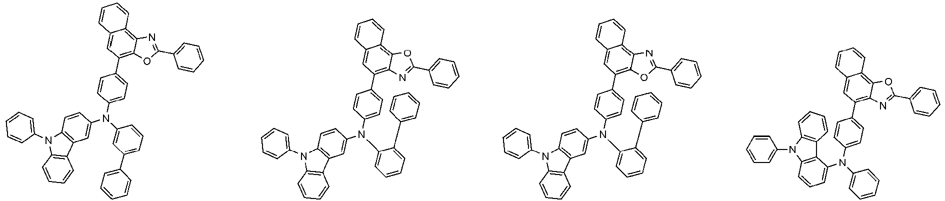

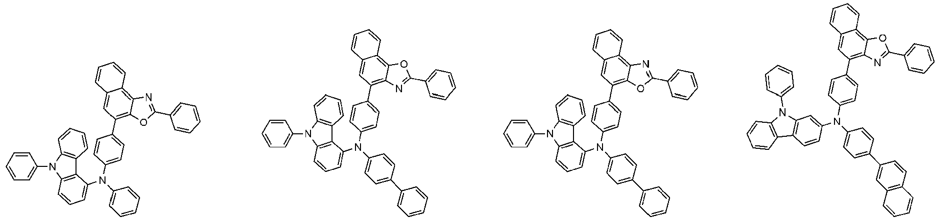

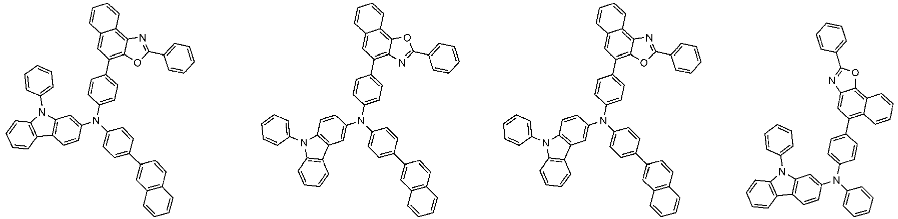

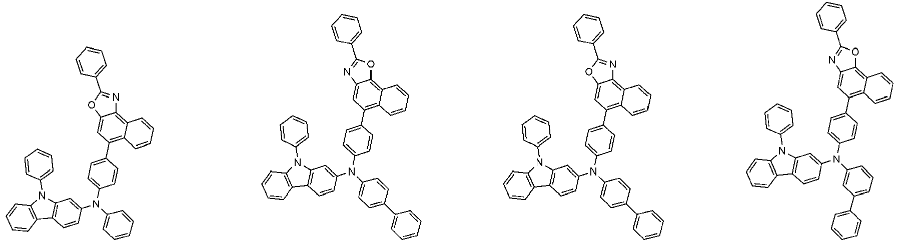

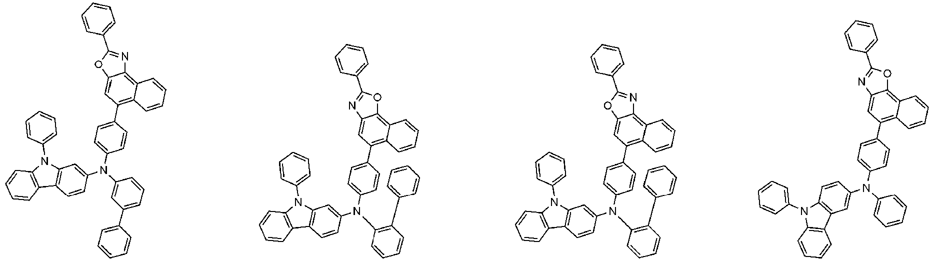

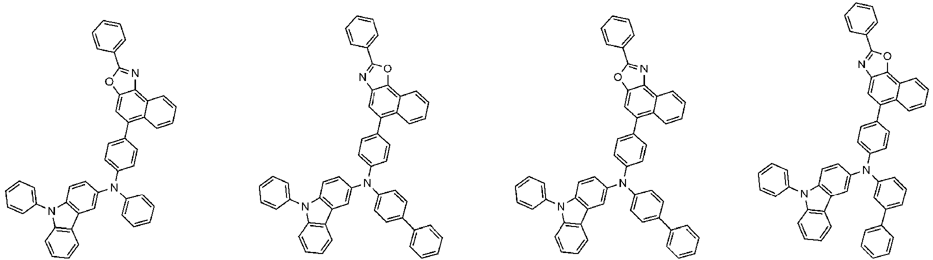

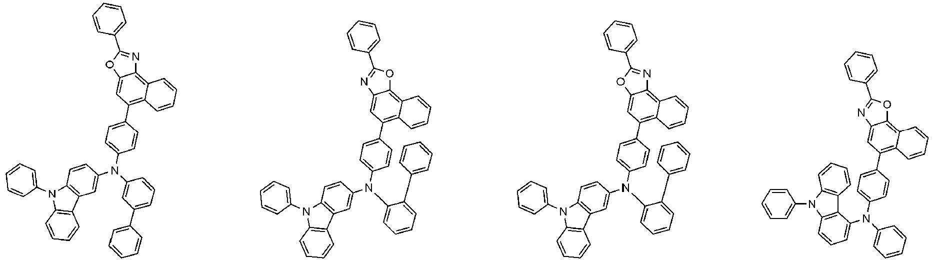

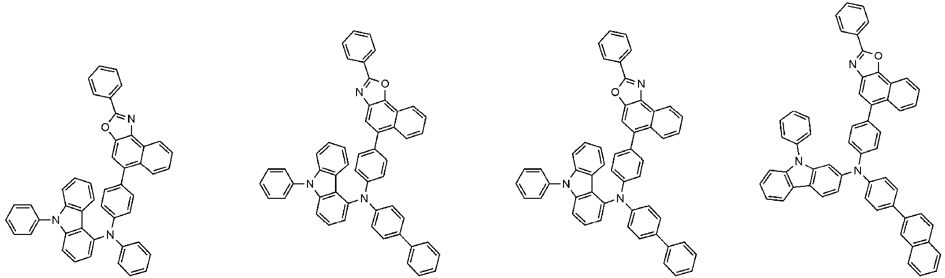

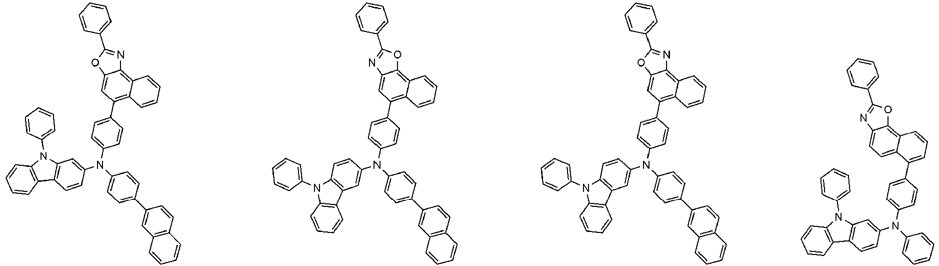

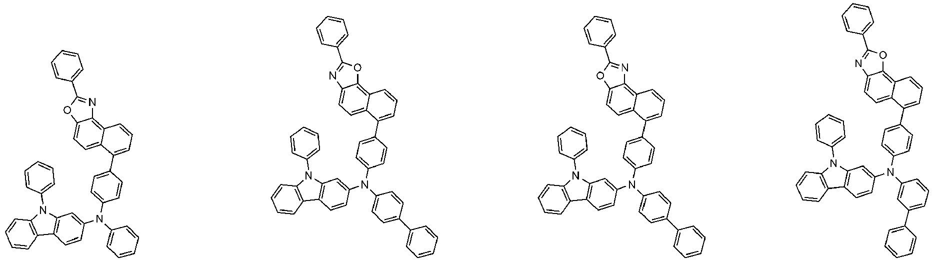

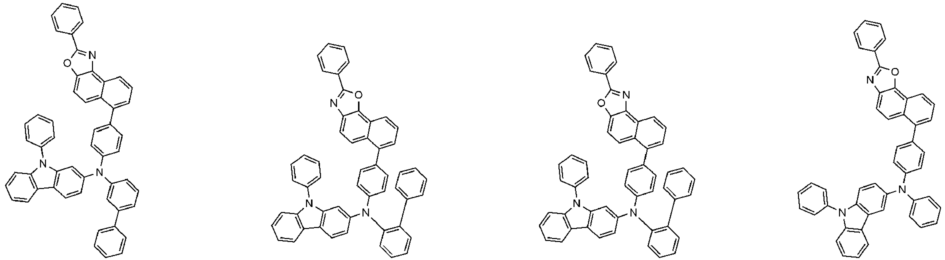

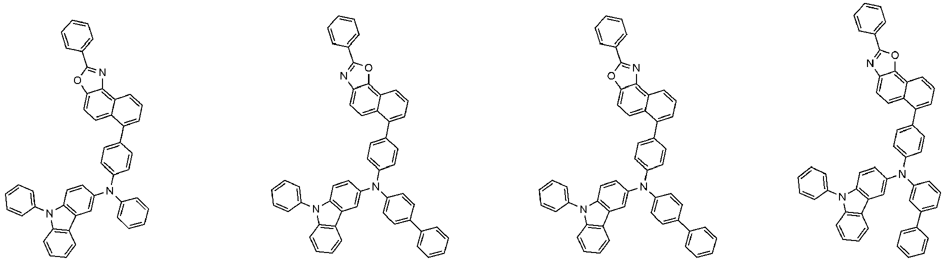

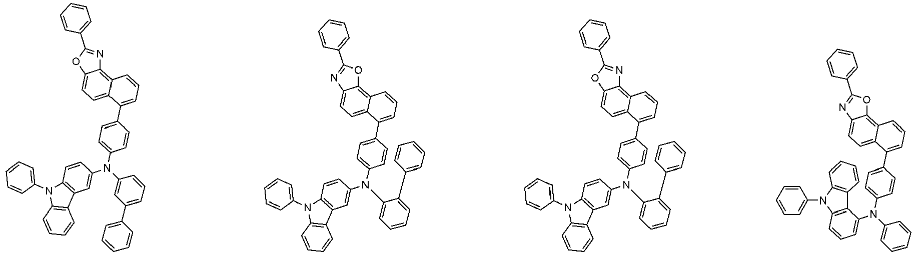

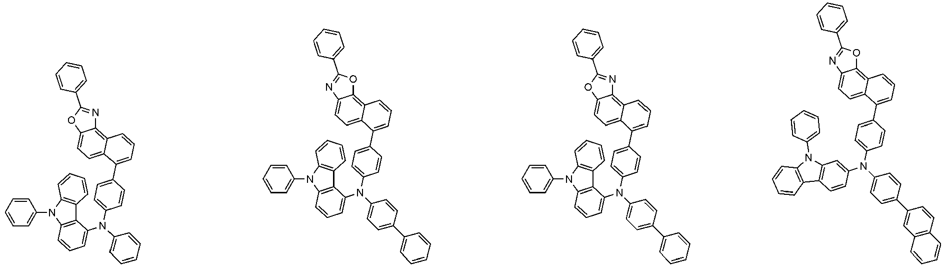

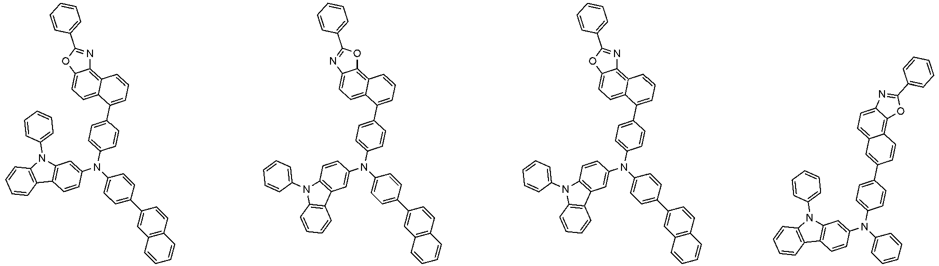

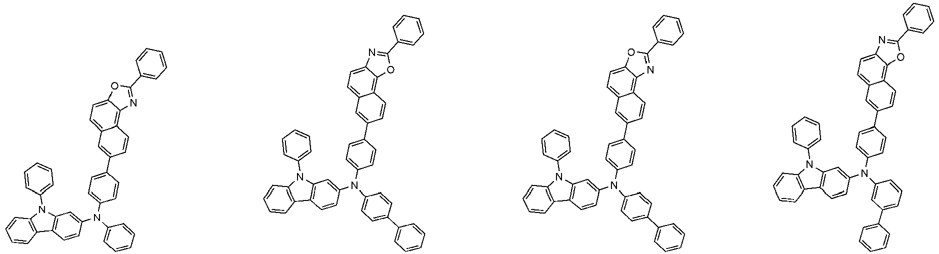

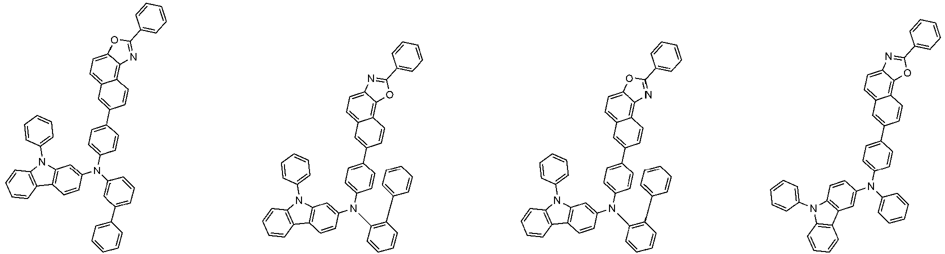

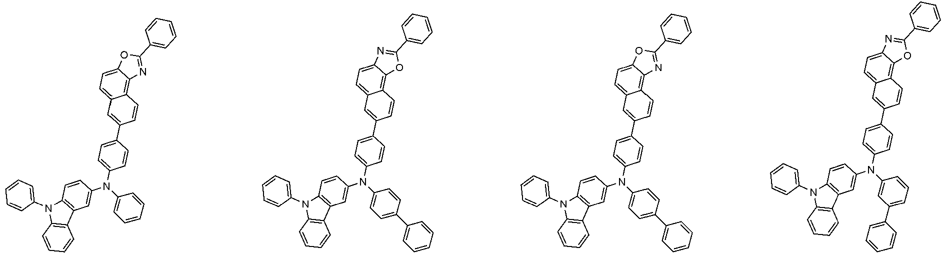

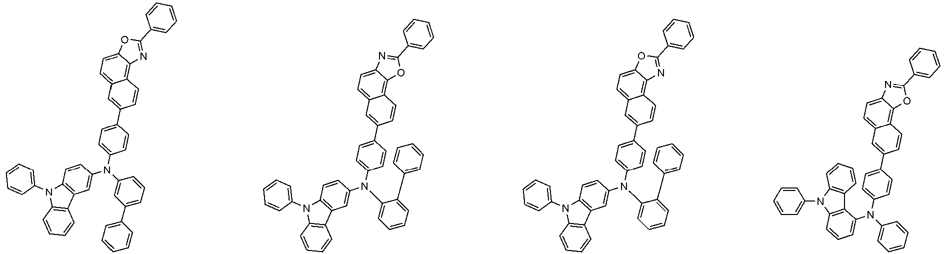

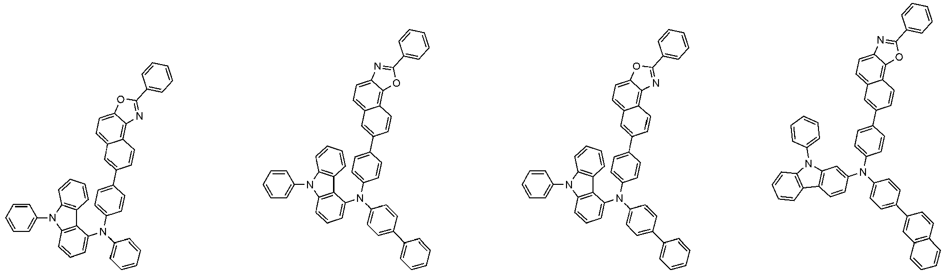

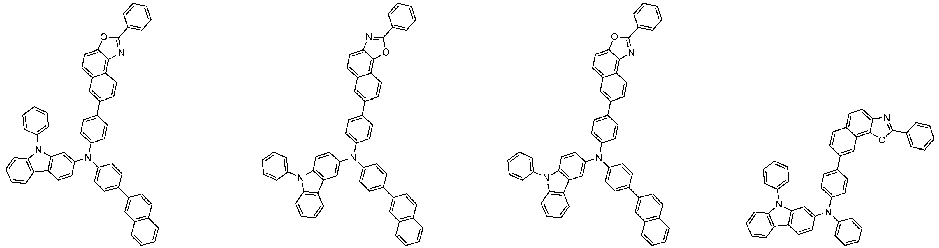

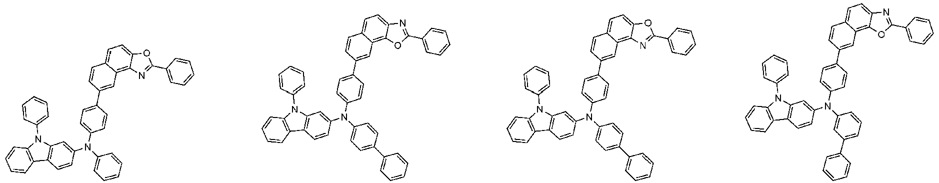

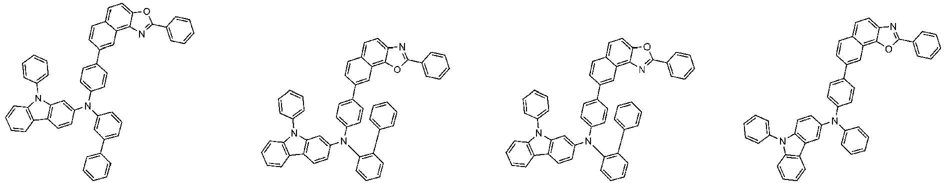

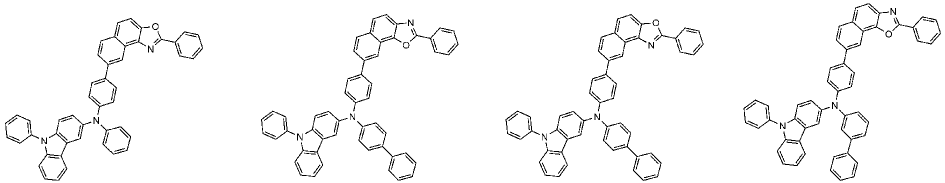

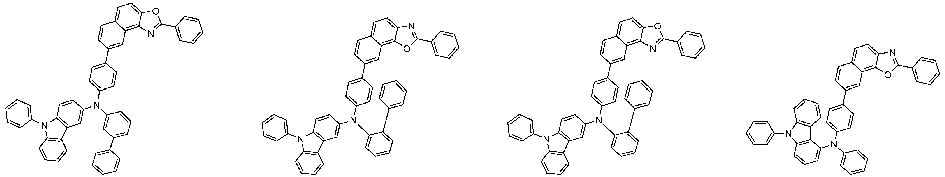

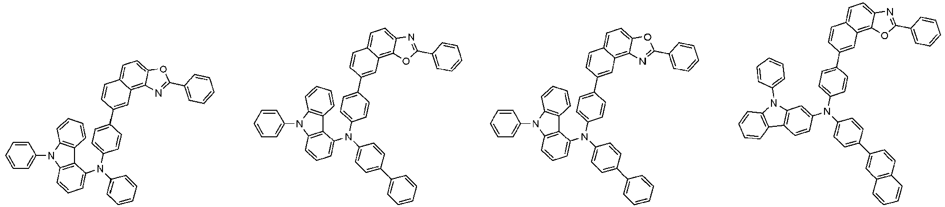

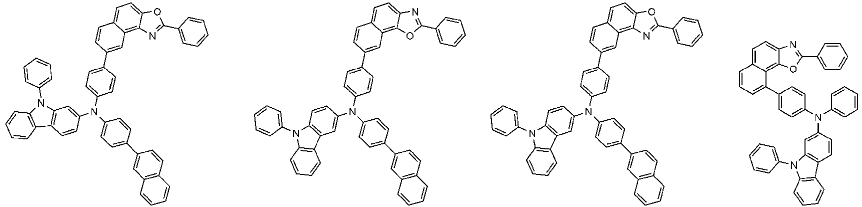

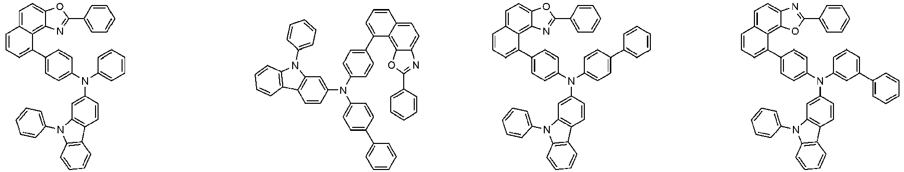

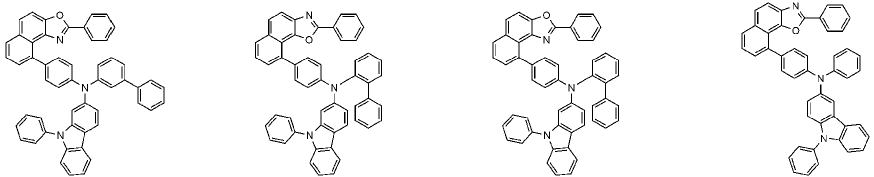

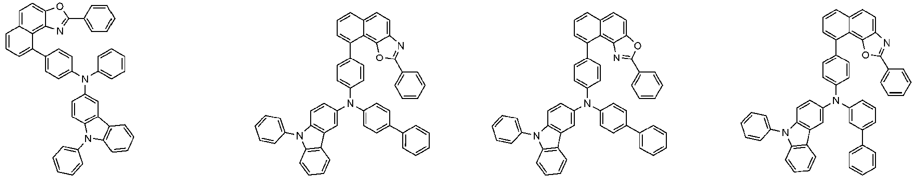

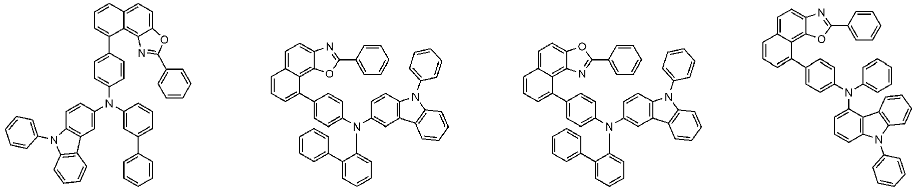

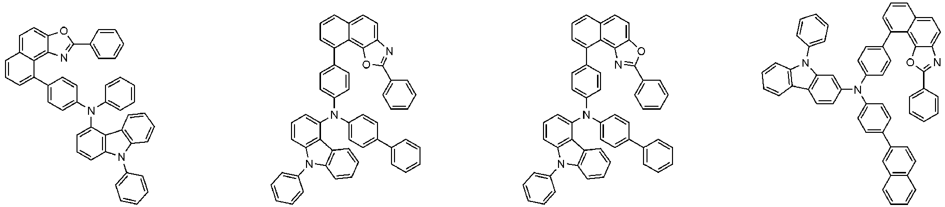

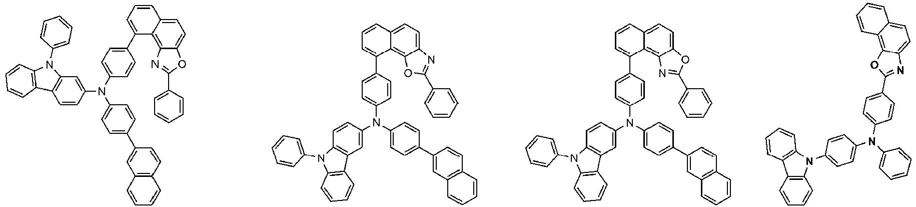

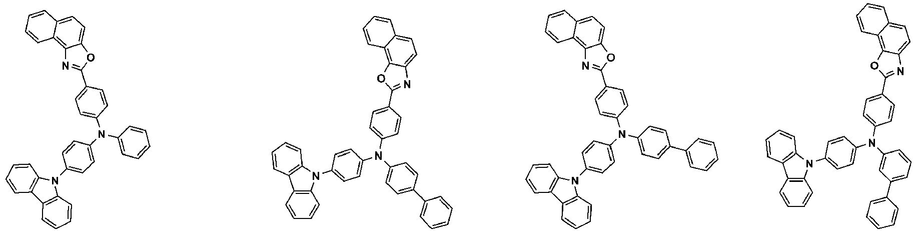

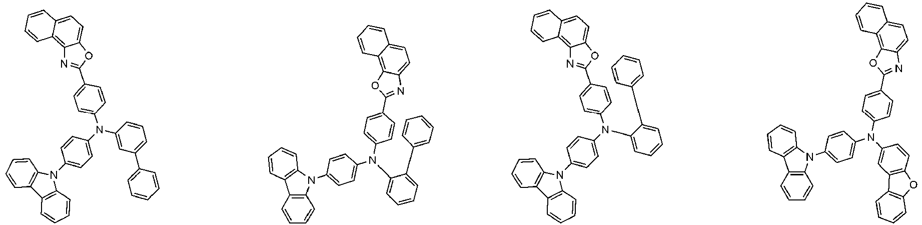

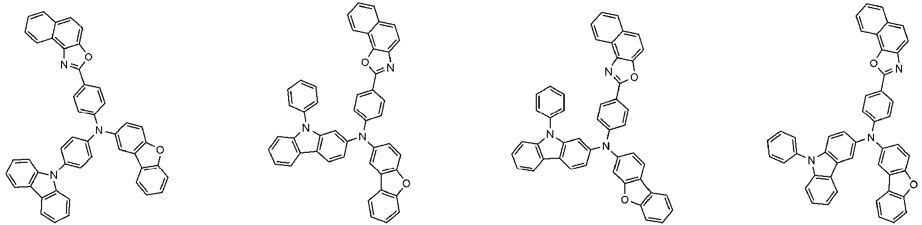

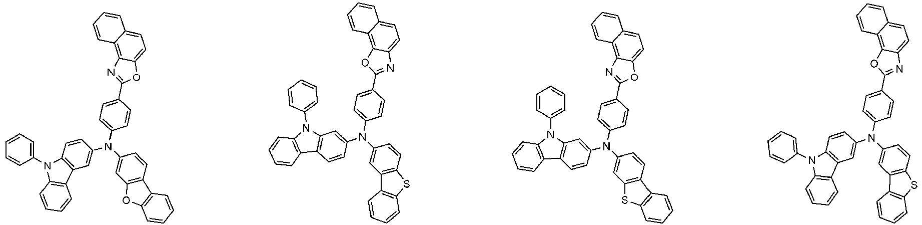

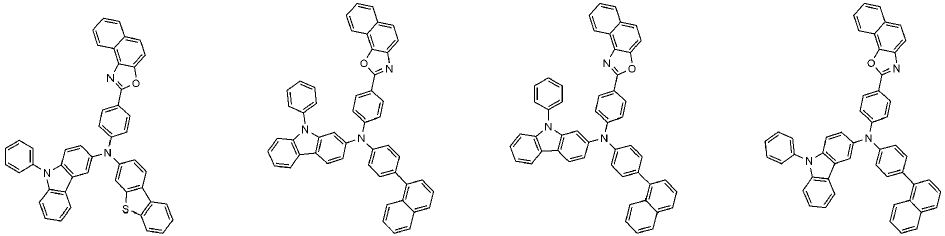

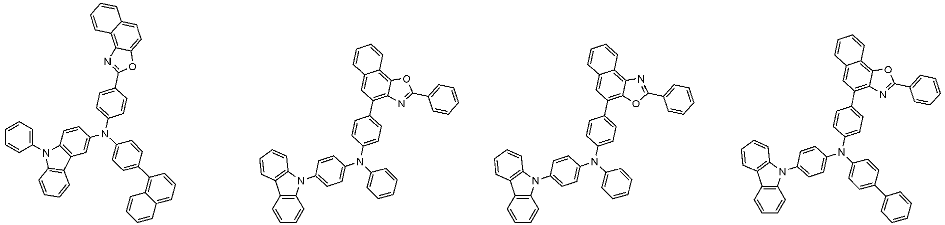

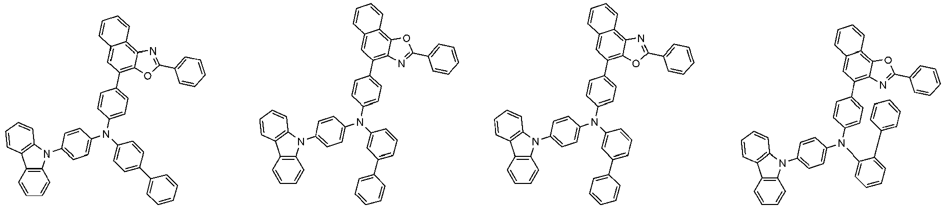

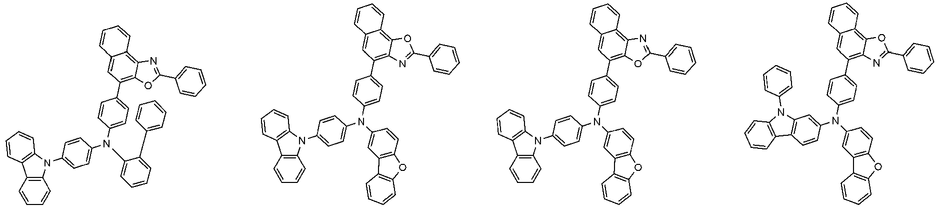

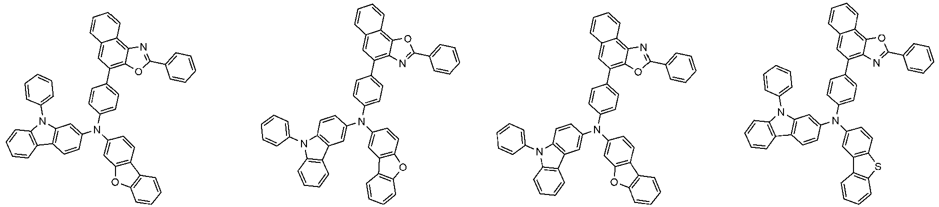

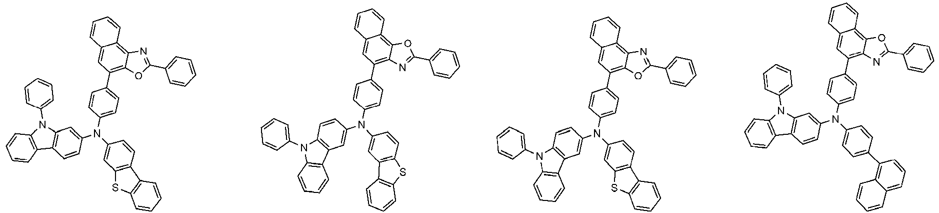

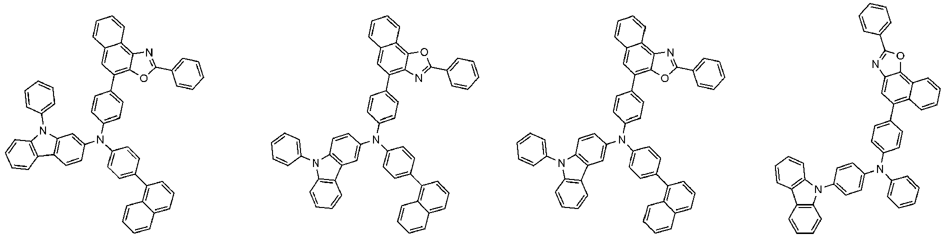

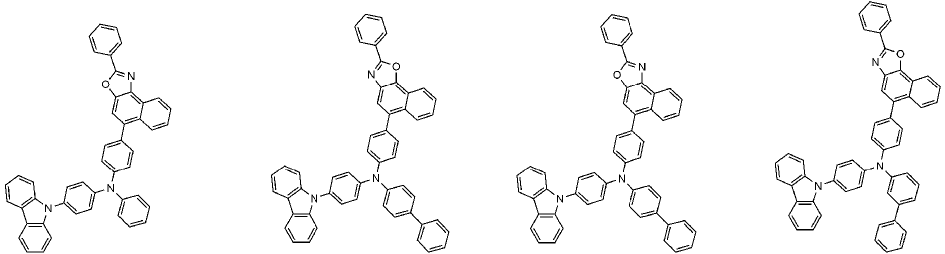

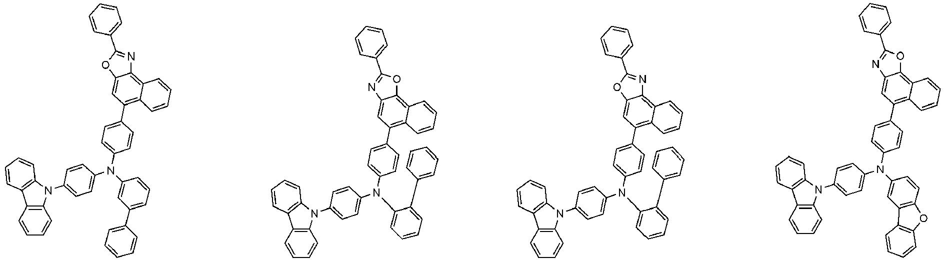

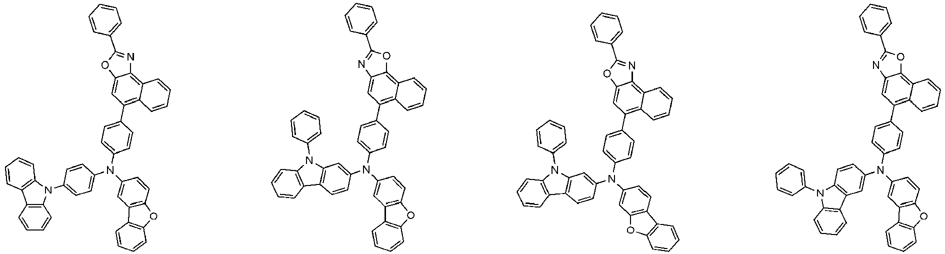

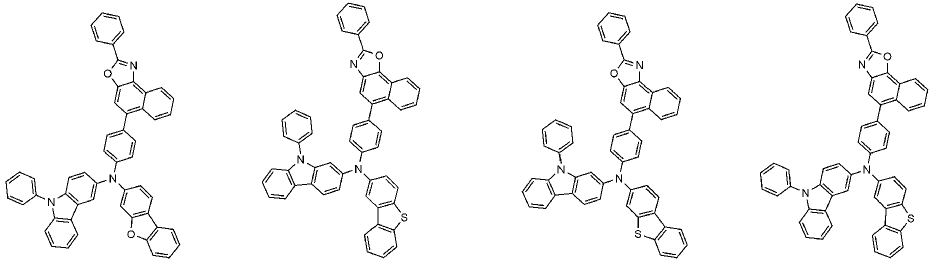

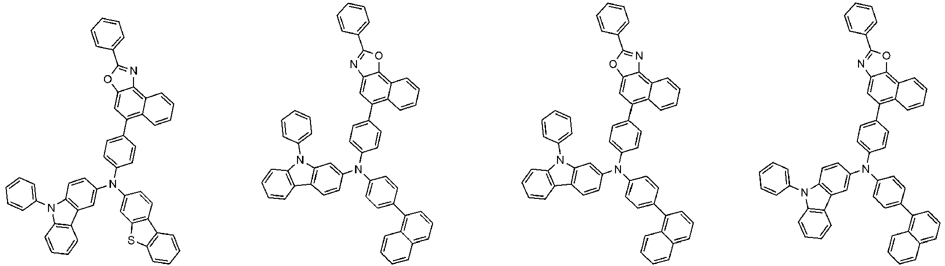

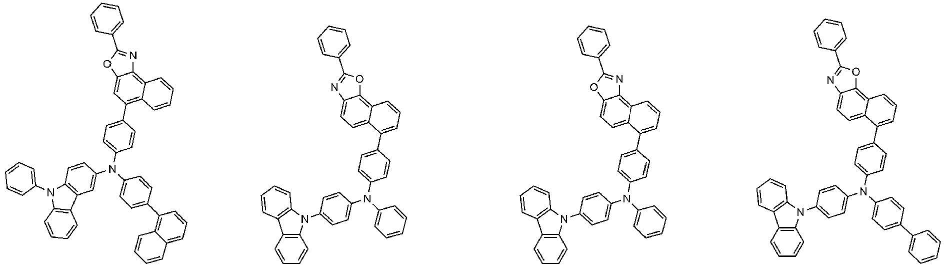

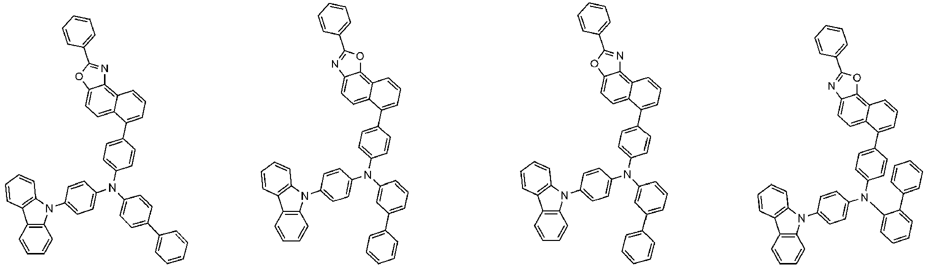

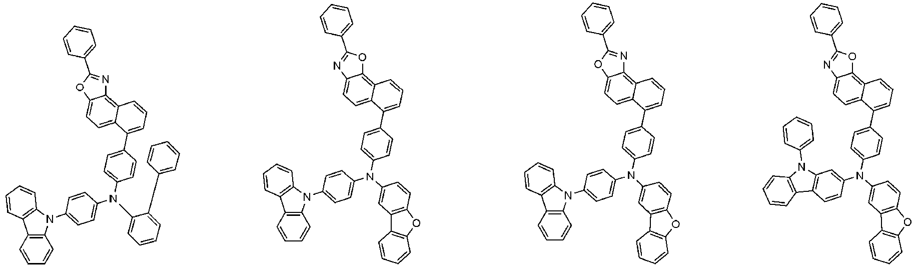

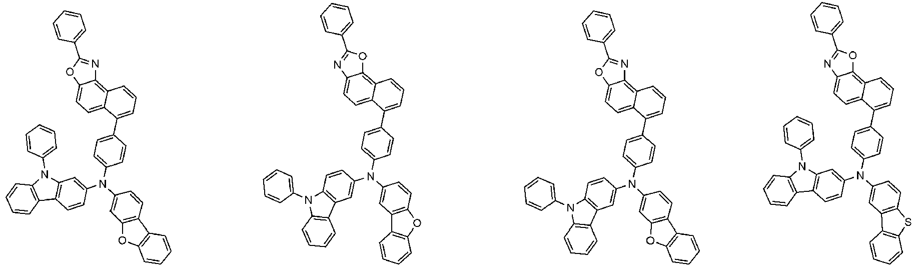

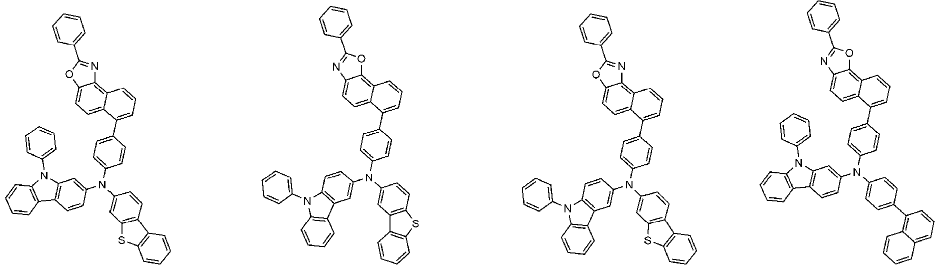

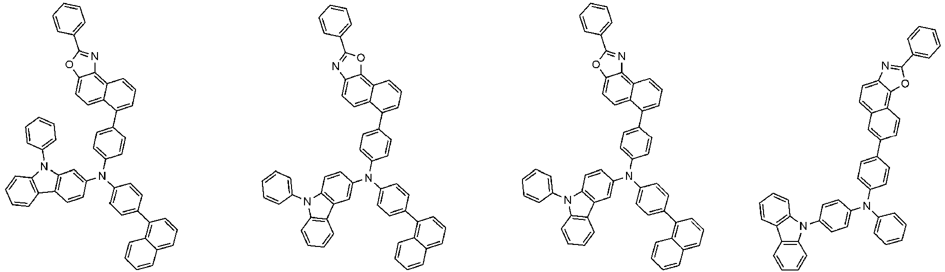

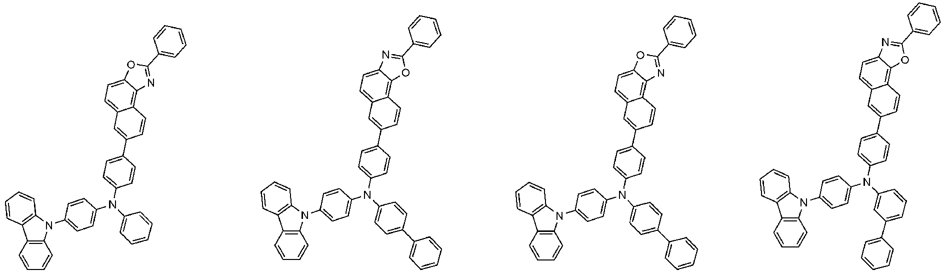

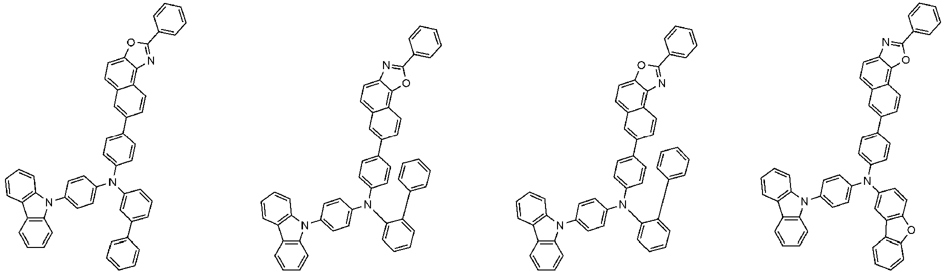

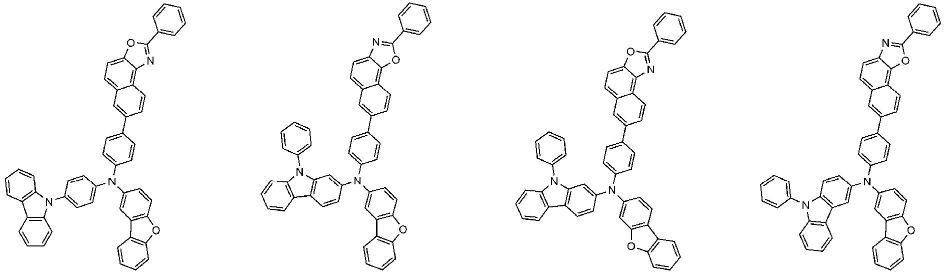

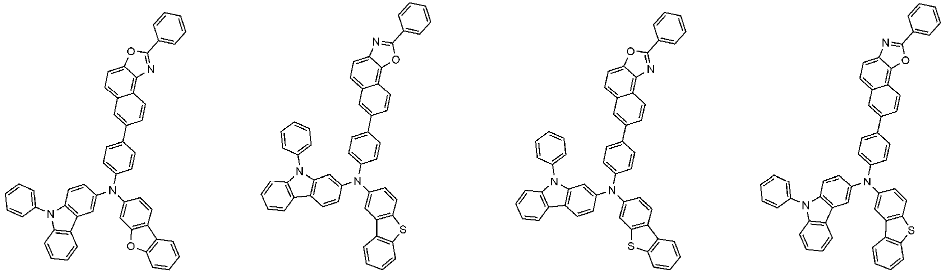

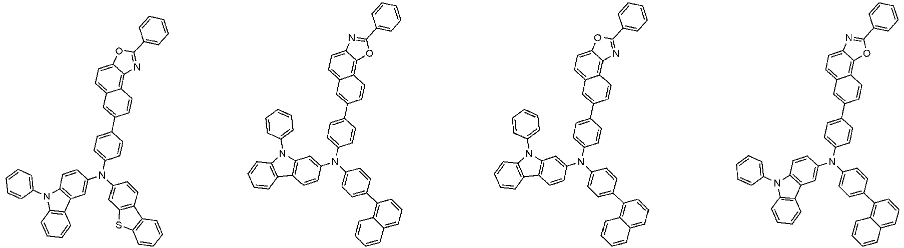

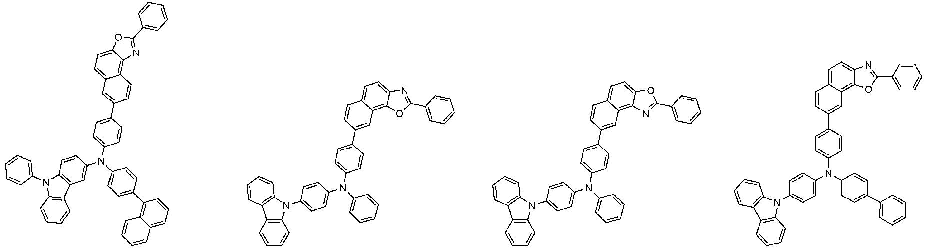

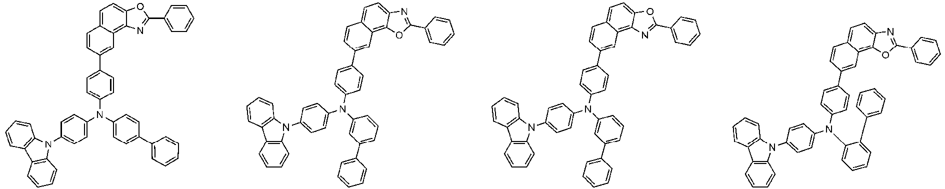

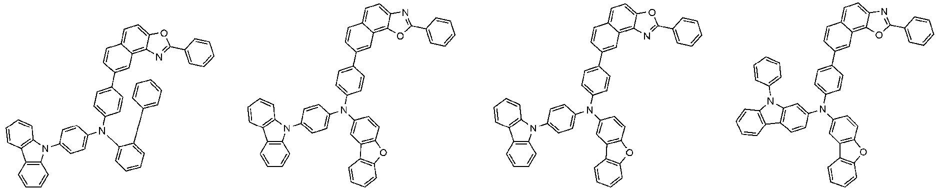

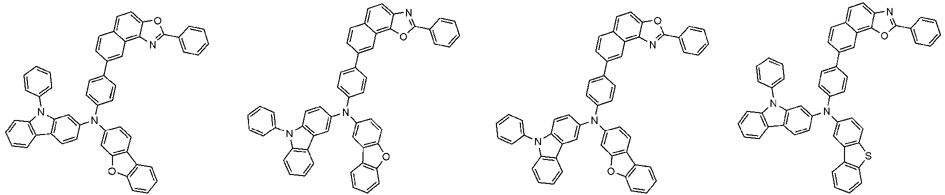

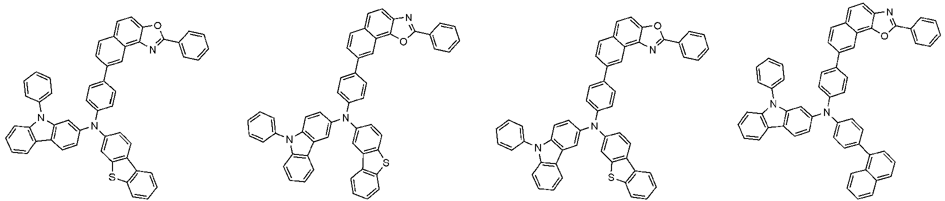

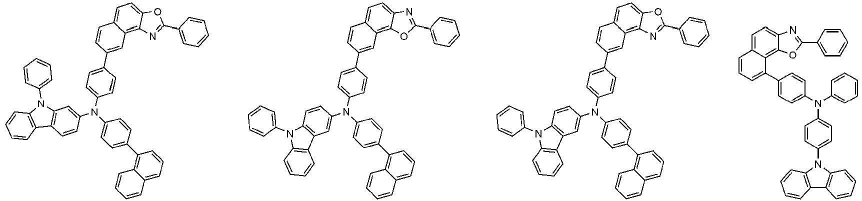

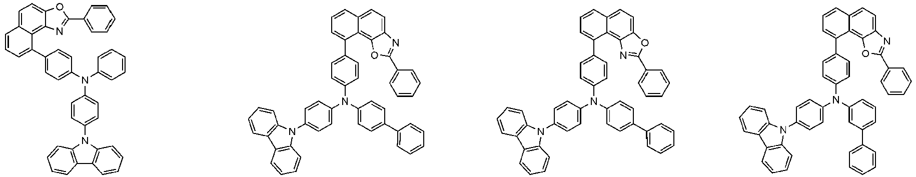

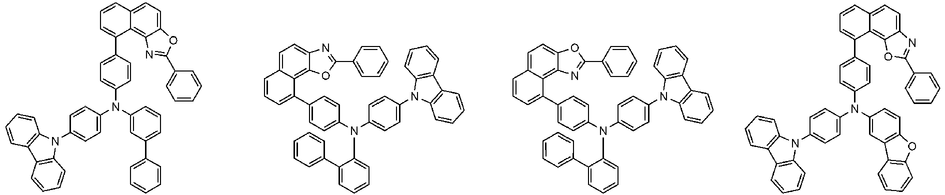

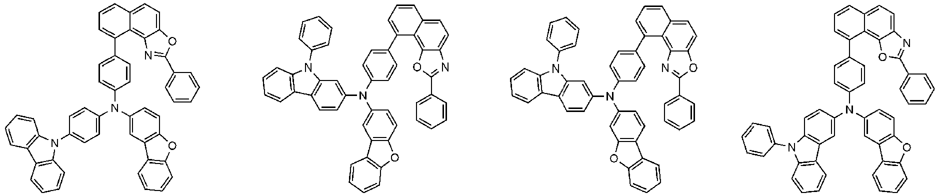

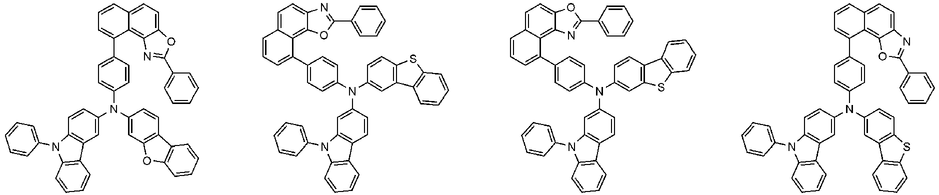

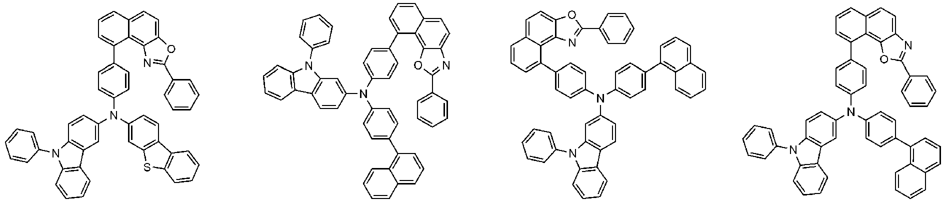

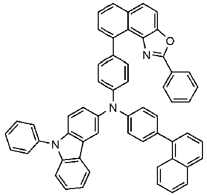

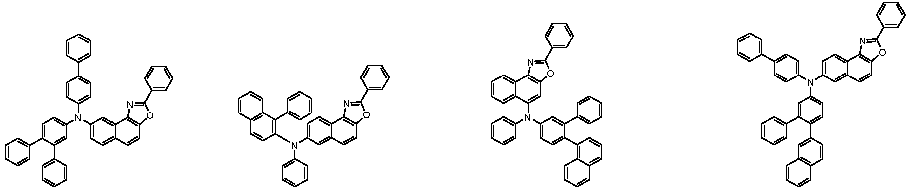

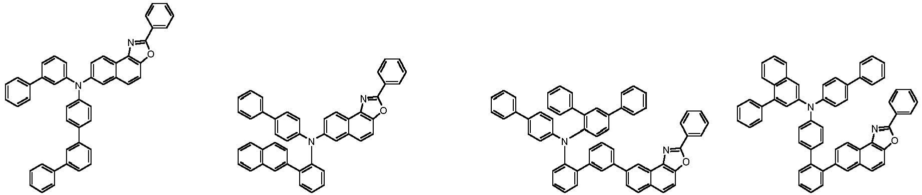

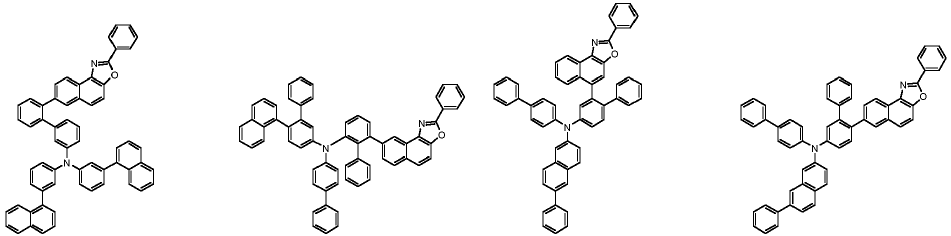

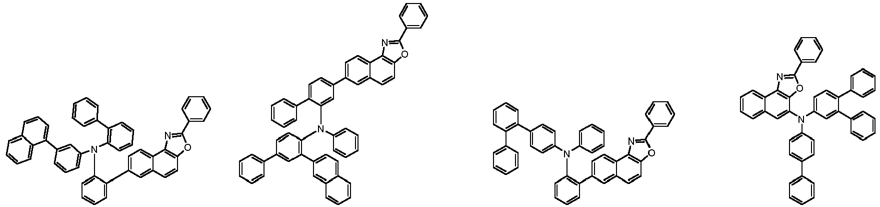

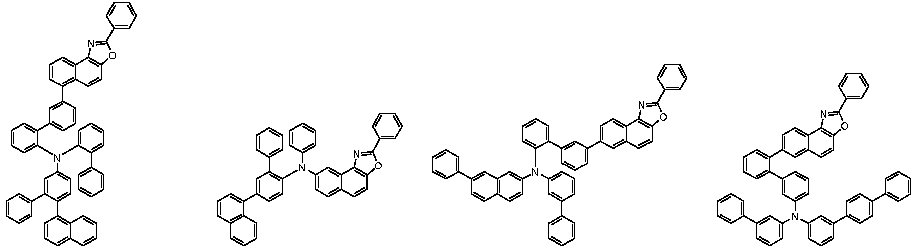

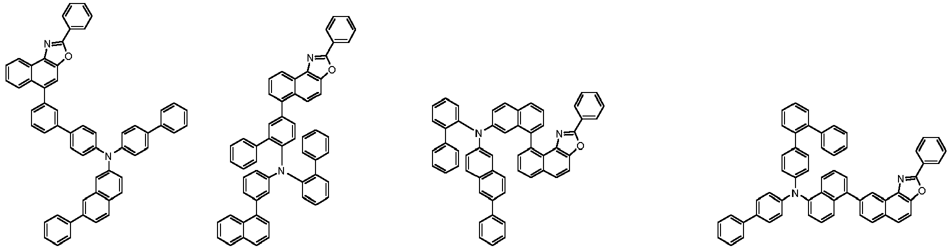

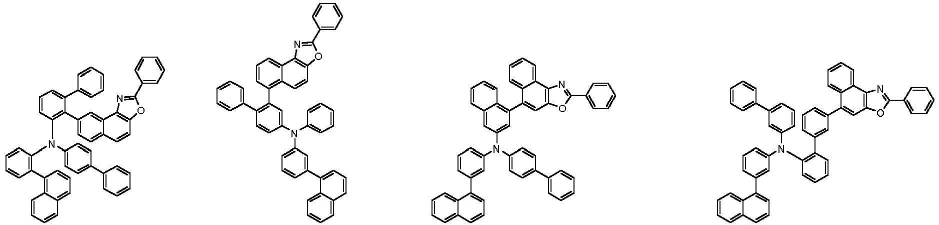

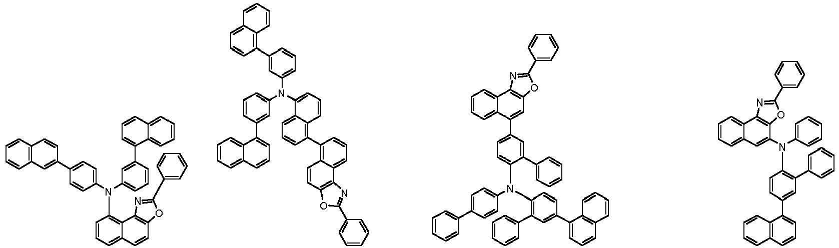

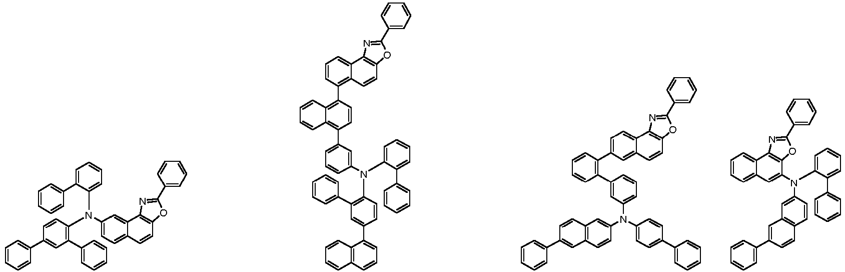

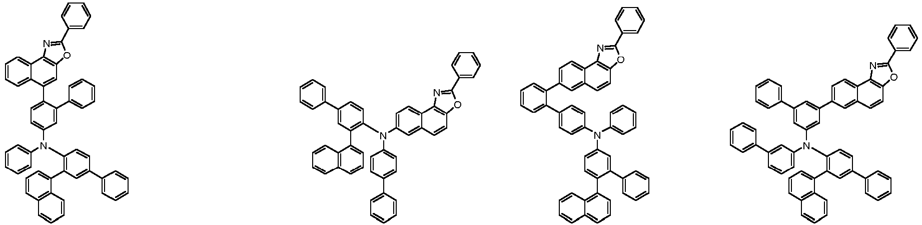

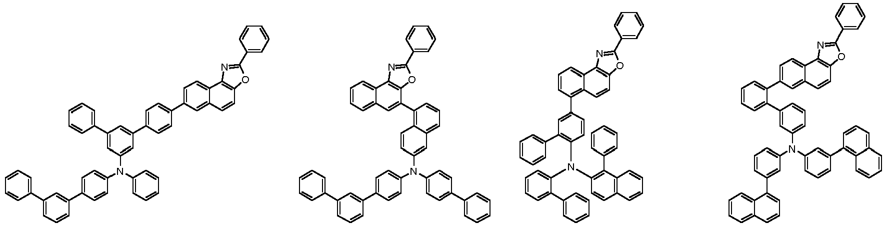

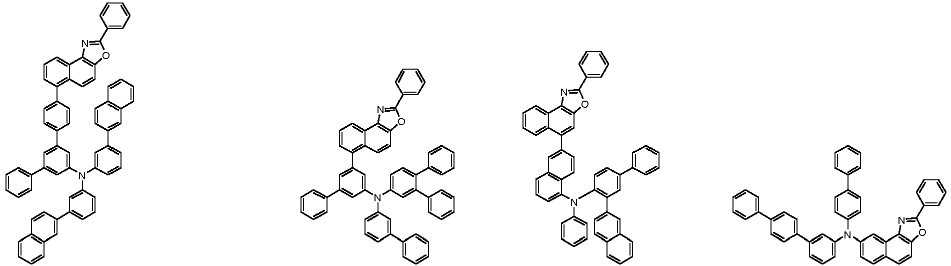

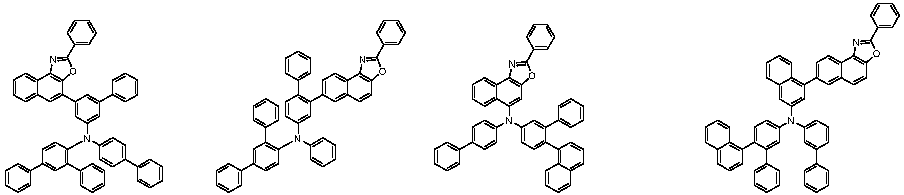

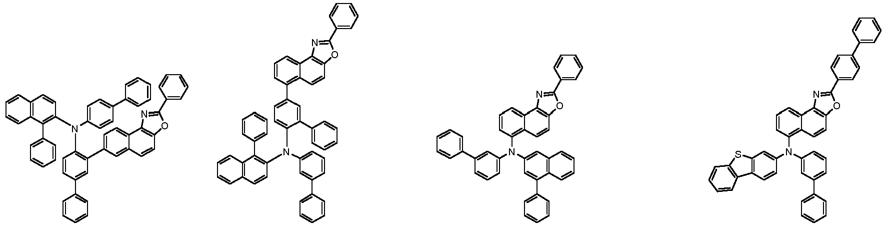

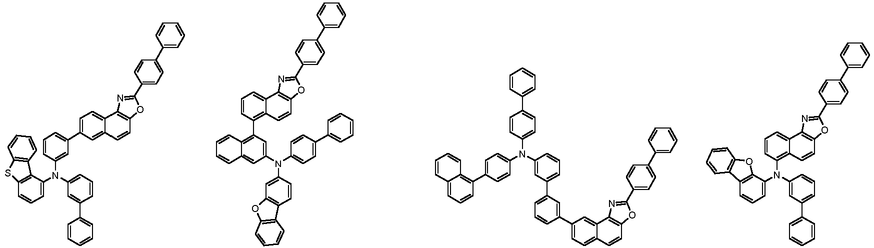

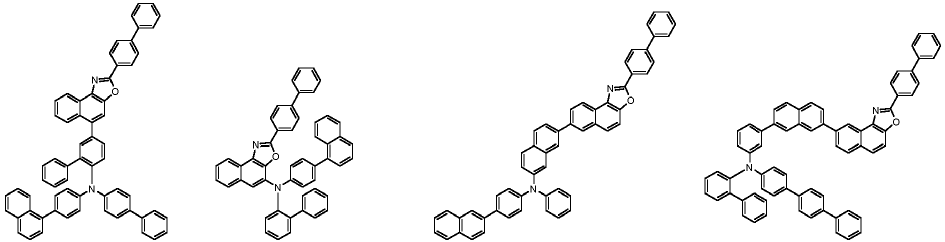

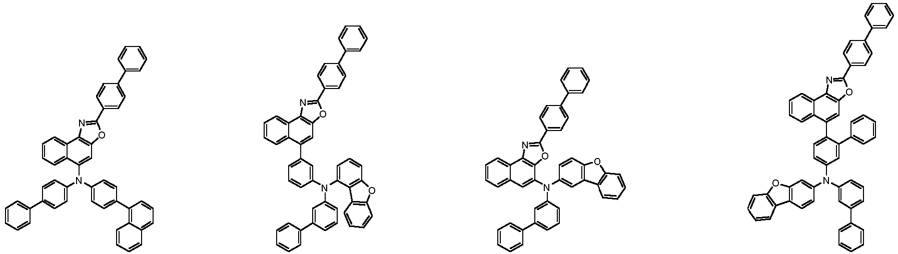

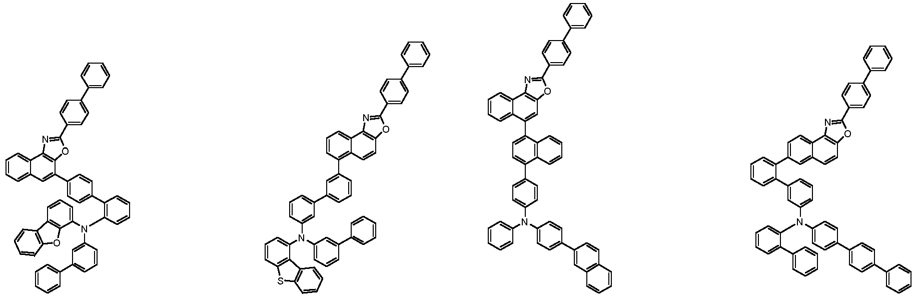

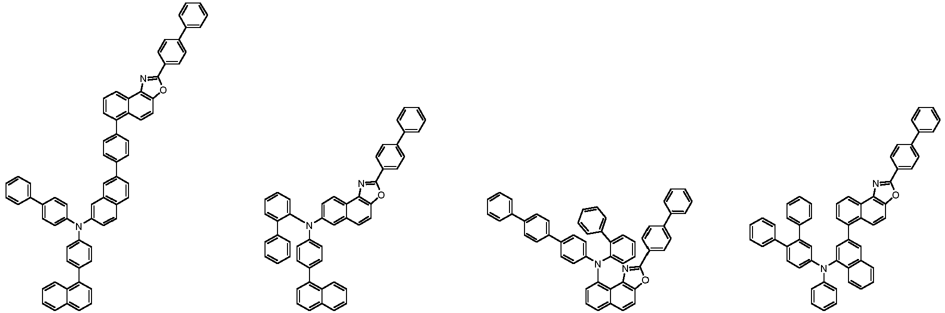

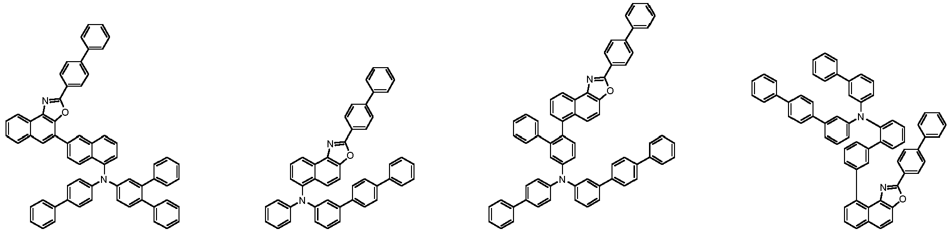

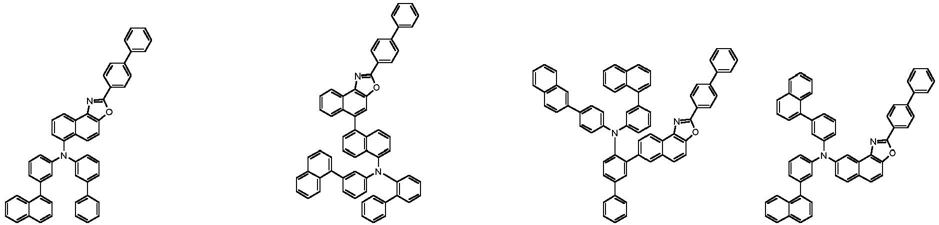

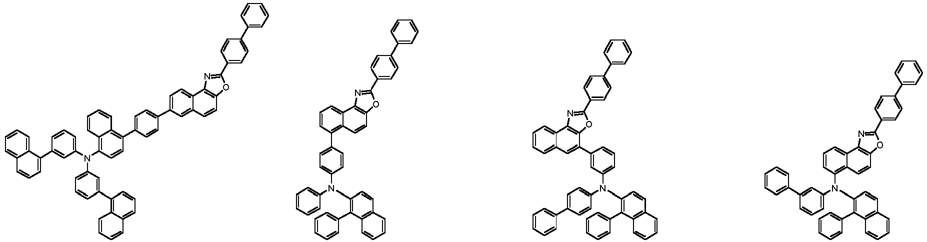

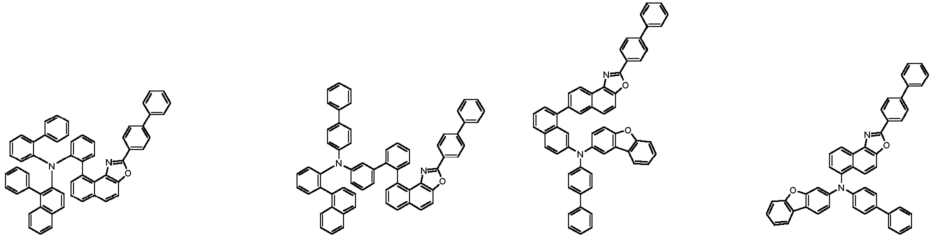

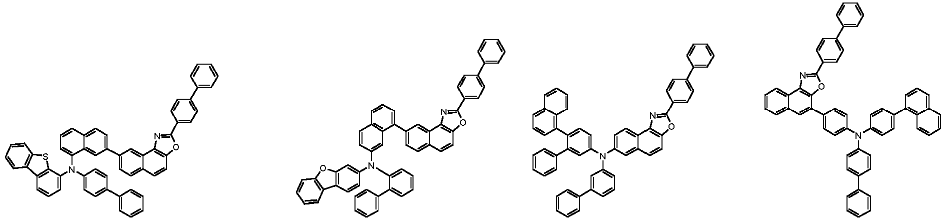

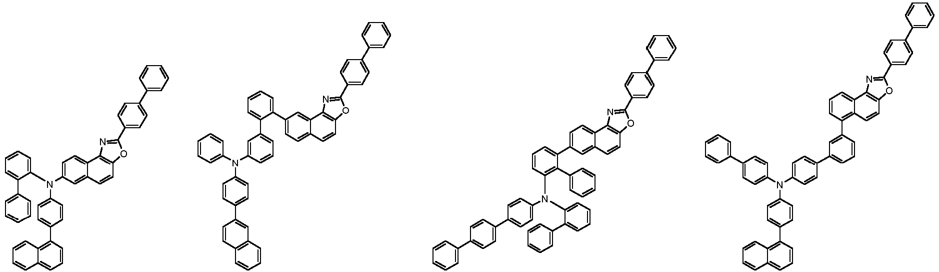

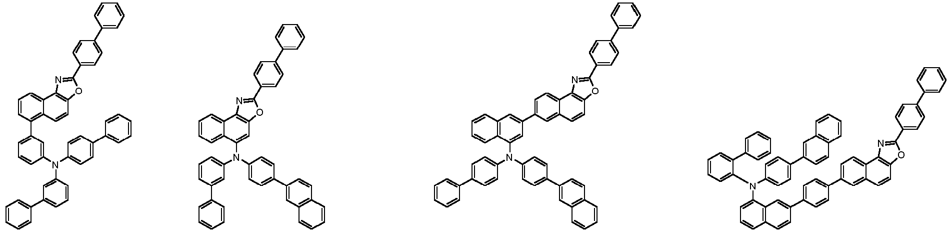

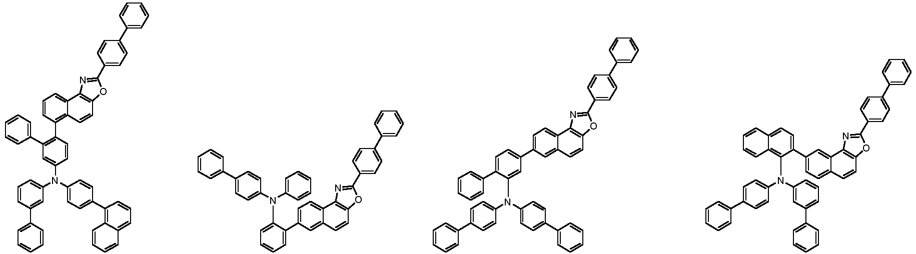

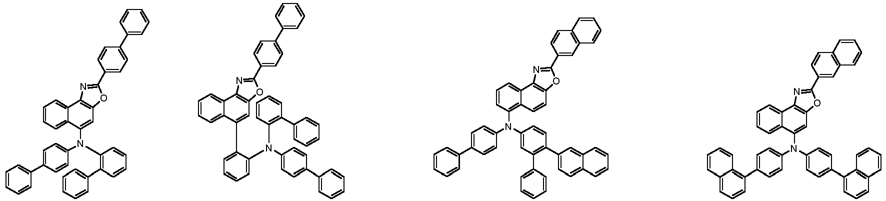

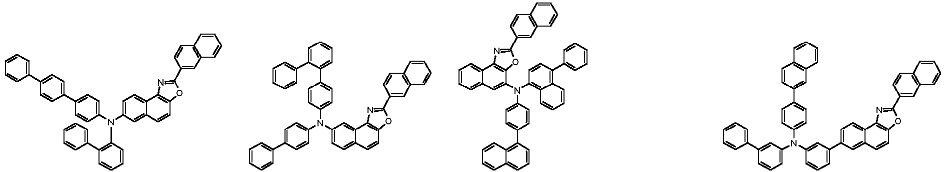

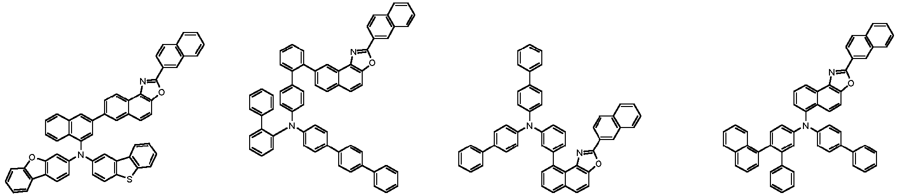

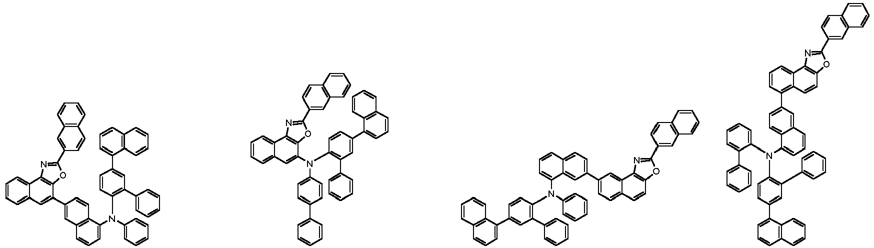

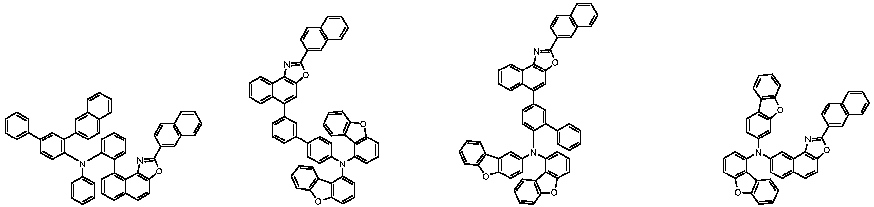

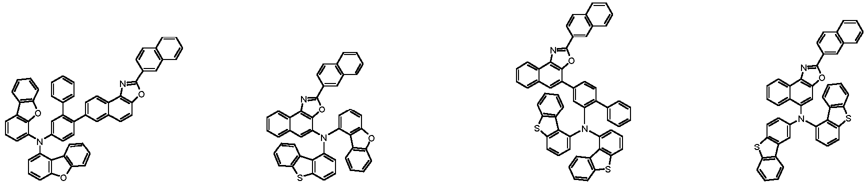

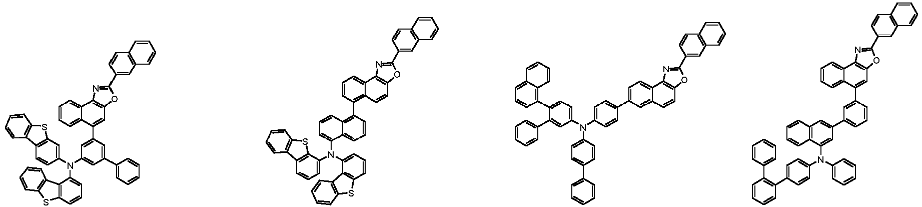

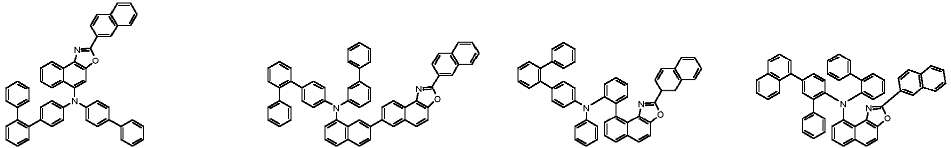

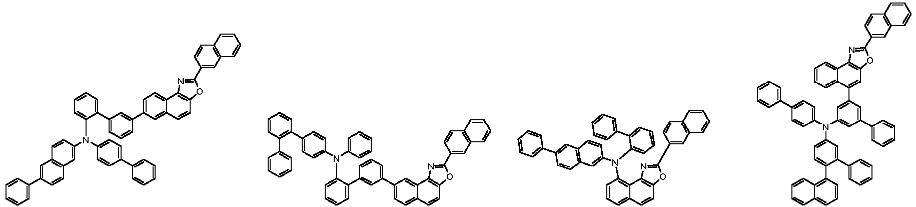

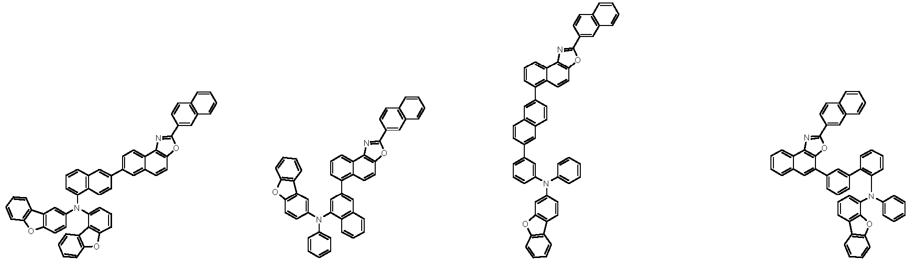

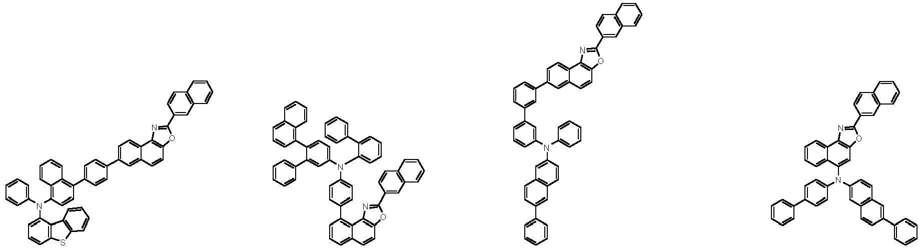

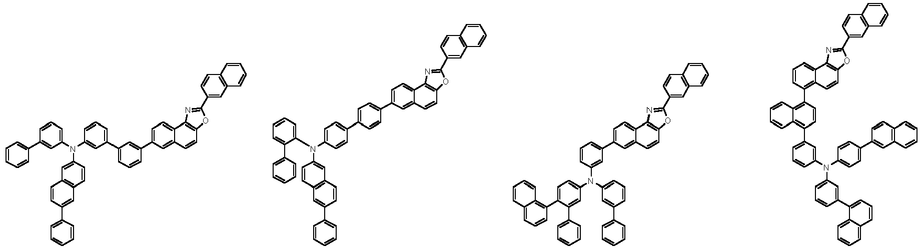

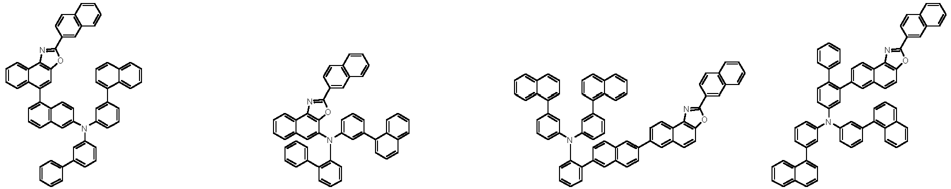

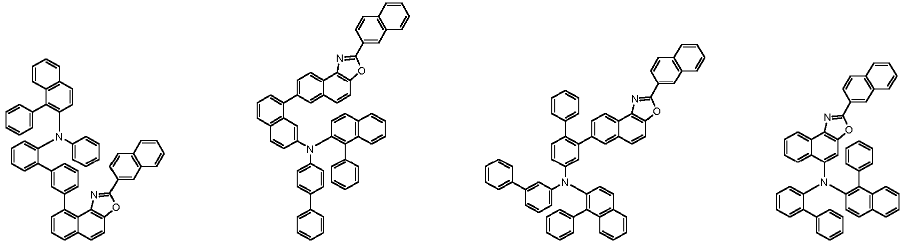

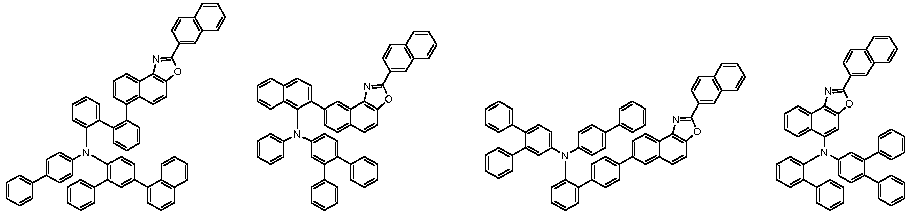

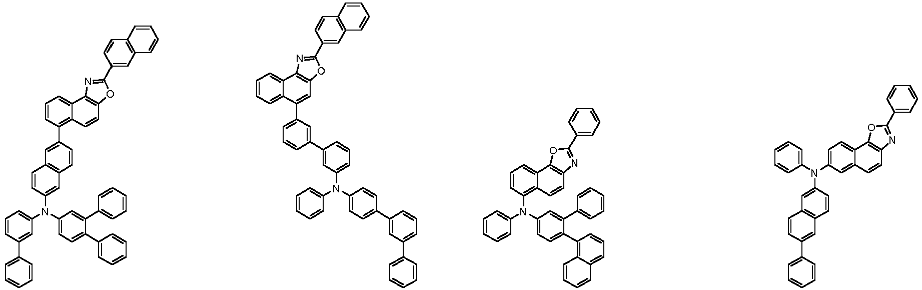

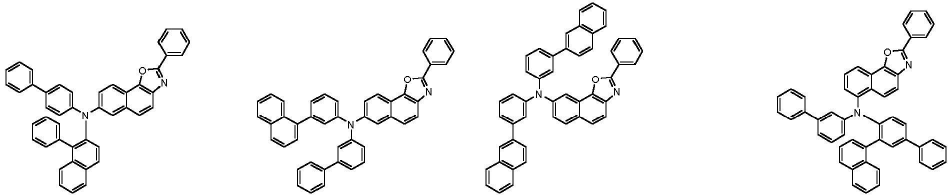

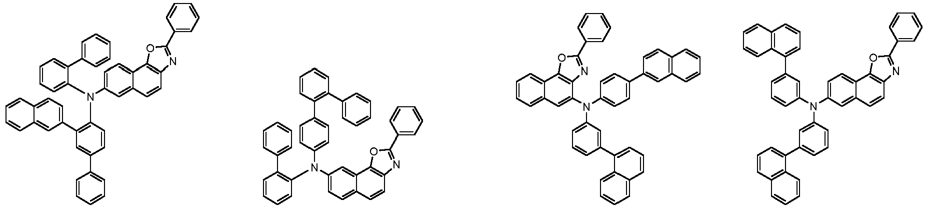

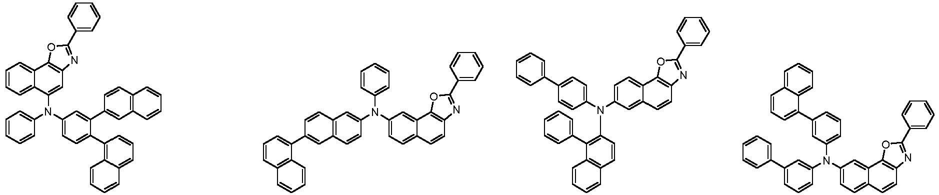

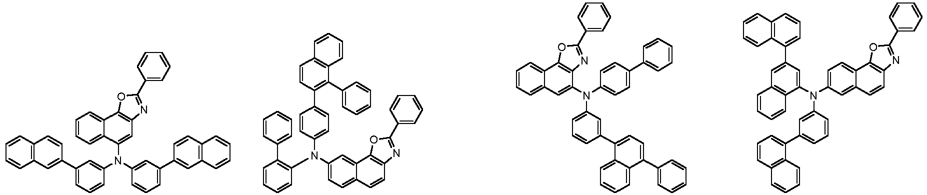

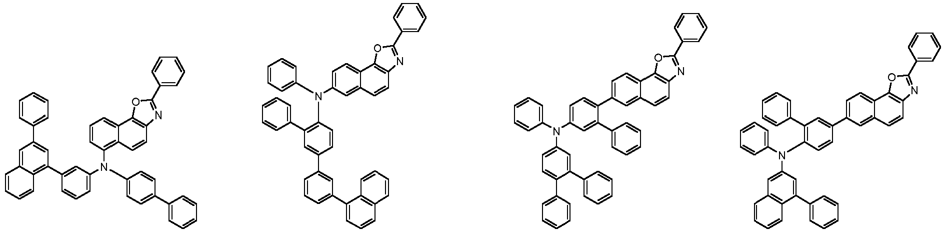

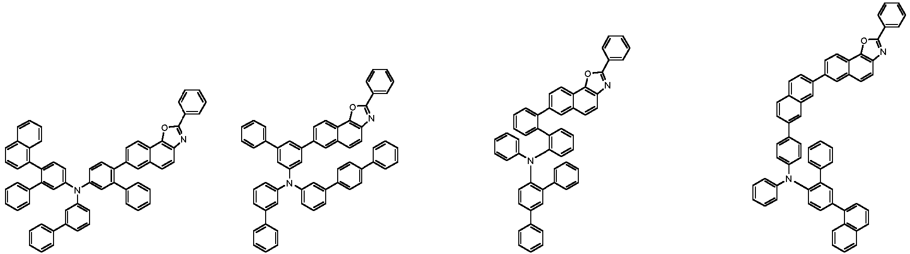

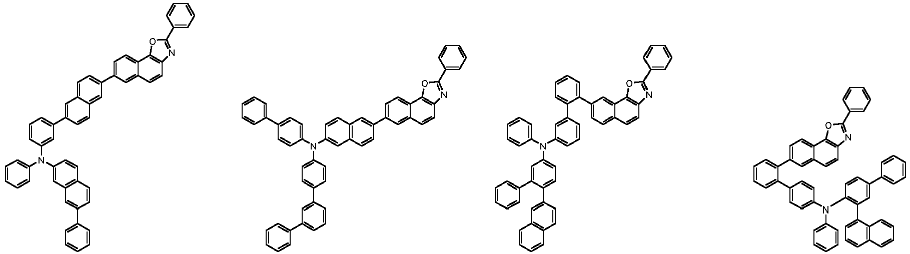

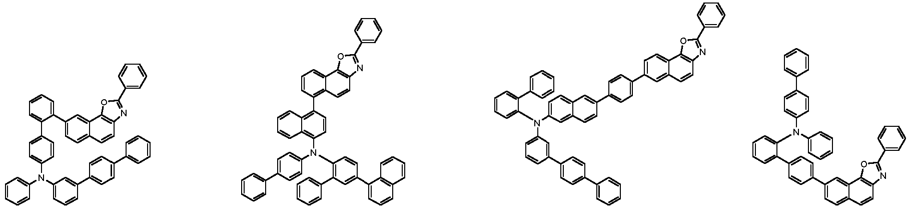

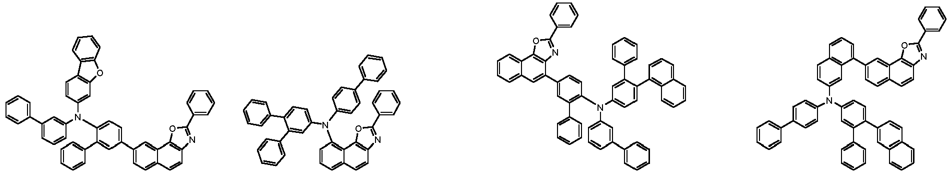

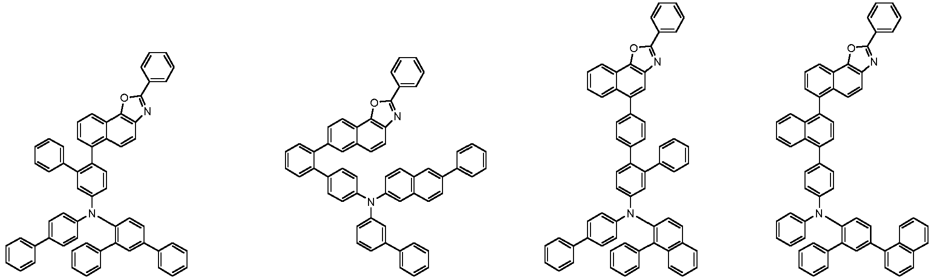

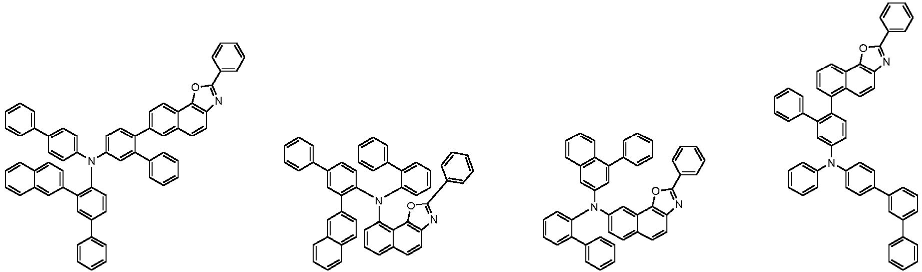

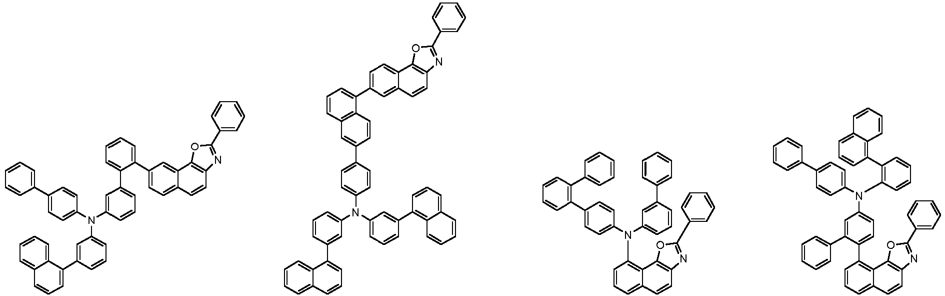

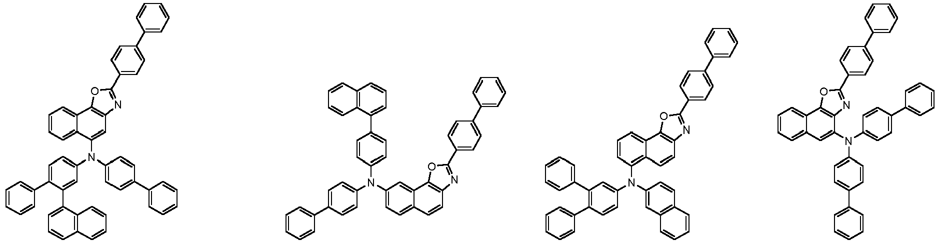

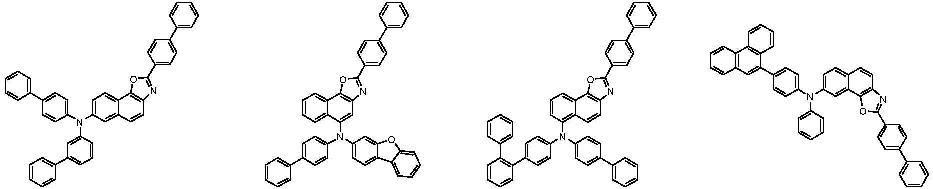

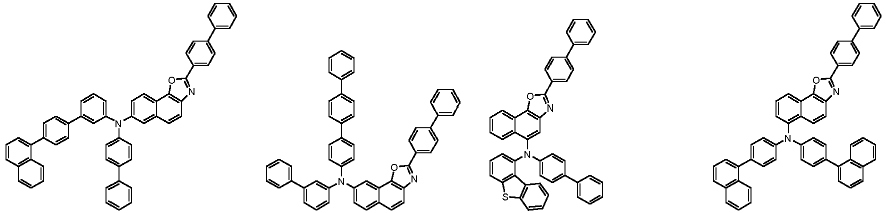

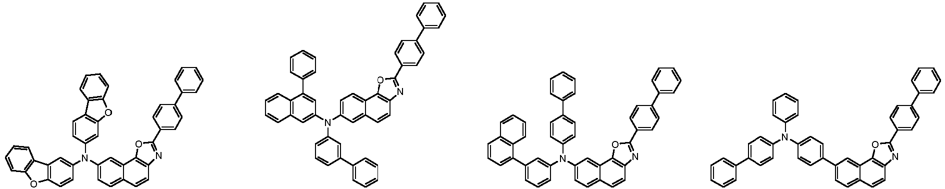

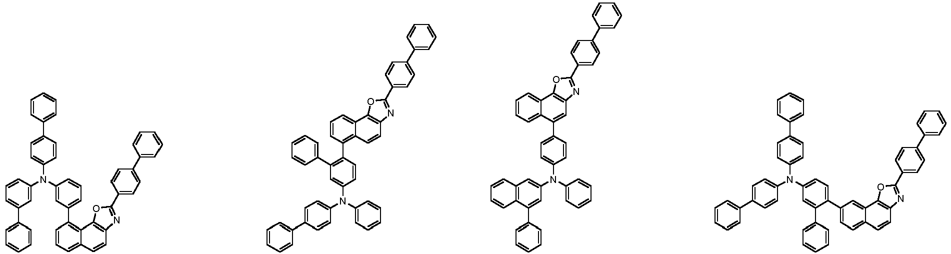

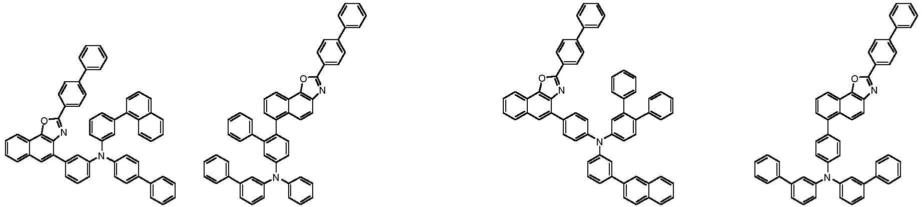

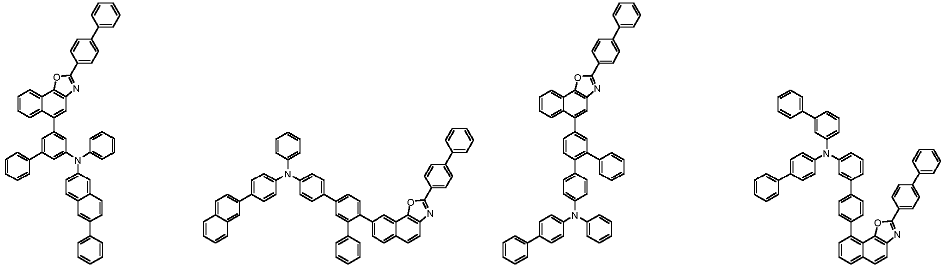

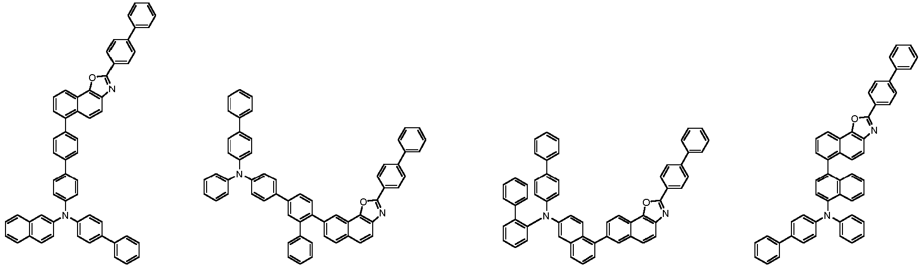

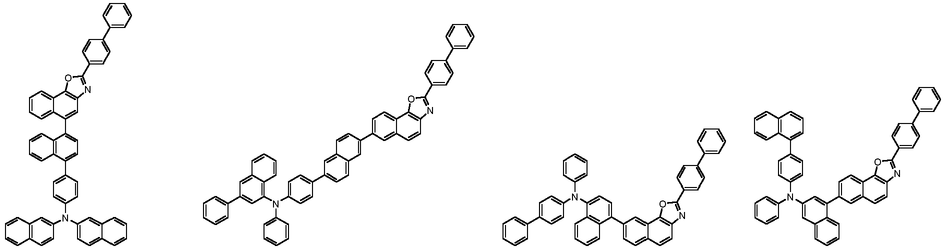

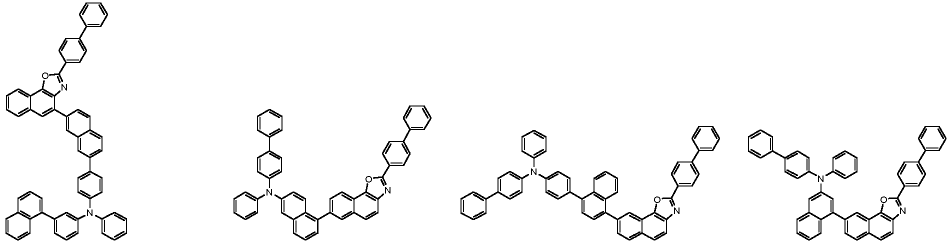

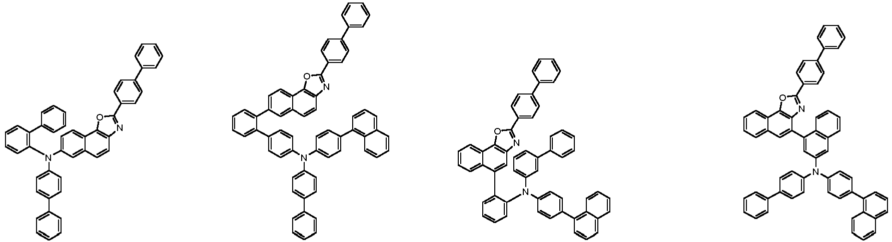

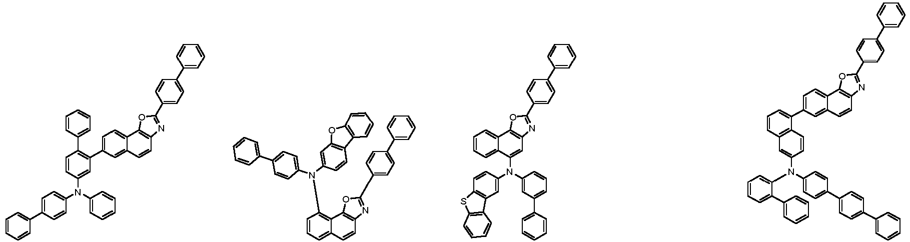

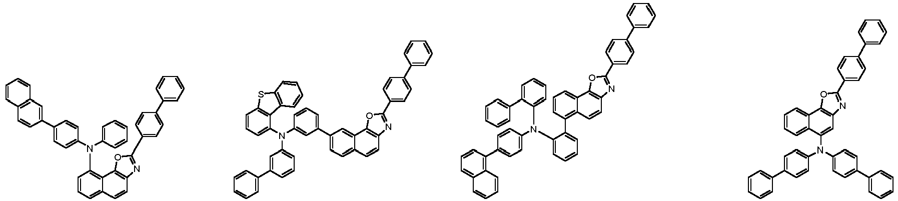

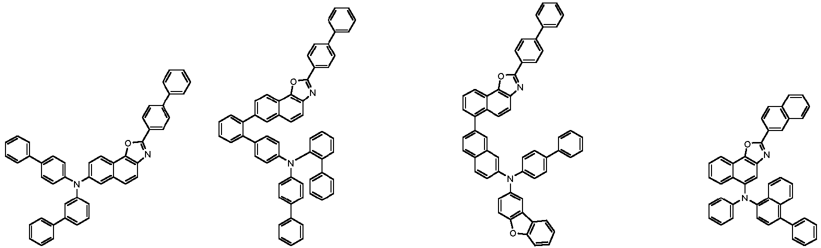

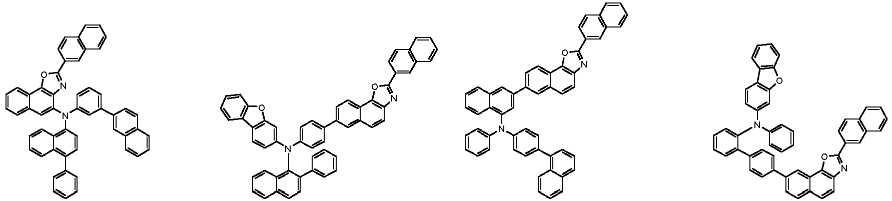

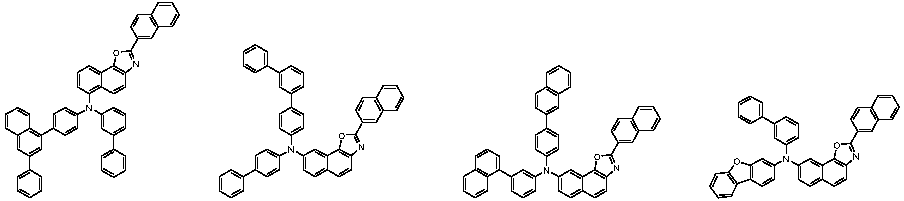

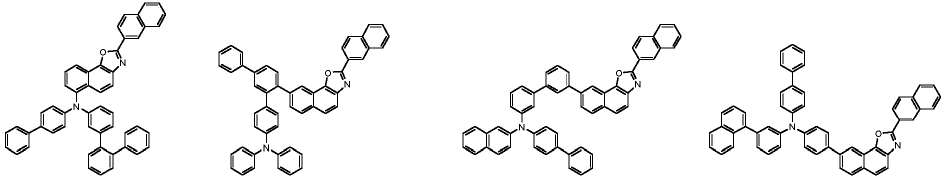

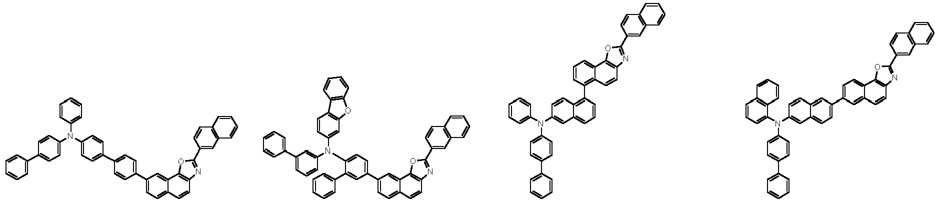

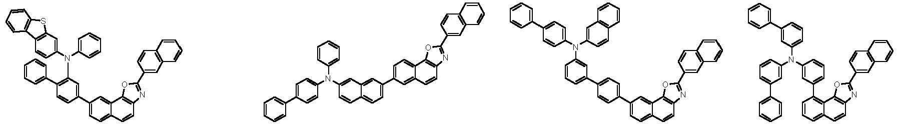

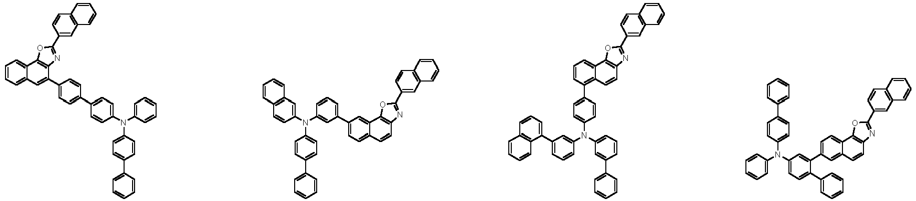

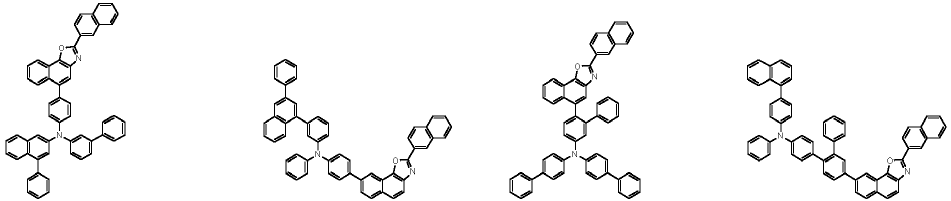

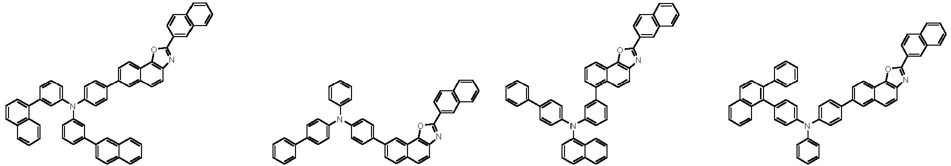

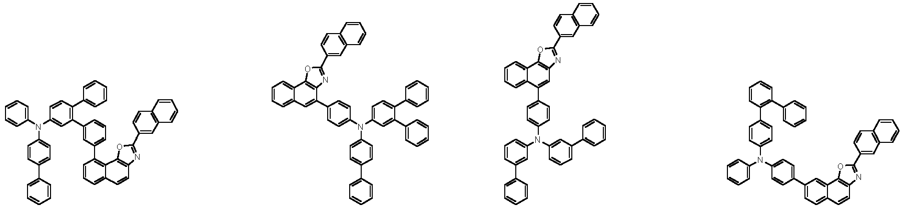

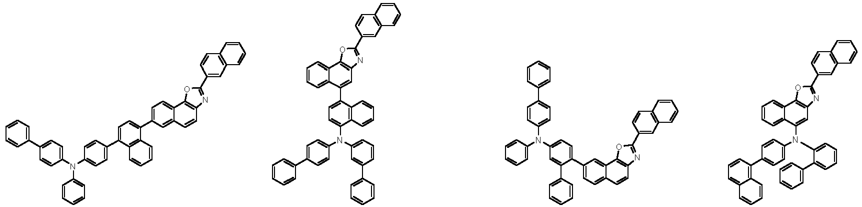

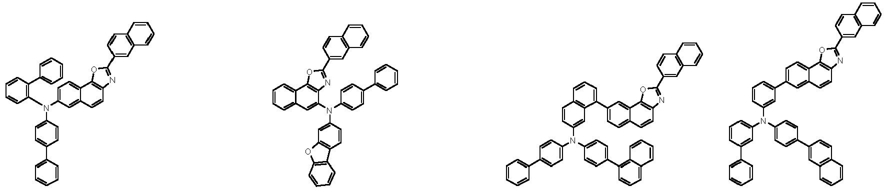

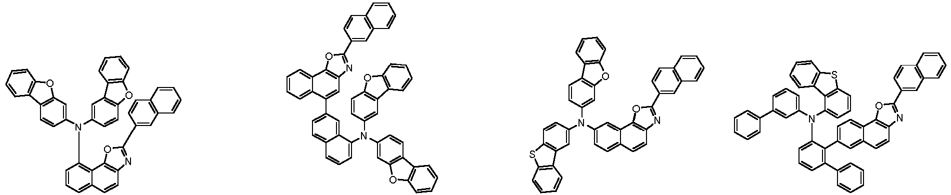

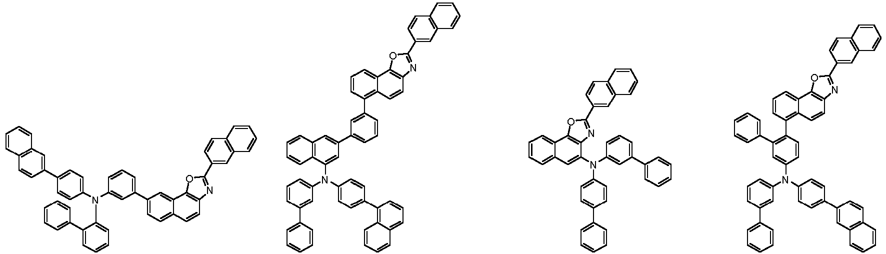

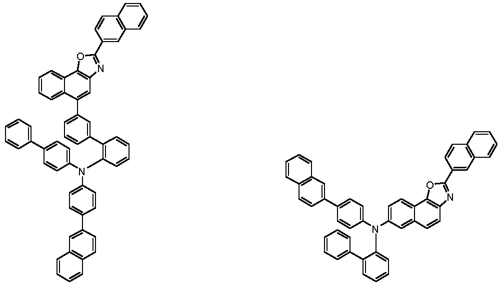

Further, the present disclosure provides a method for preparing the compound represented by Chemical Formula 2 wherein R'₁ is Chemical Formula 4 as shown in the following Reaction Scheme 2, and the other remaining compound represented by Chemical Formula 2 and compound represented by Chemical Formula 3 can also be prepared in a similar manner.

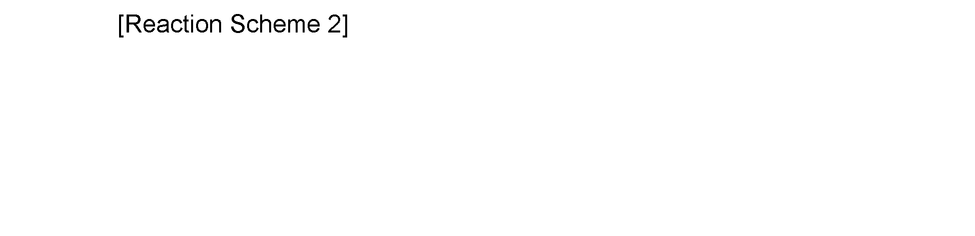

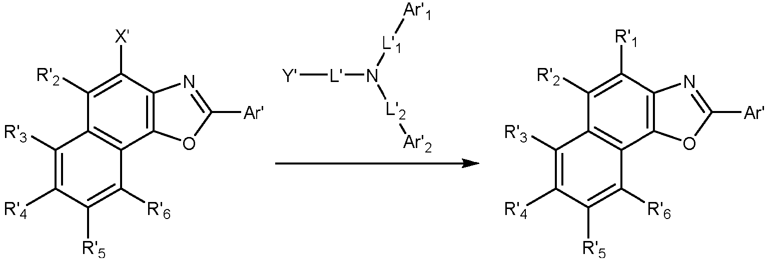

In Reaction Scheme 2, the definition of the remaining substituents except for X' and Y' are the same as defined above, X' is halogen, preferably bromo or chloro, Y' is hydrogen when L' is a single bond, and Y' is -B(OH)₂ when L' is not a single bond. Reaction Scheme 2 is a Suzuki coupling reaction, which is preferably carried out in the presence of a palladium catalyst and a base, and a reactive group for each reaction can be modified as known in the art. The above preparation method can be further embodied in Preparation Examples described hereinafter.

Meanwhile, the dopant material is not particularly limited as long as it is a material used for the organic light emitting device. As an example, an aromatic amine derivative, a styrylamine compound, a boron complex, a fluoranthene compound, a metal complex, and the like can be mentioned. Specific examples of the aromatic amine derivatives include substituted or unsubstituted fused aromatic ring derivatives having an arylamino group, examples thereof include pyrene, anthracene, chrysene, and periflanthene having the arylamino group, and the like. The styrylamine compound is a compound where at least one arylvinyl group is substituted in substituted or unsubstituted arylamine, wherein one or two or more substituent groups selected from the group consisting of an aryl group, a silyl group, an alkyl group, a cycloalkyl group and an arylamino group are substituted or unsubstituted. Specific examples thereof include styrylamine, styryldiamine, styryltriamine, styryltetramine, and the like, but are not limited thereto. Further, examples of the metal complex include an iridium complex, a platinum complex, and the like, but are not limited thereto.

### Hole Transport Layer

The organic light emitting device according to the present disclosure may include a hole transport layer between the light emitting layer and the anode.

The hole transport layer is a layer that receives holes from a hole injection layer and transports the holes to the light emitting layer. The hole transport material is suitably a material having large mobility to the holes, which can receive holes from the anode or the hole injection layer and transfer the holes to the light emitting layer.

Specific examples of the hole transport material include an arylamine-based organic material, a conductive polymer, a block copolymer in which a conjugate portion and a non-conjugate portion are present together, and the like, but are not limited thereto.

### Hole injection layer

The organic light emitting device according to the present disclosure may further include a hole injection layer between the anode and the hole transport layer, if necessary.

The hole injection layer is a layer injecting holes from an electrode, and the hole injection material is preferably a compound which has a capability of transporting the holes, has a hole injection effect in the anode and an excellent hole injection effect to the light emitting layer or the light emitting material, prevents movement of an exciton generated in the light emitting layer to the electron injection layer or the electron injection material, and is excellent in the ability to form a thin film. Further, it is preferable that a HOMO (highest occupied molecular orbital) of the hole injection material is between the work function of the anode material and a HOMO of a peripheral organic material layer.

Specific examples of the hole injection material include metal porphyrine, oligothiophene, an arylamine-based organic material, a hexanitrilehexaazatriphenylene-based organic material, a quinacridone-based organic material, a perylene-based organic material, anthraquinone, polyaniline and polythiophene-based conductive polymer, and the like, but are not limited thereto.

### Electron Transport Layer

The organic light emitting device according to the present disclosure may include an electron transport layer between the light emitting layer and the cathode.

The electron transport layer is a layer that receives electrons from a cathode and an electron injection layer formed on the cathode and transports the electrons to the light emitting layer, and that suppress the transfer of holes from the light emitting layer, and an electron transport material is suitably a material which may receive electrons well from a cathode and transfer the electrons to a light emitting layer, and has a large mobility for electrons.

Specific examples of the electron transport material include: an Al complex of 8-hydroxyquinoline; a complex including Alq₃; an organic radical compound; a hydroxyflavone-metal complex, and the like, but are not limited thereto. The electron transport layer may be used with any desired cathode material, as used according to a conventional technique. In particular, appropriate examples of the cathode material are a typical material which has a low work function, followed by an aluminum layer or a silver layer. Specific examples thereof include cesium, barium, calcium, ytterbium, and samarium, in each case followed by an aluminum layer or a silver layer.

### Electron Injection Layer

The organic light emitting device according to the present disclosure may further include an electron injection layer between the electron transport layer and the cathode, if necessary.

The electron injection layer is a layer which injects electrons from an electrode, and is preferably a compound which has a capability of transporting electrons, has an effect of injecting electrons from a cathode and an excellent effect of injecting electrons into a light emitting layer or a light emitting material, prevents excitons produced from the light emitting layer from moving to a hole injection layer, and is also excellent in the ability to form a thin film.

Specific examples of the materials that can be used as the electron injection layer include fluorenone, anthraquinodimethane, diphenoquinone, thiopyran dioxide, oxazole, oxadiazole, triazole, imidazole, perylenetetracarboxylic acid, fluorenylidene methane, anthrone, and the like, and derivatives thereof, a metal complex compound, a nitrogen-containing 5-membered ring derivative, and the like, but are not limited thereto.

Examples of the metal complex compound include 8-hydroxyquinolinato lithium, bis(8-hydroxyquinolinato)zinc, bis(8-hydroxyquinolinato)copper, bis(8-hydroxyquinolinato)manganese, tris(8-hydroxyquinolinato)aluminum, tris(2-methyl-8-hydroxyquinolinato)aluminum, tris(8-hydroxyquinolinato)gallium, bis(10-hydroxybenzo[h]quinolinato)beryllium, bis(10-hydroxybenzo[h]quinolinato)zinc, bis(2-methyl-8-quinolinato)chlorogallium, bis(2-methyl-8-quinolinato)(o-cresolato)gallium, bis(2-methyl-8-quinolinato)(1-naphtholato)aluminum, bis(2-methyl-8-quinolinato)(2-naphtholato)gallium, and the like, but are not limited thereto.

### Organic Light Emitting Device

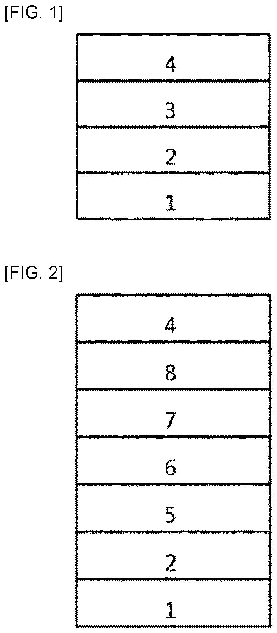

The structure of the organic light emitting device according to the present disclosure is illustrated in FIG.1 and 2. FIG. 1 shows an example of an organic light emitting device comprising a substrate 1, an anode 2, a light emitting layer 3 and a cathode 4. FIG. 2 shows an example of an organic light emitting device comprising a substrate 1, an anode 2, a hole injection layer 5, a hole transport layer 6, a light emitting layer 7, an electron transport layer 8, and a cathode 4.

The organic light emitting device according to the present disclosure can be manufactured by sequentially stacking the above-described structures. In this case, the organic light emitting device can be manufactured by depositing a metal, metal oxides having conductivity, or an alloy thereof on the substrate by using a PVD (physical vapor deposition) method such as a sputtering method or an e-beam evaporation method to form the anode, forming the respective layers described above thereon, and then depositing a material that can be used as the cathode thereon. In addition to such a method, the organic light emitting device can be manufactured by sequentially depositing from the cathode material to the anode material on a substrate in the reverse order of the above-mentioned configuration (WO 2003/012890). Further, the light emitting layer may be formed by subjecting hosts and dopants to a vacuum deposition method and a solution coating method. Herein, the solution coating method means a spin coating, a dip coating, a doctor blading, an inkjet printing, a screen printing, a spray method, a roll coating, or the like, but is not limited thereto.

Meanwhile, the organic light emitting device according to the present disclosure may be a bottom emission device, a top emission device, or a double-sided light emitting device.

Hereinafter, the preparation of the organic light emitting device will be specifically described in the following Examples. However, the following Examples are provided for illustrative purposes only, and are not intended to limit the scope of the present disclosure.

### [PREPARATION EXAMPLE]

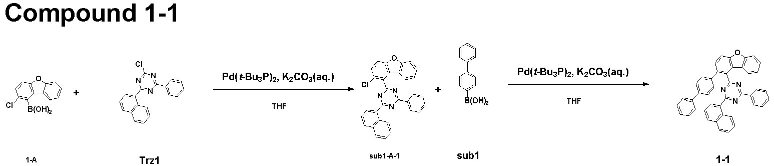

Compound 1-A (15 g, 60.9 mmol) and Compound Trz1 (19.3 g, 60.9 mmol) were added to THF (300 ml) under a nitrogen atmosphere, and the mixture was stirred and refluxed. Then, potassium carbonate (16.8 g, 121.7 mmol) was dissolved in water (50 ml), added thereto, stirred sufficiently, and then bis(tri-tert-butylphosphine)palladium(0) (0.3 g, 0.6 mmol) was added. After the reaction for 12 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 20.9 g of Compound sub1-A-1. (Yield: 71%, MS: [M+H]⁺= 484)
Compound sub1-A-1 (15 g, 31 mmol) and Compound sub1 (6.1 g, 31 mmol) were added to THF (300 ml) under a nitrogen atmosphere, and the mixture was stirred and refluxed. Then, potassium carbonate (8.6 g, 62 mmol) was dissolved in water (26 ml), added thereto, stirred sufficiently, and then bis(tri-tert-butylphosphine)palladium(0) (0.2 g, 0.4 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.3 g of Compound 1-1. (Yield: 66%, MS: [M+H]⁺= 602) 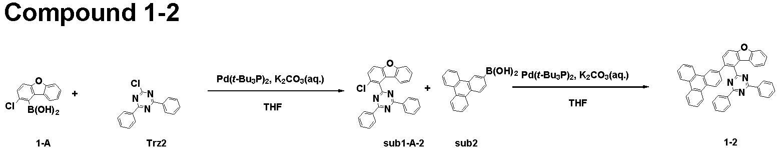
Compound 1-A (15 g, 60.9 mmol) and Compound Trz2 (16.3 g, 60.9 mmol) were added to THF (300 ml) under a nitrogen atmosphere, and the mixture was stirred and refluxed. Then, potassium carbonate (25.2 g, 182.6 mmol) was dissolved in water (76 ml), added thereto, stirred sufficiently, and then bis(tri-tert-butylphosphine)palladium(0) (0.3 g, 0.6 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 19.5 g of Compound sub1-A-2. (Yield: 74%, MS: [M+H]⁺= 434)
Compound sub1-A-2 (15 g, 34.6 mmol) and Compound sub2 (9.4 g, 34.6 mmol) were added to THF (300 ml) under a nitrogen atmosphere, and the mixture was stirred and refluxed. Then, potassium carbonate (9.6 g, 69.1 mmol) was dissolved in water (29 ml), added thereto, stirred sufficiently, and then bis(tri-tert-butylphosphine)palladium(0) (0.2 g, 0.4 mmol) was added. After the reaction for 8 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 14.3 g of Compound 1-2. (Yield: 66%, MS: [M+H]⁺= 626) 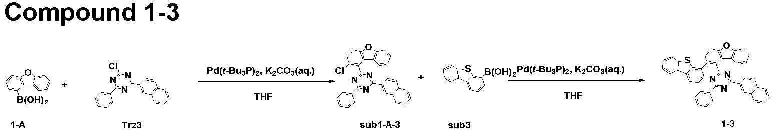
Compound 1-A (15 g, 60.9 mmol) and Compound Trz3 (19.3 g, 60.9 mmol) were added to THF (300 ml) under a nitrogen atmosphere, and the mixture was stirred and refluxed. Then, potassium carbonate (25.2 g, 182.6 mmol) was dissolved in water (76 ml), added thereto, stirred sufficiently, and then bis(tri-tert-butylphosphine)palladium(0) (0.3 g, 0.6 mmol) was added. After the reaction for 9 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 23.2 g of Compound sub1-A-3. (Yield: 79%, MS: [M+H]⁺= 484)
Compound sub1-A-3 (15 g, 31 mmol) and Compound sub3 (7.1 g, 31 mmol) were added to THF (300 ml) under a nitrogen atmosphere, and the mixture was stirred and refluxed. Then, potassium carbonate (8.6 g, 62 mmol) was dissolved in water (26 ml), added thereto, stirred sufficiently, and then bis(tri-tert-butylphosphine)palladium(0) (0.2 g, 0.4 mmol) was added. After the reaction for 12 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.9 g of Compound 1-3. (Yield: 66%, MS: [M+H]⁺= 632) 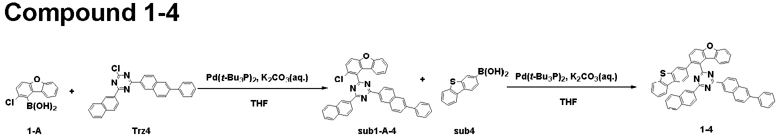
Compound 1-A (15 g, 60.9 mmol) and Compound Trz4 (27 g, 60.9 mmol) were added to THF (300 ml) under a nitrogen atmosphere, and the mixture was stirred and refluxed. Then, potassium carbonate (25.2 g, 182.6 mmol) was dissolved in water (76 ml), added thereto, stirred sufficiently, and then bis(tri-tert-butylphosphine)palladium(0) (0.3 g, 0.6 mmol) was added. After the reaction for 9 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 26 g of Compound sub1-A-4. (Yield: 70%, MS: [M+H]⁺= 610)
Compound sub1-A-4 (15 g, 24.6 mmol) and Compound sub4 (5.6 g, 24.6 mmol) were added to THF (300 ml) under a nitrogen atmosphere, and the mixture was stirred and refluxed. Then, potassium carbonate (6.8 g, 49.2 mmol) was dissolved in water (20 ml), added thereto, stirred sufficiently, and then bis(tri-tert-butylphosphine)palladium(0) (0.1 g, 0.2 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 11.2 g of Compound 1-4. (Yield: 60%, MS: [M+H]⁺= 758) 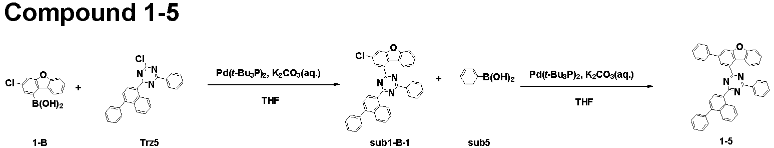
Compound 1-B (15 g, 60.9 mmol) and Compound Trz5 (24 g, 60.9 mmol) were added to THF (300 ml) under a nitrogen atmosphere, and the mixture was stirred and refluxed. Then, potassium carbonate (25.2 g, 182.6 mmol) was dissolved in water (76 ml), added thereto, stirred sufficiently, and then bis(tri-tert-butylphosphine)palladium(0) (0.3 g, 0.6 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 26.2 g of Compound sub1-B-1. (Yield: 77%, MS: [M+H]⁺= 560)
Compound sub1-B-1 (15 g, 26.8 mmol) and Compound sub5 (3.3 g, 26.8 mmol) were added to THF (300 ml) under a nitrogen atmosphere, and the mixture was stirred and refluxed. Then, potassium carbonate (7.4 g, 53.6 mmol) was dissolved in water (22 ml), added thereto, stirred sufficiently, and then bis(tri-tert-butylphosphine)palladium(0) (0.1 g, 0.2 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.9 g of Compound 1-5. (Yield: 80%, MS: [M+H]⁺= 602) 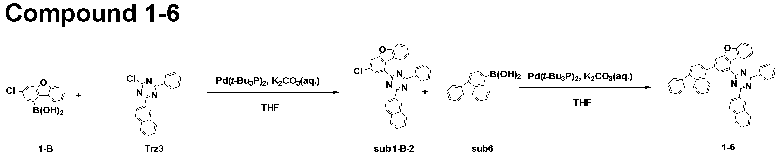
Compound 1-B (15 g, 60.9 mmol) and Compound Trz3 (19.3 g, 60.9 mmol) were added to THF (300 ml) under a nitrogen atmosphere, and the mixture was stirred and refluxed. Then, potassium carbonate (25.2 g, 182.6 mmol) was dissolved in water (76 ml), added thereto, stirred sufficiently, and then bis(tri-tert-butylphosphine)palladium(0) (0.3 g, 0.6 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 18.2 g of Compound sub1-B-2. (Yield: 62%, MS: [M+H]⁺= 484)
Compound sub1-B-2 (15 g, 31 mmol) and Compound sub6 (7.6 g, 31 mmol) were added to THF (300 ml) under a nitrogen atmosphere, and the mixture was stirred and refluxed. Then, potassium carbonate (8.6 g, 62 mmol) was dissolved in water (26 ml), added thereto, stirred sufficiently, and then bis(tri-tert-butylphosphine)palladium(0) (0.2 g, 0.4 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 15.3 g of Compound 1-6. (Yield: 76%, MS: [M+H]⁺= 650) 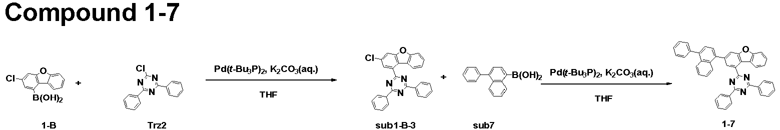
Compound 1-B (15 g, 60.9 mmol) and Compound Trz2 (16.3 g, 60.9 mmol) were added to THF (300 ml) under a nitrogen atmosphere, and the mixture was stirred and refluxed. Then, potassium carbonate (25.2 g, 182.6 mmol) was dissolved in water (76 ml), added thereto, stirred sufficiently, and then bis(tri-tert-butylphosphine)palladium(0) (0.3 g, 0.6 mmol) was added. After the reaction for 12 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 20.8 g of Compound sub1-B-3. (Yield: 79%, MS: [M+H]⁺= 434)
Compound sub1-B-3 (15 g, 34.6 mmol) and Compound sub7(8.6 g, 34.6 mmol) were added to THF (300 ml) under a nitrogen atmosphere, and the mixture was stirred and refluxed. Then, potassium carbonate (9.6 g, 69.1 mmol) was dissolved in water (29 ml), added thereto, stirred sufficiently, and then bis(tri-tert-butylphosphine)palladium(0) (0.2 g, 0.4 mmol) was added. After the reaction for 8 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 15.4 g of Compound 1-7. (Yield: 74%, MS: [M+H]⁺= 602) 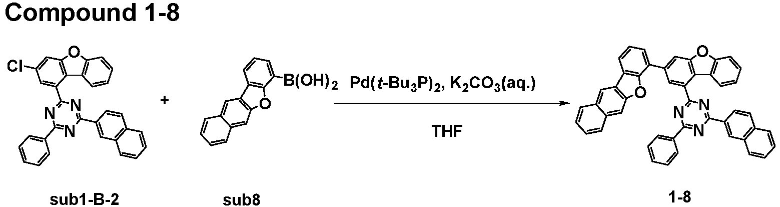
Compound sub1-B-2 (15 g, 31 mmol) and Compound sub8 (8.1 g, 31 mmol) were added to THF (300 ml) under a nitrogen atmosphere, and the mixture was stirred and refluxed. Then, potassium carbonate (8.6 g, 62 mmol) was dissolved in water (26 ml), added thereto, stirred sufficiently, and then bis(tri-tert-butylphosphine)palladium(0) (0.2 g, 0.4 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 15.5 g of Compound 1-8. (Yield: 75%, MS: [M+H]⁺= 666) 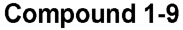 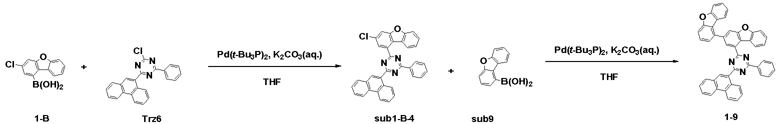
Compound 1-B (15 g, 60.9 mmol) and Compound Trz6 (22.4 g, 60.9 mmol) were added to THF (300 ml) under a nitrogen atmosphere, and the mixture was stirred and refluxed. Then, potassium carbonate (25.2 g, 182.6 mmol) was dissolved in water (76 ml), added thereto, stirred sufficiently, and then bis(tri-tert-butylphosphine)palladium(0) (0.3 g, 0.6 mmol) was added. After the reaction for 9 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 23.7 g of Compound sub1-B-4. (Yield: 73%, MS: [M+H]⁺= 534)
Compound sub1-B-4 (15 g, 28.1 mmol) and Compound sub9 (6 g, 28.1 mmol) were added to THF (300 ml) under a nitrogen atmosphere, and the mixture was stirred and refluxed. Then, potassium carbonate (7.8 g, 56.2 mmol) was dissolved in water (23 ml), added thereto, stirred sufficiently, and then bis(tri-tert-butylphosphine)palladium(0) (0.1 g, 0.2 mmol) was added. After the reaction for 8 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 11.6 g of Compound 1-9. (Yield: 62%, MS: [M+H]⁺= 666) 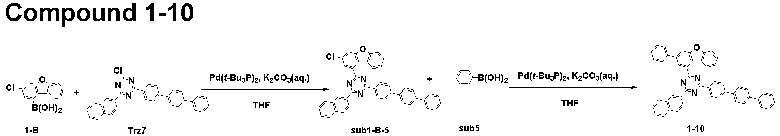
Compound 1-B (15 g, 60.9 mmol) and Compound Trz7 (28.6 g, 60.9 mmol) were added to THF (300 ml) under a nitrogen atmosphere, and the mixture was stirred and refluxed. Then, potassium carbonate (25.2 g, 182.6 mmol) was dissolved in water (76 ml), added thereto, stirred sufficiently, and then bis(tri-tert-butylphosphine)palladium(0) (0.3 g, 0.6 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 28.6 g of Compound sub1-B-5. (Yield: 74%, MS: [M+H]⁺= 636)
Compound sub1-B-5 (15 g, 23.6 mmol) and Compound sub5 (2.9 g, 23.6 mmol) were added to THF (300 ml) under a nitrogen atmosphere, and the mixture was stirred and refluxed. Then, potassium carbonate (6.5 g, 47.2 mmol) was dissolved in water (20 ml), added thereto, stirred sufficiently, and then bis(tri-tert-butylphosphine)palladium(0) (0.1 g, 0.2 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 10.4 g of Compound 1-5. (Yield: 65%, MS: [M+H]⁺= 678) 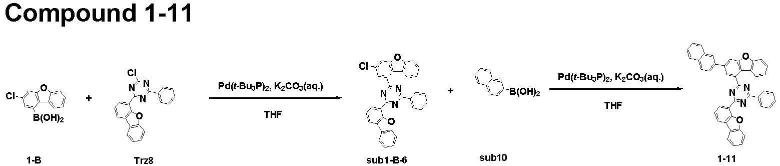
Compound 1-B (15 g, 60.9 mmol) and Compound Trz8 (21.8 g, 60.9 mmol) were added to THF (300 ml) under a nitrogen atmosphere, and the mixture was stirred and refluxed. Then, potassium carbonate (25.2 g, 182.6 mmol) was dissolved in water (76 ml), added thereto, stirred sufficiently, and then bis(tri-tert-butylphosphine)palladium(0) (0.3 g, 0.6 mmol) was added. After the reaction for 8 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 20.1 g of Compound sub1-B-6. (Yield: 63%, MS: [M+H]⁺= 524)
Compound sub1-B-6 (15 g, 28.6 mmol) and Compound sub10 (4.9 g, 28.6 mmol) were added to THF (300 ml) under a nitrogen atmosphere, and the mixture was stirred and refluxed. Then, potassium carbonate (7.9 g, 57.3 mmol) was dissolved in water (24 ml), added thereto, stirred sufficiently, and then bis(tri-tert-butylphosphine)palladium(0) (0.1 g, 0.2 mmol) was added. After the reaction for 8 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 11.4 g of Compound 1-11. (Yield: 65%, MS: [M+H]⁺= 616) 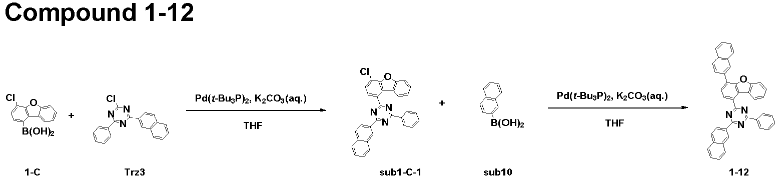
Compound 1-C (15 g, 60.9 mmol) and Compound Trz3 (19.3 g, 60.9 mmol) were added to THF (300 ml) under a nitrogen atmosphere, and the mixture was stirred and refluxed. Then, potassium carbonate (25.2 g, 182.6 mmol) was dissolved in water (76 ml), added thereto, stirred sufficiently, and then bis(tri-tert-butylphosphine)palladium(0) (0.3 g, 0.6 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 17.6 g of Compound sub1-C-1. (Yield: 60%, MS: [M+H]⁺= 484)
Compound sub1-C-1 (15 g, 31 mmol) and Compound sub10 (5.3 g, 31 mmol) were added to THF (300 ml) under a nitrogen atmosphere, and the mixture was stirred and refluxed. Then, potassium carbonate (8.6 g, 62 mmol) was dissolved in water (26 ml) , added thereto, stirred sufficiently, and then bis(tri-tert-butylphosphine)palladium(0) (0.2 g, 0.4 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.8 g of Compound 1-12. (Yield: 72%, MS: [M+H]⁺= 576) 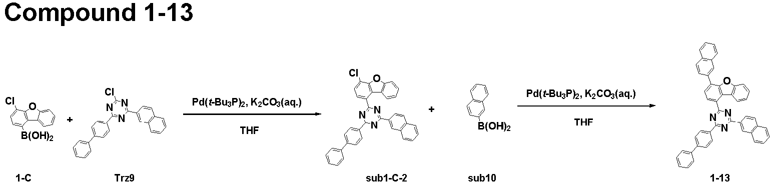
Compound 1-C (15 g, 60.9 mmol) and Compound Trz9 (24 g, 60.9 mmol) were added to THF (300 ml) under a nitrogen atmosphere, and the mixture was stirred and refluxed. Then, potassium carbonate (25.2 g, 182.6 mmol) was dissolved in water (76 ml), added thereto, stirred sufficiently, and then bis(tri-tert-butylphosphine)palladium(0) (0.3 g, 0.6 mmol) was added. After the reaction for 12 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 23.5 g of Compound sub1-C-2. (Yield: 69%, MS: [M+H]⁺= 560)
Compound sub1-C-2 (15 g, 26.8 mmol) and Compound sub10 (4.6 g, 26.8 mmol) were added to THF (300 ml) under a nitrogen atmosphere, and the mixture was stirred and refluxed. Then, potassium carbonate (7.4 g, 53.6 mmol) was dissolved in water (22 ml), added thereto, stirred sufficiently, and then bis(tri-tert-butylphosphine)palladium(0) (0.1 g, 0.2 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 14 g of Compound 1-13. (Yield: 80%, MS: [M+H]⁺= 652) 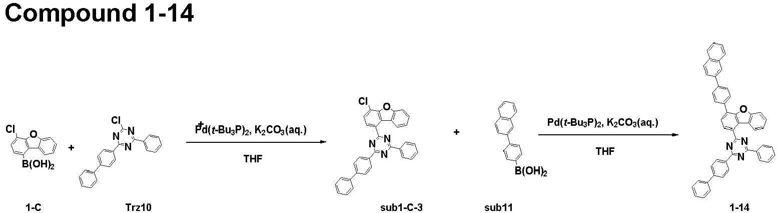
Compound 1-C (15 g, 60.9 mmol) and Compound Trz10 (20.9 g, 60.9 mmol) were added to THF (300 ml) under a nitrogen atmosphere, and the mixture was stirred and refluxed. Then, potassium carbonate (25.2 g, 182.6 mmol) was dissolved in water (76 ml), added thereto, stirred sufficiently, and then bis(tri-tert-butylphosphine)palladium(0) (0.3 g, 0.6 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 20.5 g of Compound sub1-C-3. (Yield: 66%, MS: [M+H]⁺= 510)
Compound sub1-C-3 (15 g, 29.4 mmol) and Compound sub11 (7.3 g, 29.4 mmol) were added to THF (300 ml) under a nitrogen atmosphere, and the mixture was stirred and refluxed. Then, potassium carbonate (8.1 g, 58.8 mmol) was dissolved in water (24 ml), added thereto, stirred sufficiently, and then bis(tri-tert-butylphosphine)palladium(0) (0.2 g, 0.4 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 15.3 g of Compound 1-14. (Yield: 77%, MS: [M+H]⁺= 678) 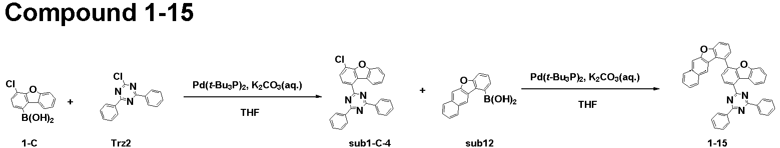
Compound 1-C (15 g, 60.9 mmol) and Compound Trz2 (16.3 g, 60.9 mmol) were added to THF (300 ml) under a nitrogen atmosphere, and the mixture was stirred and refluxed. Then, potassium carbonate (25.2 g, 182.6 mmol) was dissolved in water (76 ml), added thereto, stirred sufficiently, and then bis(tri-tert-butylphosphine)palladium(0) (0.3 g, 0.6 mmol) was added. After the reaction for 9 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 18.7 g of Compound sub1-C-4. (Yield: 71%, MS: [M+H]⁺= 434)
Compound sub1-C-4 (15 g, 37.1 mmol) and Compound sub12 (9.7 g, 37.1 mmol) were added to THF (300 ml) under a nitrogen atmosphere, and the mixture was stirred and refluxed. Then, potassium carbonate (10.3 g, 74.3 mmol) was dissolved in water (31 ml), added thereto, stirred sufficiently, and then bis(tri-tert-butylphosphine)palladium(0) (0.2 g, 0.4 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 14.6 g of Compound 1-15. (Yield: 64%, MS: [M+H]⁺= 616) 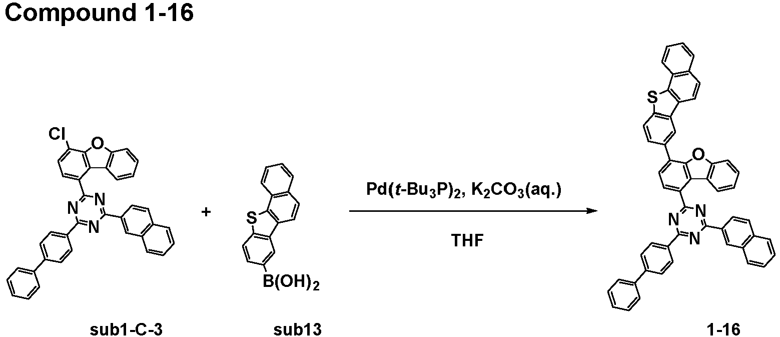
Compound sub1-C-3 (15 g, 26.8 mmol) and Compound sub13 (7.4 g, 26.8 mmol) were added to THF (300 ml) under a nitrogen atmosphere, and the mixture was stirred and refluxed. Then, potassium carbonate (7.4 g, 53.6 mmol) was dissolved in water (22 ml), added thereto, stirred sufficiently, and then bis(tri-tert-butylphosphine)palladium(0) (0.1 g, 0.2 mmol) was added. After the reaction for 9 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 16.2 g of Compound 1-16. (Yield: 80%, MS: [M+H]⁺= 758) 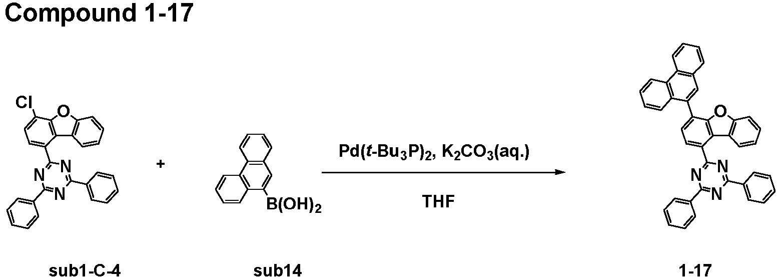
Compound sub1-C-4 (15 g, 34.6 mmol) and Compound sub14 (7.7 g, 34.6 mmol) were added to THF (300 ml) under a nitrogen atmosphere, and the mixture was stirred and refluxed. Then, potassium carbonate (9.6 g, 69.1 mmol) was dissolved in water (29 ml), added thereto, stirred sufficiently, and then bis(tri-tert-butylphosphine)palladium(0) (0.2 g, 0.4 mmol) was added. After the reaction for 8 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.3 g of Compound 1-17. (Yield: 62%, MS: [M+H]⁺= 576) 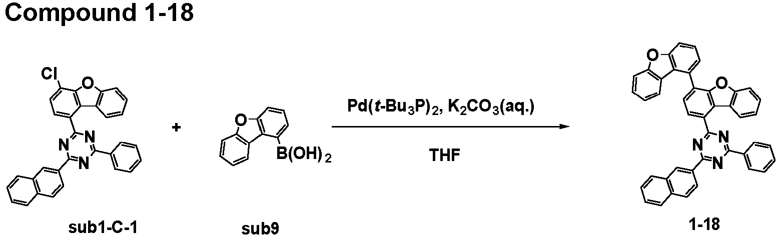
Compound sub1-C-1 (15 g, 31 mmol) and Compound sub9 (6.6 g, 31 mmol) were added to THF (300 ml) under a nitrogen atmosphere, and the mixture was stirred and refluxed. Then, potassium carbonate (8.6 g, 62 mmol) was dissolved in water (26 ml), added thereto, stirred sufficiently, and then bis(tri-tert-butylphosphine)palladium(0) (0.2 g, 0.4 mmol) was added. After the reaction for 9 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12 g of Compound 1-18. (Yield: 63%, MS: [M+H]⁺= 616) 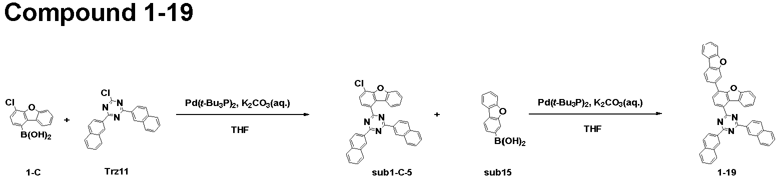
Compound 1-C (15 g, 60.9 mmol) and Compound Trz11 (22.4 g, 60.9 mmol) were added to THF (300 ml) under a nitrogen atmosphere, and the mixture was stirred and refluxed. Then, potassium carbonate (25.2 g, 182.6 mmol) was dissolved in water (76 ml), added thereto, stirred sufficiently, and then bis(tri-tert-butylphosphine)palladium(0) (0.3 g, 0.6 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 22.4 g of Compound sub1-C-5. (Yield: 69%, MS: [M+H]⁺= 534)
Compound sub1-C-5 (15 g, 28.1 mmol) and Compound sub15 (6 g, 28.1 mmol) were added to THF (300 ml) under a nitrogen atmosphere, and the mixture was stirred and refluxed. Then, potassium carbonate (7.8 g, 56.2 mmol) was dissolved in water (23 ml), added thereto, stirred sufficiently, and then bis(tri-tert-butylphosphine)palladium(0) (0.1 g, 0.2 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 13.3 g of Compound 1-19. (Yield: 71%, MS: [M+H]⁺= 666) 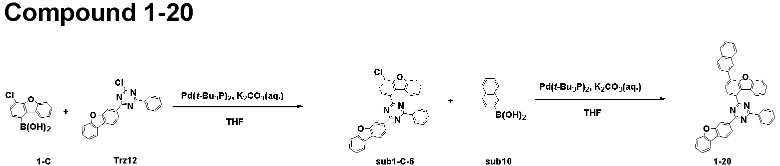
Compound 1-C (15 g, 60.9 mmol) and Compound Trz12 (21.8 g, 60.9 mmol) were added to THF (300 ml) under a nitrogen atmosphere, and the mixture was stirred and refluxed. Then, potassium carbonate (25.2 g, 182.6 mmol) was dissolved in water (76 ml) , added thereto, stirred sufficiently, and then bis(tri-tert-butylphosphine)palladium(0) (0.3 g, 0.6 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 21 g of Compound sub1-C-6. (Yield: 66%, MS: [M+H]⁺= 524)
Compound sub1-C-6 (15 g, 28.6 mmol) and Compound sub10 (4.9 g, 28.6 mmol) were added to THF (300 ml) under a nitrogen atmosphere, and the mixture was stirred and refluxed. Then, potassium carbonate (11.9 g, 85.9 mmol) was dissolved in water (36 ml), added thereto, stirred sufficiently, and then bis(tri-tert-butylphosphine)palladium(0) (0.1 g, 0.2 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.3 g of Compound 1-20. (Yield: 70%, MS: [M+H]⁺= 616) 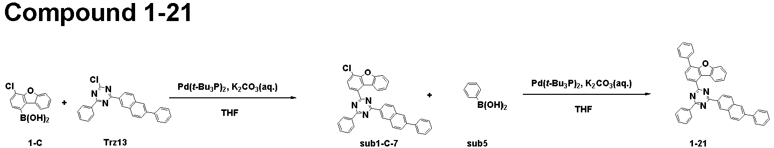
Compound 1-C (15 g, 60.9 mmol) and Compound Trz13 (24 g, 60.9 mmol) were added to THF (300 ml) under a nitrogen atmosphere, and the mixture was stirred and refluxed. Then, potassium carbonate (25.2 g, 182.6 mmol) was dissolved in water (76 ml), added thereto, stirred sufficiently, and then bis(tri-tert-butylphosphine)palladium(0)(0.3 g, 0.6 mmol) was added. After the reaction for 12 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 26.2 g of Compound sub1-C-7. (Yield: 77%, MS: [M+H]⁺= 560)
Compound sub1-C-7 (15 g, 26.8 mmol) and Compound sub5 (3.3 g, 26.8 mmol) were added to THF (300 ml) under a nitrogen atmosphere, and the mixture was stirred and refluxed. Then, potassium carbonate (11.1 g, 80.3 mmol) was dissolved in water (33 ml), added thereto, stirred sufficiently, and then bis(tri-tert-butylphosphine)palladium(0) (0.1 g, 0.2 mmol) was added. After the reaction for 8 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 10.5 g of Compound 1-21. (Yield: 65%, MS: [M+H]⁺= 602) 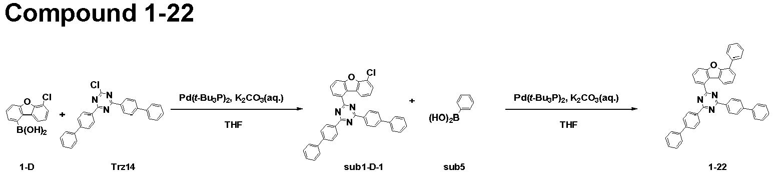
Compound 1-D (15 g, 60.9 mmol) and Compound Trz14 (19.3 g, 60.9 mmol) were added to THF (300 ml) under a nitrogen atmosphere, and the mixture was stirred and refluxed. Then, potassium carbonate (25.2 g, 182.6 mmol) was dissolved in water (76 ml), added thereto, stirred sufficiently, and then bis(tri-tert-butylphosphine)palladium(0) (0.3 g, 0.6 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 23.9 g of Compound sub1-D-1. (Yield: 67%, MS: [M+H]⁺= 586)
Compound sub1-D-1 (15 g, 25.6 mmol) and Compound sub5 (3.1 g, 25.6 mmol) were added to THF (300 ml) under a nitrogen atmosphere, and the mixture was stirred and refluxed. Then, potassium carbonate (10.6 g, 76.8 mmol) was dissolved in water (32 ml), added thereto, stirred sufficiently, and then bis(tri-tert-butylphosphine)palladium(0) (0.1 g, 0.2 mmol) was added. After the reaction for 8 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 10.3 g of Compound 1-22. (Yield: 64%, MS: [M+H]⁺= 628) 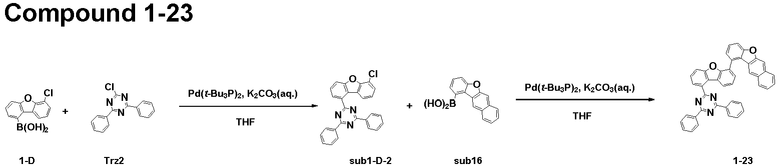
Compound 1-D (15 g, 60.9 mmol) and Compound Trz2 (16.3 g, 60.9 mmol) were added to THF (300 ml) under a nitrogen atmosphere, and the mixture was stirred and refluxed. Then, potassium carbonate (25.2 g, 182.6 mmol) was dissolved in water (76 ml), added thereto, stirred sufficiently, and then bis(tri-tert-butylphosphine)palladium(0) (0.3 g, 0.6 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 20 g of Compound sub1-D-2. (Yield: 76%, MS: [M+H]⁺= 434)
Compound sub1-D-2 (15 g, 34.6 mmol) and Compound sub16 (9.1 g, 34.6 mmol) were added to THF (300 ml) under a nitrogen atmosphere, and the mixture was stirred and refluxed. Then, potassium carbonate (14.3 g, 103.7 mmol) was dissolved in water (43 ml), added thereto, stirred sufficiently, and then bis(tri-tert-butylphosphine)palladium(0) (0.2 g, 0.4 mmol) was added. After the reaction for 9 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 14 g of Compound 1-23. (Yield: 66%, MS: [M+H]⁺= 616) 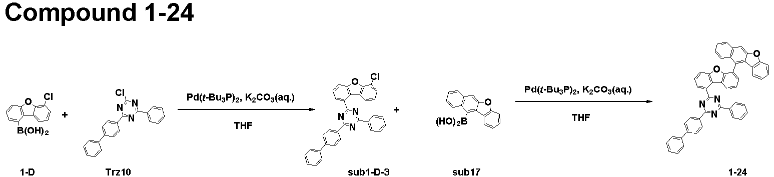
Compound 1-D (15 g, 60.9 mmol) and Compound Trz10 (20.9 g, 60.9 mmol) were added to THF (300 ml) under a nitrogen atmosphere, and the mixture was stirred and refluxed. Then, potassium carbonate (25.2 g, 182.6 mmol) was dissolved in water (76 ml), added thereto, stirred sufficiently, and then bis(tri-tert-butylphosphine)palladium(0) (0.3 g, 0.6 mmol) was added. After the reaction for 12 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 20.8 g of Compound sub1-D-3. (Yield: 67%, MS: [M+H]⁺= 510)
Compound sub1-D-3 (15 g, 29.4 mmol) and Compound sub17 (7.7 g, 29.4 mmol) were added to THF (300 ml) under a nitrogen atmosphere, and the mixture was stirred and refluxed. Then, potassium carbonate (12.2 g, 88.2 mmol) was dissolved in water (37 ml), added thereto, stirred sufficiently, and then bis(tri-tert-butylphosphine)palladium(0) (0.2 g, 0.4 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.4 g of Compound 1-24. (Yield: 61%, MS: [M+H]⁺= 692) 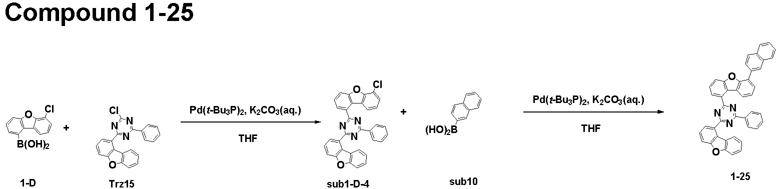
Compound 1-D (15 g, 60.9 mmol) and Compound Trz15 (21.8 g, 60.9 mmol) were added to THF (300 ml) under a nitrogen atmosphere, and the mixture was stirred and refluxed. Then, potassium carbonate (25.2 g, 182.6 mmol) was dissolved in water (76 ml), added thereto, stirred sufficiently, and then bis(tri-tert-butylphosphine)palladium(0) (0.3 g, 0.6 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 21.3 g of Compound sub1-D-4. (Yield: 67%, MS: [M+H]⁺= 524)
Compound sub1-D-4 (15 g, 28.6 mmol) and Compound sub10 (4.9 g, 28.6 mmol) were added to THF (300 ml) under a nitrogen atmosphere, and the mixture was stirred and refluxed. Then, potassium carbonate (11.9 g, 85.9 mmol) was dissolved in water (36 ml), added thereto, stirred sufficiently, and then bis(tri-tert-butylphosphine)palladium(0) (0.1 g, 0.2 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 10.7 g of Compound 1-25. (Yield: 61%, MS: [M+H]⁺= 616) 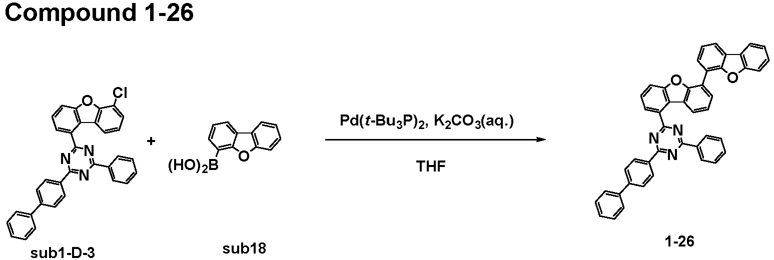
Compound sub1-D-3 (15 g, 29.4 mmol) and Compound sub18 (6.2 g, 29.4 mmol) were added to **THF** (300 ml) under a nitrogen atmosphere, and the mixture was stirred and refluxed. Then, potassium carbonate (12.2 g, 88.2 mmol) was dissolved in water (37 ml), added thereto, stirred sufficiently, and then bis(tri-tert-butylphosphine)palladium(0) (0.2 g, 0.4 mmol) was added. After the reaction for 9 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 14.3 g of Compound 1-26. (Yield: 76%, MS: [M+H]⁺= 642) 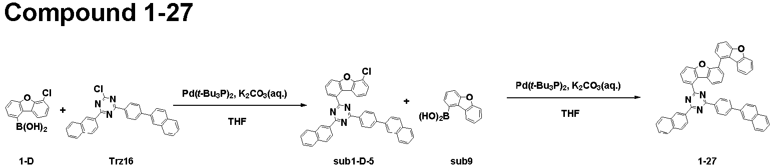
Compound 1-D (15 g, 60.9 mmol) and Compound Trz16 (27 g, 60.9 mmol) were added to THF (300 ml) under a nitrogen atmosphere, and the mixture was stirred and refluxed. Then, potassium carbonate (25.2 g, 182.6 mmol) was dissolved in water (76 ml), added thereto, stirred sufficiently, and then bis(tri-tert-butylphosphine)palladium(0) (0.3 g, 0.6 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 27.1 g of Compound sub1-D-5. (Yield: 73%, MS: [M+H]⁺= 610)
Compound sub1-D-5 (15 g, 24.6 mmol) and Compound sub9 (5.2 g, 24.6 mmol) were added to THF (300 ml) under a nitrogen atmosphere, and the mixture was stirred and refluxed. Then, potassium carbonate (10.2 g, 73.8 mmol) was dissolved in water (31 ml), added thereto, stirred sufficiently, and then bis(tri-tert-butylphosphine)palladium(0) (0.1 g, 0.2 mmol) was added. After the reaction for 9 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.8 g of Compound 1-27. (Yield: 70%, MS: [M+H]⁺= 742) 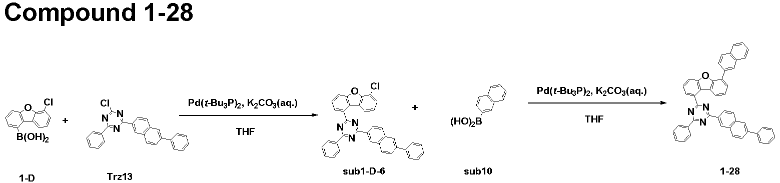
Compound 1-D (15 g, 60.9 mmol) and Compound Trz13 (24 g, 60.9 mmol) were added to THF (300 ml) under a nitrogen atmosphere, and the mixture was stirred and refluxed. Then, potassium carbonate (25.2 g, 182.6 mmol) was dissolved in water (76 ml), added thereto, stirred sufficiently, and then bis(tri-tert-butylphosphine)palladium(0) (0.3 g, 0.6 mmol) was added. After the reaction for 9 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 20.8 g of Compound sub1-D-6. (Yield: 61%, MS: [M+H]⁺= 560)
Compound sub1-D-6 (15 g, 26.8 mmol) and Compound sub10 (4.6 g, 26.8 mmol) were added to THF (300 ml) under a nitrogen atmosphere, and the mixture was stirred and refluxed. Then, potassium carbonate (11.1 g, 80.3 mmol) was dissolved in water (33 ml), added thereto, stirred sufficiently, and then bis(tri-tert-butylphosphine)palladium(0) (0.1 g, 0.2 mmol) was added. After the reaction for 9 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.2 g of Compound 1-28. (Yield: 70%, MS: [M+H]⁺= 652) 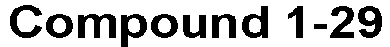 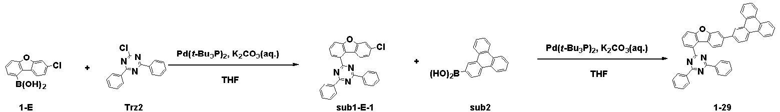
Compound 1-E (15 g, 60.9 mmol) and Compound Trz2 (16.3 g, 60.9 mmol) were added to THF (300 ml) under a nitrogen atmosphere, and the mixture was stirred and refluxed. Then, potassium carbonate (25.2 g, 182.6 mmol) was dissolved in water (76 ml), added thereto, stirred sufficiently, and then bis(tri-tert-butylphosphine)palladium(0) (0.3 g, 0.6 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 17.1 g of Compound sub1-E-1. (Yield: 65%, MS: [M+H]⁺= 434)
Compound sub1-E-1 (15 g, 34.6 mmol) and Compound sub2 (9.4 g, 34.6 mmol) were added to THF (300 ml) under a nitrogen atmosphere, and the mixture was stirred and refluxed. Then, potassium carbonate (14.3 g, 103.7 mmol) was dissolved in water (43 ml), added thereto, stirred sufficiently, and then bis(tri-tert-butylphosphine)palladium(0) (0.2 g, 0.4 mmol) was added. After the reaction for 8 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 14.5 g of Compound 1-29. (Yield: 67%, MS: [M+H]⁺= 626) 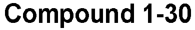 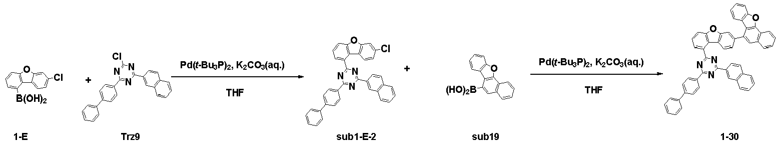
Compound 1-E (15 g, 60.9 mmol) and Compound Trz9 (24 g, 60.9 mmol) were added to THF (300 ml) under a nitrogen atmosphere, and the mixture was stirred and refluxed. Then, potassium carbonate (25.2 g, 182.6 mmol) was dissolved in water (76 ml), added thereto, stirred sufficiently, and then bis(tri-tert-butylphosphine)palladium(0) (0.3 g, 0.6 mmol) was added. After the reaction for 8 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 26.9 g of Compound sub1-E-2. (Yield: 79%, MS: [M+H]⁺= 560)
Compound sub1-E-2 (15 g, 26.8 mmol) and Compound sub19 (7 g, 26.8 mmol) were added to THF (300 ml) under a nitrogen atmosphere, and the mixture was stirred and refluxed. Then, potassium carbonate (11.1 g, 80.3 mmol) was dissolved in water (33 ml), added thereto, stirred sufficiently, and then bis(tri-tert-butylphosphine)palladium(0) (0.1 g, 0.2 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 15.9 g of Compound 1-30. (Yield: 80%, MS: [M+H]⁺= 742) 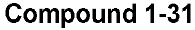 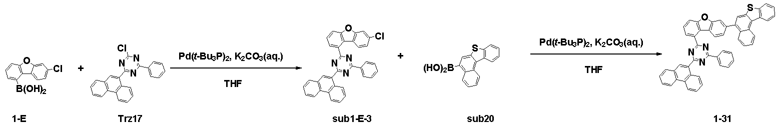
Compound 1-E (15 g, 60.9 mmol) and Compound Trz17 (22.4 g, 60.9 mmol) were added to THF (300 ml) under a nitrogen atmosphere, and the mixture was stirred and refluxed. Then, potassium carbonate (25.2 g, 182.6 mmol) was dissolved in water (76 ml), added thereto, stirred sufficiently, and then bis(tri-tert-butylphosphine)palladium(0) (0.3 g, 0.6 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 25.3 g of Compound sub1-E-3. (Yield: 78%, MS: [M+H]⁺= 534)
Compound sub1-E-3 (15 g, 28.1 mmol) and Compound sub20 (7.8 g, 28.1 mmol) were added to THF (300 ml) under a nitrogen atmosphere, and the mixture was stirred and refluxed. Then, potassium carbonate (11.6 g, 84.3 mmol) was dissolved in water (35 ml), added thereto, stirred sufficiently, and then bis(tri-tert-butylphosphine)palladium(0) (0.1 g, 0.2 mmol) was added. After the reaction for 9 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 14.8 g of Compound 1-31. (Yield: 72%, MS: [M+H]⁺= 732) 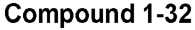 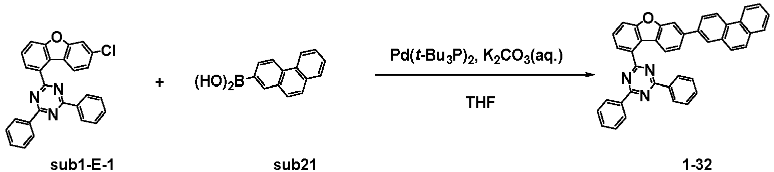
Compound sub1-E-1 (15 g, 34.6 mmol) and Compound sub21 (7.7 g, 34.6 mmol) were added to THF (300 ml) under a nitrogen atmosphere, and the mixture was stirred and refluxed. Then, potassium carbonate (14.3 g, 103.7 mmol) was dissolved in water (43 ml), added thereto, stirred sufficiently, and then bis(tri-tert-butylphosphine)palladium(0) (0.2 g, 0.4 mmol) was added. After the reaction for 9 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.9 g of Compound 1-32. (Yield: 65%, MS: [M+H]⁺= 576) 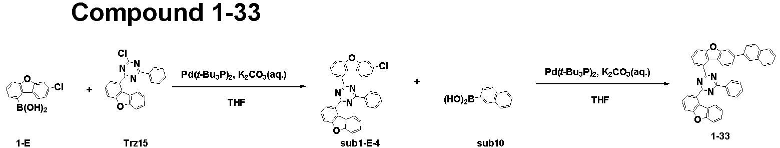
Compound 1-E (15 g, 60.9 mmol) and Compound Trz15 (21.8 g, 60.9 mmol) were added to THF (300 ml) under a nitrogen atmosphere, and the mixture was stirred and refluxed. Then, potassium carbonate (25.2 g, 182.6 mmol) was dissolved in water (76 ml), added thereto, stirred sufficiently, and then bis(tri-tert-butylphosphine)palladium(0)(0.3 g, 0.6 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 25.5 g of Compound sub1-E-4. (Yield: 80%, MS: [M+H]⁺= 524)
Compound sub1-E-4 (15 g, 28.6 mmol) and Compound sub10 (4.9 g, 28.6 mmol) were added to THF (300 ml) under a nitrogen atmosphere, and the mixture was stirred and refluxed. Then, potassium carbonate (11.9 g, 85.9 mmol) was dissolved in water (36 ml), added thereto, stirred sufficiently, and then bis(tri-tert-butylphosphine)palladium(0) (0.1 g, 0.2 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 10.6 g of Compound 1-33. (Yield: 60%, MS: [M+H]⁺= 616) 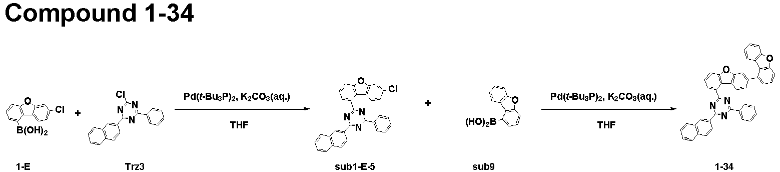
Compound 1-E (15 g, 60.9 mmol) and Compound Trz3 (19.3 g, 60.9 mmol) were added to THF (300 ml) under a nitrogen atmosphere, and the mixture was stirred and refluxed. Then, potassium carbonate (25.2 g, 182.6 mmol) was dissolved in water (76 ml), added thereto, stirred sufficiently, and then bis(tri-tert-butylphosphine)palladium(0) (0.3 g, 0.6 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 17.6 g of Compound sub1-E-5. (Yield: 60%, MS: [M+H]⁺= 484)
Compound sub1-E-5 (15 g, 31 mmol) and Compound sub9 (6.6 g, 31 mmol) were added to THF (300 ml) under a nitrogen atmosphere, and the mixture was stirred and refluxed. Then, potassium carbonate (12.9 g, 93 mmol) was dissolved in water (39 ml), added thereto, stirred sufficiently, and then bis(tri-tert-butylphosphine)palladium(0) (0.2 g, 0.4 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 11.4 g of Compound 1-34. (Yield: 60%, MS: [M+H]⁺= 616) 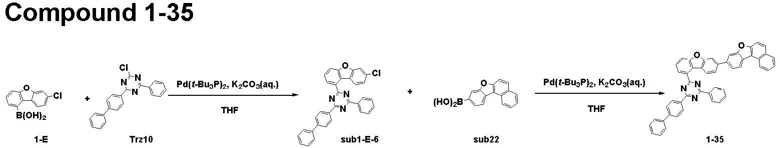
Compound 1-E (15 g, 60.9 mmol) and Compound Trz10 (20.9 g, 60.9 mmol) were added to THF (300 ml) under a nitrogen atmosphere, and the mixture was stirred and refluxed. Then, potassium carbonate (25.2 g, 182.6 mmol) was dissolved in water (76 ml), added thereto, stirred sufficiently, and then bis(tri-tert-butylphosphine)palladium(0) (0.3 g, 0.6 mmol) was added. After the reaction for 8 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 21.7 g of Compound sub1-E-6. (Yield: 70%, MS: [M+H]⁺= 510)
Compound sub1-E-6 (15 g, 29.4 mmol) and Compound sub22 (7.7 g, 29.4 mmol) were added to THF (300 ml) under a nitrogen atmosphere, and the mixture was stirred and refluxed. Then, potassium carbonate (12.2 g, 88.2 mmol) was dissolved in water (37 ml), added thereto, stirred sufficiently, and then bis(tri-tert-butylphosphine)palladium(0) (0.2 g, 0.4 mmol) was added. After the reaction for 9 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 14.6 g of Compound 1-35. (Yield: 72%, MS: [M+H]⁺= 692) 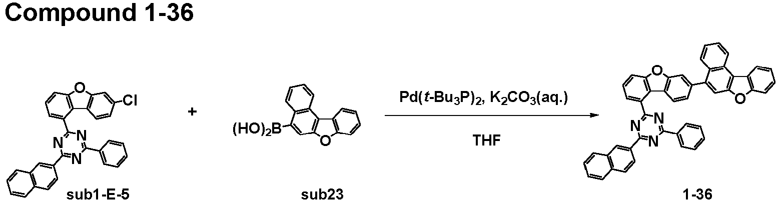
Compound sub1-E-5 (15 g, 31 mmol) and Compound sub23(8.1 g, 31 mmol) were added to THF (300 ml) under a nitrogen atmosphere, and the mixture was stirred and refluxed. Then, potassium carbonate (12.9 g, 93 mmol) was dissolved in water (39 ml), added thereto, stirred sufficiently, and then bis(tri-tert-butylphosphine)palladium(0) (0.2 g, 0.4 mmol) was added. After the reaction for 12 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.4 g of Compound 1-36. (Yield: 60%, MS: [M+H]⁺= 666) 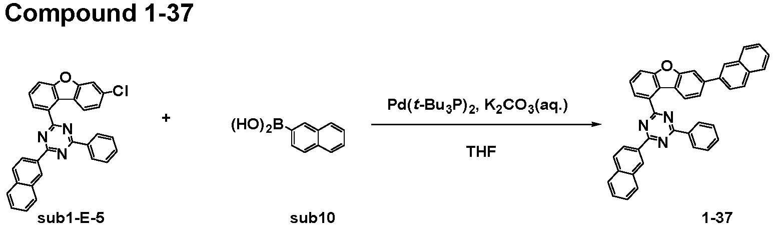
Compound sub1-E-5 (15 g, 31 mmol) and Compound sub10 (5.3 g, 31 mmol) were added to THF (300 ml) under a nitrogen atmosphere, and the mixture was stirred and refluxed. Then, potassium carbonate (12.9 g, 93 mmol) was dissolved in water (39 ml), added thereto, stirred sufficiently, and then bis(tri-tert-butylphosphine)palladium(0) (0.2 g, 0.4 mmol) was added. After the reaction for 12 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 14.1 g of Compound 1-37. (Yield: 79%, MS: [M+H]⁺= 576) 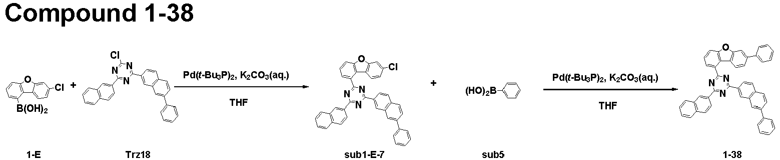
Compound 1-E (15 g, 60.9 mmol) and Compound Trz18 (27 g, 60.9 mmol) were added to THF (300 ml) under a nitrogen atmosphere, and the mixture was stirred and refluxed. Then, potassium carbonate (25.2 g, 182.6 mmol) was dissolved in water (76 ml), added thereto, stirred sufficiently, and then bis(tri-tert-butylphosphine)palladium(0) (0.3 g, 0.6 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 24.1 g of Compound sub1-E-7. (Yield: 65%, MS: [M+H]⁺= 610)
Compound sub1-E-7 (15 g, 24.6 mmol) and Compound sub5 (3 g, 24.6 mmol) were added to THF (300 ml) under a nitrogen atmosphere, and the mixture was stirred and refluxed. Then, potassium carbonate(10.2 g, 73.8 mmol) was dissolved in water (31 ml), added thereto, stirred sufficiently, and then bis(tri-tert-butylphosphine)palladium(0) (0.1 g, 0.2 mmol) was added. After the reaction for 9 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 10.1 g of Compound 1-38. (Yield: 63%, MS: [M+H]⁺= 652) 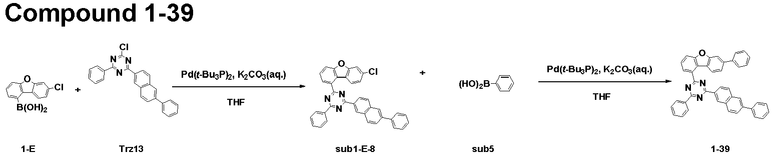
Compound 1-E (15 g, 60.9 mmol) and Compound Trz13 (24 g, 60.9 mmol) were added to THF (300 ml) under a nitrogen atmosphere, and the mixture was stirred and refluxed. Then, potassium carbonate (25.2 g, 182.6 mmol) was dissolved in water (76 ml), added thereto, stirred sufficiently, and then bis(tri-tert-butylphosphine)palladium(0) (0.3 g, 0.6 mmol) was added. After the reaction for 12 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 26.2 g of Compound sub1-E-8. (Yield: 77%, MS: [M+H]⁺= 560)
Compound sub1-E-8 (15 g, 26.8 mmol) and Compound sub5 (3.3 g, 26.8 mmol) were added to THF (300 ml) under a nitrogen atmosphere, and the mixture was stirred and refluxed. Then, potassium carbonate (11.1 g, 80.3 mmol) was dissolved in water (33 ml), added thereto, stirred sufficiently, and then bis(tri-tert-butylphosphine)palladium(0) (0.1 g, 0.2 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 10.9 g of Compound 1-39. (Yield: 68%, MS: [M+H]⁺= 602) 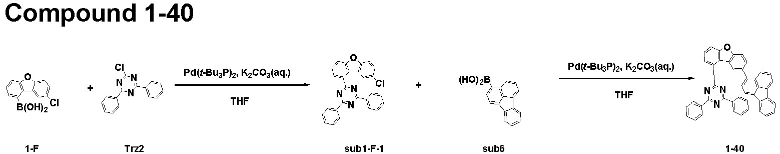
Compound 1-F (15 g, 60.9 mmol) and Compound Trz2 (16.3 g, 60.9 mmol) were added to THF (300 ml) under a nitrogen atmosphere, and the mixture was stirred and refluxed. Then, potassium carbonate (25.2 g, 182.6 mmol) was dissolved in water (76 ml), added thereto, stirred sufficiently, and then bis(tri-tert-butylphosphine)palladium(0) (0.3 g, 0.6 mmol) was added. After the reaction for 12 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 19.2 g of Compound sub1-F-1. (Yield: 73%, MS: [M+H]⁺= 434)
Compound 1-F (15 g, 34.6 mmol) and Compound sub6 (8.5 g, 34.6 mmol) were added to THF (300 ml) under a nitrogen atmosphere, and the mixture was stirred and refluxed. Then, potassium carbonate (14.3 g, 103.7 mmol) was dissolved in water (43 ml), added thereto, stirred sufficiently, and then bis(tri-tert-butylphosphine)palladium(0) (0.2 g, 0.4 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 14.7 g of Compound 1-40 . (Yield: 71%, MS: [M+H]⁺= 600) 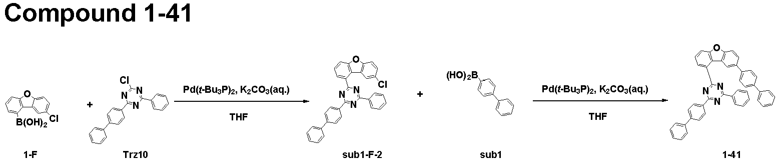
Compound 1-F (15 g, 60.9 mmol) and Compound Trz10(20.9 g, 60.9 mmol) were added to THF (300 ml) under a nitrogen atmosphere, and the mixture was stirred and refluxed. Then, potassium carbonate (25.2 g, 182.6 mmol) was dissolved in water (76 ml), added thereto, stirred sufficiently, and then bis(tri-tert-butylphosphine)palladium(0) (0.3 g, 0.6 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 21.1 g of Compound sub1-F-2. (Yield: 68%, MS: [M+H]⁺= 510)
Compound sub1-F-2 (15 g, 29.4 mmol) and Compound sub1 (5.8 g, 29.4 mmol) were added to THF (300 ml) under a nitrogen atmosphere, and the mixture was stirred and refluxed. Then, potassium carbonate (12.2 g, 88.2 mmol) was dissolved in water (37 ml), added thereto, stirred sufficiently, and then bis(tri-tert-butylphosphine)palladium(0) (0.2 g, 0.4 mmol) was added. After the reaction for 12 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 14.2 g of Compound 1-41. (Yield: 77%, MS: [M+H]⁺= 628) 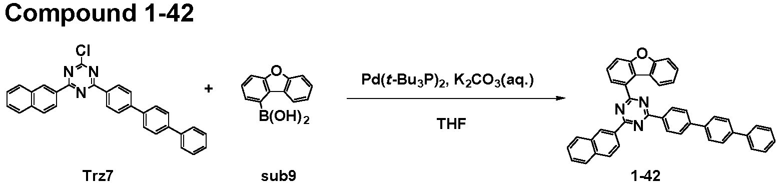
Compound Trz7 (15 g, 31.9 mmol) and Compound sub9 (6.8 g, 31.9 mmol) were added to THF (300 ml) under a nitrogen atmosphere, and the mixture was stirred and refluxed. Then, potassium carbonate (13.2 g, 95.8 mmol) was dissolved in water (40 ml), added thereto, stirred sufficiently, and then bis(tri-tert-butylphosphine)palladium(0) (0.2 g, 0.4 mmol) was added. After the reaction for 9 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 15.2 g of Compound 1-42. (Yield: 79%, MS: [M+H]⁺= 602) 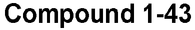 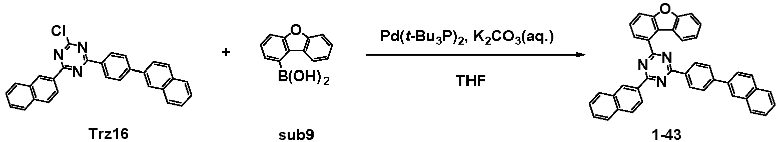
Compound Trz16 (15 g, 33.8 mmol) and Compound sub9 (7.2 g, 33.8 mmol) were added to THF (300 ml) under a nitrogen atmosphere, and the mixture was stirred and refluxed. Then, potassium carbonate (14 g, 101.4 mmol) was dissolved in water (42 ml), added thereto, stirred sufficiently, and then bis(tri-tert-butylphosphine)palladium(0) (0.2 g, 0.4 mmol) was added. After the reaction for 12 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 15 g of Compound 1-43. (Yield: 77%, MS: [M+H]⁺= 576) 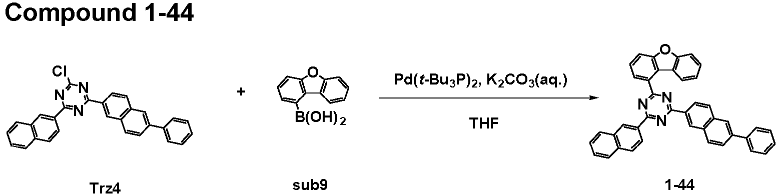
Compound Trz4 (15 g, 33.8 mmol) and Compound sub9 (7.2 g, 33.8 mmol) were added to THF (300 ml) under a nitrogen atmosphere, and the mixture was stirred and refluxed. Then, potassium carbonate (14 g, 101.4 mmol) was dissolved in water(42 ml), added thereto, stirred sufficiently, and then bis(tri-tert-butylphosphine)palladium(0) (0.2 g, 0.4 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 14.2 g of Compound 1-44. (Yield: 73%, MS: [M+H]⁺= 576) 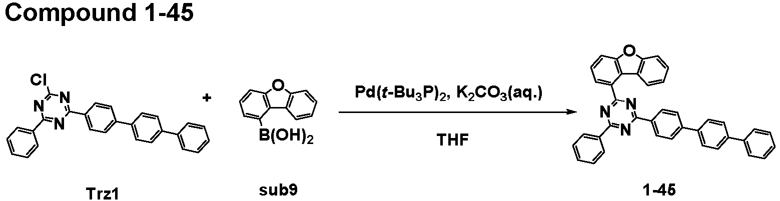
Compound Trz1 (15 g, 35.7 mmol) and Compound sub9 (7.6 g, 35.7 mmol) were added to THF (300 ml) under a nitrogen atmosphere, and the mixture was stirred and refluxed. Then, potassium carbonate (14.8 g, 107.2 mmol) was dissolved in water (44 ml), added thereto, stirred sufficiently, and then bis(tri-tert-butylphosphine)palladium(0) (0.2 g, 0.4 mmol) was added. After the reaction for 9 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.2 g of Compound 1-45. (Yield: 62%, MS: [M+H]⁺= 552) 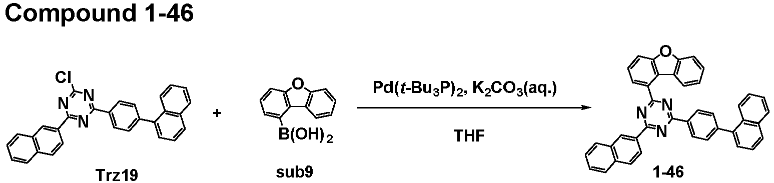
Compound Trz19 (15 g, 33.8 mmol) and Compound sub9 (7.2 g, 33.8 mmol) were added to THF (300 ml) under a nitrogen atmosphere, and the mixture was stirred and refluxed. Then, potassium carbonate (14 g, 101.4 mmol) was dissolved in water (42 ml), added thereto, stirred sufficiently, and then bis(tri-tert-butylphosphine)palladium(0) (0.2 g, 0.4 mmol) was added. After the reaction for 8 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 13.6 g of Compound 1-46. (Yield: 70%, MS: [M+H]⁺= 576) 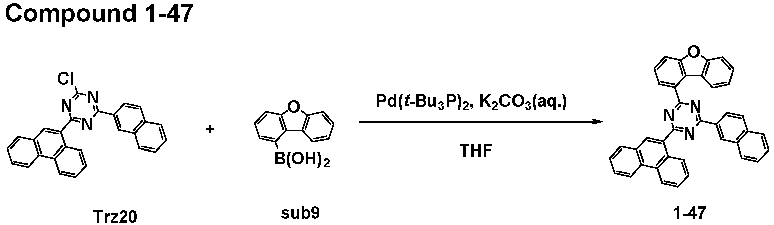
Compound Trz20 (15 g, 35.9 mmol) and Compound sub9 (7.6 g, 35.9 mmol) were added to THF (300 ml) under a nitrogen atmosphere, and the mixture was stirred and refluxed. Then, potassium carbonate (14.9 g, 107.7 mmol) was dissolved in water (45 ml), added thereto, stirred sufficiently, and then bis(tri-tert-butylphosphine)palladium(0) (0.2 g, 0.4 mmol) was added. After the reaction for 8 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 15 g of Compound 1-47. (Yield: 76%, MS: [M+H]⁺= 550) 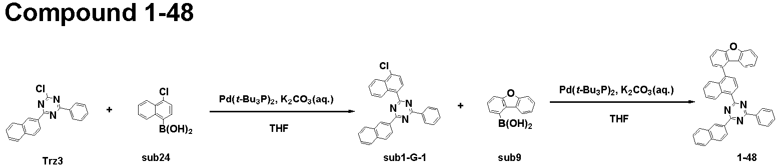
Compound Trz3 (15 g, 47.2 mmol) and Compound sub24 (9.7 g, 47.2 mmol) were added to THF (300 ml) under a nitrogen atmosphere, and the mixture was stirred and refluxed. Then, potassium carbonate (19.6 g, 141.6 mmol) was dissolved in water (59 ml), added thereto, stirred sufficiently, and then bis(tri-tert-butylphosphine)palladium(0) (0.2 g, 0.4 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 13 g of Compound sub1-G-1. (Yield: 62%, MS: [M+H]⁺= 444)
Compound sub1-G-1 (15 g, 33.8 mmol) and Compound sub9 (7.2 g, 33.8 mmol) were added to THF (300 ml) under a nitrogen atmosphere, and the mixture was stirred and refluxed. Then, potassium carbonate (14 g, 101.4 mmol) was dissolved in water (42 ml), added thereto, stirred sufficiently, and then bis(tri-tert-butylphosphine)palladium(0) (0.2 g, 0.4 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 15.2 g of Compound 1-48. (Yield: 78%, MS: [M+H]⁺= 576) 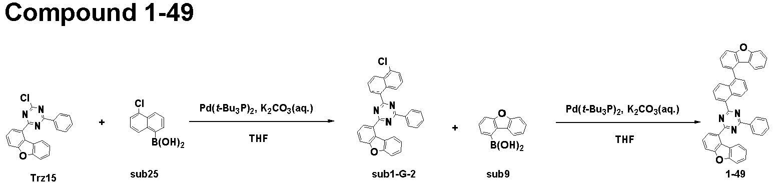
Compound Trz15 (15 g, 41.9 mmol) and Compound sub25 (8.7 g, 41.9 mmol) were added to THF (300 ml) under a nitrogen atmosphere, and the mixture was stirred and refluxed. Then, potassium carbonate (17.4 g, 125.8 mmol) was dissolved in water (52 ml), added thereto, stirred sufficiently, and then bis(tri-tert-butylphosphine)palladium(0) (0.2 g, 0.4 mmol) was added. After the reaction for 8 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.6 g of Compound sub1-G-2. (Yield: 62%, MS: [M+H]⁺= 484)
Compound sub1-G-2 (15 g, 31 mmol) and Compound sub9 (6.6 g, 31 mmol) were added to THF (300 ml) under a nitrogen atmosphere, and the mixture was stirred and refluxed. Then, potassium carbonate (12.9 g, 93 mmol) was dissolved in water (39 ml), added thereto, stirred sufficiently, and then bis(tri-tert-butylphosphine)palladium(0) (0.2 g, 0.4 mmol) was added. After the reaction for 8 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 13.7 g of Compound 1-49. (Yield: 72%, MS: [M+H]⁺= 616) 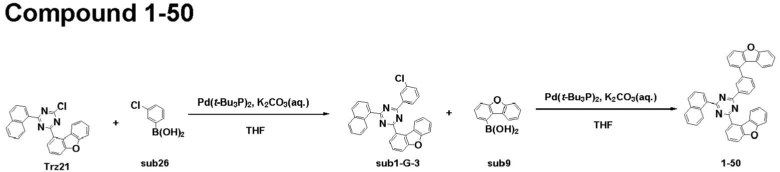
Compound Trz21 (15 g, 36.8 mmol) and Compound sub26 (5.8 g, 36.8 mmol) were added to THF (300 ml) under a nitrogen atmosphere, and the mixture was stirred and refluxed. Then, potassium carbonate (15.2 g, 110.3 mmol) was dissolved in water (46 ml), added thereto, stirred sufficiently, and then bis(tri-tert-butylphosphine)palladium(0) (0.2 g, 0.4 mmol) was added. After the reaction for 9 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.8 g of Compound sub1-G-3. (Yield: 72%, MS: [M+H]⁺= 484)
Compound sub1-G-3 (15 g, 31 mmol) and Compound sub9 (6.6 g, 31 mmol) were added to THF (300 ml) under a nitrogen atmosphere, and the mixture was stirred and refluxed. Then, potassium carbonate (12.9 g, 93 mmol) was dissolved in water (39 ml), added thereto, stirred sufficiently, and then bis(tri-tert-butylphosphine)palladium(0) (0.2 g, 0.4 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 13.2 g of Compound 1-50. (Yield: 69%, MS: [M+H]⁺= 616) 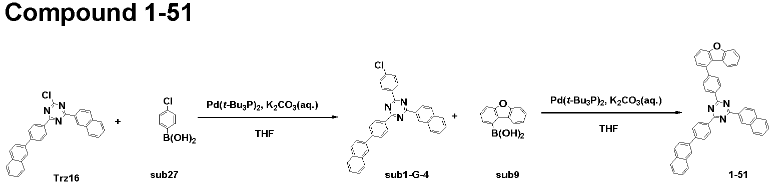
Compound Trz16 (15 g, 33.8 mmol) and Compound sub27 (5.3 g, 33.8 mmol) were added to THF (300 ml) under a nitrogen atmosphere, and the mixture was stirred and refluxed. Then, potassium carbonate (14 g, 101.4 mmol) was dissolved in water (42 ml), added thereto, stirred sufficiently, and then bis(tri-tert-butylphosphine)palladium(0) (0.2 g, 0.4 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 13.3 g of Compound sub1-G-4. (Yield: 76%, MS: [M+H]⁺= 520)
Compound sub1-G-4 (15 g, 28.8 mmol) and Compound sub9 (6.1 g, 28.8 mmol) were added to THF (300 ml) under a nitrogen atmosphere, and the mixture was stirred and refluxed. Then, potassium carbonate (12 g, 86.5 mmol) was dissolved in water (36 ml), added thereto, stirred sufficiently, and then bis(tri-tert-butylphosphine)palladium(0) (0.1 g, 0.2 mmol) was added. After the reaction for 9 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 13.3 g of Compound 1-51. (Yield: 71%, MS: [M+H]⁺= 652) 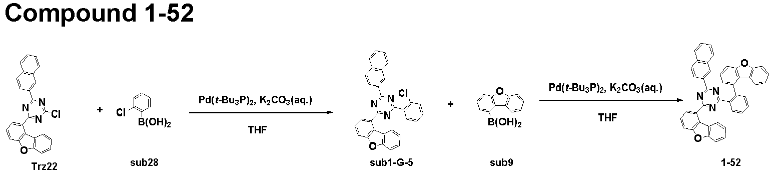
Compound Trz22 (15 g, 36.8 mmol) and Compound sub28 (5.8 g, 36.8 mmol) were added to THF (300 ml) under a nitrogen atmosphere, and the mixture was stirred and refluxed. Then, potassium carbonate (15.2 g, 110.3 mmol) was dissolved in water (46 ml), added thereto, stirred sufficiently, and then bis(tri-tert-butylphosphine)palladium(0) (0.2 g, 0.4 mmol) was added. After the reaction for 12 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.8 g of Compound sub1-G-5. (Yield: 72%, MS: [M+H]⁺= 484)
Compound sub1-G-5 (15 g, 31 mmol) and Compound sub9 (6.6 g, 31 mmol) were added to THF (300 ml) under a nitrogen atmosphere, and the mixture was stirred and refluxed. Then, potassium carbonate (12.9 g, 93 mmol) was dissolved in water (39 ml), added thereto, stirred sufficiently, and then bis(tri-tert-butylphosphine)palladium(0) (0.2 g, 0.4 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 13 g of Compound 1-52 . (Yield: 68%, MS: [M+H]⁺= 616) 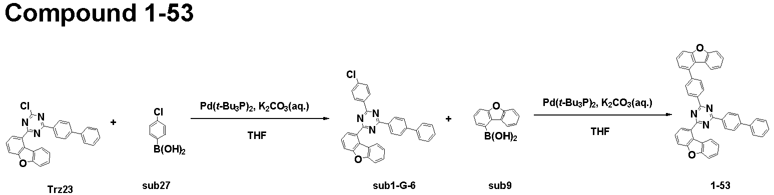
Compound Trz23 (15 g, 34.6 mmol) and Compound sub27 (5.4 g, 34.6 mmol) were added to THF (300 ml) under a nitrogen atmosphere, and the mixture was stirred and refluxed. Then, potassium carbonate (14.3 g, 103.7 mmol) was dissolved in water (43 ml), added thereto, stirred sufficiently, and then bis(tri-tert-butylphosphine)palladium(0) (0.2 g, 0.4 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 11.3 g of Compound sub1-G-6. (Yield: 64%, MS: [M+H]⁺= 510)
Compound sub1-G-5 (15 g, 31 mmol) and Compound sub9 (6.6 g, 31 mmol) were added to THF (300 ml) under a nitrogen atmosphere, and the mixture was stirred and refluxed. Then, potassium carbonate (12.9 g, 93 mmol) was dissolved in water (39 ml), added thereto, stirred sufficiently, and then bis(tri-tert-butylphosphine)palladium(0) (0.2 g, 0.4 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 13 g of Compound 1-53. (Yield: 68%, MS: [M+H]⁺= 616) 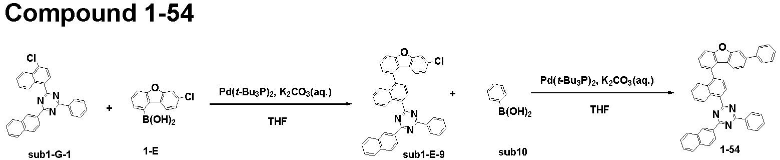
Compound sub1-G-1 (15 g, 33.8 mmol) and Compound 1-E (8.3 g, 33.8 mmol) were added to THF (300 ml) under a nitrogen atmosphere, and the mixture was stirred and refluxed. Then, potassium carbonate (14 g, 101.4 mmol) was dissolved in water (42 ml), added thereto, stirred sufficiently, and then bis(tri-tert-butylphosphine)palladium(0) (0.2 g, 0.4 mmol) was added. After the reaction for 8 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 14.4 g of Compound sub1-E-9. (Yield: 70%, MS: [M+H]⁺= 610)
Compound sub1-E-9 (15 g, 24.6 mmol) and Compound sub5 (3 g, 24.6 mmol) were added to THF (300 ml) under a nitrogen atmosphere, and the mixture was stirred and refluxed. Then, potassium carbonate (10.2 g, 73.8 mmol) was dissolved in water (31 ml), added thereto, stirred sufficiently, and then bis(tri-tert-butylphosphine)palladium(0) (0.1 g, 0.2 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.2 g of Compound 1-54. (Yield: 76%, MS: [M+H]⁺= 652) 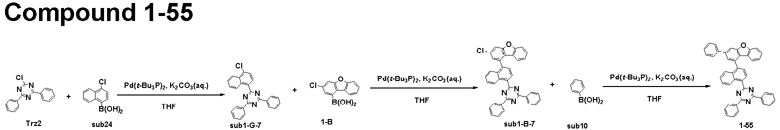
Compound Trz2 (15 g, 56 mmol) and Compound sub24 (11.6 g, 56 mmol) were added to THF (300 ml) under a nitrogen atmosphere, and the mixture was stirred and refluxed. Then, potassium carbonate (23.2 g, 168.1 mmol) was dissolved in water (70 ml), added thereto, stirred sufficiently, and then bis(tri-tert-butylphosphine)palladium(0) (0.3 g, 0.6 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 15.6 g of Compound sub1-G-7. (Yield: 71%, MS: [M+H]⁺= 394)
Compound sub1-G-7 (15 g, 38.1 mmol) and Compound 1-B (9.4 g, 38.1 mmol) were added to THF (300 ml) under a nitrogen atmosphere, and the mixture was stirred and refluxed. Then, potassium carbonate (15.8 g, 114.3 mmol) was dissolved in water (47 ml), added thereto, stirred sufficiently, and then bis(tri-tert-butylphosphine)palladium(0) (0.2 g, 0.4 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 13.8 g of Compound sub1-B-7. (Yield: 65%, MS: [M+H]⁺= 560)
Compound sub1-B-7 (15 g, 26.8 mmol) and Compound sub5 (3.3 g, 26.8 mmol) were added to THF (300 ml) under a nitrogen atmosphere, and the mixture was stirred and refluxed. Then, potassium carbonate (11.1 g, 80.3 mmol) was dissolved in water (33 ml), added thereto, stirred sufficiently, and then bis(tri-tert-butylphosphine)palladium(0) (0.1 g, 0.2 mmol) was added. After the reaction for 9 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.9 g of Compound 1-55. (Yield: 80%, MS: [M+H]⁺= 602) 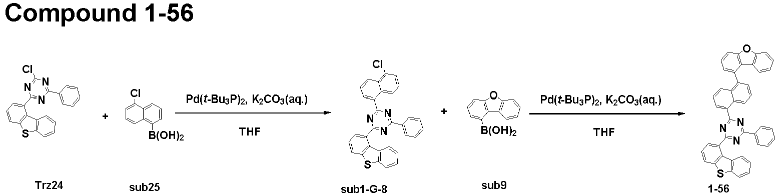
Compound Trz24 (15 g, 38.1 mmol) and Compound sub 25 (9.4 g, 38.1 mmol) were added to THF (300 ml) under a nitrogen atmosphere, and the mixture was stirred and refluxed. Then, potassium carbonate (15.8 g, 114.3 mmol) was dissolved in water (47 ml), added thereto, stirred sufficiently, and then bis(tri-tert-butylphosphine)palladium(0) (0.2 g, 0.4 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 13.8 g of Compound sub1-B-7. (Yield: 65%, MS: [M+H]⁺= 560)
Compound sub1-G-8 (15 g, 30 mmol) and Compound sub9 (6.4 g, 30 mmol) were added to THF (300 ml) under a nitrogen atmosphere, and the mixture was stirred and refluxed. Then, potassium carbonate (12.4 g, 90 mmol) was dissolved in water (37 ml), added thereto, stirred sufficiently, and then bis(tri-tert-butylphosphine)palladium(0) (0.2 g, 0.4 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 13.4 g of Compound 1-56. (Yield: 71%, MS: [M+H]⁺= 632) 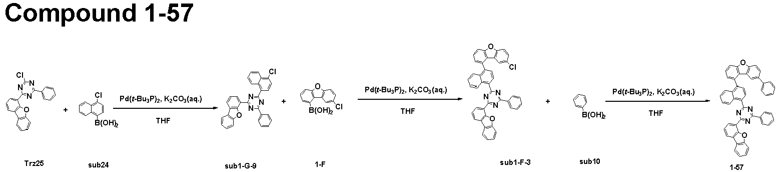
Compound Trz25 (15 g, 41.9 mmol) and Compound sub24 (8.7 g, 41.9 mmol) were added to THF (300 ml) under a nitrogen atmosphere, and the mixture was stirred and refluxed. Then, potassium carbonate (17.4 g, 125.8 mmol) was dissolved in water (52 ml), added thereto, stirred sufficiently, and then bis(tri-tert-butylphosphine)palladium(0) (0.2 g, 0.4 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.4 g of Compound sub1-G-9. (Yield: 61%, MS: [M+H]⁺= 484)
Compound sub1-G-9 (15 g, 31 mmol) and Compound 1-F (7.6 g, 31 mmol) were added to THF (300 ml) under a nitrogen atmosphere, and the mixture was stirred and refluxed. Then, potassium carbonate (12.9 g, 93 mmol) was dissolved in water (39 ml), added thereto, stirred sufficiently, and then bis(tri-tert-butylphosphine)palladium(0) (0.2 g, 0.4 mmol) was added. After the reaction for 9 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.5 g of Compound sub1-F-3. (Yield: 62%, MS: [M+H]⁺= 650)
Compound sub1-F-3 (15 g, 23.1 mmol) and Compound sub5 (2.8 g, 23.1 mmol) were added to THF (300 ml) under a nitrogen atmosphere, and the mixture was stirred and refluxed. Then, potassium carbonate (9.6 g, 69.2 mmol) was dissolved in water (29 ml), added thereto, stirred sufficiently, and then bis(tri-tert-butylphosphine)palladium(0) (0.1 g, 0.2 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.8 g of Compound 1-57. (Yield: 80%, MS: [M+H]⁺= 692) 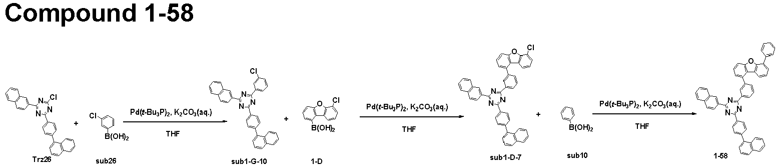
Compound Trz26 (15 g, 33.8 mmol) and Compound sub26 (5.3 g, 33.8 mmol) were added to THF (300 ml) under a nitrogen atmosphere, and the mixture was stirred and refluxed. Then, potassium carbonate (14 g, 101.4 mmol) was dissolved in water (42 ml), added thereto, stirred sufficiently, and then bis(tri-tert-butylphosphine)palladium(0) (0.2 g, 0.4 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 10.5 g of Compound sub1-G-10. (Yield: 60%, MS: [M+H]⁺= 520)
Compound sub1-G-10 (15 g, 28.8 mmol) and Compound 1-D (7.1 g, 28.8 mmol) were added to THF (300 ml) under a nitrogen atmosphere, and the mixture was stirred and refluxed. Then, potassium carbonate (12 g, 86.5 mmol) was dissolved in water (36 ml), added thereto, stirred sufficiently, and then bis(tri-tert-butylphosphine)palladium(0) (0.1 g, 0.2 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 15 g of Compound sub1-E-7. (Yield: 76%, MS: [M+H]⁺= 686)
Compound sub1-D-7 (15 g, 21.9 mmol) and Compound sub5 (2.7 g, 21.9 mmol) were added to THF (300 ml) under a nitrogen atmosphere, and the mixture was stirred and refluxed. Then, potassium carbonate (9.1 g, 65.6 mmol) was dissolved in water (27 ml), added thereto, stirred sufficiently, and then bis(tri-tert-butylphosphine)palladium(0) (0.1 g, 0.2 mmol) was added. After the reaction for 12 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 9.9 g of Compound 1-58. (Yield: 62%, MS: [M+H]⁺= 728) 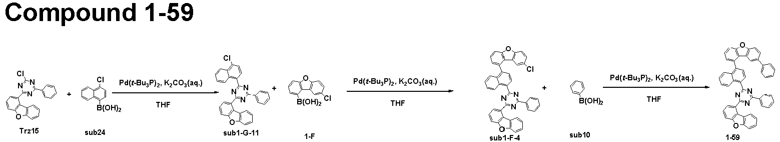
Compound Trz15 (15 g, 41.9 mmol) and Compound sub24 (8.7 g, 41.9 mmol) were added to THF (300 ml) under a nitrogen atmosphere, and the mixture was stirred and refluxed. Then, potassium carbonate (17.4 g, 125.8 mmol) was dissolved in water (52 ml), added thereto, stirred sufficiently, and then bis(tri-tert-butylphosphine)palladium(0) (0.2 g, 0.4 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.4 g of Compound sub1-G-11. (Yield: 61%, MS: [M+H]⁺= 484)
Compound sub1-G-11 (15 g, 28.8 mmol) and Compound 1-D (7.1 g, 28.8 mmol) were added to THF (300 ml) under a nitrogen atmosphere, and the mixture was stirred and refluxed. Then, potassium carbonate (12 g, 86.5 mmol) was dissolved in water (36 ml), added thereto, stirred sufficiently, and then bis(tri-tert-butylphosphine)palladium(0) (0.1 g, 0.2 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 15 g of Compound sub1-E-4. (Yield: 76%, MS: [M+H]⁺= 686)
Compound sub1-F-4 (15 g, 23.1 mmol) and Compound sub5 (2.8 g, 23.1 mmol) were added to THF (300 ml) under a nitrogen atmosphere, and the mixture was stirred and refluxed. Then, potassium carbonate (9.6 g, 69.2 mmol) was dissolved in water (29 ml), added thereto, stirred sufficiently, and then bis(tri-tert-butylphosphine)palladium(0) (0.1 g, 0.2 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.1 g of Compound 1-59. (Yield: 76%, MS: [M+H]⁺= 692) 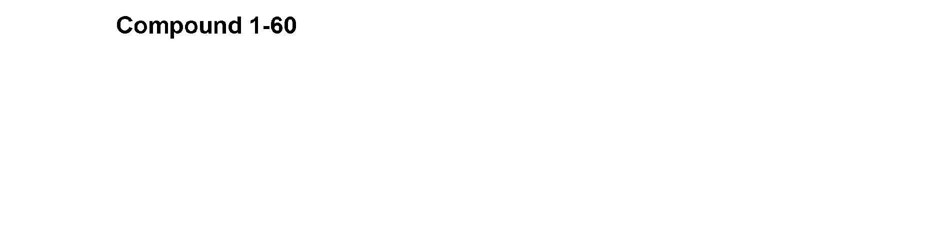 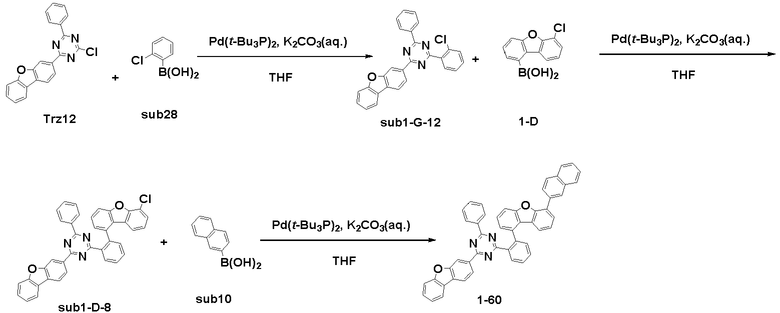
Compound Trz12 (15 g, 41.9 mmol) and Compound sub28 (6.6 g, 41.9 mmol) were added to THF (300 ml) under a nitrogen atmosphere, and the mixture was stirred and refluxed. Then, potassium carbonate (17.4 g, 125.8 mmol) was dissolved in water (52 ml), added thereto, stirred sufficiently, and then bis(tri-tert-butylphosphine)palladium(0) (0.2 g, 0.4 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 11.1 g of Compound sub1-G-12. (Yield: 61%, MS: [M+H]⁺= 434)
Compound sub1-G-12 (15 g, 34.6 mmol) and Compound 1-D (8.5 g, 34.6 mmol) were added to THF (300 ml) under a nitrogen atmosphere, and the mixture was stirred and refluxed. Then, potassium carbonate (14.3 g, 103.7 mmol) was dissolved in water (43 ml), added thereto, stirred sufficiently, and then bis(tri-tert-butylphosphine)palladium(0) (0.2 g, 0.4 mmol) was added. After the reaction for 9 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 13.6 g of Compound sub1-D-8 . (Yield: 79%, MS: [M+H]⁺= 500)
Compound sub1-D-8 (15 g, 25 mmol) and Compound sub10 (4.3 g, 25 mmol) were added to THF (300 ml) under a nitrogen atmosphere, and the mixture was stirred and refluxed. Then, potassium carbonate (10.4 g, 75 mmol) was dissolved in water (31 ml), added thereto, stirred sufficiently, and then bis(tri-tert-butylphosphine)palladium(0) (0.1 g, 0.2 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 13.3 g of Compound 1-60. (Yield: 77%, MS: [M+H]⁺= 692) 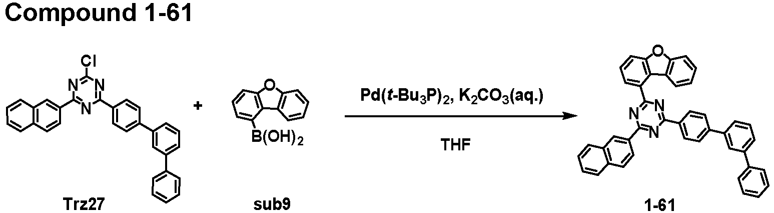
Compound Trz27 (15 g, 31.9 mmol) and Compound sub9 (6.8 g, 31.9 mmol) were added to THF (300 ml) under a nitrogen atmosphere, and the mixture was stirred and refluxed. Then, potassium carbonate (13.2 g, 95.8 mmol) was dissolved in water (40 ml), added thereto, stirred sufficiently, and then bis(tri-tert-butylphosphine)palladium(0)(0.4 g, 0.8 mmol) was added. After the reaction for 8 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 10 g of Compound 1-61. (Yield: 52%, MS: [M+H]⁺= 602) 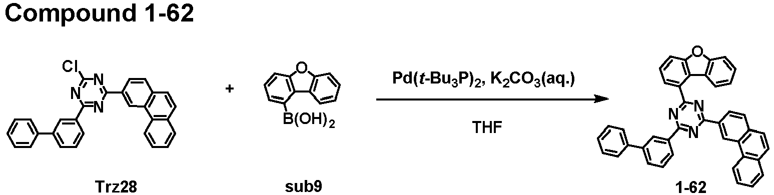
Compound Trz28 (15 g, 33.8 mmol) and Compound sub9 (7.2 g, 33.8 mmol) were added to THF (300 ml) under a nitrogen atmosphere, and the mixture was stirred and refluxed. Then, potassium carbonate (14 g, 101.4 mmol) was dissolved in water (42 ml), added thereto, stirred sufficiently, and then bis(tri-tert-butylphosphine)palladium(0)(0.4 g, 0.8 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.2 g of Compound 1-62. (Yield: 63%, MS: [M+H]⁺= 576) 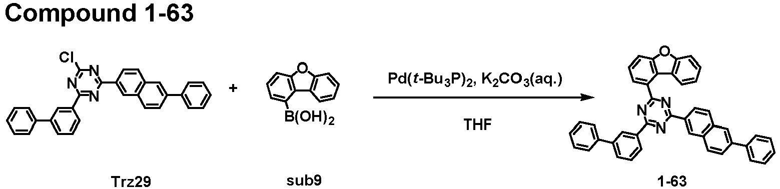
Compound Trz29 (15 g, 31.9 mmol) and Compound sub9 (6.8 g, 31.9 mmol) were added to THF (300 ml) under a nitrogen atmosphere, and the mixture was stirred and refluxed. Then, potassium carbonate (13.2 g, 95.8 mmol) was dissolved in water (40 ml), added thereto, stirred sufficiently, and then bis(tri-tert-butylphosphine)palladium(0) (0.4 g, 0.8 mmol) was added. After the reaction for 12 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 12.7 g of Compound 1-63. (Yield: 66%, MS: [M+H]⁺= 602) 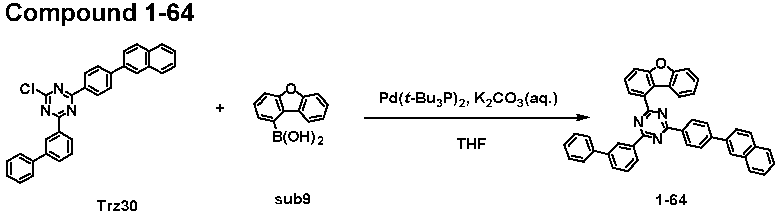
Compound Trz30 (15 g, 31.9 mmol) and Compound sub9 (6.8 g, 31.9 mmol) were added to THF (300 ml) under a nitrogen atmosphere, and the mixture was stirred and refluxed. Then, potassium carbonate (13.2 g, 95.8 mmol) was dissolved in water (40 ml), added thereto, stirred sufficiently, and then bis(tri-tert-butylphosphine)palladium(0) (0.4 g, 0.8 mmol) was added. After the reaction for 8 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 13.2 g of Compound 1-64. (Yield: 69%, MS: [M+H]⁺= 602) 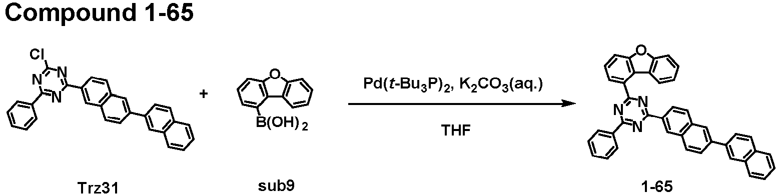
Compound Trz31 (15 g, 33.8 mmol) and Compound sub9 (7.2 g, 33.8 mmol) were added to THF (300 ml) under a nitrogen atmosphere, and the mixture was stirred and refluxed. Then, potassium carbonate (14 g, 101.4 mmol) was dissolved in water (42 ml), added thereto, stirred sufficiently, and then bis(tri-tert-butylphosphine)palladium(0) (0.4 g, 0.8 mmol) was added. After the reaction for 8 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 14.6 g of Compound 1-65. (Yield: 75%, MS: [M+H]⁺= 576) 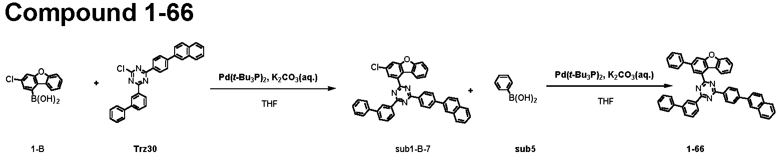
Compound 1-B (15 g, 60.9 mmol) and Compound Trz30 (28.6 g, 60.9 mmol) were added to THF (300 ml) under a nitrogen atmosphere, and the mixture was stirred and refluxed. Then, potassium carbonate (25.2 g, 182.6 mmol) was dissolved in water (76 ml), added thereto, stirred sufficiently, and then bis(tri-tert-butylphosphine)palladium(0) (0.7 g, 1.4 mmol) was added. After the reaction for 12 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 19.3 g of Compound sub1-B-7. (Yield: 50%, MS: [M+H]⁺= 636)
Compound sub1-B-7 (15 g, 23.6 mmol) and Compound sub5 (2.9 g, 23.6 mmol) were added to THF (300 ml) under a nitrogen atmosphere, and the mixture was stirred and refluxed. Then, potassium carbonate (9.8 g, 70.7 mmol) was dissolved in water (29 ml), added thereto, stirred sufficiently, and then bis(tri-tert-butylphosphine)palladium(0) (0.3 g, 0.6 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 8.5 g of Compound 1-66. (Yield: 53%, MS: [M+H]⁺= 678) 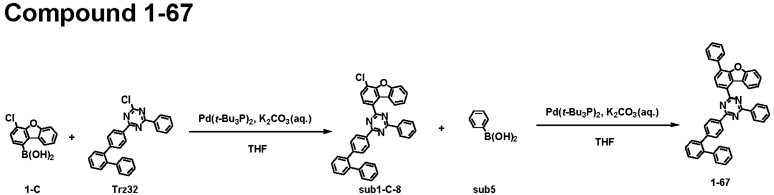
Compound 1-C (15 g, 60.9 mmol) and Compound Trz32 (25.6 g, 60.9 mmol) were added to THF (300 ml) under a nitrogen atmosphere, and the mixture was stirred and refluxed. Then, potassium carbonate (25.2 g, 182.6 mmol) was dissolved in water (76 ml), added thereto, stirred sufficiently, and then bis(tri-tert-butylphosphine)palladium(0) (0.7 g, 1.4 mmol) was added. After the reaction for 8 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 24.9 g of Compound sub1-C-8 . (Yield: 70%, MS: [M+H]⁺= 586)
Compound sub1-C-8 (15 g, 25.6 mmol) and Compound sub5 (3.1 g, 25.6 mmol) were added to THF (300 ml) under a nitrogen atmosphere, and the mixture was stirred and refluxed. Then, potassium carbonate (10.6 g, 76.8 mmol) was dissolved in water (32 ml), added thereto, stirred sufficiently, and then bis(tri-tert-butylphosphine)palladium(0) (0.3 g, 0.6 mmol) was added. After the reaction for 9 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 10.6 g of Compound 1-67. (Yield: 66%, MS: [M+H]⁺= 628) 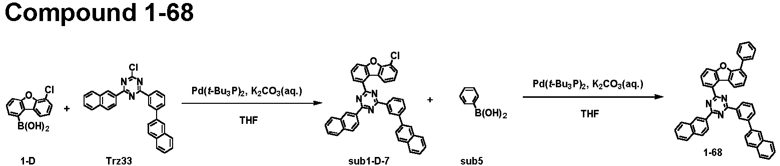
Compound 1-D (15 g, 60.9 mmol) and Compound Trz33 (27 g, 60.9 mmol) were added to THF (300 ml) under a nitrogen atmosphere, and the mixture was stirred and refluxed. Then, potassium carbonate (25.2 g, 182.6 mmol) was dissolved in water (76 ml), added thereto, stirred sufficiently, and then bis(tri-tert-butylphosphine)palladium(0) (0.7 g, 1.4 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 29.7 g of Compound sub1-D-7. (Yield: 80%, MS: [M+H]⁺= 610)
Compound sub1-D-7 (15 g, 24.6 mmol) and Compound sub5 (3 g, 24.6 mmol) were added to THF (300 ml) under a nitrogen atmosphere, and the mixture was stirred and refluxed. Then, potassium carbonate (10.2 g, 73.8 mmol) was dissolved in water (31 ml), added thereto, stirred sufficiently, and then bis(tri-tert-butylphosphine)palladium(0) (0.3 g, 0.6 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 11.2 g of Compound 1-68. (Yield: 70%, MS: [M+H]⁺= 652) 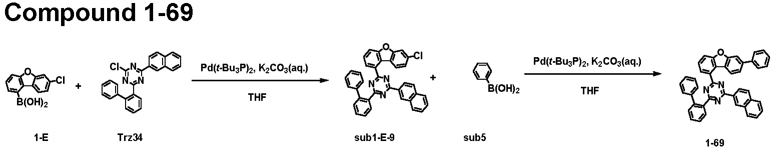
Compound 1-E (15 g, 60.9 mmol) and Compound Trz34 (24 g, 60.9 mmol) were added to THF (300 ml) under a nitrogen atmosphere, and the mixture was stirred and refluxed. Then, potassium carbonate (25.2 g, 182.6 mmol) was dissolved in water (76 ml), added thereto, stirred sufficiently, and then bis(tri-tert-butylphosphine)palladium(0) (0.7 g, 1.4 mmol) was added. After the reaction for 8 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 21.8 g of Compound sub1-E-9. (Yield: 64%, MS: [M+H]⁺= 560)
Compound sub1-E-9 (15 g, 26.8 mmol) and Compound sub5 (3.3 g, 26.8 mmol) were added to THF (300 ml) under a nitrogen atmosphere, and the mixture was stirred and refluxed. Then, potassium carbonate (11.1 g, 80.3 mmol) was dissolved in water (33 ml), added thereto, stirred sufficiently, and then bis(tri-tert-butylphosphine)palladium(0) (0.3 g, 0.6 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 10 g of Compound 1-69. (Yield: 62%, MS: [M+H]⁺= 602) 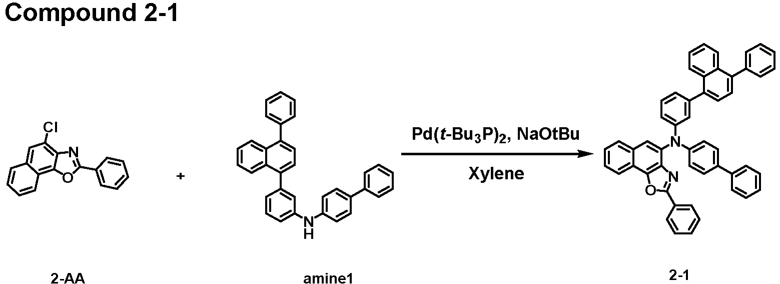
Compound 2-AA (10 g, 35.8 mmol), Compound amine1 (16 g, 35.8 mmol) and sodium tert-butoxide (11.4 g, 53.6 mmol) were added to xylene (200 ml) under a nitrogen atmosphere, and the mixture was stirred and refluxed. Then, bis(tri-tert-butylphosphine)palladium(0) (0.2 g, 0.4 mmol) was added thereto. After the reaction was completed after 2 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by silica gel column chromatography to give 16.8 g of Compound 2-1. (Yield: 68%, MS: [M+H]⁺= 691) 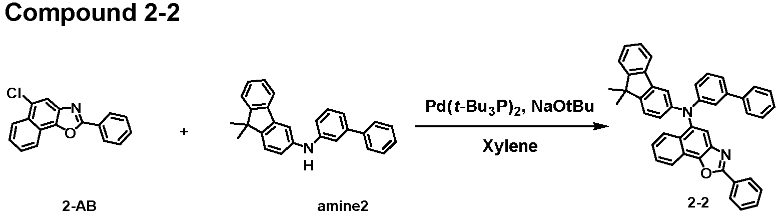
Compound 2-AB (10 g, 35.8 mmol), Compound amine2 (12.9 g, 35.8 mmol) and sodium tert-butoxide(11.4 g, 53.6 mmol) were added to xylene (200 ml) under a nitrogen atmosphere, and the mixture was stirred and refluxed. Then, bis(tri-tert-butylphosphine)palladium(0) (0.2 g, 0.4 mmol) was added thereto. After the reaction was completed after 2 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by silica gel column chromatography to give 13.2 g of Compound 2-2. (Yield: 61%, MS: [M+H]⁺= 605) 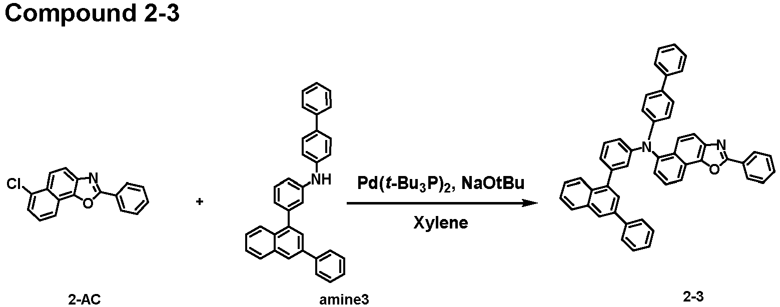
Compound 2-AC (10 g, 35.8 mmol), Compound amine3 (16 g, 35.8 mmol) and sodium tert-butoxide(11.4 g, 53.6 mmol) were added to xylene (200 ml) under a nitrogen atmosphere, and the mixture was stirred and refluxed. Then, bis(tri-tert-butylphosphine)palladium(0) (0.2 g, 0.4 mmol) was added thereto. After the reaction was completed after 2 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by silica gel column chromatography to give 17.3 g of Compound 2-3. (Yield: 70%, MS: [M+H]⁺= 691) 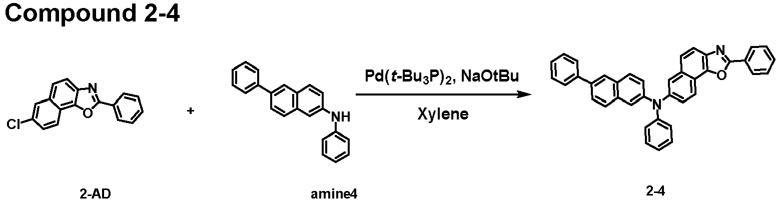
Compound 2-AD (10 g, 35.8 mmol), Compound amine4 (10.6 g, 35.8 mmol) and sodium tert-butoxide (11.4 g, 53.6 mmol) were added to xylene (200 ml) under a nitrogen atmosphere, and the mixture was stirred and refluxed. Then, bis(tri-tert-butylphosphine)palladium(0) (0.2 g, 0.4 mmol) was added thereto. After the reaction was completed after 3 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by silica gel column chromatography to give 12.7 g of Compound 2-4. (Yield: 66%, MS: [M+H]⁺= 539) 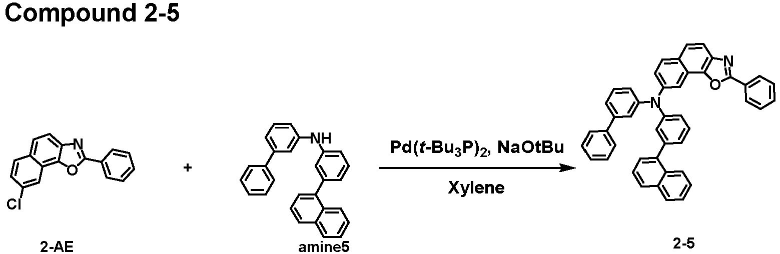
Compound 2-AE (10 g, 35.8 mmol), Compound amine5 (13.3 g, 35.8 mmol) and sodium tert-butoxide (11.4 g, 53.6 mmol) were added to xylene (200 ml) under a nitrogen atmosphere, and the mixture was stirred and refluxed. Then, bis(tri-tert-butylphosphine)palladium(0) (0.2 g, 0.4 mmol) was added thereto. After the reaction was completed after 2 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by silica gel column chromatography to give 13.4 g of Compound 2-5. (Yield: 61%, MS: [M+H]⁺= 615) 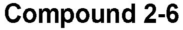 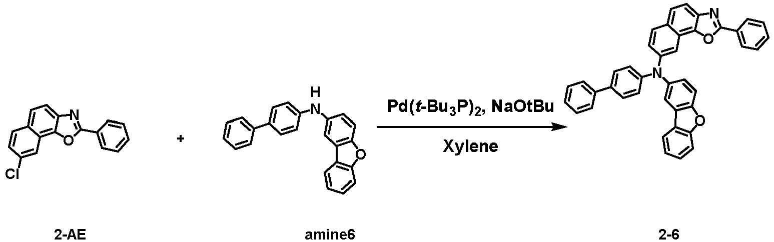
Compound 2-AE (10 g, 35.8 mmol), Compound amine6 (12 g, 35.8 mmol) and sodium tert-butoxide(11.4 g, 53.6 mmol) were added to xylene (200 ml) under a nitrogen atmosphere, and the mixture was stirred and refluxed. Then, bis(tri-tert-butylphosphine)palladium(0) (0.2 g, 0.4 mmol) was added thereto. After the reaction was completed after 3 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by silica gel column chromatography to give 13.4 g of Compound 2-6. (Yield: 65%, MS: [M+H]⁺= 579) 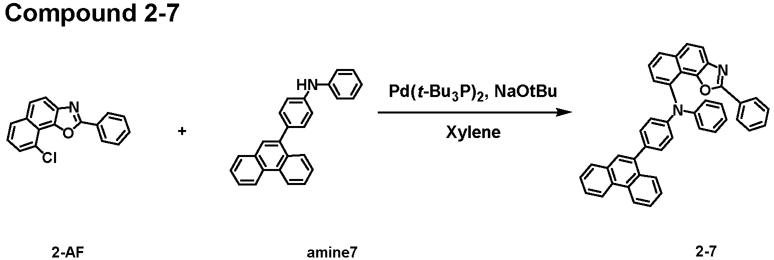
Compound 2-AF (10 g, 35.8 mmol), Compound amine7 (12.3 g, 35.8 mmol) and sodium tert-butoxide (11.4 g, 53.6 mmol) were added to xylene (200 ml) under a nitrogen atmosphere, and the mixture was stirred and refluxed. Then, bis(tri-tert-butylphosphine)palladium(0) (0.2 g, 0.4 mmol) was added thereto. After the reaction was completed after 2 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by silica gel column chromatography to give 13.5 g of Compound 2-7. (Yield: 64%, MS: [M+H]⁺= 589) 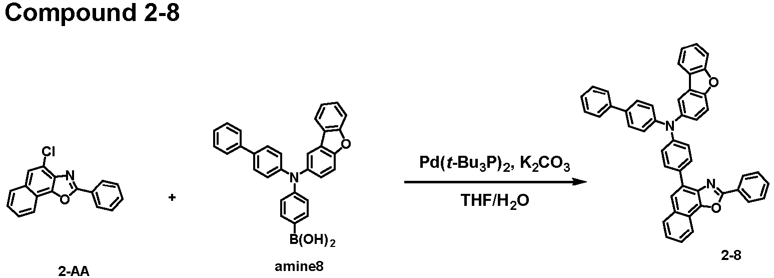
Compound 2-A (15 g, 53.6 mmol) and Compound amine8 (25.6 g, 56.3 mmol) were added to THF (300 ml) under a nitrogen atmosphere, and the mixture was stirred and refluxed. Then, potassium carbonate (22.2 g, 160.9 mmol) was dissolved in water (67 ml), added thereto, stirred sufficiently, and then bis(tri-tert-butylphosphine)palladium(0) (0.6 g, 1.2 mmol) was added. After the reaction for 9 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 23.9 g of Compound 2-8. (Yield: 68%, MS: [M+H]⁺= 655) 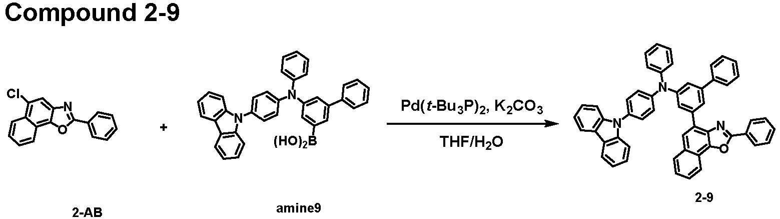
Compound 2-AB (15 g, 53.6 mmol) and Compound amine9 (29.9 g, 56.3 mmol) were added to THF (300 ml) under a nitrogen atmosphere, and the mixture was stirred and refluxed. Then, potassium carbonate (22.2 g, 160.9 mmol) was dissolved in water (67 ml), added thereto, stirred sufficiently, and then bis(tri-tert-butylphosphine)palladium(0) (0.6 g, 1.2 mmol) was added. After the reaction for 9 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 23.9 g of Compound 2-9. (Yield: 61%, MS: [M+H]⁺= 730) 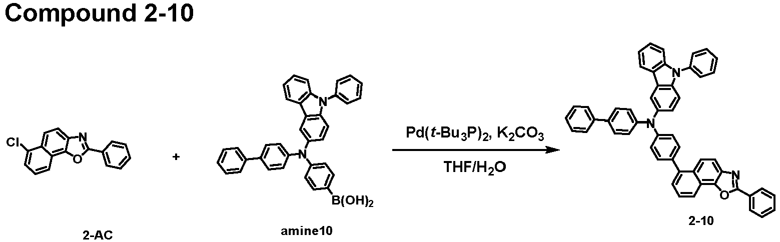
Compound 2-AC (15 g, 53.6 mmol) and Compound amine10 (29.9 g, 56.3 mmol) were added to THF (300 ml) under a nitrogen atmosphere, and the mixture was stirred and refluxed. Then, potassium carbonate (22.2 g, 160.9 mmol) was dissolved in water (67 ml), added thereto, stirred sufficiently, and then bis(tri-tert-butylphosphine)palladium(0) (0.6 g, 1.2 mmol) was added. After the reaction for 12 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 24.2 g of Compound 2-10. (Yield: 62%, MS: [M+H]⁺= 730) 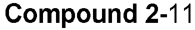 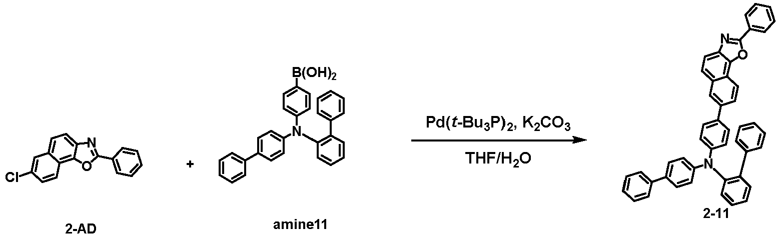
Compound 2-AD (15 g, 53.6 mmol) and Compound amine11 (24.9 g, 56.3 mmol) were added to THF (300 ml) under a nitrogen atmosphere, and the mixture was stirred and refluxed. Then, potassium carbonate (22.2 g, 160.9 mmol) was dissolved in water (67 ml), added thereto, stirred sufficiently, and then bis(tri-tert-butylphosphine)palladium(0) (0.6 g, 1.2 mmol) was added. After the reaction for 12 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 20.9 g of Compound 2-11. (Yield: 61%, MS: [M+H]⁺= 641) 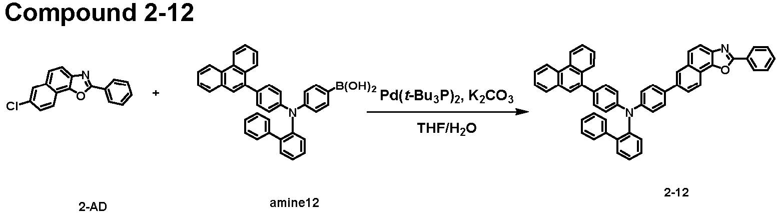
Compound 2-AD (15 g, 53.6 mmol) and Compound amine12 (30.5 g, 56.3 mmol) were added to THF (300 ml) under a nitrogen atmosphere, and the mixture was stirred and refluxed. Then, potassium carbonate (22.2 g, 160.9 mmol) was dissolved in water (67 ml), added thereto, stirred sufficiently, and then bis(tri-tert-butylphosphine)palladium(0) (0.6 g, 1.2 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 25.8 g of Compound 2-12. (Yield: 65%, MS: [M+H]⁺= 741) 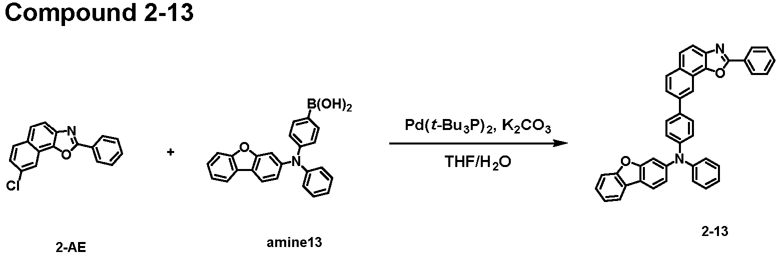
Compound 2-AE (15 g, 53.6 mmol) and Compound amine13 (21.4 g, 56.3 mmol) were added to THF (300 ml) under a nitrogen atmosphere, and the mixture was stirred and refluxed. Then, potassium carbonate (22.2 g, 160.9 mmol) was dissolved in water (67 ml), added thereto, stirred sufficiently, and then bis(tri-tert-butylphosphine)palladium(0) (0.6 g, 1.2 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 18.6 g of Compound 2-13. (Yield: 60%, MS: [M+H]⁺= 579) 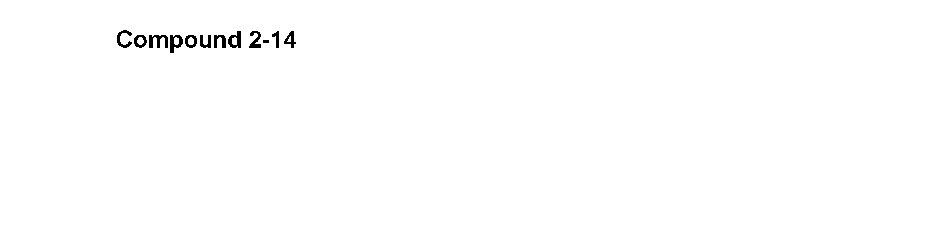 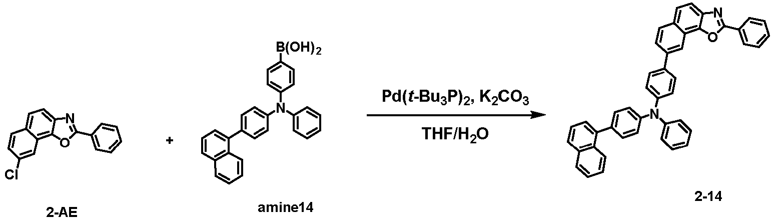
Compound 2-AE (15 g, 53.6 mmol) and Compound amine14 (23.4 g, 56.3 mmol) were added to THF (300 ml) under a nitrogen atmosphere, and the mixture was stirred and refluxed. Then, potassium carbonate (22.2 g, 160.9 mmol) was dissolved in water (67 ml), added thereto, stirred sufficiently, and then bis(tri-tert-butylphosphine)palladium(0) (0.6 g, 1.2 mmol) was added. After the reaction for 9 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 22.1 g of Compound 2-14. (Yield: 67%, MS: [M+H]⁺= 615) 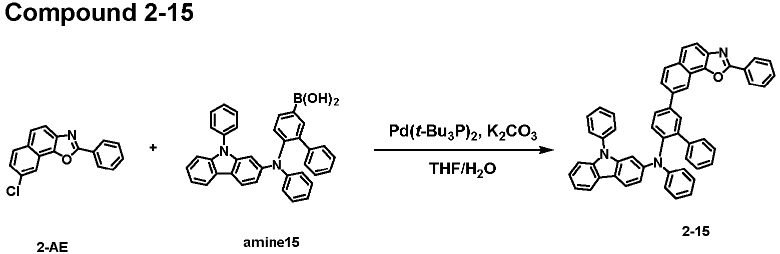
Compound 2-AE (15 g, 53.6 mmol) and Compound amine15 (29.9 g, 56.3 mmol) were added to THF (300 ml) under a nitrogen atmosphere, and the mixture was stirred and refluxed. Then, potassium carbonate (22.2 g, 160.9 mmol) was dissolved in water (67 ml), added thereto, stirred sufficiently, and then bis(tri-tert-butylphosphine)palladium(0) (0.6 g, 1.2 mmol) was added. After the reaction for 8 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 24.2 g of Compound 2-15. (Yield: 62%, MS: [M+H]⁺= 730) 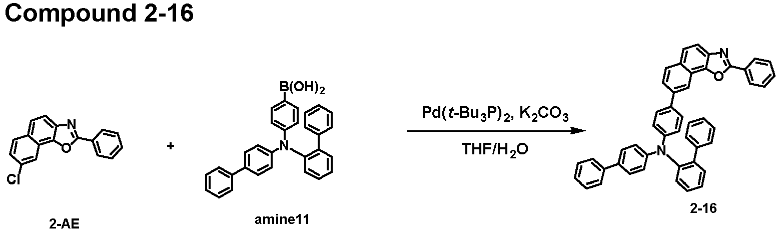
Compound 2-AE (15 g, 53.6 mmol) and Compound amine11 (24.9 g, 56.3 mmol) were added to THF (300 ml) under a nitrogen atmosphere, and the mixture was stirred and refluxed. Then, potassium carbonate (22.2 g, 160.9 mmol) was dissolved in water (67 ml), added thereto, stirred sufficiently, and then bis(tri-tert-butylphosphine)palladium(0) (0.6 g, 1.2 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 23 g of Compound 2-16. (Yield: 67%, MS: [M+H]⁺= 641) 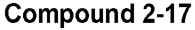 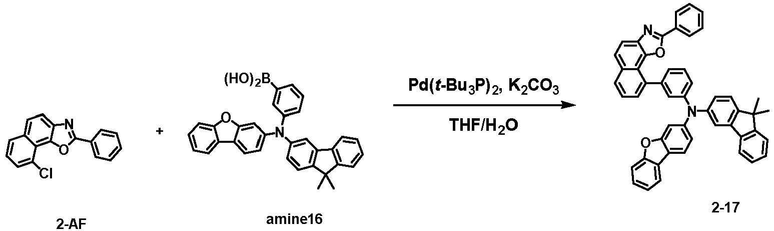
Compound 2-AF (15 g, 53.6 mmol) and Compound amine16 (27.9 g, 56.3 mmol) were added to THF (300 ml) under a nitrogen atmosphere, and the mixture was stirred and refluxed. Then, potassium carbonate (22.2 g, 160.9 mmol) was dissolved in water (67 ml), added thereto, stirred sufficiently, and then bis(tri-tert-butylphosphine)palladium(0) (0.6 g, 1.2 mmol) was added. After the reaction for 8 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 23.5 g of Compound 2-17. (Yield: 63%, MS: [M+H]⁺= 695) 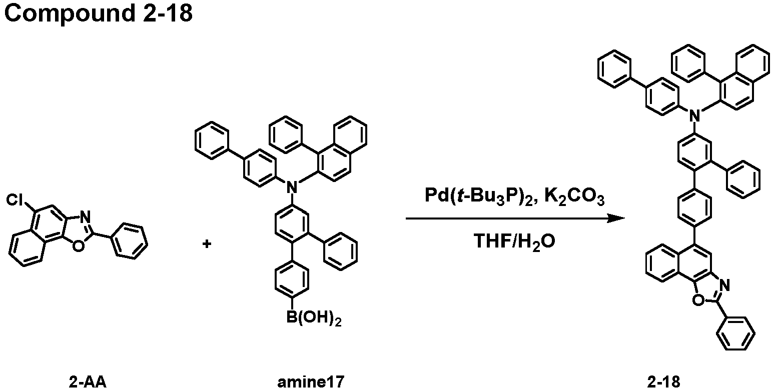
Compound 2-AA (15 g, 53.6 mmol) and Compound amine17 (36.2 g, 56.3 mmol) were added to THF (300 ml) under a nitrogen atmosphere, and the mixture was stirred and refluxed. Then, potassium carbonate (22.2 g, 160.9 mmol) was dissolved in water (67 ml), added thereto, stirred sufficiently, and then bis(tri-tert-butylphosphine)palladium(0) (0.6 g, 1.2 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 28.5 g of Compound 2-18. (Yield: 63%, MS: [M+H]⁺= 843) 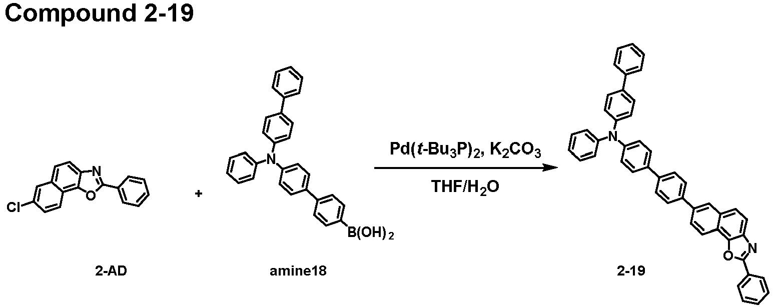
Compound 2-AD (15 g, 53.6 mmol) and Compound amine18 (24.9 g, 56.3 mmol) were added to THF (300 ml) under a nitrogen atmosphere, and the mixture was stirred and refluxed. Then, potassium carbonate (22.2 g, 160.9 mmol) was dissolved in water (67 ml), added thereto, stirred sufficiently, and then bis(tri-tert-butylphosphine)palladium(0) (0.6 g, 1.2 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 23.3 g of Compound 2-19. (Yield: 68%, MS: [M+H]⁺= 641) 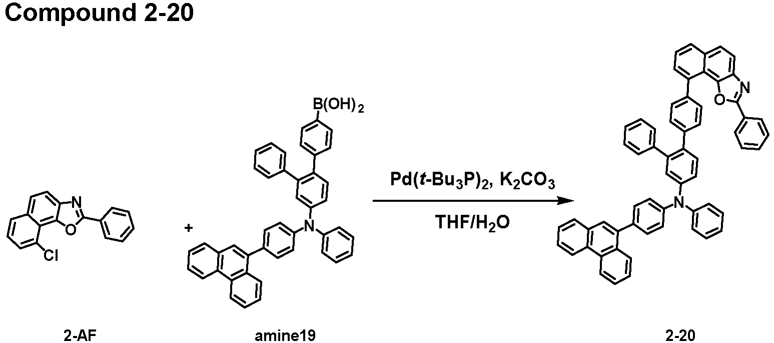
Compound 2-AF (15 g, 53.6 mmol) and Compound amine19 (34.8 g, 56.3 mmol) were added to THF (300 ml) under a nitrogen atmosphere, and the mixture was stirred and refluxed. Then, potassium carbonate (22.2 g, 160.9 mmol) was dissolved in water (67 ml), added thereto, stirred sufficiently, and then bis(tri-tert-butylphosphine)palladium(0) (0.6 g, 1.2 mmol) was added. After the reaction for 8 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 27.6 g of Compound 2-20. (Yield: 63%, MS: [M+H]⁺= 817) 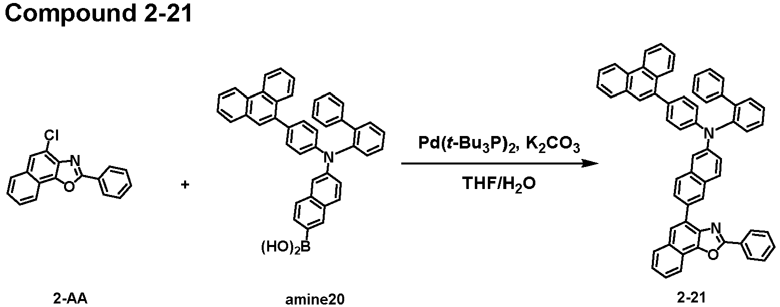
Compound 2-AA (15 g, 53.6 mmol) and Compound amine20 (33.3 g, 56.3 mmol) were added to THF (300 ml) under a nitrogen atmosphere, and the mixture was stirred and refluxed. Then, potassium carbonate (22.2 g, 160.9 mmol) was dissolved in water (67 ml), added thereto, stirred sufficiently, and then bis(tri-tert-butylphosphine)palladium(0) (0.6 g, 1.2 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 27.5 g of Compound 2-21. (Yield: 65%, MS: [M+H]⁺= 791) 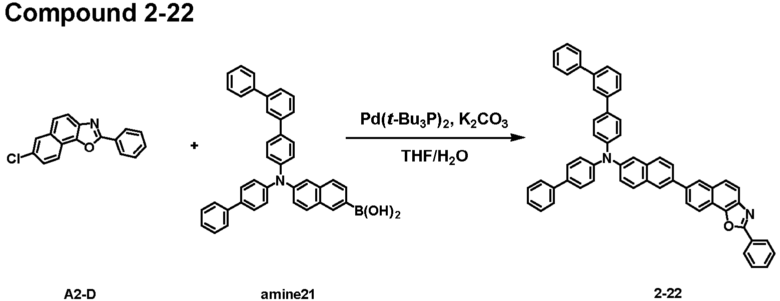
Compound 2-AD (15 g, 53.6 mmol) and Compound amine21 (32 g, 56.3 mmol) were added to **THF** (300 ml) under a nitrogen atmosphere, and the mixture was stirred and refluxed. Then, potassium carbonate (22.2 g, 160.9 mmol) was dissolved in water (67 ml), added thereto, stirred sufficiently, and then bis(tri-tert-butylphosphine)palladium(0) (0.6 g, 1.2 mmol) was added. After the reaction for 12 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 27.9 g of Compound 2-22. (Yield: 68%, MS: [M+H]⁺= 767) 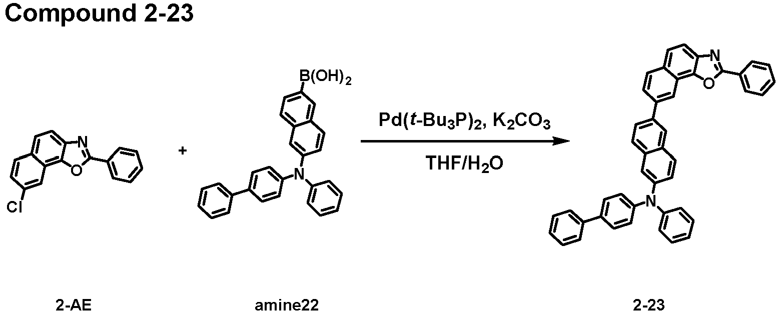
Compound 2-AE (15 g, 53.6 mmol) and Compound amine22 (23.4 g, 56.3 mmol) were added to THF (300 ml) under a nitrogen atmosphere, and the mixture was stirred and refluxed. Then, potassium carbonate (22.2 g, 160.9 mmol) was dissolved in water (67 ml), added thereto, stirred sufficiently, and then bis(tri-tert-butylphosphine)palladium(0) (0.6 g, 1.2 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 22.4 g of Compound 2-23. (Yield: 68%, MS: [M+H]⁺= 615) 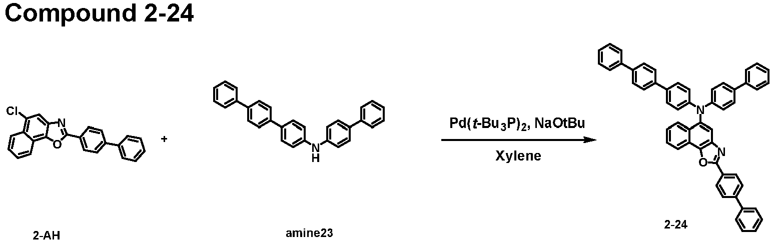
Compound 2-AH (10 g, 28.1 mmol), Compound amine23 (11.2 g, 28.1 mmol) and sodium tert-butoxide(8.9 g, 42.2 mmol) were added to xylene (200 ml) under a nitrogen atmosphere, and the mixture was stirred and refluxed. Then, bis(tri-tert-butylphosphine)palladium(0) (0.1 g, 0.2 mmol) was added thereto. After the reaction was completed after 3 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by silica gel column chromatography to give 14.1 g of Compound 2-24. (Yield: 70%, MS: [M+H]⁺= 717) 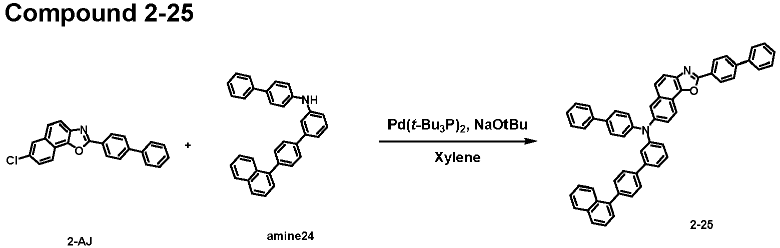
Compound 2-AJ (10 g, 28.1 mmol), Compound amine24 (12.6 g, 28.1 mmol) and sodium tert-butoxide(8.9 g, 42.2 mmol) were added to xylene (200 ml) under a nitrogen atmosphere, and the mixture was stirred and refluxed. Then, bis(tri-tert-butylphosphine)palladium(0) (0.1 g, 0.2 mmol) was added thereto. After the reaction was completed after 2 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by silica gel column chromatography to give 13.1 g of Compound 2-25. (Yield: 61%, MS: [M+H]⁺= 767) 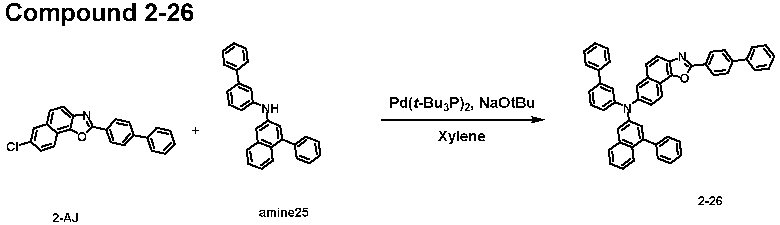
Compound 2-AJ (10 g, 28.1 mmol), Compound amine25 (10.4 g, 28.1 mmol) and sodium tert-butoxide (8.9 g, 42.2 mmol) were added to xylene (200 ml) under a nitrogen atmosphere, and the mixture was stirred and refluxed. Then, bis(tri-tert-butylphosphine)palladium(0) (0.1 g, 0.2 mmol) was added thereto. After the reaction was completed after 2 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by silica gel column chromatography to give 11.8 g of Compound 2-26. (Yield: 61%, MS: [M+H]⁺= 691) 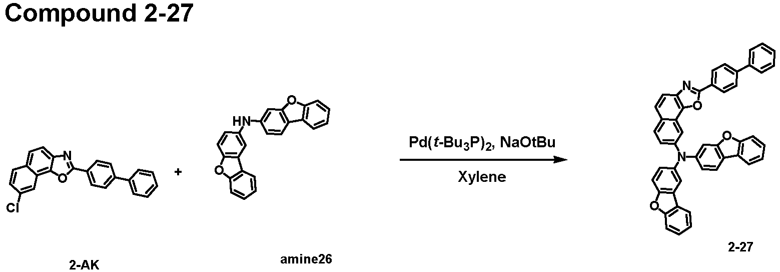
Compound 2-AK (10 g, 28.1 mmol), Compound amine26 (9.8 g, 28.1 mmol) and sodium tert-butoxide(8.9 g, 42.2 mmol) were added to xylene (200 ml) under a nitrogen atmosphere, and the mixture was stirred and refluxed. Then, bis(tri-tert-butylphosphine)palladium(0) (0.1 g, 0.2 mmol) was added thereto. After the reaction was completed after 2 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by silica gel column chromatography to give 11.6 g of Compound 2-27. (Yield: 62%, MS: [M+H]⁺= 669) 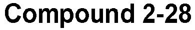 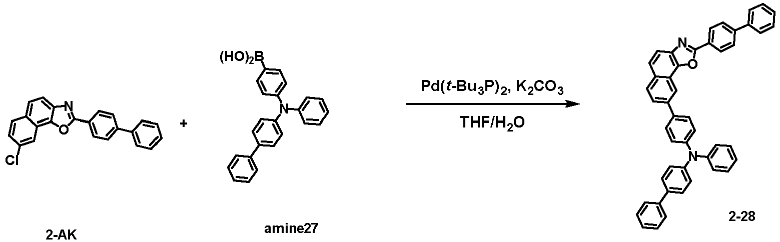
Compound 2-AK (15 g, 42.2 mmol) and Compound amine27 (16.2 g, 44.3 mmol) were added to THF (300 ml) under a nitrogen atmosphere, and the mixture was stirred and refluxed. Then, potassium carbonate (17.5 g, 126.5 mmol) was dissolved in water (52 ml), added thereto, stirred sufficiently, and then bis(tri-tert-butylphosphine)palladium(0) (0.5 g, 1.0 mmol) was added. After the reaction for 12 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 16.2 g of Compound 2-28. (Yield: 60%, MS: [M+H]⁺= 641) 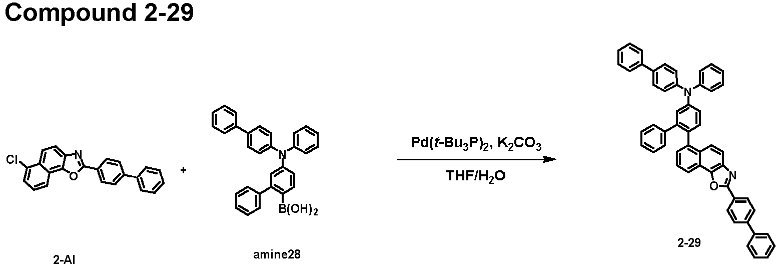
Compound 2-AI (15 g, 42.2 mmol) and Compound amine28 (19.5 g, 44.3 mmol) were added to THF (300 ml) under a nitrogen atmosphere, and the mixture was stirred and refluxed. Then, potassium carbonate(17.5 g, 126.5 mmol) was dissolved in water (52 ml), added thereto, stirred sufficiently, and then bis(tri-tert-butylphosphine)palladium(0) (0.5 g, 1.0 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 18.1 g of Compound 2-29. (Yield: 60%, MS: [M+H]⁺= 717) 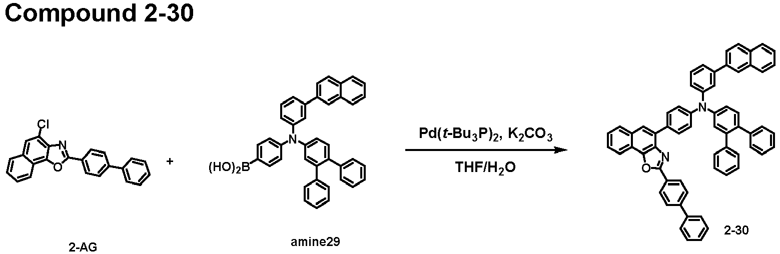
Compound 2-AG (15 g, 42.2 mmol) and Compound amine29 (25.1 g, 44.3 mmol) were added to **THF** (300 ml) under a nitrogen atmosphere, and the mixture was stirred and refluxed. Then, potassium carbonate (17.5 g, 126.5 mmol) was dissolved in water (52 ml), added thereto, stirred sufficiently, and then bis(tri-tert-butylphosphine)palladium(0) (0.5 g, 1.0 mmol) was added. After the reaction for 12 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 22.7 g of Compound 2-30. (Yield: 64%, MS: [M+H]⁺= 843) 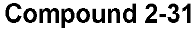 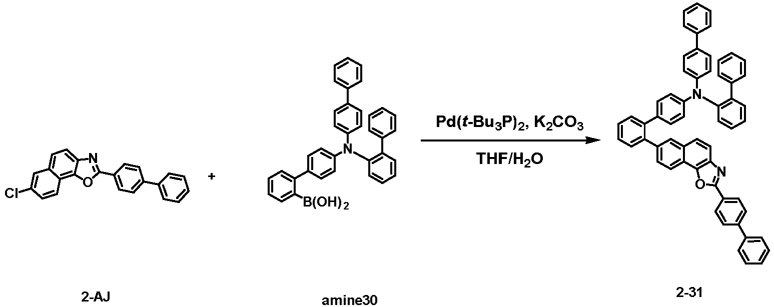
Compound 2-AJ (15 g, 42.2 mmol) and Compound amine30 (22.9 g, 44.3 mmol) were added to THF (300 ml) under a nitrogen atmosphere, and the mixture was stirred and refluxed. Then, potassium carbonate (17.5 g, 126.5 mmol) was dissolved in water (52 ml), added thereto, stirred sufficiently, and then bis(tri-tert-butylphosphine)palladium(0) (0.5 g, 1.0 mmol) was added. After the reaction for 9 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 22.4 g of Compound 2-31. (Yield: 67%, MS: [M+H]⁺= 793) 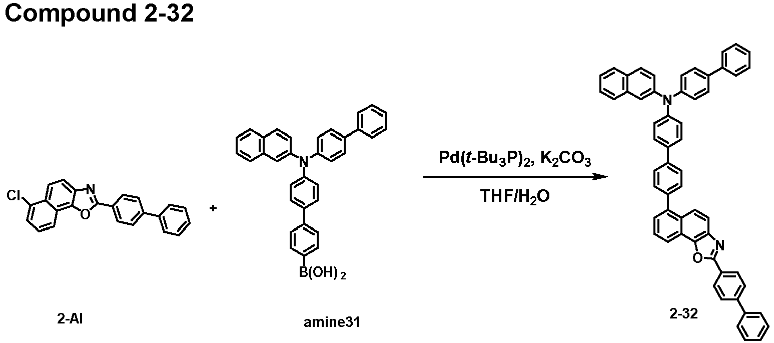
Compound 2-AI (15 g, 42.2 mmol) and Compound amine31 (21.8 g, 44.3 mmol) were added to THF (300 ml) under a nitrogen atmosphere, and the mixture was stirred and refluxed. Then, potassium carbonate (17.5 g, 126.5 mmol) was dissolved in water (52 ml), added thereto, stirred sufficiently, and then bis(tri-tert-butylphosphine)palladium(0) (0.5 g, 1.0 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 22.6 g of Compound 2-32. (Yield: 70%, MS: [M+H]⁺= 767) 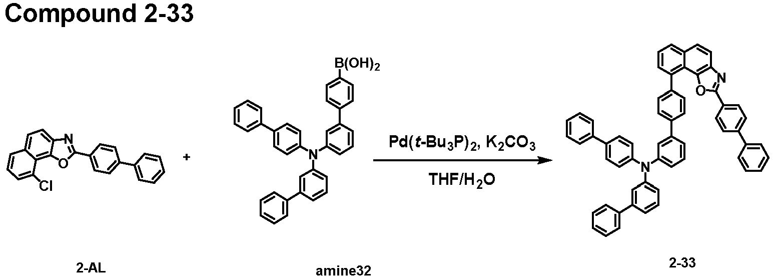
Compound 2-AL (15 g, 42.2 mmol) and Compound amine32 (22.9 g, 44.3 mmol) were added to THF (300 ml) under a nitrogen atmosphere, and the mixture was stirred and refluxed. Then, potassium carbonate (17.5 g, 126.5 mmol) was dissolved in water (52 ml), added thereto, stirred sufficiently, and then bis(tri-tert-butylphosphine)palladium(0) (0.5 g, 1.0 mmol) was added. After the reaction for 9 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 23.4 g of Compound 2-33. (Yield: 70%, MS: [M+H]⁺= 793) 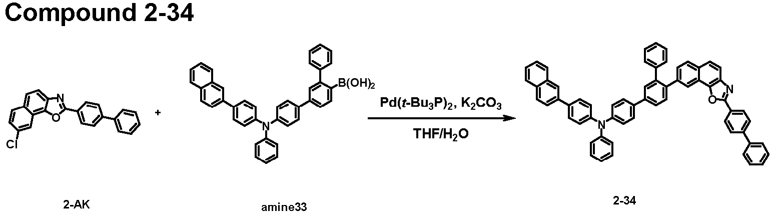
Compound 2-AK (15 g, 42.2 mmol) and Compound amine33 (25.1 g, 44.3 mmol) were added to THF (300 ml) under a nitrogen atmosphere, and the mixture was stirred and refluxed. Then, potassium carbonate (17.5 g, 126.5 mmol) was dissolved in water (52 ml), added thereto, stirred sufficiently, and then bis(tri-tert-butylphosphine)palladium(0) (0.5 g, 1.0 mmol) was added. After the reaction for 8 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 21.3 g of Compound 2-34. (Yield: 60%, MS: [M+H]⁺= 843) 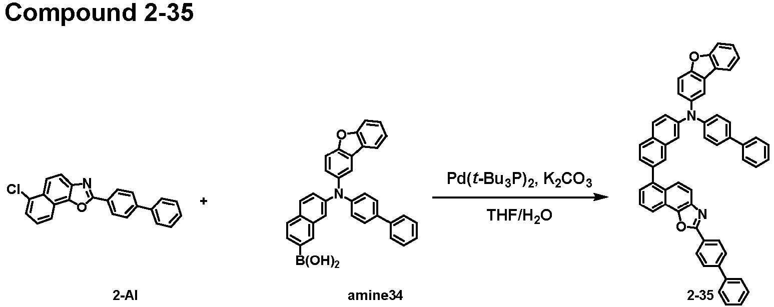
Compound 2-AI (15 g, 42.2 mmol) and Compound amine34 (22.4 g, 44.3 mmol) were added to THF (300 ml) under a nitrogen atmosphere, and the mixture was stirred and refluxed. Then, potassium carbonate (17.5 g, 126.5 mmol) was dissolved in water (52 ml), added thereto, stirred sufficiently, and then bis(tri-tert-butylphosphine)palladium(0) (0.5 g, 1.0 mmol) was added. After the reaction for 9 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 22.7 g of Compound 2-35. (Yield: 69%, MS: [M+H]⁺= 781) 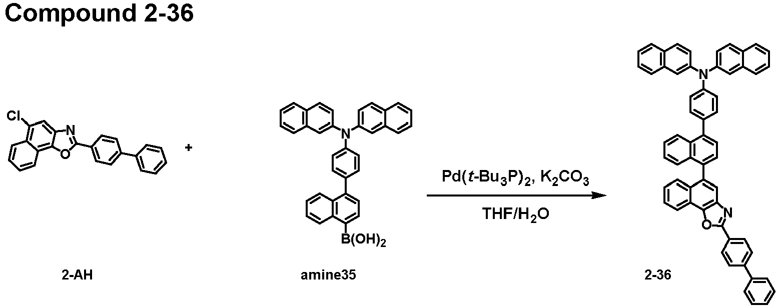
Compound 2-AH (15 g, 42.2 mmol) and Compound amine35 (22.8 g, 44.3 mmol) were added to THF (300 ml) under a nitrogen atmosphere, and the mixture was stirred and refluxed. Then, potassium carbonate(17.5 g, 126.5 mmol) was dissolved in water (52 ml), added thereto, stirred sufficiently, and then bis(tri-tert-butylphosphine)palladium(0) (0.5 g, 1.0 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 23 g of Compound 2-36. (Yield: 69%, MS: [M+H]⁺= 791) 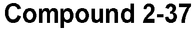 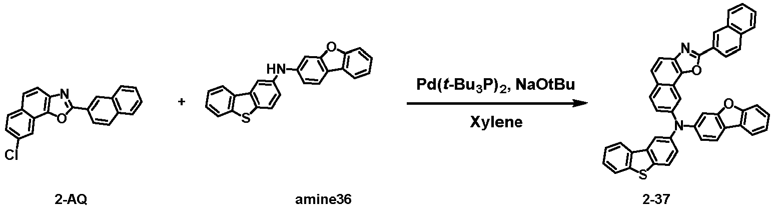
Compound 2-AQ (10 g, 30.3 mmol), Compound amine36 (11.1 g, 30.3 mmol) and sodium tert-butoxide (9.7 g, 45.5 mmol) were added to xylene (200 ml) under a nitrogen atmosphere, and the mixture was stirred and refluxed. Then, bis(tri-tert-butylphosphine)palladium(0) (0.2 g, 0.4 mmol) was added thereto. After the reaction was completed after 3 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by silica gel column chromatography to give 13.6 g of Compound 2-37. (Yield: 68%, MS: [M+H]⁺= 659) 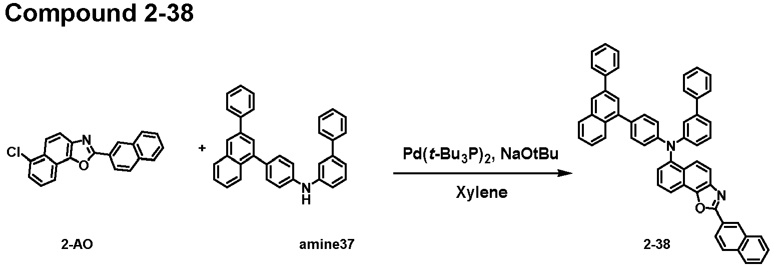
Compound 2-AO (10 g, 30.3 mmol), Compound amine37 (13.6 g, 30.3 mmol) and sodium tert-butoxide (9.7 g, 45.5 mmol) were added to xylene (200 ml) under a nitrogen atmosphere, and the mixture was stirred and refluxed. Then, bis(tri-tert-butylphosphine)palladium(0) (0.2 g, 0.4 mmol) was added thereto. After the reaction was completed after 2 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by silica gel column chromatography to give 14.4 g of Compound 2-38. (Yield: 64%, MS: [M+H]⁺= 741) 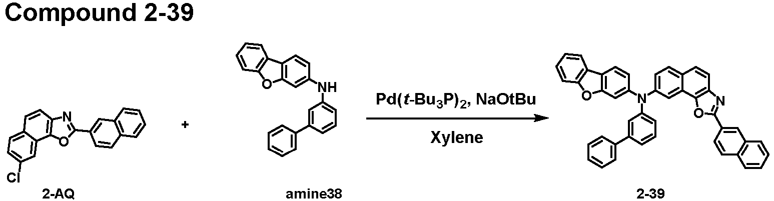
Compound 2-AQ (10 g, 30.3 mmol), Compound amine38 (10.2 g, 30.3 mmol) and sodium tert-butoxide (9.7 g, 45.5 mmol) were added to xylene (200 ml) under a nitrogen atmosphere, and the mixture was stirred and refluxed. Then, bis(tri-tert-butylphosphine)palladium(0) (0.2 g, 0.4 mmol) was added thereto. After the reaction was completed after 2 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by silica gel column chromatography to give 12 g of Compound 2-39. (Yield: 63%, MS: [M+H]⁺= 629) 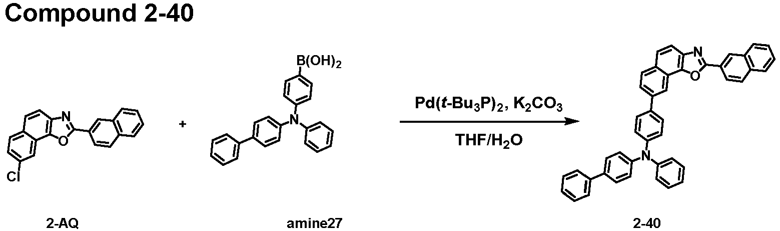
Compound 2-AQ (15 g, 45.5 mmol) and Compound amine27 (17.4 g, 47.8 mmol) were added to THF (300 ml) under a nitrogen atmosphere, and the mixture was stirred and refluxed. Then, potassium carbonate (18.9 g, 136.5 mmol) was dissolved in water (57 ml), added thereto, stirred sufficiently, and then bis(tri-tert-butylphosphine)palladium(0) (0.5 g, 1.0 mmol) was added. After the reaction for 8 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 18.4 g of Compound 2-40. (Yield: 66%, MS: [M+H]⁺= 615) 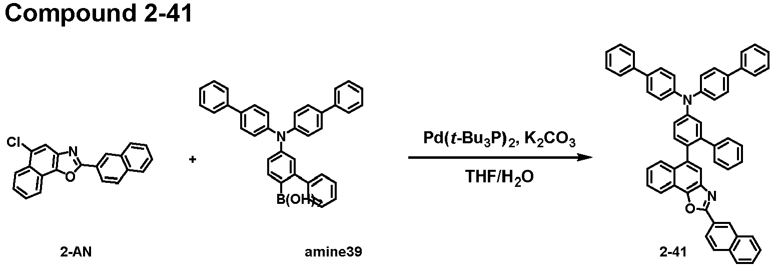
Compound 2-AN (15 g, 45.5 mmol) and Compound amine39 (24.7 g, 47.8 mmol) were added to THF (300 ml) under a nitrogen atmosphere, and the mixture was stirred and refluxed. Then, potassium carbonate (18.9 g, 136.5 mmol) was dissolved in water (57 ml), added thereto, stirred sufficiently, and then bis(tri-tert-butylphosphine)palladium(0) (0.5 g, 1.0 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 20.9 g of Compound 2-41. (Yield: 60%, MS: [M+H]⁺= 767) 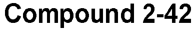 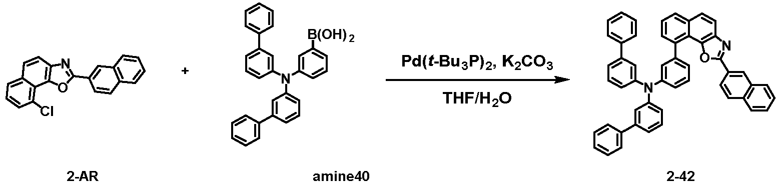
Compound 2-AR (15 g, 45.5 mmol) and Compound amine40 (21.1 g, 47.8 mmol) were added to THF (300 ml) under a nitrogen atmosphere, and the mixture was stirred and refluxed. Then, potassium carbonate (18.9 g, 136.5 mmol) was dissolved in water (57 ml), added thereto, stirred sufficiently, and then bis(tri-tert-butylphosphine)palladium(0) (0.5 g, 1.0 mmol) was added. After the reaction for 9 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 20.7 g of Compound 2-42. (Yield: 66%, MS: [M+H]⁺= 691) 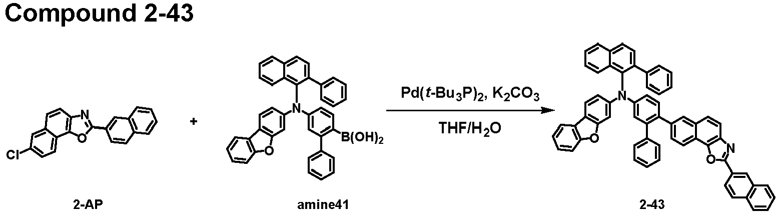
Compound 2-AP (15 g, 45.5 mmol) and Compound amine41 (27.8 g, 47.8 mmol) were added to THF (300 ml) under a nitrogen atmosphere, and the mixture was stirred and refluxed. Then, potassium carbonate (18.9 g, 136.5 mmol) was dissolved in water (57 ml), added thereto, stirred sufficiently, and then bis(tri-tert-butylphosphine)palladium(0) (0.5 g, 1.0 mmol) was added. After the reaction for 8 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 26.1 g of Compound 2-43. (Yield: 69%, MS: [M+H]⁺= 831) 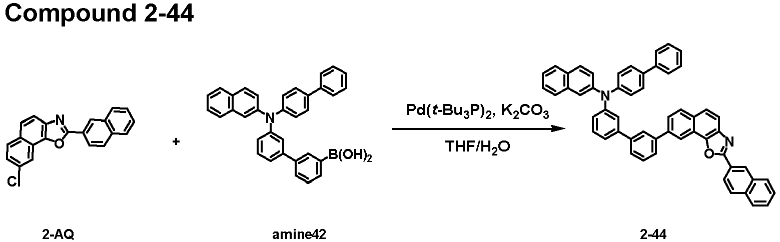
Compound 2-AQ (15 g, 45.5 mmol) and Compound amine42 (23.5 g, 47.8 mmol) were added to THF (300 ml) under a nitrogen atmosphere, and the mixture was stirred and refluxed. Then, potassium carbonate (18.9 g, 136.5 mmol) was dissolved in water (57 ml), added thereto, stirred sufficiently, and then bis(tri-tert-butylphosphine)palladium(0) (0.5 g, 1.0 mmol) was added. After the reaction for 8 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 22.9 g of Compound 2-44. (Yield: 68%, MS: [M+H]⁺= 741) 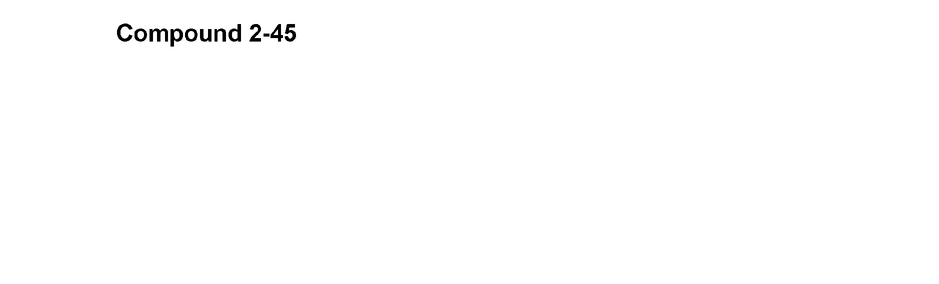 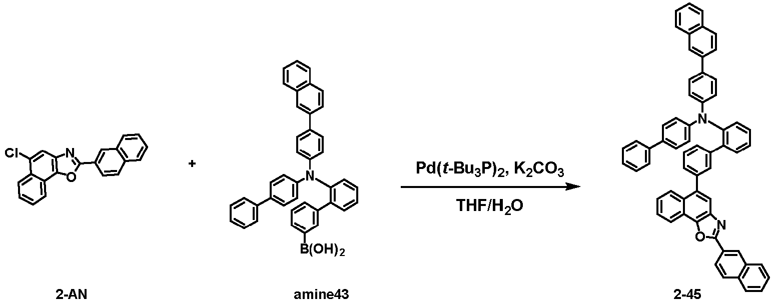
Compound 2-AN (15 g, 45.5 mmol) and Compound amine43 (27.1 g, 47.8 mmol) were added to THF (300 ml) under a nitrogen atmosphere, and the mixture was stirred and refluxed. Then, potassium carbonate (18.9 g, 136.5 mmol) was dissolved in water (57 ml), added thereto, stirred sufficiently, and then bis(tri-tert-butylphosphine)palladium(0) (0.5 g, 1.0 mmol) was added. After the reaction for 12 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 26 g of Compound 2-45. (Yield: 70%, MS: [M+H]⁺= 817) 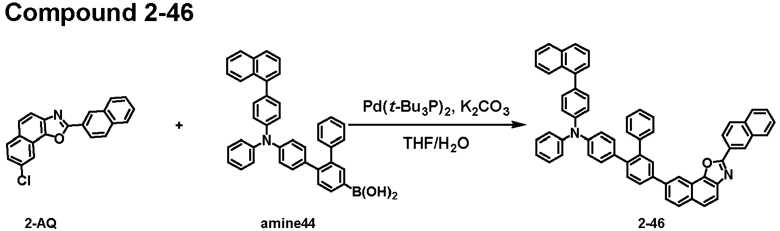
Compound 2-AQ (15 g, 45.5 mmol) and Compound amine44 (27.1 g, 47.8 mmol) were added to THF (300 ml) under a nitrogen atmosphere, and the mixture was stirred and refluxed. Then, potassium carbonate (18.9 g, 136.5 mmol) was dissolved in water (57 ml), added thereto, stirred sufficiently, and then bis(tri-tert-butylphosphine)palladium(0) (0.5 g, 1.0 mmol) was added. After the reaction for 12 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 22.3 g of Compound 2-46. (Yield: 60%, MS: [M+H]⁺= 817) 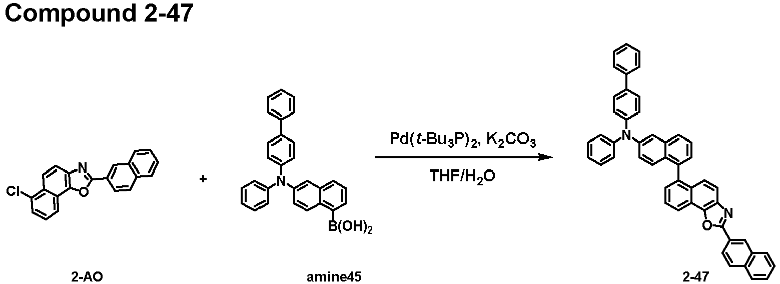
Compound 2-AQ (15 g, 43.4 mmol) and Compound amine45 (25.8 g, 45.5 mmol) were added to THF (300 ml) under a nitrogen atmosphere, and the mixture was stirred and refluxed. Then, potassium carbonate (18 g, 130.1 mmol) was dissolved in water (54 ml), added thereto, stirred sufficiently, and then bis(tri-tert-butylphosphine)palladium(0) (0.5 g, 1.0 mmol) was added. After the reaction for 9 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 19.5 g of Compound 2-47. (Yield: 54%, MS: [M+H]⁺= 833) 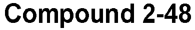 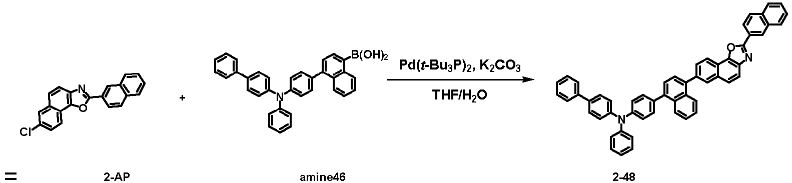
Compound 2-AP (15 g, 45.5 mmol) and Compound amine46 (23.5 g, 47.8 mmol) were added to THF (300 ml) under a nitrogen atmosphere, and the mixture was stirred and refluxed. Then, potassium carbonate (18.9 g, 136.5 mmol) was dissolved in water (57 ml), added thereto, stirred sufficiently, and then bis(tri-tert-butylphosphine)palladium(0) (0.5 g, 1.0 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 20.2 g of Compound 2-48. (Yield: 60%, MS: [M+H]⁺= 741) 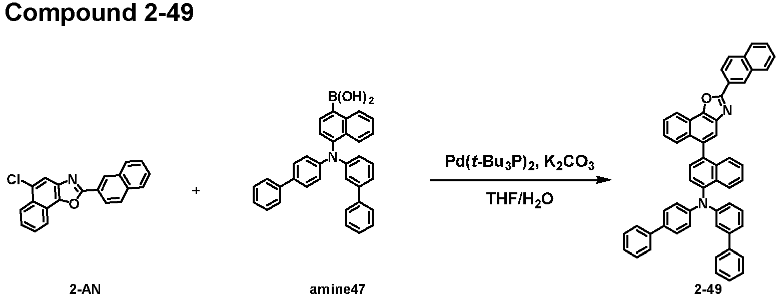
Compound 2-AN (15 g, 45.5 mmol) and Compound amine47 (23.5 g, 47.8 mmol) were added to THF (300 ml) under a nitrogen atmosphere, and the mixture was stirred and refluxed. Then, potassium carbonate (18.9 g, 136.5 mmol) was dissolved in water (57 ml), added thereto, stirred sufficiently, and then bis(tri-tert-butylphosphine)palladium(0) (0.5 g, 1.0 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 21.5 g of Compound 2-49. (Yield: 64%, MS: [M+H]⁺= 741) 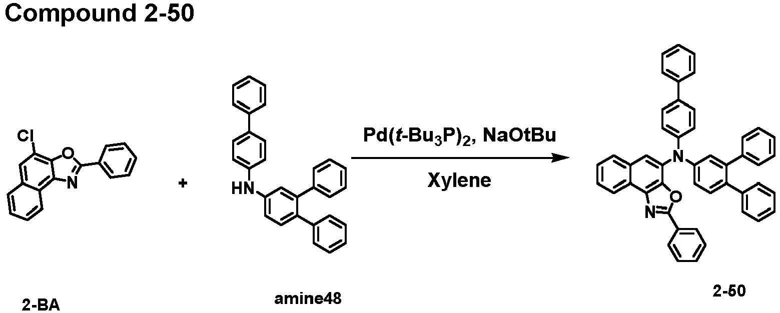
Compound 2-BA (10 g, 30.3 mmol), Compound amine48 (12.1 g, 30.3 mmol) and sodium tert-butoxide (9.7 g, 45.5 mmol) were added to xylene (200 ml) under a nitrogen atmosphere, and the mixture was stirred and refluxed. Then, bis(tri-tert-butylphosphine)palladium(0) (0.2 g, 0.4 mmol) was added thereto. After the reaction was completed after 2 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by silica gel column chromatography to give 11.8 g of Compound 2-50. (Yield: 61 %, MS: [M+H]⁺= 641) 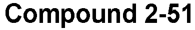 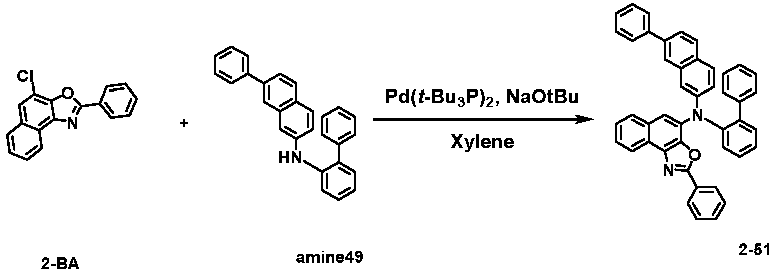
Compound 2-BA (10 g, 30.3 mmol), Compound amine49 (11.3 g, 30.3 mmol) and sodium tert-butoxide (9.7 g, 45.5 mmol) were added to xylene (200 ml) under a nitrogen atmosphere, and the mixture was stirred and refluxed. Then, bis(tri-tert-butylphosphine)palladium(0) (0.2 g, 0.4 mmol) was added thereto. After the reaction was completed after 3 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by silica gel column chromatography to give 11.7 g of Compound 2-51. (Yield: 63%, MS: [M+H]⁺= 615) 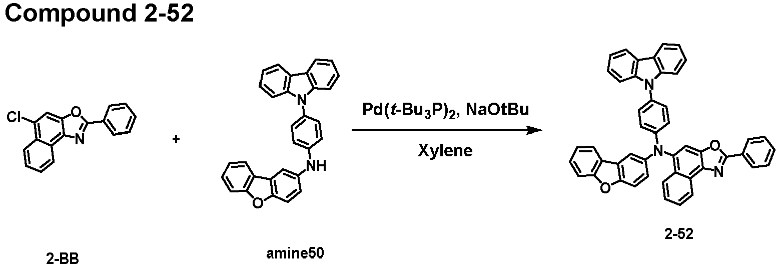
Compound 2-BB (10 g, 30.3 mmol), Compound amine50 (12.9 g, 30.3 mmol) and sodium tert-butoxide(9.7 g, 45.5 mmol) were added to xylene (200 ml) under a nitrogen atmosphere, and the mixture was stirred and refluxed. Then, bis(tri-tert-butylphosphine)palladium(0) (0.2 g, 0.4 mmol) was added thereto. After the reaction was completed after 2 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by silica gel column chromatography to give 14 g of Compound 2-52. (Yield: 69%, MS: [M+H]⁺= 668) 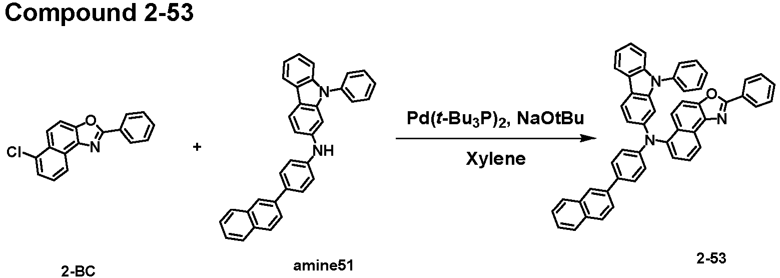
Compound 2-BC (10 g, 30.3 mmol), Compound amine51 (14 g, 30.3 mmol) and sodium tert-butoxide (9.7 g, 45.5 mmol) were added to xylene (200 ml) under a nitrogen atmosphere, and the mixture was stirred and refluxed. Then, bis(tri-tert-butylphosphine)palladium(0) (0.2 g, 0.4 mmol) was added thereto. After the reaction was completed after 2 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by silica gel column chromatography to give 12.8 g of Compound 2-53. (Yield: 60%, MS: [M+H]⁺= 704) 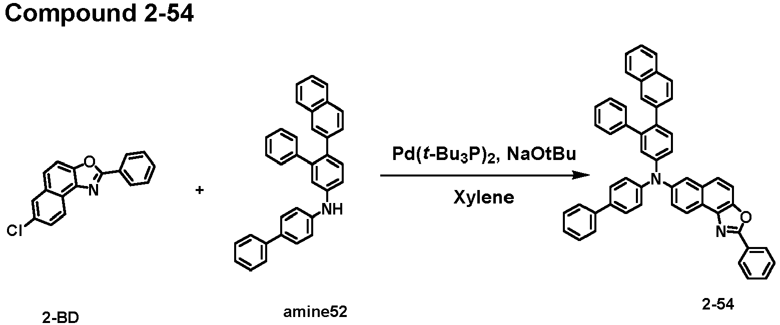
Compound 2-BD (10 g, 30.3 mmol), Compound amine52 (13.6 g, 30.3 mmol) and sodium tert-butoxide (9.7 g, 45.5 mmol) were added to xylene (200 ml) under a nitrogen atmosphere, and the mixture was stirred and refluxed. Then, bis(tri-tert-butylphosphine)palladium(0) (0.2 g, 0.4 mmol) was added thereto. After the reaction was completed after 2 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by silica gel column chromatography to give 12.6 g of Compound 2-54. (Yield: 60%, MS: [M+H]⁺= 691) 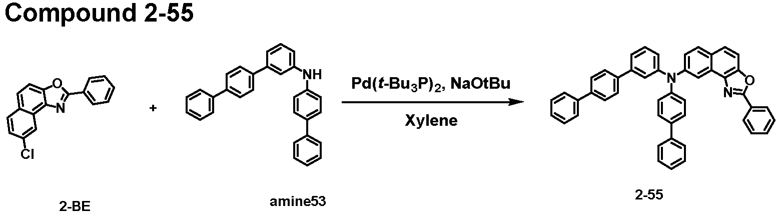
Compound 2-BE (10 g, 30.3 mmol), Compound amine53 (12.1 g, 30.3 mmol) and sodium tert-butoxide (9.7 g, 45.5 mmol) were added to xylene (200 ml) under a nitrogen atmosphere, and the mixture was stirred and refluxed. Then, bis(tri-tert-butylphosphine)palladium(0) (0.2 g, 0.4 mmol) was added thereto. After the reaction was completed after 2 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by silica gel column chromatography to give 13.2 g of Compound 2-55. (Yield: 68%, MS: [M+H]⁺= 641) 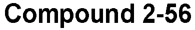 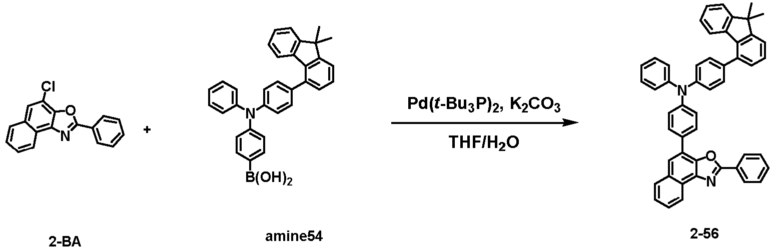
Compound 2-BA (15 g, 53.6 mmol) and Compound amine54 (27.1 g, 56.3 mmol) were added to THF (300 ml) under a nitrogen atmosphere, and the mixture was stirred and refluxed. Then, potassium carbonate (22.2 g, 160.9 mmol) was dissolved in water (67 ml), added thereto, stirred sufficiently, and then bis(tri-tert-butylphosphine)palladium(0) (0.6 g, 1.2 mmol) was added. After the reaction for 8 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 21.9 g of Compound 2-56. (Yield: 60%, MS: [M+H]⁺= 681) 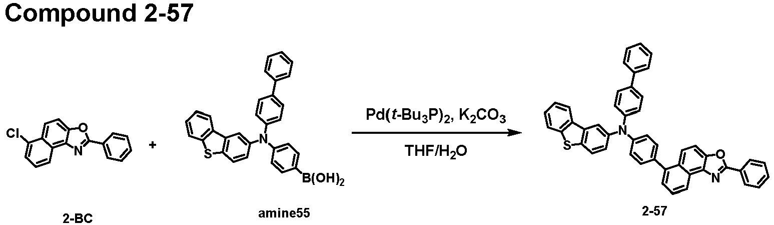
Compound 2-BC (15 g, 53.6 mmol) and Compound amine55 (26.5 g, 56.3 mmol) were added to THF (300 ml) under a nitrogen atmosphere, and the mixture was stirred and refluxed. Then, potassium carbonate (22.2 g, 160.9 mmol) was dissolved in water (67 ml), added thereto, stirred sufficiently, and then bis(tri-tert-butylphosphine)palladium(0) (0.6 g, 1.2 mmol) was added. After the reaction for 8 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 23 g of Compound 2-57. (Yield: 64%, MS: [M+H]⁺= 671) 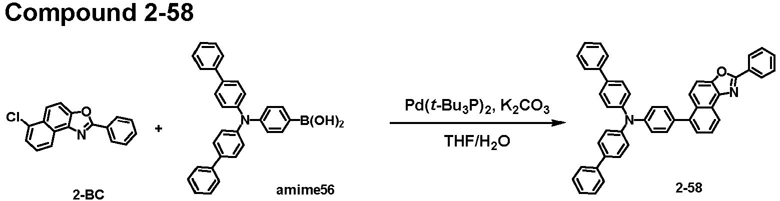
Compound 2-BC (15 g, 53.6 mmol) and Compound amine56 (24.9 g, 56.3 mmol) were added to THF (300 ml) under a nitrogen atmosphere, and the mixture was stirred and refluxed. Then, potassium carbonate (22.2 g, 160.9 mmol) was dissolved in water (67 ml), added thereto, stirred sufficiently, and then bis(tri-tert-butylphosphine)palladium(0) (0.6 g, 1.2 mmol) was added. After the reaction for 8 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 22.7 g of Compound 2-58. (Yield: 66%, MS: [M+H]⁺= 641) 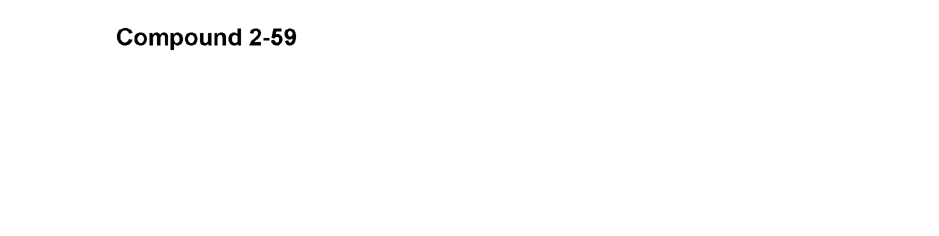 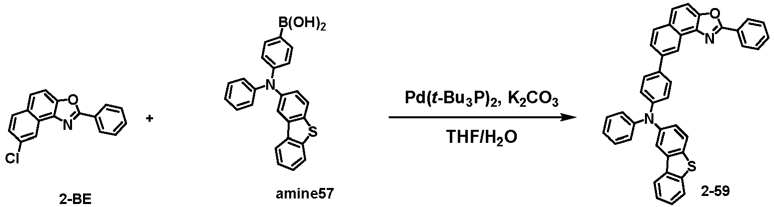
Compound 2-BE (15 g, 53.6 mmol) and Compound amine57 (22.3 g, 56.3 mmol) were added to THF (300 ml) under a nitrogen atmosphere, and the mixture was stirred and refluxed. Then, potassium carbonate (22.2 g, 160.9 mmol) was dissolved in water (67 ml), added thereto, stirred sufficiently, and then bis(tri-tert-butylphosphine)palladium(0) (0.6 g, 1.2 mmol) was added. After the reaction for 9 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 22.3 g of Compound 2-59. (Yield: 70%, MS: [M+H]⁺= 595) 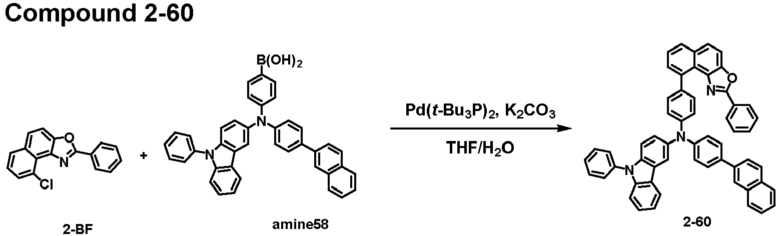
Compound 2-BF (15 g, 53.6 mmol) and Compound amine58 (32.7 g, 56.3 mmol) were added to THF (300 ml) under a nitrogen atmosphere, and the mixture was stirred and refluxed. Then, potassium carbonate (22.2 g, 160.9 mmol) was dissolved in water (67 ml), added thereto, stirred sufficiently, and then bis(tri-tert-butylphosphine)palladium(0) (0.6 g, 1.2 mmol) was added. After the reaction for 8 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 25.5 g of Compound 2-60. (Yield: 61%, MS: [M+H]⁺= 780) 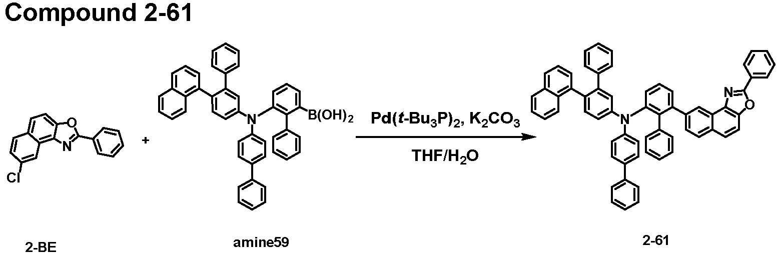
Compound 2-BE (15 g, 53.6 mmol) and Compound amine59 (36.2 g, 56.3 mmol) were added to THF (300 ml) under a nitrogen atmosphere, and the mixture was stirred and refluxed. Then, potassium carbonate (22.2 g, 160.9 mmol) was dissolved in water (67 ml), added thereto, stirred sufficiently, and then bis(tri-tert-butylphosphine)palladium(0) (0.6 g, 1.2 mmol) was added. After the reaction for 8 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 31.6 g of Compound 2-61 . (Yield: 70%, MS: [M+H]⁺= 843) 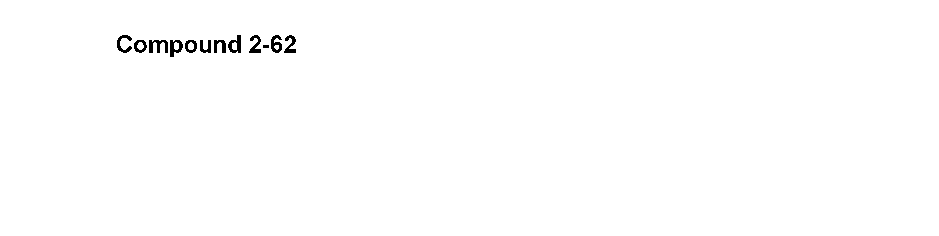 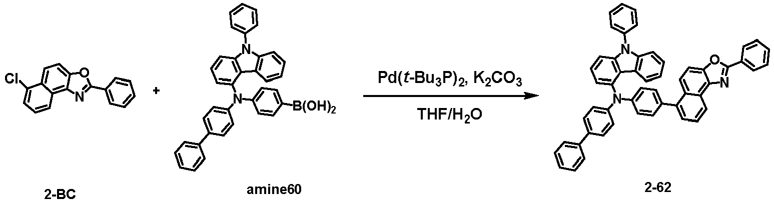
Compound 2-BC (15 g, 53.6 mmol) and Compound amine60 (29.9 g, 56.3 mmol) were added to THF (300 ml) under a nitrogen atmosphere, and the mixture was stirred and refluxed. Then, potassium carbonate (22.2 g, 160.9 mmol) was dissolved in water (67 ml), added thereto, stirred sufficiently, and then bis(tri-tert-butylphosphine)palladium(0) (0.6 g, 1.2 mmol) was added. After the reaction for 12 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 26.2 g of Compound 2-62. (Yield: 67%, MS: [M+H]⁺= 730) 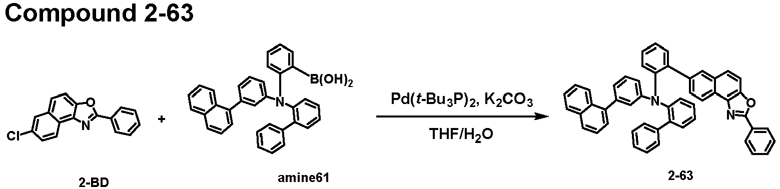
Compound 2-BD (15 g, 53.6 mmol) and Compound amine61 (27.7 g, 56.3 mmol) were added to THF (300 ml) under a nitrogen atmosphere, and the mixture was stirred and refluxed. Then, potassium carbonate (22.2 g, 160.9 mmol) was dissolved in water (67 ml), added thereto, stirred sufficiently, and then bis(tri-tert-butylphosphine)palladium(0) (0.6 g, 1.2 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 22.2 g of Compound 2-63. (Yield: 60%, MS: [M+H]⁺= 691) 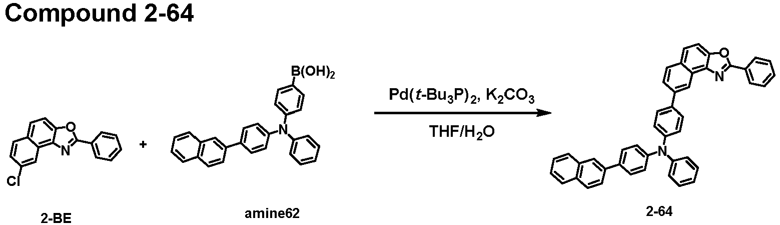
Compound 2-BE (15 g, 53.6 mmol) and Compound amine62 (23.4 g, 56.3 mmol) were added to THF (300 ml) under a nitrogen atmosphere, and the mixture was stirred and refluxed. Then, potassium carbonate (22.2 g, 160.9 mmol) was dissolved in water (67 ml), added thereto, stirred sufficiently, and then bis(tri-tert-butylphosphine)palladium(0) (0.6 g, 1.2 mmol) was added. After the reaction for 9 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 21.1 g of Compound 2-64. (Yield: 64%, MS: [M+H]⁺= 615) 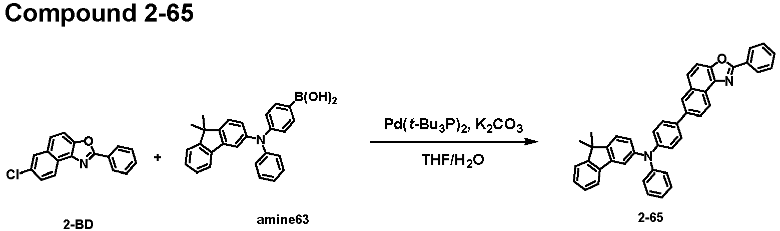
Compound 2-BD (15 g, 53.6 mmol) and Compound amine63 (22.8 g, 56.3 mmol) were added to THF (300 ml) under a nitrogen atmosphere, and the mixture was stirred and refluxed. Then, potassium carbonate (22.2 g, 160.9 mmol) was dissolved in water (67 ml), added thereto, stirred sufficiently, and then bis(tri-tert-butylphosphine)palladium(0) (0.6 g, 1.2 mmol) was added. After the reaction for 8 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 21.7 g of Compound 2-65. (Yield: 67%, MS: [M+H]⁺= 605) 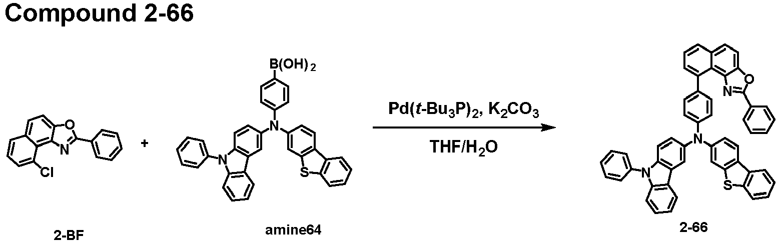
Compound 2-BF (15 g, 53.6 mmol) and Compound amine64 (31.6 g, 56.3 mmol) were added to THF (300 ml) under a nitrogen atmosphere, and the mixture was stirred and refluxed. Then, potassium carbonate (22.2 g, 160.9 mmol) was dissolved in water (67 ml), added thereto, stirred sufficiently, and then bis(tri-tert-butylphosphine)palladium(0) (0.6 g, 1.2 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 26.9 g of Compound 2-66. (Yield: 66%, MS: [M+H]⁺= 760) 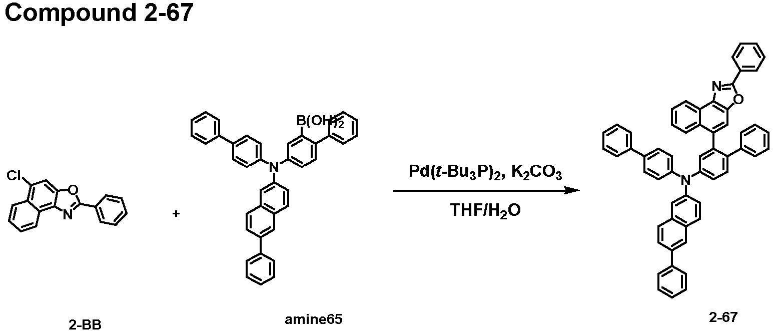
Compound 2-BB (15 g, 53.6 mmol) and Compound amine65 (32 g, 56.3 mmol) were added to THF (300 ml) under a nitrogen atmosphere, and the mixture was stirred and refluxed. Then, potassium carbonate (22.2 g, 160.9 mmol) was dissolved in water (67 ml), added thereto, stirred sufficiently, and then bis(tri-tert-butylphosphine)palladium(0) (0.6 g, 1.2 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 27.1 g of Compound 2-67. (Yield: 66%, MS: [M+H]⁺= 767) 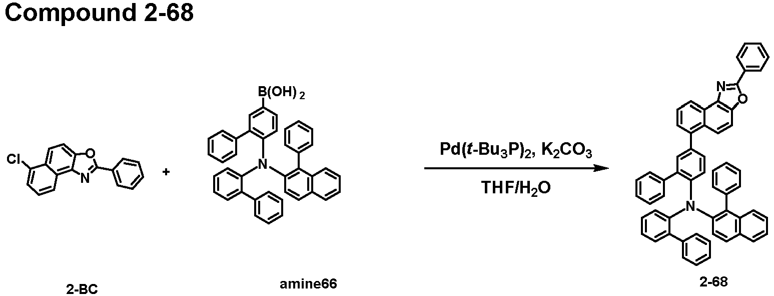
Compound 2-BC (15 g, 53.6 mmol) and Compound amine66 (32 g, 56.3 mmol) were added to THF (300 ml) under a nitrogen atmosphere, and the mixture was stirred and refluxed. Then, potassium carbonate (22.2 g, 160.9 mmol) was dissolved in water (67 ml), added thereto, stirred sufficiently, and then bis(tri-tert-butylphosphine)palladium(0) (0.6 g, 1.2 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 19.8 g of Compound 2-68. (Yield: 65%, MS: [M+H]⁺= 569) 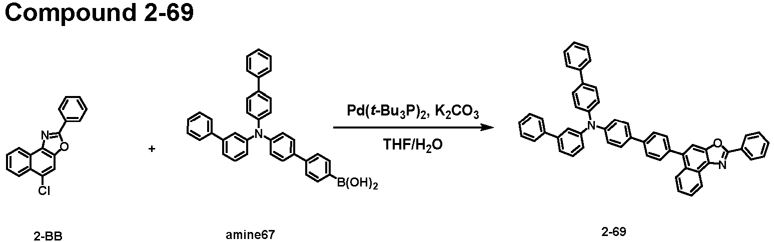
Compound 2-BB (15 g, 53.6 mmol) and Compound amine67 (29.1 g, 56.3 mmol) were added to THF (300 ml) under a nitrogen atmosphere, and the mixture was stirred and refluxed. Then, potassium carbonate (22.2 g, 160.9 mmol) was dissolved in water (67 ml), added thereto, stirred sufficiently, and then bis(tri-tert-butylphosphine)palladium(0) (0.6 g, 1.2 mmol) was added. After the reaction for 9 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 26.5 g of Compound 2-69. (Yield: 69%, MS: [M+H]⁺= 717) 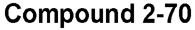 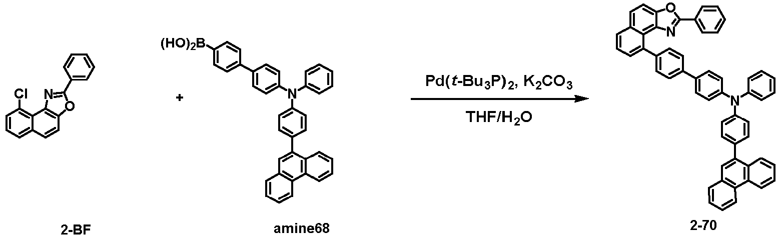
Compound 2-BF (15 g, 53.6 mmol) and Compound amine68 (30.5 g, 56.3 mmol) were added to THF (300 ml) under a nitrogen atmosphere, and the mixture was stirred and refluxed. Then, potassium carbonate (22.2 g, 160.9 mmol) was dissolved in water (67 ml), added thereto, stirred sufficiently, and then bis(tri-tert-butylphosphine)palladium(0) (0.6 g, 1.2 mmol) was added. After the reaction for 12 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 25 g of Compound 2-70. (Yield: 63%, MS: [M+H]⁺= 741) 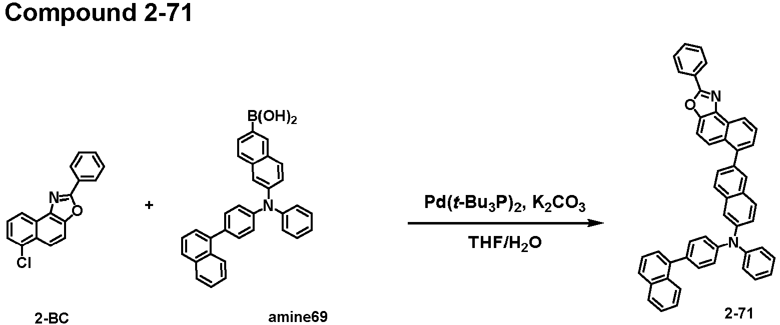
Compound 2-BC (15 g, 53.6 mmol) and Compound amine69 (26.2 g, 56.3 mmol) were added to THF (300 ml) under a nitrogen atmosphere, and the mixture was stirred and refluxed. Then, potassium carbonate (22.2 g, 160.9 mmol) was dissolved in water (67 ml), added thereto, stirred sufficiently, and then bis(tri-tert-butylphosphine)palladium(0) (0.6 g, 1.2 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 22.1 g of Compound 2-71. (Yield: 62%, MS: [M+H]⁺= 665) 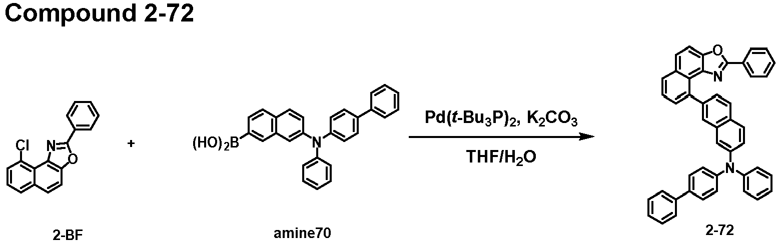
Compound 2-BF (15 g, 53.6 mmol) and Compound amine70 (23.4 g, 56.3 mmol) were added to THF (300 ml) under a nitrogen atmosphere, and the mixture was stirred and refluxed. Then, potassium carbonate (22.2 g, 160.9 mmol) was dissolved in water (67 ml), added thereto, stirred sufficiently, and then bis(tri-tert-butylphosphine)palladium(0) (0.6 g, 1.2 mmol) was added. After the reaction for 9 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 21.7 g of Compound 2-72. (Yield: 66%, MS: [M+H]⁺= 615) 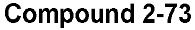 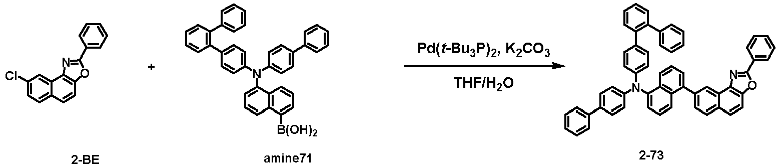
Compound 2-BE (15 g, 53.6 mmol) and Compound amine71 (32 g, 56.3 mmol) were added to THF (300 ml) under a nitrogen atmosphere, and the mixture was stirred and refluxed. Then, potassium carbonate (22.2 g, 160.9 mmol) was dissolved in water (67 ml), added thereto, stirred sufficiently, and then bis(tri-tert-butylphosphine)palladium(0) (0.6 g, 1.2 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 25.5 g of Compound 2-73. (Yield: 62%, MS: [M+H]⁺= 767) 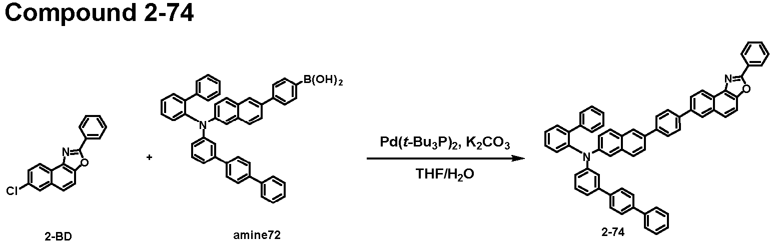
Compound 2-BD (15 g, 53.6 mmol) and Compound amine72 (36.2 g, 56.3 mmol) were added to THF (300 ml) under a nitrogen atmosphere, and the mixture was stirred and refluxed. Then, potassium carbonate (22.2 g, 160.9 mmol) was dissolved in water (67 ml), added thereto, stirred sufficiently, and then bis(tri-tert-butylphosphine)palladium(0) (0.6 g, 1.2 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 30.7 g of Compound 2-74. (Yield: 68%, MS: [M+H]⁺= 843) 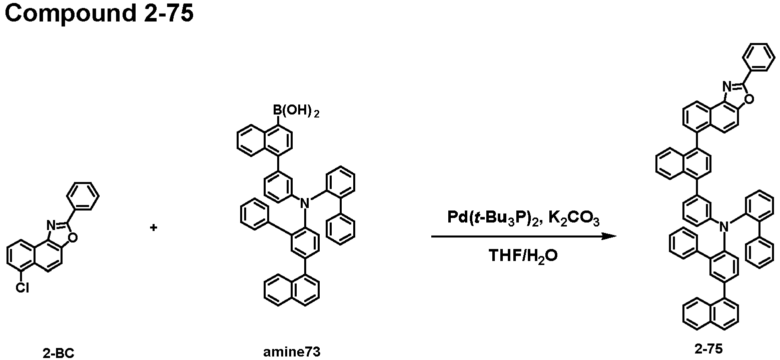
Compound 2-BC (15 g, 53.6 mmol) and Compound amine73 (39.1 g, 56.3 mmol) were added to THF (300 ml) under a nitrogen atmosphere, and the mixture was stirred and refluxed. Then, potassium carbonate (22.2 g, 160.9 mmol) was dissolved in water (67 ml), added thereto, stirred sufficiently, and then bis(tri-tert-butylphosphine)palladium(0) (0.6 g, 1.2 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 29.7 g of Compound 2-75. (Yield: 62%, MS: [M+H]⁺= 893) 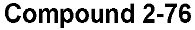 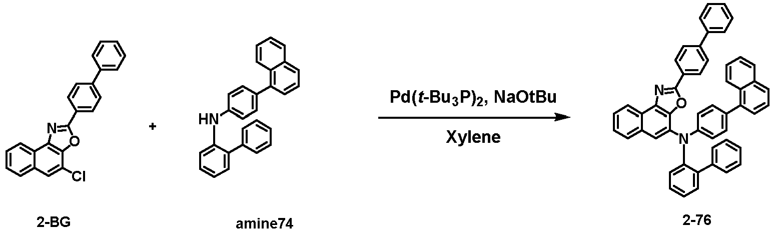
Compound 2-BG (10 g, 28.1 mmol), Compound amine74 (10.4 g, 28.1 mmol) and sodium tert-butoxide (8.9 g, 42.2 mmol) were added to xylene (200 ml) under a nitrogen atmosphere, and the mixture was stirred and refluxed. Then, bis(tri-tert-butylphosphine)palladium(0) (0.1 g, 0.2 mmol) was added thereto. After the reaction was completed after 2 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by silica gel column chromatography to give 12.6 g of Compound 2-76. (Yield: 65%, MS: [M+H]⁺= 691) 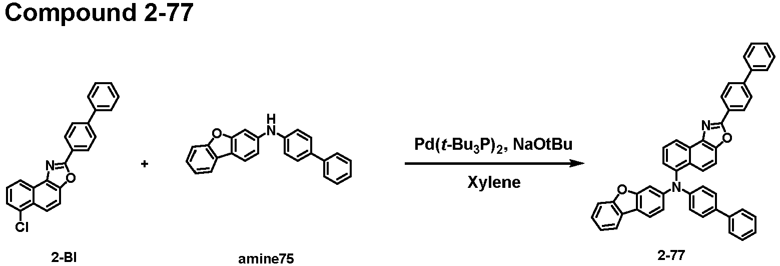
Compound 2-BI (10 g, 28.1 mmol), Compound amine75 (9.4 g, 28.1 mmol) and sodium tert-butoxide (8.9 g, 42.2 mmol) were added to xylene (200 ml) under a nitrogen atmosphere, and the mixture was stirred and refluxed. Then, bis(tri-tert-butylphosphine)palladium(0) (0.1 g, 0.2 mmol) was added thereto. After the reaction was completed after 2 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by silica gel column chromatography to give 11 g of Compound 2-77. (Yield: 60%, MS: [M+H]⁺= 655) 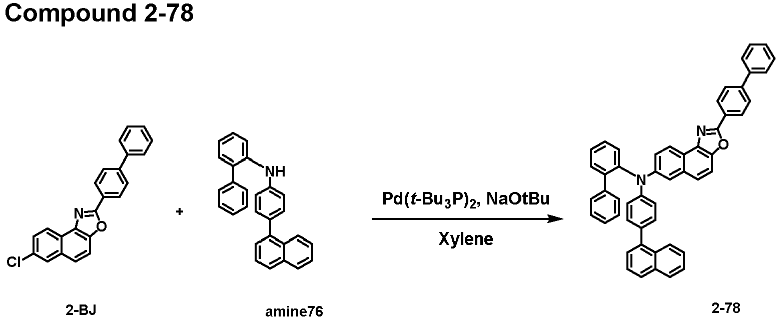
Compound 2-BJ (10 g, 28.1 mmol), Compound amine76 (10.4 g, 28.1 mmol) and sodium tert-butoxide (8.9 g, 42.2 mmol) were added to xylene (200 ml) under a nitrogen atmosphere, and the mixture was stirred and refluxed. Then, bis(tri-tert-butylphosphine)palladium(0) (0.1 g, 0.2 mmol) was added thereto. After the reaction was completed after 3 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by silica gel column chromatography to give 11.8 g of Compound 2-78. (Yield: 61 %, MS: [M+H]⁺= 691) 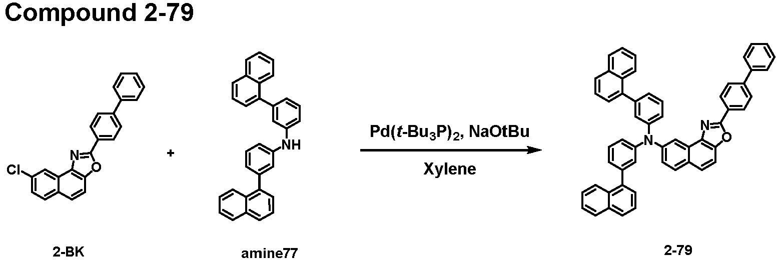
Compound 2-BK (10 g, 28.1 mmol), Compound amine77 (11.8 g, 28.1 mmol) and sodium tert-butoxide (8.9 g, 42.2 mmol) were added to xylene (200 ml) under a nitrogen atmosphere, and the mixture was stirred and refluxed. Then, bis(tri-tert-butylphosphine)palladium(0) (0.1 g, 0.2 mmol) was added thereto. After the reaction was completed after 2 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by silica gel column chromatography to give 13.1 g of Compound 2-79. (Yield: 63%, MS: [M+H]⁺= 741) 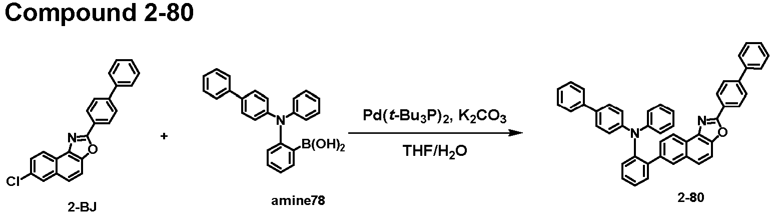
Compound 2-BJ (15 g, 42.2 mmol) and Compound amine78 (16.2 g, 44.3 mmol) were added to THF (300 ml) under a nitrogen atmosphere, and the mixture was stirred and refluxed. Then, potassium carbonate (17.5 g, 126.5 mmol) was dissolved in water (52 ml), added thereto, stirred sufficiently, and then bis(tri-tert-butylphosphine)palladium(0) (0.5 g, 1.0 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 18.1 g of Compound 2-80. (Yield: 67%, MS: [M+H]⁺= 641) 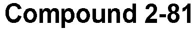 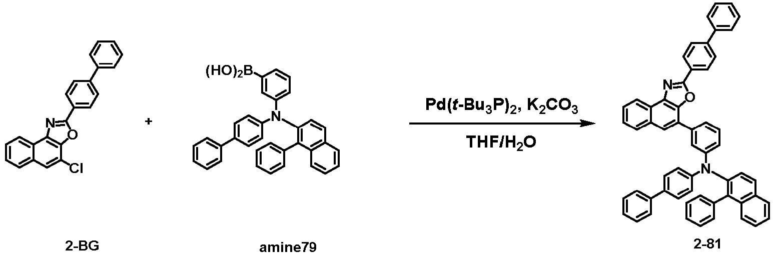
Compound 2-BG (15 g, 42.2 mmol) and Compound amine79 (21.8 g, 44.3 mmol) were added to THF (300 ml) under a nitrogen atmosphere, and the mixture was stirred and refluxed. Then, potassium carbonate (17.5 g, 126.5 mmol) was dissolved in water (52 ml), added thereto, stirred sufficiently, and then bis(tri-tert-butylphosphine)palladium(0) (0.5 g, 1.0 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 19.7 g of Compound 2-81. (Yield: 61%, MS: [M+H]⁺= 767) 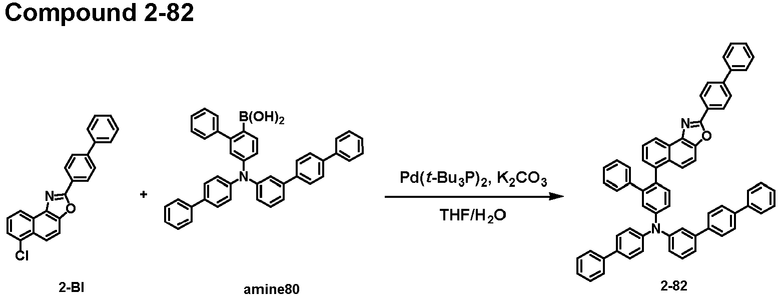
Compound 2-BI (15 g, 42.2 mmol) and Compound amine80 (26.3 g, 44.3 mmol) were added to THF (300 ml) under a nitrogen atmosphere, and the mixture was stirred and refluxed. Then, potassium carbonate (17.5 g, 126.5 mmol) was dissolved in water (52 ml), added thereto, stirred sufficiently, and then bis(tri-tert-butylphosphine)palladium(0) (0.5 g, 1.0 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 24.9 g of Compound 2-82. (Yield: 68%, MS: [M+H]⁺= 869) 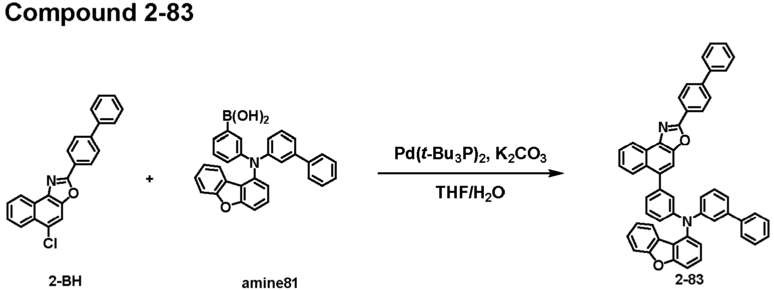
Compound 2-BH (15 g, 42.2 mmol) and Compound amine81 (20.2 g, 44.3 mmol) were added to THF (300 ml) under a nitrogen atmosphere, and the mixture was stirred and refluxed. Then, potassium carbonate (17.5 g, 126.5 mmol) was dissolved in water (52 ml), added thereto, stirred sufficiently, and then bis(tri-tert-butylphosphine)palladium(0) (0.5 g, 1.0 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 19.7 g of Compound 2-83 . (Yield: 64%, MS: [M+H]⁺= 731) 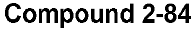 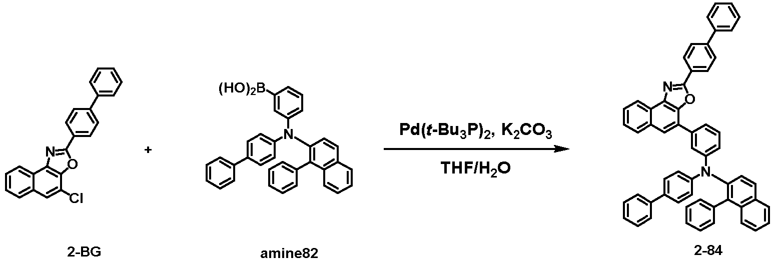
Compound 2-BG (15 g, 42.2 mmol) and Compound amine82 (21.8 g, 44.3 mmol) were added to THF (300 ml) under a nitrogen atmosphere, and the mixture was stirred and refluxed. Then, potassium carbonate (17.5 g, 126.5 mmol) was dissolved in water (52 ml), added thereto, stirred sufficiently, and then bis(tri-tert-butylphosphine)palladium(0) (0.5 g, 1.0 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 20 g of Compound 2-84. (Yield: 62%, MS: [M+H]⁺= 767) 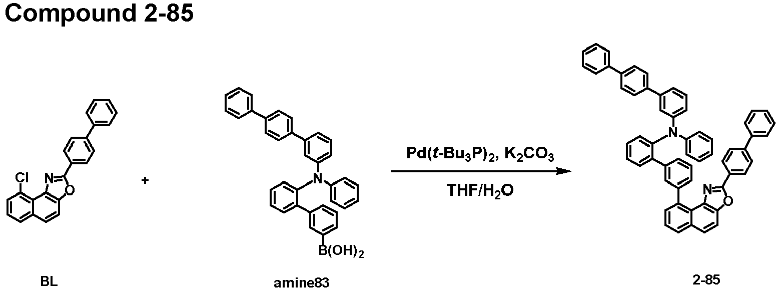
Compound 2-BL (15 g, 42.2 mmol) and Compound amine83 (22.9 g, 44.3 mmol) were added to THF (300 ml) under a nitrogen atmosphere, and the mixture was stirred and refluxed. Then, potassium carbonate (17.5 g, 126.5 mmol) was dissolved in water (52 ml), added thereto, stirred sufficiently, and then bis(tri-tert-butylphosphine)palladium(0) (0.5 g, 1.0 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 20 g of Compound 2-85. (Yield: 60%, MS: [M+H]⁺= 793) 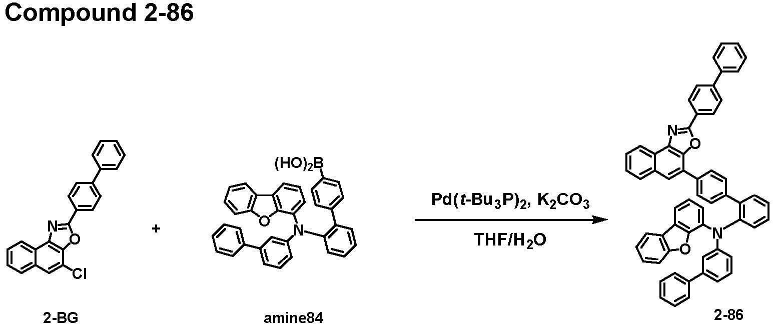
Compound 2-BG (15 g, 42.2 mmol) and Compound amine84 (23.5 g, 44.3 mmol) were added to THF (300 ml) under a nitrogen atmosphere, and the mixture was stirred and refluxed. Then, potassium carbonate (17.5 g, 126.5 mmol) was dissolved in water (52 ml), added thereto, stirred sufficiently, and then bis(tri-tert-butylphosphine)palladium(0) (0.5 g, 1.0 mmol) was added. After the reaction for 9 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 23.5 g of Compound 2-86 . (Yield: 69%, MS: [M+H]⁺= 807) 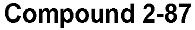 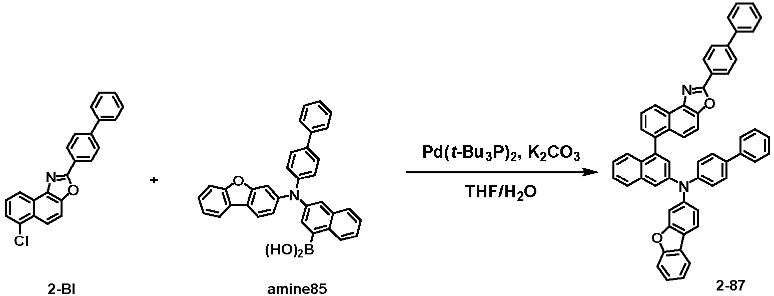
Compound 2-BI (15 g, 42.2 mmol) and Compound amine85 (22.4 g, 44.3 mmol) were added to THF (300 ml) under a nitrogen atmosphere, and the mixture was stirred and refluxed. Then, potassium carbonate (17.5 g, 126.5 mmol) was dissolved in water (52 ml), added thereto, stirred sufficiently, and then bis(tri-tert-butylphosphine)palladium(0) (0.5 g, 1.0 mmol) was added. After the reaction for 9 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 22.7 g of Compound 2-87. (Yield: 69%, MS: [M+H]⁺= 781) 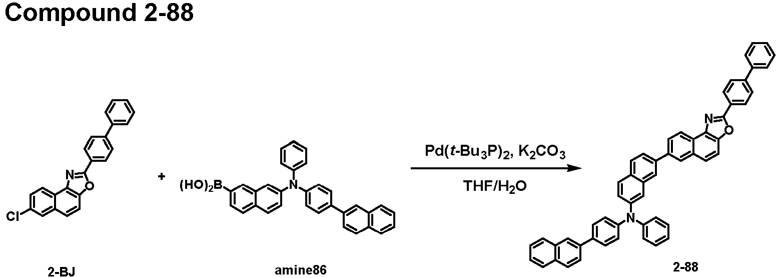
Compound 2-BJ (15 g, 42.2 mmol) and Compound amine86 (20.6 g, 44.3 mmol) were added to THF (300 ml) under a nitrogen atmosphere, and the mixture was stirred and refluxed. Then, potassium carbonate (17.5 g, 126.5 mmol) was dissolved in water (52 ml), added thereto, stirred sufficiently, and then bis(tri-tert-butylphosphine)palladium(0) (0.5 g, 1.0 mmol) was added. After the reaction for 12 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 20.6 g of Compound 2-88. (Yield: 66%, MS: [M+H]⁺= 741) 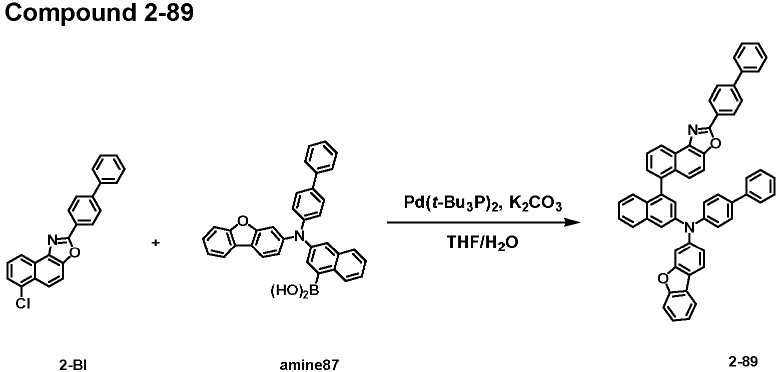
Compound 2-BI (15 g, 42.2 mmol) and Compound amine87 (22.4 g, 44.3 mmol) were added to THF (300 ml) under a nitrogen atmosphere, and the mixture was stirred and refluxed. Then, potassium carbonate (17.5 g, 126.5 mmol) was dissolved in water (52 ml), added thereto, stirred sufficiently, and then bis(tri-tert-butylphosphine)palladium(0) (0.5 g, 1.0 mmol) was added. After the reaction for 8 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 20.4 g of Compound 2-89. (Yield: 62%, MS: [M+H]⁺= 781) 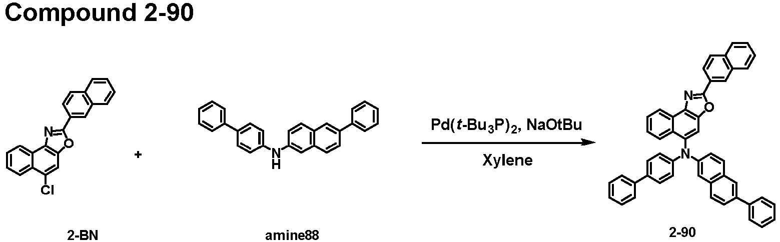
Compound 2-BN (10 g, 30.3 mmol), Compound amine88 (11.3 g, 30.3 mmol) and sodium tert-butoxide (9.7 g, 45.5 mmol) were added to xylene (200 ml) under a nitrogen atmosphere, and the mixture was stirred and refluxed. Then, bis(tri-tert-butylphosphine)palladium(0) (0.2 g, 0.4 mmol) was added thereto. After the reaction was completed after 3 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by silica gel column chromatography to give 13.3 g of Compound 2-90. (Yield: 66%, MS: [M+H]⁺= 665) 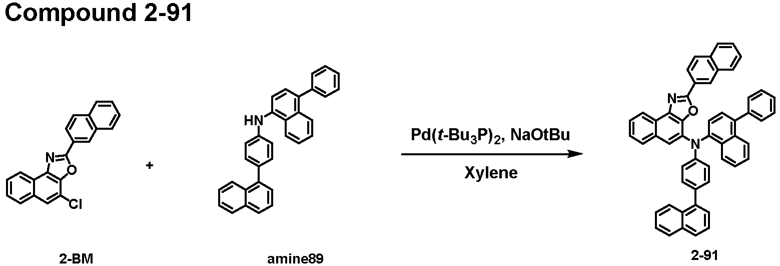
Compound 2-BM (10 g, 30.3 mmol), Compound amine89 (12.8 g, 30.3 mmol) and sodium tert-butoxide (9.7 g, 45.5 mmol) were added to xylene (200 ml) under a nitrogen atmosphere, and the mixture was stirred and refluxed. Then, bis(tri-tert-butylphosphine)palladium(0) (0.2 g, 0.4 mmol) was added thereto. After the reaction was completed after 2 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by silica gel column chromatography to give 13.4 g of Compound 2-91. (Yield: 62%, MS: [M+H]⁺= 715) 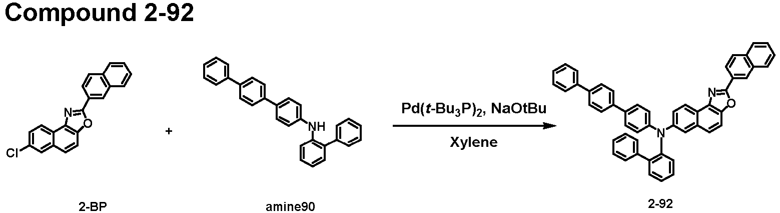
Compound 2-BP (10 g, 30.3 mmol), Compound amine90 (12.1 g, 30.3 mmol) and sodium tert-butoxide (9.7 g, 45.5 mmol) were added to xylene (200 ml) under a nitrogen atmosphere, and the mixture was stirred and refluxed. Then, bis(tri-tert-butylphosphine)palladium(0) (0.2 g, 0.4 mmol) was added thereto. After the reaction was completed after 3 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by silica gel column chromatography to give 13.8 g of Compound 2-92. (Yield: 66%, MS: [M+H]⁺= 691) 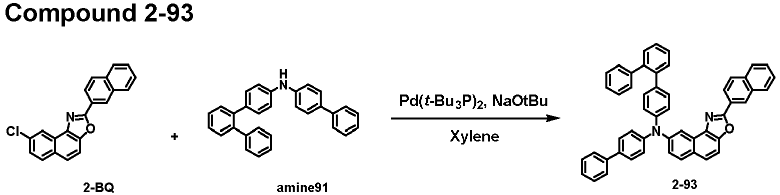
Compound 2-BQ (10 g, 30.3 mmol), Compound amine91 (12.1 g, 30.3 mmol) and sodium tert-butoxide (9.7 g, 45.5 mmol) were added to xylene (200 ml) under a nitrogen atmosphere, and the mixture was stirred and refluxed. Then, bis(tri-tert-butylphosphine)palladium(0) (0.2 g, 0.4 mmol) was added thereto. After the reaction was completed after 3 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by silica gel column chromatography to give 13.4 g of Compound 2-93. (Yield: 64%, MS: [M+H]⁺= 691) 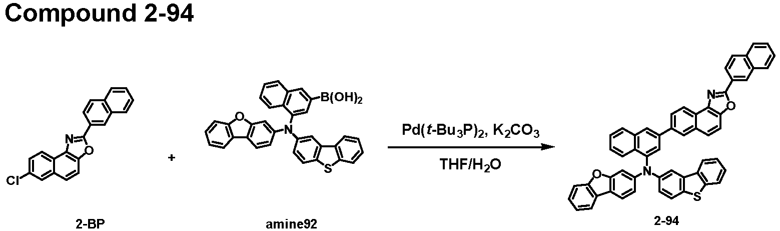
Compound 2-BP (15 g, 45.5 mmol) and Compound amine92 (25.6 g, 47.8 mmol) were added to **THF** (300 ml) under a nitrogen atmosphere, and the mixture was stirred and refluxed. Then, potassium carbonate (18.9 g, 136.5 mmol) was dissolved in water (57 ml), added thereto, stirred sufficiently, and then bis(tri-tert-butylphosphine)palladium(0) (0.5 g, 1.0 mmol) was added. After the reaction for 8 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 21.8 g of Compound 2-94. (Yield: 61%, MS: [M+H]⁺= 785) 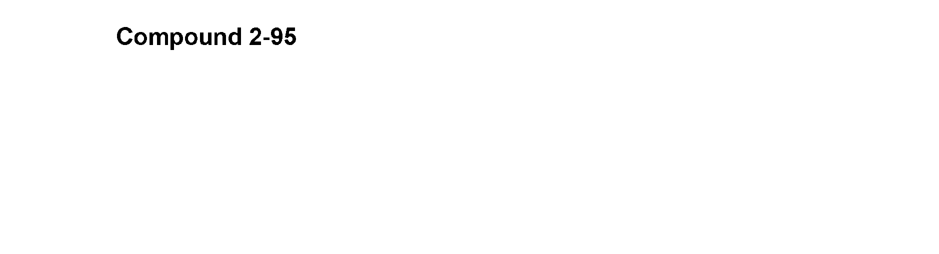 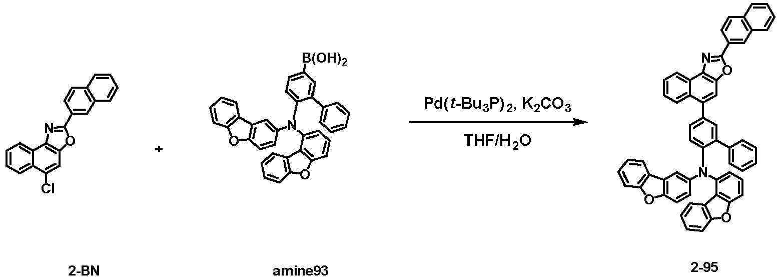
Compound 2-BN (15 g, 45.5 mmol) and Compound amine93 (26 g, 47.8 mmol) were added to THF (300 ml) under a nitrogen atmosphere, and the mixture was stirred and refluxed. Then, potassium carbonate (18.9 g, 136.5 mmol) was dissolved in water (57 ml), added thereto, stirred sufficiently, and then bis(tri-tert-butylphosphine)palladium(0) (0.5 g, 1.0 mmol) was added. After the reaction for 9 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 24.6 g of Compound 2-95. (Yield: 68%, MS: [M+H]⁺= 795) 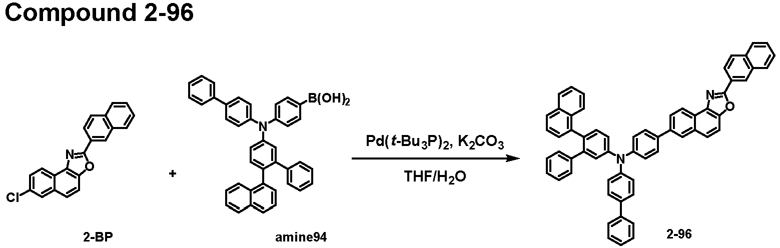
Compound 2-BP (15 g, 45.5 mmol) and Compound amine94 (27.1 g, 47.8 mmol) were added to THF (300 ml) under a nitrogen atmosphere, and the mixture was stirred and refluxed. Then, potassium carbonate (18.9 g, 136.5 mmol) was dissolved in water (57 ml), added thereto, stirred sufficiently, and then bis(tri-tert-butylphosphine)palladium(0) (0.5 g, 1.0 mmol) was added. After the reaction for 8 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 25.6 g of Compound 2-96. (Yield: 69%, MS: [M+H]⁺= 817) 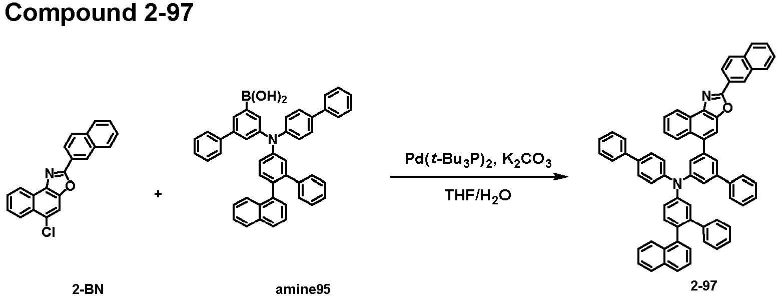
Compound 2-BN (15 g, 45.5 mmol) and Compound amine95 (30.7 g, 47.8 mmol) were added to THF (300 ml) under a nitrogen atmosphere, and the mixture was stirred and refluxed. Then, potassium carbonate (18.9 g, 136.5 mmol) was dissolved in water (57 ml), added thereto, stirred sufficiently, and then bis(tri-tert-butylphosphine)palladium(0) (0.5 g, 1.0 mmol) was added. After the reaction for 12 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 25.2 g of Compound 2-97. (Yield: 62%, MS: [M+H]⁺= 893) 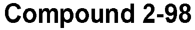 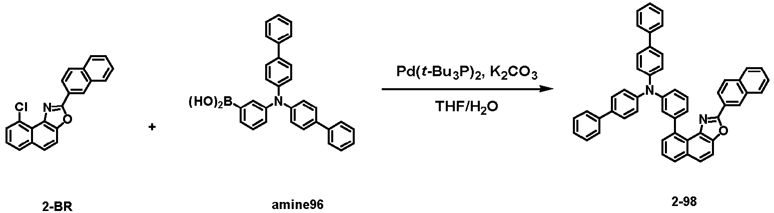
Compound 2-BR (15 g, 45.5 mmol) and Compound amine96 (21.1 g, 47.8 mmol) were added to THF (300 ml) under a nitrogen atmosphere, and the mixture was stirred and refluxed. Then, potassium carbonate (18.9 g, 136.5 mmol) was dissolved in water (57 ml), added thereto, stirred sufficiently, and then bis(tri-tert-butylphosphine)palladium(0) (0.5 g, 1.0 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 20.1 g of Compound 2-98. (Yield: 64%, MS: [M+H]⁺= 691) 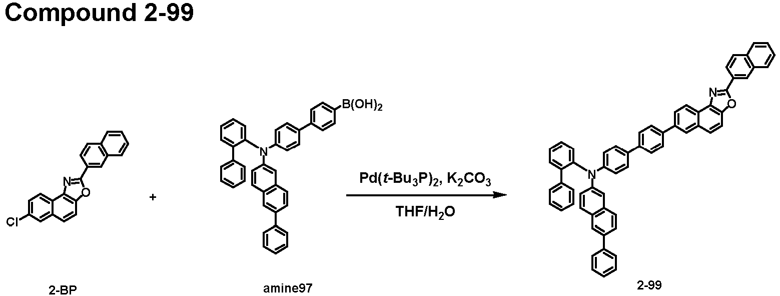
Compound 2-BP (15 g, 45.5 mmol) and Compound amine97 (27.1 g, 47.8 mmol) were added to THF (300 ml) under a nitrogen atmosphere, and the mixture was stirred and refluxed. Then, potassium carbonate (18.9 g, 136.5 mmol) was dissolved in water (57 ml), added thereto, stirred sufficiently, and then bis(tri-tert-butylphosphine)palladium(0) (0.5 g, 1.0 mmol) was added. After the reaction for 8 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 23 g of Compound 2-99. (Yield: 62%, MS: [M+H]⁺= 817) 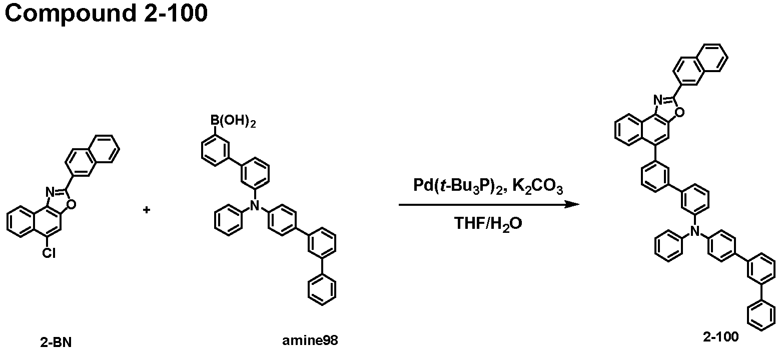
Compound 2-BN (15 g, 45.5 mmol) and Compound amine98 (24.7 g, 47.8 mmol) were added to THF (300 ml) under a nitrogen atmosphere, and the mixture was stirred and refluxed. Then, potassium carbonate (18.9 g, 136.5 mmol) was dissolved in water (57 ml), added thereto, stirred sufficiently, and then bis(tri-tert-butylphosphine)palladium(0) (0.5 g, 1.0 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 22.3 g of Compound 2-100. (Yield: 64%, MS: [M+H]⁺= 767) 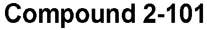 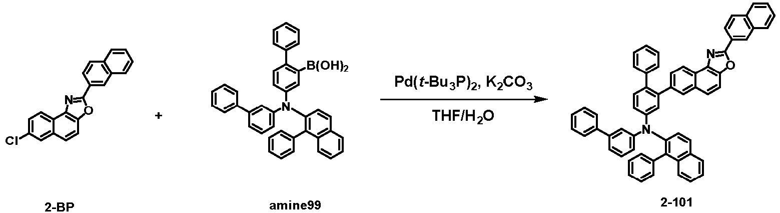
Compound 2-BP (15 g, 45.5 mmol) and Compound amine99 (27.1 g, 47.8 mmol) were added to THF (300 ml) under a nitrogen atmosphere, and the mixture was stirred and refluxed. Then, potassium carbonate (18.9 g, 136.5 mmol) was dissolved in water (57 ml), added thereto, stirred sufficiently, and then bis(tri-tert-butylphosphine)palladium(0) (0.5 g, 1.0 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 22.3 g of Compound 2-101. (Yield: 60%, MS: [M+H]⁺= 817) 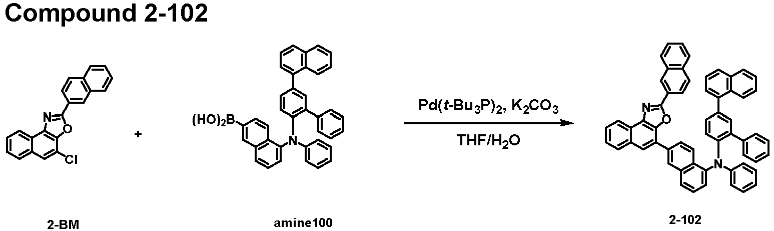
Compound 2-BM (15 g, 45.5 mmol) and Compound amine100 (25.9 g, 47.8 mmol) were added to THF (300 ml) under a nitrogen atmosphere, and the mixture was stirred and refluxed. Then, potassium carbonate (18.9 g, 136.5 mmol) was dissolved in water (57 ml), added thereto, stirred sufficiently, and then bis(tri-tert-butylphosphine)palladium(0) (0.5 g, 1.0 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 21.6 g of Compound 2-102. (Yield: 60%, MS: [M+H]⁺= 791) 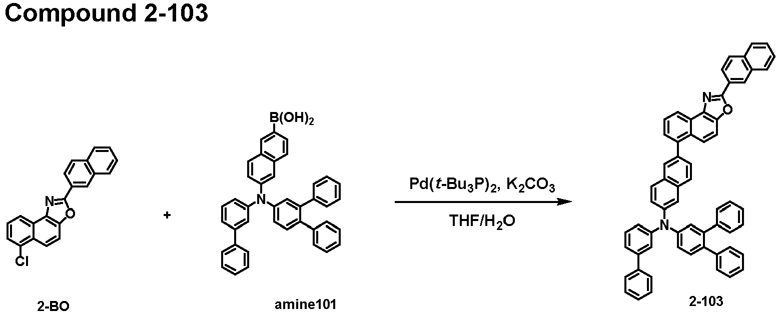
Compound 2-BO (15 g, 45.5 mmol) and Compound amine101 (27.1 g, 47.8 mmol) were added to THF (300 ml) under a nitrogen atmosphere, and the mixture was stirred and refluxed. Then, potassium carbonate (18.9 g, 136.5 mmol) was dissolved in water (57 ml), added thereto, stirred sufficiently, and then bis(tri-tert-butylphosphine)palladium(0) (0.5 g, 1.0 mmol) was added. After the reaction for 8 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 26 g of Compound 2-103. (Yield: 70%, MS: [M+H]⁺= 817) 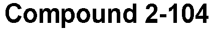 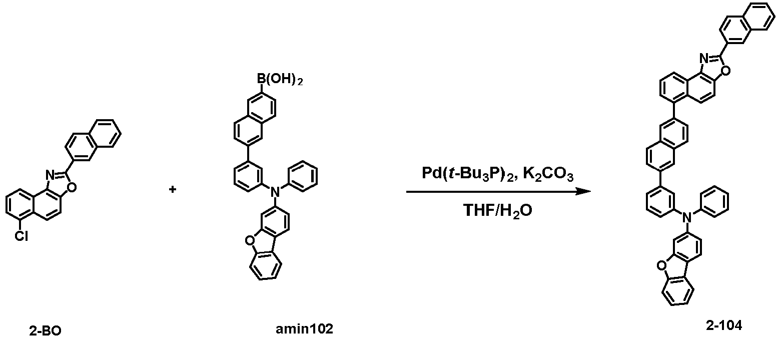
Compound 2-BO (15 g, 45.5 mmol) and Compound amine102 (24.1 g, 47.8 mmol) were added to THF (300 ml) under a nitrogen atmosphere, and the mixture was stirred and refluxed. Then, potassium carbonate (18.9 g, 136.5 mmol) was dissolved in water (57 ml), added thereto, stirred sufficiently, and then bis(tri-tert-butylphosphine)palladium(0) (0.5 g, 1.0 mmol) was added. After the reaction for 10 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 22.6 g of Compound 2-104. (Yield: 63%, MS: [M+H]⁺= 791) 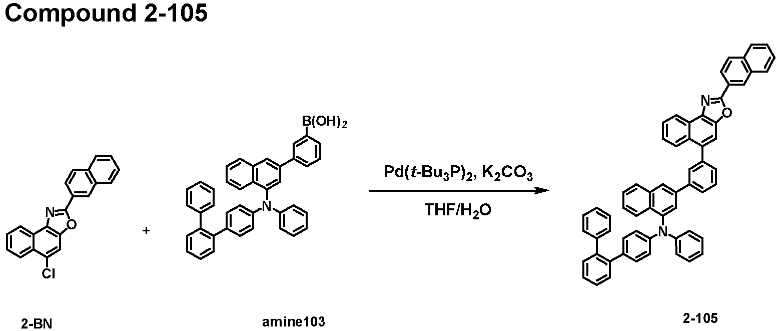
Compound 2-BN (15 g, 45.5 mmol) and Compound amine103 (27.1 g, 47.8 mmol) were added to THF (300 ml) under a nitrogen atmosphere, and the mixture was stirred and refluxed. Then, potassium carbonate (18.9 g, 136.5 mmol) was dissolved in water (57 ml), added thereto, stirred sufficiently, and then bis(tri-tert-butylphosphine)palladium(0) (0.5 g, 1.0 mmol) was added. After the reaction for 11 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 23.7 g of Compound 2-105. (Yield: 69%, MS: [M+H]⁺= 755) 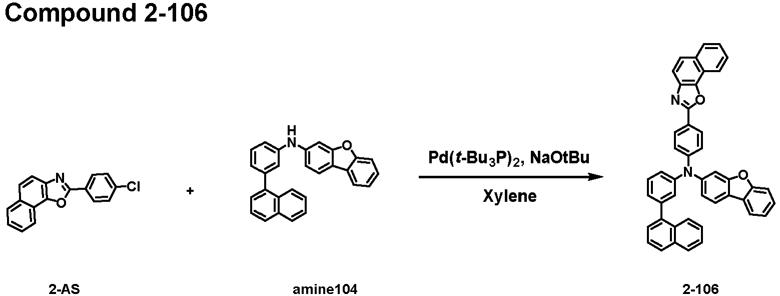
Compound 2-AS (10 g, 35.8 mmol), Compound amine104 (13.8 g, 35.8 mmol) and sodium tert-butoxide (11.4 g, 53.6 mmol) were added to xylene (200 ml) under a nitrogen atmosphere, and the mixture was stirred and refluxed. Then, bis(tri-tert-butylphosphine)palladium(0) (0.2 g, 0.4 mmol) was added thereto. After the reaction was completed after 3 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by silica gel column chromatography to give 14.1 g of Compound 2-106. (Yield: 63%, MS: [M+H]⁺= 629) 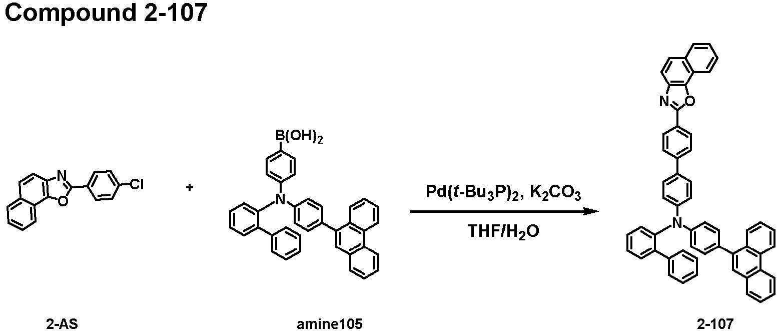
Compound 2-AS (15 g, 45.5 mmol) and Compound amine105 (21.2 g, 47.8 mmol) were added to THF (300 ml) under a nitrogen atmosphere, and the mixture was stirred and refluxed. Then, potassium carbonate (18.9 g, 136.5 mmol) was dissolved in water (57 ml), added thereto, stirred sufficiently, and then bis(tri-tert-butylphosphine)palladium(0) (0.5 g, 1.0 mmol) was added. After the reaction for 12 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 19.2 g of Compound 2-107. (Yield: 61%, MS: [M+H]⁺= 691) 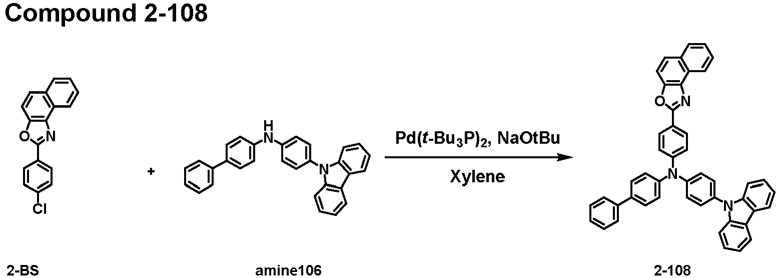
Compound 2-BS (10 g, 35.8 mmol), Compound amine106 (13.8 g, 35.8 mmol) and sodium tert-butoxide (11.4 g, 53.6 mmol) were added to xylene (200 ml) under a nitrogen atmosphere, and the mixture was stirred and refluxed. Then, bis(tri-tert-butylphosphine)palladium(0) (0.2 g, 0.4 mmol) was added thereto. After the reaction was completed after 3 hours, the reaction mixture was cooled to room temperature, and the solvent was removed under reduced pressure. Then, the compound was again completely dissolved in chloroform, washed twice with water, and then the organic layer was separated, treated with anhydrous magnesium sulfate and then filtered, and the filtrate was distilled under reduced pressure. The concentrated compound was purified by silica gel column chromatography to give 14.1 g of Compound 2-108. (Yield: 63%, MS: [M+H]⁺= 629) 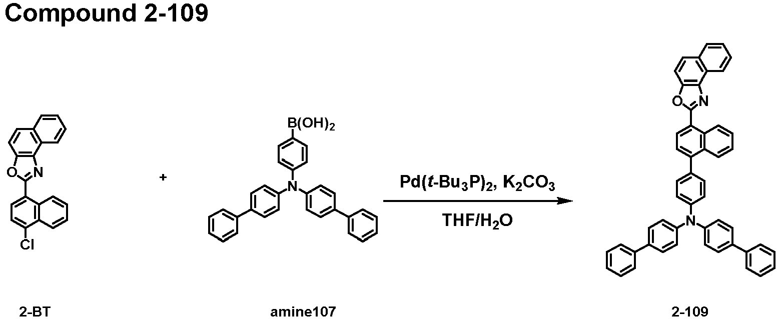
Compound 2-BT (15 g, 45.5 mmol) and Compound amine107 (21.2 g, 47.8 mmol) were added to THF (300 ml) under a nitrogen atmosphere, and the mixture was stirred and refluxed. Then, potassium carbonate (18.9 g, 136.5 mmol) was dissolved in water (57 ml), added thereto, stirred sufficiently, and then bis(tri-tert-butylphosphine)palladium(0) (0.5 g, 1.0 mmol) was added. After the reaction for 12 hours, the reaction mixture was cooled to room temperature, the organic layer and the aqueous layer were separated and then the organic layer was distilled. This was again dissolved in chloroform, washed twice with water, and then the organic layer was separated, anhydrous magnesium sulfate was added thereto, stirred, and then filtered, and the filtrate was distilled under reduced pressure. The concentrated compound was purified by silica gel column chromatography to prepare 19.2 g of Compound 2-109. (Yield: 61%, MS: [M+H]⁺= 691)

### [EXAMPLE]

### Example 1

A glass substrate on which a thin film of ITO (indium tin oxide) was coated in a thickness of 1,000 Å was put into distilled water containing the detergent dissolved therein and washed by the ultrasonic wave. In this case, the used detergent was a product commercially available from Fisher Co. and the distilled water was one which had been twice filtered by using a filter commercially available from Millipore Co. The ITO was washed for 30 minutes, and ultrasonic washing was then repeated twice for 10 minutes by using distilled water. After the washing with distilled water was completed, the substrate was ultrasonically washed with isopropyl alcohol, acetone, and methanol solvent, and dried, after which it was transported to a plasma cleaner. Then, the substrate was cleaned with oxygen plasma for 5 minutes, and then transferred to a vacuum evaporator.

On the ITO transparent electrode thus prepared, the following compound HI-1 was formed in a thickness of 1150Å, and the following compound A-1was p-doped at a concentration of 1.5 wt.% to form a hole injection layer. The following compound HT-1 was vacuum deposited on the hole injection layer to form a hole transport layer with a film thickness of 800Å. Then, the following compound EB-1 was vacuum-deposited on the hole transport layer to form an electron blocking layer with a film thickness of 150 Å. Then, the previously prepared compound 1-2, compounds 2-1 and compound Dp-7 were vacuum-deposited in a weight ratio of 49:49:2 on the electron blocking layer to form a red light emitting layer with a film thickness of 400 Å. The following compound HB-1 was vacuum-deposited on the light emitting layer to form a hole blocking layer with a film thickness of 30 Å. Then, the following compound ET-1 and the following compound LiQ were vacuum-deposited in a weight ratio of 2:1 on the hole blocking layer to form an electron injection and transport layer with a thickness of 300 Å. Lithium fluoride (LiF) and aluminum were sequentially deposited to have a thickness of 12 Å and 1,000 Å, respectively, on the electron injection and transport layer, thereby forming a cathode.

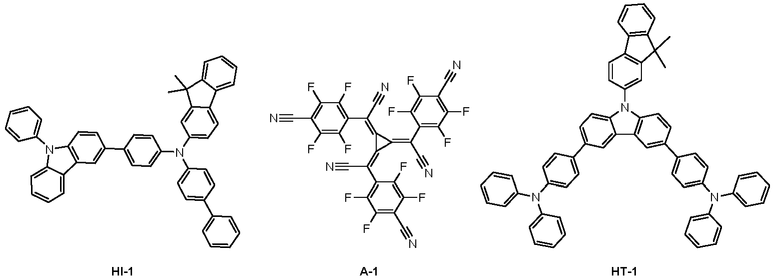

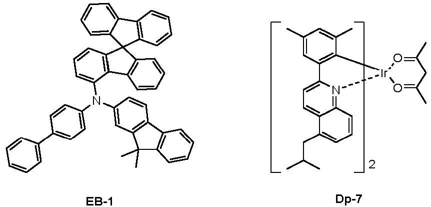

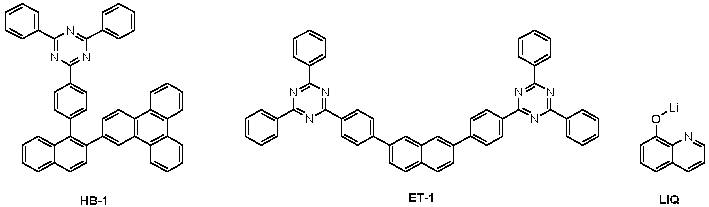

In the above-mentioned processes, the deposition rates of the organic materials were maintained at 0.4-0.7 Å/sec, the deposition rates of lithium fluoride and the aluminum of the cathode were maintained at 0.3 Å/sec and 2 Å/sec, respectively, and the degree of vacuum during the deposition was maintained at 2×10⁻⁷ ~ 5×10⁻⁶ torr, thereby manufacturing an organic light emitting device.

### Examples 2 to 200

The organic light emitting devices were manufactured in the same manner as in Example 1, except that in the production of the light emitting layer, the compounds shown in Tables 1 to 8 below were used instead of Compound 1-2 and Compound 2-1, respectively.

### Comparative Examples 1 to 188

The organic light emitting devices were manufactured in the same manner as in Example 1, except that in the production of the light emitting layer, the compounds shown in Tables 9 to 17 below were used instead of Compound 1-2 and Compound 2-1, respectively. In Tables 9 to 17 below, Compounds B-1 to B-12 and C-1 to C-16 were as follows, respectively.

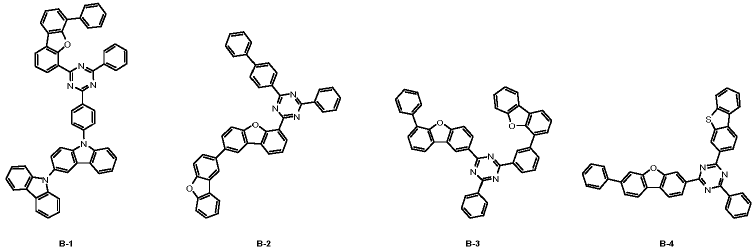

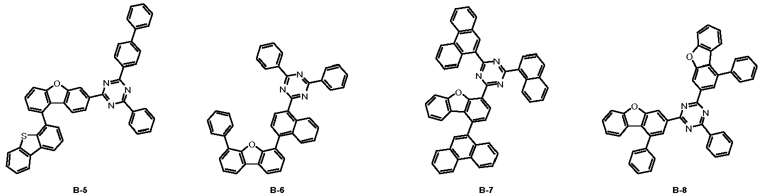

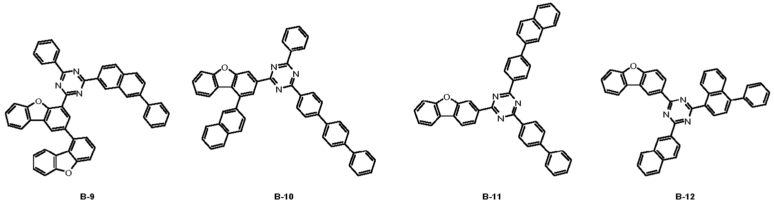

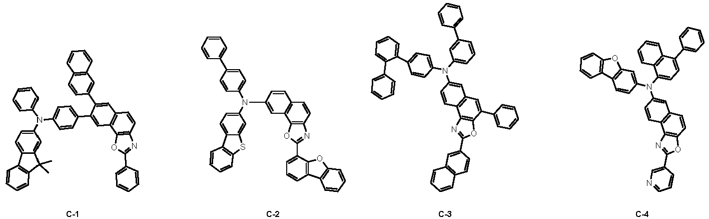

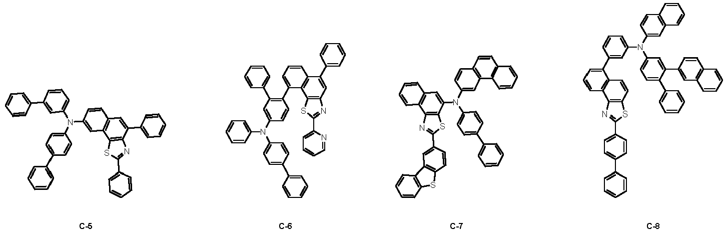

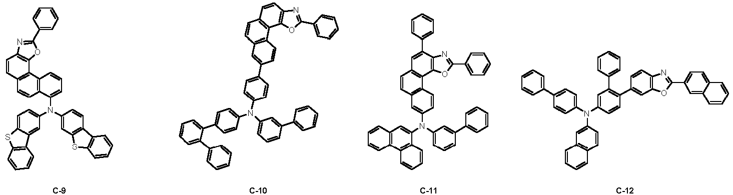

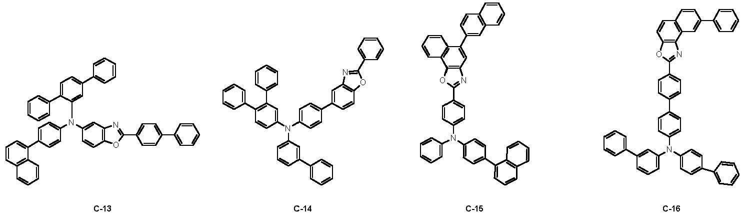

The voltage and efficiency were measured (15 mA/cm²) by applying a current to the organic light emitting devices manufactured in Examples and Comparative Examples, and the results are shown in Tables below. Lifetime T95 was measured based on 7000 nits, and T95 means the time (hr) required for the lifetime to be reduced to 95% of the initial lifetime.

**[Table 1]**

| | First host | Second host | Driving voltage(V) | Efficienc y(cd/A) | Lifetime T95(hr) | Luminescent color |
|---|---|---|---|---|---|---|
| Ex. 1 | Com. 1-2 | Com. 2-1 | 3.52 | 21.62 | 247 | Red |
| Ex. 2 | Com. 1-2 | Com. 2-27 | 3.57 | 21.98 | 267 | Red |
| Ex. 3 | Com. 1-2 | Com. 2-46 | 3.51 | 23.33 | 258 | Red |
| Ex. 4 | Com. 1-2 | Com. 2-66 | 3.60 | 21.60 | 246 | Red |
| Ex. 5 | Com. 1-2 | Com. 2-100 | 3.55 | 21.69 | 242 | Red |
| Ex. 6 | Com. 1-3 | Com. 2-3 | 3.53 | 21.45 | 246 | Red |
| Ex. 7 | Com. 1-3 | Com. 2-12 | 3.60 | 21.57 | 232 | Red |
| Ex. 8 | Com. 1-3 | Com. 2-51 | 3.55 | 21.67 | 238 | Red |
| Ex. 9 | Com. 1-3 | Com. 2-71 | 3.58 | 21.86 | 244 | Red |
| Ex. 10 | Com. 1-3 | Com. 2-105 | 3.59 | 20.98 | 236 | Red |
| Ex. 11 | Com. 1-8 | Com. 2-17 | 3.72 | 19.98 | 212 | Red |
| Ex. 12 | Com. 1-8 | Com. 2-36 | 3.70 | 19.36 | 215 | Red |
| Ex. 13 | Com. 1-8 | Com. 2-51 | 3.63 | 20.12 | 200 | Red |
| Ex. 14 | Com. 1-8 | Com. 2-76 | 3.62 | 20.60 | 206 | Red |
| Ex. 15 | Com. 1-8 | Com. 2-105 | 3.62 | 20.08 | 192 | Red |
| Ex. 16 | Com. 1-9 | Com. 2-7 | 3.65 | 20.14 | 191 | Red |
| Ex. 17 | Com. 1-9 | Com. 2-41 | 3.71 | 20.49 | 198 | Red |
| Ex. 18 | Com. 1-9 | Com. 2-56 | 3.65 | 20.03 | 210 | Red |
| Ex. 19 | Com. 1-9 | Com. 2-81 | 3.63 | 19.91 | 215 | Red |
| Ex. 20 | Com. 1-9 | Com. 2-96 | 3.62 | 20.39 | 206 | Red |
| Ex. 21 | Com. 1-10 | Com. 2-1 | 3.77 | 20.83 | 233 | Red |
| Ex. 22 | Com. 1-10 | Com. 2-22 | 3.73 | 20.82 | 225 | Red |
| Ex. 23 | Com. 1-10 | Com. 2-46 | 3.48 | 23.55 | 275 | Red |
| Ex. 24 | Com. 1-10 | Com. 2-86 | 3.76 | 20.85 | 232 | Red |
| Ex. 25 | Com. 1-10 | Com. 2-96 | 3.78 | 20.67 | 213 | Red |

**[Table 2]**

| | First host | Second host | Driving voltage(V) | Efficienc y(cd/A) | Lifetime T95(hr) | Luminescent color |
|---|---|---|---|---|---|---|
| Ex. 26 | Com. 1-12 | Com. 2-3 | 3.77 | 20.86 | 226 | Red |
| Ex. 27 | Com. 1-12 | Com. 2-27 | 3.40 | 23.86 | 280 | Red |
| Ex. 28 | Com. 1-12 | Com. 2-51 | 3.70 | 20.67 | 226 | Red |
| Ex. 29 | Com. 1-12 | Com. 2-91 | 3.80 | 20.80 | 224 | Red |
| Ex. 30 | Com. 1-12 | Com. 2-105 | 3.78 | 20.65 | 232 | Red |
| Ex. 31 | Com. 1-15 | Com. 2-1 | 3.67 | 20.39 | 243 | Red |
| Ex. 32 | Com. 1-15 | Com. 2-27 | 3.42 | 24.15 | 297 | Red |
| Ex. 33 | Com. 1-15 | Com. 2-56 | 3.62 | 20.06 | 231 | Red |
| Ex. 34 | Com. 1-15 | Com. 2-96 | 3.66 | 19.76 | 240 | Red |
| Ex. 35 | Com. 1-15 | Com. 2-105 | 3.68 | 20.37 | 234 | Red |
| Ex. 36 | Com. 1-16 | Com. 2-12 | 3.64 | 20.22 | 234 | Red |
| Ex. 37 | Com. 1-16 | Com. 2-36 | 3.60 | 20.63 | 241 | Red |
| Ex. 38 | Com. 1-16 | Com. 2-61 | 3.67 | 19.89 | 241 | Red |
| Ex. 39 | Com. 1-16 | Com. 2-91 | 3.65 | 20.27 | 245 | Red |
| Ex. 40 | Com. 1-16 | Com. 2-105 | 3.64 | 19.97 | 247 | Red |
| Ex. 41 | Com. 1-17 | Com. 2-2 | 3.63 | 21.18 | 243 | Red |
| Ex. 42 | Com. 1-17 | Com. 2-28 | 3.57 | 23.01 | 258 | Red |
| Ex. 43 | Com. 1-17 | Com. 2-47 | 3.51 | 21.51 | 231 | Red |
| Ex. 44 | Com. 1-17 | Com. 2-67 | 3.54 | 21.51 | 240 | Red |
| Ex. 45 | Com. 1-17 | Com. 2-101 | 3.52 | 20.89 | 234 | Red |
| Ex. 46 | Com. 1-20 | Com. 2-13 | 3.60 | 23.47 | 242 | Red |
| Ex. 47 | Com. 1-20 | Com. 2-32 | 3.59 | 20.89 | 241 | Red |
| Ex. 48 | Com. 1-20 | Com. 2-52 | 3.53 | 20.92 | 241 | Red |
| Ex. 49 | Com. 1-20 | Com. 2-72 | 3.61 | 22.04 | 245 | Red |
| Ex. 50 | Com. 1-20 | Com. 2-106 | 3.59 | 21.35 | 247 | Red |

**[Table 3]**

| | First host | Second host | Driving voltage(V) | Efficiency (cd/A) | Lifetime T95(hr) | Luminescent color |
|---|---|---|---|---|---|---|
| Ex. 51 | Com. 1-21 | Com. 2-18 | 3.93 | 22.34 | 193 | Red |
| Ex. 52 | Com. 1-21 | Com. 2-37 | 3.46 | 24.36 | 290 | Red |
| Ex. 53 | Com. 1-21 | Com. 2-52 | 3.51 | 21.97 | 217 | Red |
| Ex. 54 | Com. 1-21 | Com. 2-77 | 3.54 | 23.46 | 195 | Red |
| Ex. 55 | Com. 1-21 | Com. 2-106 | 3.52 | 22.72 | 216 | Red |
| Ex. 56 | Com. 1-24 | Com. 2-8 | 3.54 | 22.51 | 195 | Red |
| Ex. 57 | Com. 1-24 | Com. 2-42 | 3.59 | 22.62 | 213 | Red |
| Ex. 58 | Com. 1-24 | Com. 2-57 | 3.53 | 23.05 | 209 | Red |
| Ex. 59 | Com. 1-24 | Com. 2-82 | 3.61 | 22.46 | 199 | Red |
| Ex. 60 | Com. 1-24 | Com. 2-97 | 3.59 | 23.24 | 197 | Red |
| Ex. 61 | Com. 1-27 | Com. 2-2 | 3.67 | 20.39 | 243 | Red |
| Ex. 62 | Com. 1-27 | Com. 2-23 | 3.67 | 20.10 | 236 | Red |
| Ex. 63 | Com. 1-27 | Com. 2-47 | 3.62 | 20.06 | 231 | Red |
| Ex. 64 | Com. 1-27 | Com. 2-87 | 3.66 | 19.76 | 240 | Red |
| Ex. 65 | Com. 1-27 | Com. 2-97 | 3.68 | 20.37 | 234 | Red |
| Ex. 66 | Com. 1-28 | Com. 2-13 | 3.42 | 24.15 | 297 | Red |
| Ex. 67 | Com. 1-28 | Com. 2-28 | 3.48 | 23.83 | 292 | Red |
| Ex. 68 | Com. 1-28 | Com. 2-52 | 3.67 | 19.89 | 241 | Red |
| Ex. 69 | Com. 1-28 | Com. 2-92 | 3.65 | 20.27 | 245 | Red |
| Ex. 70 | Com. 1-28 | Com. 2-106 | 3.64 | 19.97 | 247 | Red |
| Ex. 71 | Com. 1-31 | Com. 2-2 | 3.71 | 22.91 | 215 | Red |
| Ex. 72 | Com. 1-31 | Com. 2-28 | 3.51 | 23.33 | 258 | Red |
| Ex. 73 | Com. 1-31 | Com. 2-57 | 3.52 | 21.37 | 238 | Red |
| Ex. 74 | Com. 1-31 | Com. 2-97 | 3.56 | 21.35 | 238 | Red |
| Ex. 75 | Com. 1-31 | Com. 2-106 | 3.55 | 20.66 | 239 | Red |

**[Table 4]**

| | First host | Second host | Driving voltage(V) | Efficiency (cd/A) | Lifetime T95(hr) | Luminescent color |
|---|---|---|---|---|---|---|
| Ex. 76 | Com. 1-33 | Com. 2-13 | 3.45 | 23.63 | 291 | Red |
| Ex. 77 | Com. 1-33 | Com. 2-37 | 3.43 | 24.30 | 285 | Red |
| Ex. 78 | Com. 1-33 | Com. 2-62 | 3.62 | 21.50 | 246 | Red |
| Ex. 79 | Com. 1-33 | Com. 2-92 | 3.59 | 21.42 | 237 | Red |
| Ex. 80 | Com. 1-33 | Com. 2-106 | 3.58 | 22.01 | 249 | Red |
| Ex. 81 | Com. 1-37 | Com. 2-4 | 3.43 | 23.92 | 287 | Red |
| Ex. 82 | Com. 1-37 | Com. 2-29 | 3.54 | 20.81 | 241 | Red |
| Ex. 83 | Com. 1-37 | Com. 2-48 | 3.51 | 21.64 | 232 | Red |
| Ex. 84 | Com. 1-37 | Com. 2-68 | 3.57 | 21.97 | 247 | Red |
| Ex. 85 | Com. 1-37 | Com. 2-102 | 3.59 | 20.90 | 234 | Red |
| Ex. 86 | Com. 1-39 | Com. 2-14 | 3.41 | 23.50 | 295 | Red |
| Ex. 87 | Com. 1-39 | Com. 2-33 | 3.72 | 20.85 | 212 | Red |
| Ex. 88 | Com. 1-39 | Com. 2-53 | 3.76 | 20.82 | 219 | Red |
| Ex. 89 | Com. 1-39 | Com. 2-73 | 3.81 | 20.86 | 235 | Red |
| Ex. 90 | Com. 1-39 | Com. 2-107 | 3.74 | 20.67 | 222 | Red |
| Ex. 91 | Com. 1-40 | Com. 2-19 | 3.77 | 20.71 | 220 | Red |
| Ex. 92 | Com. 1-40 | Com. 2-38 | 3.72 | 20.74 | 237 | Red |
| Ex. 93 | Com. 1-40 | Com. 2-53 | 3.77 | 20.81 | 221 | Red |
| Ex. 94 | Com. 1-40 | Com. 2-78 | 3.77 | 20.64 | 234 | Red |
| Ex. 95 | Com. 1-40 | Com. 2-107 | 3.81 | 20.81 | 229 | Red |
| Ex. 96 | Com. 1-41 | Com. 2-9 | 3.64 | 19.58 | 234 | Red |
| Ex. 97 | Com. 1-41 | Com. 2-43 | 3.63 | 19.42 | 249 | Red |
| Ex. 98 | Com. 1-41 | Com. 2-58 | 3.60 | 19.93 | 238 | Red |
| Ex. 99 | Com. 1-41 | Com. 2-83 | 3.62 | 20.07 | 239 | Red |
| Ex. 100 | Com. 1-41 | Com. 2-98 | 3.65 | 20.10 | 244 | Red |

**[Table 5]**

| | First host | Second host | Driving voltage(V) | Efficiency (cd/A) | Lifetime T95(hr) | Luminescent color |
|---|---|---|---|---|---|---|
| Ex. 101 | Com. 1-42 | Com. 2-4 | 3.47 | 24.16 | 285 | Red |
| Ex. 102 | Com. 1-42 | Com. 2-24 | 3.68 | 19.89 | 232 | Red |
| Ex. 103 | Com. 1-42 | Com. 2-48 | 3.70 | 19.79 | 243 | Red |
| Ex. 104 | Com. 1-42 | Com. 2-88 | 3.71 | 19.94 | 238 | Red |
| Ex. 105 | Com. 1-42 | Com. 2-98 | 3.72 | 19.52 | 238 | Red |
| Ex. 106 | Com. 1-43 | Com. 2-14 | 3.40 | 24.42 | 275 | Red |
| Ex. 107 | Com. 1-43 | Com. 2-29 | 3.72 | 20.85 | 212 | Red |
| Ex. 108 | Com. 1-43 | Com. 2-53 | 3.76 | 20.82 | 219 | Red |
| Ex. 109 | Com. 1-43 | Com. 2-93 | 3.41 | 24.36 | 287 | Red |
| Ex. 110 | Com. 1-43 | Com. 2-107 | 3.74 | 20.67 | 222 | Red |
| Ex. 111 | Com. 1-44 | Com. 2-4 | 3.41 | 24.46 | 285 | Red |
| Ex. 112 | Com. 1-44 | Com. 2-29 | 3.72 | 20.74 | 237 | Red |
| Ex. 113 | Com. 1-44 | Com. 2-58 | 3.77 | 20.81 | 221 | Red |
| Ex. 114 | Com. 1-44 | Com. 2-98 | 3.77 | 20.64 | 234 | Red |
| Ex. 115 | Com. 1-44 | Com. 2-107 | 3.81 | 20.81 | 229 | Red |
| Ex. 116 | Com. 1-48 | Com. 2-14 | 3.44 | 24.47 | 287 | Red |
| Ex. 117 | Com. 1-48 | Com. 2-38 | 3.86 | 22.42 | 195 | Red |
| Ex. 118 | Com. 1-48 | Com. 2-63 | 3.82 | 22.81 | 199 | Red |
| Ex. 119 | Com. 1-48 | Com. 2-93 | 3.45 | 23.61 | 294 | Red |
| Ex. 120 | Com. 1-48 | Com. 2-107 | 3.79 | 23.16 | 205 | Red |
| Ex. 121 | Com. 1-52 | Com. 2-5 | 3.56 | 23.01 | 242 | Red |
| Ex. 122 | Com. 1-52 | Com. 2-30 | 3.71 | 20.23 | 247 | Red |
| Ex. 123 | Com. 1-52 | Com. 2-49 | 3.62 | 19.78 | 237 | Red |
| Ex. 124 | Com. 1-52 | Com. 2-69 | 3.61 | 20.63 | 232 | Red |
| Ex. 125 | Com. 1-52 | Com. 2-103 | 3.71 | 20.53 | 242 | Red |

**[Table 6]**

| | First host | Second host | Driving voltage(V) | Efficiency (cd/A) | Lifetime T95(hr) | Luminescent color |
|---|---|---|---|---|---|---|
| Ex. 126 | Com. 1-53 | Com. 2-15 | 3.52 | 21.91 | 252 | Red |
| Ex. 127 | Com. 1-53 | Com. 2-34 | 3.52 | 22.28 | 253 | Red |
| Ex. 128 | Com. 1-53 | Com. 2-54 | 3.68 | 19.41 | 248 | Red |
| Ex. 129 | Com. 1-53 | Com. 2-74 | 3.69 | 19.57 | 231 | Red |
| Ex. 130 | Com. 1-53 | Com. 2-108 | 3.63 | 20.25 | 248 | Red |
| Ex. 131 | Com. 1-55 | Com. 2-20 | 3.74 | 20.67 | 223 | Red |
| Ex. 132 | Com. 1-55 | Com. 2-39 | 3.45 | 24.47 | 288 | Red |
| Ex. 133 | Com. 1-55 | Com. 2-54 | 3.73 | 20.75 | 215 | Red |
| Ex. 134 | Com. 1-55 | Com. 2-79 | 3.76 | 20.66 | 236 | Red |
| Ex. 135 | Com. 1-55 | Com. 2-108 | 3.72 | 20.80 | 219 | Red |
| Ex. 136 | Com. 1-56 | Com. 2-10 | 3.79 | 20.63 | 230 | Red |
| Ex. 137 | Com. 1-56 | Com. 2-44 | 3.81 | 20.64 | 218 | Red |
| Ex. 138 | Com. 1-56 | Com. 2-59 | 3.57 | 22.34 | 267 | Red |
| Ex. 139 | Com. 1-56 | Com. 2-84 | 3.77 | 20.76 | 219 | Red |
| Ex. 140 | Com. 1-56 | Com. 2-99 | 3.72 | 20.72 | 238 | Red |
| Ex. 141 | Com. 1-57 | Com. 2-5 | 3.54 | 22.70 | 263 | Red |
| Ex. 142 | Com. 1-57 | Com. 2-25 | 3.59 | 21.60 | 247 | Red |
| Ex. 143 | Com. 1-57 | Com. 2-49 | 3.51 | 21.47 | 237 | Red |
| Ex. 144 | Com. 1-57 | Com. 2-89 | 3.63 | 21.29 | 232 | Red |
| Ex. 145 | Com. 1-57 | Com. 2-99 | 3.61 | 20.65 | 242 | Red |
| Ex. 146 | Com. 1-58 | Com. 2-15 | 3.55 | 22.29 | 250 | Red |
| Ex. 147 | Com. 1-58 | Com. 2-30 | 3.51 | 21.14 | 249 | Red |
| Ex. 148 | Com. 1-58 | Com. 2-54 | 3.58 | 21.67 | 248 | Red |
| Ex. 149 | Com. 1-58 | Com. 2-94 | 3.57 | 21.11 | 231 | Red |
| Ex. 150 | Com. 1-58 | Com. 2-108 | 3.57 | 20.62 | 248 | Red |

**[Table 7]**

| | First host | Second host | Driving voltage(V) | Efficiency (cd/A) | Lifetime T95(hr) | Luminescent color |
|---|---|---|---|---|---|---|
| Ex. 151 | Com. 1-60 | Com. 2-3 | 3.57 | 22.99 | 258 | Red |
| Ex. 152 | Com. 1-60 | Com. 2-30 | 3.61 | 21.79 | 231 | Red |
| Ex. 153 | Com. 1-60 | Com. 2-59 | 3.55 | 23.36 | 248 | Red |
| Ex. 154 | Com. 1-60 | Com. 2-99 | 3.62 | 21.76 | 233 | Red |
| Ex. 155 | Com. 1-60 | Com. 2-108 | 3.58 | 20.92 | 247 | Red |
| Ex. 156 | Com. 1-61 | Com. 2-15 | 3.42 | 24.11 | 284 | Red |
| Ex. 157 | Com. 1-61 | Com. 2-39 | 3.40 | 23.86 | 285 | Red |
| Ex. 158 | Com. 1-61 | Com. 2-64 | 3.54 | 20.80 | 238 | Red |
| Ex. 159 | Com. 1-61 | Com. 2-94 | 3.51 | 20.67 | 245 | Red |
| Ex. 160 | Com. 1-61 | Com. 2-108 | 3.55 | 21.84 | 246 | Red |
| Ex. 161 | Com. 1-62 | Com. 2-6 | 3.63 | 22.33 | 267 | Red |
| Ex. 162 | Com. 1-62 | Com. 2-31 | 3.60 | 21.05 | 244 | Red |
| Ex. 163 | Com. 1-62 | Com. 2-50 | 3.63 | 21.18 | 249 | Red |
| Ex. 164 | Com. 1-62 | Com. 2-70 | 3.54 | 21.47 | 240 | Red |
| Ex. 165 | Com. 1-62 | Com. 2-104 | 3.57 | 21.42 | 240 | Red |
| Ex. 166 | Com. 1-63 | Com. 2-16 | 3.42 | 24.26 | 279 | Red |
| Ex. 167 | Com. 1-63 | Com. 2-35 | 3.71 | 20.26 | 243 | Red |
| Ex. 168 | Com. 1-63 | Com. 2-55 | 3.40 | 23.65 | 276 | Red |
| Ex. 169 | Com. 1-63 | Com. 2-75 | 3.59 | 19.55 | 246 | Red |
| Ex. 170 | Com. 1-63 | Com. 2-109 | 3.67 | 19.89 | 239 | Red |
| Ex. 171 | Com. 1-64 | Com. 2-21 | 3.70 | 20.86 | 219 | Red |
| Ex. 172 | Com. 1-64 | Com. 2-40 | 3.48 | 23.89 | 285 | Red |
| Ex. 173 | Com. 1-64 | Com. 2-55 | 3.41 | 23.84 | 298 | Red |
| Ex. 174 | Com. 1-64 | Com. 2-80 | 3.79 | 20.70 | 217 | Red |
| Ex. 175 | Com. 1-64 | Com. 2-109 | 3.75 | 20.70 | 232 | Red |

**[Table 8]**

| | First host | Second host | Driving voltage(V) | Efficiency (cd/A) | Lifetime T95(hr) | Luminescent color |
|---|---|---|---|---|---|---|
| Ex. 176 | Com. 1-65 | Com. 2-11 | 3.53 | 22.04 | 256 | Red |
| Ex. 177 | Com. 1-65 | Com. 2-45 | 3.58 | 22.93 | 256 | Red |
| Ex. 178 | Com. 1-65 | Com. 2-60 | 3.44 | 23.83 | 275 | Red |
| Ex. 179 | Com. 1-65 | Com. 2-85 | 3.52 | 21.99 | 258 | Red |
| Ex. 180 | Com. 1-65 | Com. 2-100 | 3.53 | 22.99 | 250 | Red |
| Ex. 181 | Com. 1-66 | Com. 2-6 | 3.43 | 24.24 | 277 | Red |
| Ex. 182 | Com. 1-66 | Com. 2-26 | 3.60 | 22.67 | 246 | Red |
| Ex. 183 | Com. 1-66 | Com. 2-50 | 3.53 | 21.90 | 239 | Red |
| Ex. 184 | Com. 1-66 | Com. 2-90 | 3.55 | 20.81 | 243 | Red |
| Ex. 185 | Com. 1-66 | Com. 2-100 | 3.56 | 20.93 | 238 | Red |
| Ex. 186 | Com. 1-67 | Com. 2-16 | 3.48 | 23.69 | 290 | Red |
| Ex. 187 | Com. 1-67 | Com. 2-31 | 3.53 | 21.86 | 239 | Red |
| Ex. 188 | Com. 1-67 | Com. 2-55 | 3.43 | 24.18 | 282 | Red |
| Ex. 189 | Com. 1-67 | Com. 2-95 | 3.57 | 21.50 | 239 | Red |
| Ex. 190 | Com. 1-67 | Com. 2-109 | 3.59 | 21.16 | 244 | Red |
| Ex. 191 | Com. 1-68 | Com. 2-5 | 3.47 | 23.76 | 290 | Red |
| Ex. 192 | Com. 1-68 | Com. 2-31 | 3.77 | 20.71 | 228 | Red |
| Ex. 193 | Com. 1-68 | Com. 2-60 | 3.81 | 20.79 | 220 | Red |
| Ex. 194 | Com. 1-68 | Com. 2-100 | 3.71 | 20.61 | 234 | Red |
| Ex. 195 | Com. 1-68 | Com. 2-109 | 3.71 | 20.84 | 218 | Red |
| Ex. 196 | Com. 1-69 | Com. 2-16 | 3.59 | 22.96 | 261 | Red |
| Ex. 197 | Com. 1-69 | Com. 2-40 | 3.54 | 22.56 | 261 | Red |
| Ex. 198 | Com. 1-69 | Com. 2-65 | 3.77 | 20.66 | 219 | Red |
| Ex. 199 | Com. 1-69 | Com. 2-95 | 3.80 | 20.76 | 221 | Red |
| Ex. 200 | Com. 1-69 | Com. 2-109 | 3.76 | 20.64 | 228 | Red |

**[Table 9]**

| | First host | Second host | Driving voltage(V) | Efficiency (cd/A) | Lifetime T95(hr) | Luminescent color |
|---|---|---|---|---|---|---|
| Comparative Ex. 1 | Com. B-1 | Com. 2-1 | 4.17 | 18.26 | 151 | Red |
| Comparative Ex. 2 | Com. B-1 | Com. 2-7 | 4.11 | 17.89 | 142 | Red |
| Comparative Ex. 3 | Com. B-1 | Com. 2-15 | 4.11 | 18.58 | 131 | Red |
| Comparative Ex. 4 | Com. B-1 | Com. 2-25 | 4.21 | 18.21 | 139 | Red |
| Comparative Ex. 5 | Com. B-1 | Com. 2-32 | 4.10 | 18.68 | 144 | Red |
| Comparative Ex. 6 | Com. B-2 | Com. 2-2 | 4.20 | 18.57 | 138 | Red |
| Comparative Ex. 7 | Com. B-2 | Com. 2-8 | 4.11 | 18.64 | 138 | Red |
| Comparative Ex. 8 | Com. B-2 | Com. 2-16 | 4.12 | 18.43 | 132 | Red |
| Comparative Ex. 9 | Com. B-2 | Com. 2-26 | 4.20 | 18.51 | 135 | Red |
| Comparative Ex. 10 | Com. B-2 | Com. 2-41 | 4.13 | 18.70 | 139 | Red |
| Comparative Ex. 11 | Com. B-3 | Com. 2-3 | 4.29 | 18.08 | 135 | Red |
| Comparative Ex. 12 | Com. B-3 | Com. 2-9 | 4.19 | 17.99 | 143 | Red |
| Comparative Ex. 13 | Com. B-3 | Com. 2-17 | 4.20 | 17.44 | 138 | Red |
| Comparative Ex. 14 | Com. B-3 | Com. 2-27 | 4.12 | 17.61 | 138 | Red |
| Comparative Ex. 15 | Com. B-3 | Com. 2-34 | 4.11 | 17.67 | 143 | Red |
| Comparative Ex. 16 | Com. B-4 | Com. 2-4 | 4.09 | 17.80 | 147 | Red |
| Comparative Ex. 17 | Com. B-4 | Com. 2-10 | 4.14 | 17.40 | 148 | Red |
| Comparative Ex. 18 | Com. B-4 | Com. 2-18 | 4.20 | 17.76 | 146 | Red |
| Comparative Ex. 19 | Com. B-4 | Com. 2-28 | 4.16 | 17.81 | 139 | Red |
| Comparative Ex. 20 | Com. B-4 | Com. 2-43 | 4.19 | 17.24 | 135 | Red |
| Comparative Ex. 21 | Com. B-5 | Com. 2-5 | 4.38 | 13.75 | 103 | Red |
| Comparative Ex. 22 | Com. B-5 | Com. 2-11 | 4.30 | 14.33 | 98 | Red |
| Comparative Ex. 23 | Com. B-5 | Com. 2-19 | 4.33 | 14.23 | 91 | Red |
| Comparative Ex. 24 | Com. B-5 | Com. 2-29 | 4.42 | 14.24 | 82 | Red |
| Comparative Ex. 25 | Com. B-5 | Com. 2-36 | 4.29 | 14.42 | 91 | Red |

**[Table 10]**

| | First host | Second host | Driving voltage(V) | Efficiency (cd/A) | Lifetime T95(hr) | Luminescent color |
|---|---|---|---|---|---|---|
| Comparative Ex. 26 | Com. B-6 | Com. 2-6 | 4.40 | 13.63 | 86 | Red |
| Comparative Ex. 27 | Com. B-6 | Com. 2-12 | 4.35 | 13.56 | 96 | Red |
| Comparative Ex. 28 | Com. B-6 | Com. 2-20 | 4.32 | 14.46 | 85 | Red |
| Comparative Ex. 29 | Com. B-6 | Com. 2-30 | 4.33 | 13.96 | 98 | Red |
| Comparative Ex. 30 | Com. B-6 | Com. 2-45 | 4.42 | 13.31 | 103 | Red |
| Comparative Ex. 31 | Com. B-7 | Com. 2-1 | 4.11 | 18.03 | 155 | Red |
| Comparative Ex. 32 | Com. B-7 | Com. 2-7 | 4.20 | 18.17 | 136 | Red |
| Comparative Ex. 33 | Com. B-7 | Com. 2-15 | 4.19 | 17.87 | 135 | Red |
| Comparative Ex. 34 | Com. B-7 | Com. 2-25 | 4.15 | 18.05 | 137 | Red |
| Comparative Ex. 35 | Com. B-7 | Com. 2-32 | 4.19 | 18.75 | 146 | Red |
| Comparative Ex. 36 | Com. B-8 | Com. 2-2 | 4.15 | 18.38 | 134 | Red |
| Comparative Ex. 37 | Com. B-8 | Com. 2-8 | 4.11 | 18.74 | 138 | Red |
| Comparative Ex. 38 | Com. B-8 | Com. 2-16 | 4.16 | 18.05 | 141 | Red |
| Comparative Ex. 39 | Com. B-8 | Com. 2-26 | 4.13 | 18.24 | 147 | Red |
| Comparative Ex. 40 | Com. B-8 | Com. 2-41 | 4.16 | 18.63 | 140 | Red |
| Comparative Ex. 41 | Com. B-9 | Com. 2-3 | 4.28 | 17.45 | 140 | Red |
| Comparative Ex. 42 | Com. B-9 | Com. 2-9 | 4.21 | 17.56 | 136 | Red |
| Comparative Ex. 43 | Com. B-9 | Com. 2-17 | 4.14 | 17.25 | 135 | Red |
| Comparative Ex. 44 | Com. B-9 | Com. 2-27 | 4.19 | 17.38 | 137 | Red |
| Comparative Ex. 45 | Com. B-9 | Com. 2-34 | 4.14 | 17.32 | 146 | Red |
| Comparative Ex. 46 | Com. B-10 | Com. 2-4 | 4.31 | 13.55 | 91 | Red |
| Comparative Ex. 47 | Com. B-10 | Com. 2-10 | 4.30 | 14.11 | 105 | Red |
| Comparative Ex. 48 | Com. B-10 | Com. 2-18 | 4.39 | 13.70 | 103 | Red |
| Comparative Ex. 49 | Com. B-10 | Com. 2-28 | 4.36 | 14.00 | 93 | Red |
| Comparative Ex. 50 | Com. B-10 | Com. 2-43 | 4.41 | 13.74 | 105 | Red |

**[Table 11]**

| | First host | Second host | Driving voltage(V) | Efficiency (cd/A) | Lifetime T95(hr) | Luminescent color |
|---|---|---|---|---|---|---|
| Comparative Ex. 51 | Com. B-11 | Com. 2-5 | 4.39 | 13.25 | 107 | Red |
| Comparative Ex. 52 | Com. B-11 | Com. 2-11 | 4.30 | 14.10 | 97 | Red |
| Comparative Ex. 53 | Com. B-11 | Com. 2-19 | 4.38 | 13.80 | 104 | Red |
| Comparative Ex. 54 | Com. B-11 | Com. 2-29 | 4.41 | 14.49 | 101 | Red |
| Comparative Ex. 55 | Com. B-11 | Com. 2-36 | 4.33 | 14.34 | 105 | Red |
| Comparative Ex. 56 | Com. B-12 | Com. 2-6 | 4.13 | 18.21 | 161 | Red |
| Comparative Ex. 57 | Com. B-12 | Com. 2-12 | 4.10 | 18.76 | 136 | Red |
| Comparative Ex. 58 | Com. B-12 | Com. 2-20 | 4.18 | 18.71 | 138 | Red |
| Comparative Ex. 59 | Com. B-12 | Com. 2-30 | 4.14 | 18.66 | 143 | Red |
| Comparative Ex. 60 | Com. B-12 | Com. 2-45 | 4.14 | 18.53 | 142 | Red |

**[Table 12]**

| | First host | Second host | Driving voltage(V) | Efficiency (cd/A) | Lifetime T95(hr) | Luminescent color |
|---|---|---|---|---|---|---|
| Comparative Ex. 61 | Com. 2-1 | Com. C-1 | 4.10 | 18.10 | 168 | Red |
| Comparative Ex. 62 | Com. 2-27 | Com. C-1 | 4.12 | 18.64 | 147 | Red |
| Comparative Ex. 63 | Com. 2-46 | Com. C-1 | 4.12 | 18.30 | 134 | Red |
| Comparative Ex. 64 | Com. 2-66 | Com. C-1 | 4.13 | 18.33 | 143 | Red |
| Comparative Ex. 65 | Com. 2-3 | Com. C-1 | 4.16 | 18.76 | 135 | Red |
| Comparative Ex. 66 | Com. 2-12 | Com. C-1 | 4.09 | 18.62 | 149 | Red |
| Comparative Ex. 67 | Com. 2-51 | Com. C-1 | 4.10 | 18.07 | 141 | Red |
| Comparative Ex. 68 | Com. 2-71 | Com. C-1 | 4.10 | 18.54 | 137 | Red |
| Comparative Ex. 69 | Com. 2-17 | Com. C-2 | 4.29 | 17.94 | 147 | Red |
| Comparative Ex. 70 | Com. 2-36 | Com. C-2 | 4.10 | 17.44 | 147 | Red |
| Comparative Ex. 71 | Com. 2-51 | Com. C-2 | 4.10 | 18.08 | 134 | Red |
| Comparative Ex. 72 | Com. 2-76 | Com. C-2 | 4.17 | 17.48 | 143 | Red |
| Comparative Ex. 73 | Com. 2-105 | Com. C-2 | 4.14 | 17.43 | 135 | Red |
| Comparative Ex. 74 | Com. 2-7 | Com. C-2 | 4.21 | 17.60 | 149 | Red |
| Comparative Ex. 75 | Com. 2-41 | Com. C-2 | 4.09 | 17.91 | 141 | Red |
| Comparative Ex. 76 | Com. 2-56 | Com. C-2 | 4.17 | 17.29 | 137 | Red |
| Comparative Ex. 77 | Com. 2-1 | Com. C-3 | 4.13 | 18.04 | 154 | Red |
| Comparative Ex. 78 | Com. 2-22 | Com. C-3 | 4.20 | 17.91 | 169 | Red |
| Comparative Ex. 79 | Com. 2-46 | Com. C-3 | 4.10 | 18.30 | 152 | Red |
| Comparative Ex. 80 | Com. 2-86 | Com. C-3 | 4.19 | 18.13 | 163 | Red |
| Comparative Ex. 81 | Com. 2-96 | Com. C-3 | 4.11 | 18.20 | 154 | Red |
| Comparative Ex. 82 | Com. 2-5 | Com. C-3 | 4.12 | 17.92 | 159 | Red |
| Comparative Ex. 83 | Com. 2-25 | Com. C-3 | 4.12 | 18.12 | 172 | Red |
| Comparative Ex. 84 | Com. 2-49 | Com. C-3 | 4.10 | 18.09 | 151 | Red |

**[Table 13]**

| | First host | Second host | Driving voltage(V) | Efficiency (cd/A) | Lifetime T95(hr) | Luminescent color |
|---|---|---|---|---|---|---|
| Comparative Ex. 85 | Com. 2-4 | Com. C-4 | 4.14 | 18.53 | 164 | Red |
| Comparative Ex. 86 | Com. 2-24 | Com. C-4 | 4.18 | 17.85 | 154 | Red |
| Comparative Ex. 87 | Com. 2-48 | Com. C-4 | 4.09 | 18.80 | 157 | Red |
| Comparative Ex. 88 | Com. 2-88 | Com. C-4 | 4.17 | 18.60 | 166 | Red |
| Comparative Ex. 89 | Com. 2-98 | Com. C-4 | 4.18 | 18.49 | 153 | Red |
| Comparative Ex. 90 | Com. 2-14 | Com. C-4 | 4.19 | 18.34 | 166 | Red |
| Comparative Ex. 91 | Com. 2-29 | Com. C-4 | 4.11 | 17.86 | 151 | Red |
| Comparative Ex. 92 | Com. 2-53 | Com. C-4 | 4.11 | 17.98 | 157 | Red |
| Comparative Ex. 93 | Com. 2-1 | Com. C-5 | 4.29 | 17.21 | 102 | Red |
| Comparative Ex. 94 | Com. 2-27 | Com. C-5 | 4.38 | 13.33 | 97 | Red |
| Comparative Ex. 95 | Com. 2-46 | Com. C-5 | 4.31 | 13.73 | 88 | Red |
| Comparative Ex. 96 | Com. 2-66 | Com. C-5 | 4.37 | 14.31 | 96 | Red |
| Comparative Ex. 97 | Com. 2-3 | Com. C-5 | 4.36 | 13.66 | 102 | Red |
| Comparative Ex. 98 | Com. 2-12 | Com. C-5 | 4.40 | 14.35 | 106 | Red |
| Comparative Ex. 99 | Com. 2-51 | Com. C-5 | 4.35 | 13.23 | 84 | Red |
| Comparative Ex. 100 | Com. 2-71 | Com. C-5 | 4.29 | 14.36 | 96 | Red |
| Comparative Ex. 101 | Com. 2-17 | Com. C-6 | 4.42 | 16.71 | 91 | Red |
| Comparative Ex. 102 | Com. 2-36 | Com. C-6 | 4.29 | 13.24 | 107 | Red |
| Comparative Ex. 103 | Com. 2-51 | Com. C-6 | 4.33 | 13.29 | 83 | Red |
| Comparative Ex. 104 | Com. 2-76 | Com. C-6 | 4.32 | 13.62 | 92 | Red |
| Comparative Ex. 105 | Com. 2-105 | Com. C-6 | 4.38 | 13.41 | 95 | Red |
| Comparative Ex. 106 | Com. 2-7 | Com. C-6 | 4.30 | 14.11 | 90 | Red |
| Comparative Ex. 107 | Com. 2-41 | Com. C-6 | 4.41 | 13.92 | 85 | Red |
| Comparative Ex. 108 | Com. 2-56 | Com. C-6 | 4.41 | 13.25 | 105 | Red |

**[Table 14]**

| | First host | Second host | Driving voltage(V) | Efficiency (cd/A) | Lifetime T95(hr) | Luminescent color |
|---|---|---|---|---|---|---|
| Comparative Ex. 109 | Com. 2-1 | Com. C-7 | 4.17 | 18.10 | 161 | Red |
| Comparative Ex. 110 | Com. 2-22 | Com. C-7 | 4.18 | 18.13 | 160 | Red |
| Comparative Ex. 111 | Com. 2-46 | Com. C-7 | 4.09 | 18.13 | 153 | Red |
| Comparative Ex. 112 | Com. 2-86 | Com. C-7 | 4.13 | 17.95 | 173 | Red |
| Comparative Ex. 113 | Com. 2-96 | Com. C-7 | 4.16 | 18.71 | 166 | Red |
| Comparative Ex. 114 | Com. 2-5 | Com. C-7 | 4.20 | 18.80 | 163 | Red |
| Comparative Ex. 115 | Com. 2-25 | Com. C-7 | 4.09 | 18.28 | 173 | Red |
| Comparative Ex. 116 | Com. 2-49 | Com. C-7 | 4.12 | 17.81 | 151 | Red |
| Comparative Ex. 117 | Com. 2-4 | Com. C-8 | 4.25 | 17.93 | 146 | Red |
| Comparative Ex. 118 | Com. 2-24 | Com. C-8 | 4.11 | 18.05 | 131 | Red |
| Comparative Ex. 119 | Com. 2-48 | Com. C-8 | 4.09 | 17.95 | 142 | Red |
| Comparative Ex. 120 | Com. 2-88 | Com. C-8 | 4.19 | 17.98 | 136 | Red |
| Comparative Ex. 121 | Com. 2-98 | Com. C-8 | 4.11 | 17.77 | 145 | Red |
| Comparative Ex. 122 | Com. 2-14 | Com. C-8 | 4.11 | 17.37 | 140 | Red |
| Comparative Ex. 123 | Com. 2-29 | Com. C-8 | 4.12 | 17.40 | 144 | Red |
| Comparative Ex. 124 | Com. 2-53 | Com. C-8 | 4.21 | 17.55 | 134 | Red |
| Comparative Ex. 125 | Com. 2-1 | Com. C-9 | 4.42 | 17.04 | 131 | Red |
| Comparative Ex. 126 | Com. 2-27 | Com. C-9 | 4.31 | 13.48 | 131 | Red |
| Comparative Ex. 127 | Com. 2-46 | Com. C-9 | 4.29 | 14.18 | 129 | Red |
| Comparative Ex. 128 | Com. 2-66 | Com. C-9 | 4.34 | 14.27 | 124 | Red |
| Comparative Ex. 129 | Com. 2-3 | Com. C-9 | 4.33 | 13.61 | 122 | Red |
| Comparative Ex. 130 | Com. 2-12 | Com. C-9 | 4.36 | 13.98 | 124 | Red |
| Comparative Ex. 131 | Com. 2-51 | Com. C-9 | 4.32 | 13.90 | 134 | Red |
| Comparative Ex. 132 | Com. 2-71 | Com. C-9 | 4.37 | 14.43 | 131 | Red |

**[Table 15]**

| | First host | Second host | Driving voltage(V) | Efficiency (cd/A) | Lifetime T95(hr) | Luminescent color |
|---|---|---|---|---|---|---|
| Comparative Ex. 133 | Com. 2-17 | Com. C-10 | 4.40 | 17.46 | 134 | Red |
| Comparative Ex. 134 | Com. 2-36 | Com. C-10 | 4.42 | 13.64 | 133 | Red |
| Comparative Ex. 135 | Com. 2-51 | Com. C-10 | 4.39 | 14.10 | 126 | Red |
| Comparative Ex. 136 | Com. 2-76 | Com. C-10 | 4.40 | 13.83 | 124 | Red |
| Comparative Ex. 137 | Com. 2-105 | Com. C-10 | 4.32 | 14.34 | 133 | Red |
| Comparative Ex. 138 | Com. 2-7 | Com. C-10 | 4.35 | 13.36 | 126 | Red |
| Comparative Ex. 139 | Com. 2-41 | Com. C-10 | 4.41 | 14.11 | 131 | Red |
| Comparative Ex. 140 | Com. 2-56 | Com. C-10 | 4.34 | 13.82 | 134 | Red |
| Comparative Ex. 141 | Com. 2-1 | Com. C-11 | 4.39 | 16.83 | 123 | Red |
| Comparative Ex. 142 | Com. 2-22 | Com. C-11 | 4.40 | 13.83 | 126 | Red |
| Comparative Ex. 143 | Com. 2-46 | Com. C-11 | 4.34 | 14.11 | 122 | Red |
| Comparative Ex. 144 | Com. 2-86 | Com. C-11 | 4.40 | 14.12 | 132 | Red |
| Comparative Ex. 145 | Com. 2-96 | Com. C-11 | 4.31 | 14.43 | 123 | Red |
| Comparative Ex. 146 | Com. 2-5 | Com. C-11 | 4.37 | 14.23 | 127 | Red |
| Comparative Ex. 147 | Com. 2-25 | Com. C-11 | 4.29 | 13.95 | 134 | Red |
| Comparative Ex. 148 | Com. 2-49 | Com. C-11 | 4.29 | 13.56 | 123 | Red |
| Comparative Ex. 149 | Com. 2-4 | Com. C-12 | 4.38 | 13.53 | 106 | Red |
| Comparative Ex. 150 | Com. 2-24 | Com. C-12 | 4.40 | 13.25 | 91 | Red |
| Comparative Ex. 151 | Com. 2-48 | Com. C-12 | 4.37 | 14.20 | 104 | Red |
| Comparative Ex. 152 | Com. 2-88 | Com. C-12 | 4.30 | 14.21 | 87 | Red |
| Comparative Ex. 153 | Com. 2-98 | Com. C-12 | 4.34 | 14.45 | 107 | Red |
| Comparative Ex. 154 | Com. 2-14 | Com. C-12 | 4.34 | 13.56 | 101 | Red |
| Comparative Ex. 155 | Com. 2-29 | Com. C-12 | 4.42 | 14.22 | 84 | Red |
| Comparative Ex. 156 | Com. 2-53 | Com. C-12 | 4.42 | 13.70 | 99 | Red |

**[Table 16]**

| | First host | Second host | Driving voltage(V) | Efficiency (cd/A) | Lifetime T95(hr) | Luminescent color |
|---|---|---|---|---|---|---|
| Comparative Ex. 157 | Com. 2-1 | Com. C-13 | 4.32 | 13.41 | 87 | Red |
| Comparative Ex. 158 | Com. 2-27 | Com. C-13 | 4.33 | 13.78 | 89 | Red |
| Comparative Ex. 159 | Com. 2-46 | Com. C-13 | 4.31 | 14.12 | 102 | Red |
| Comparative Ex. 160 | Com. 2-66 | Com. C-13 | 4.37 | 13.57 | 102 | Red |
| Comparative Ex. 161 | Com. 2-3 | Com. C-13 | 4.29 | 14.24 | 104 | Red |
| Comparative Ex. 162 | Com. 2-12 | Com. C-13 | 4.38 | 13.81 | 91 | Red |
| Comparative Ex. 163 | Com. 2-51 | Com. C-13 | 4.29 | 13.88 | 86 | Red |
| Comparative Ex. 164 | Com. 2-71 | Com. C-13 | 4.42 | 14.03 | 83 | Red |
| Comparative Ex. 165 | Com. 2-17 | Com. C-14 | 4.29 | 14.11 | 94 | Red |
| Comparative Ex. 166 | Com. 2-36 | Com. C-14 | 4.36 | 13.45 | 94 | Red |
| Comparative Ex. 167 | Com. 2-51 | Com. C-14 | 4.36 | 14.05 | 104 | Red |
| Comparative Ex. 168 | Com. 2-76 | Com. C-14 | 4.42 | 13.82 | 101 | Red |
| Comparative Ex. 169 | Com. 2-105 | Com. C-14 | 4.33 | 14.18 | 83 | Red |
| Comparative Ex. 170 | Com. 2-7 | Com. C-14 | 4.42 | 14.12 | 101 | Red |
| Comparative Ex. 171 | Com. 2-41 | Com. C-14 | 4.42 | 13.52 | 107 | Red |
| Comparative Ex. 172 | Com. 2-56 | Com. C-14 | 4.33 | 13.22 | 101 | Red |
| Comparative Ex. 173 | Com. 2-1 | Com. C-15 | 4.10 | 18.40 | 157 | Red |
| Comparative Ex. 174 | Com. 2-22 | Com. C-15 | 4.16 | 18.65 | 175 | Red |
| Comparative Ex. 175 | Com. 2-46 | Com. C-15 | 4.10 | 18.57 | 175 | Red |
| Comparative Ex. 176 | Com. 2-86 | Com. C-15 | 4.20 | 18.69 | 156 | Red |
| Comparative Ex. 177 | Com. 2-96 | Com. C-15 | 4.13 | 18.31 | 149 | Red |
| Comparative Ex. 178 | Com. 2-5 | Com. C-15 | 4.13 | 18.72 | 155 | Red |
| Comparative Ex. 179 | Com. 2-25 | Com. C-15 | 4.18 | 18.17 | 175 | Red |
| Comparative Ex. 180 | Com. 2-49 | Com. C-15 | 4.19 | 18.01 | 166 | Red |

**[Table 17]**

| | First host | Second host | Driving voltage(V) | Efficiency (cd/A) | Lifetime T95(hr) | Luminescent color |
|---|---|---|---|---|---|---|
| Comparative Ex. 181 | Com. 2-4 | Com. C-16 | 4.09 | 18.36 | 163 | Red |
| Comparative Ex. 182 | Com. 2-24 | Com. C-16 | 4.20 | 18.00 | 155 | Red |
| Comparative Ex. 183 | Com. 2-48 | Com. C-16 | 4.11 | 18.59 | 161 | Red |
| Comparative Ex. 184 | Com. 2-88 | Com. C-16 | 4.11 | 18.04 | 168 | Red |
| Comparative Ex. 185 | Com. 2-98 | Com. C-16 | 4.15 | 18.53 | 175 | Red |
| Comparative Ex. 186 | Com. 2-14 | Com. C-16 | 4.17 | 18.11 | 167 | Red |
| Comparative Ex. 187 | Com. 2-29 | Com. C-16 | 4.17 | 18.08 | 157 | Red |
| Comparative Ex. 188 | Com. 2-53 | Com. C-16 | 4.10 | 17.93 | 149 | Red |

When a current was applied to the organic light emitting devices manufactured in Examples 1 to 200 and Comparative Examples 1 to 188, the results shown in the above Tables were obtained. A material widely used in the prior art was used as the red organic light emitting device of Example 1, Compound EB-1 was used as the electron blocking layer, and Compound Dp-7 was used as the dopant of the red light emitting layer. When any one of Comparative Example Compounds B-1 to B-12 and the compound represented by Chemical Formula 2 of the present disclosure were co-deposited together and used as a red light emitting layer, the result showed that generally, the driving voltage increased and the efficiency and lifetime decreased as compared with the combination of the present disclosure. Even when any one of Comparative Example Compounds C-1 to C-16 and the compound represented by Chemical Formula 1 of the present disclosure were co-deposited together and used as a red light emitting layer, the result showed that the driving voltage increased and the efficiency and lifetime decreased.

When inferred from these results, it can be seen that the reasons for an improvement in the driving voltage and an increase in the efficiency and lifetime is that the combination of the compound of Chemical Formula 1 as the first host of the present disclosure and the compound of Chemical Formula 2 as the second host provides good energy transfer to the red dopant in the red light emitting layer. After all, this confirms that the combination of Chemical Formula 1 and Chemical Formula 2 of the present disclosure combines electrons and holes through a more stable balance in the light emitting layer than the combination with Comparative Example Compounds, thereby forming excitons and greatly increasing the efficiency and lifetime.

In conclusion, when the compound of Chemical Formula 1 and the compound of Chemical Formula 2 of the present disclosure were combined, co-deposited and used as a host for the red light emitting layer, it can be confirmed that the driving voltage, luminous efficiency, and lifetime characteristics of the organic light emitting device can be improved.

### [Description of Symbols]

| | | | |
|---|---|---|---|
| | 1: substrate | 2: | anode |
| | 3: light emitting layer | 4: | cathode |
| | 5: hole injection layer | 6: | hole transport layer |
| | 7: light emitting layer | 8: | electron transport layer |

## Claims

1. An organic light emitting device comprising:
an anode (2);
a cathode (4); and
a light emitting layer (3) interposed between the anode and the cathode,
wherein the light emitting layer comprises (i) a compound represented by the following Chemical Formula 1, and (ii) a compound represented by the following Chemical Formula 2, or the following Chemical Formula 3: 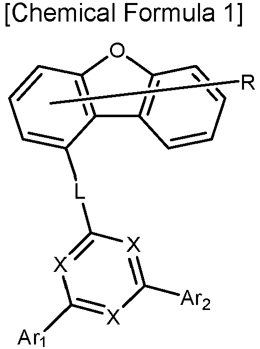
wherein in Chemical Formula 1,
L is a single bond; or a substituted or unsubstituted C₆₋₆₀ arylene,
X's are N; or CH, with the proviso that at least two or more of X are N,
R is hydrogen, deuterium, a substituted or unsubstituted C₆₋₆₀ aryl; or a substituted or unsubstituted C₂₋₆₀ heteroaryl containing any one or more selected from the group consisting of N, O and S,
Ar₁ and Ar₂ are each independently a substituted or unsubstituted C₆₋₆₀ aryl; or a substituted or unsubstituted C₂₋₆₀ heteroaryl containing any one or more selected from the group consisting of N, O and S, 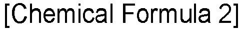 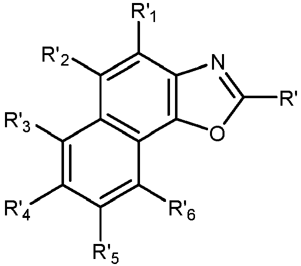 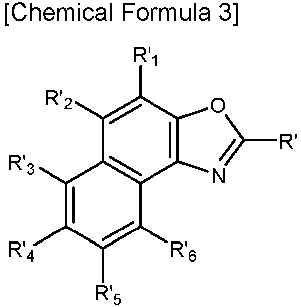
wherein in Chemical Formulas 2 and 3,
R' is a substituent represented by the following Chemical Formula 4, or a substituted or unsubstituted C₆₋₆₀ aryl,
when R' is a substituent represented by the following Chemical Formula 4, R'₁ to R'₆ are each independently hydrogen or deuterium,
when R' is not a substituent represented by the following Chemical Formula 4, any one of R'₁ to R'₆ is a substituent represented by the following Chemical Formula 4, and the rest are each independently hydrogen or deuterium; 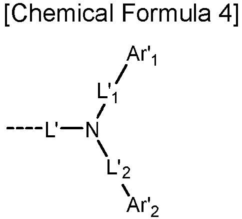
wherein in Chemical Formula 4,
L' is a single bond, a substituted or unsubstituted C₆₋₆₀ arylene, or a substituted or unsubstituted C₂₋₆₀ heteroarylene containing any one or more selected from the group consisting of N, O and S,
L'₁ and L'₂ are each independently a single bond, a substituted or unsubstituted C₆₋₆₀ arylene; or a substituted or unsubstituted C₂₋₆₀ heteroarylene containing any one or more selected from the group consisting of N, O and S, and
Ar'₁ and Ar'₂ are each independently a substituted or unsubstituted C₆₋₆₀ aryl, or a substituted or unsubstituted C₂₋₆₀ heteroaryl containing any one or more selected from the group consisting of N, O and S.

2. The organic light emitting device of claim 1, wherein:
L is a single bond; phenylene; biphenyldiyl; or naphthylene.

3. The organic light emitting device of claim 1, wherein:
all of X are N.

4. The organic light emitting device of claim 1, wherein:
R is hydrogen, deuterium, phenyl, biphenylyl, terphenylyl, naphthyl, phenylnaphthyl, naphthylphenyl, phenanthrenyl, triphenylenyl, fluoranthenyl, dibenzofuranyl, benzonaphthofuranyl, dibenzothiophenyl, or benzonaphthothiophenyl.

5. The organic light emitting device of claim 1, wherein:
Ar₁ and Ar₂ are each independently phenyl, biphenylyl, terphenylyl, naphthyl, naphthylphenyl, phenylnaphthyl, phenanthrenyl, dibenzofuranyl, or dibenzothiophenyl.

6. The organic light emitting device of claim 1, wherein:
the compound represented by Chemical Formula 1 is any one selected from the group consisting of:

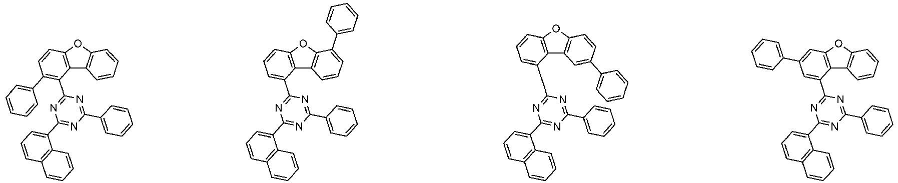

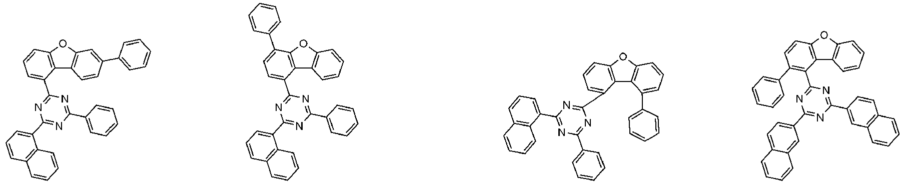

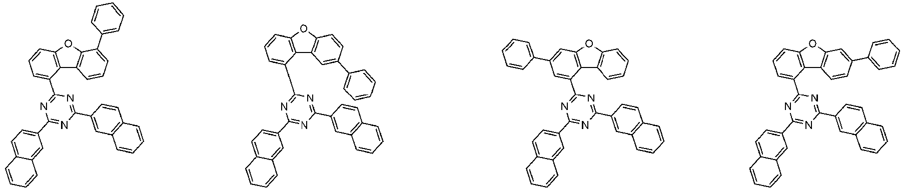

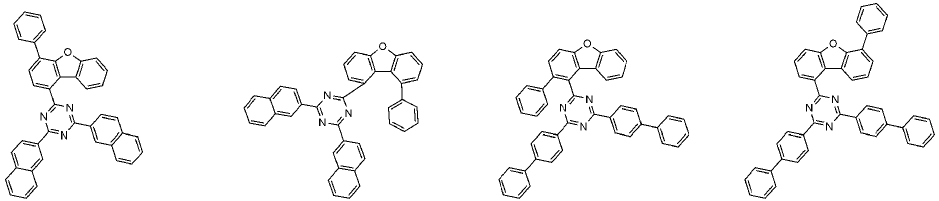

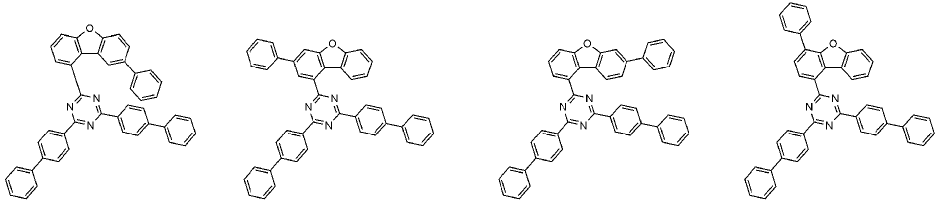

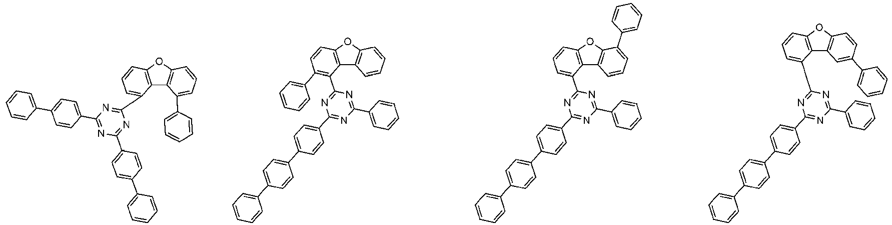

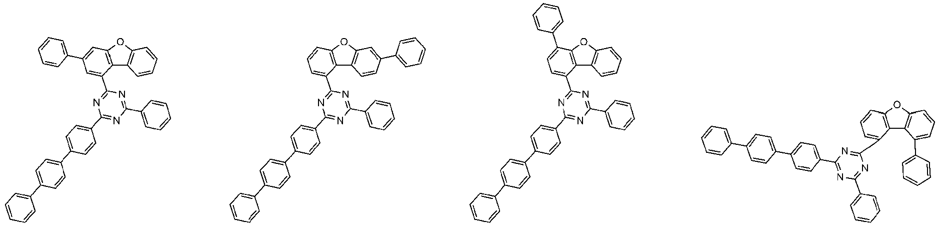

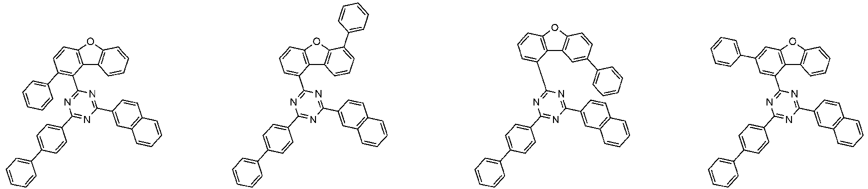

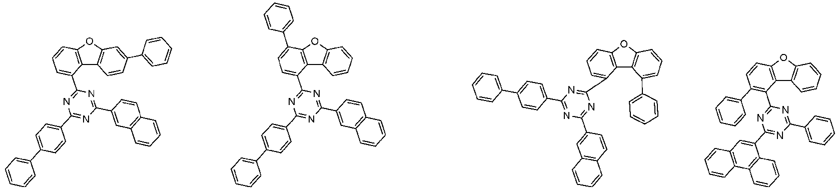

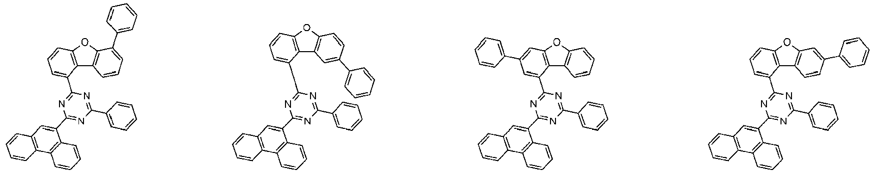

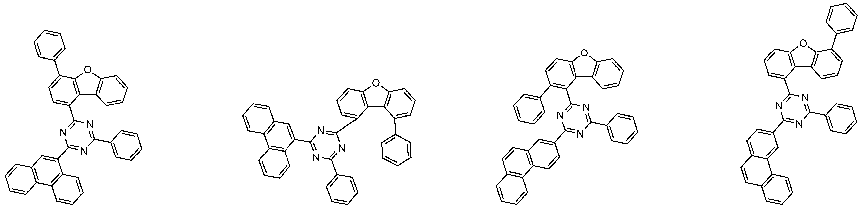

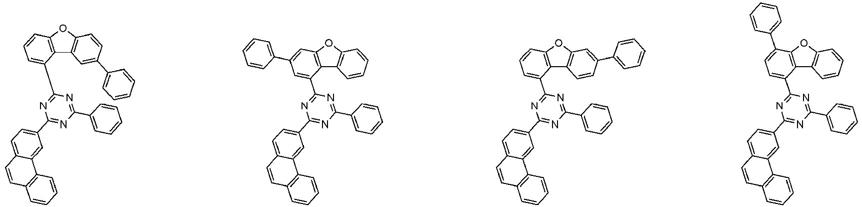

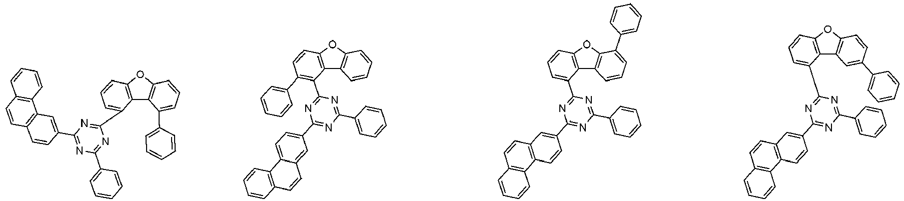

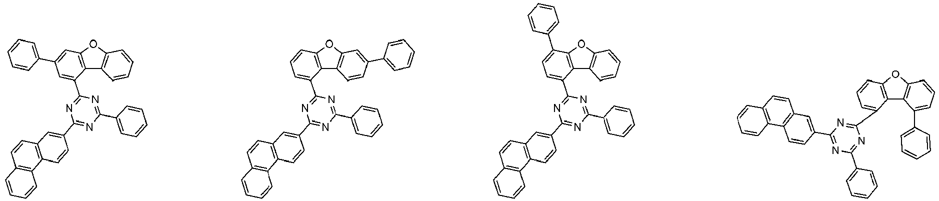

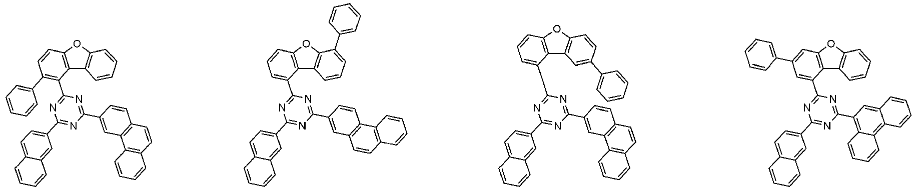

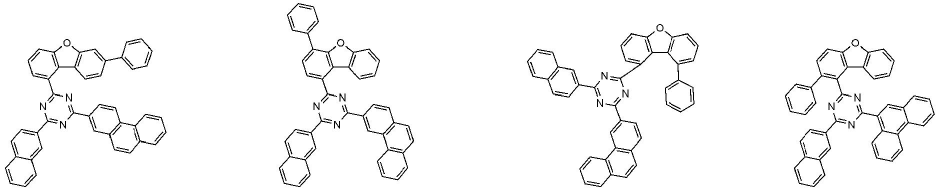

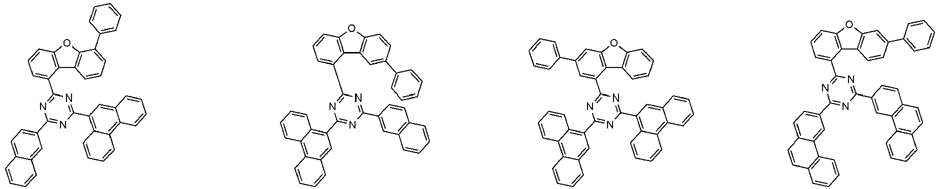

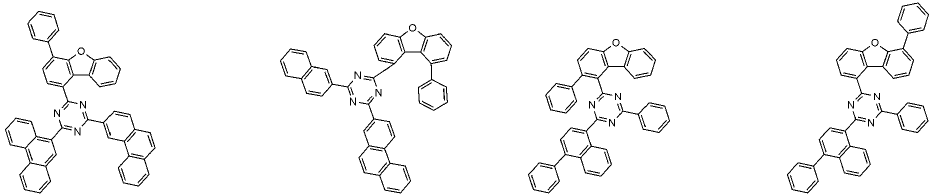

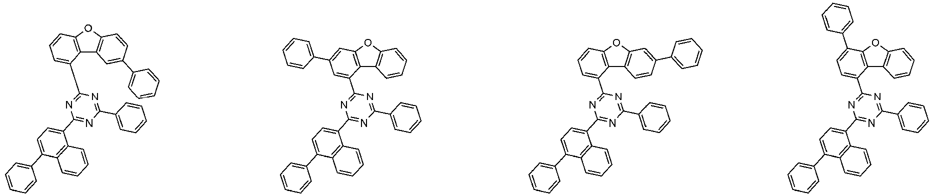

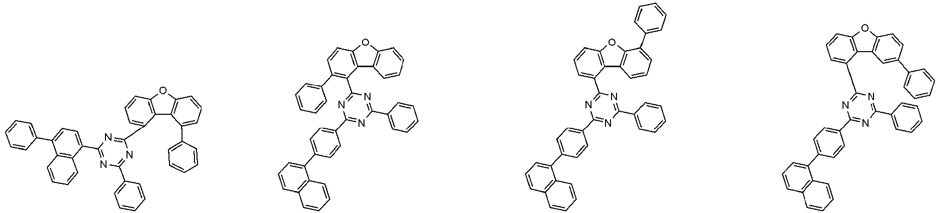

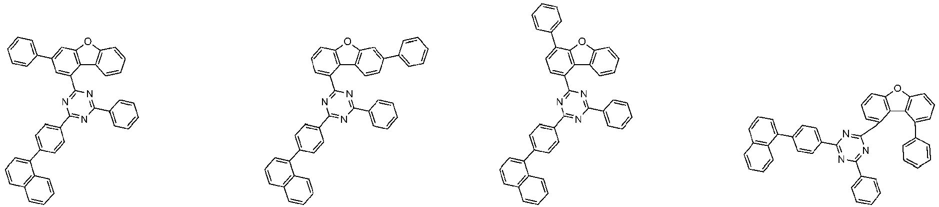

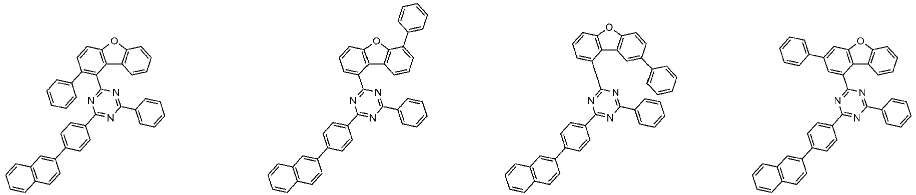

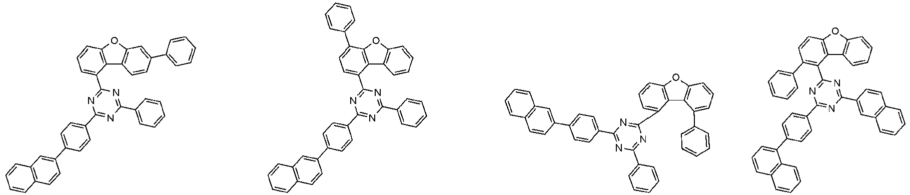

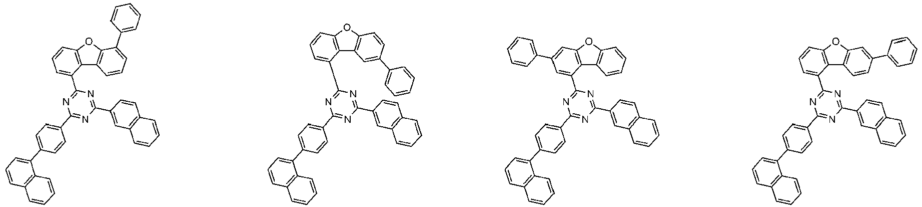

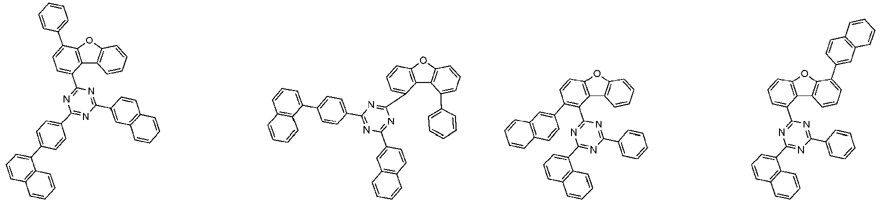

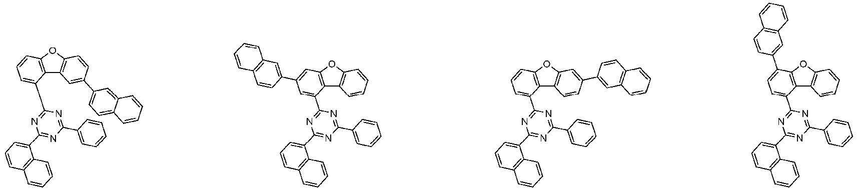

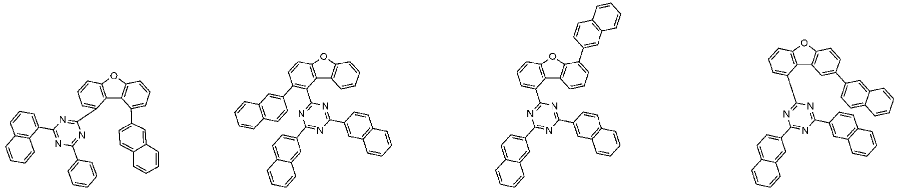

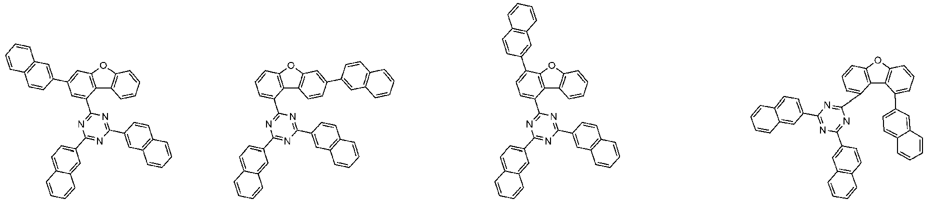

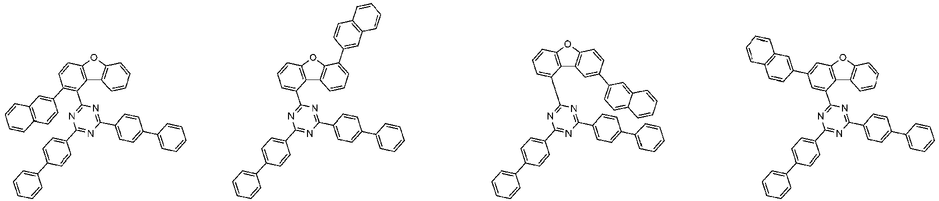

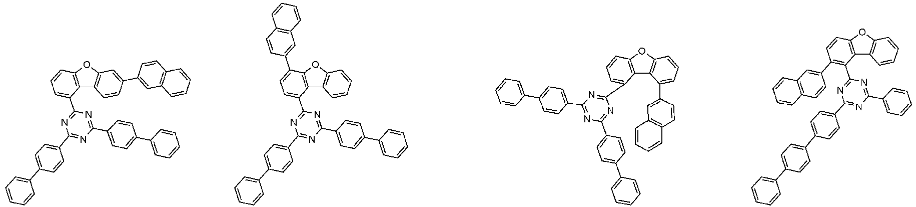

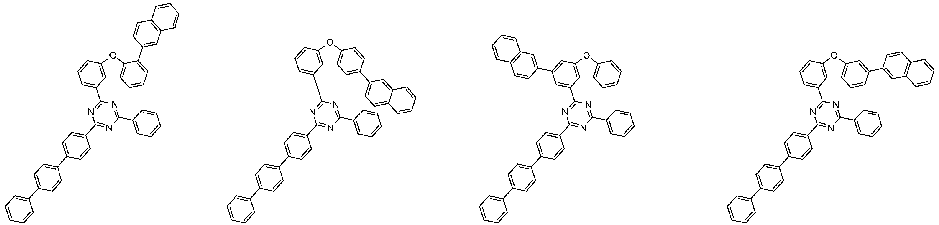

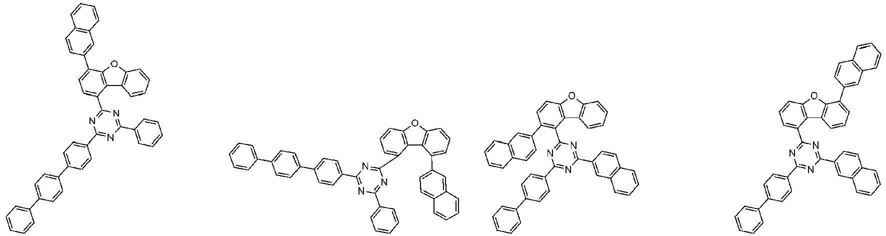

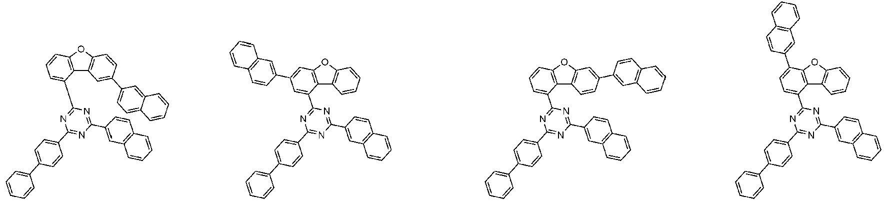

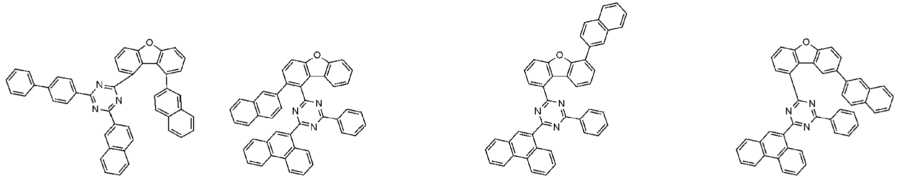

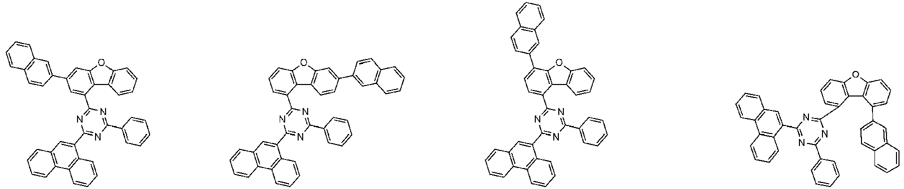

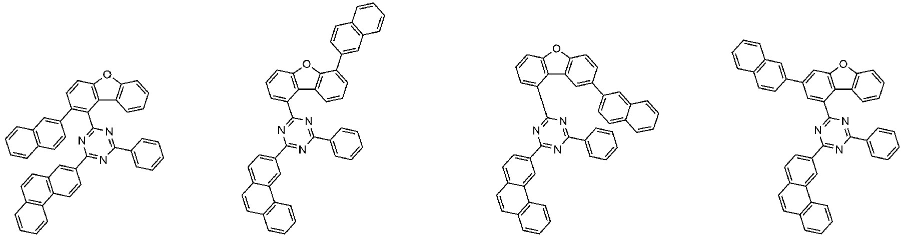

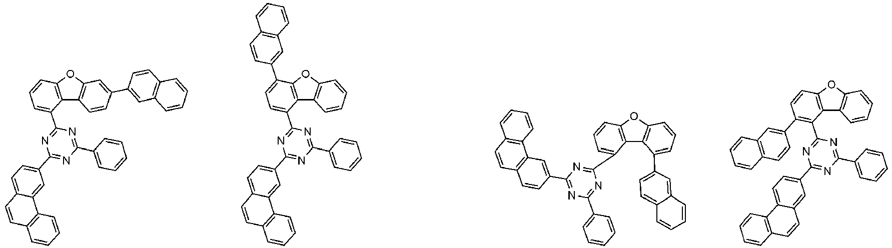

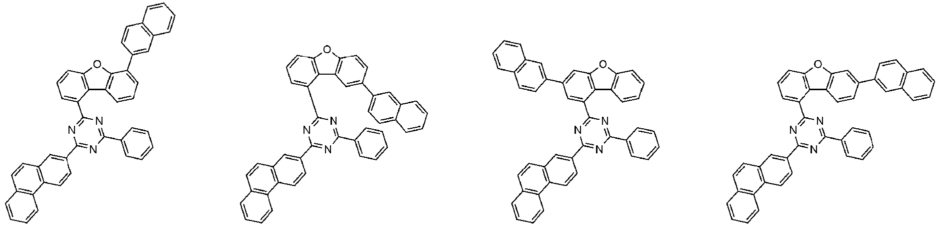

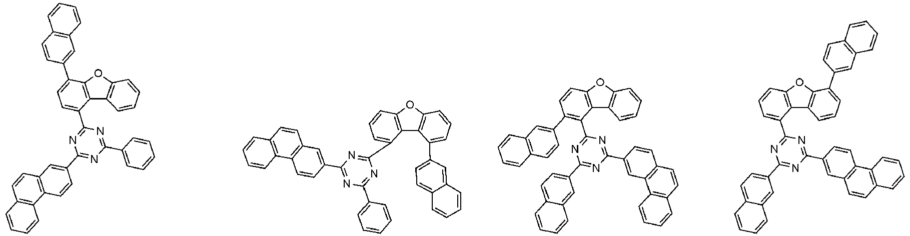

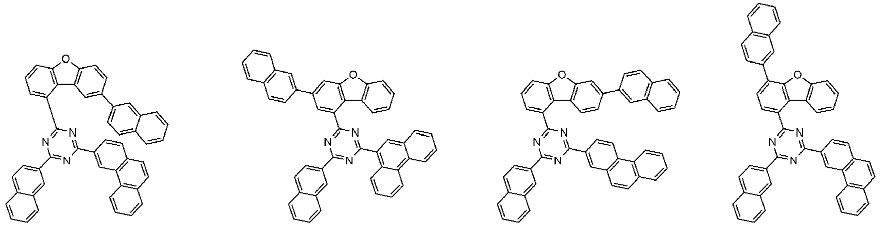

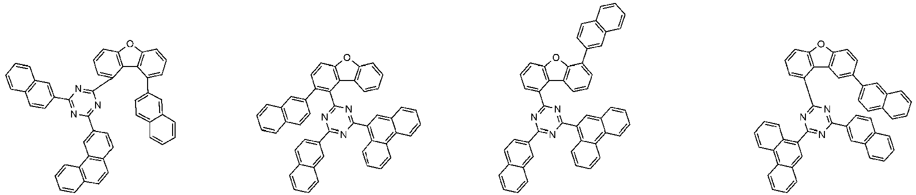

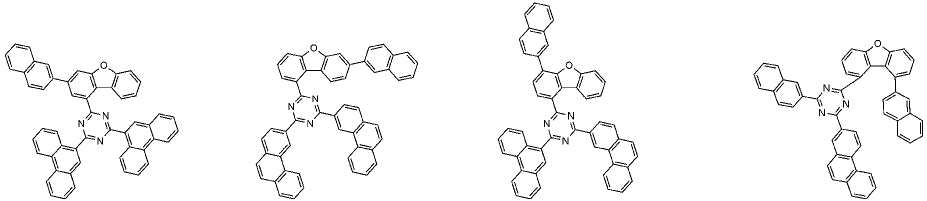

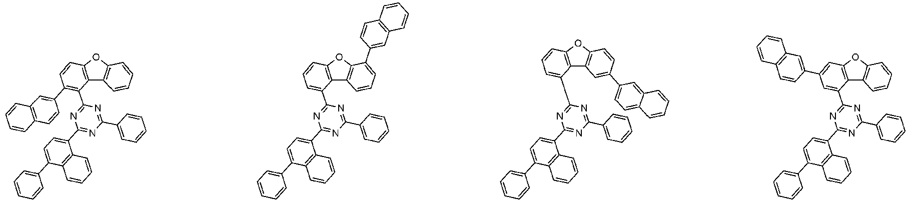

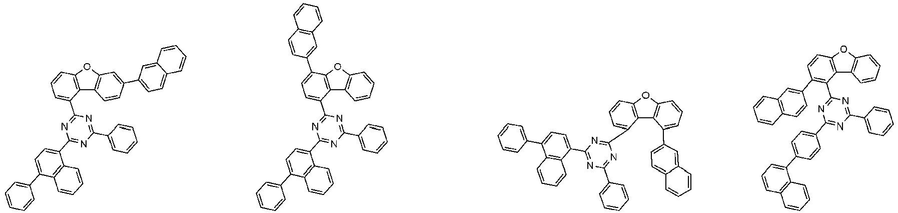

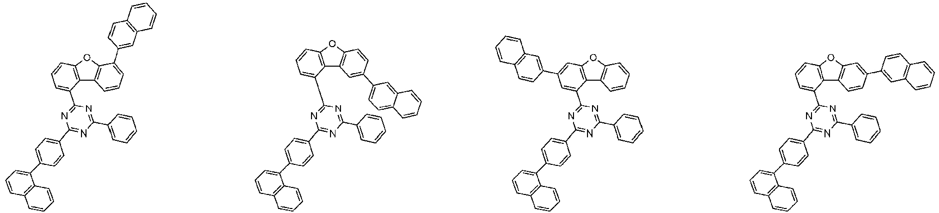

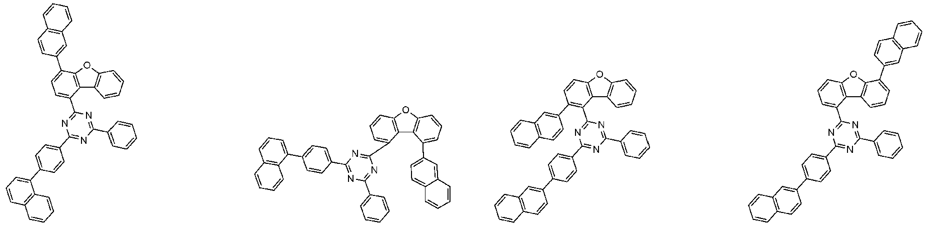

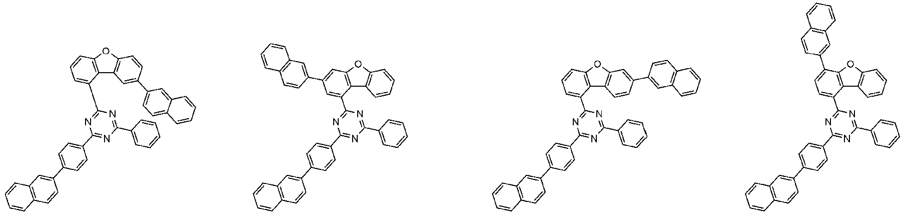

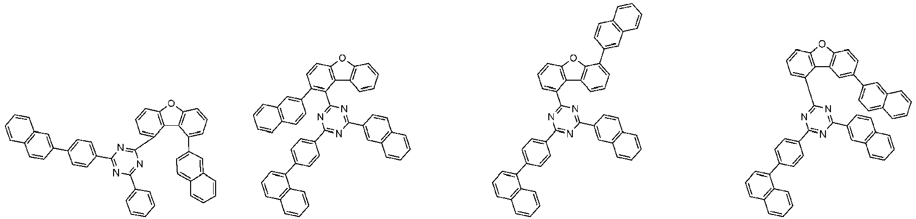

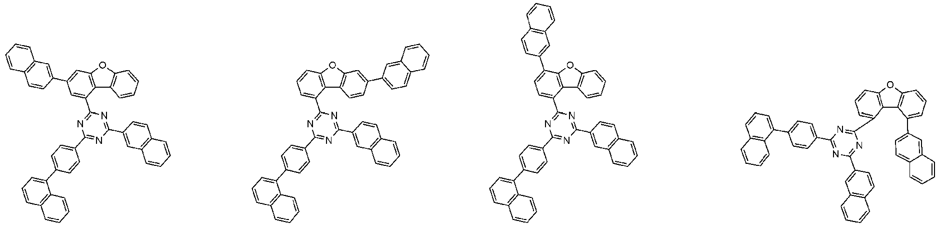

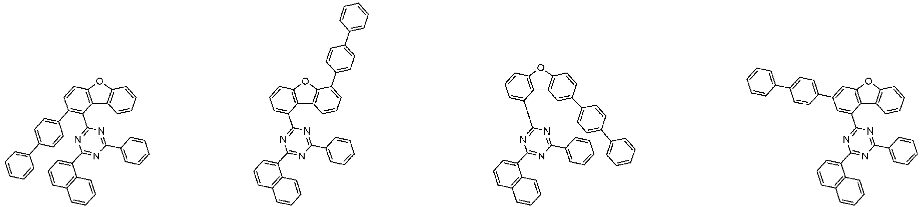

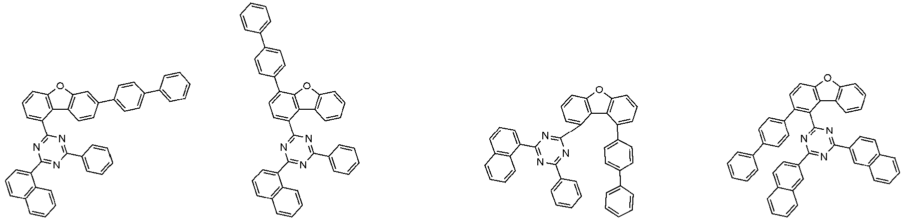

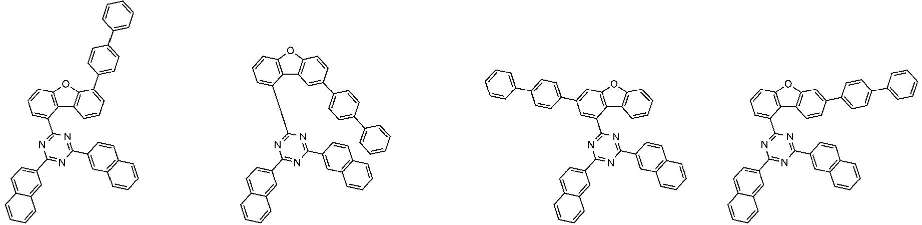

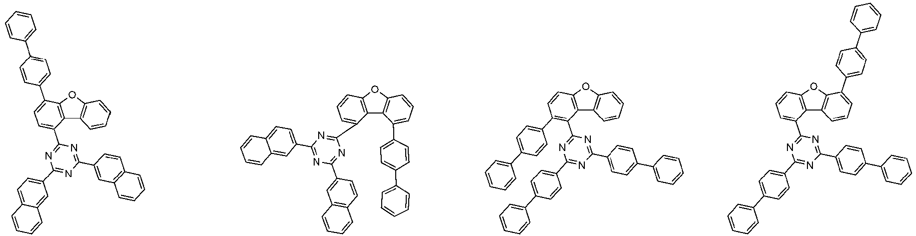

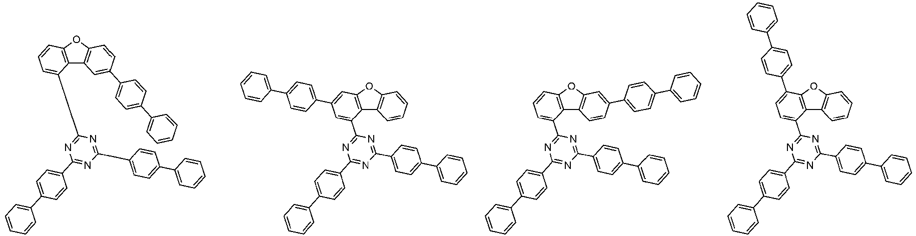

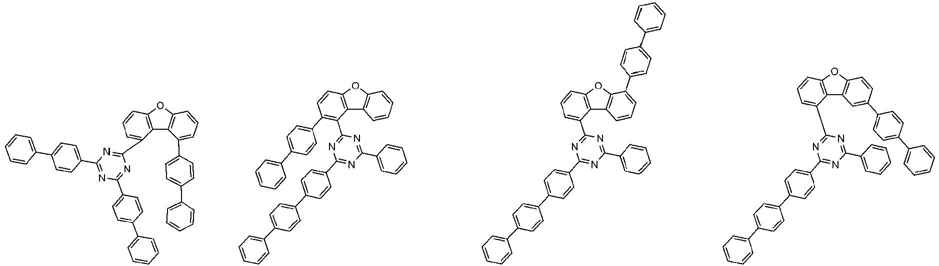

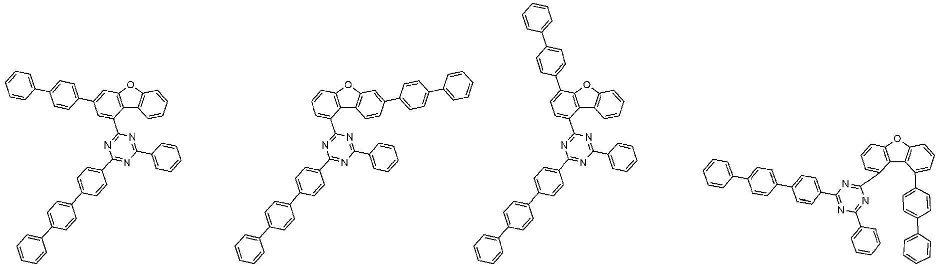

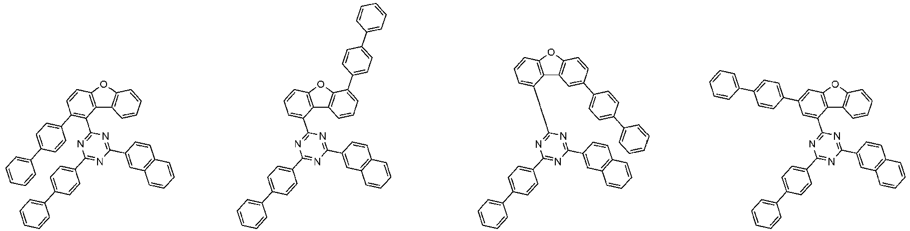

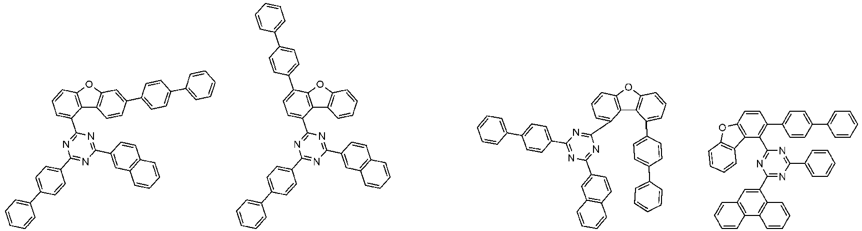

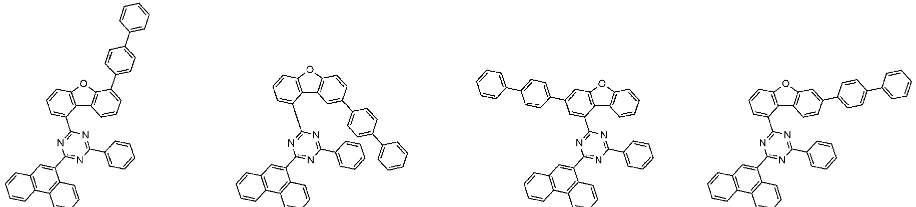

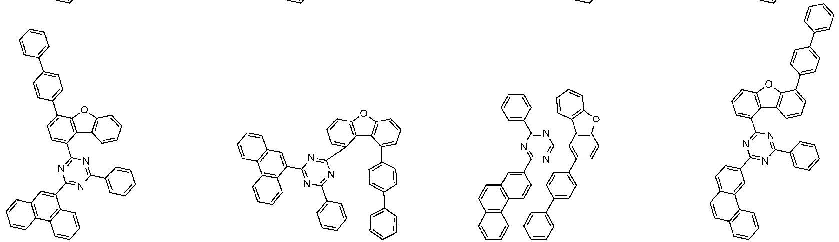

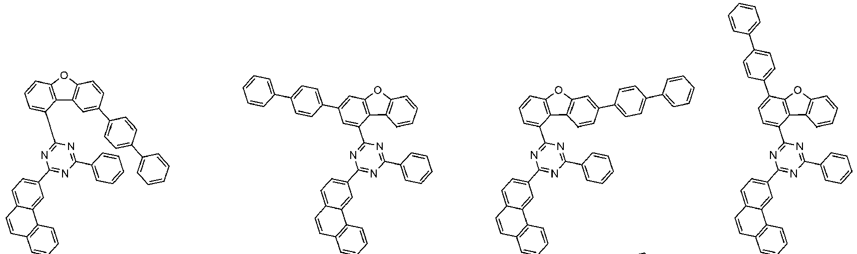

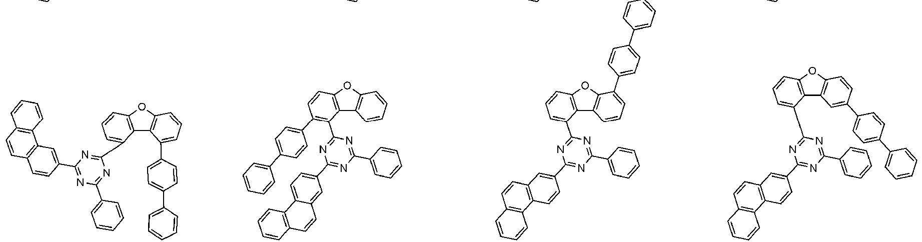

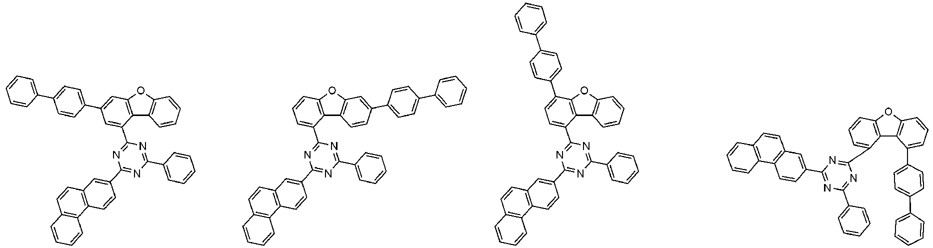

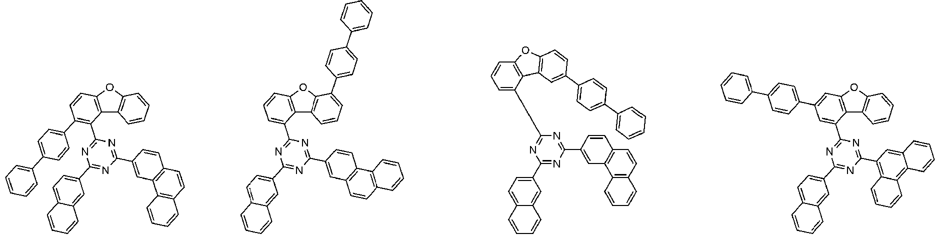

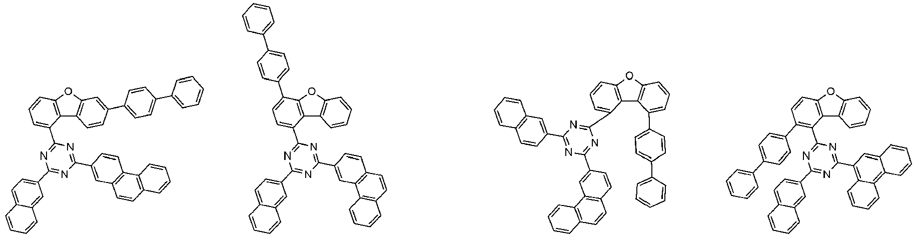

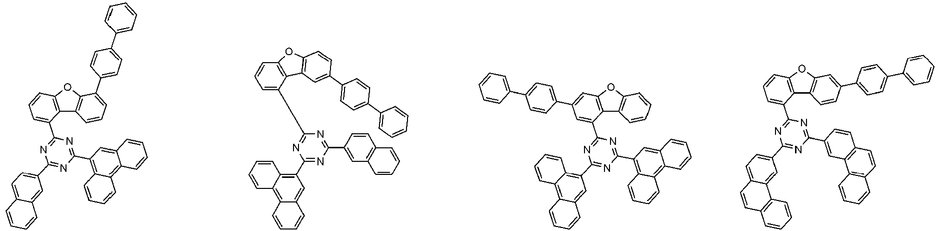

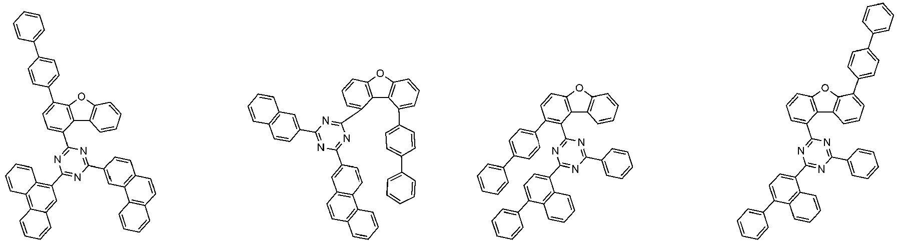

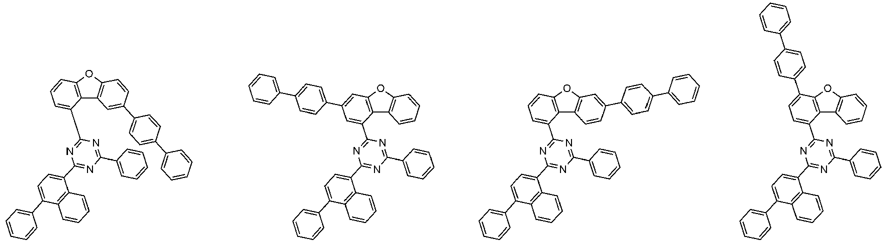

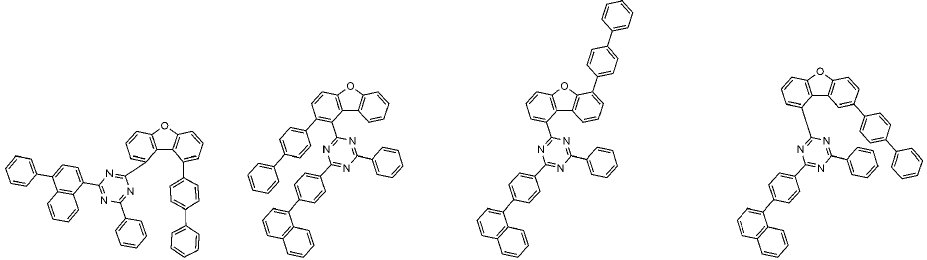

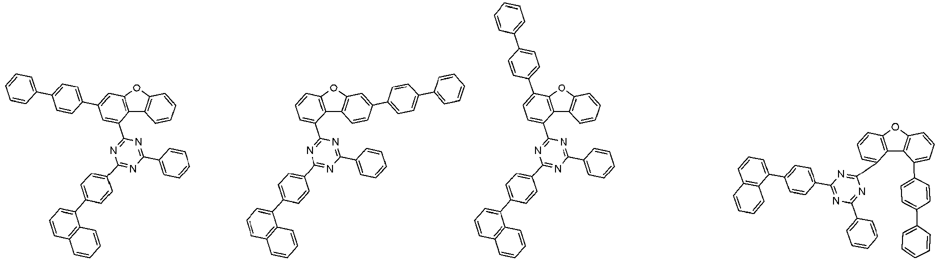

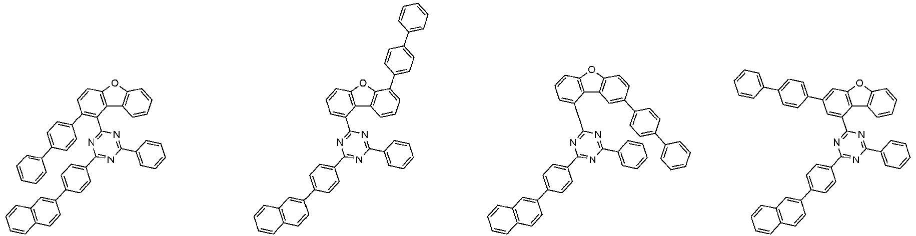

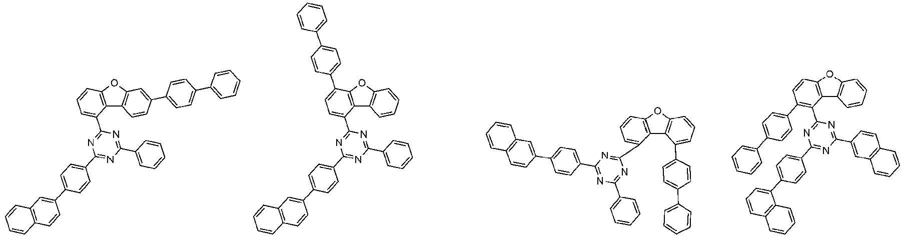

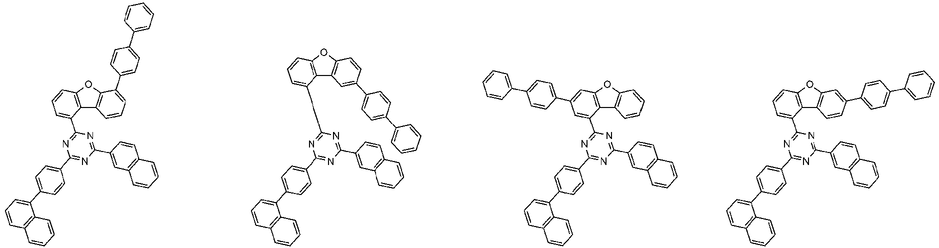

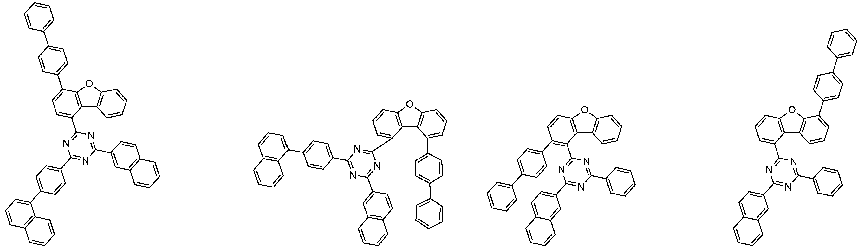

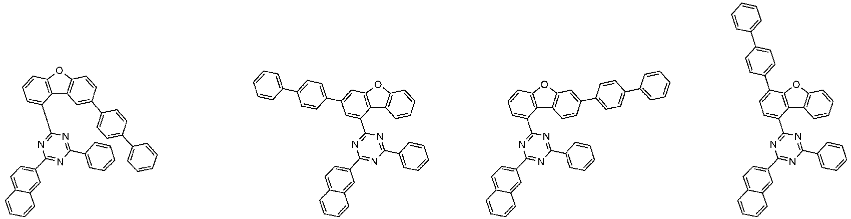

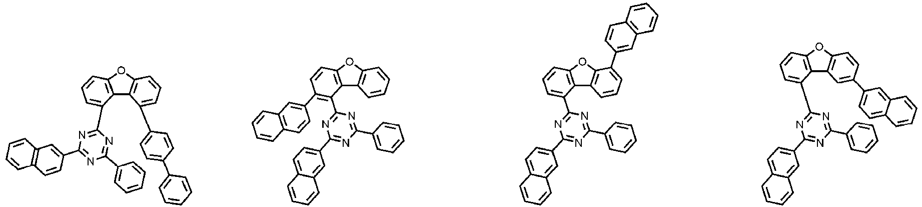

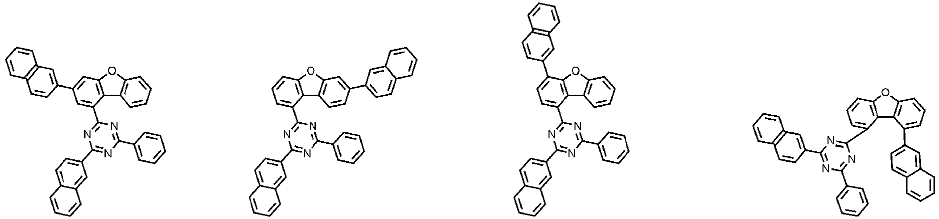

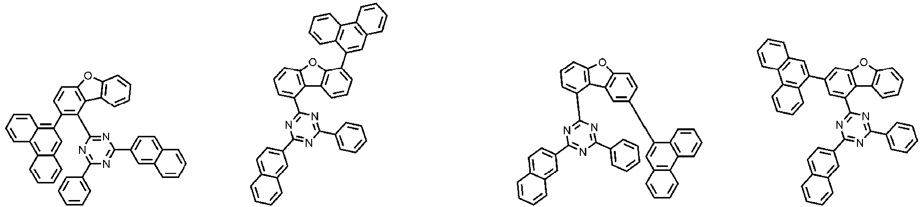

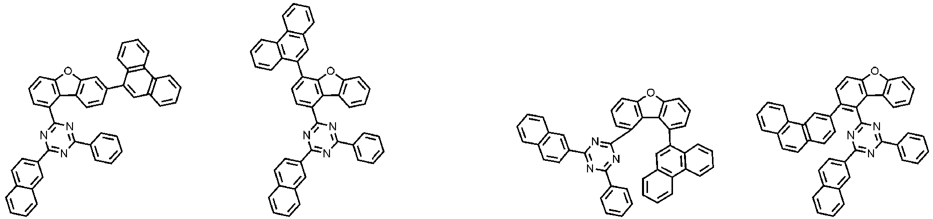

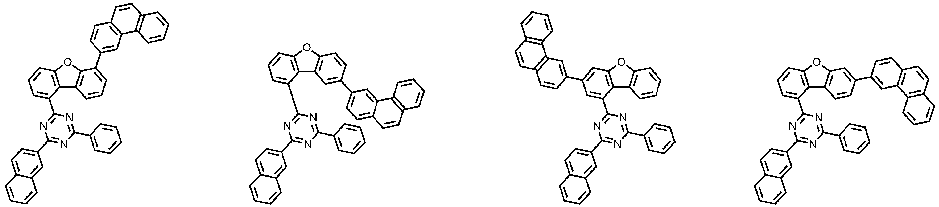

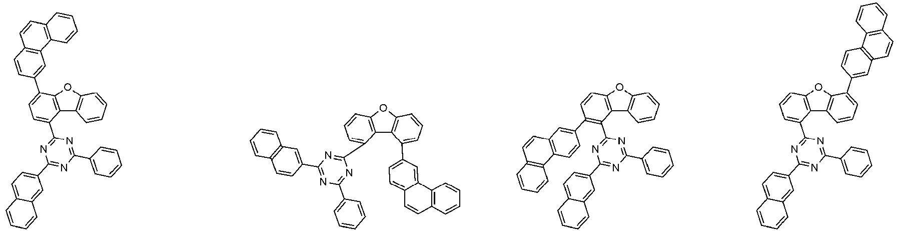

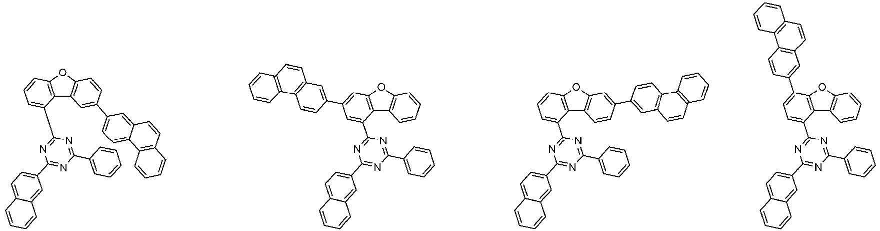

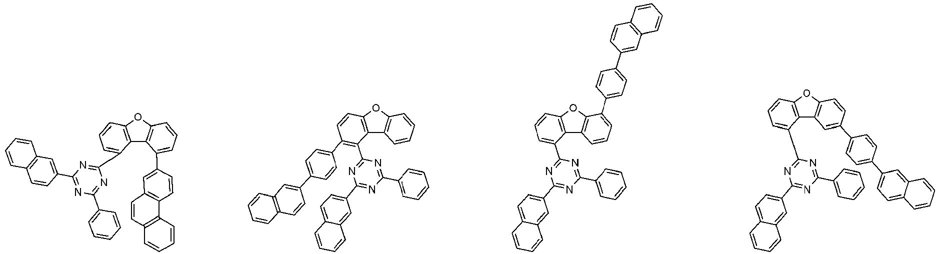

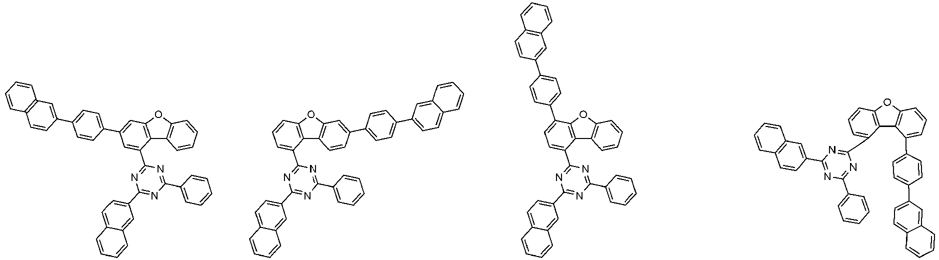

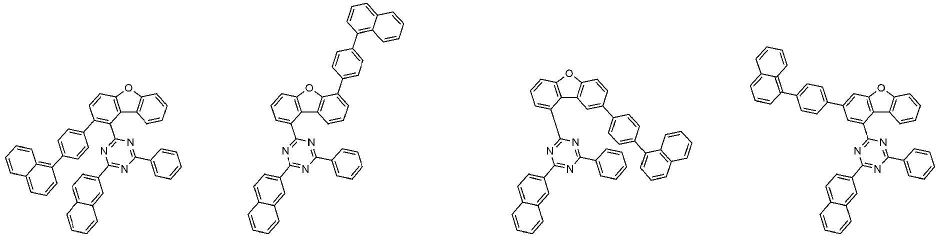

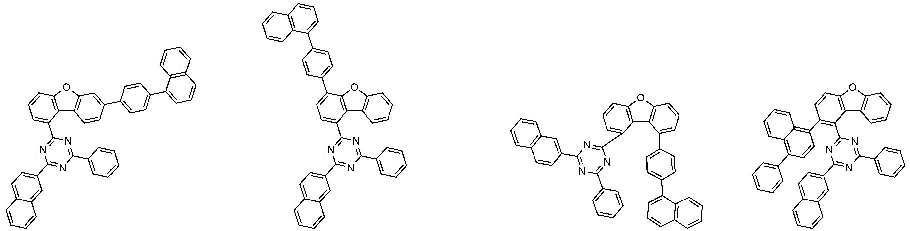

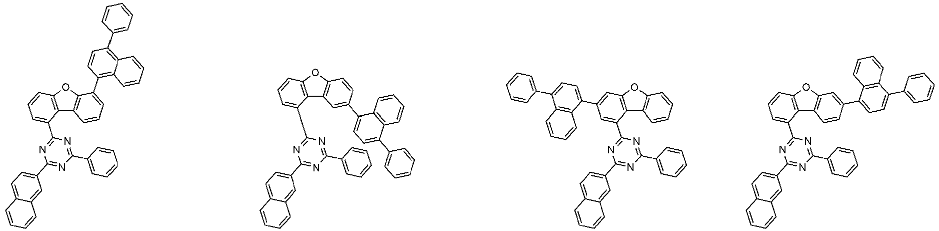

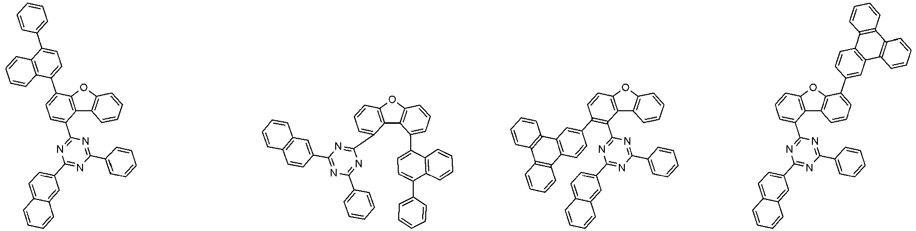

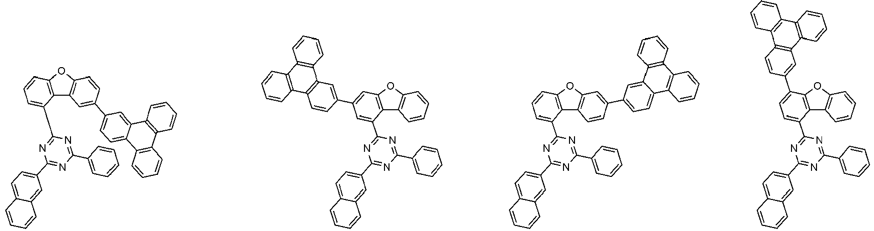

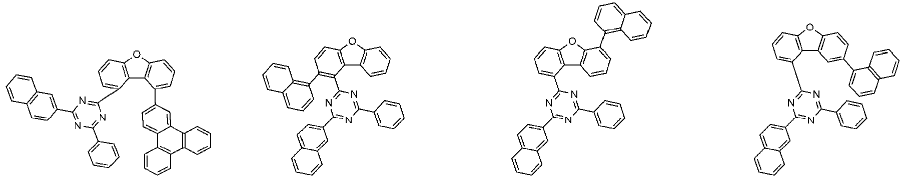

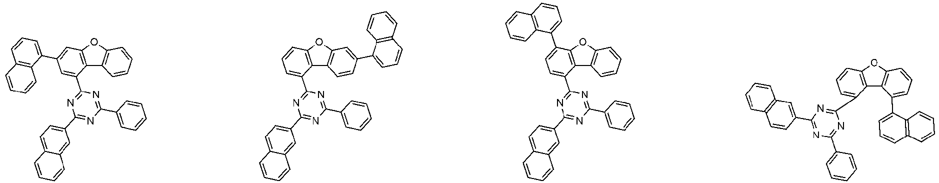

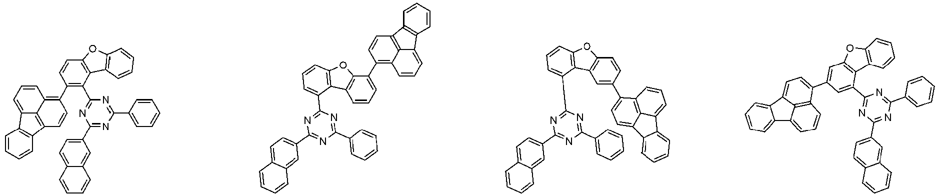

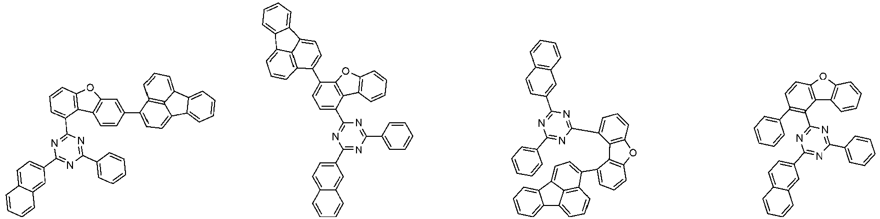

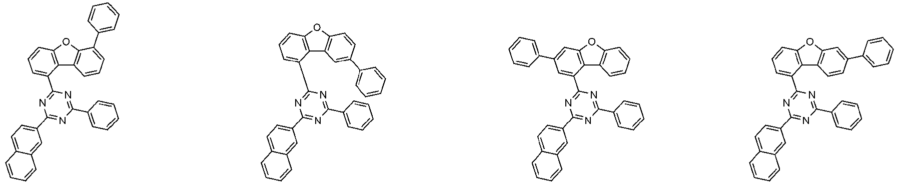

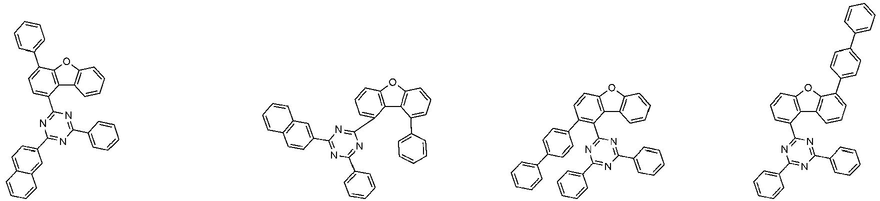

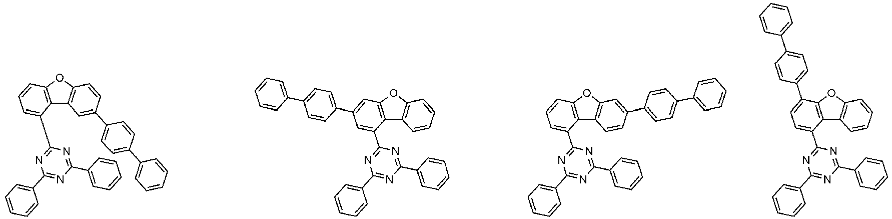

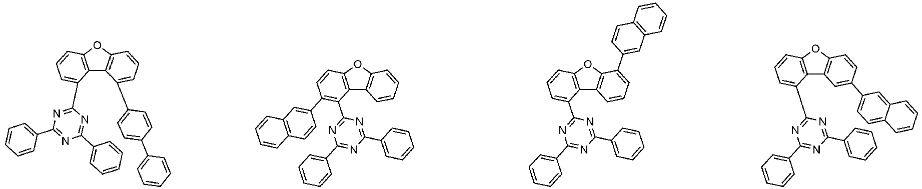

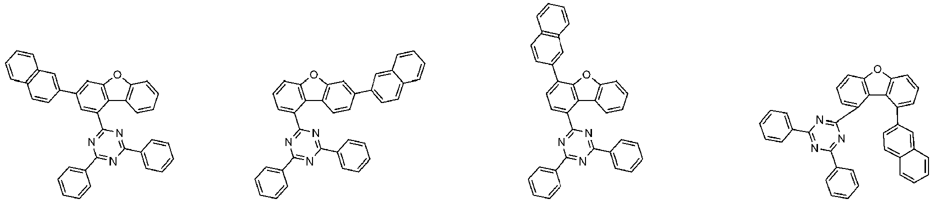

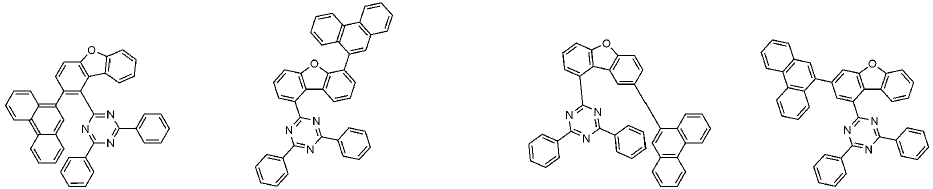

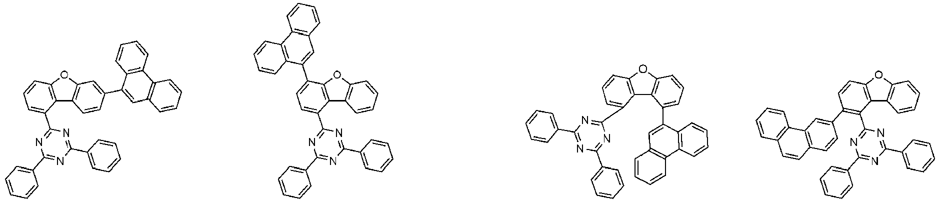

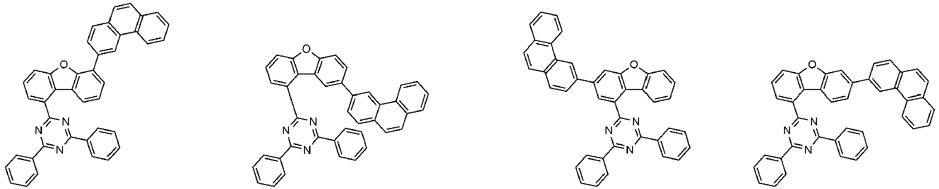

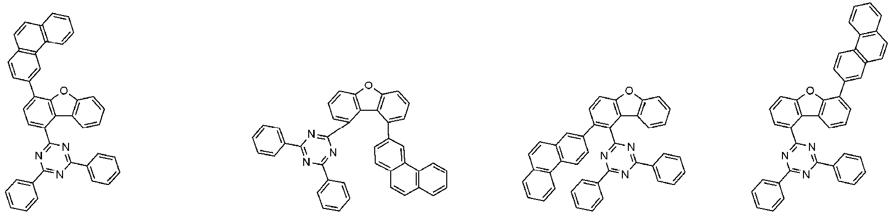

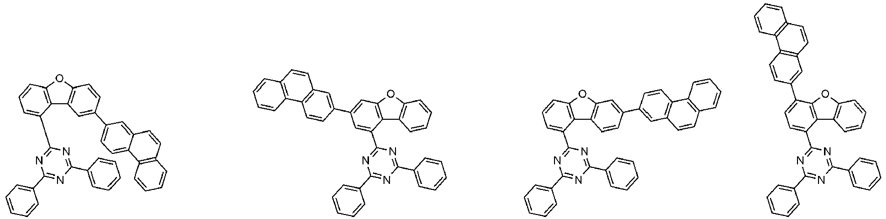

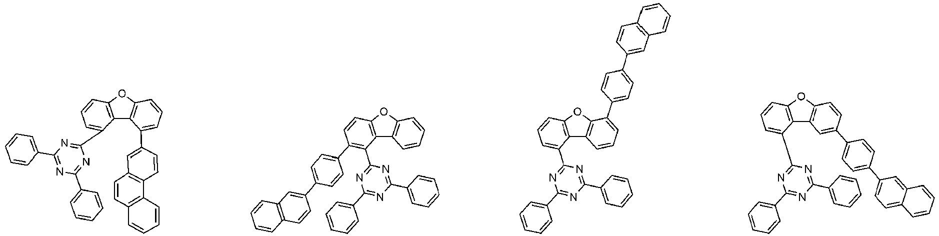

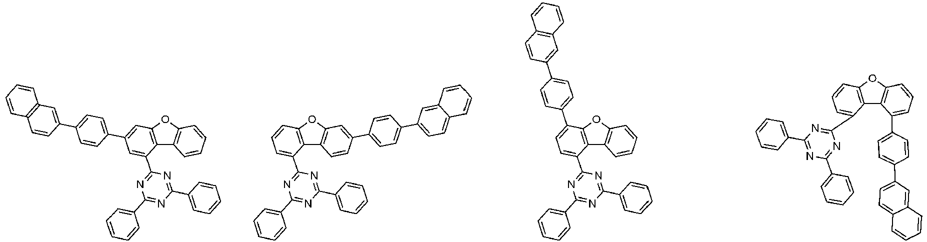

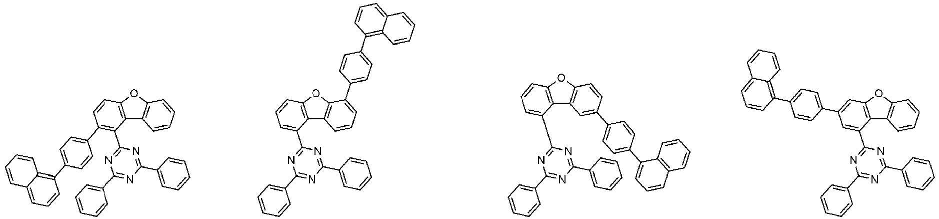

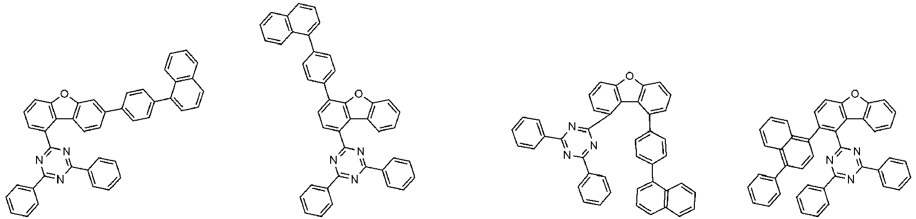

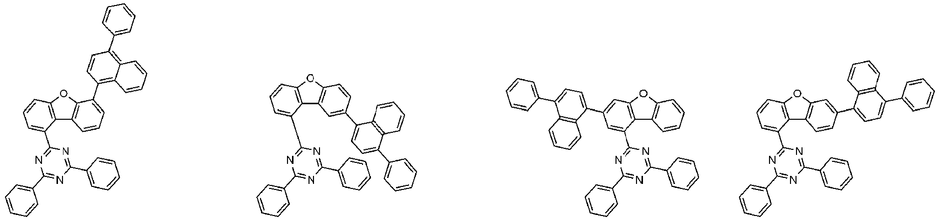

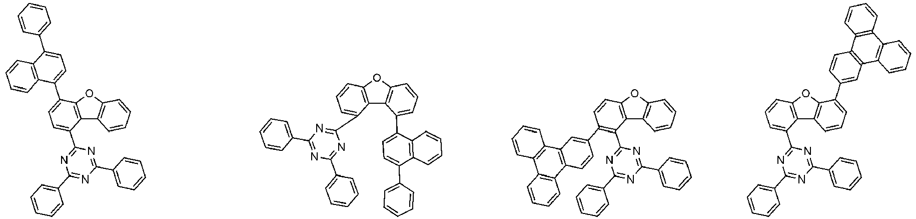

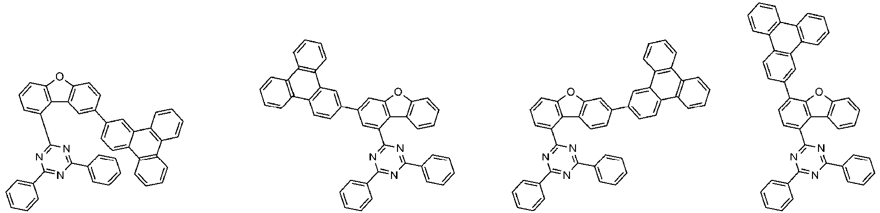

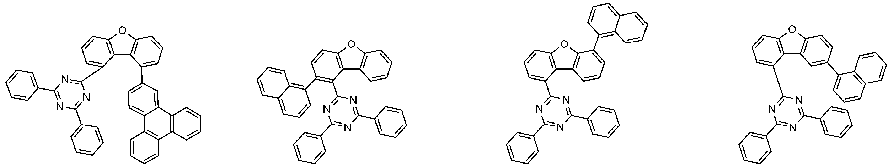

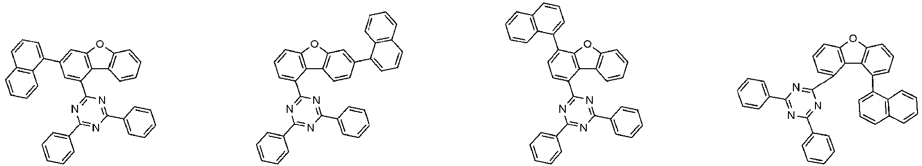

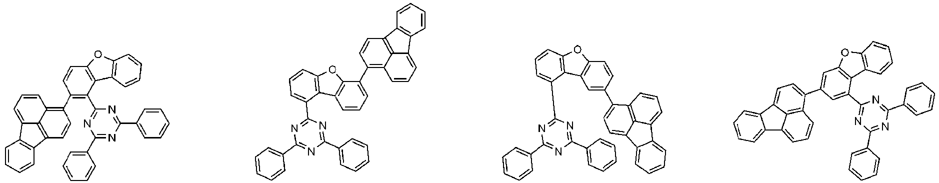

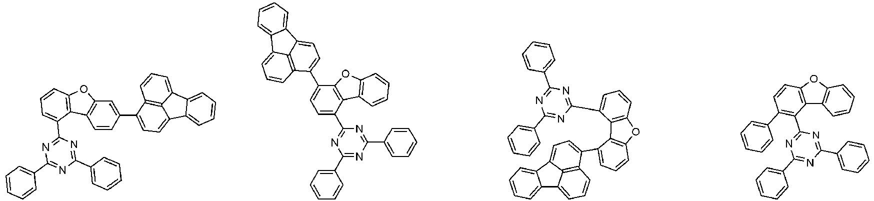

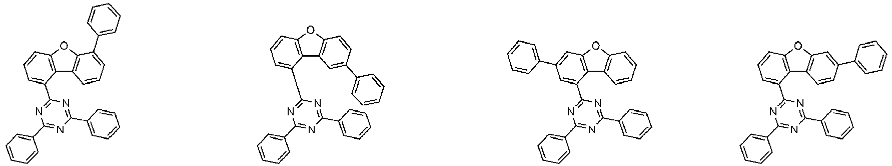

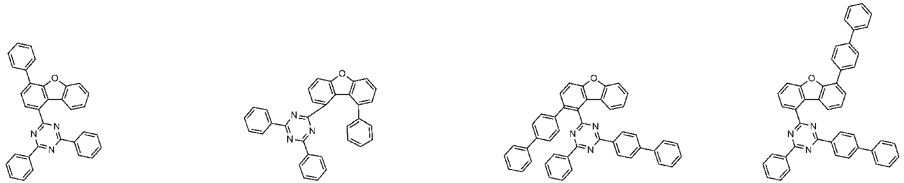

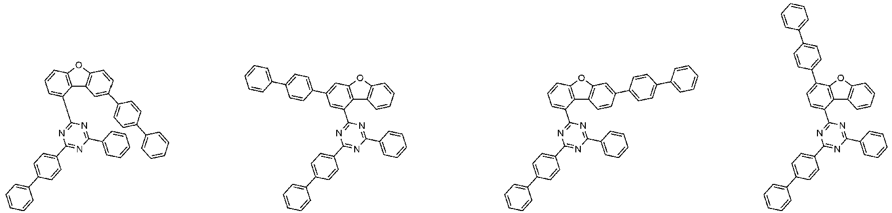

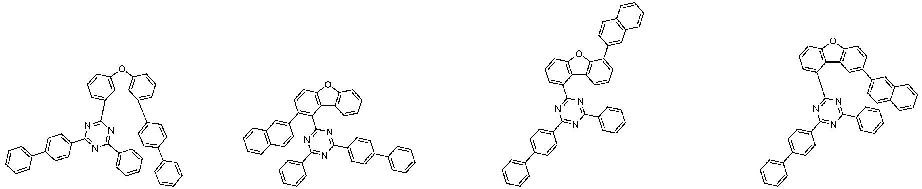

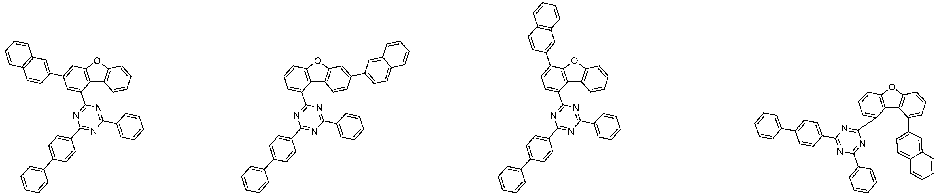

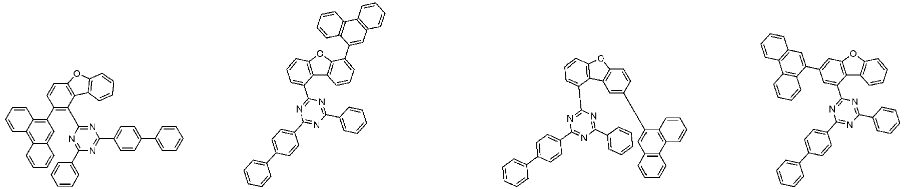

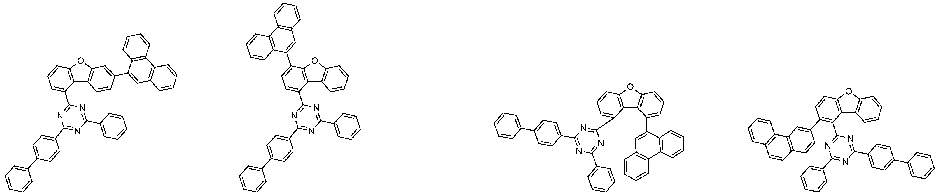

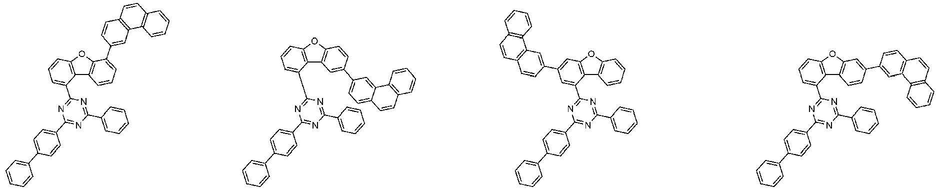

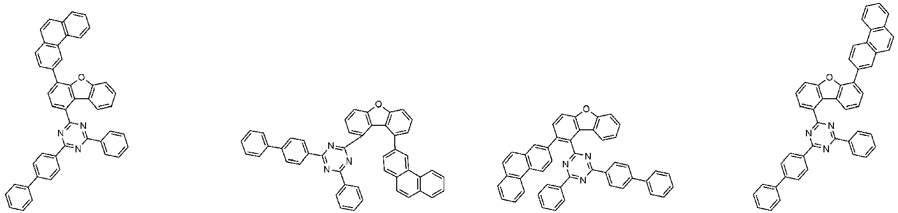

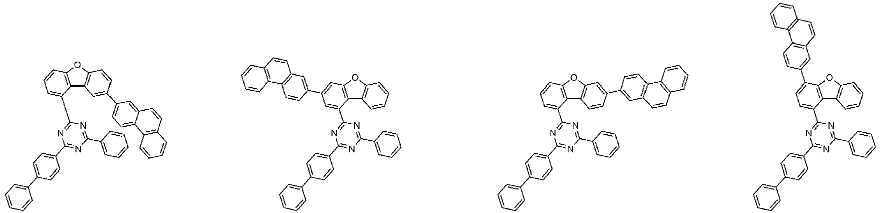

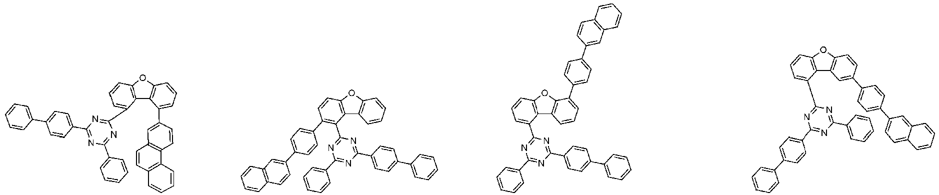

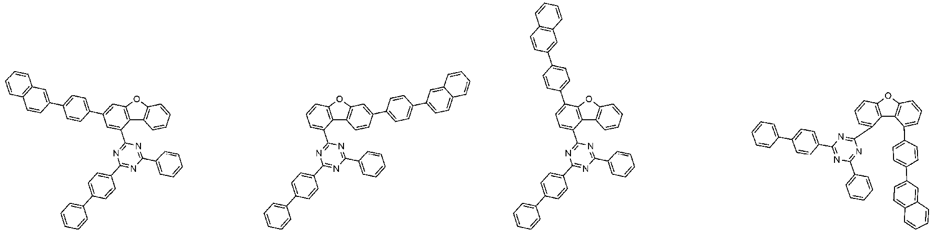

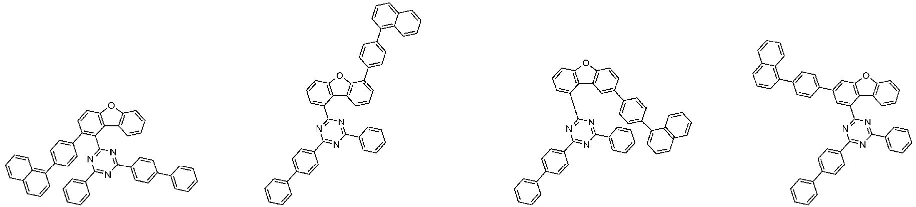

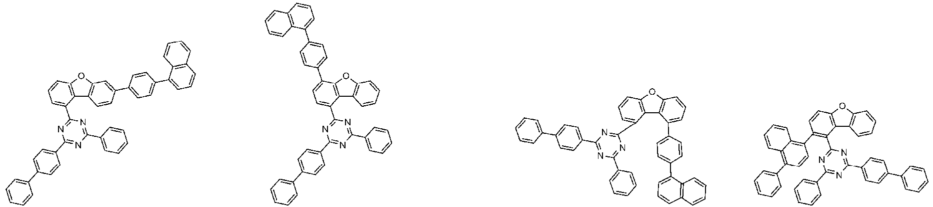

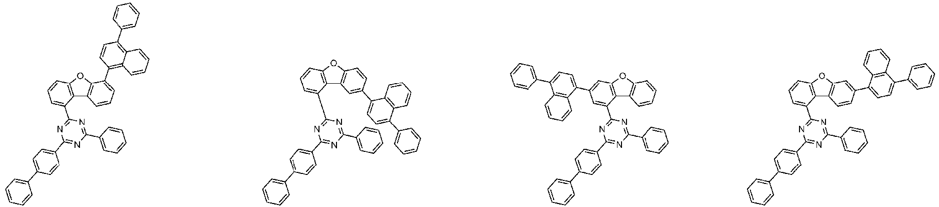

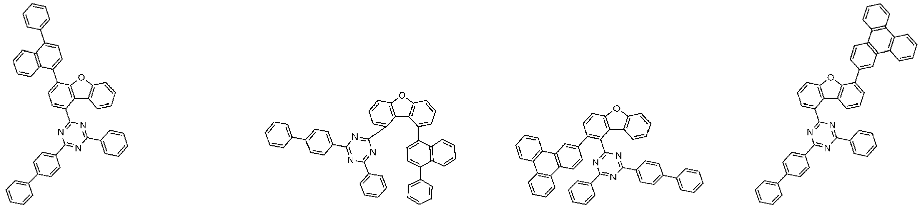

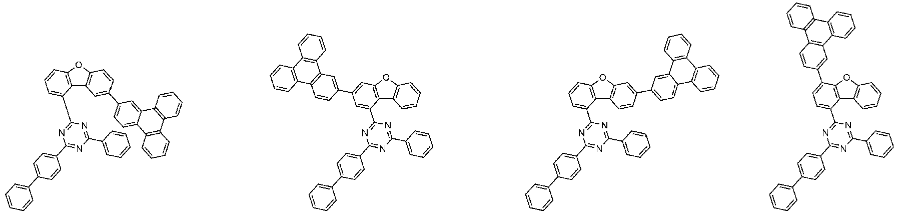

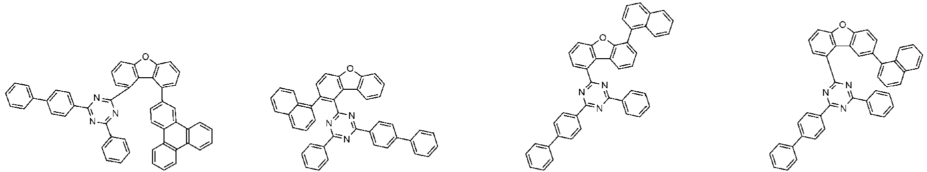

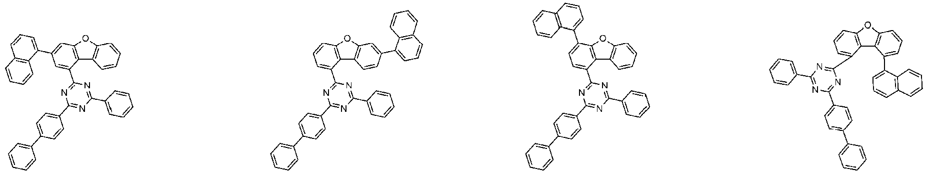

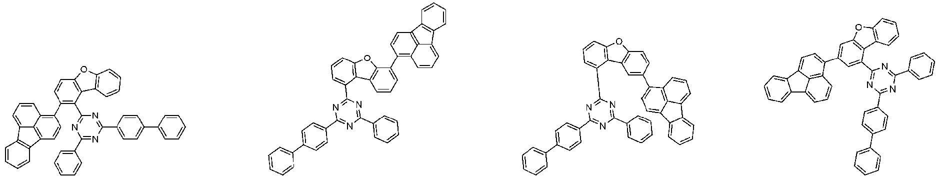

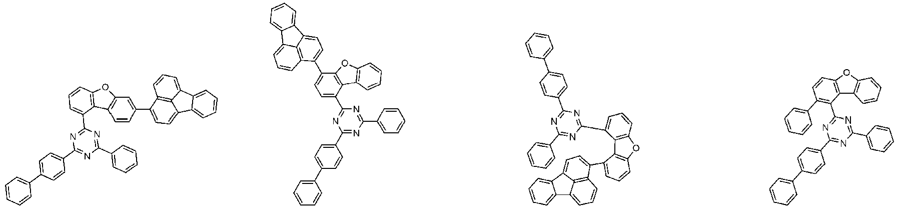

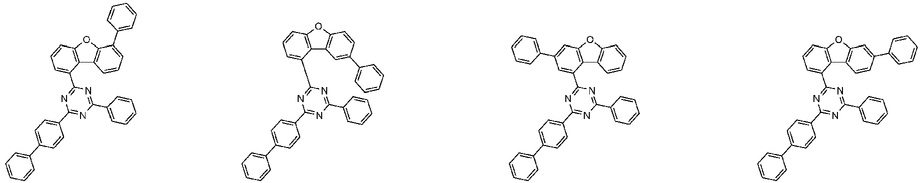

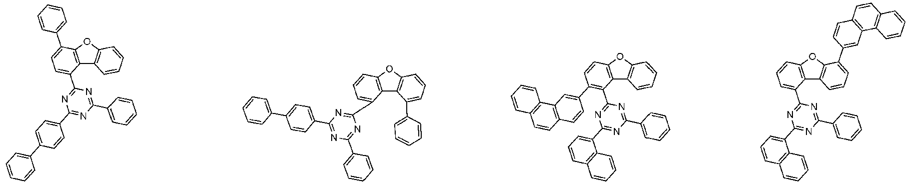

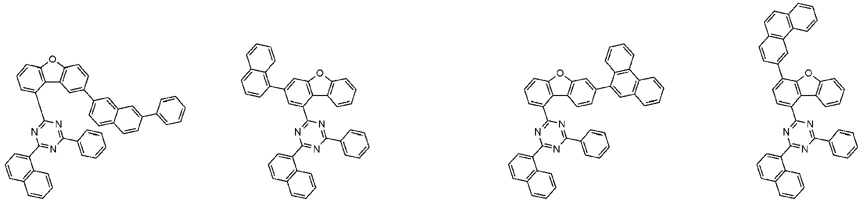

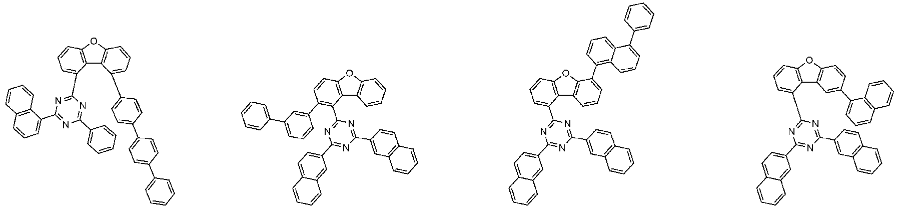

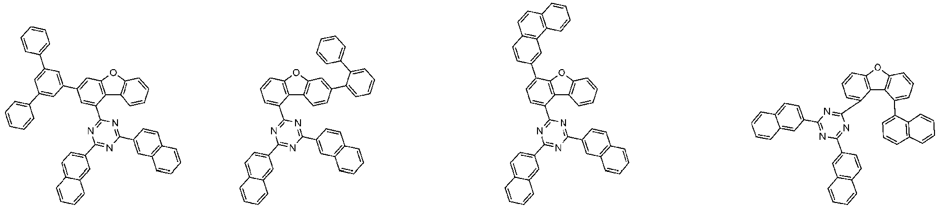

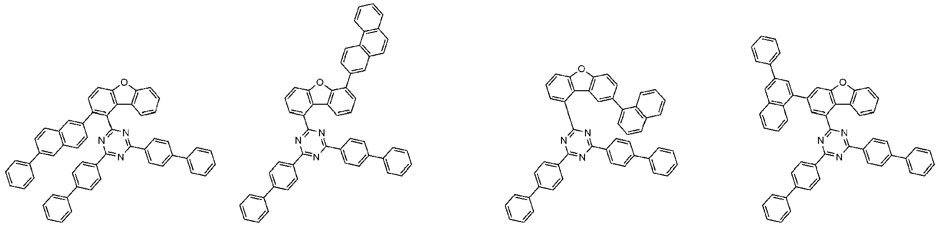

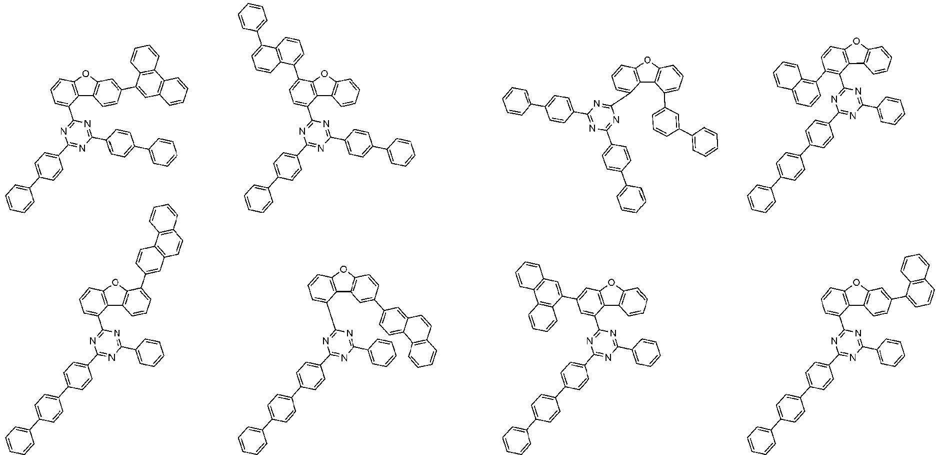

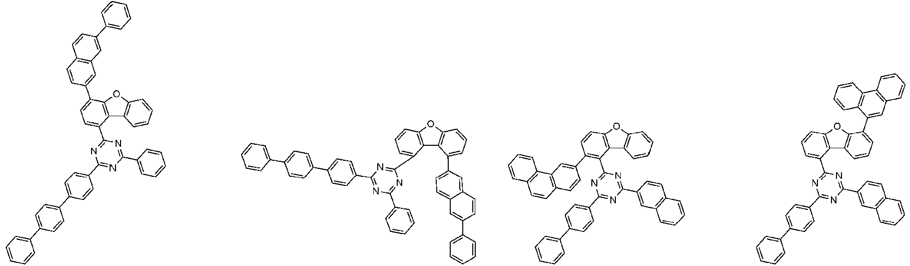

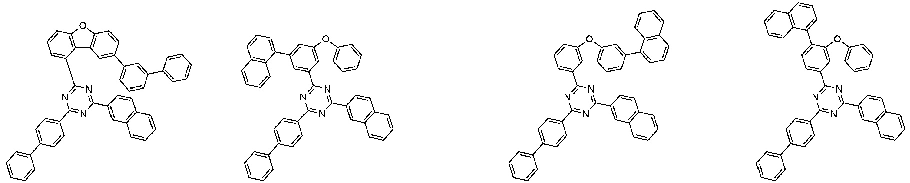

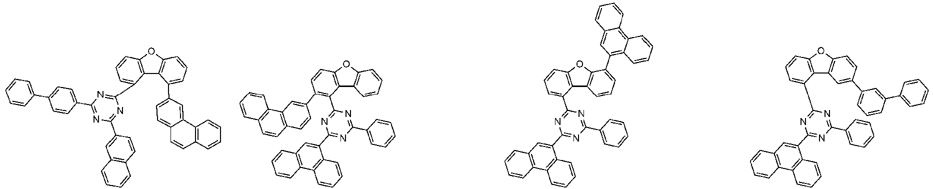

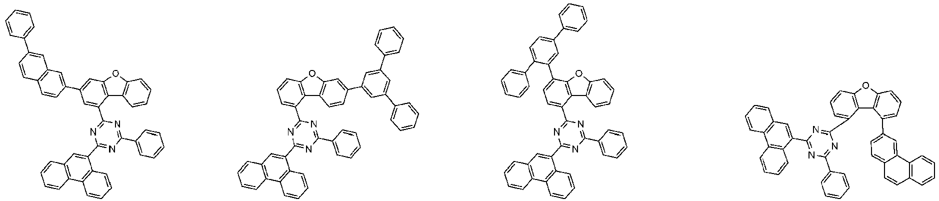

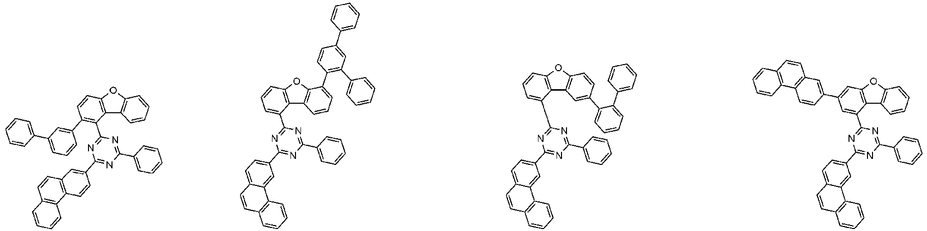

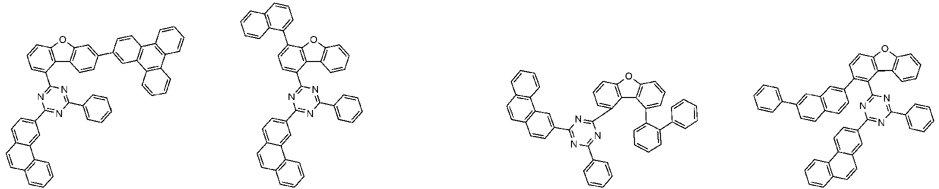

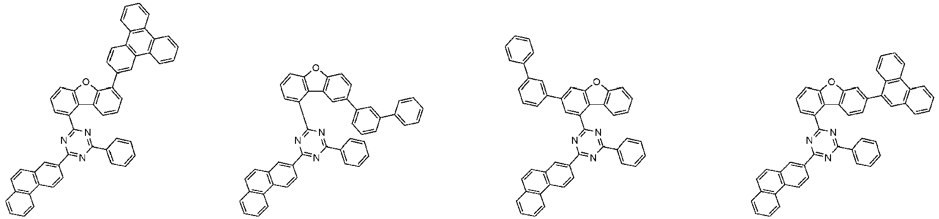

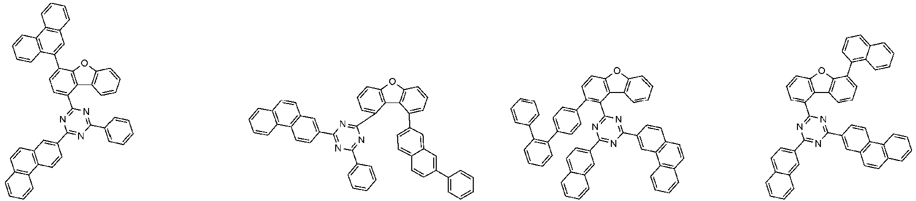

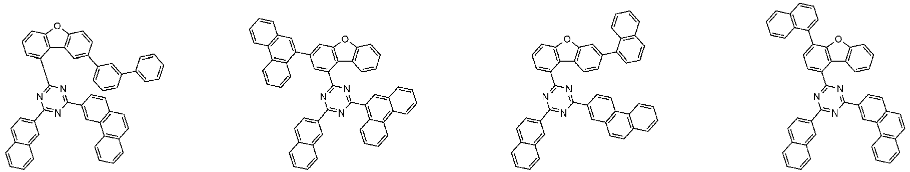

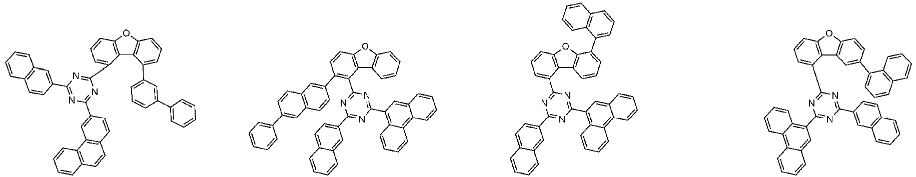

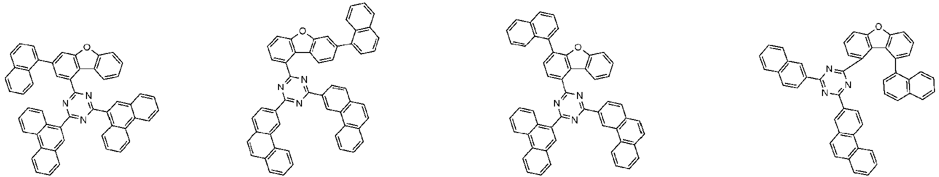

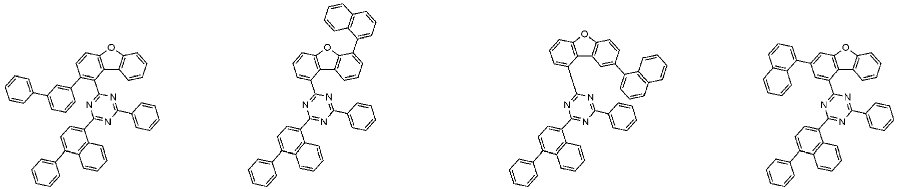

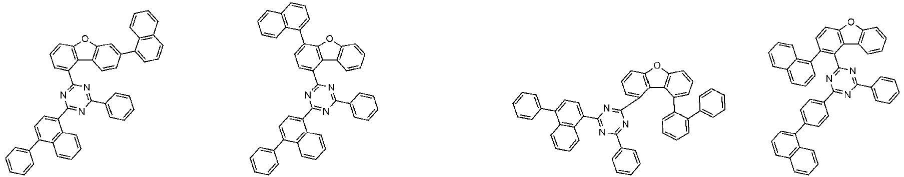

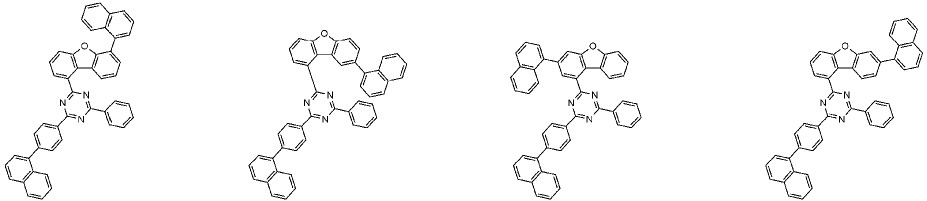

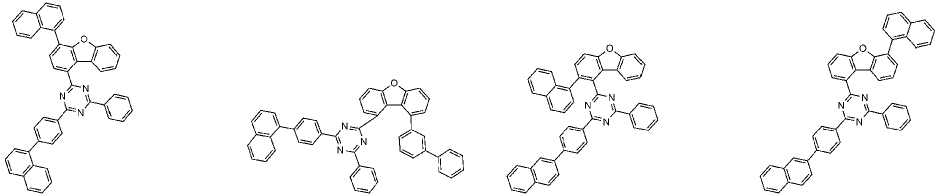

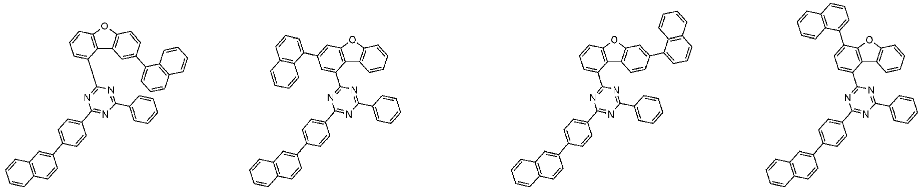

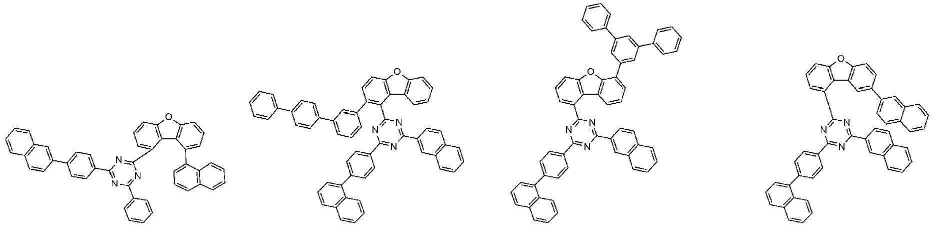

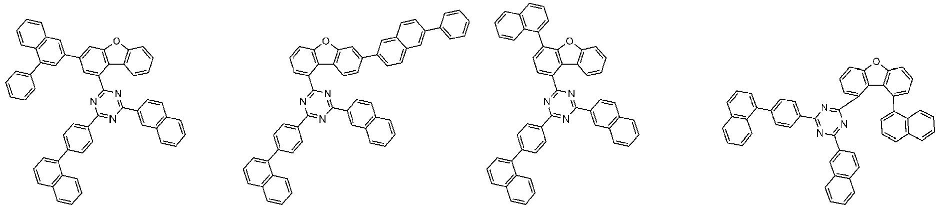

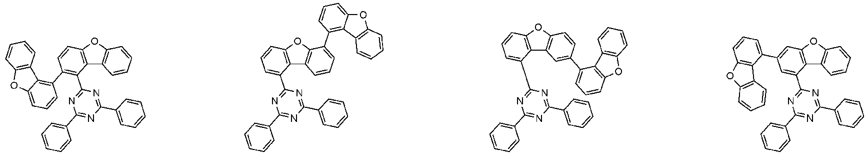

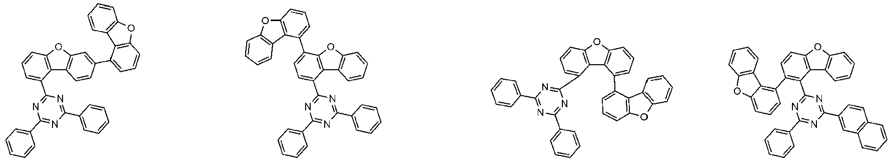

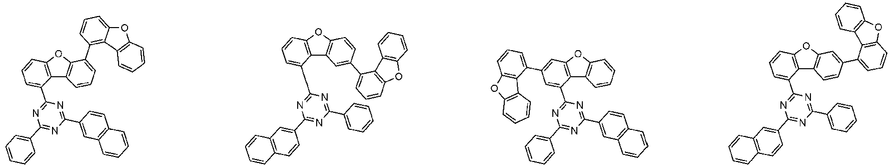

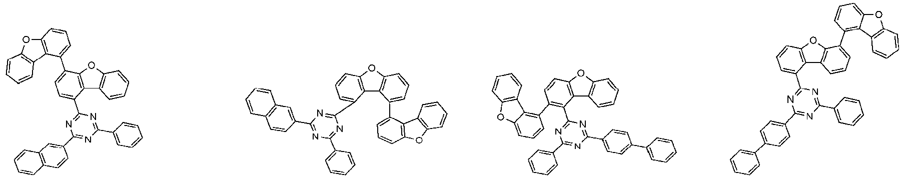

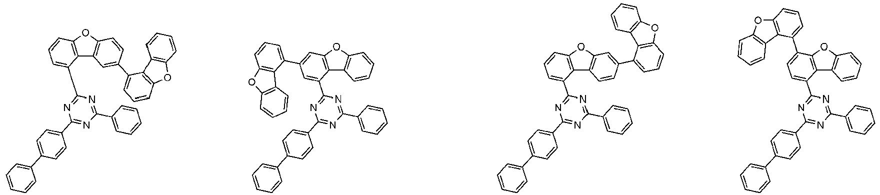

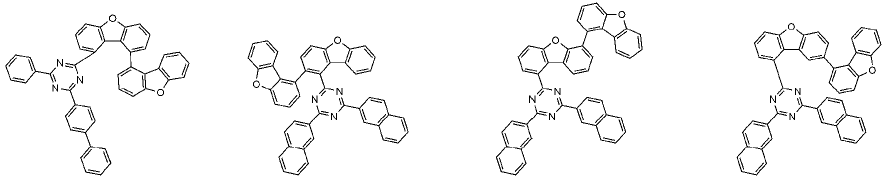

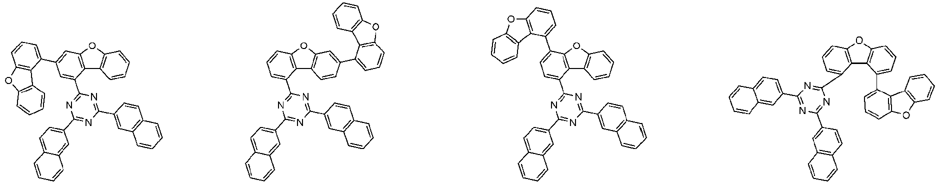

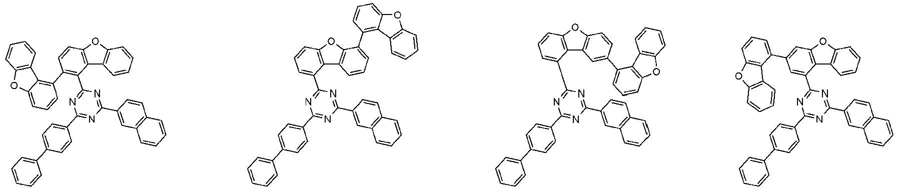

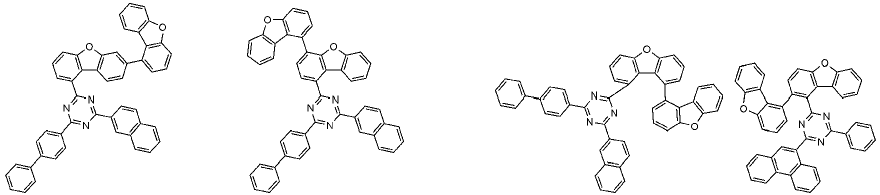

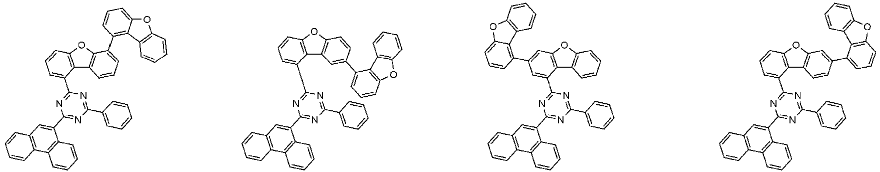

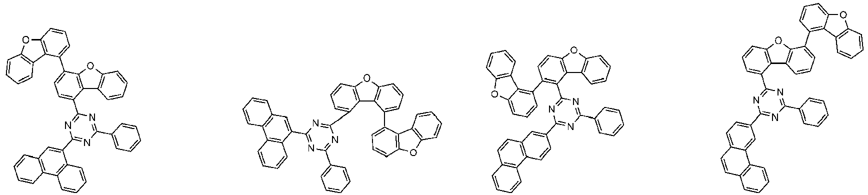

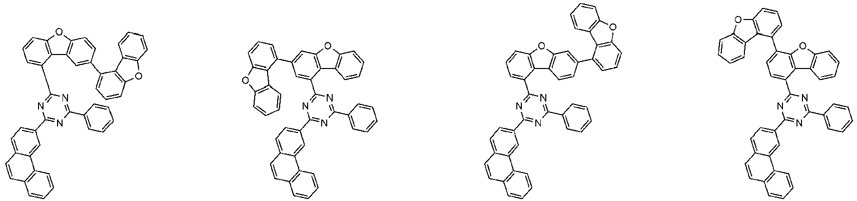

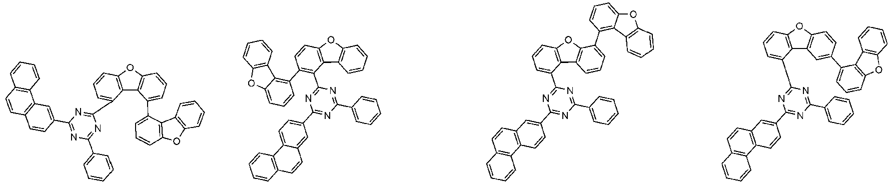

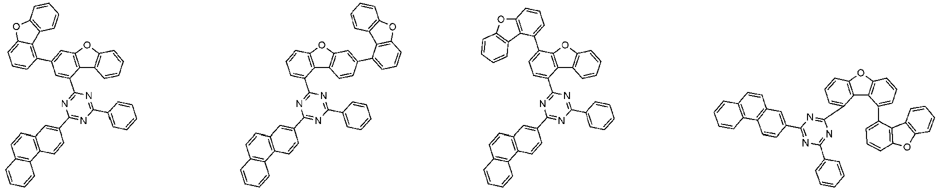

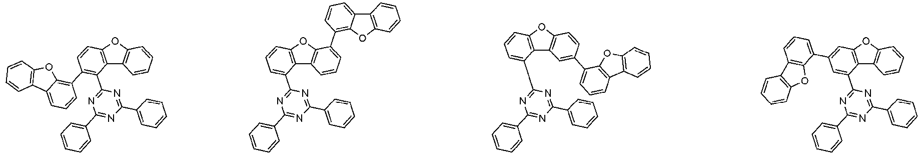

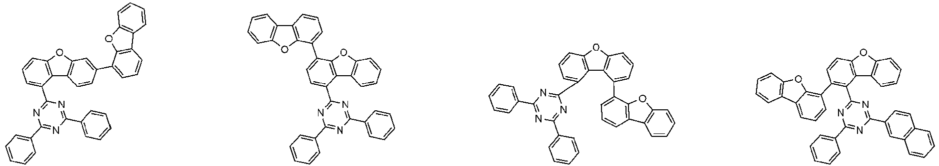

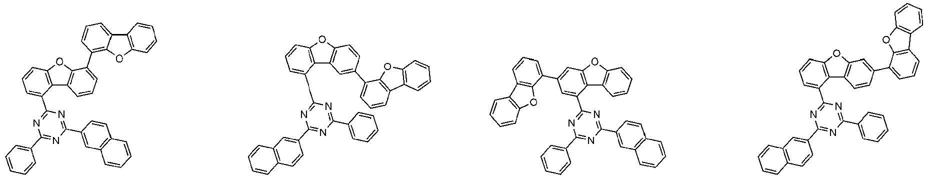

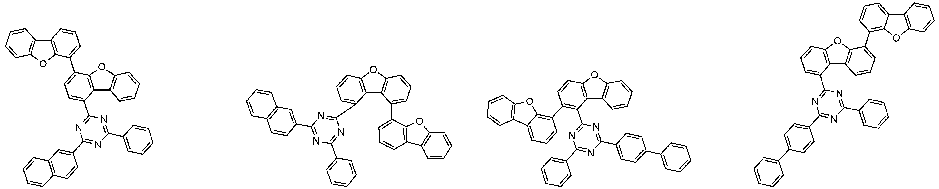

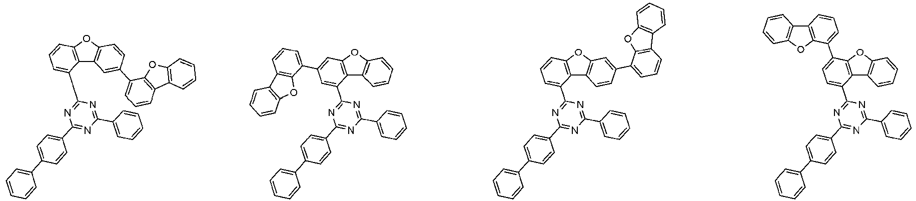

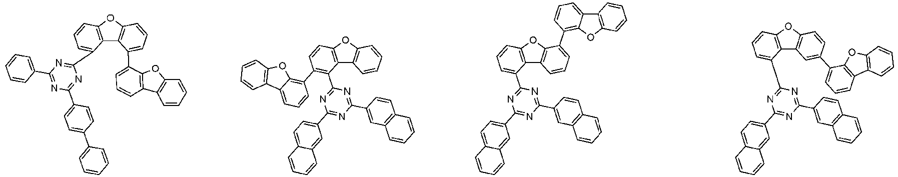

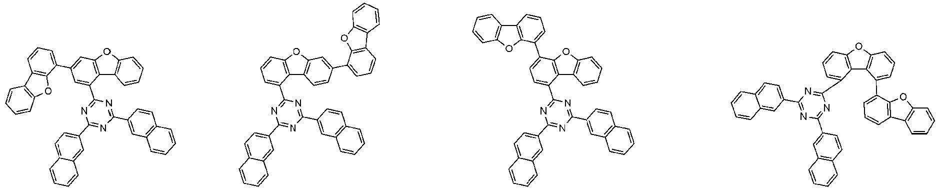

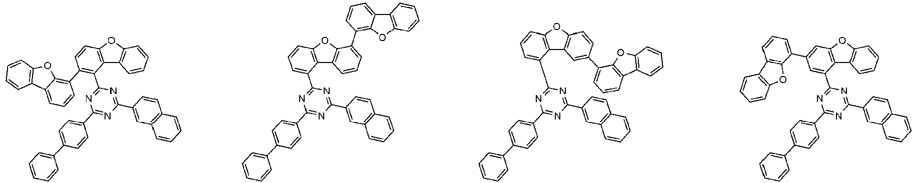

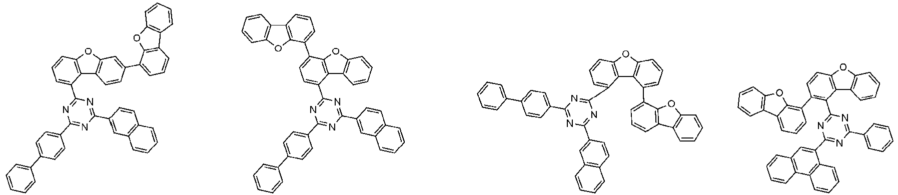

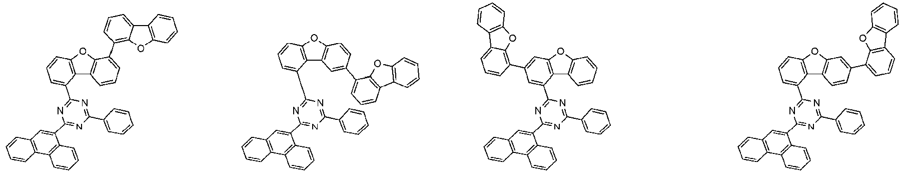

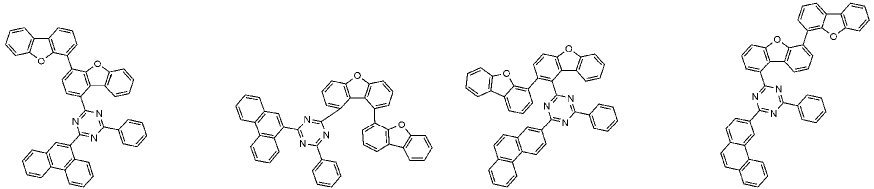

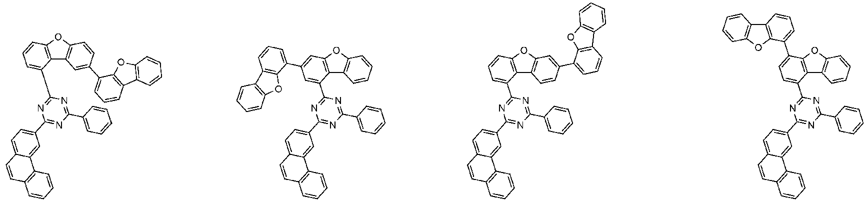

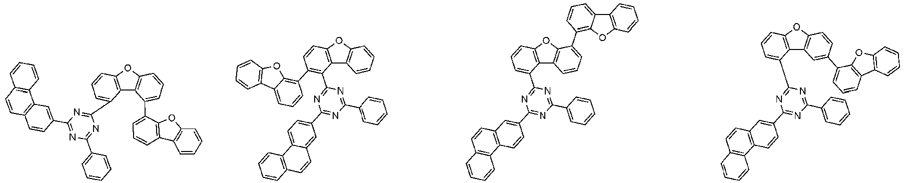

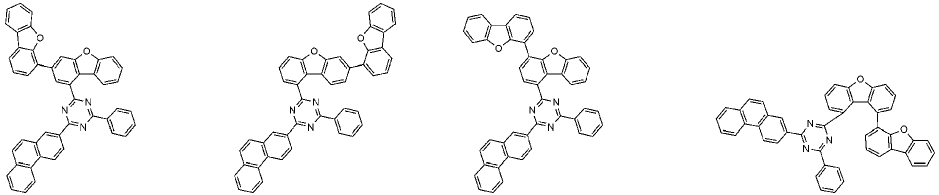

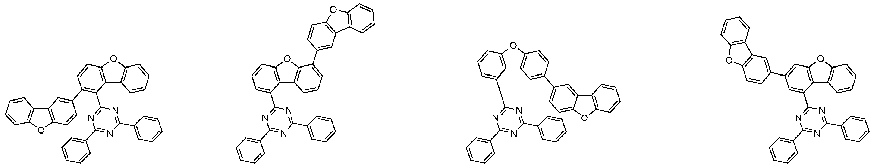

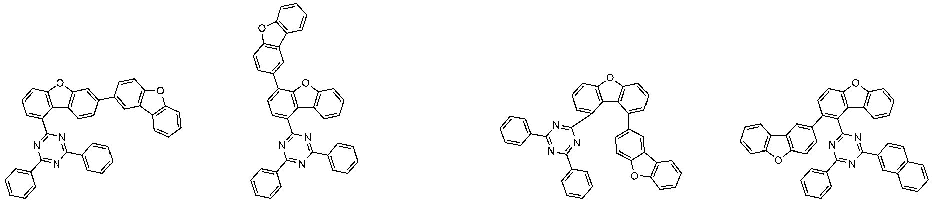

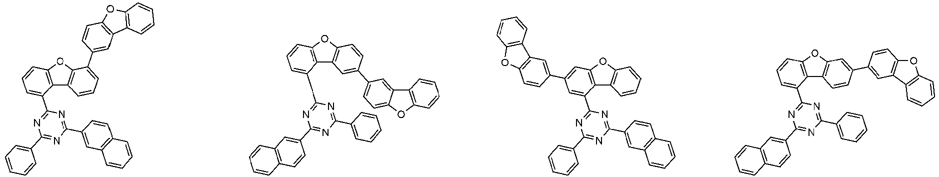

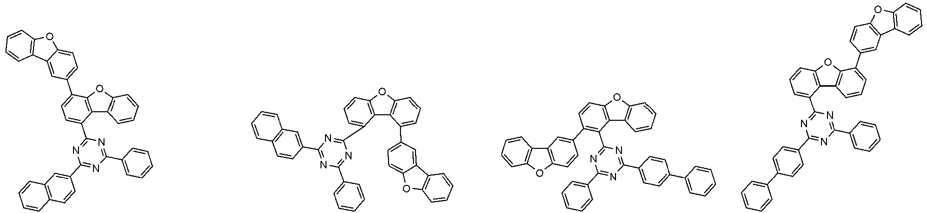

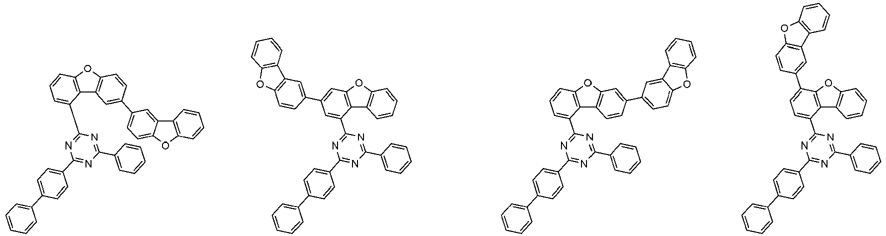

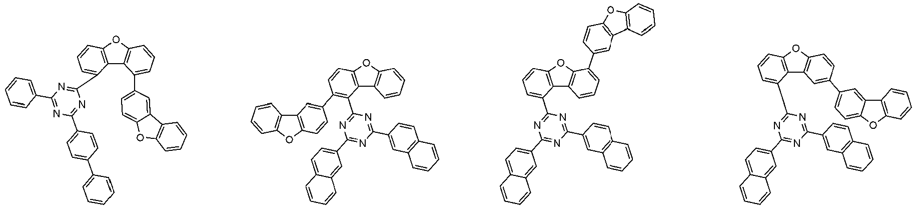

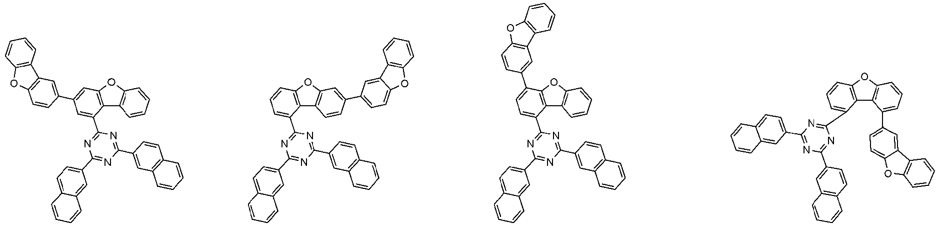

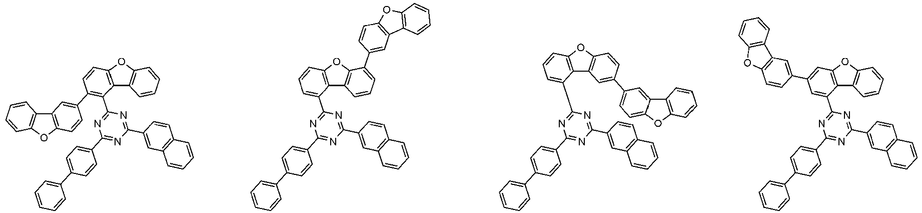

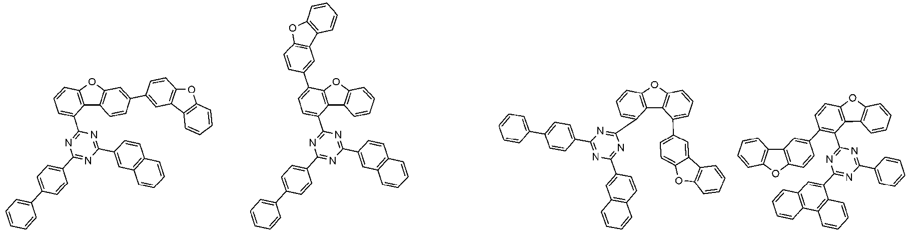

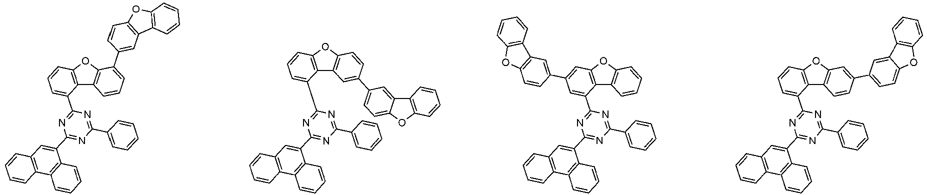

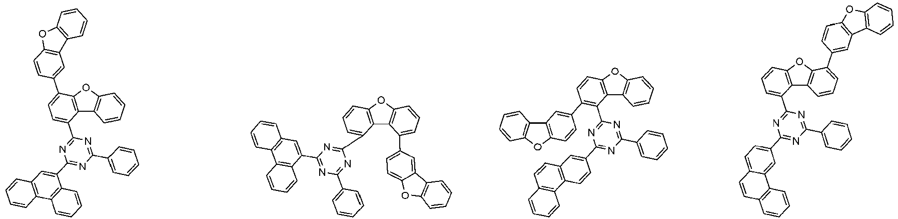

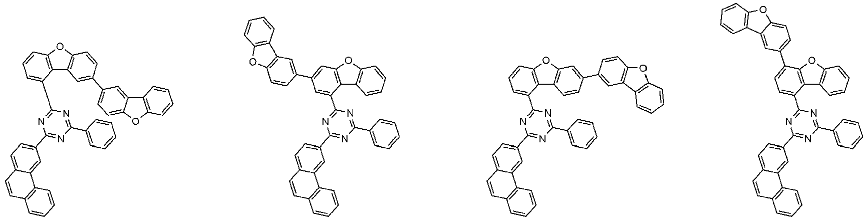

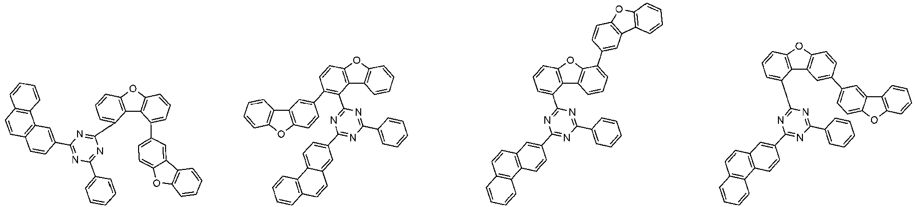

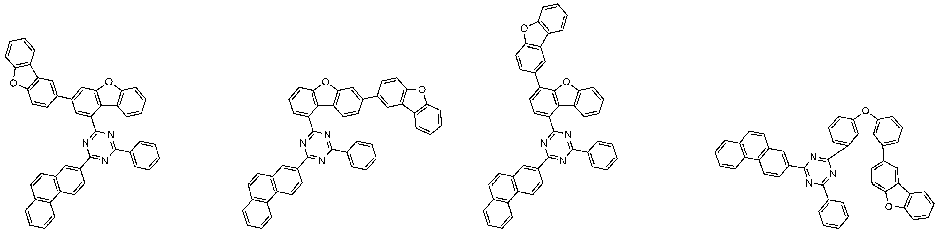

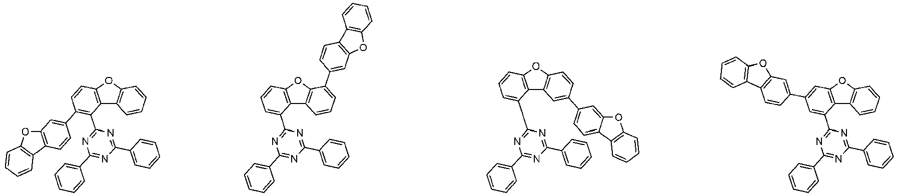

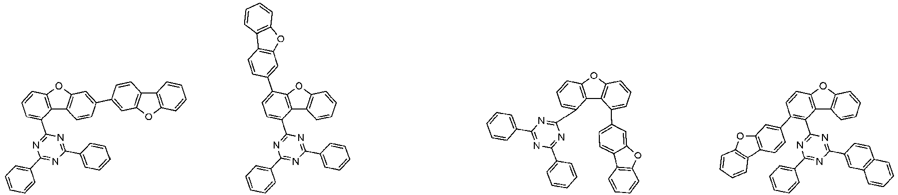

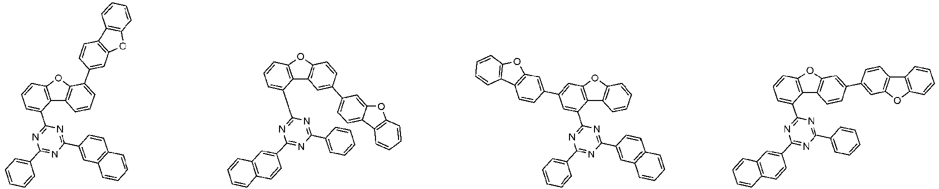

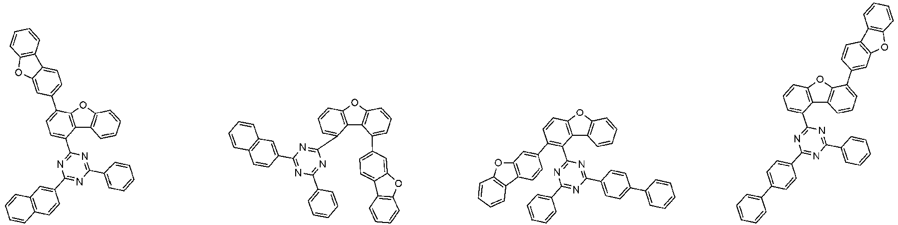

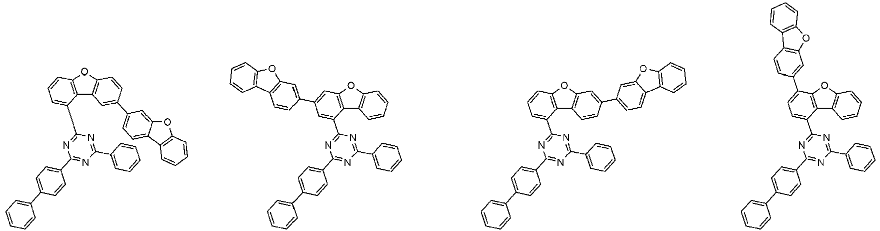

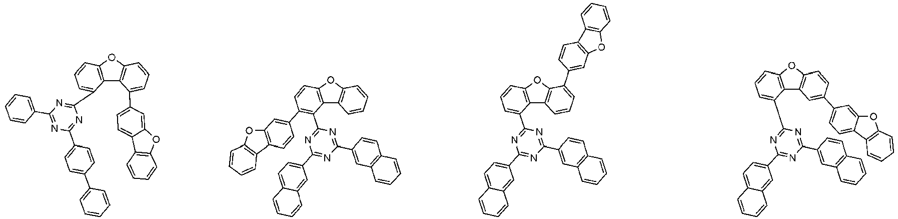

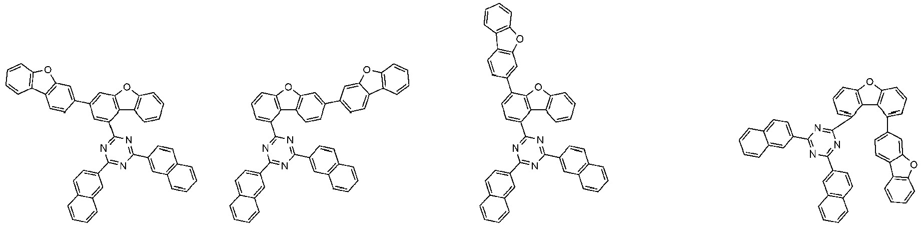

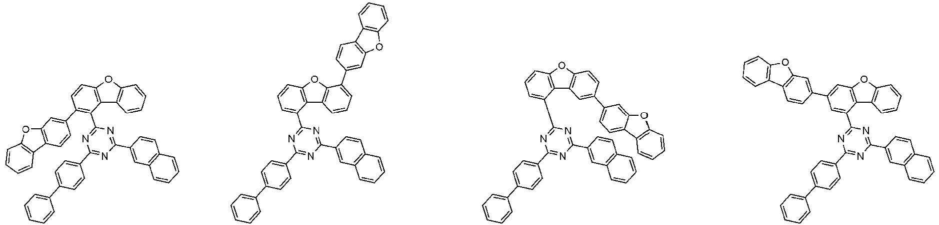

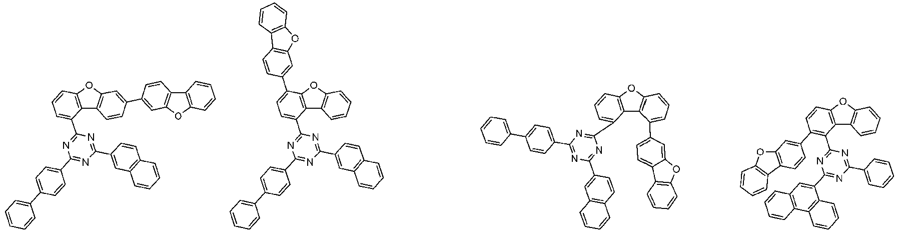

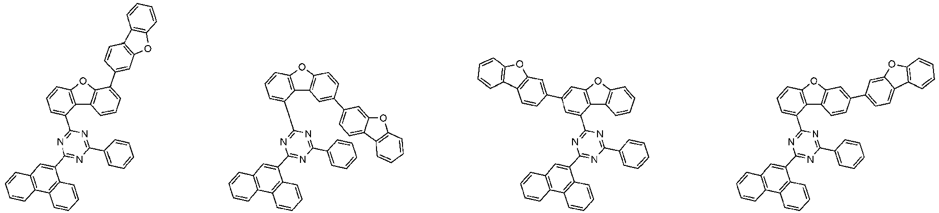

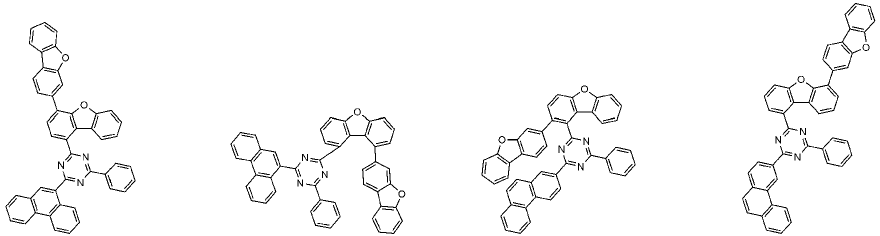

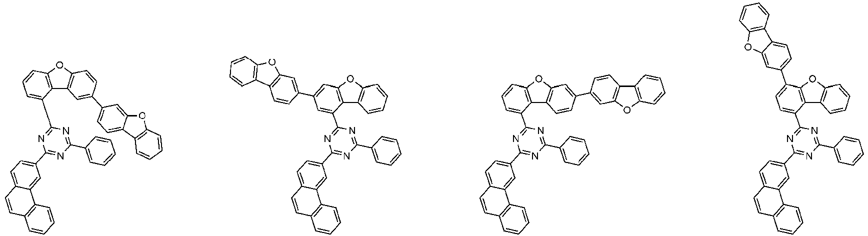

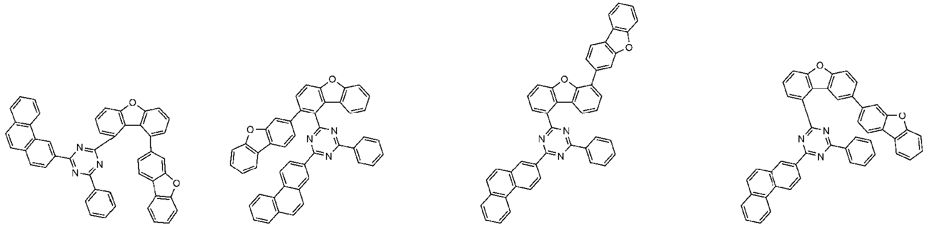

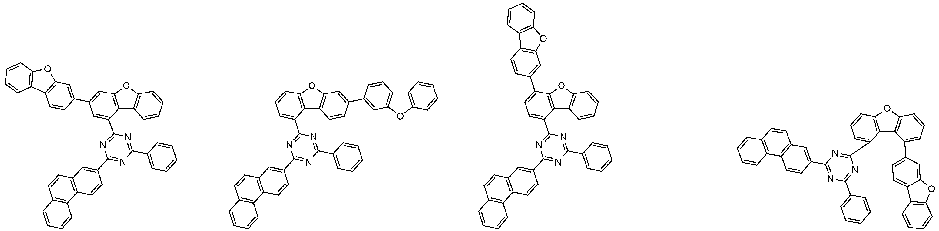

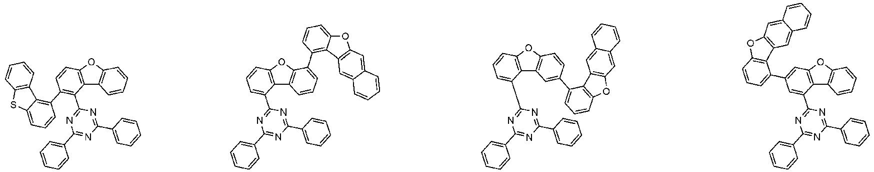

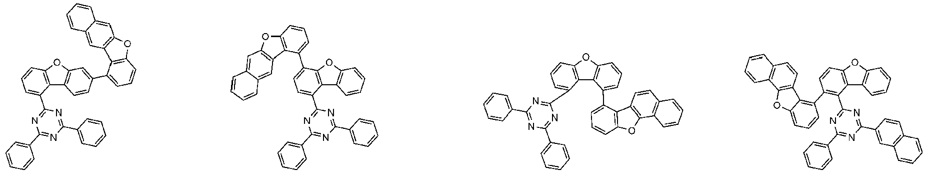

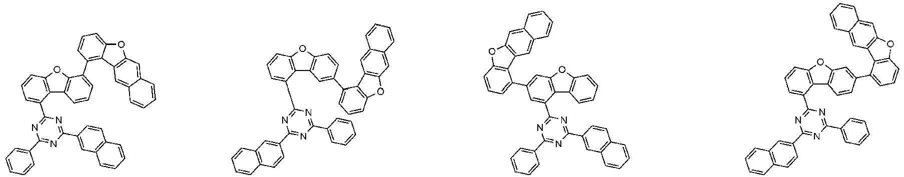

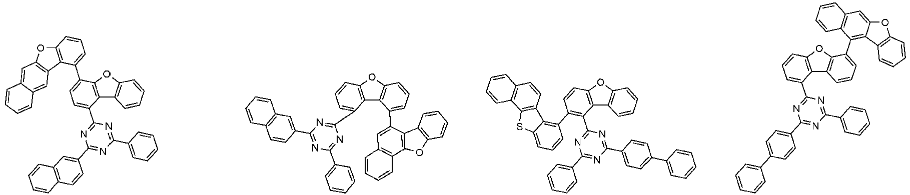

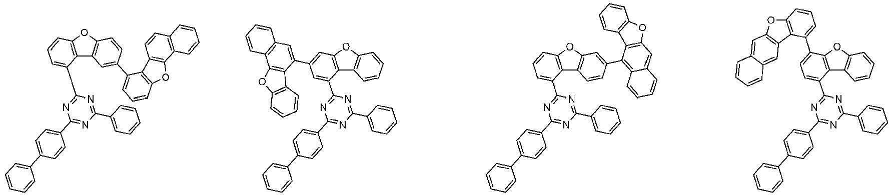

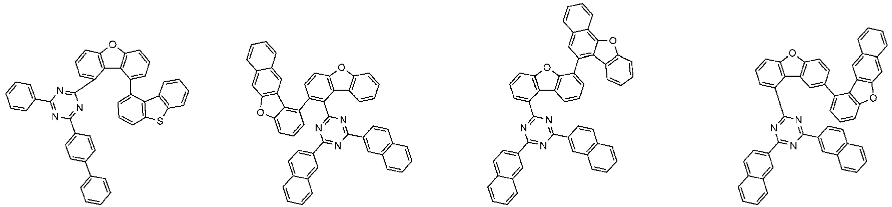

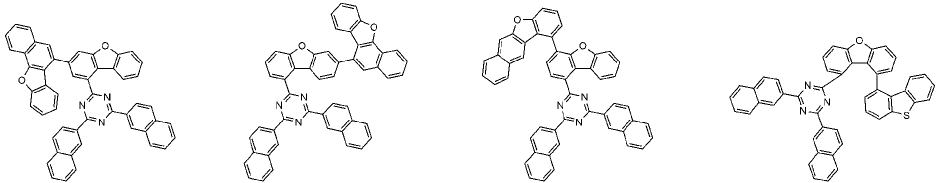

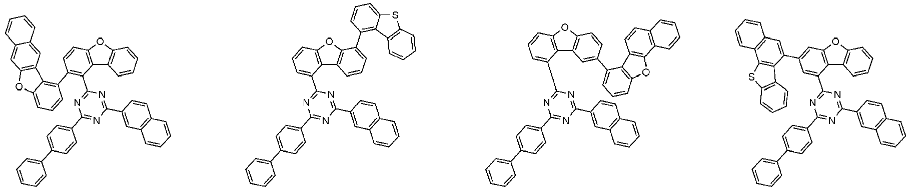

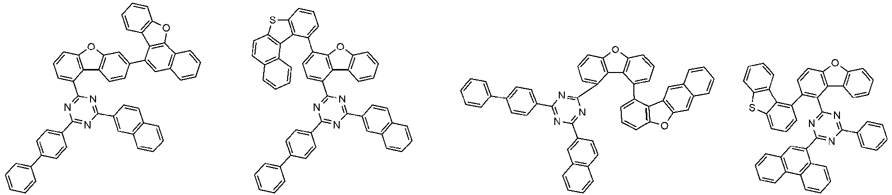

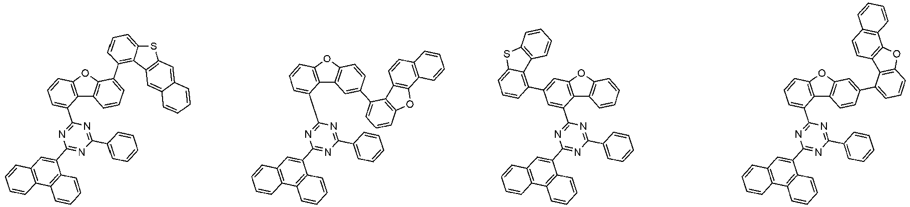

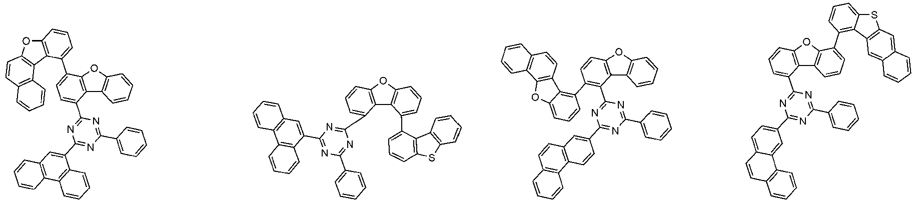

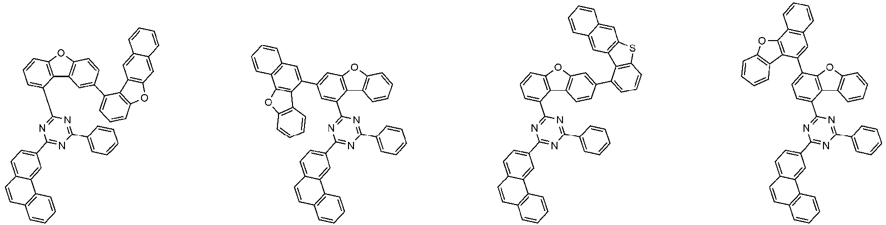

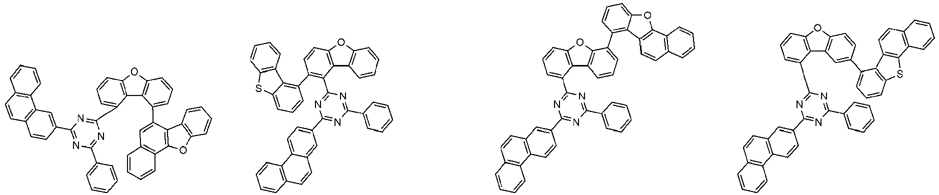

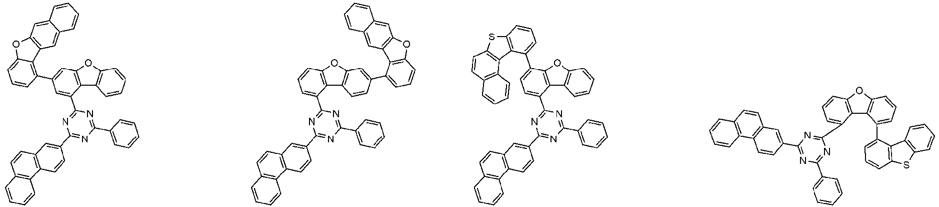

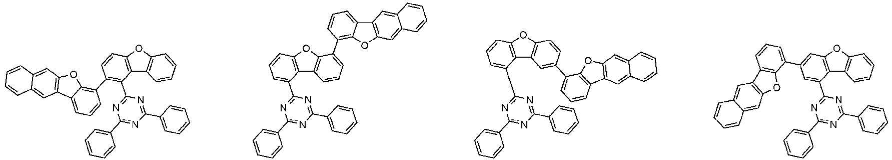

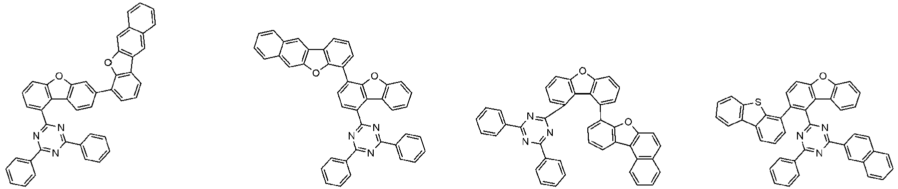

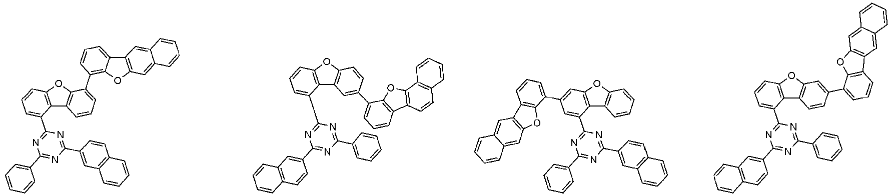

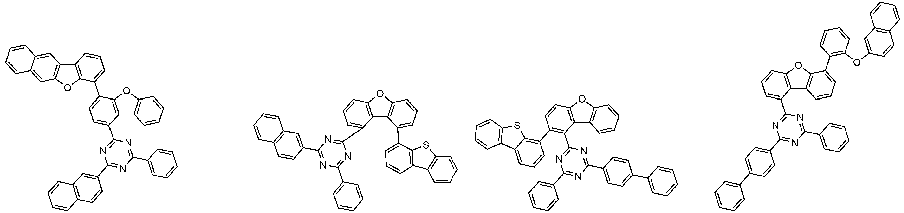

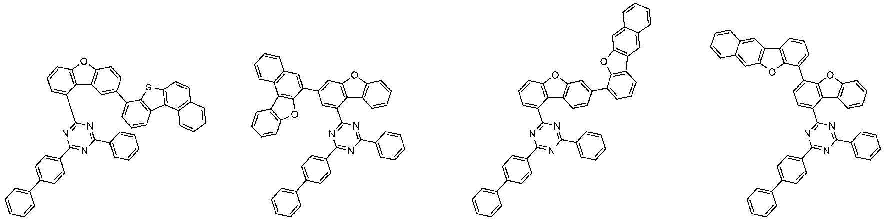

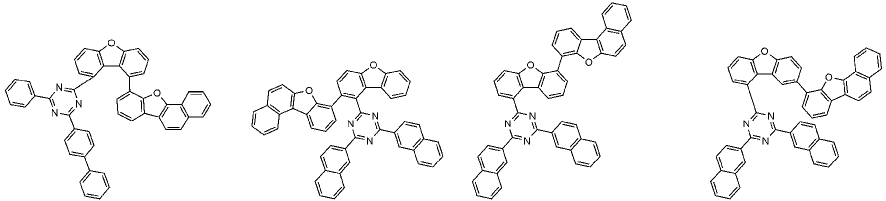

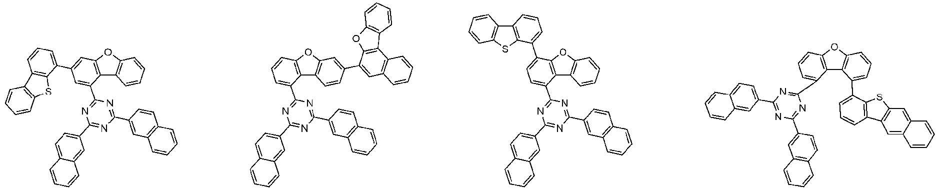

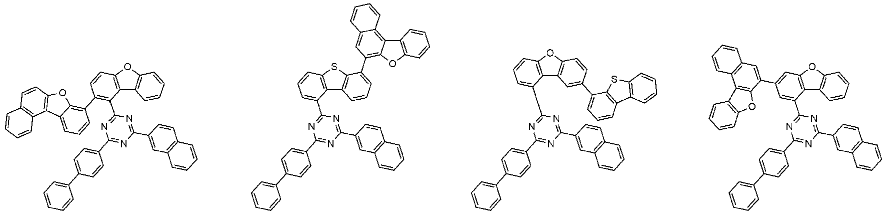

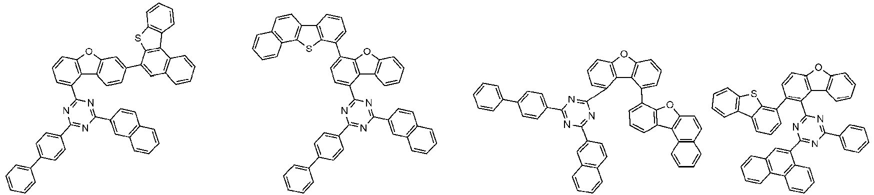

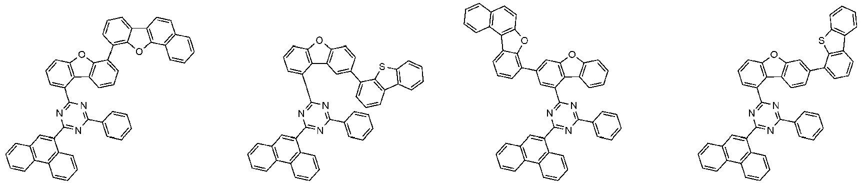

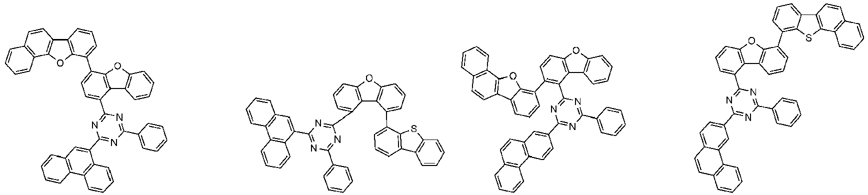

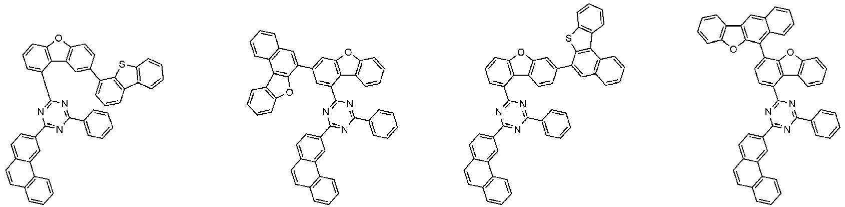

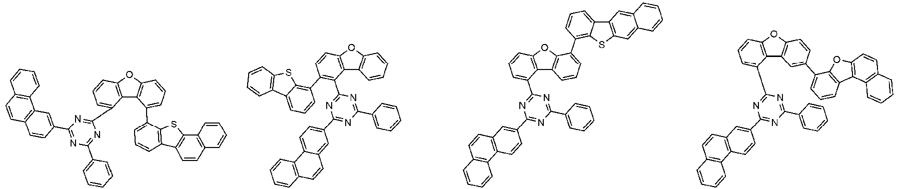

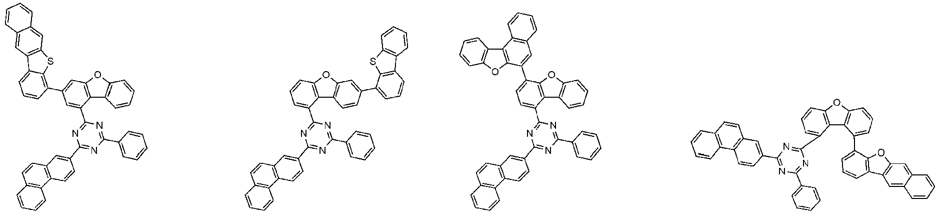

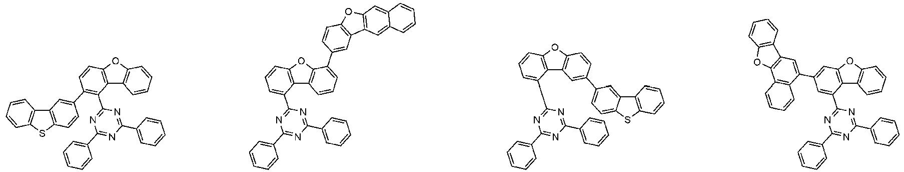

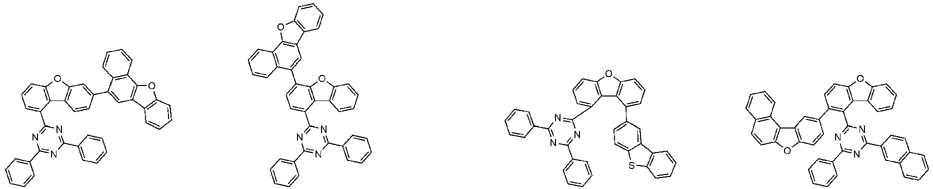

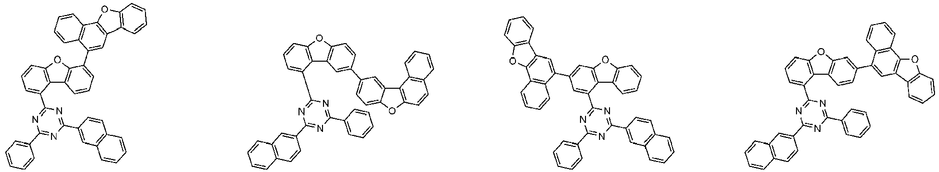

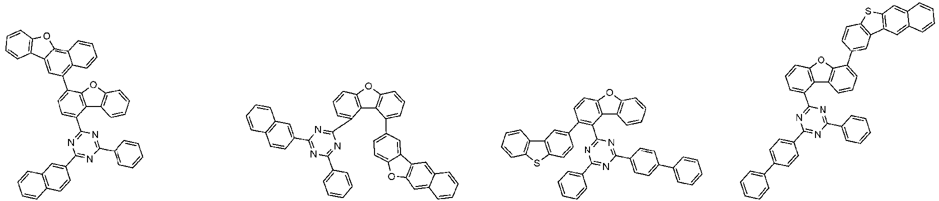

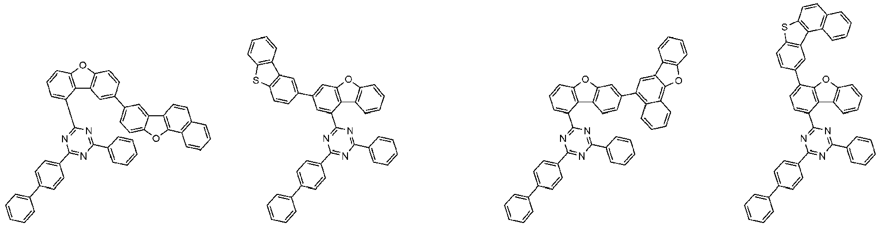

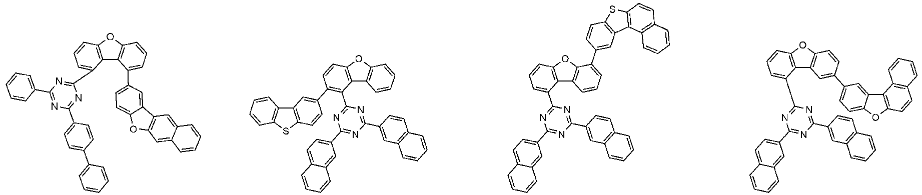

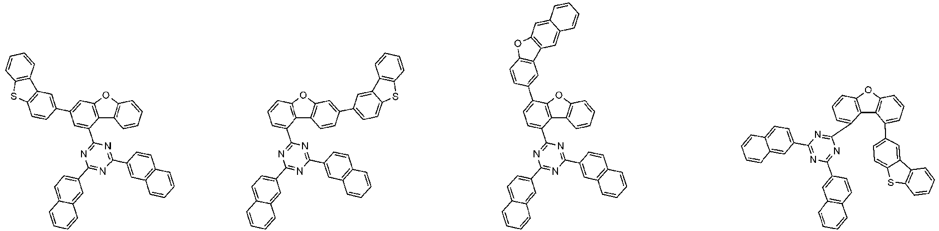

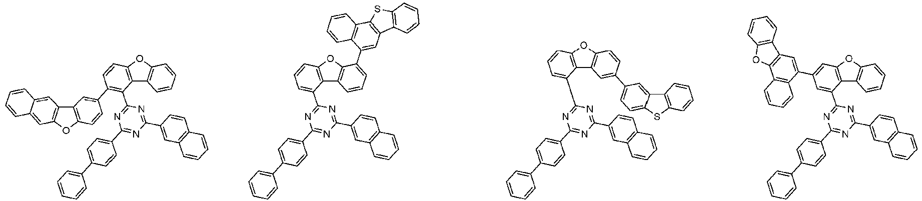

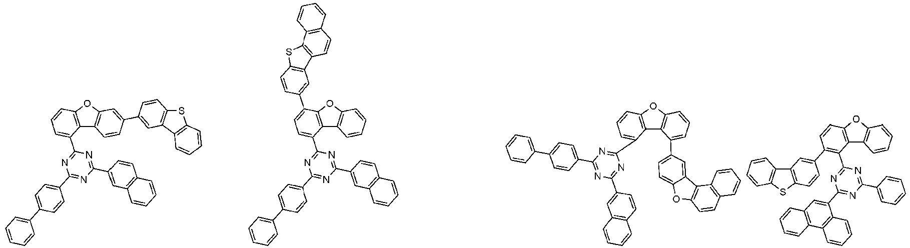

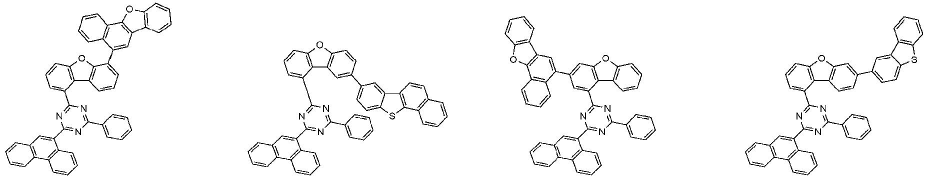

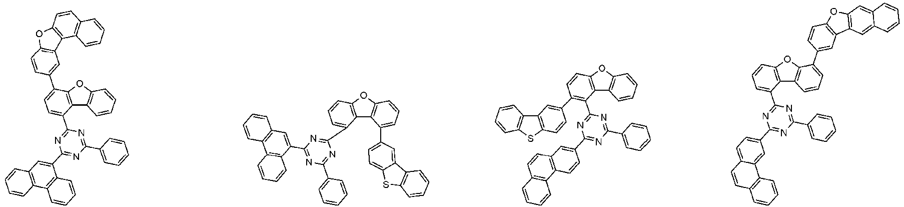

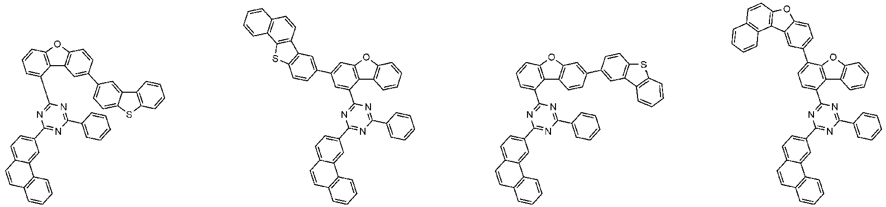

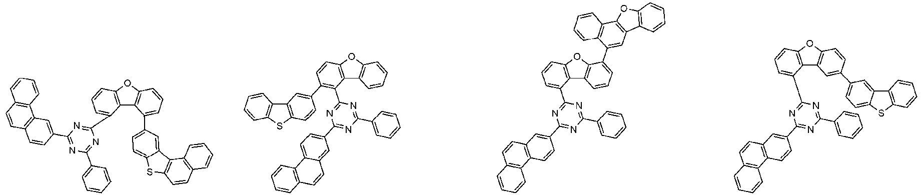

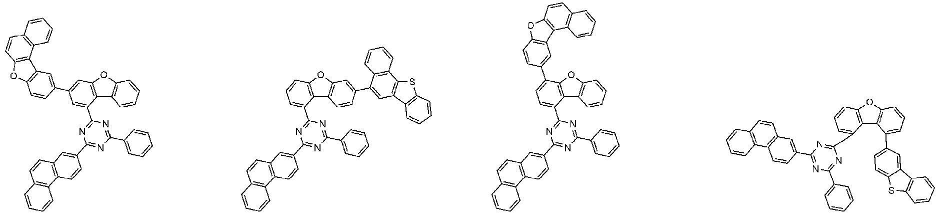

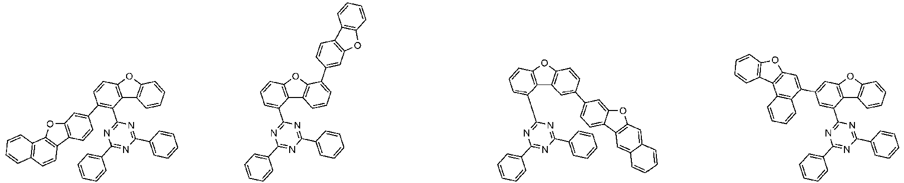

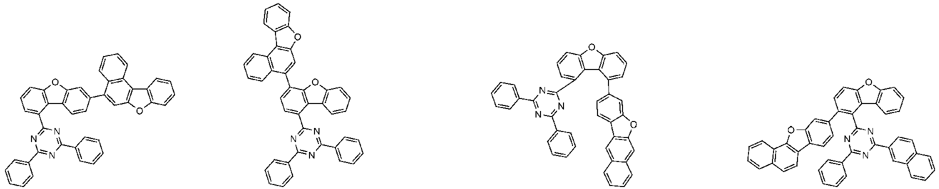

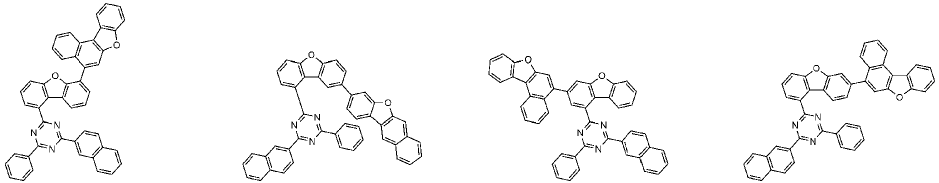

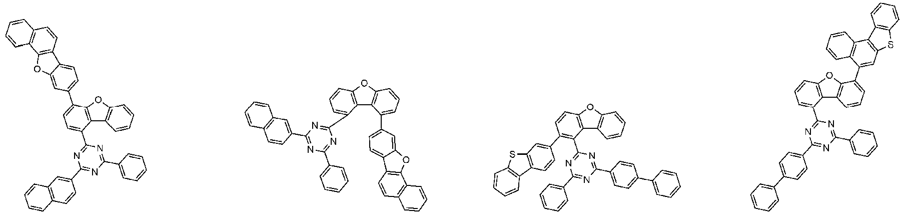

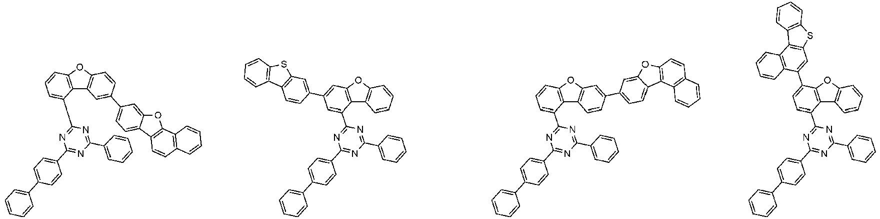

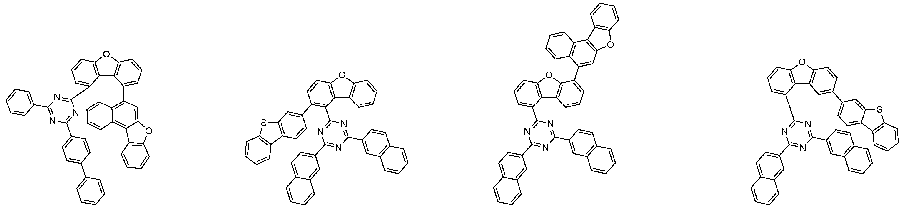

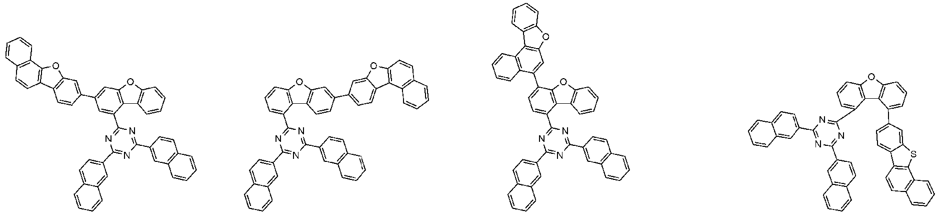

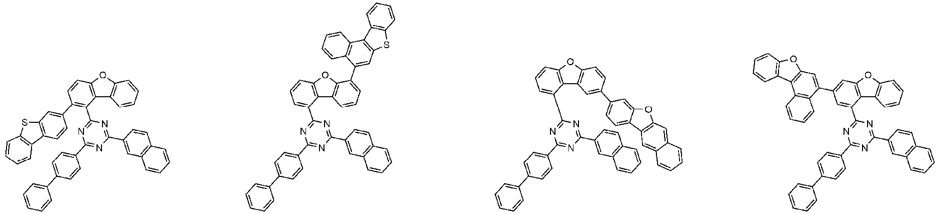

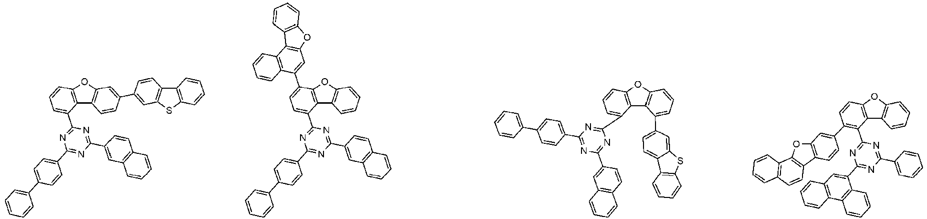

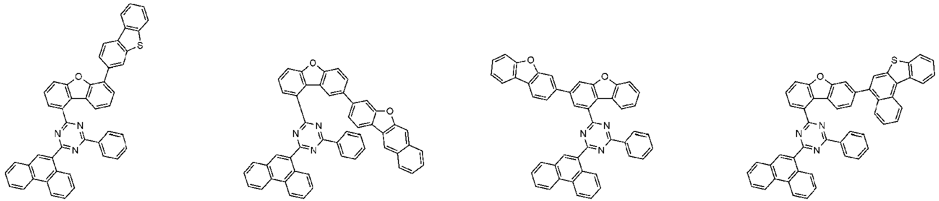

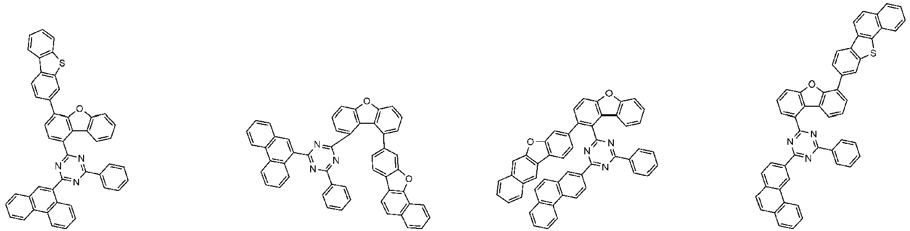

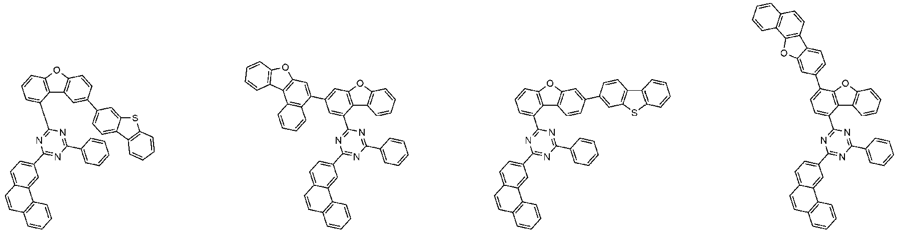

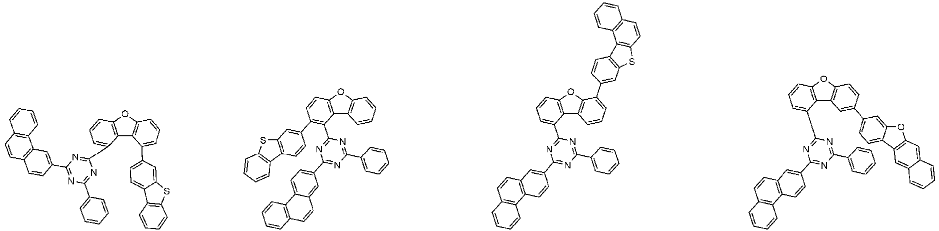

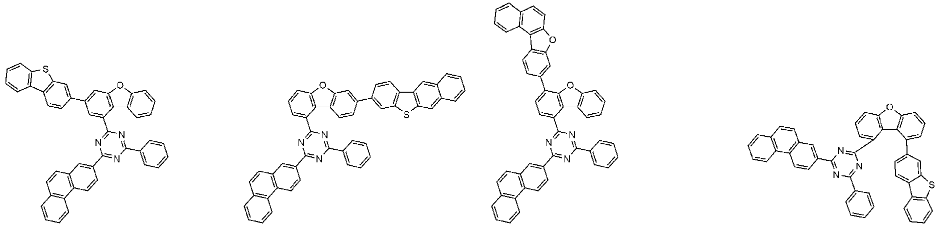

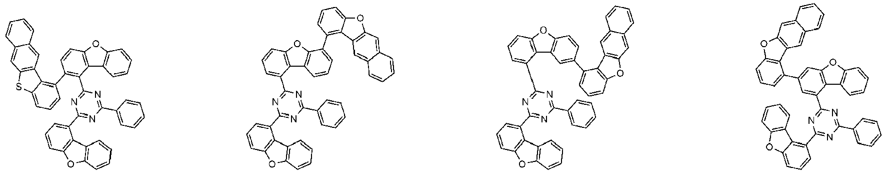

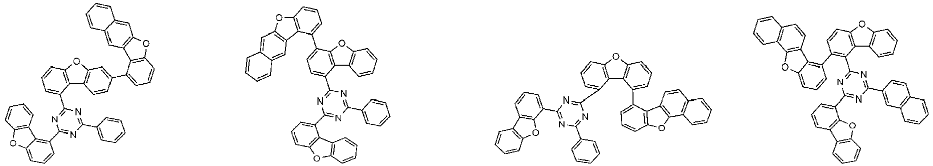

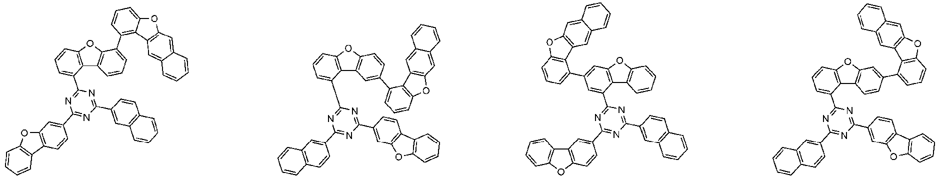

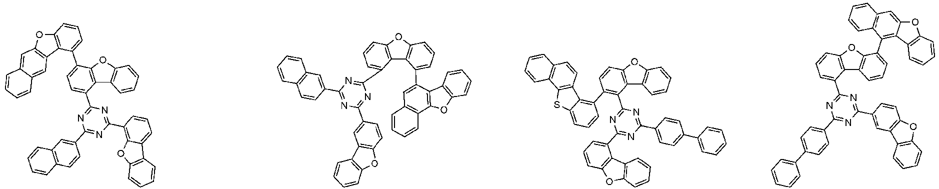

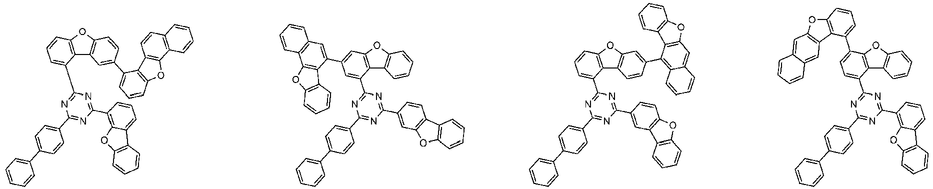

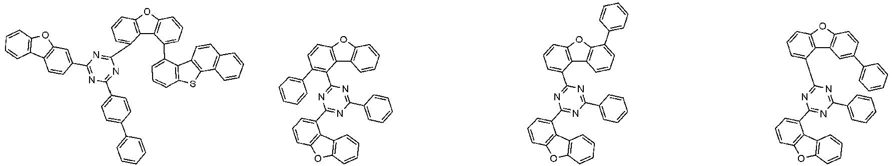

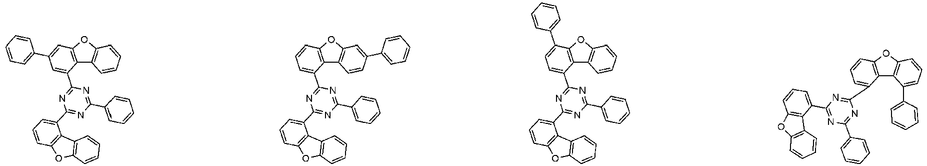

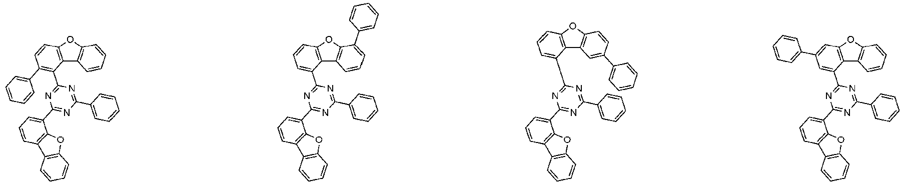

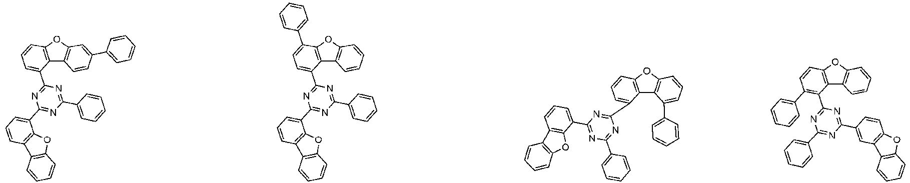

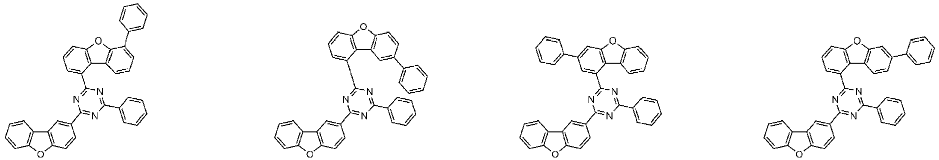

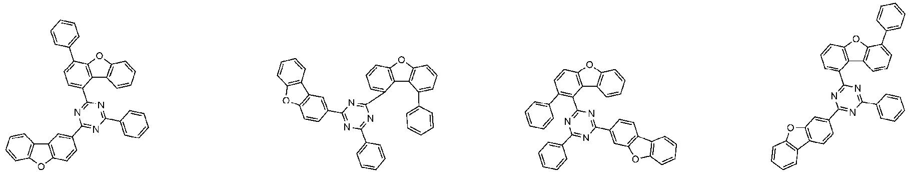

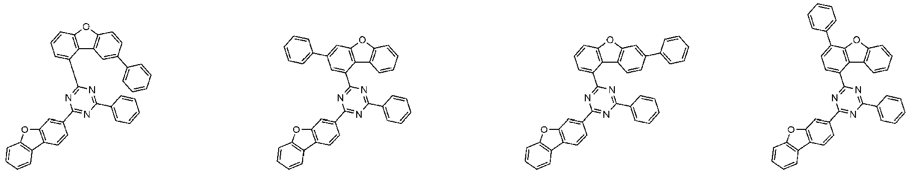

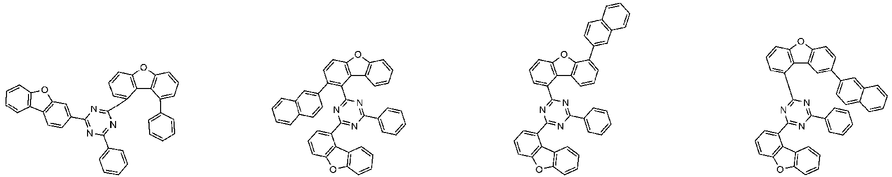

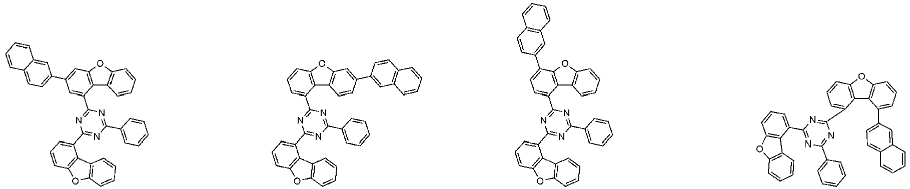

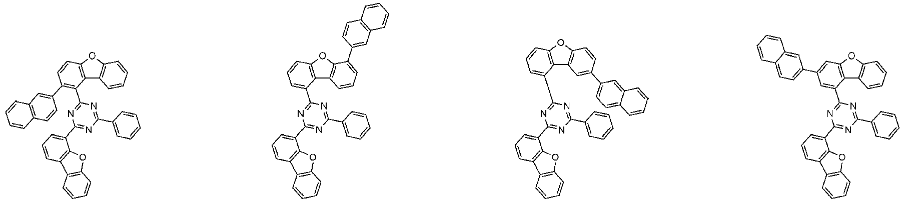

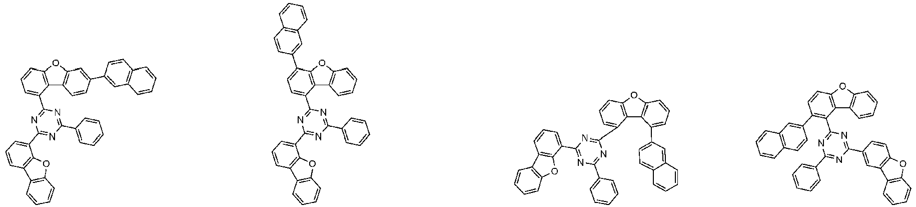

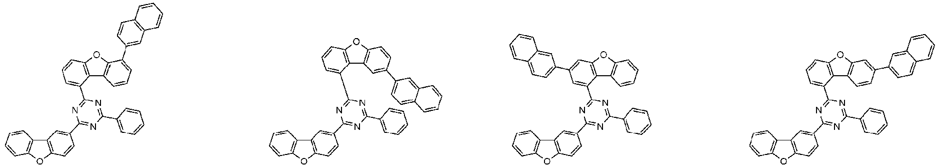

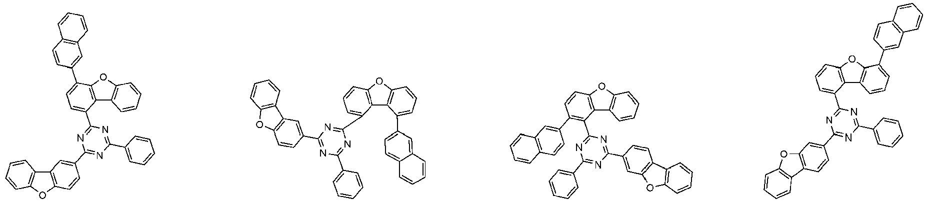

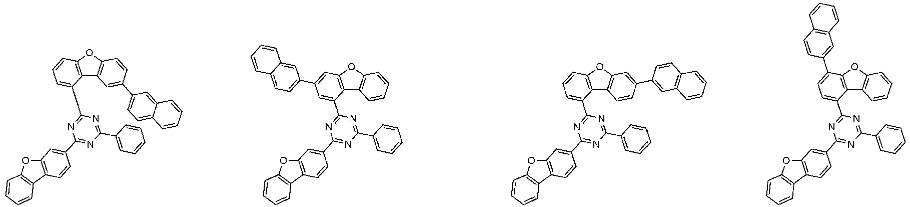

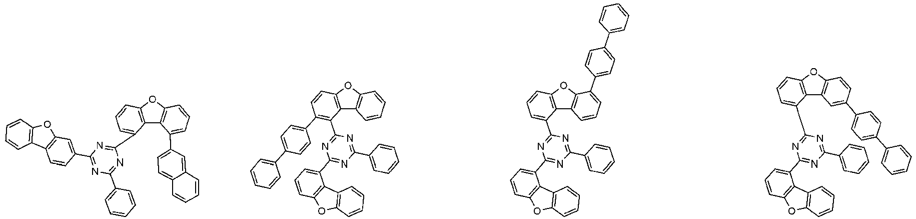

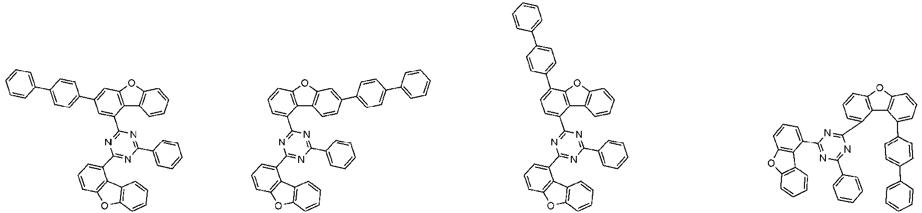

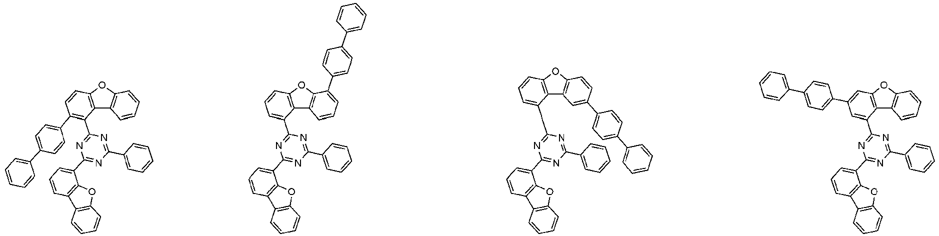

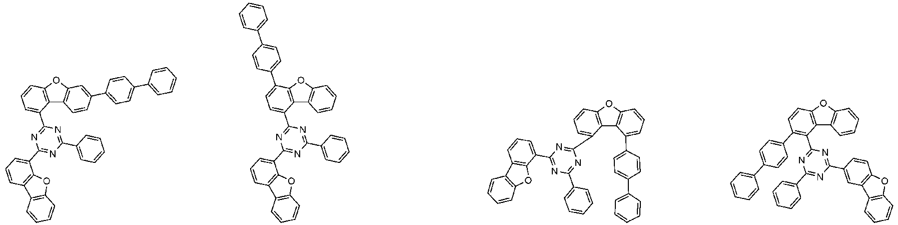

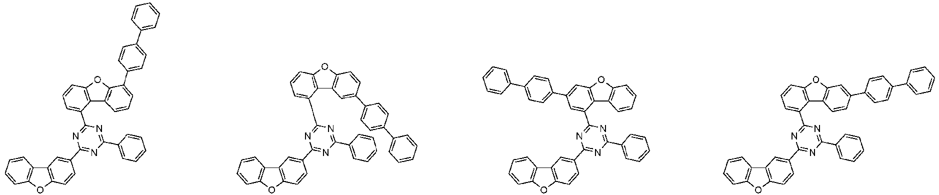

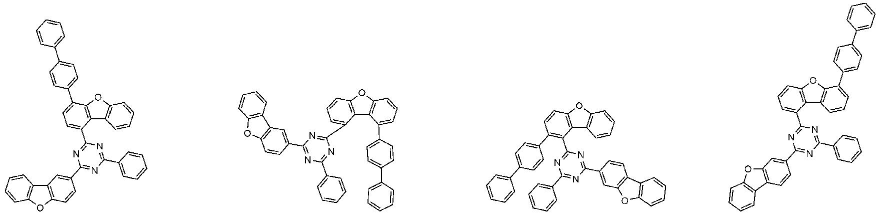

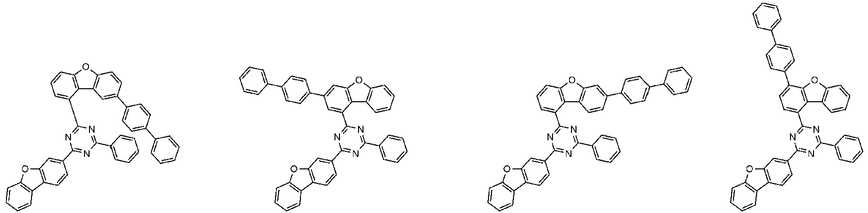

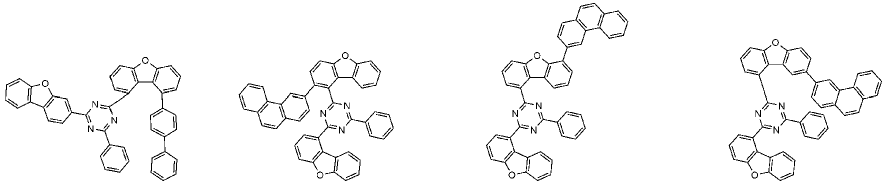

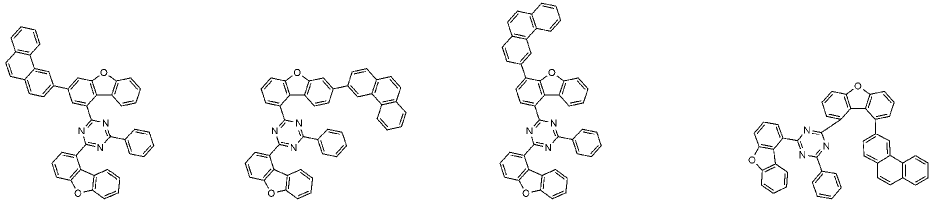

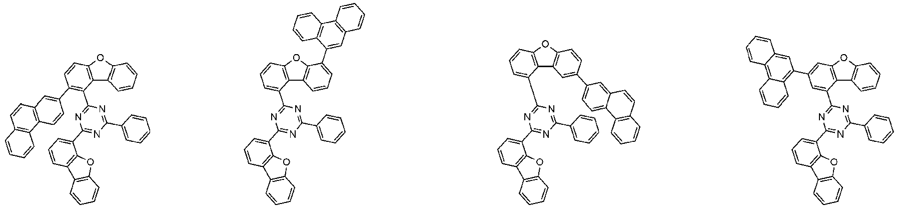

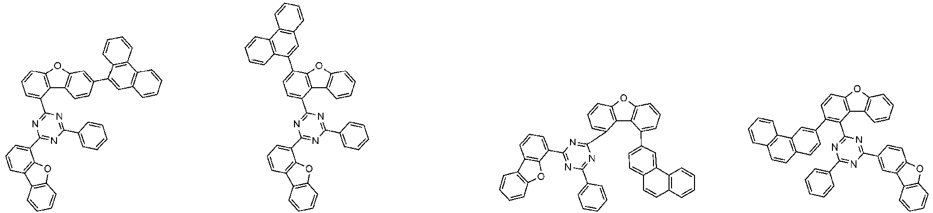

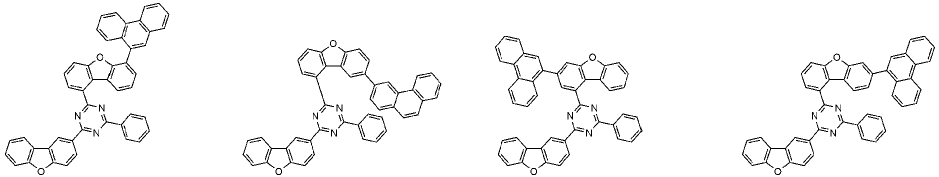

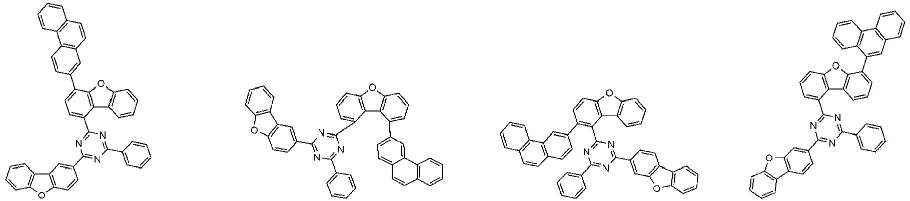

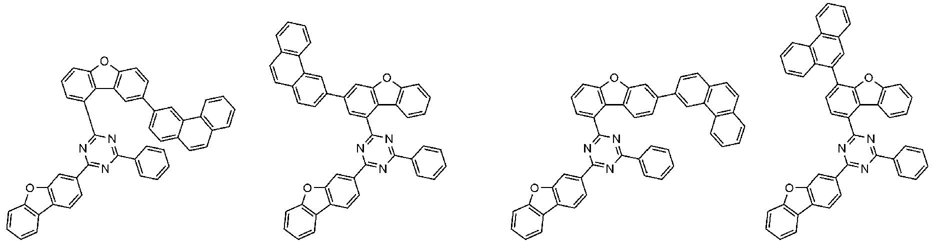

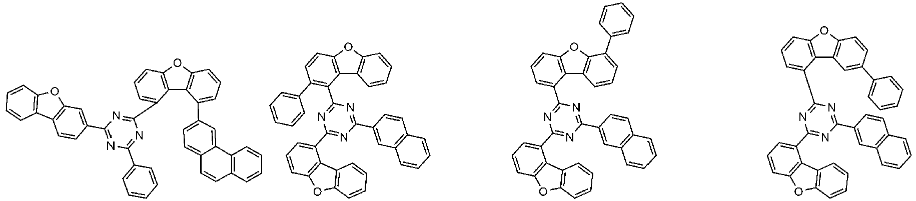

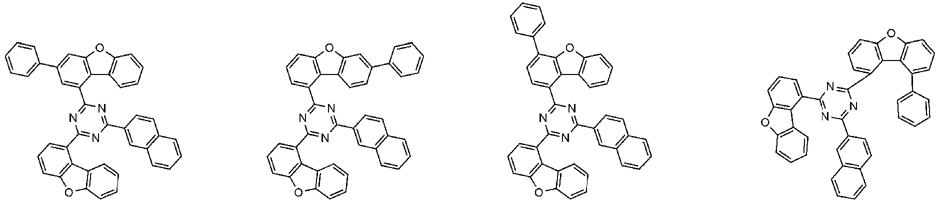

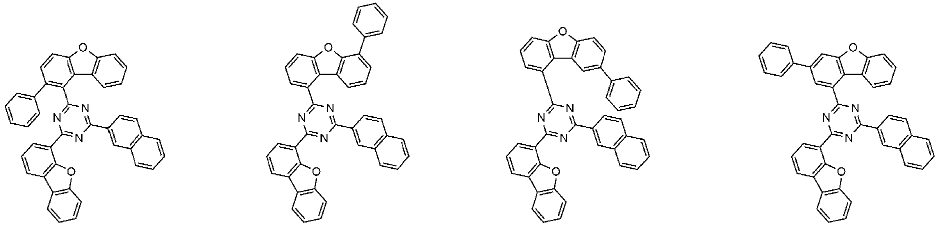

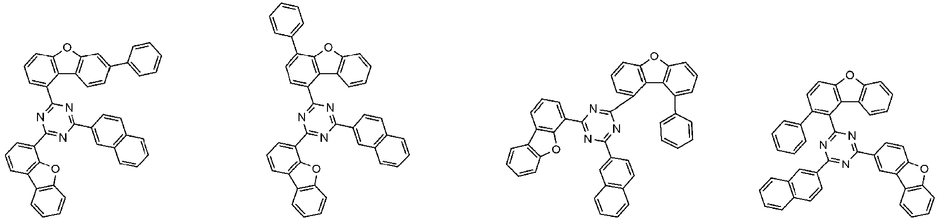

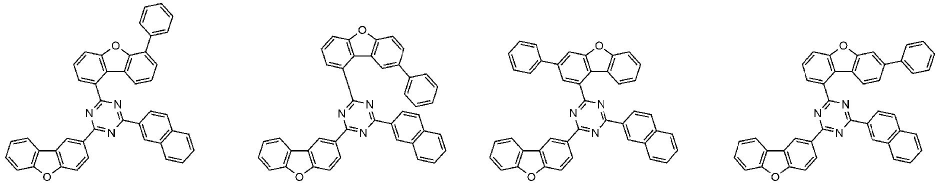

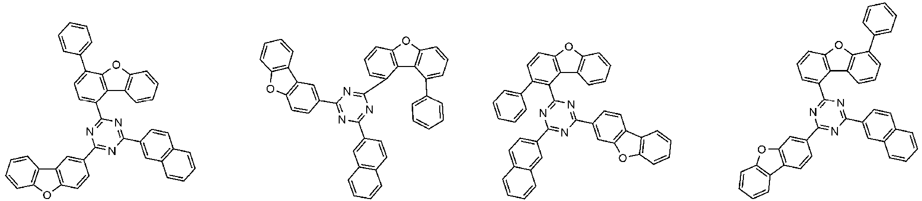

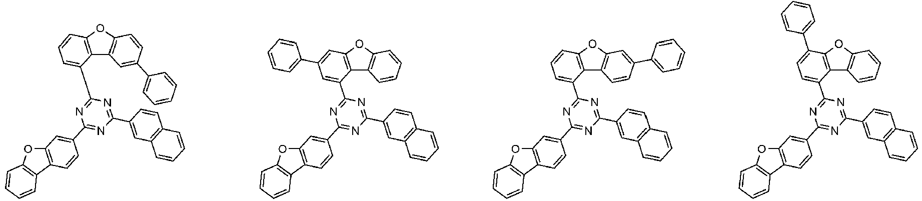

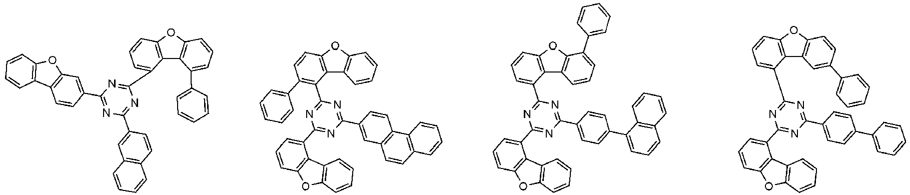

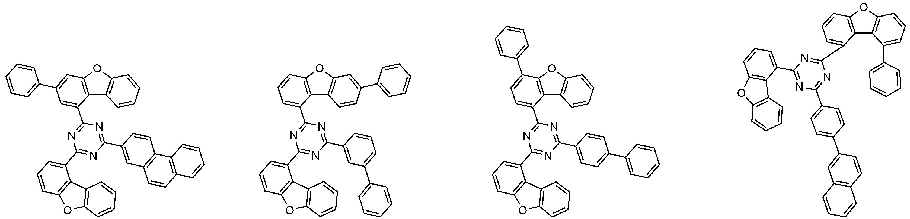

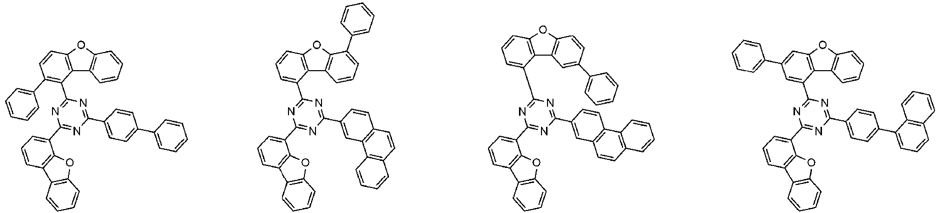

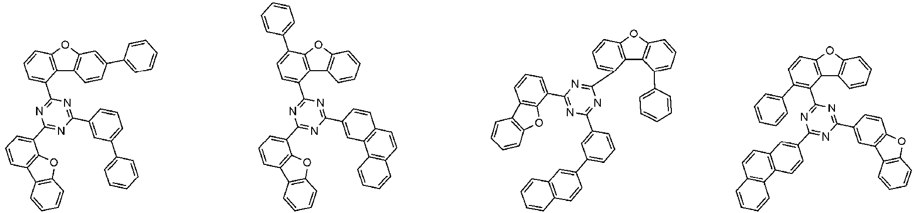

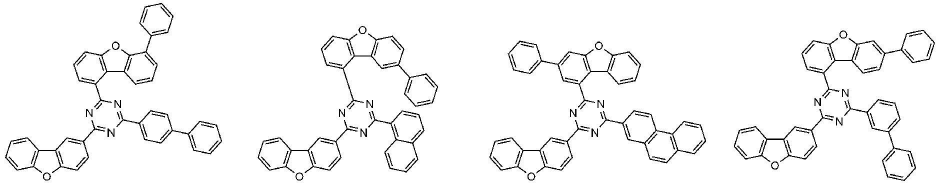

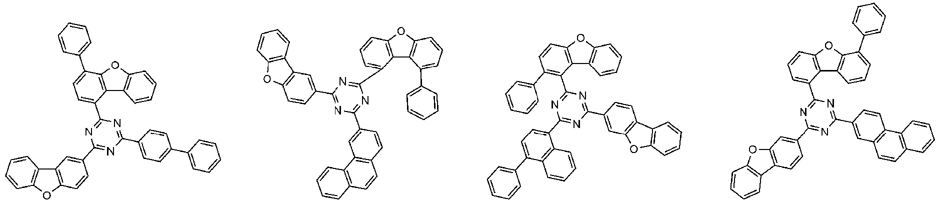

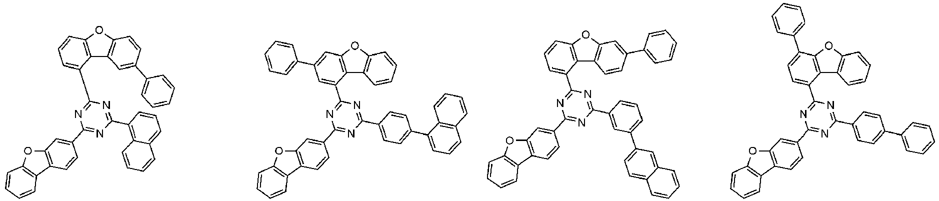

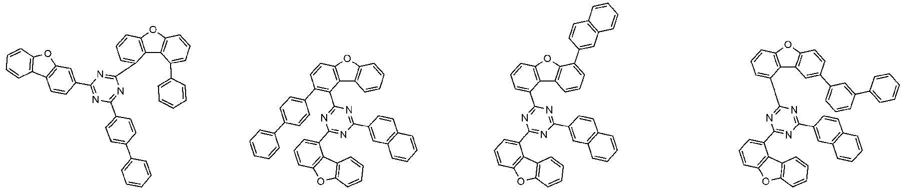

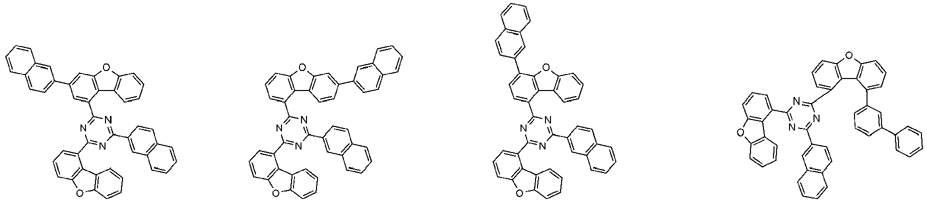

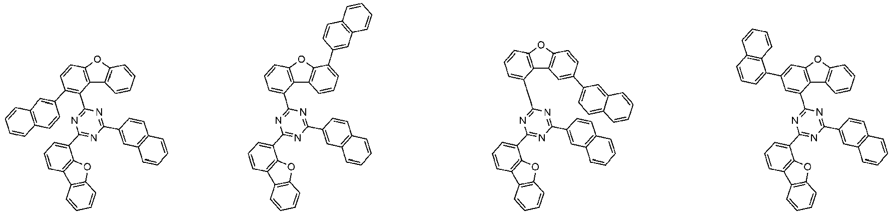

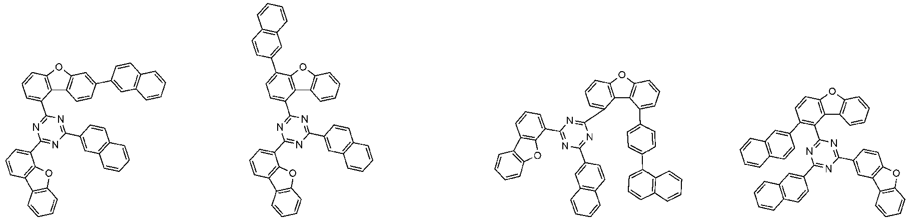

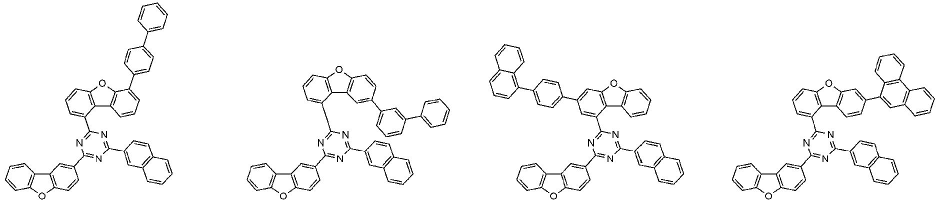

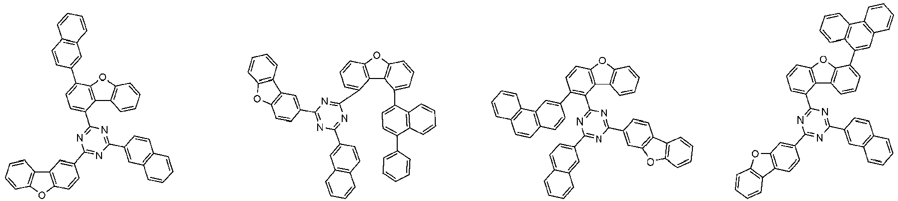

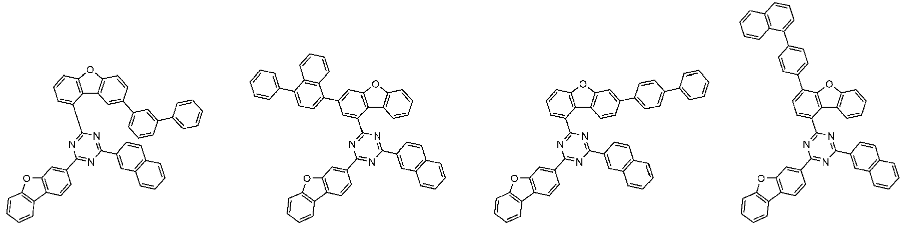

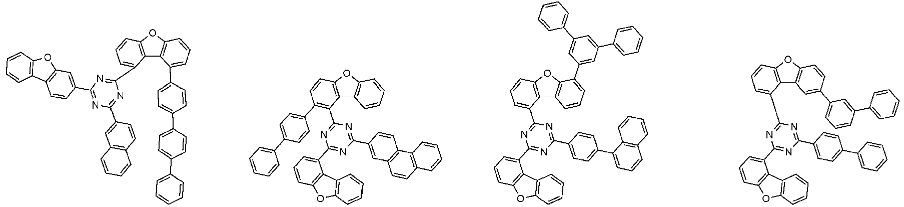

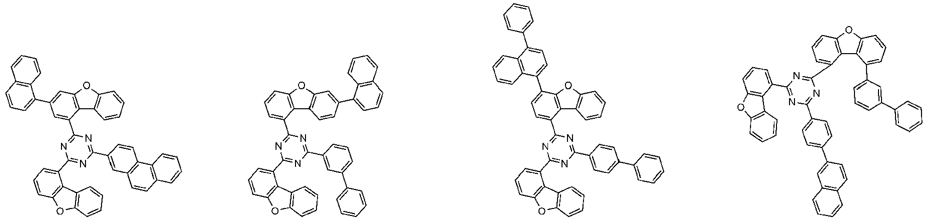

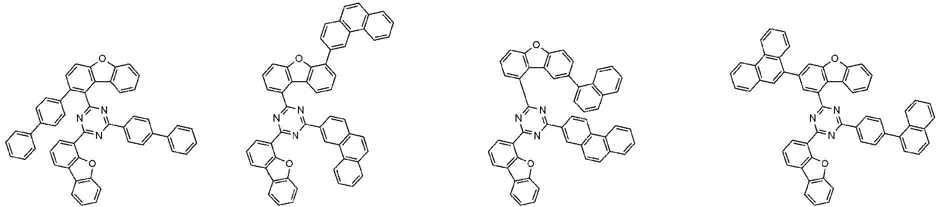

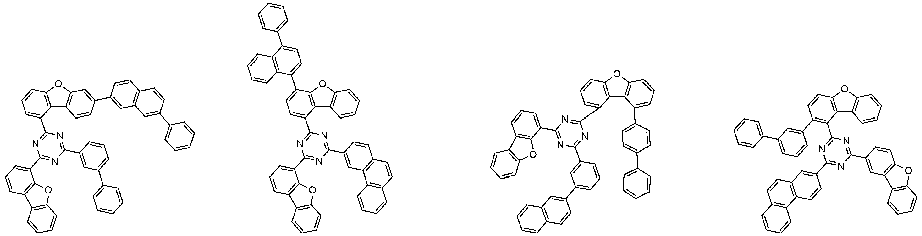

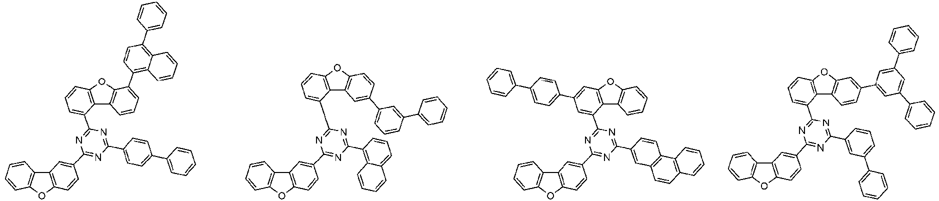

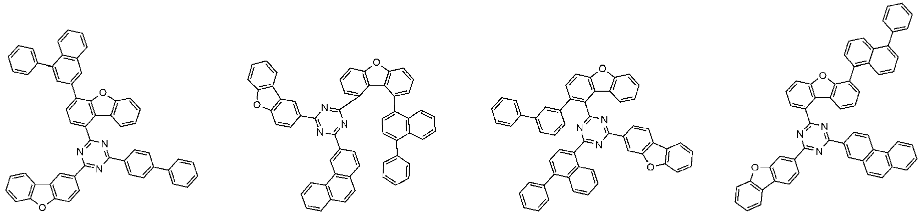

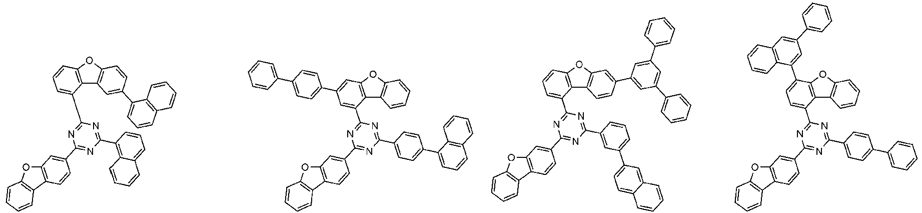

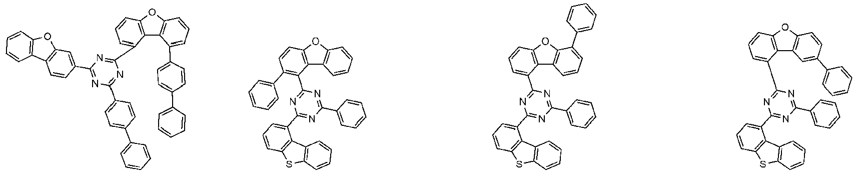

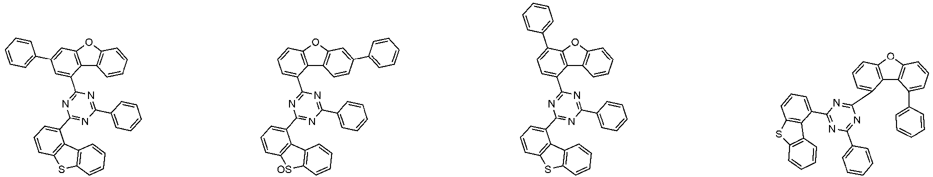

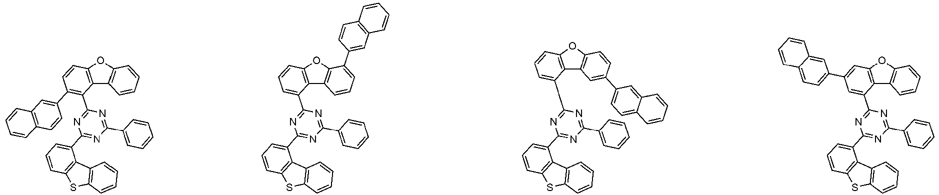

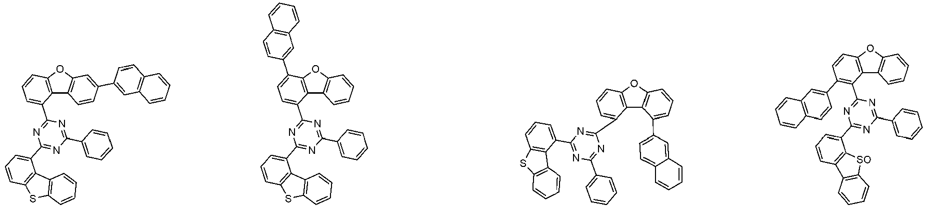

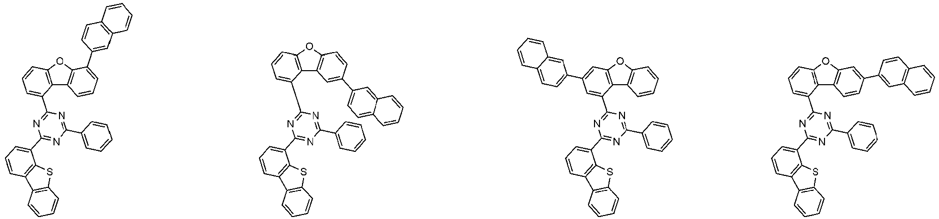

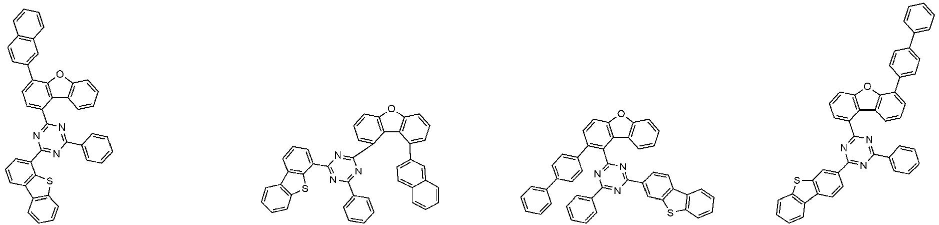

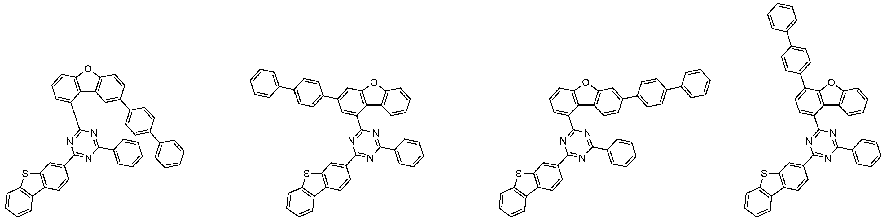

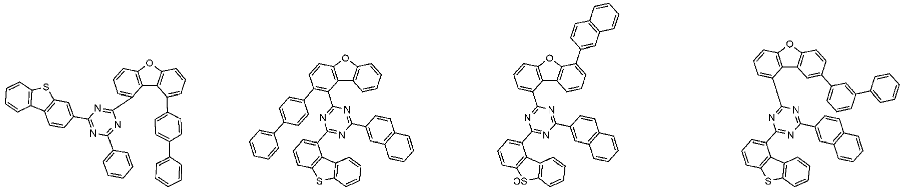

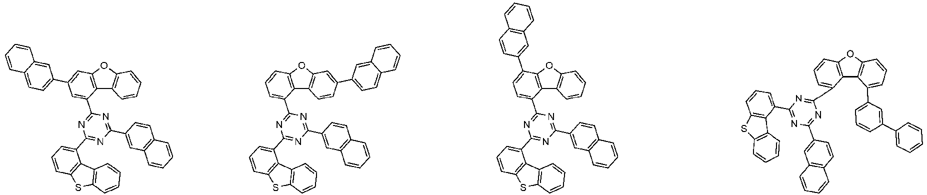

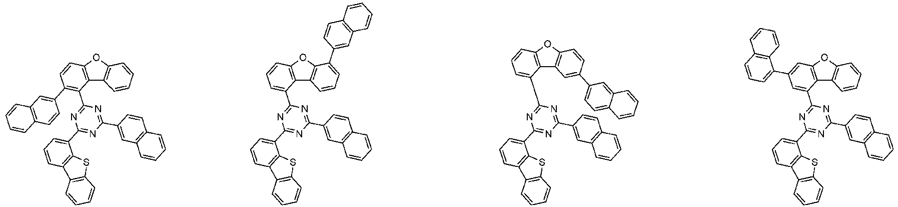

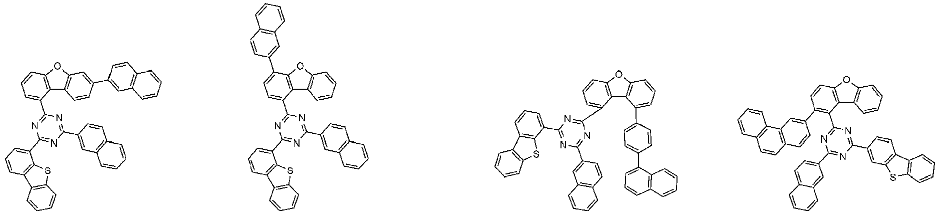

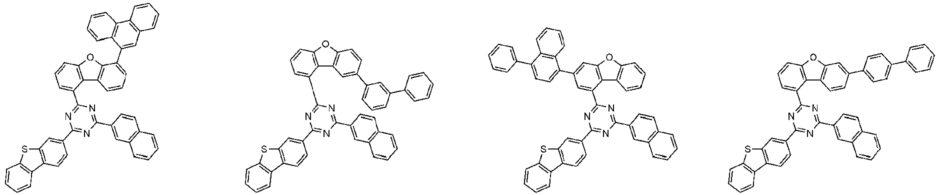

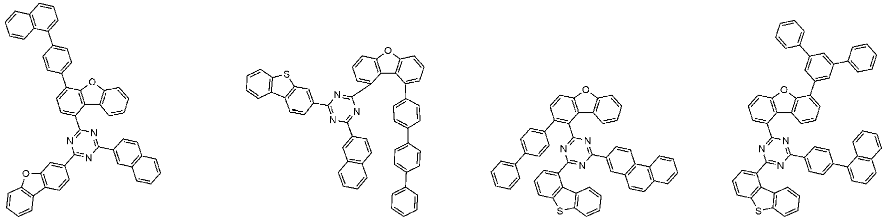

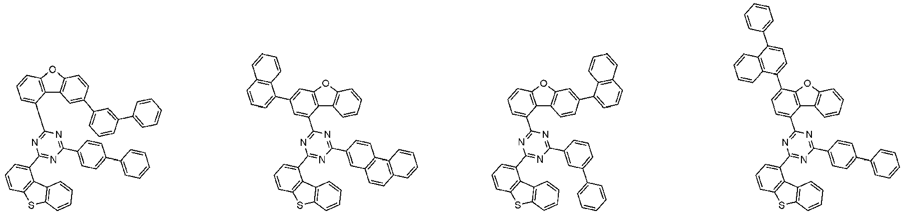

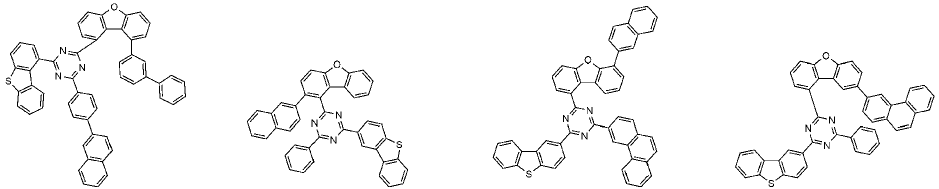

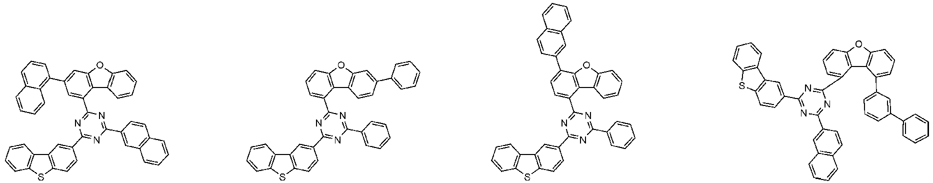

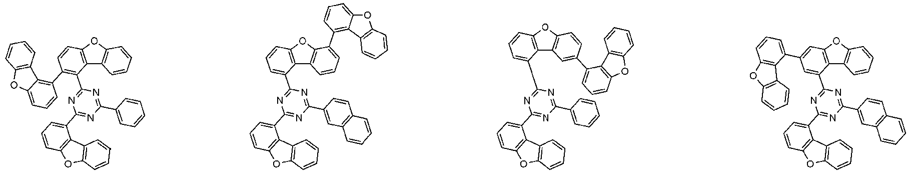

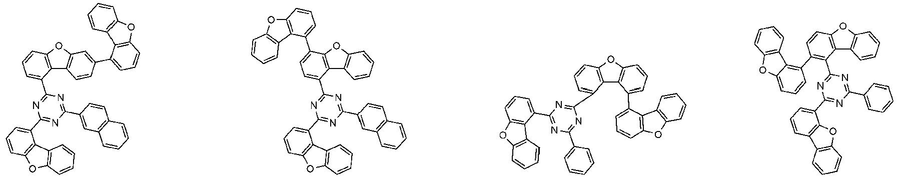

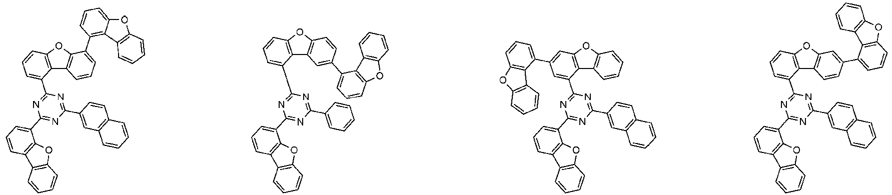

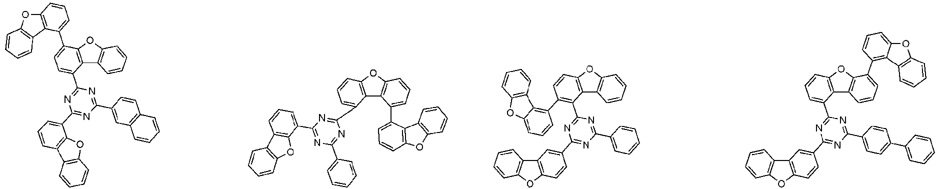

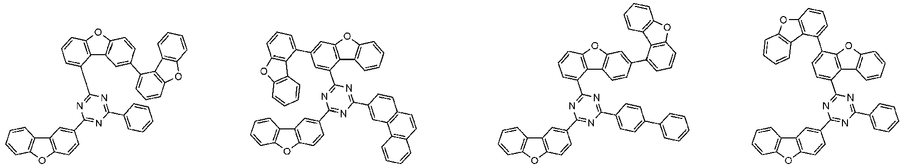

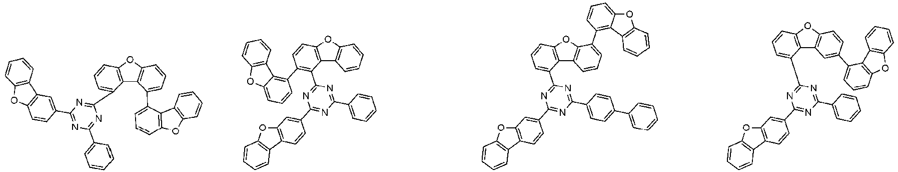

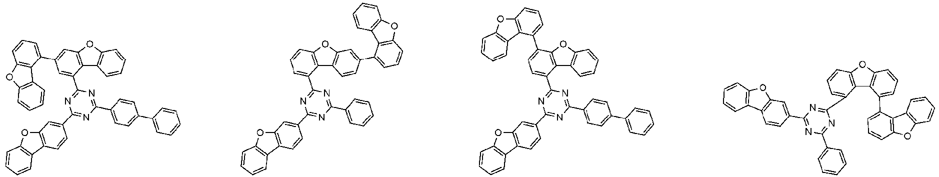

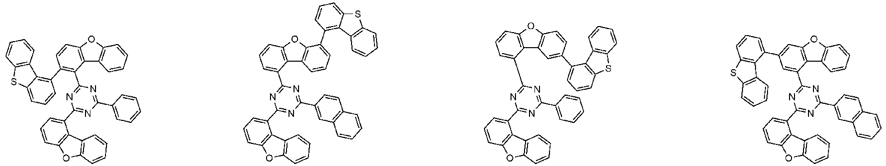

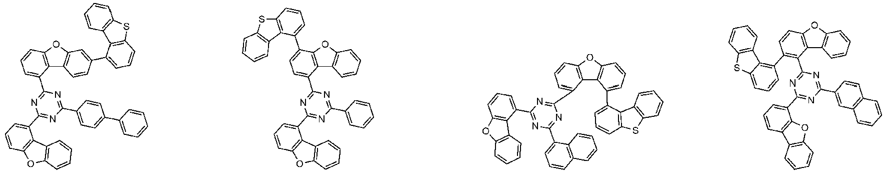

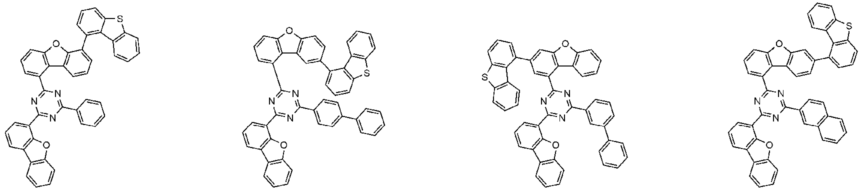

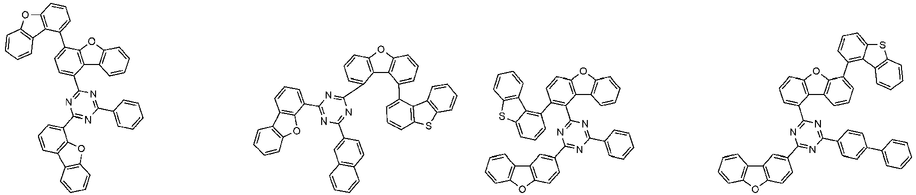

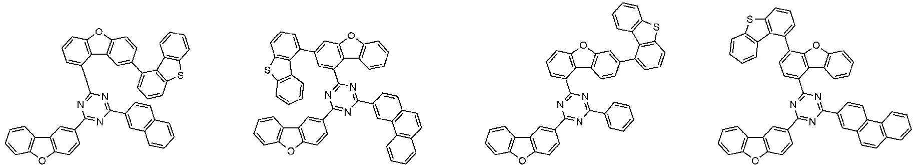

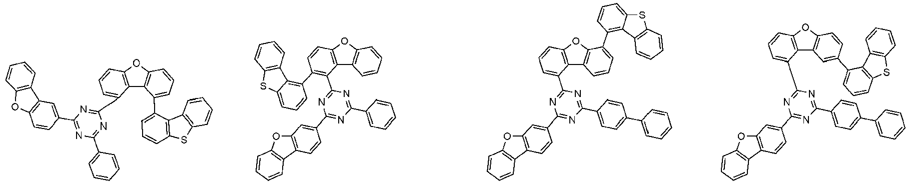

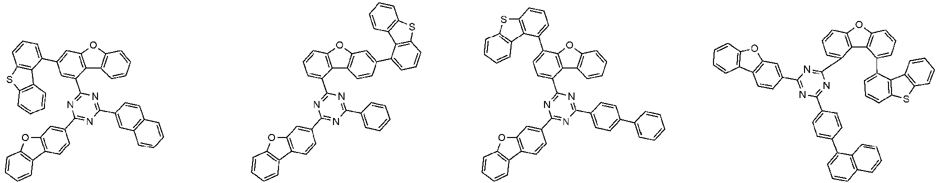

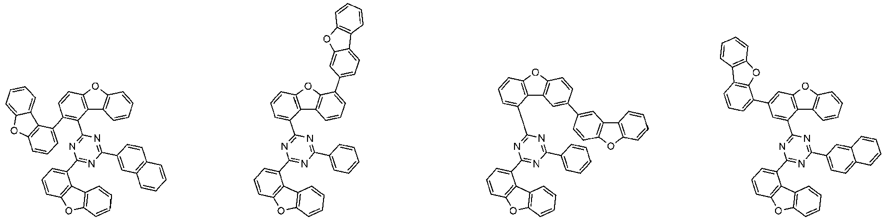

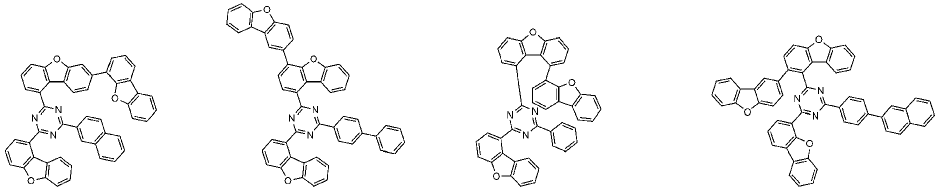

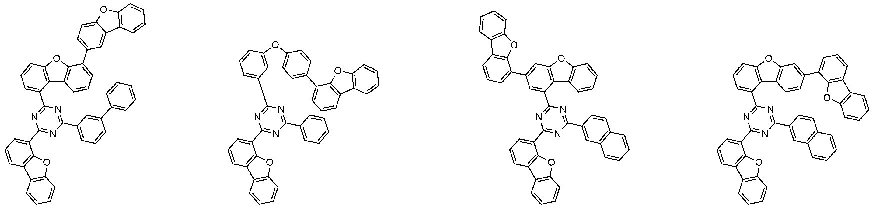

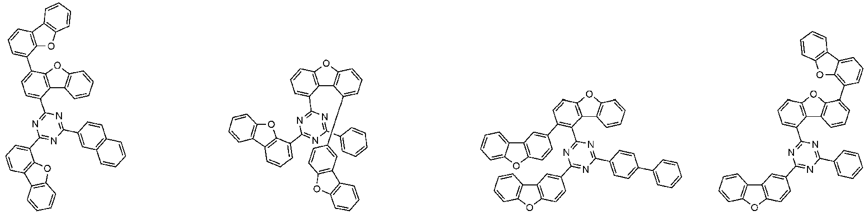

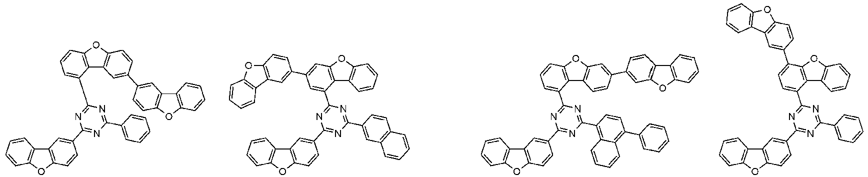

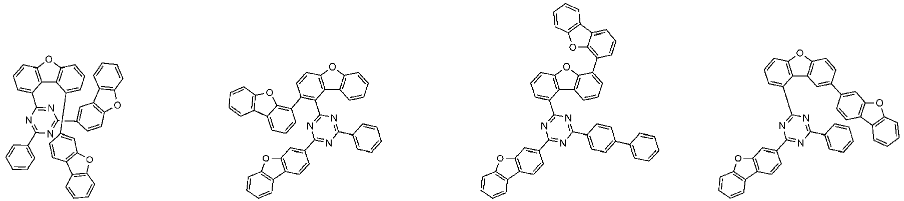

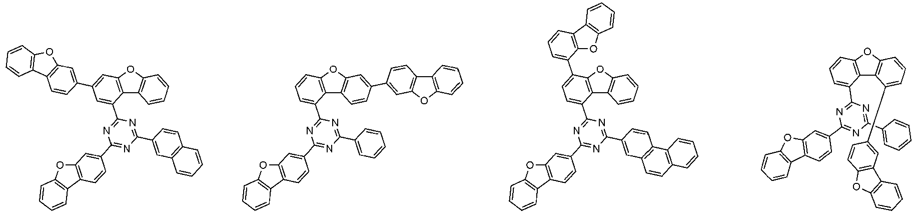

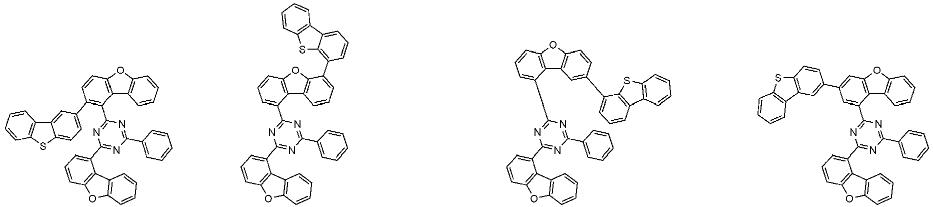

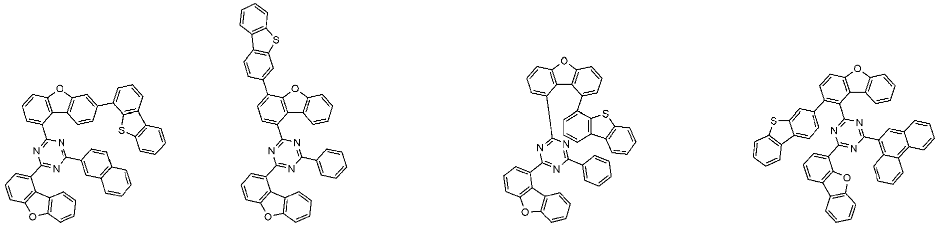

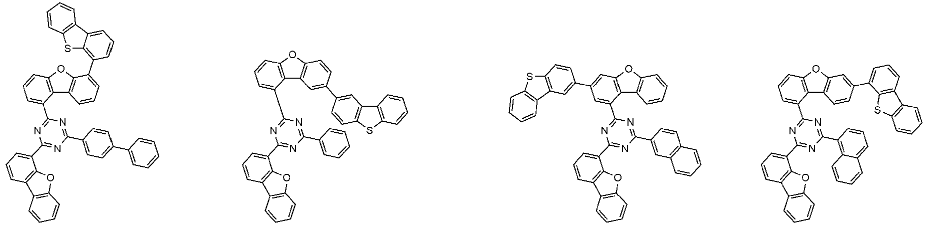

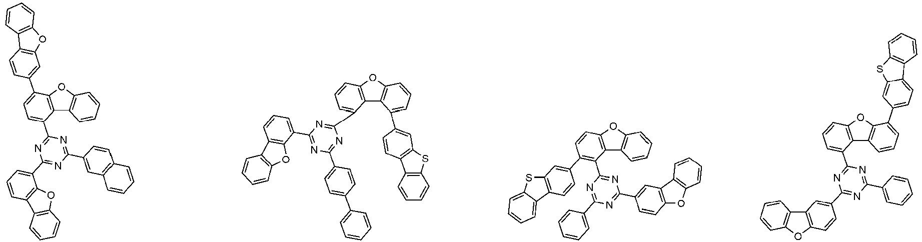

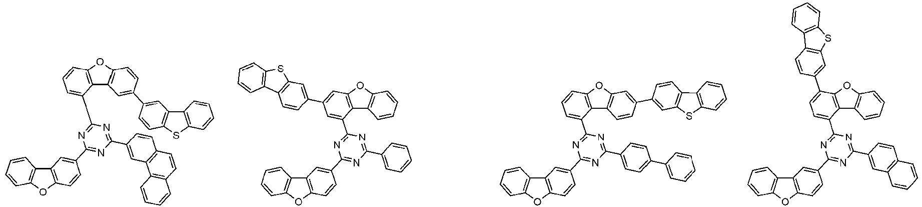

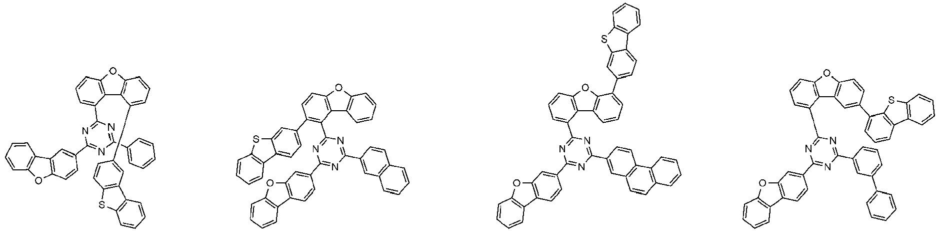

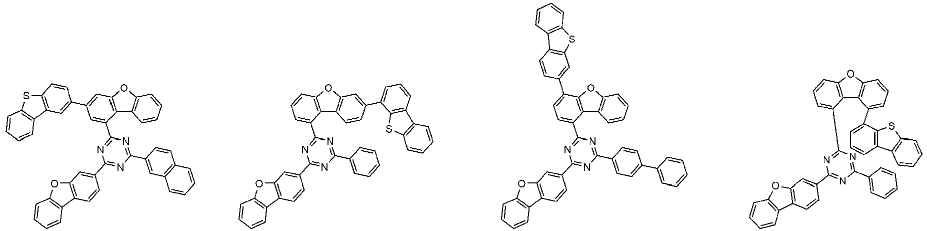

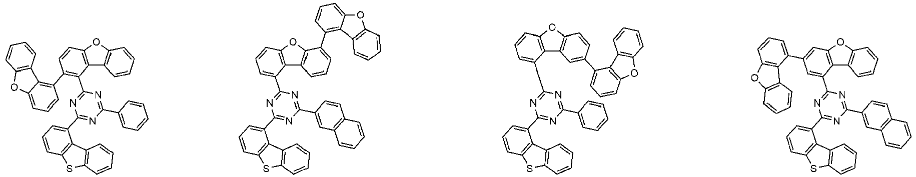

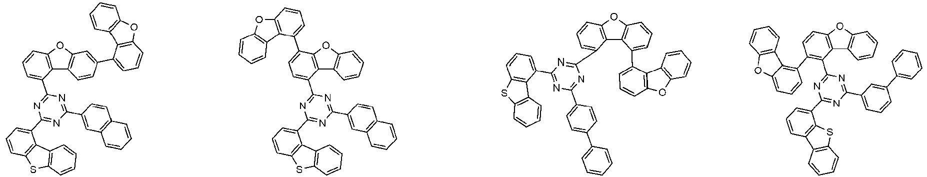

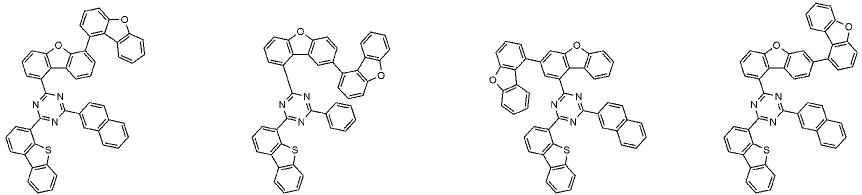

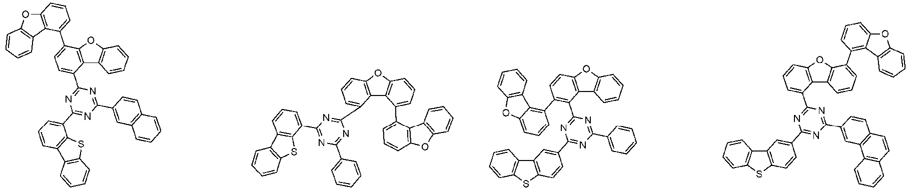

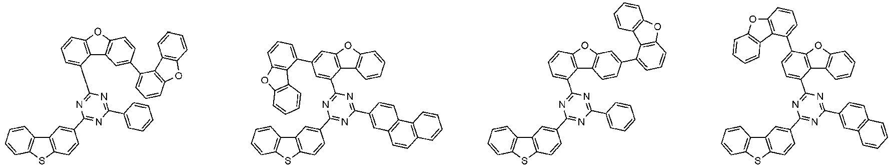

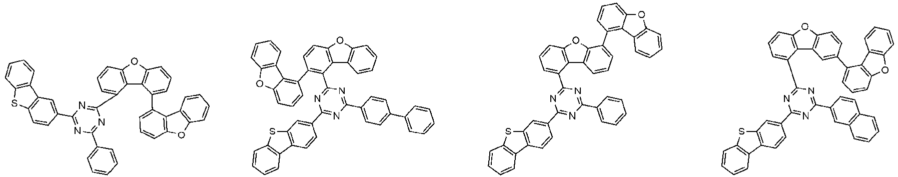

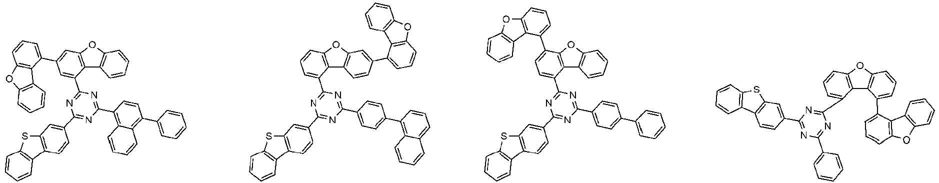

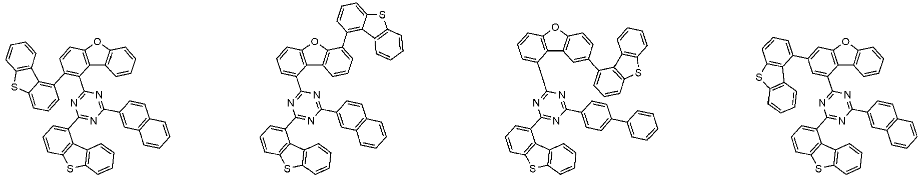

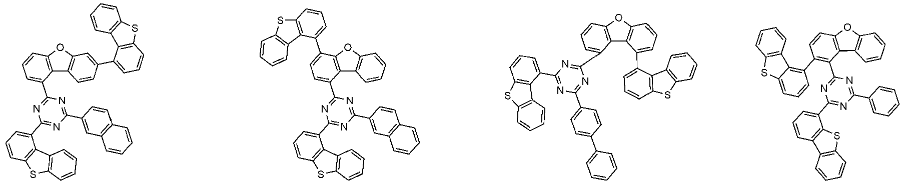

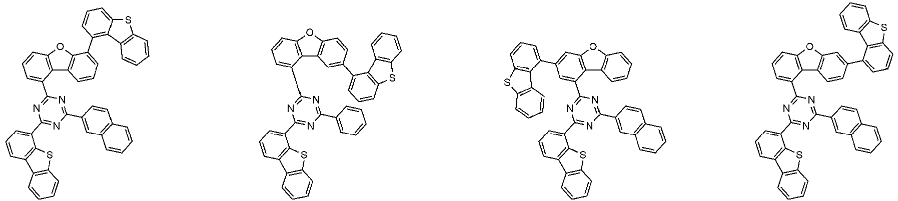

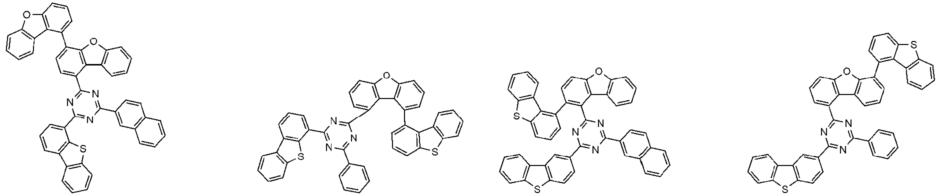

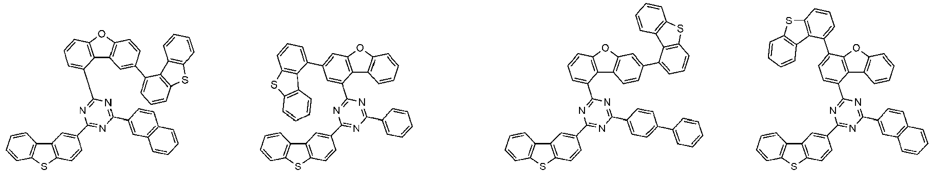

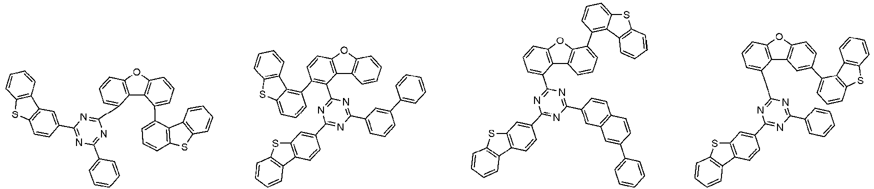

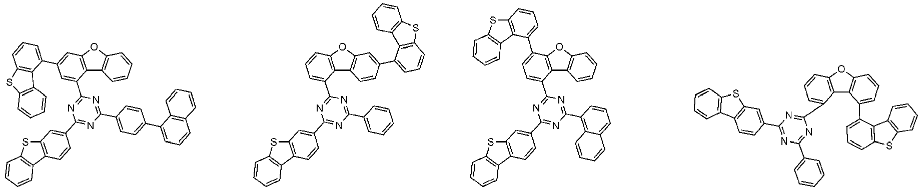

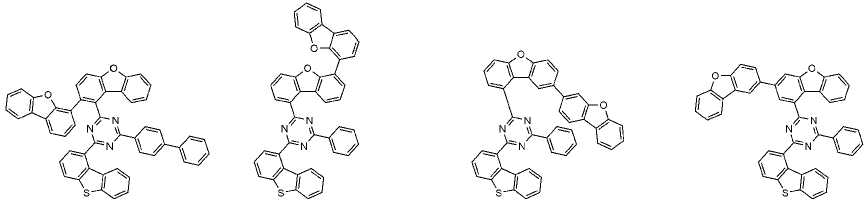

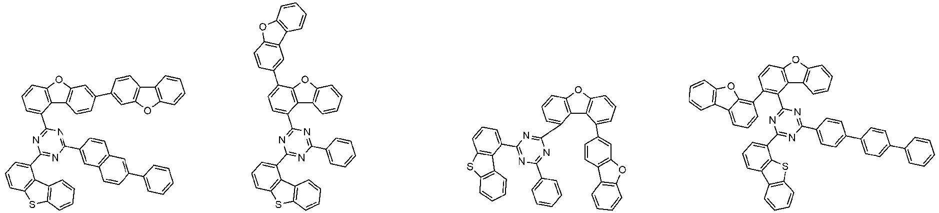

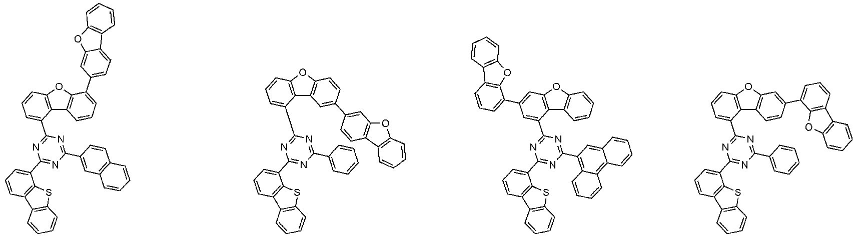

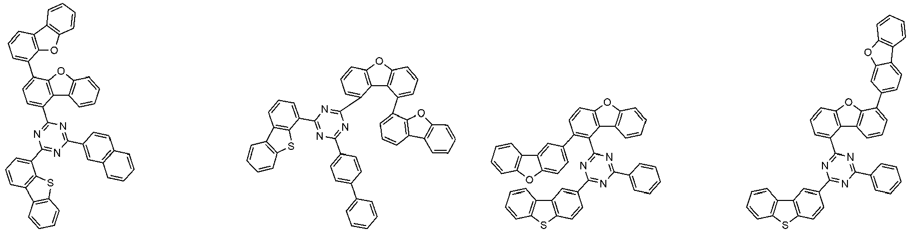

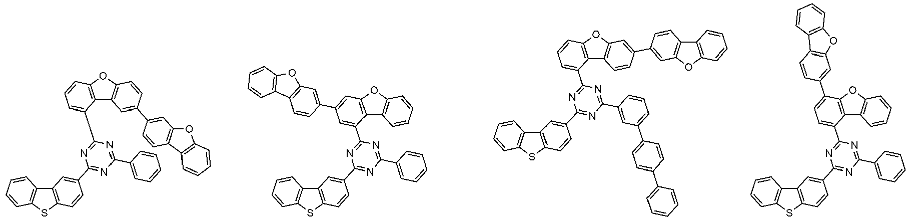

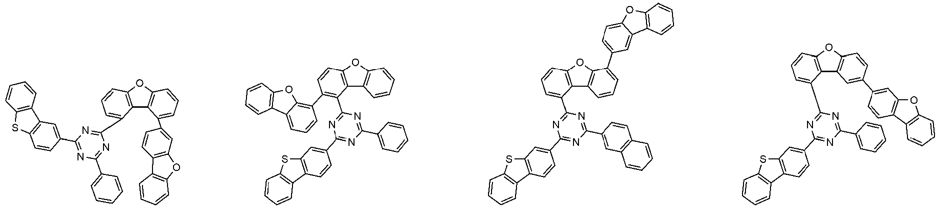

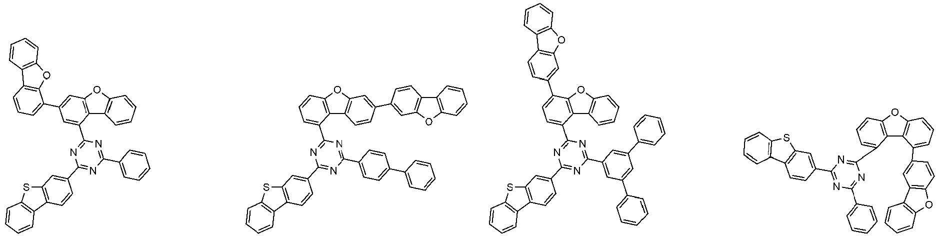

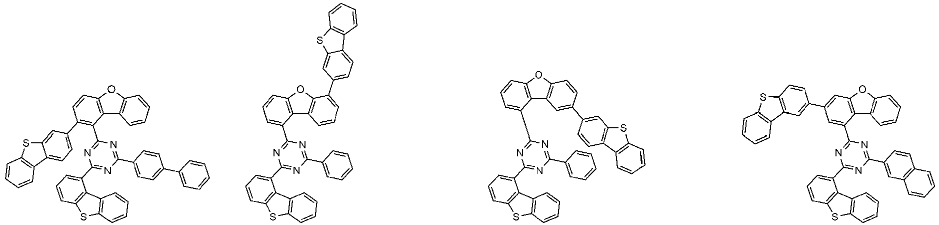

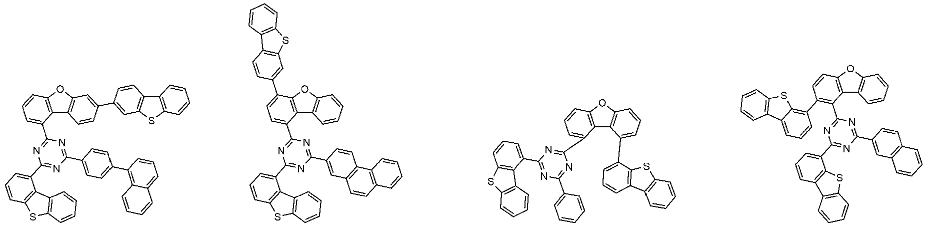

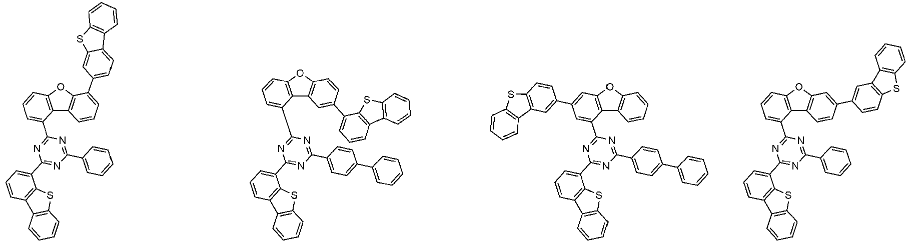

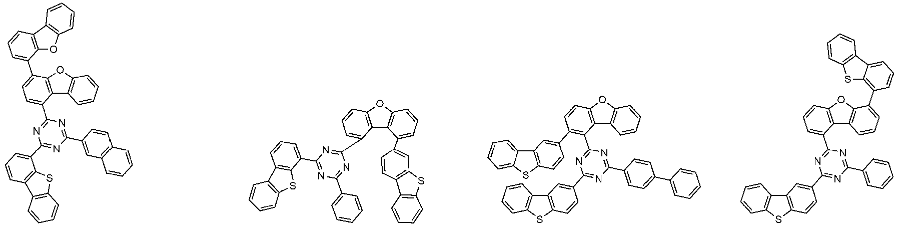

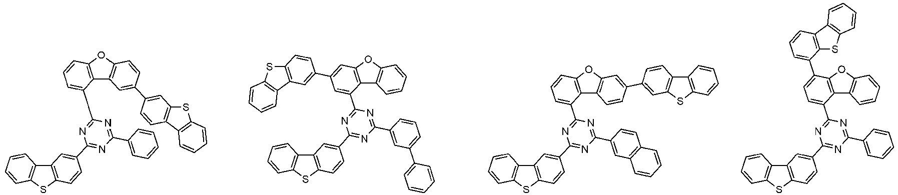

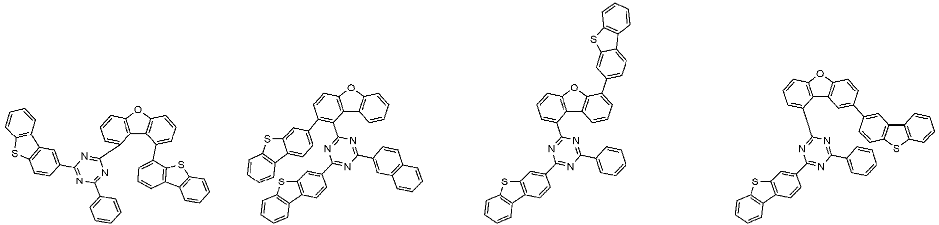

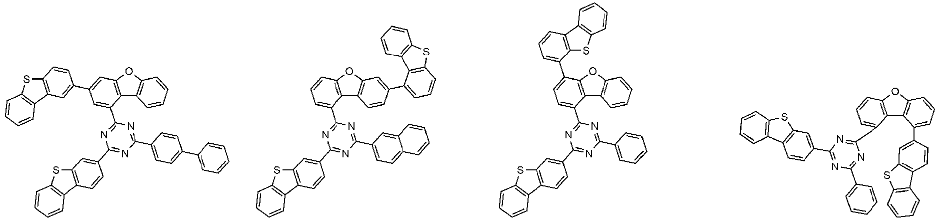

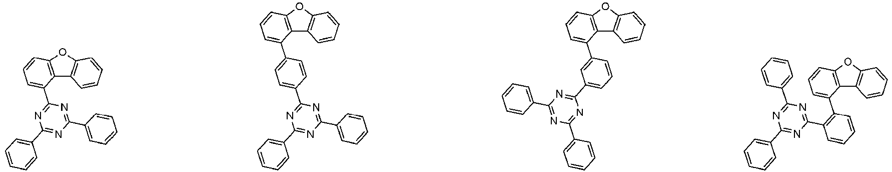

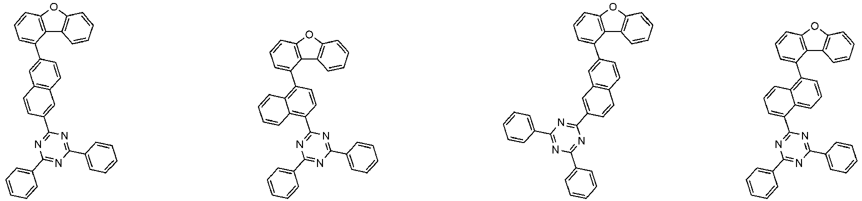

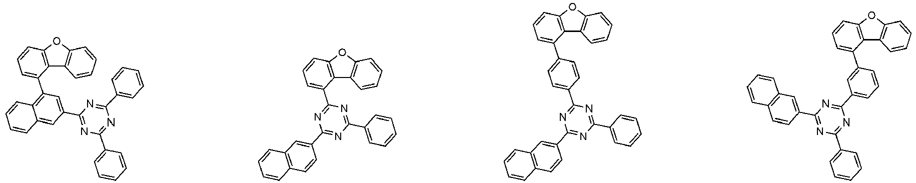

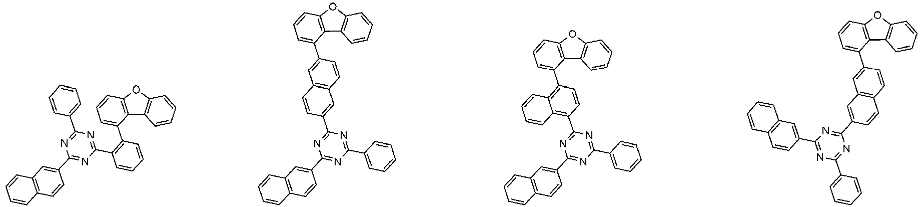

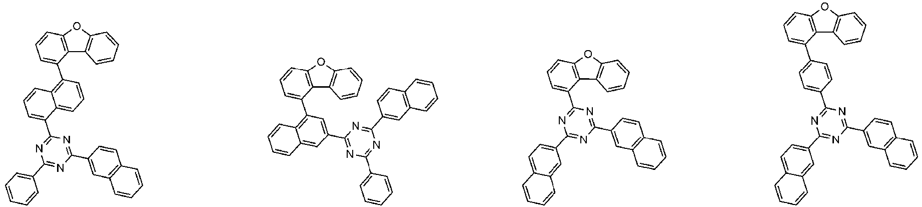

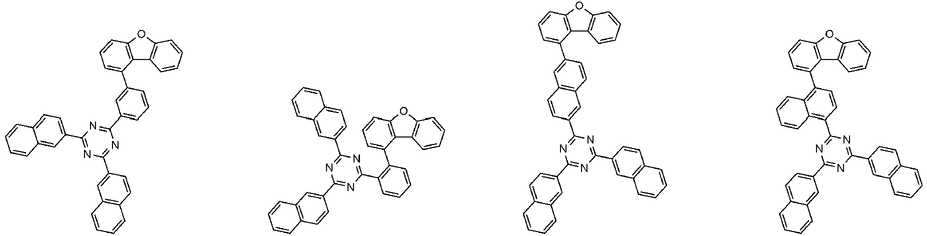

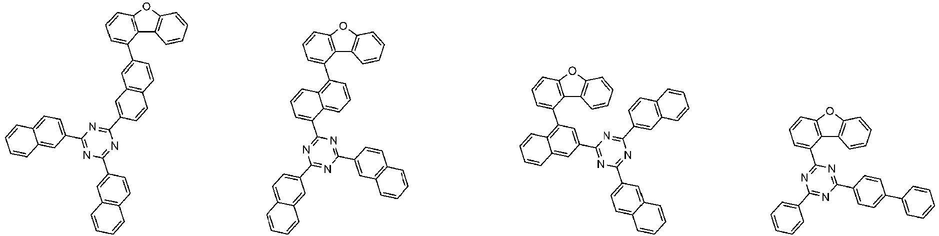

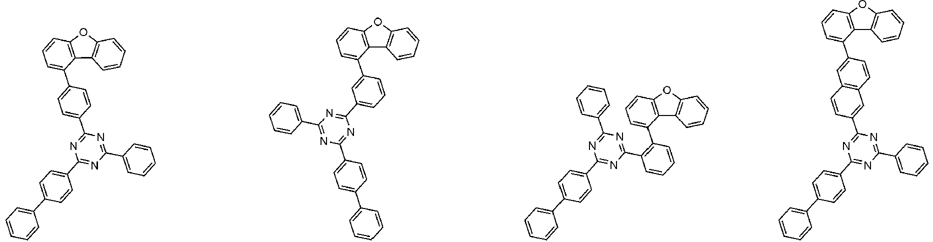

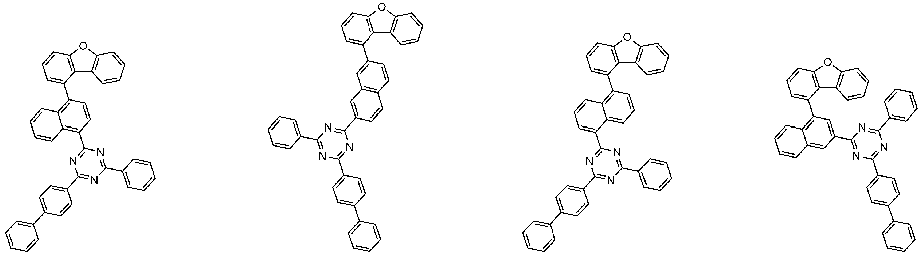

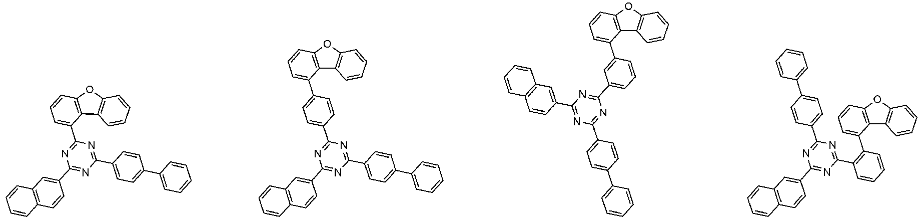

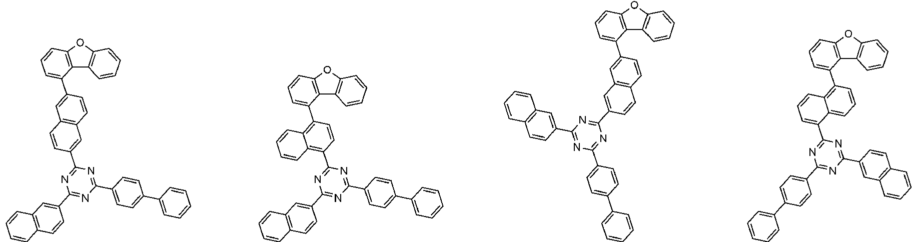

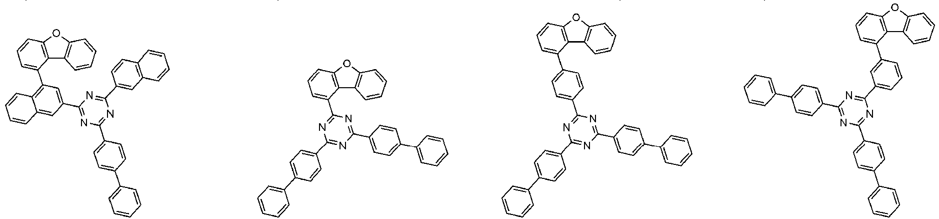

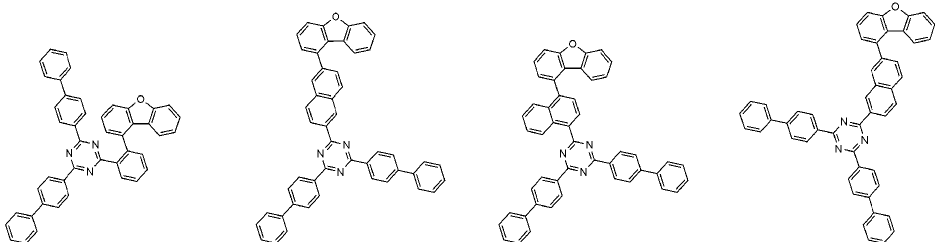

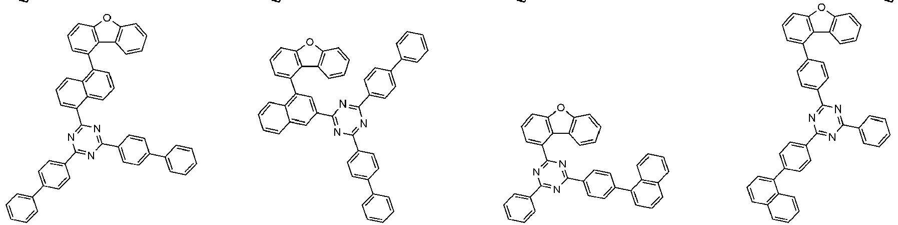

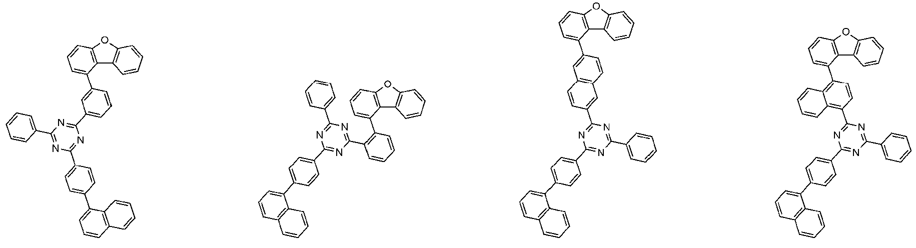

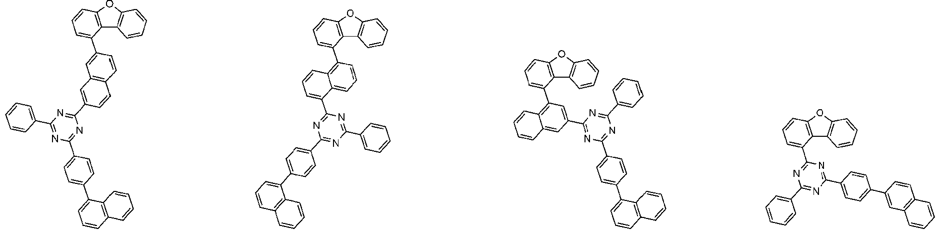

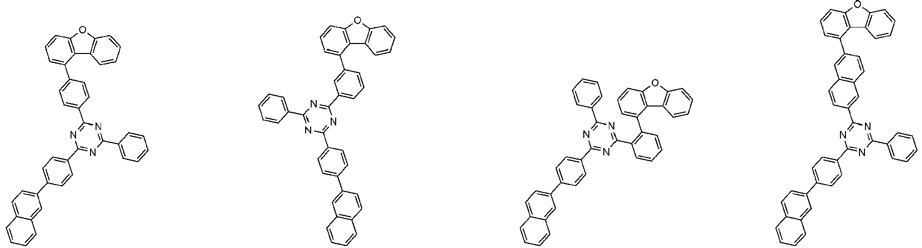

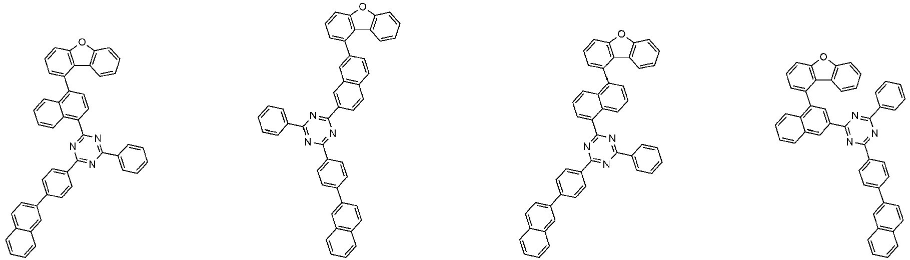

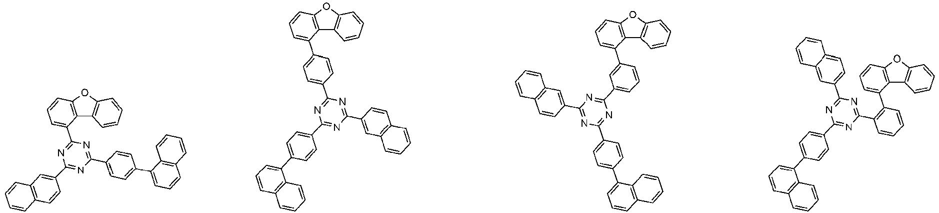

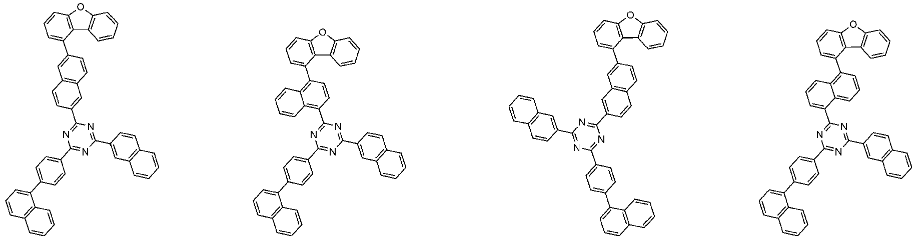

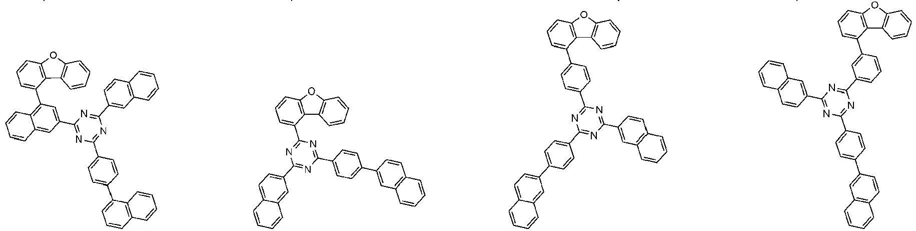

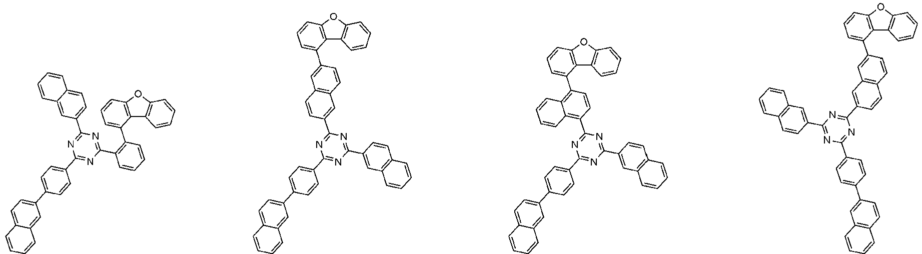

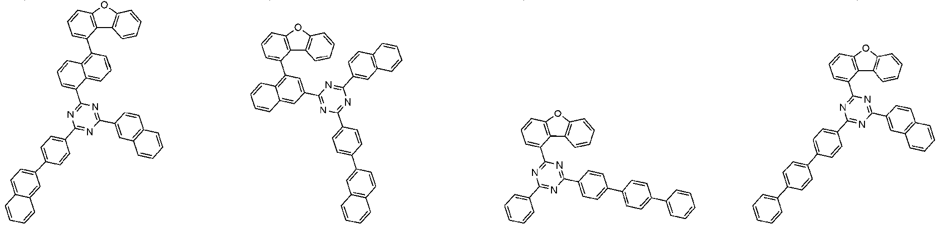

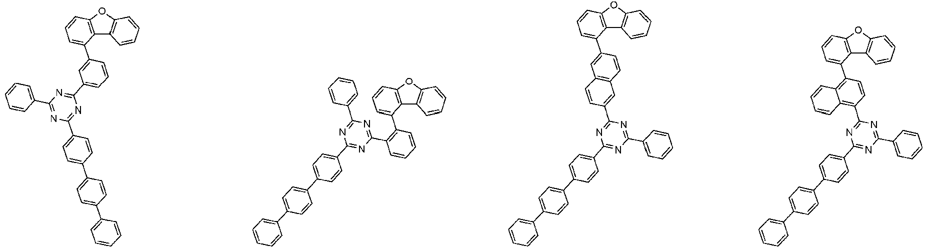

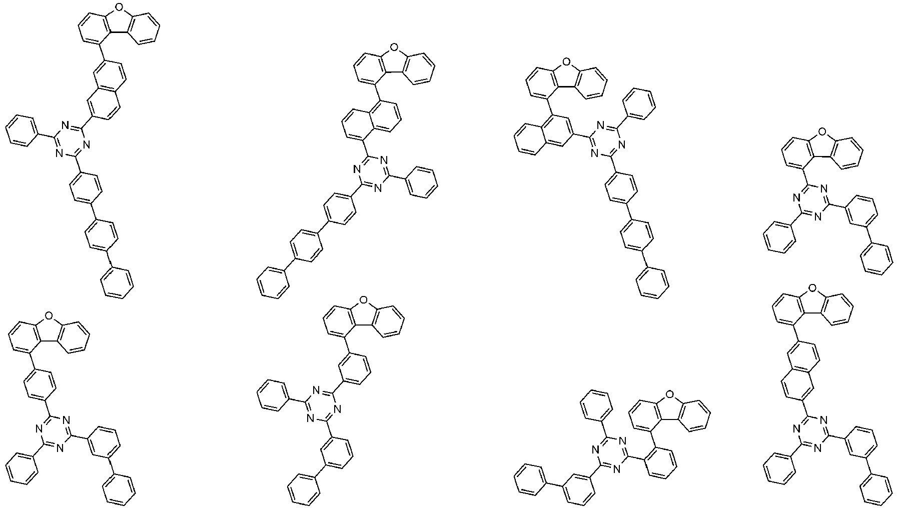

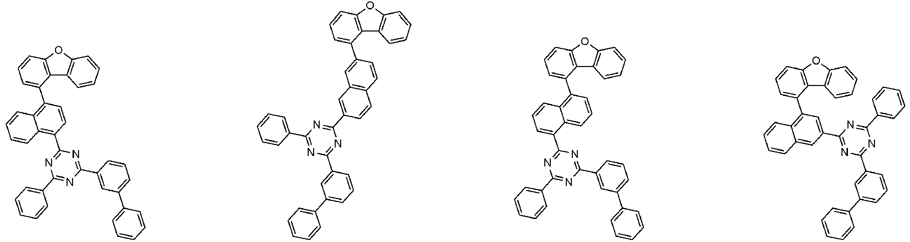

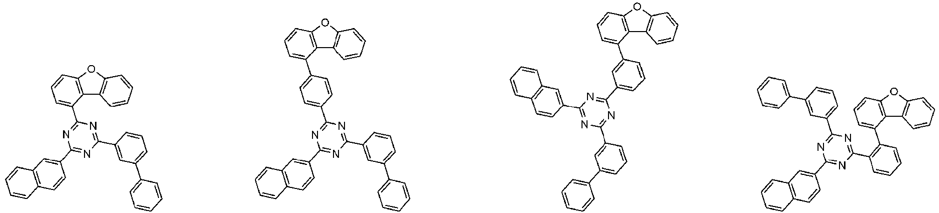

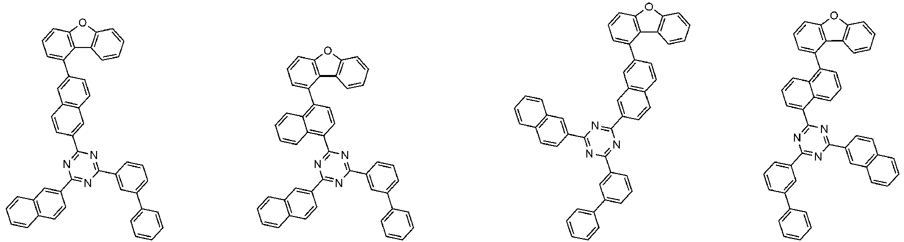

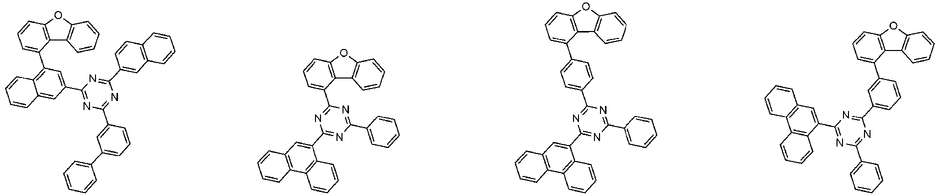

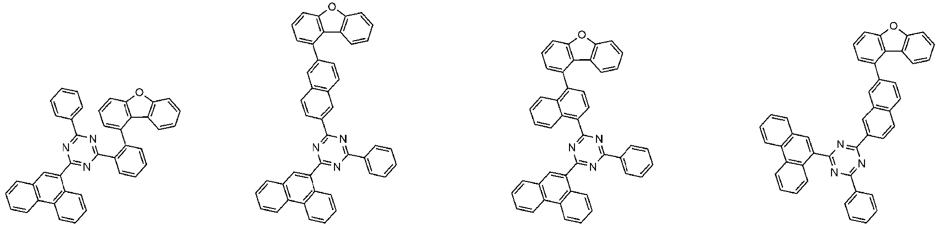

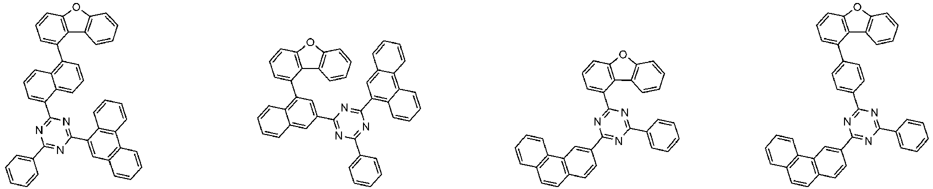

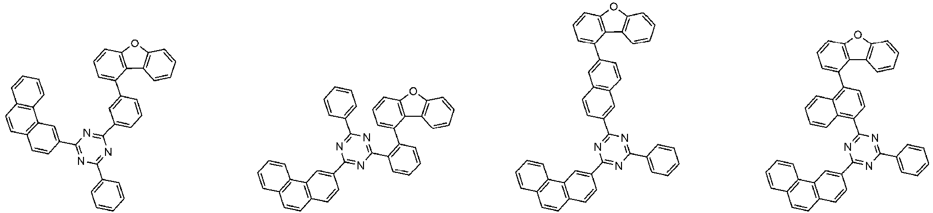

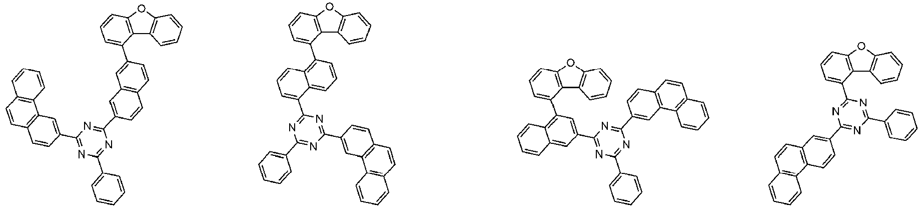

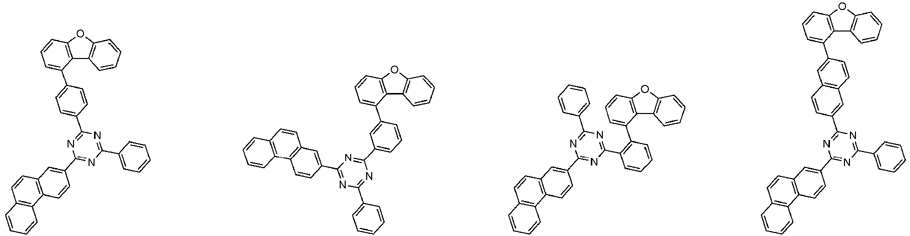

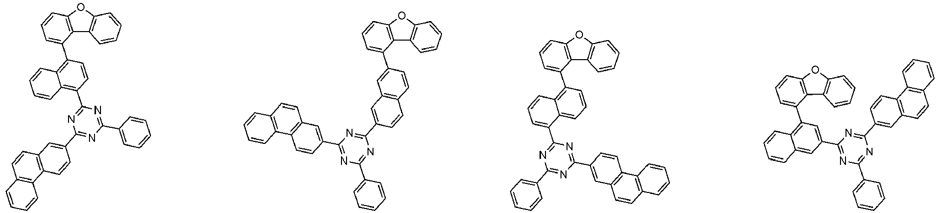

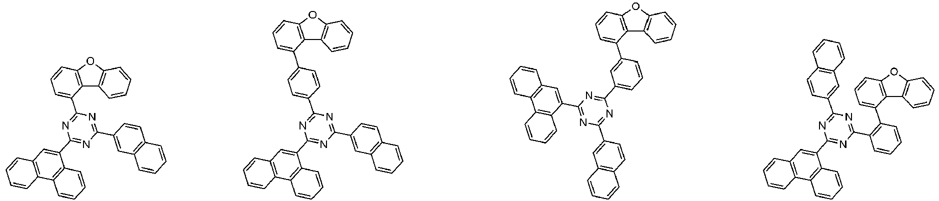

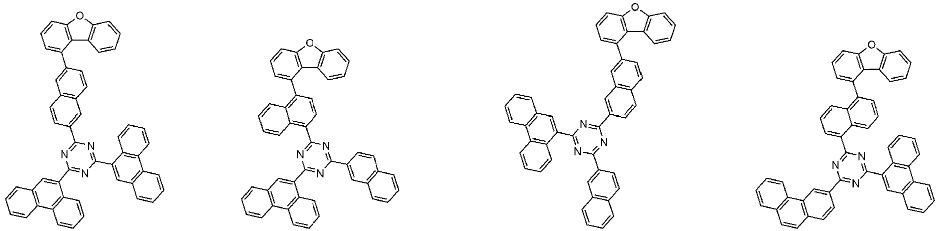

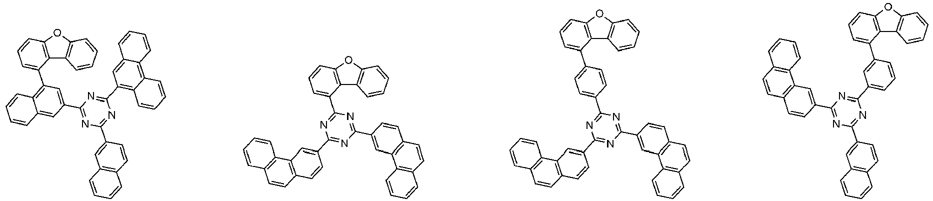

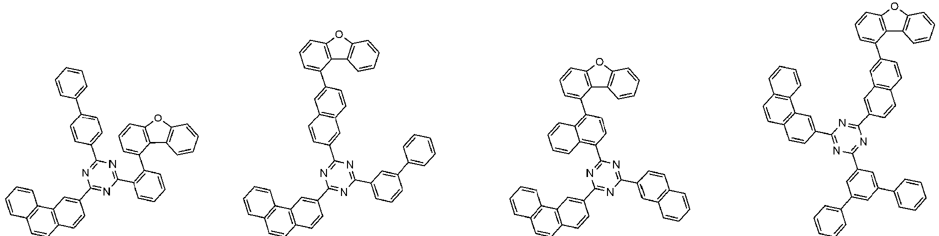

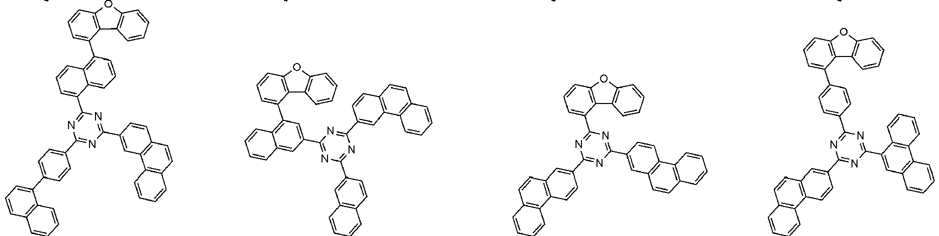

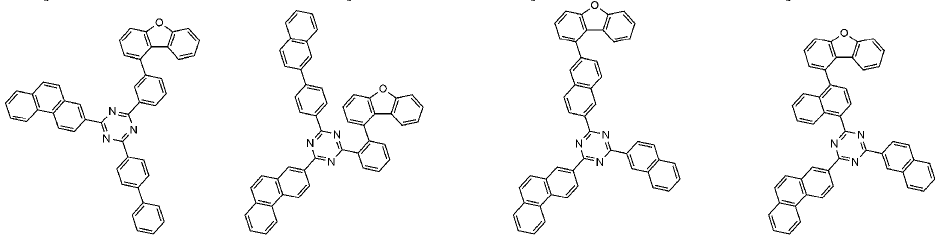

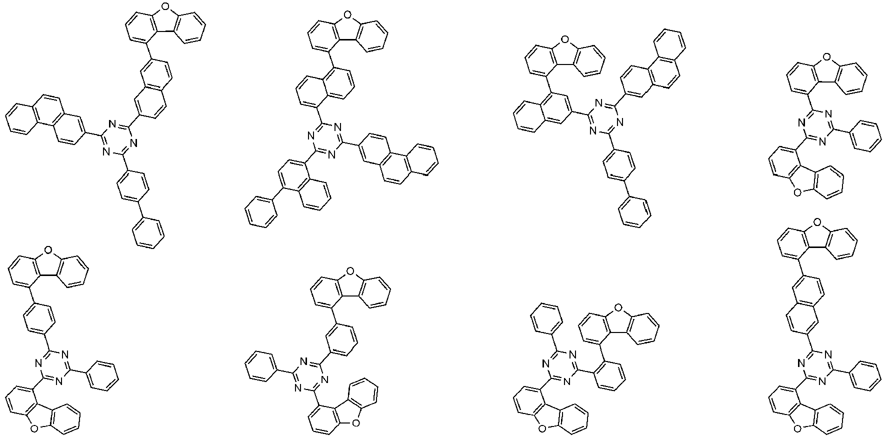

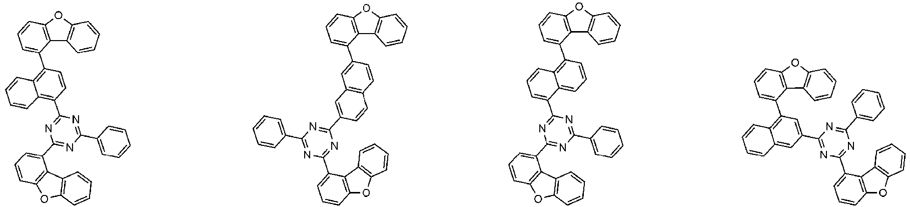

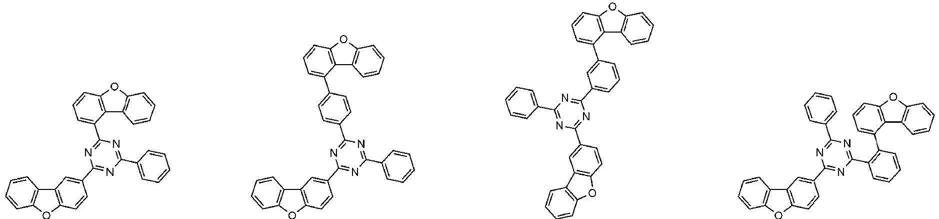

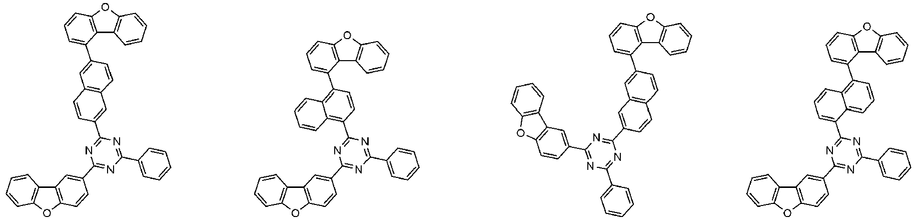

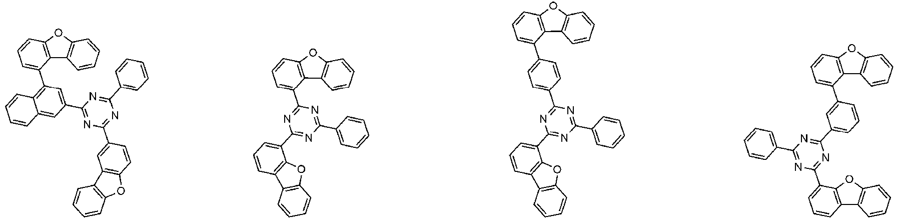

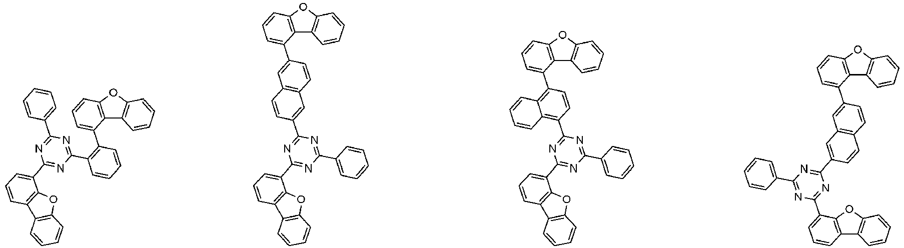

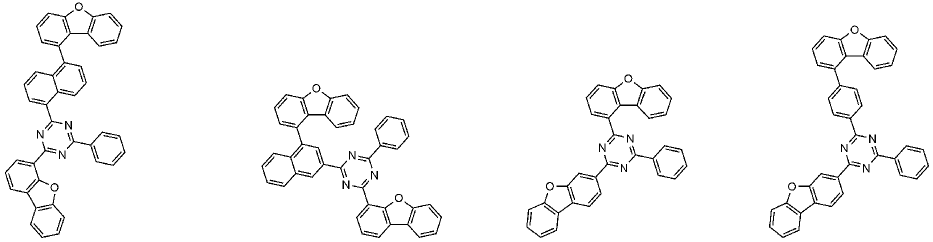

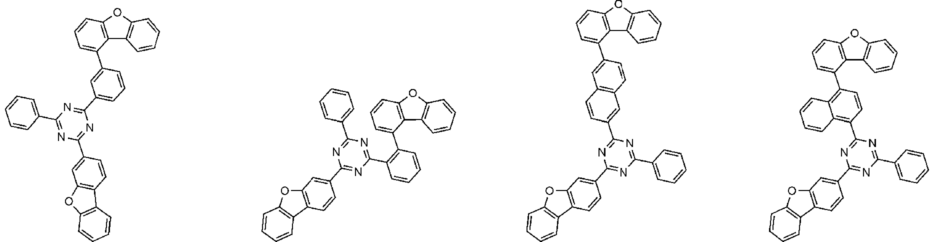

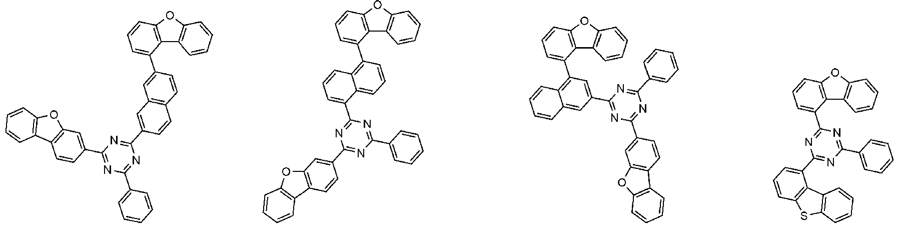

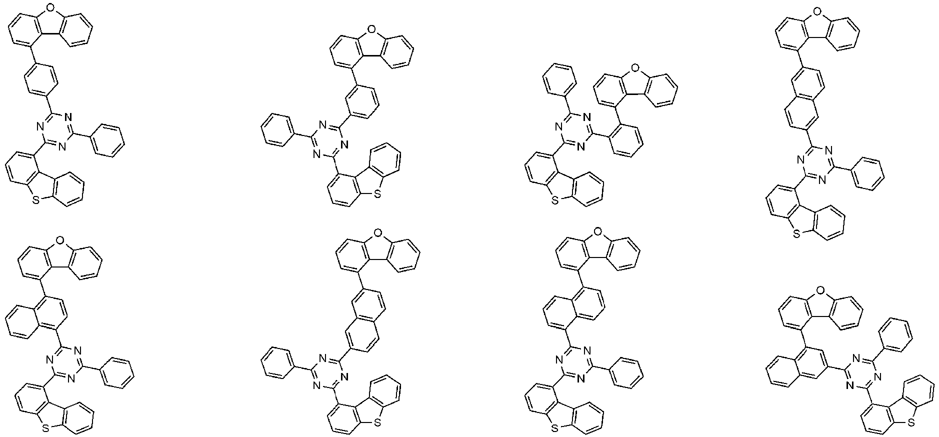

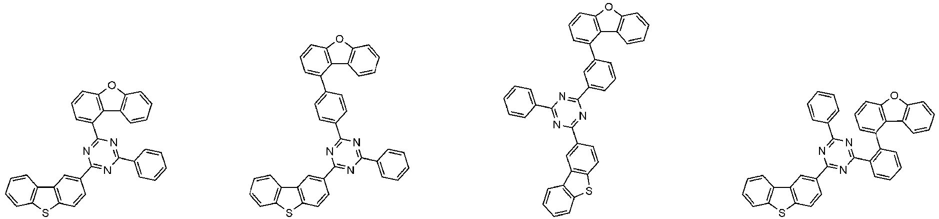

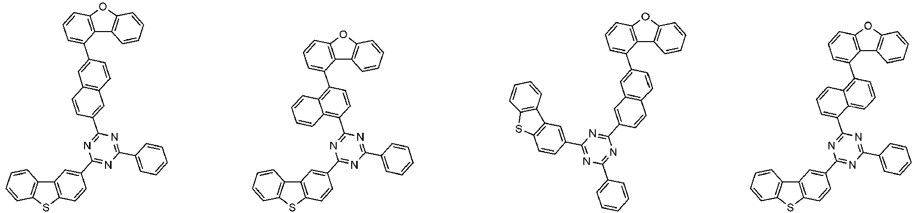

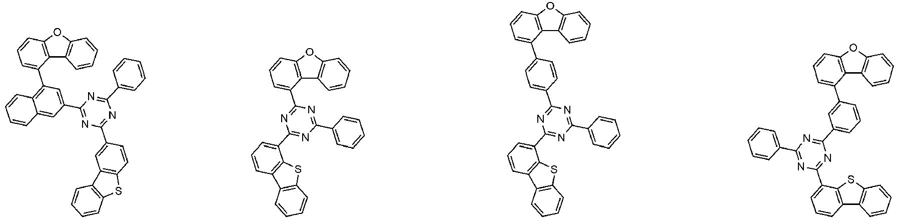

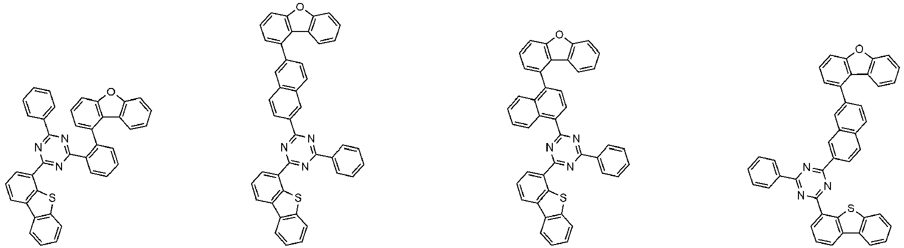

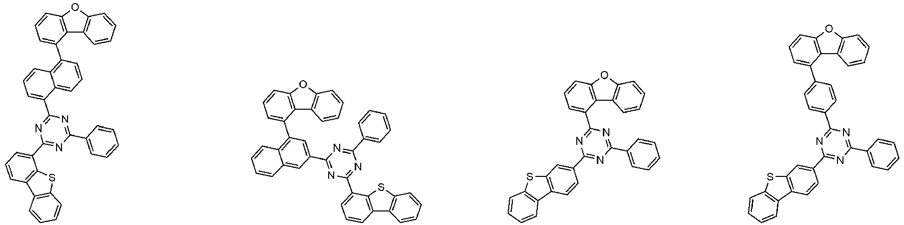

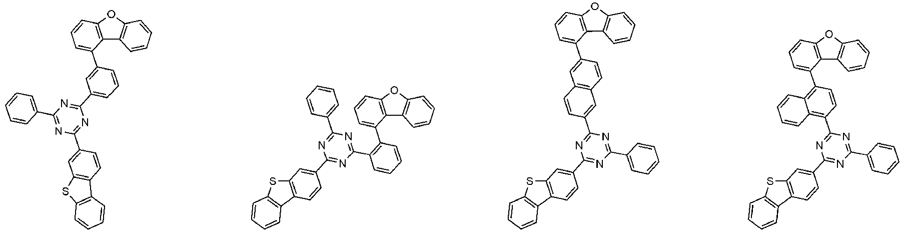

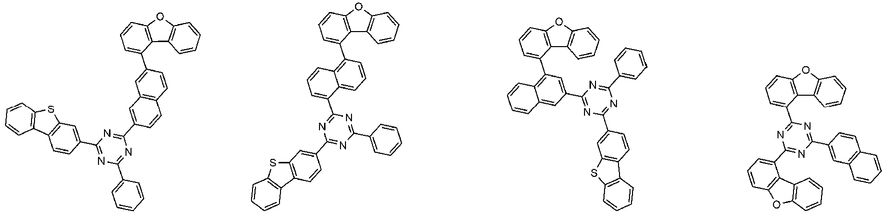

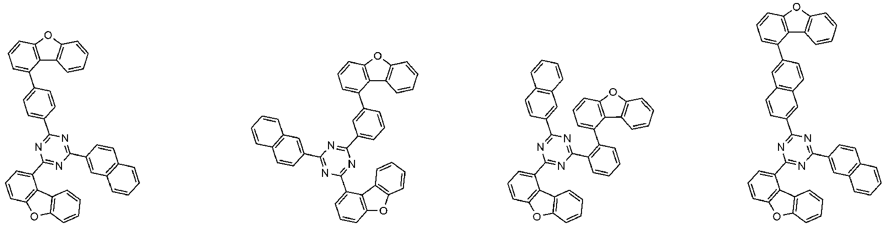

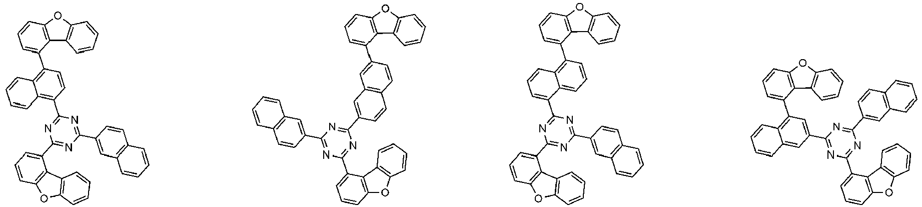

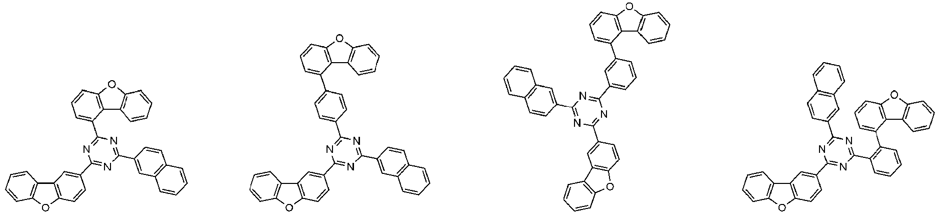

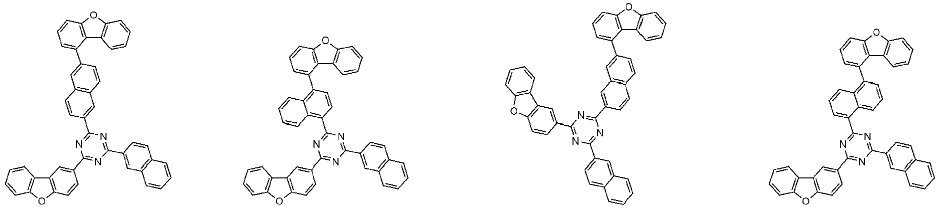

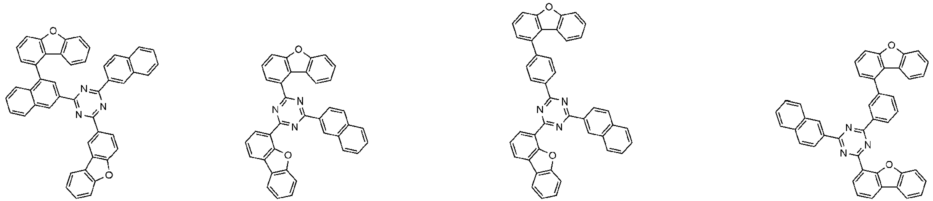

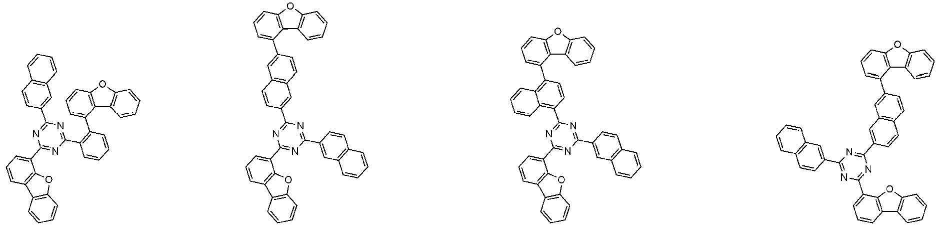

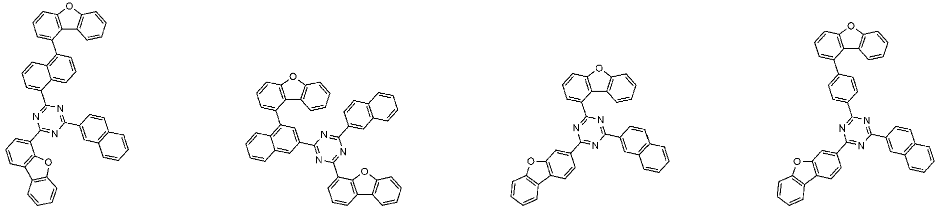

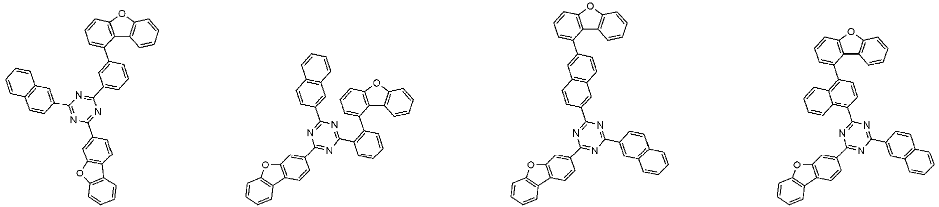

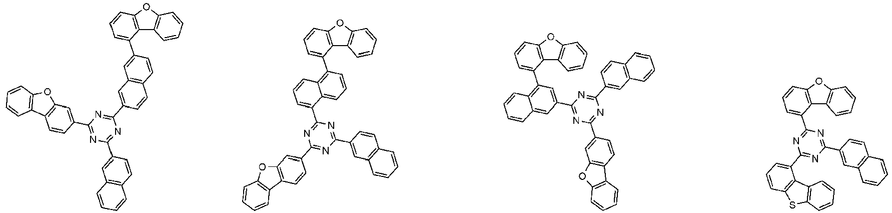

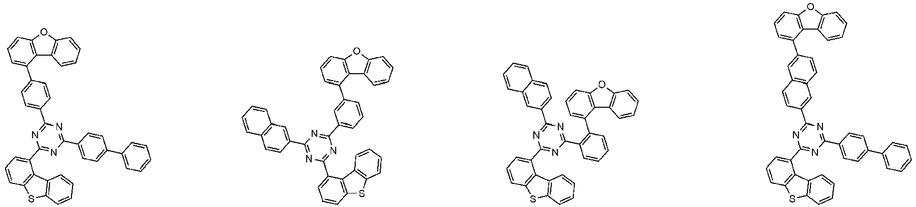

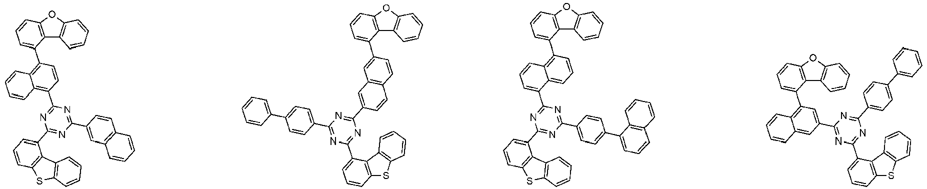

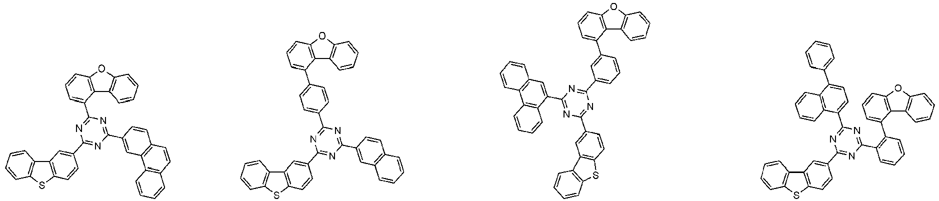

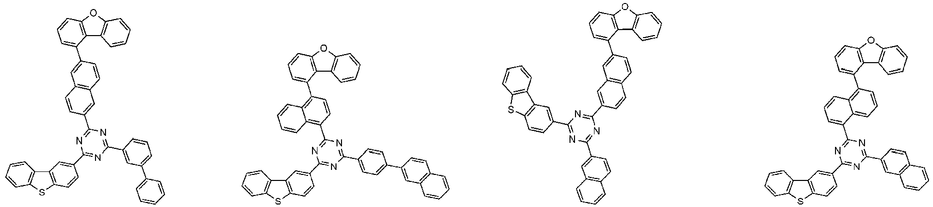

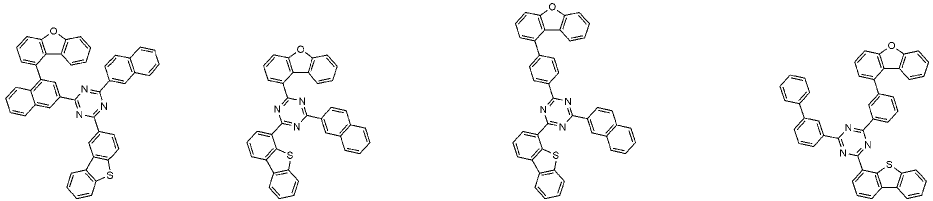

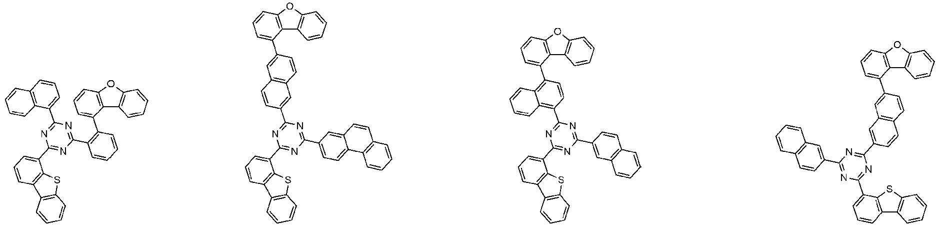

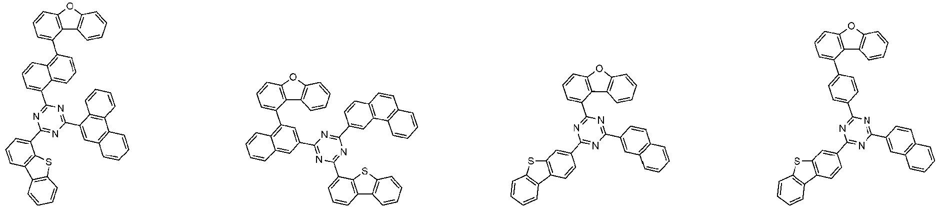

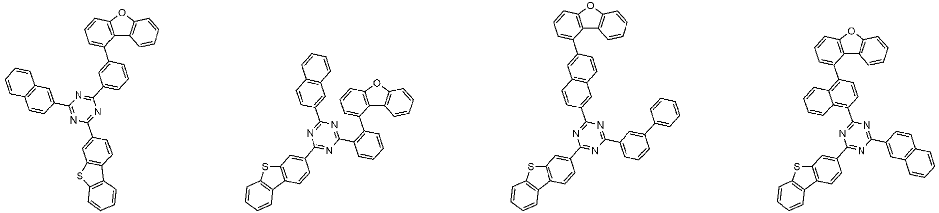

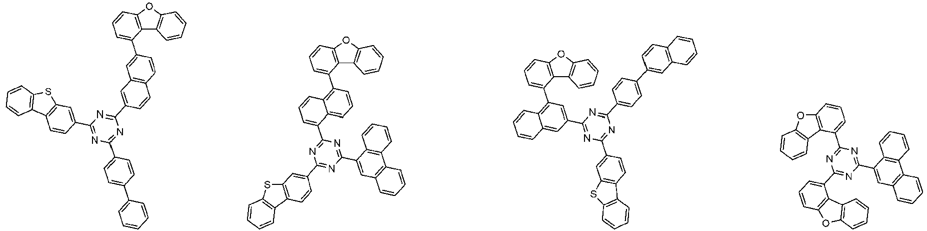

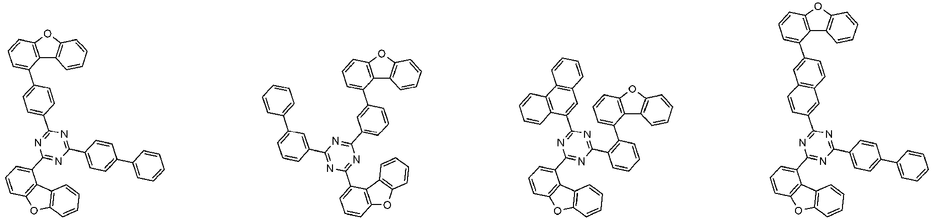

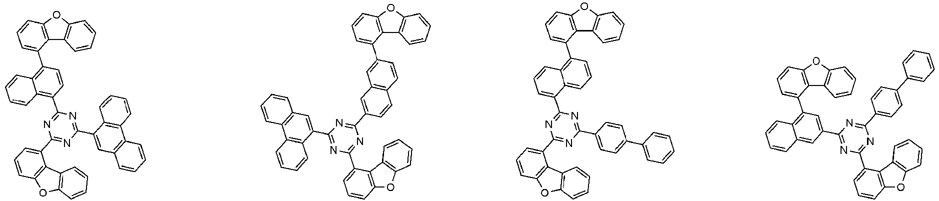

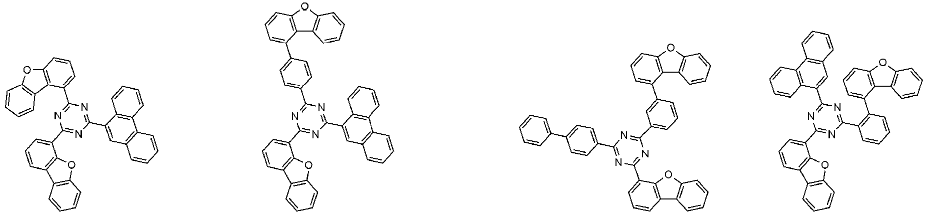

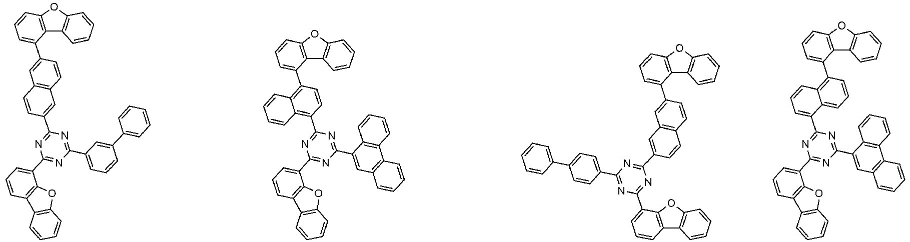

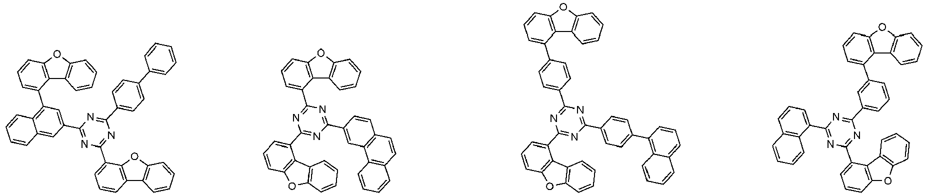

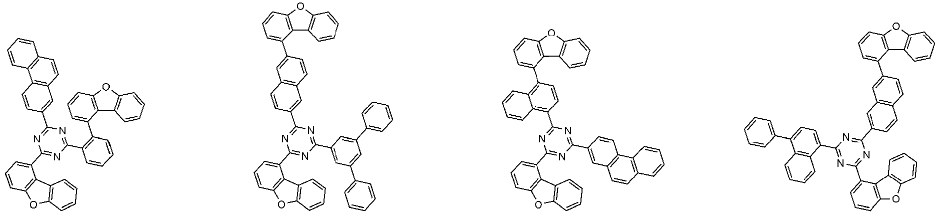

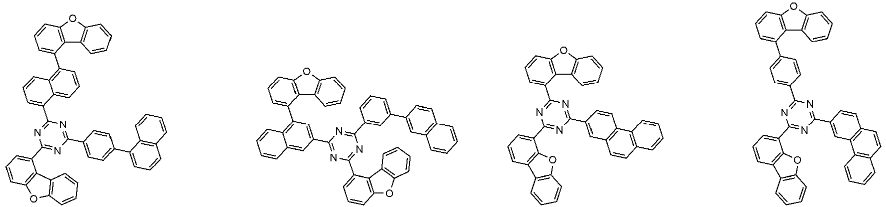

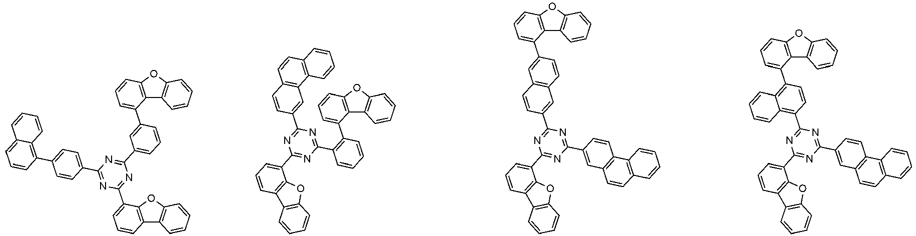

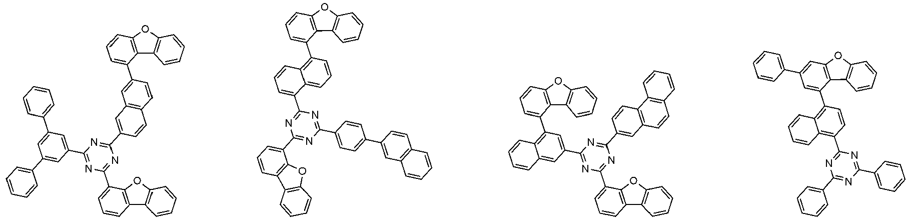

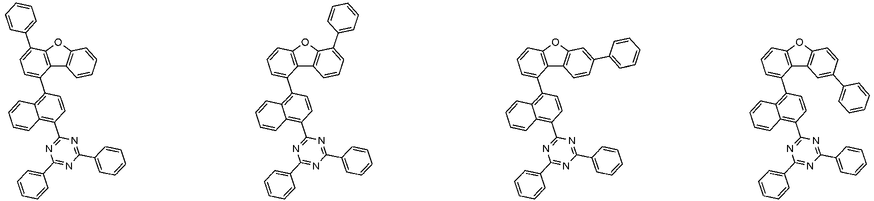

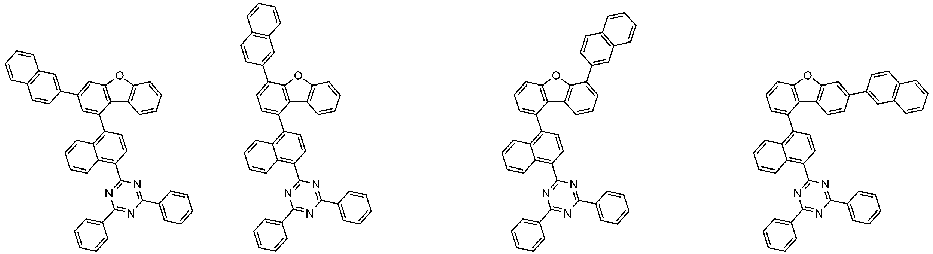

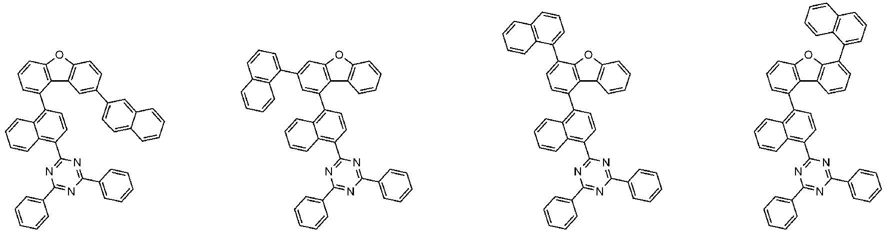

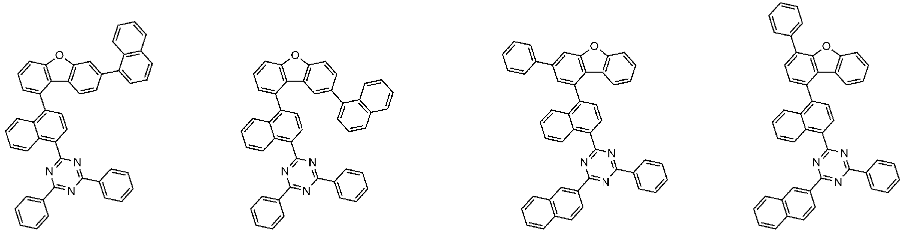

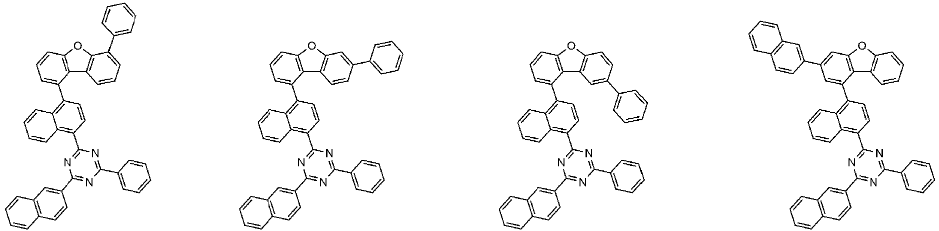

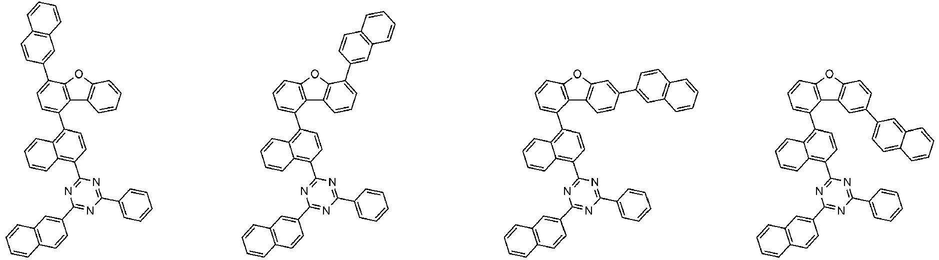

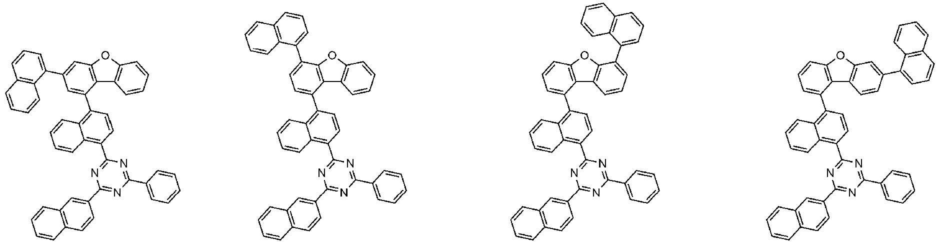

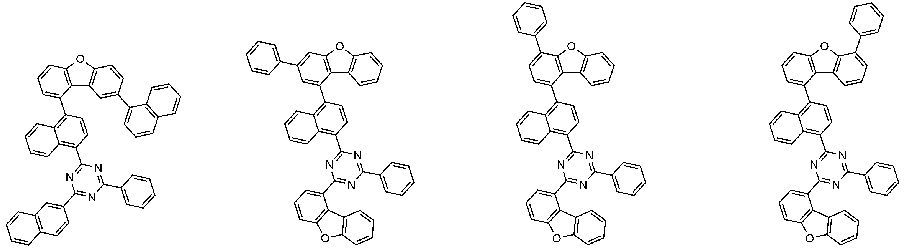

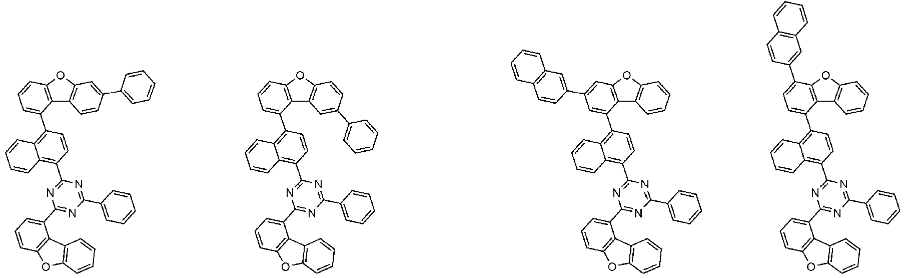

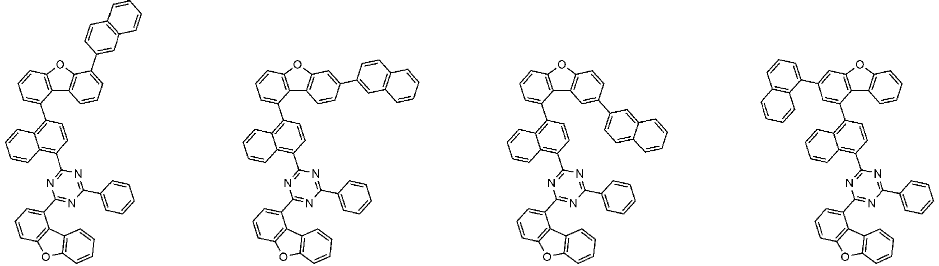

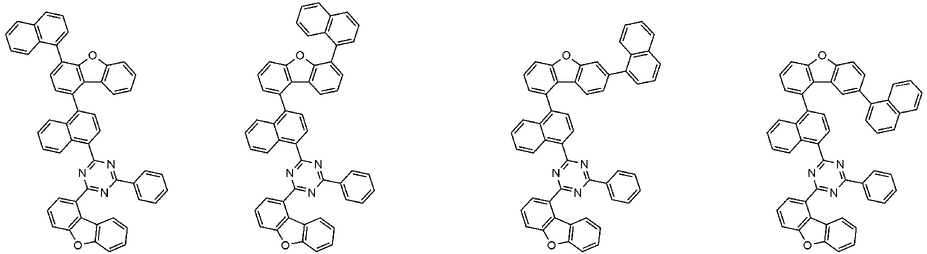

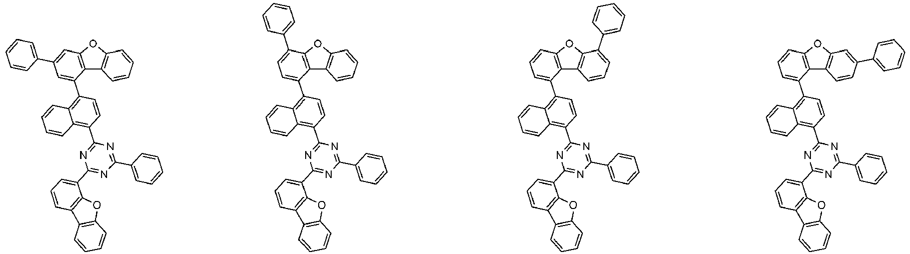

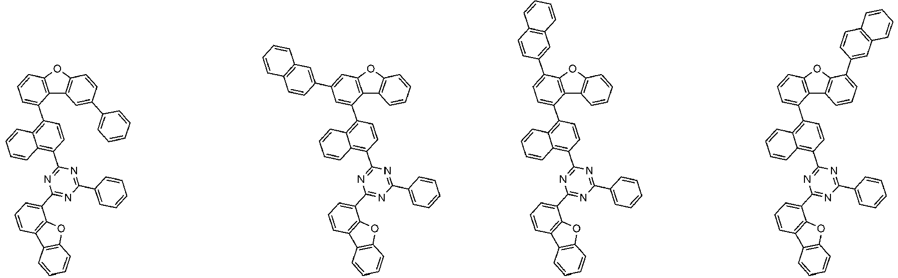

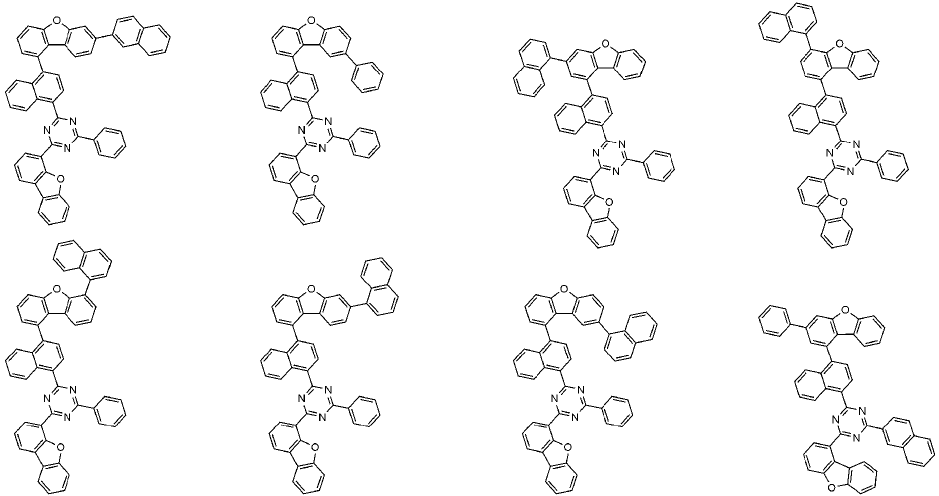

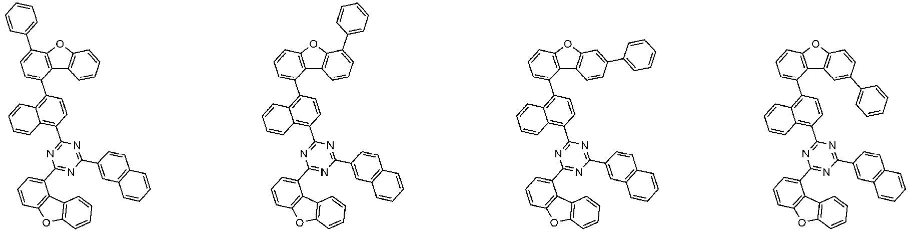

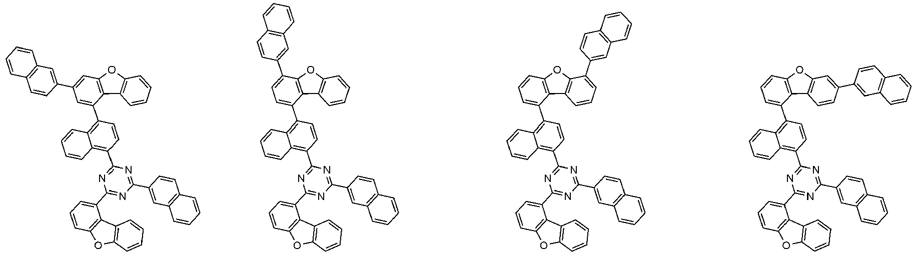

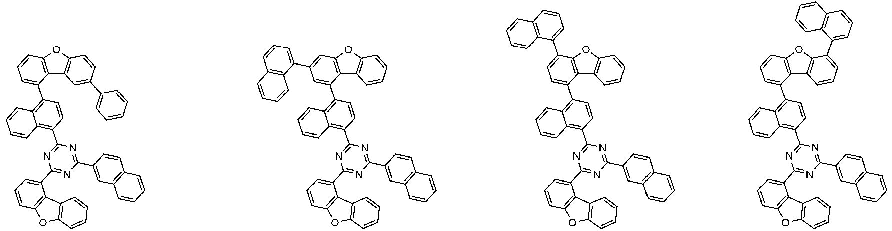

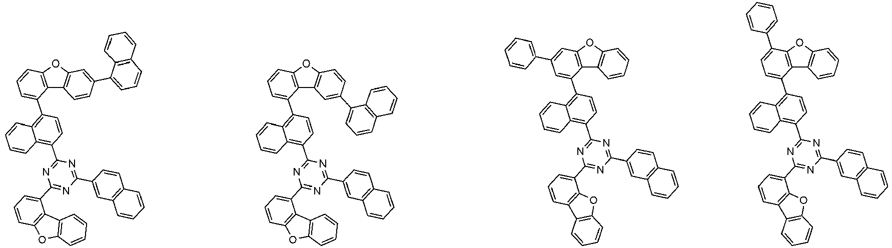

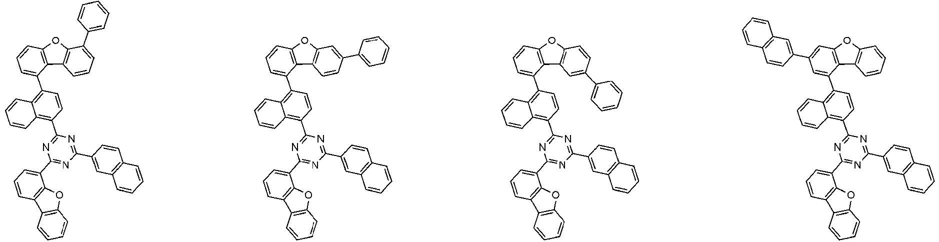

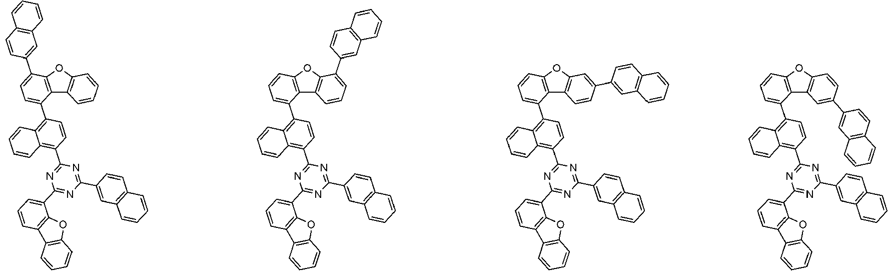

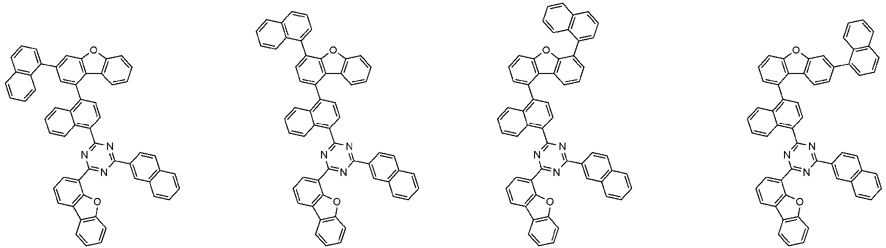

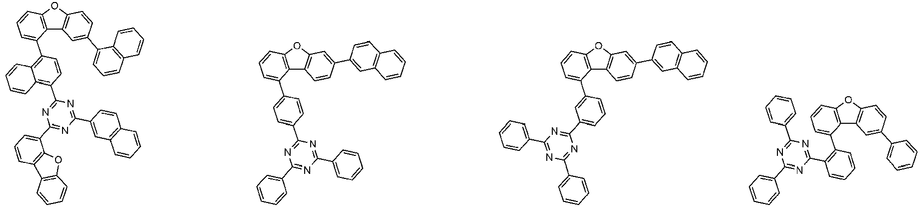

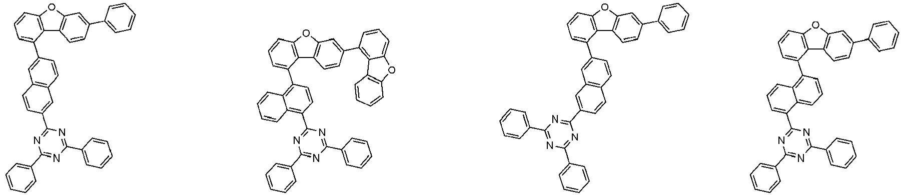

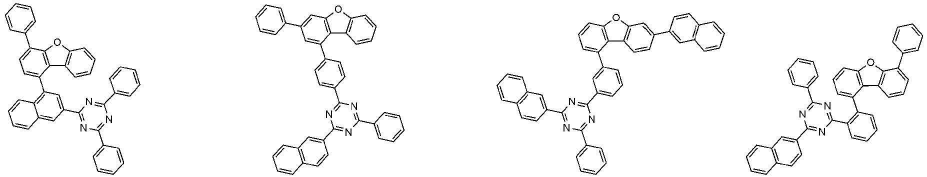

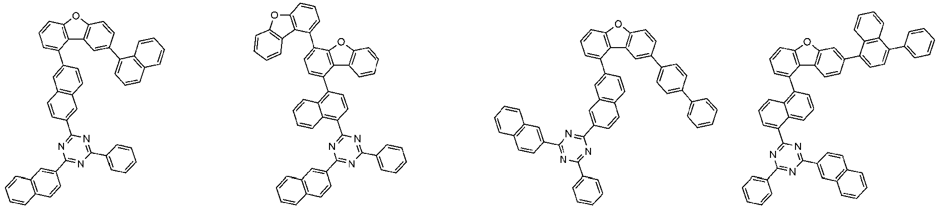

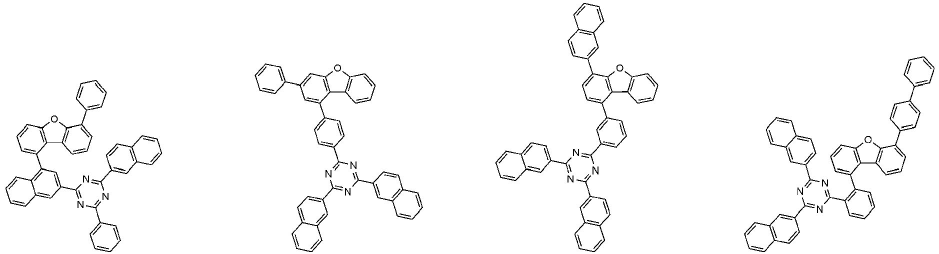

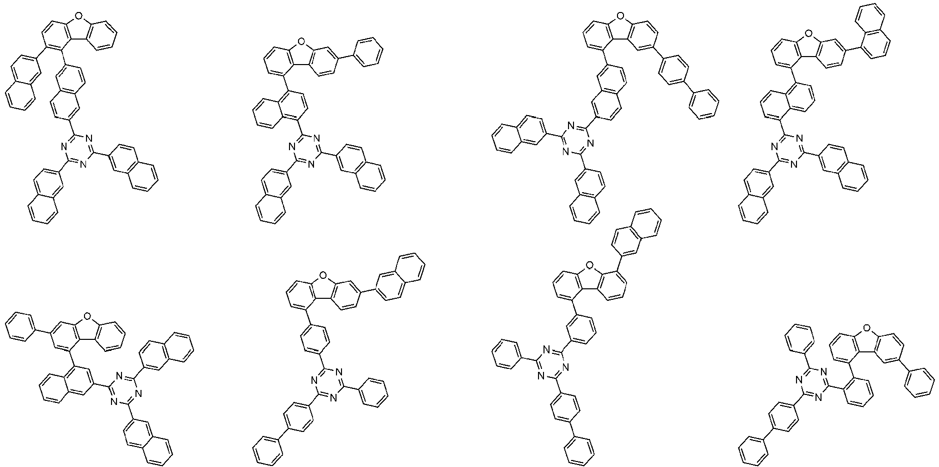

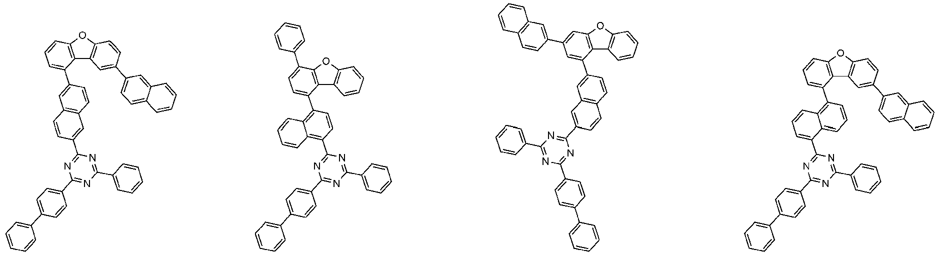

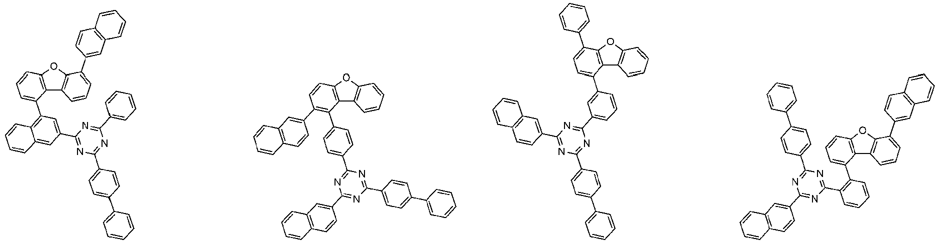

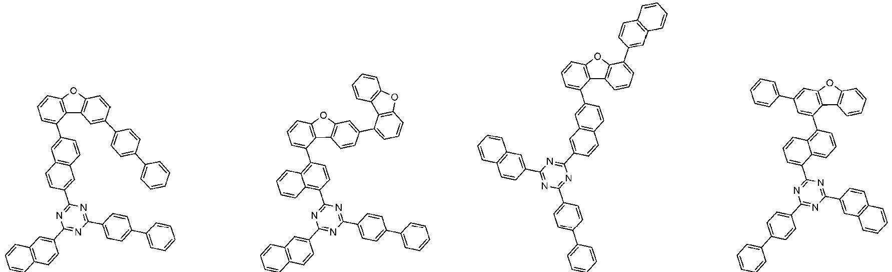

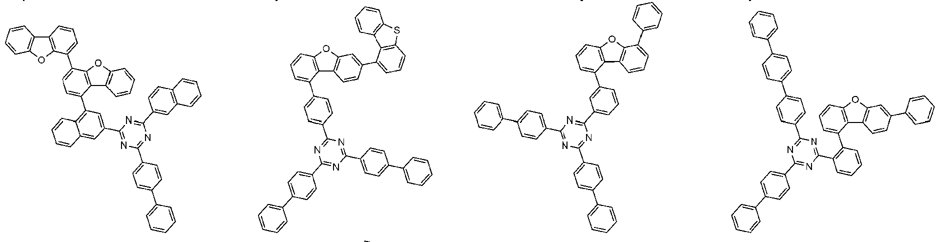

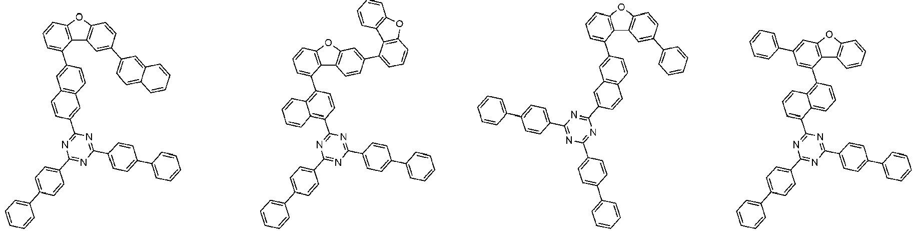

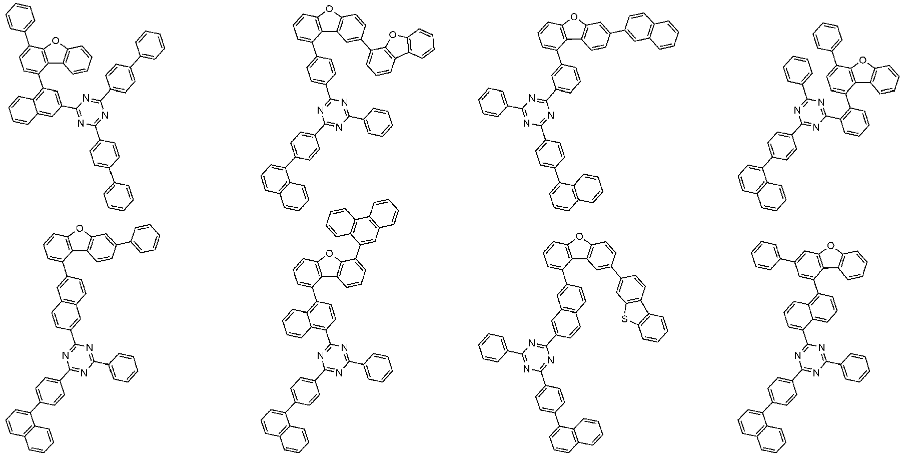

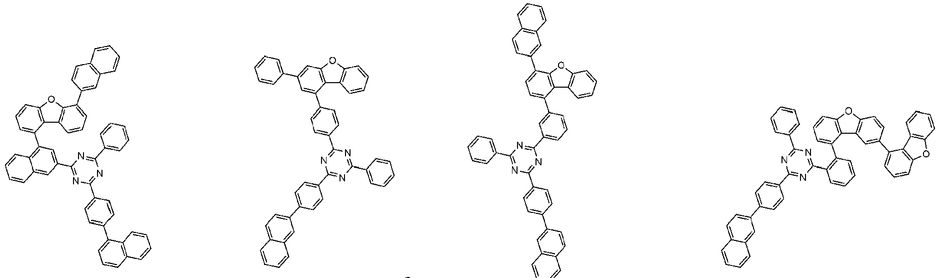

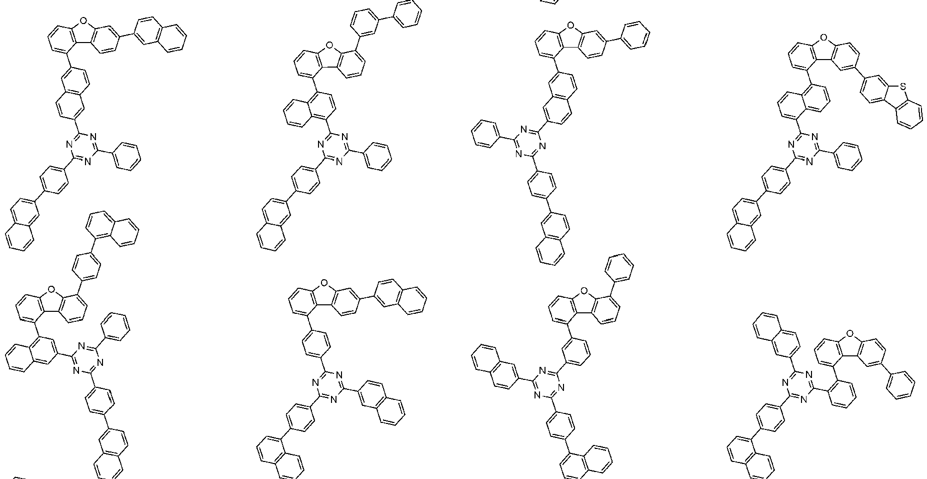

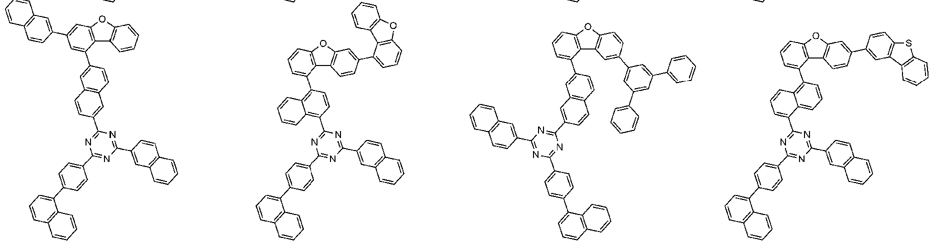

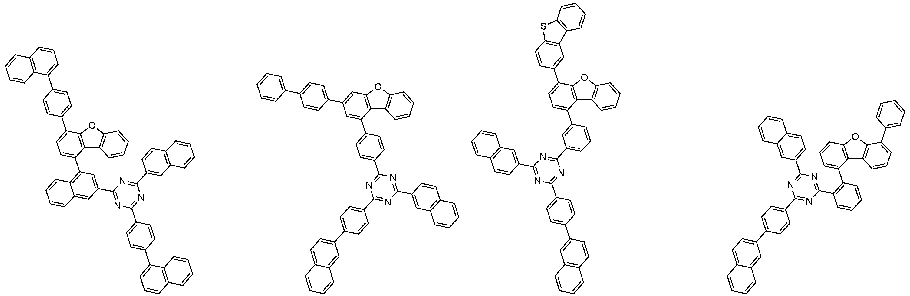

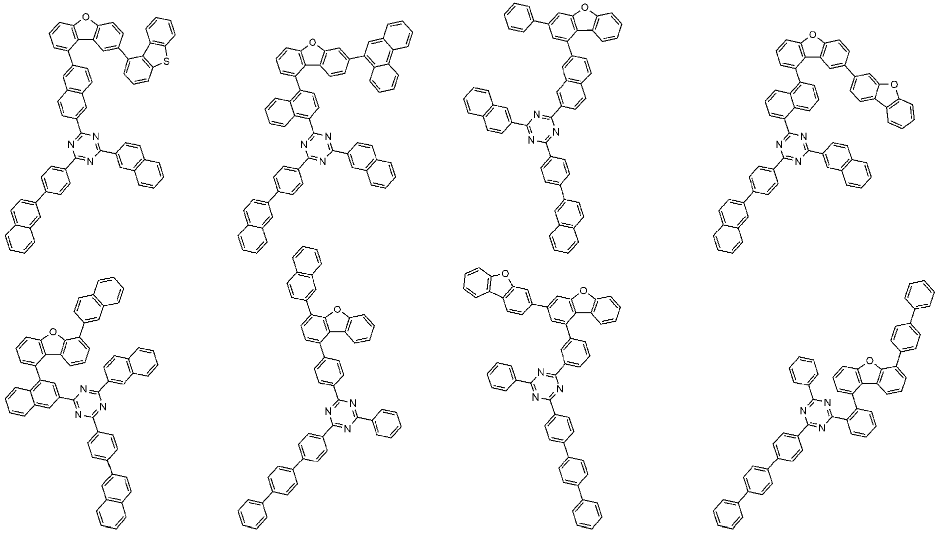

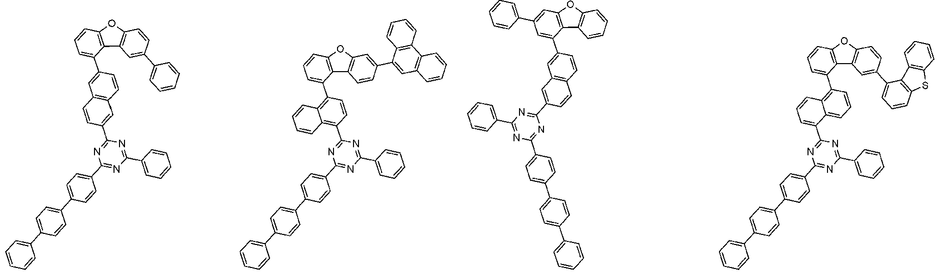

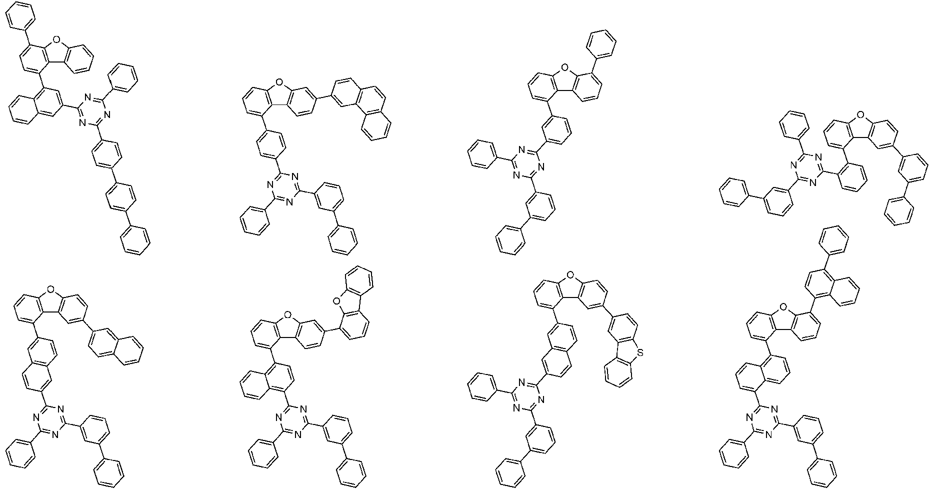

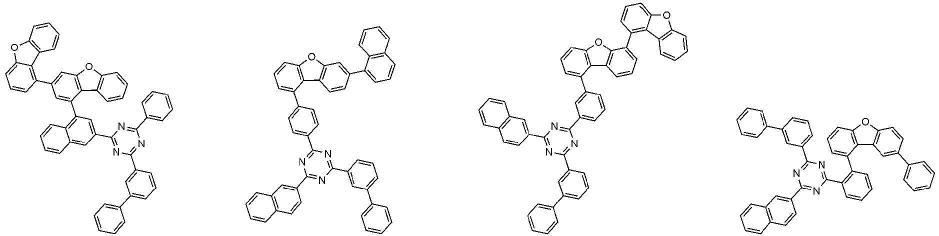

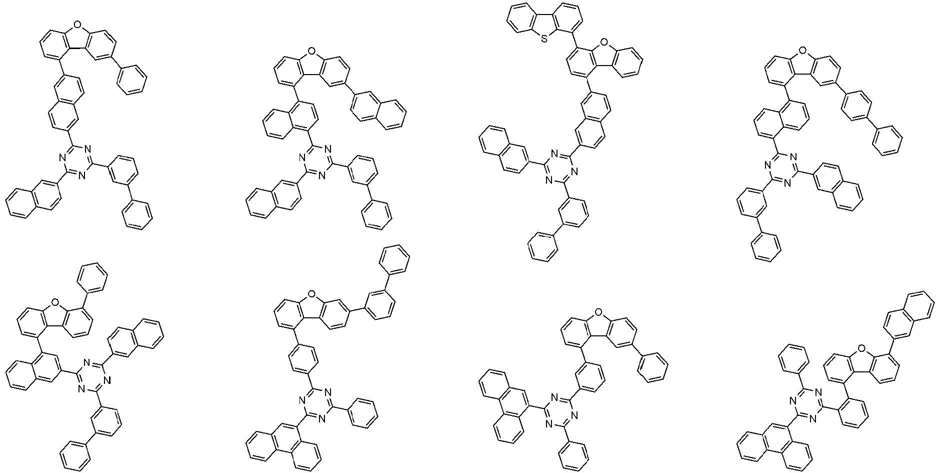

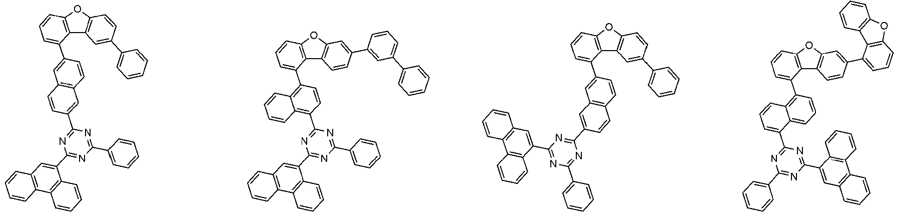

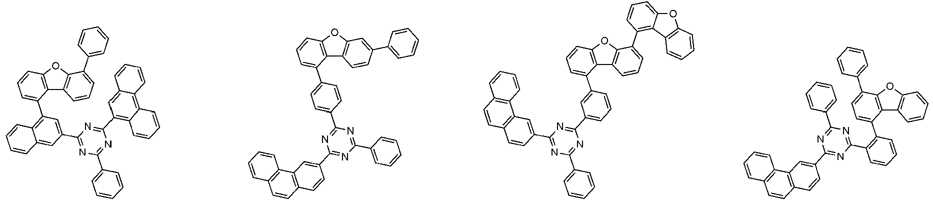

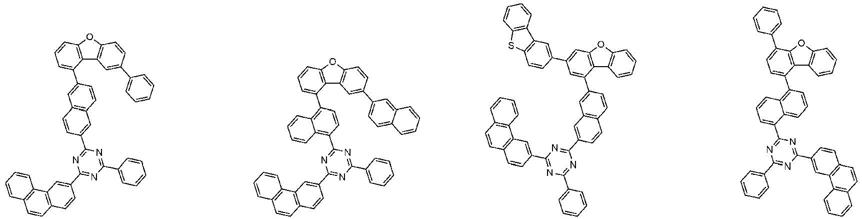

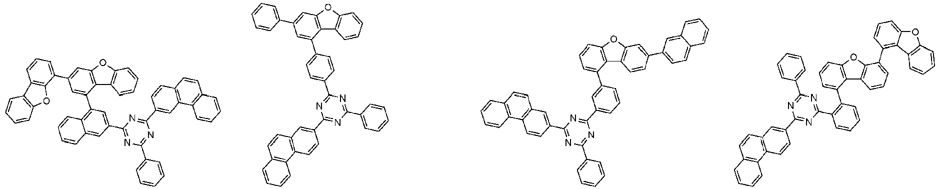

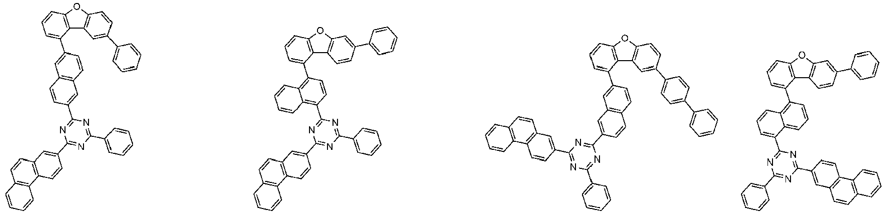

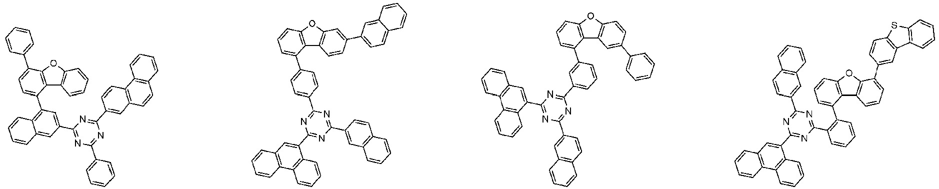

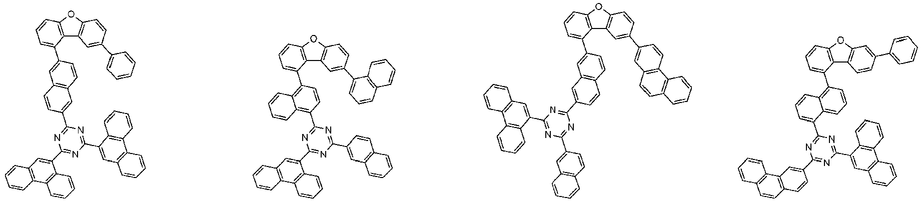

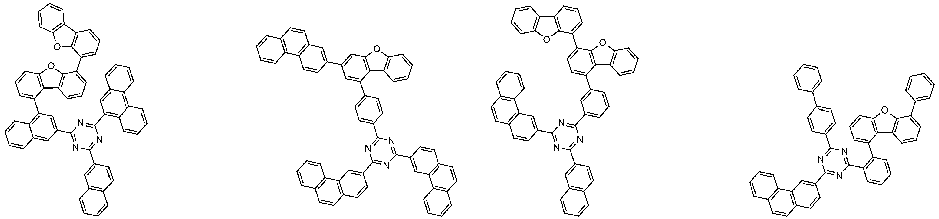

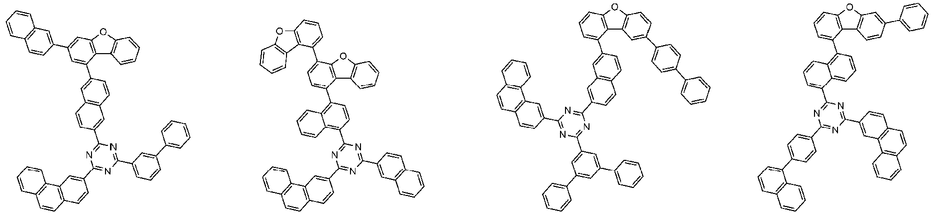

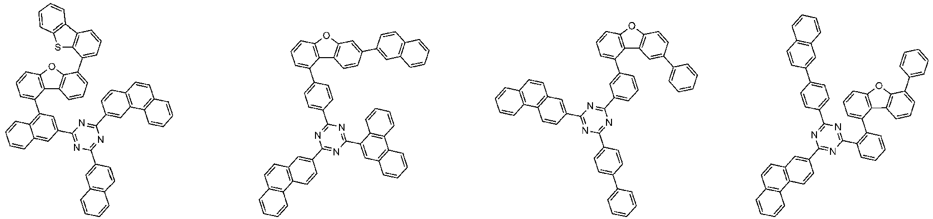

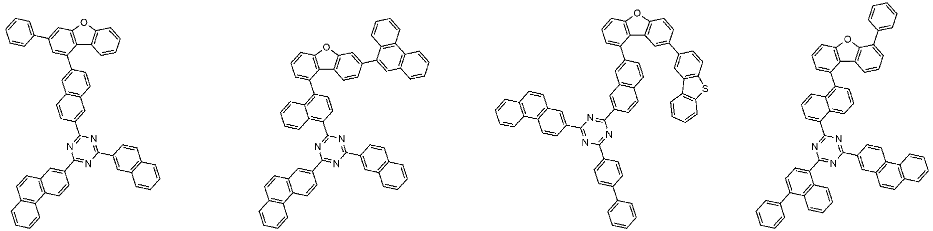

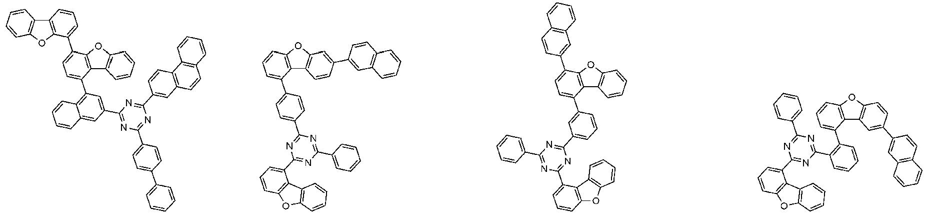

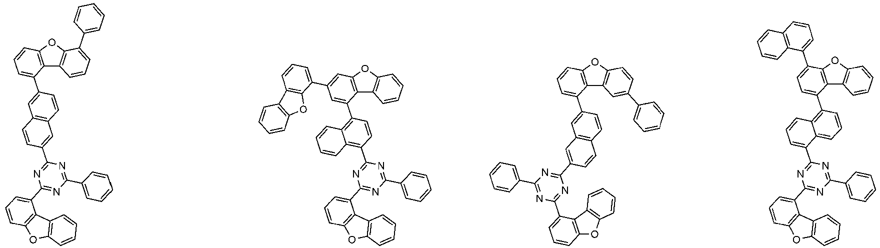

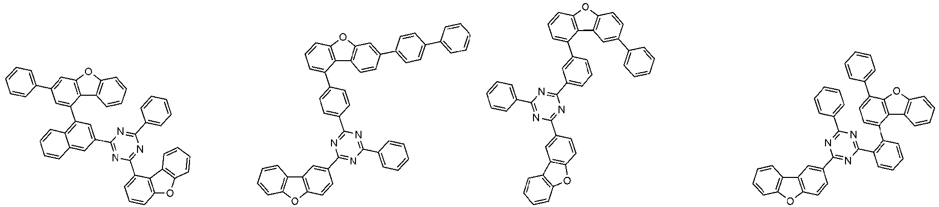

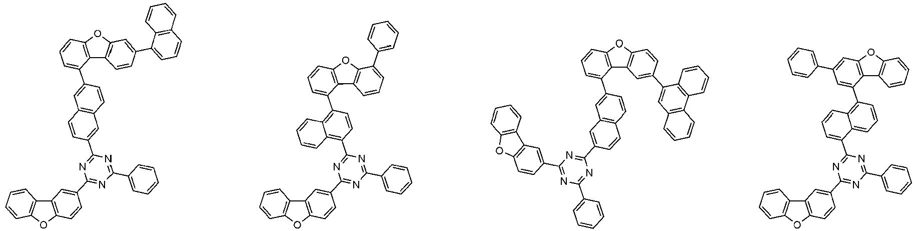

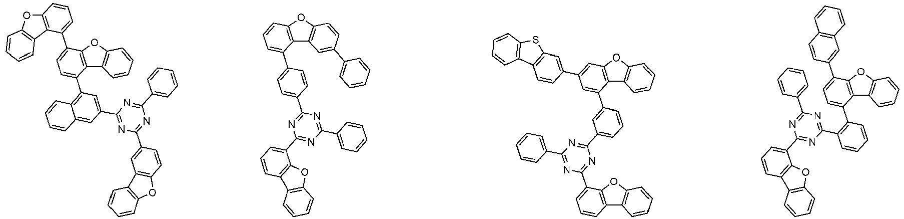

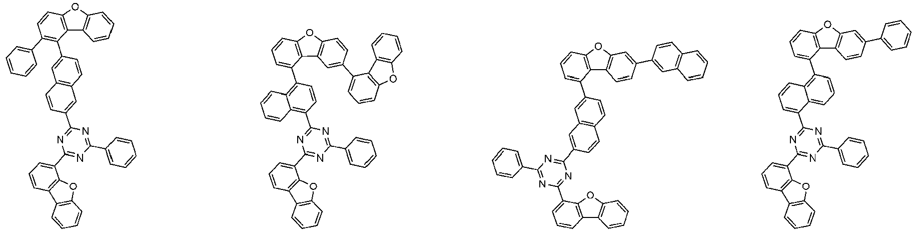

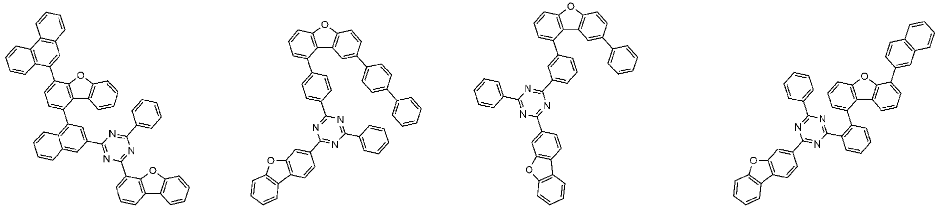

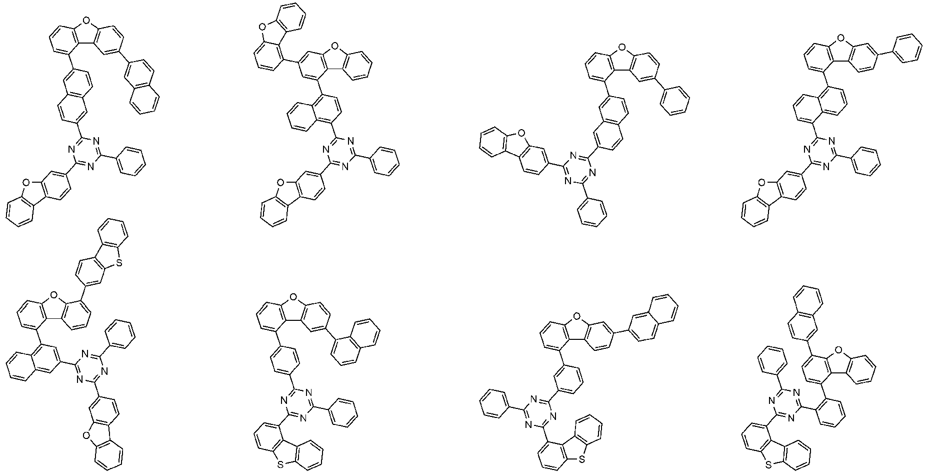

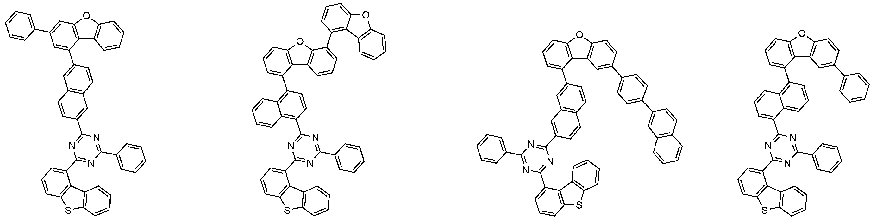

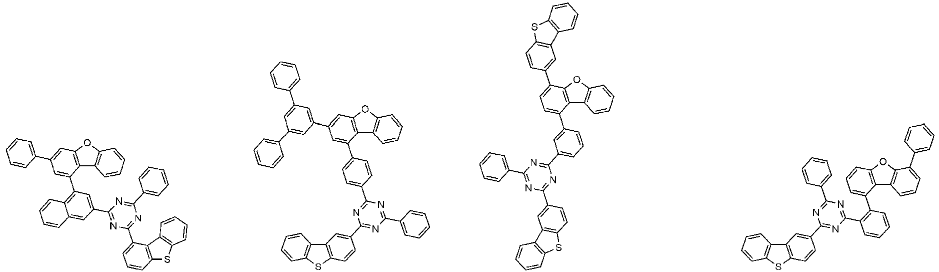

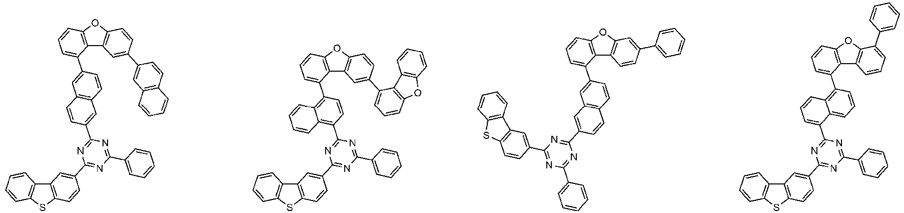

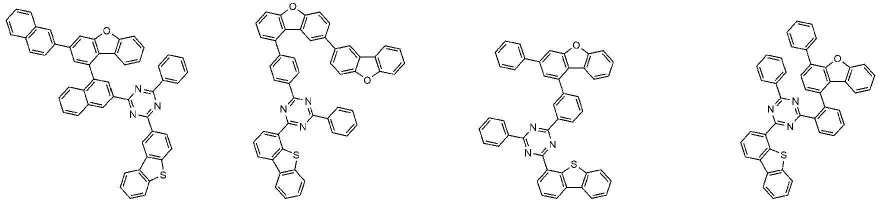

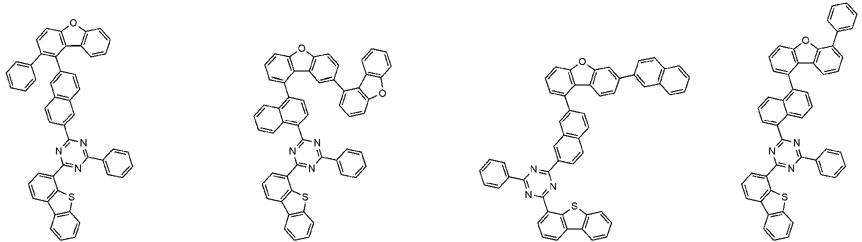

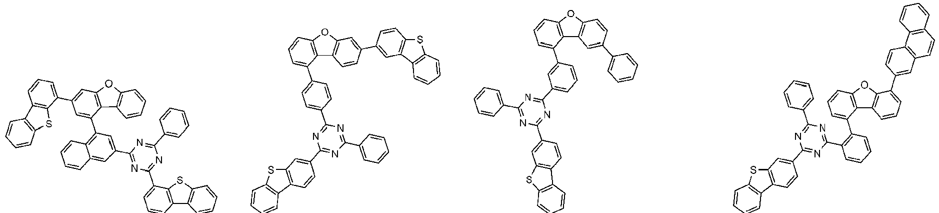

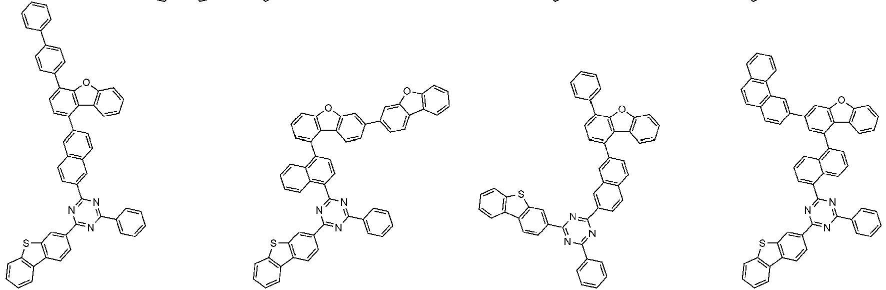

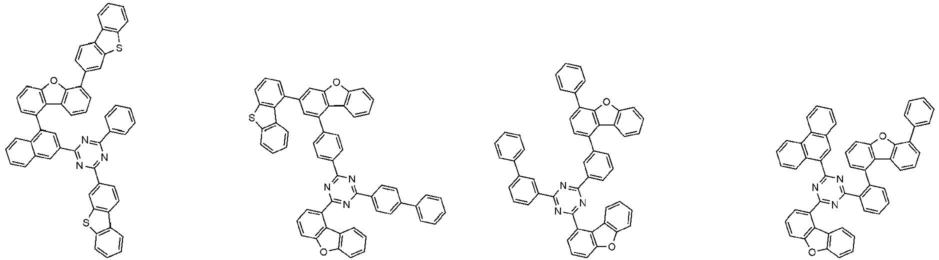

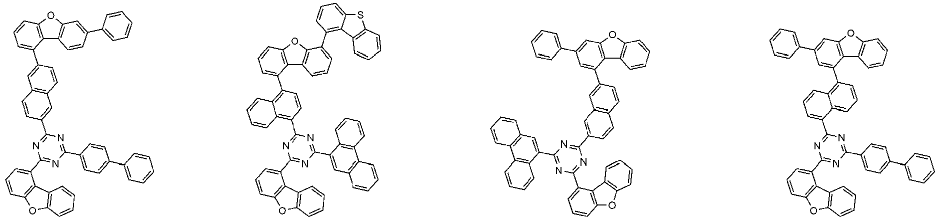

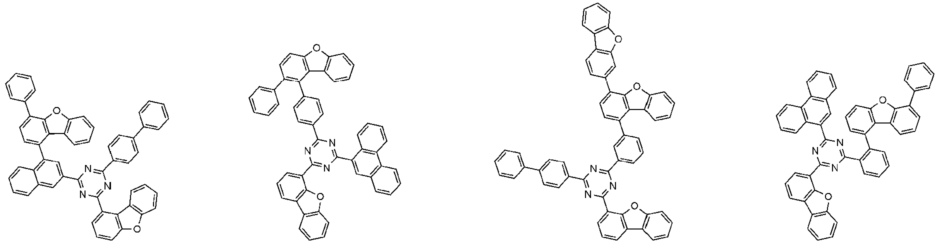

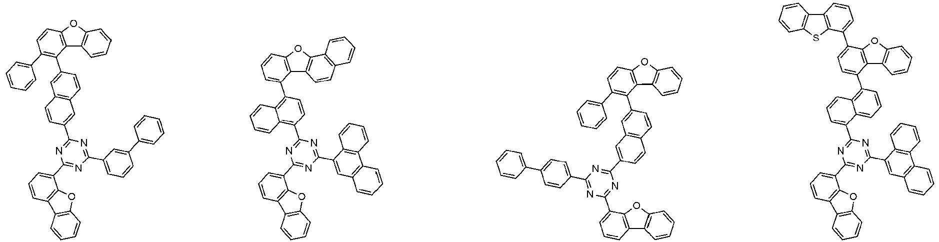

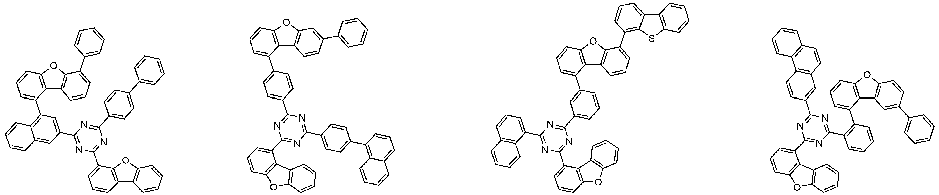

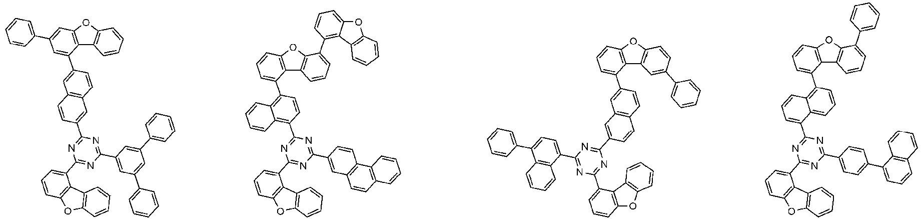

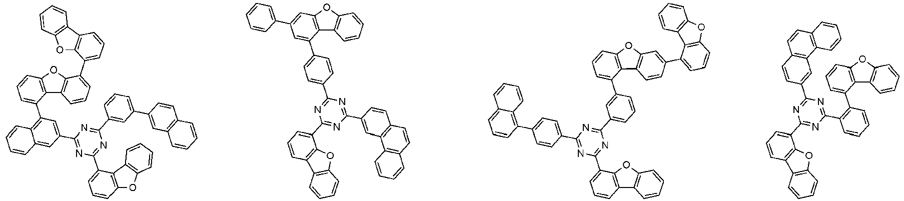

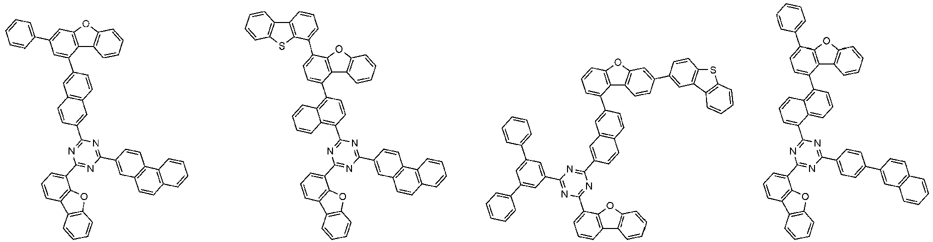

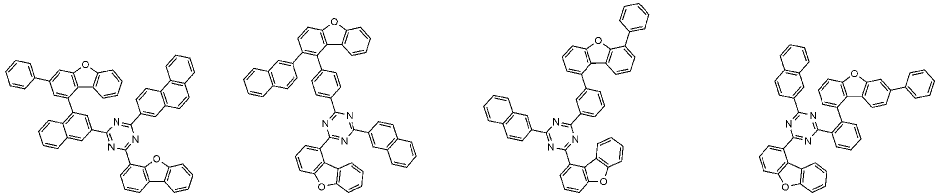

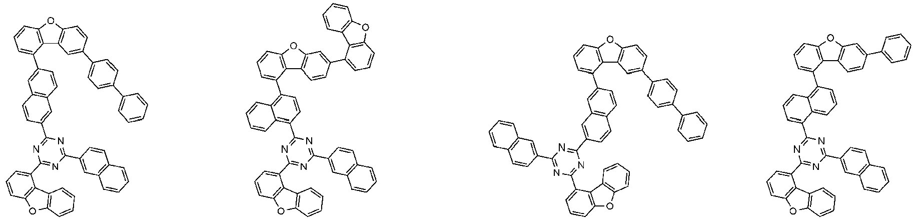

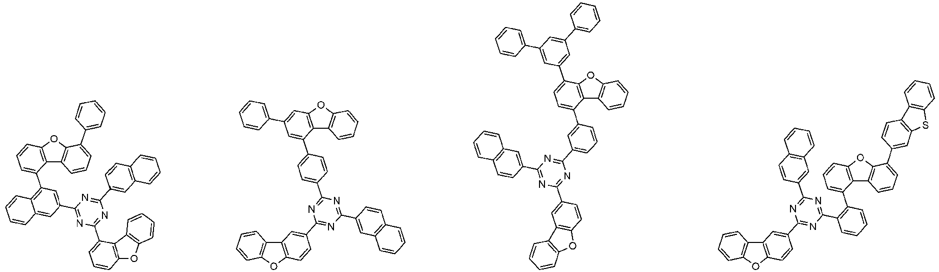

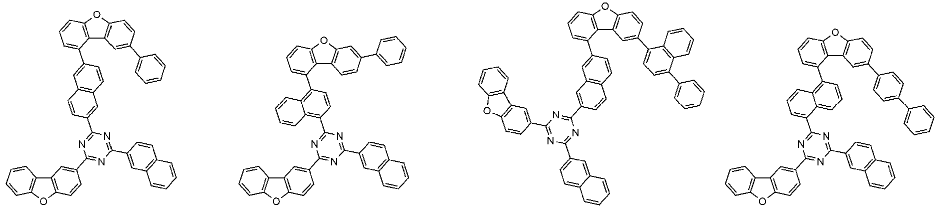

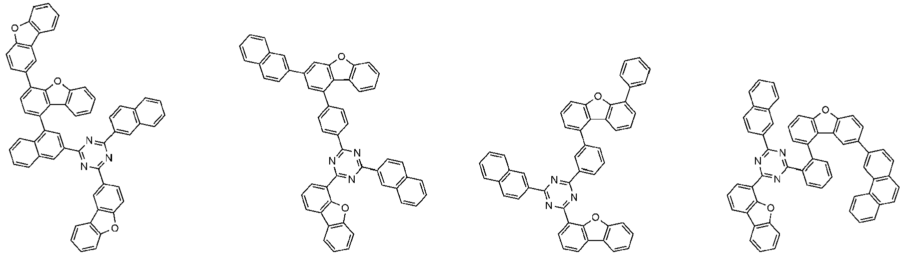

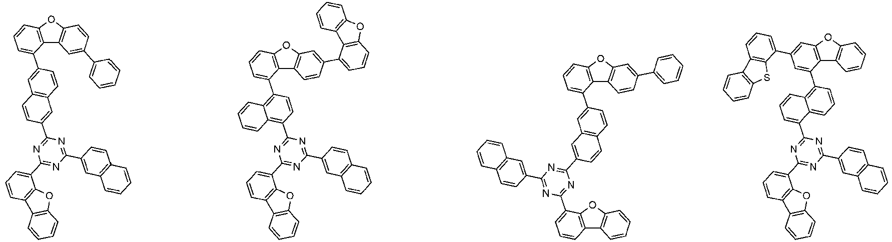

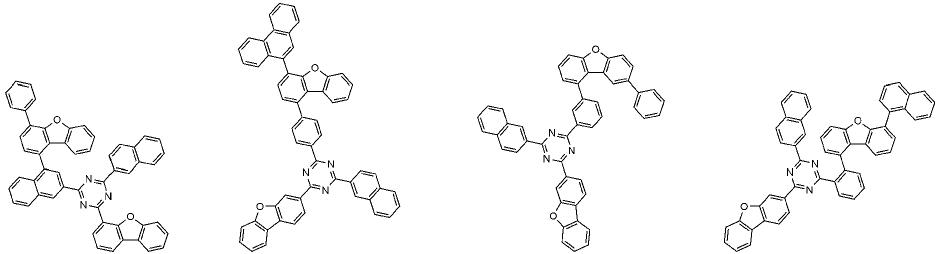

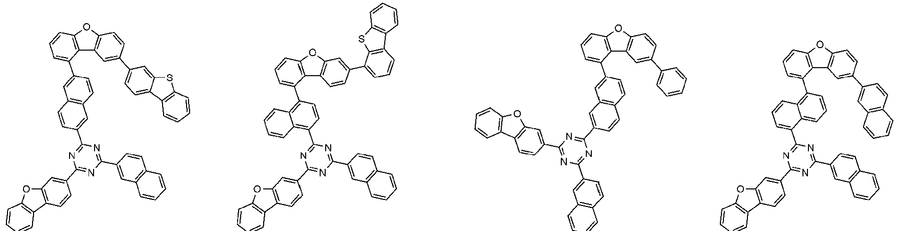

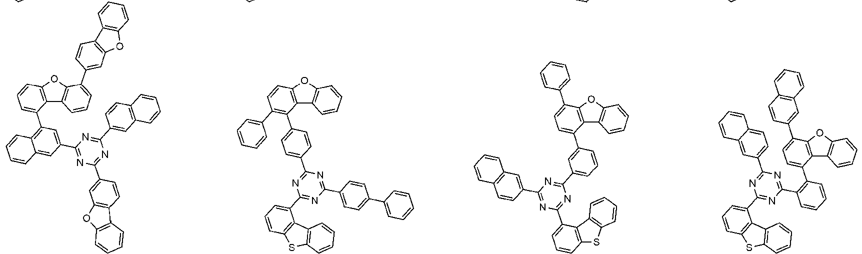

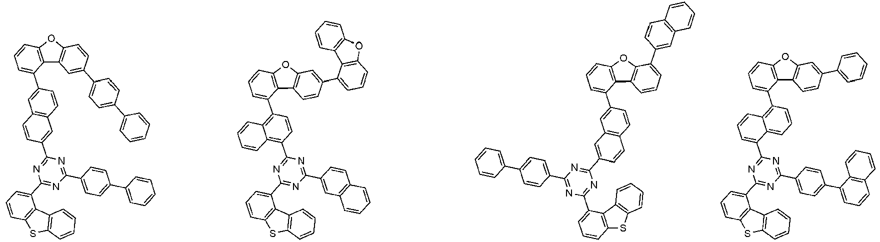

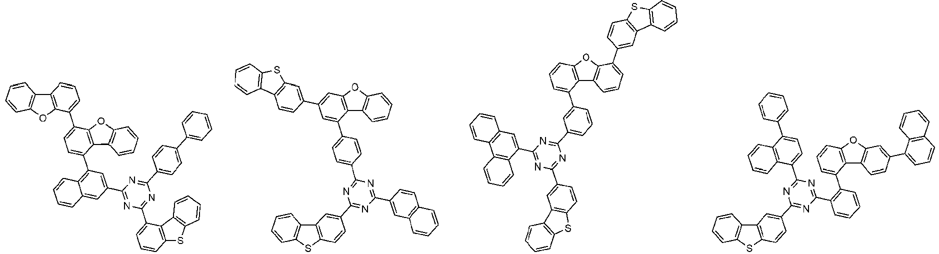

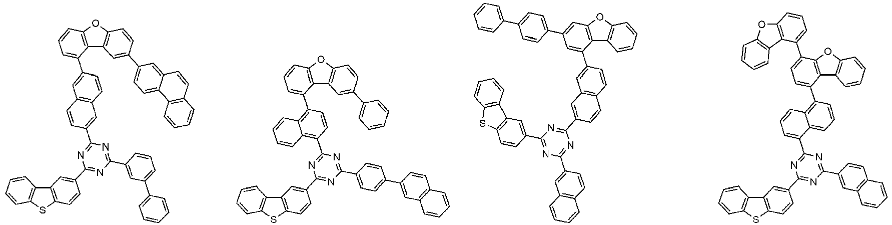

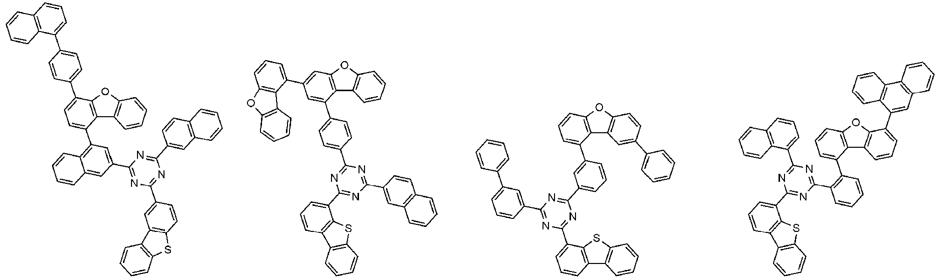

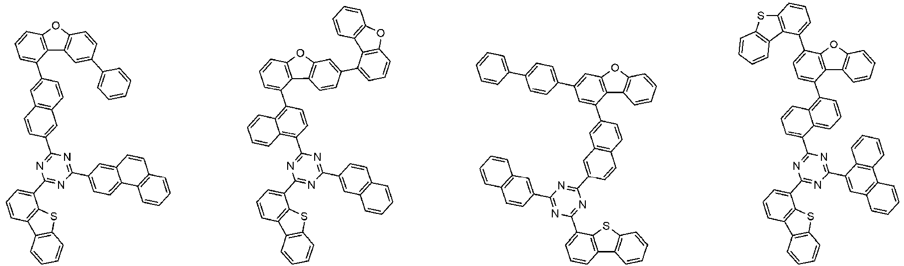

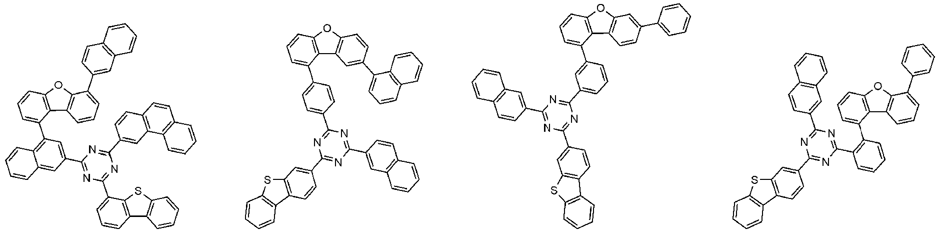

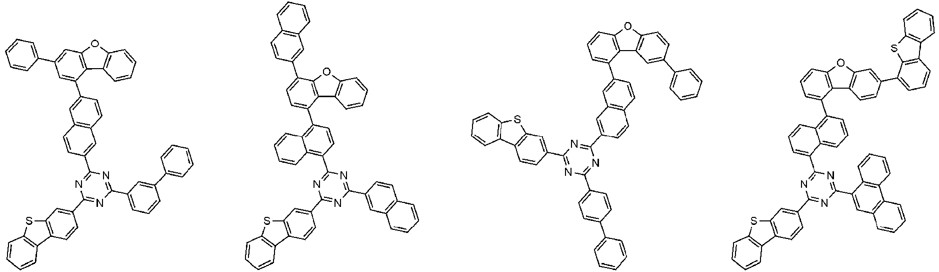

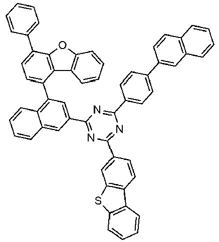

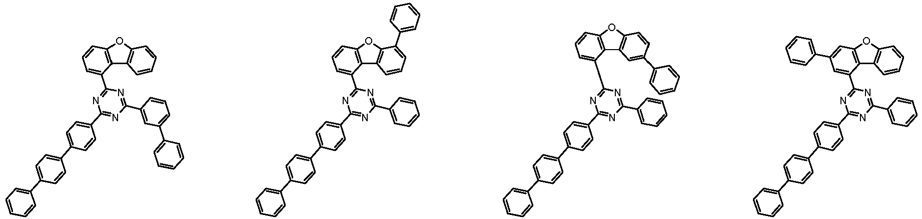

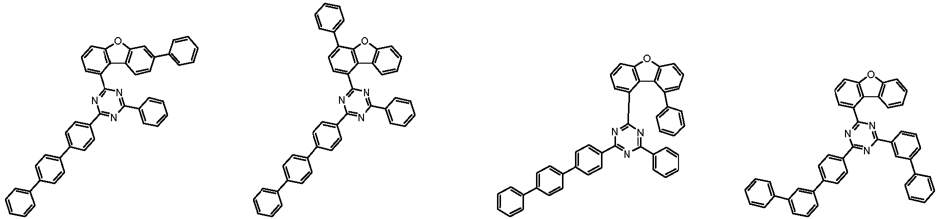

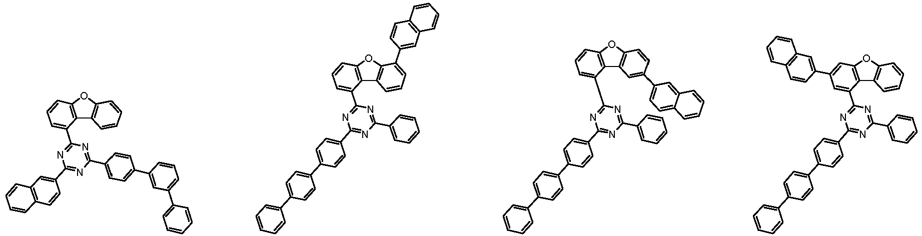

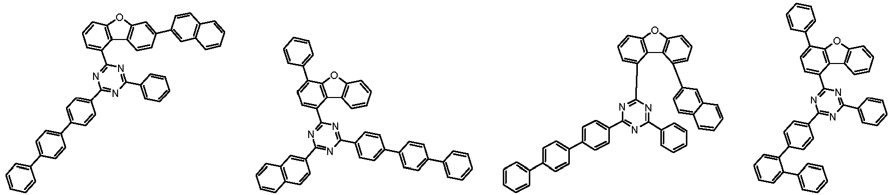

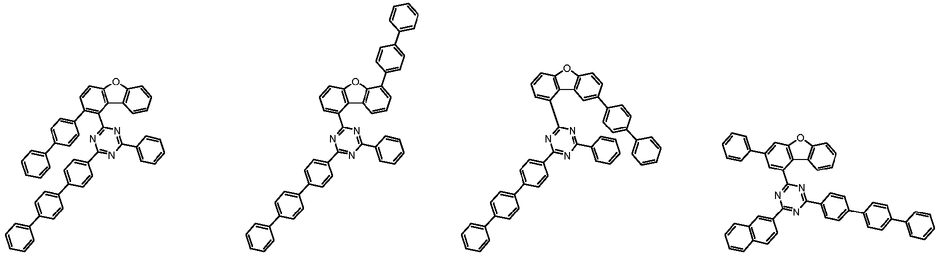

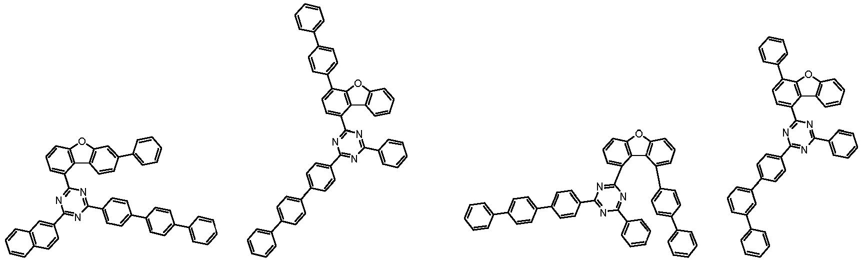

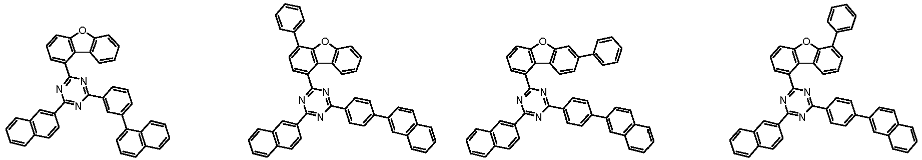

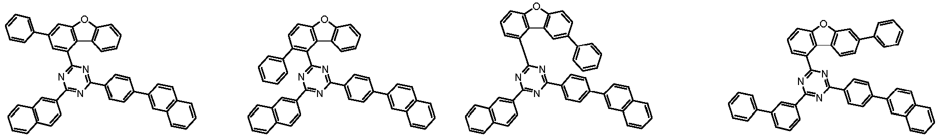

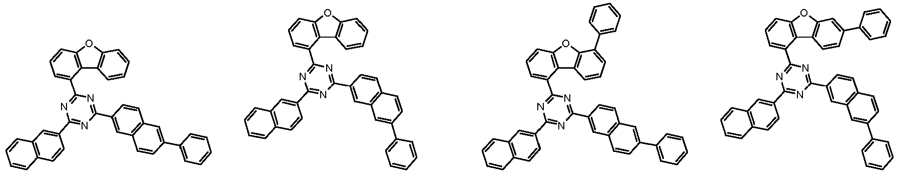

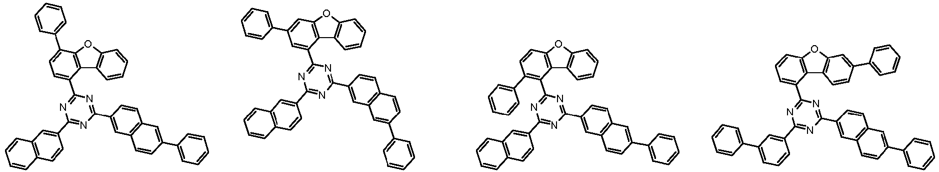

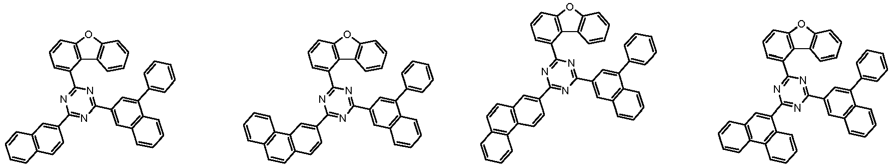

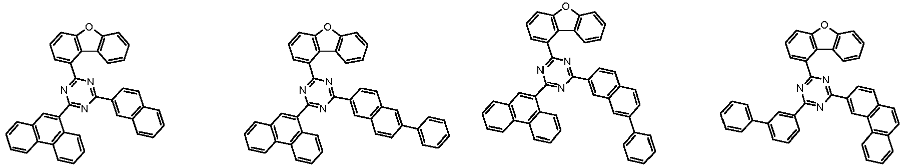

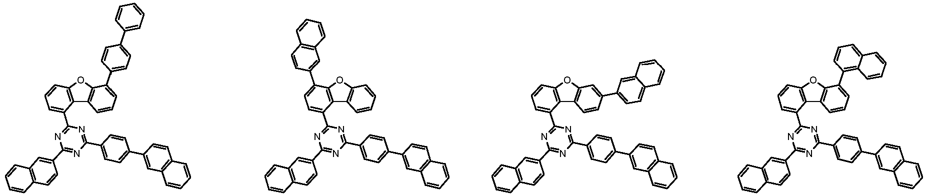

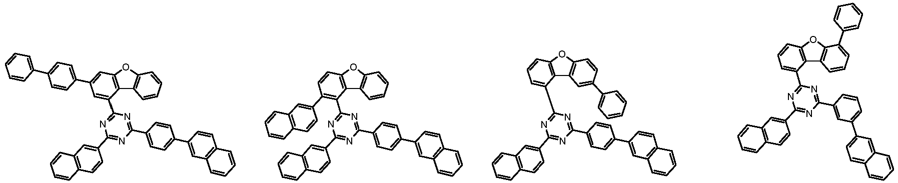

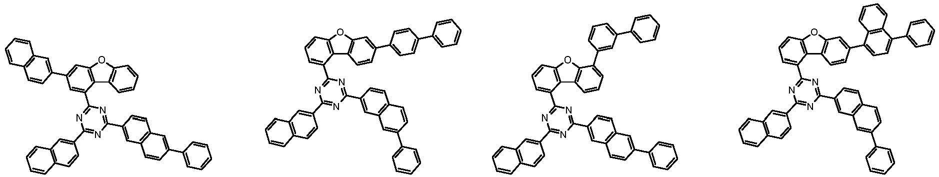

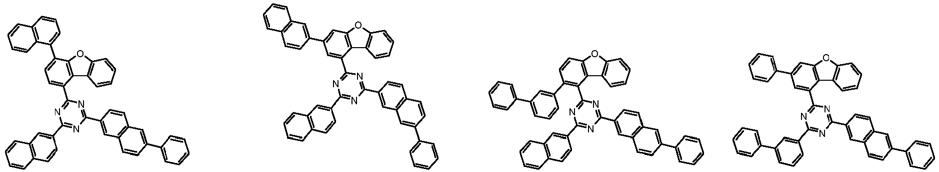

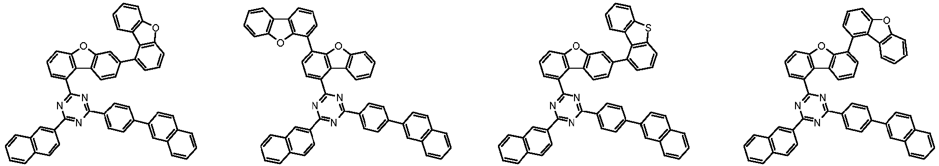

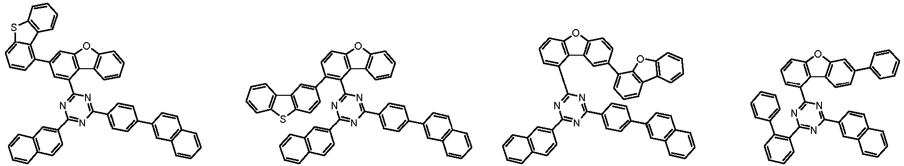

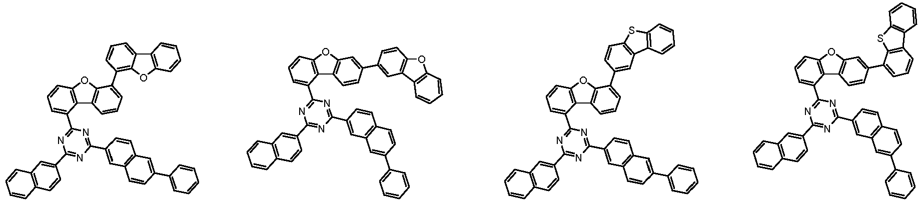

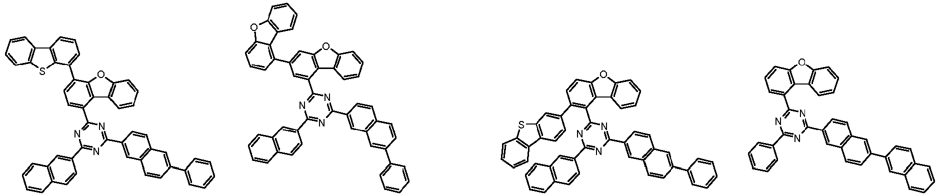

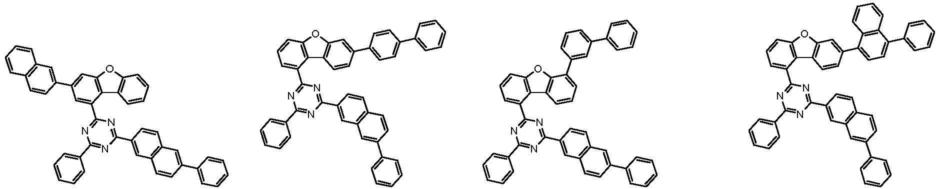

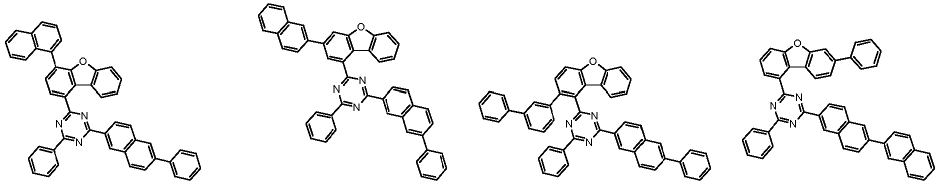

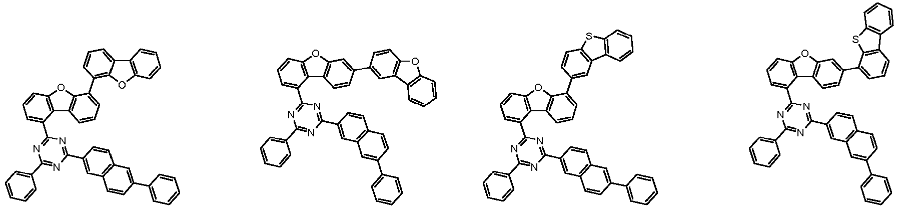

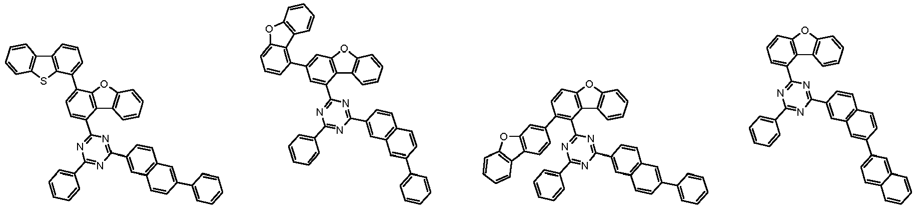

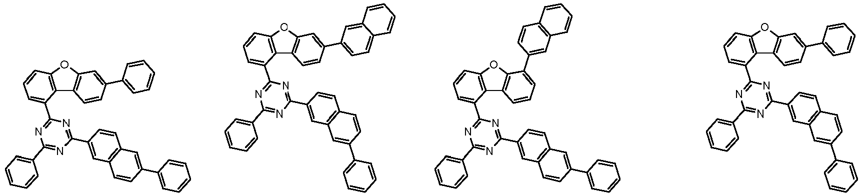

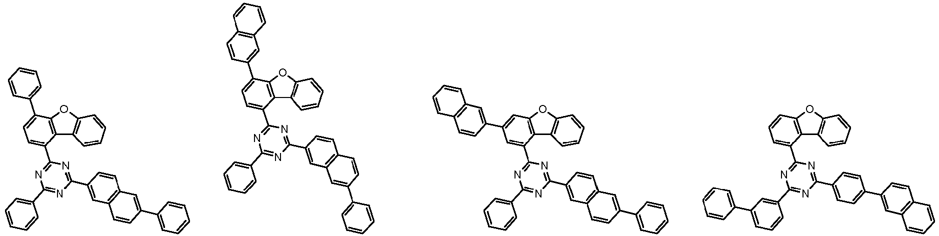

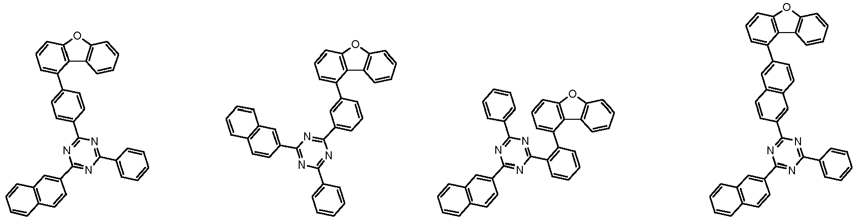

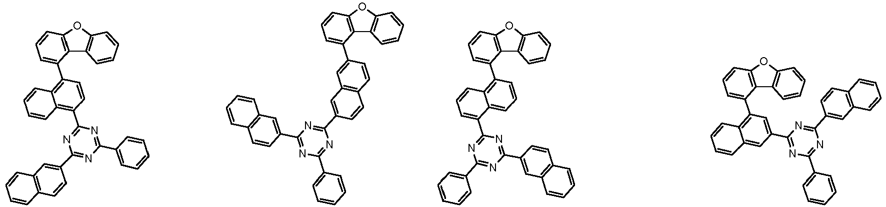

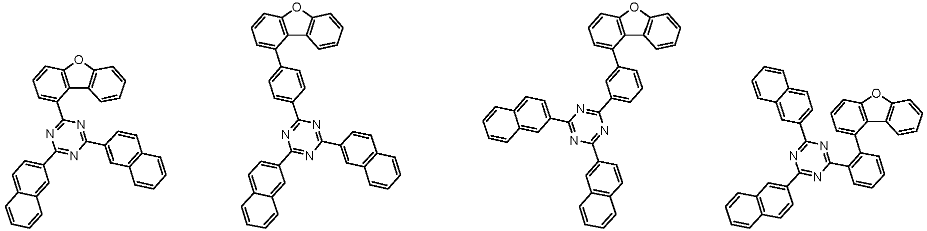

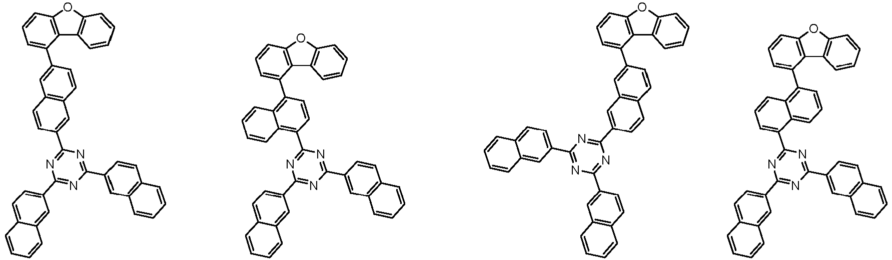

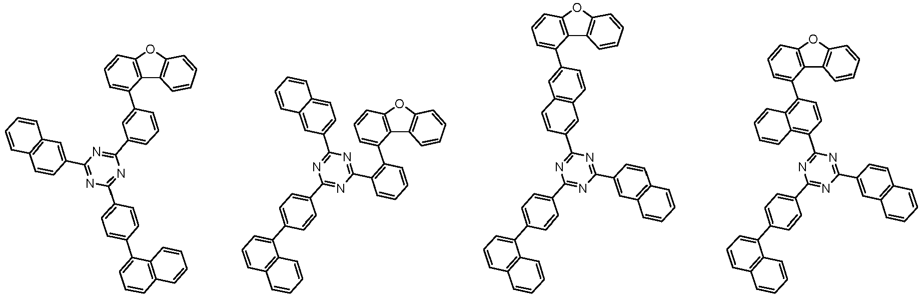

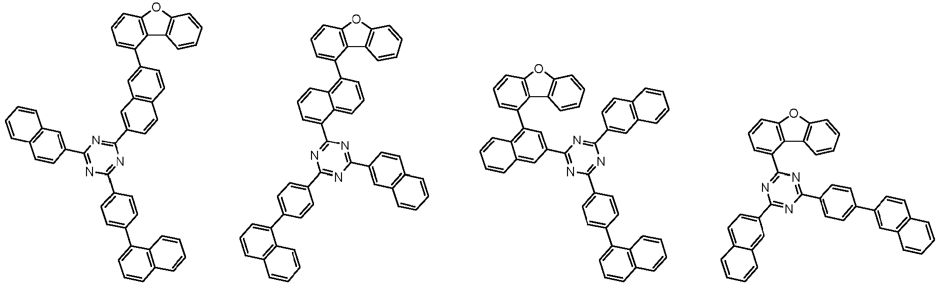

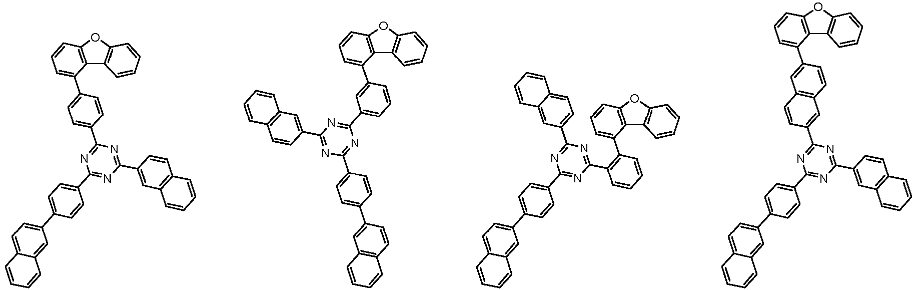

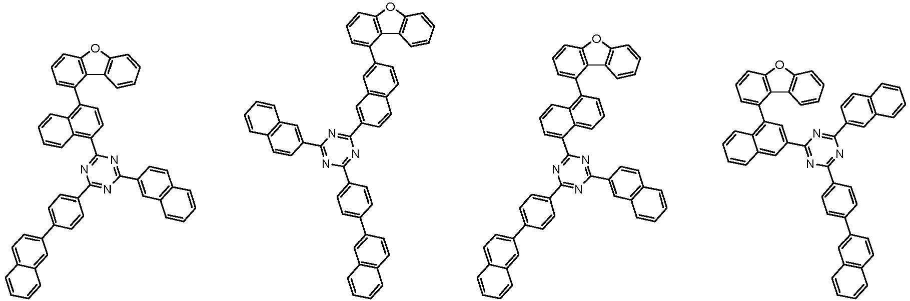

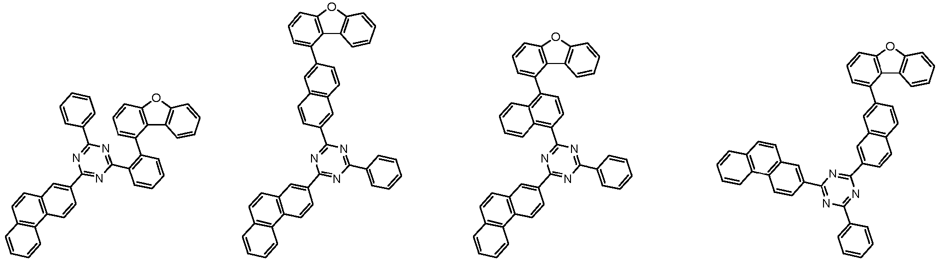

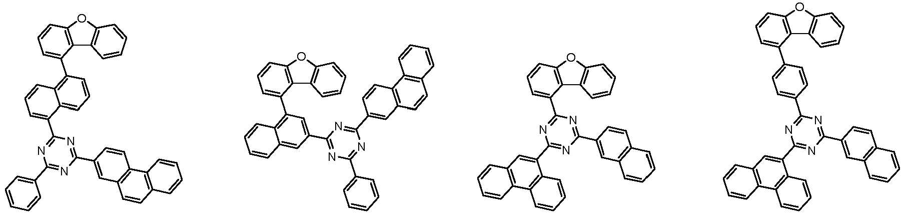

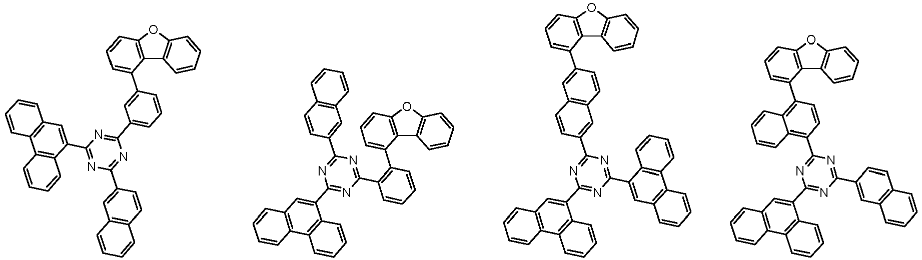

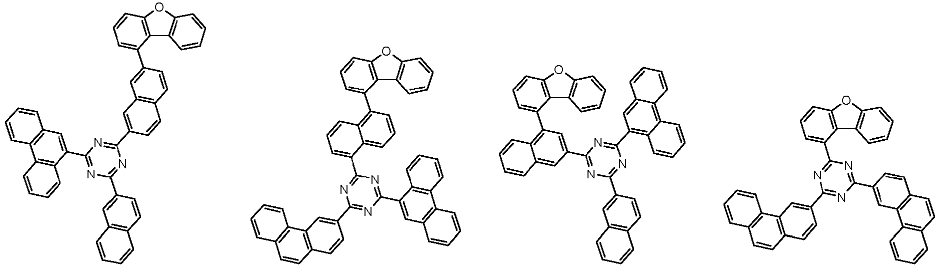

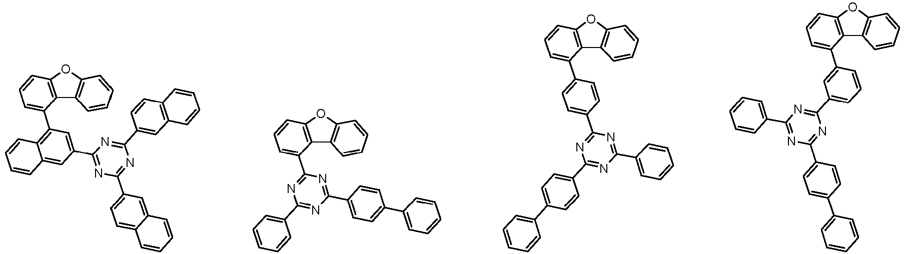

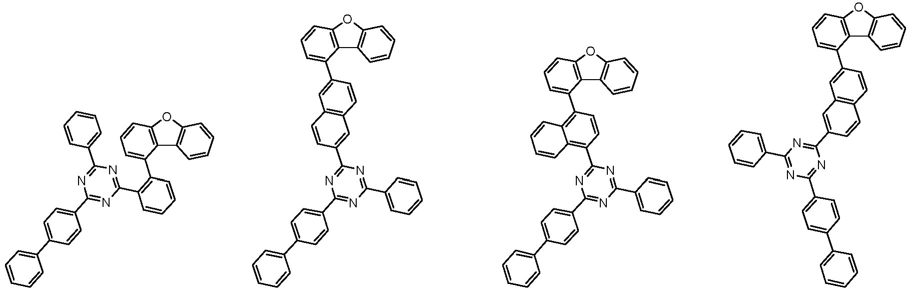

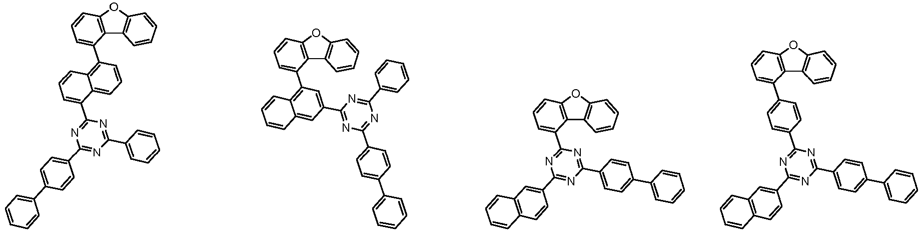

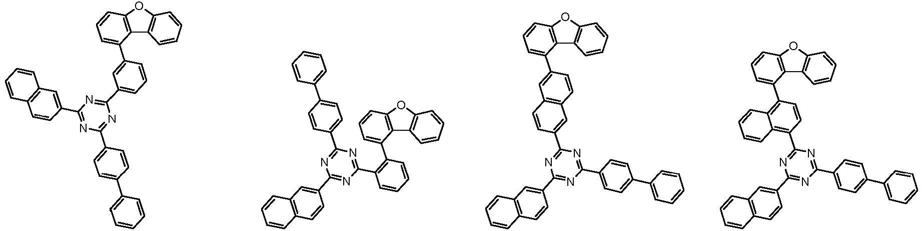

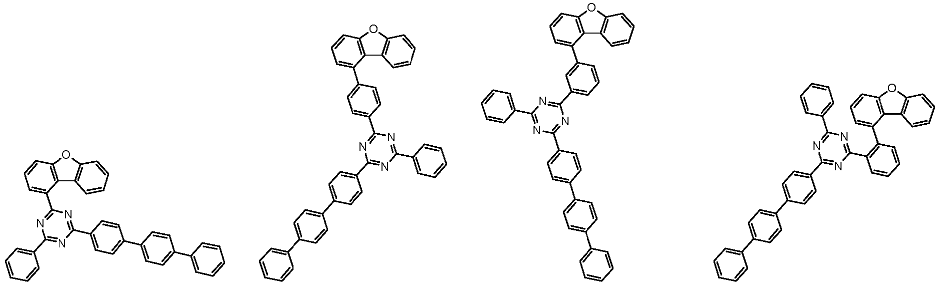

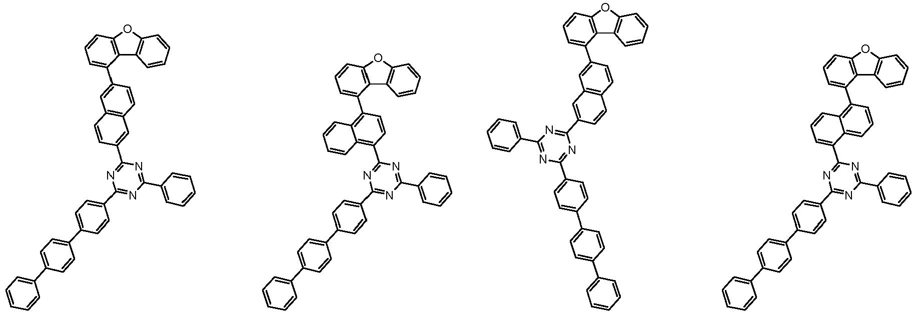

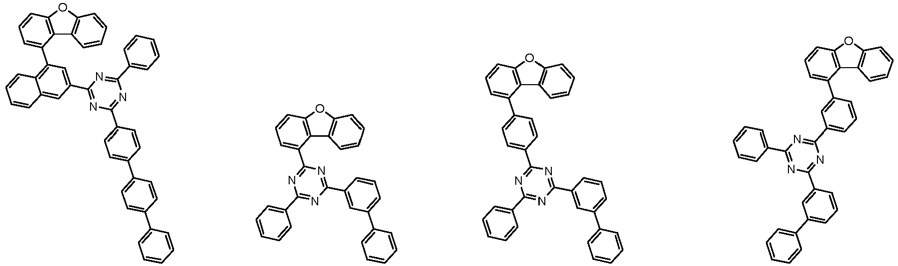

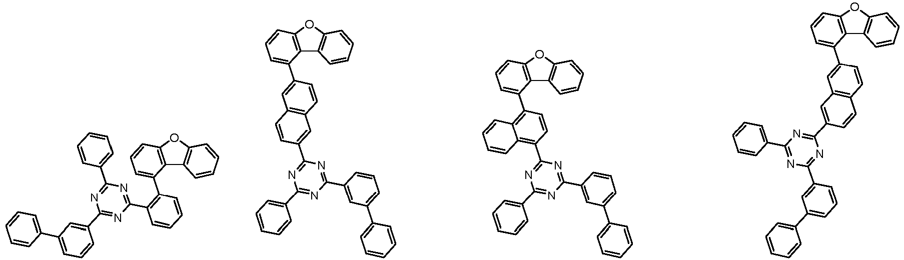

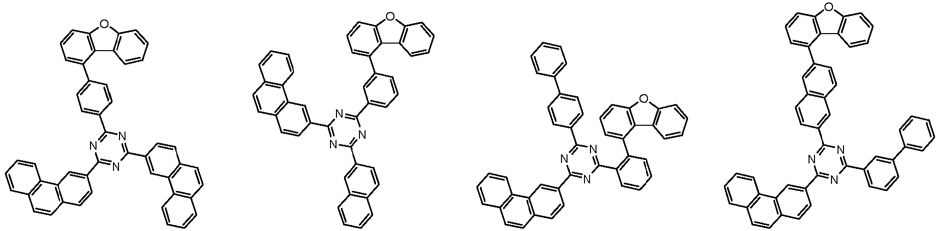

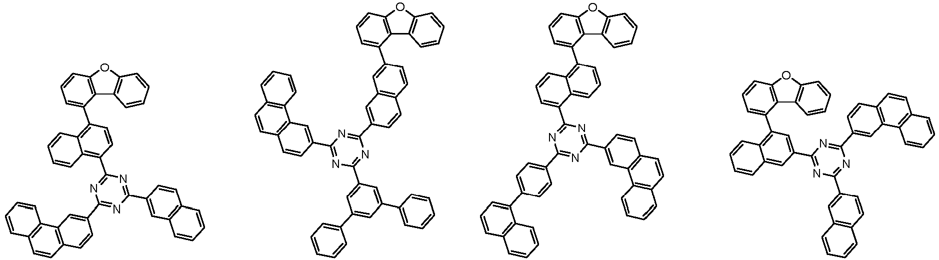

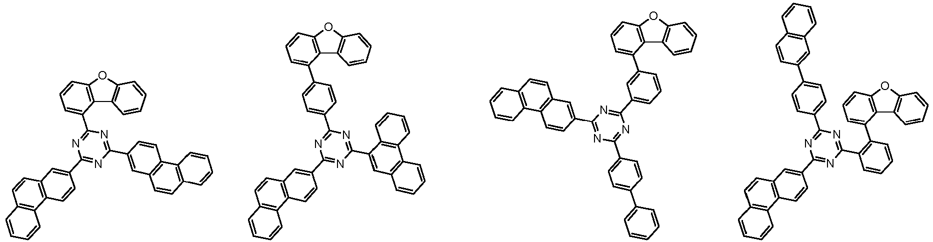

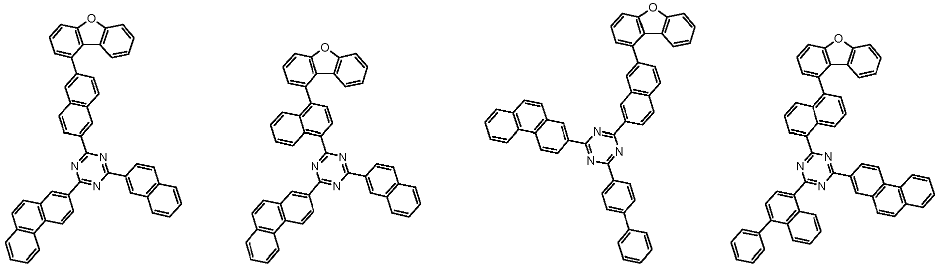

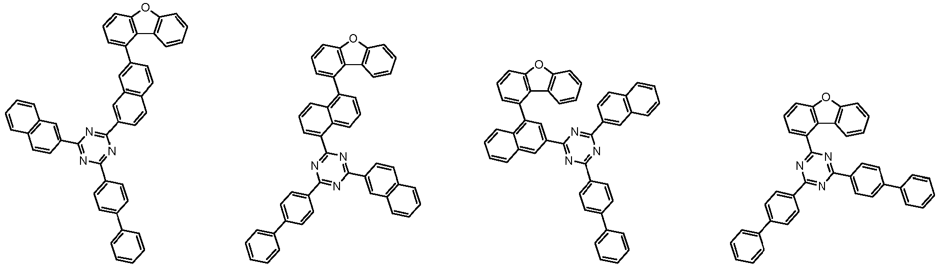

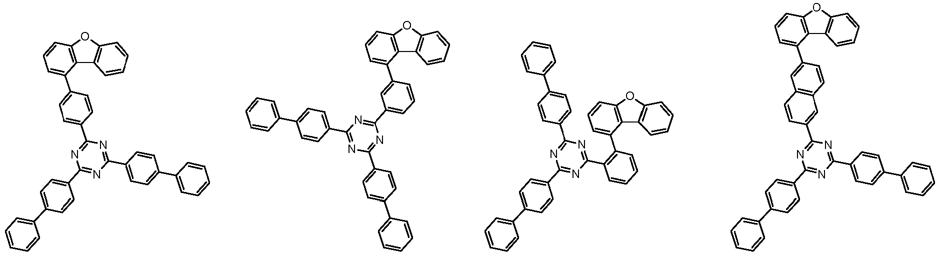

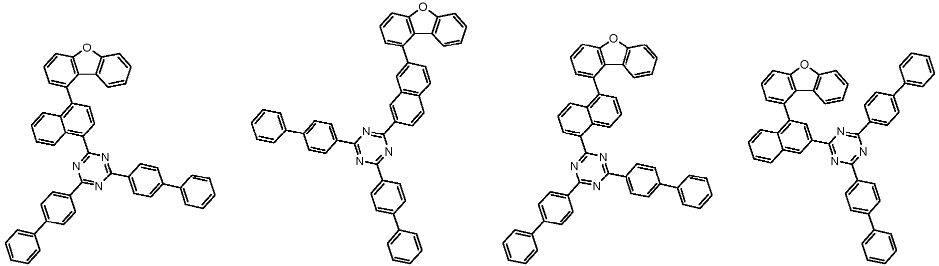

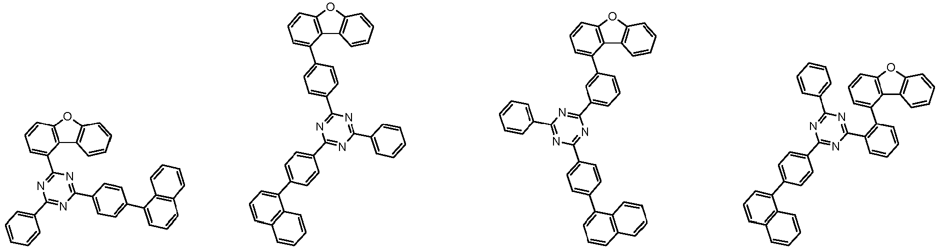

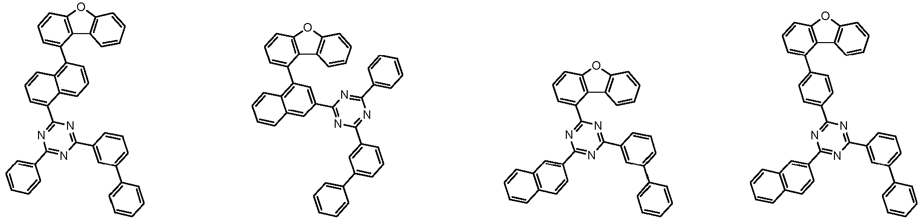

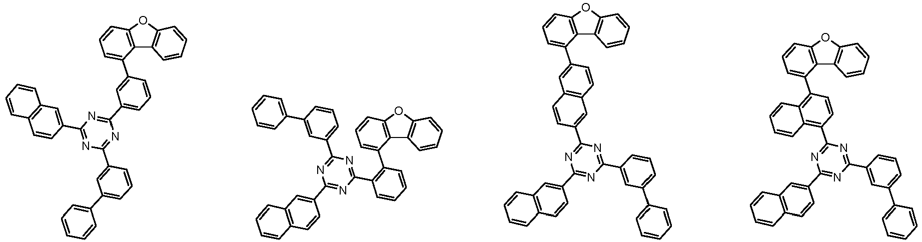

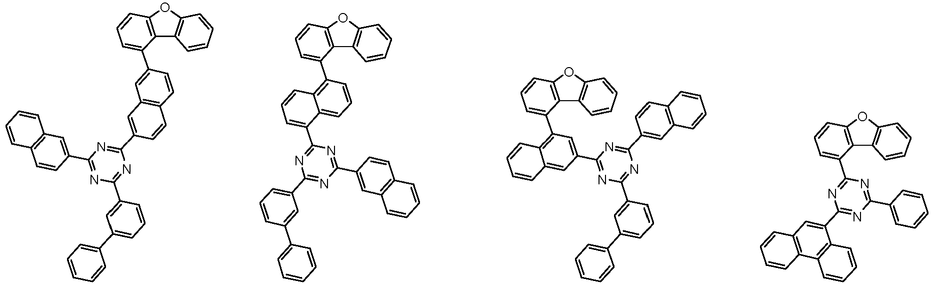

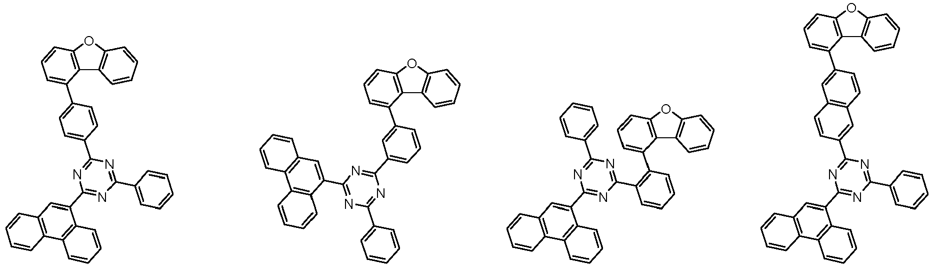

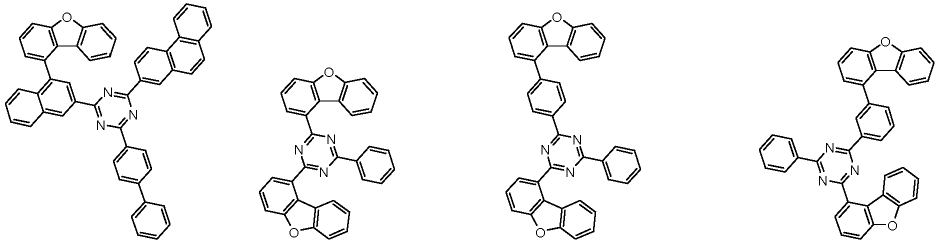

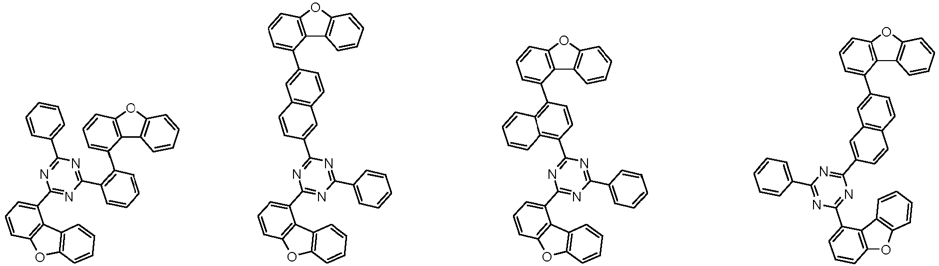

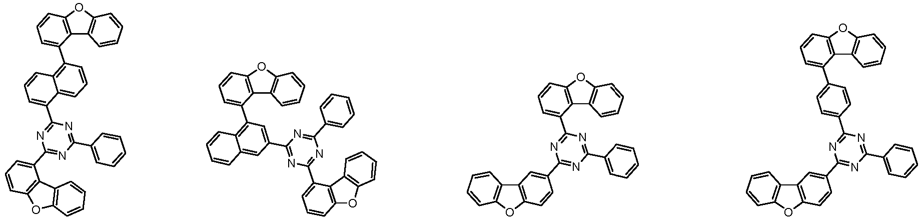

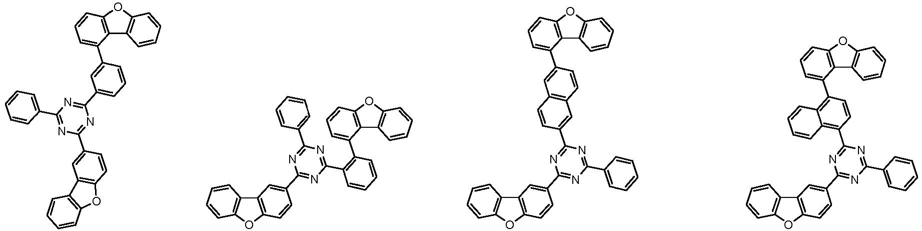

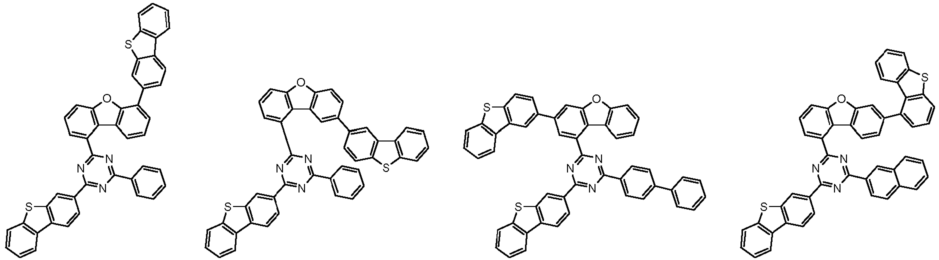

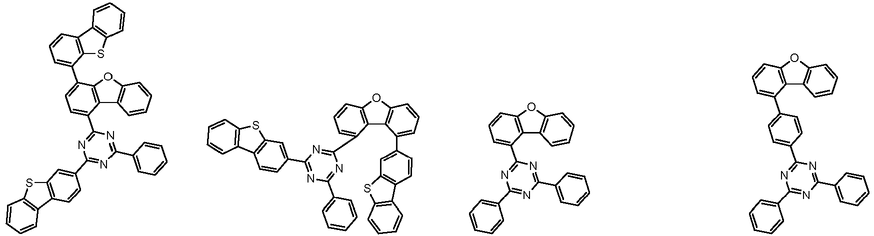

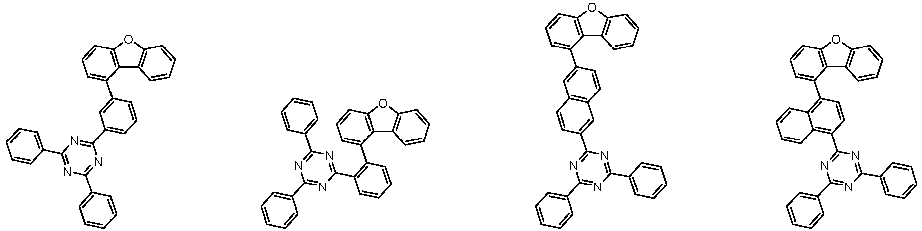

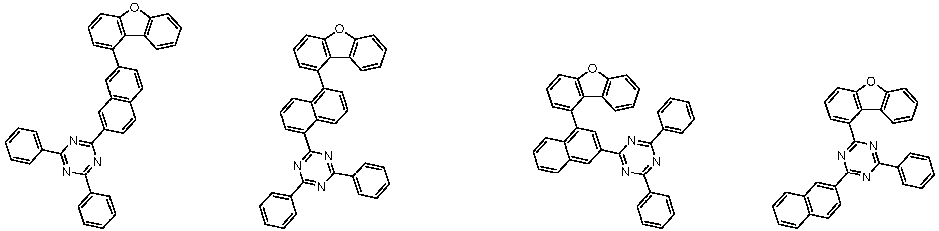

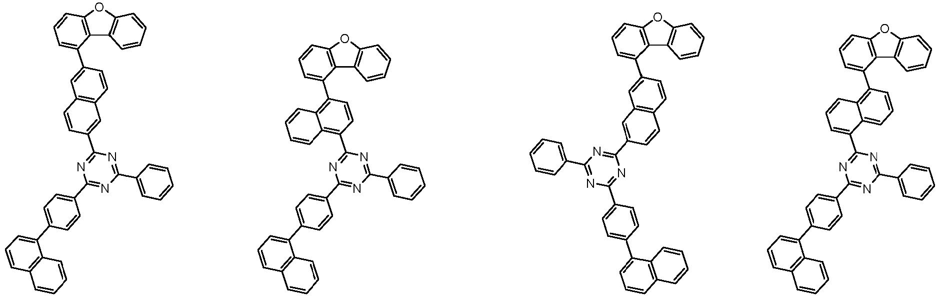

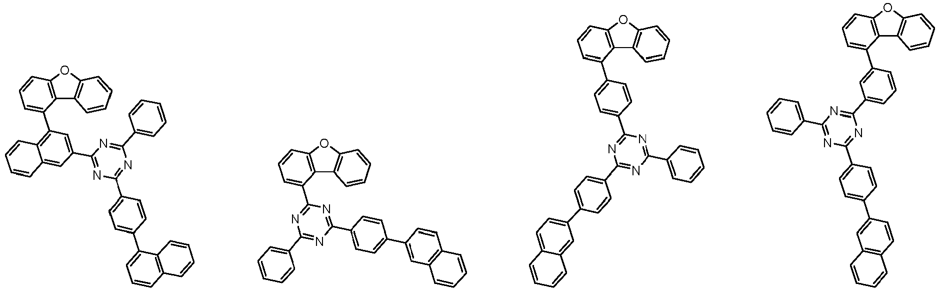

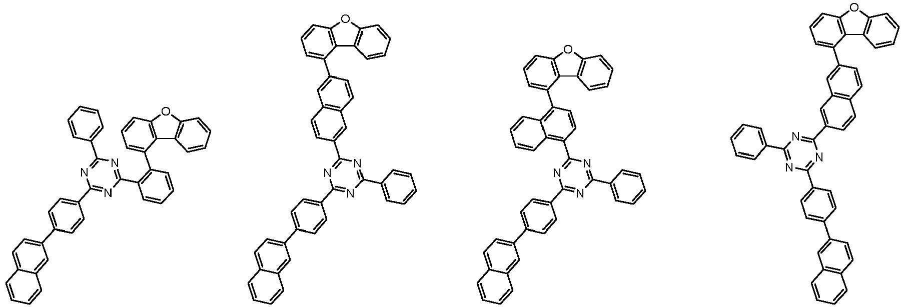

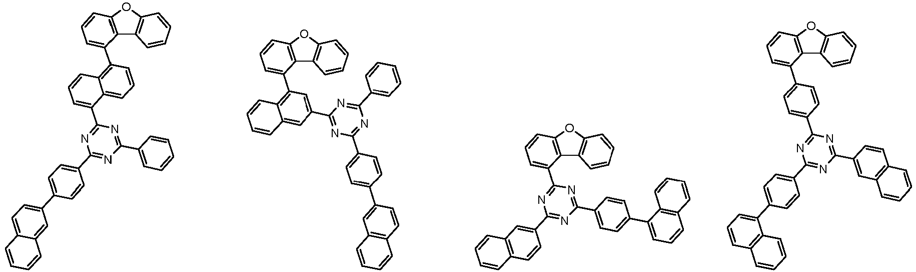

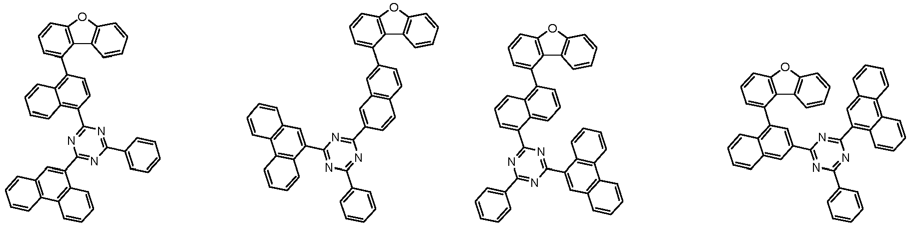

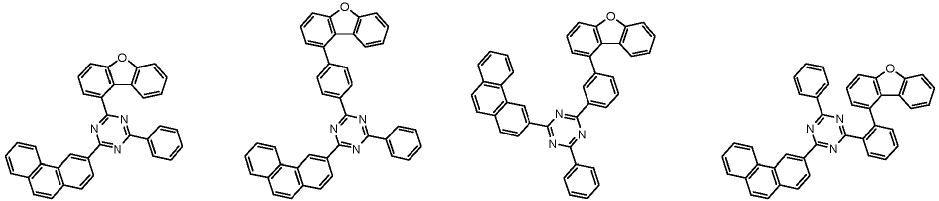

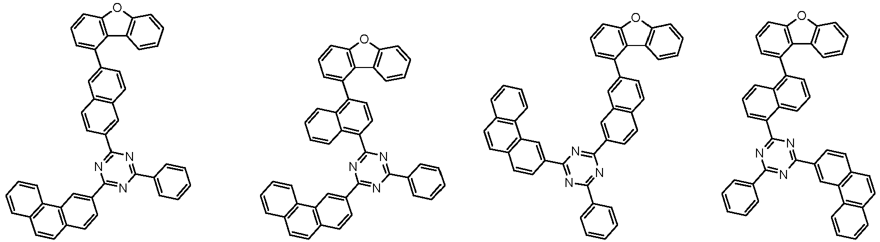

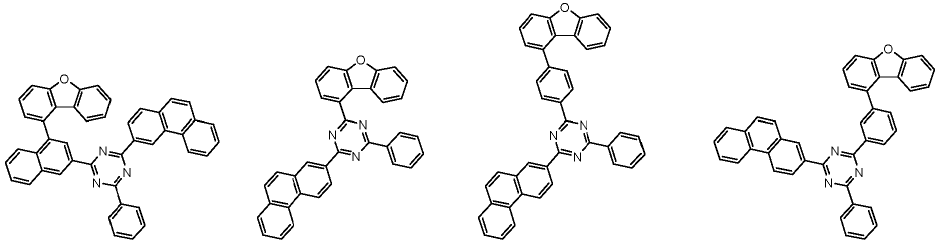

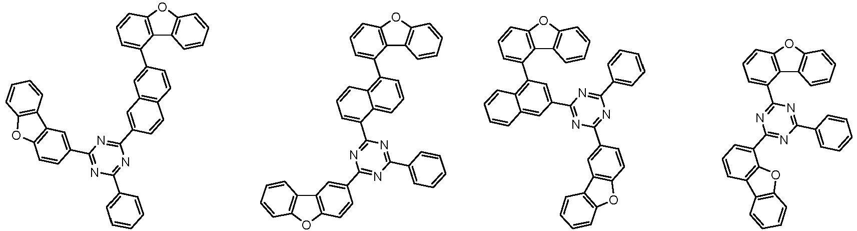

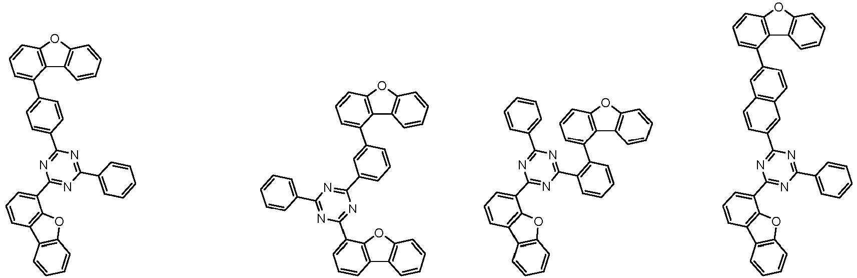

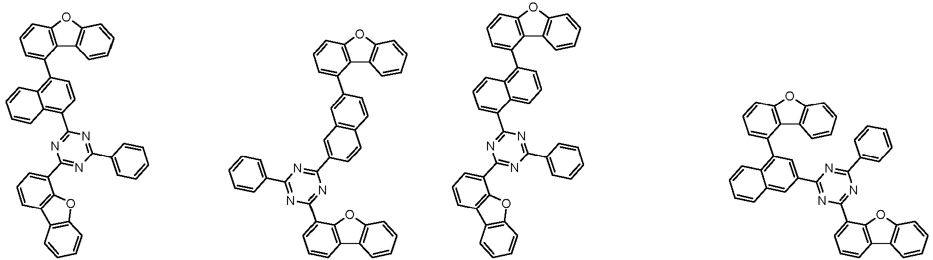

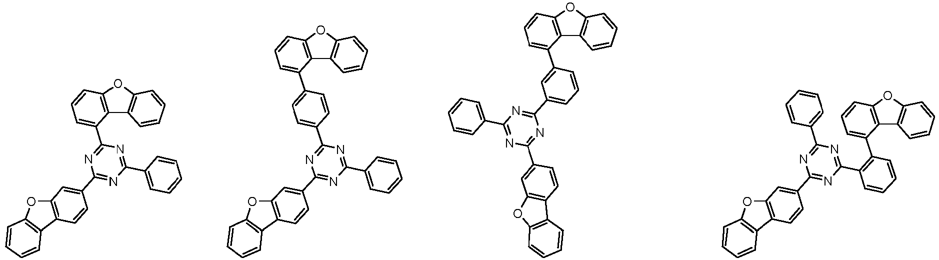

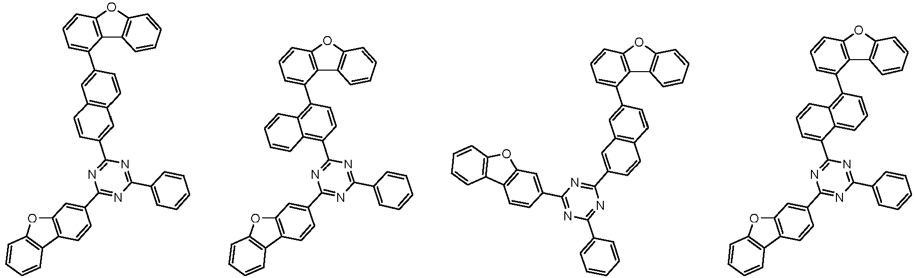

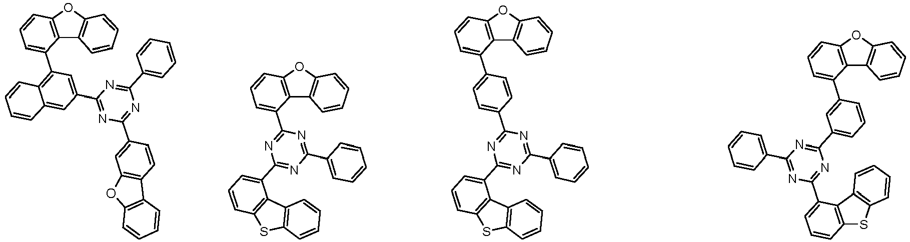

7. The organic light emitting device of claim 1, wherein:
R' is a substituent represented by Chemical Formula 4, or phenyl, biphenyl, or naphthyl.

8. The organic light emitting device of claim 1, wherein:
L' is a single bond, phenylene, biphenyldiyl, terphenyldiyl, naphthylene, or -(phenylene)-(naphthylene)-.

9. The organic light emitting device of claim 1, wherein:
L'₁ and L'₂ are each independently a single bond, phenylene, or biphenyldiyl.

10. The organic light emitting device of claim 1, wherein:
Ar'₁ and Ar'₂ are each independently phenyl, biphenylyl, terphenylyl, naphthyl, naphthylphenyl, phenylnaphthyl, phenanthrenyl, dimethylfluorenyl, diphenylfluorenyl, dibenzofuranyl, dibenzothiophenyl, 9H-carbazol-9-yl, or 9-phenyl-9H-carbazolyl.

11. The organic light emitting device of claim 1, wherein:
the compound represented by Chemical Formula 2 or Chemical Formula 3 is any one selected from the group consisting of:

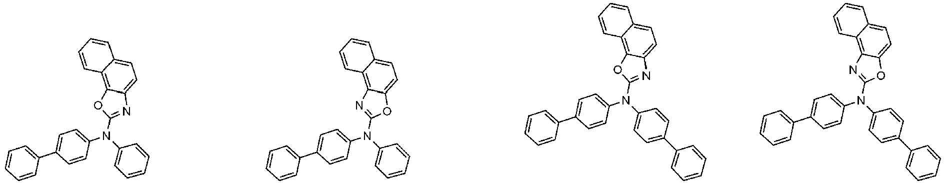

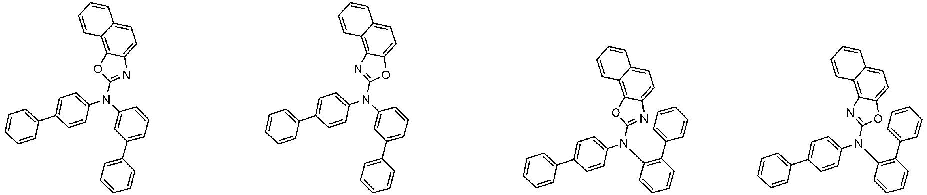

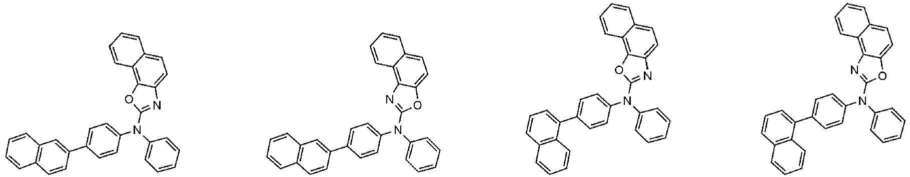

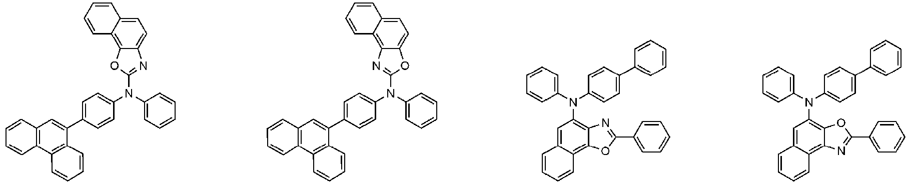

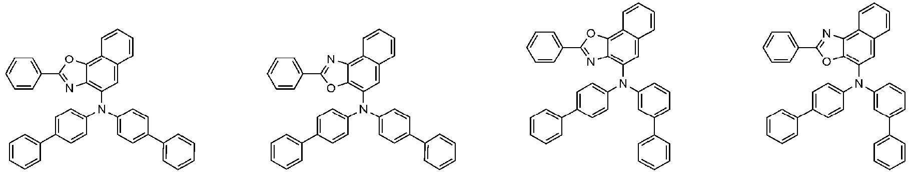

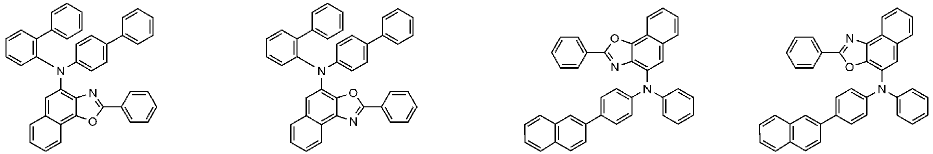

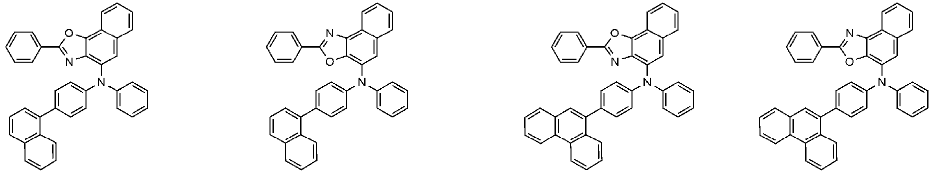

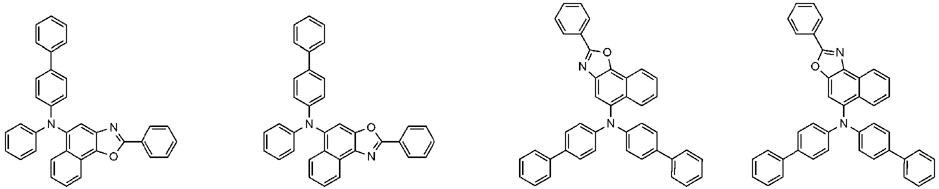

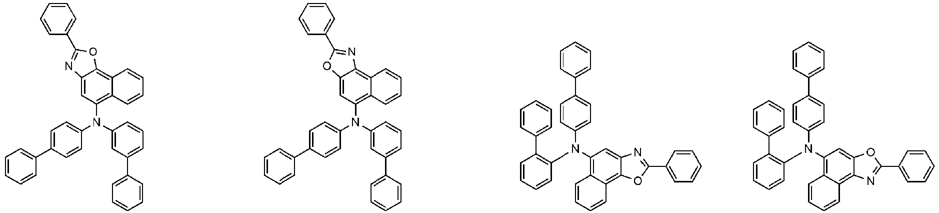

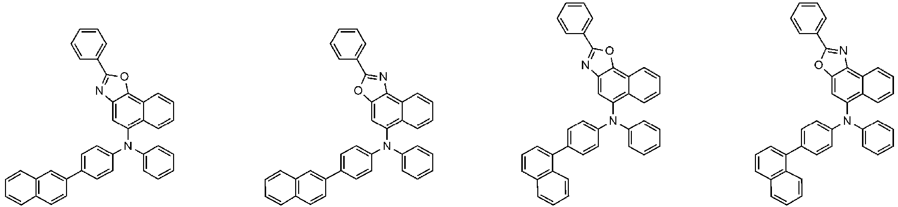

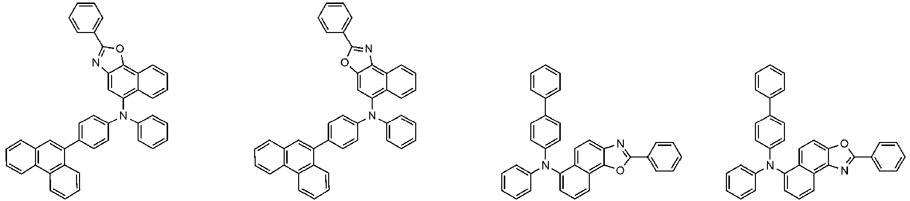

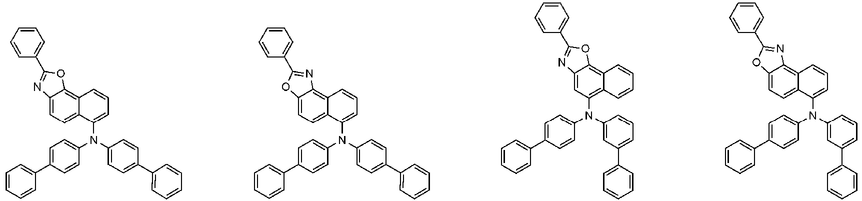

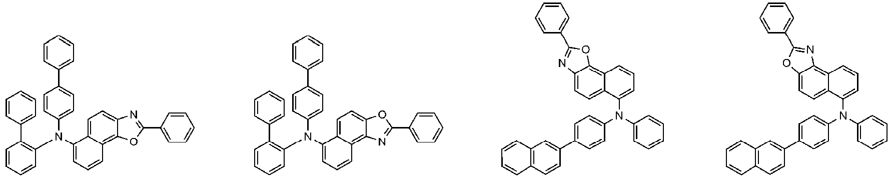

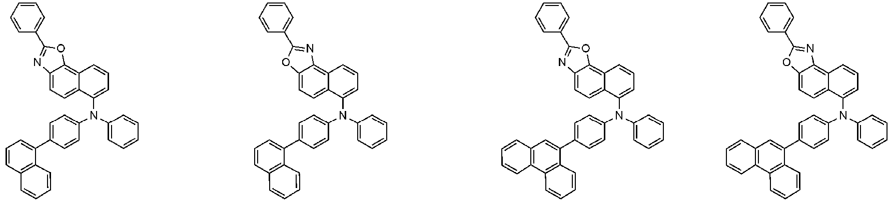

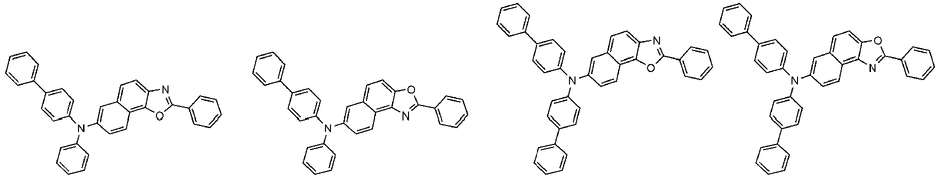

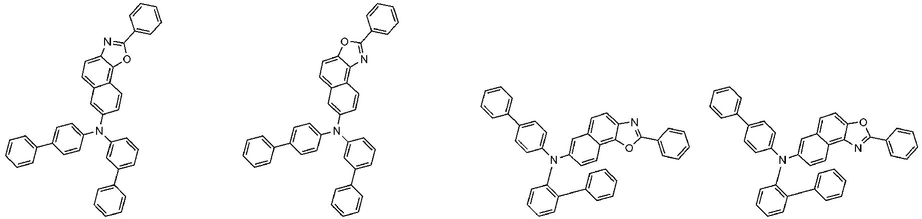

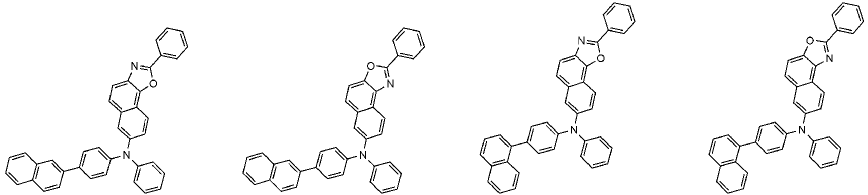

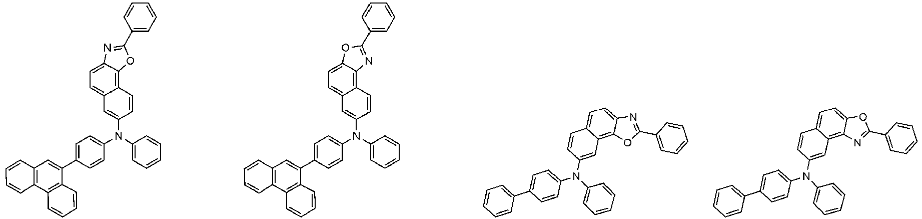

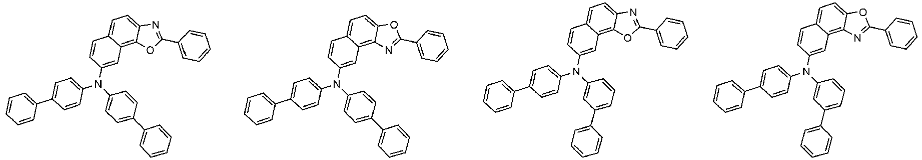

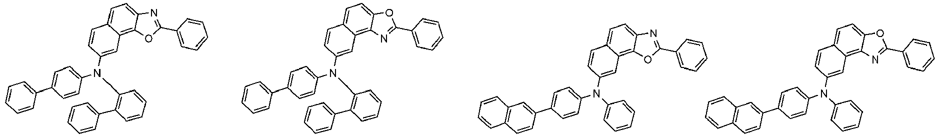

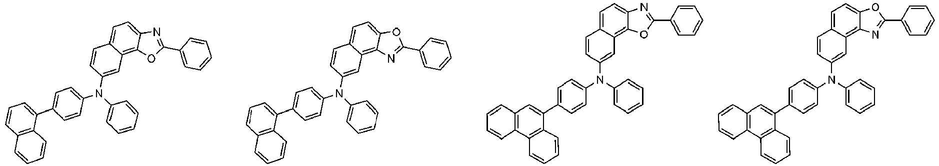

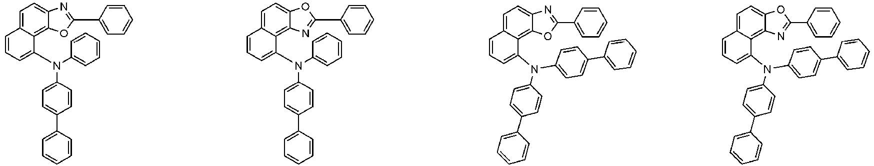

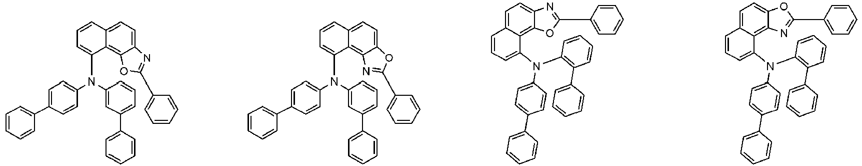

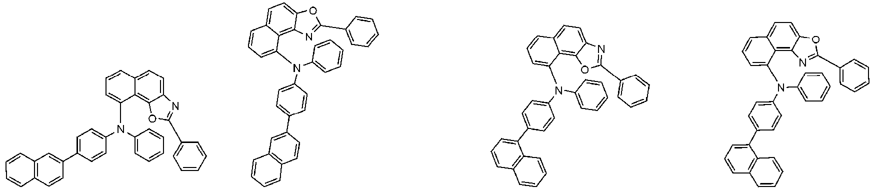

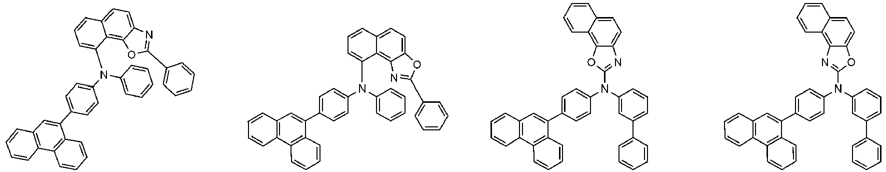

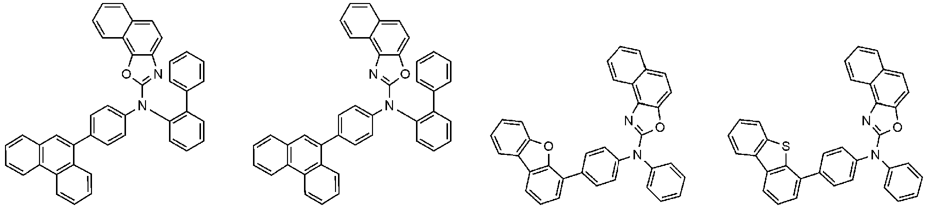

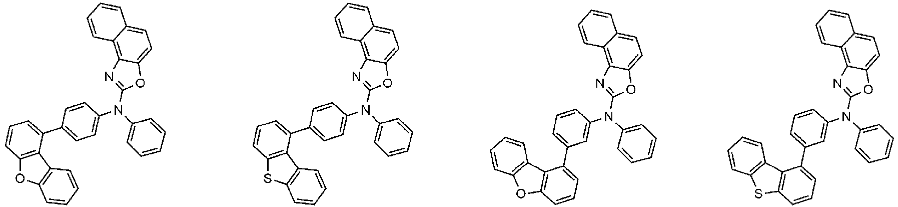

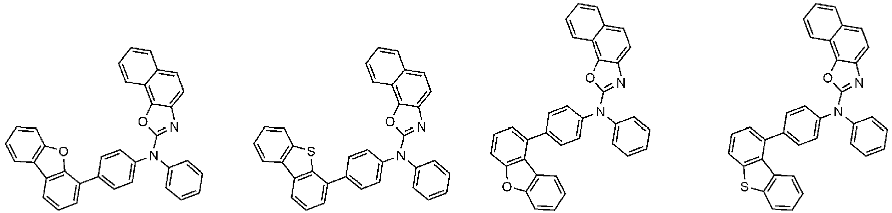

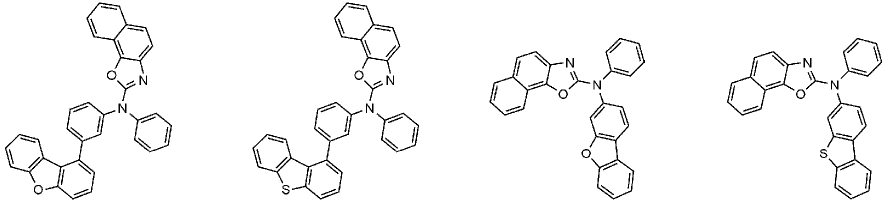

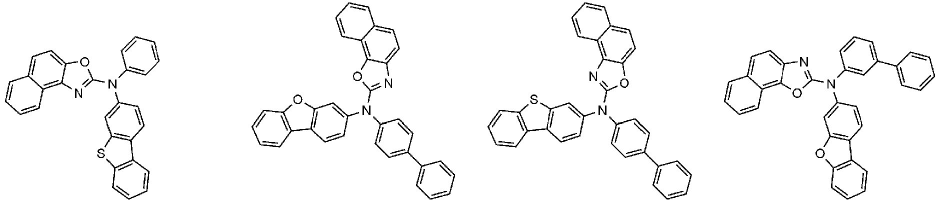

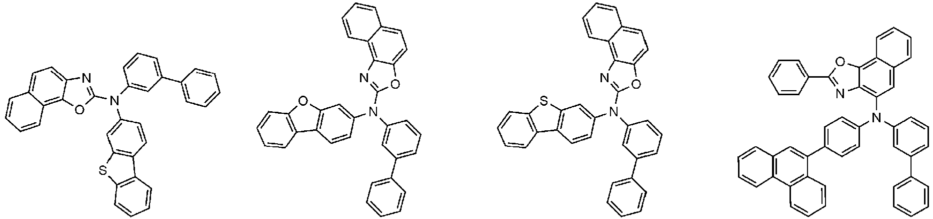

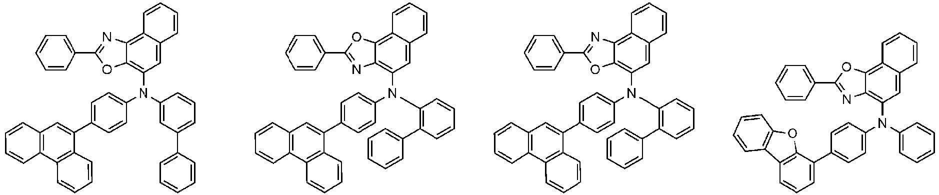

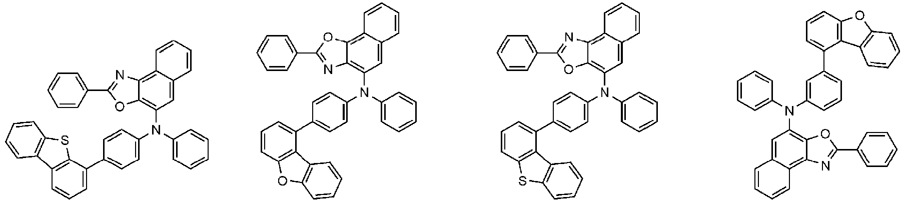

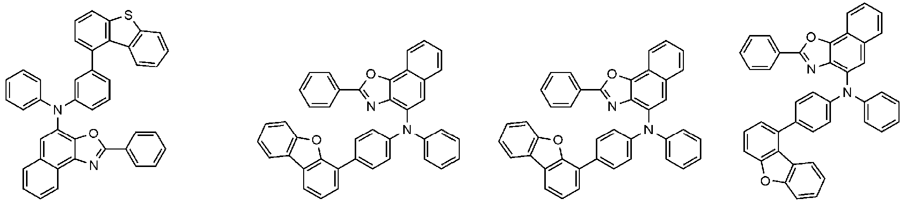

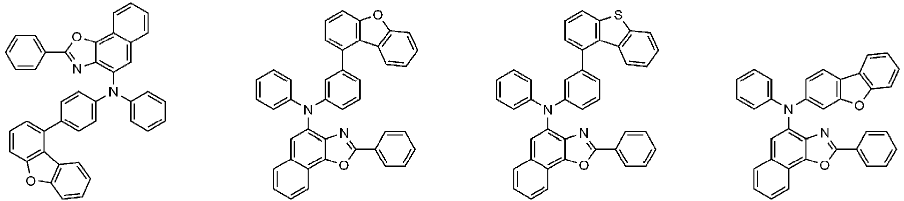

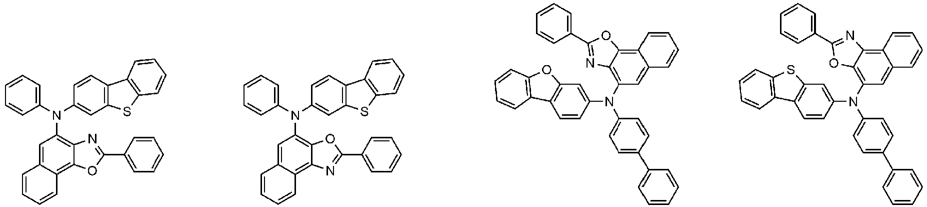

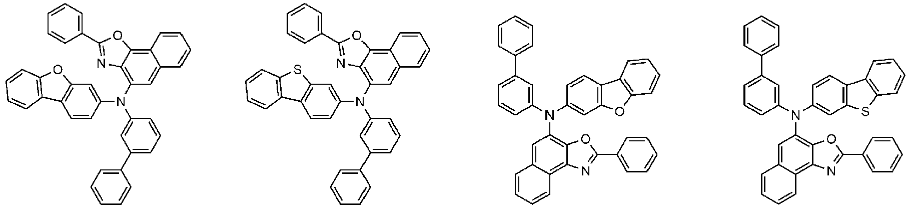

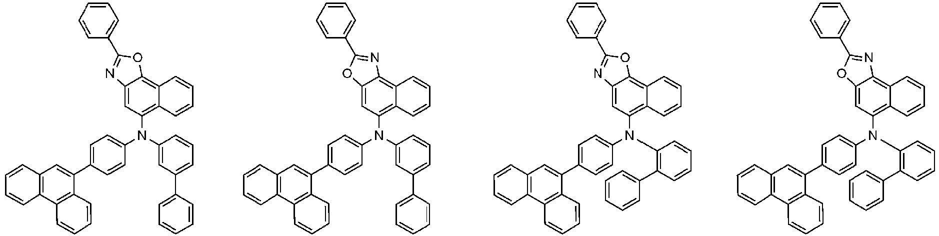

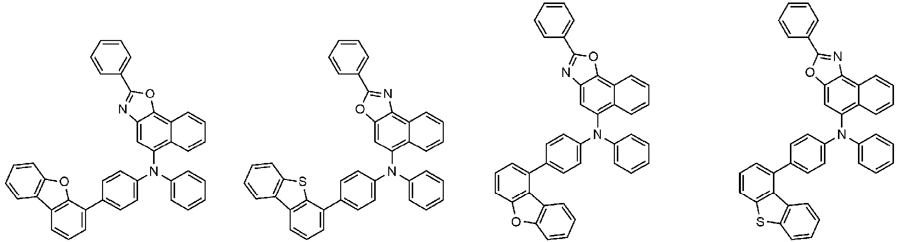

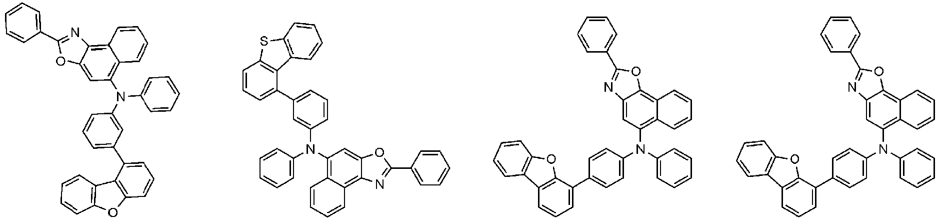

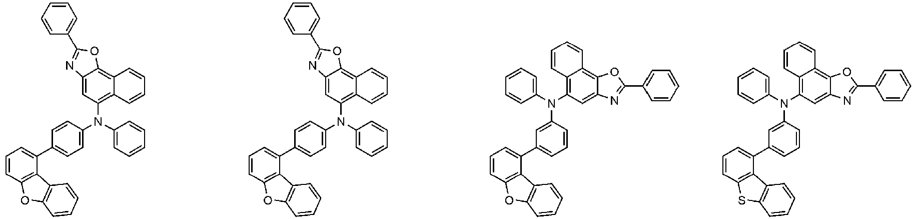

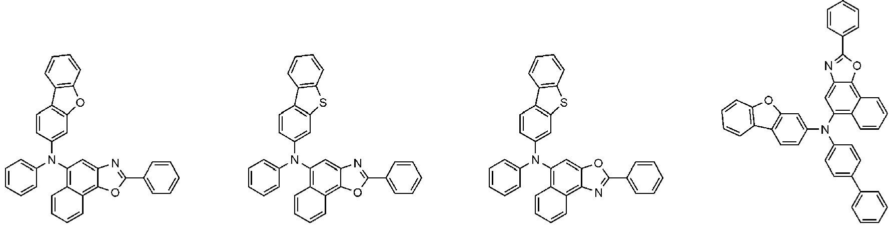

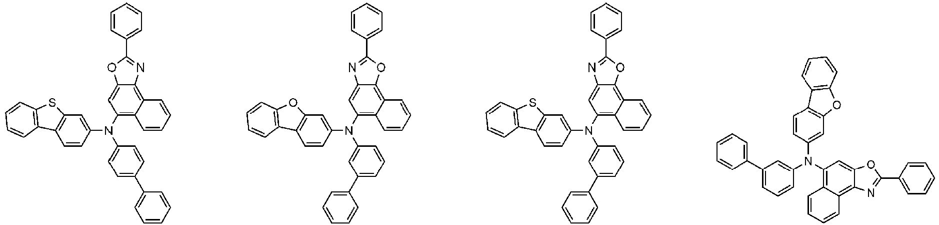

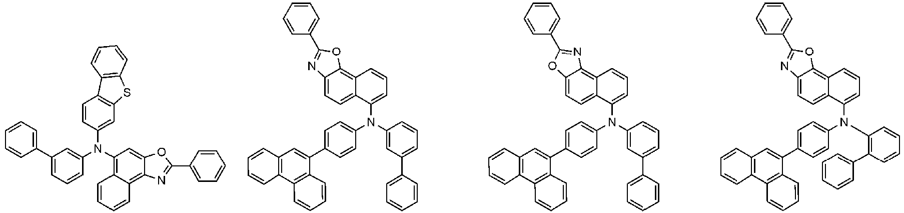

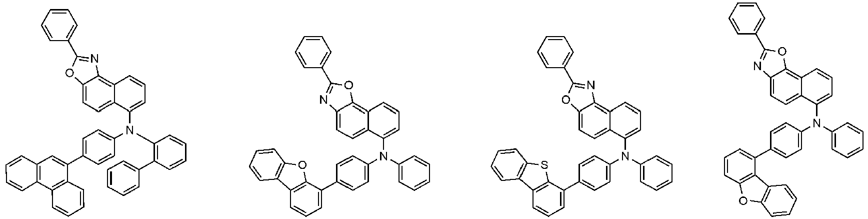

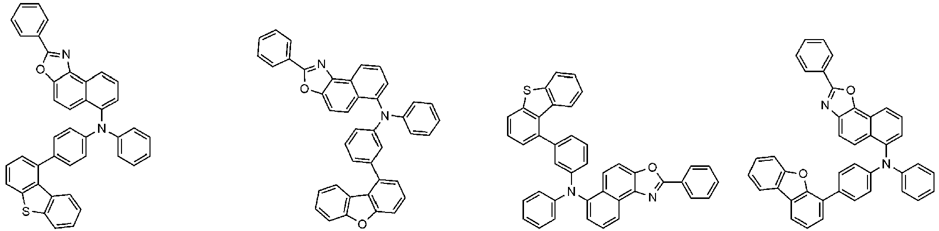

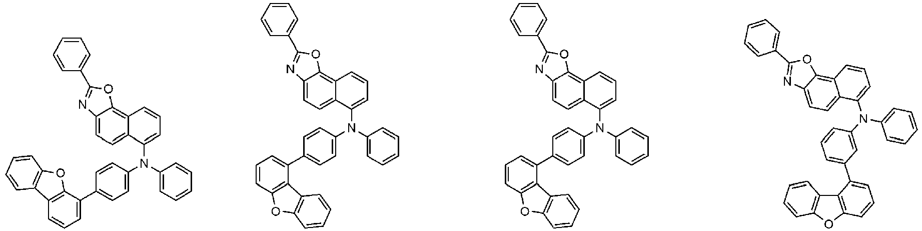

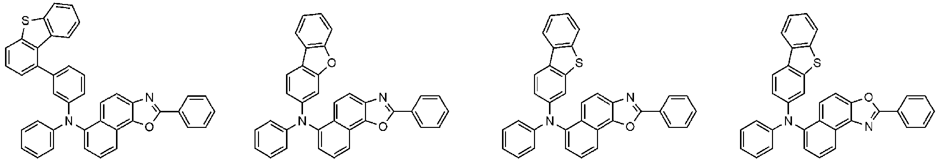

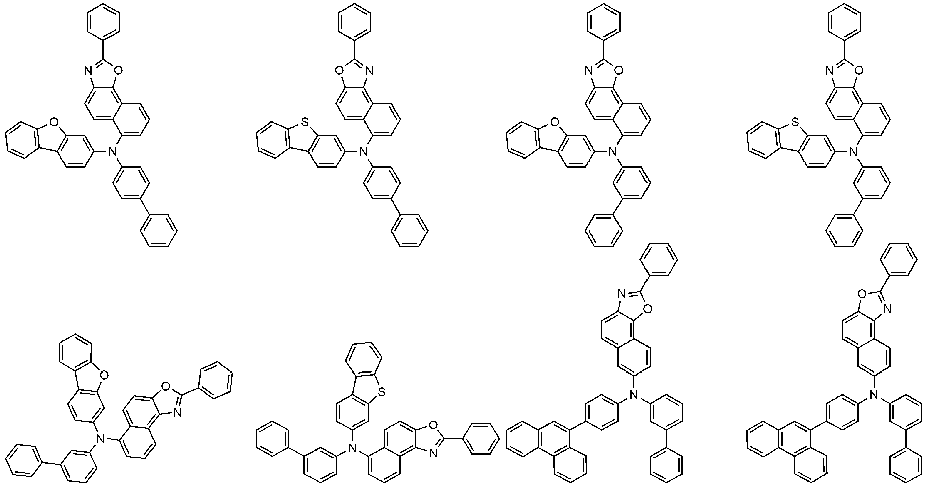

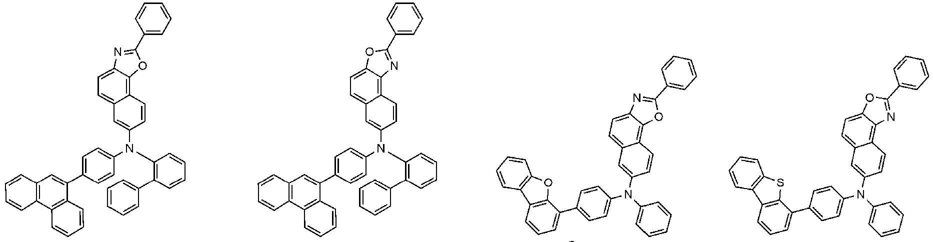

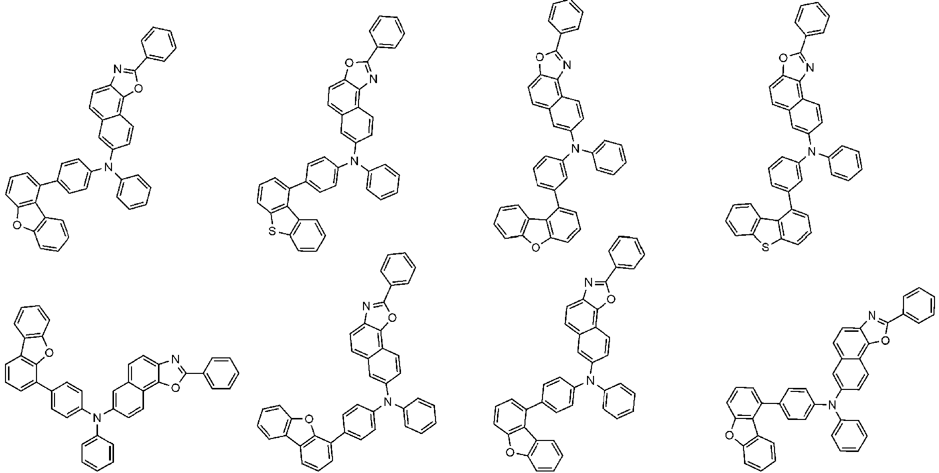

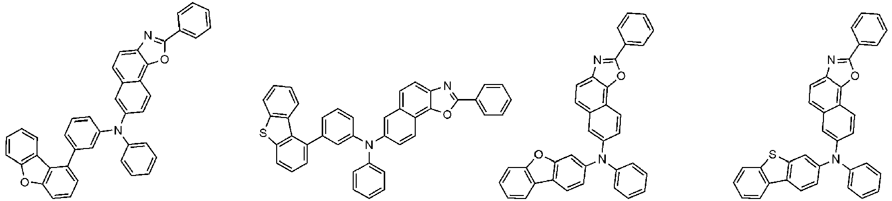

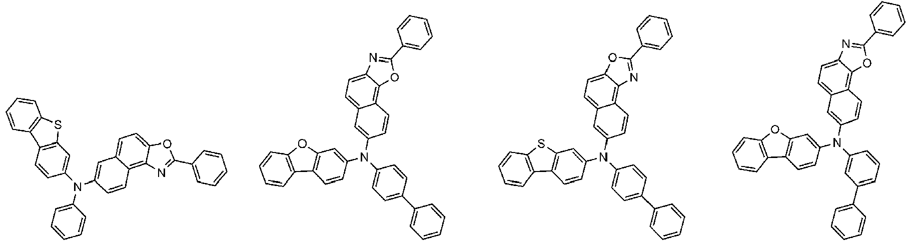

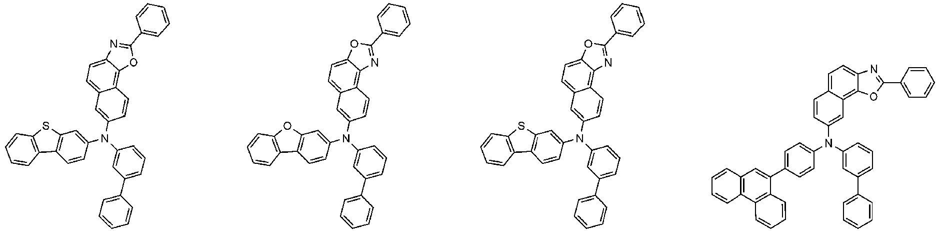

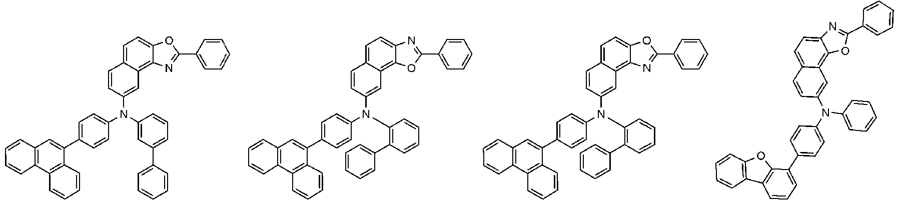

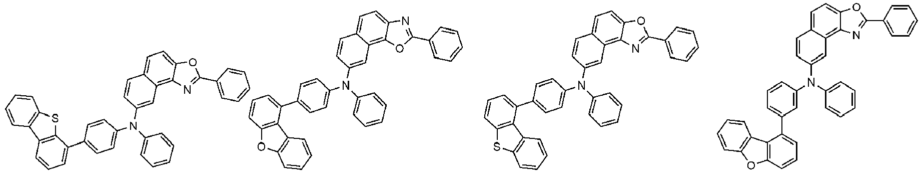

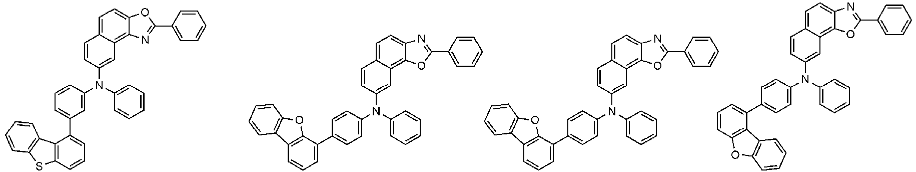

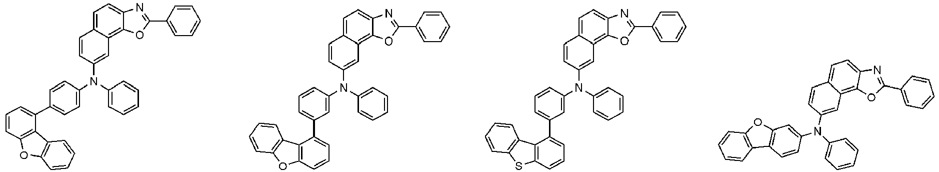

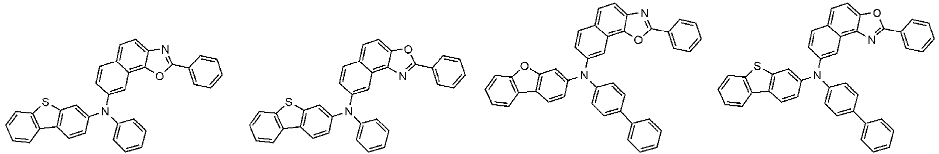

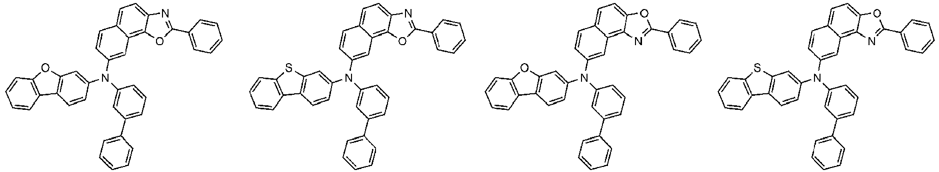

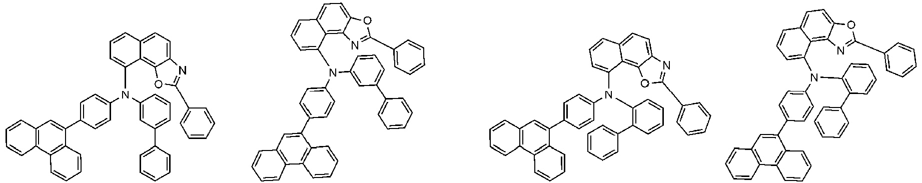

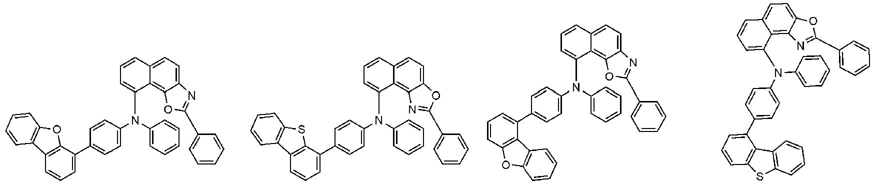

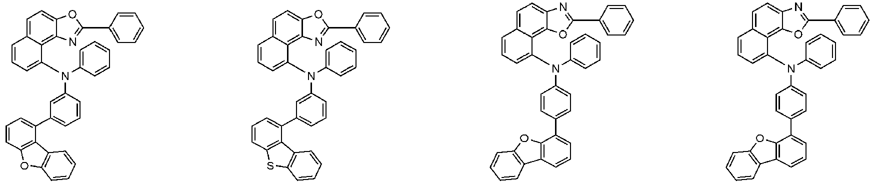

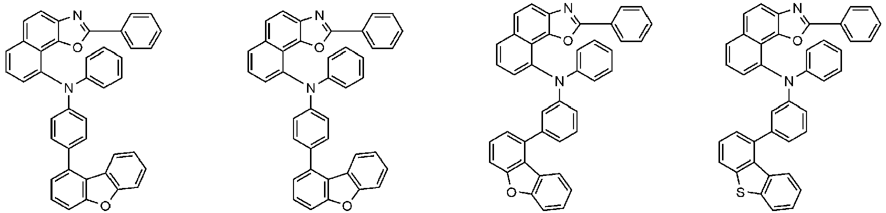

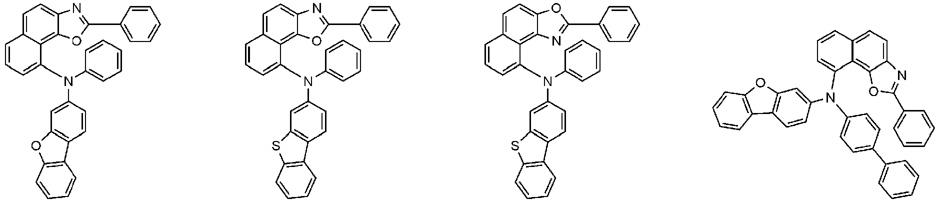

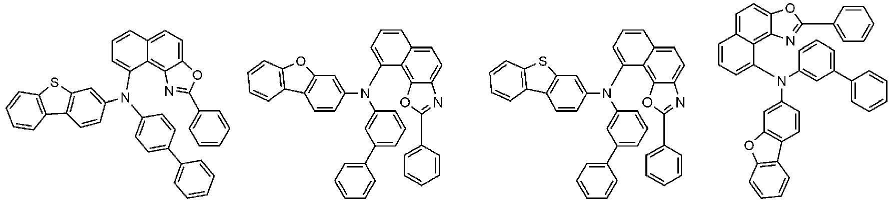

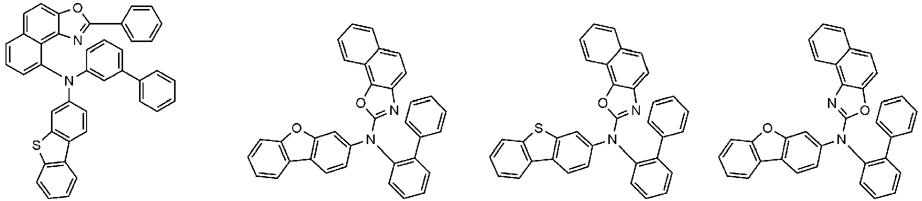

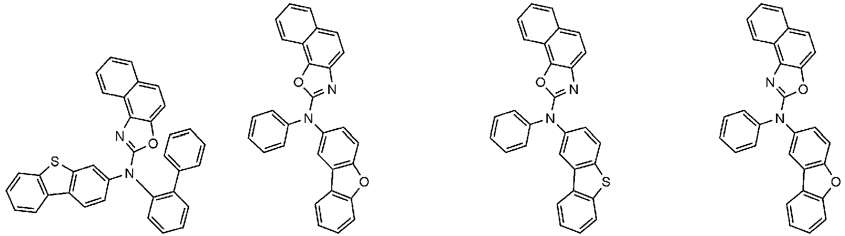

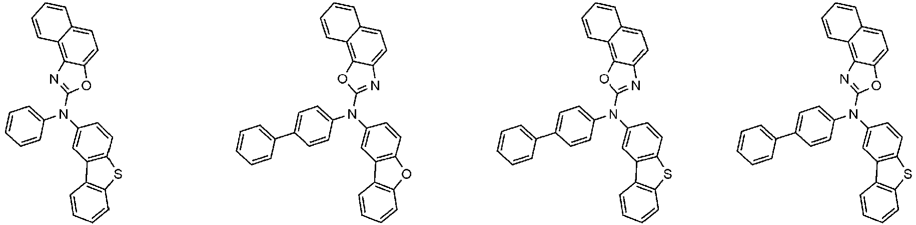

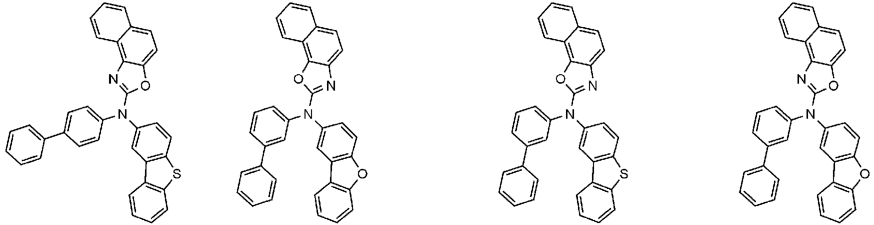

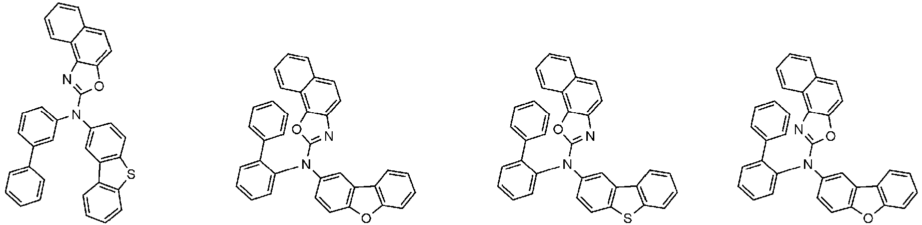

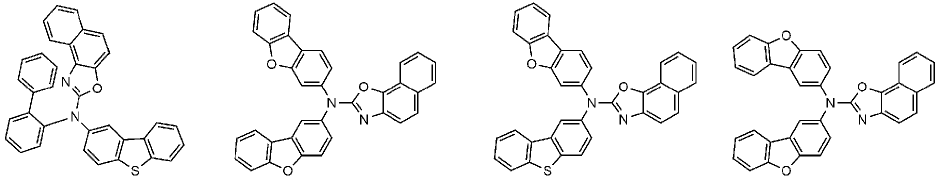

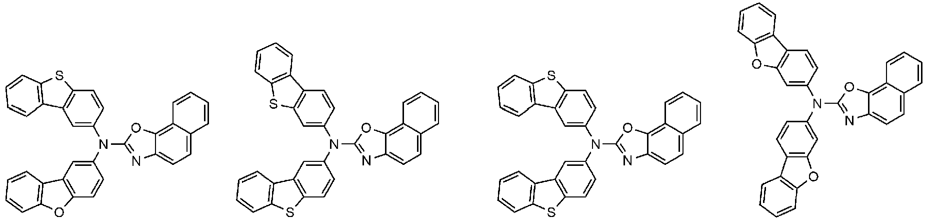

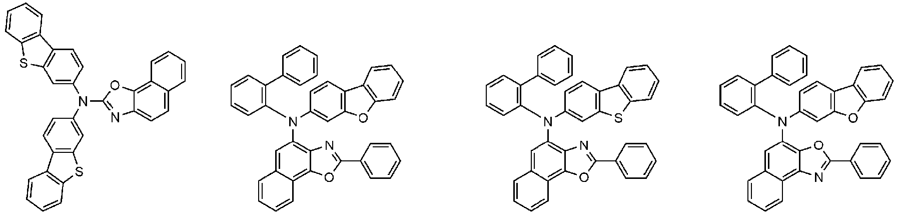

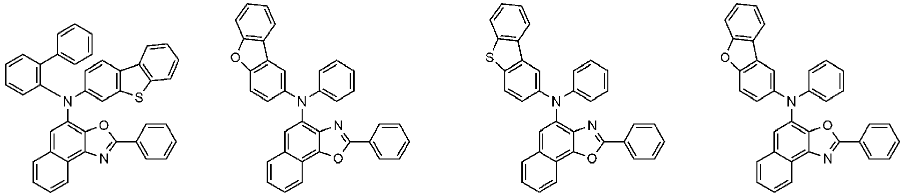

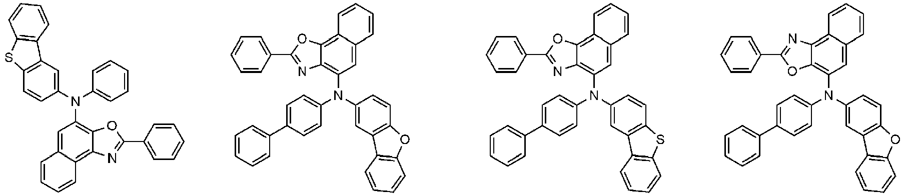

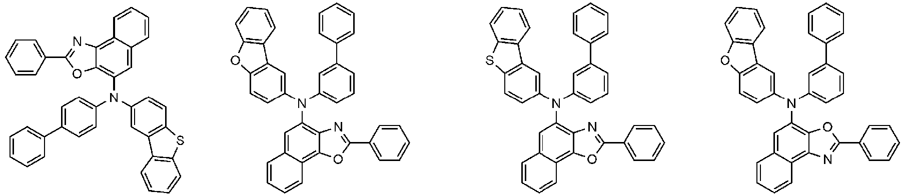

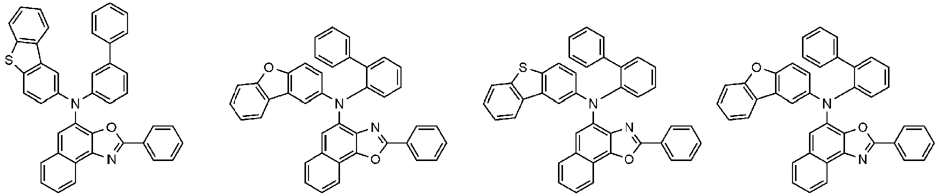

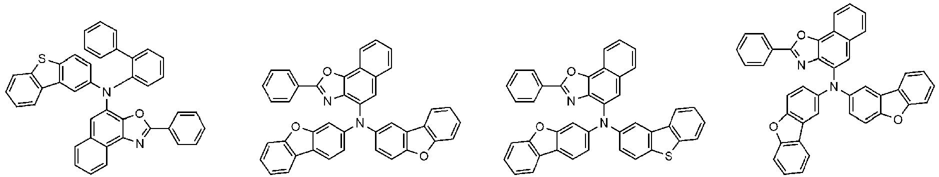

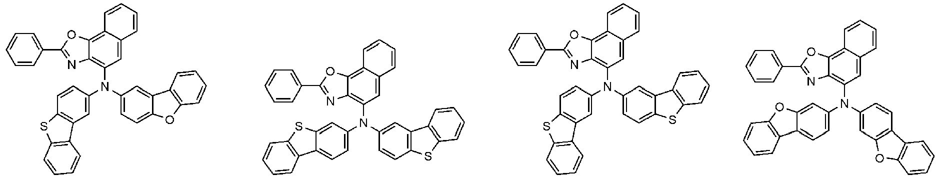

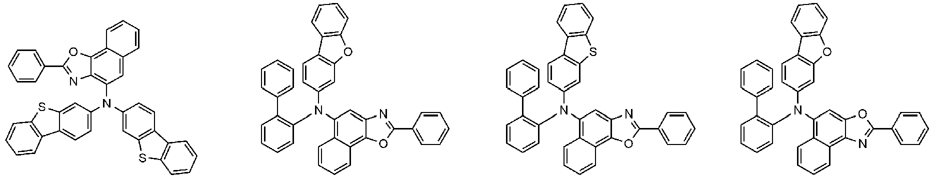

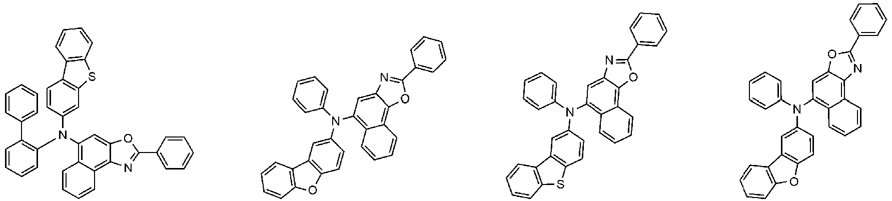

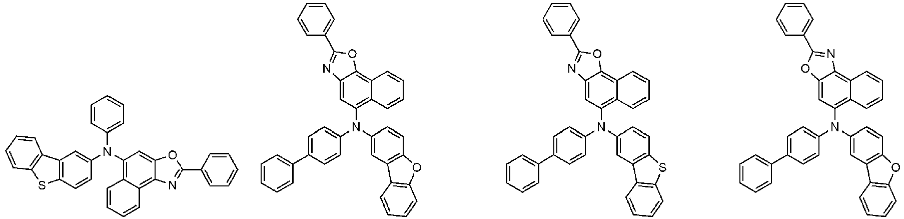

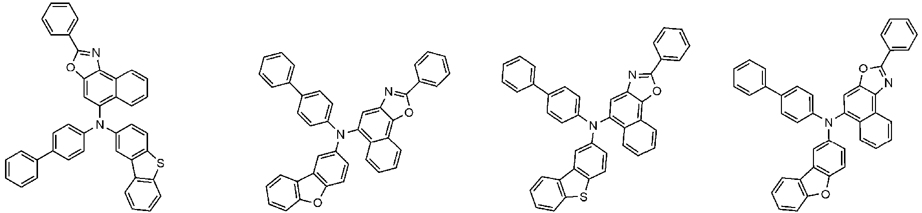

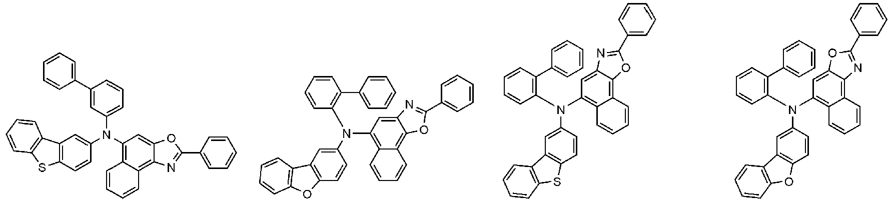

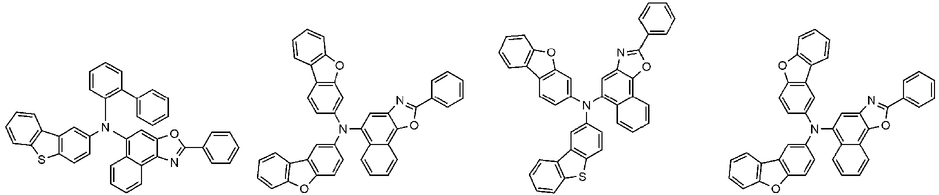

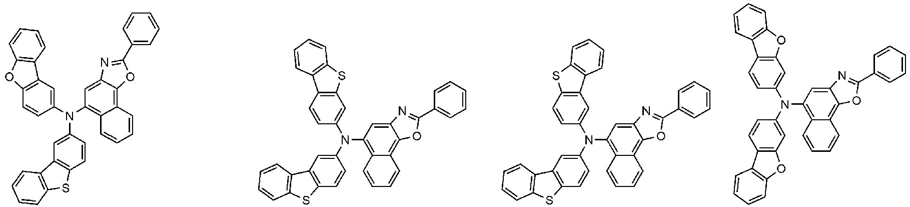

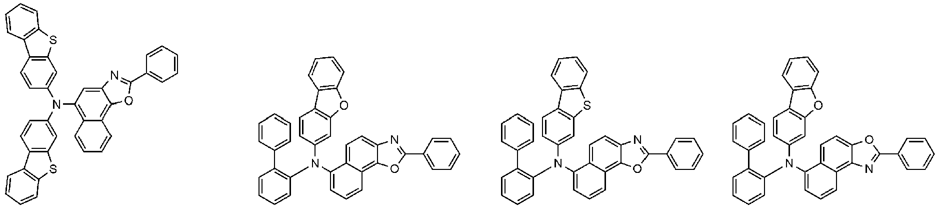

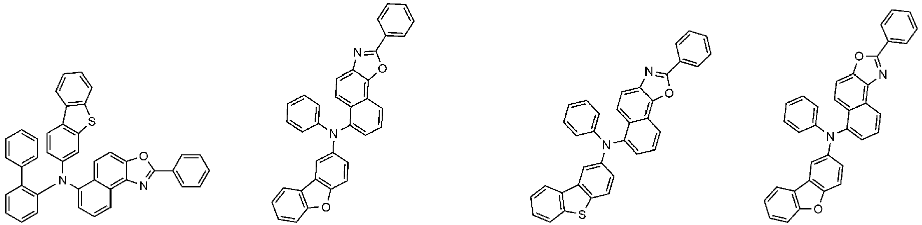

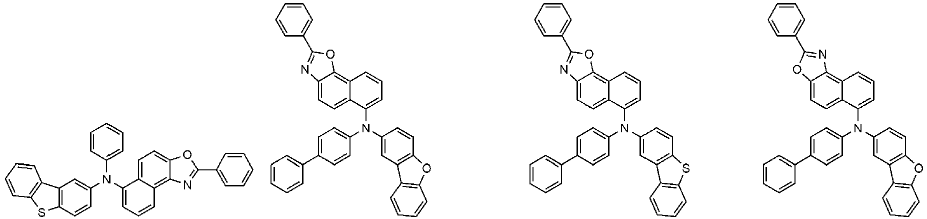

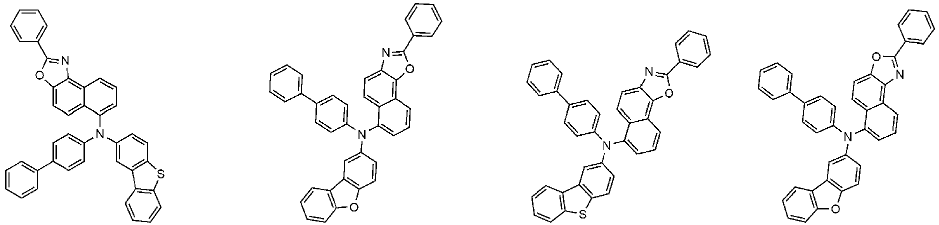

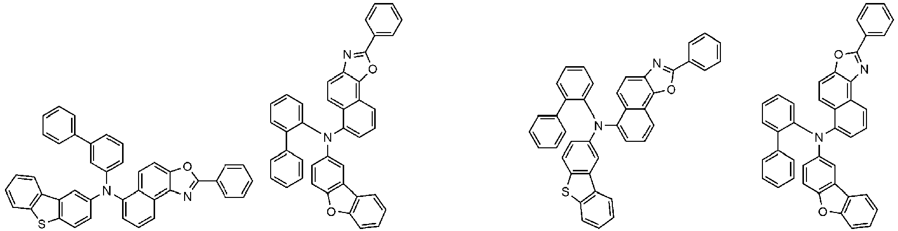

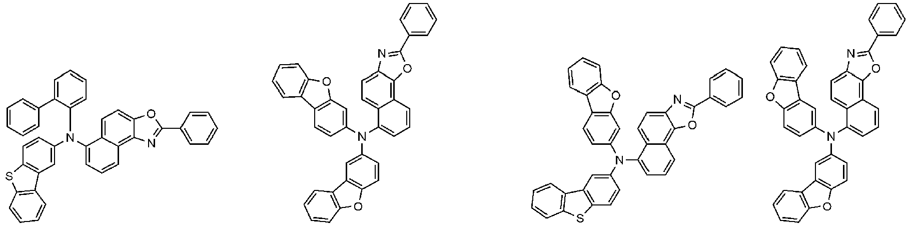

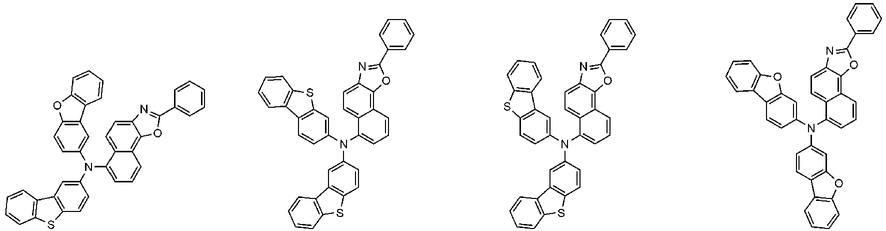

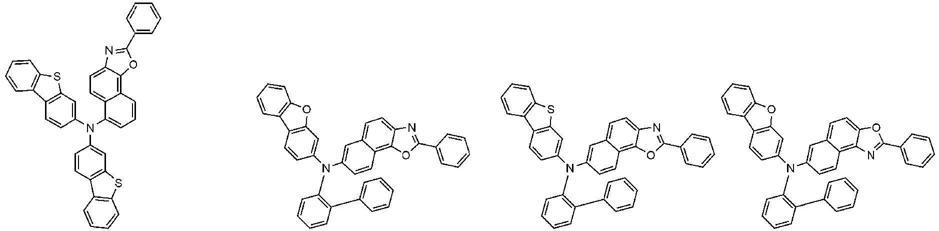

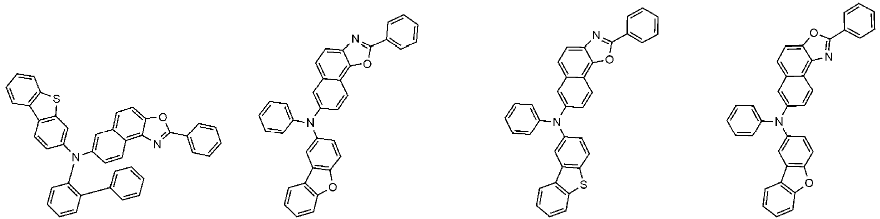

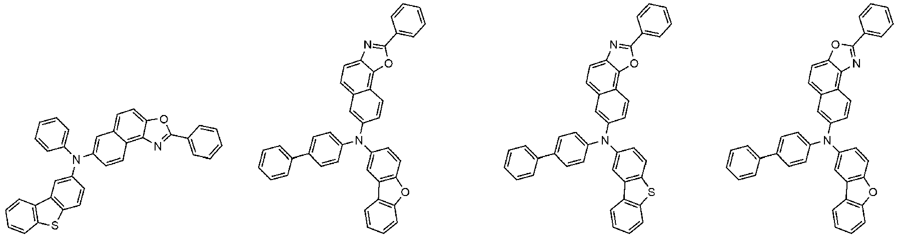

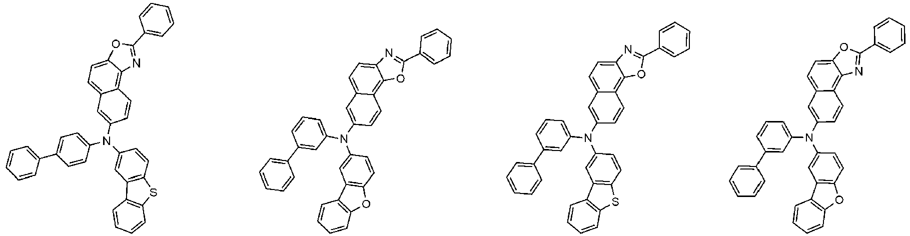

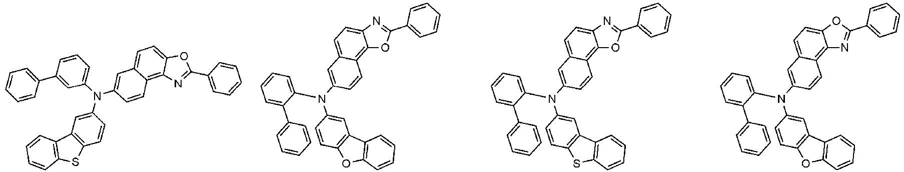

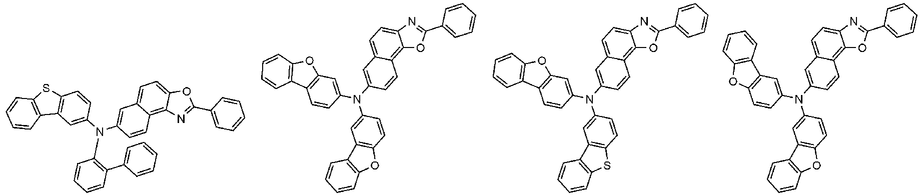

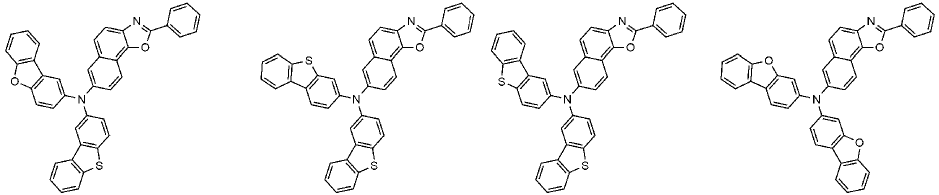

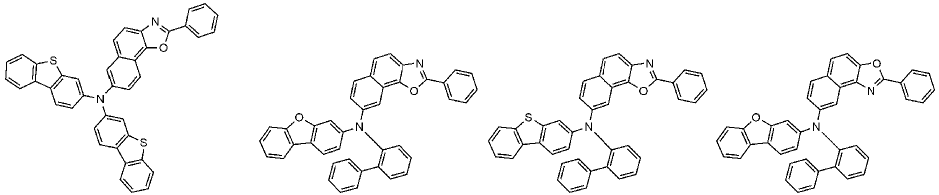

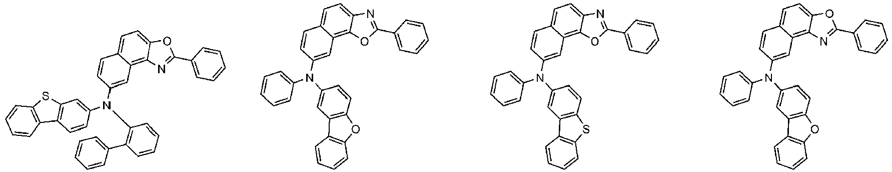

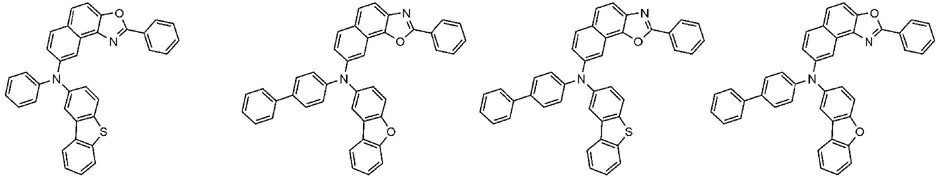

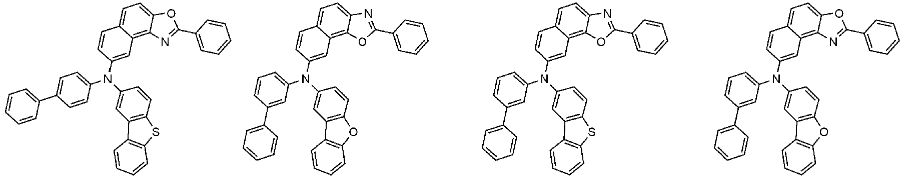

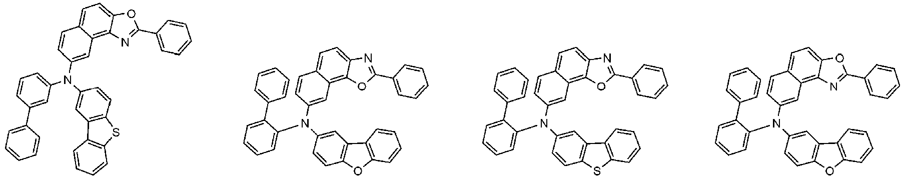

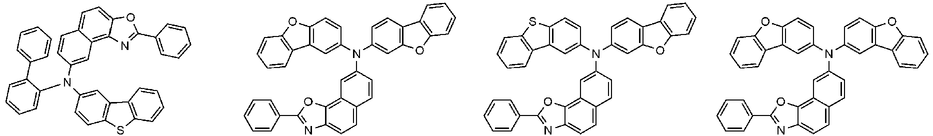

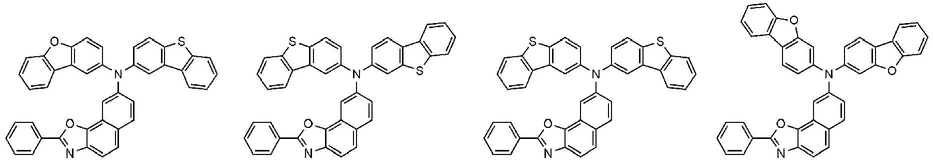

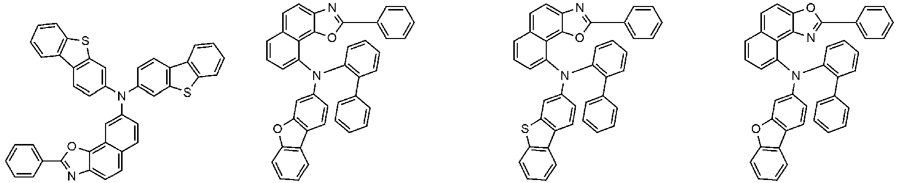

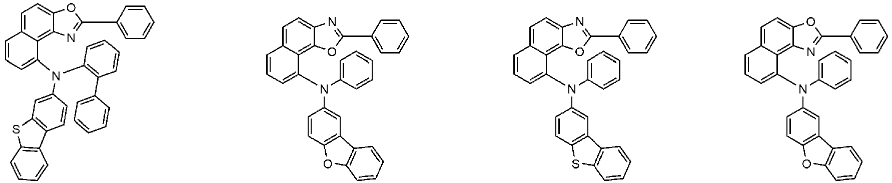

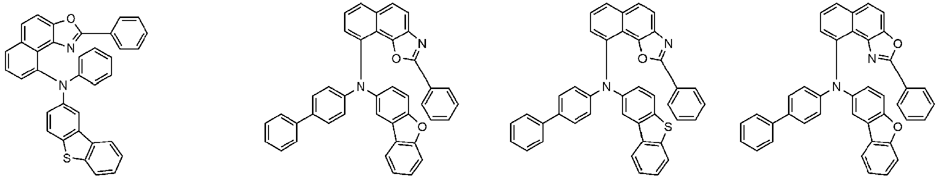

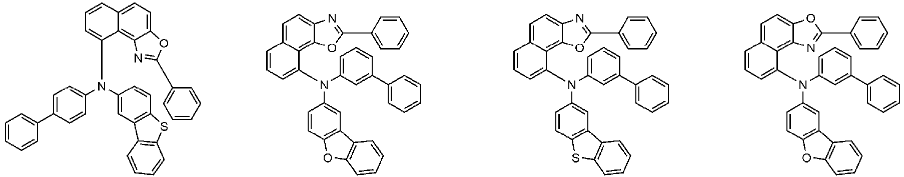

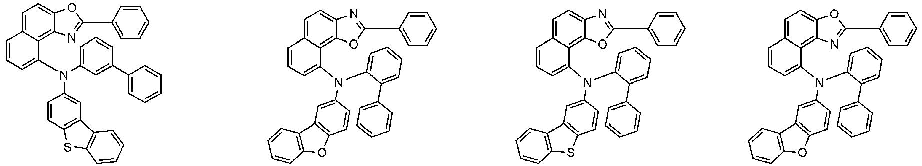

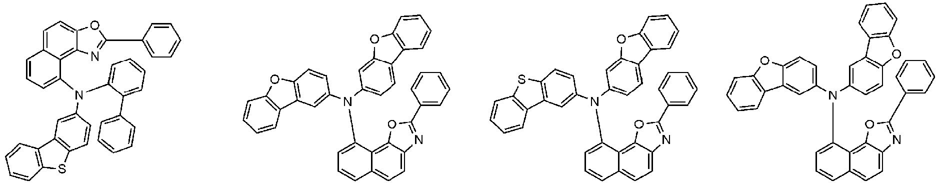

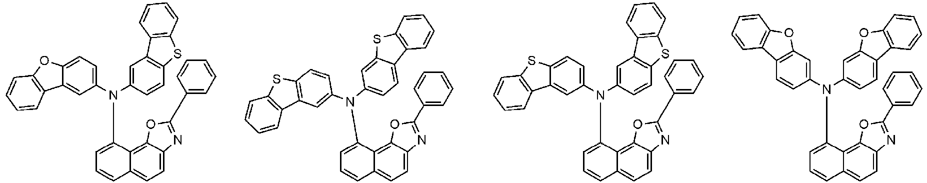

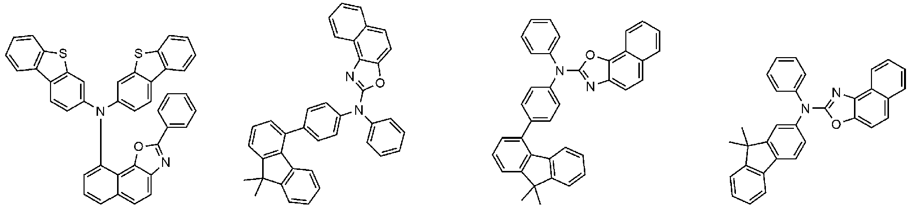

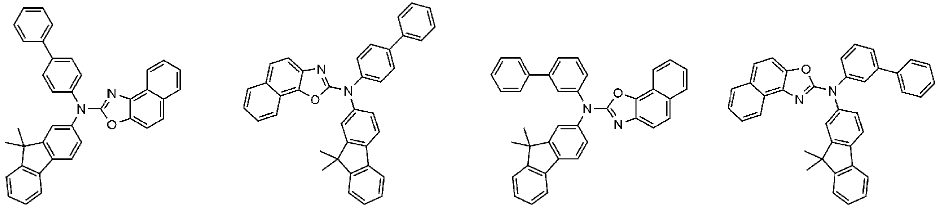

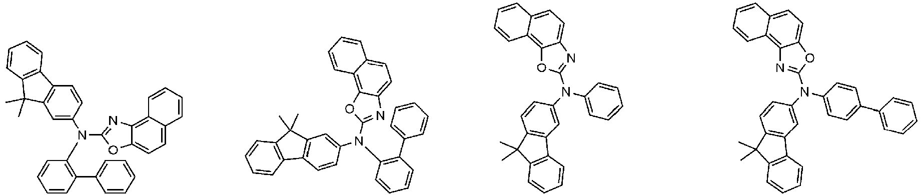

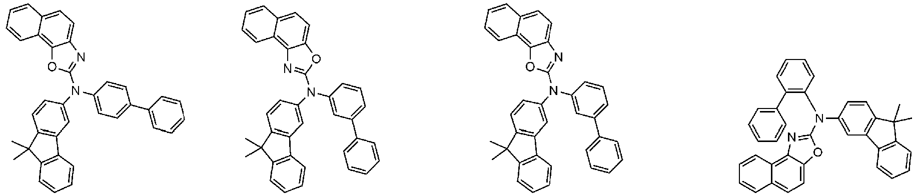

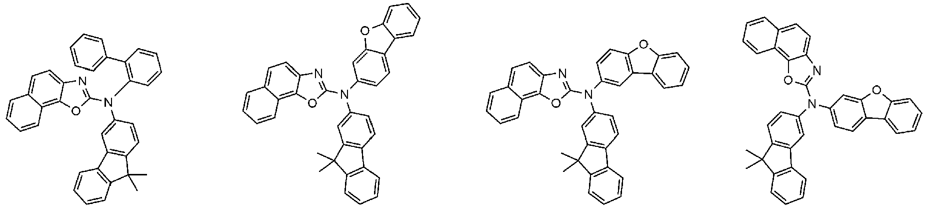

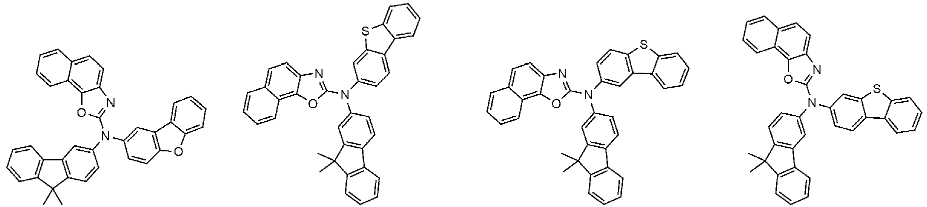

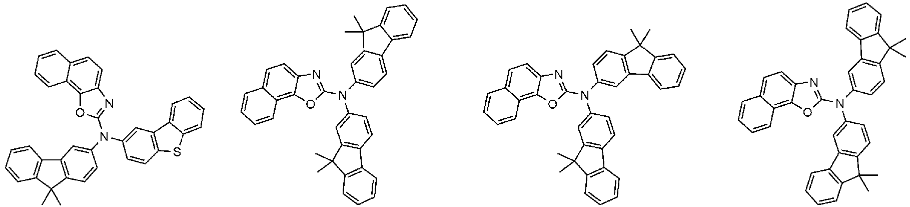

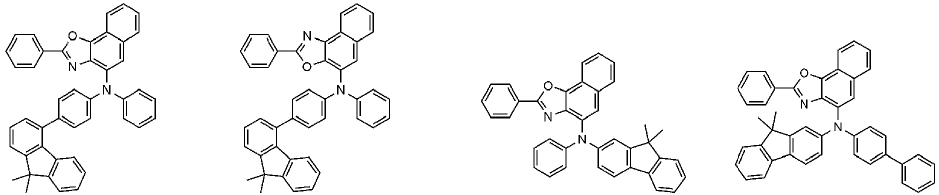

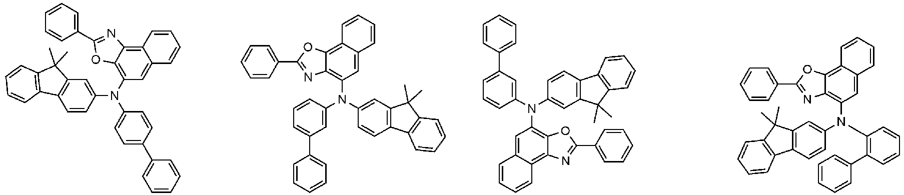

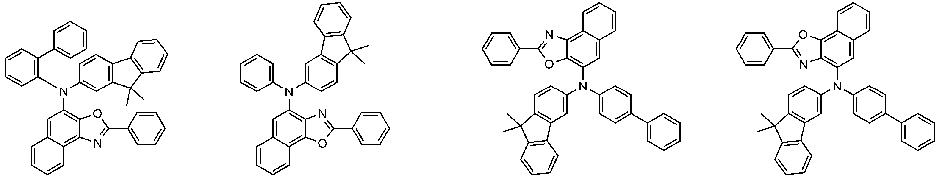

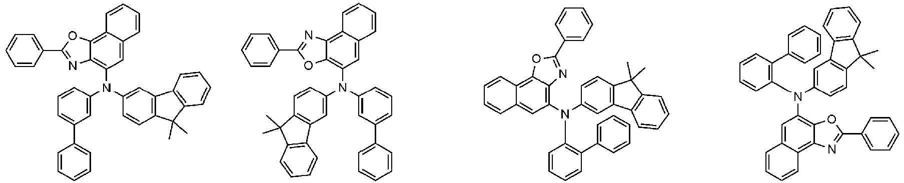

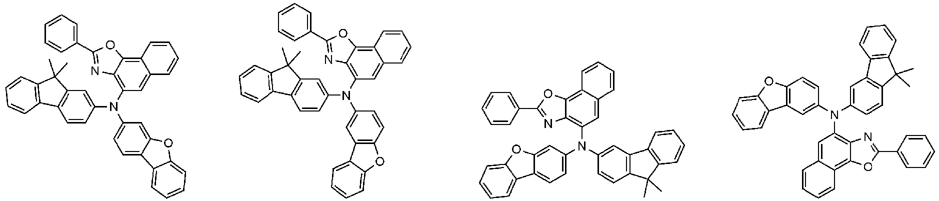

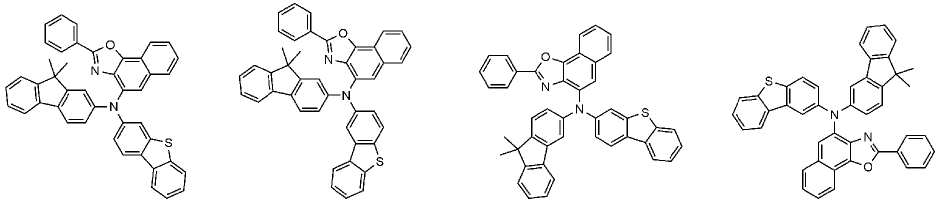

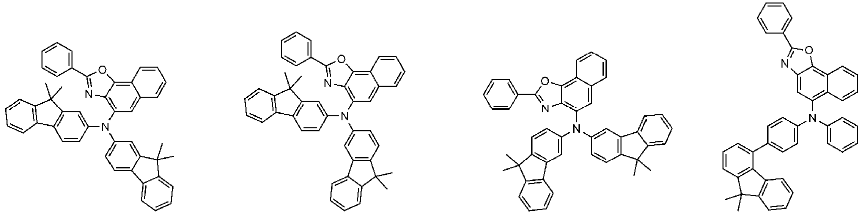

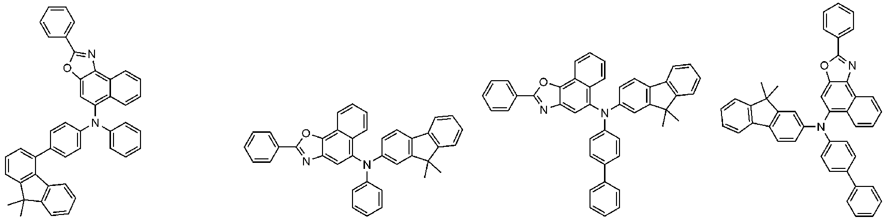

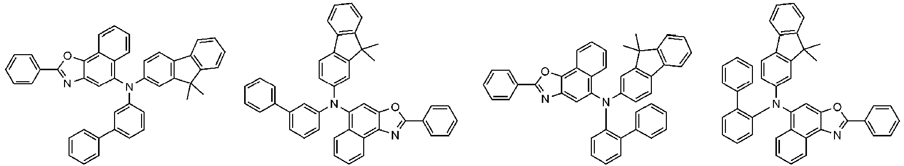

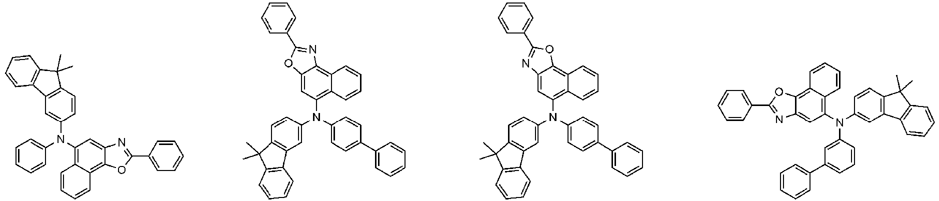

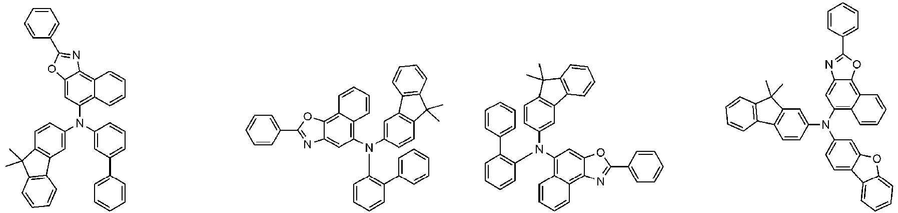

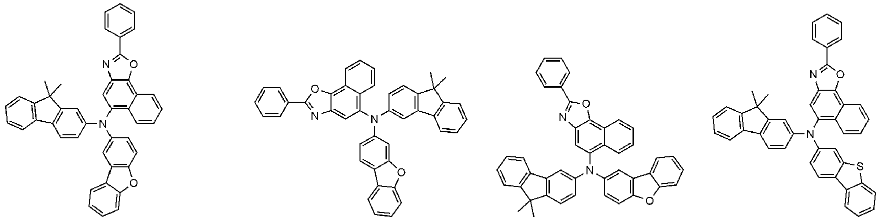

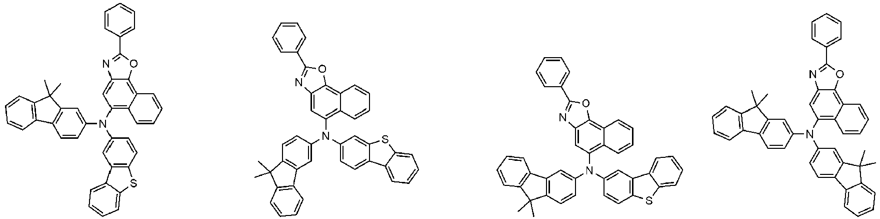

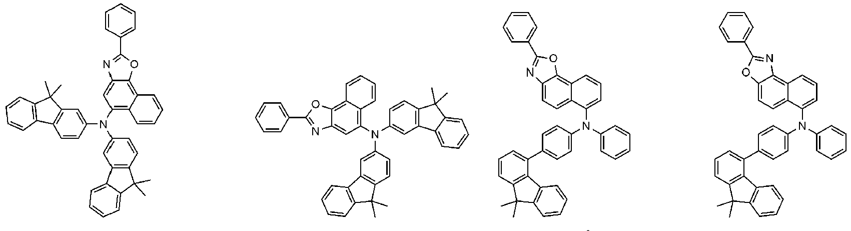

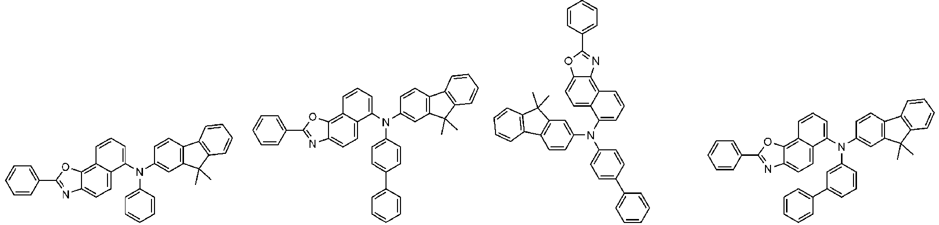

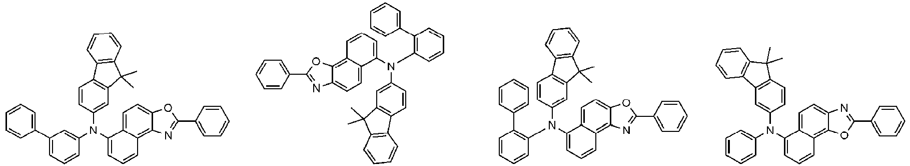

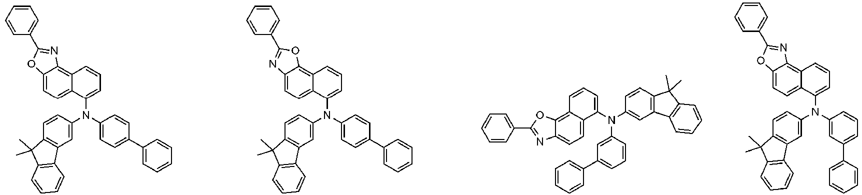

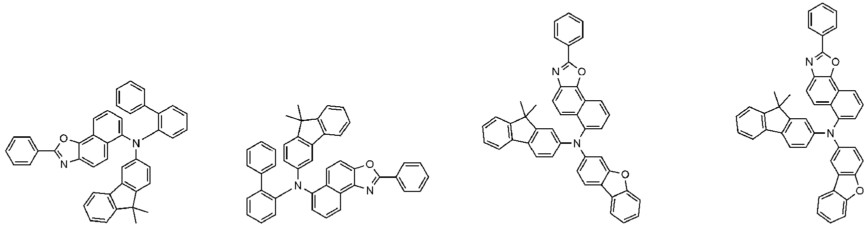

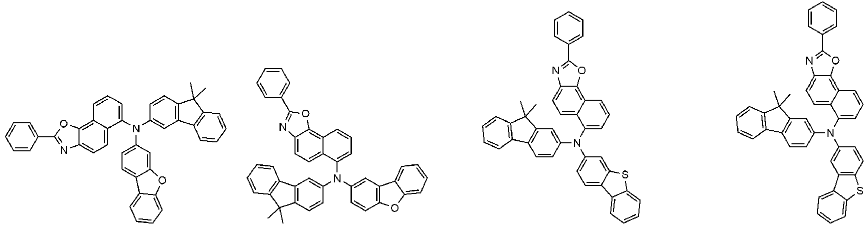

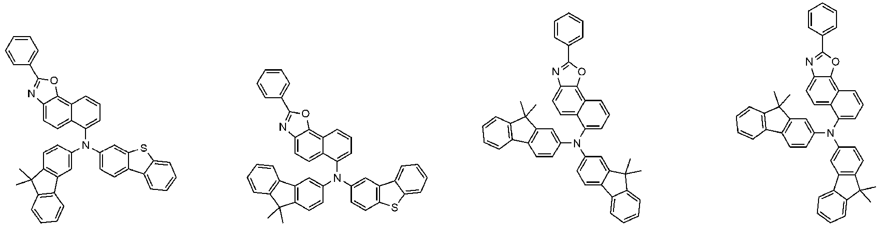

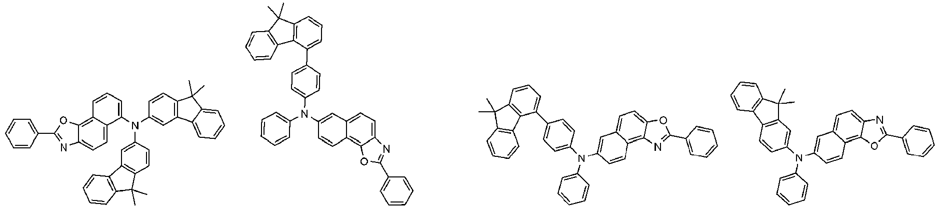

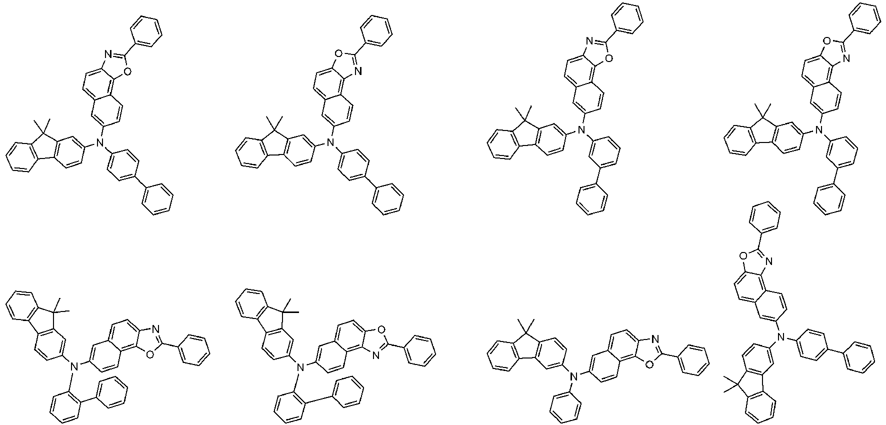

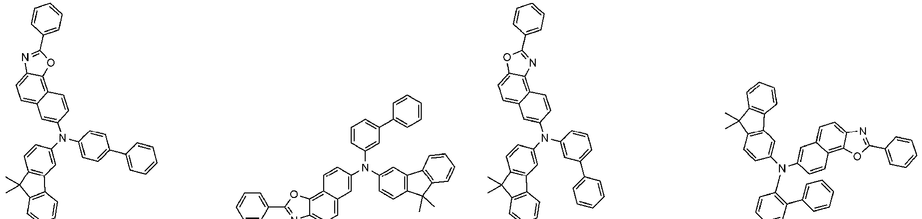

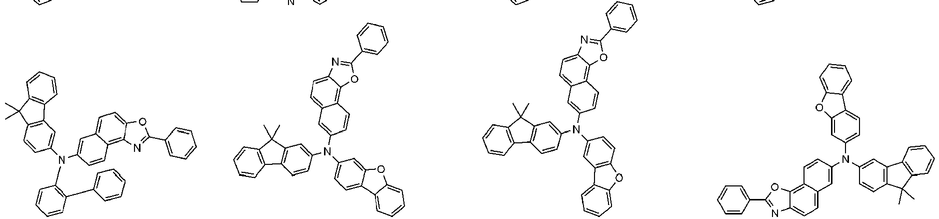

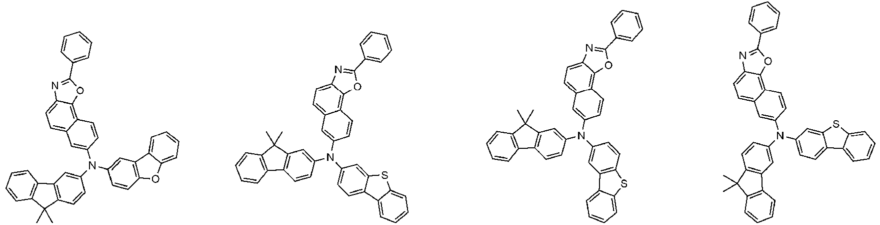

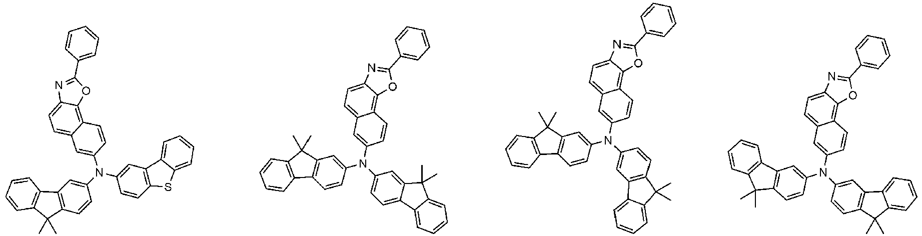

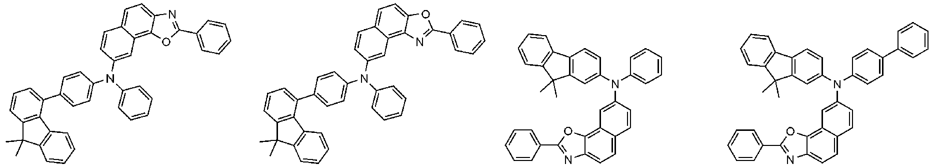

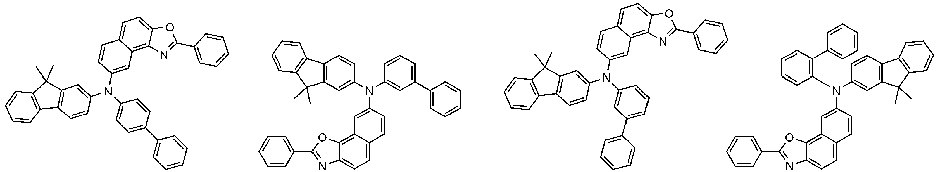

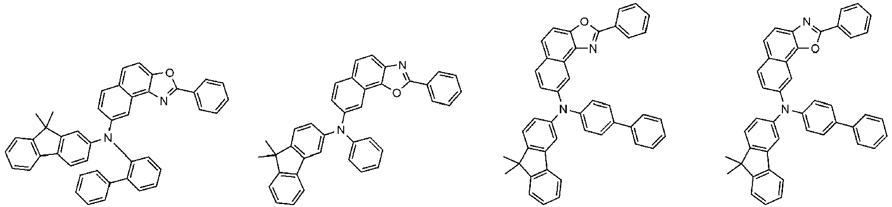

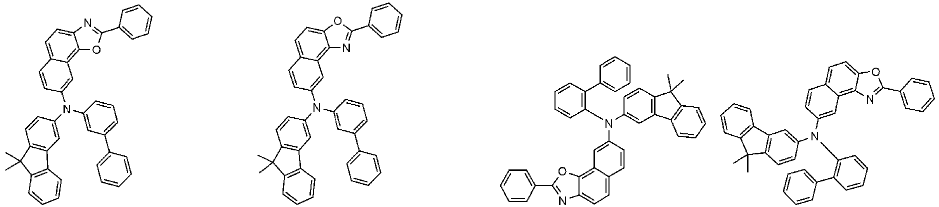

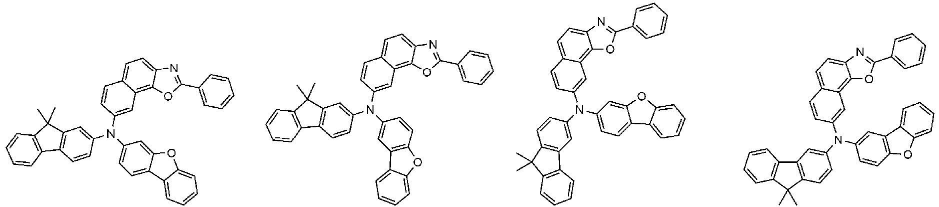

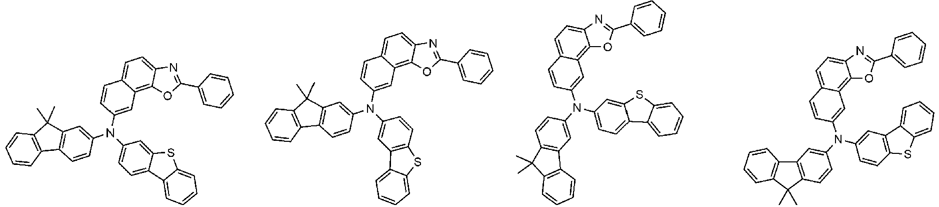

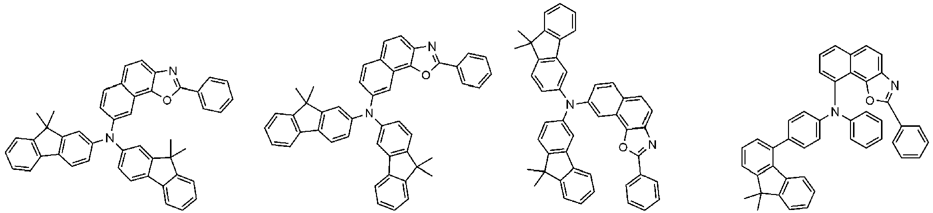

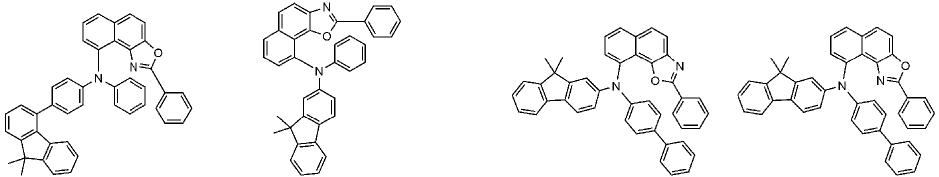

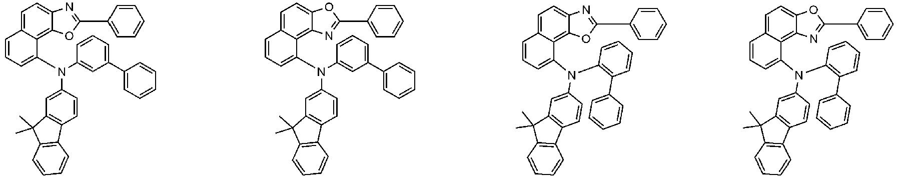

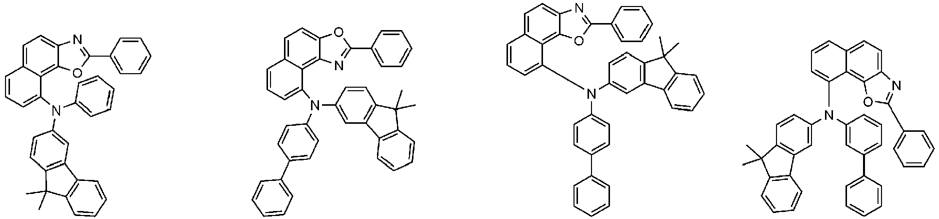

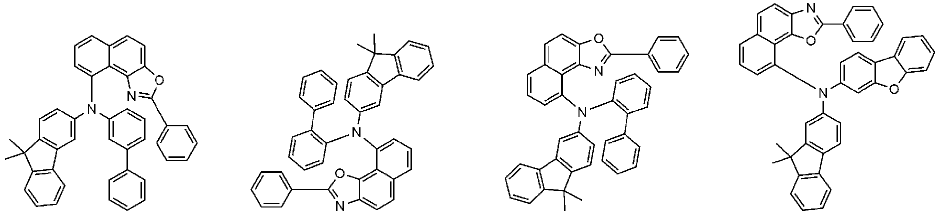

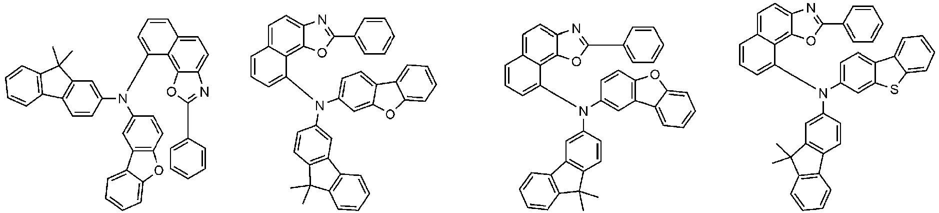

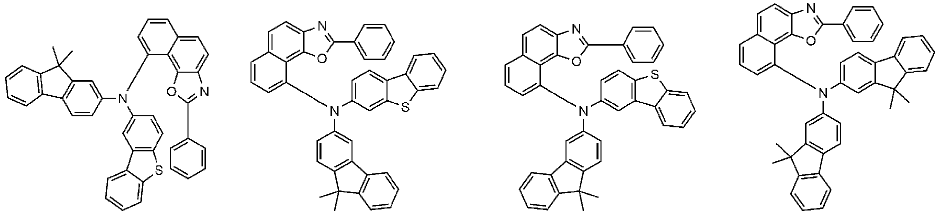

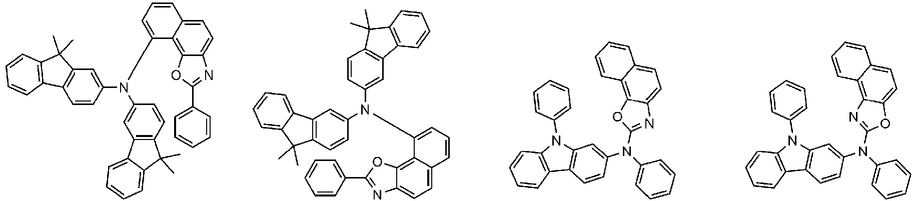

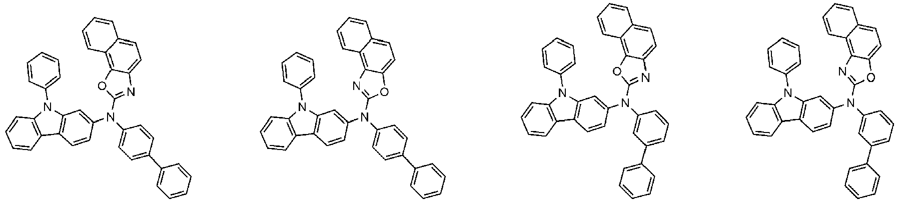

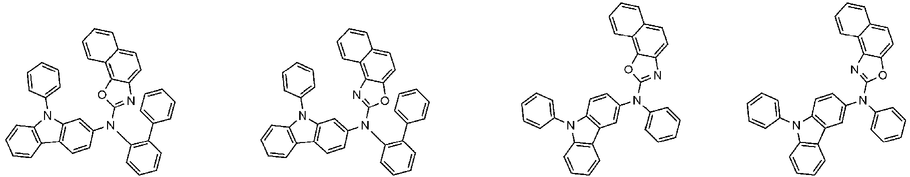

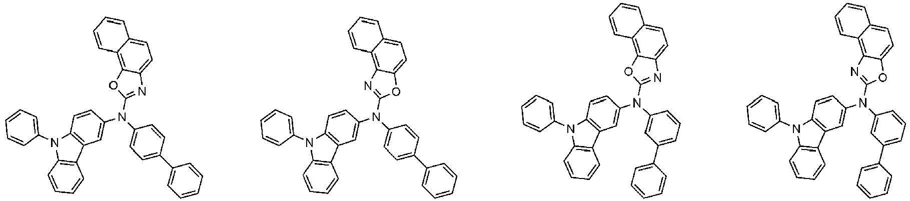

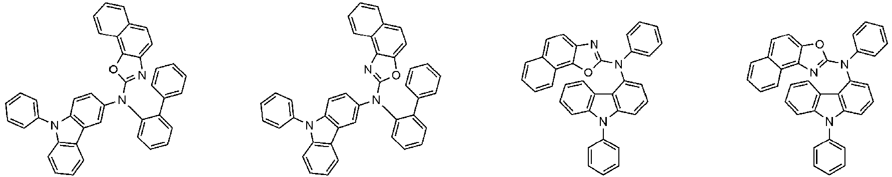

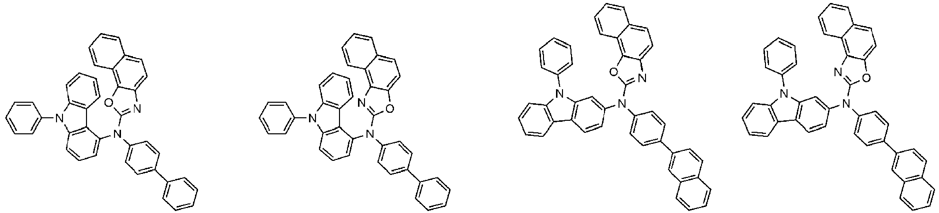

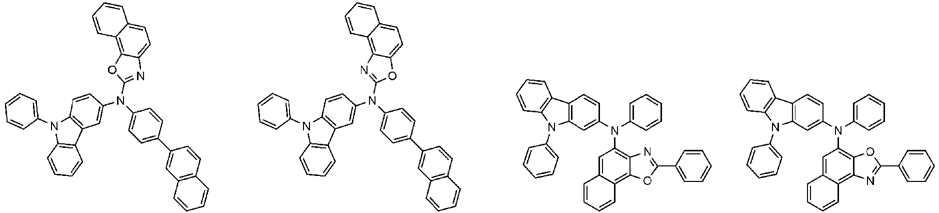

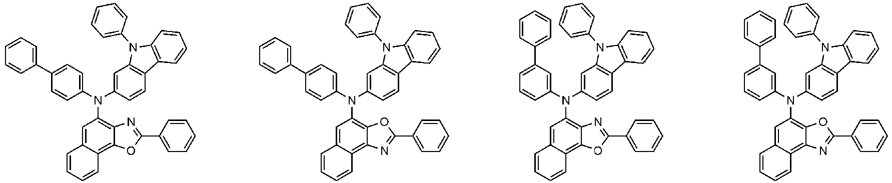

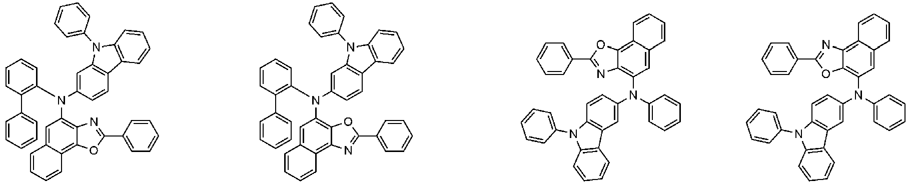

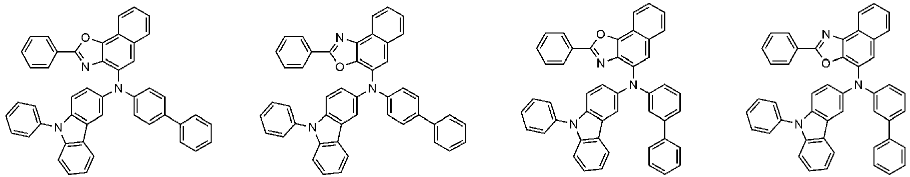

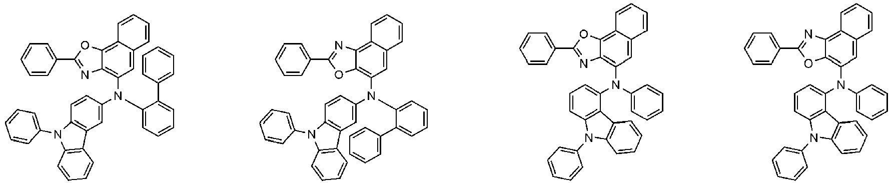

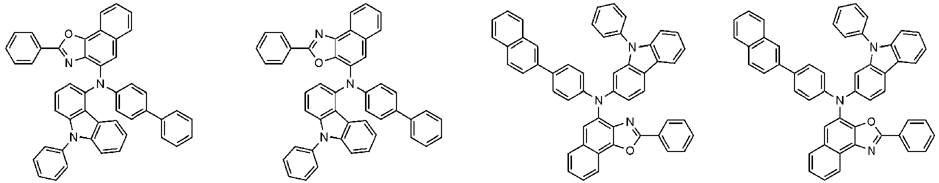

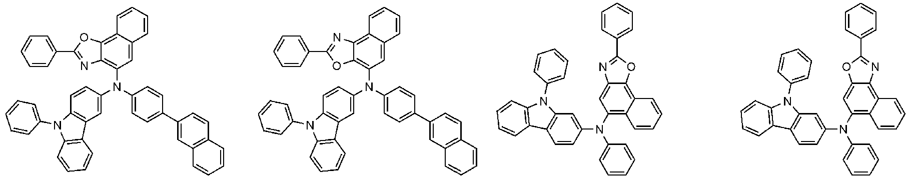

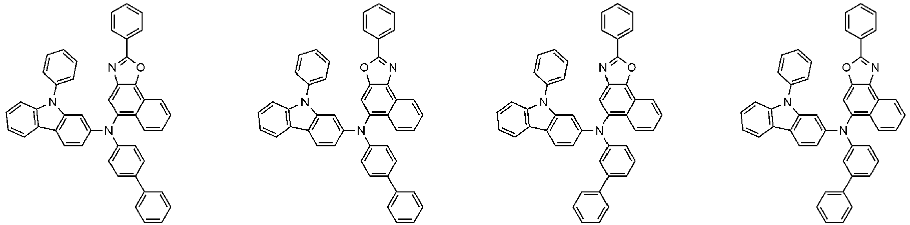

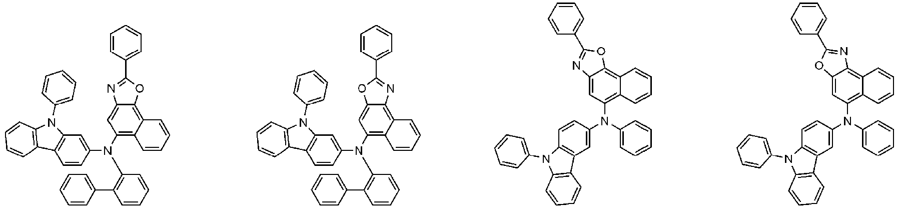

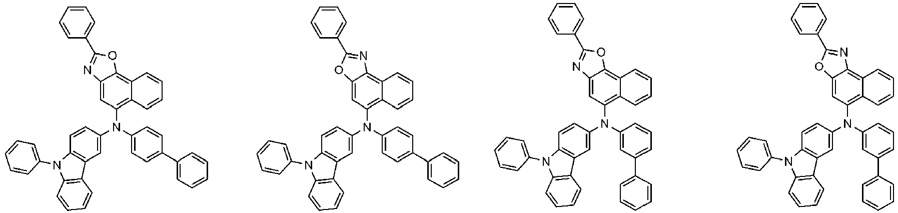

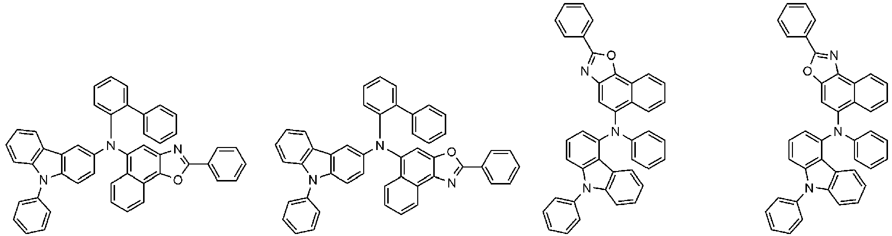

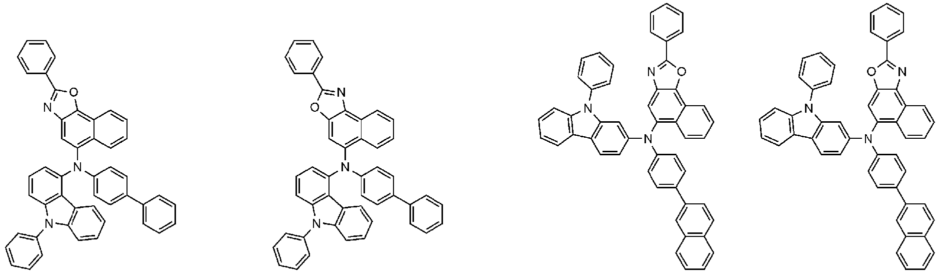

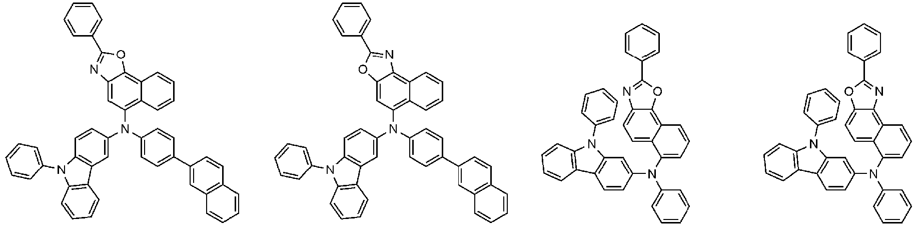

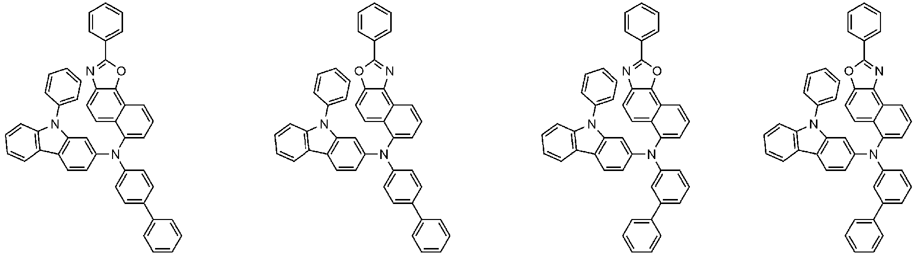

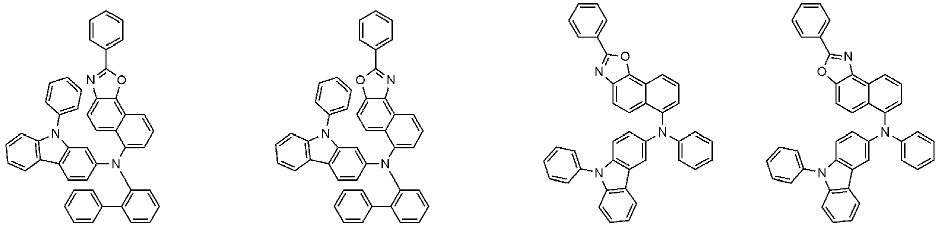

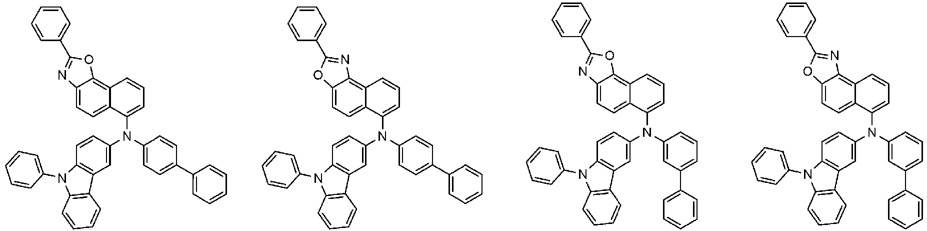

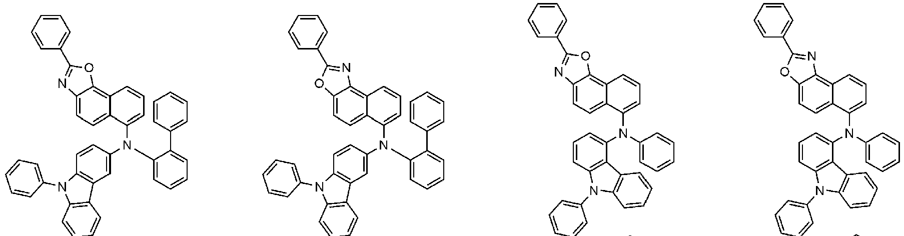

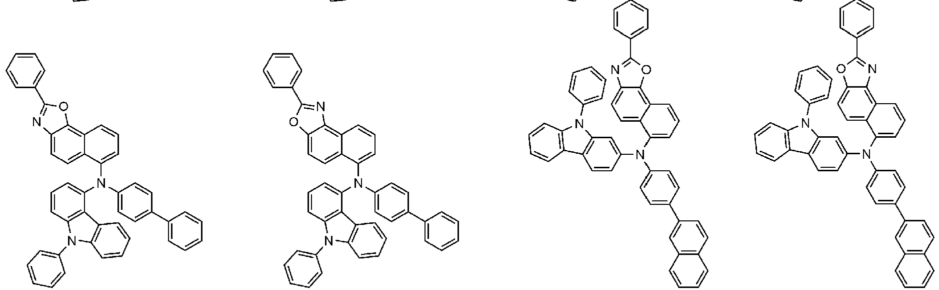

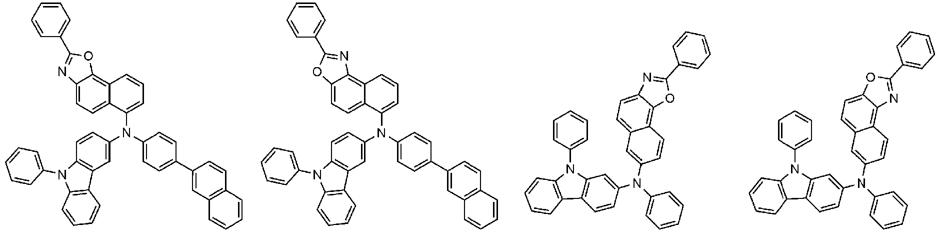

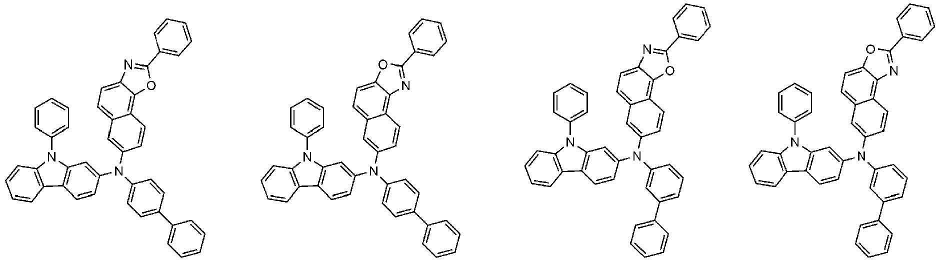

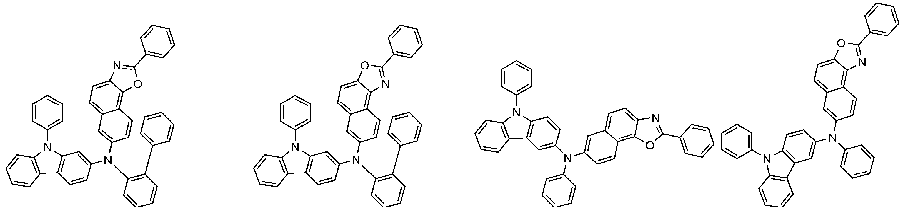

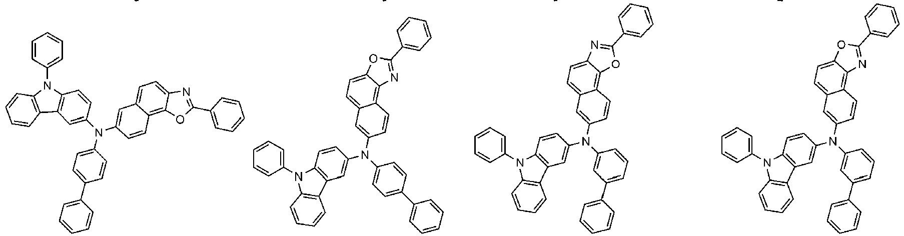

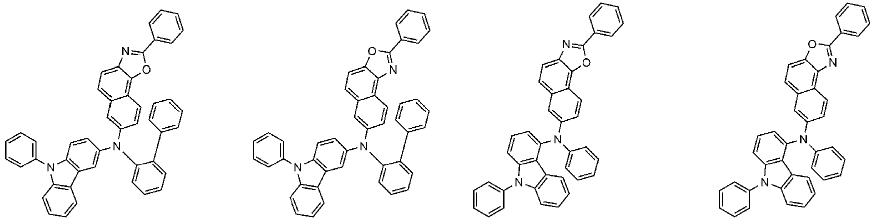

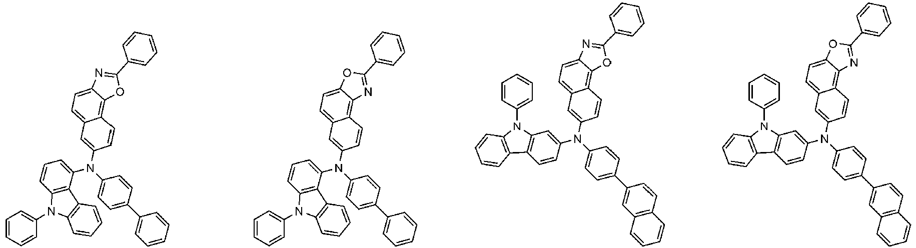

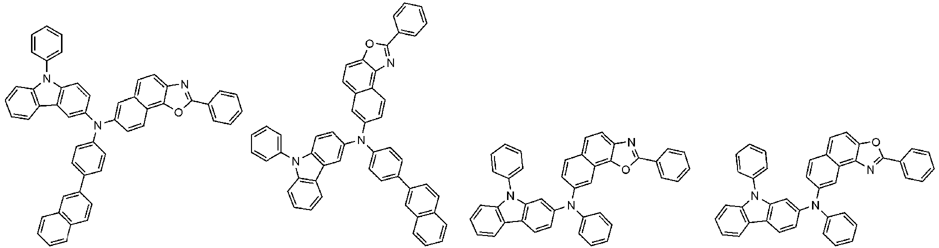

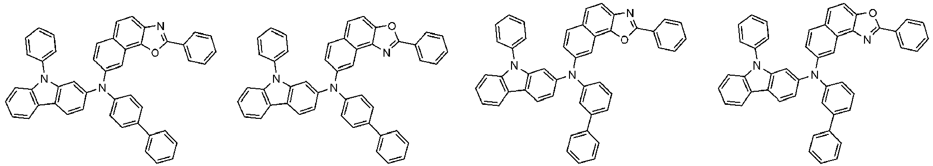

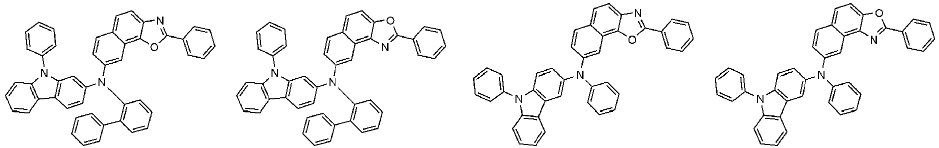

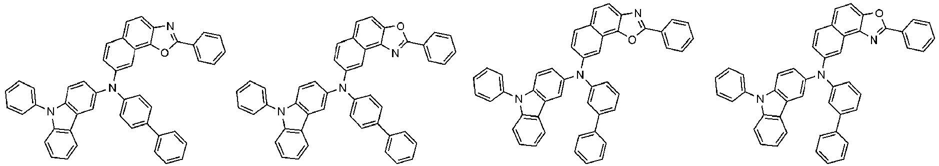

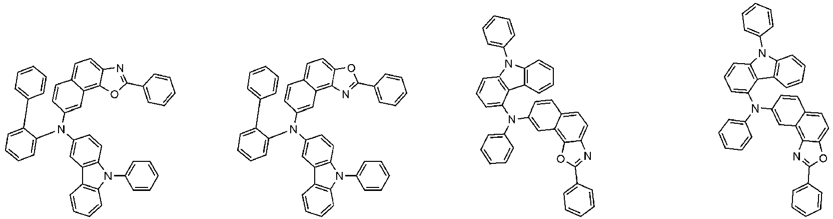

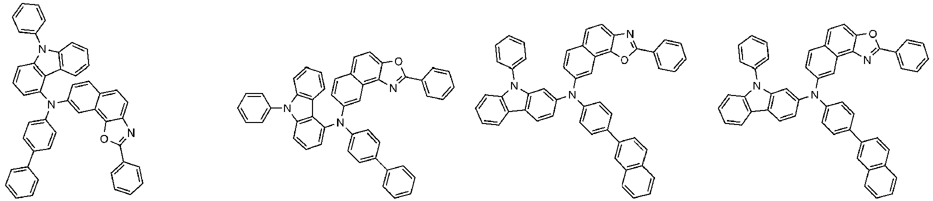

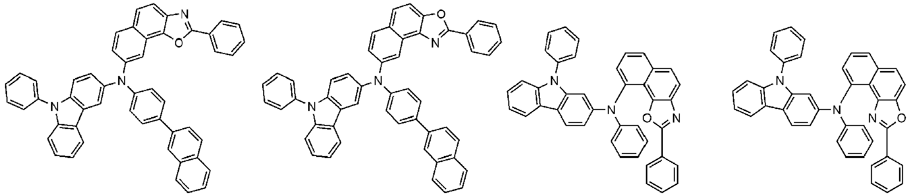

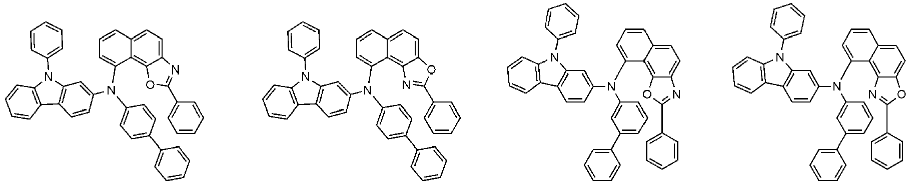

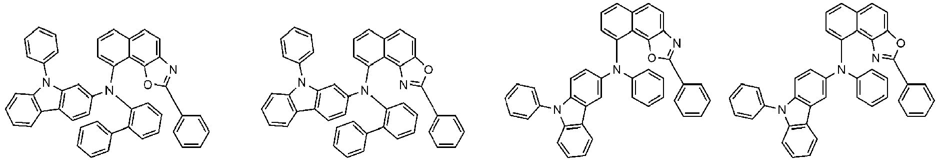

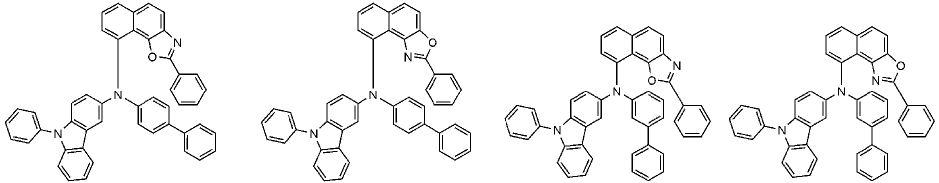

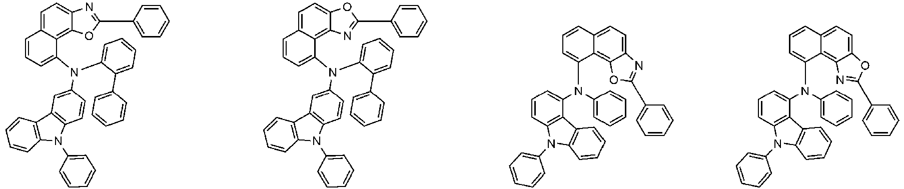

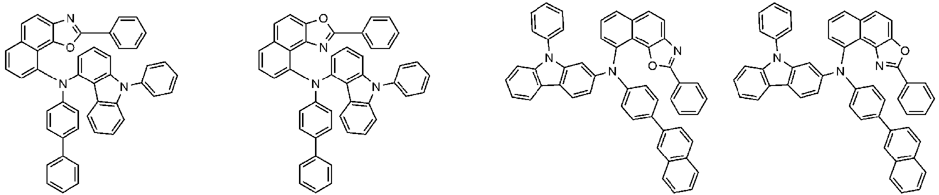

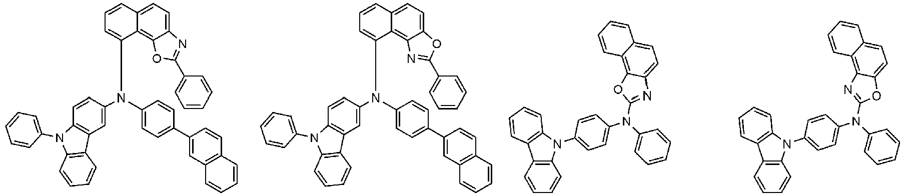

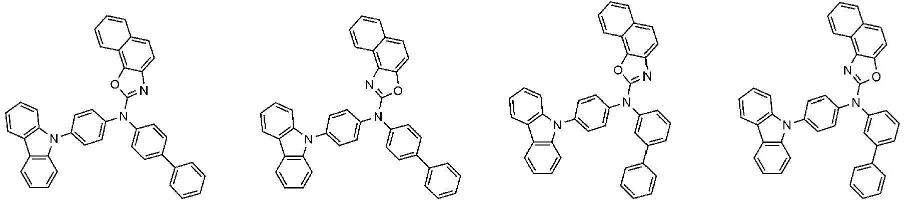

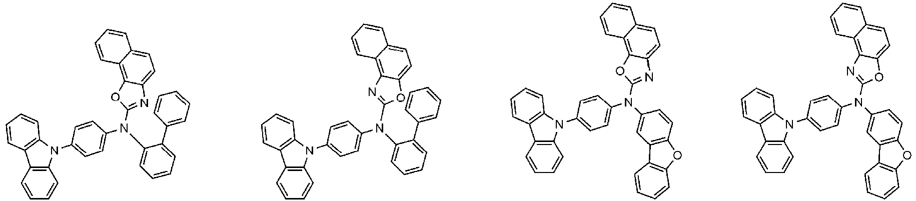

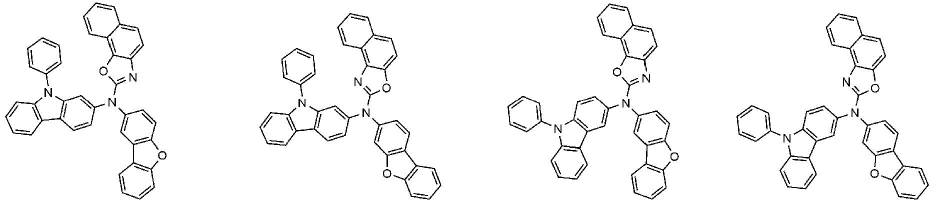

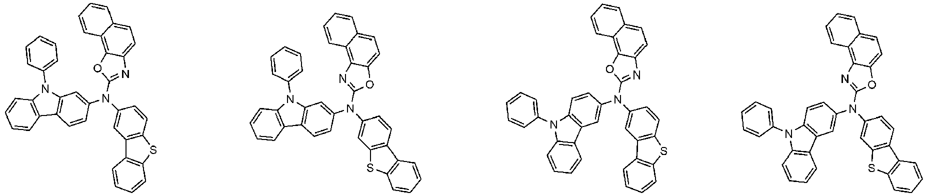

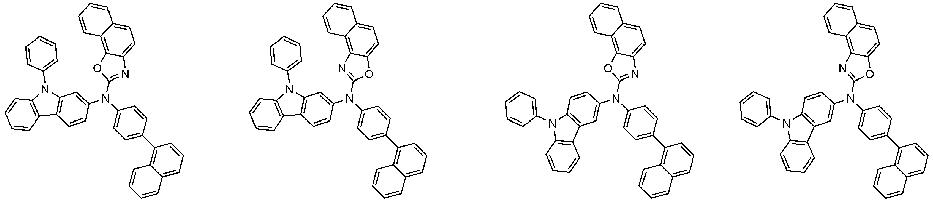

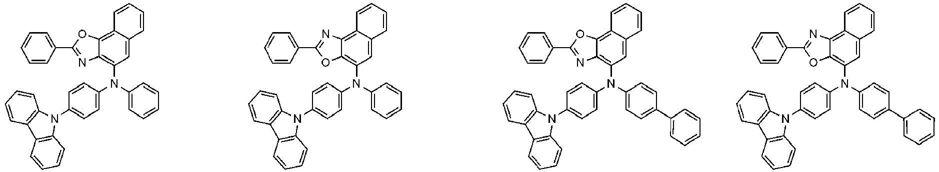

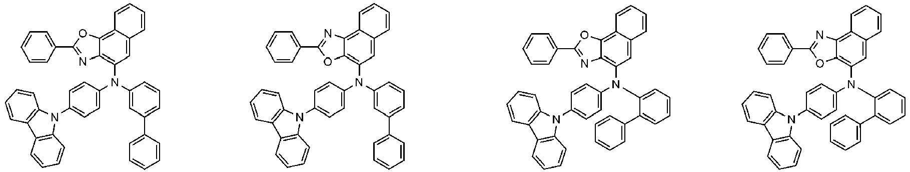

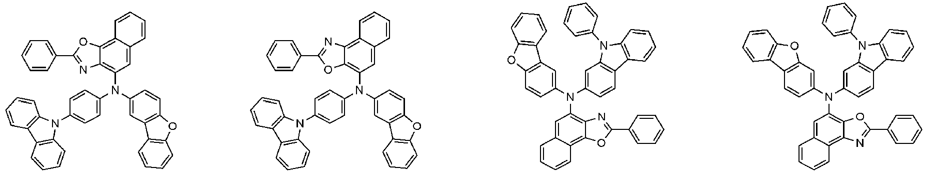

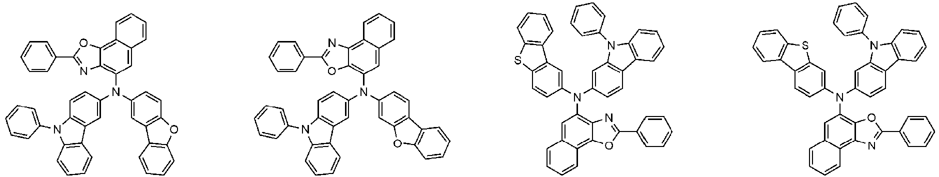

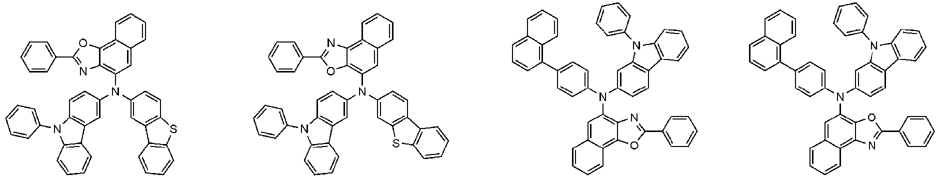

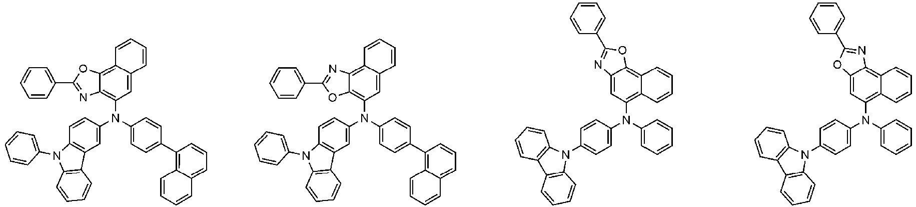

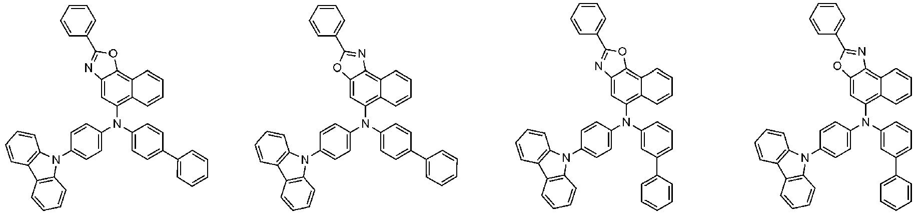

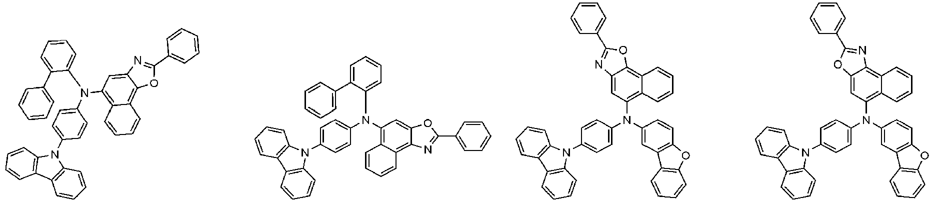

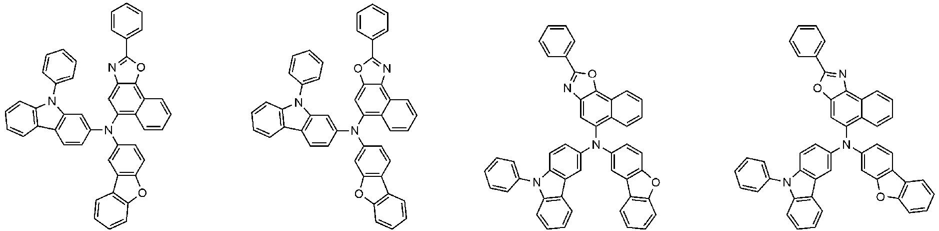

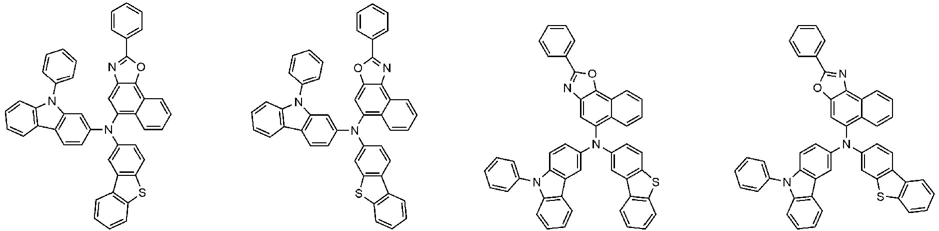

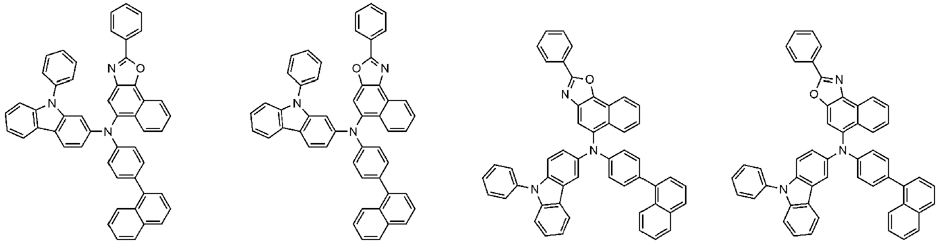

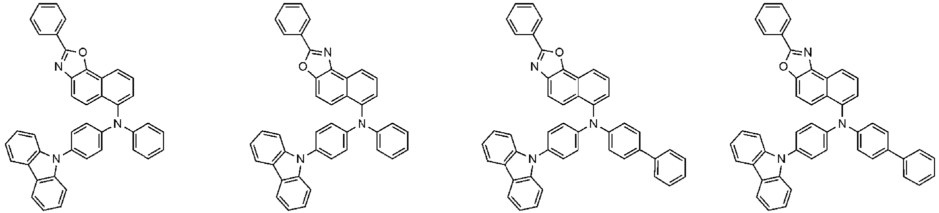

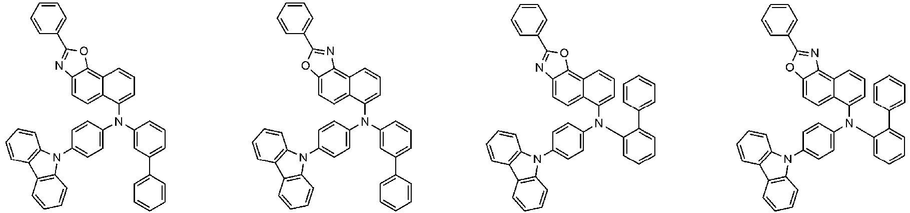

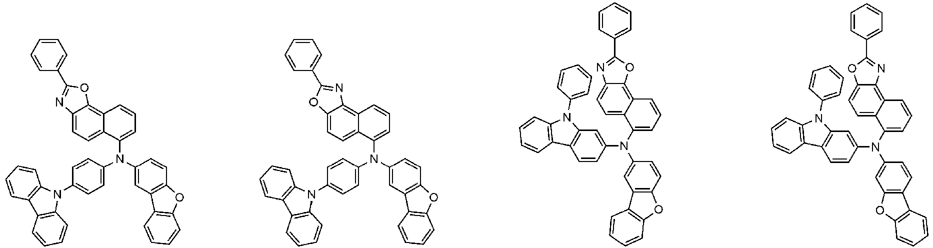

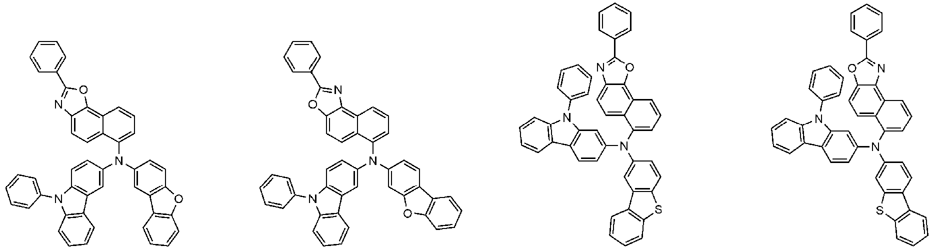

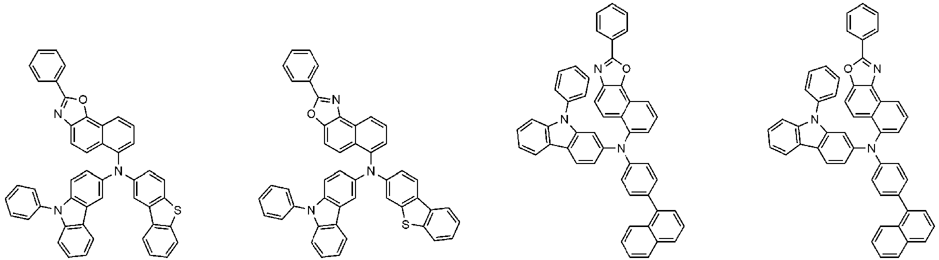

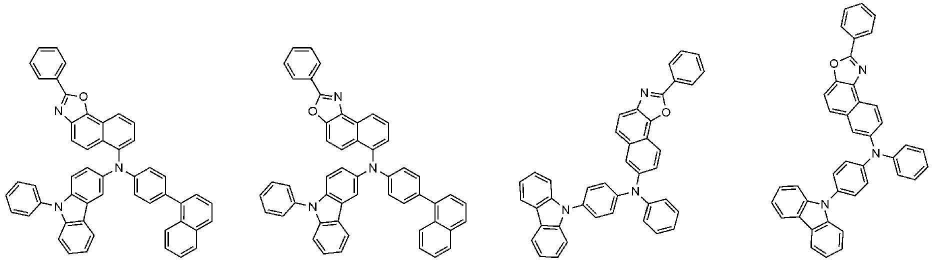

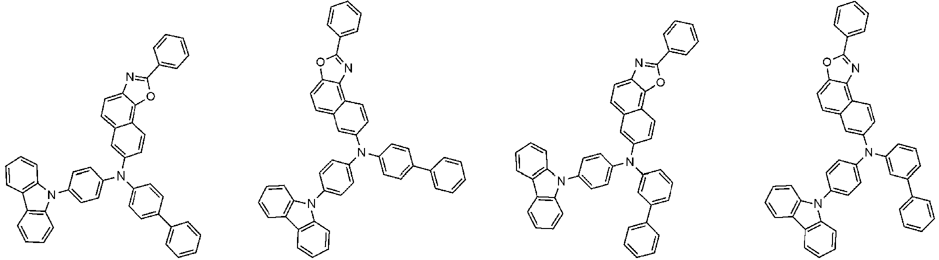

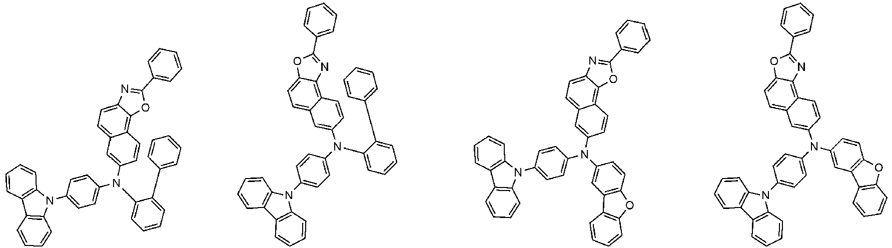

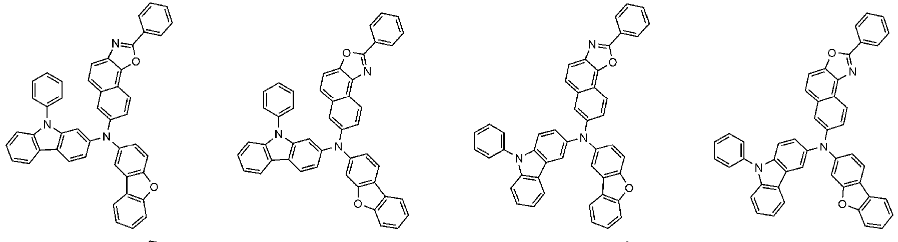

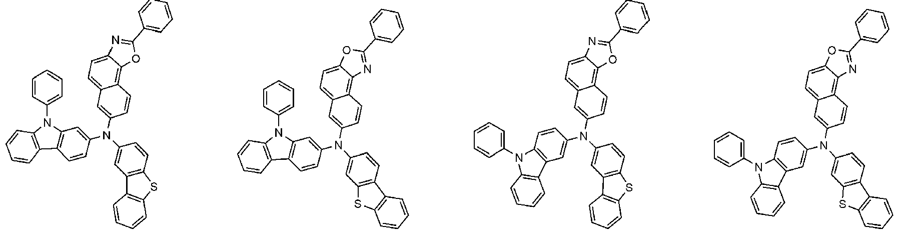

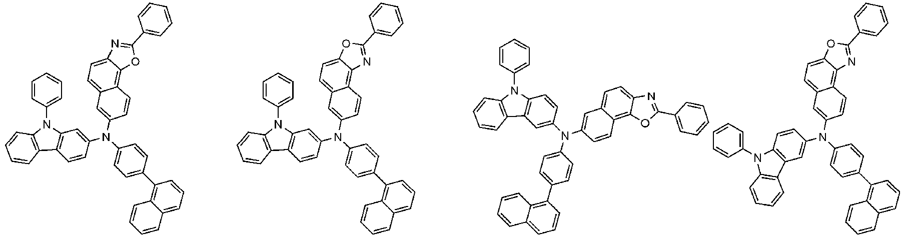

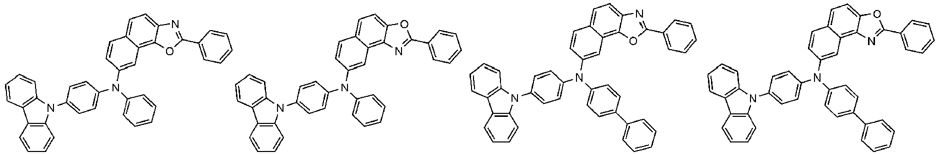

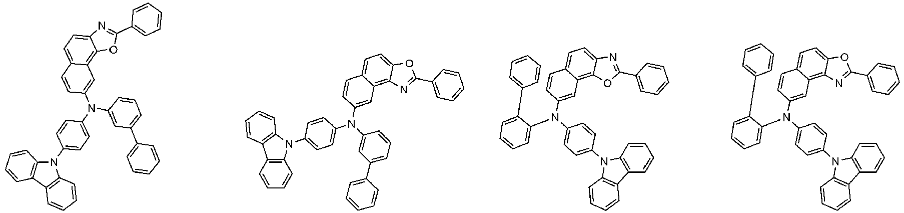

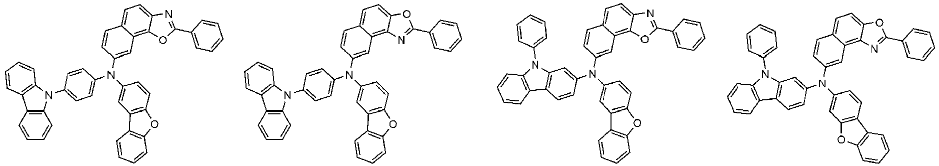

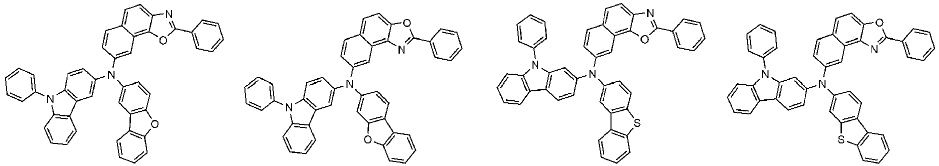

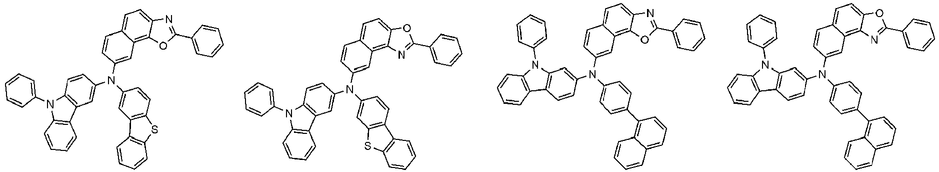

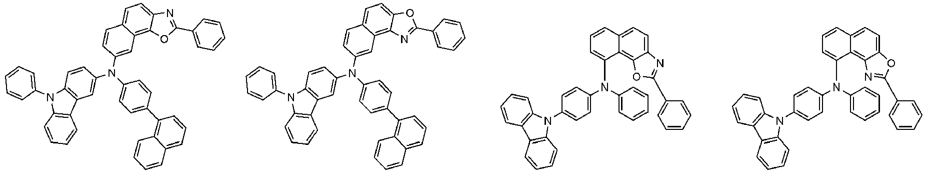

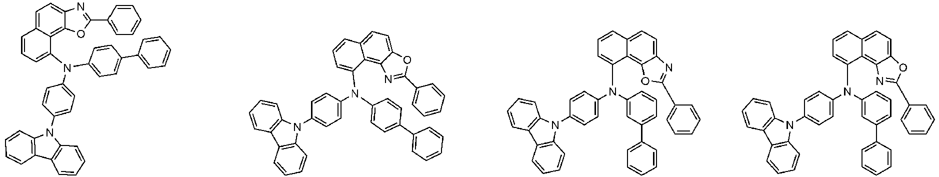

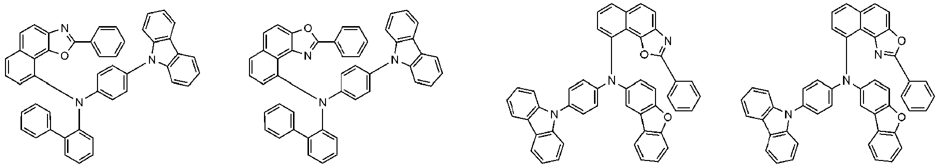

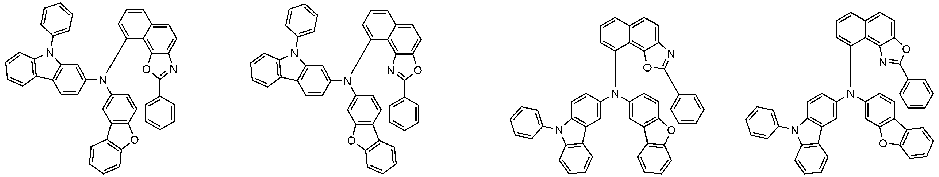

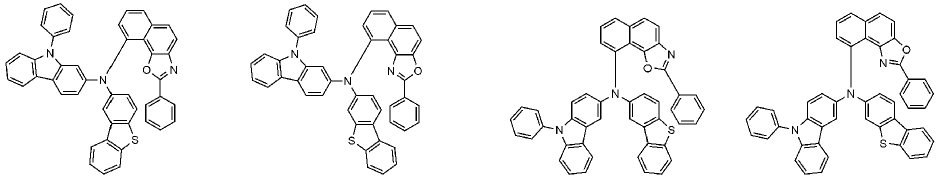

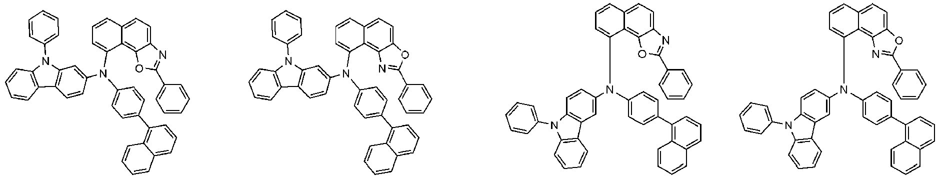

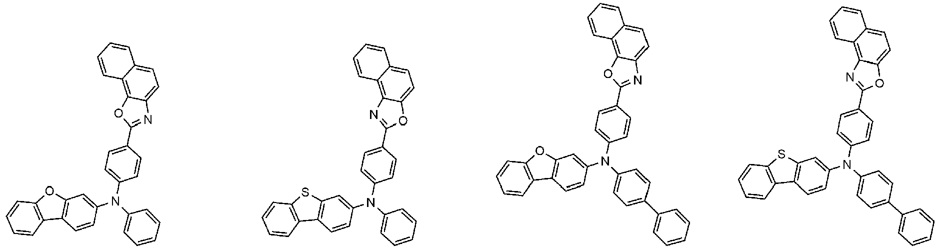

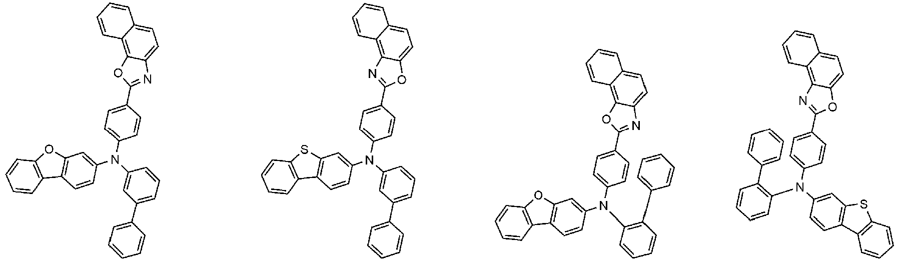

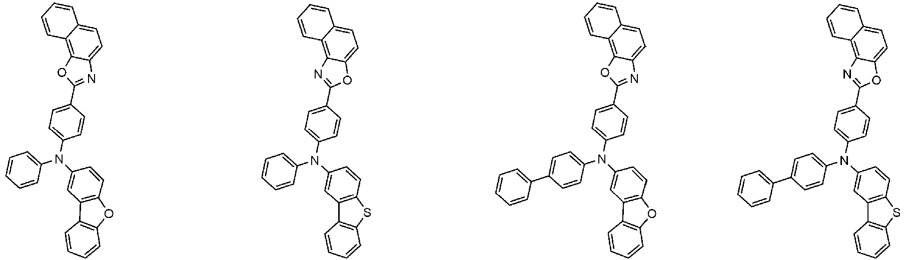

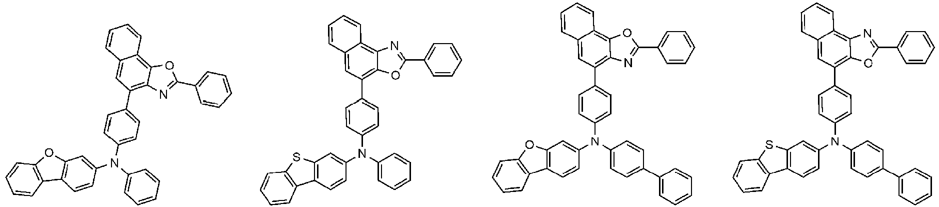

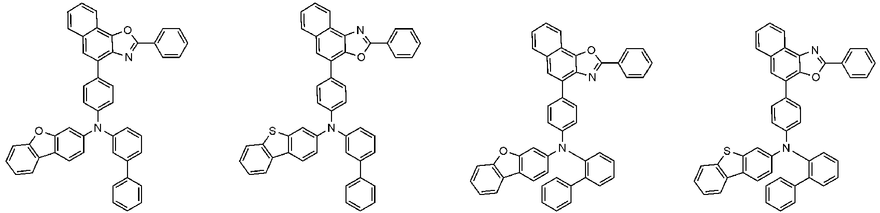

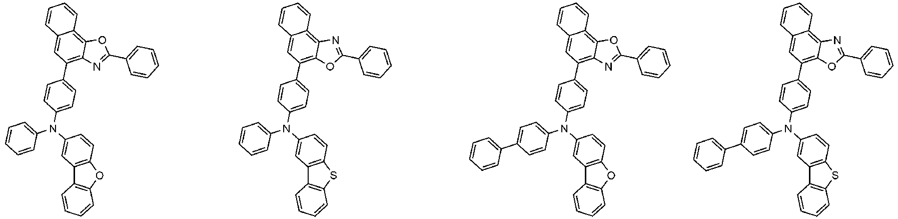

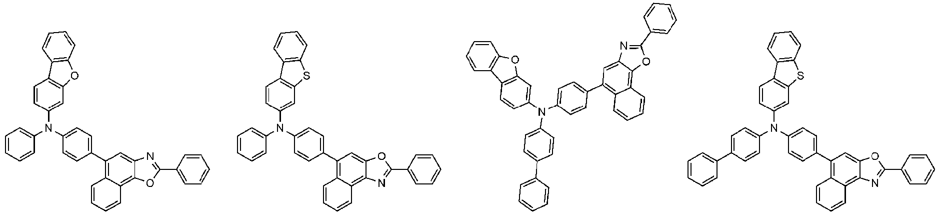

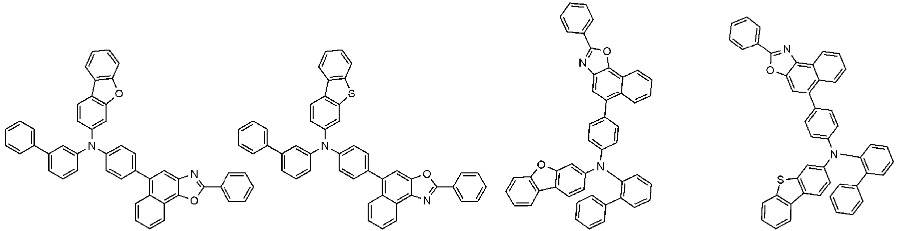

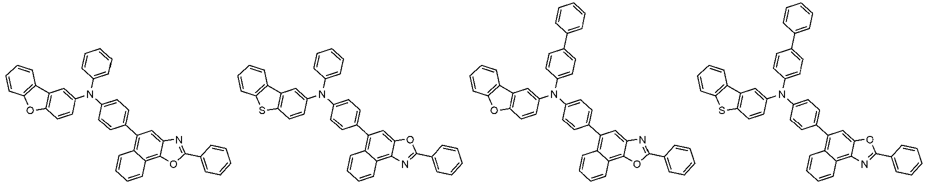

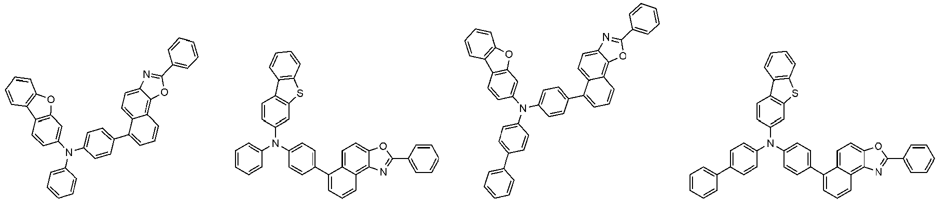

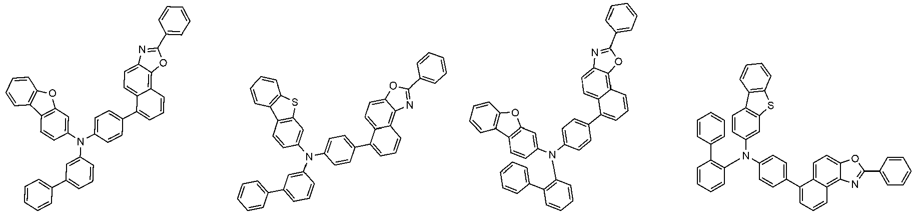

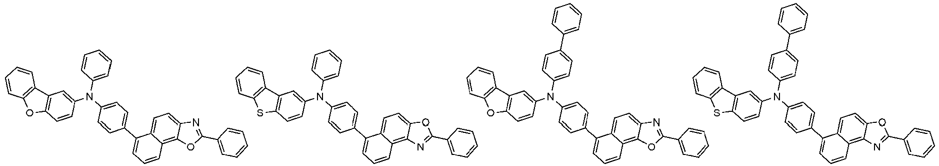

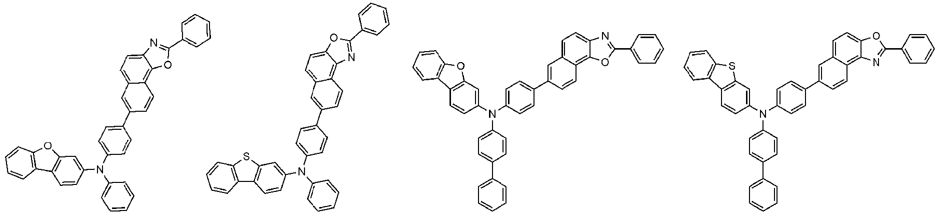

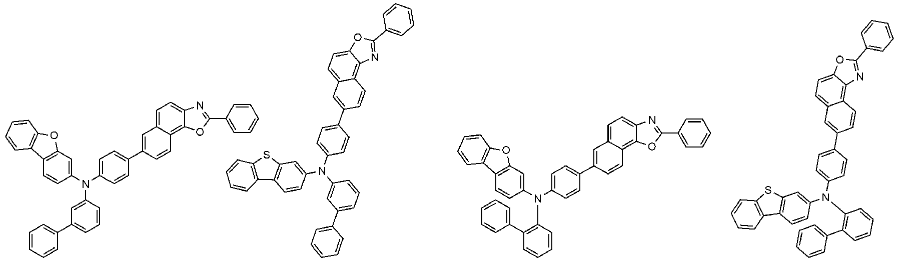

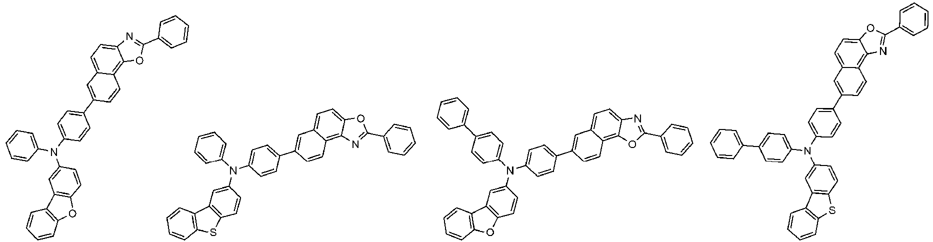

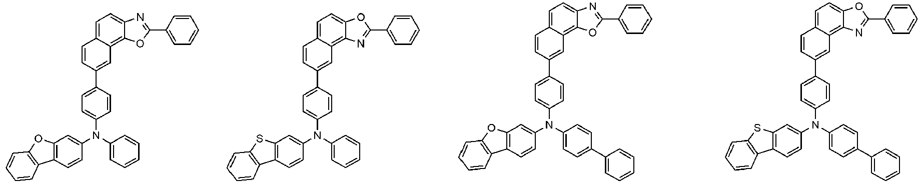

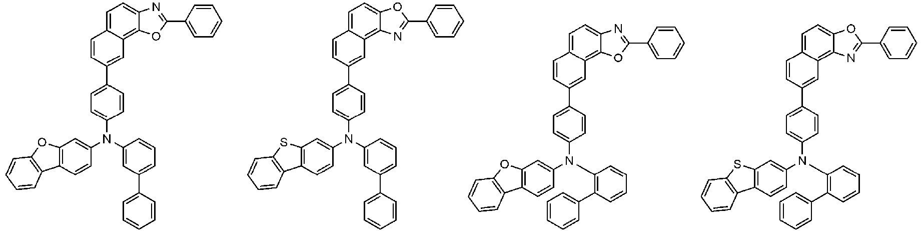

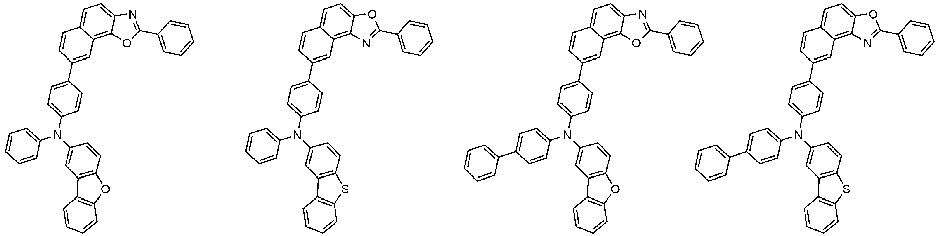

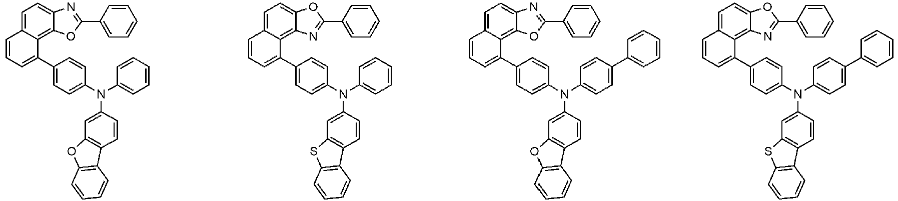

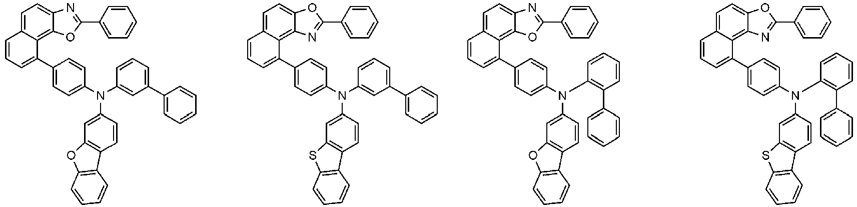

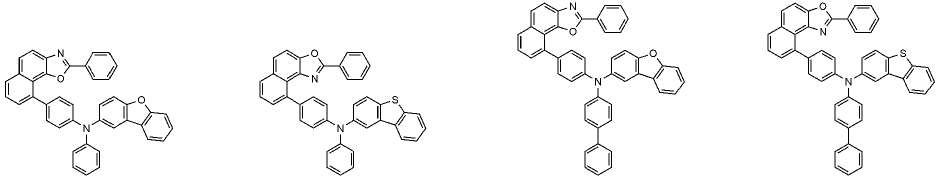

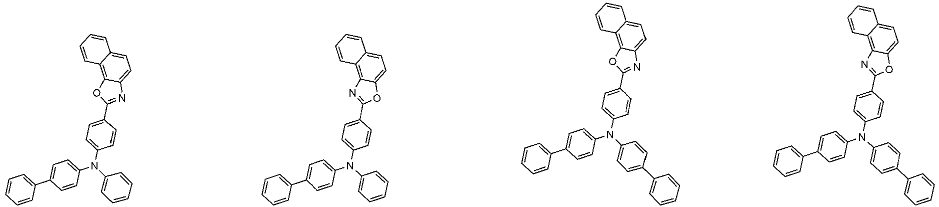

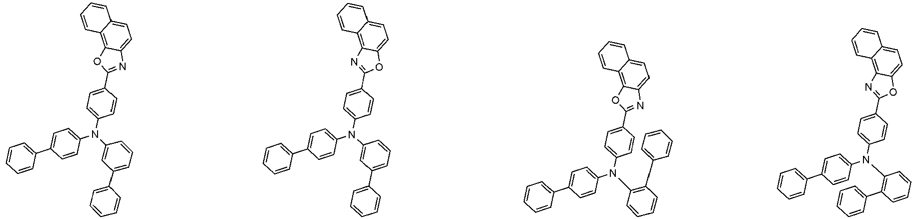

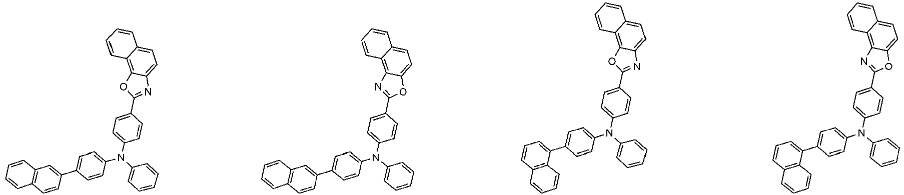

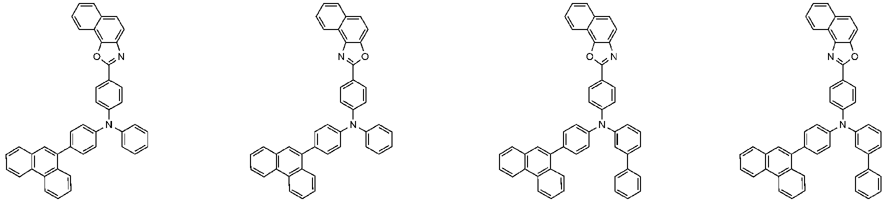

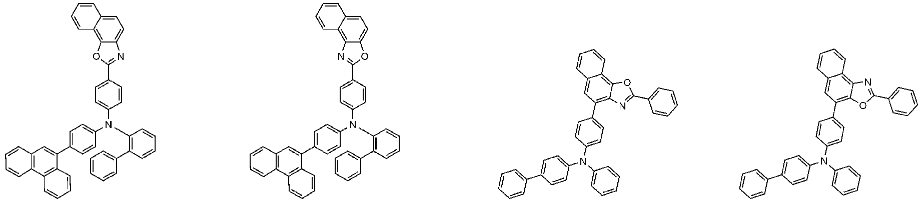

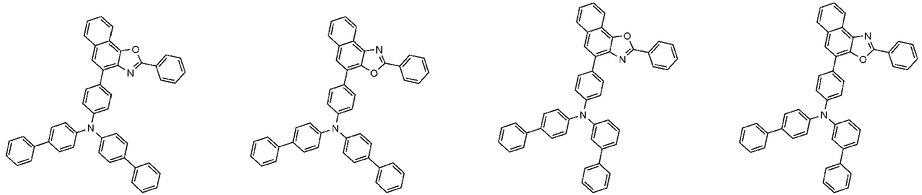

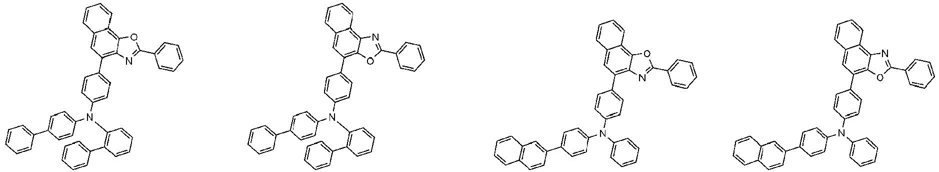

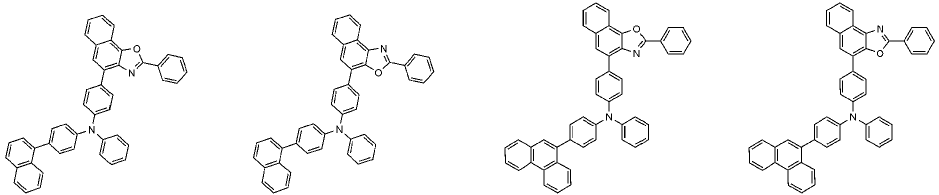

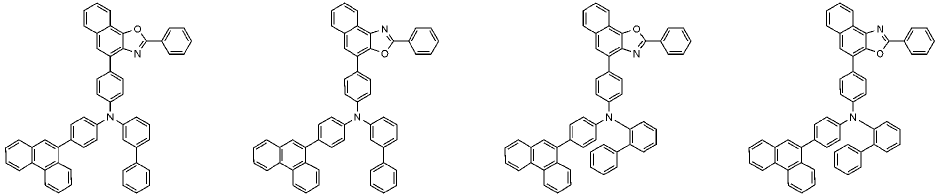

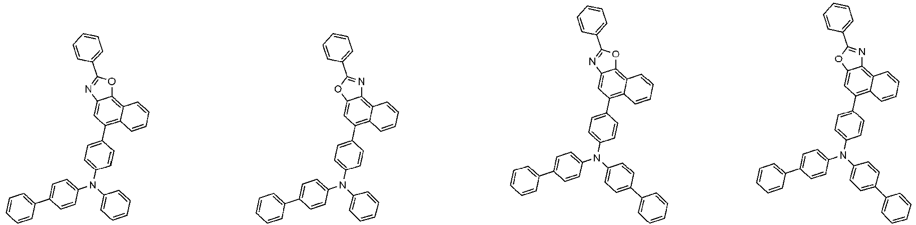

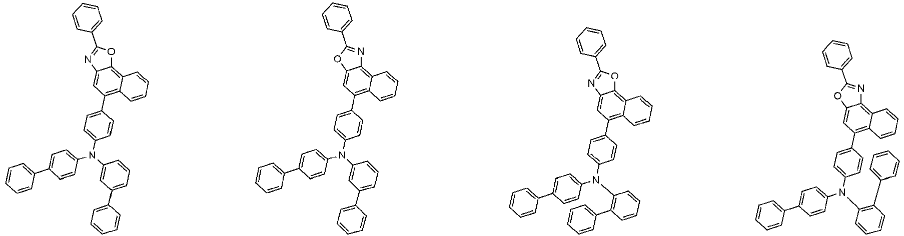

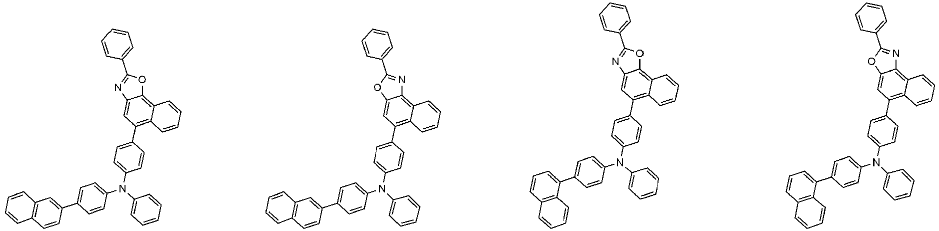

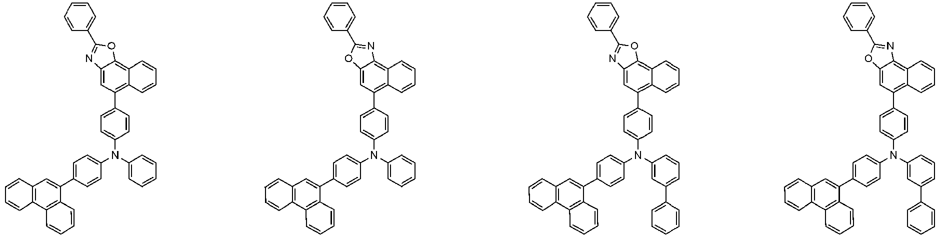

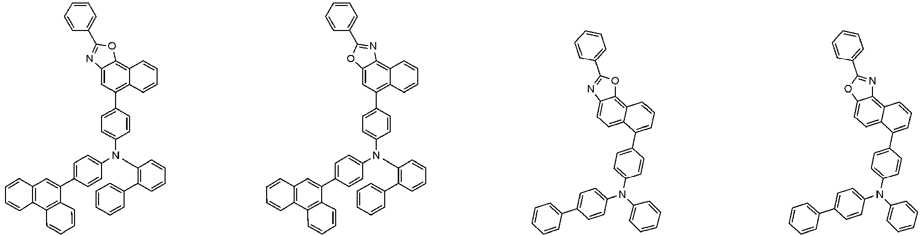

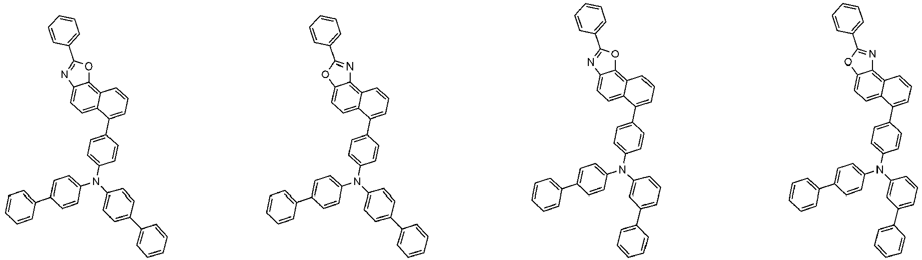

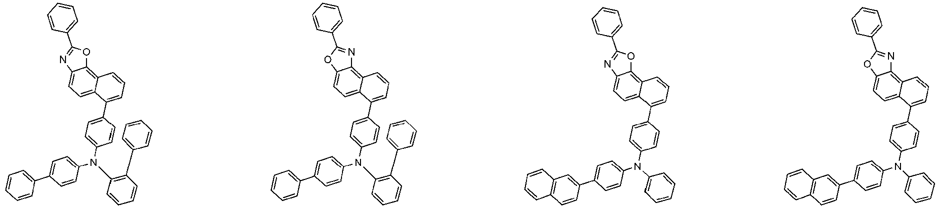

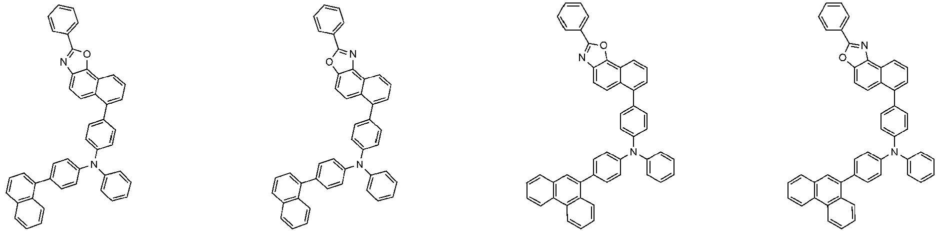

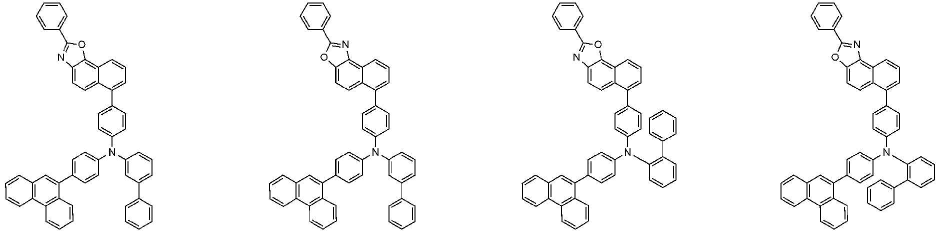

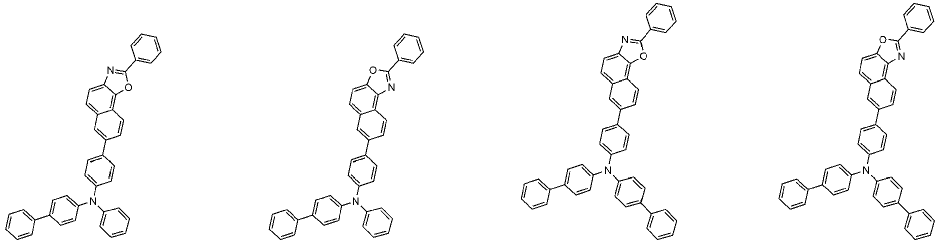

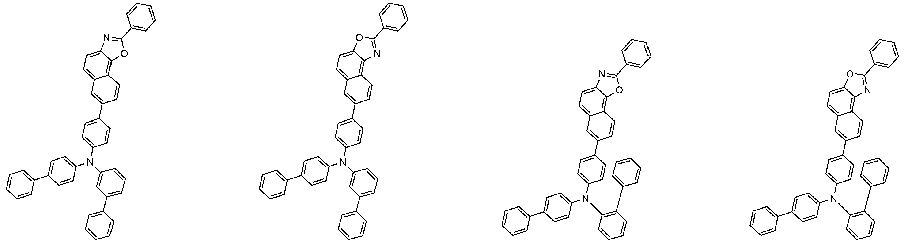

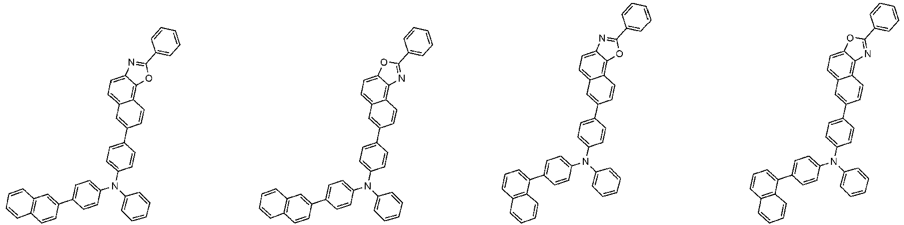

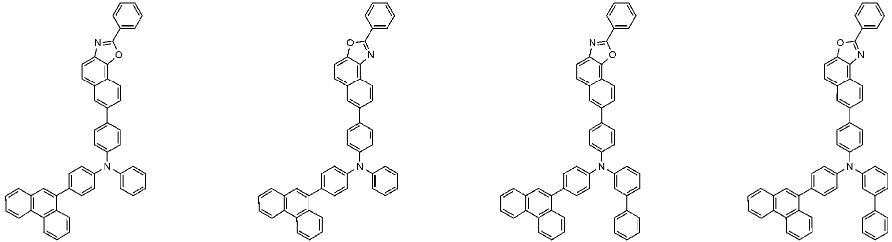

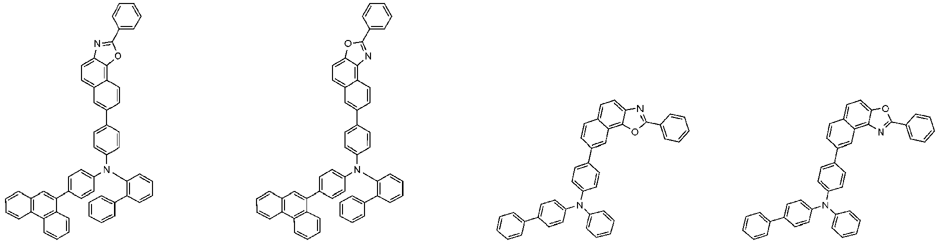

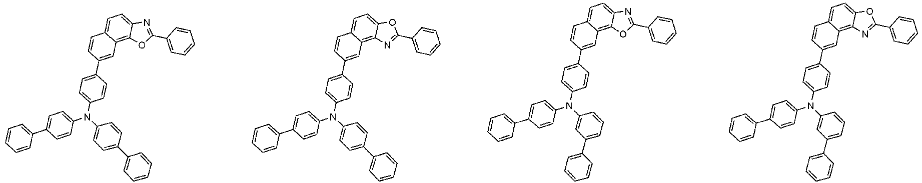

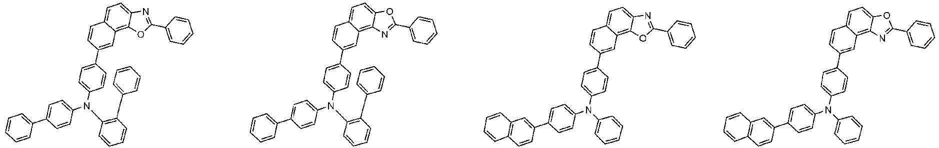

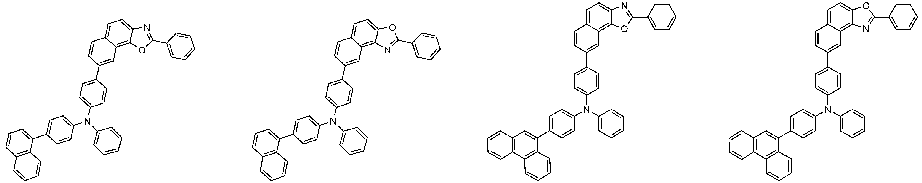

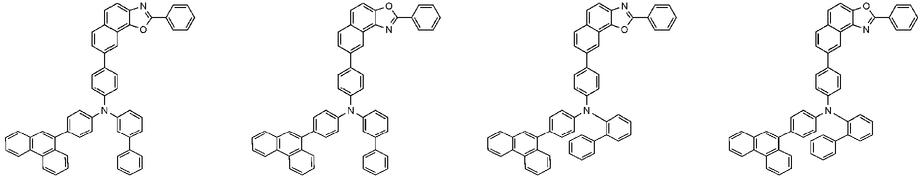

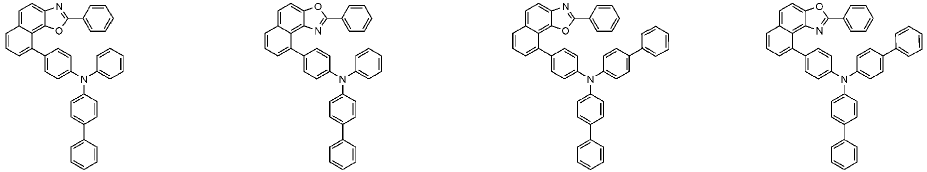

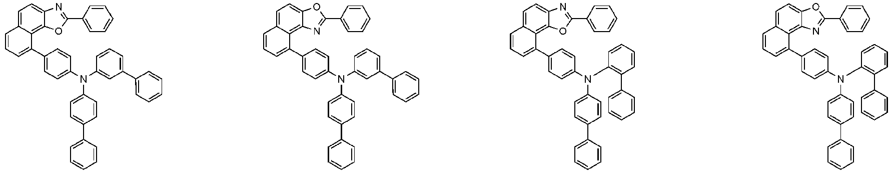

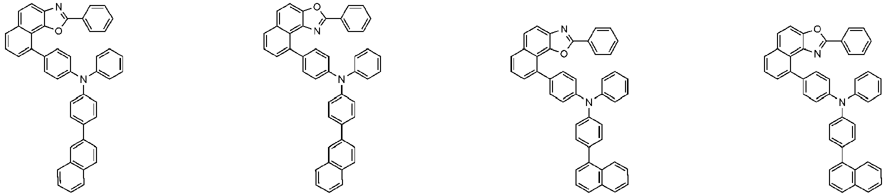

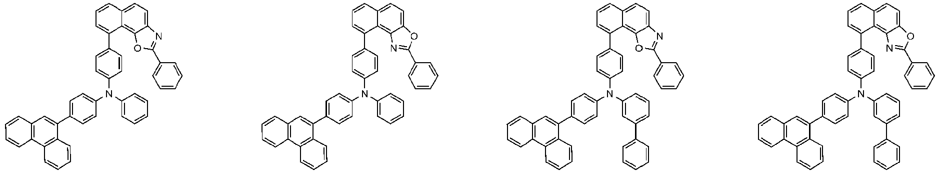

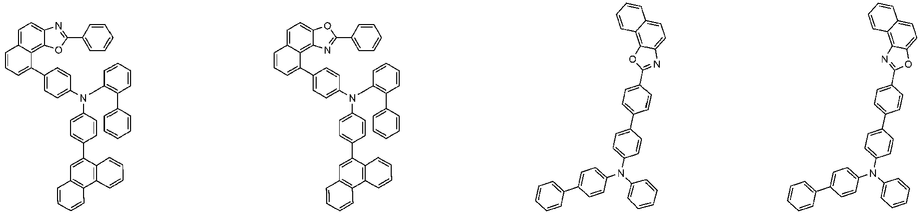

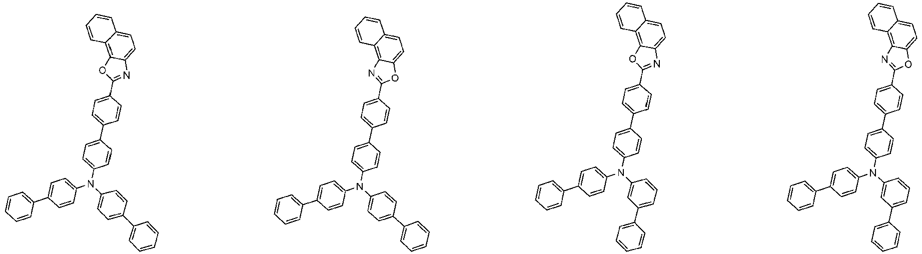

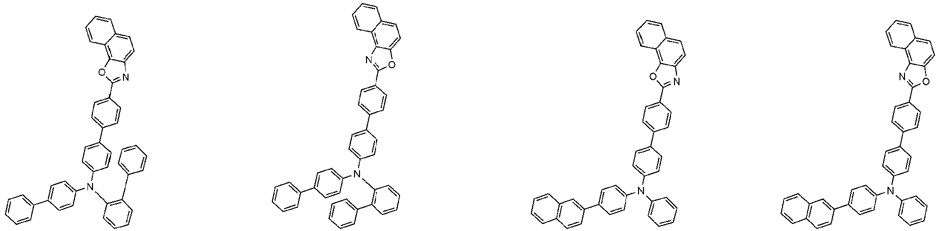

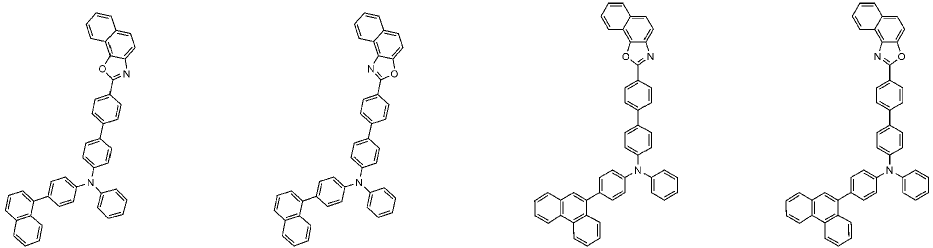

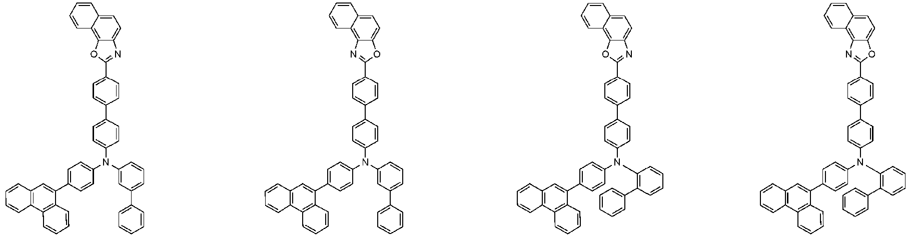

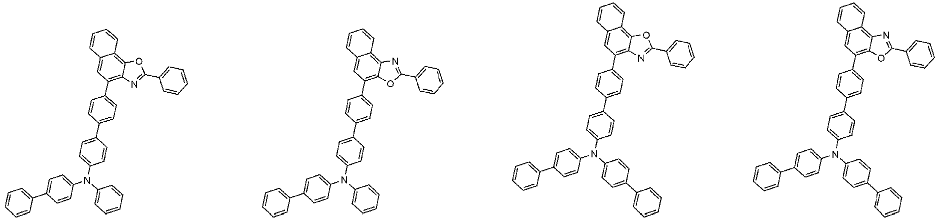

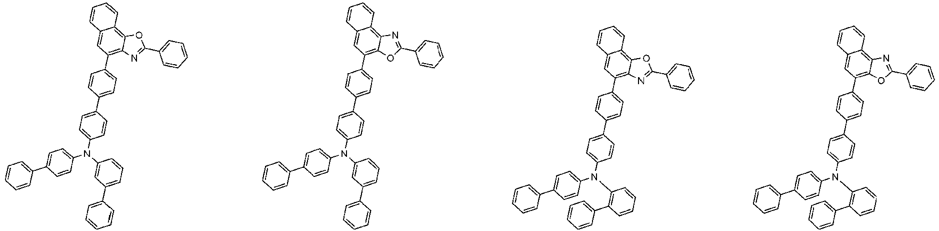

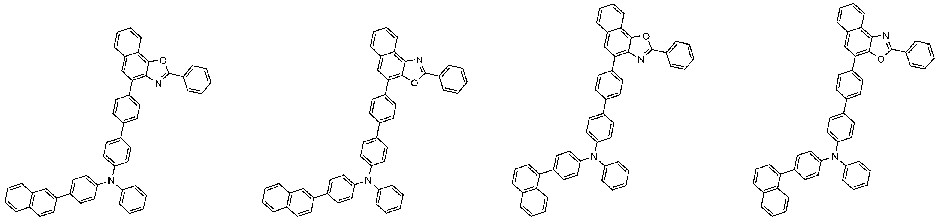

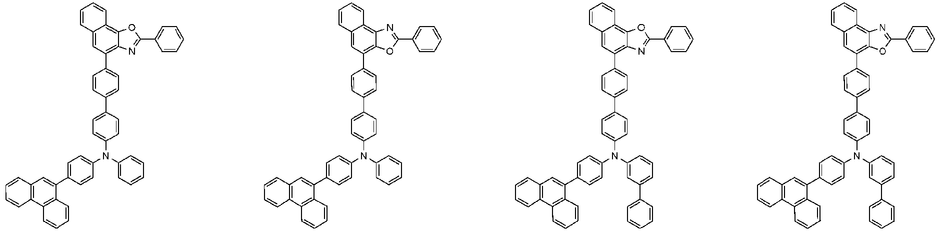

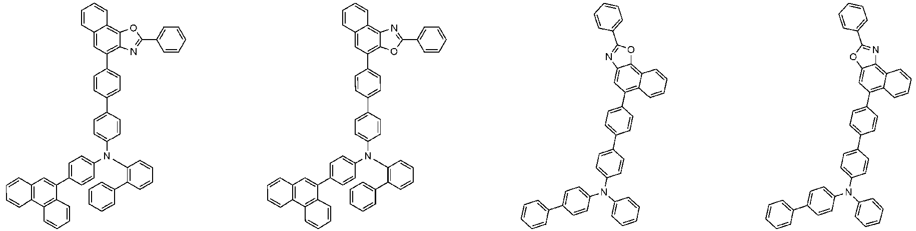

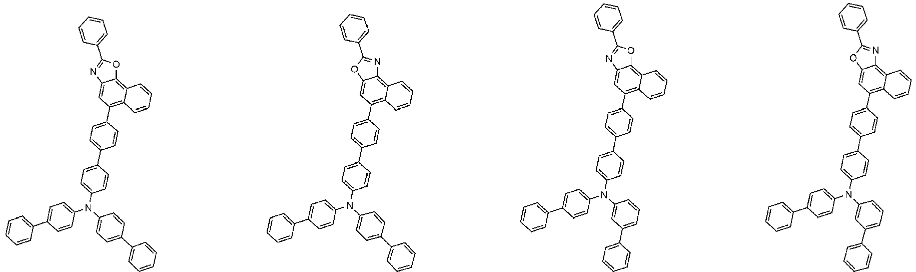

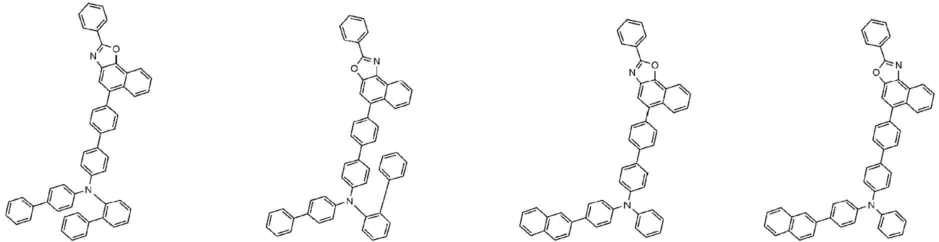

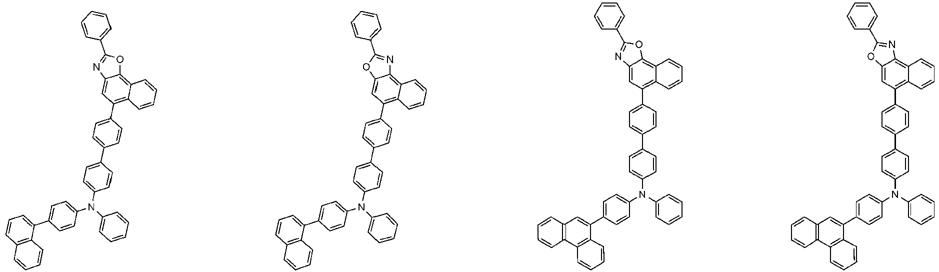

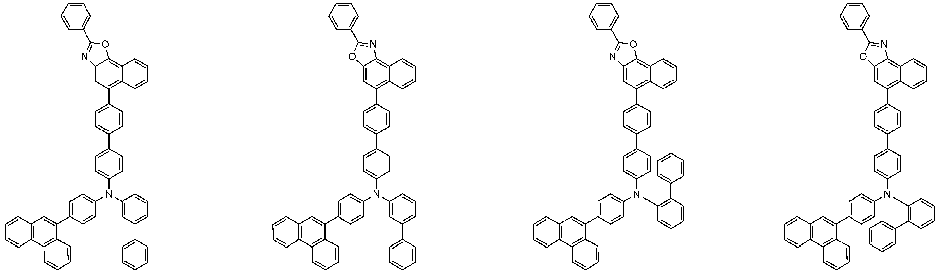

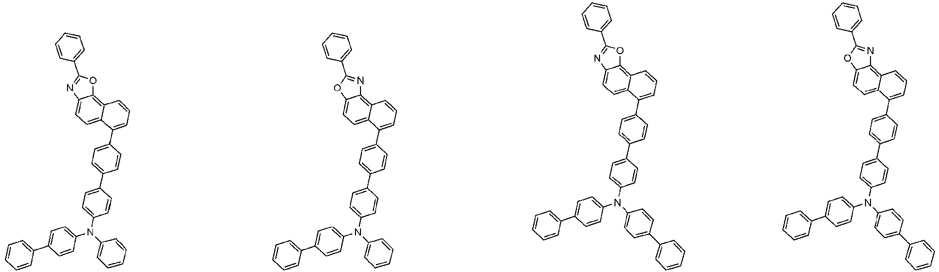

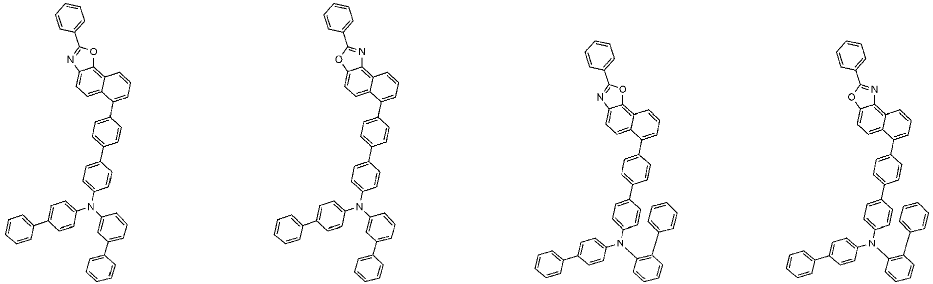

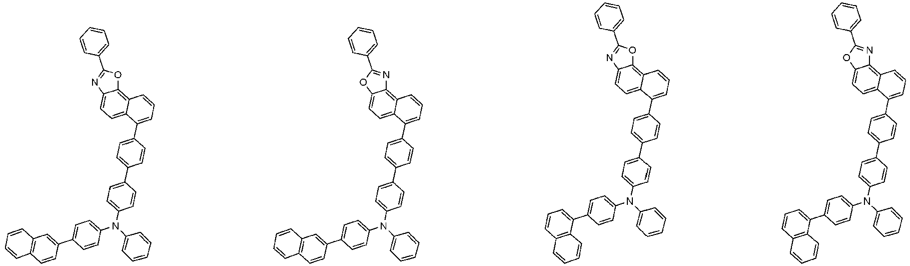

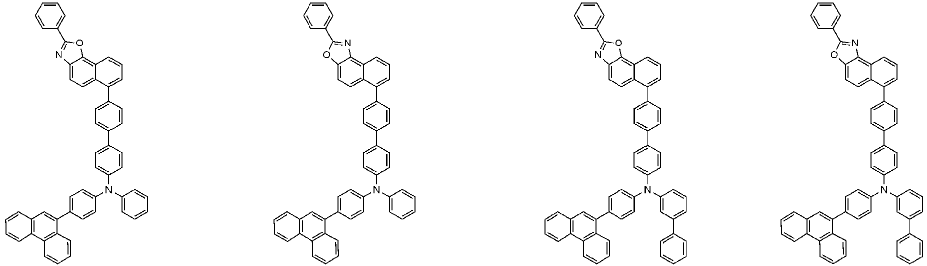

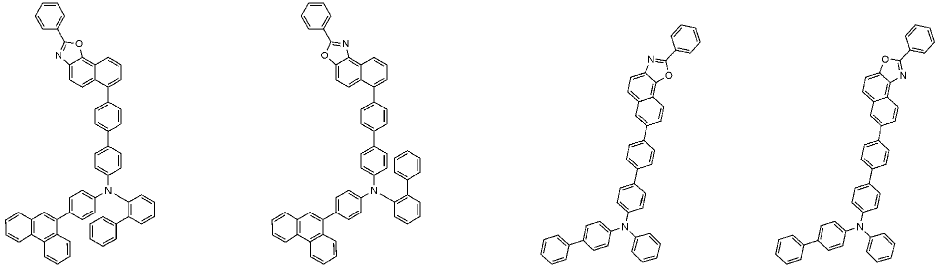

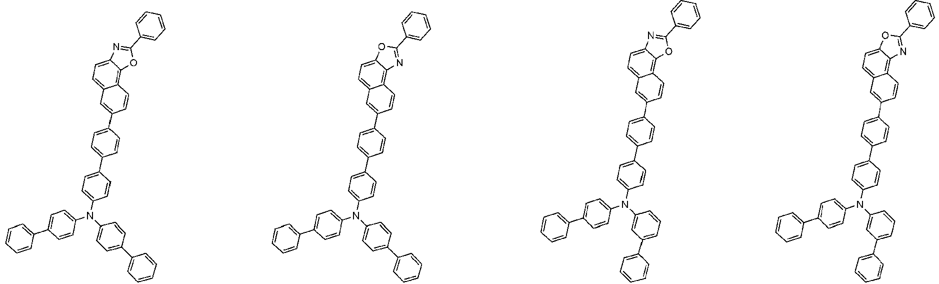

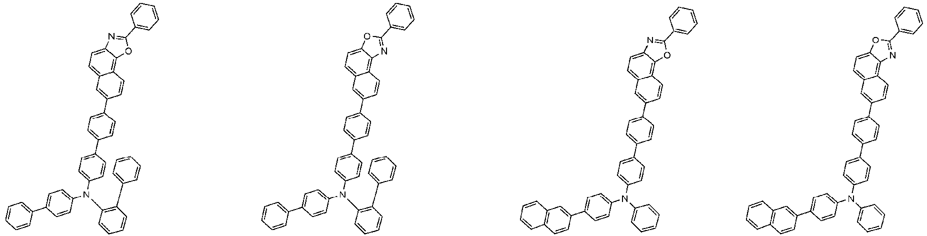

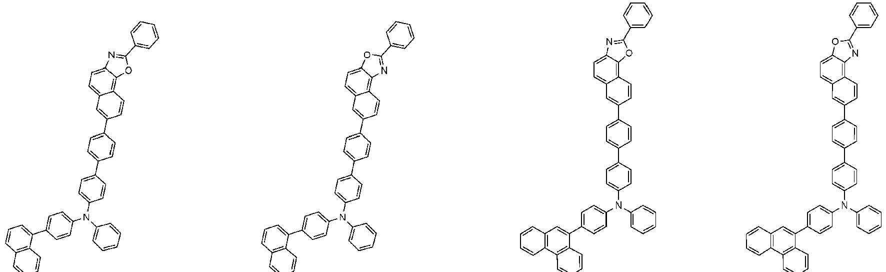

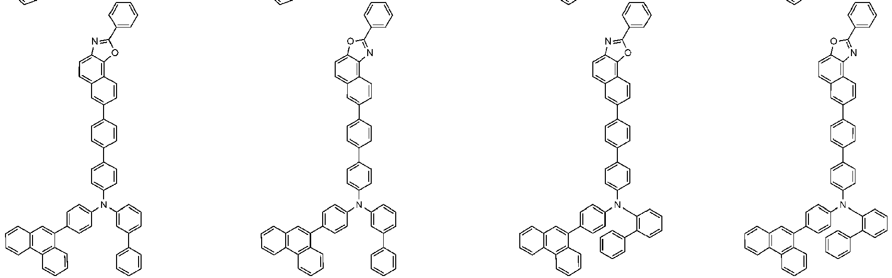

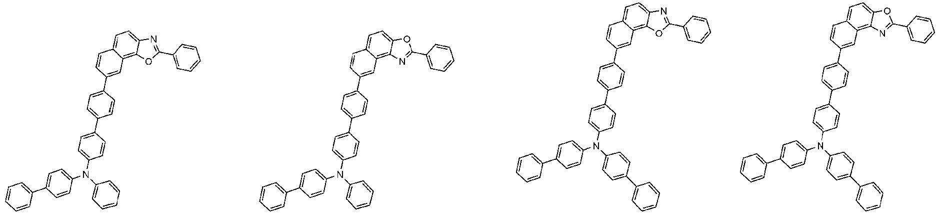

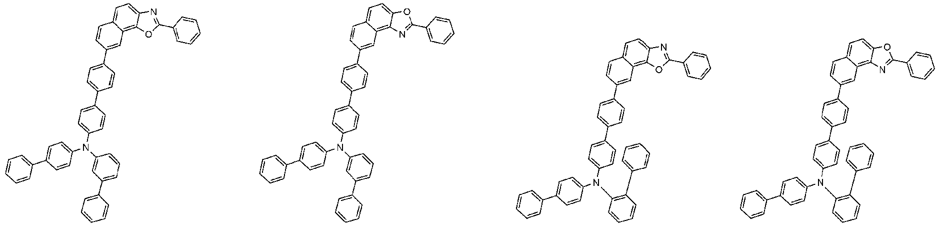

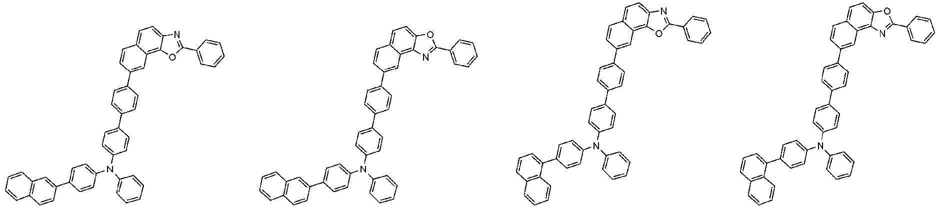

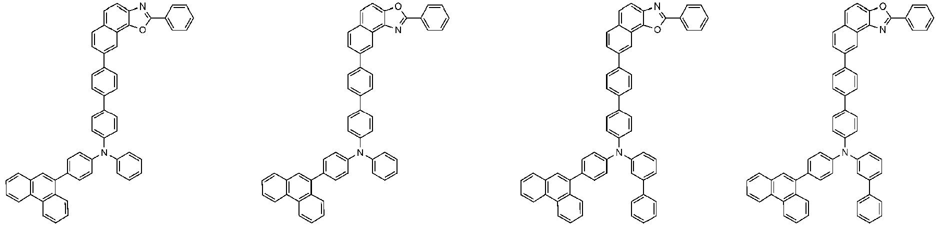

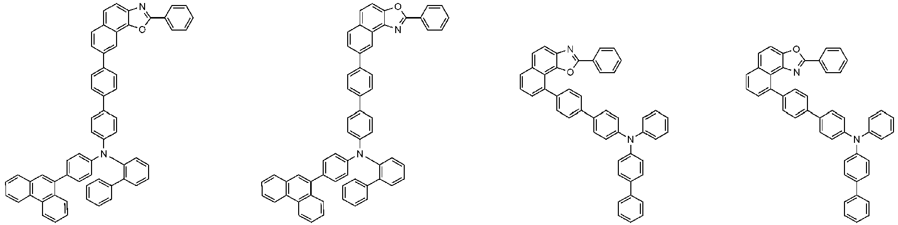

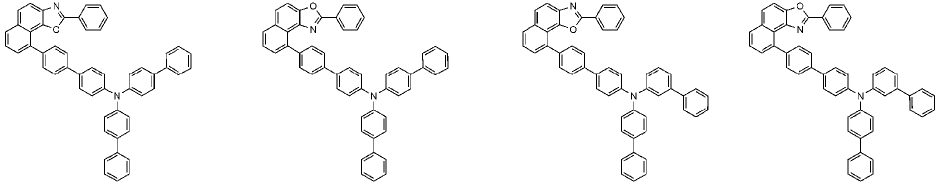

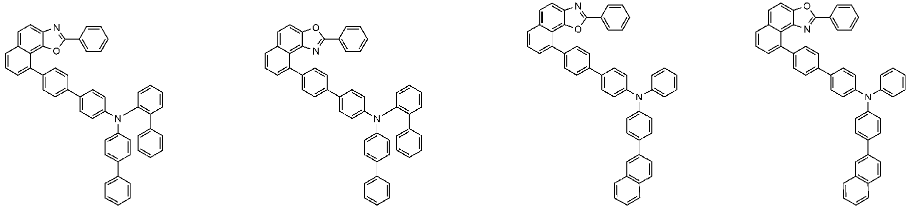

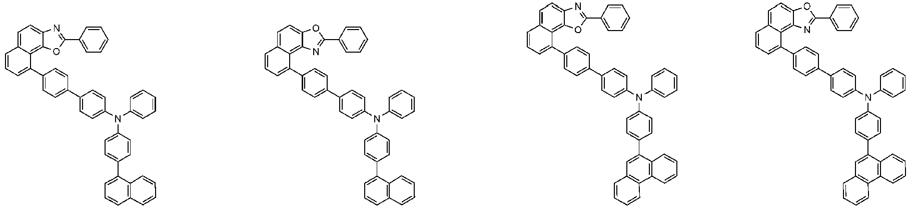

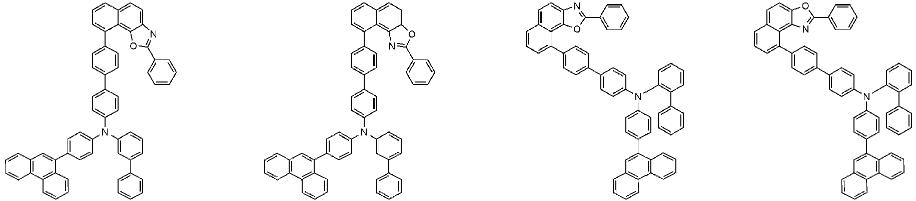

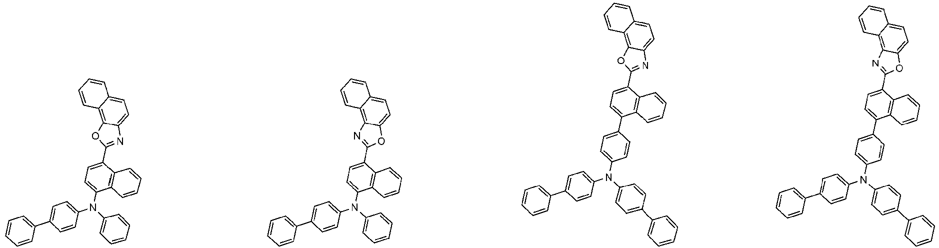

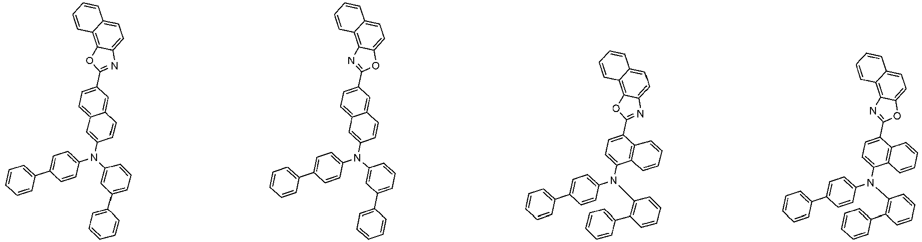

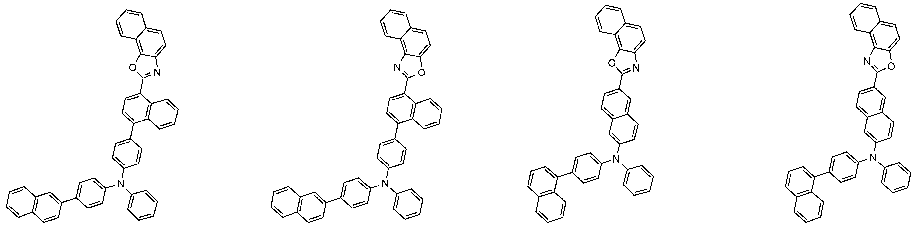

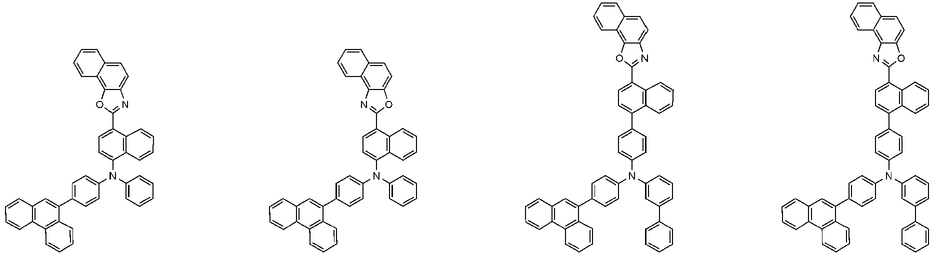

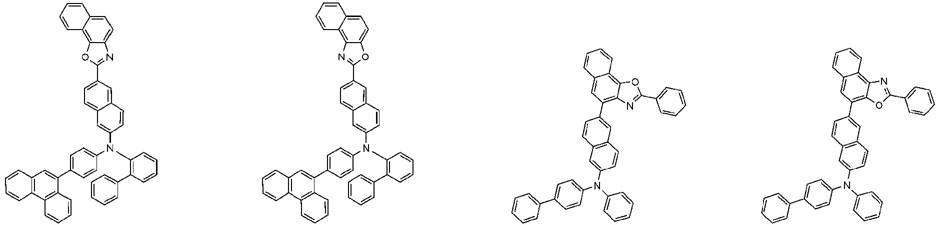

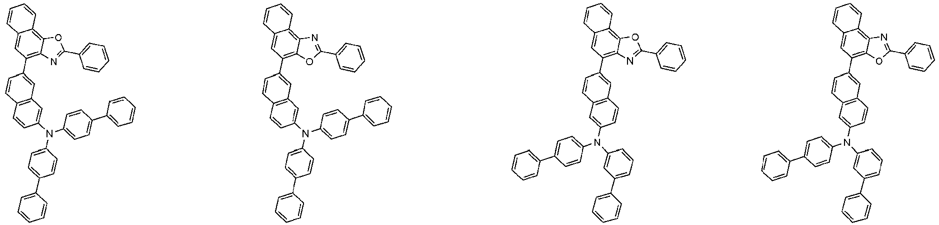

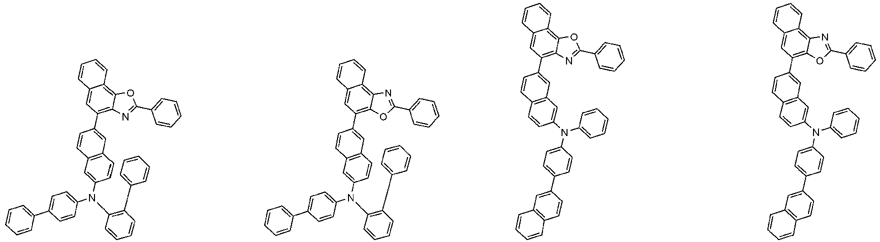

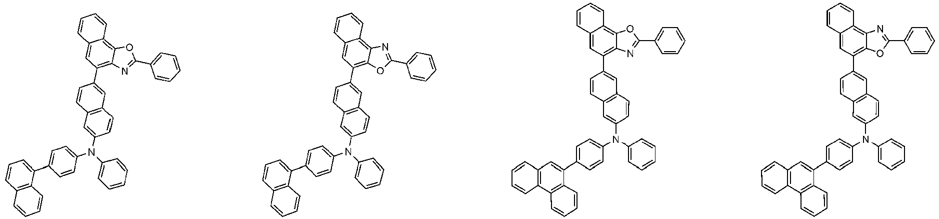

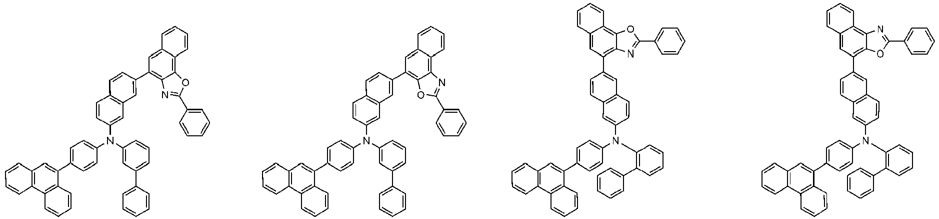

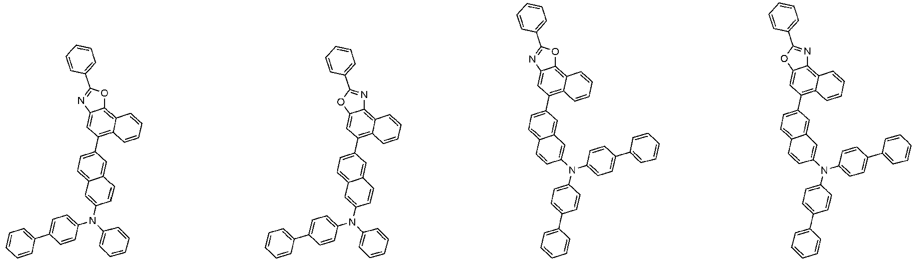

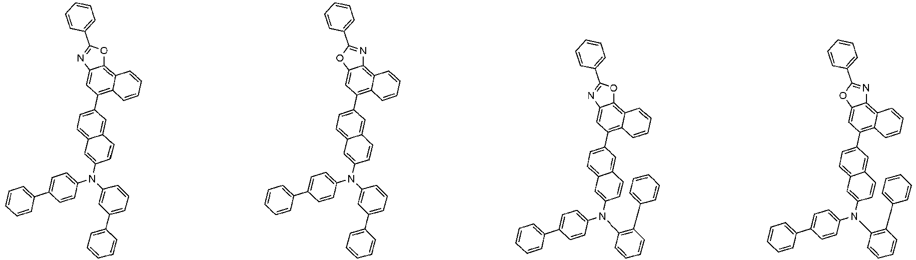

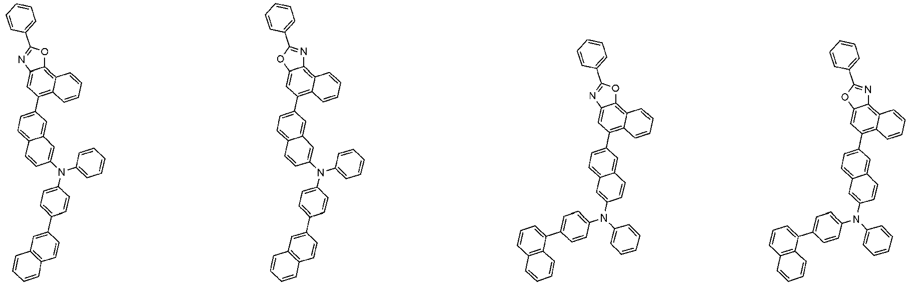

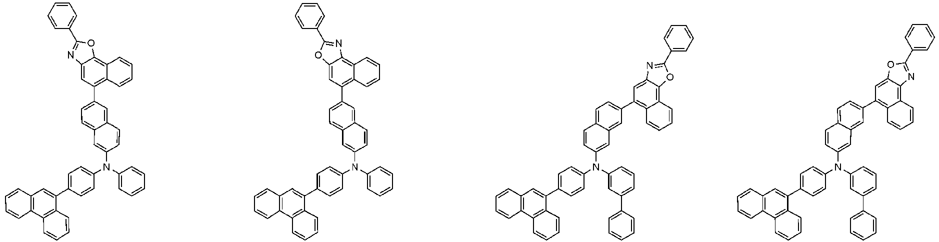

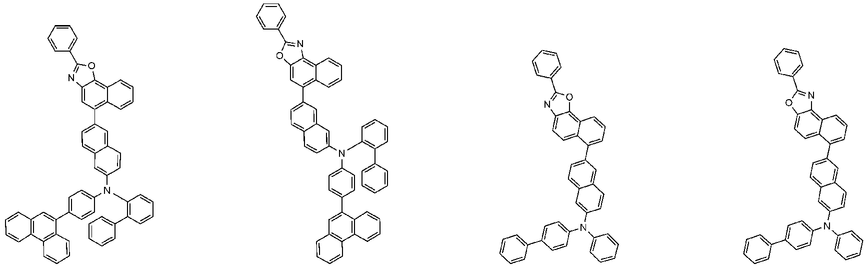

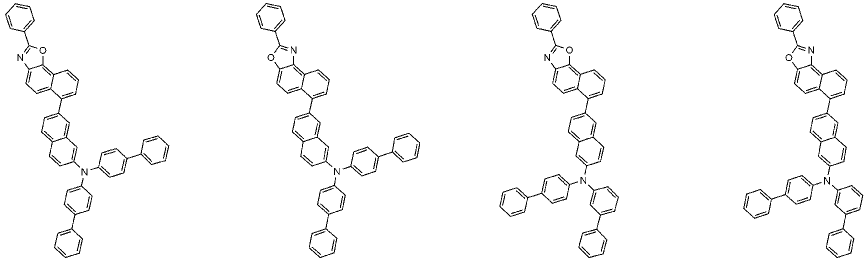

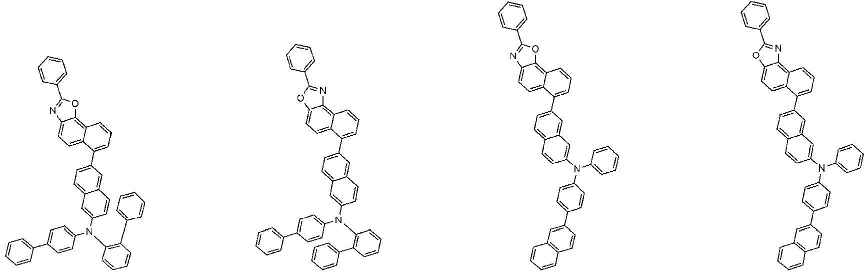

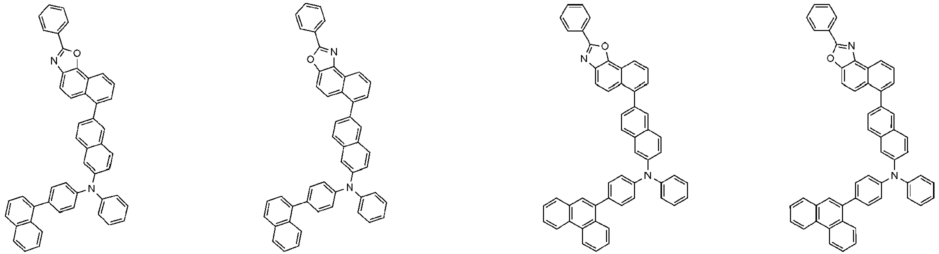

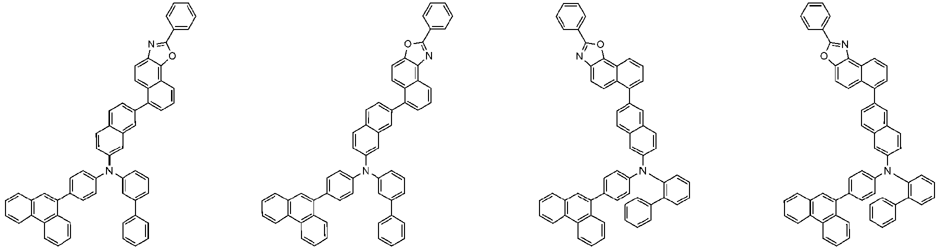

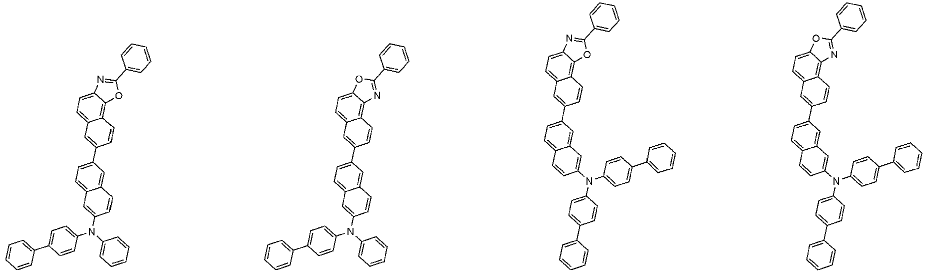

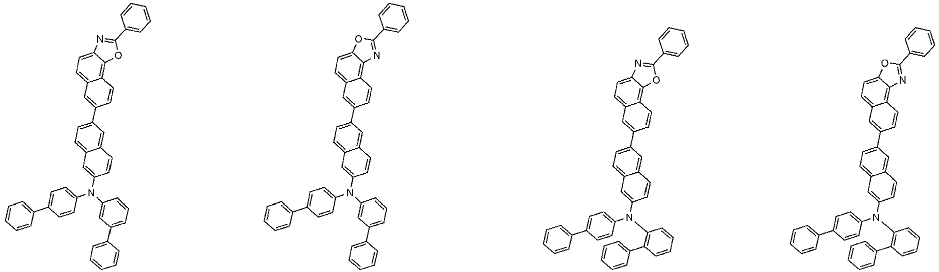

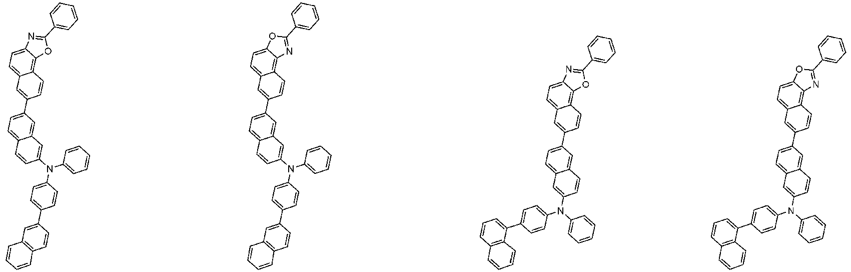

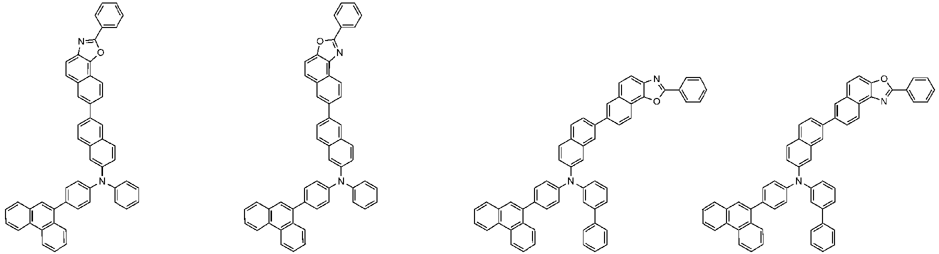

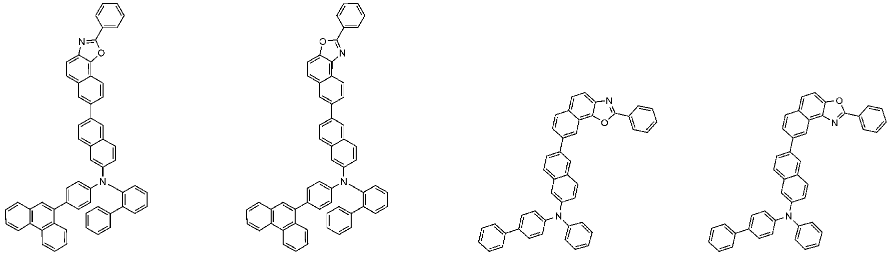

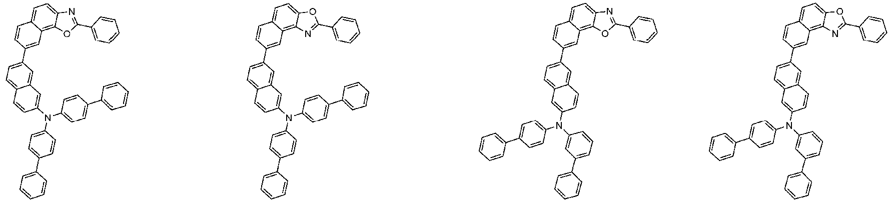

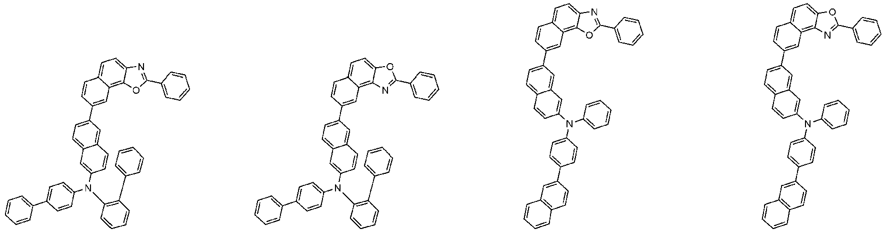

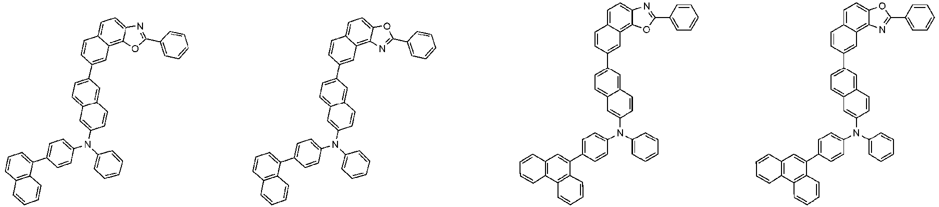

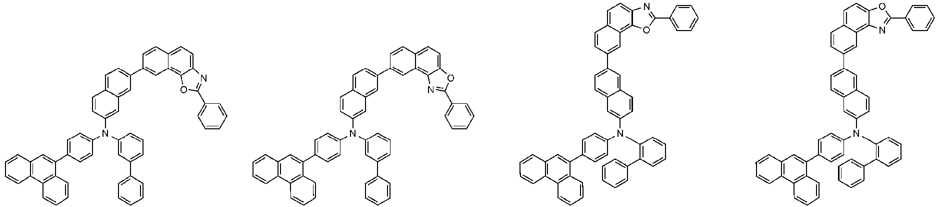

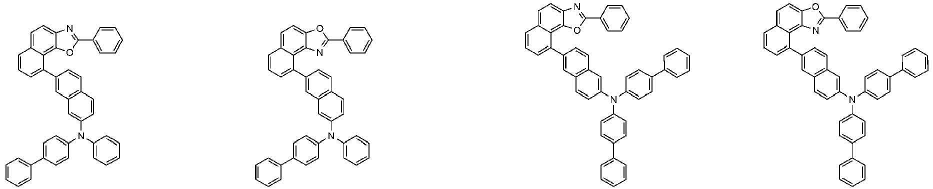

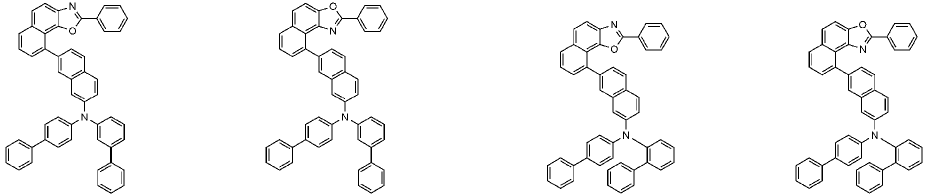

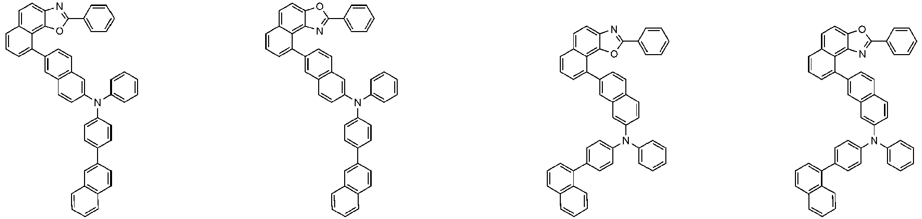

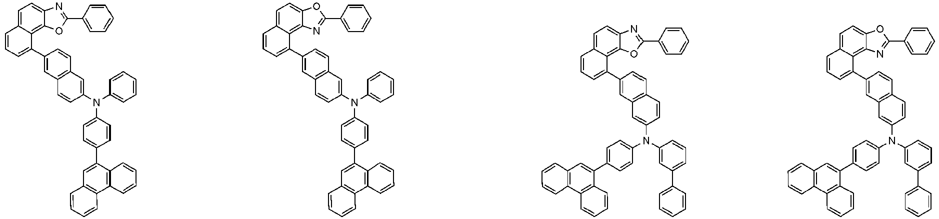

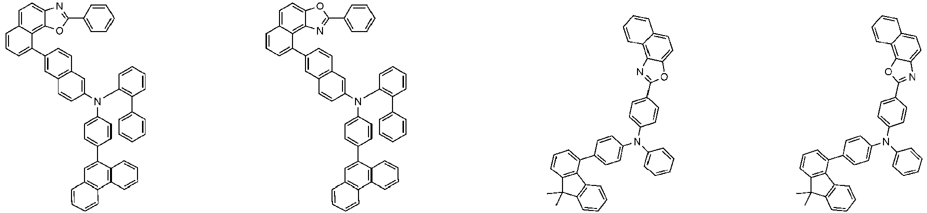

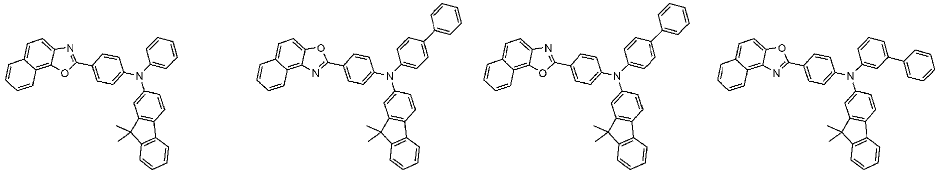

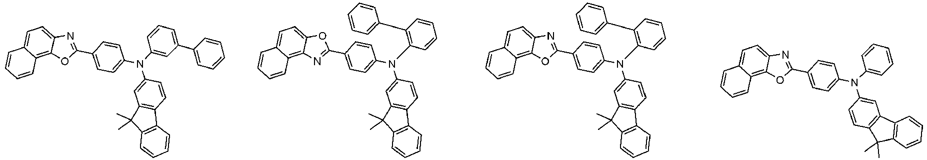

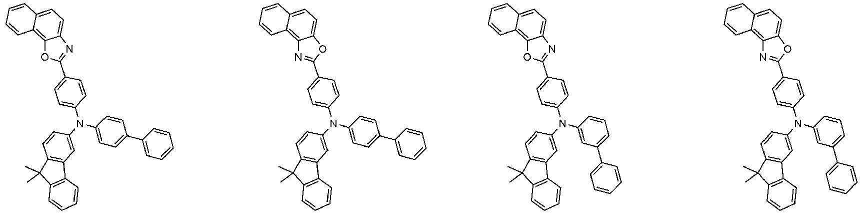

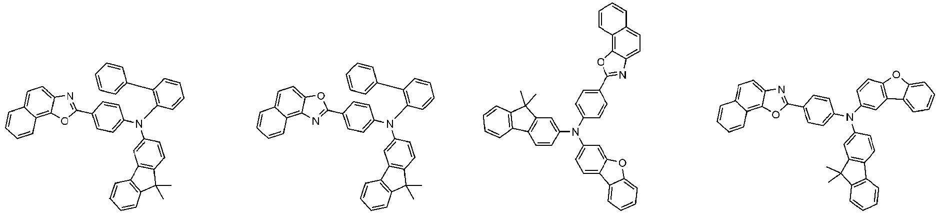

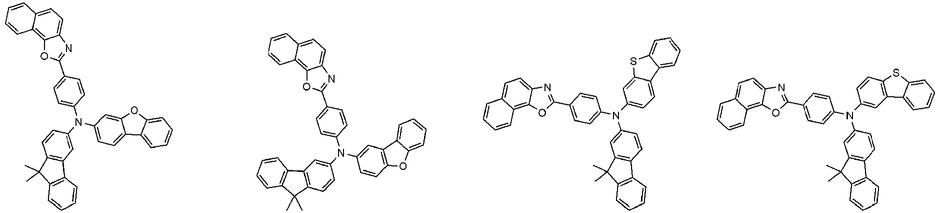

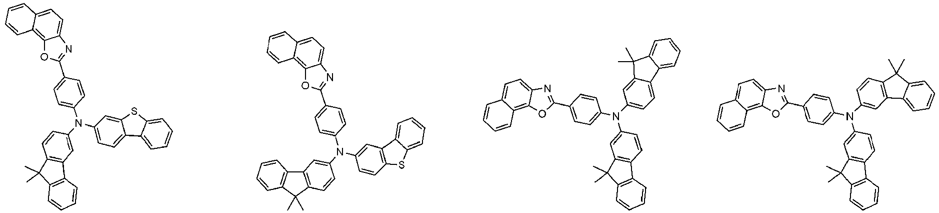

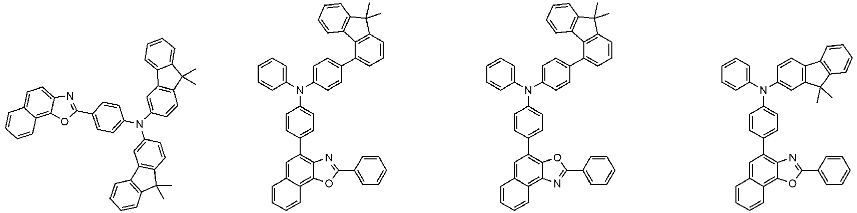

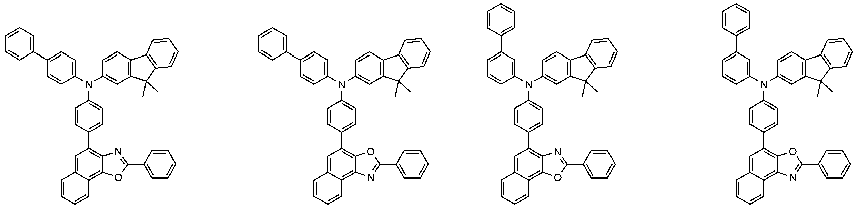

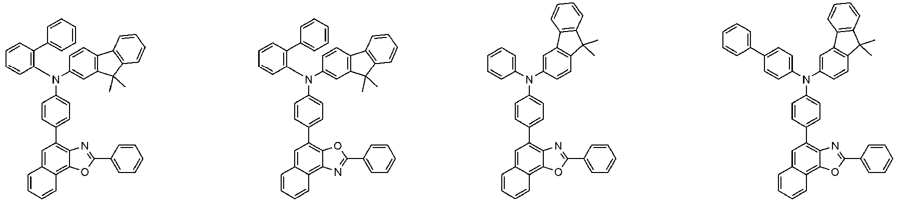

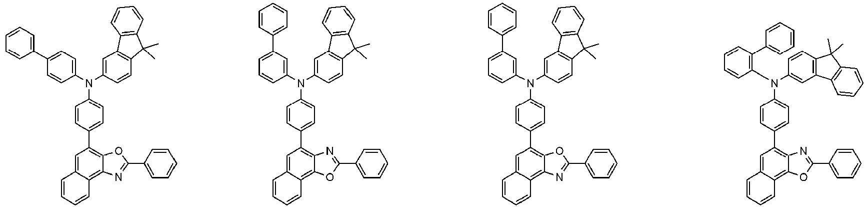

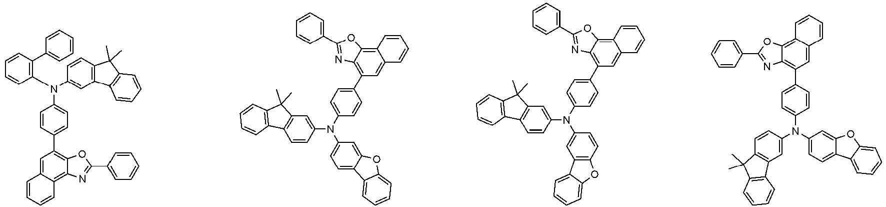

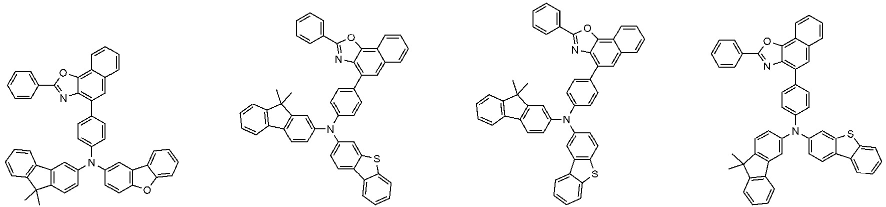

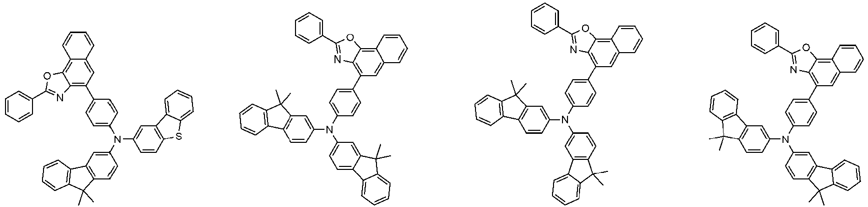

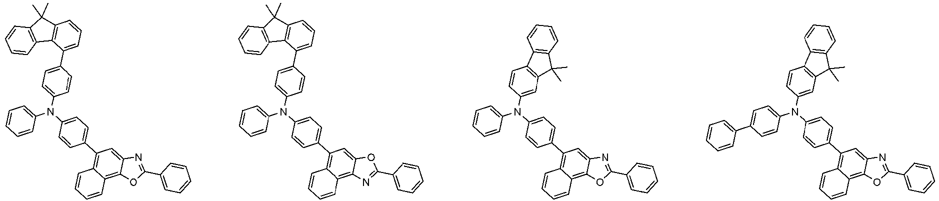

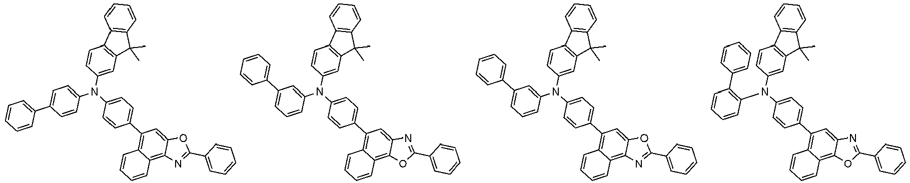

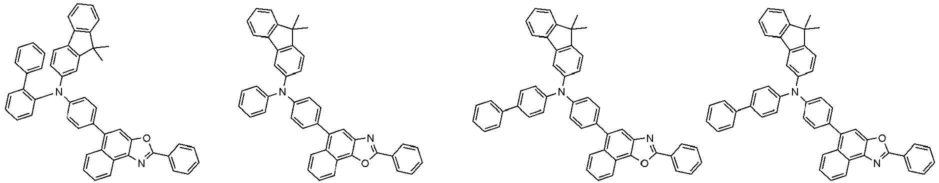

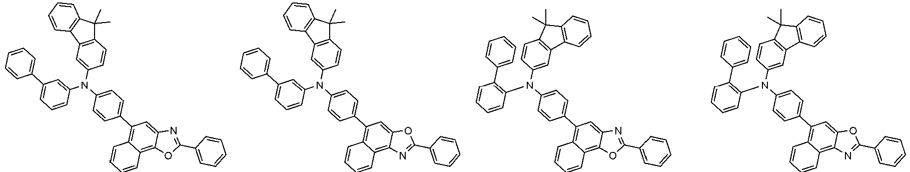

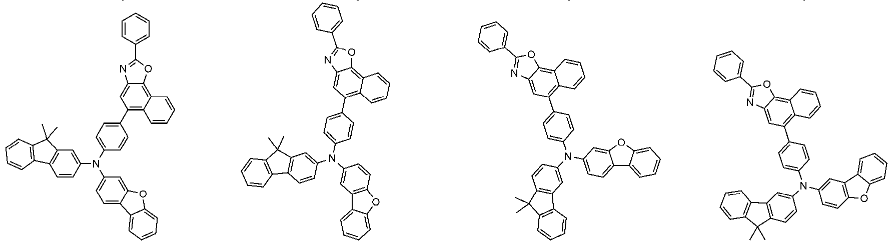

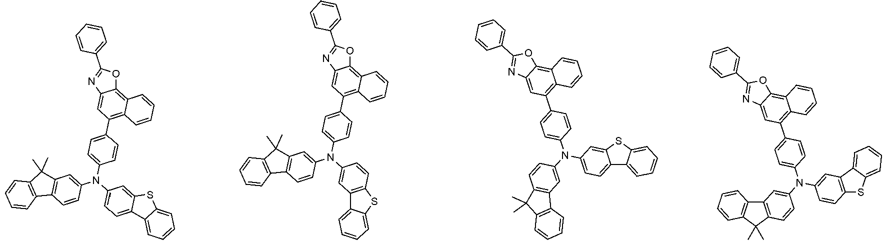

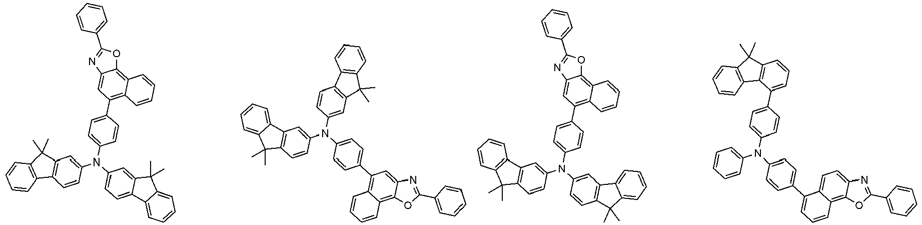

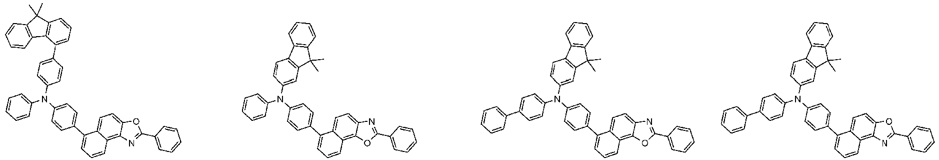

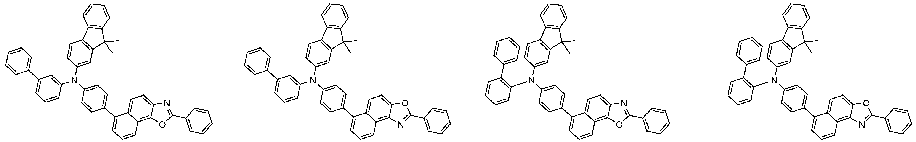

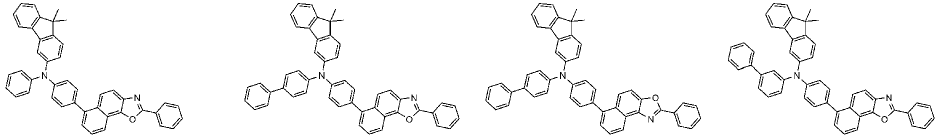

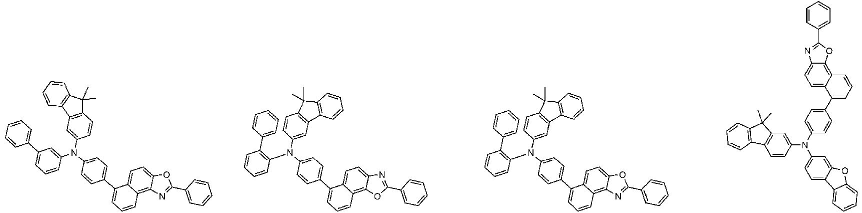

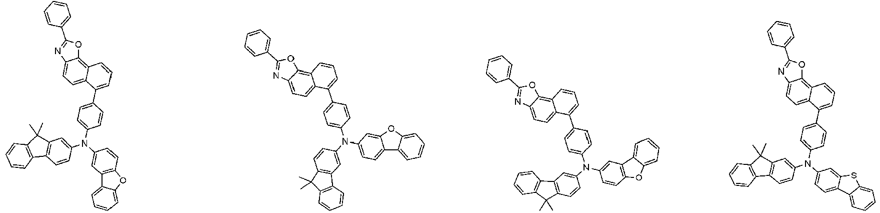

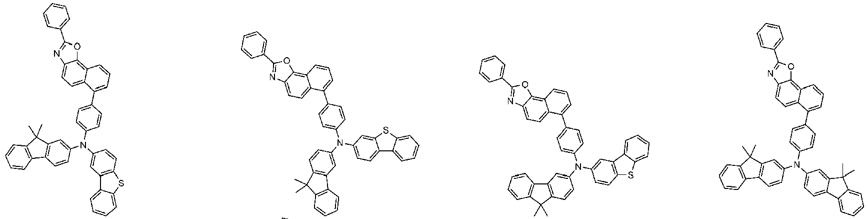

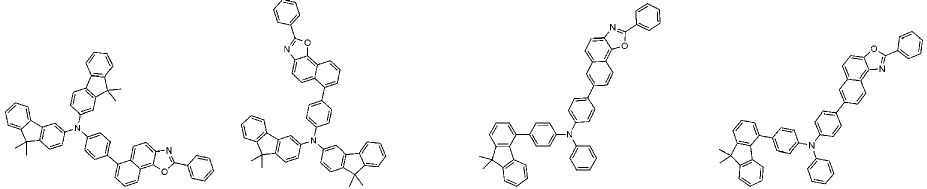

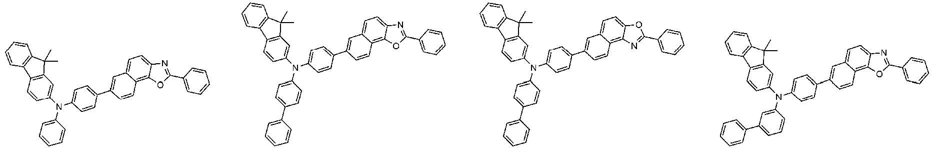

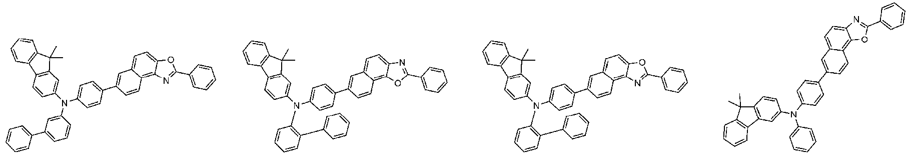

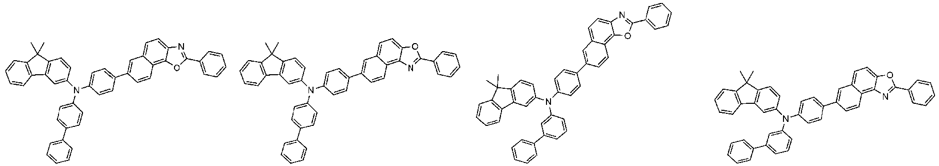

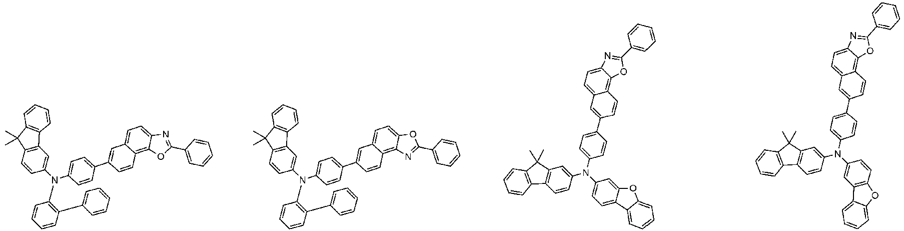

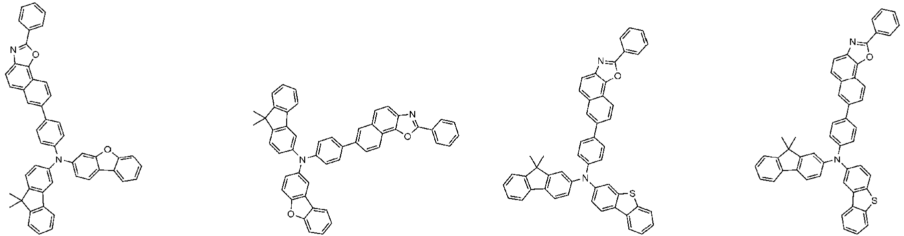

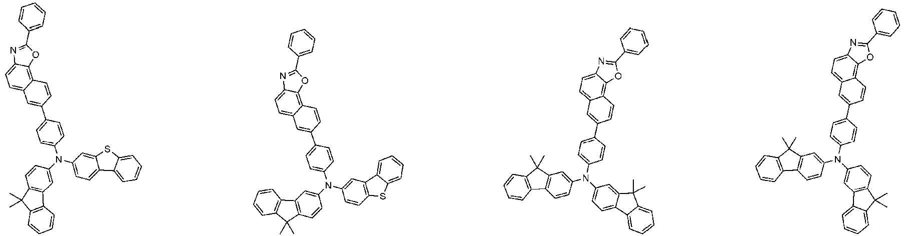

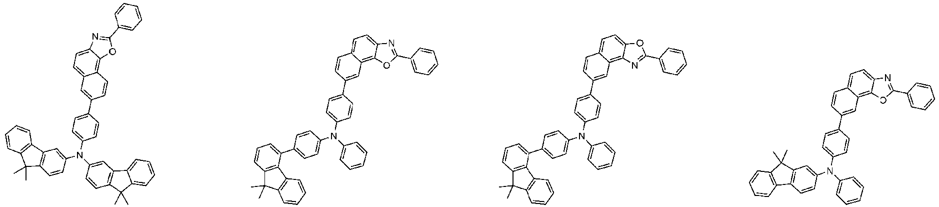

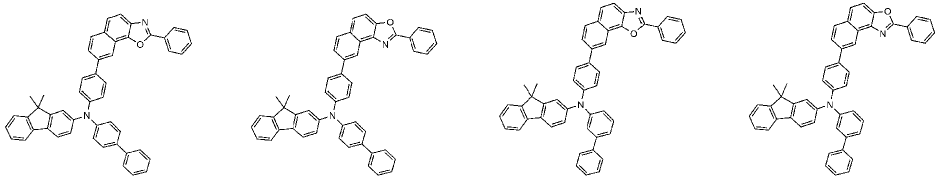

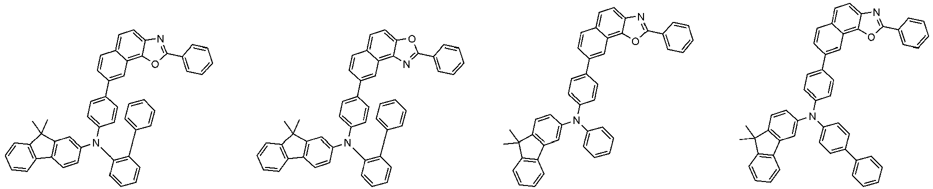

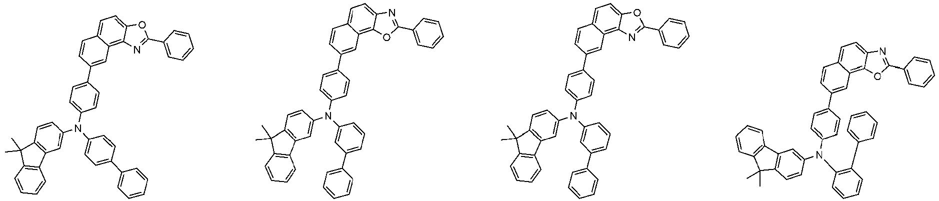

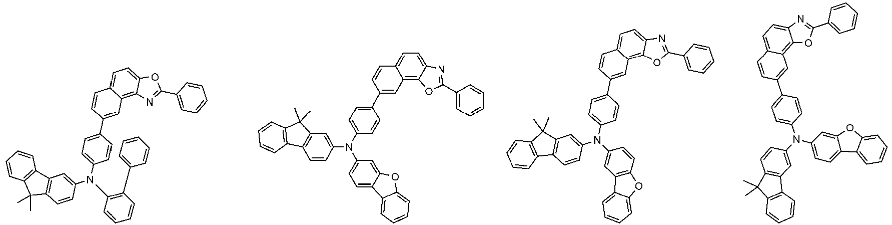

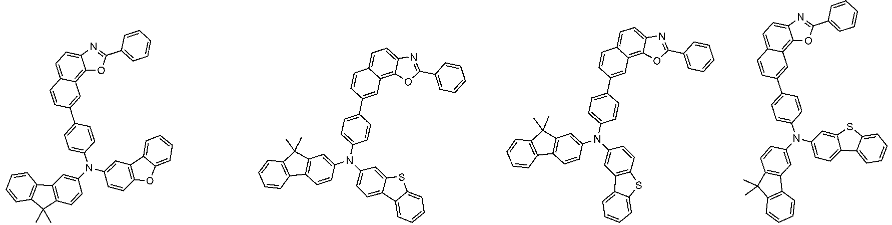

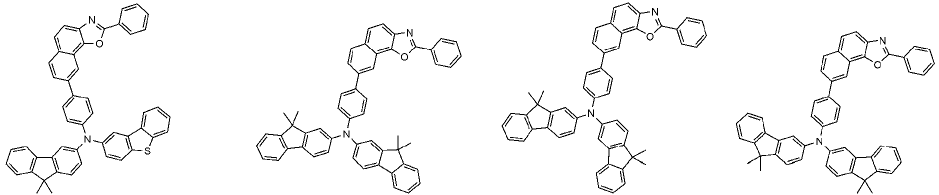

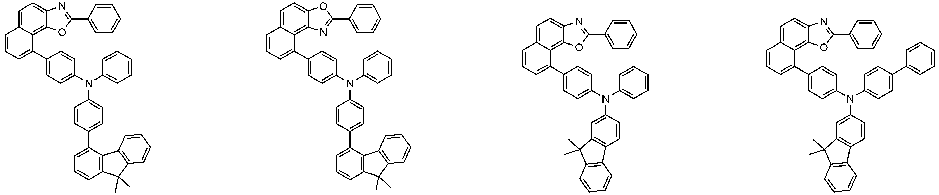

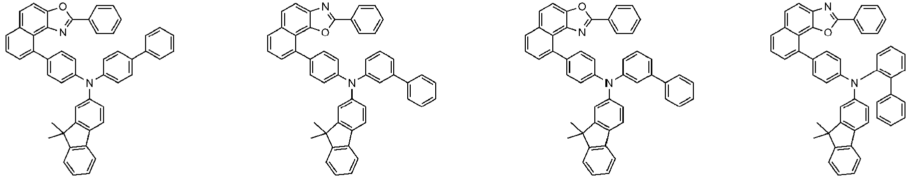

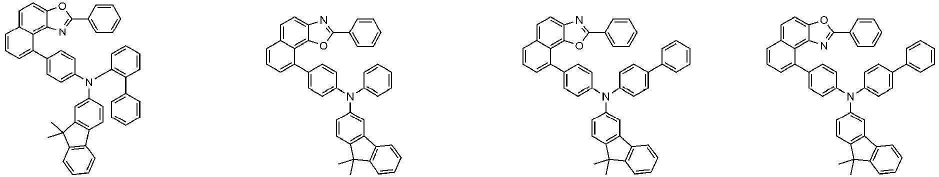

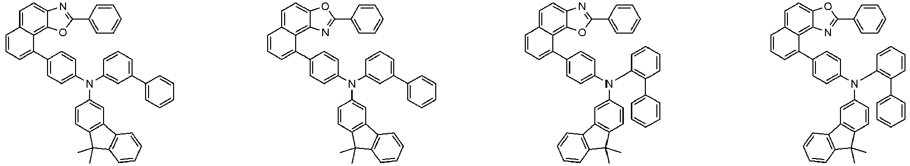

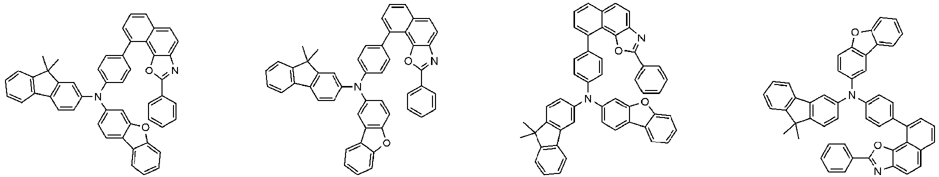

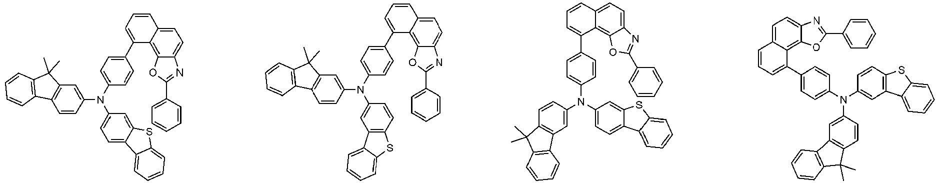

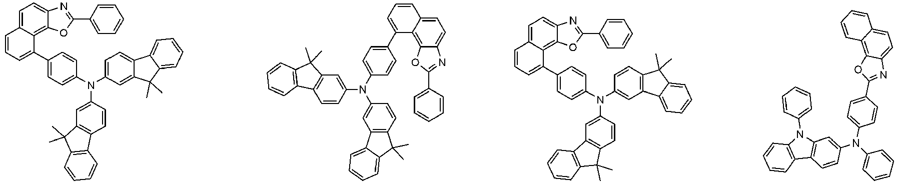

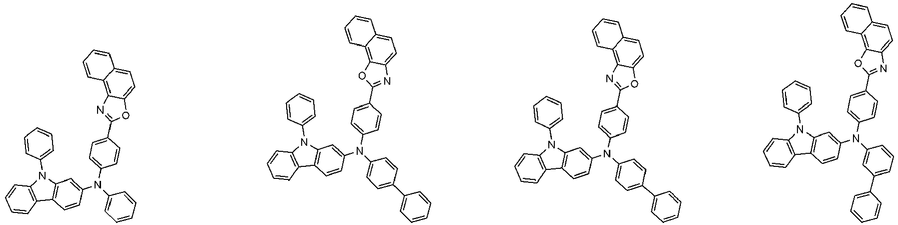

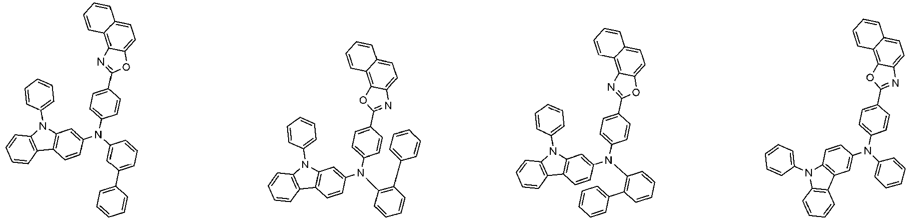

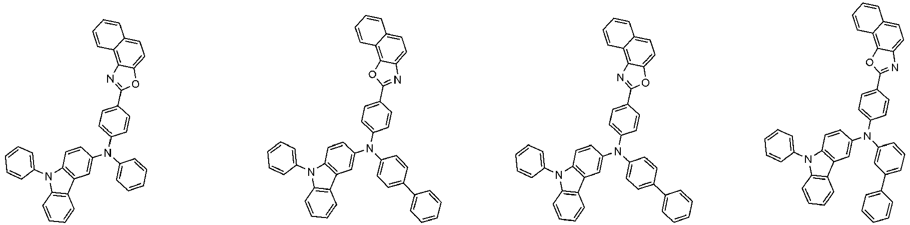

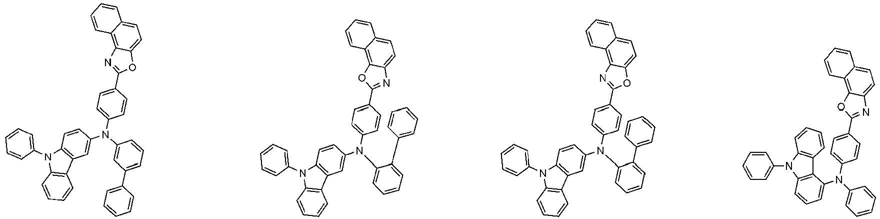

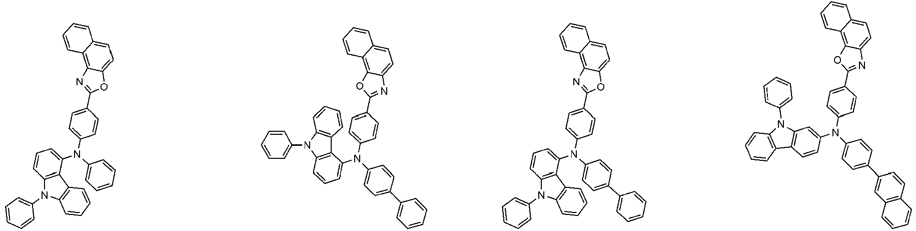

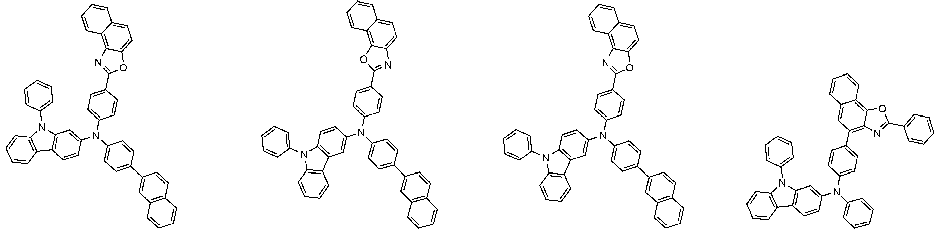

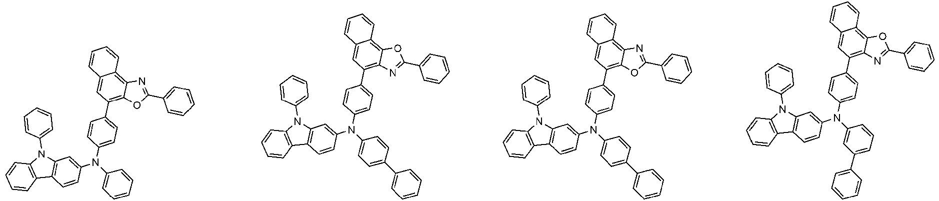

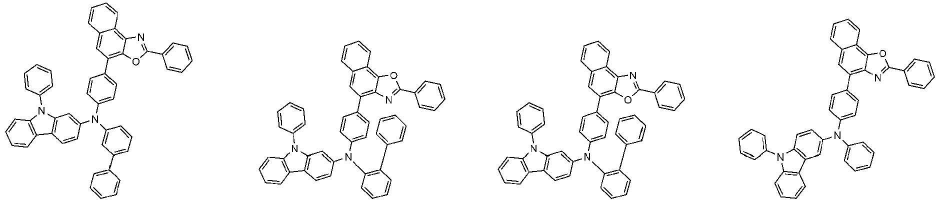

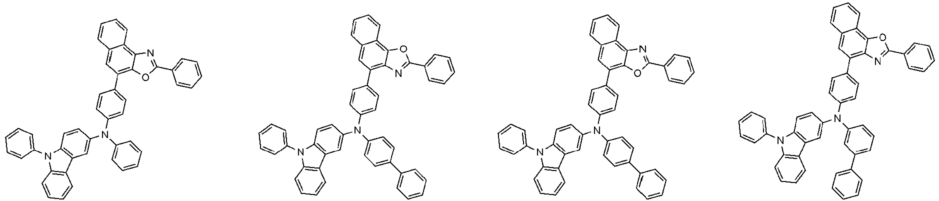

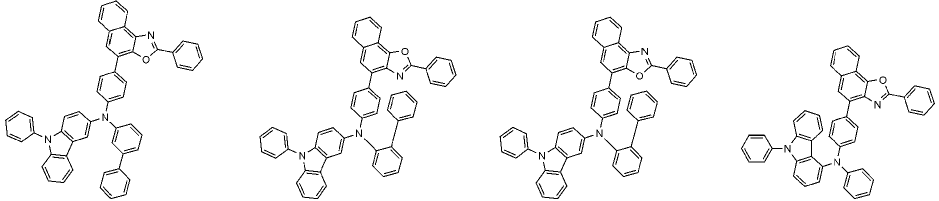

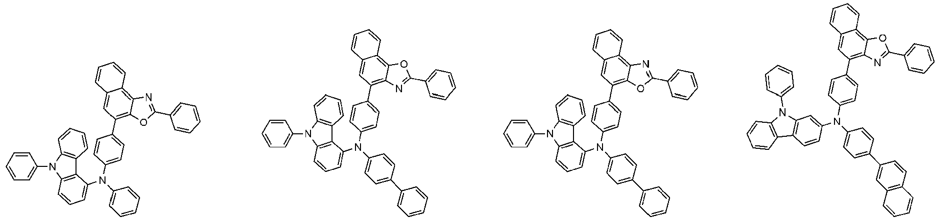

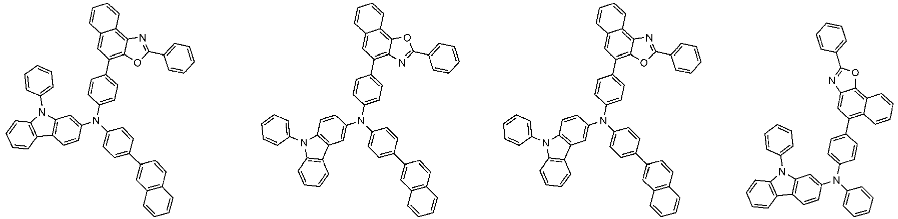

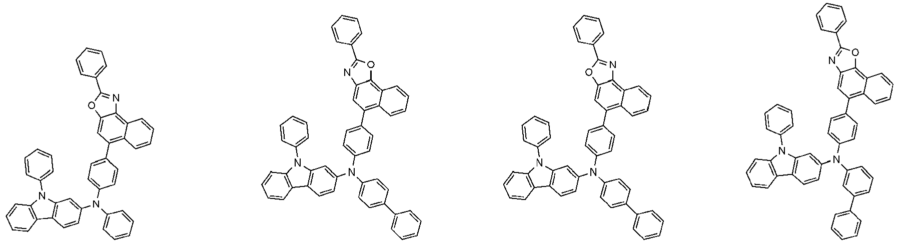

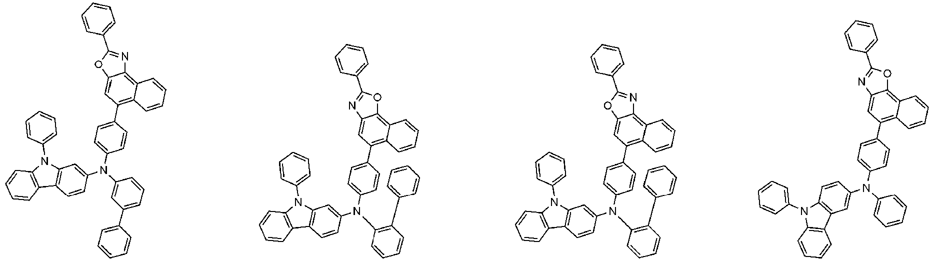

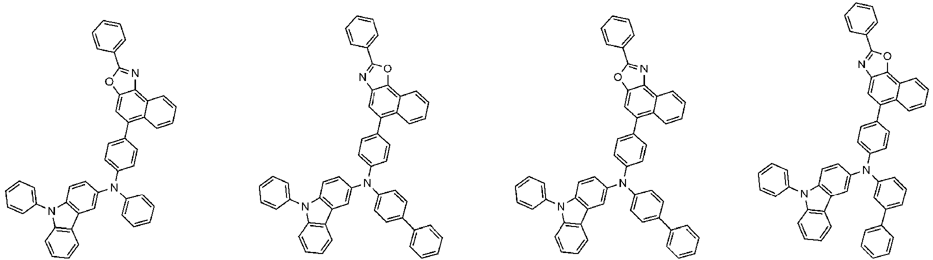

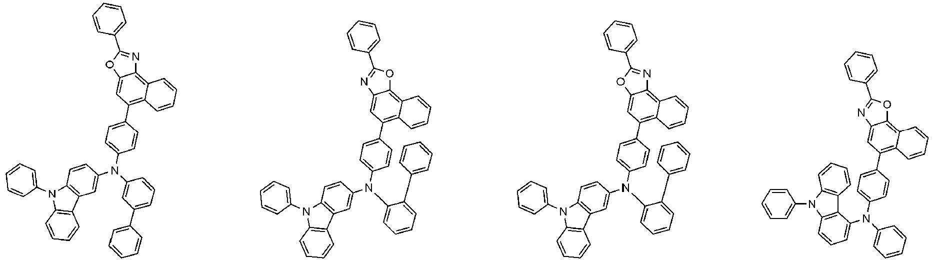

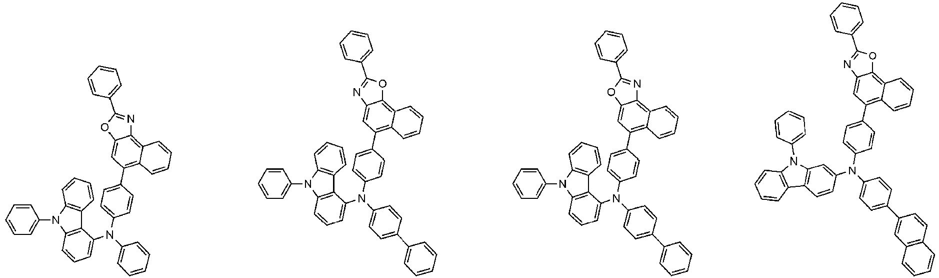

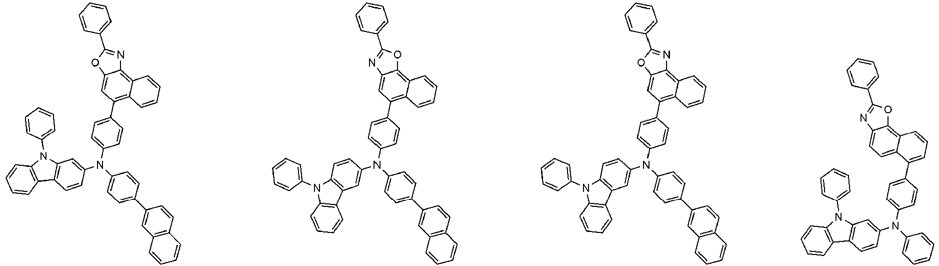

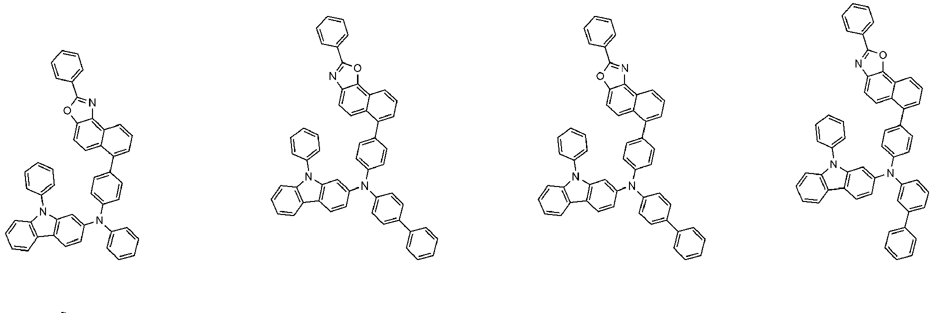

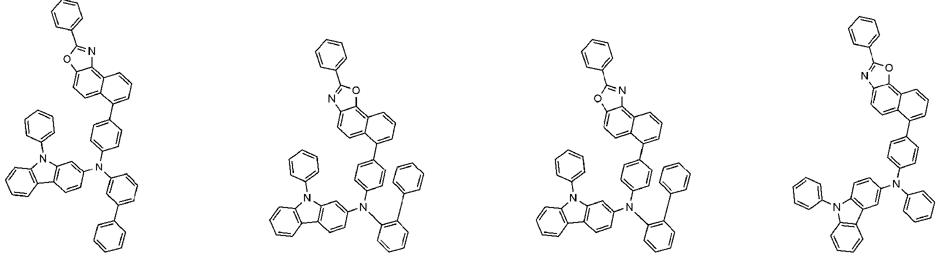

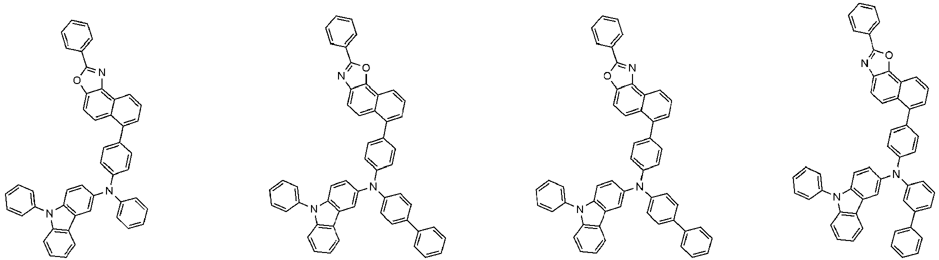

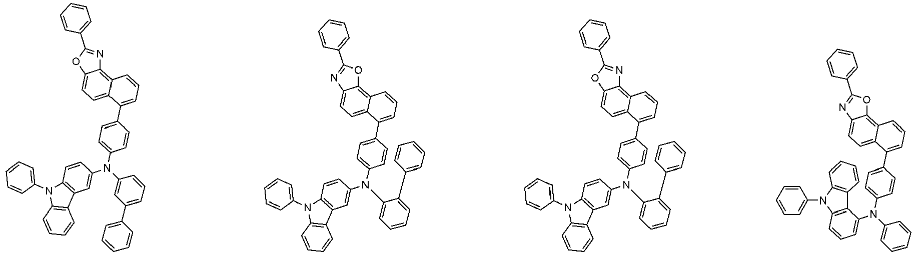

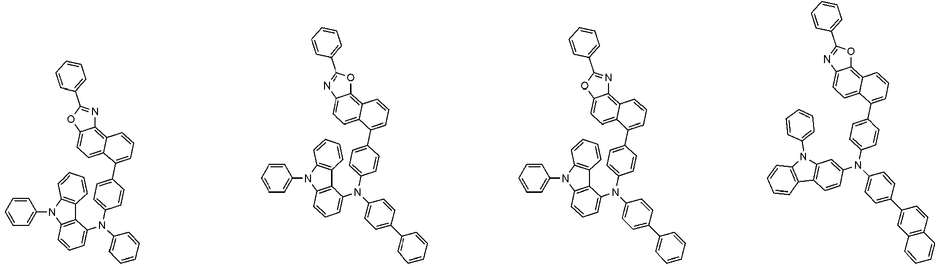

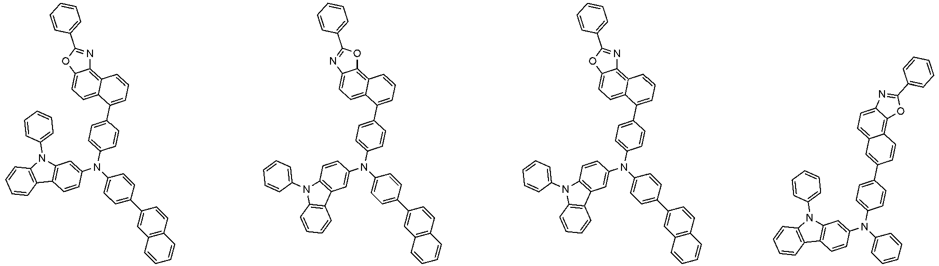

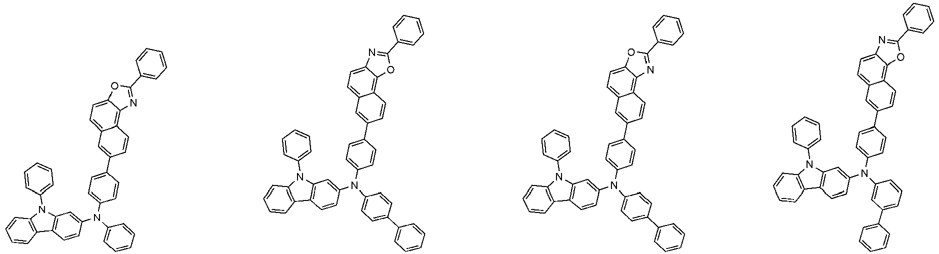

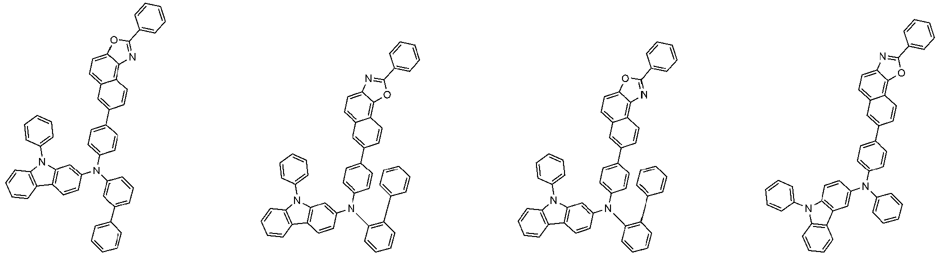

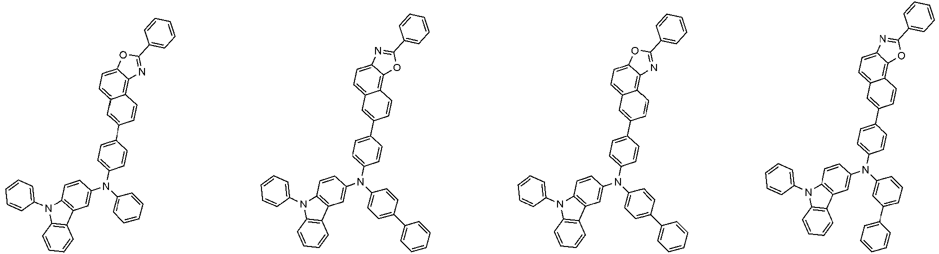

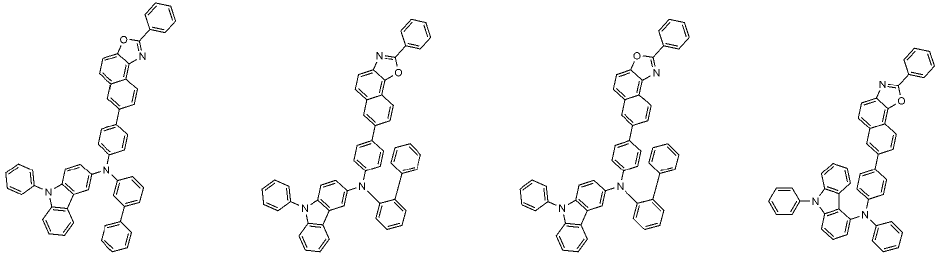

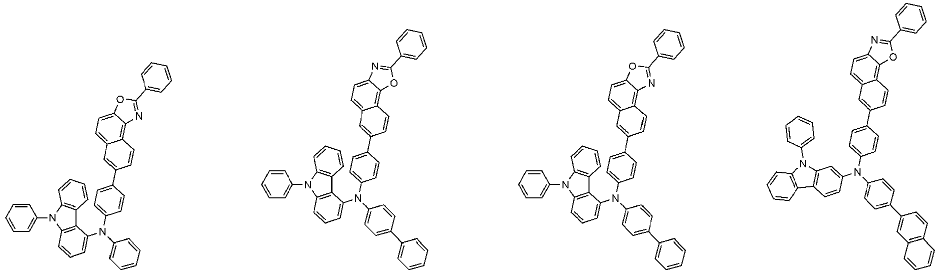

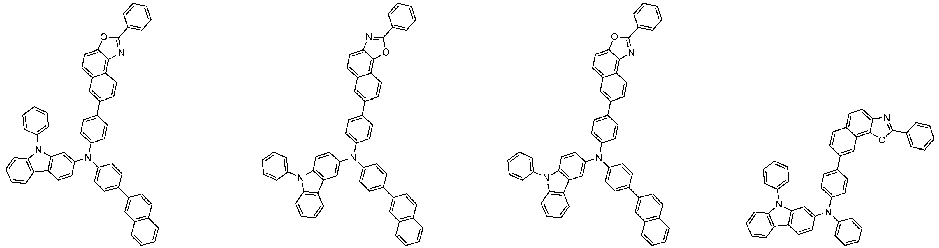

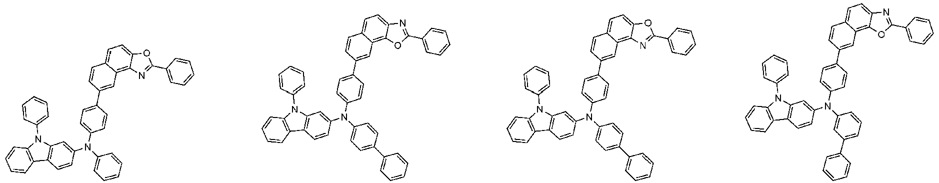

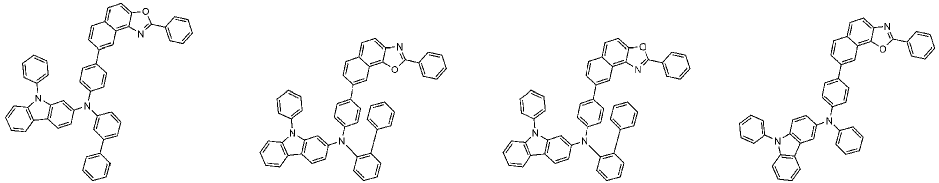

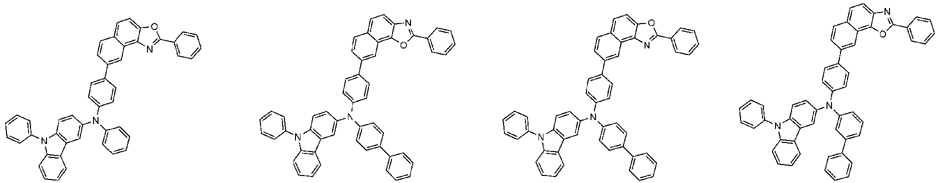

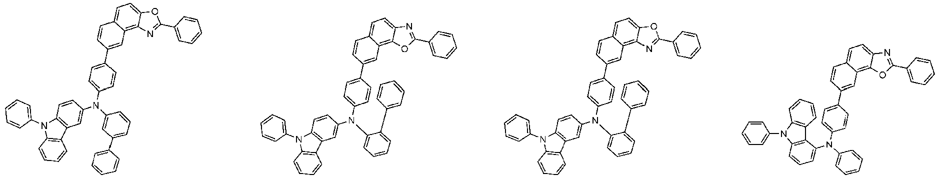

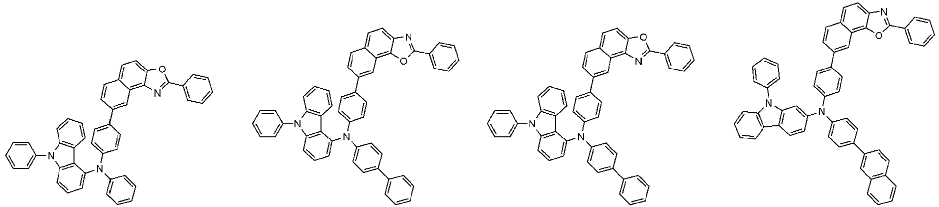

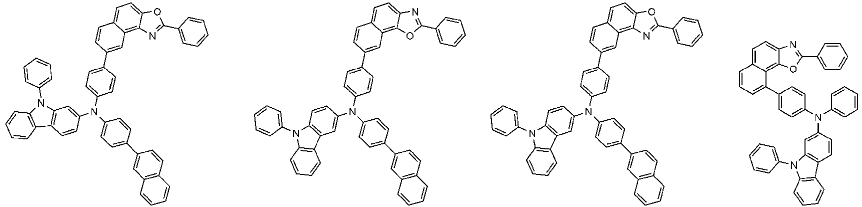

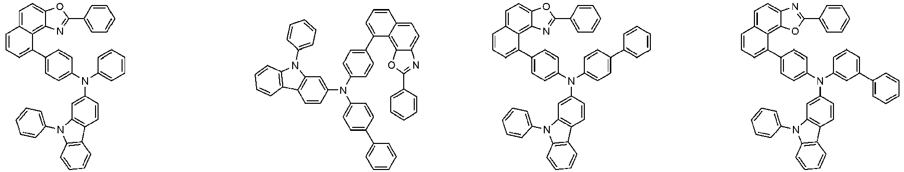

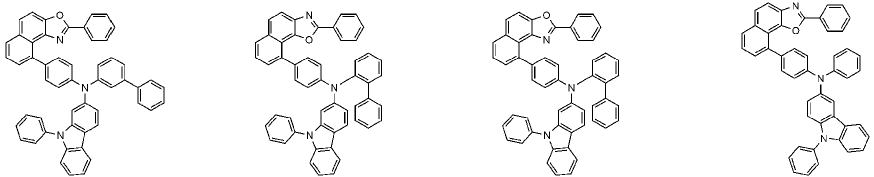

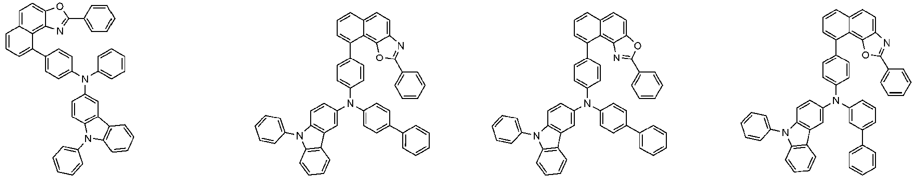

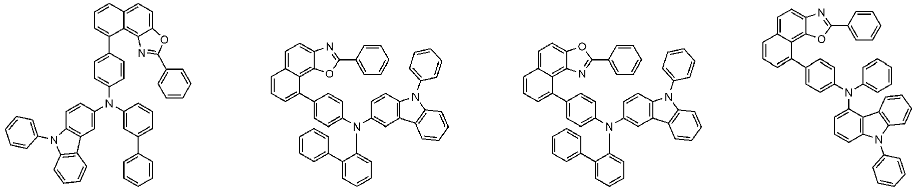

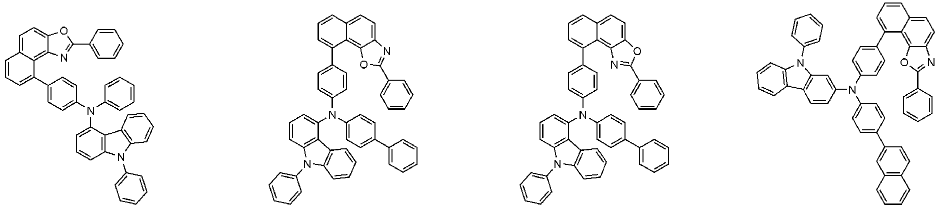

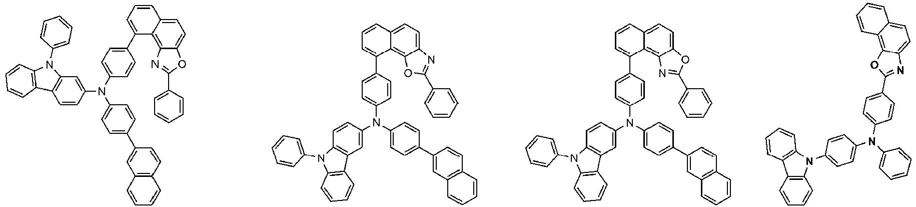

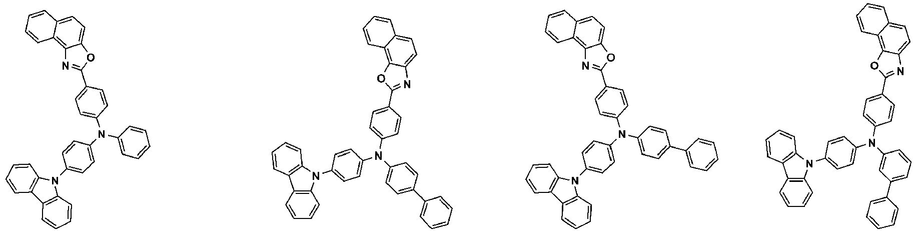

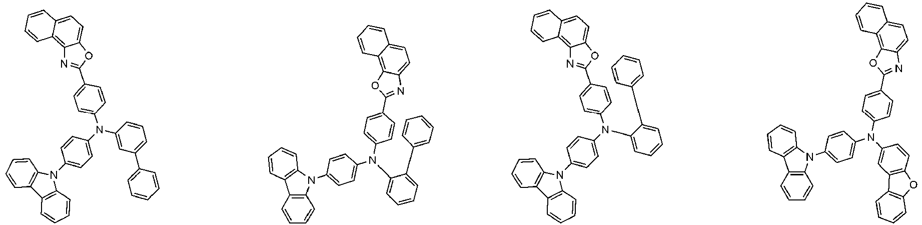

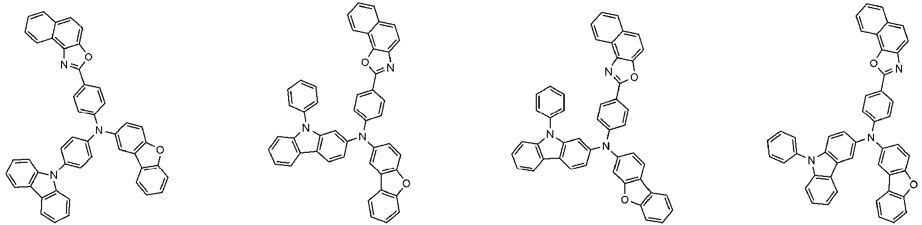

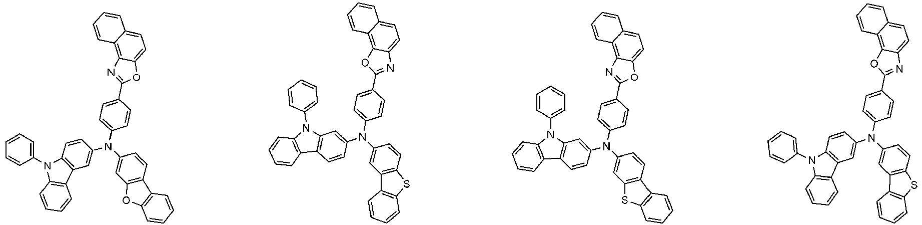

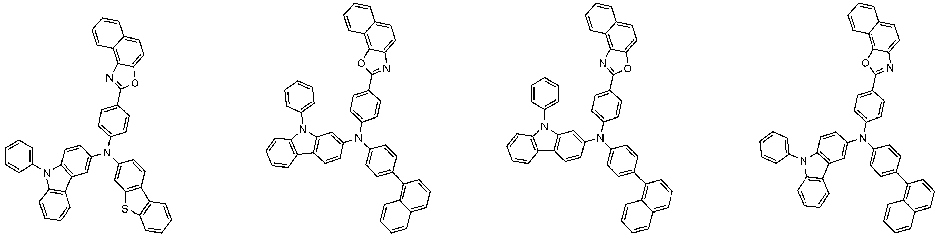

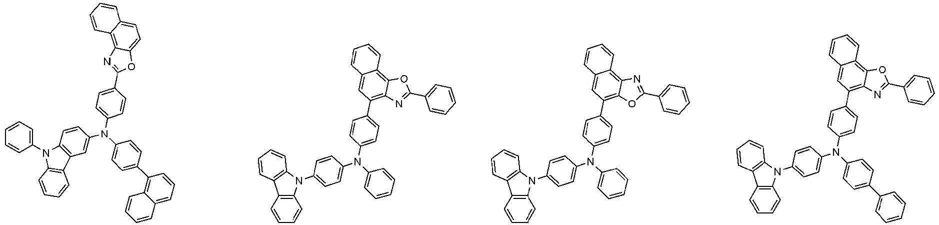

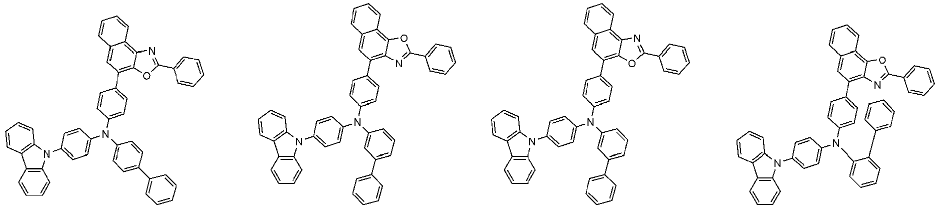

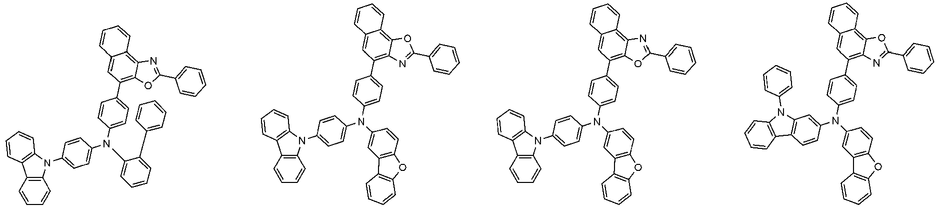

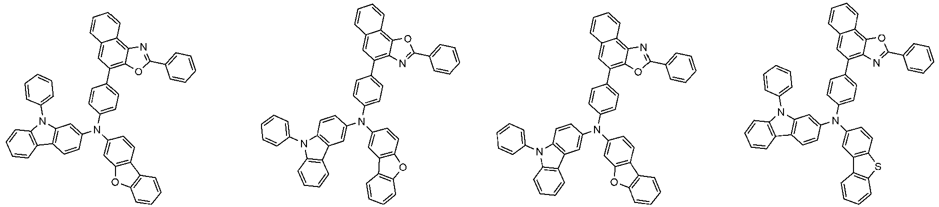

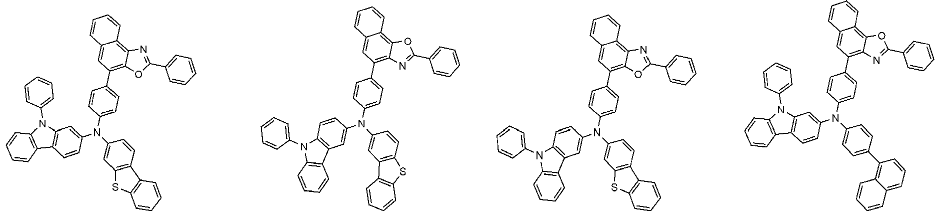

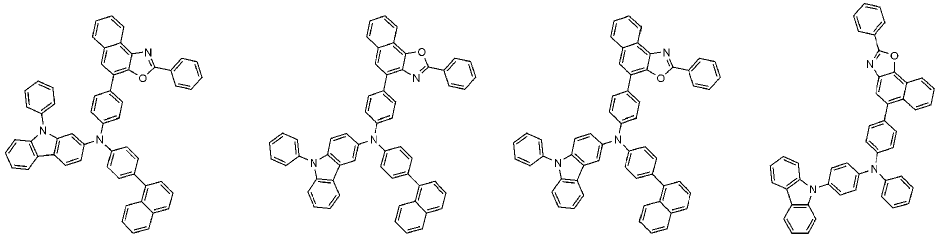

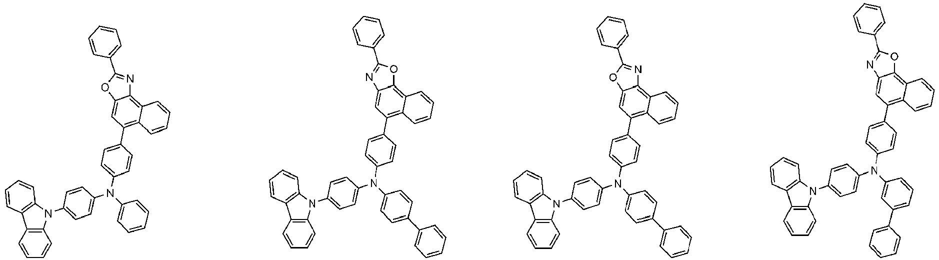

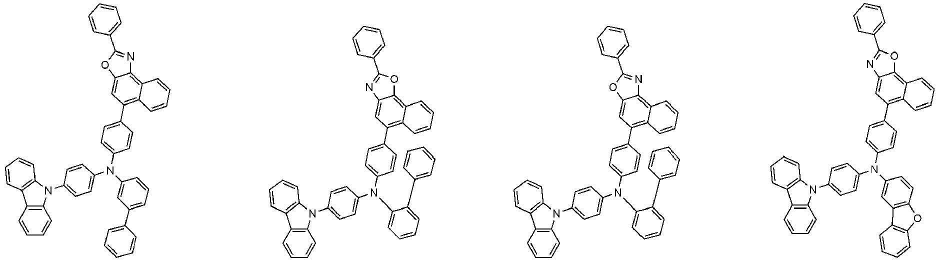

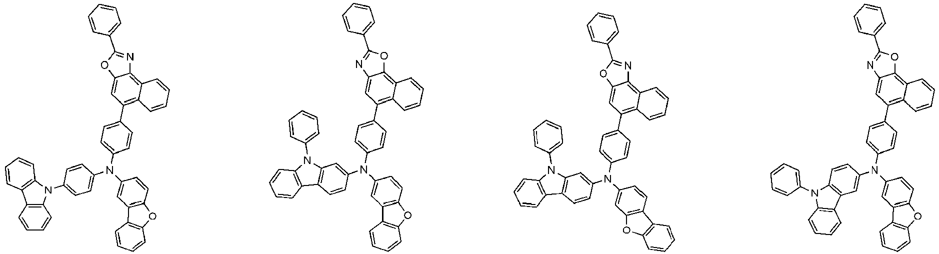

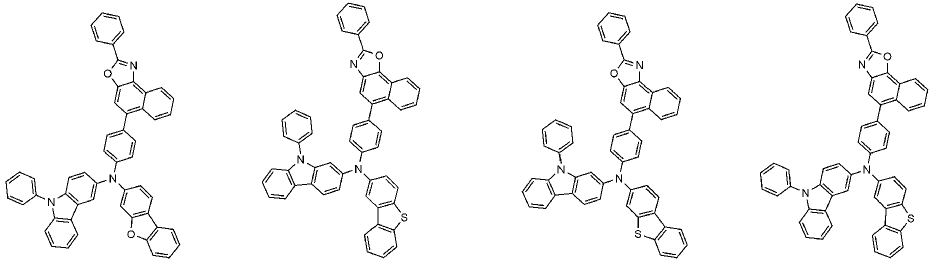

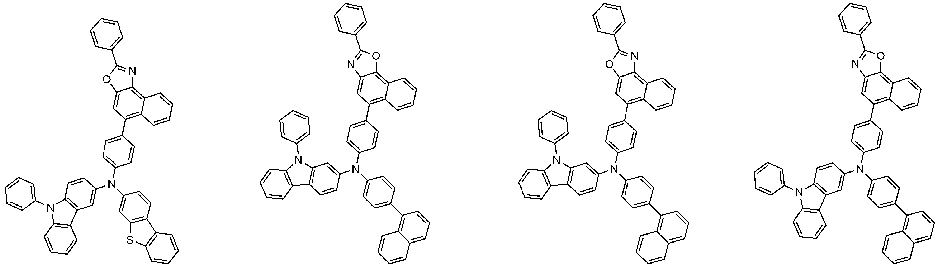

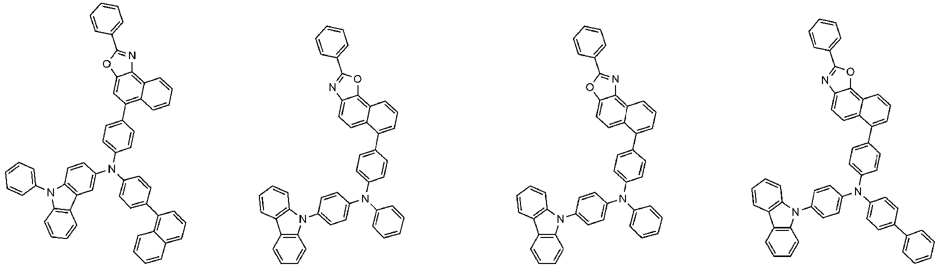

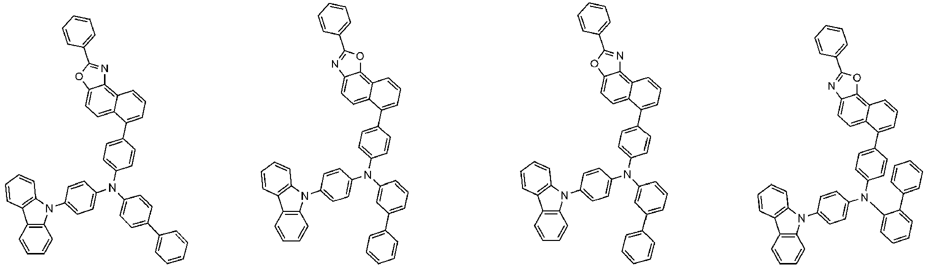

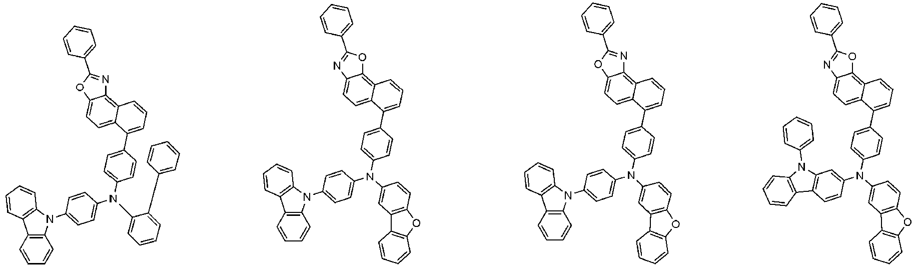

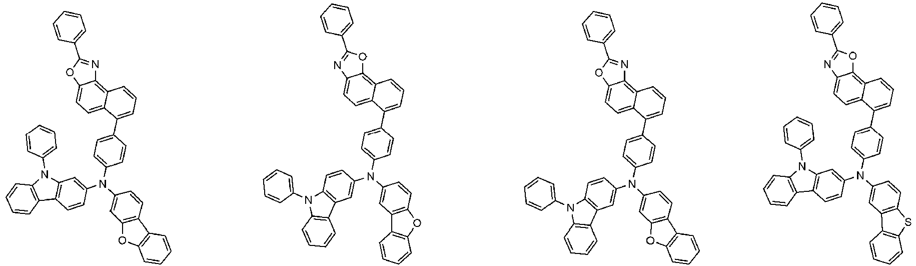

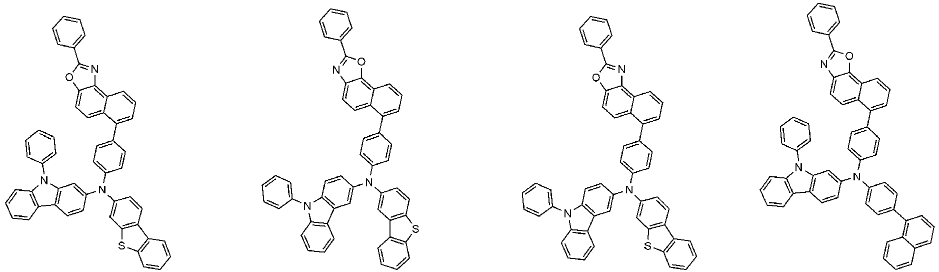

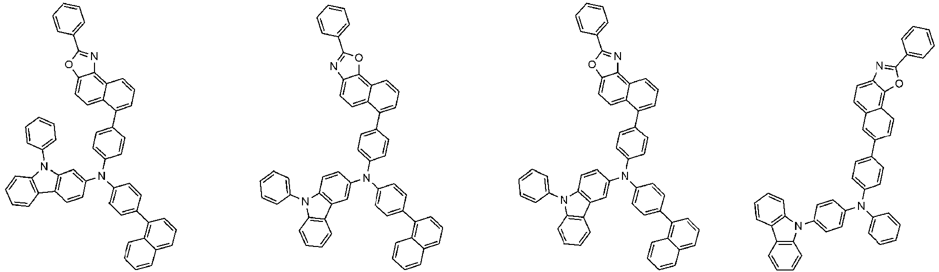

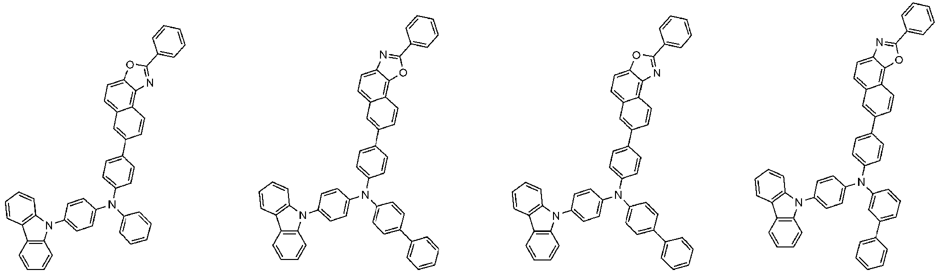

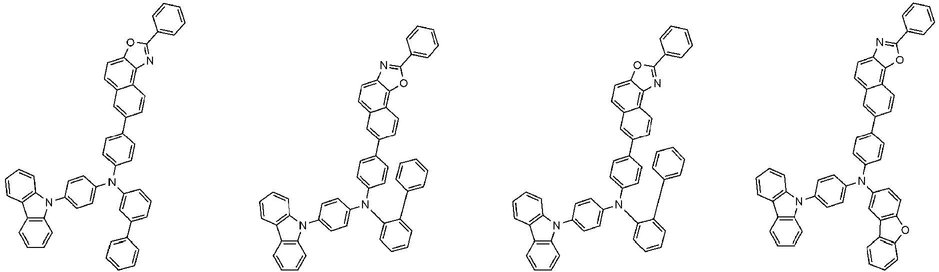

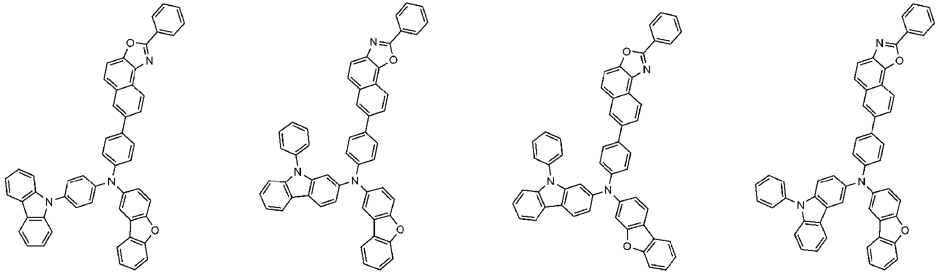

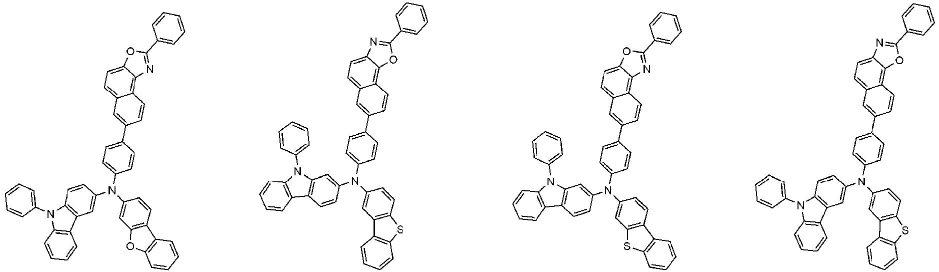

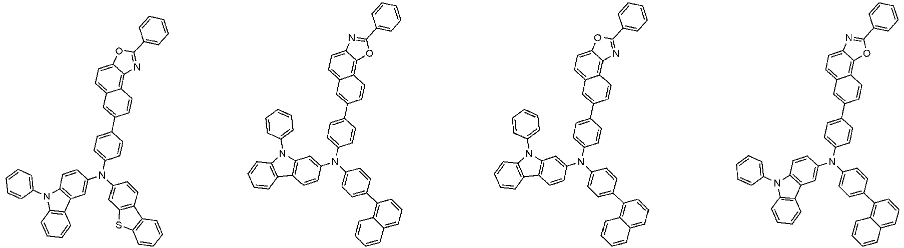

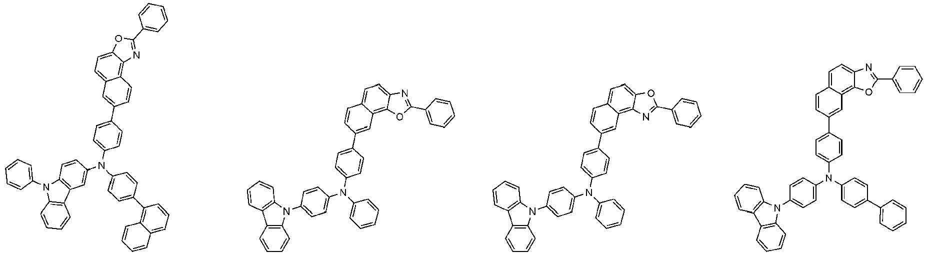

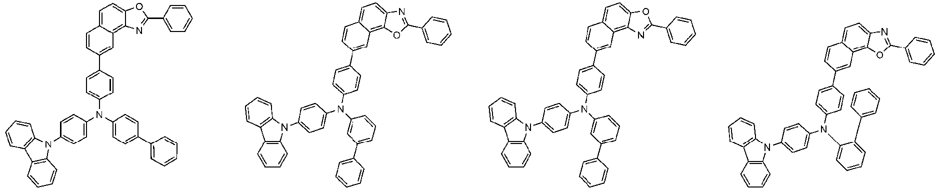

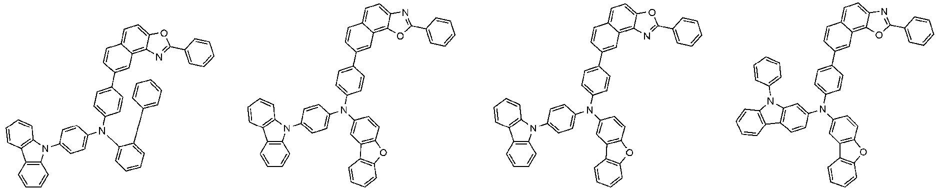

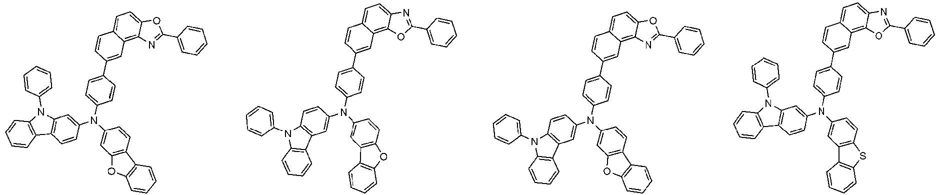

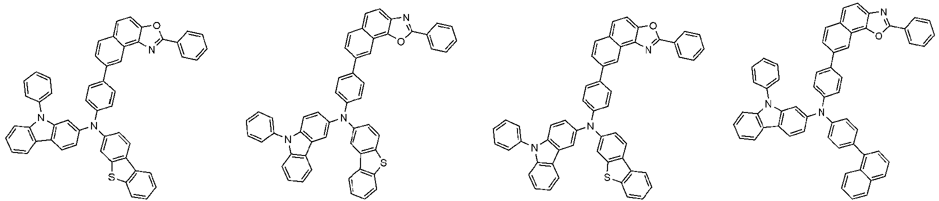

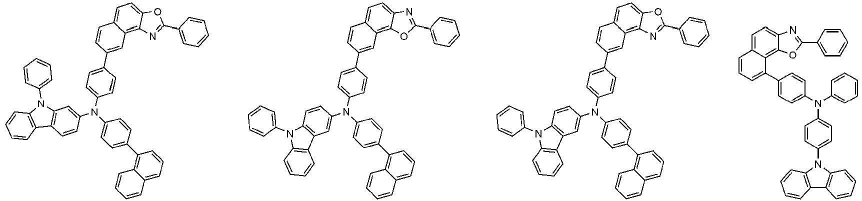

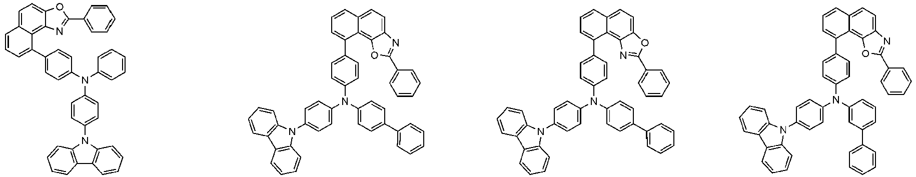

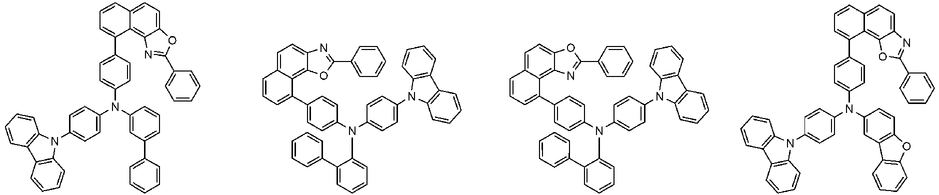

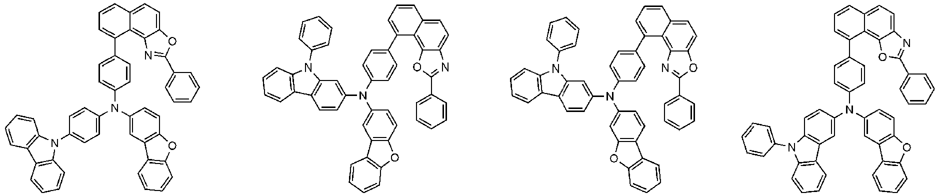

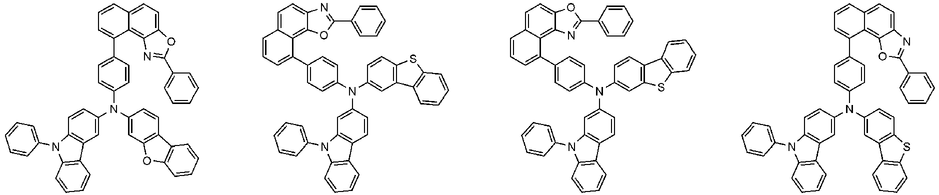

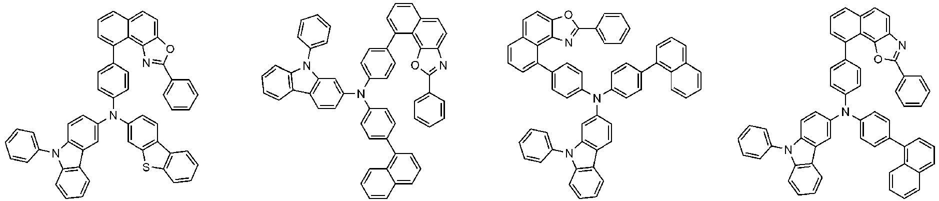

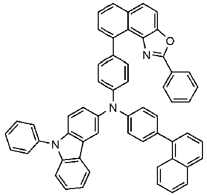

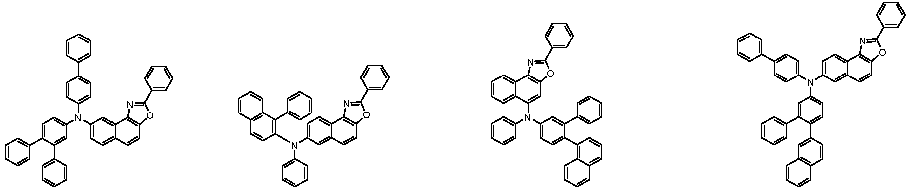

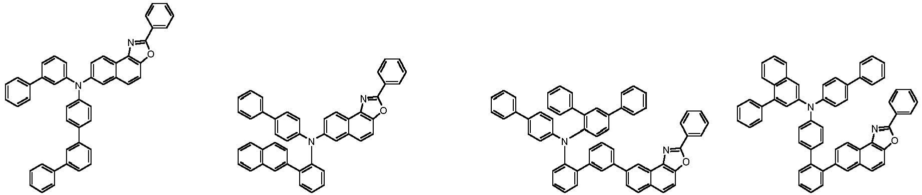

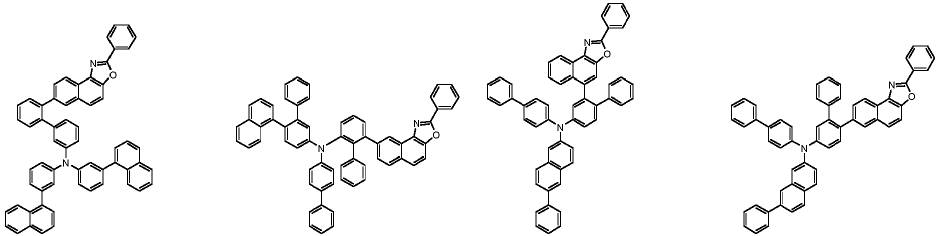

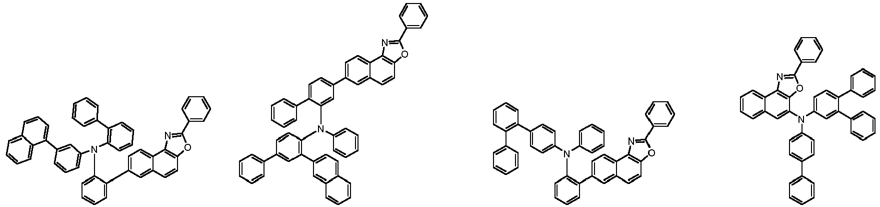

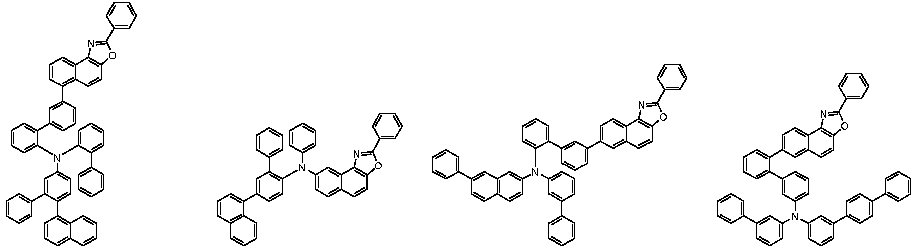

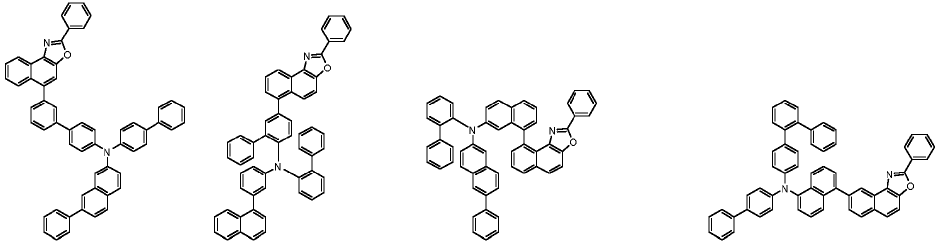

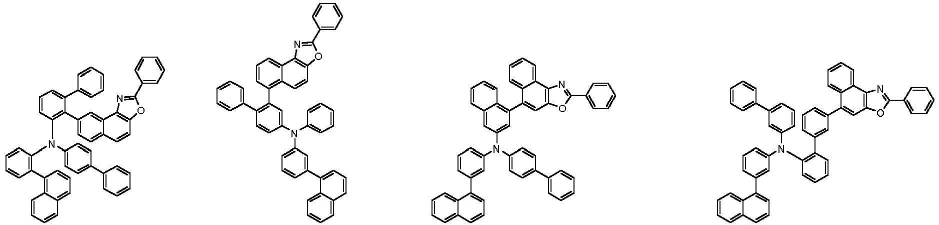

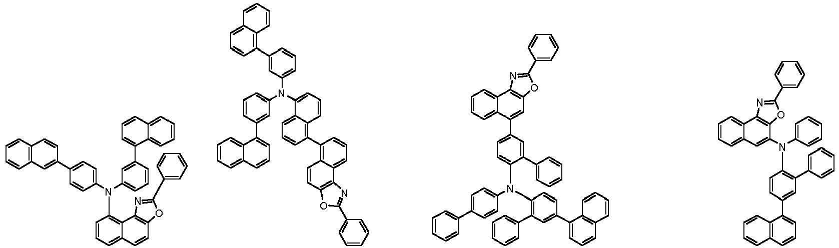

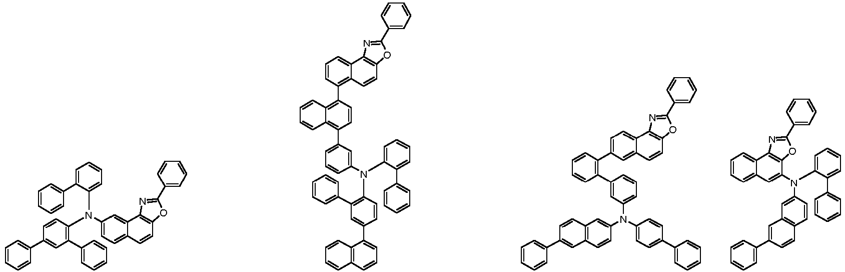

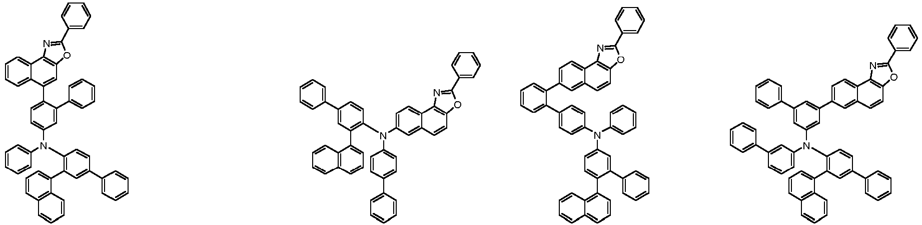

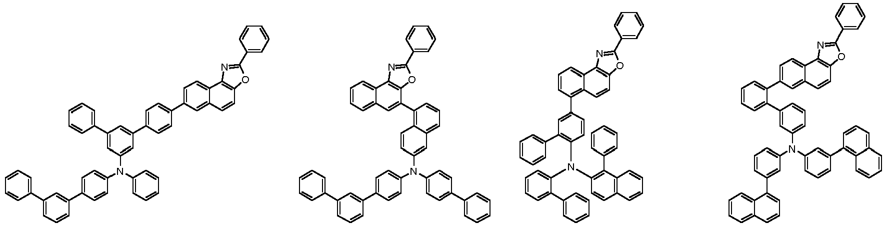

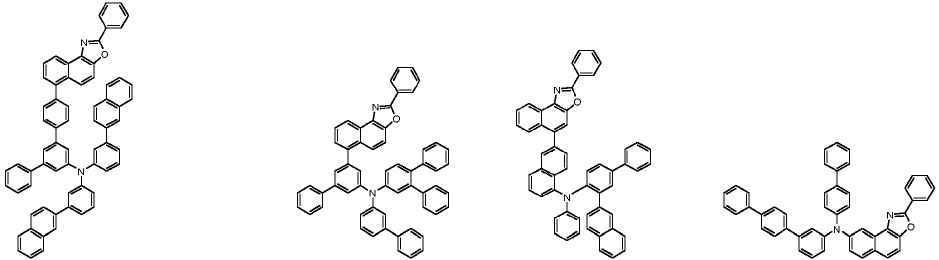

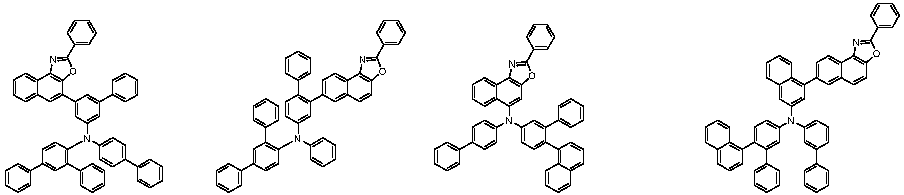

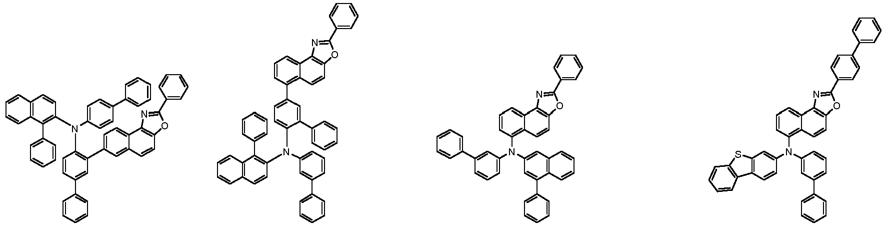

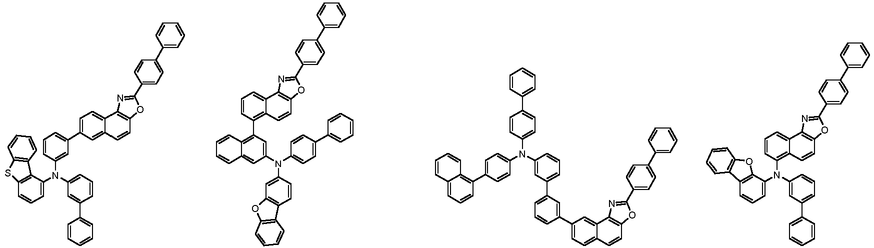

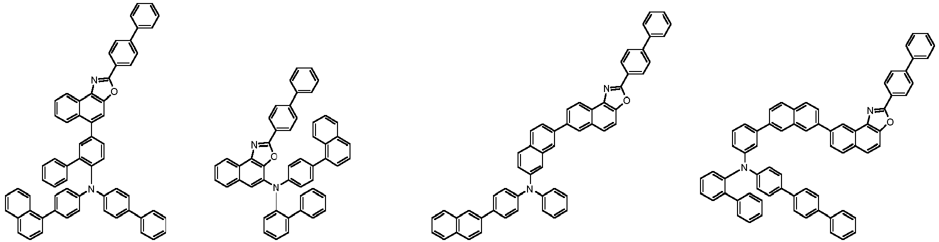

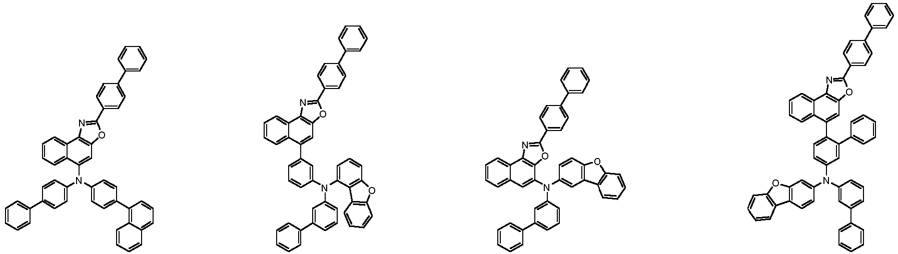

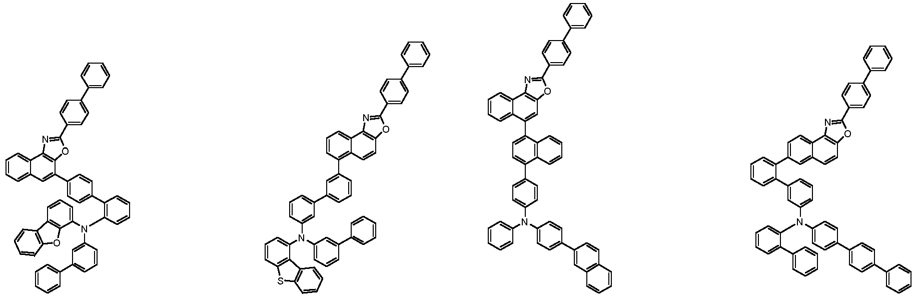

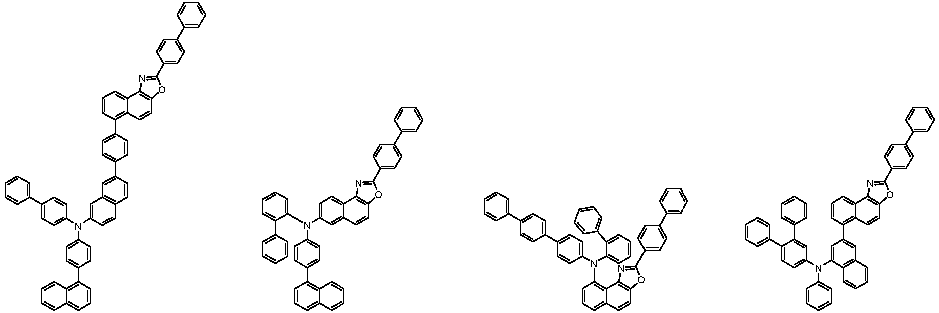

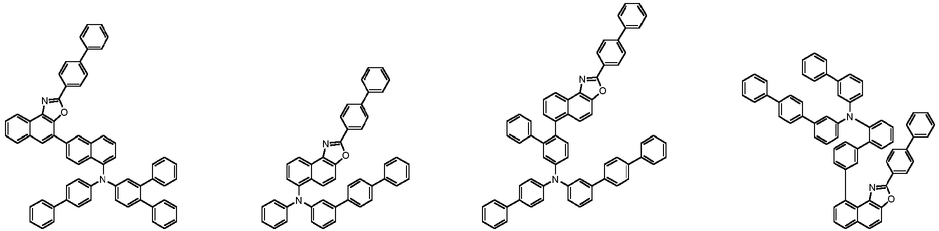

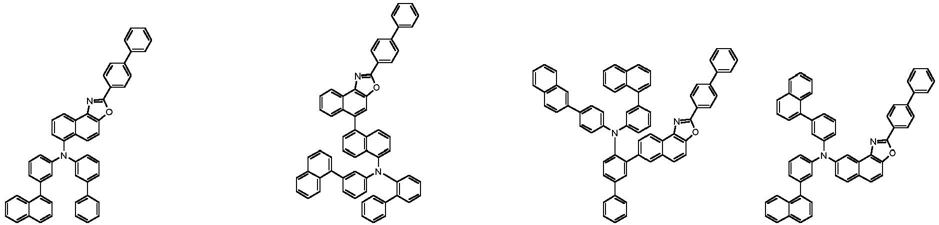

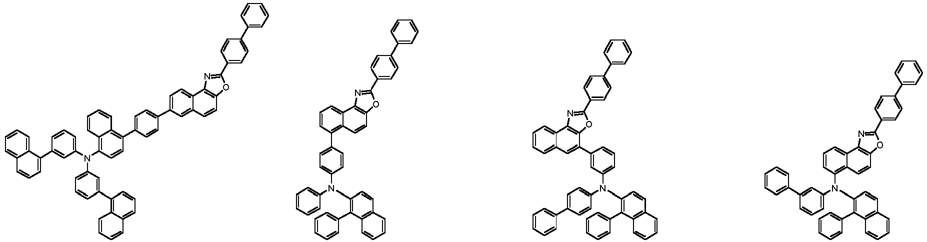

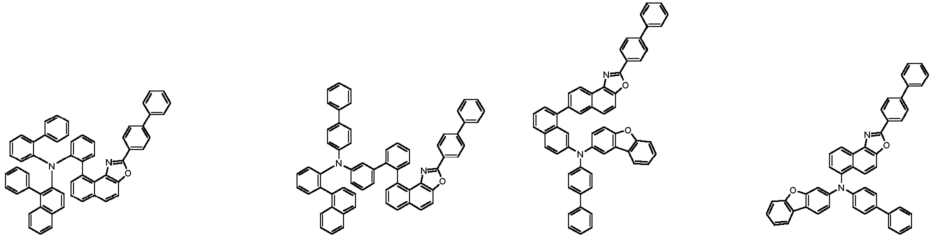

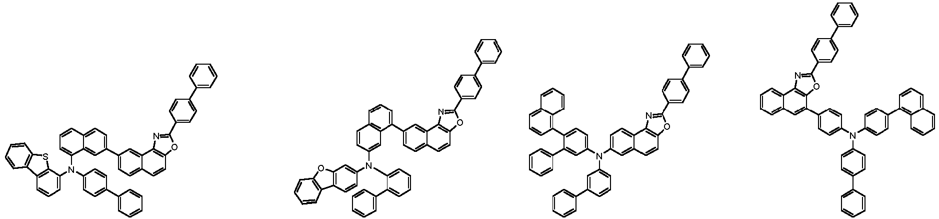

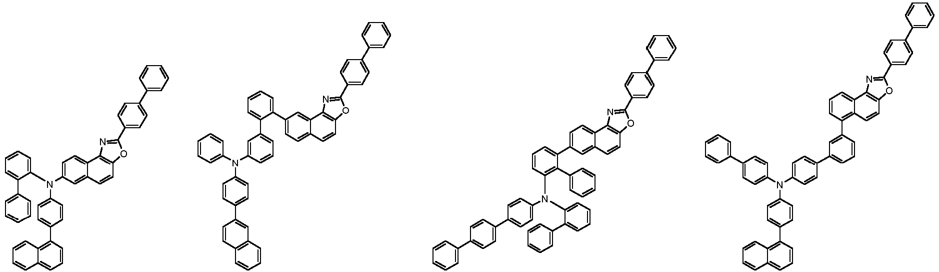

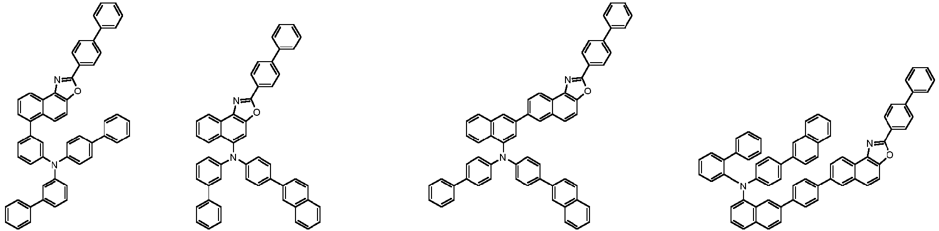

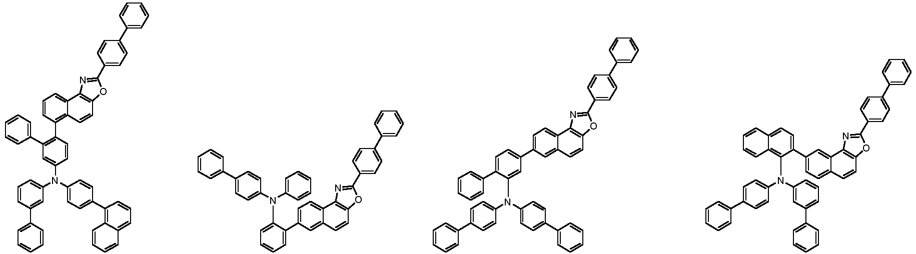

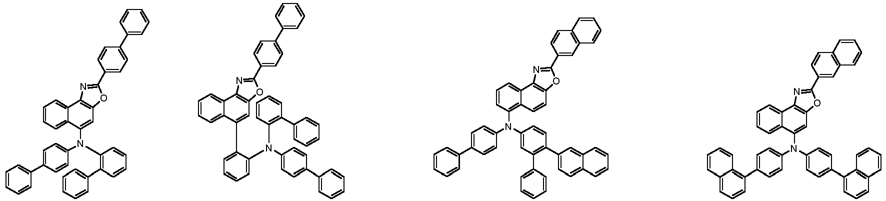

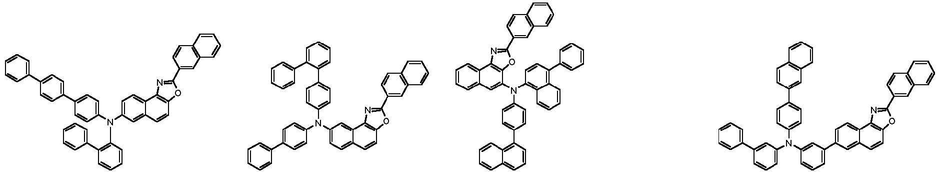

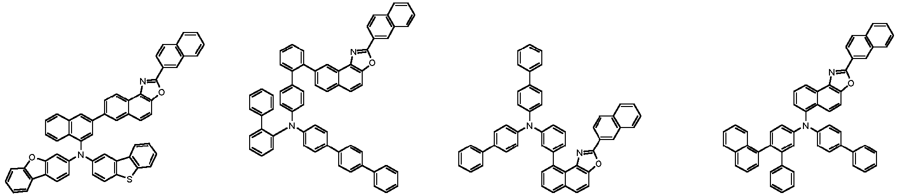

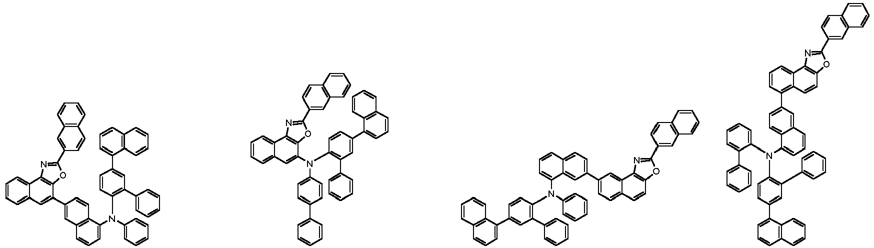

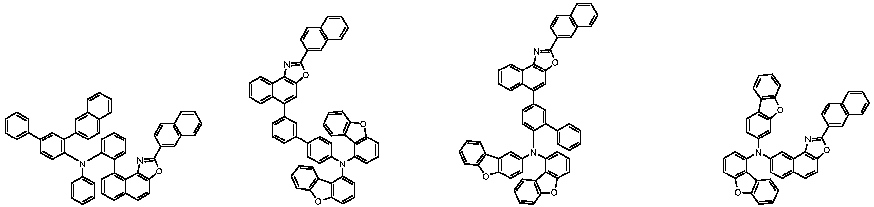

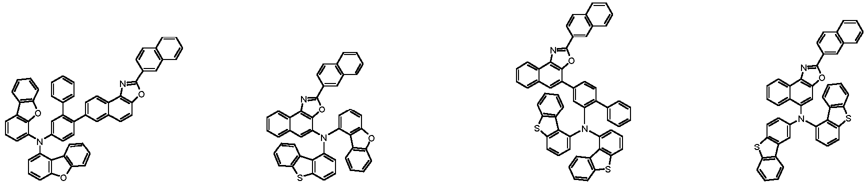

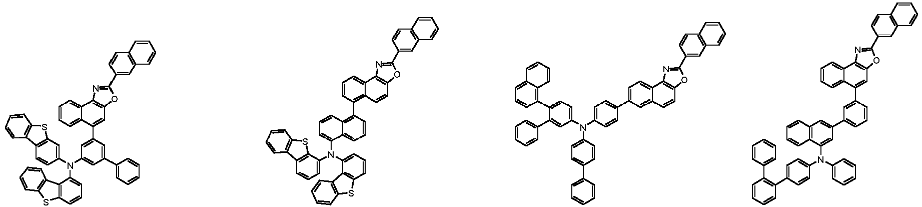

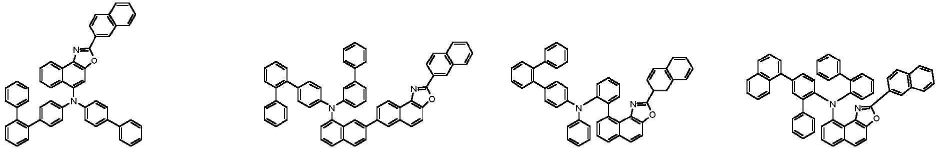

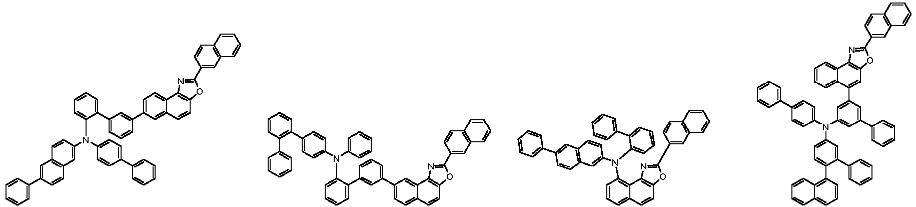

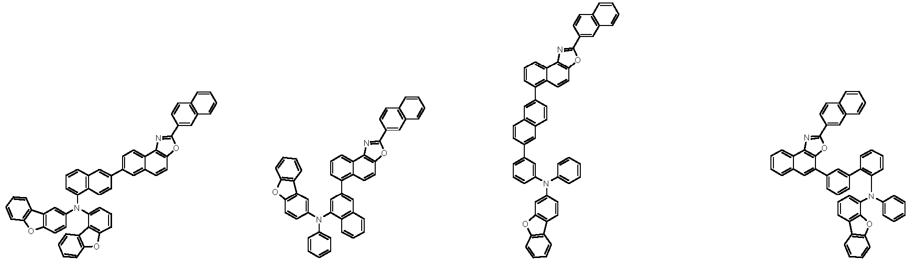

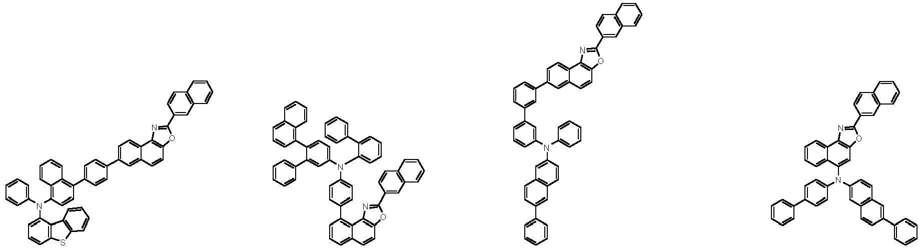

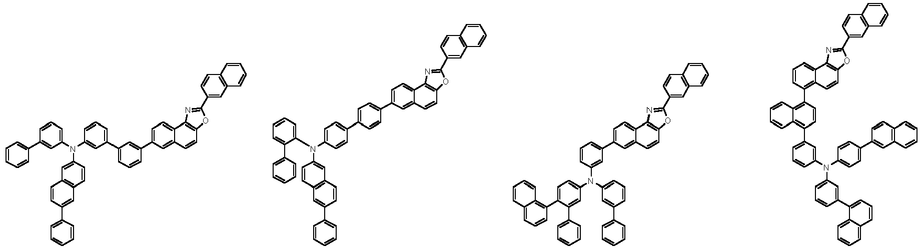

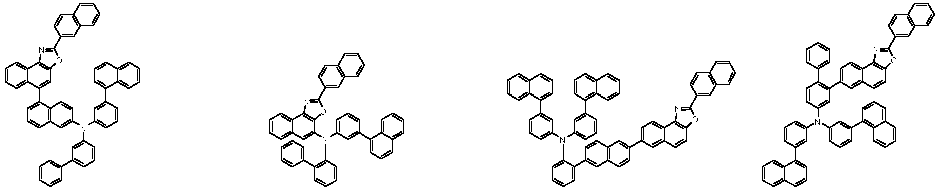

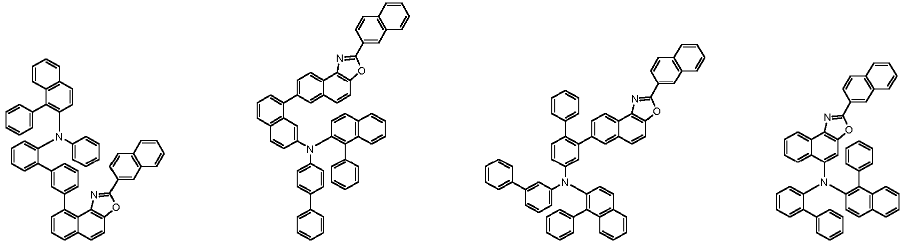

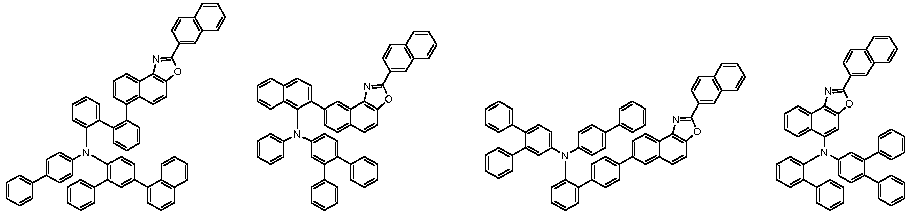

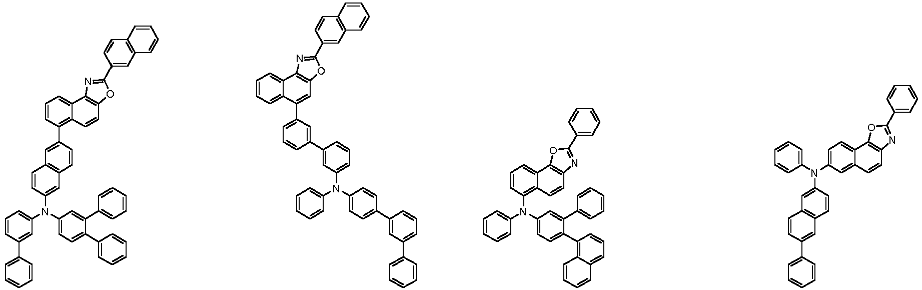

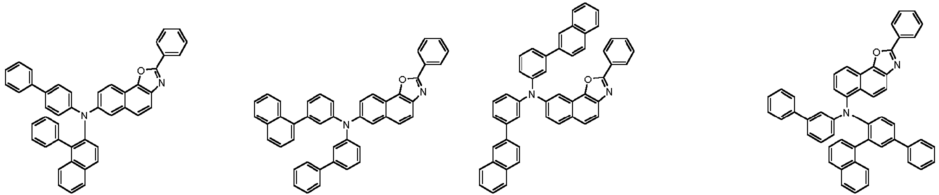

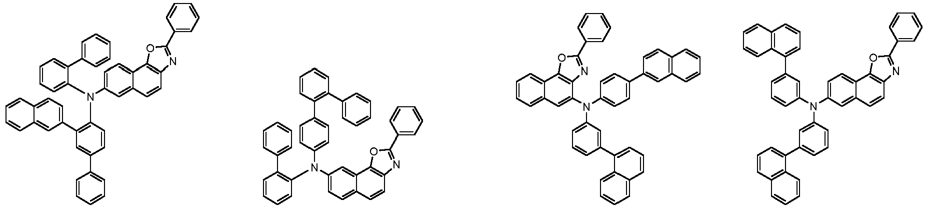

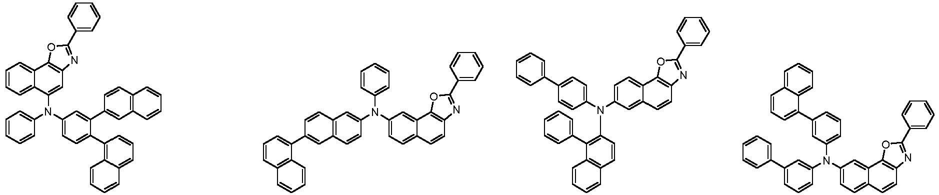

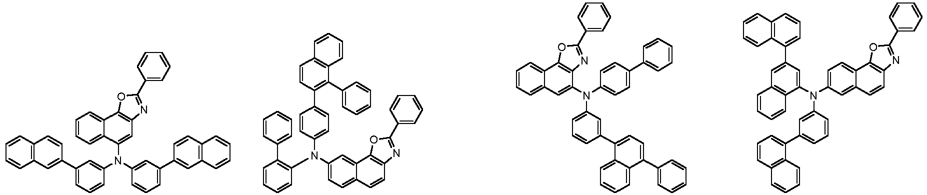

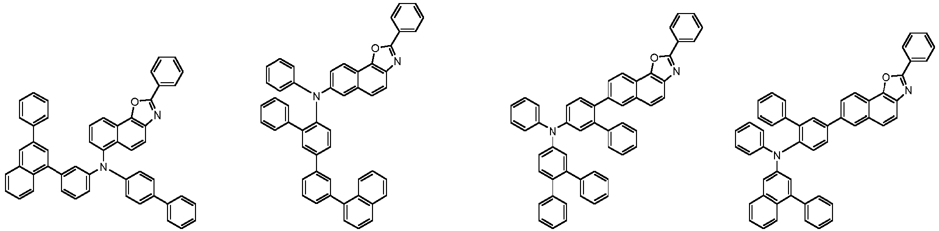

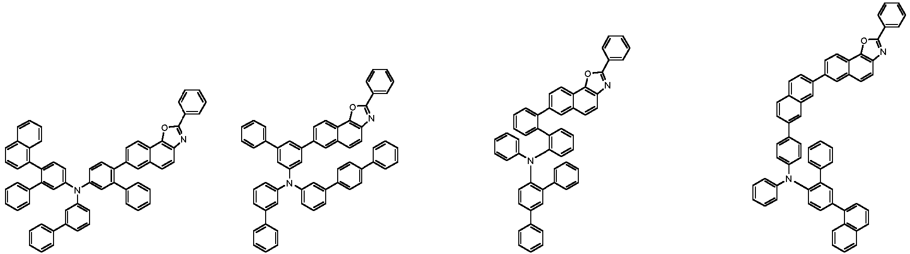

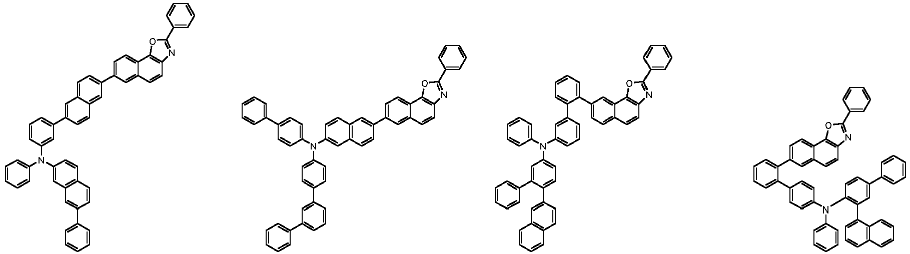

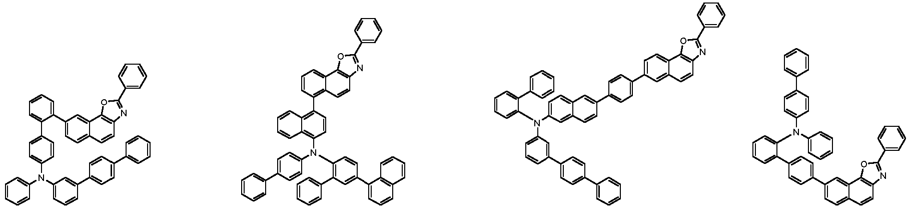

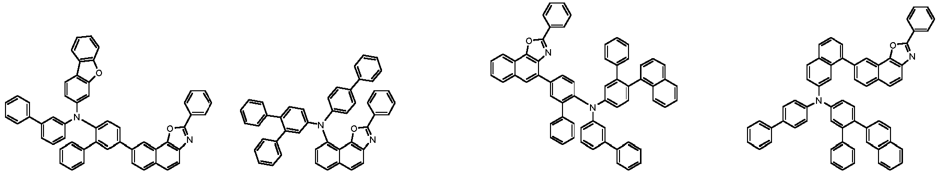

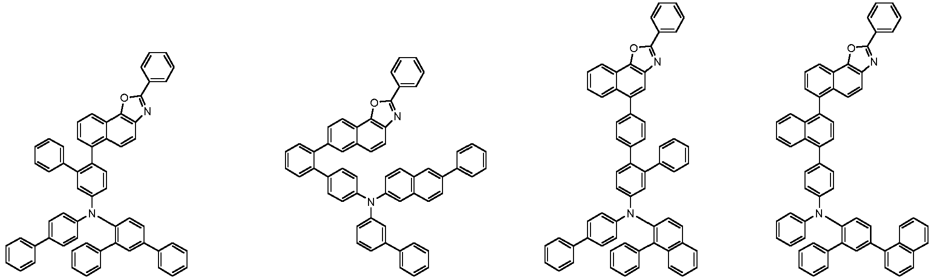

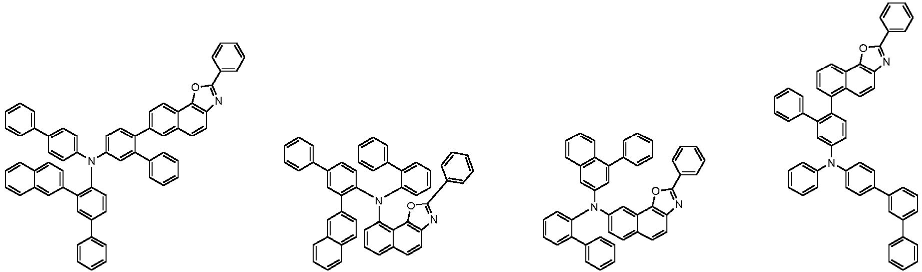

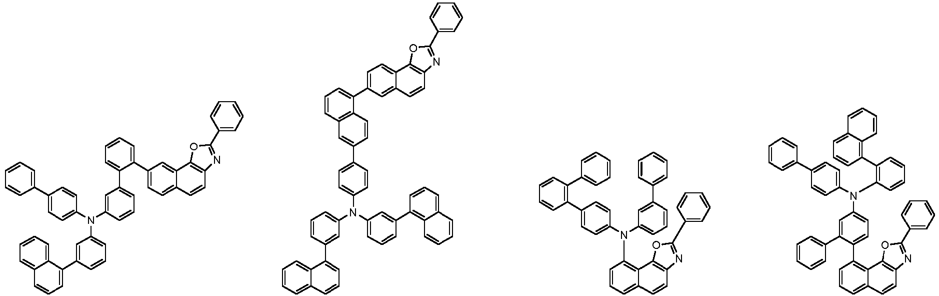

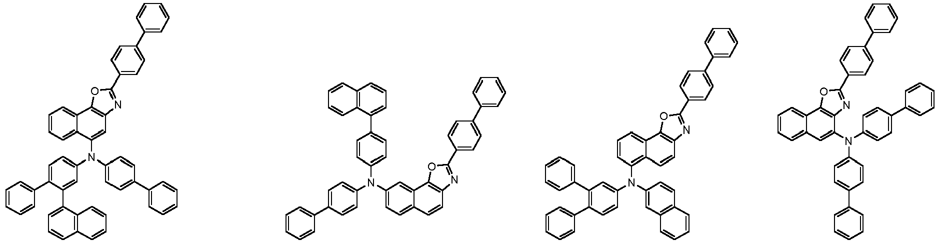

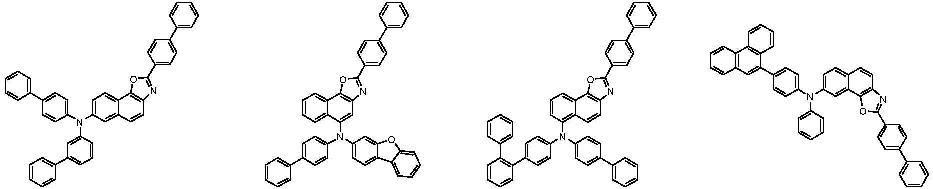

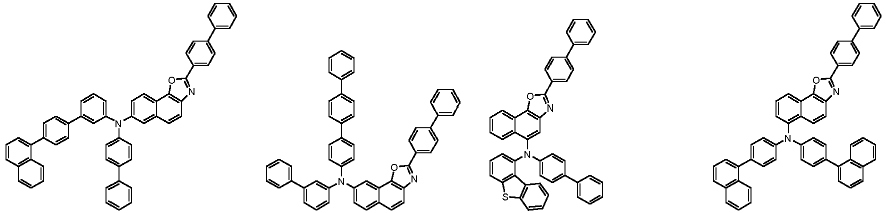

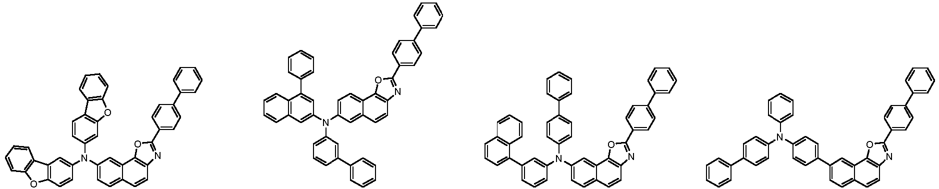

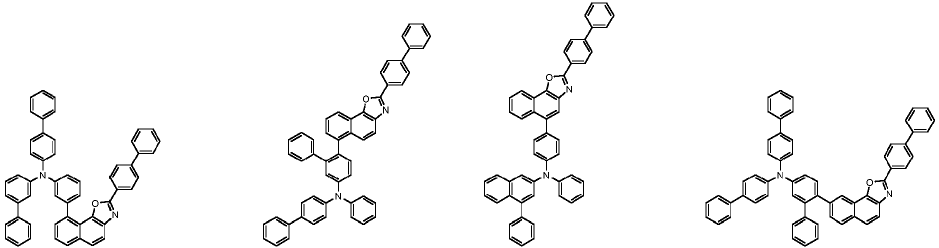

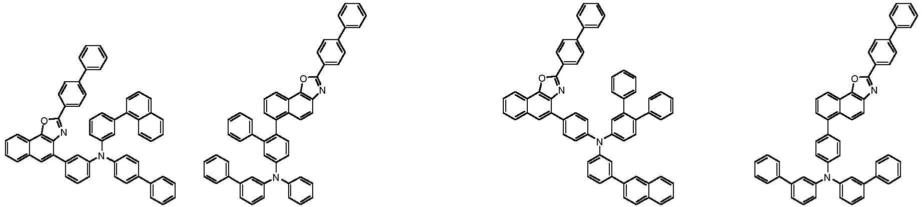

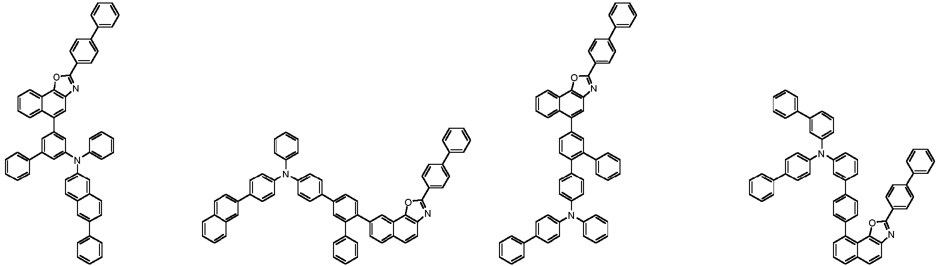

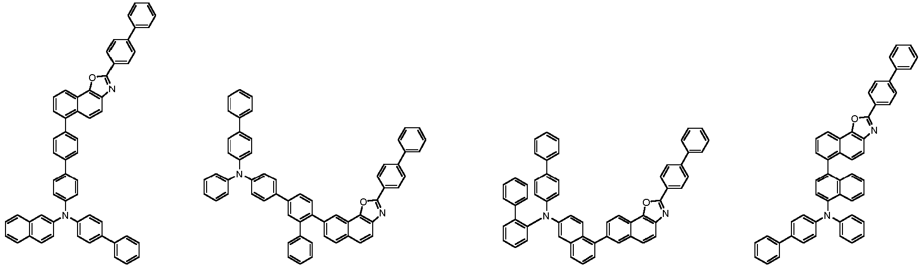

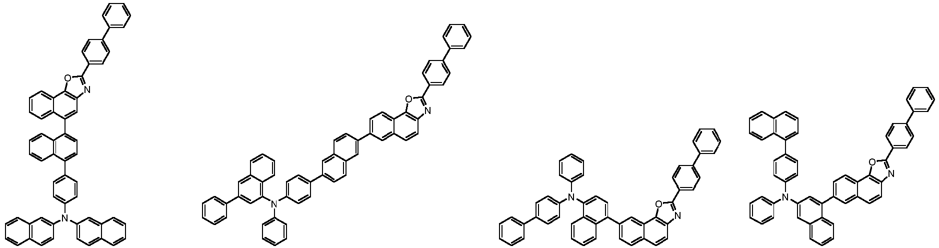

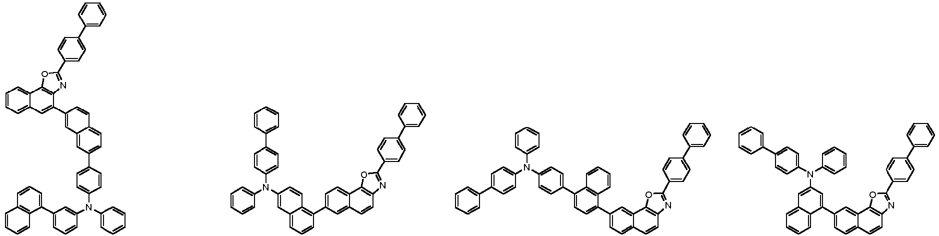

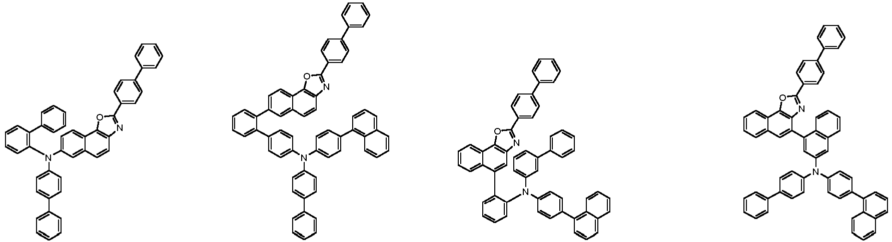

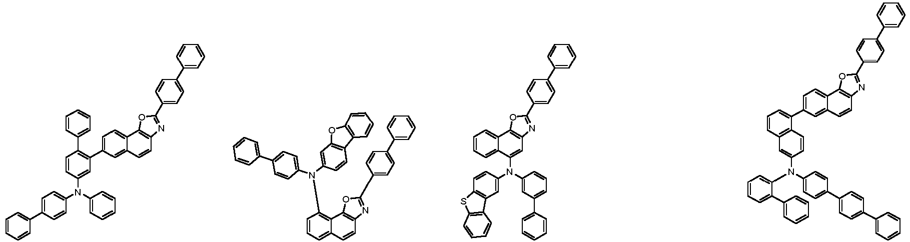

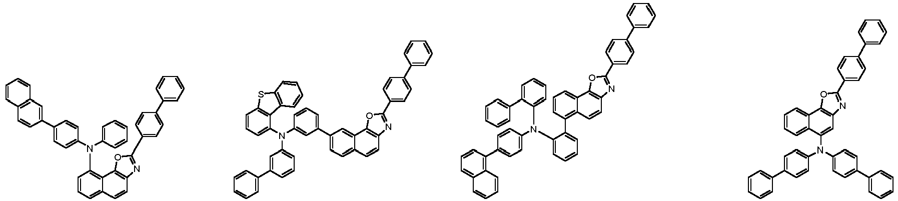

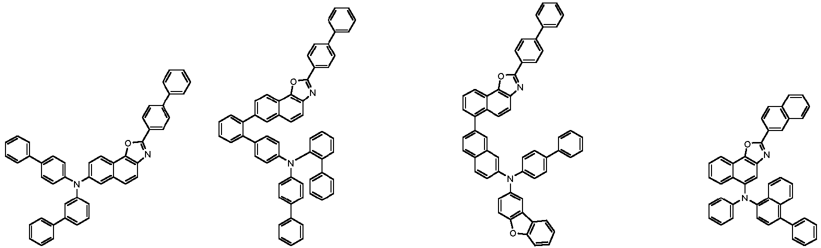

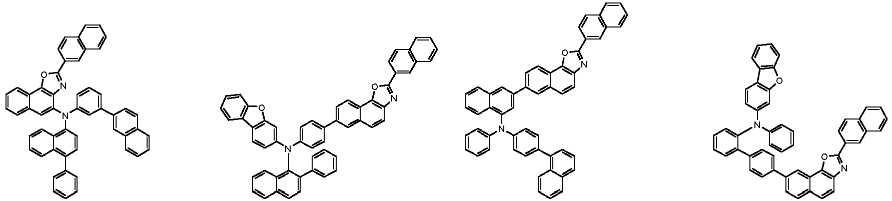

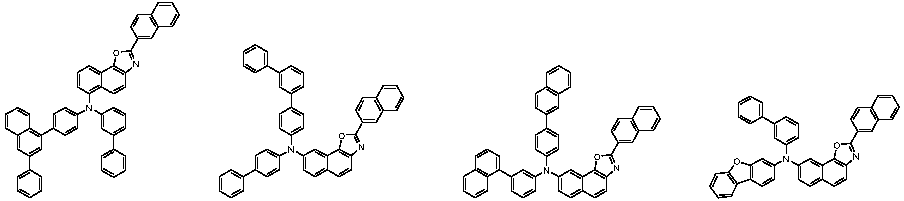

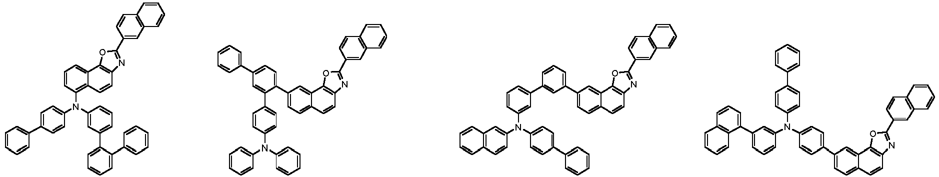

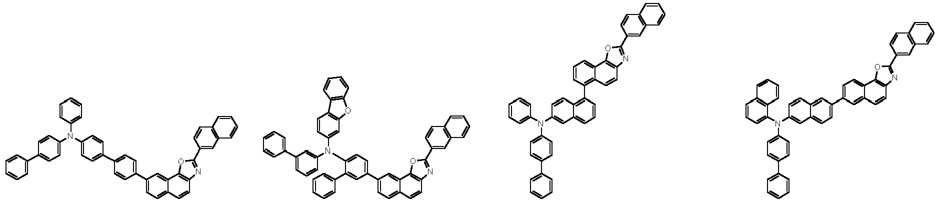

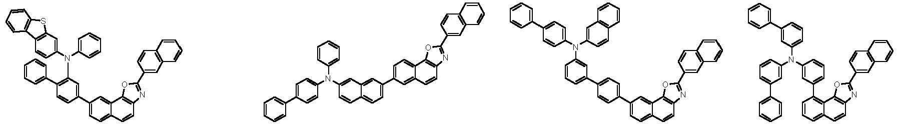

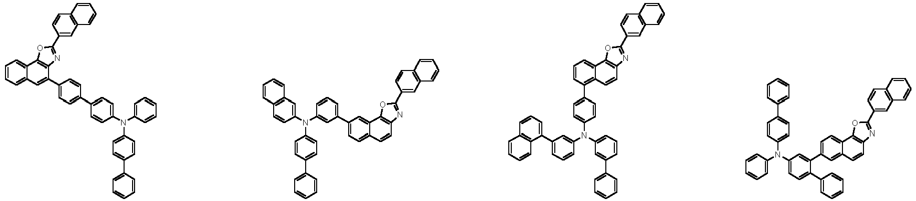

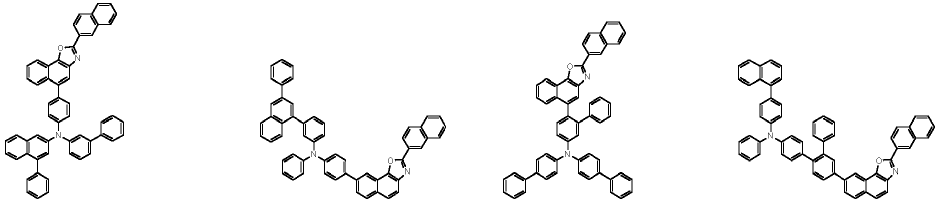

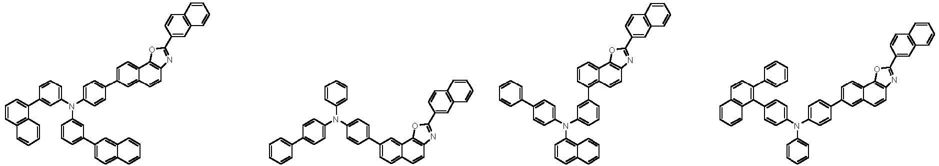

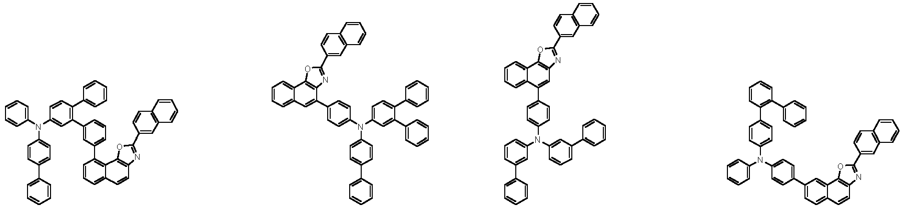

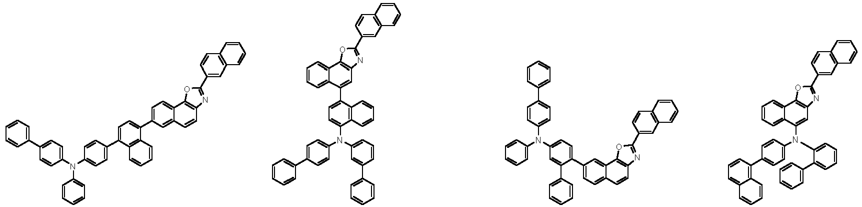

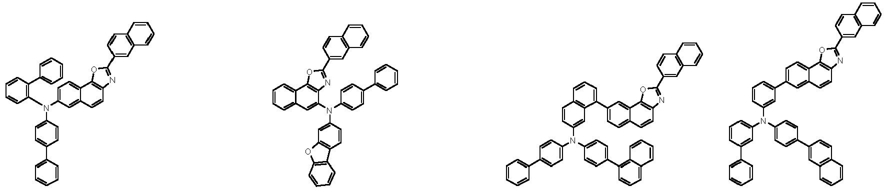

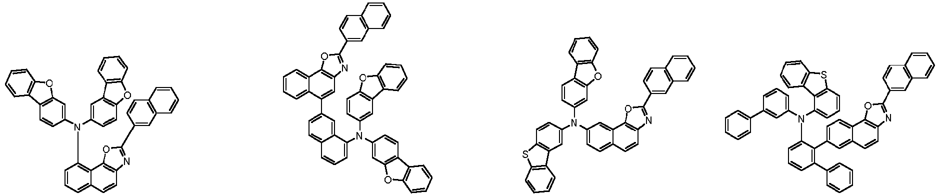

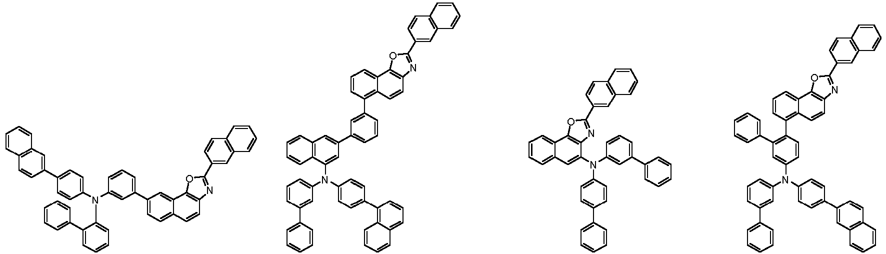

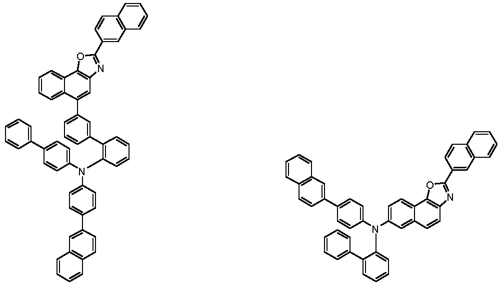

## Patentansprüche

1. Organische lichtemittierende Vorrichtung, umfassend:
eine Anode (2);
eine Kathode (4); und
eine lichtemittierende Schicht (3), die zwischen der Anode und der Kathode angeordnet ist,
wobei die lichtemittierende Schicht (i) eine Verbindung mit der folgenden chemischen Formel 1, und (ii) eine Verbindung mit der folgenden chemischen Formel 2 oder der folgenden chemischen Formel 3 umfasst: 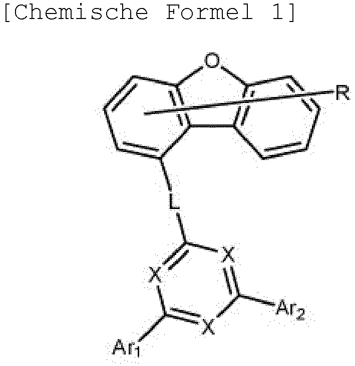
worin, in der chemischen Formel 1,
L eine Einfachbindung; oder ein substituiertes oder unsubstituiertes C₆₋₆₀-Arylen ist,
X ist N; oder CH, mit der Maßgabe, dass mindestens zwei oder mehr X N sind,
R ist Wasserstoff, Deuterium, ein substituiertes oder unsubstituiertes C₆₋₆₀-Aryl oder ein substituiertes oder unsubstituiertes C₂₋₆₀-Heteroaryl, das eines oder mehrere ausgewählt aus der Gruppe bestehend aus N, O und S enthält,
Ar₁ und Ar₂ sind jeweils unabhängig voneinander ein substituiertes oder unsubstituiertes C₆₋₆₀-Aryl; oder ein substituiertes oder unsubstituiertes C₂₋₆₀-Heteroaryl, das eines oder mehrere ausgewählt aus der Gruppe bestehend aus N, O und S enthält, 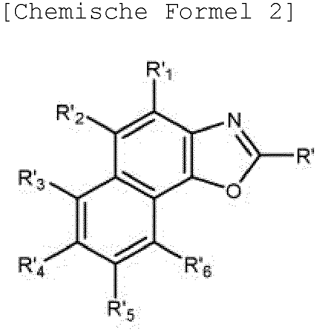 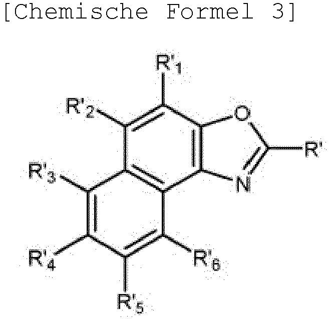
worin, in den chemischen Formeln 2 und 3,
R' ein Substituent mit der folgenden chemischen Formel 4, oder ein substituiertes oder unsubstituiertes C₆₋₆₀-Aryl ist,
wenn R' ein Substituent mit der folgenden chemischen Formel 4 ist, sind R'₁ bis R'₆ jeweils unabhängig voneinander Wasserstoff oder Deuterium,
wenn R' kein Substituent mit der folgenden chemischen Formel 4 ist, ist einer der Reste R'₁ bis R'₆ ein Substituent mit der folgenden chemischen Formel 4, und die übrigen Reste sind jeweils unabhängig voneinander Wasserstoff oder Deuterium; 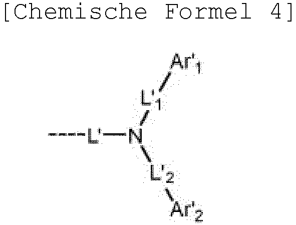
worin, in der chemischen Formel 4,
L' eine Einfachbindung, ein substituiertes oder unsubstituiertes C₆₋₆₀-Arylen oder ein substituiertes oder unsubstituiertes C₂₋₆₀-Heteroarylen, das eines oder mehrere ausgewählt aus der Gruppe bestehend aus N, O und S enthält, ist,
L'₁ und L'₂ sind jeweils unabhängig voneinander eine Einfachbindung, ein substituiertes oder unsubstituiertes C₆₋₆₀-Arylen oder ein substituiertes oder unsubstituiertes C₂₋₆₀-Heteroarylen, das eines oder mehrere ausgewählt aus der Gruppe bestehend aus N, O und S enthält, und
Ar'₁ und Ar'₂ sind jeweils unabhängig voneinander ein substituiertes oder unsubstituiertes C₆₋₆₀-Aryl oder ein substituiertes oder unsubstituiertes C₂₋₆₀-Heteroaryl, das eines oder mehrere ausgewählt aus der Gruppe bestehend aus N, O und S enthält.

2. Organische lichtemittierende Vorrichtung nach Anspruch 1, wobei:
L eine Einfachbindung; Phenylen; Biphenyldiyl; oder Naphthylen ist.

3. Organische lichtemittierende Vorrichtung nach Anspruch 1, wobei:
alle X N sind.

4. Organische lichtemittierende Vorrichtung nach Anspruch 1, wobei:
R Wasserstoff, Deuterium, Phenyl, Biphenylyl, Terphenylyl, Naphthyl, Phenylnaphthyl, Naphthylphenyl, Phenanthrenyl, Triphenylenyl, Fluoranthenyl, Dibenzofuranyl, Benzonaphthofuranyl, Dibenzothiophenyl, oder Benzonaphthothiophenyl ist.

5. Organische lichtemittierende Vorrichtung nach Anspruch 1, wobei:
Ar₁ und Ar₂ jeweils unabhängig voneinander Phenyl, Biphenylyl, Terphenylyl, Naphthyl, Naphthylphenyl, Phenylnaphthyl, Phenanthrenyl, Dibenzofuranyl oder Dibenzothiophenyl sind.

6. Organische lichtemittierende Vorrichtung nach Anspruch 1, wobei:
die Verbindung mit der chemischen Formel 1 eine beliebige Verbindung ist, ausgewählt aus der Gruppe bestehend aus:

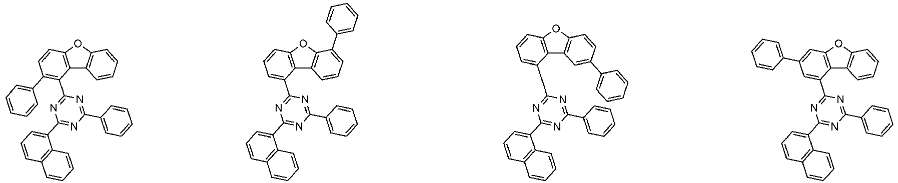

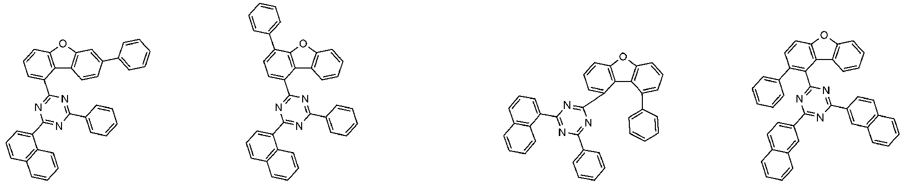

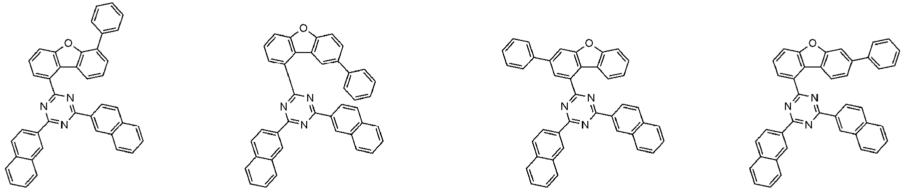

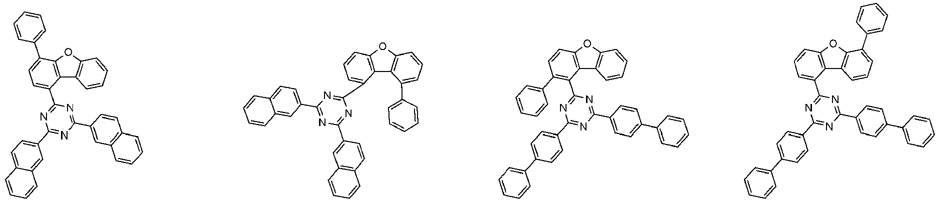

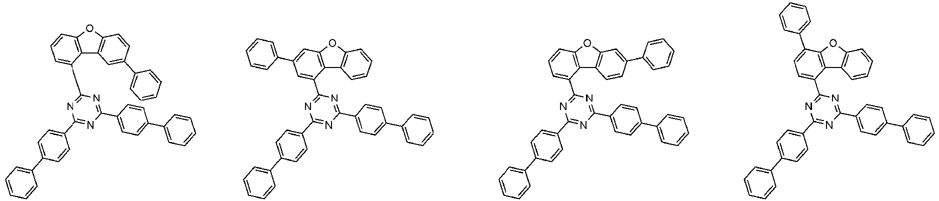

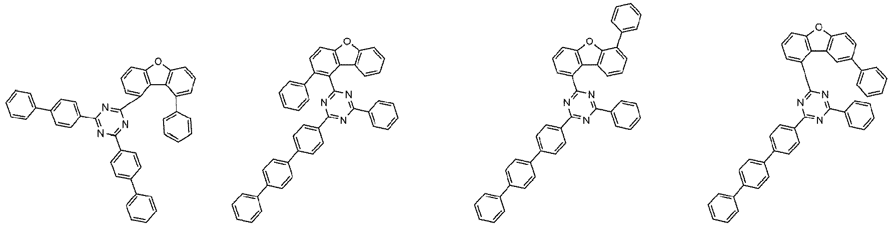

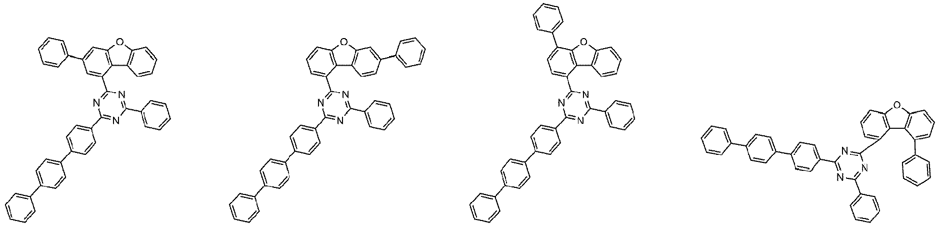

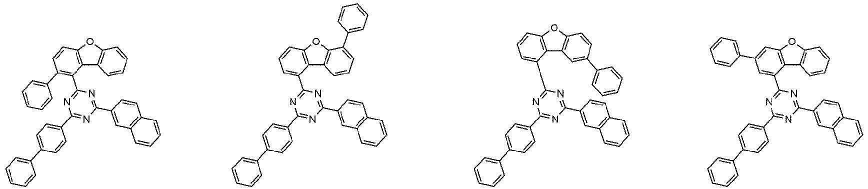

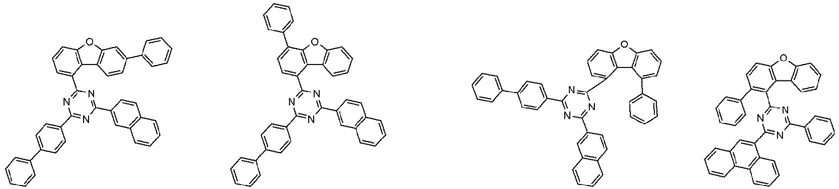

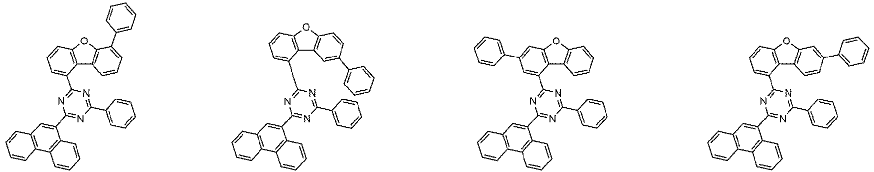

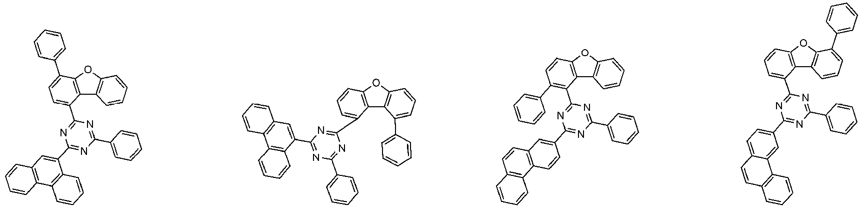

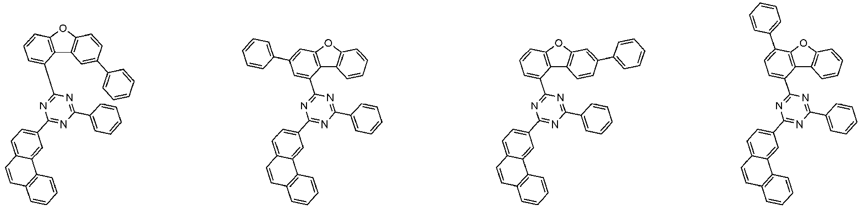

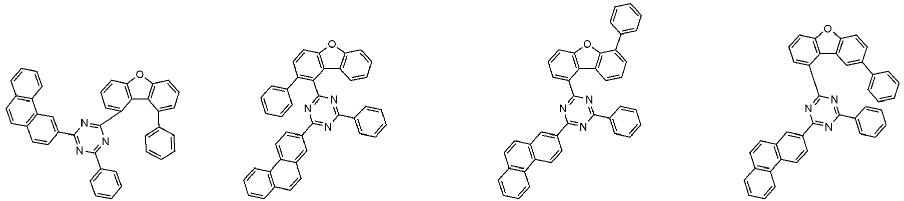

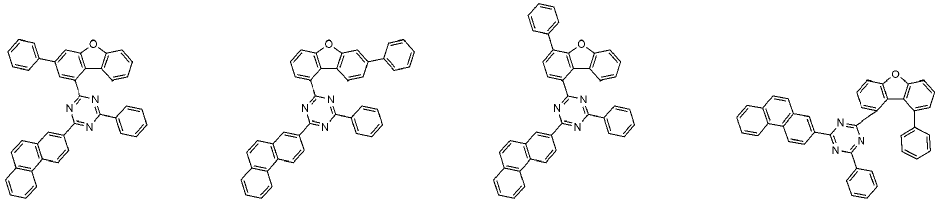

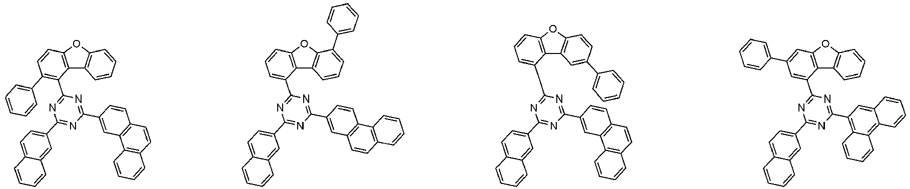

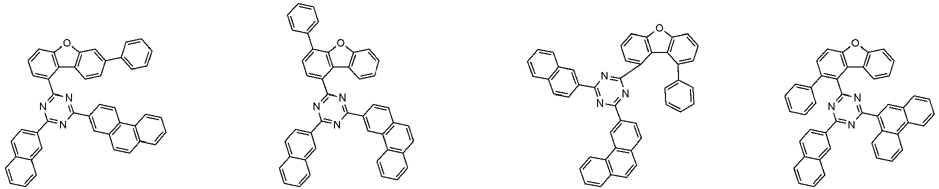

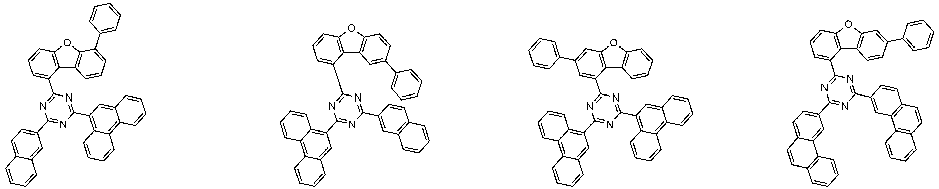

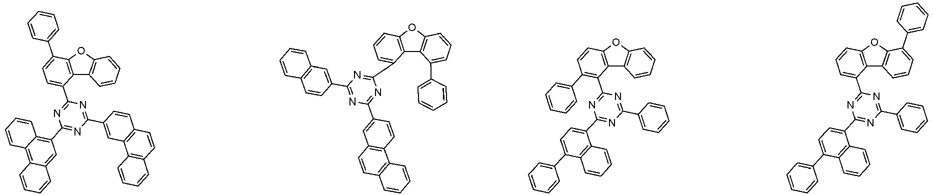

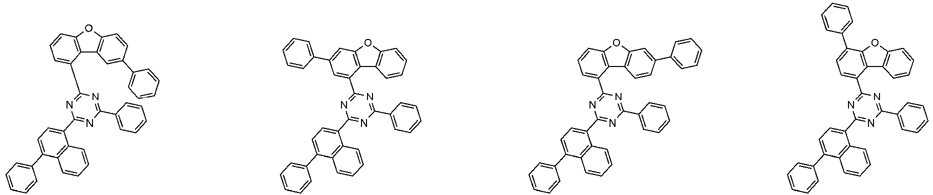

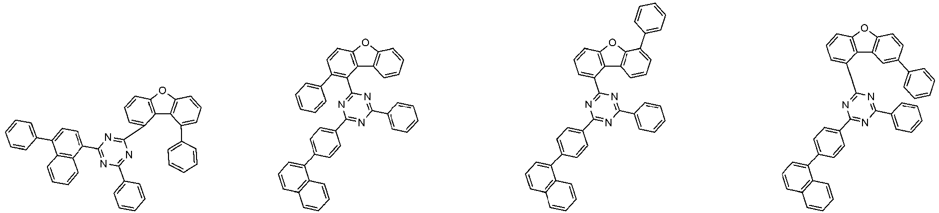

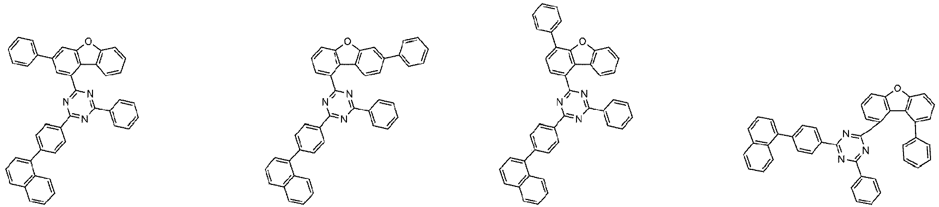

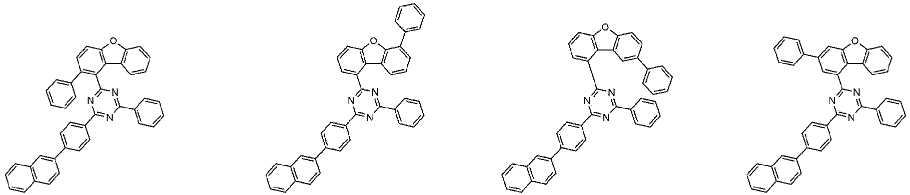

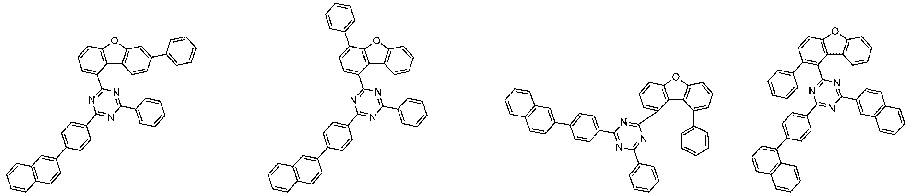

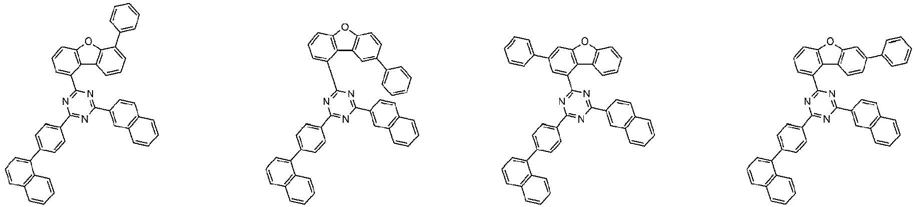

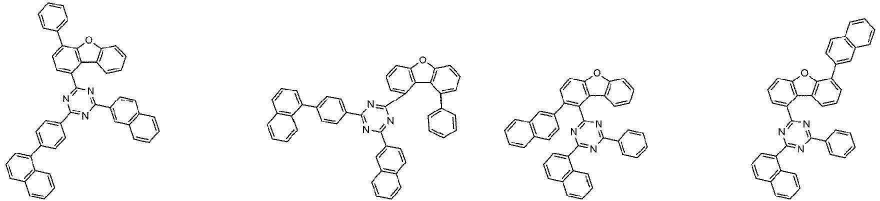

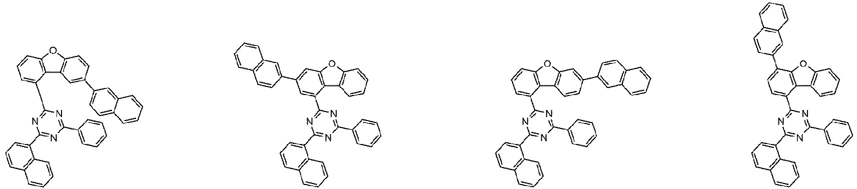

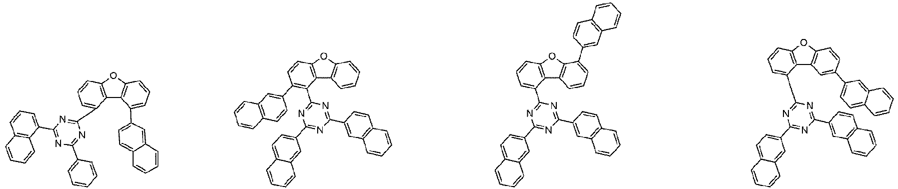

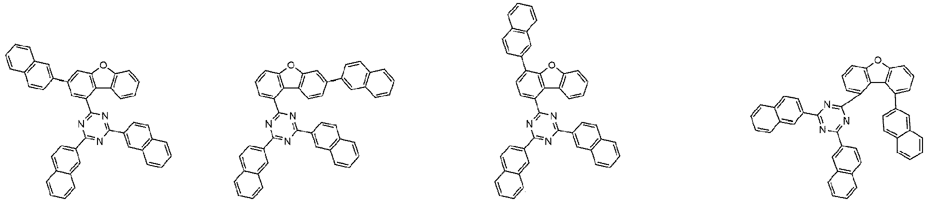

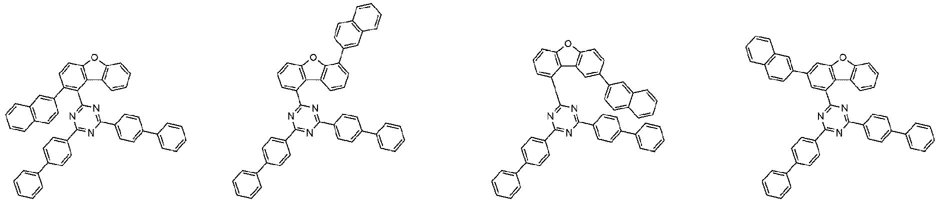

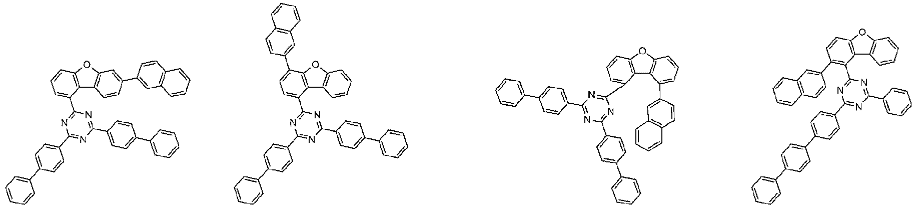

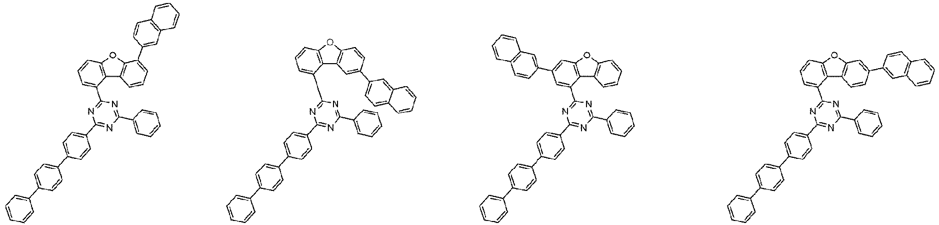

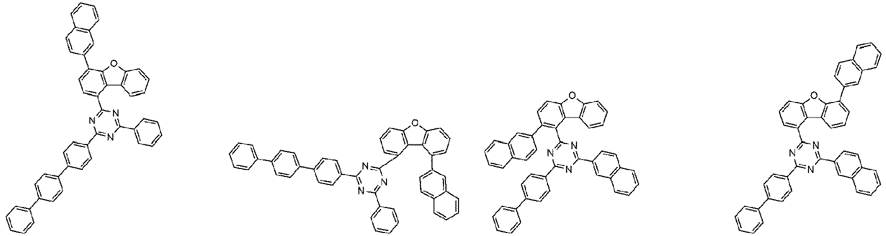

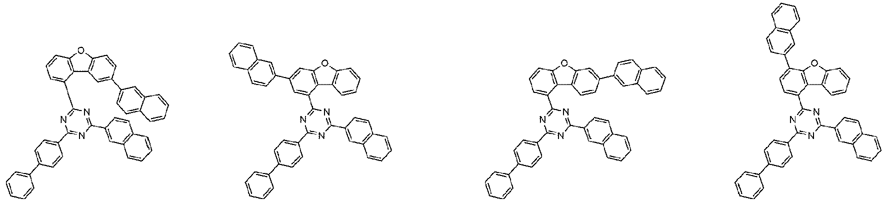

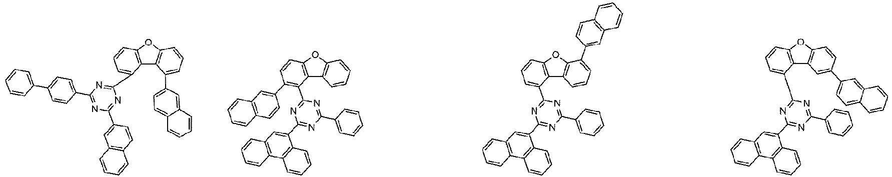

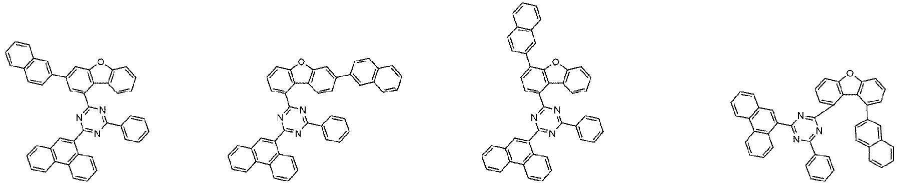

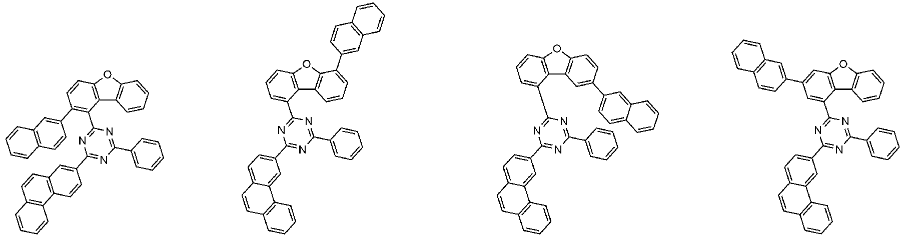

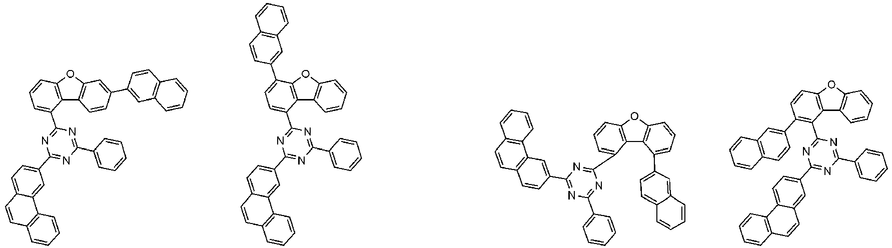

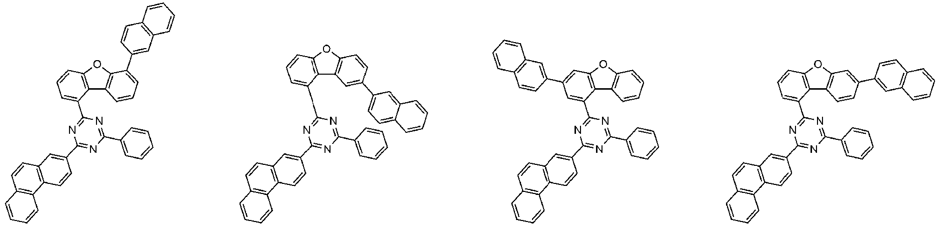

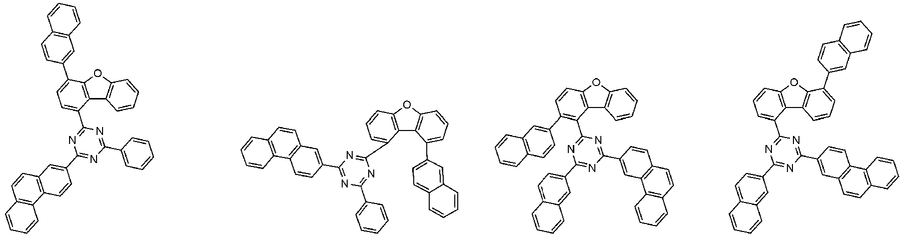

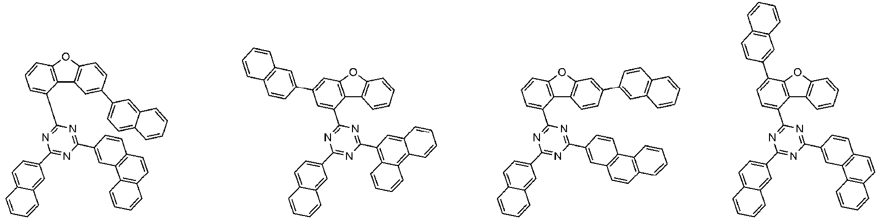

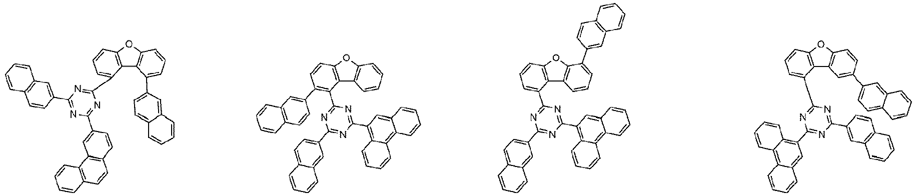

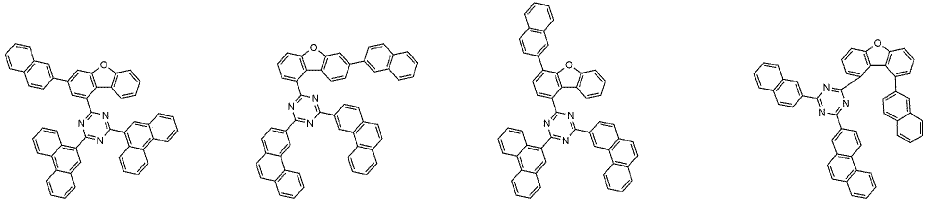

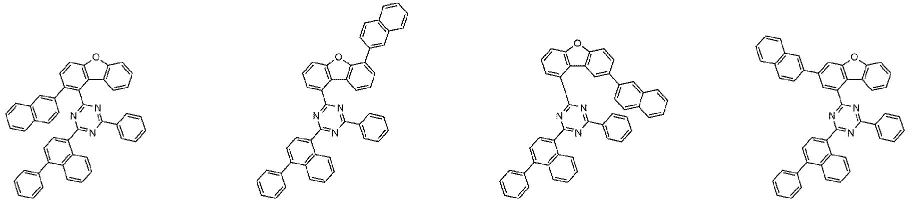

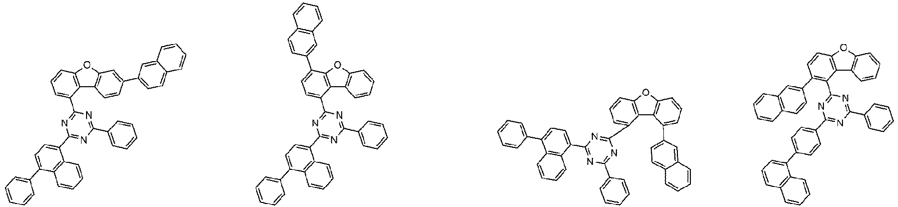

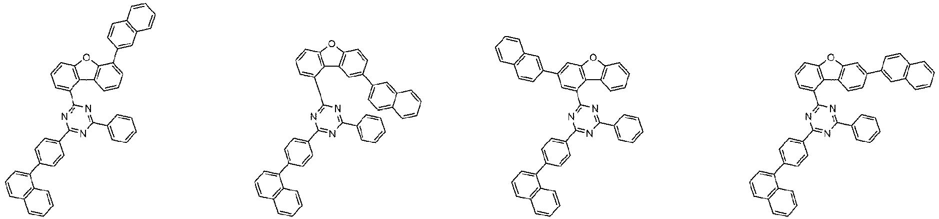

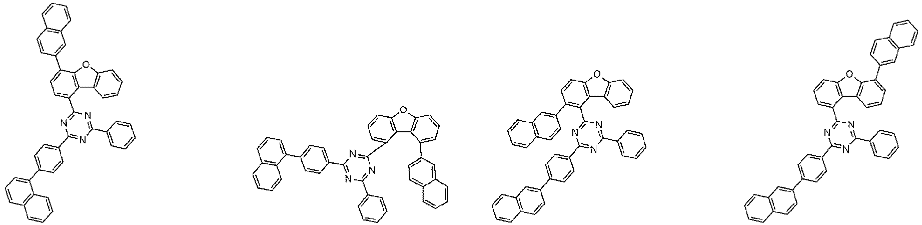

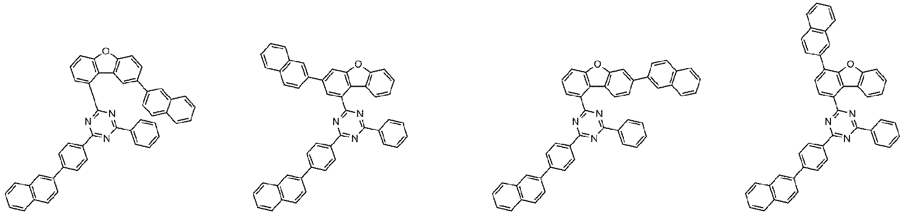

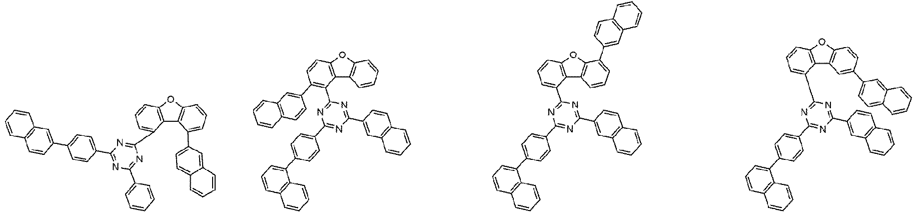

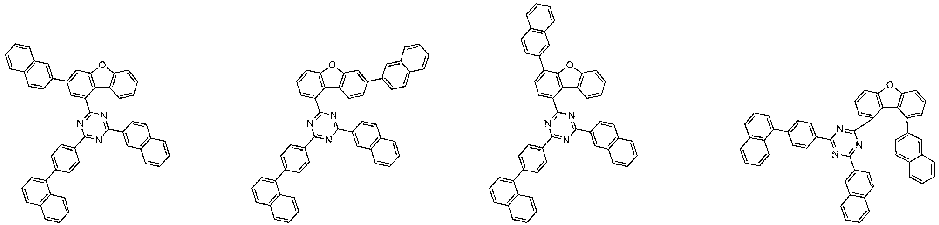

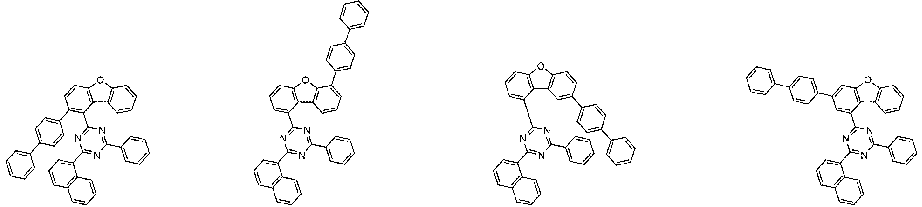

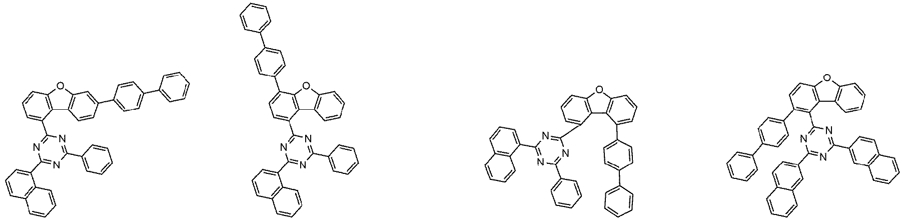

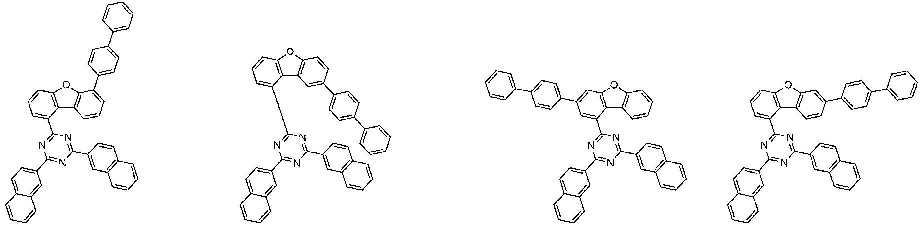

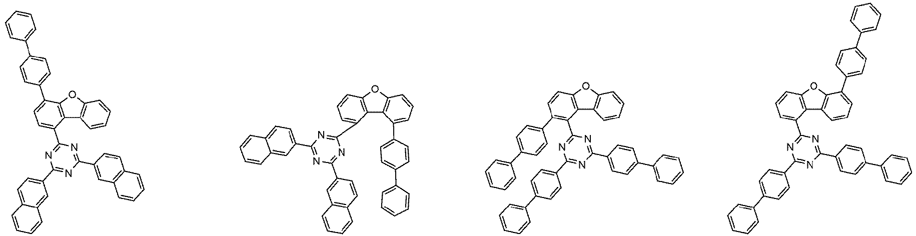

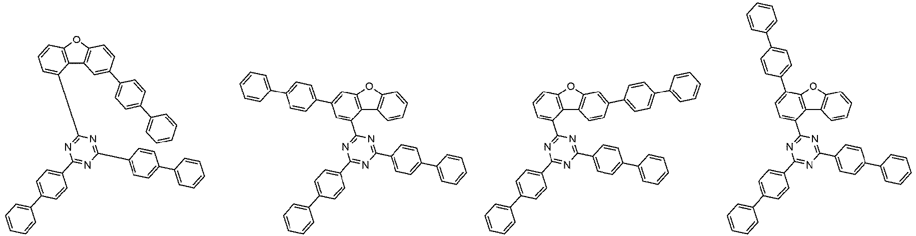

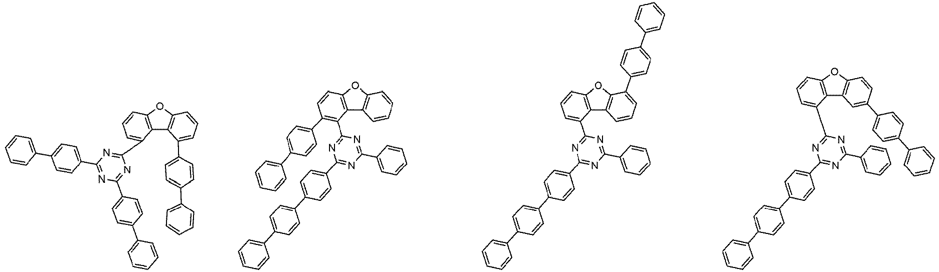

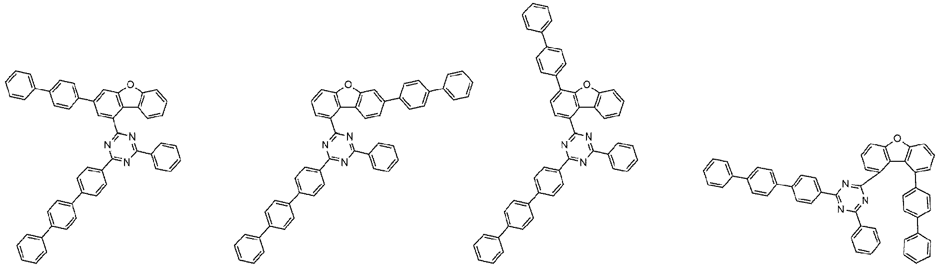

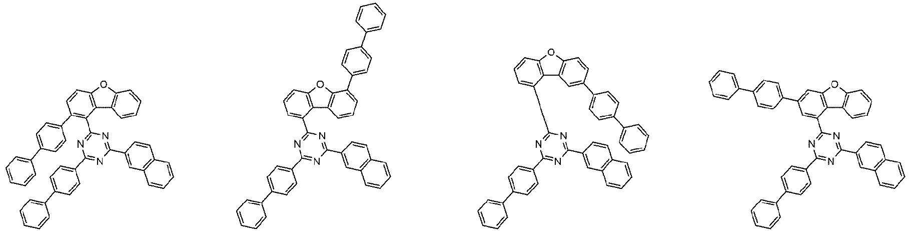

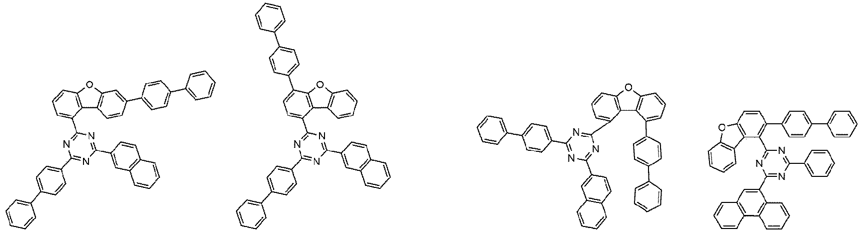

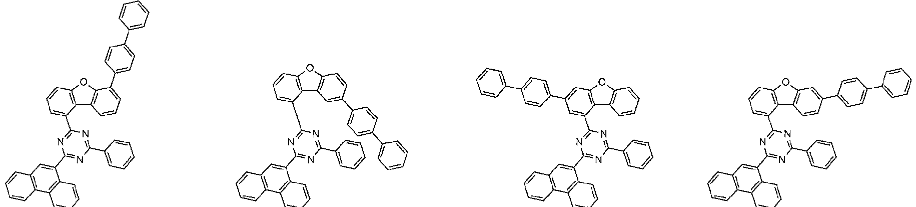

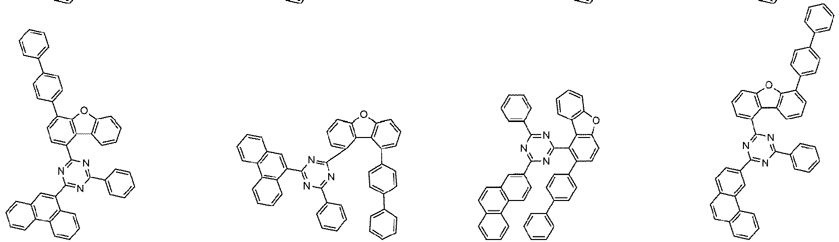

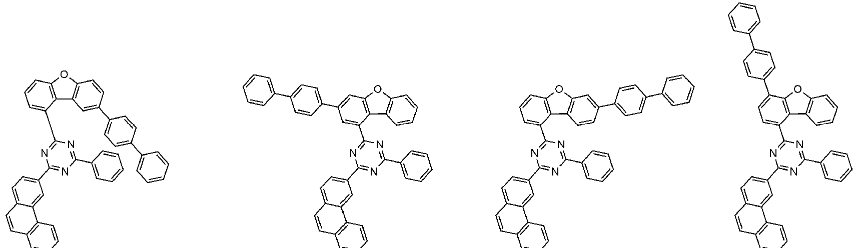

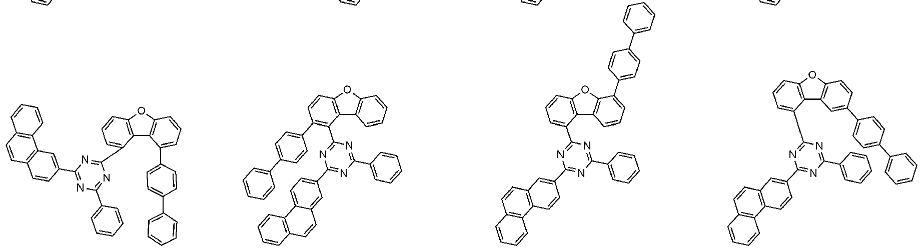

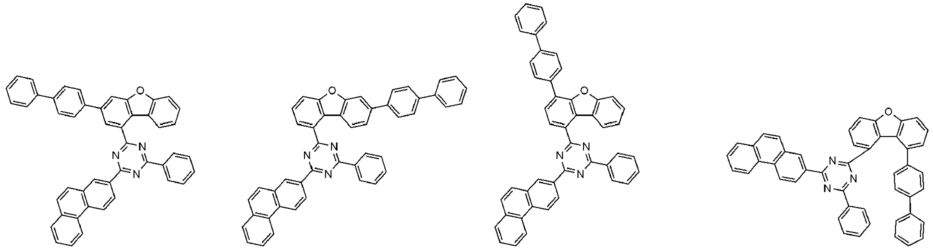

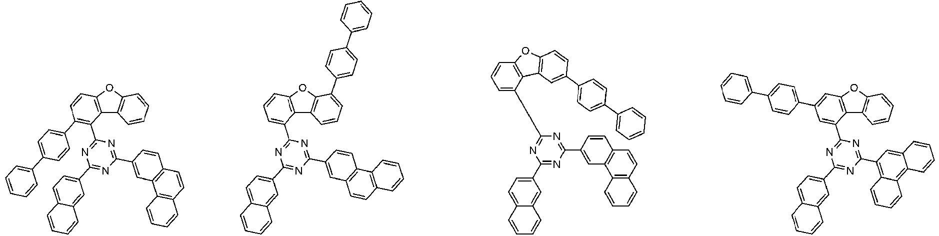

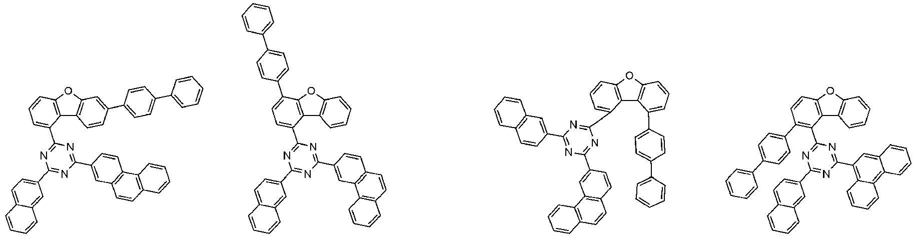

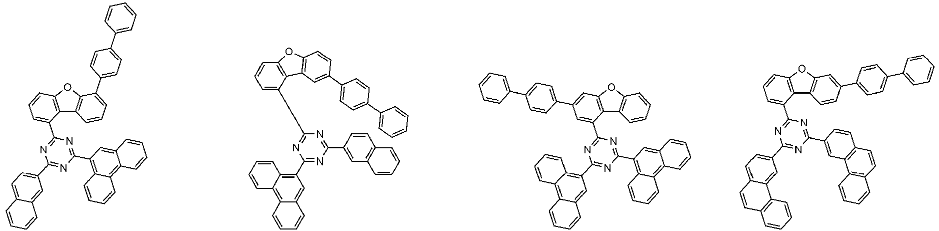

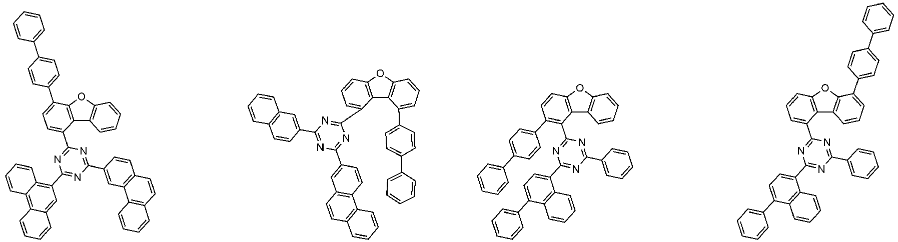

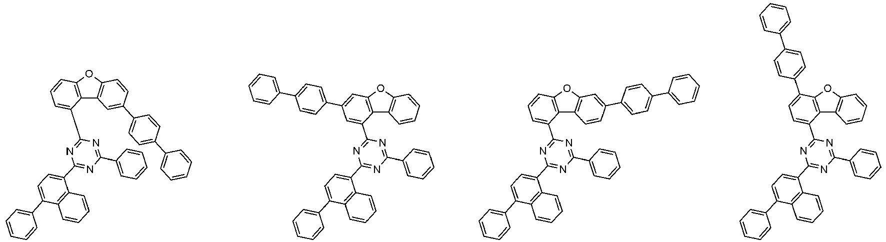

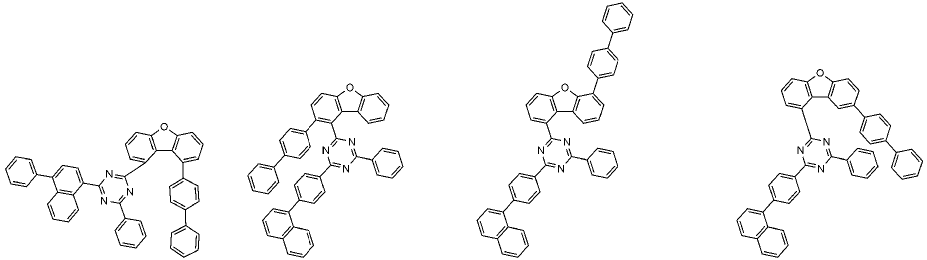

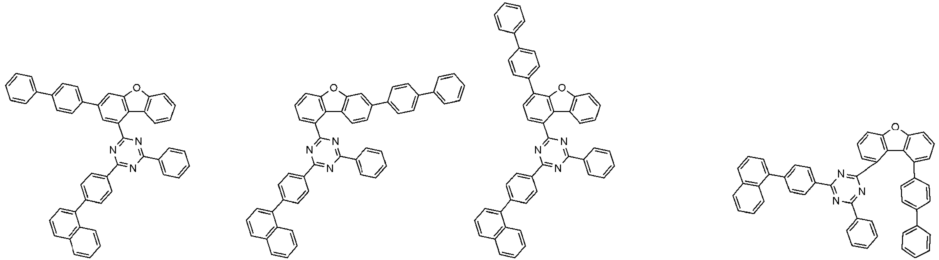

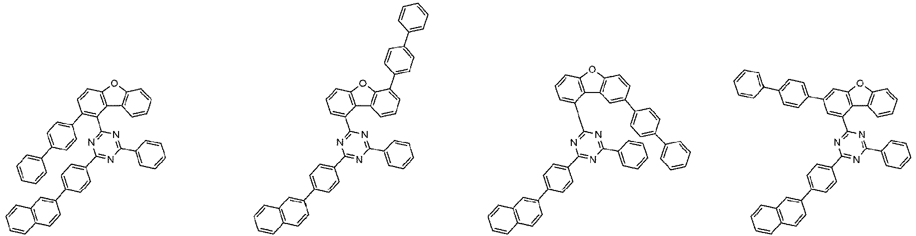

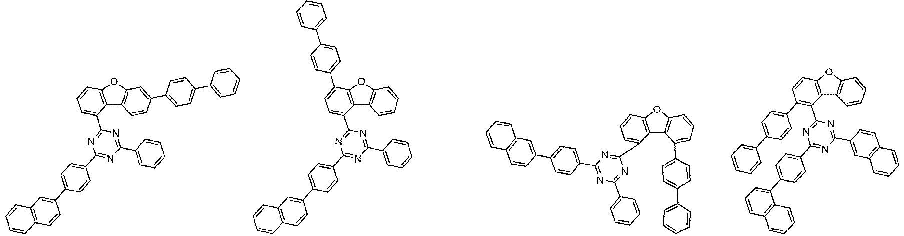

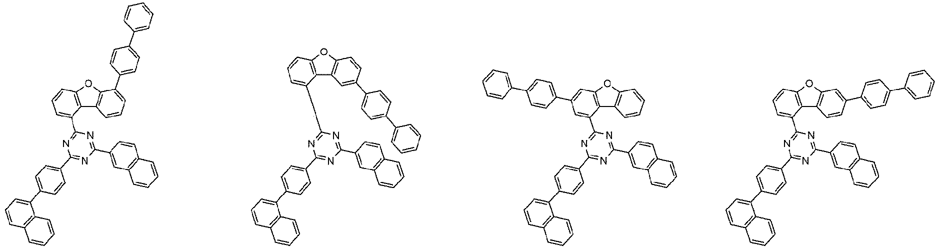

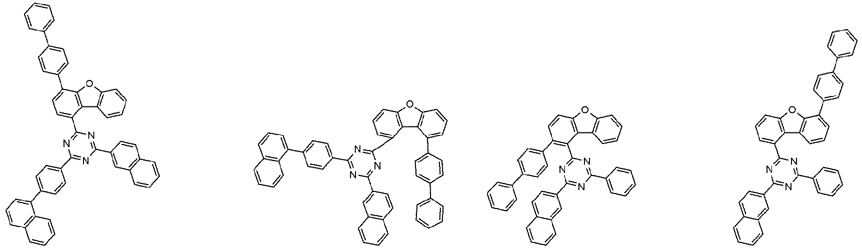

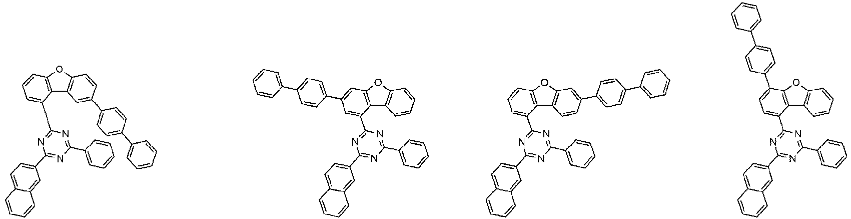

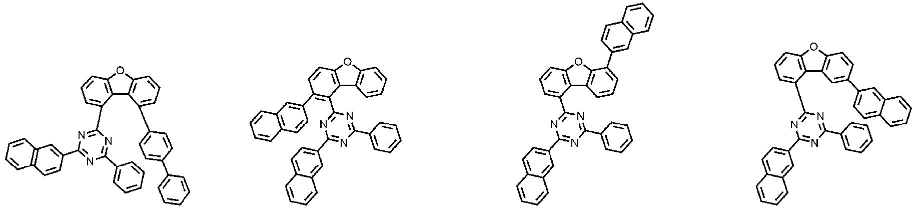

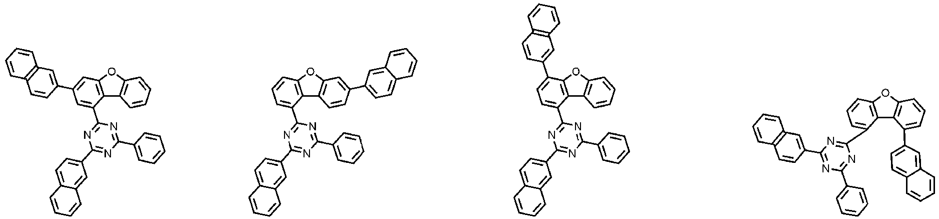

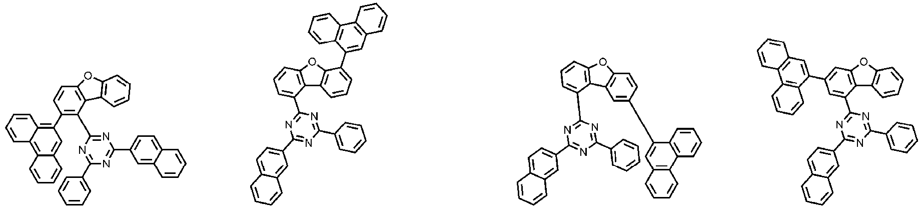

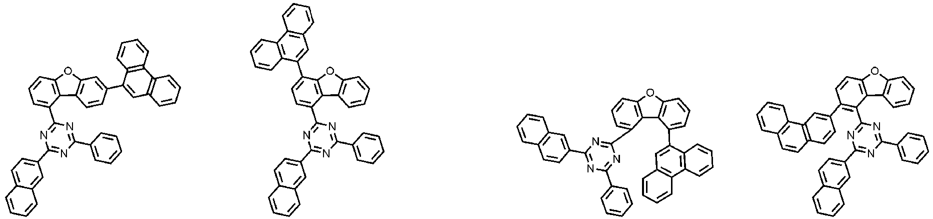

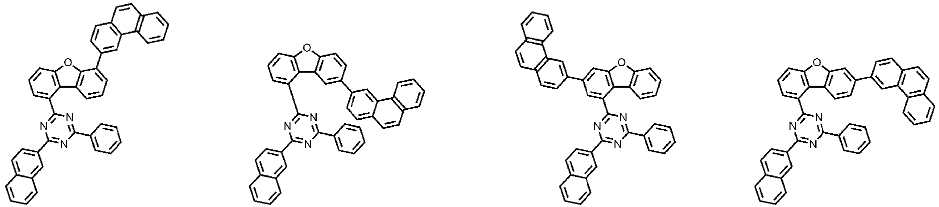

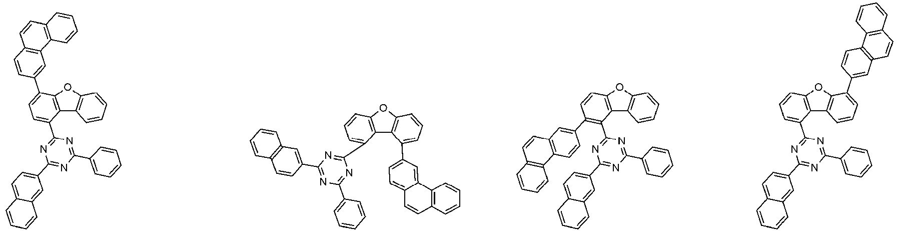

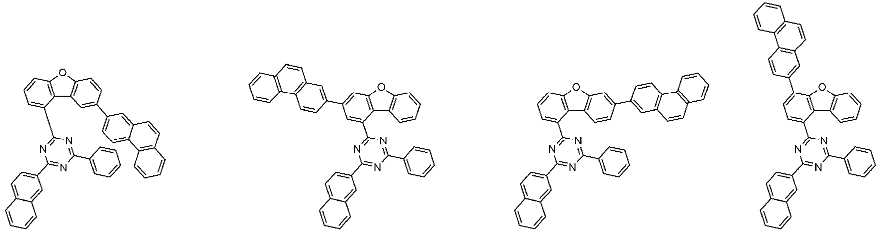

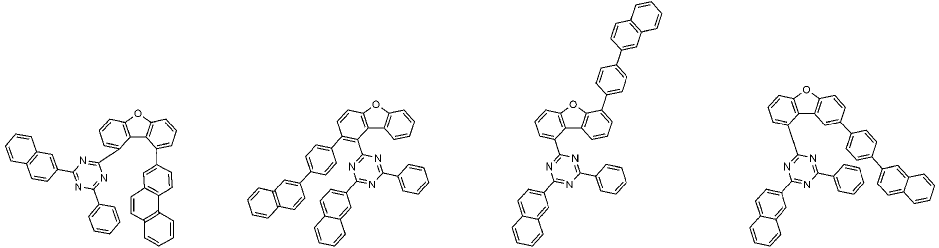

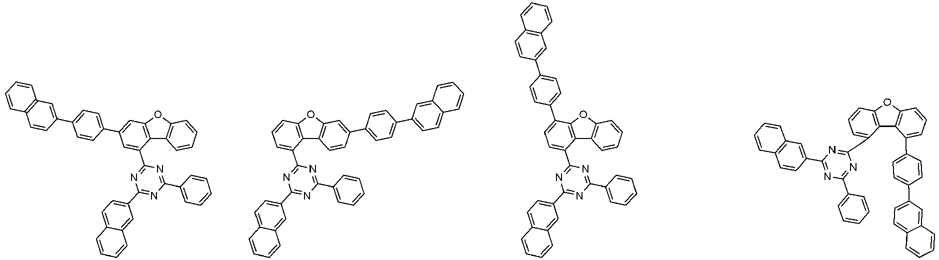

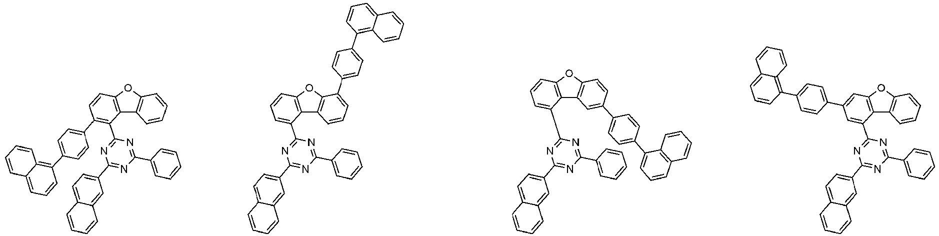

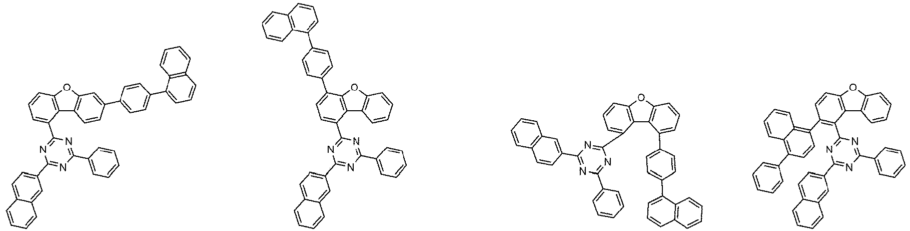

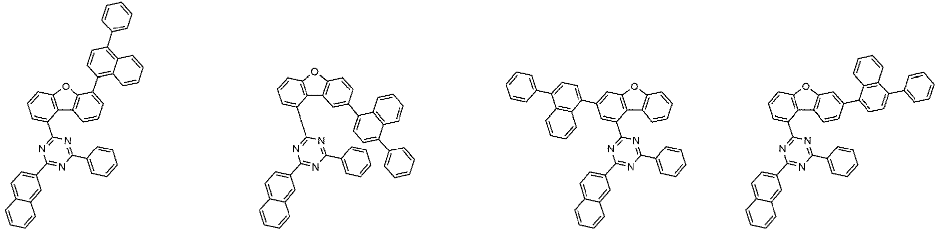

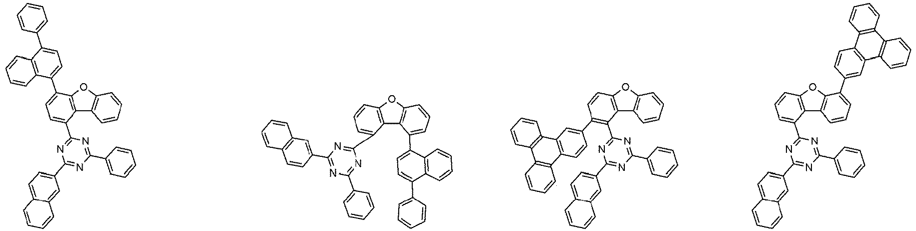

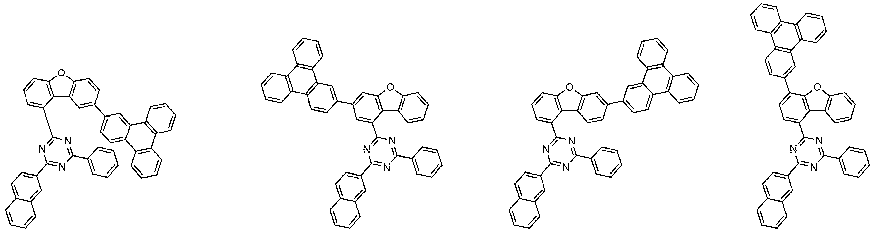

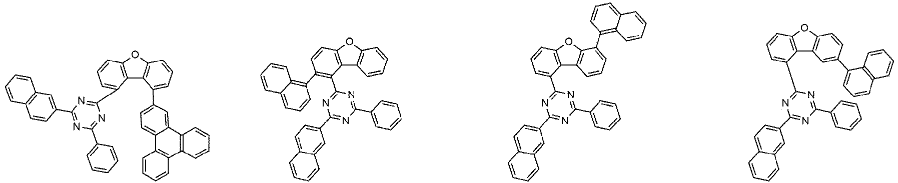

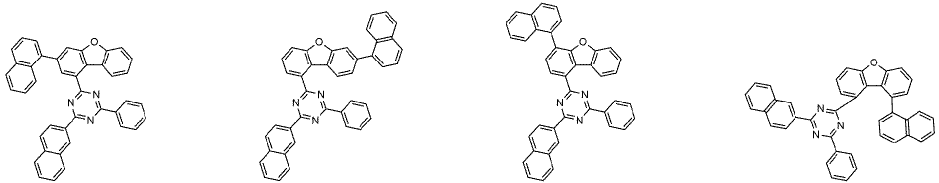

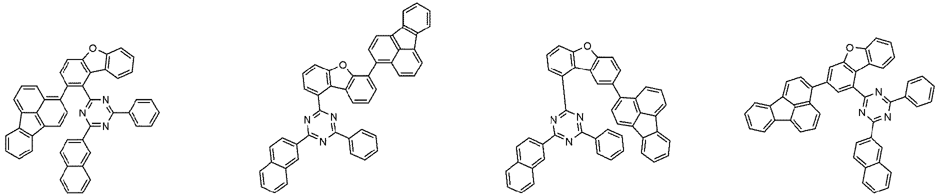

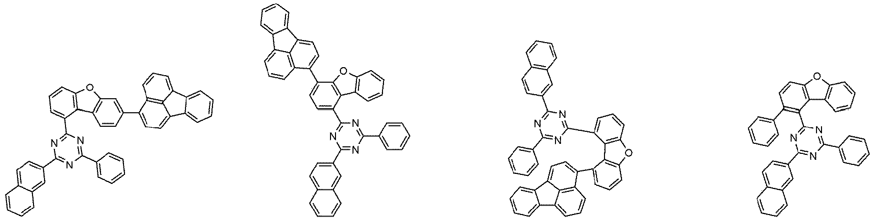

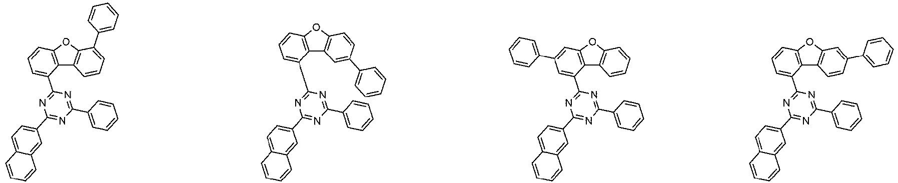

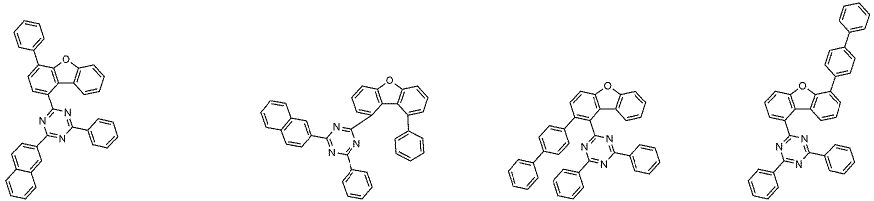

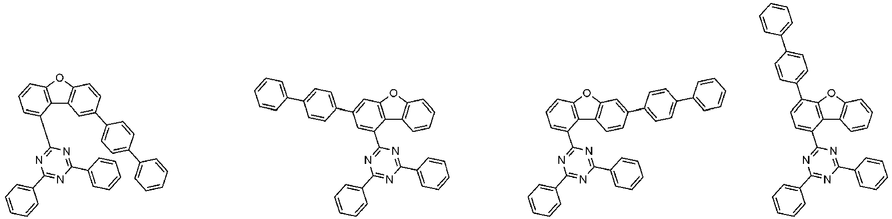

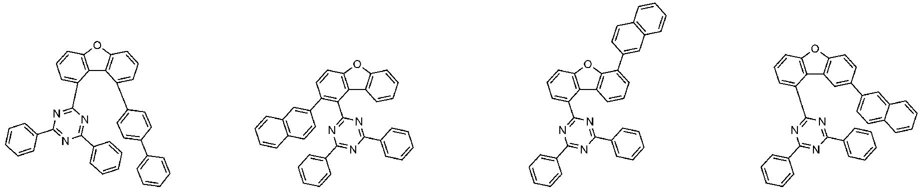

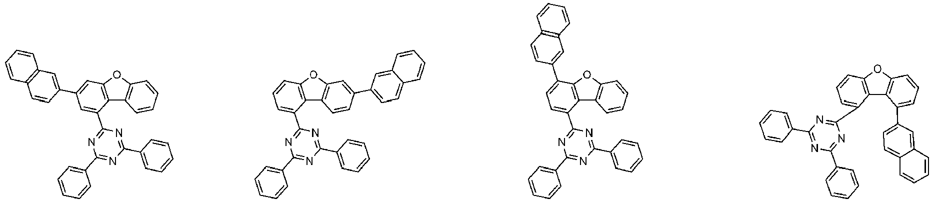

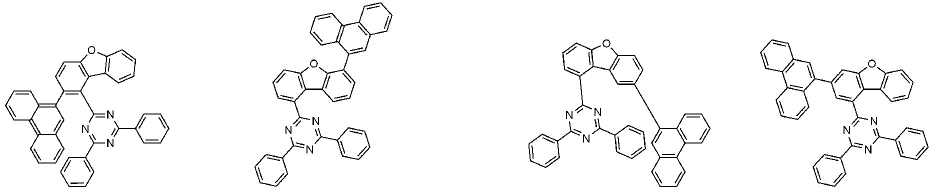

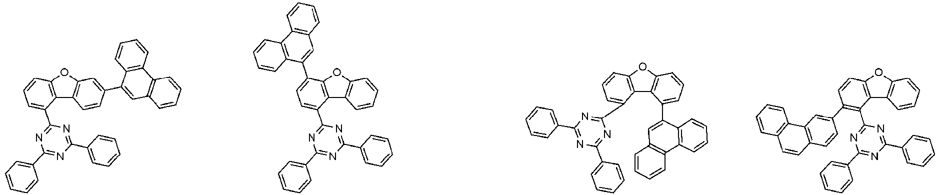

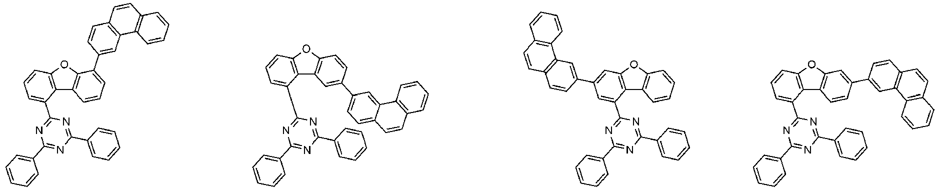

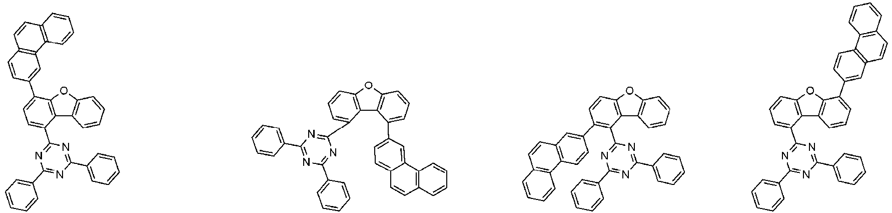

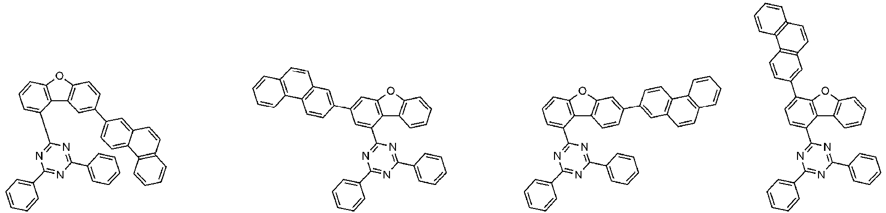

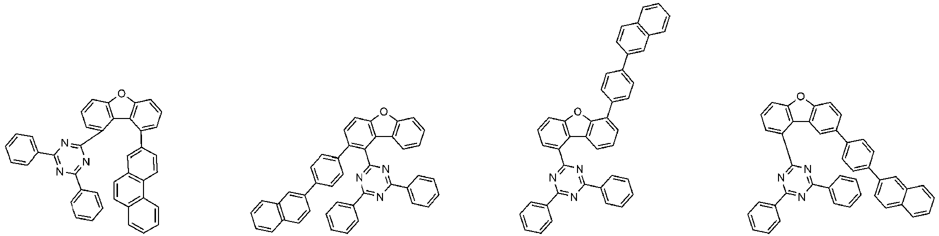

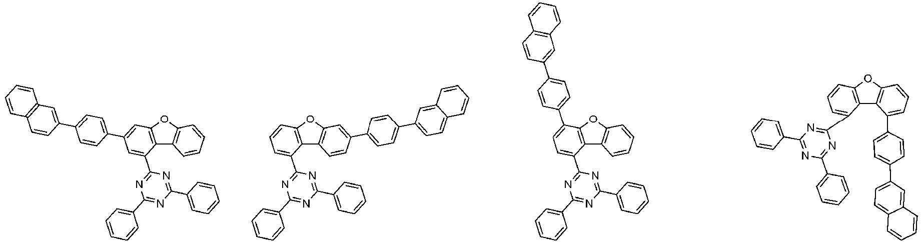

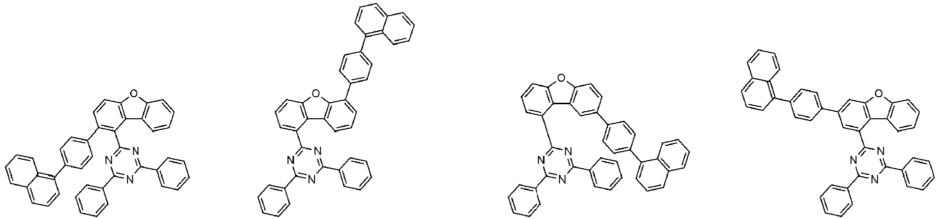

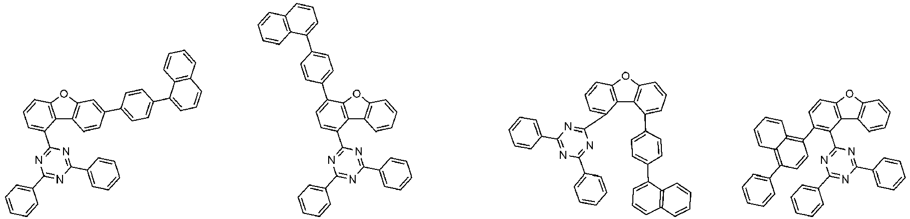

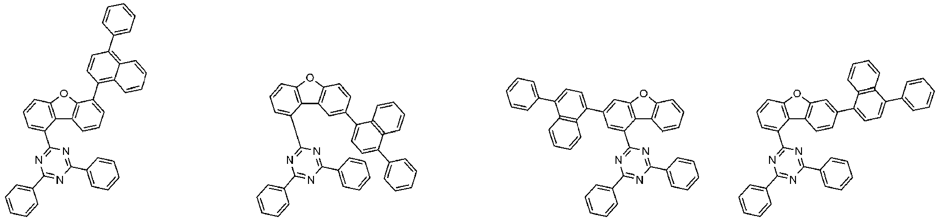

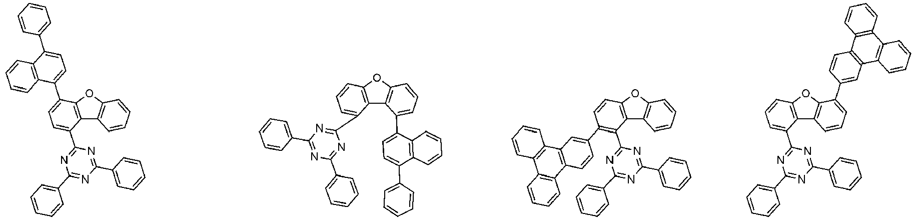

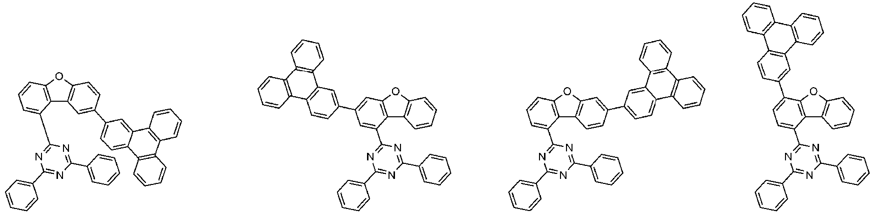

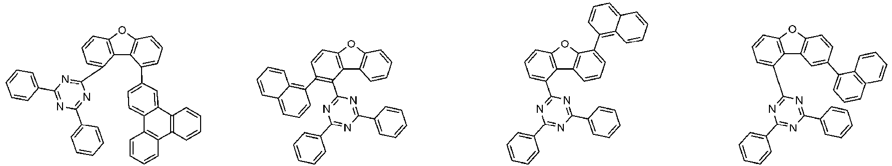

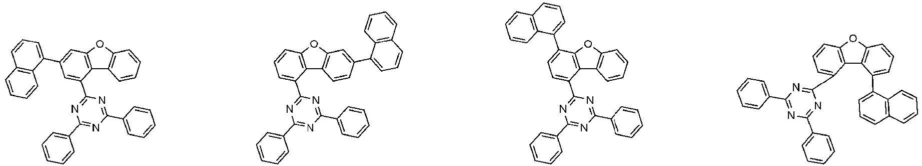

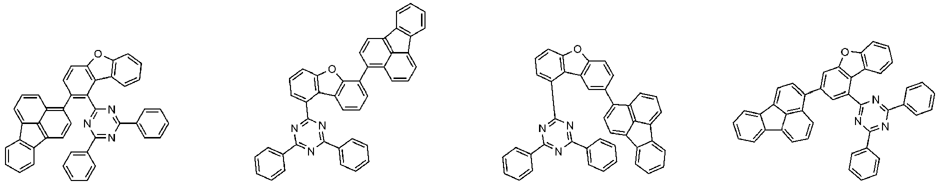

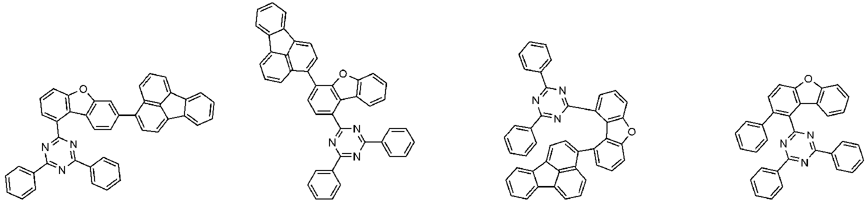

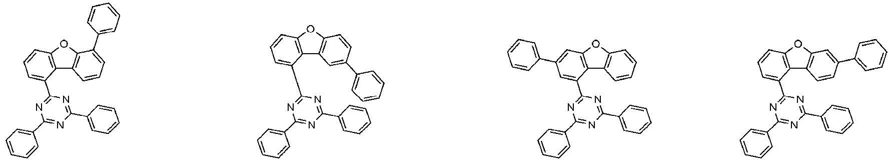

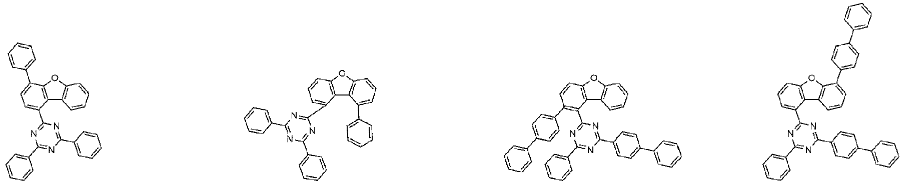

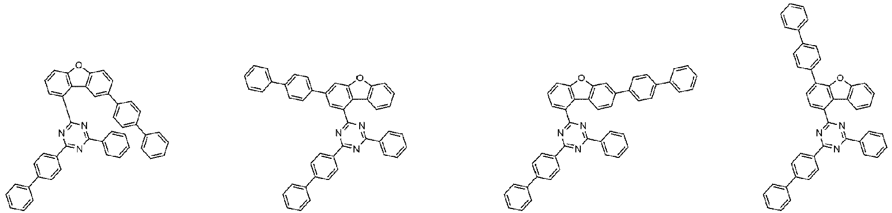

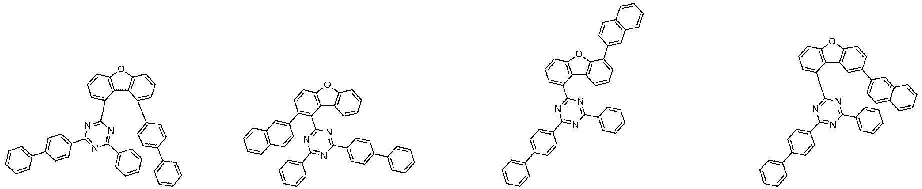

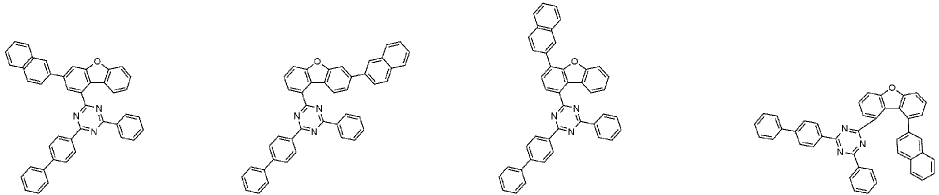

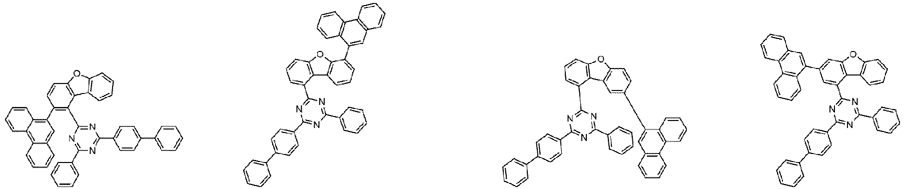

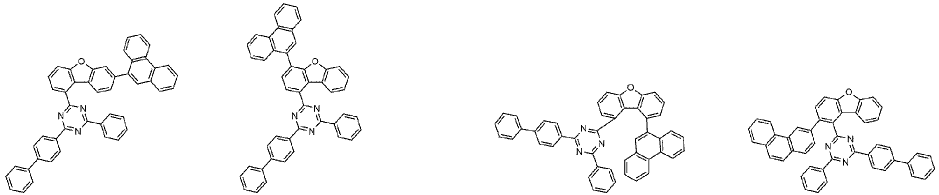

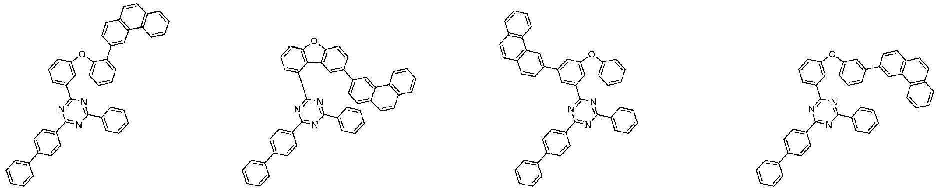

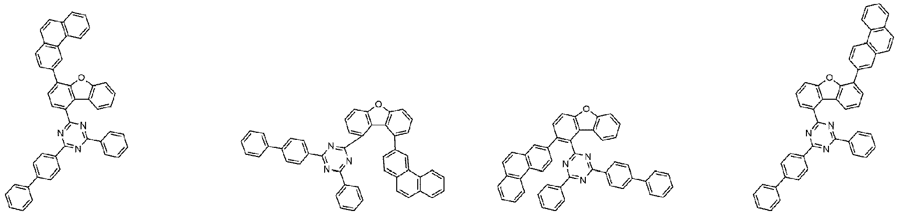

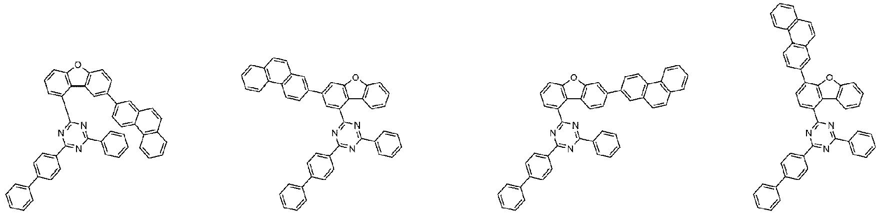

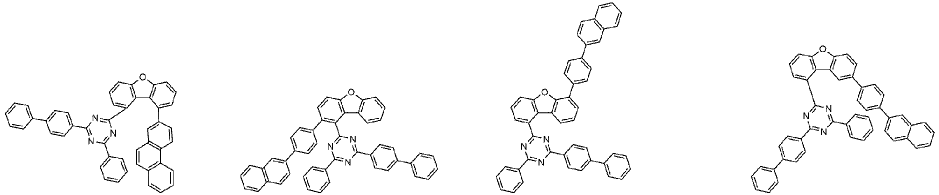

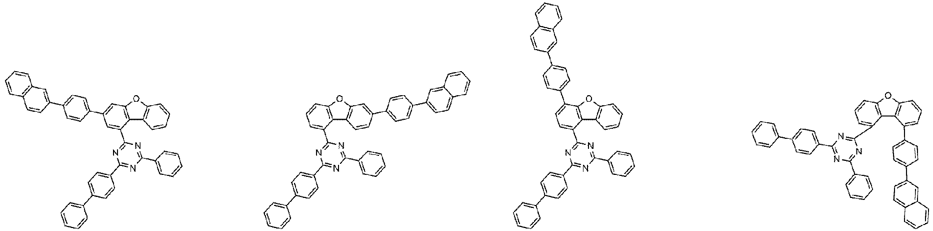

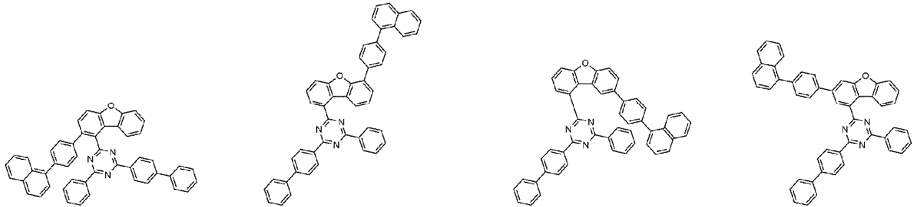

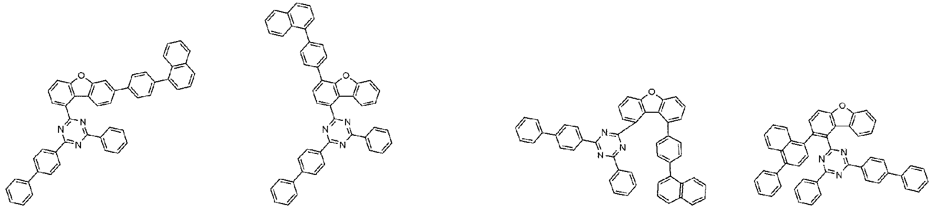

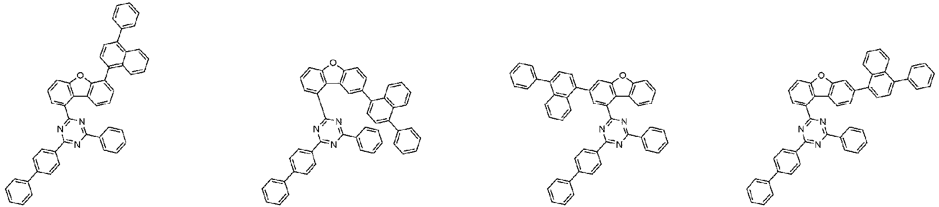

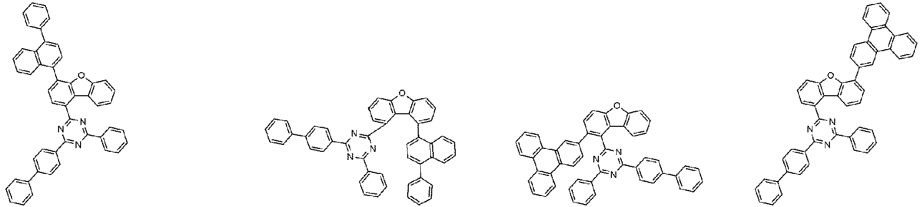

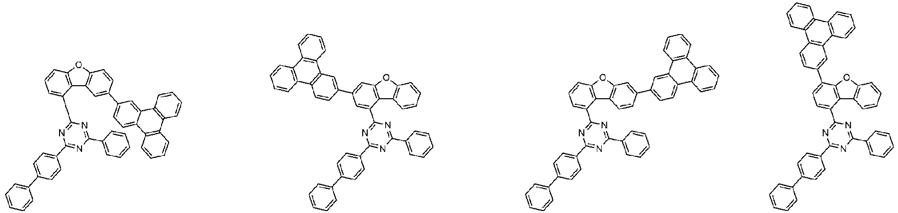

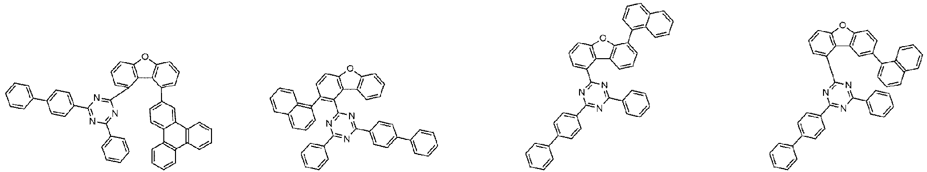

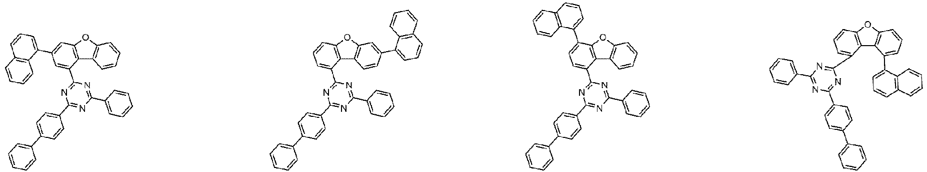

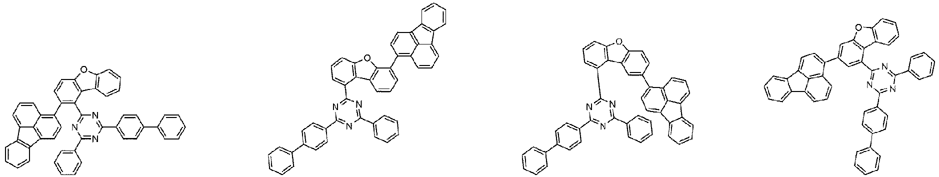

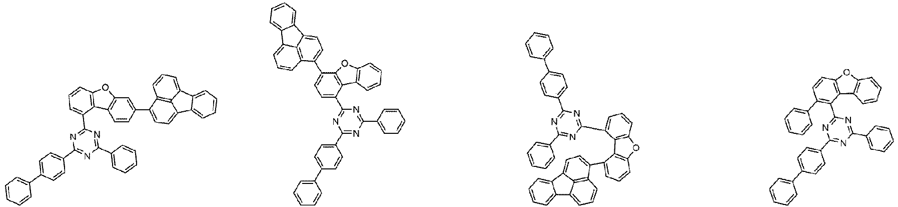

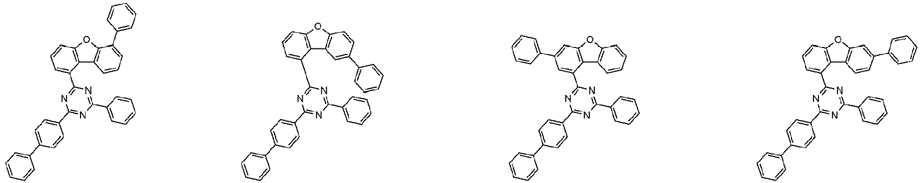

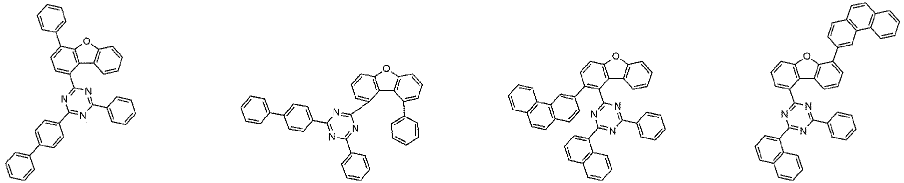

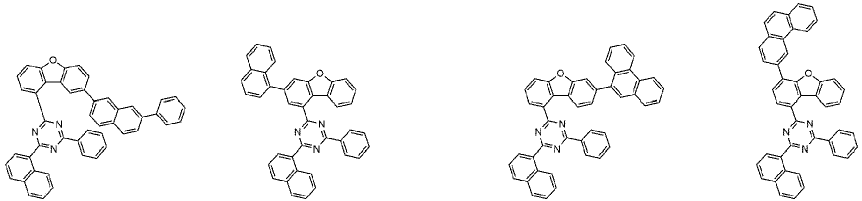

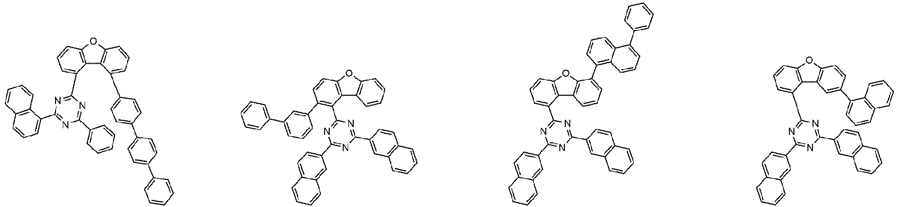

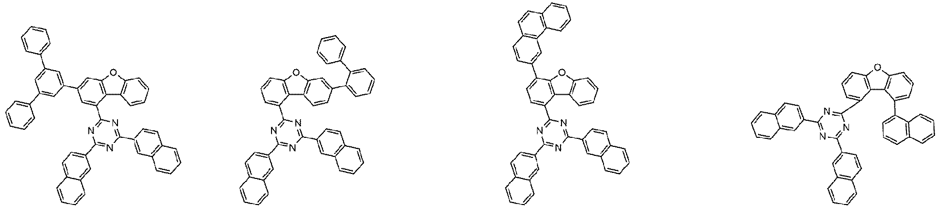

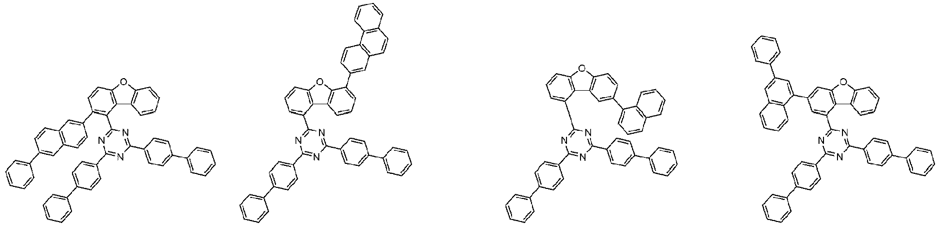

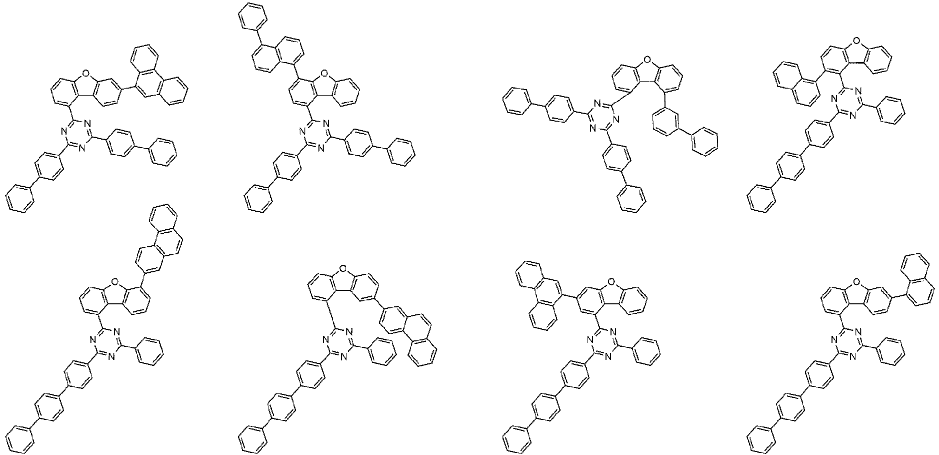

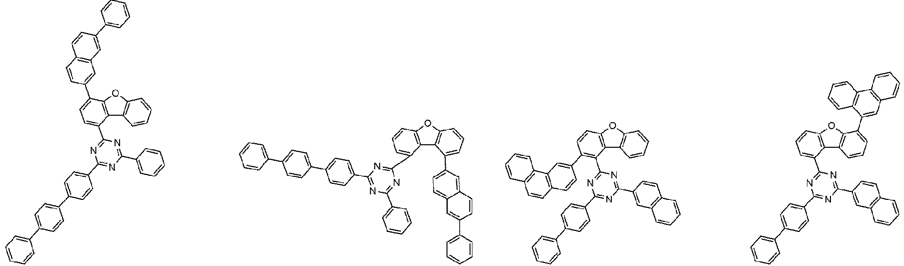

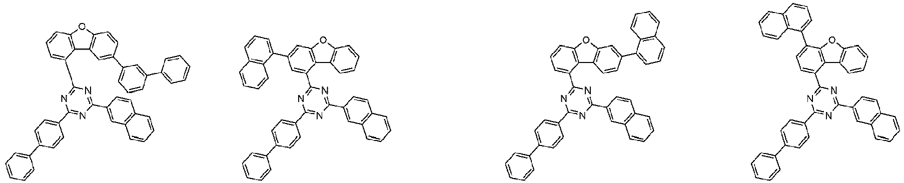

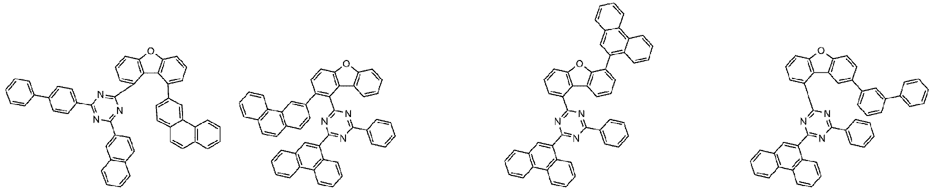

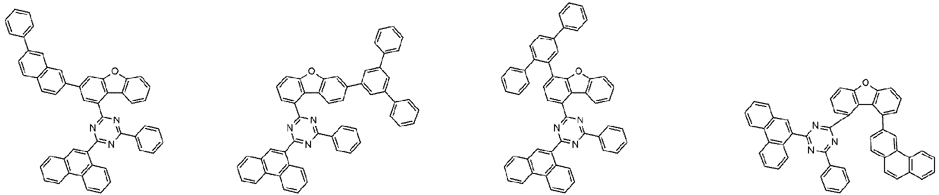

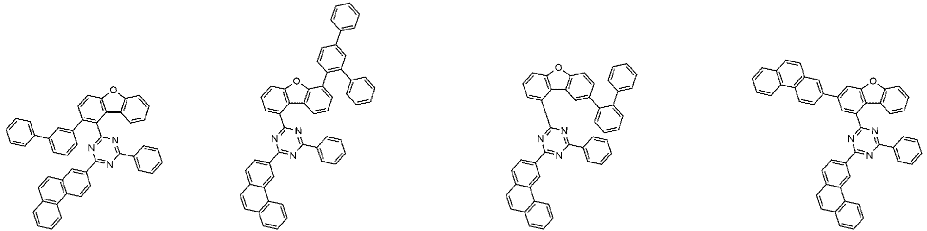

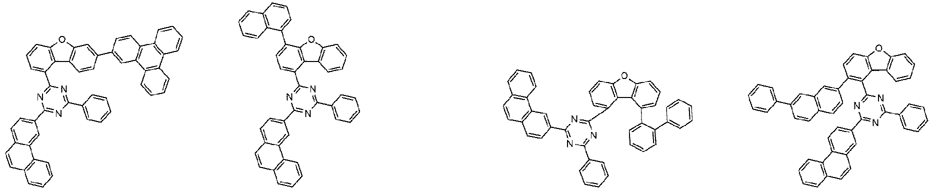

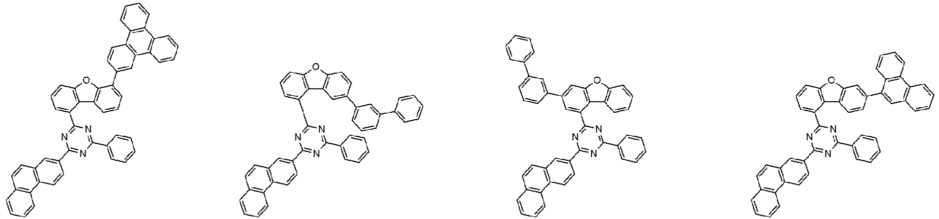

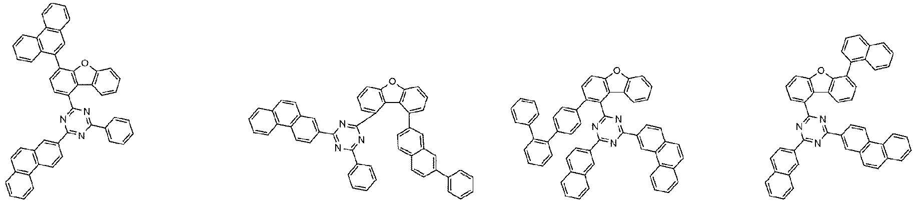

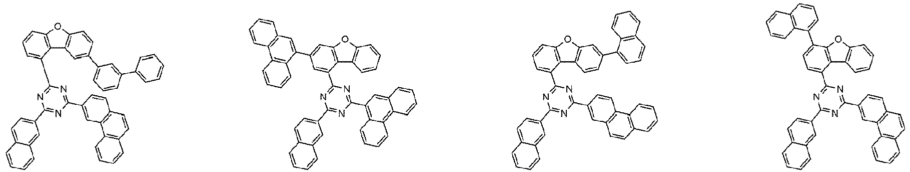

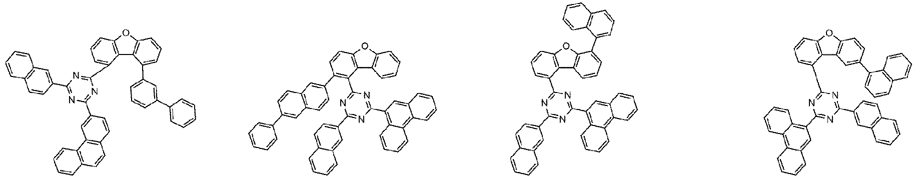

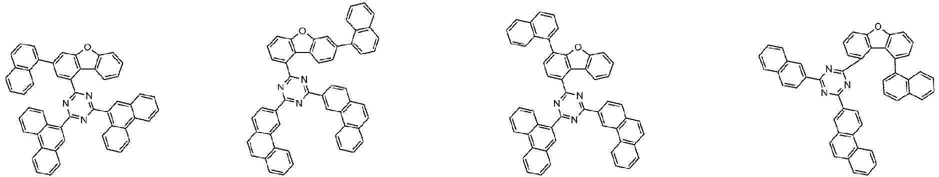

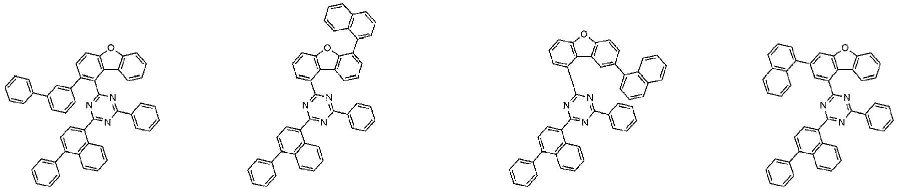

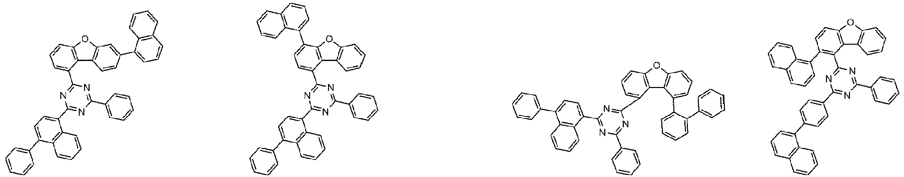

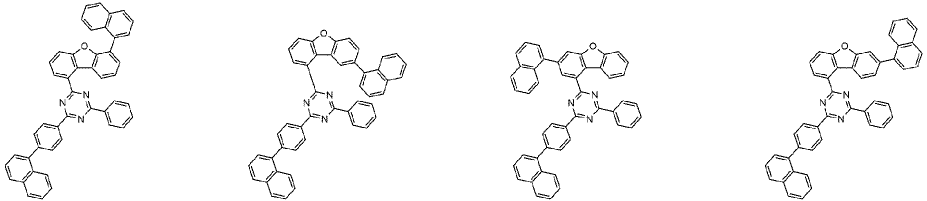

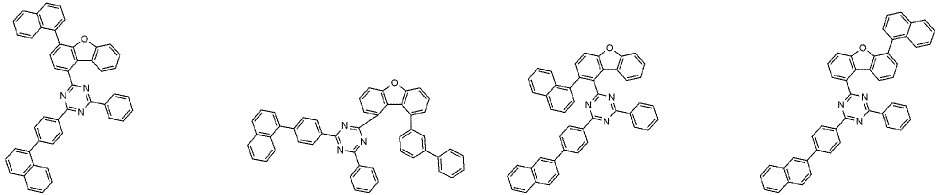

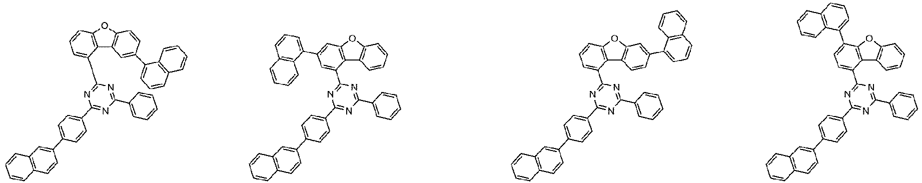

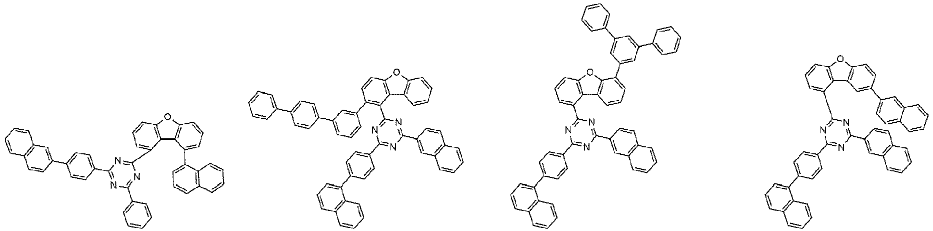

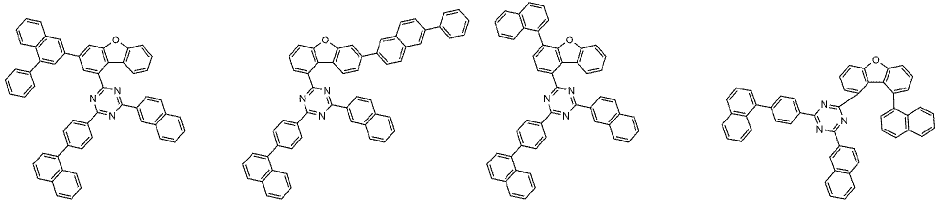

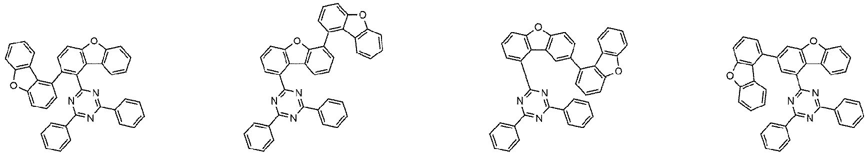

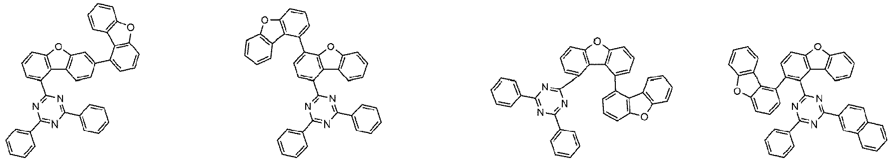

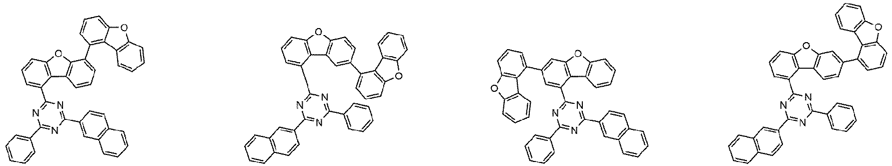

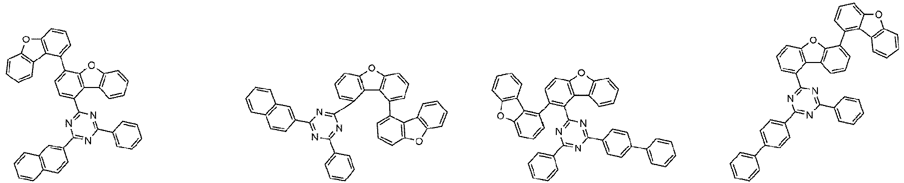

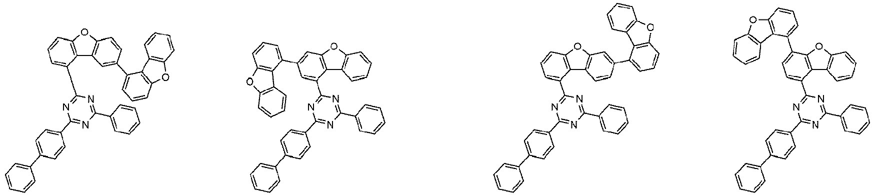

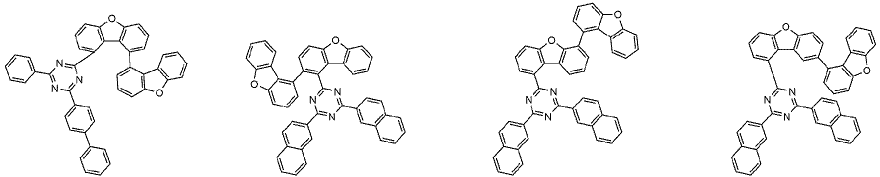

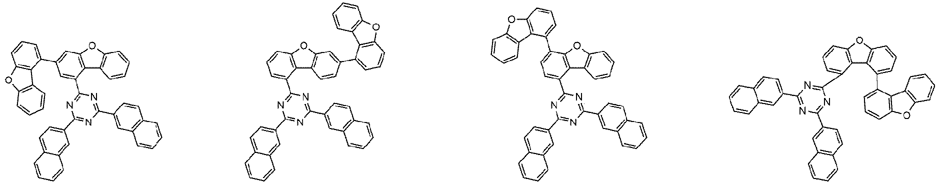

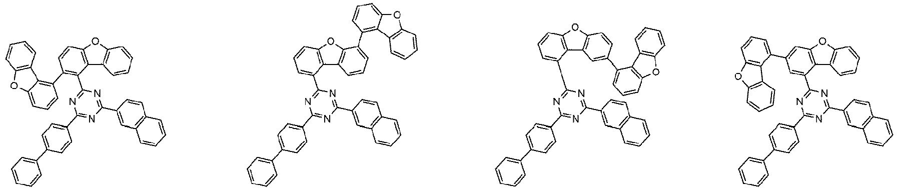

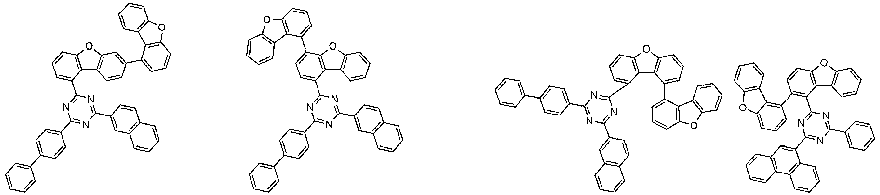

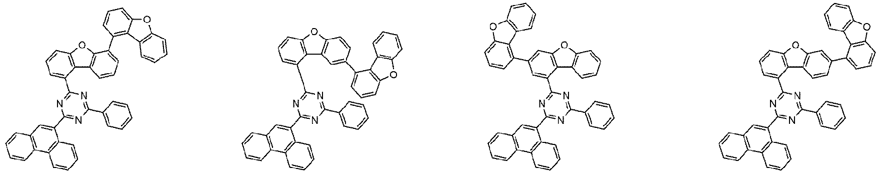

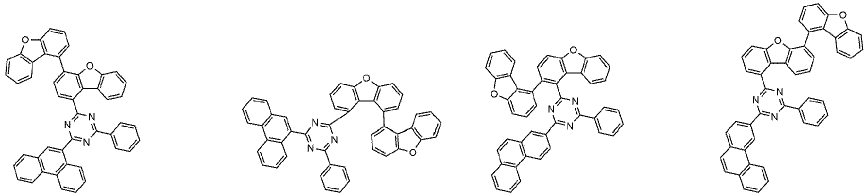

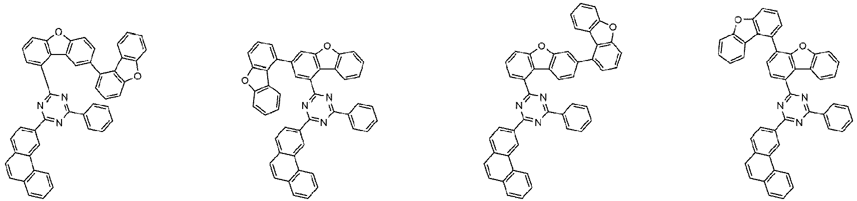

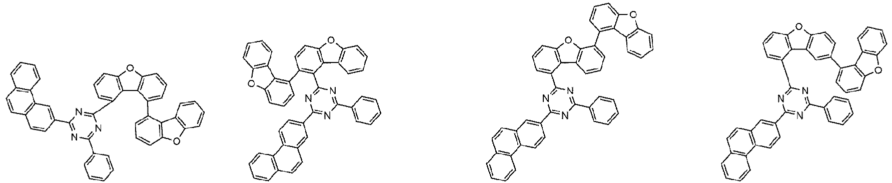

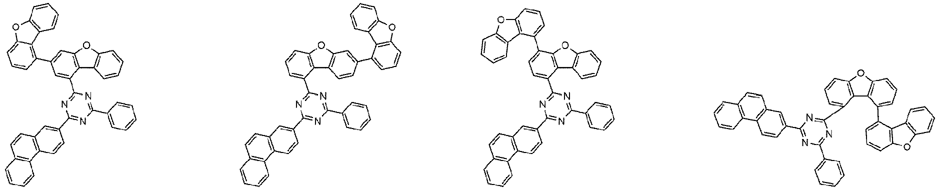

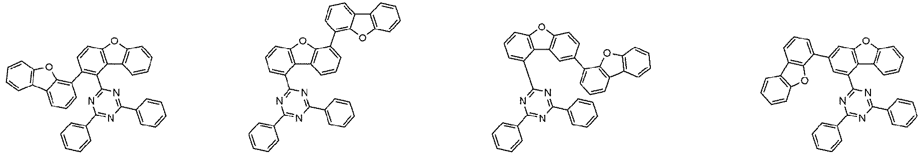

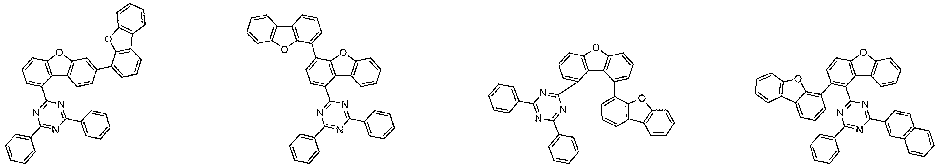

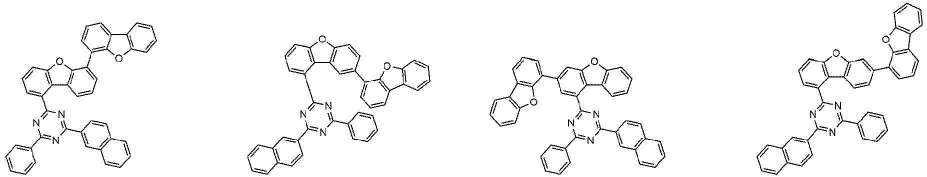

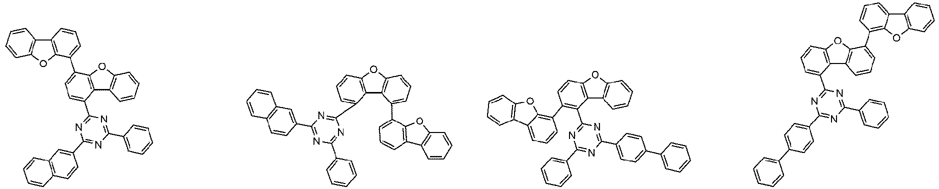

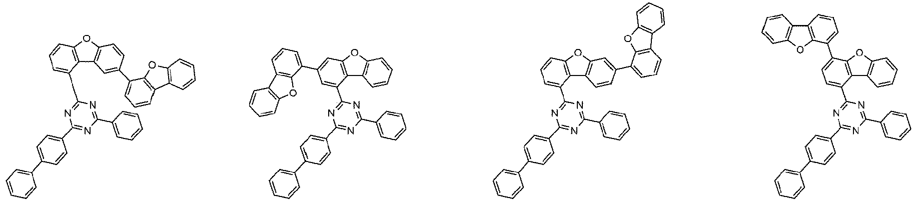

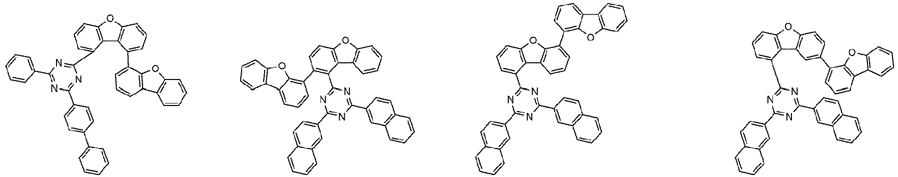

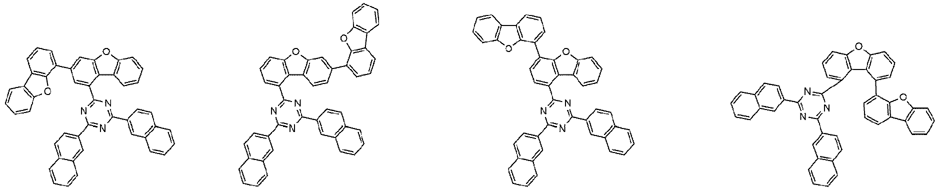

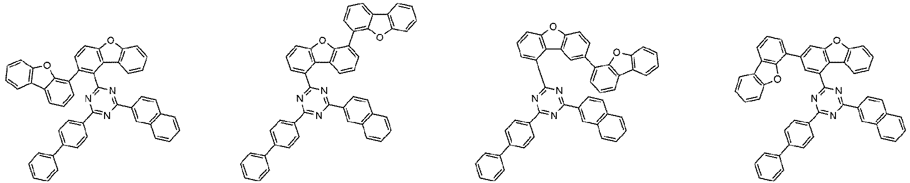

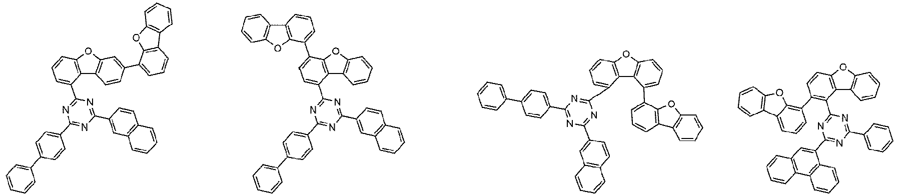

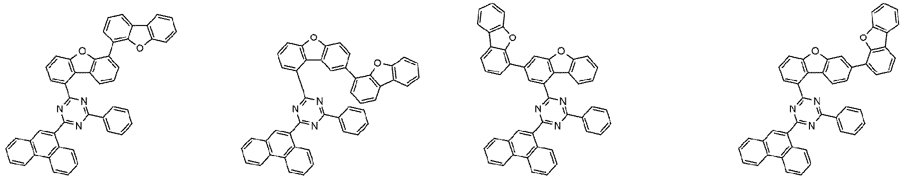

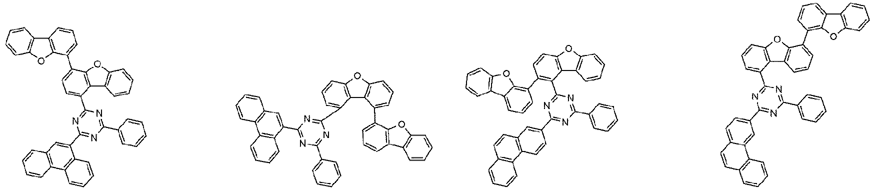

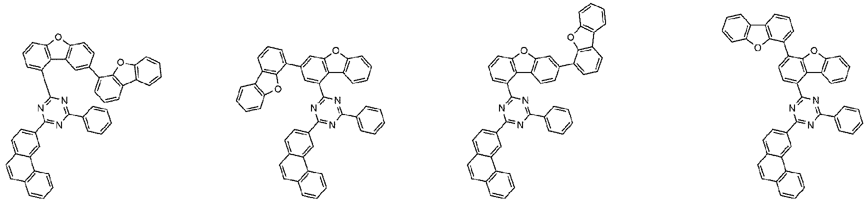

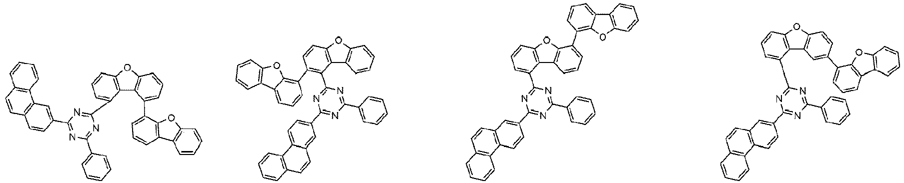

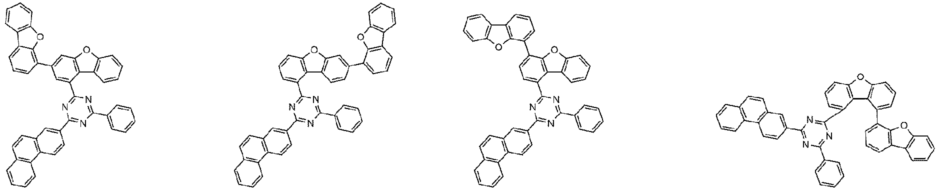

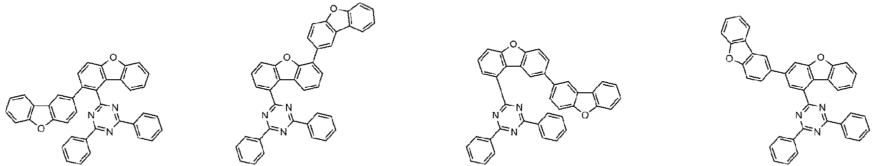

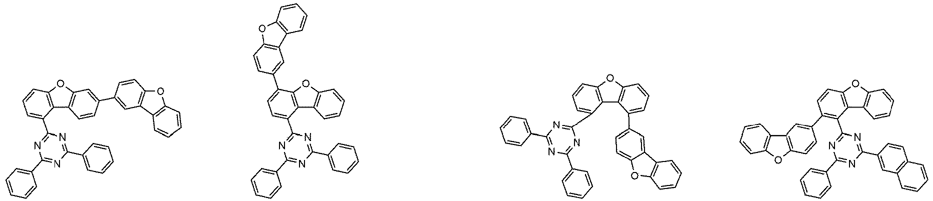

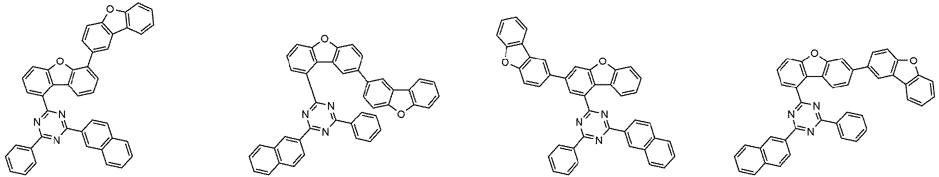

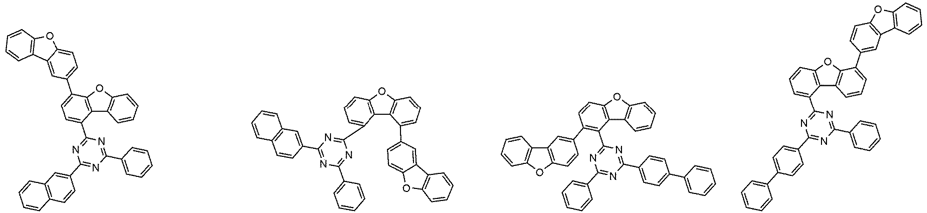

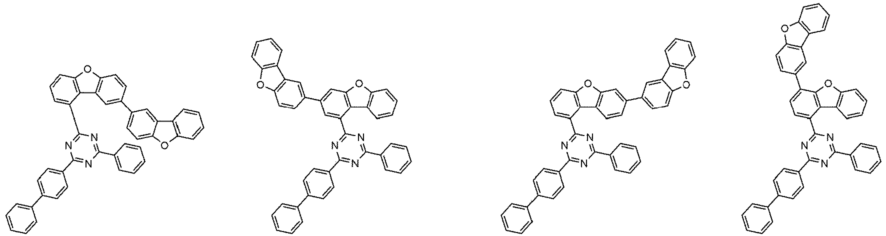

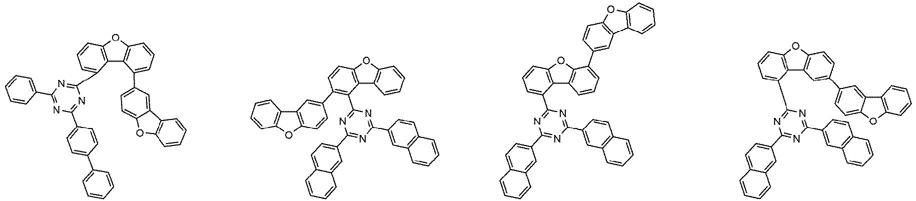

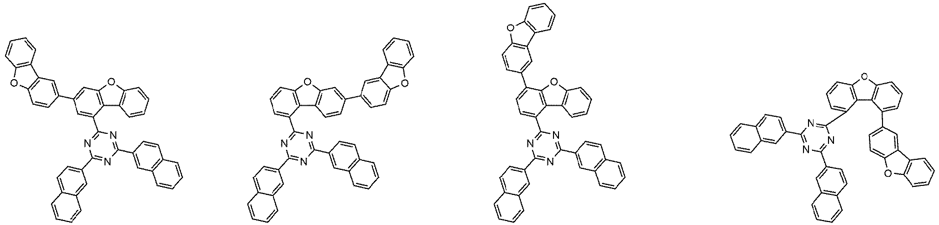

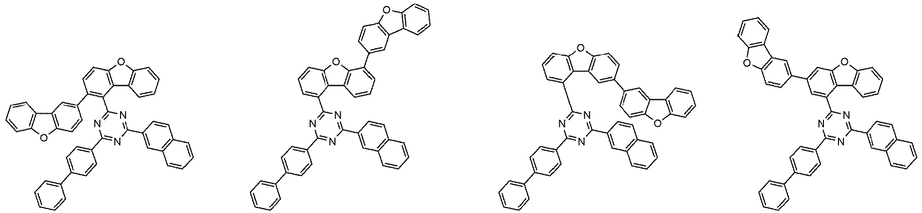

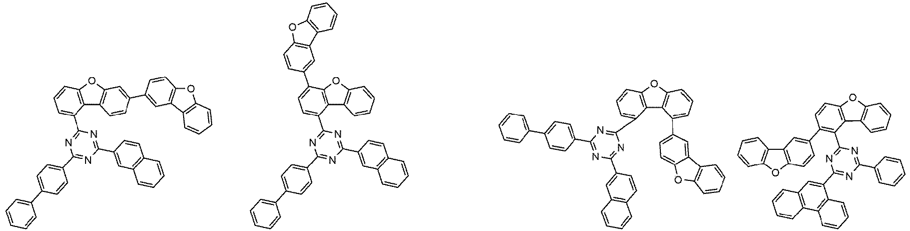

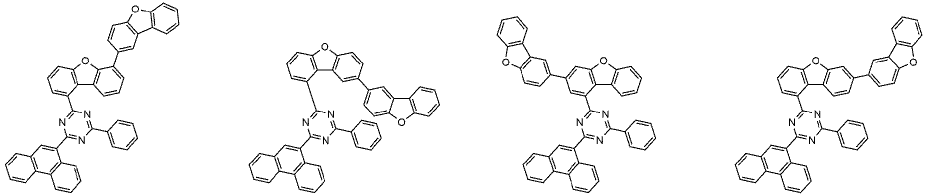

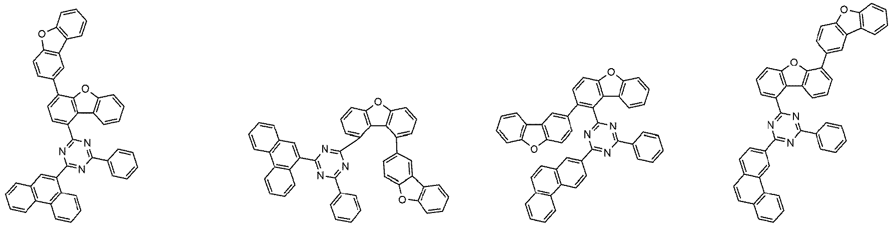

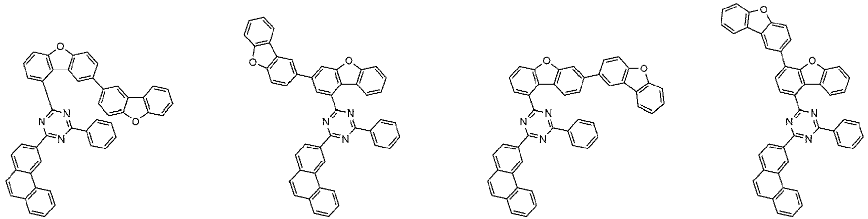

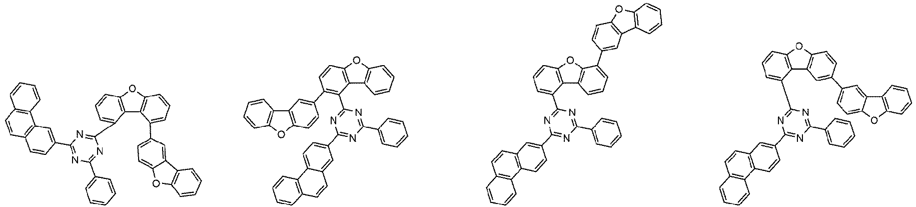

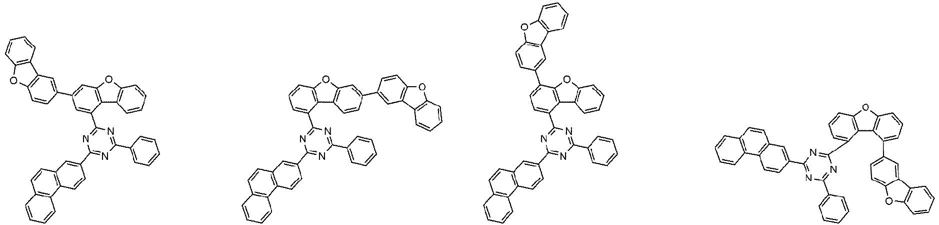

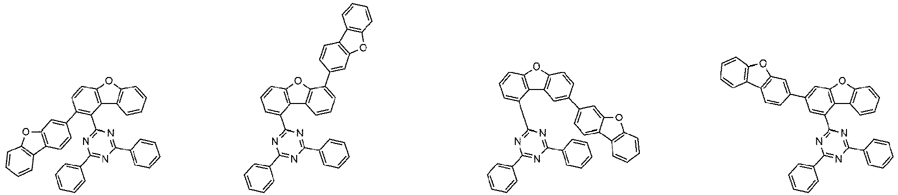

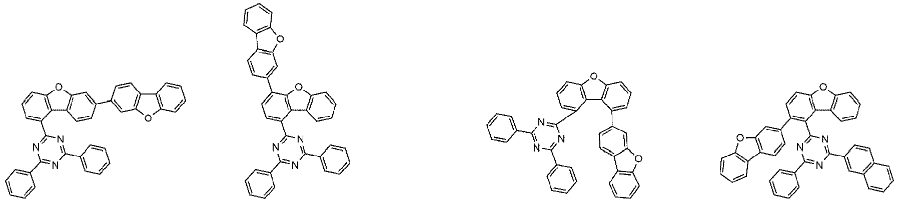

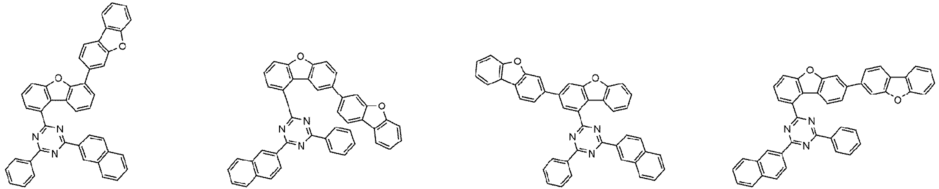

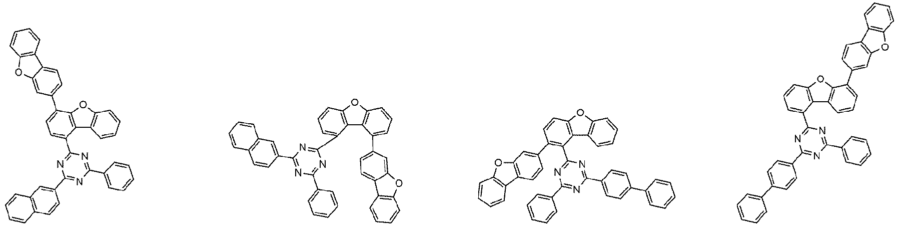

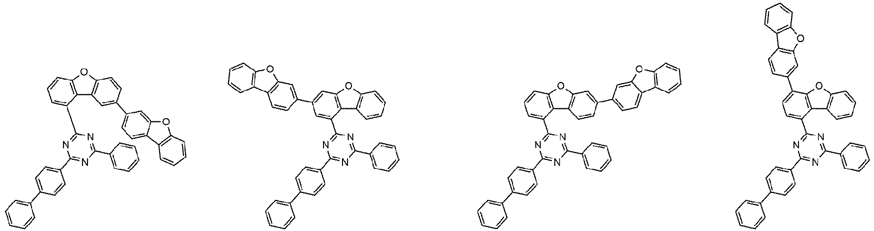

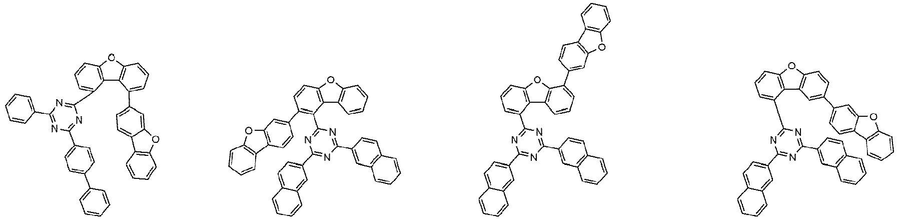

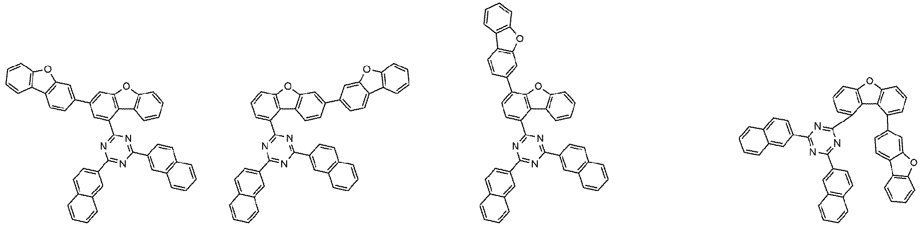

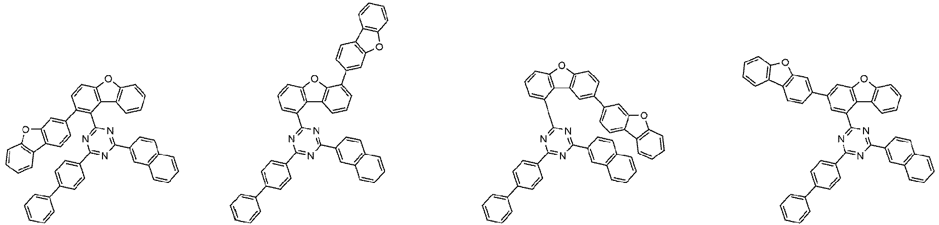

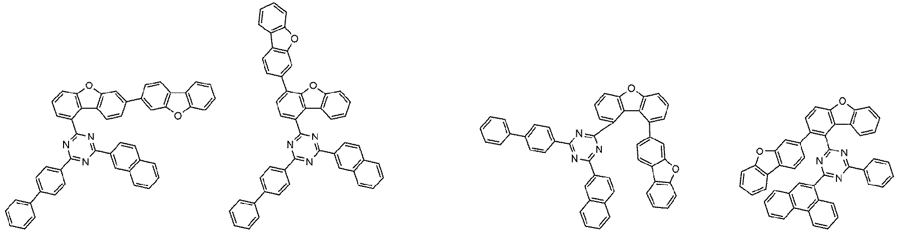

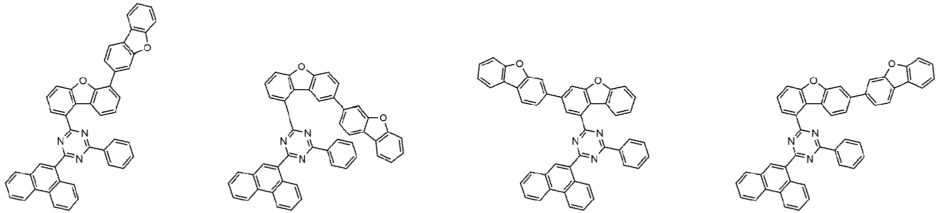

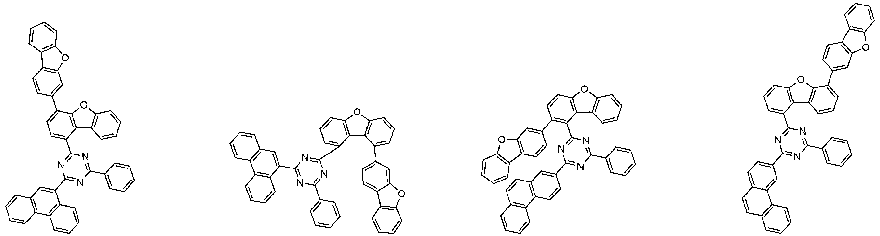

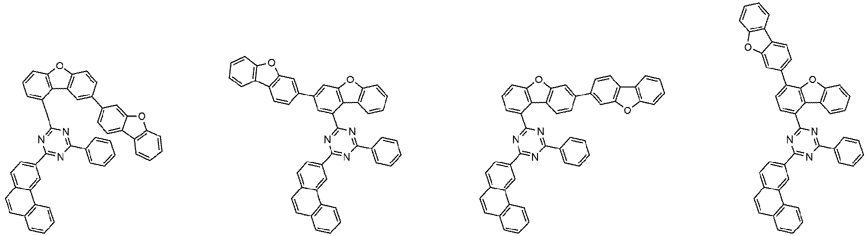

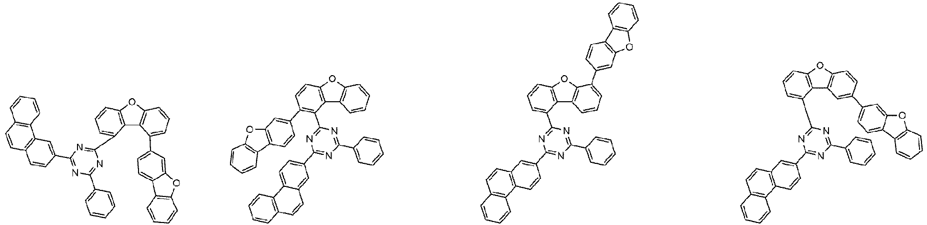

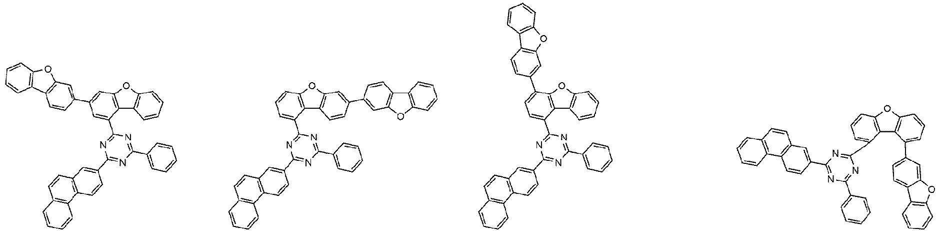

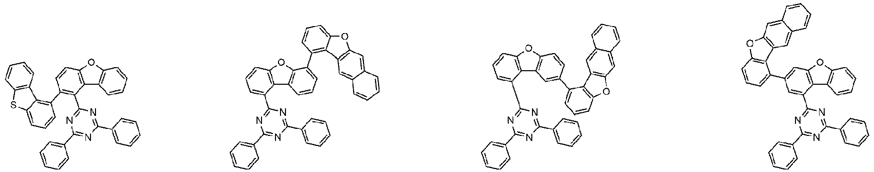

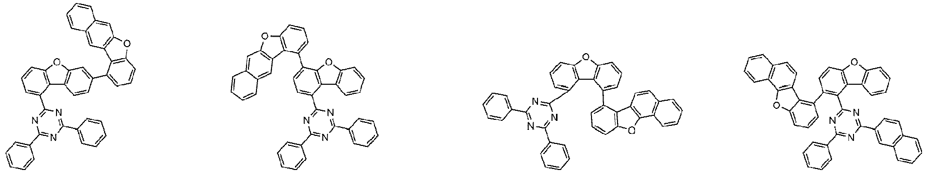

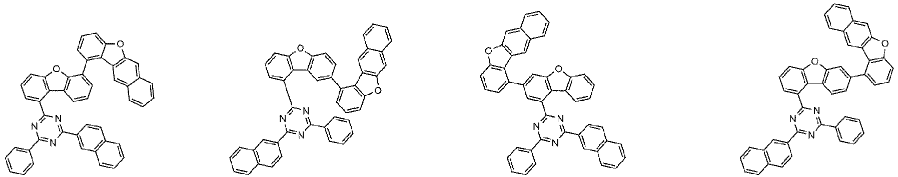

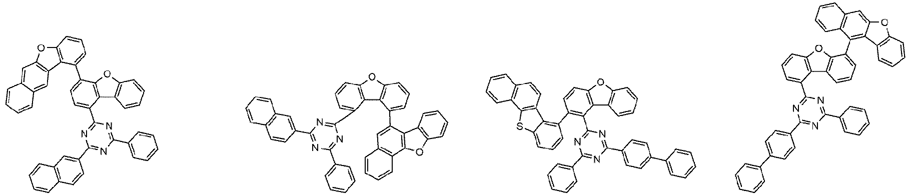

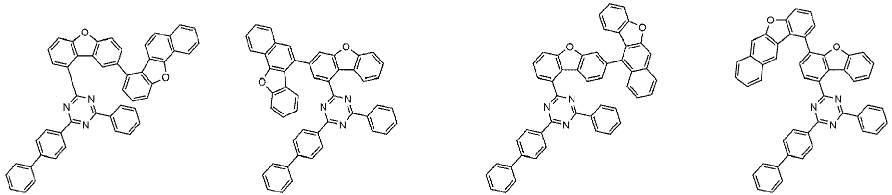

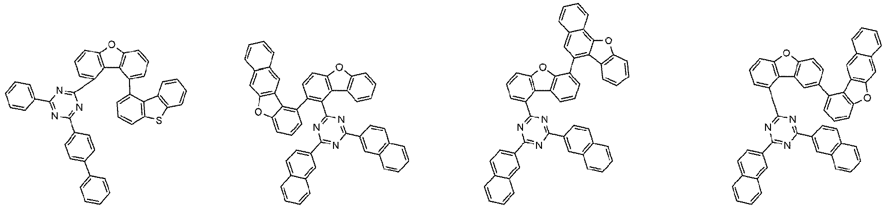

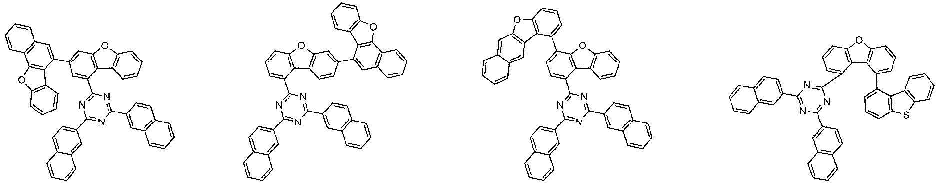

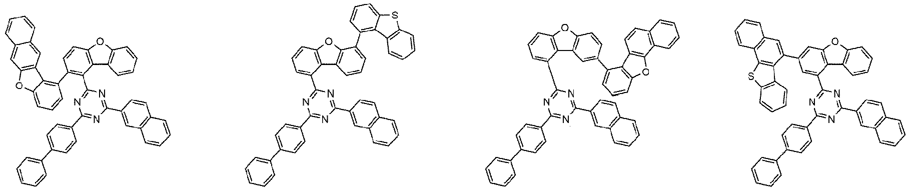

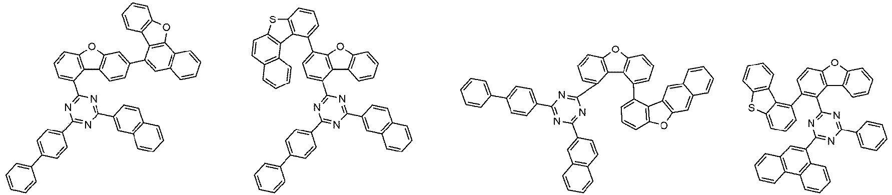

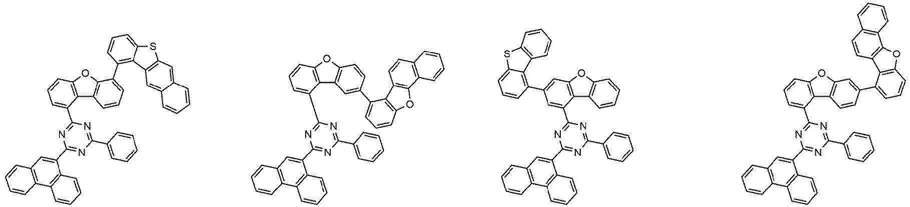

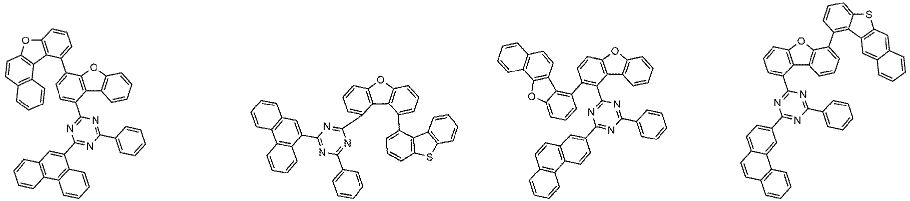

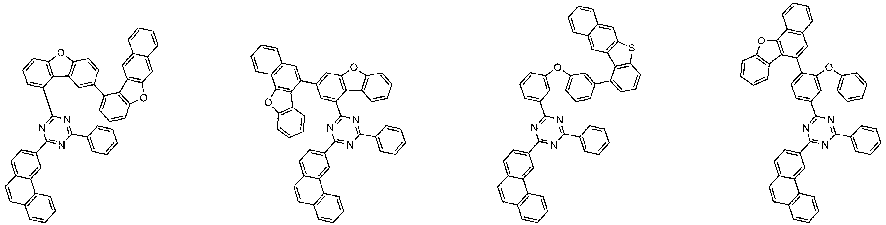

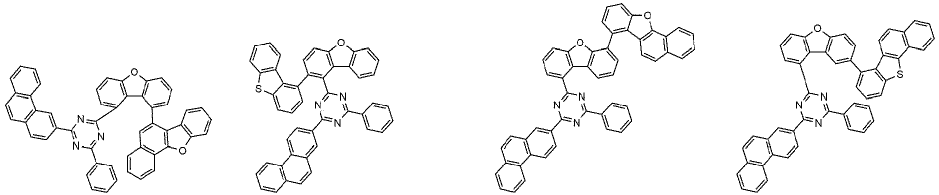

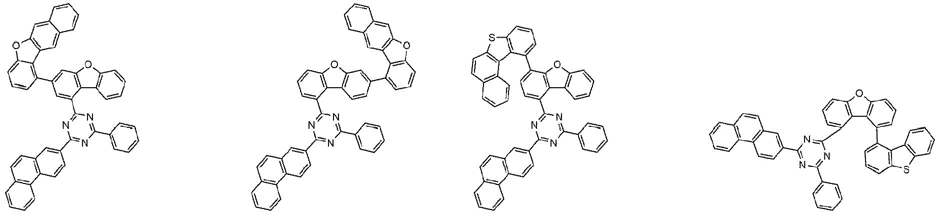

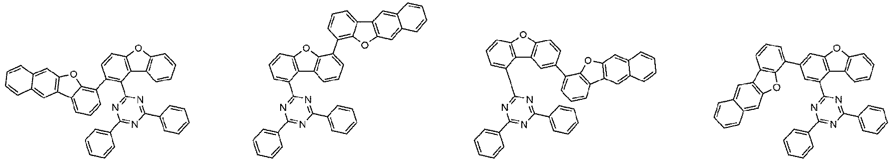

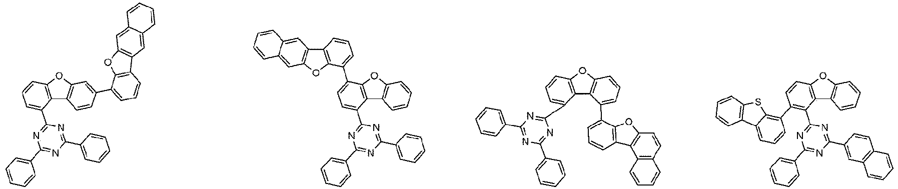

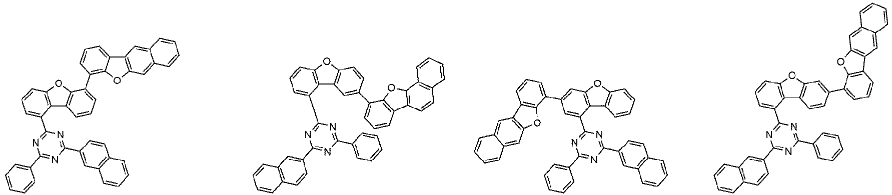

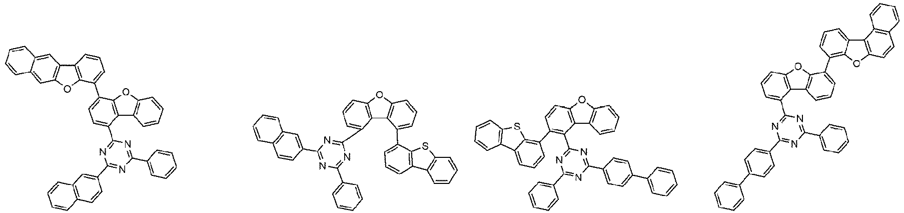

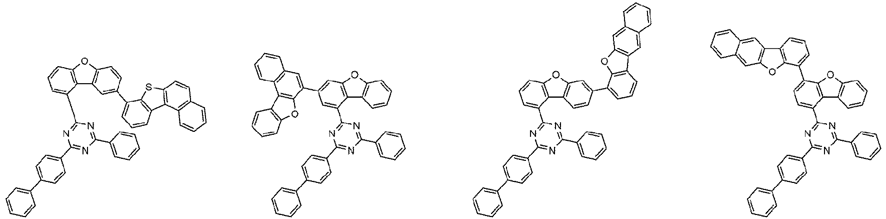

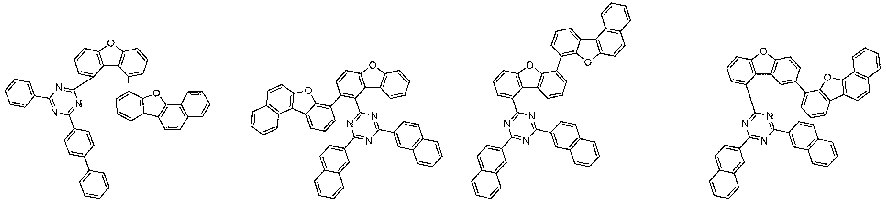

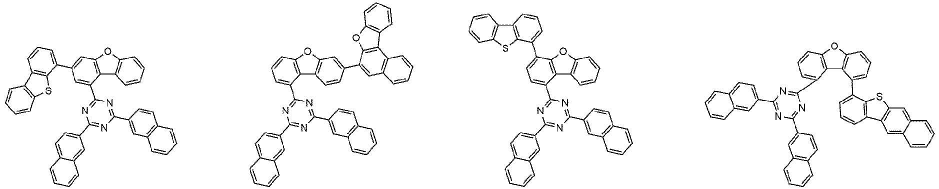

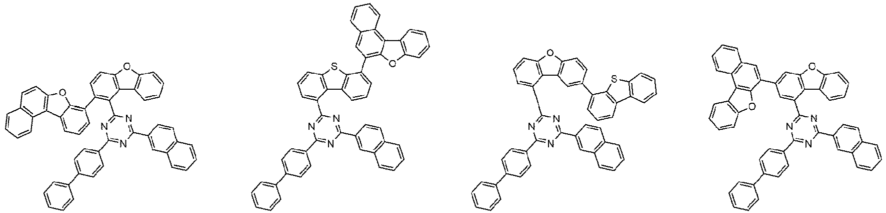

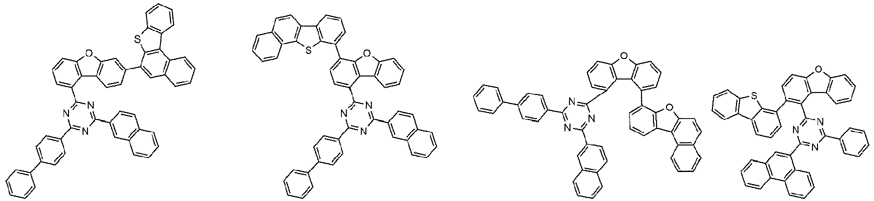

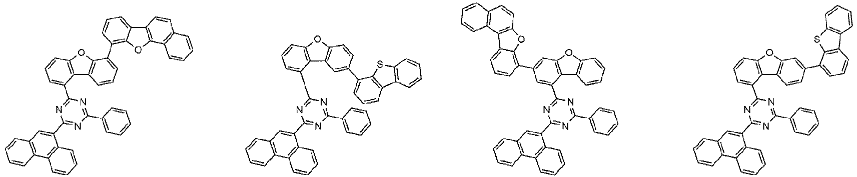

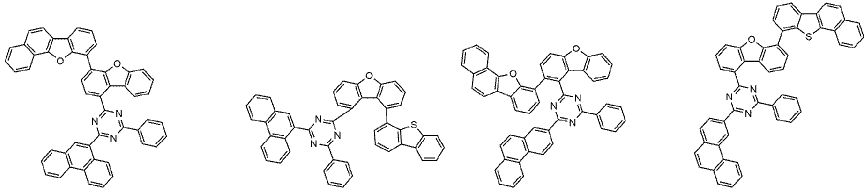

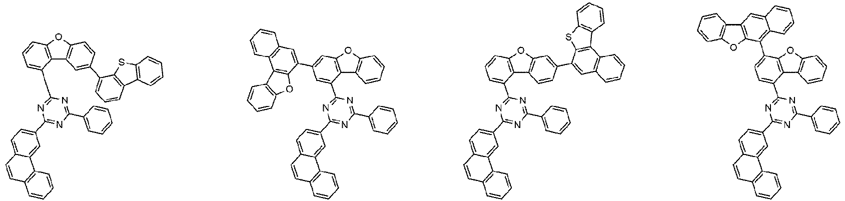

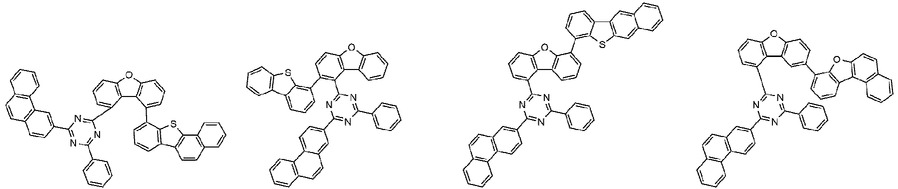

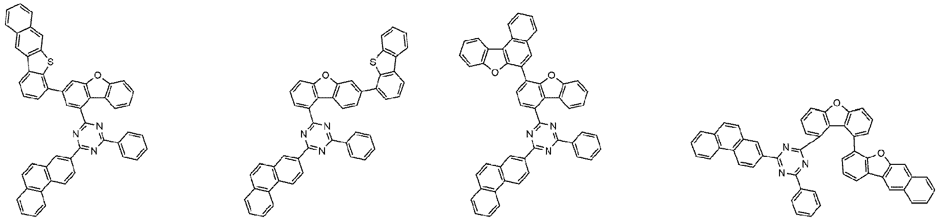

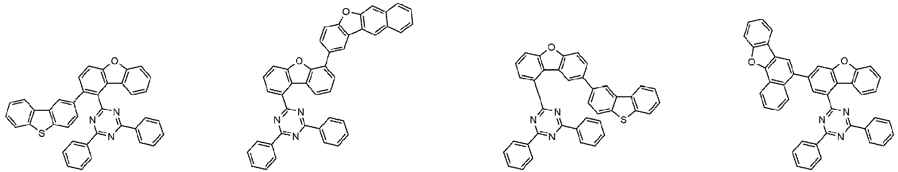

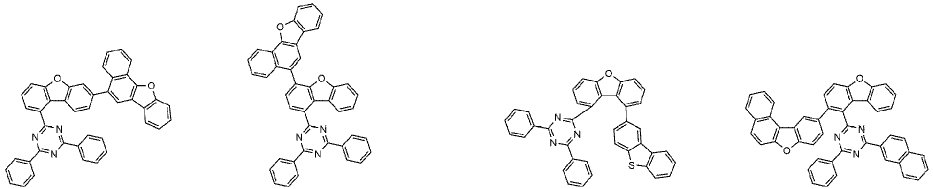

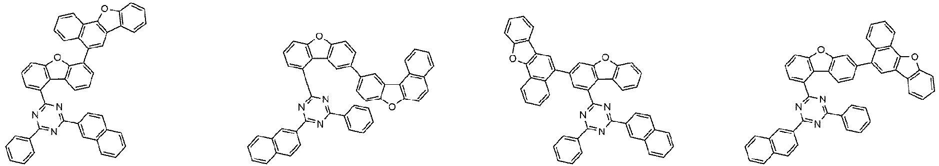

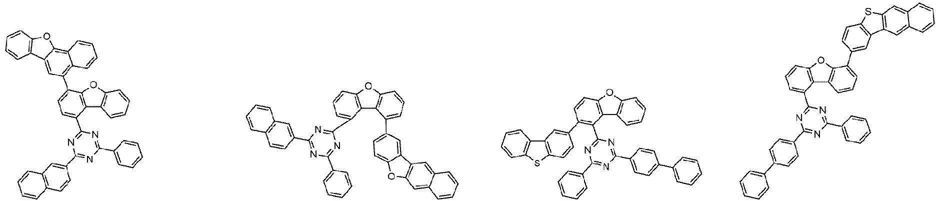

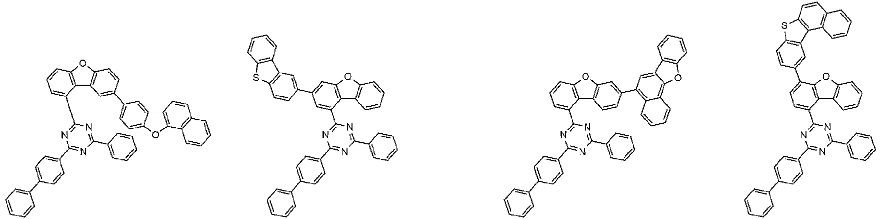

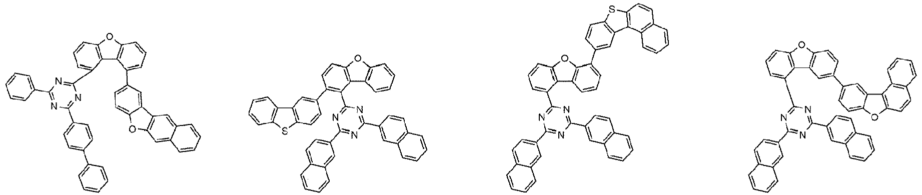

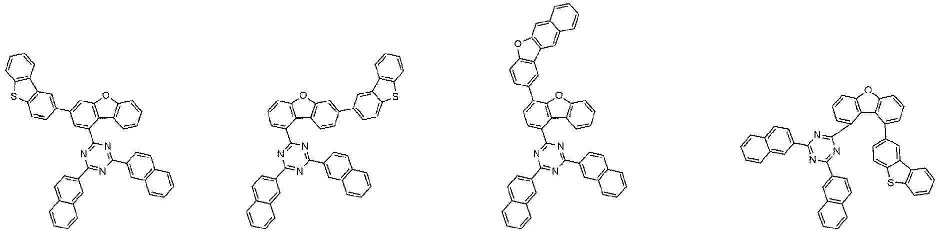

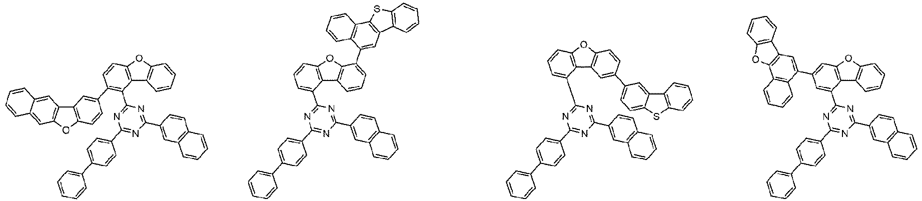

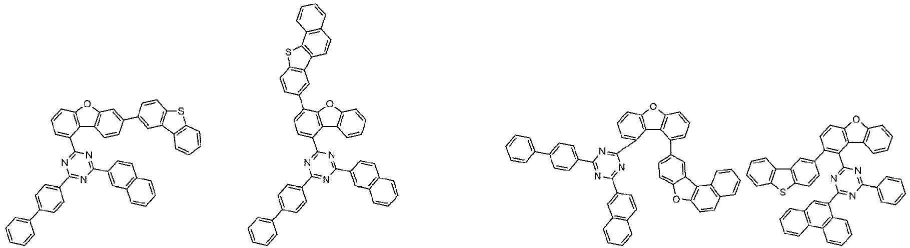

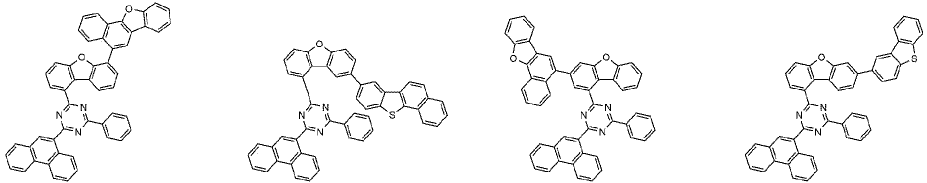

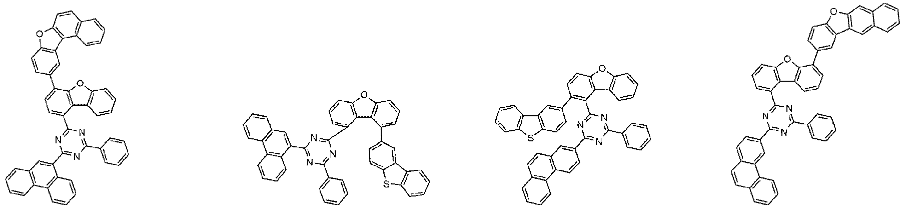

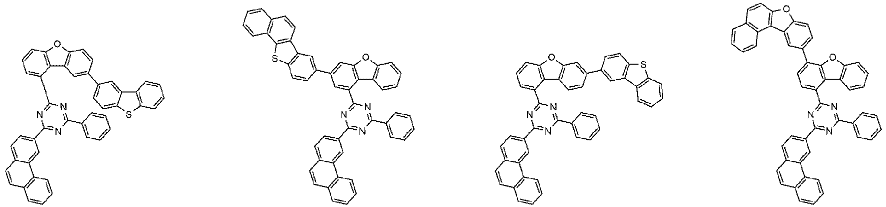

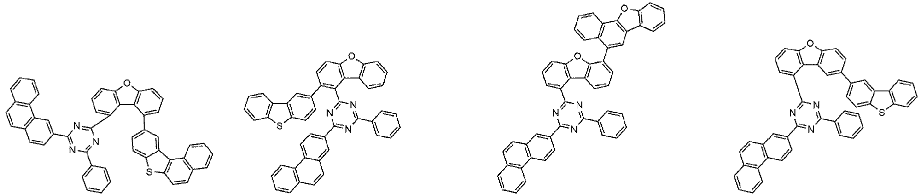

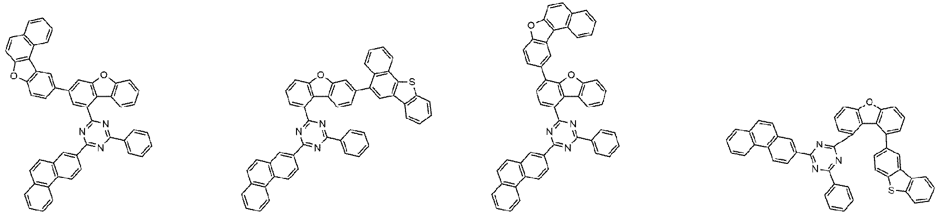

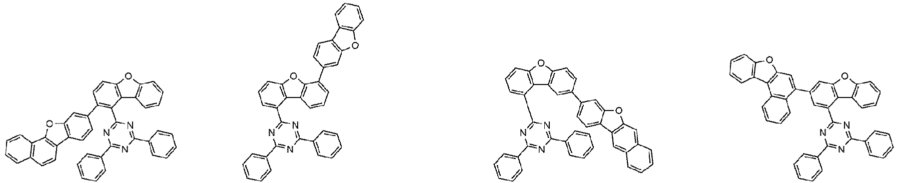

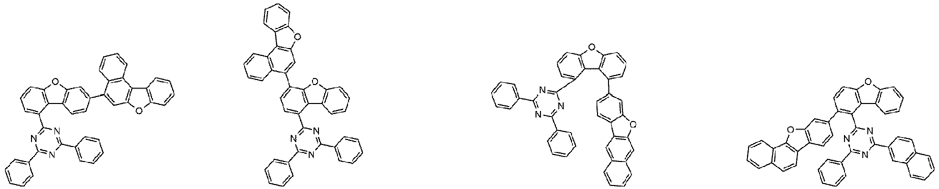

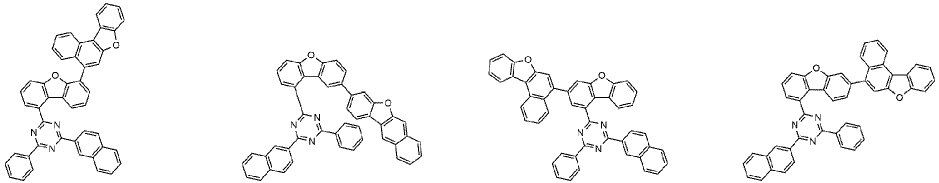

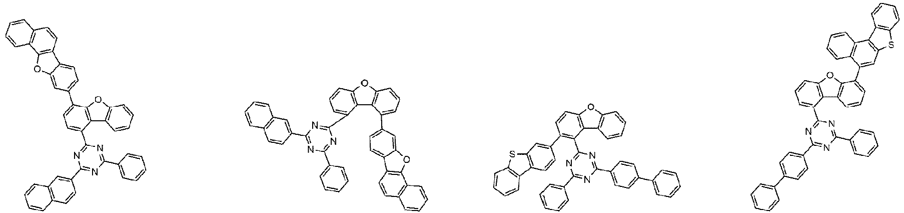

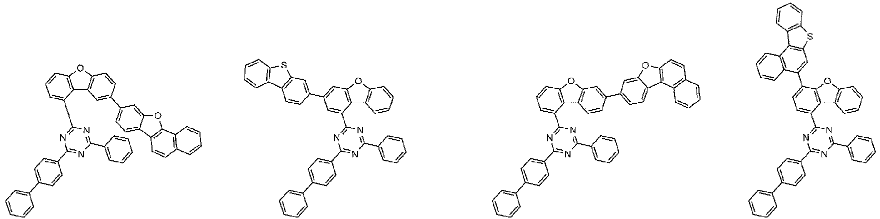

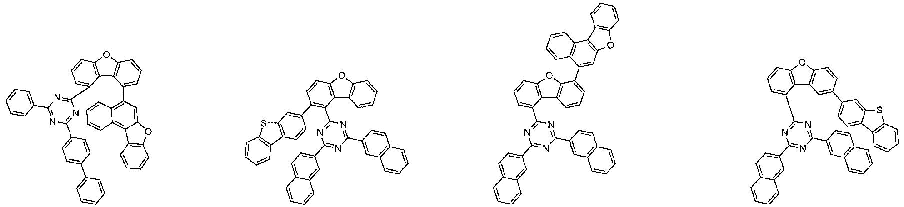

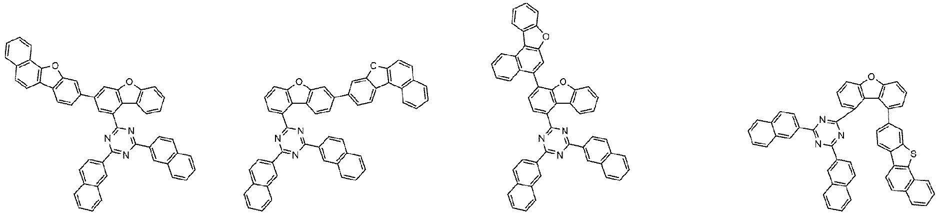

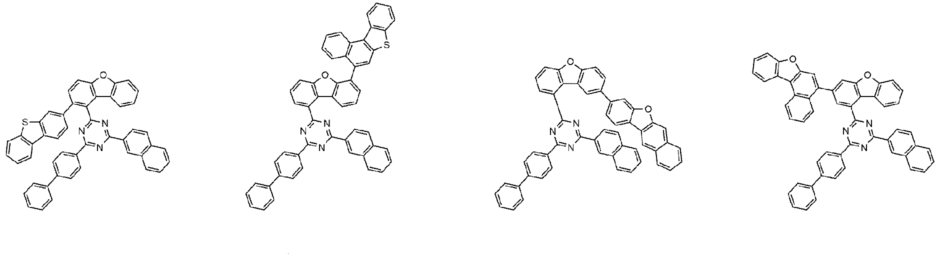

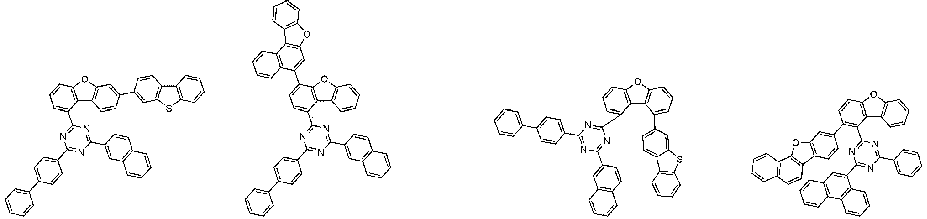

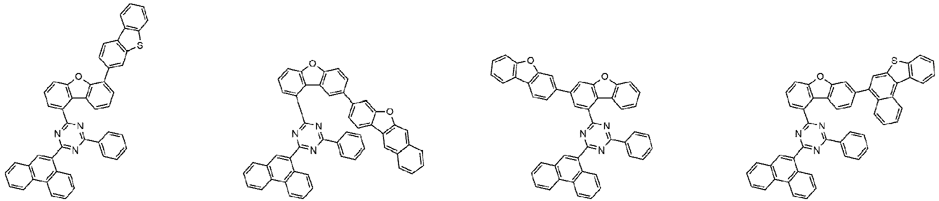

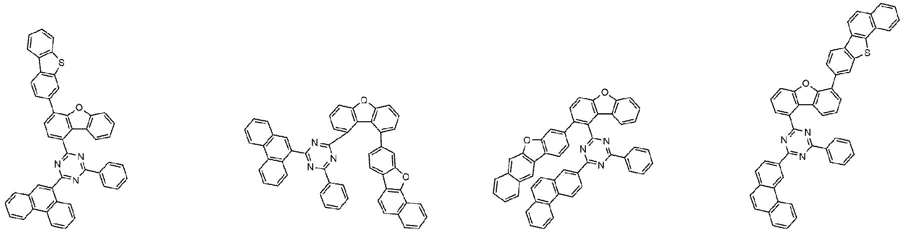

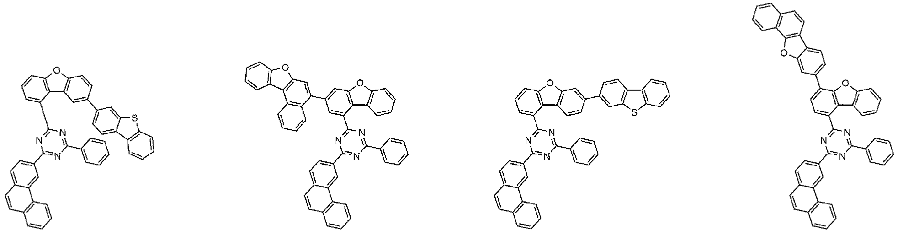

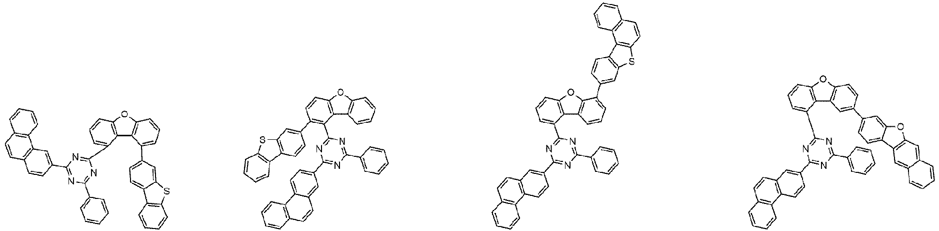

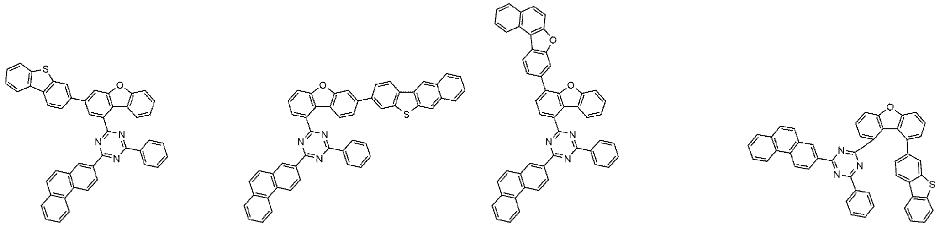

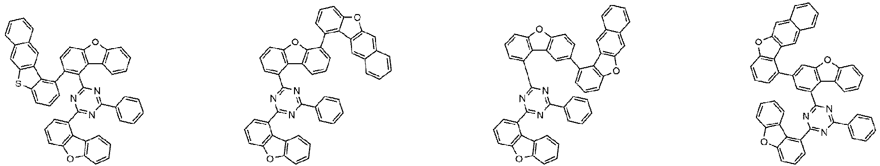

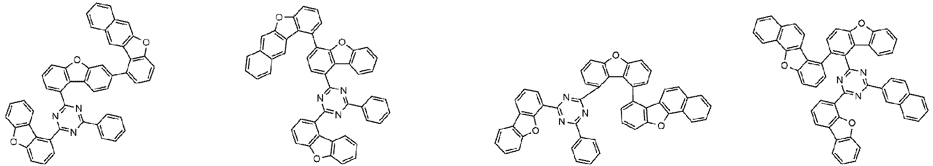

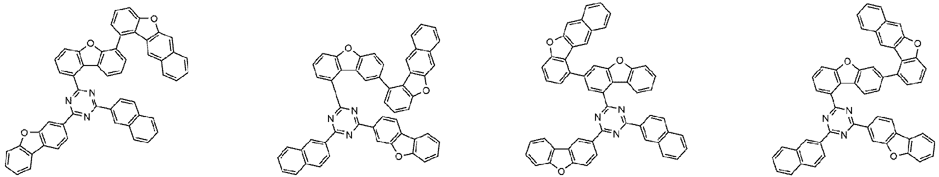

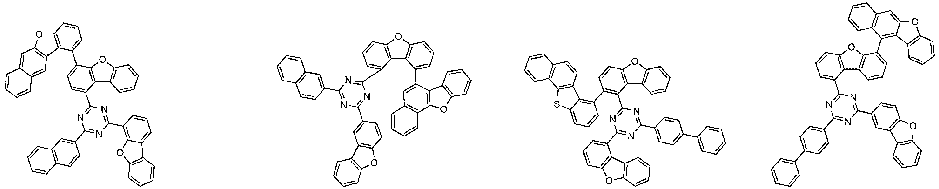

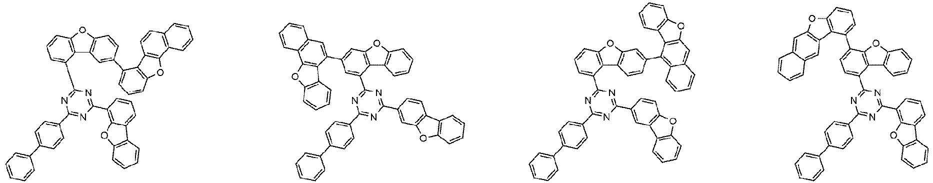

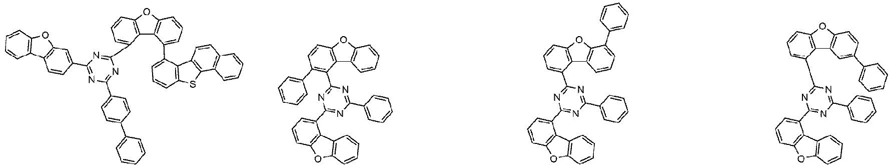

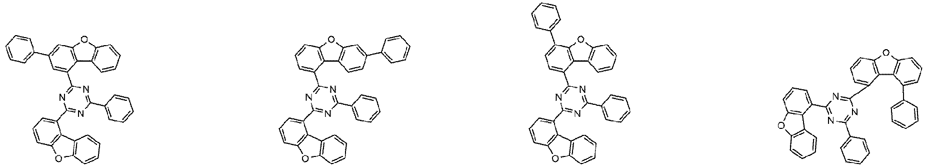

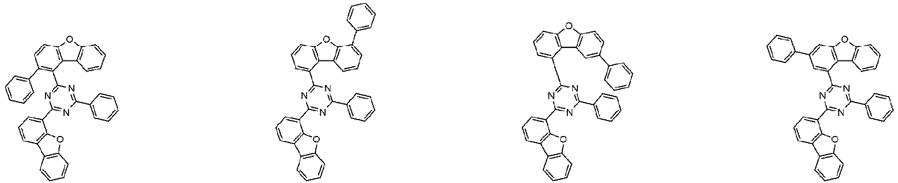

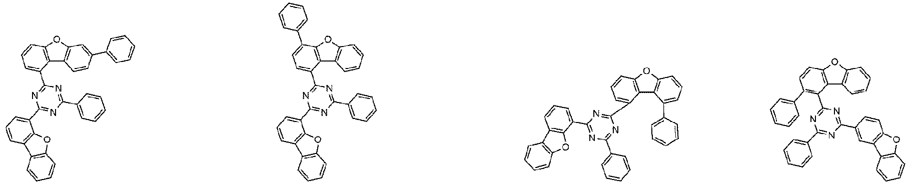

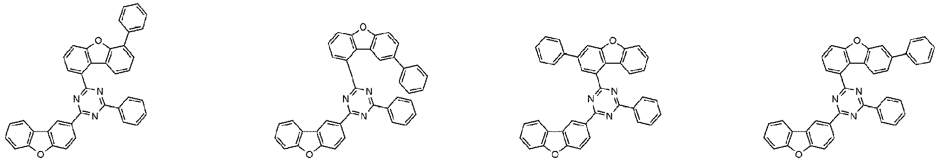

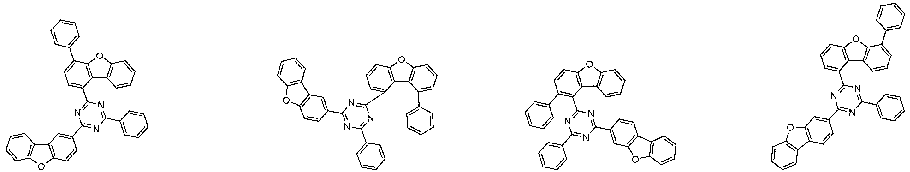

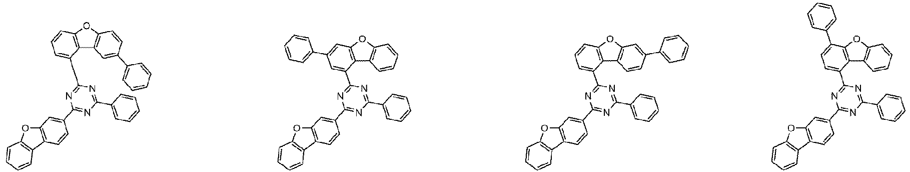

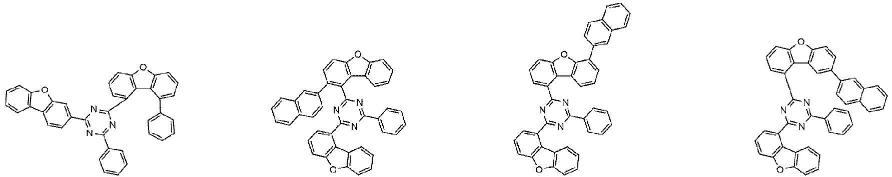

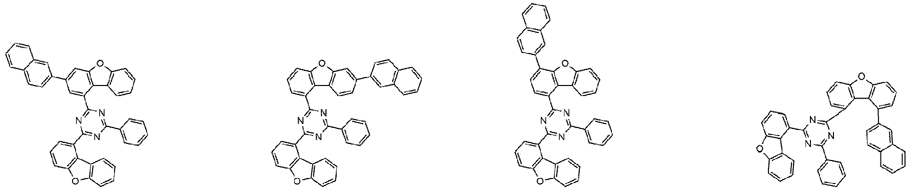

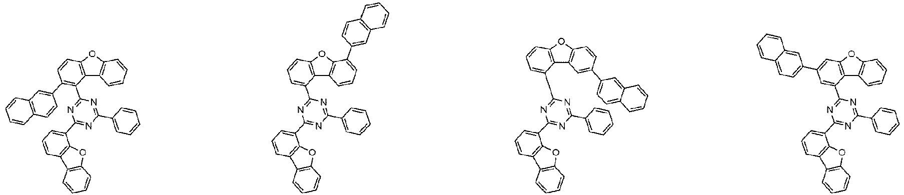

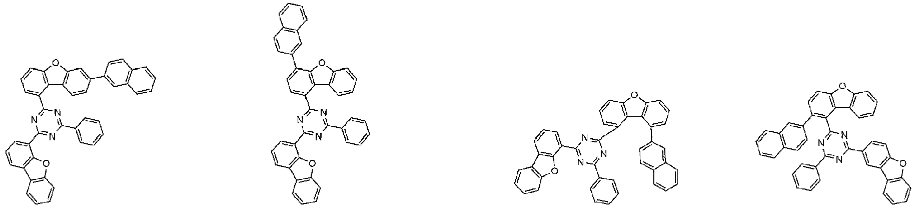

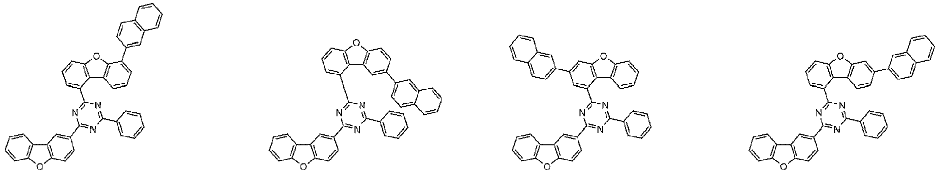

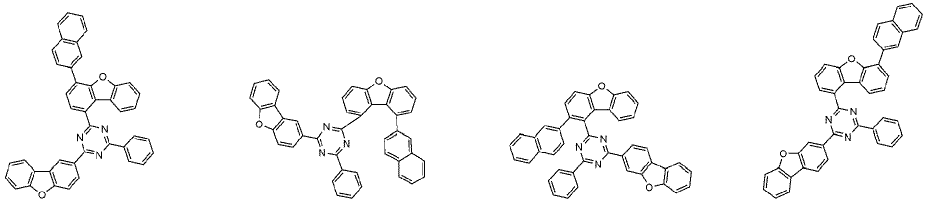

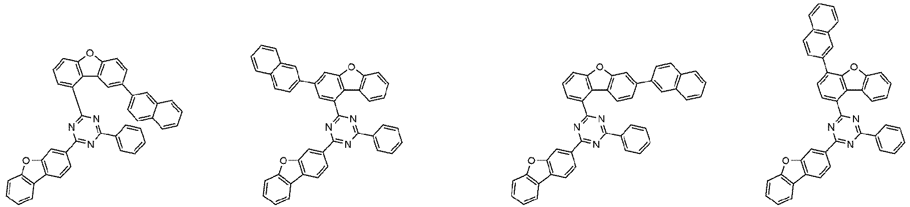

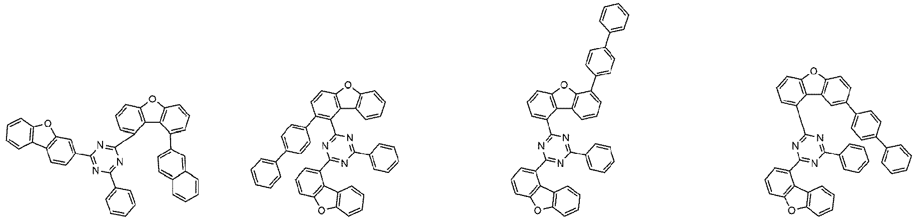

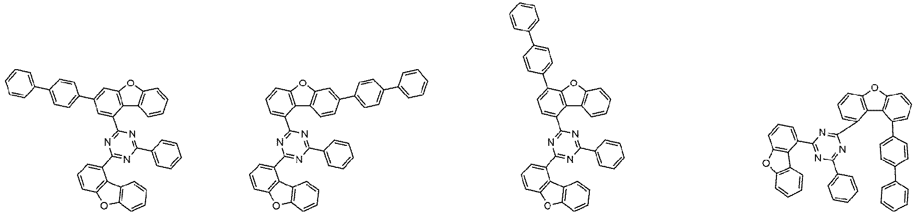

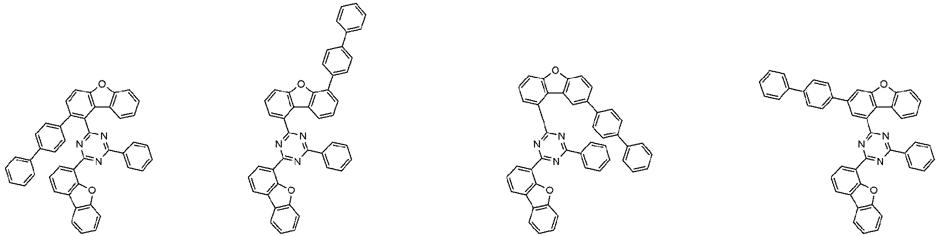

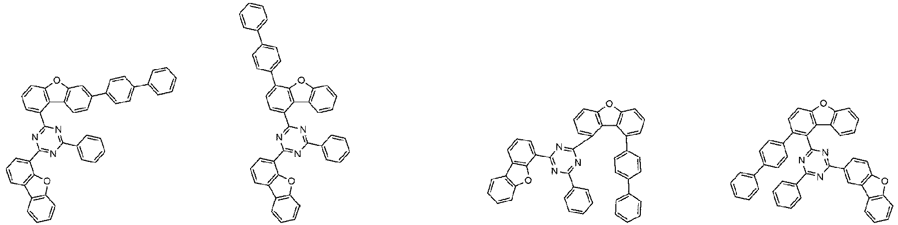

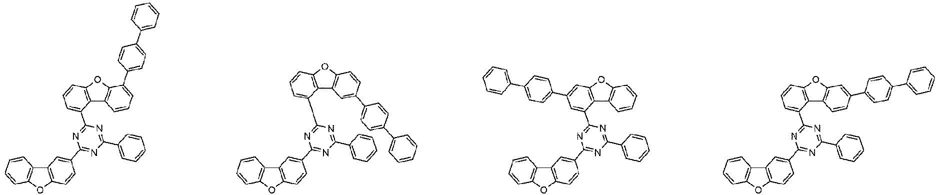

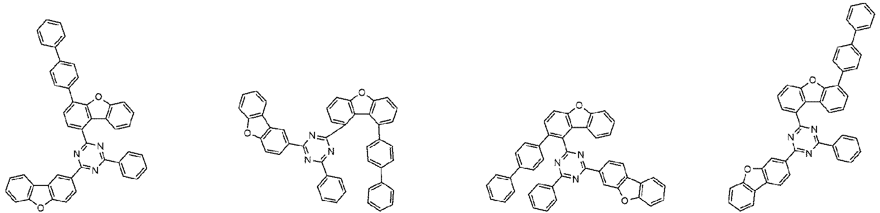

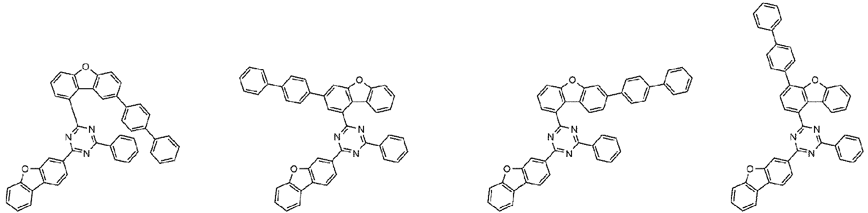

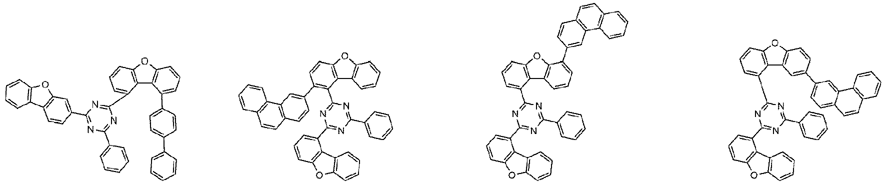

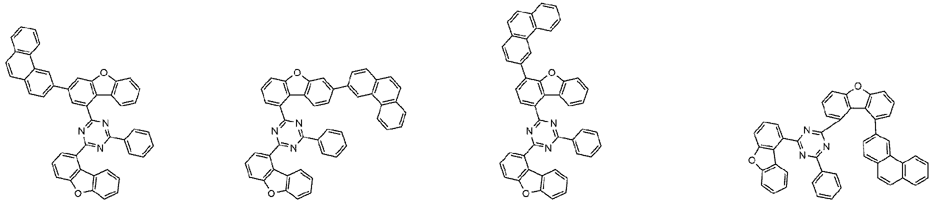

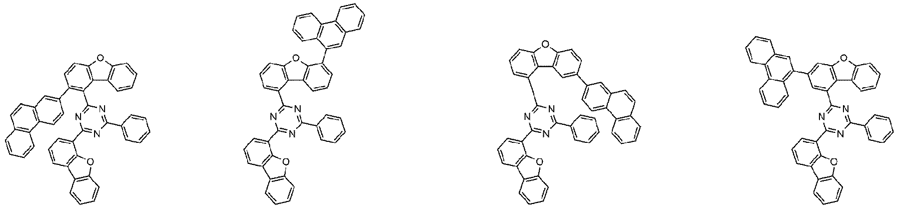

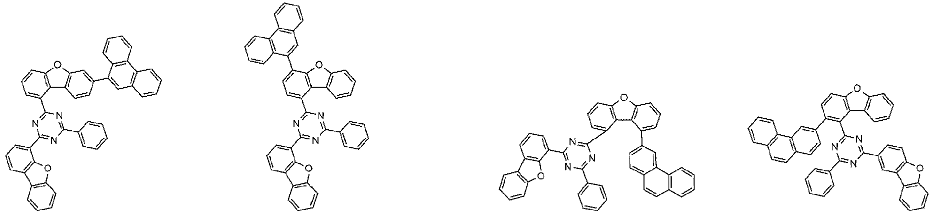

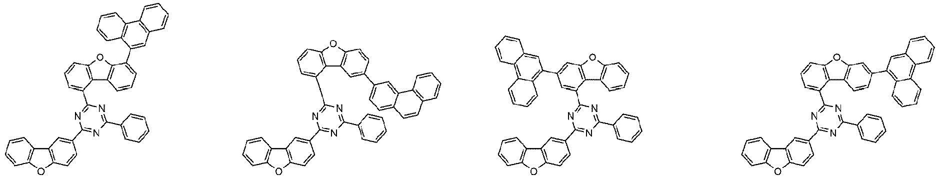

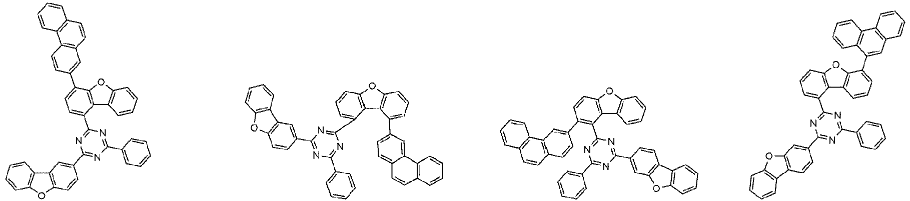

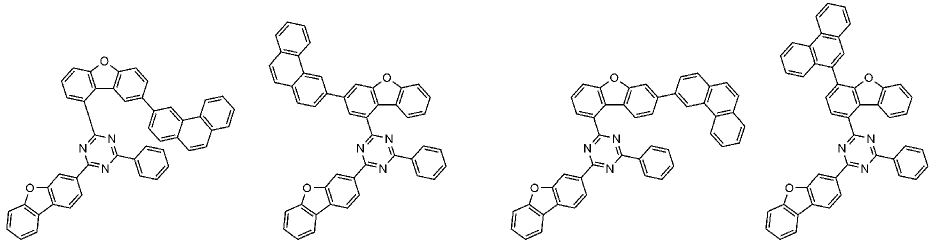

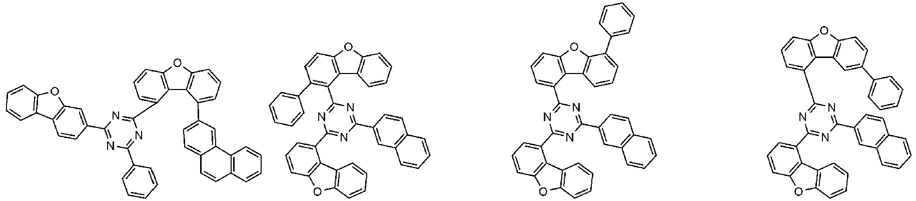

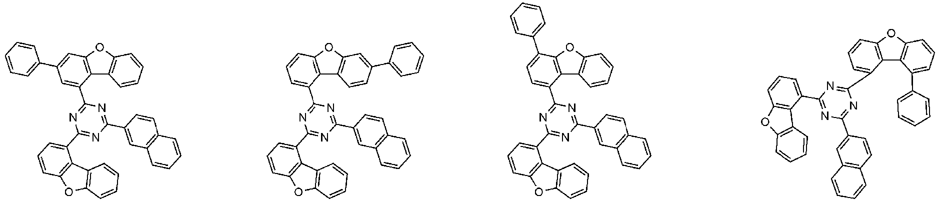

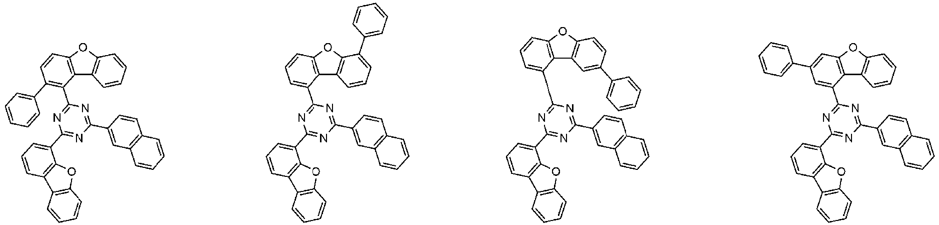

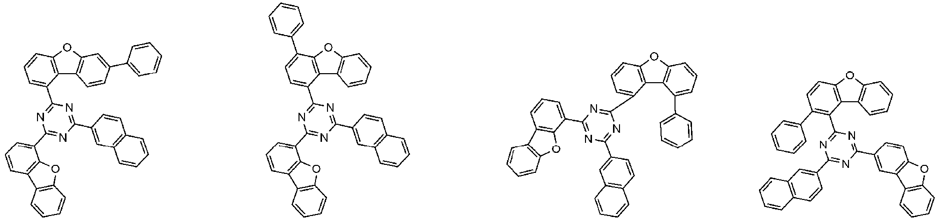

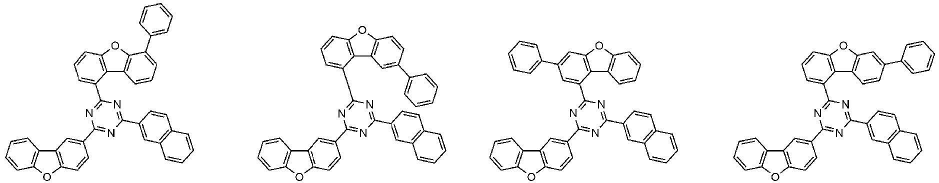

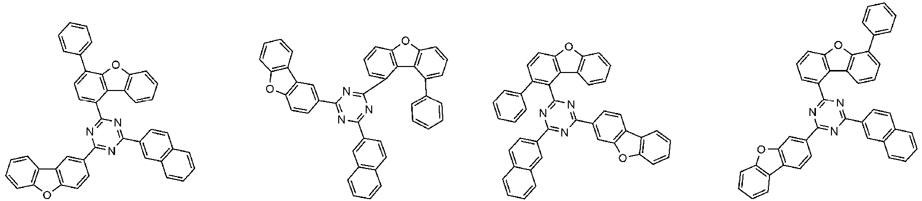

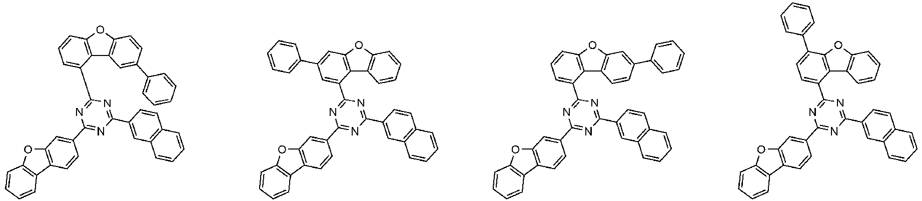

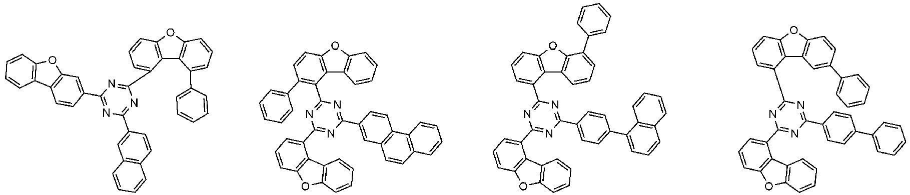

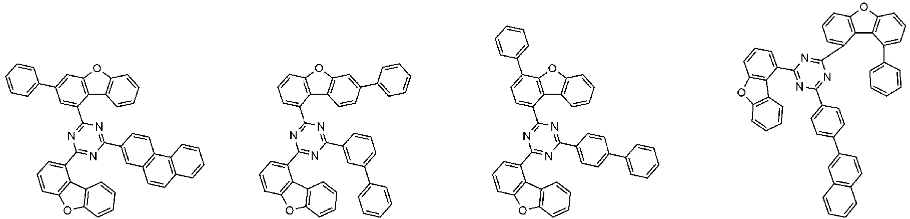

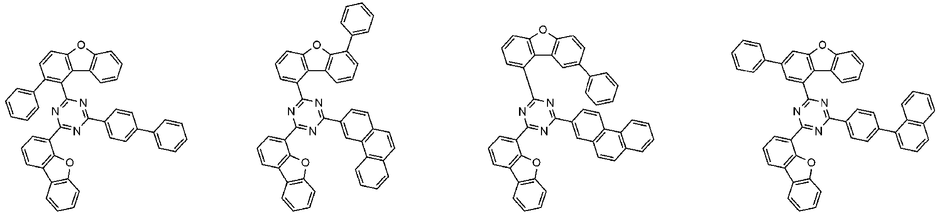

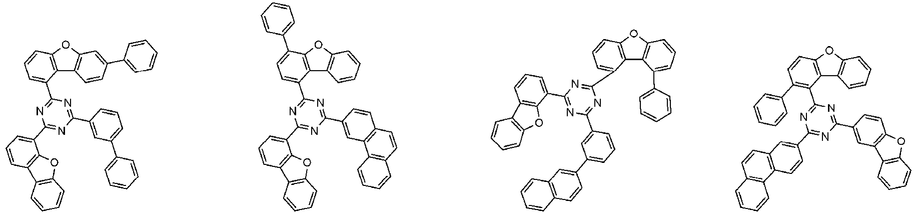

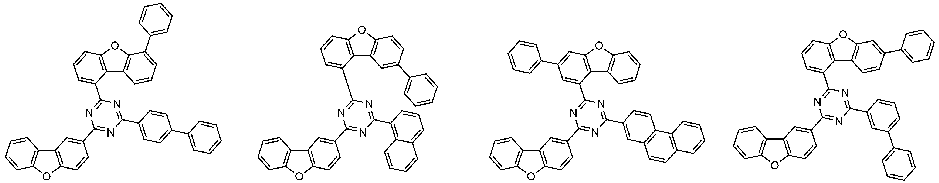

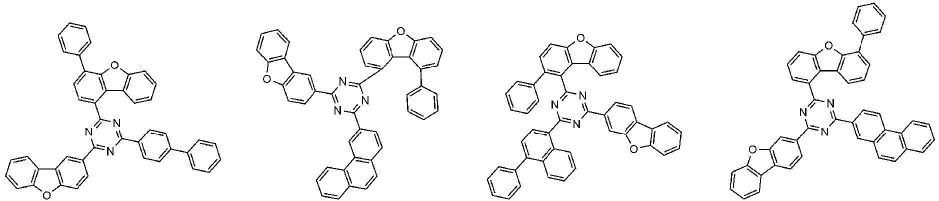

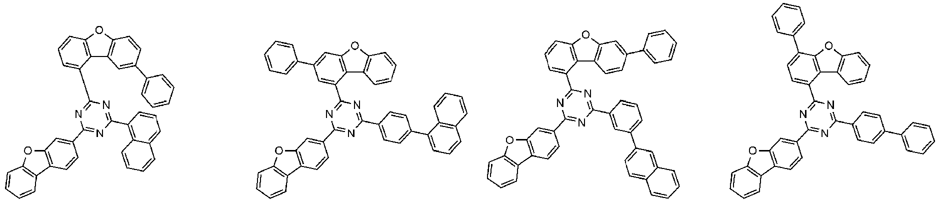

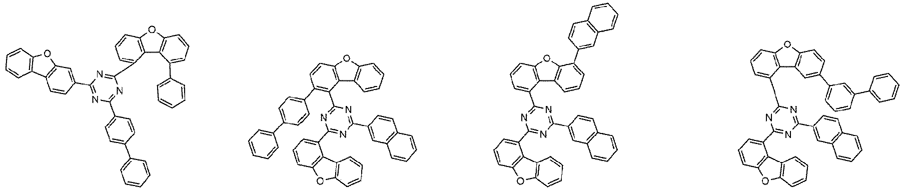

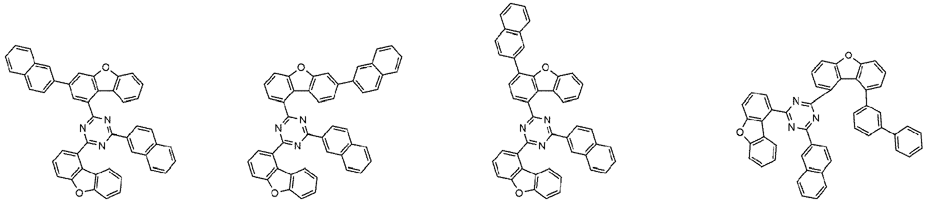

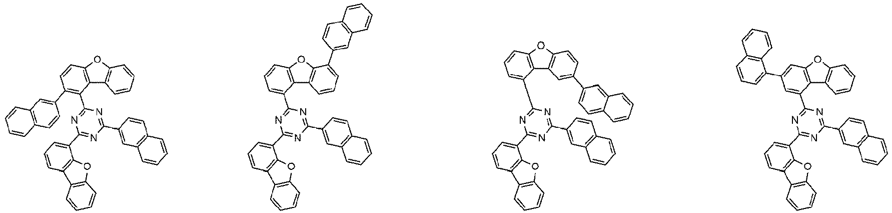

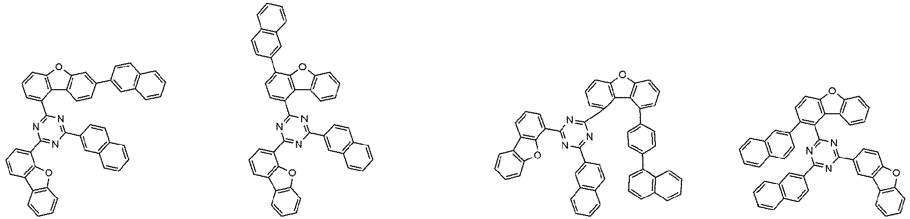

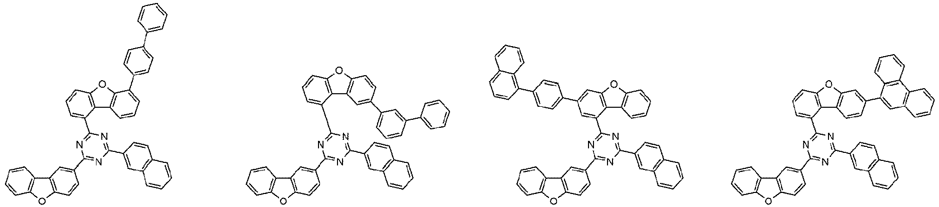

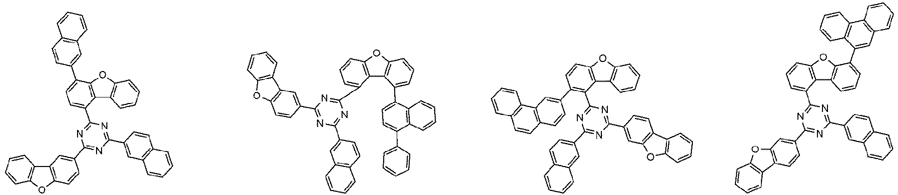

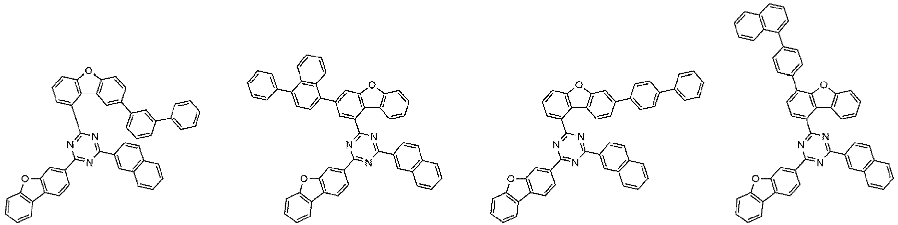

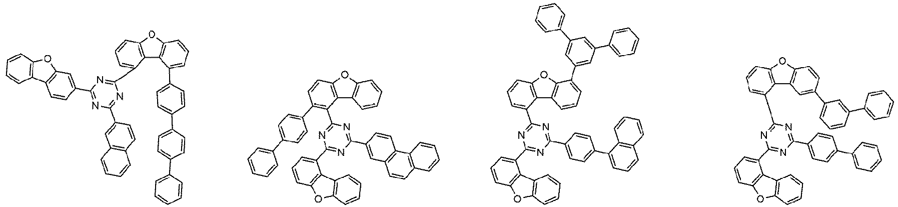

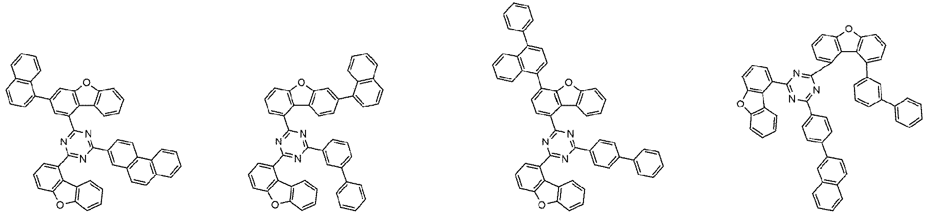

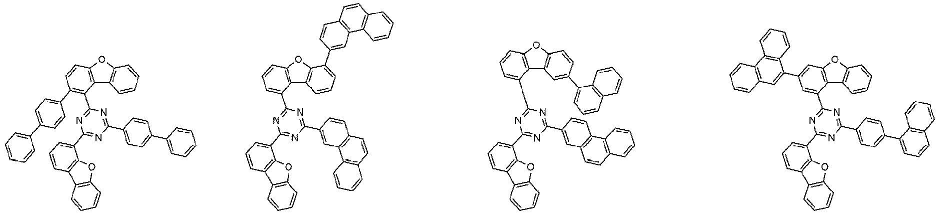

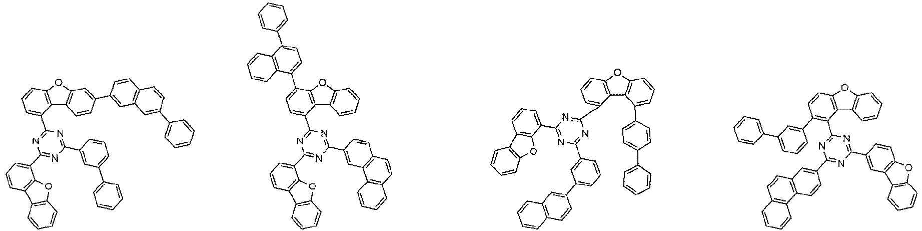

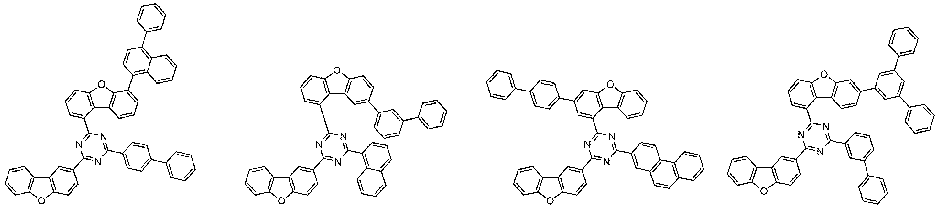

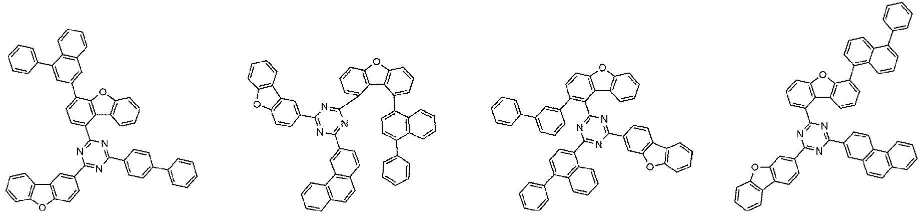

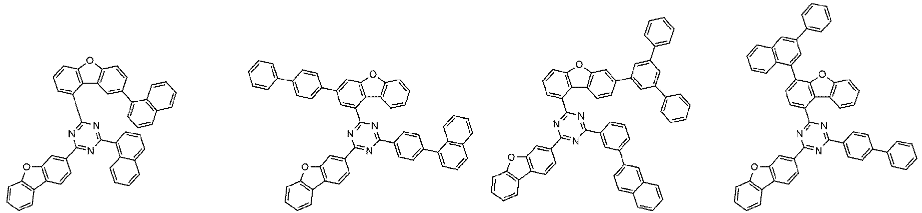

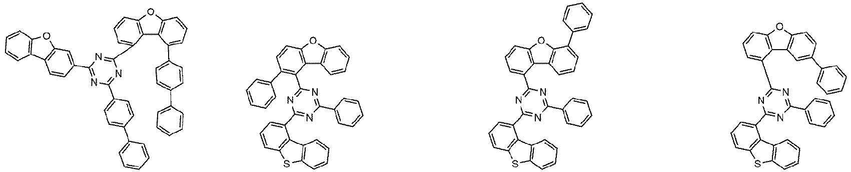

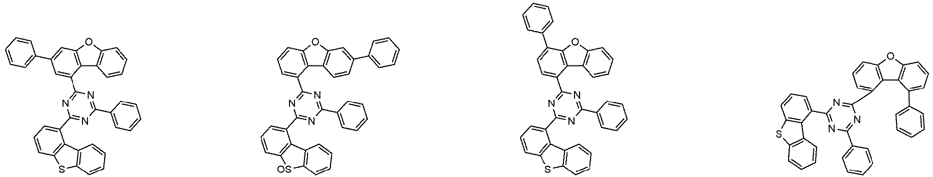

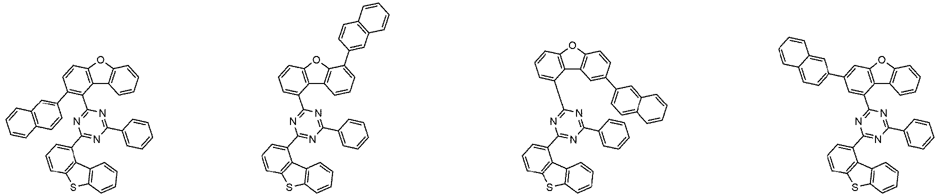

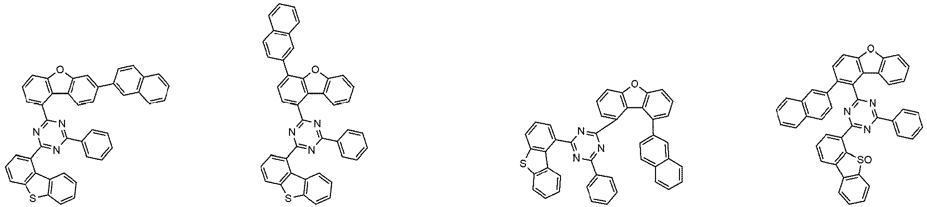

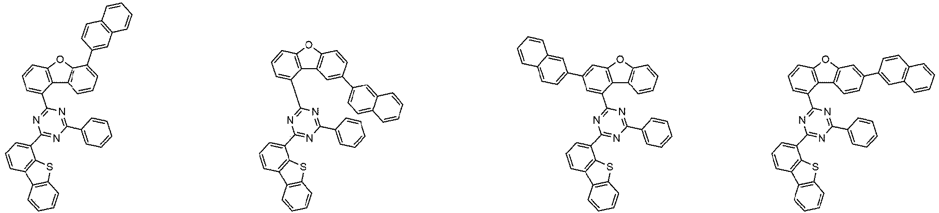

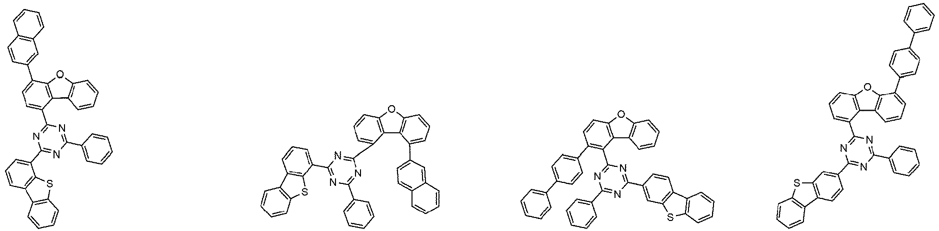

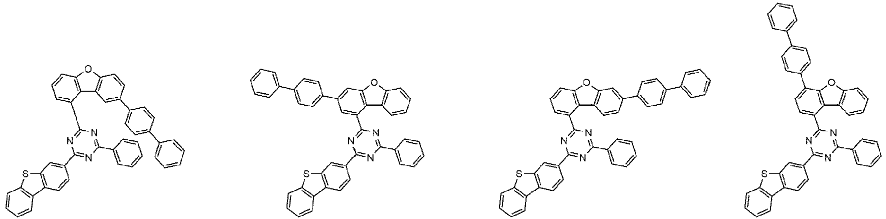

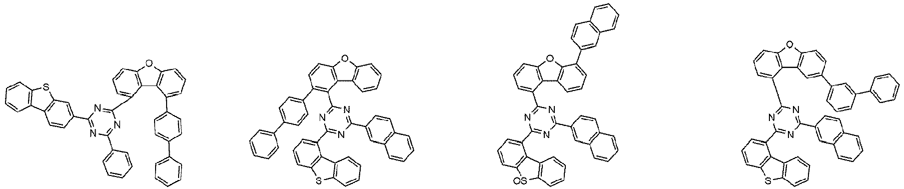

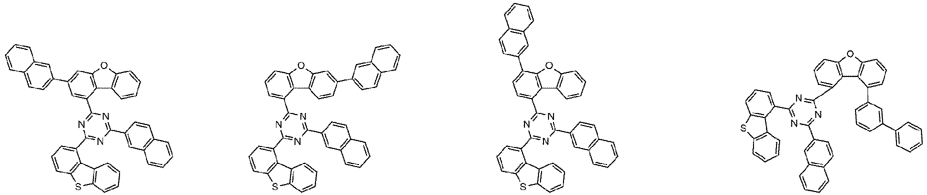

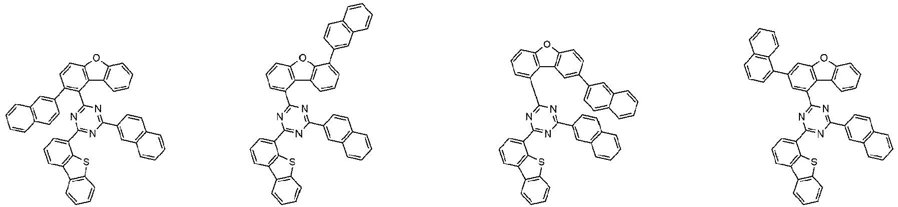

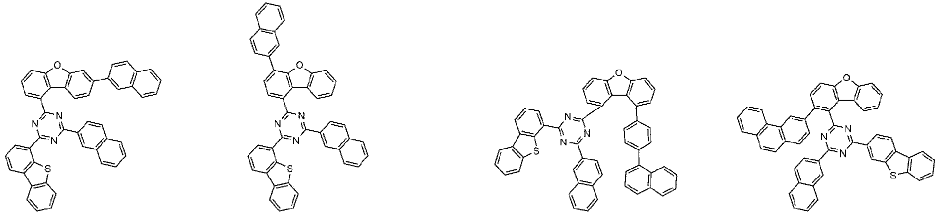

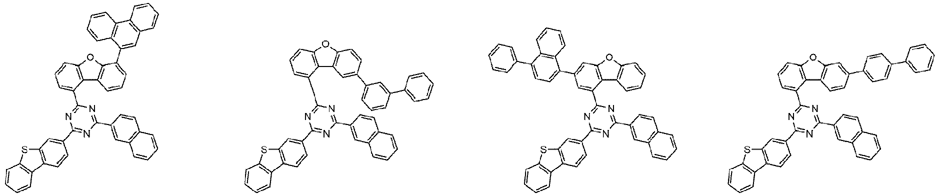

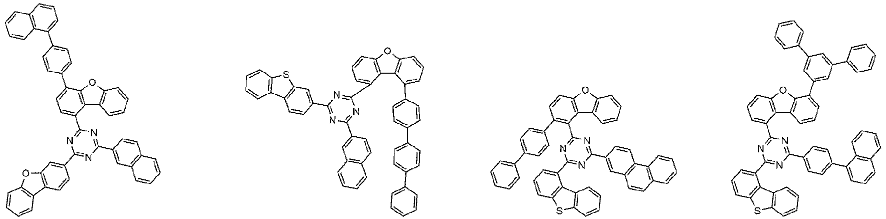

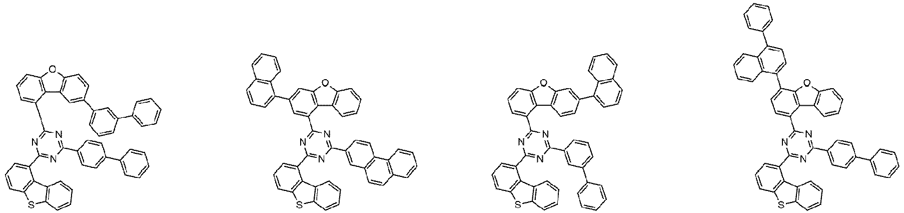

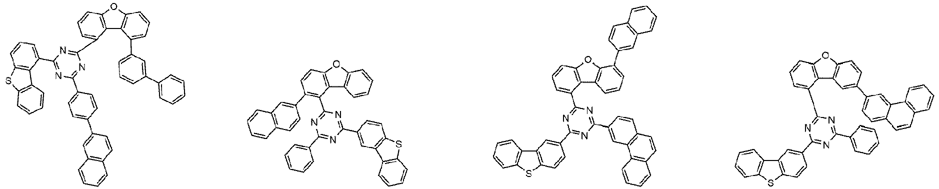

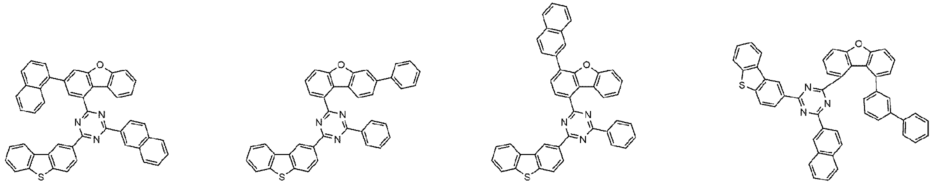

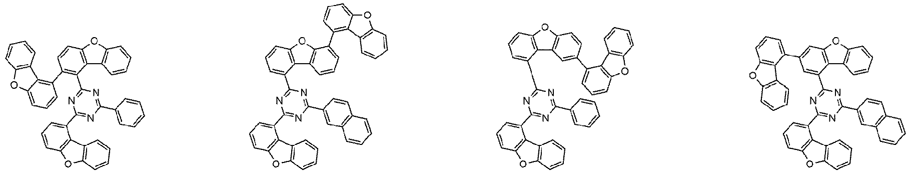

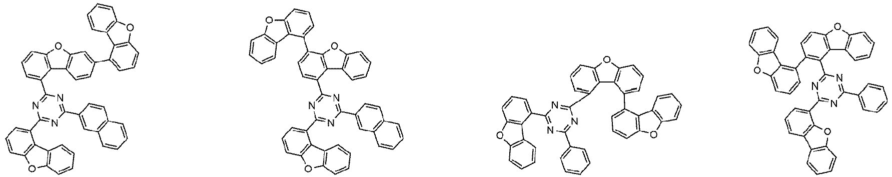

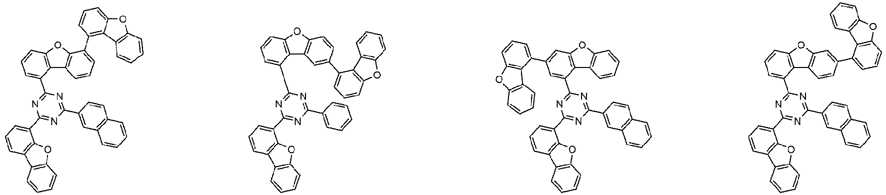

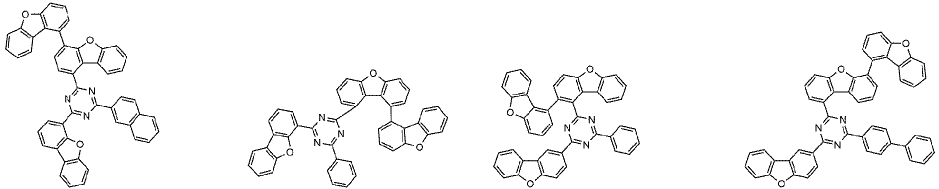

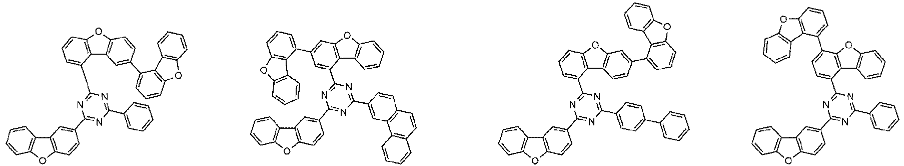

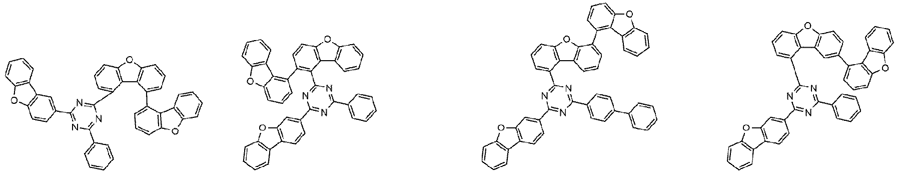

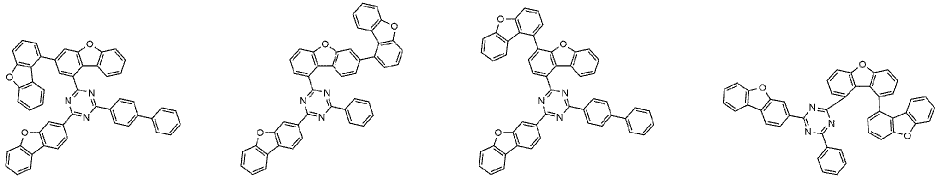

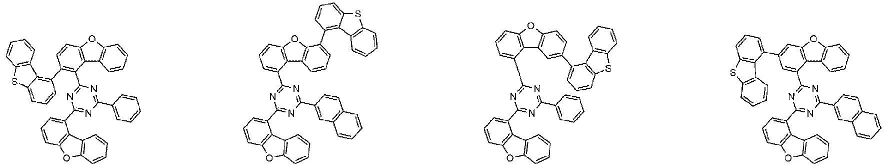

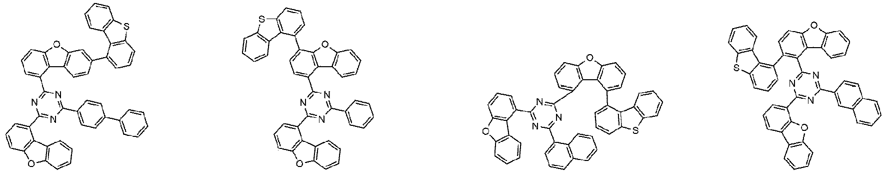

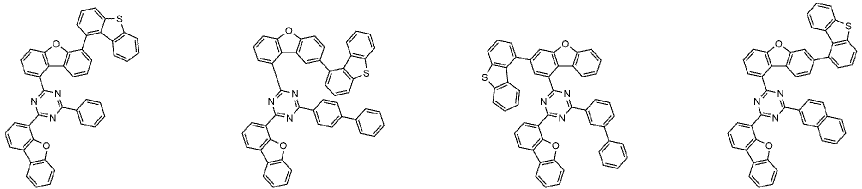

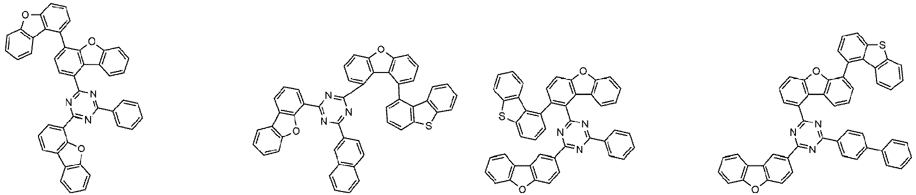

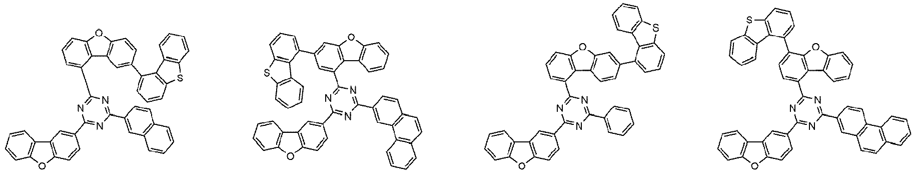

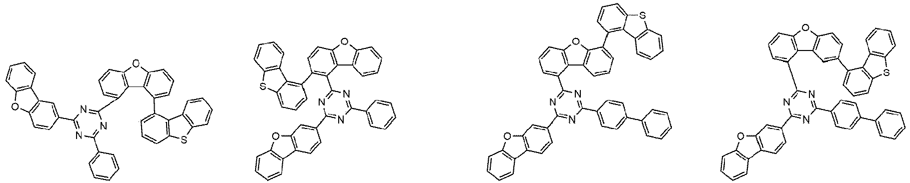

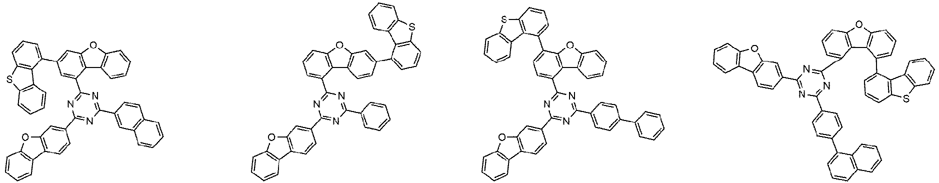

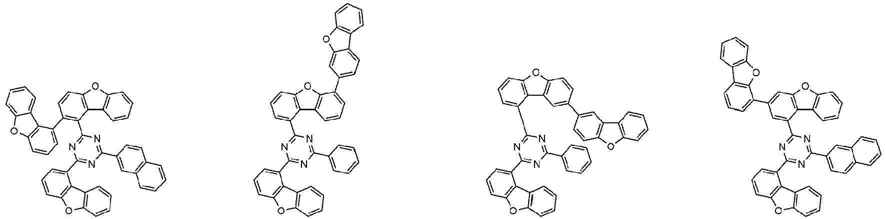

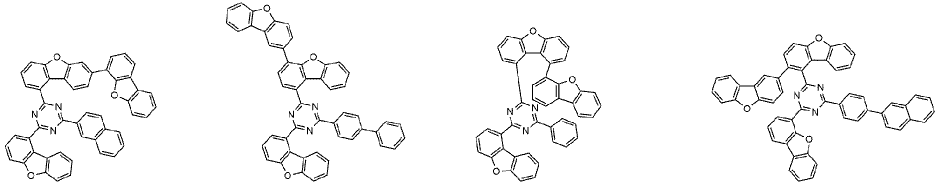

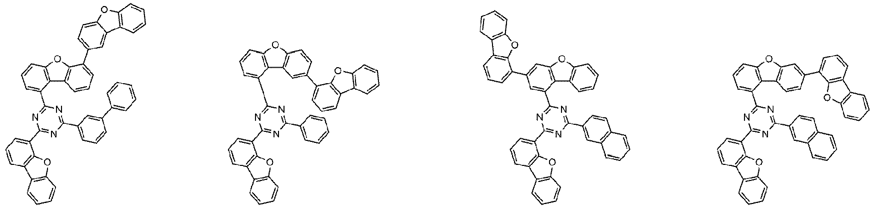

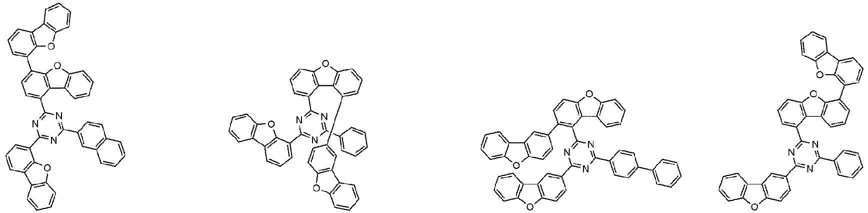

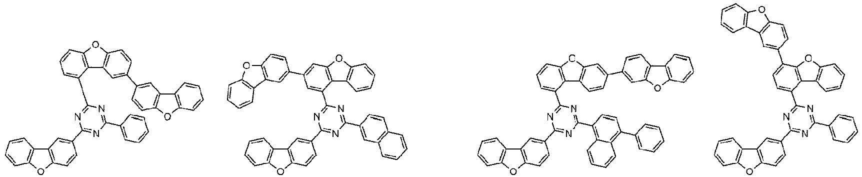

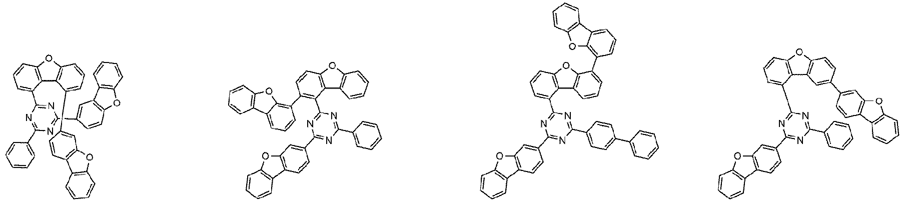

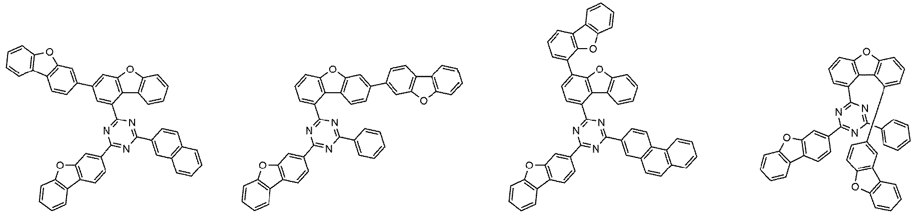

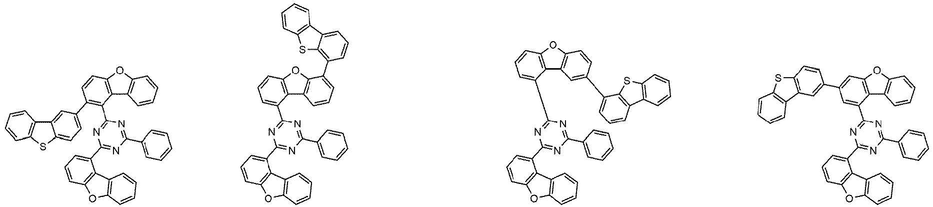

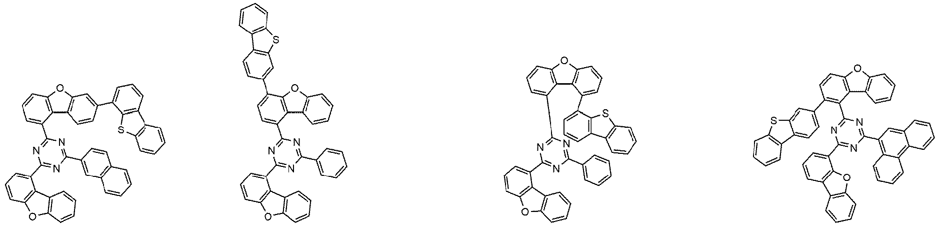

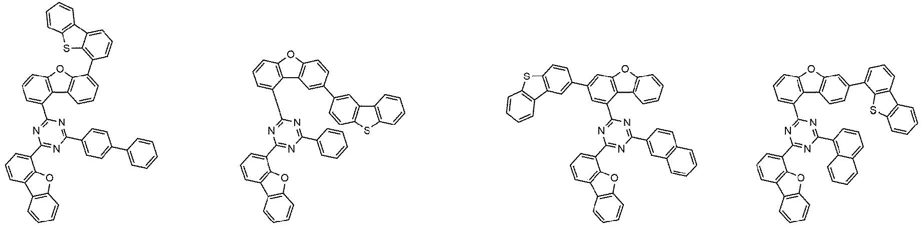

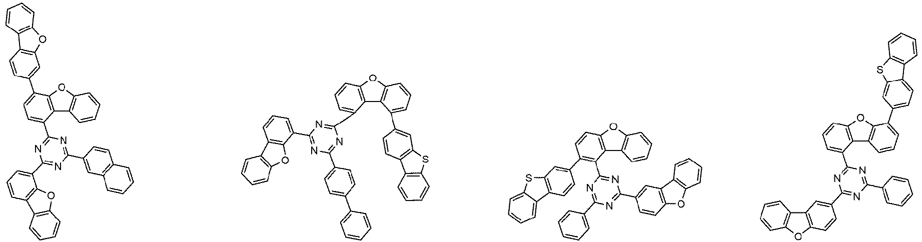

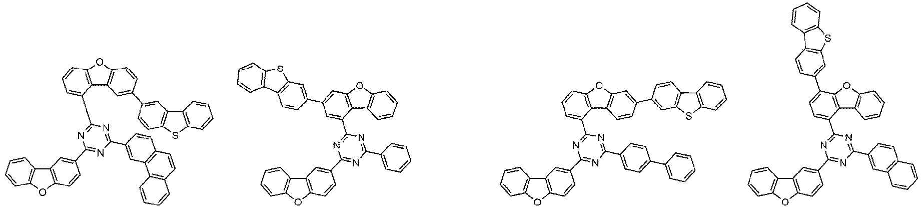

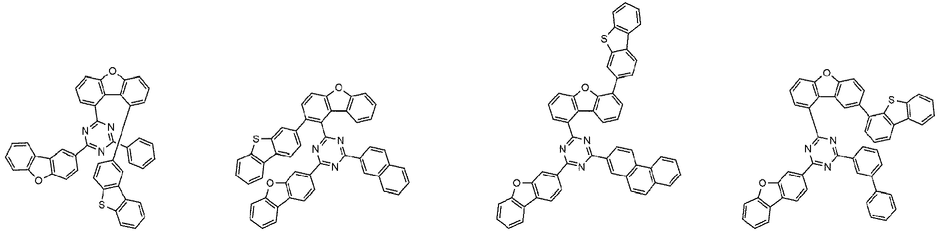

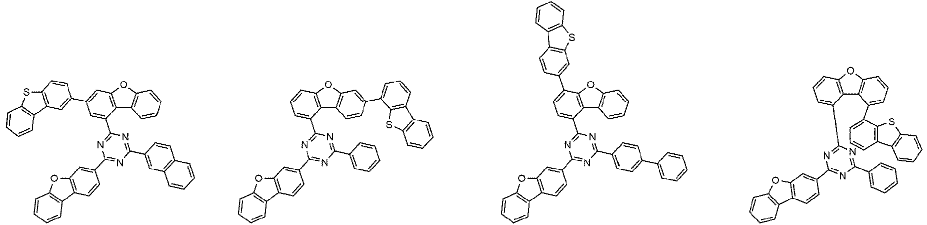

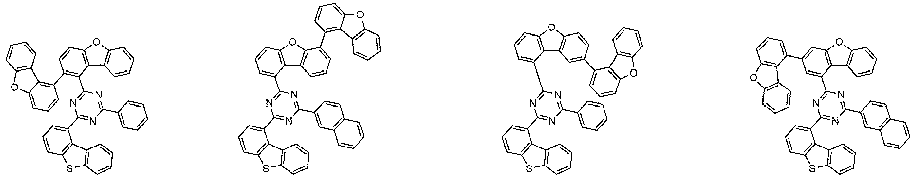

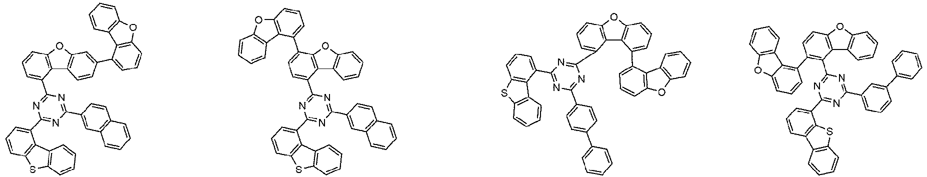

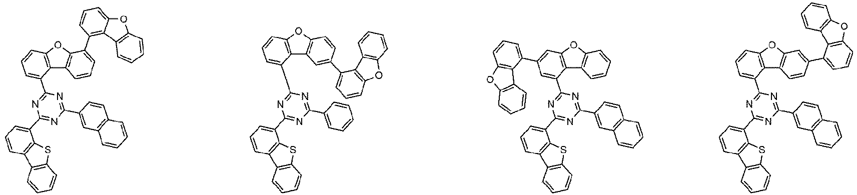

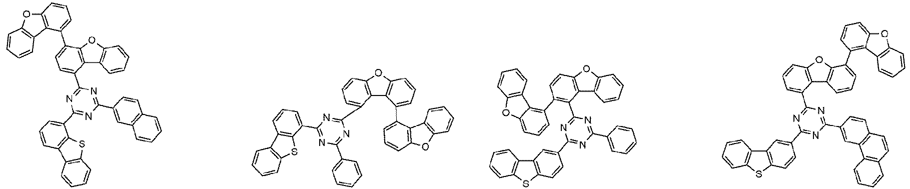

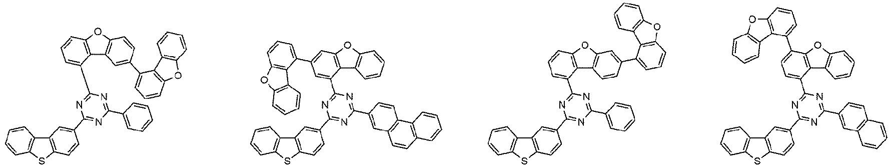

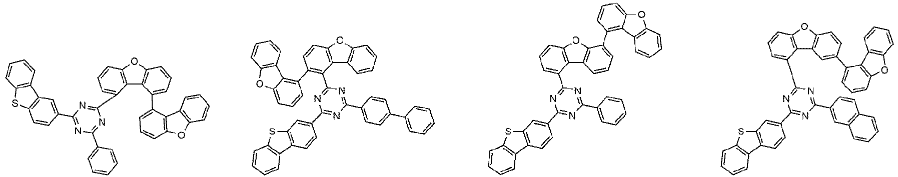

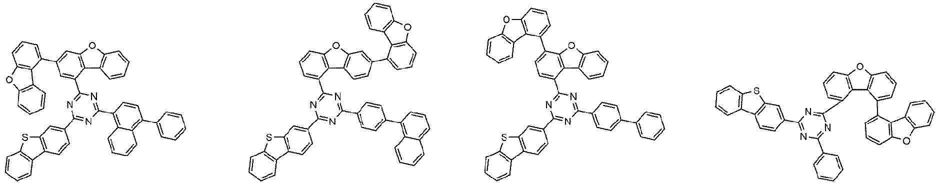

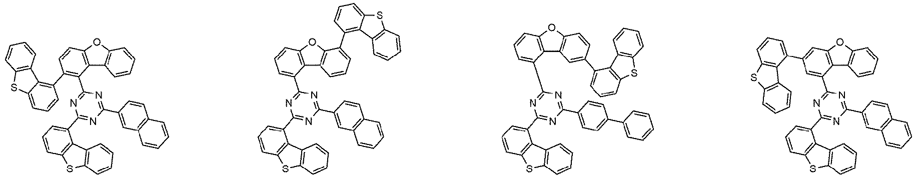

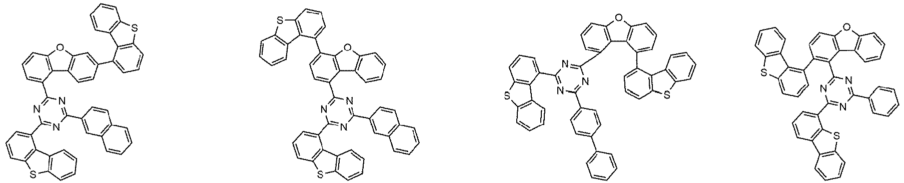

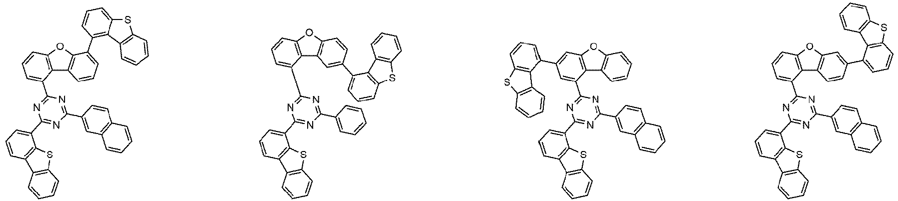

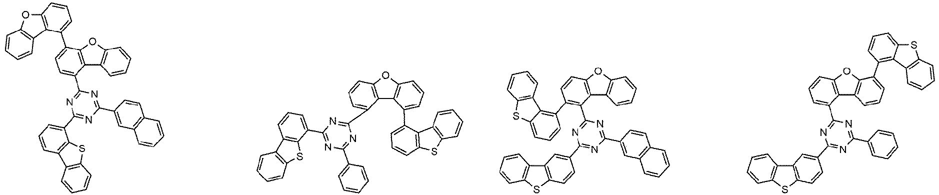

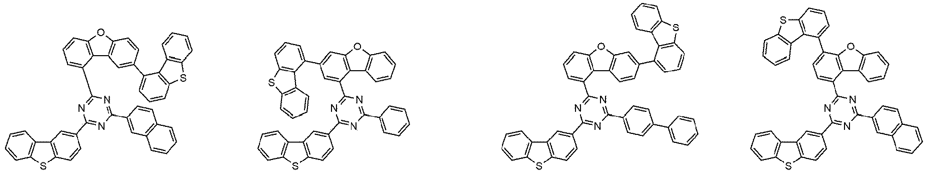

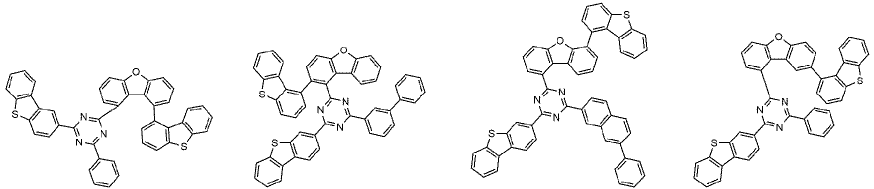

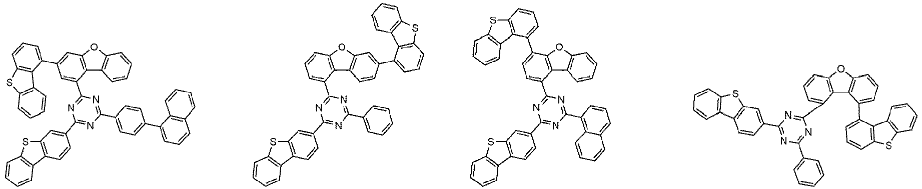

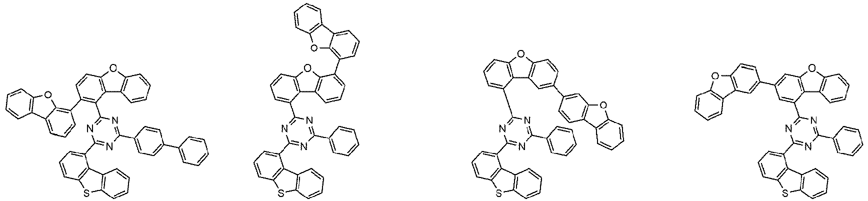

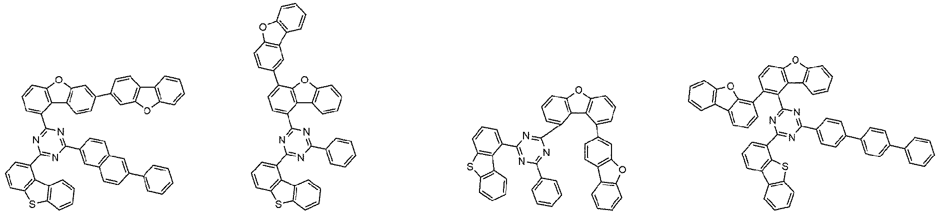

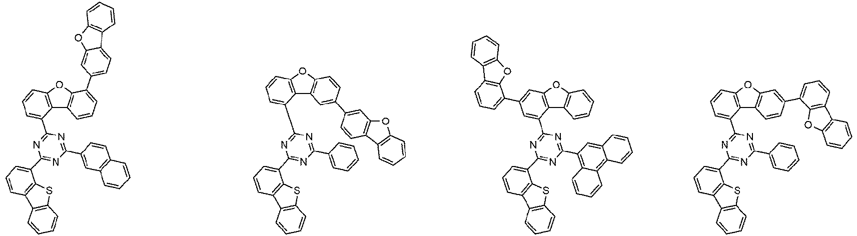

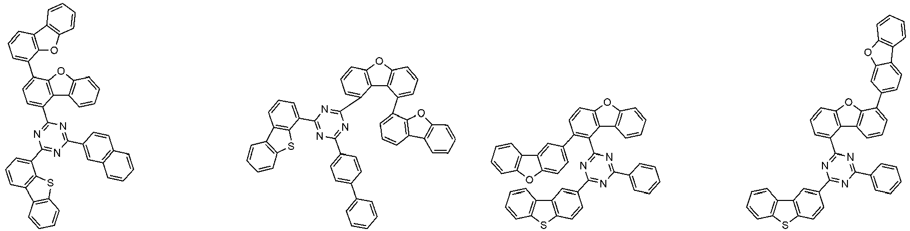

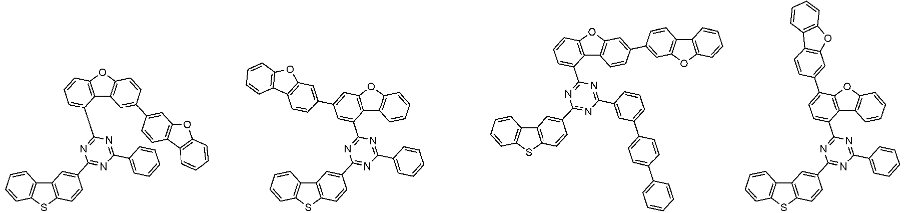

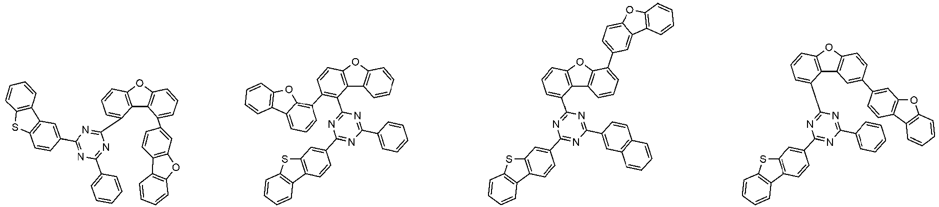

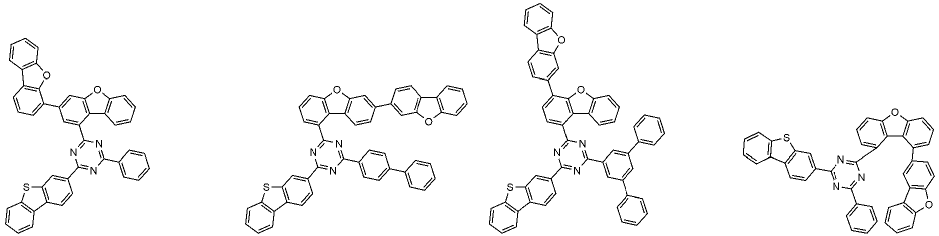

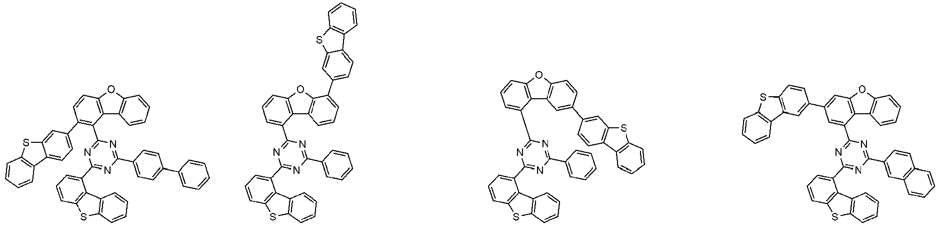

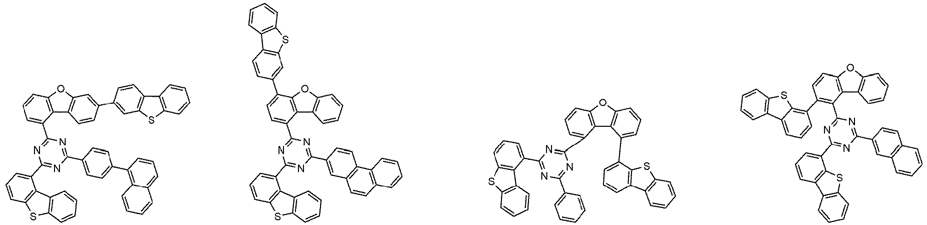

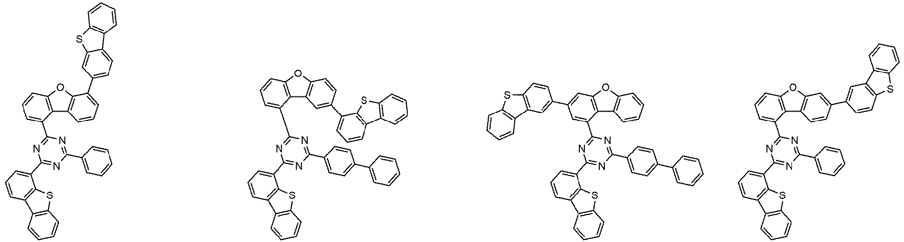

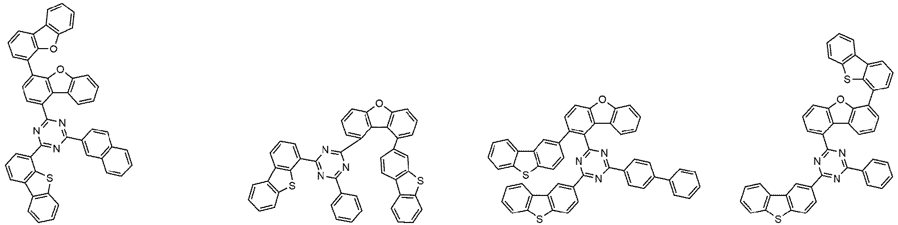

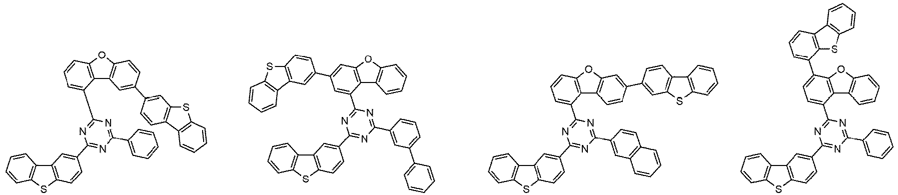

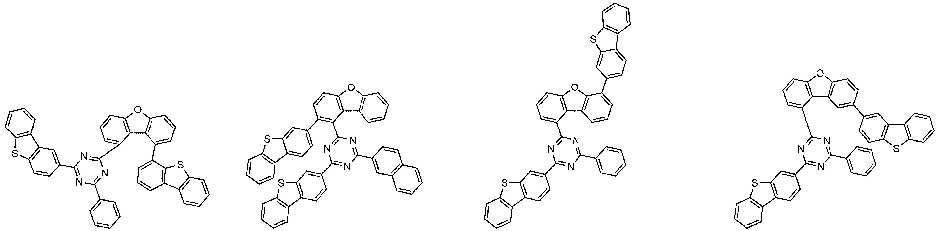

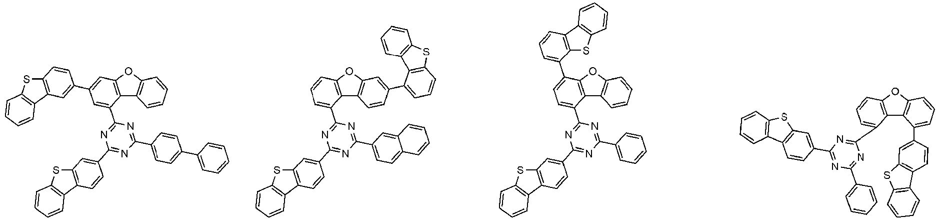

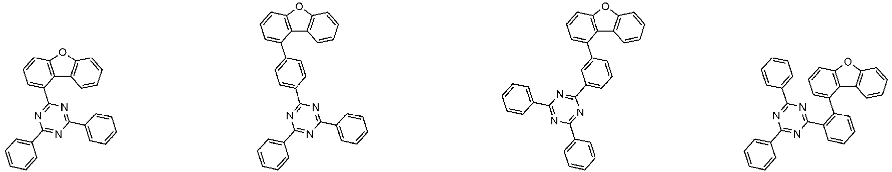

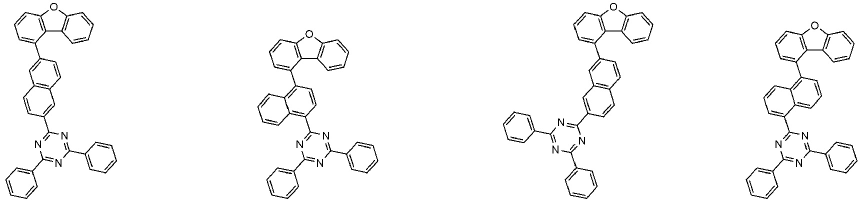

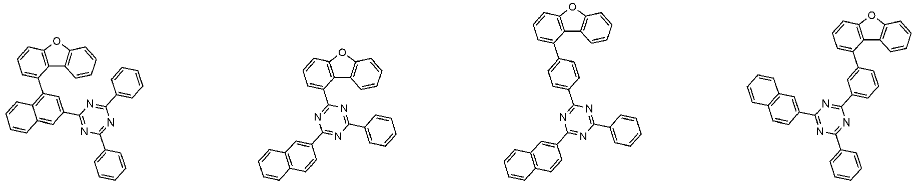

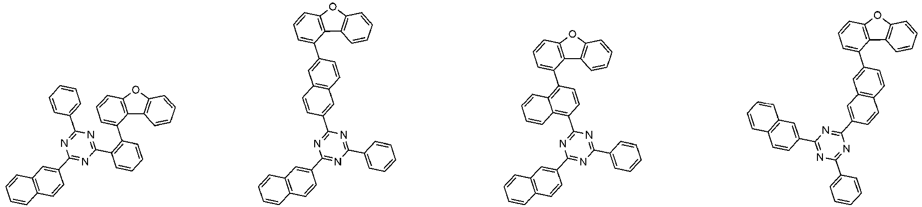

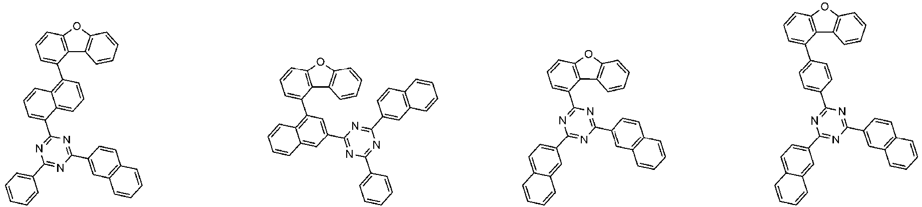

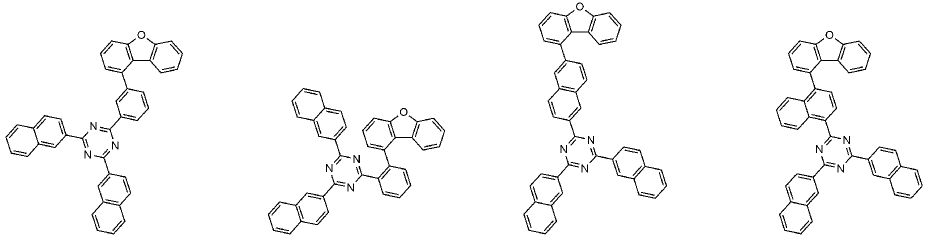

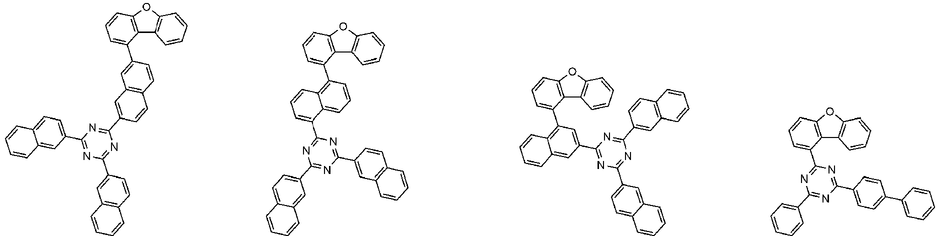

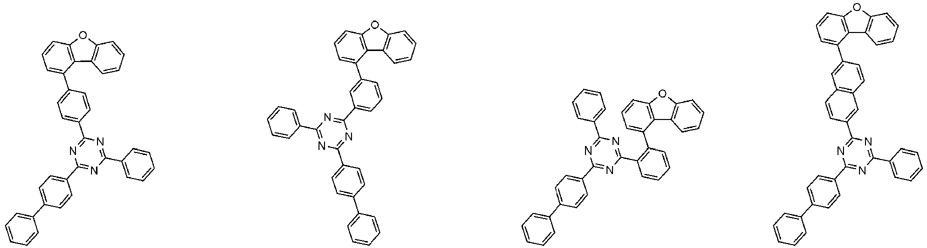

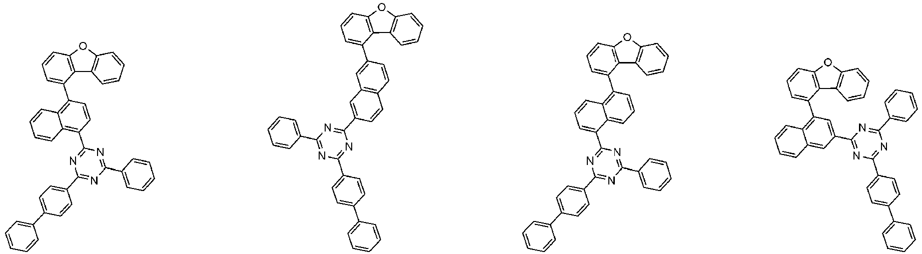

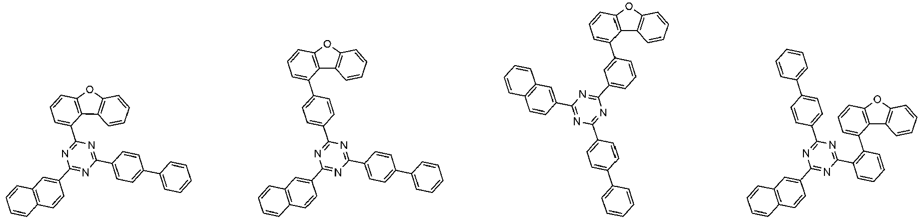

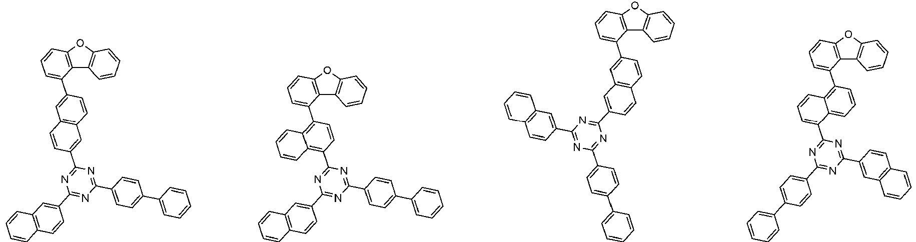

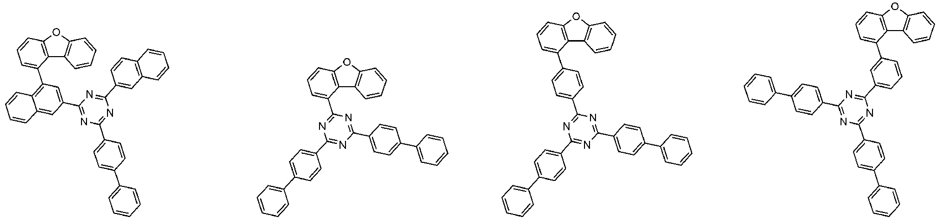

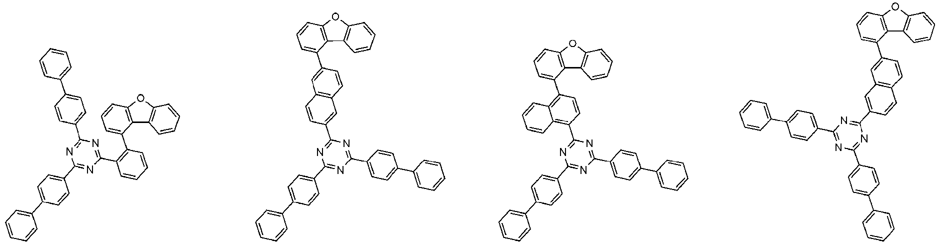

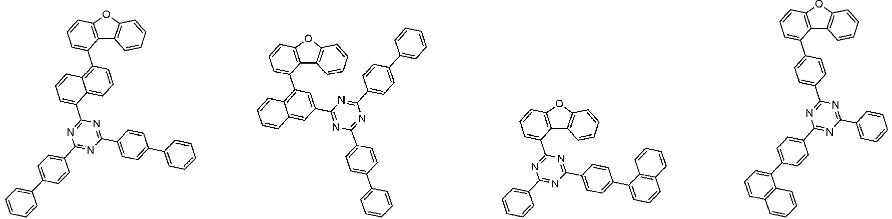

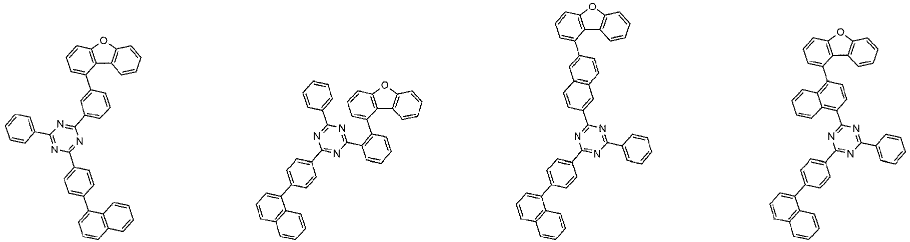

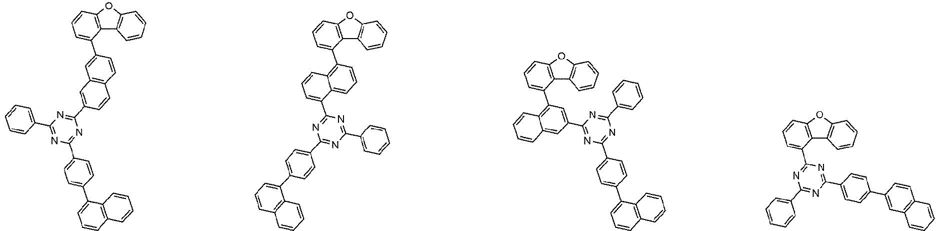

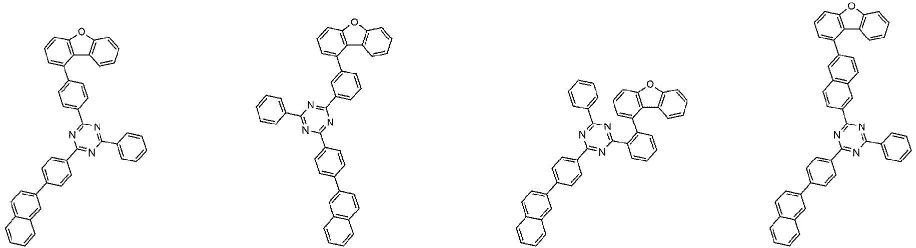

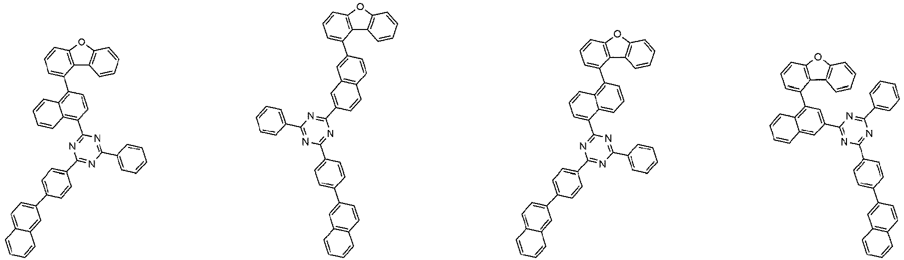

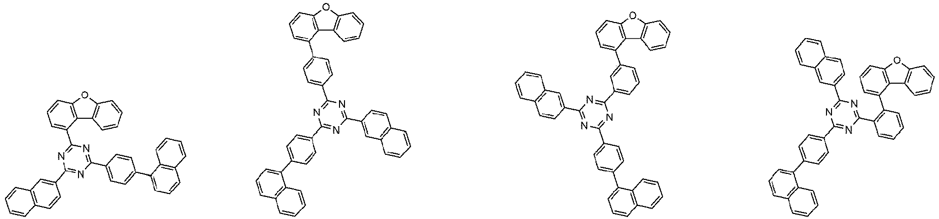

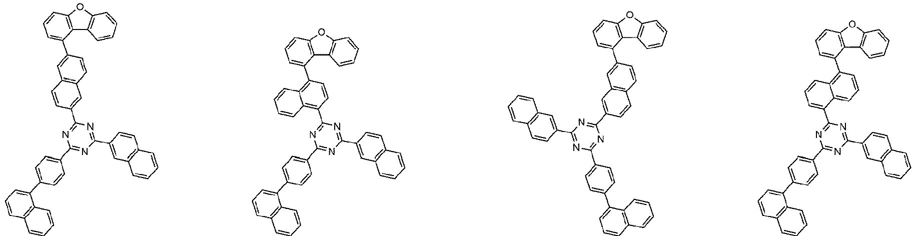

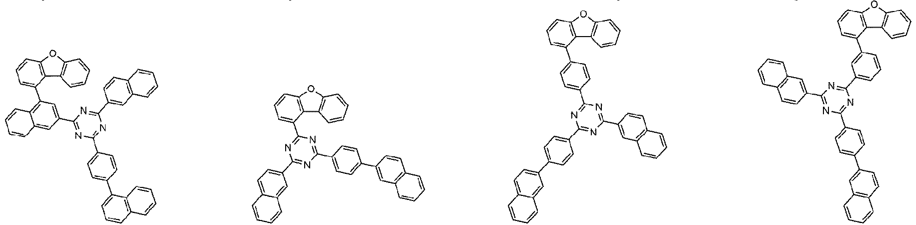

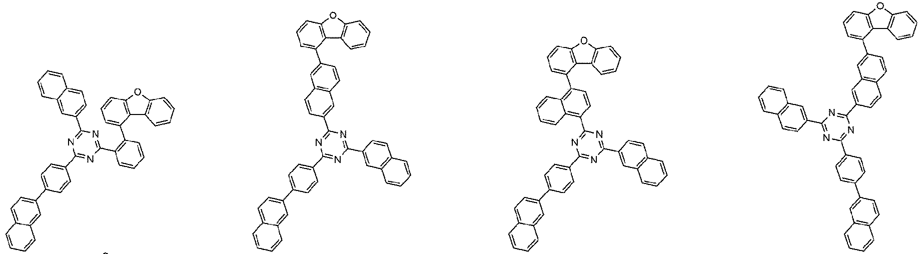

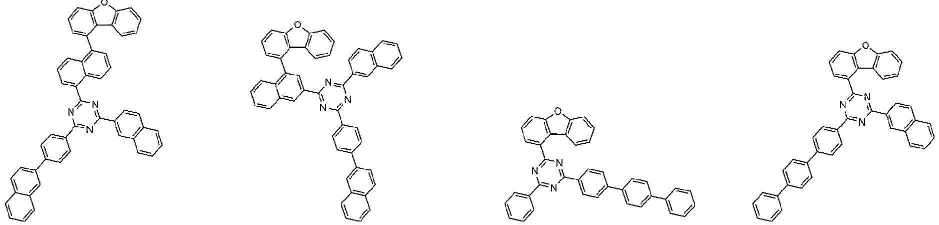

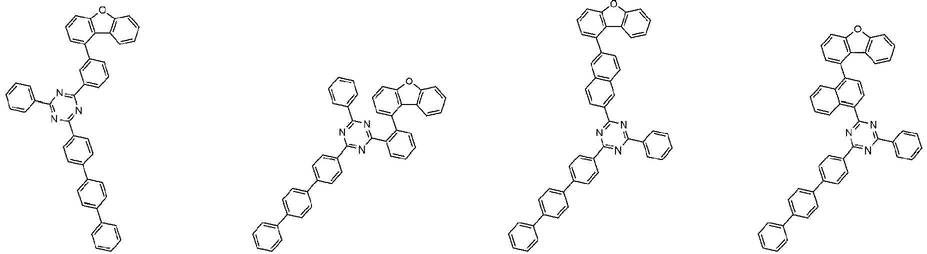

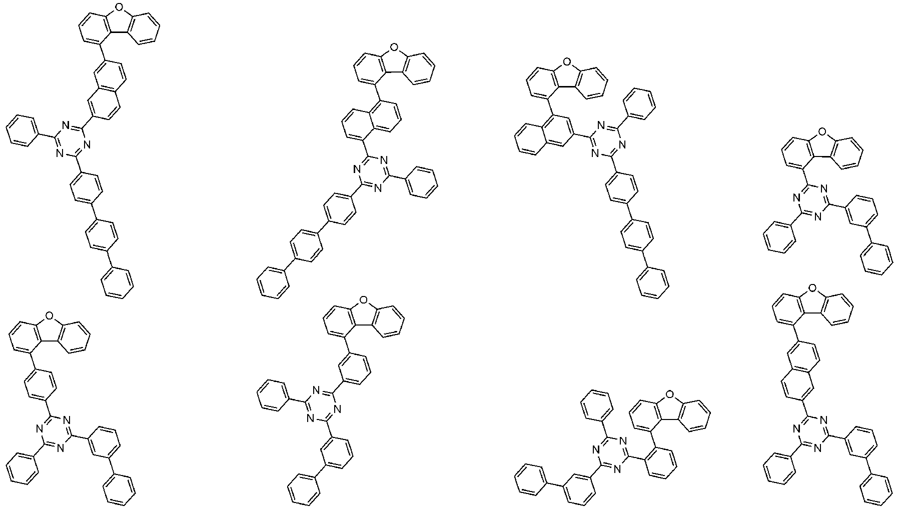

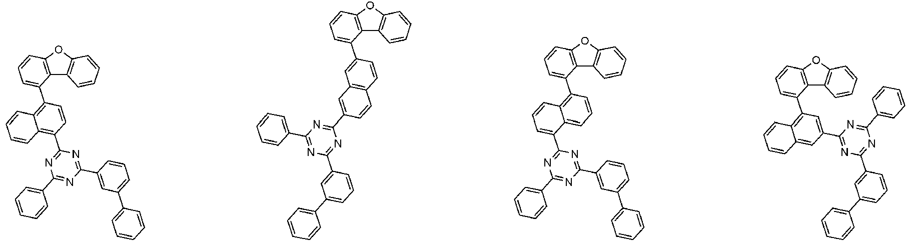

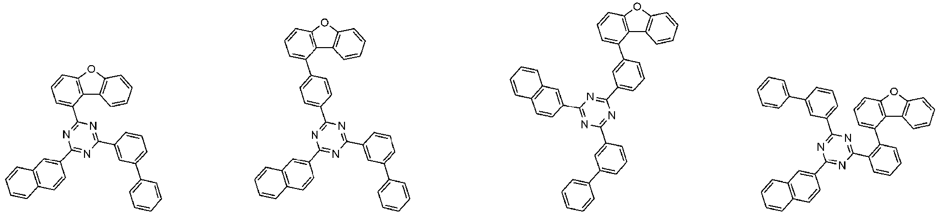

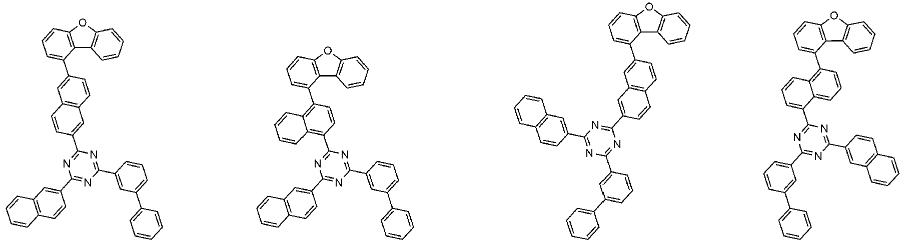

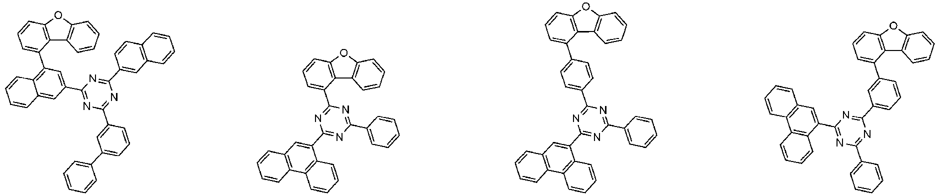

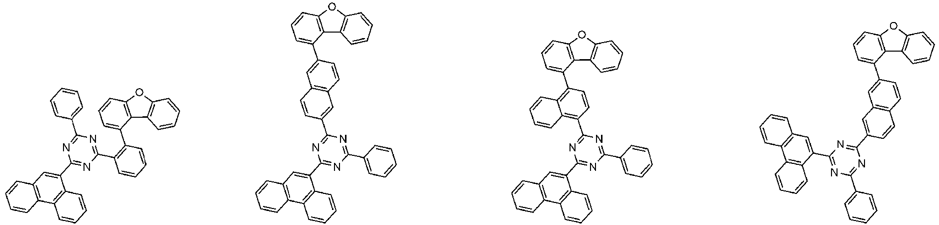

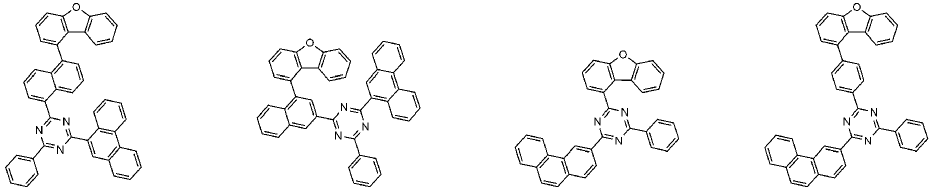

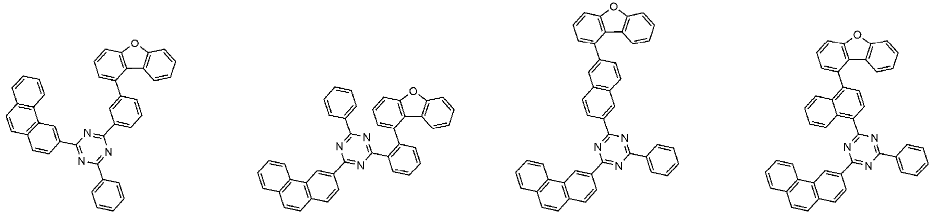

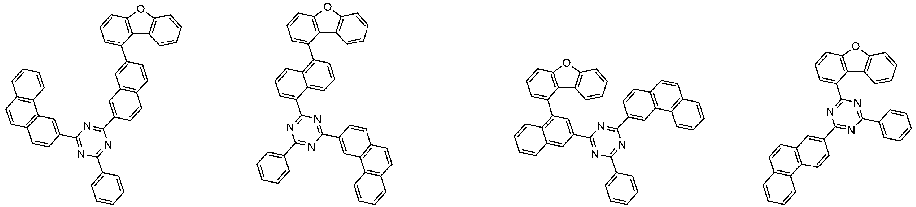

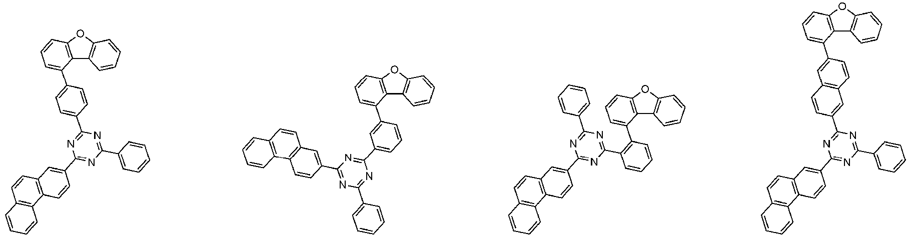

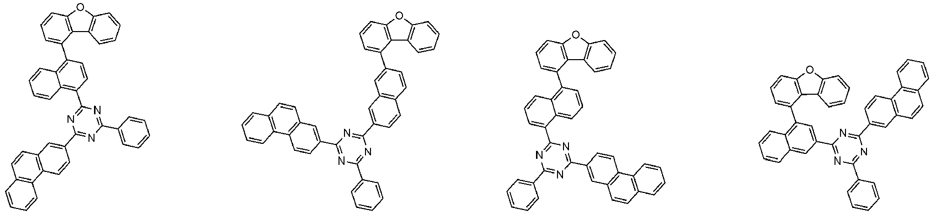

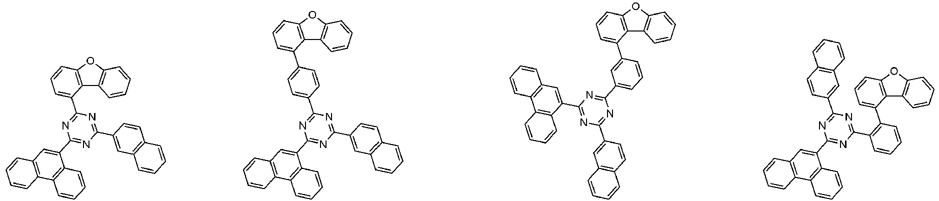

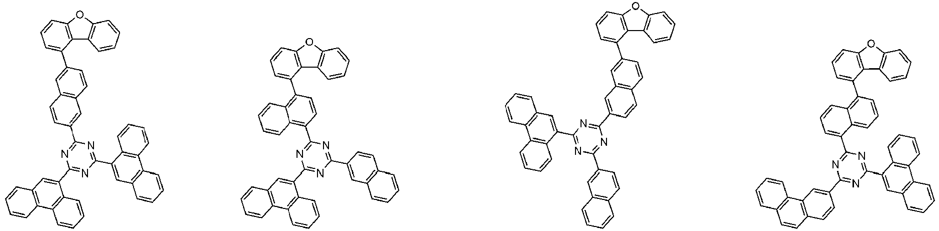

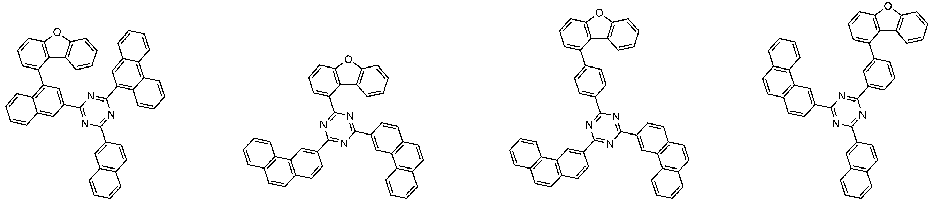

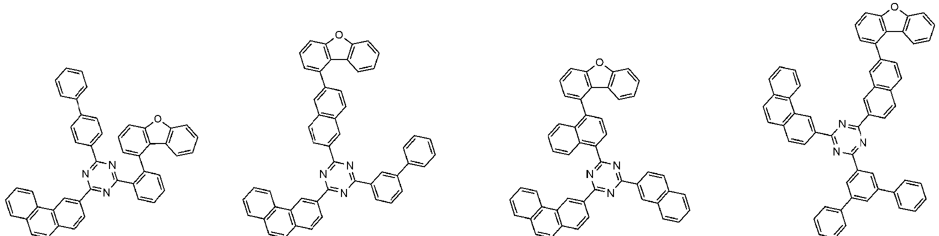

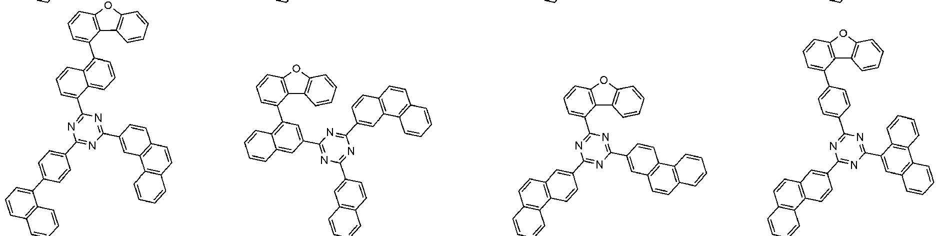

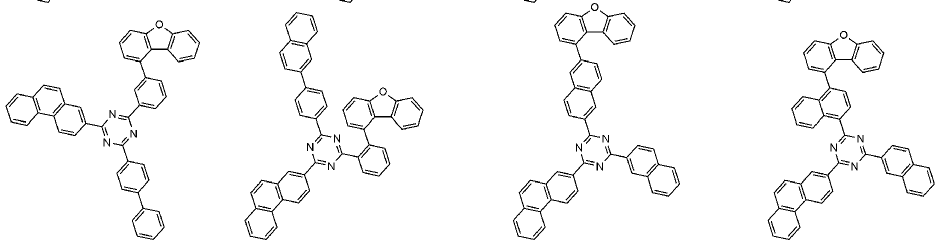

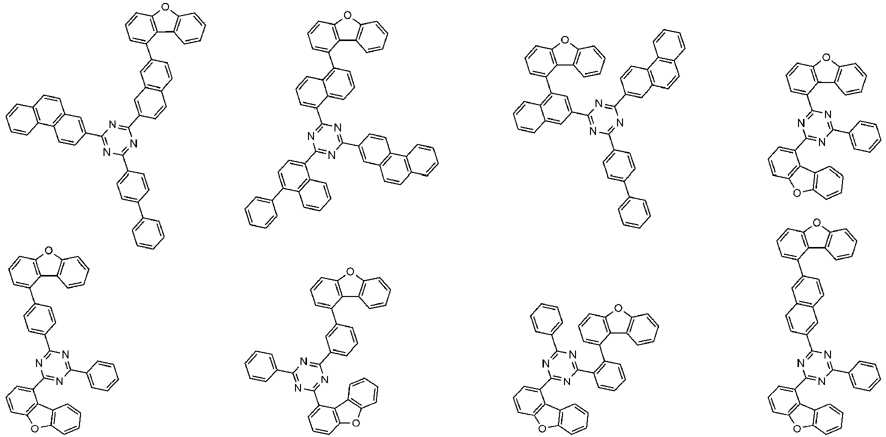

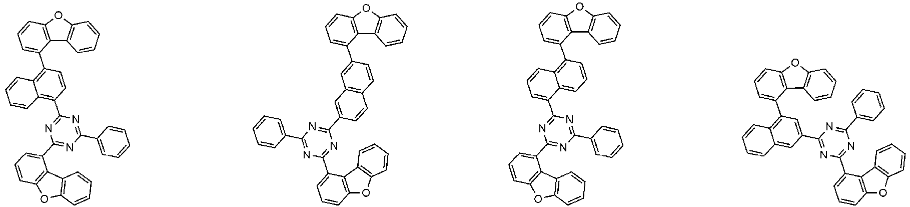

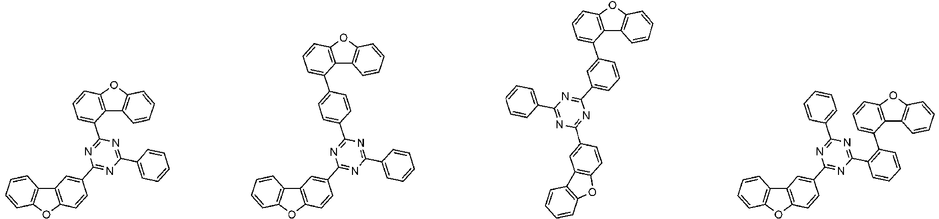

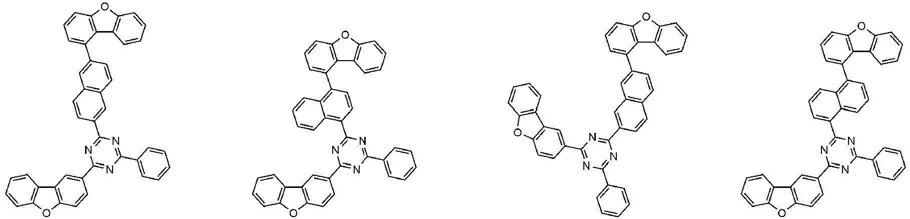

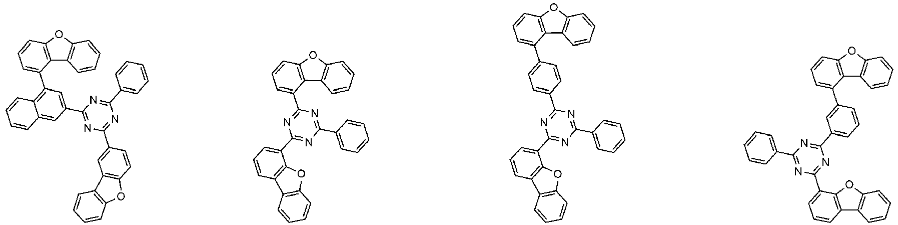

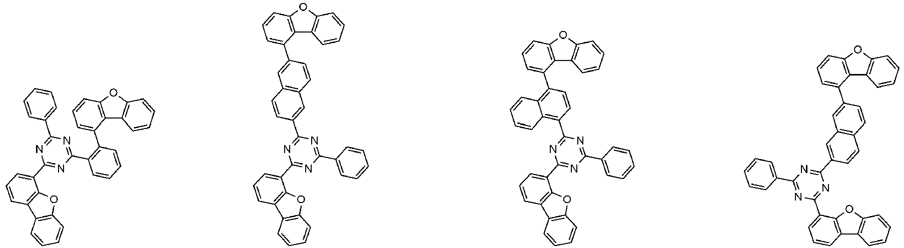

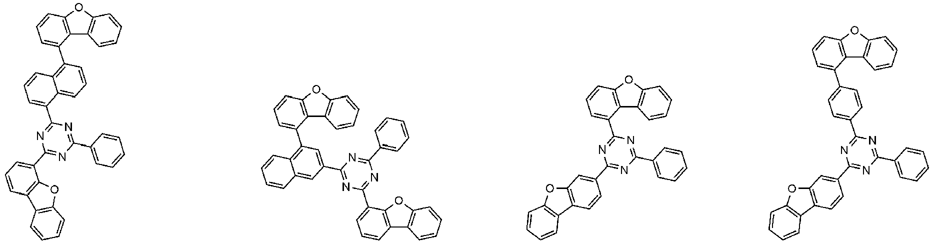

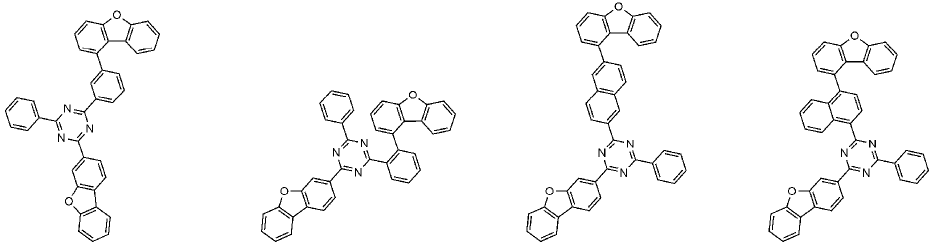

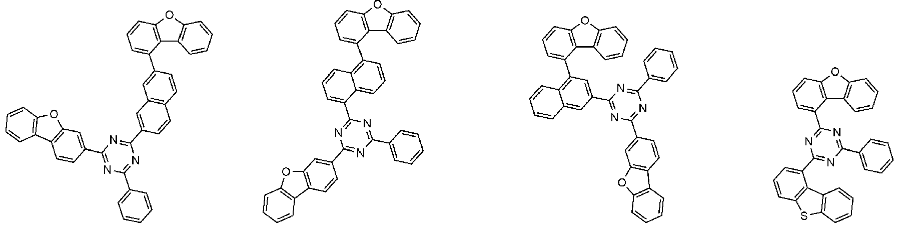

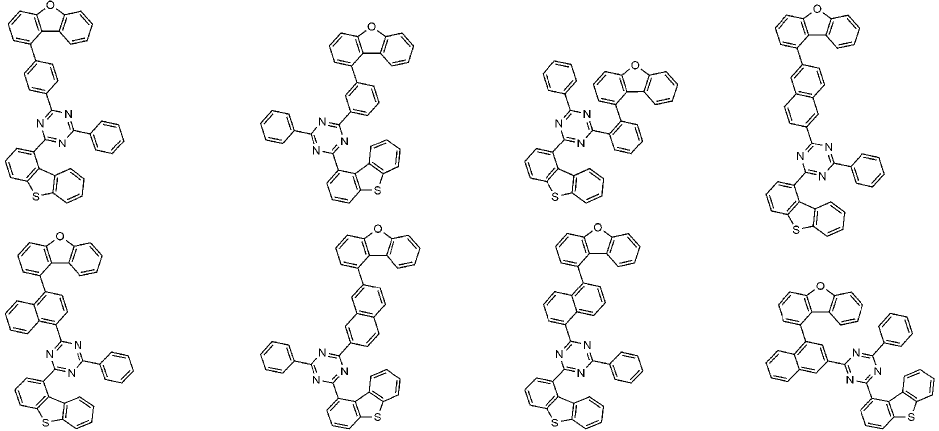

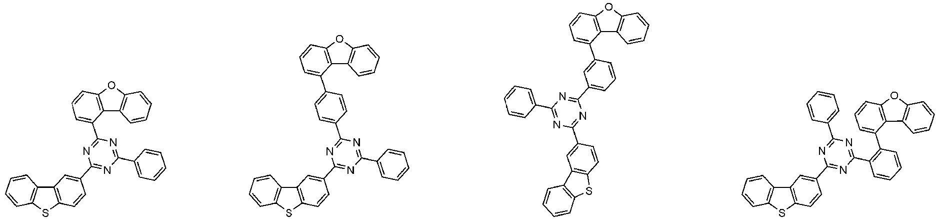

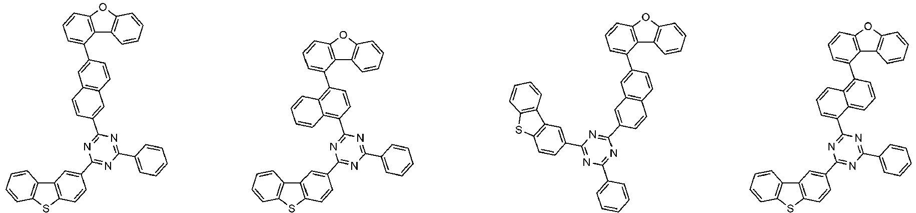

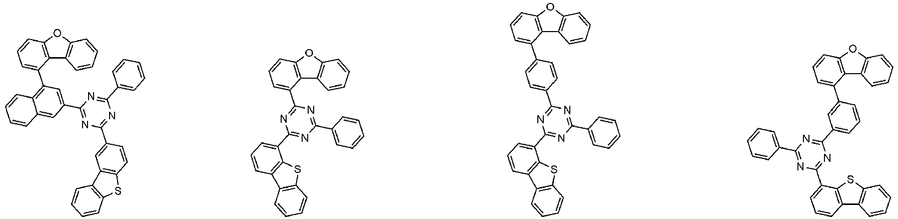

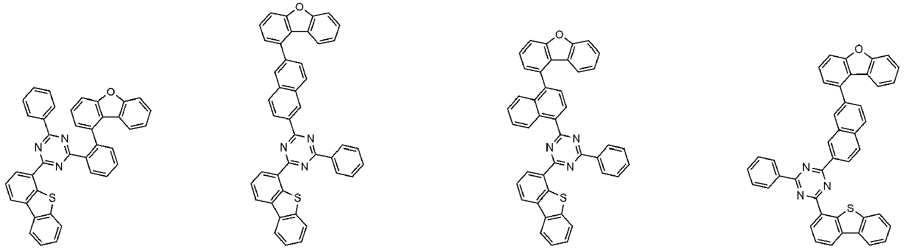

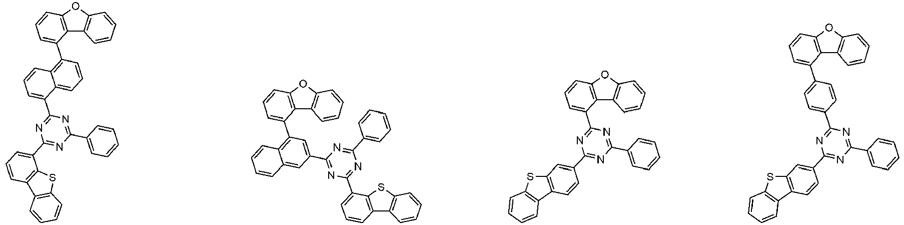

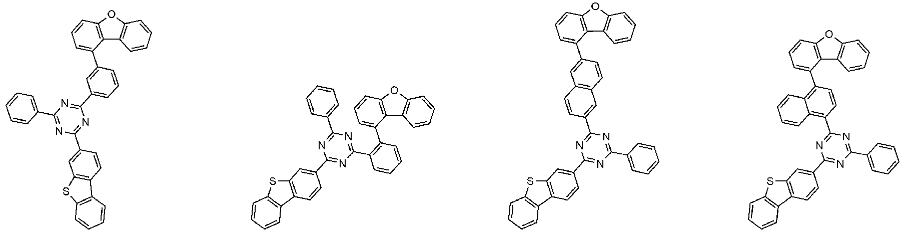

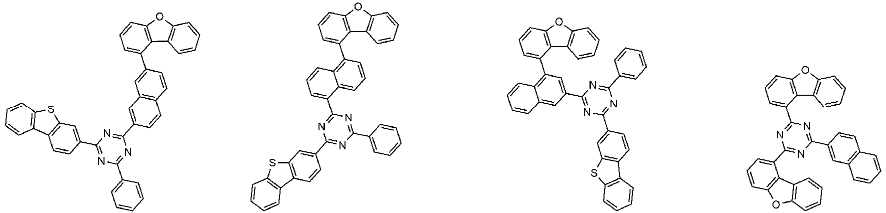

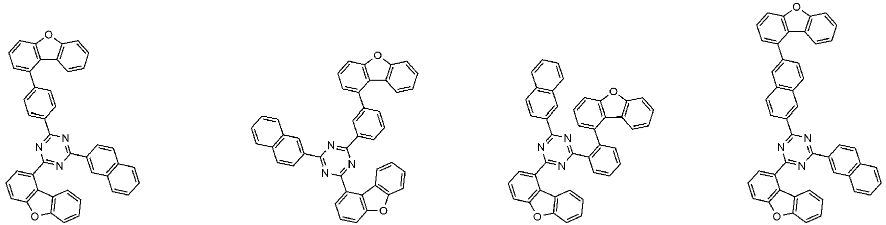

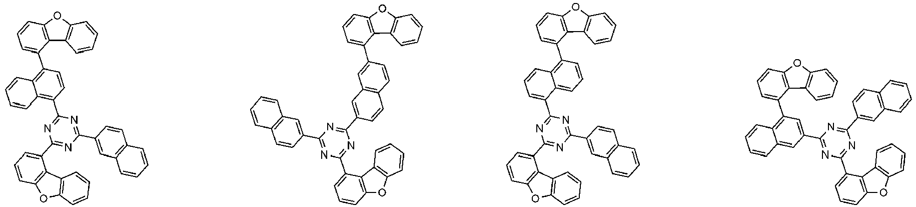

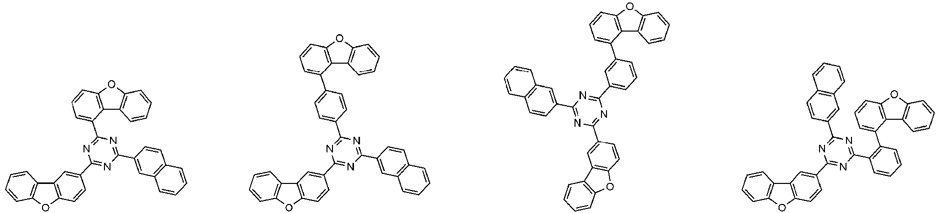

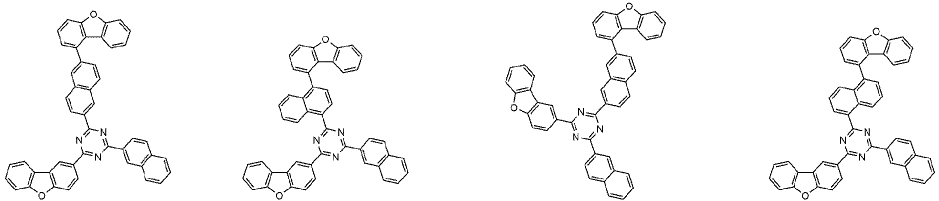

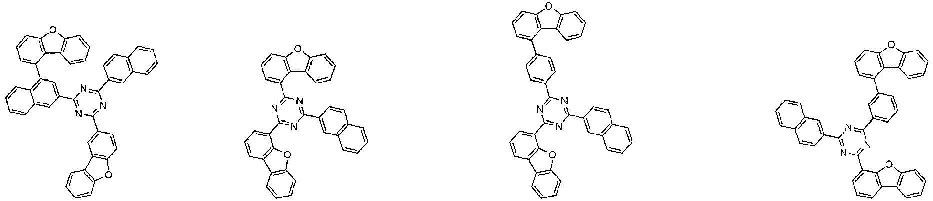

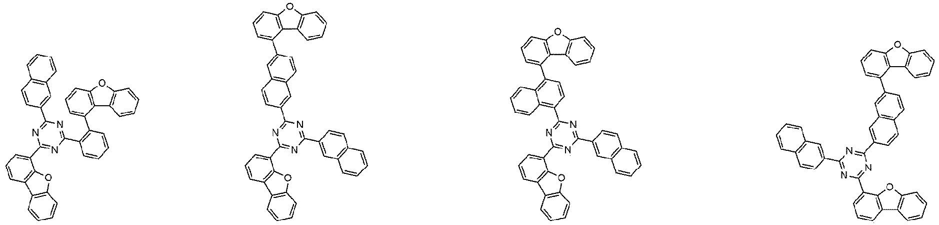

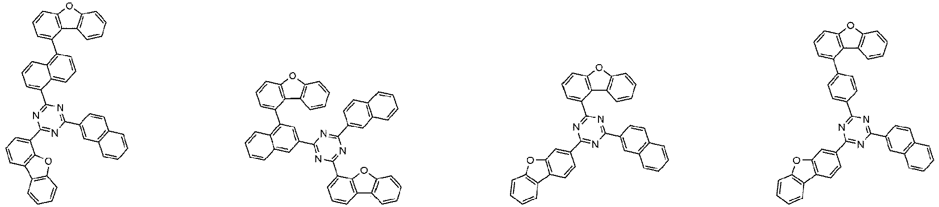

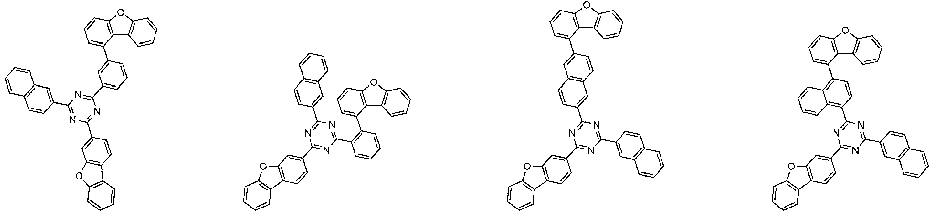

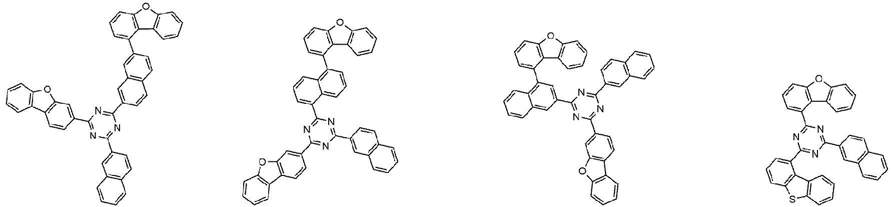

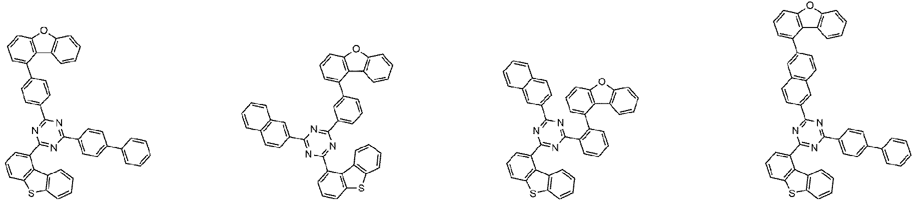

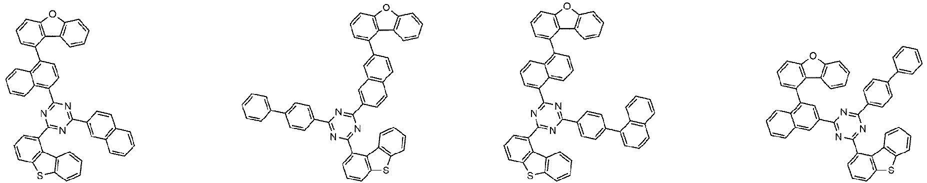

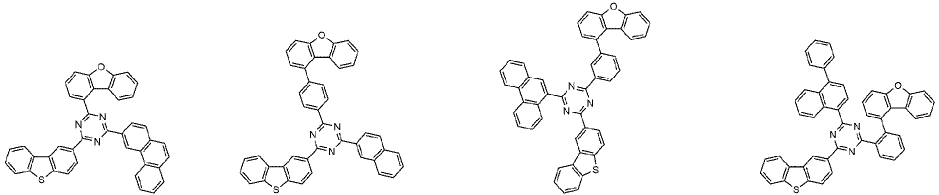

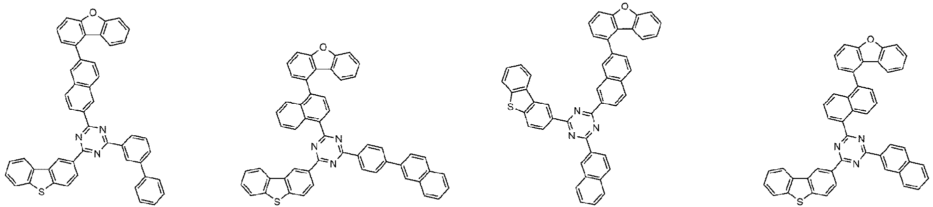

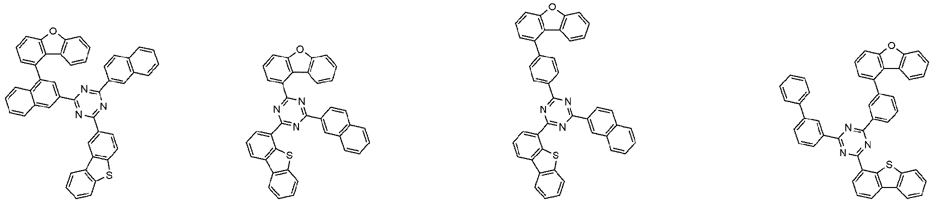

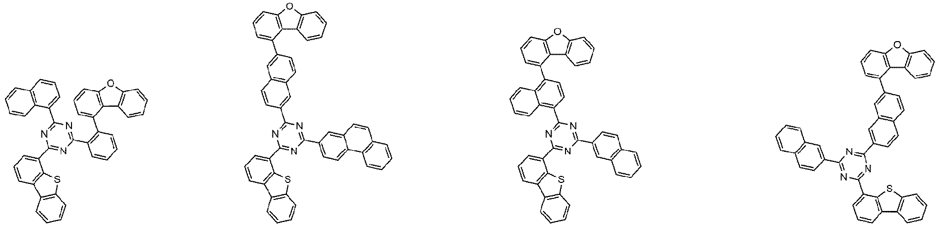

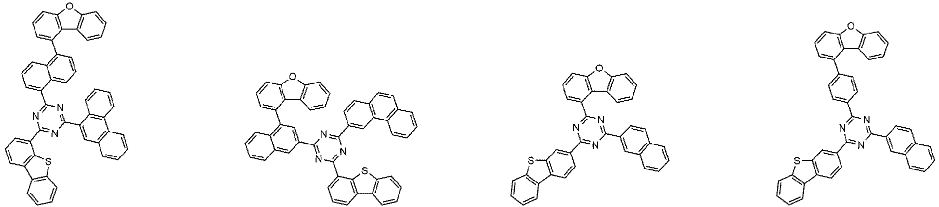

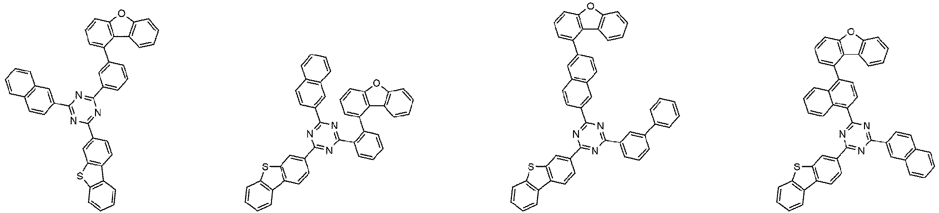

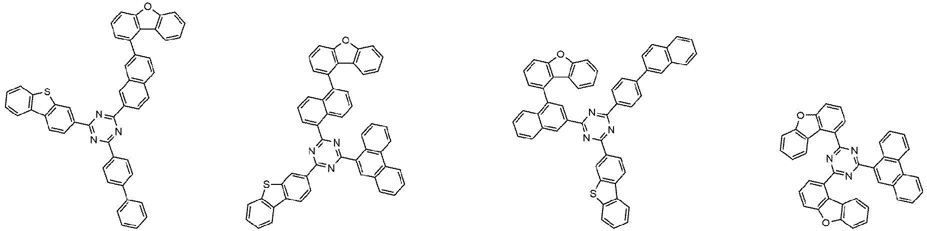

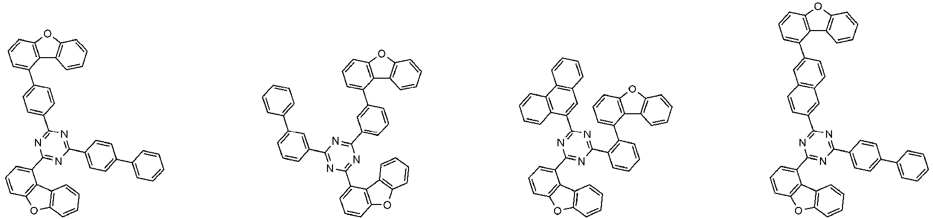

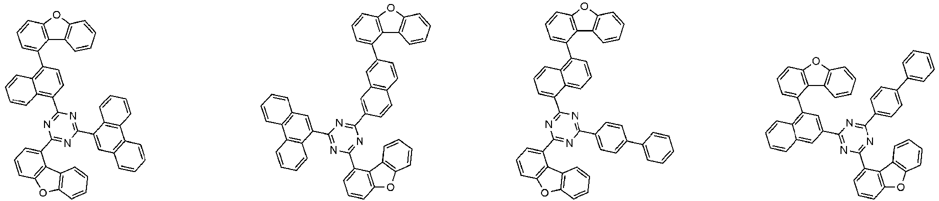

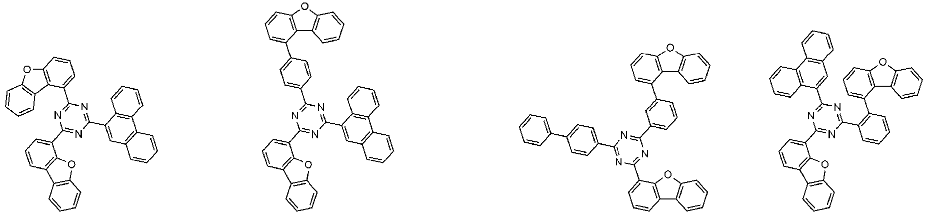

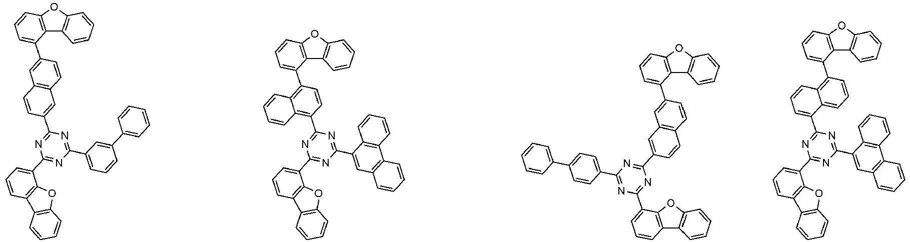

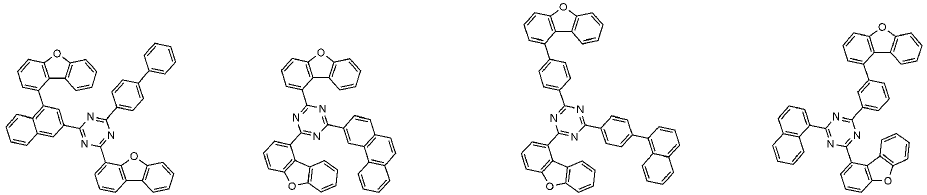

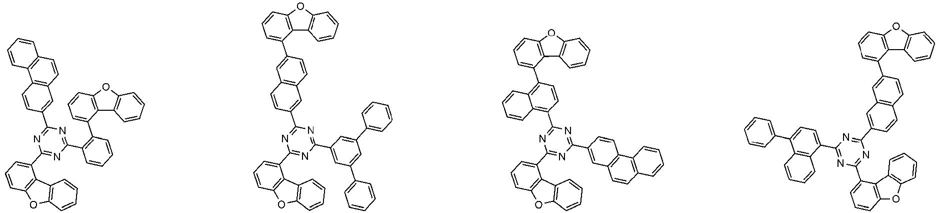

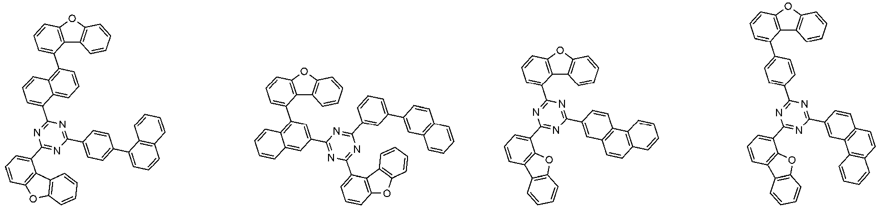

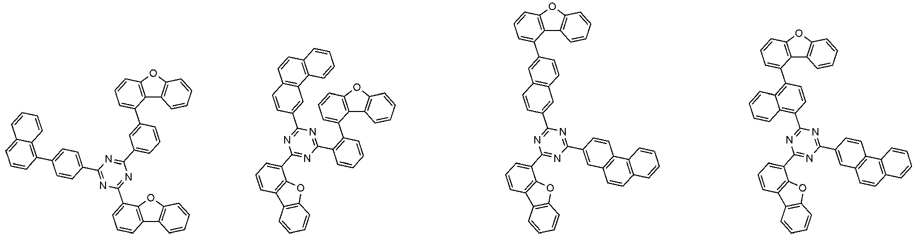

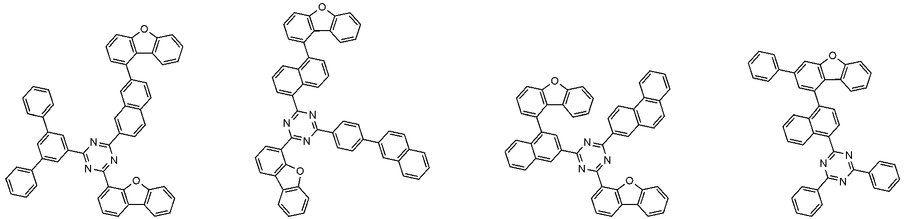

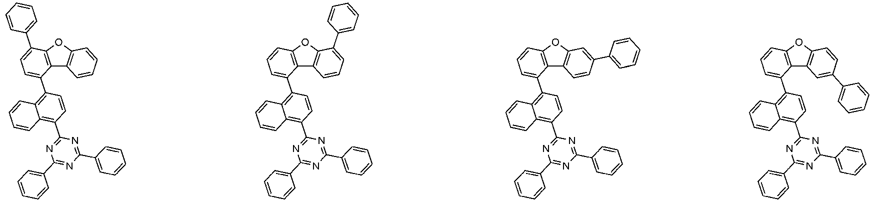

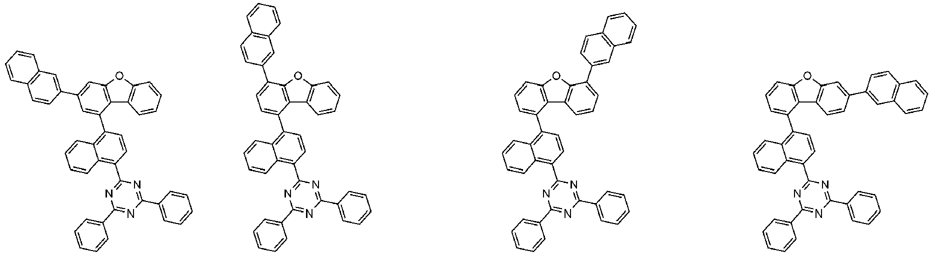

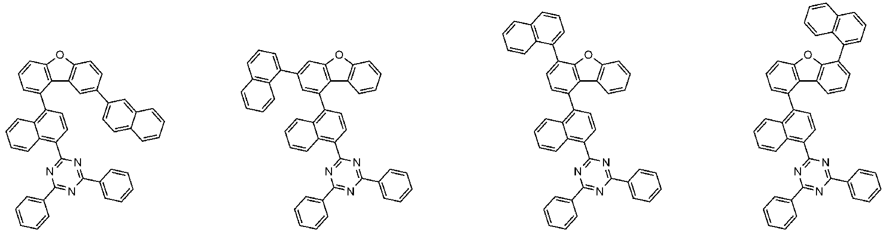

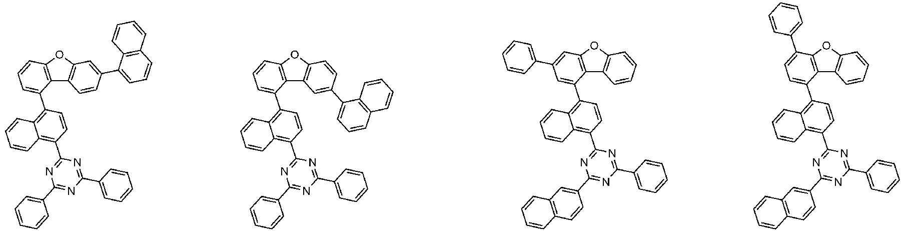

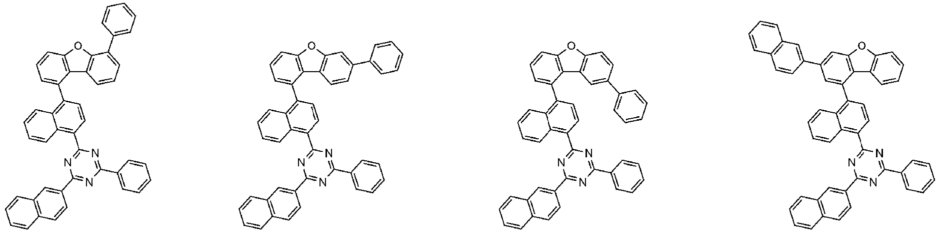

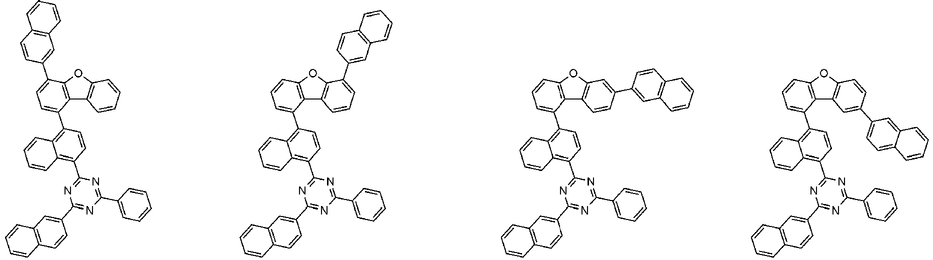

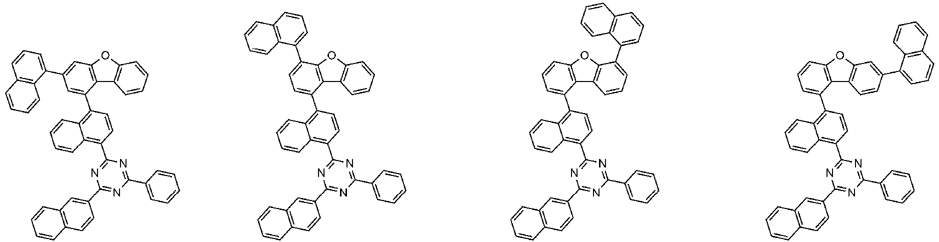

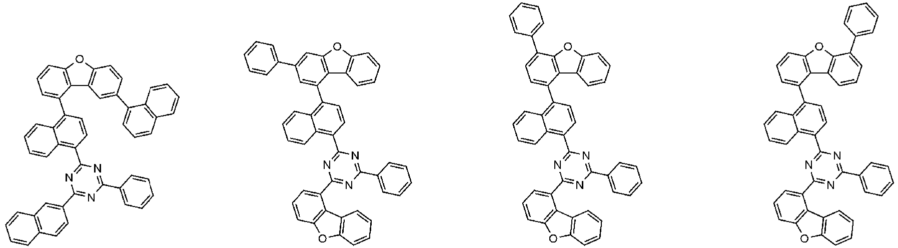

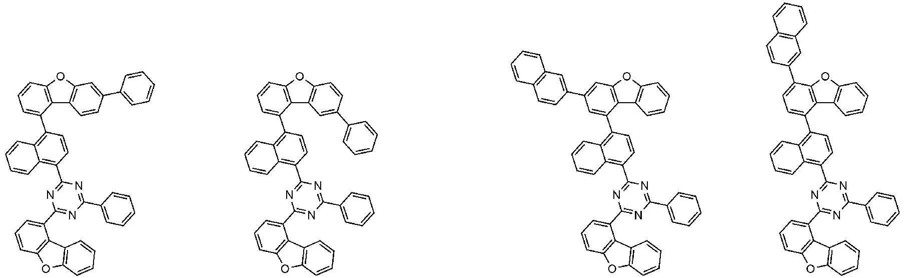

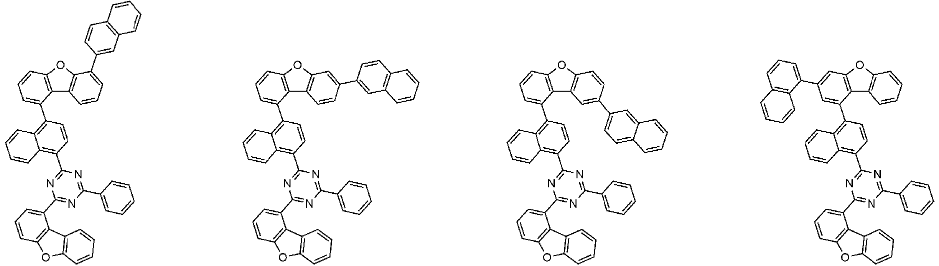

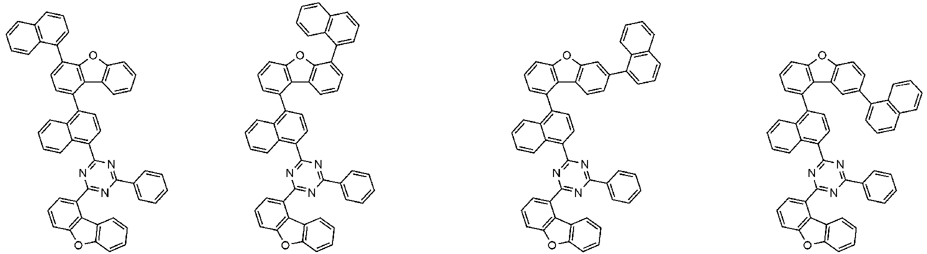

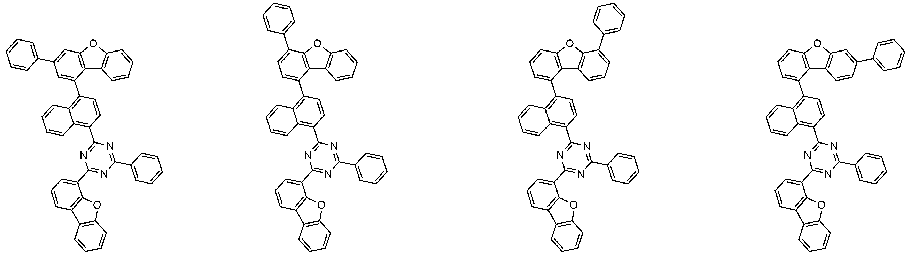

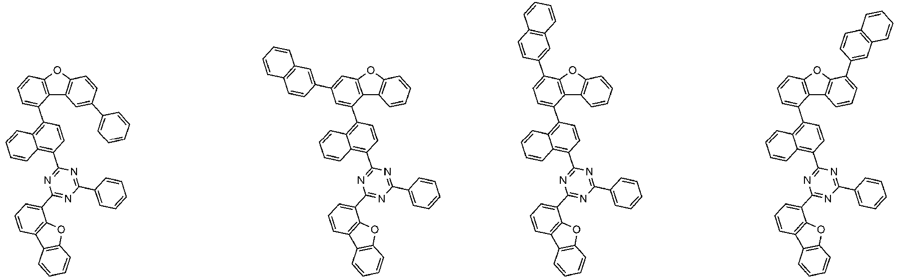

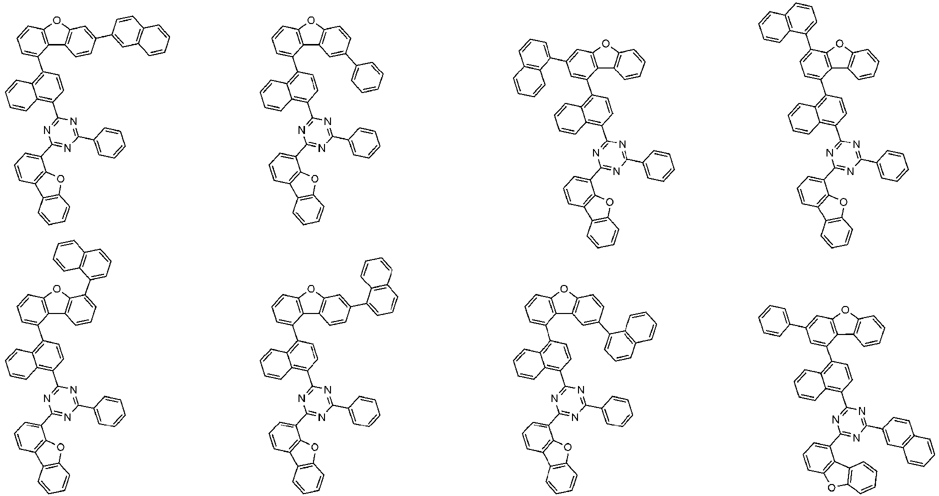

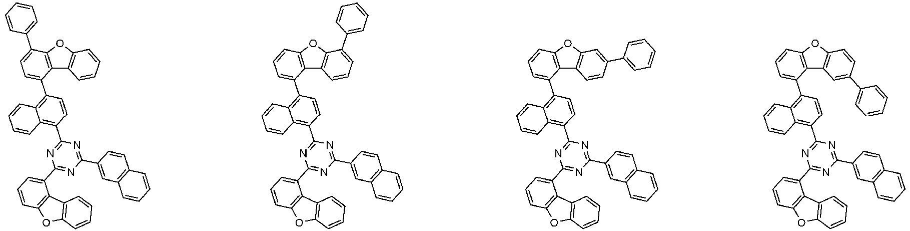

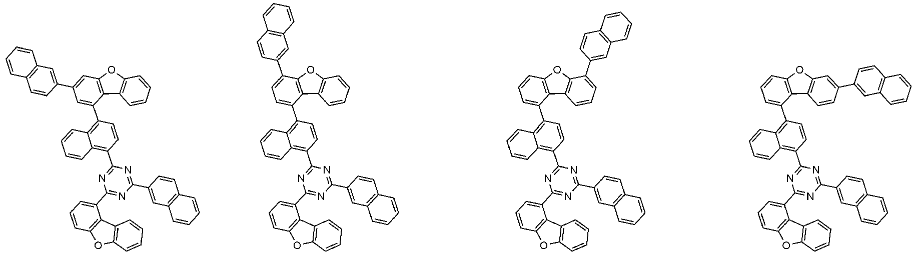

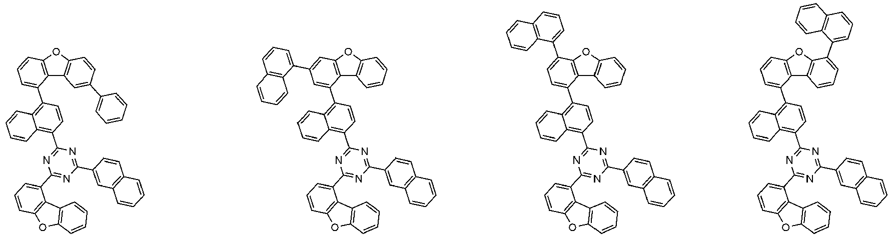

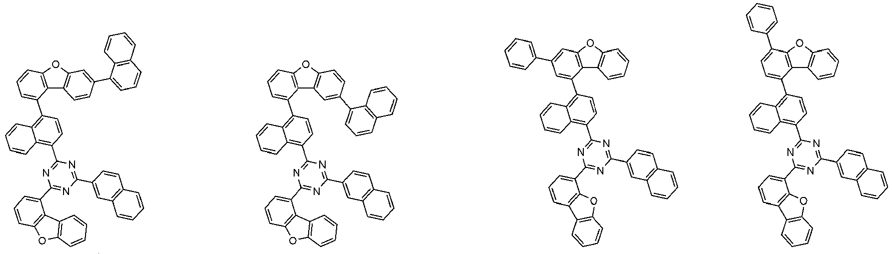

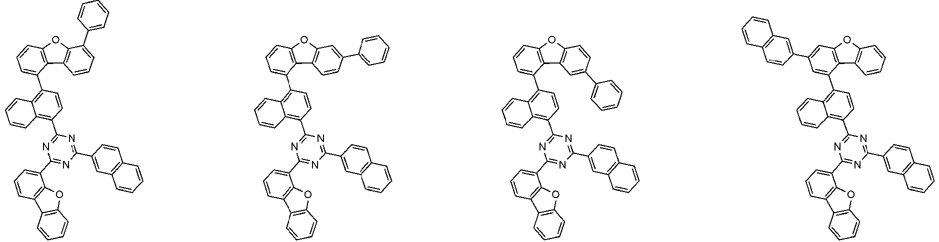

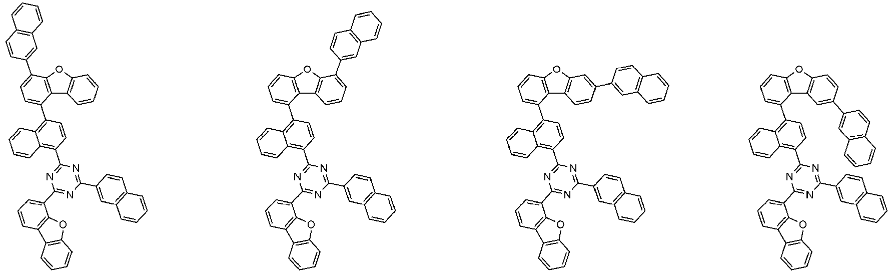

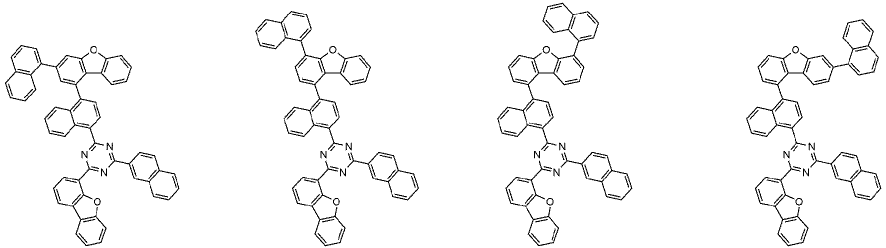

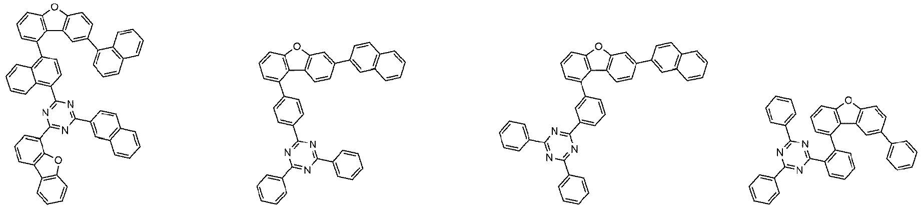

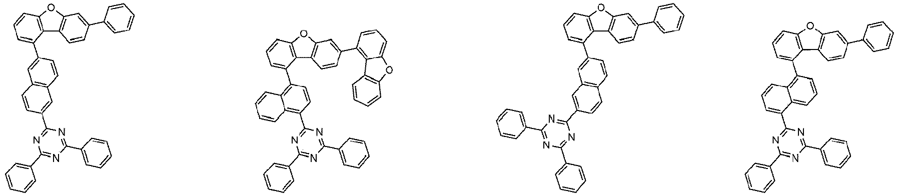

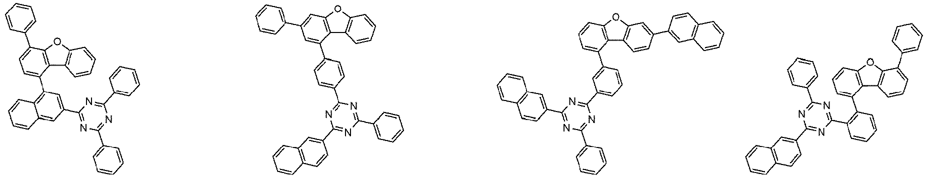

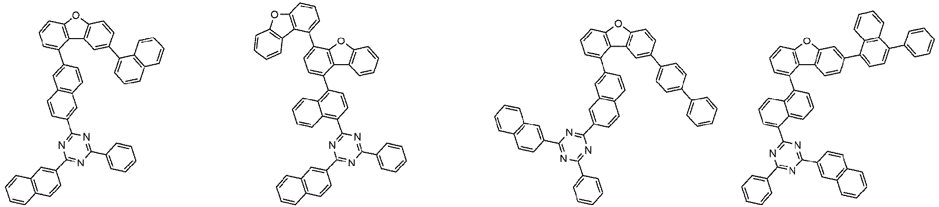

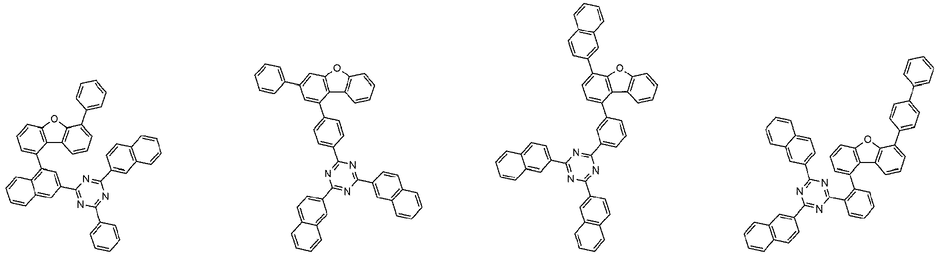

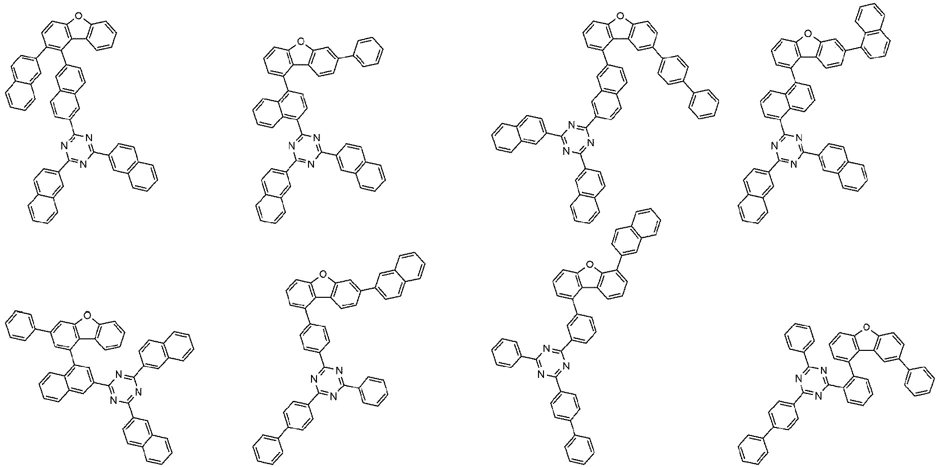

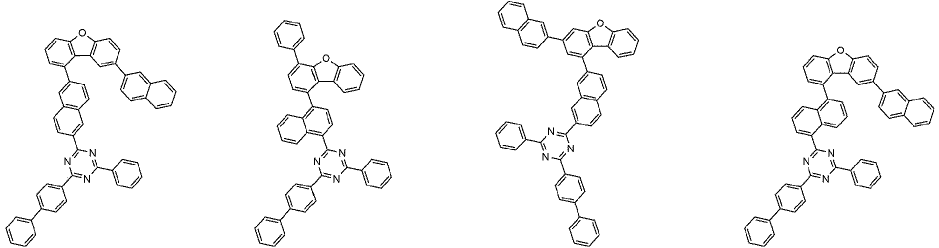

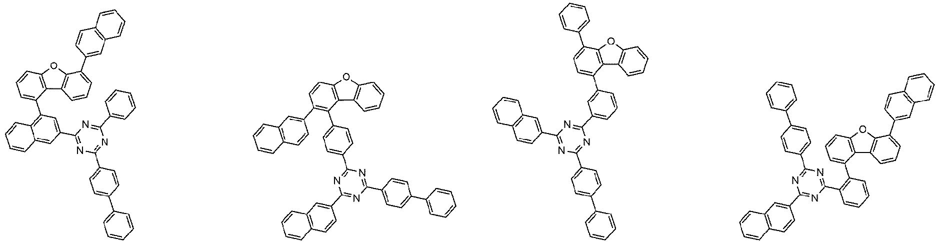

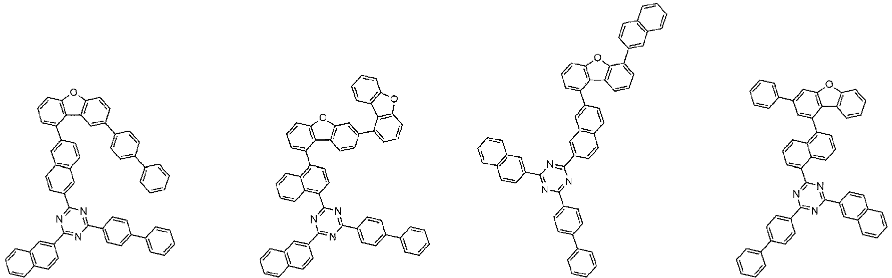

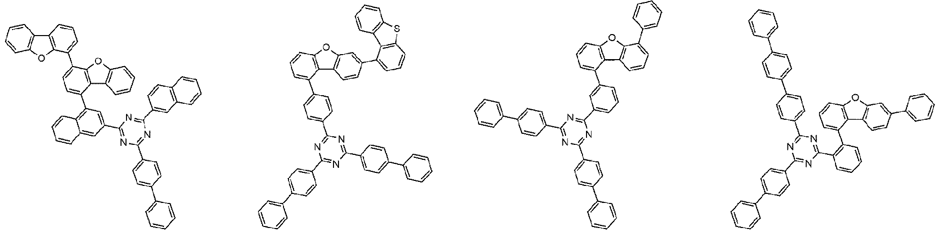

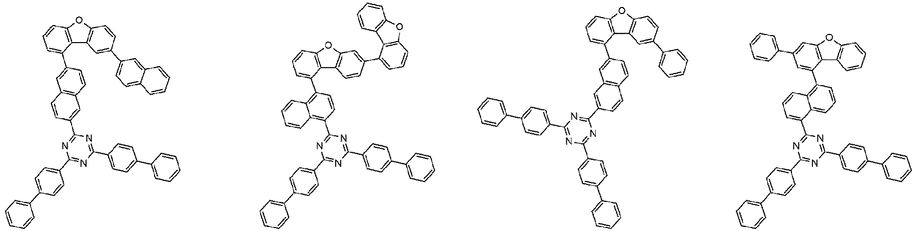

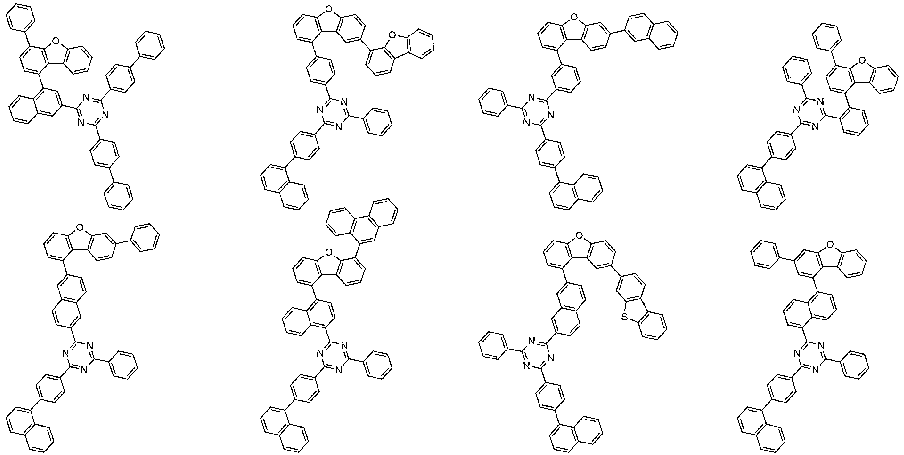

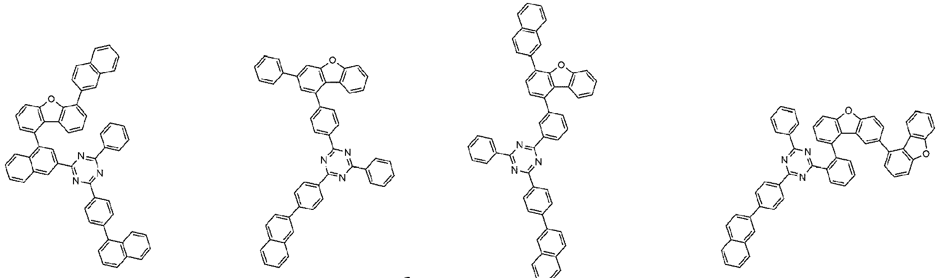

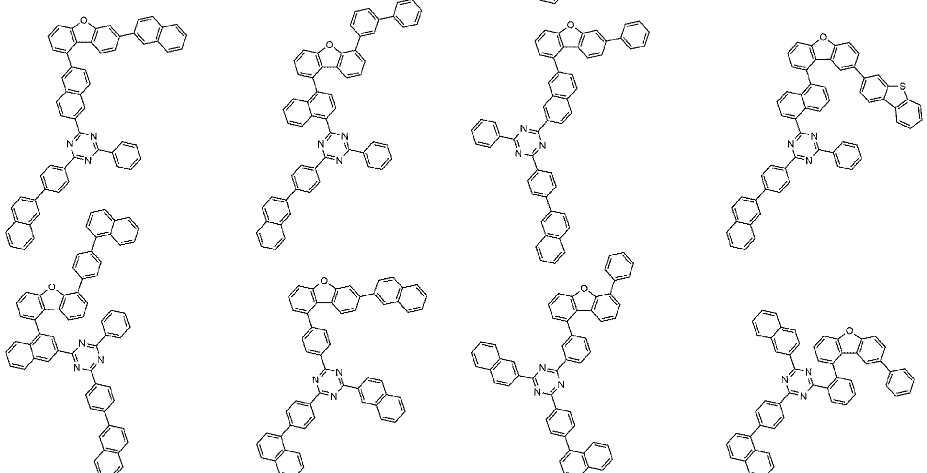

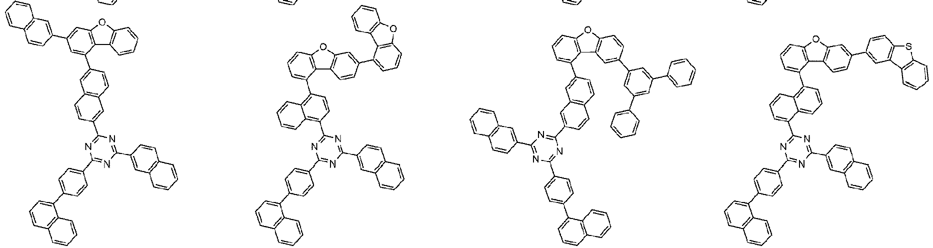

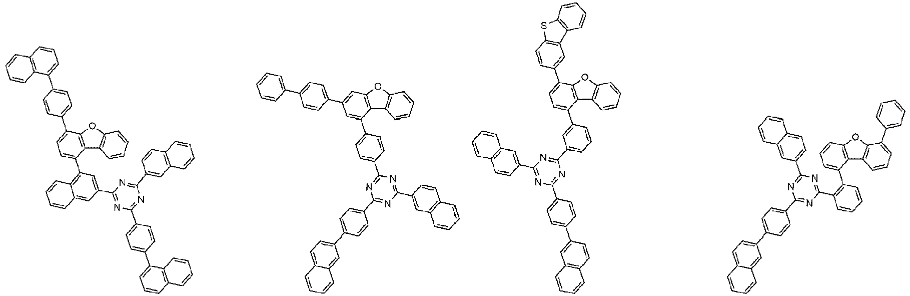

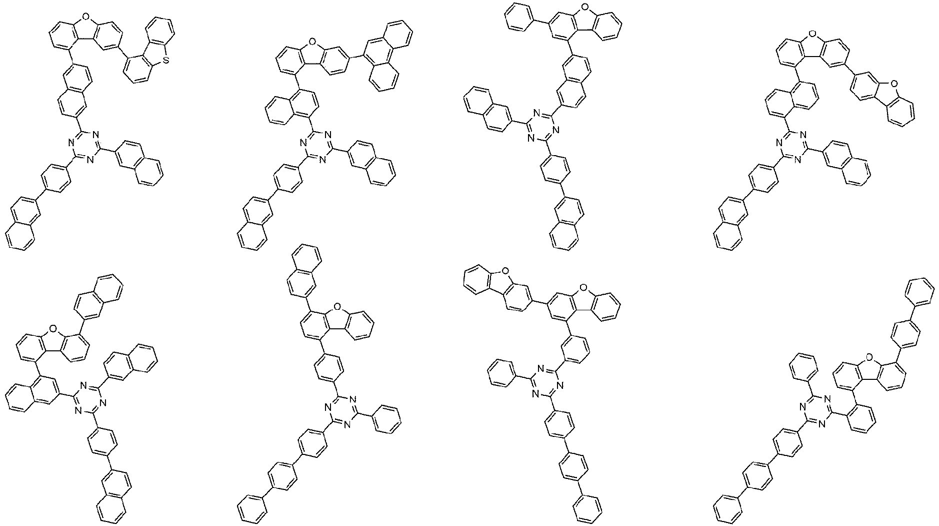

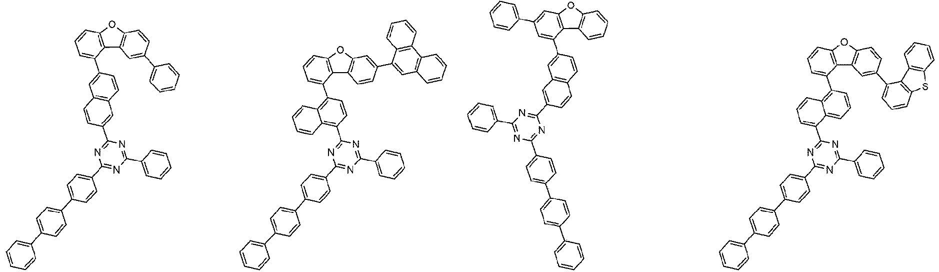

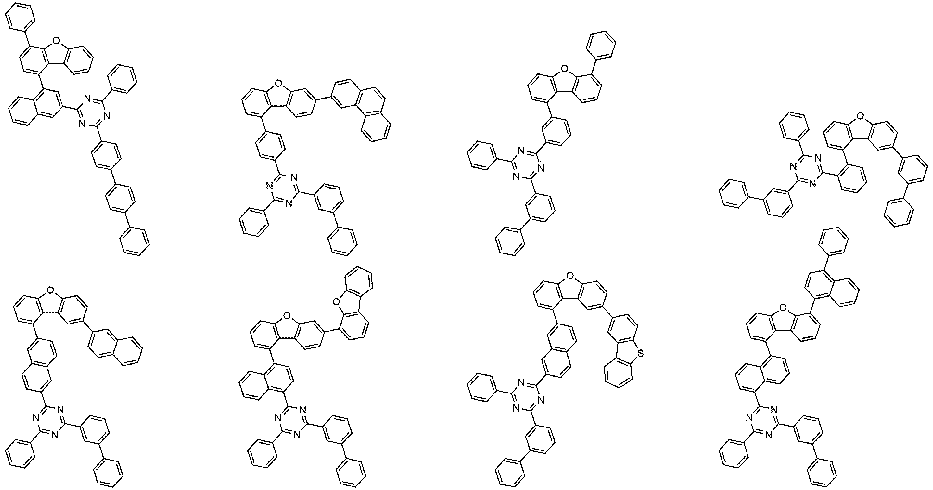

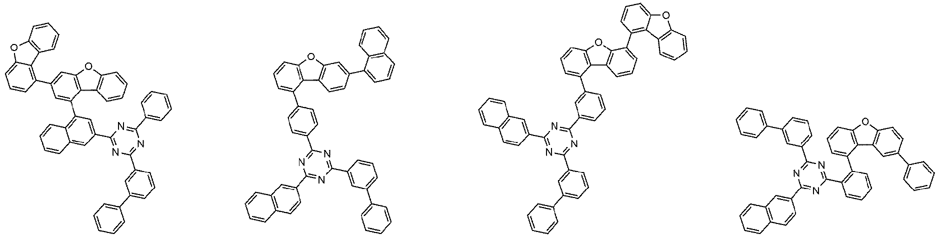

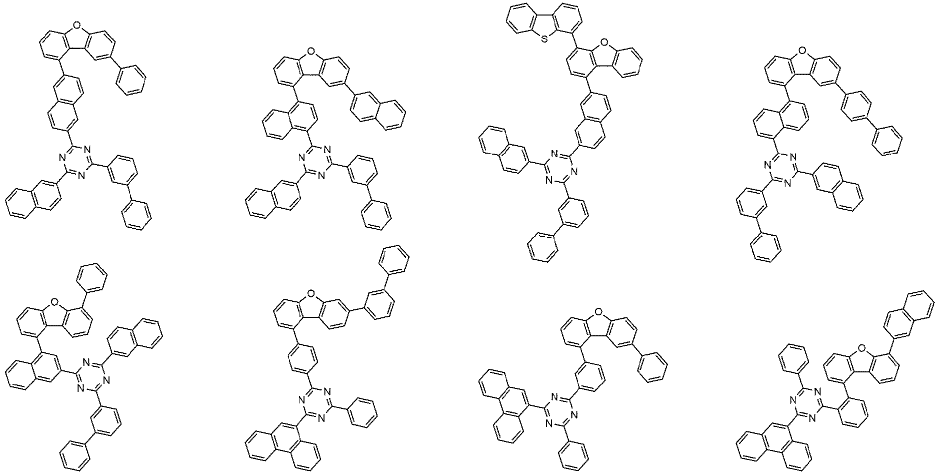

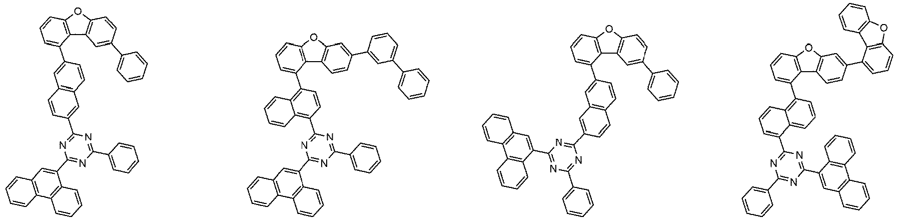

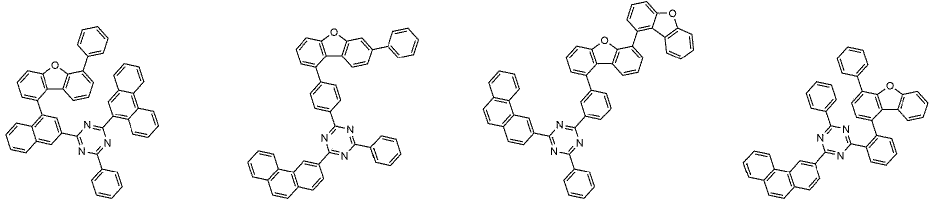

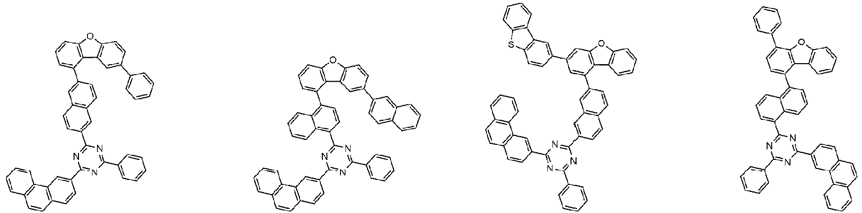

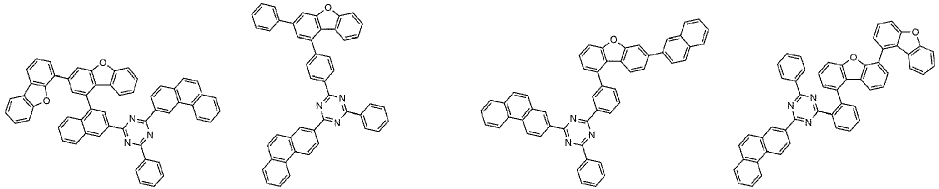

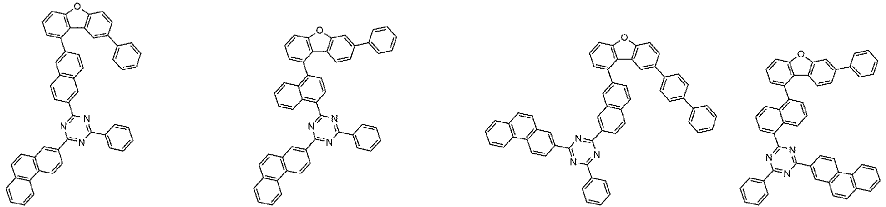

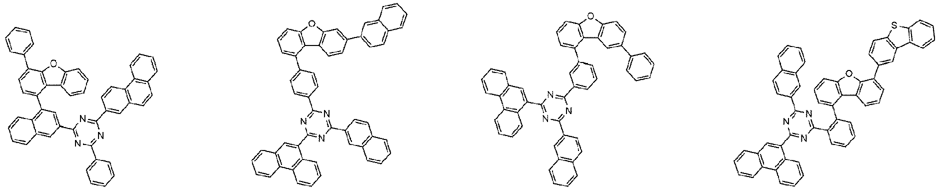

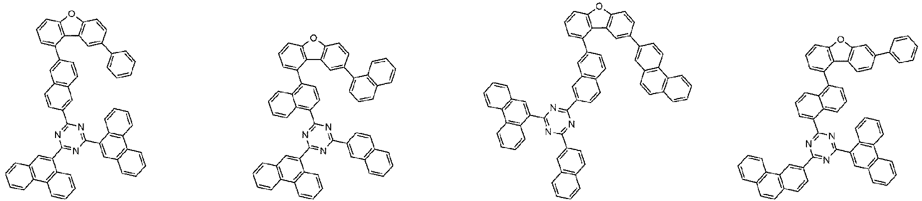

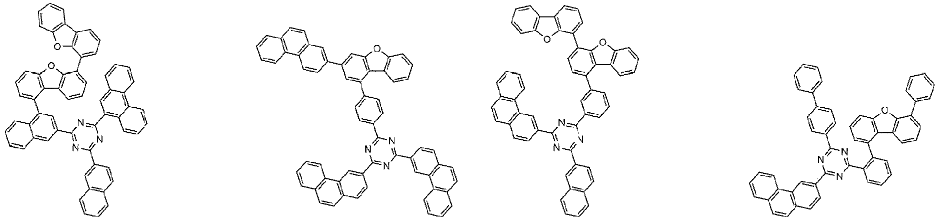

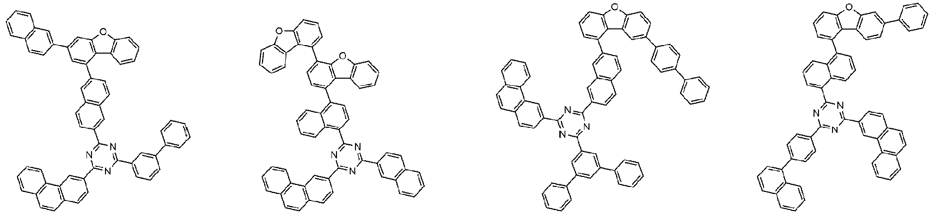

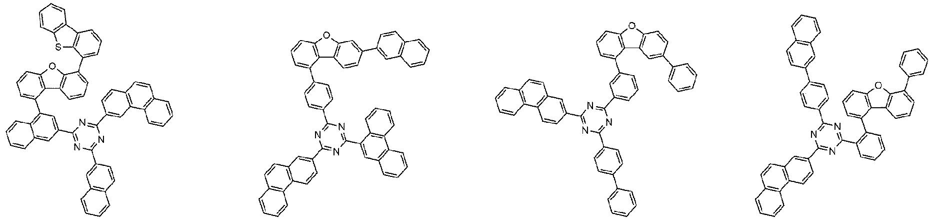

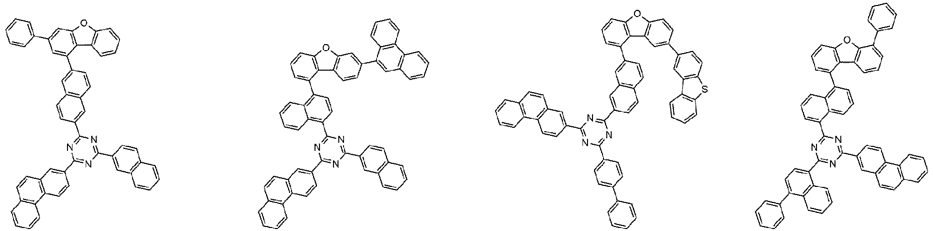

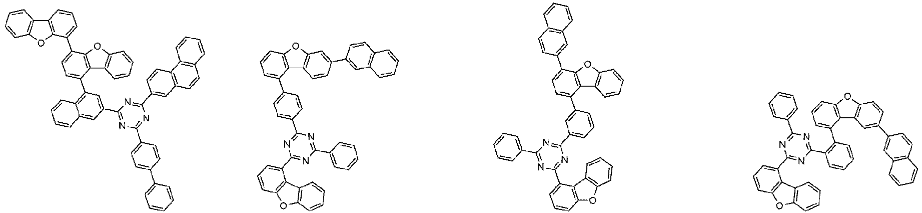

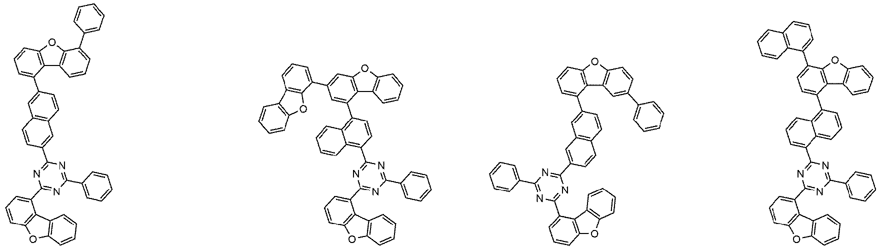

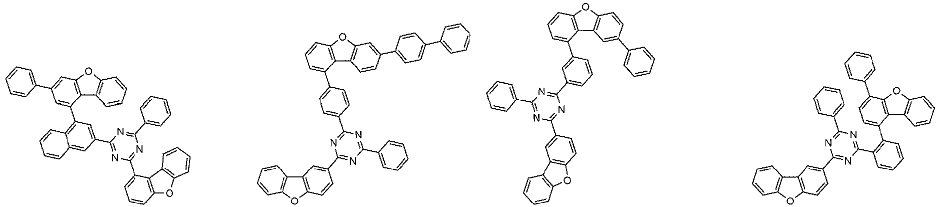

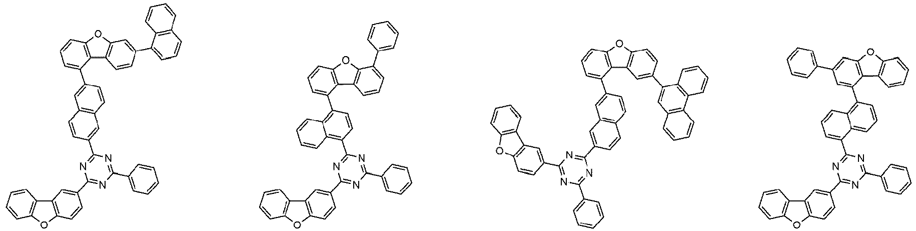

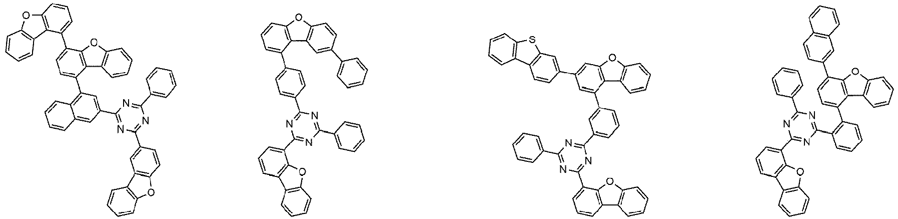

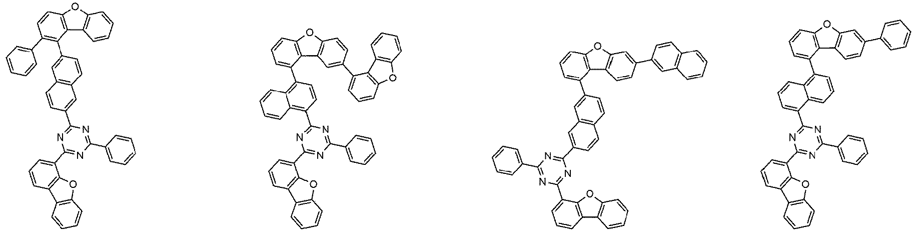

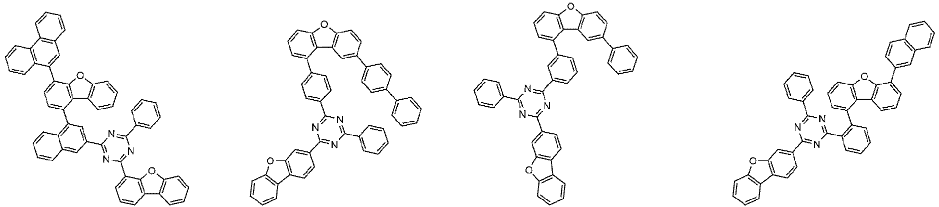

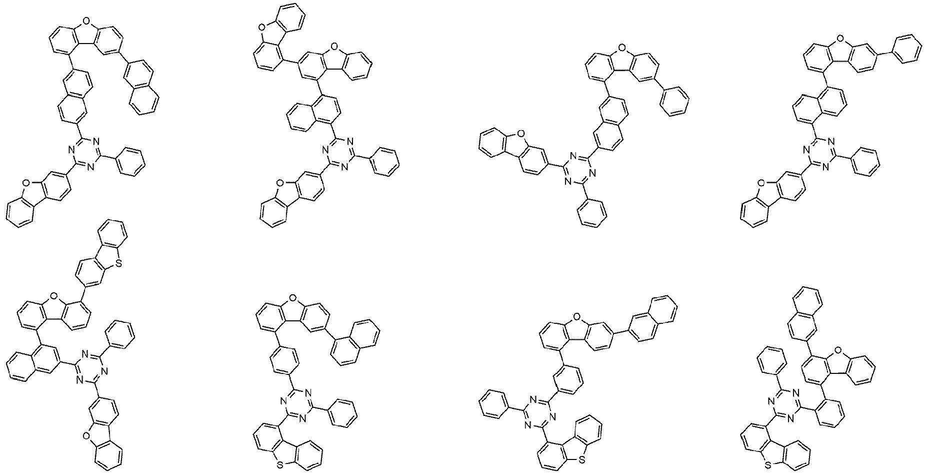

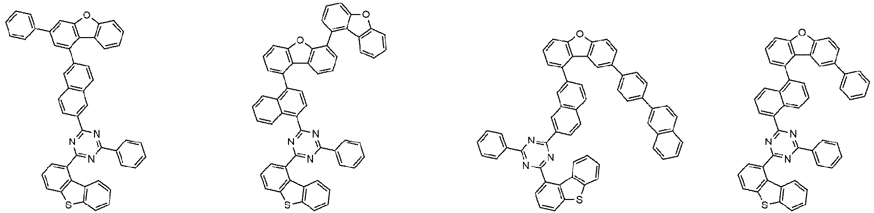

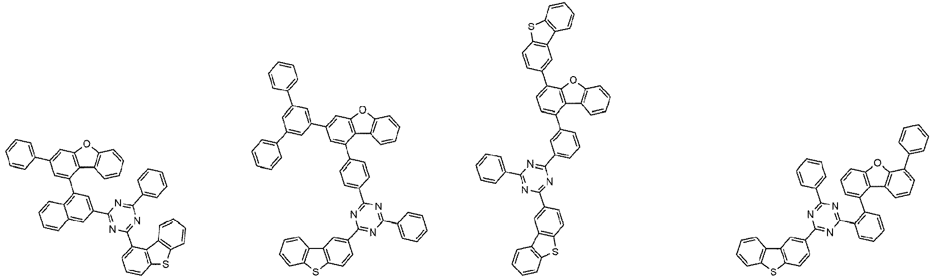

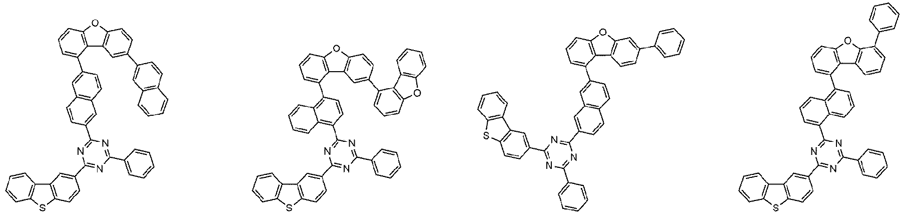

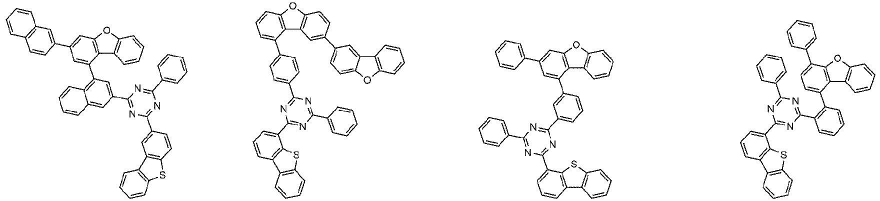

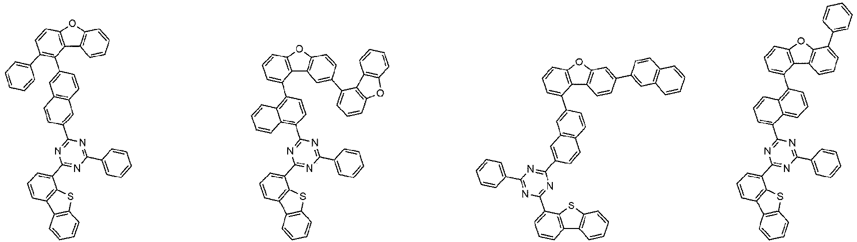

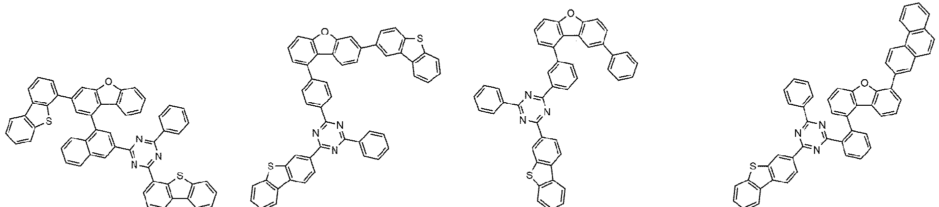

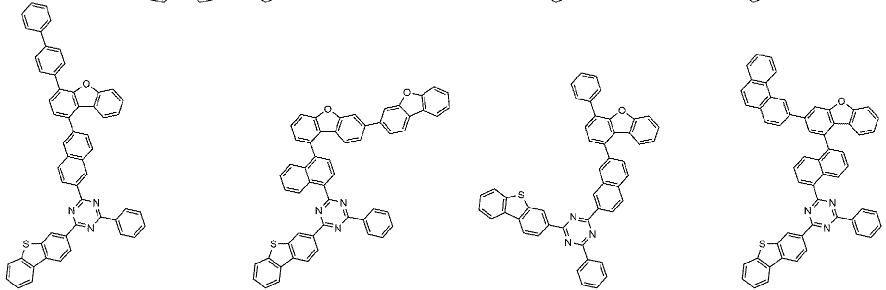

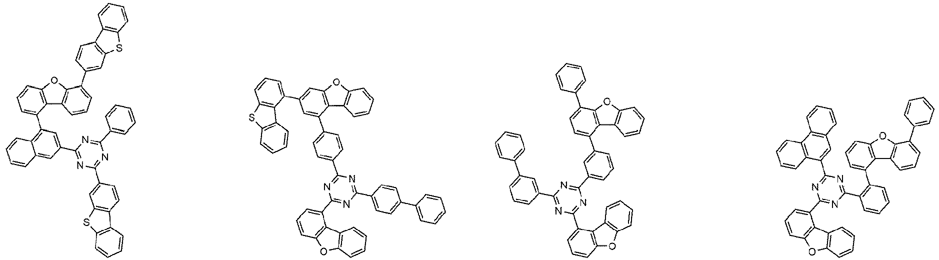

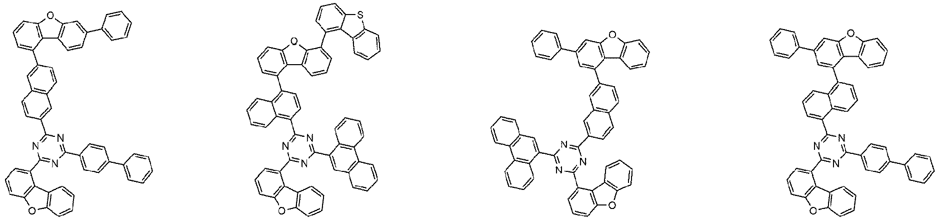

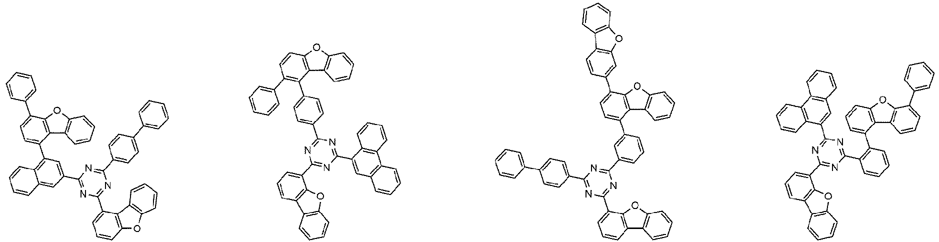

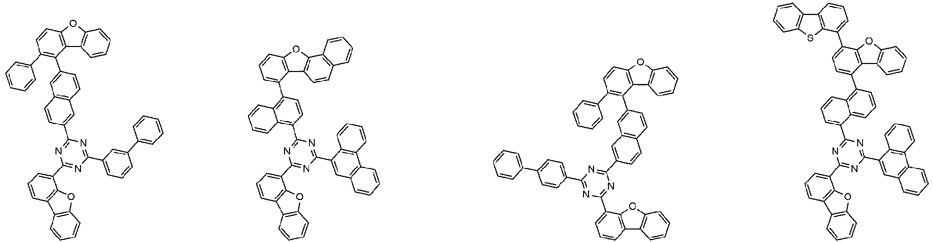

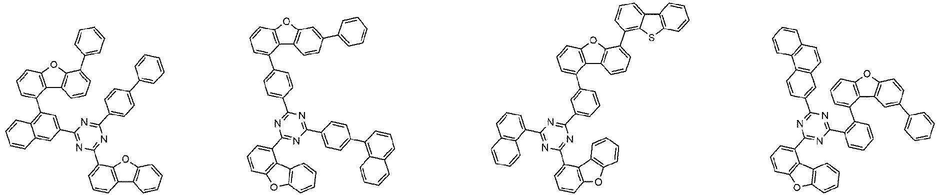

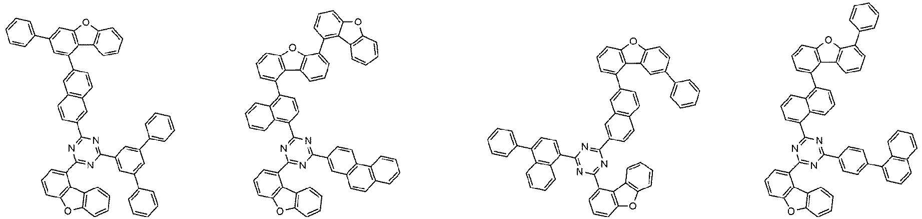

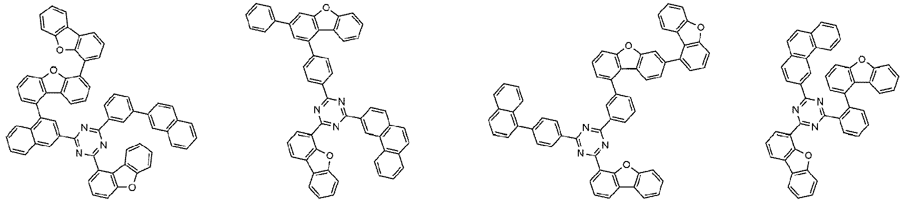

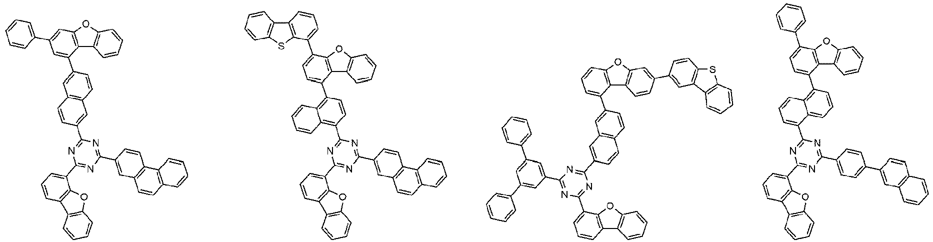

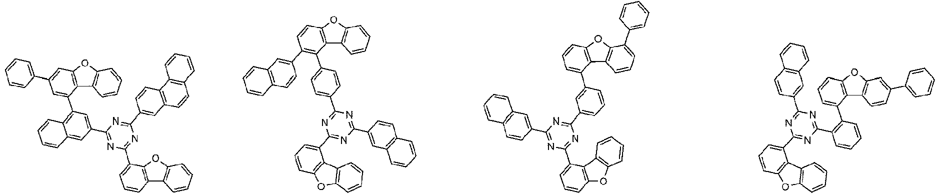

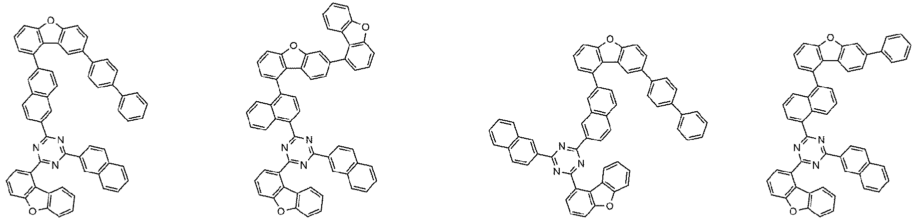

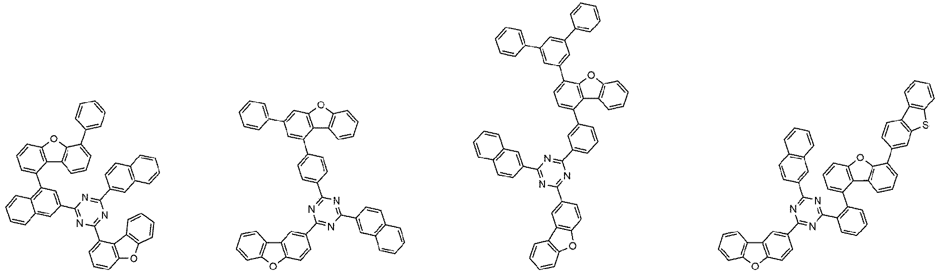

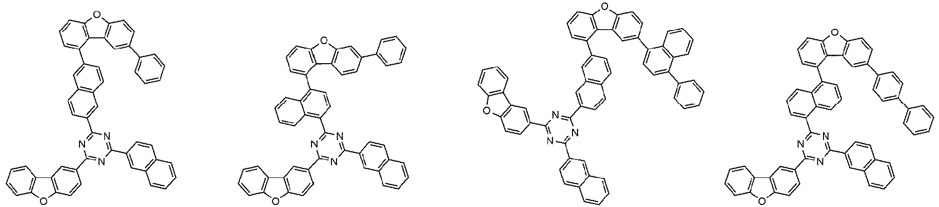

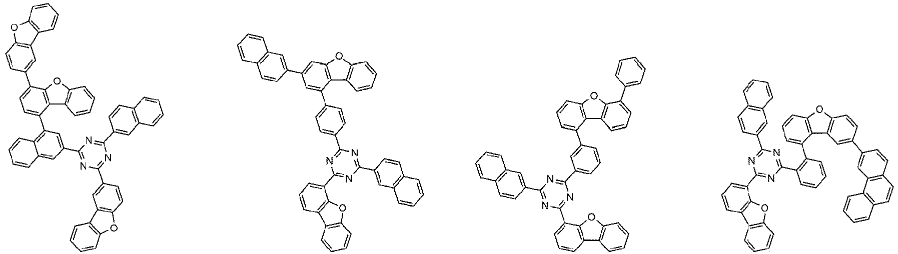

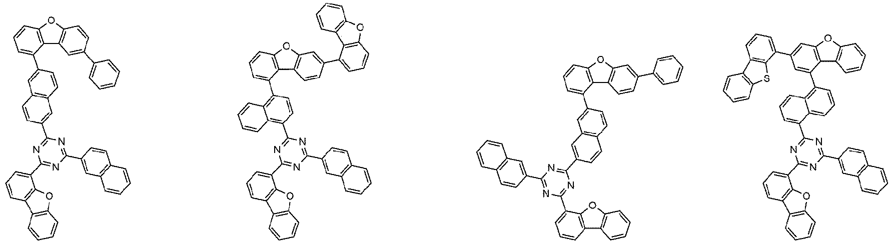

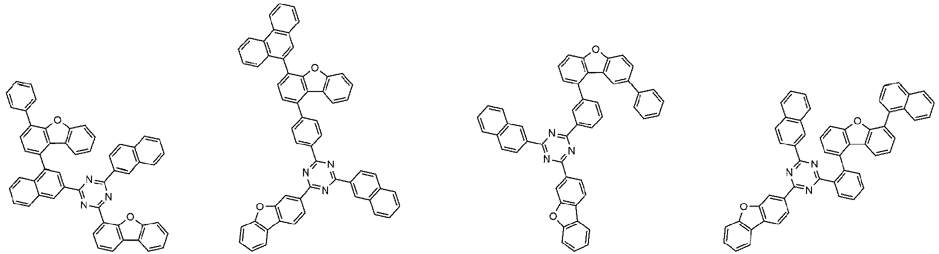

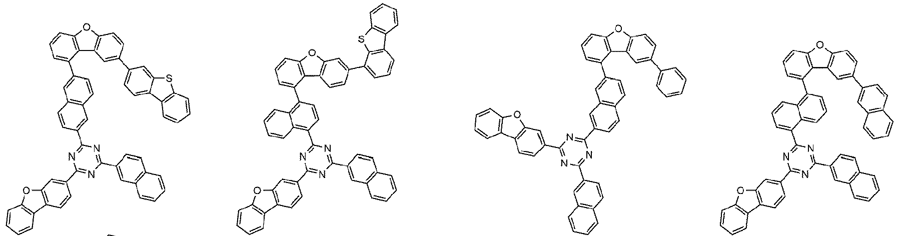

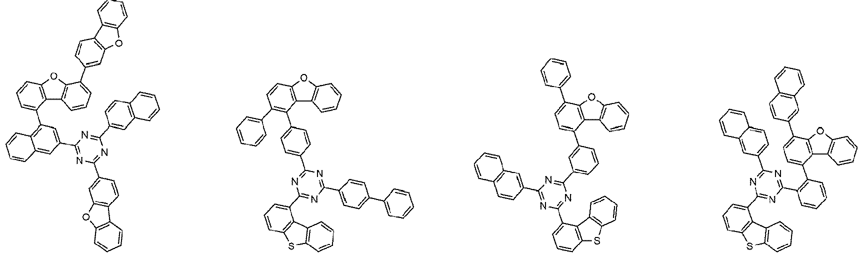

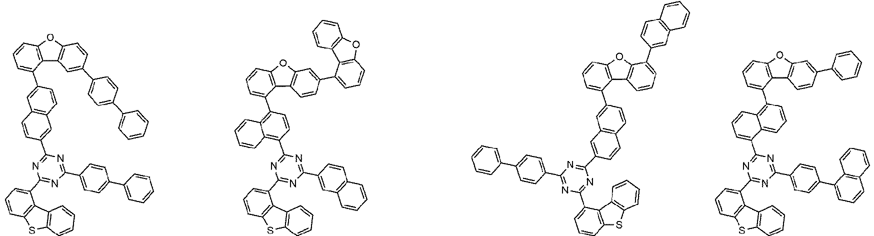

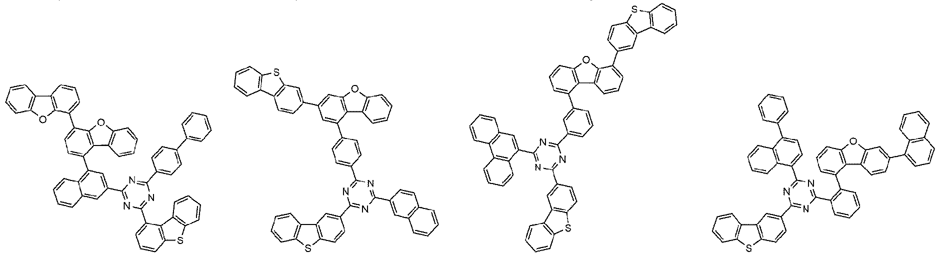

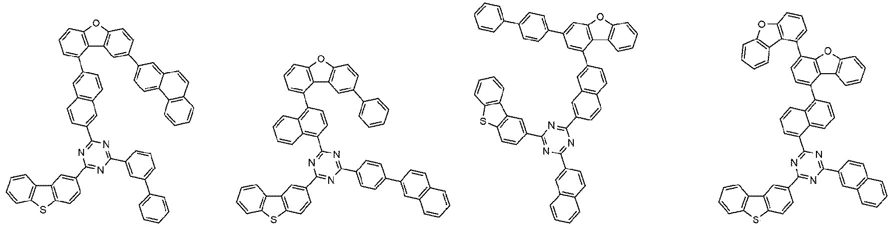

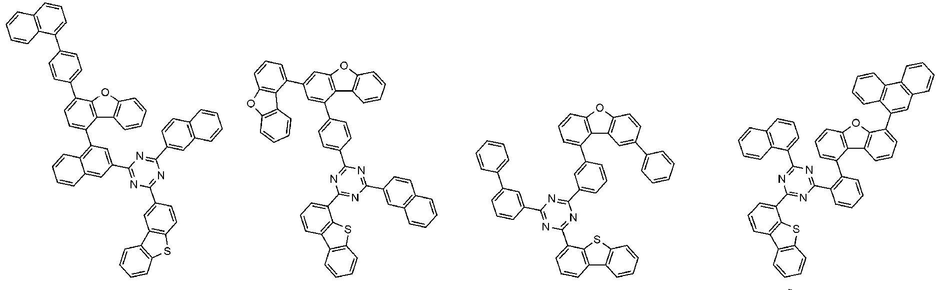

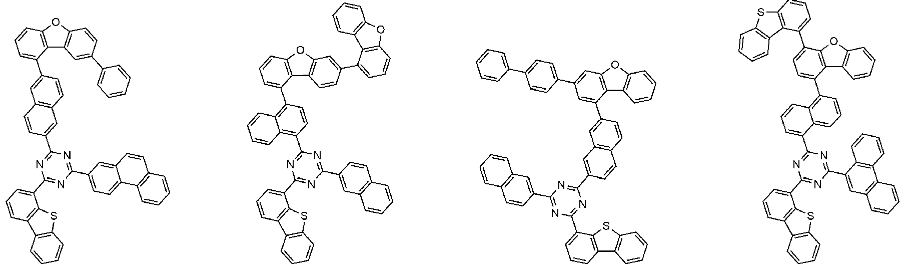

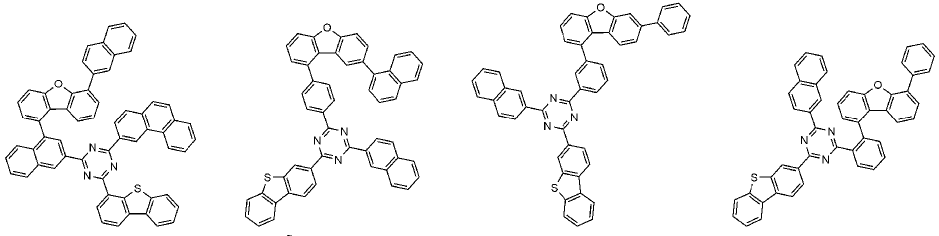

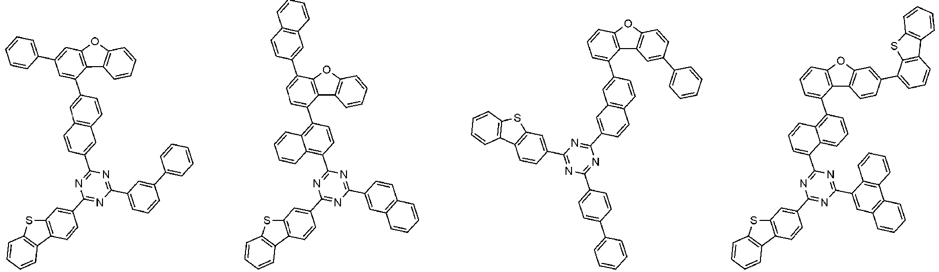

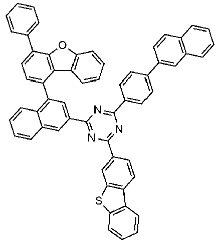

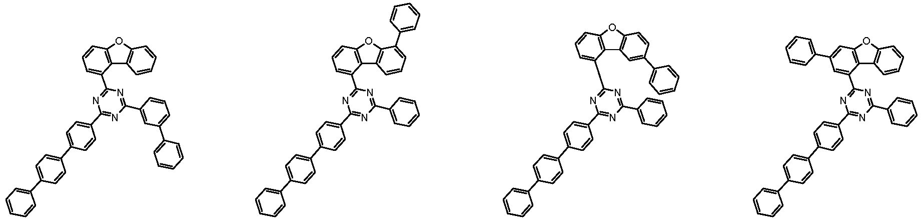

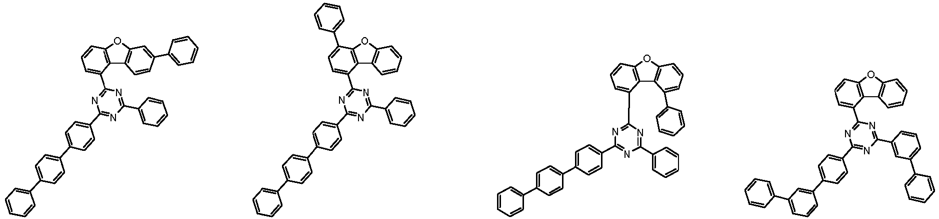

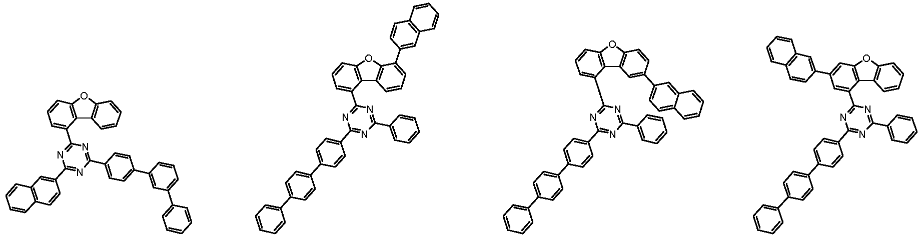

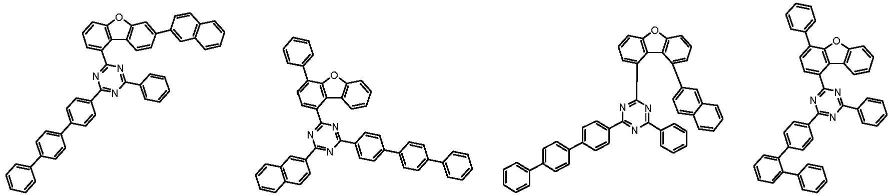

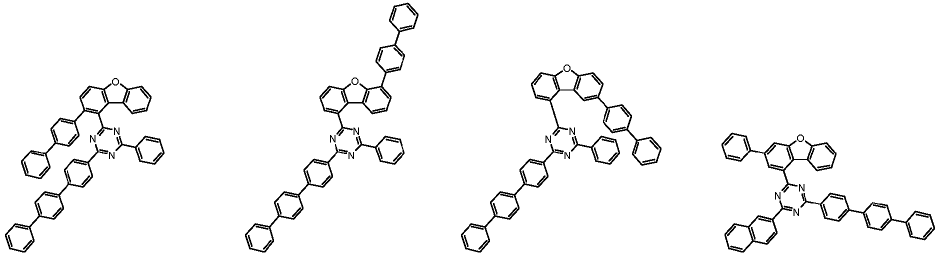

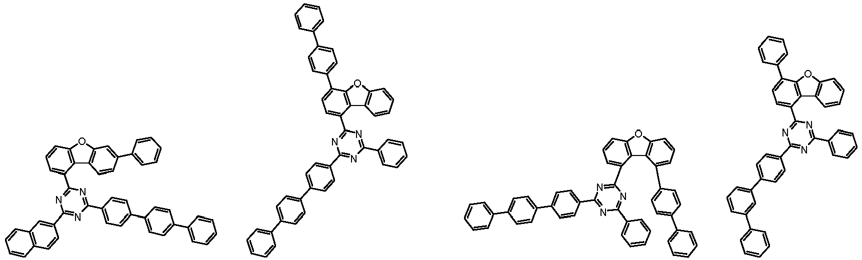

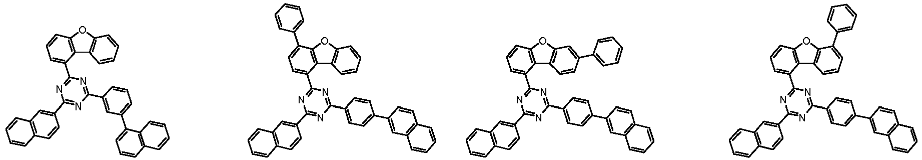

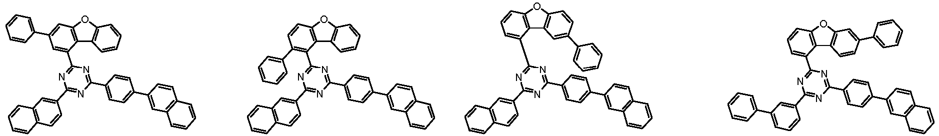

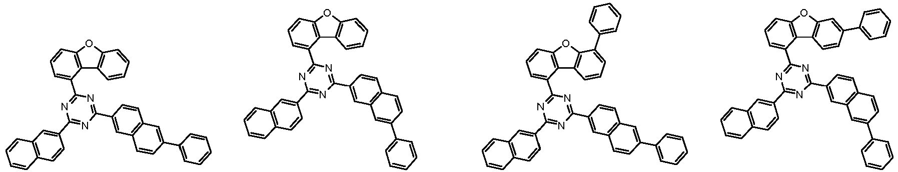

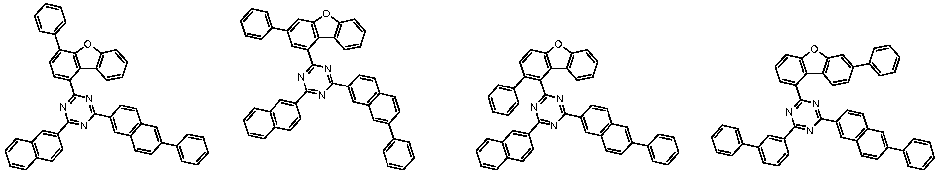

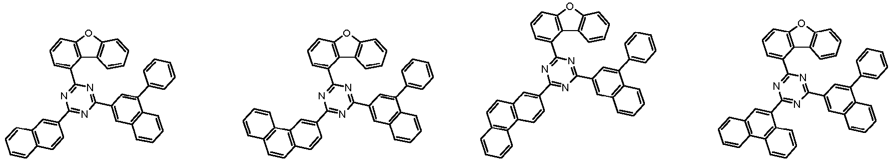

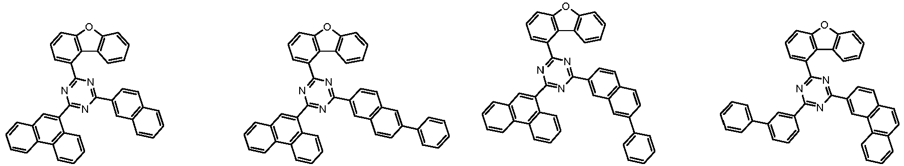

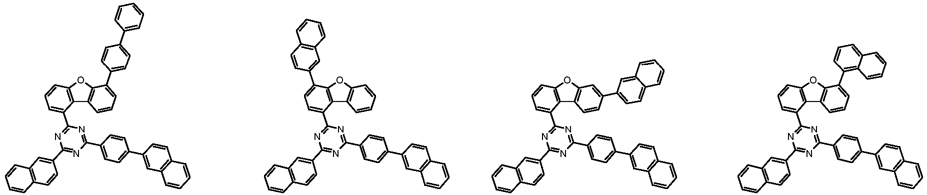

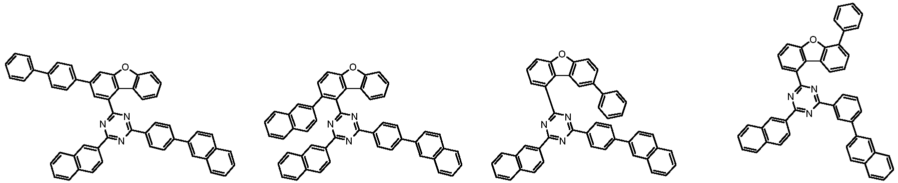

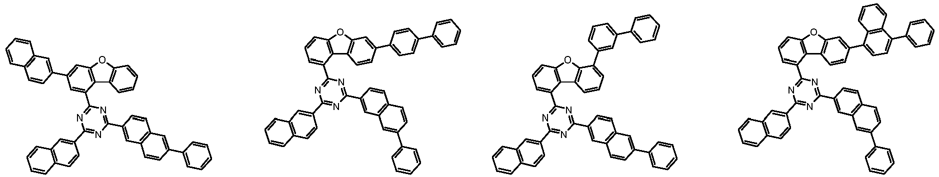

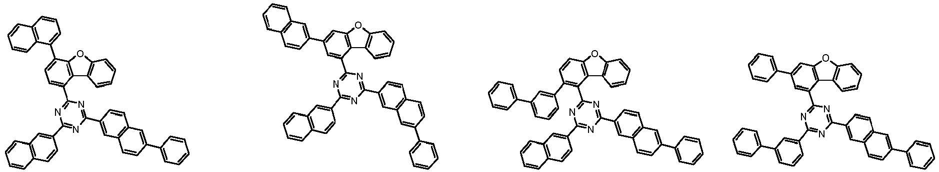

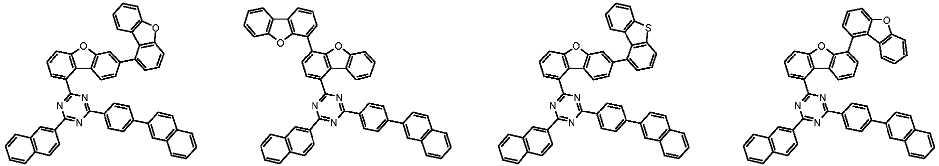

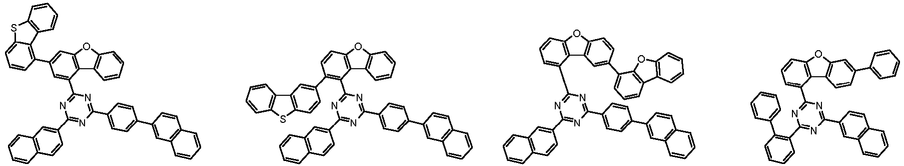

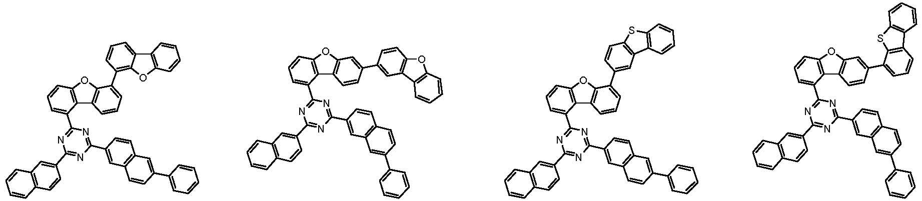

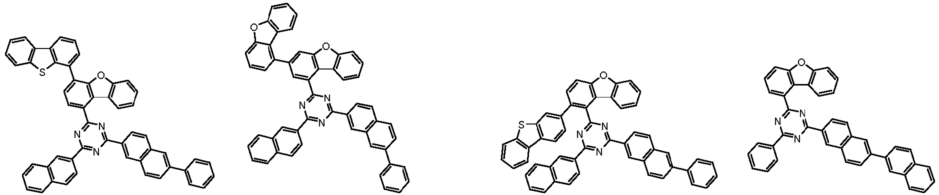

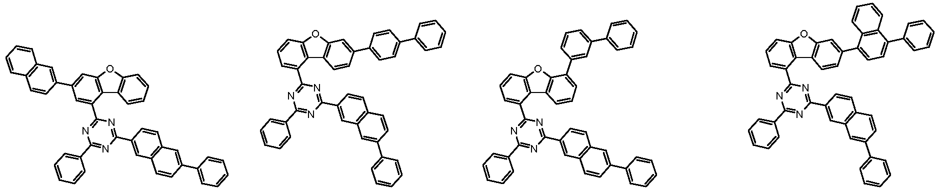

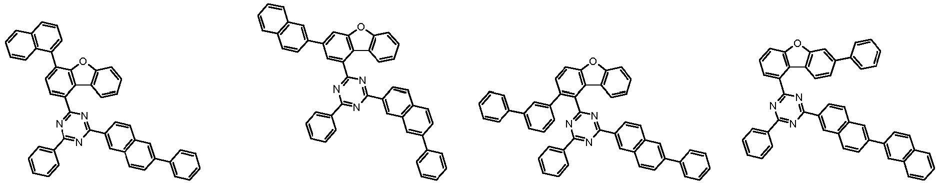

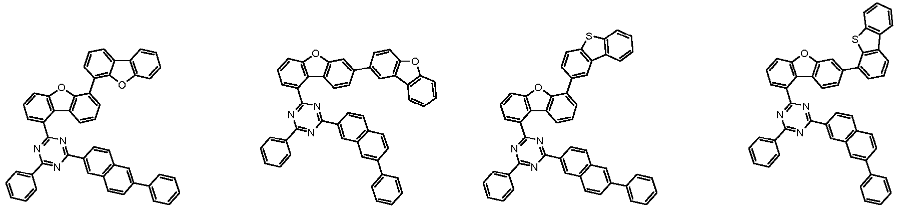

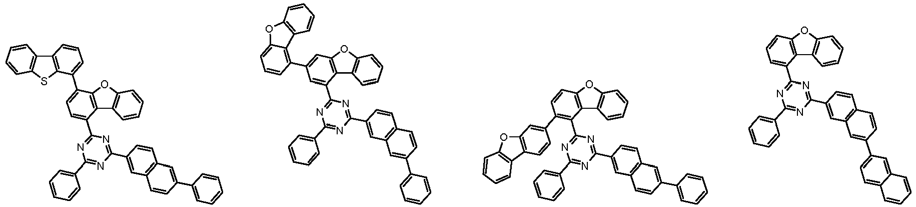

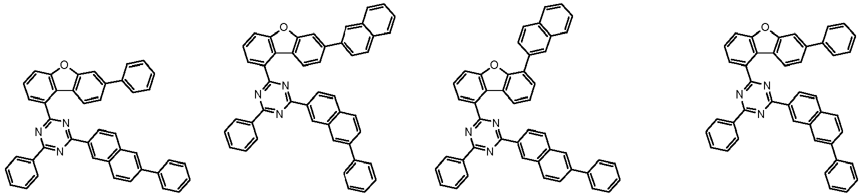

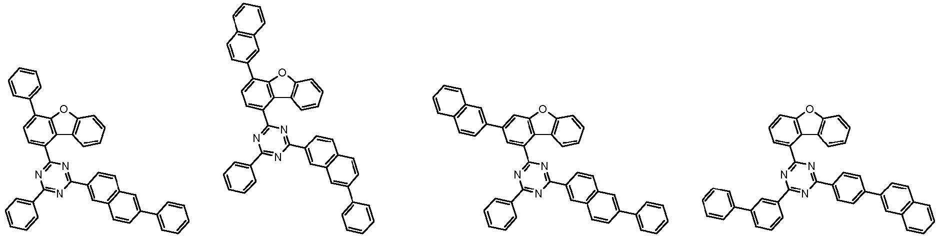

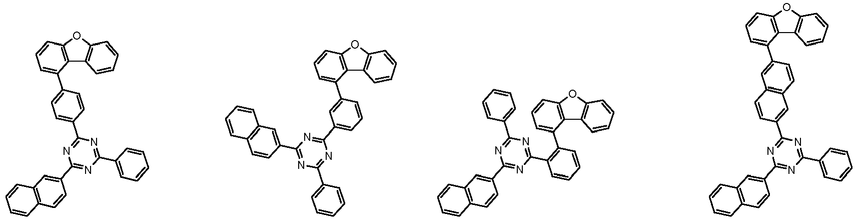

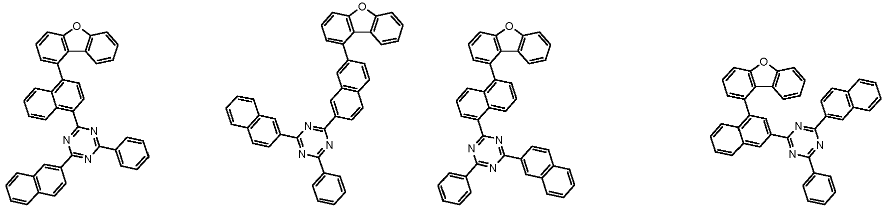

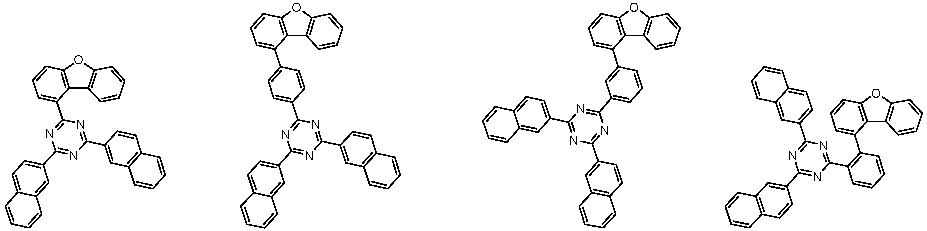

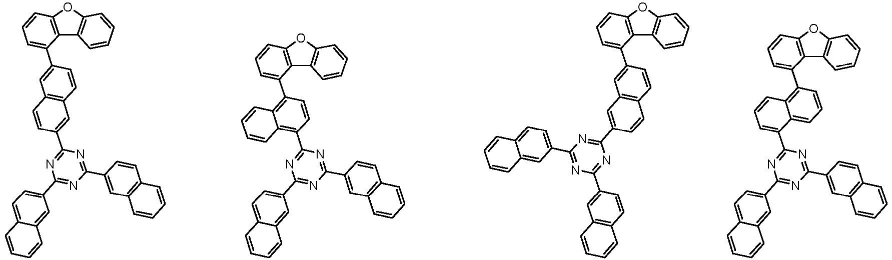

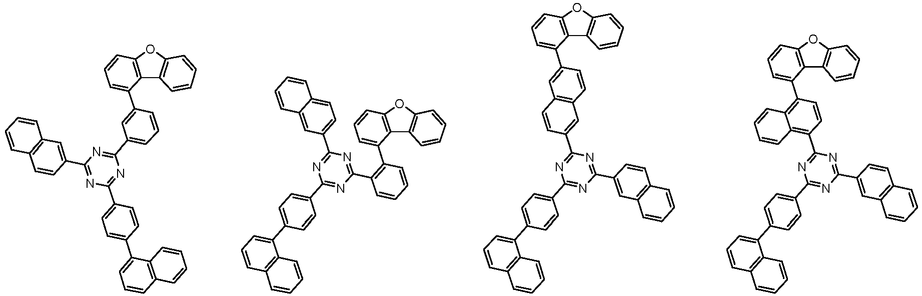

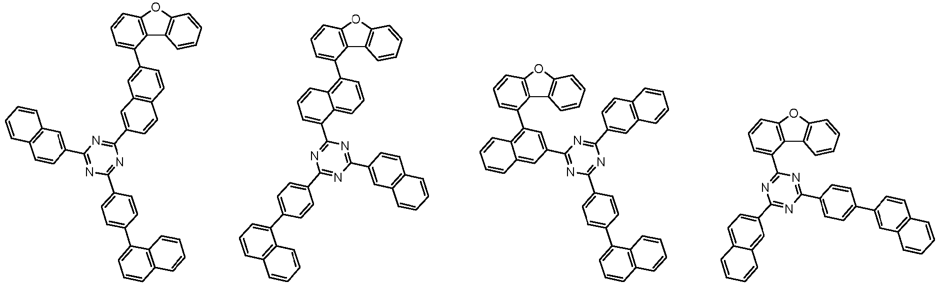

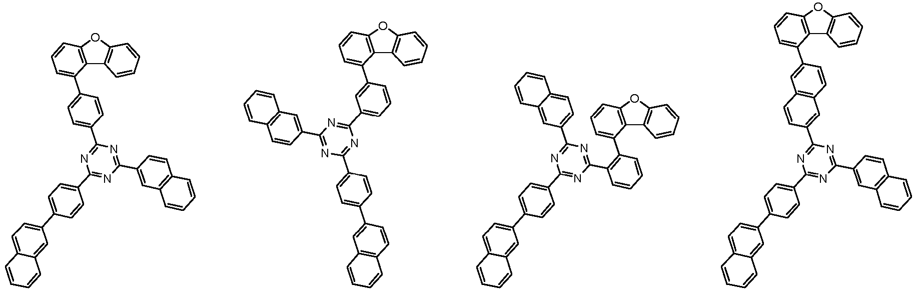

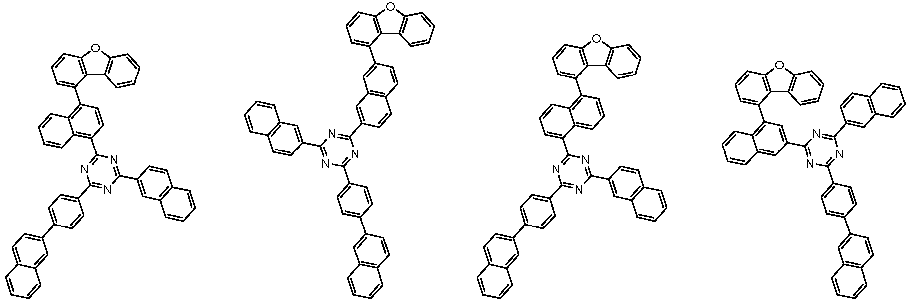

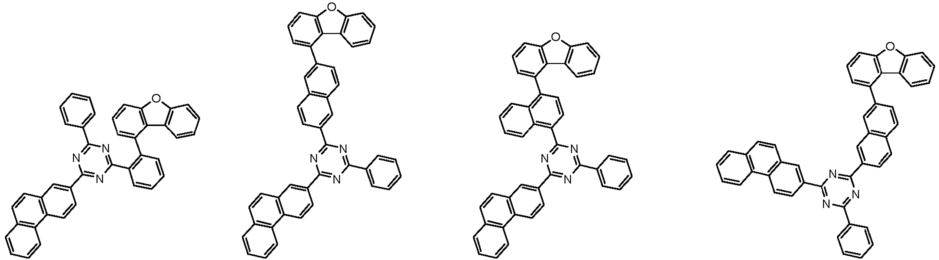

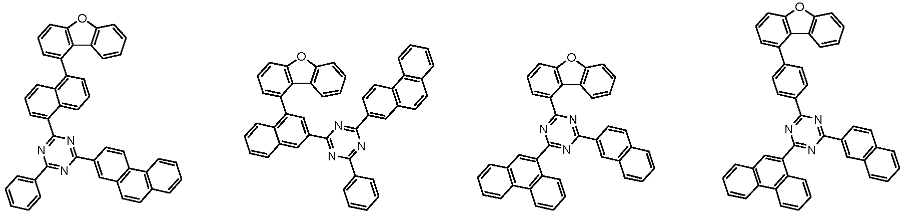

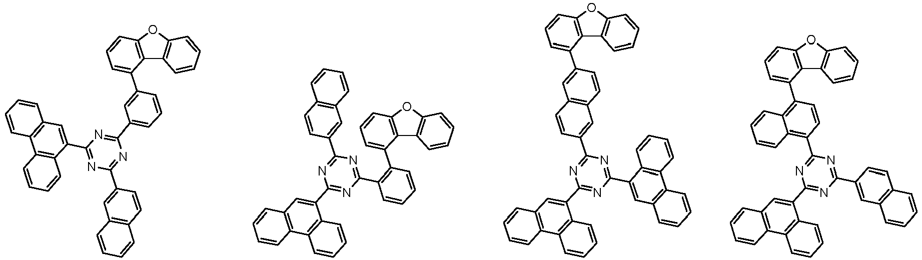

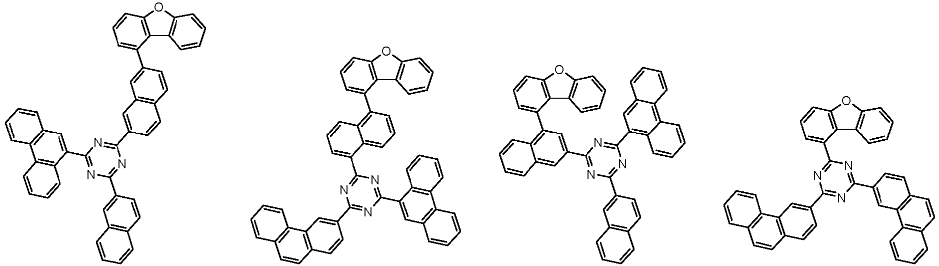

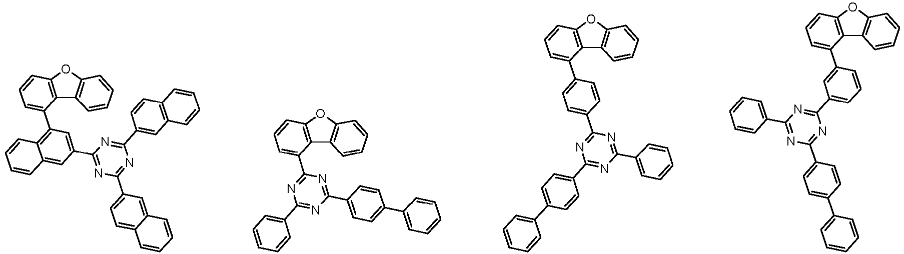

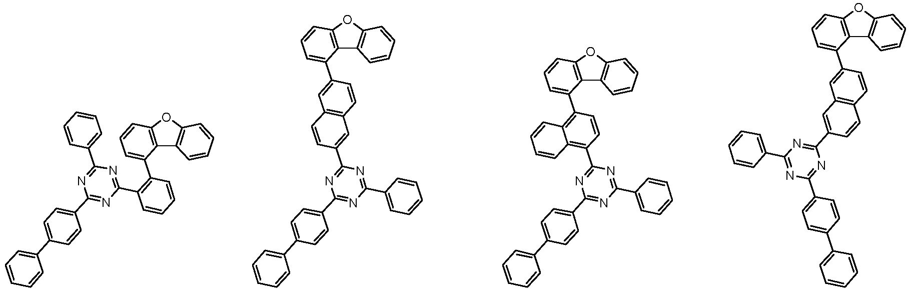

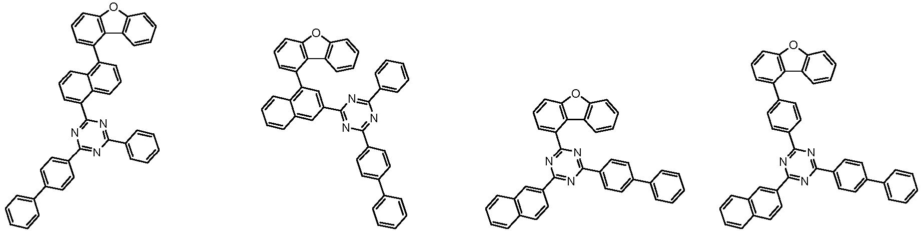

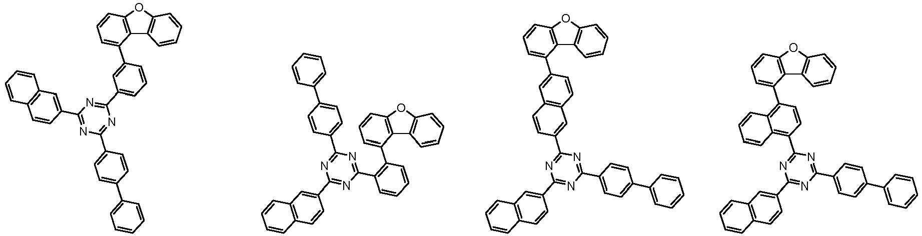

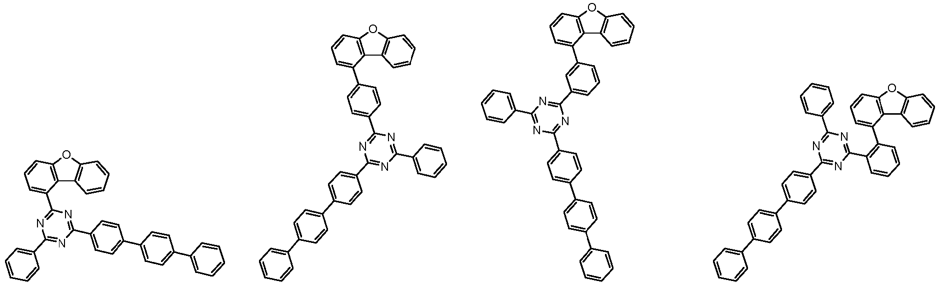

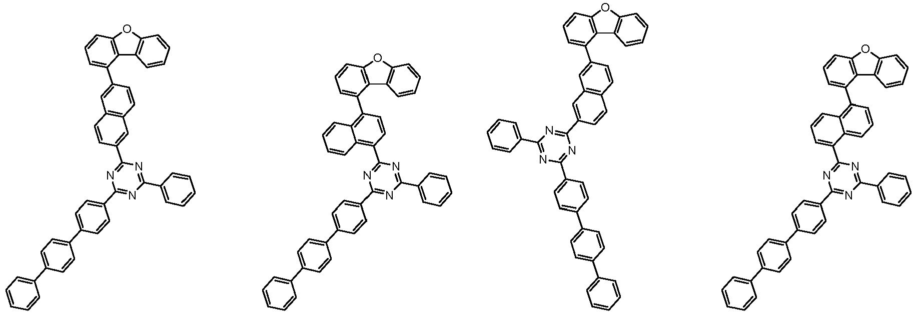

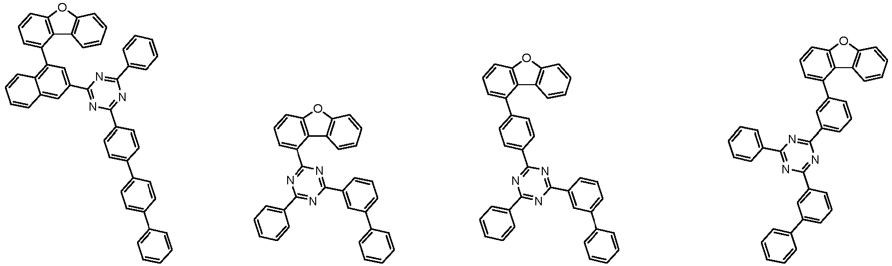

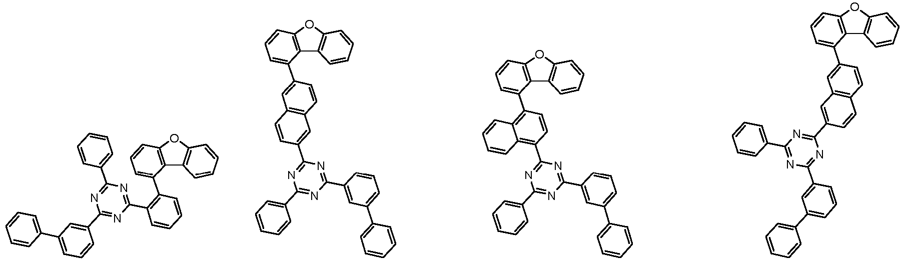

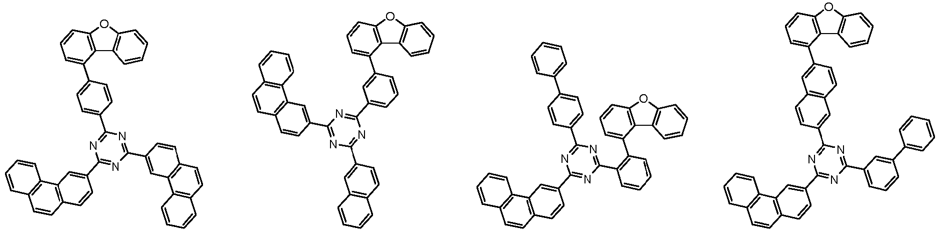

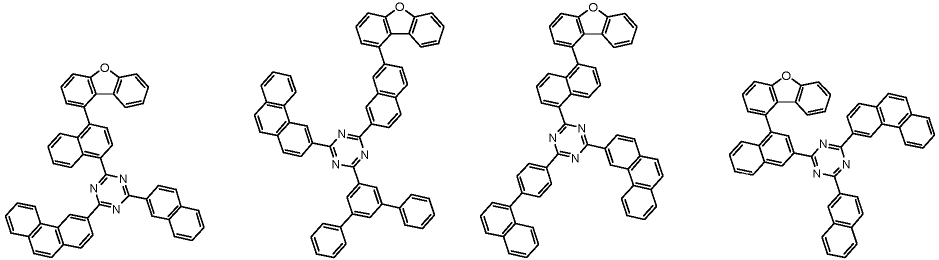

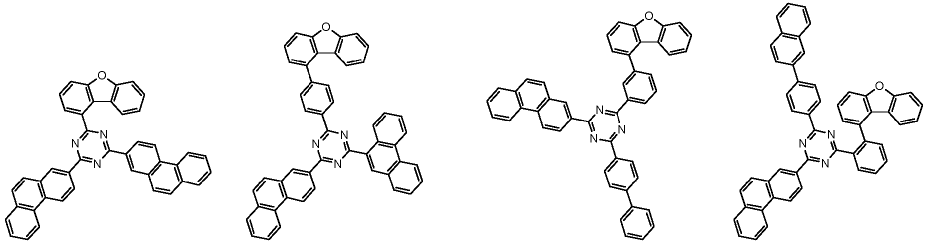

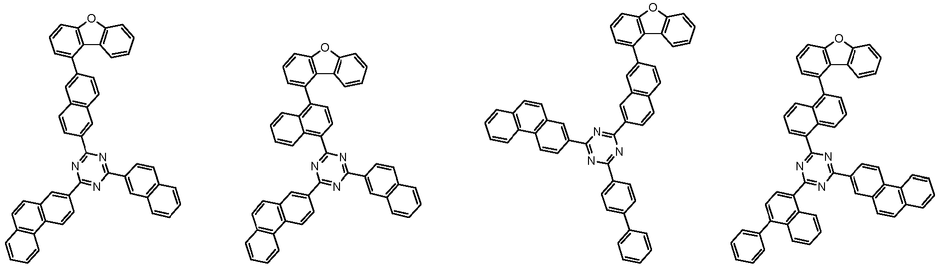

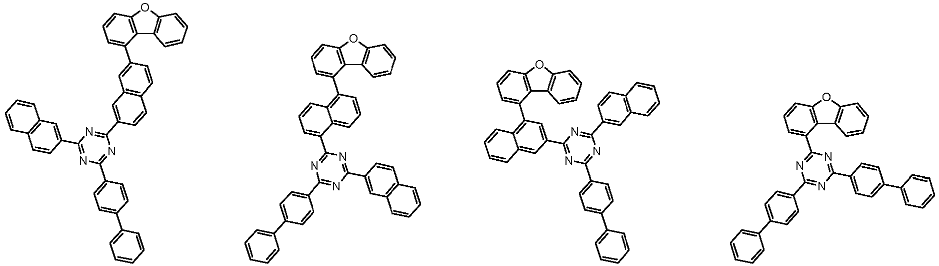

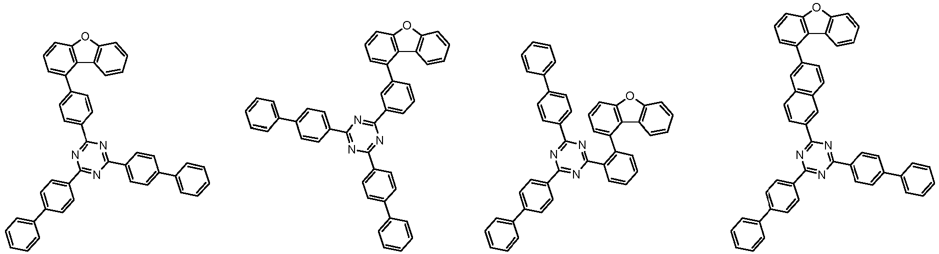

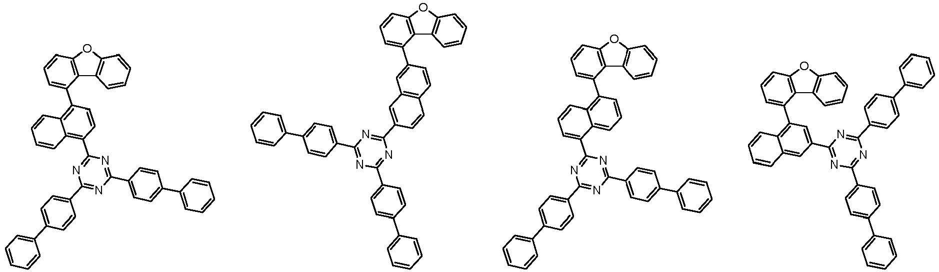

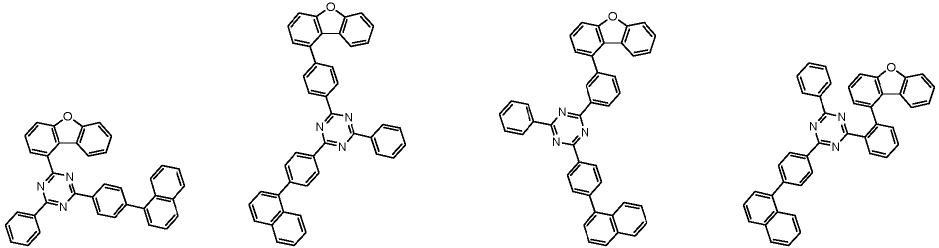

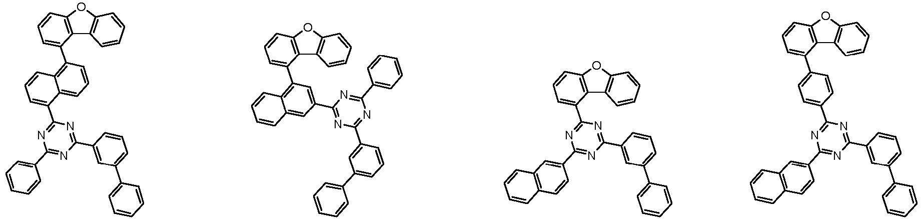

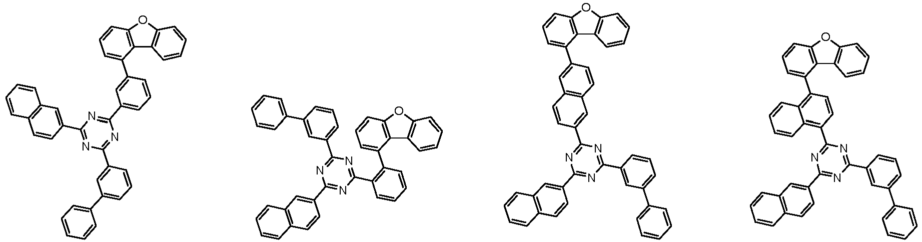

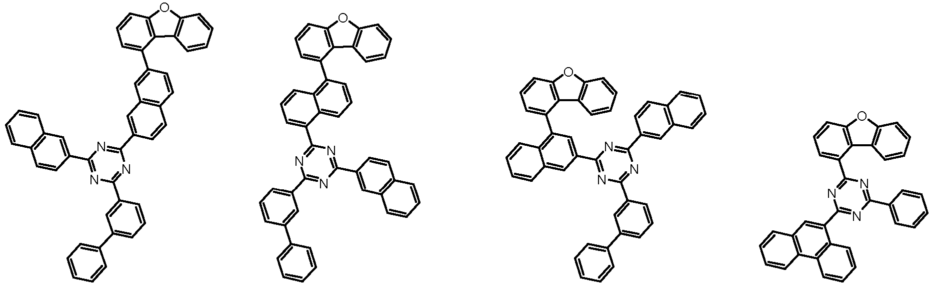

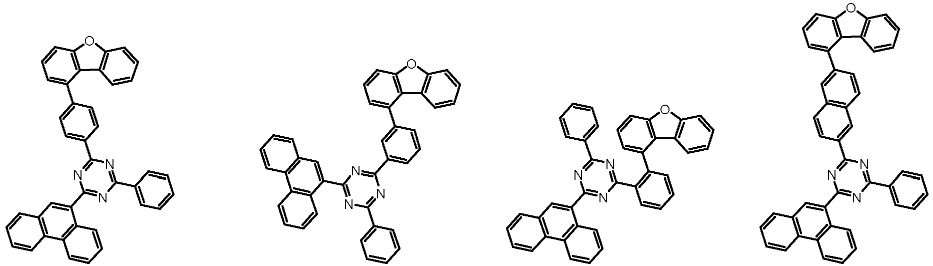

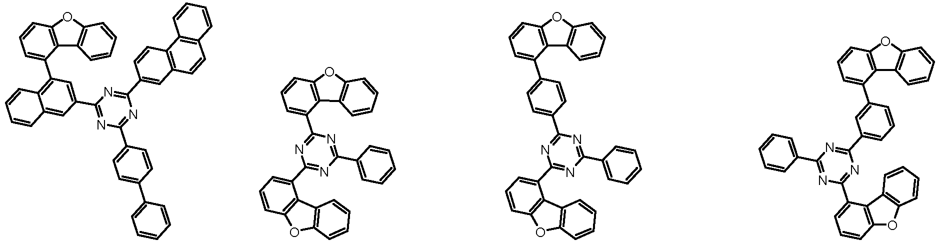

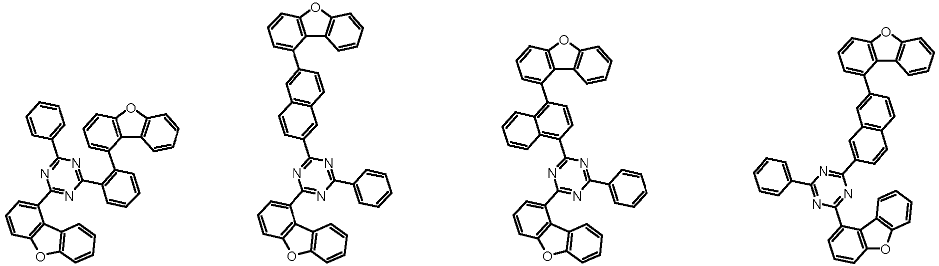

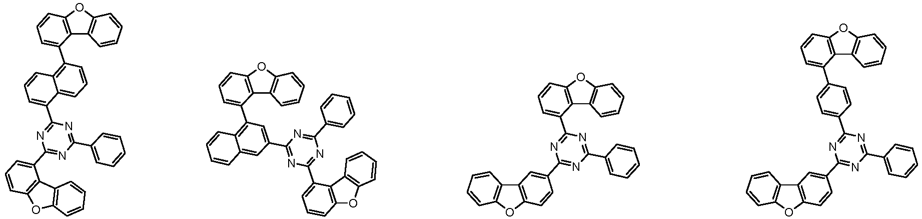

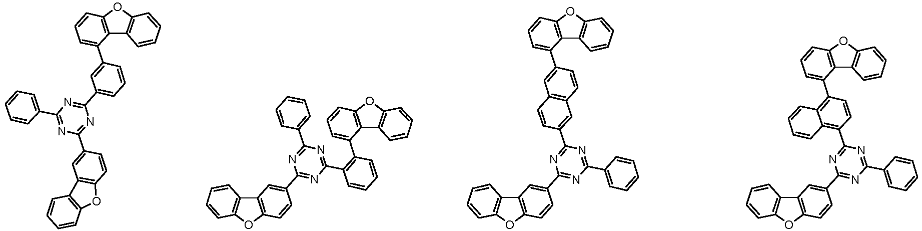

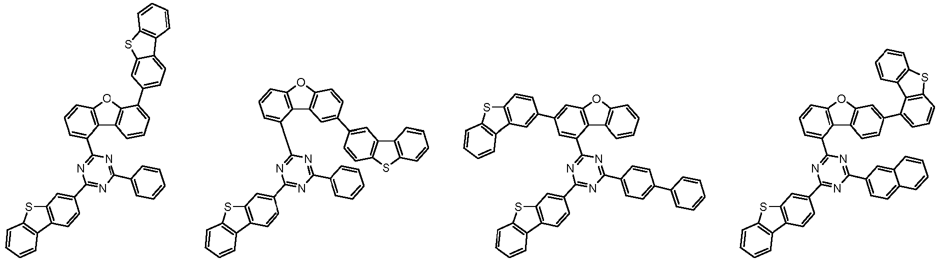

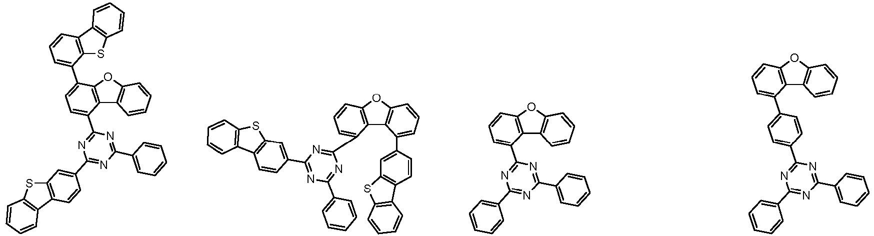

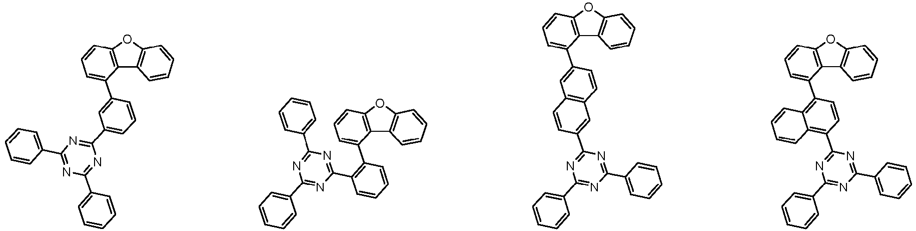

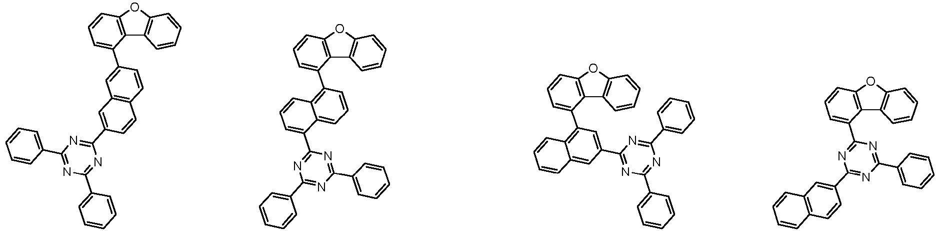

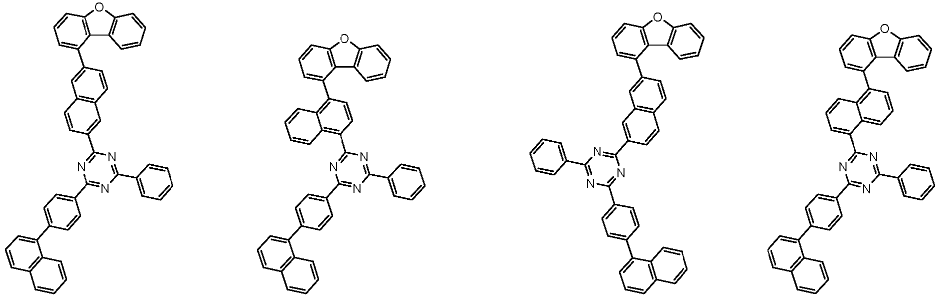

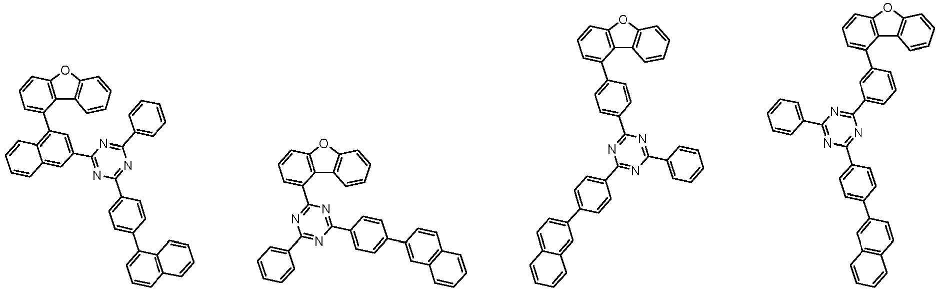

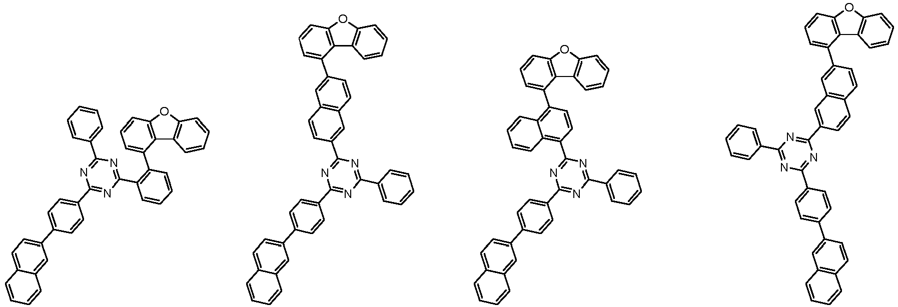

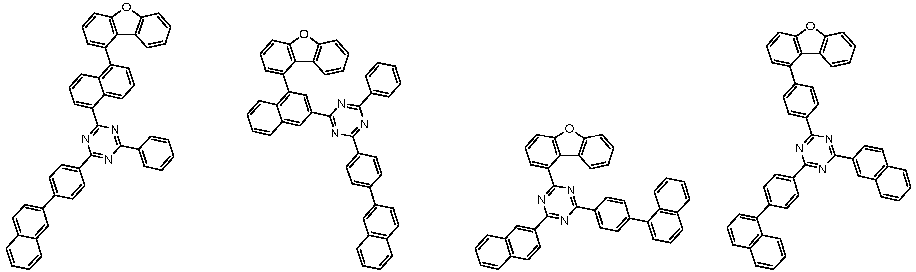

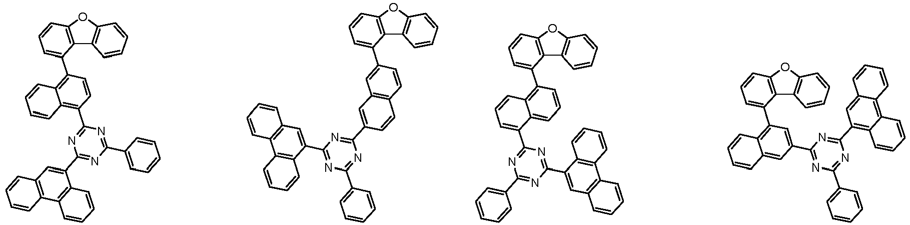

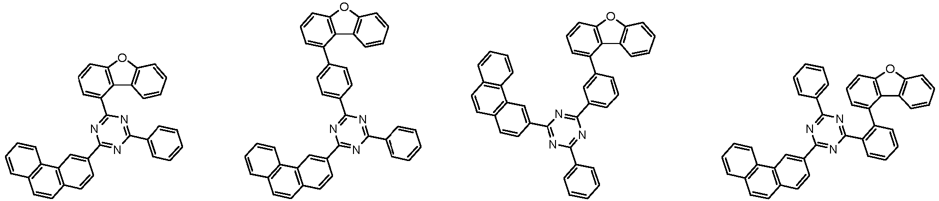

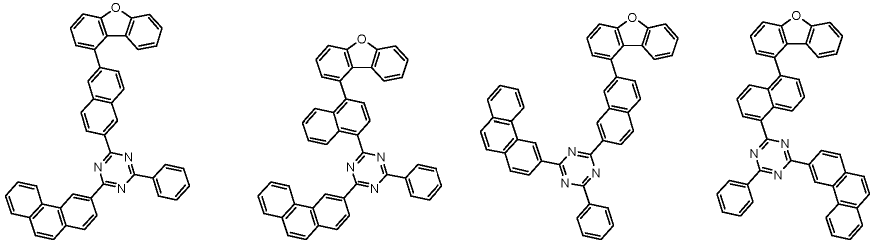

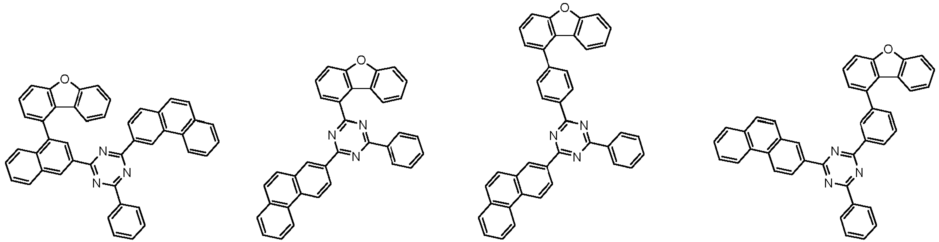

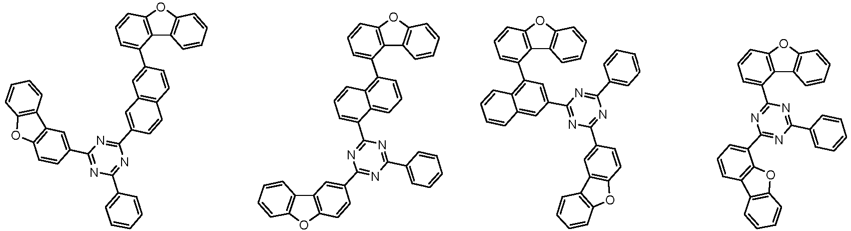

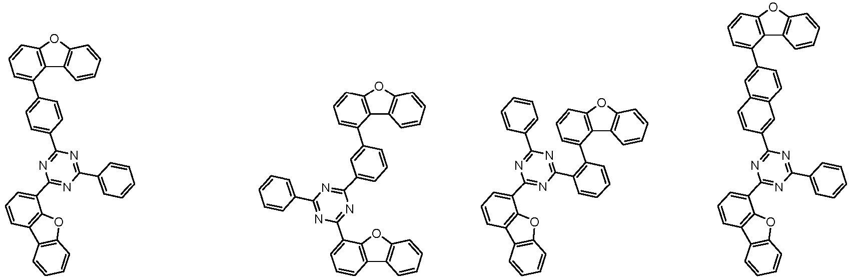

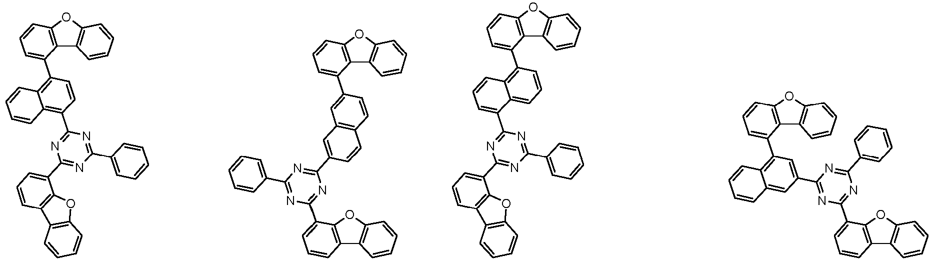

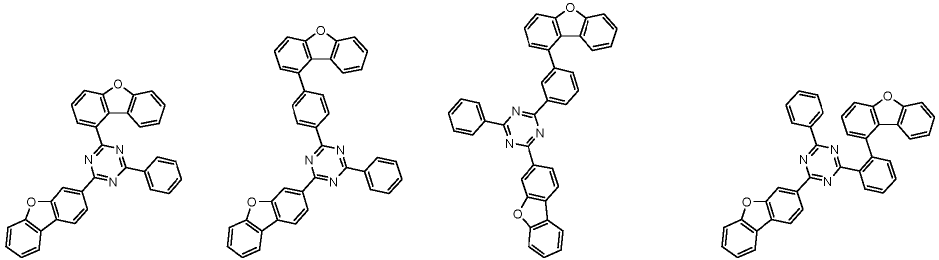

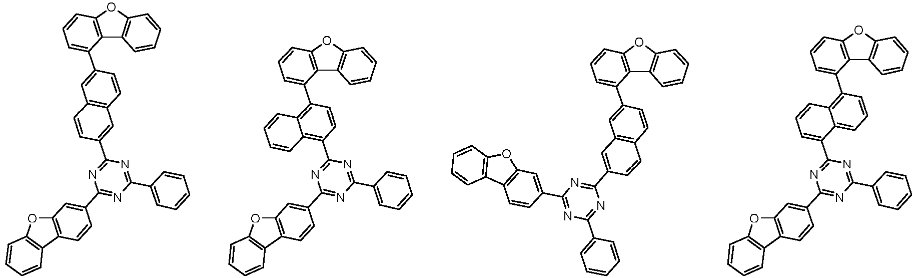

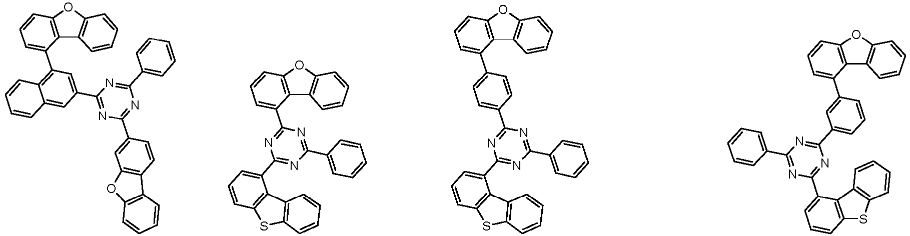

7. Organische lichtemittierende Vorrichtung nach Anspruch 1, wobei:
R' ein Substituent mit der chemischen Formel 4, oder Phenyl, Biphenyl oder Naphthyl ist.

8. Organische lichtemittierende Vorrichtung nach Anspruch 1, wobei:
L' eine Einfachbindung, Phenylen, Biphenyldiyl, Terphenyldiyl, Naphthylen oder -(Phenylen)-(Naphthylen)-ist.

9. Organische lichtemittierende Vorrichtung nach Anspruch 1, wobei:
L'₁ und L'₂ jeweils unabhängig voneinander eine Einfachbindung, Phenylen oder Biphenyldiyl sind.

10. Organische lichtemittierende Vorrichtung nach Anspruch 1, wobei:
Ar'₁ und Ar'₂ jeweils unabhängig voneinander Phenyl, Biphenylyl, Terphenylyl, Naphthyl, Naphthylphenyl, Phenylnaphthyl, Phenanthrenyl, Dimethylfluorenyl, Diphenylfluorenyl, Dibenzofuranyl, Dibenzothiophenyl, 9H-Carbazol-9-yl oder 9-Phenyl-9H-carbazolyl sind.

11. Organische lichtemittierende Vorrichtung nach Anspruch 1, wobei:
die Verbindung mit der chemischen Formel 2 oder der chemischen Formel 3 eine beliebige Verbindung ist, ausgewählt aus der Gruppe bestehend aus:

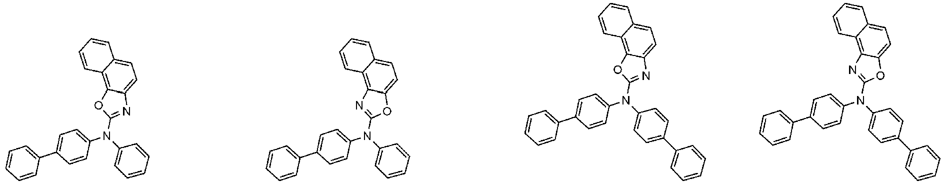

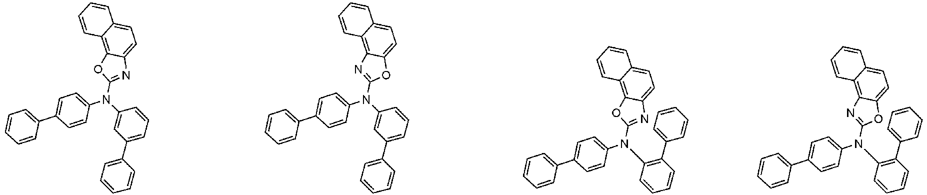

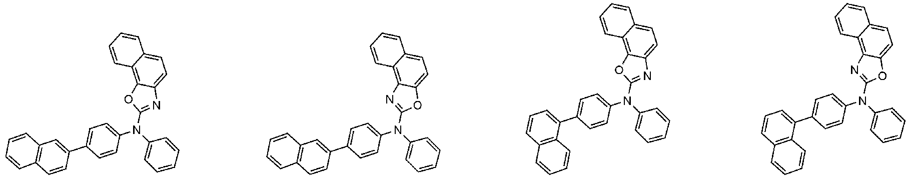

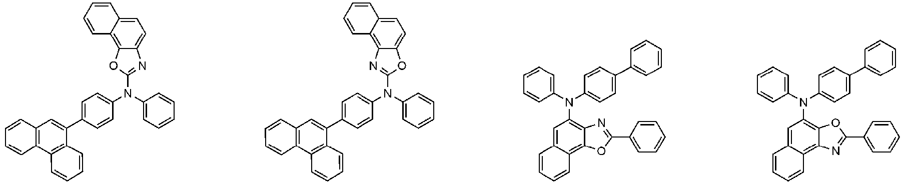

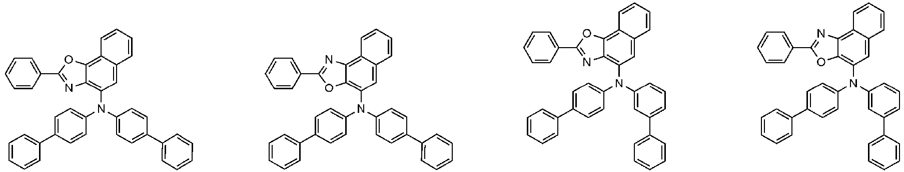

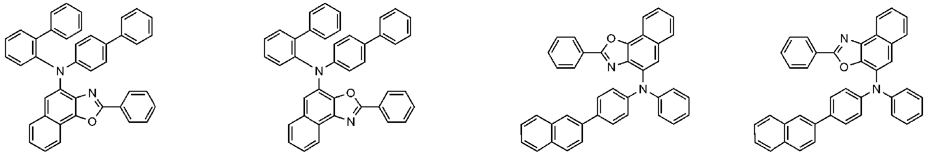

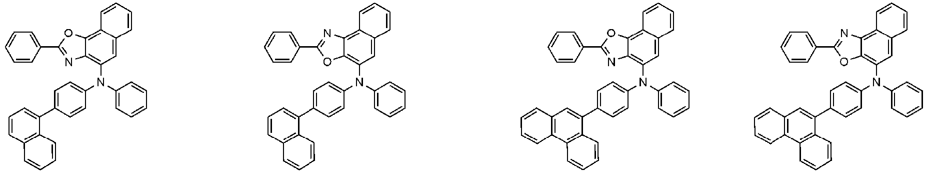

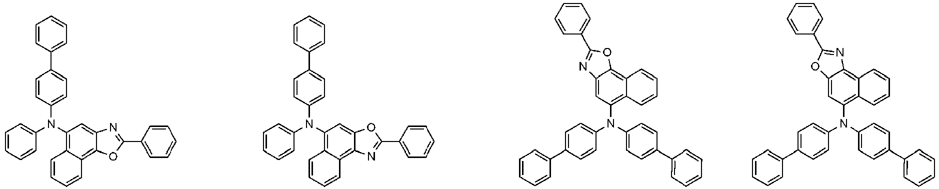

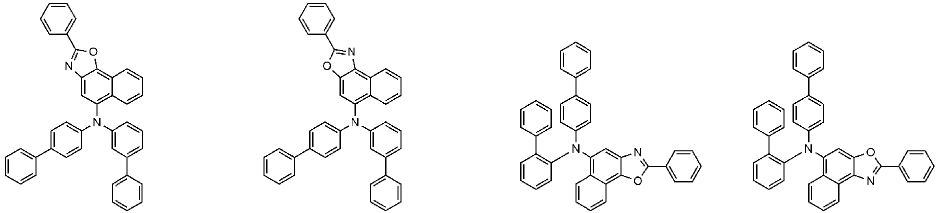

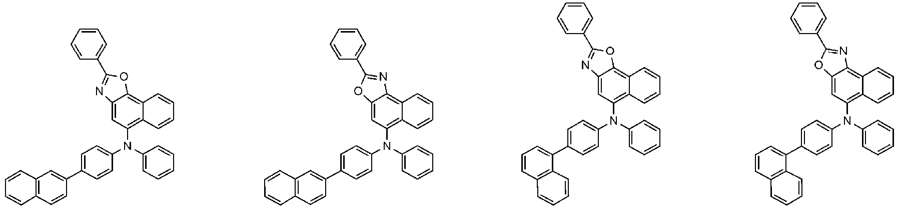

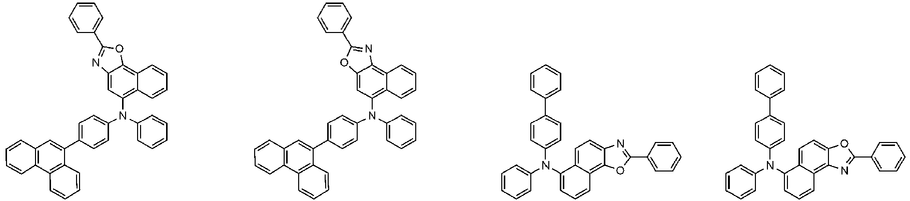

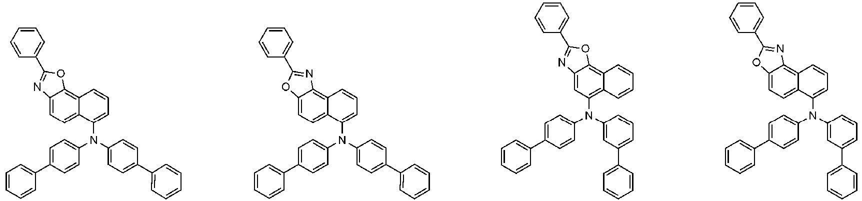

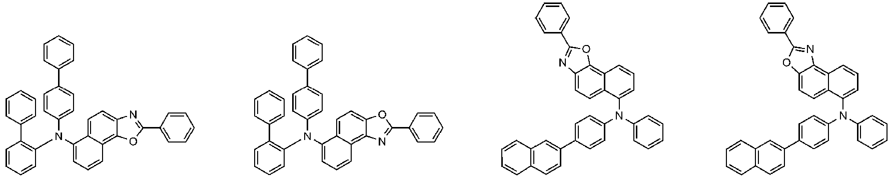

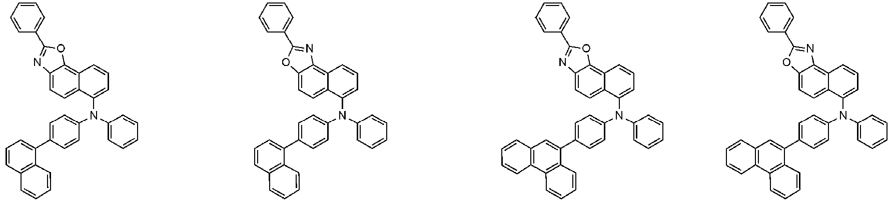

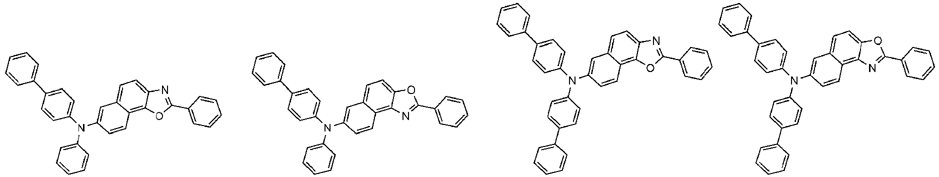

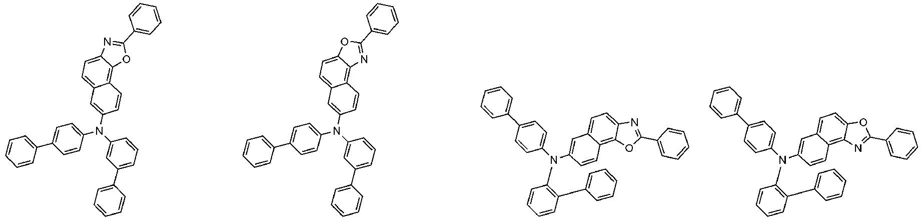

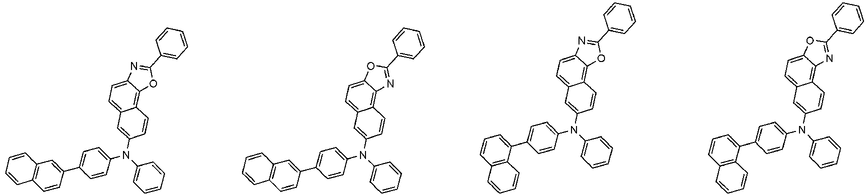

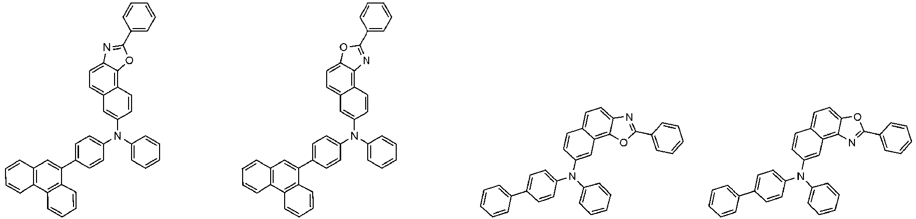

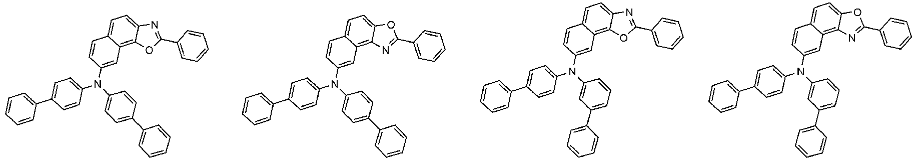

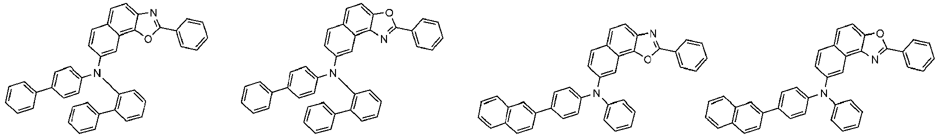

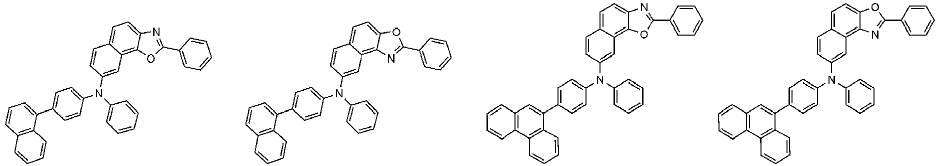

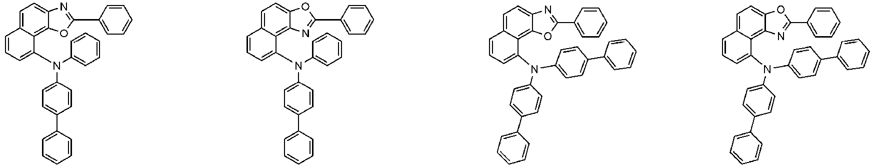

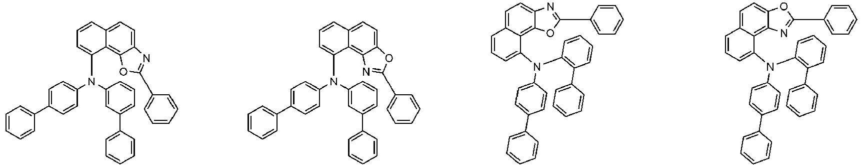

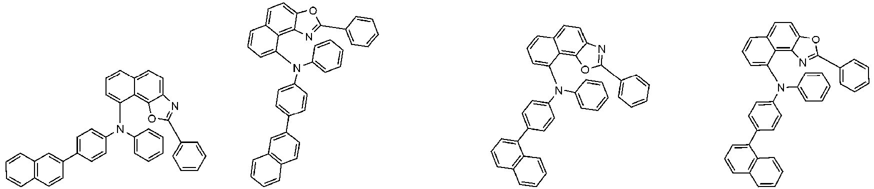

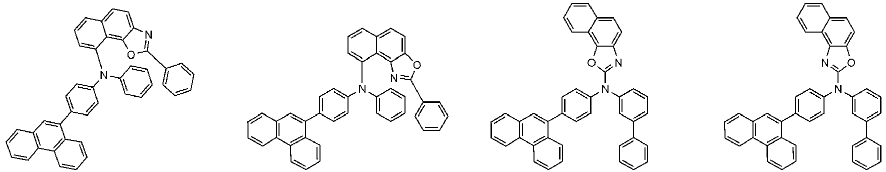

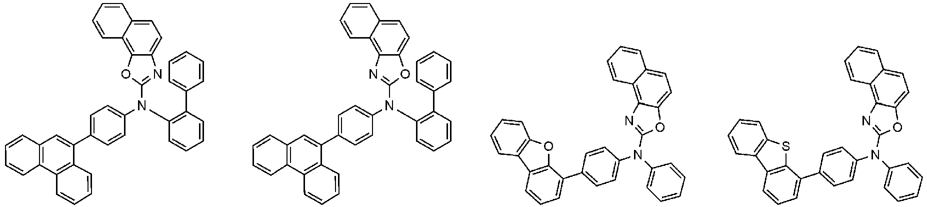

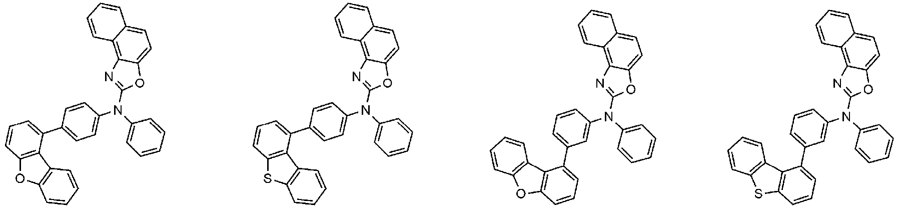

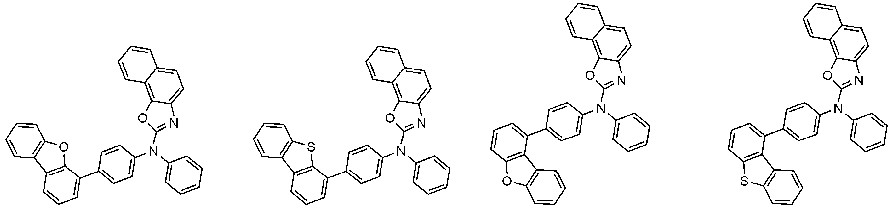

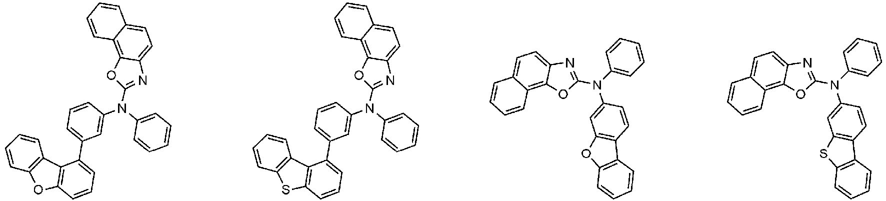

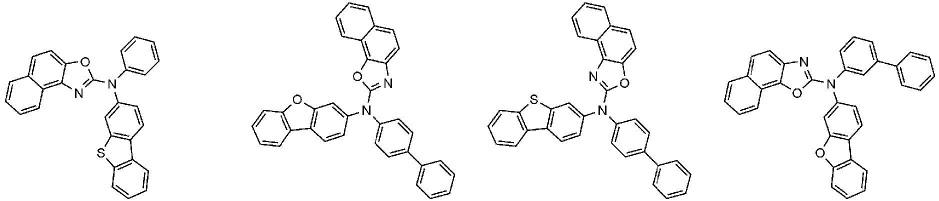

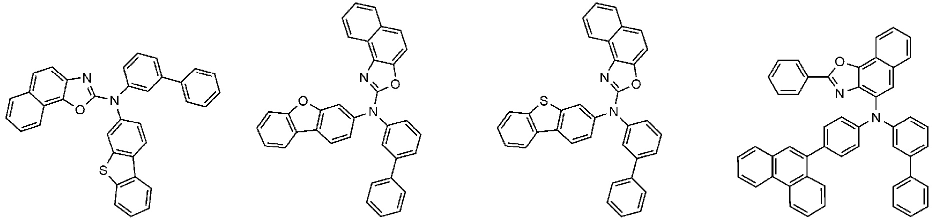

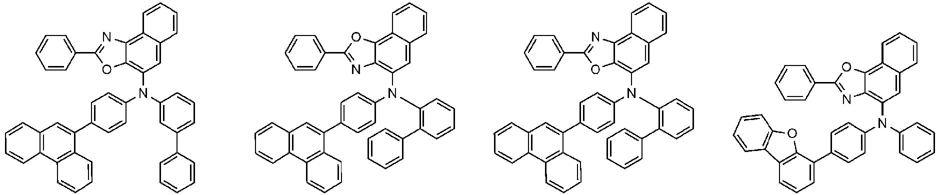

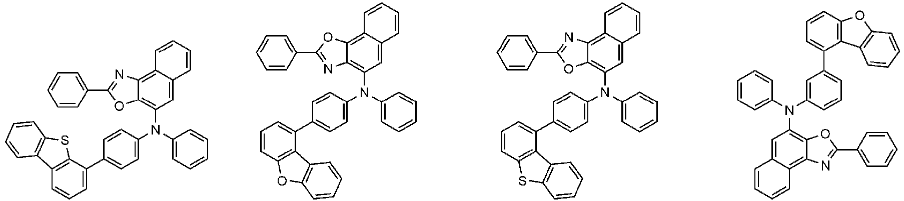

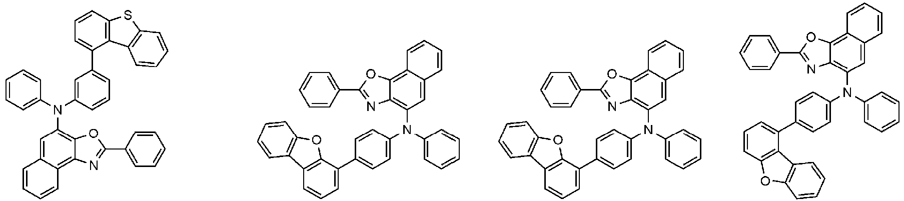

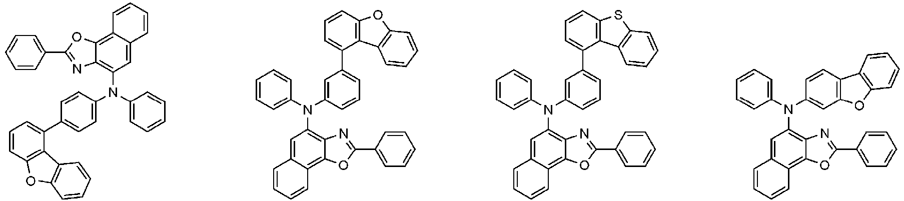

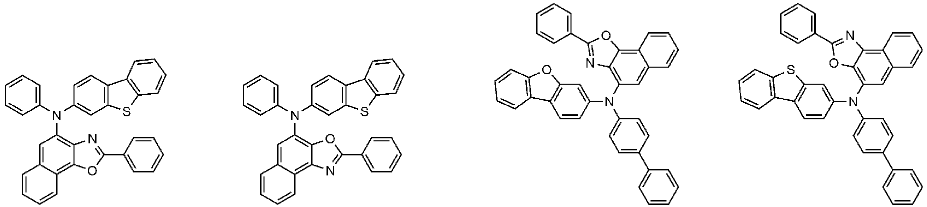

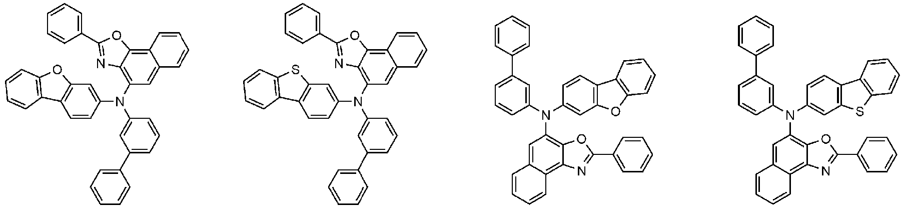

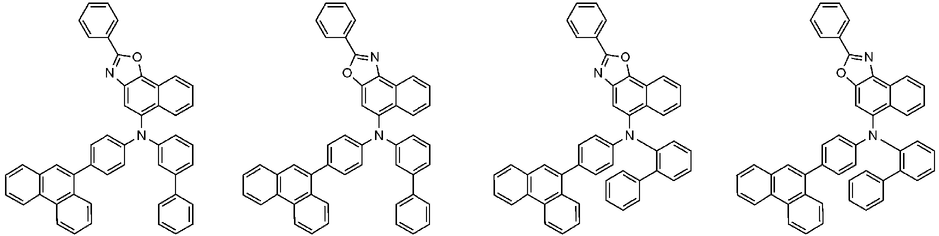

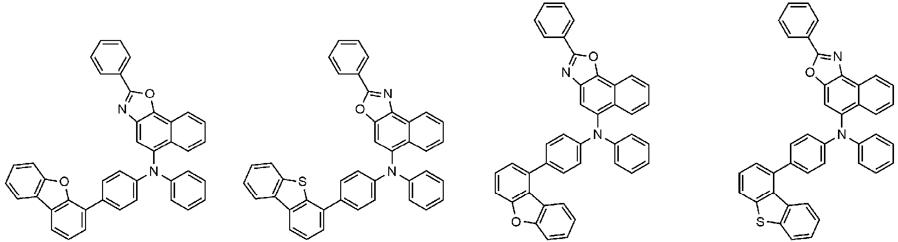

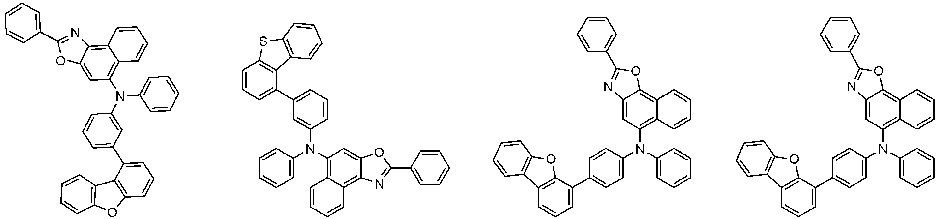

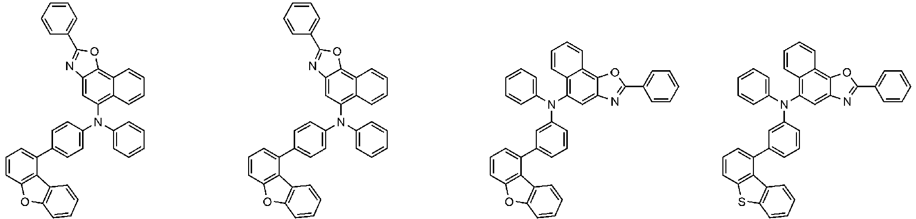

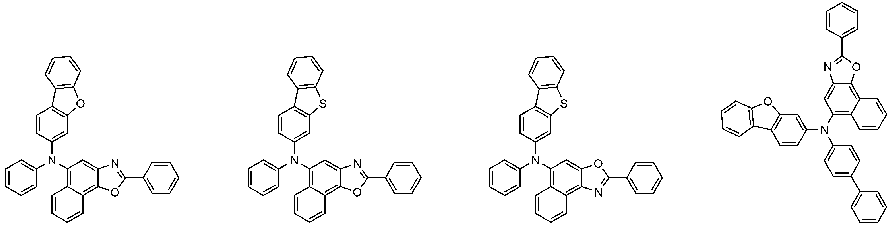

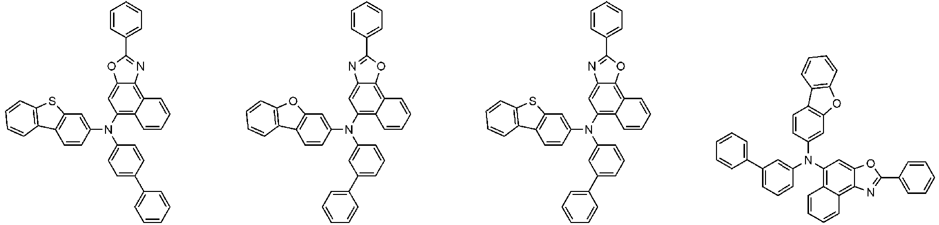

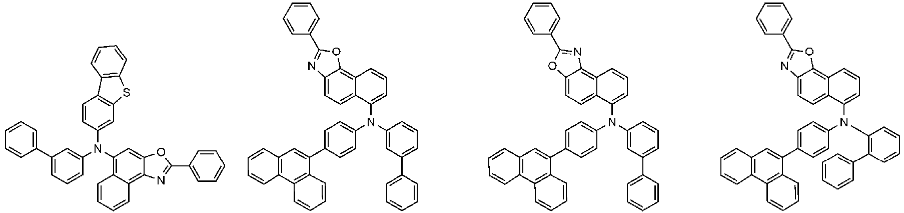

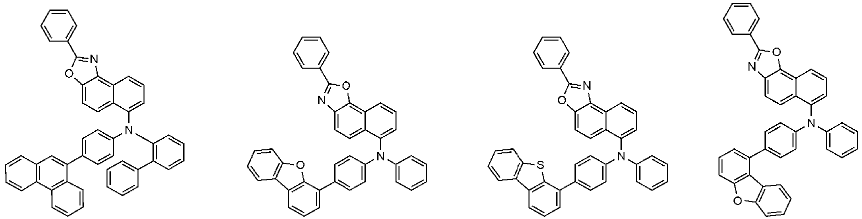

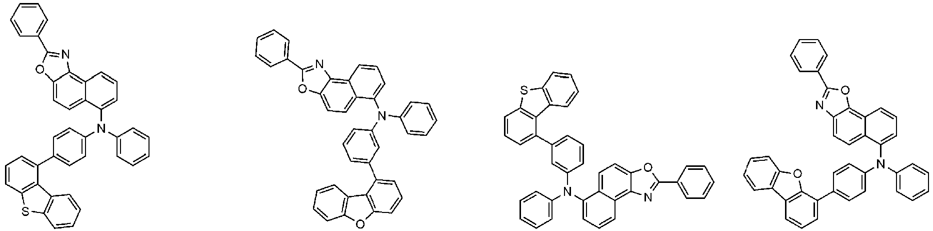

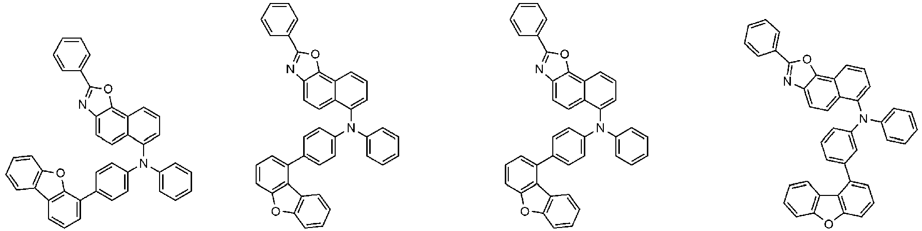

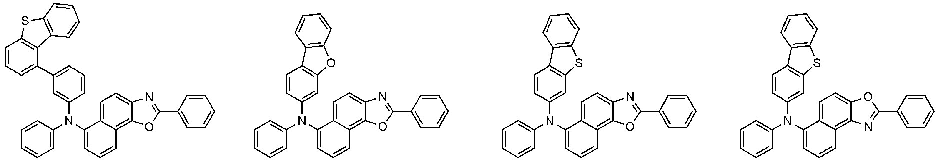

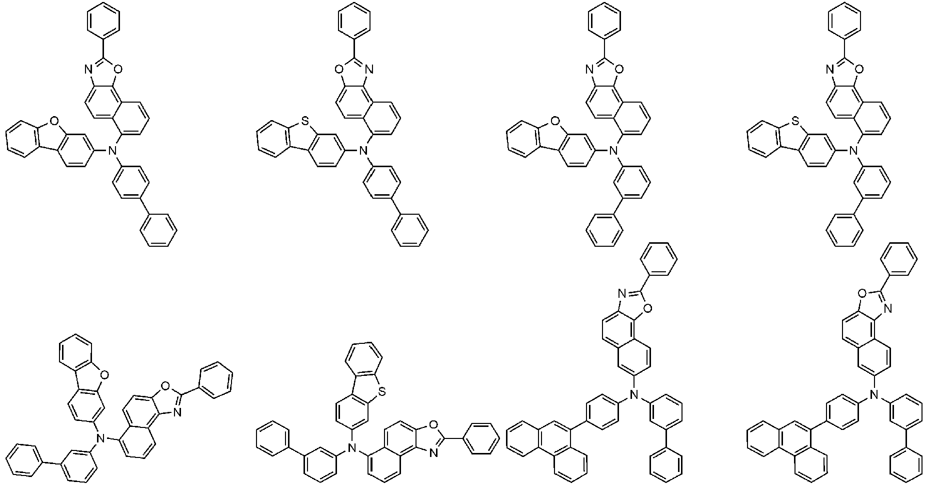

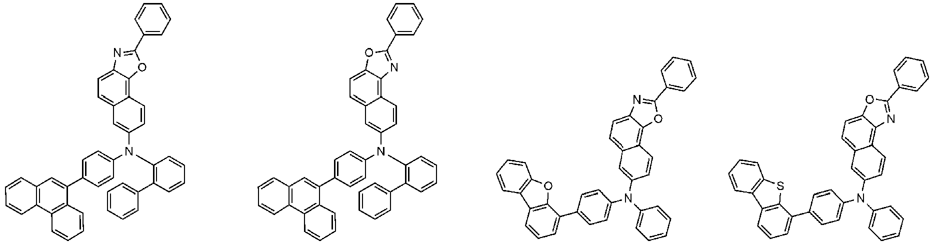

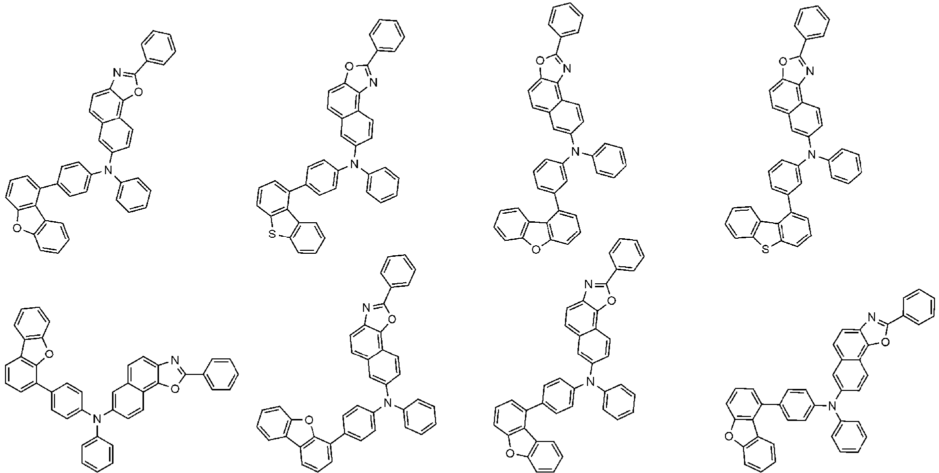

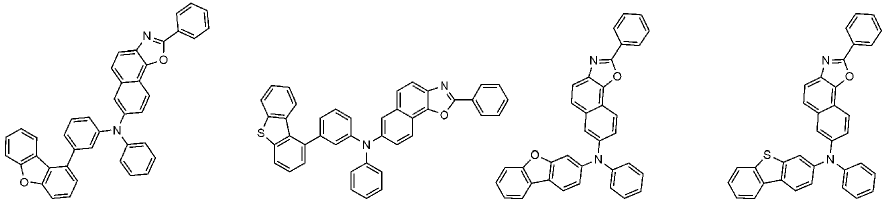

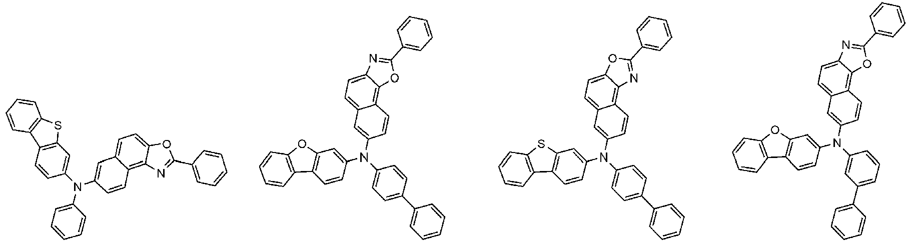

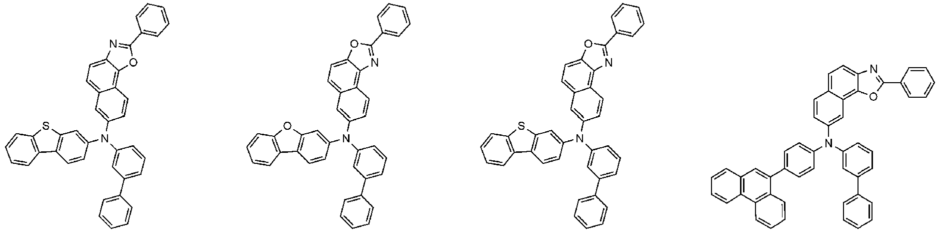

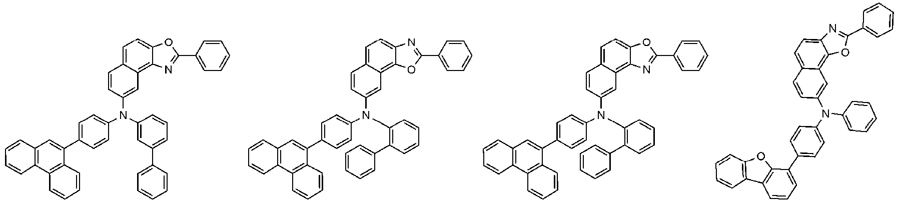

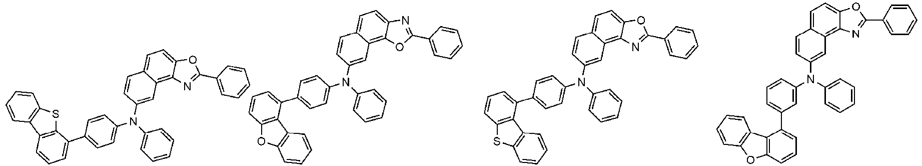

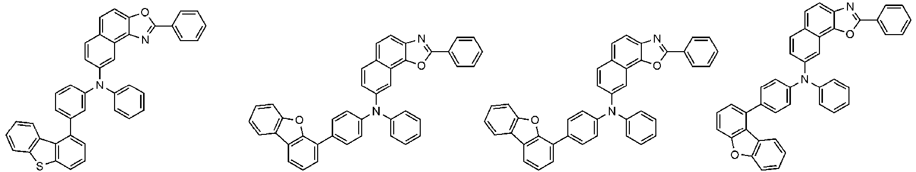

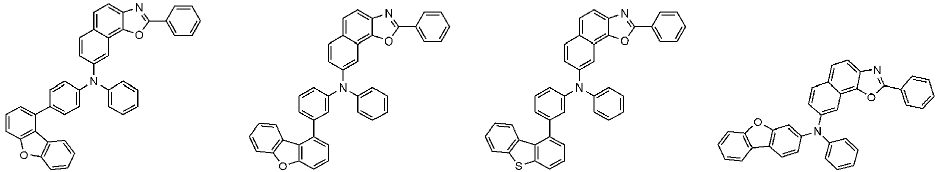

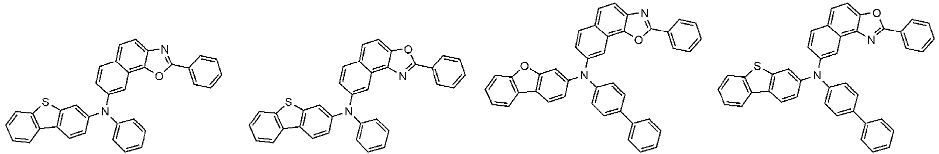

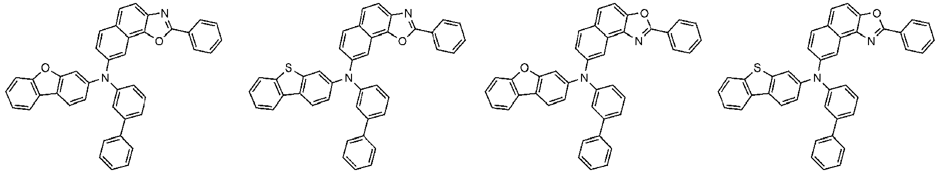

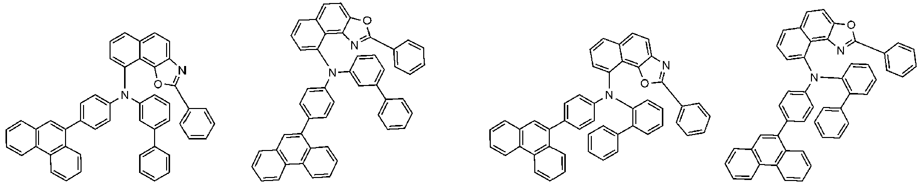

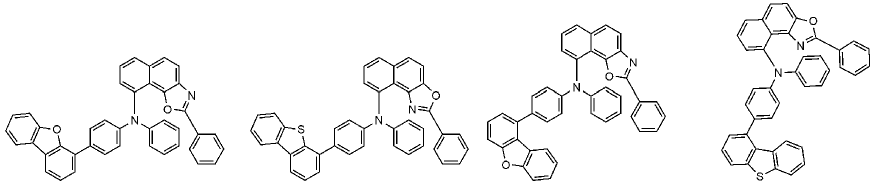

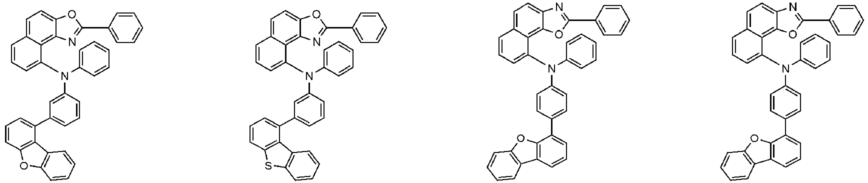

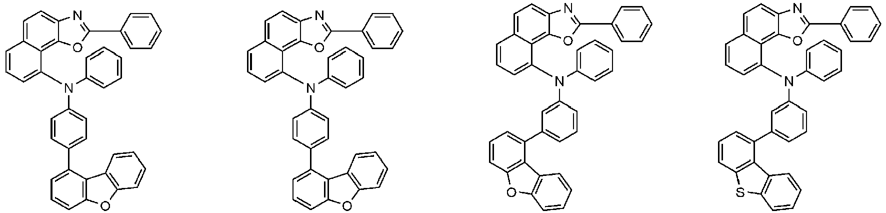

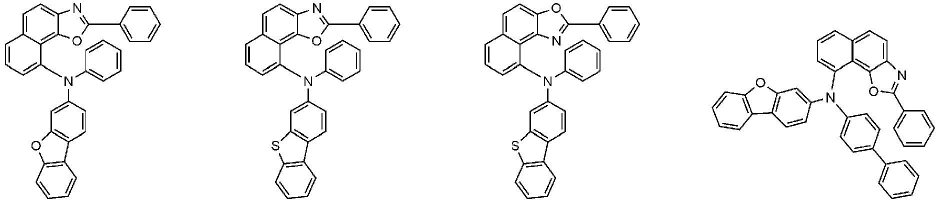

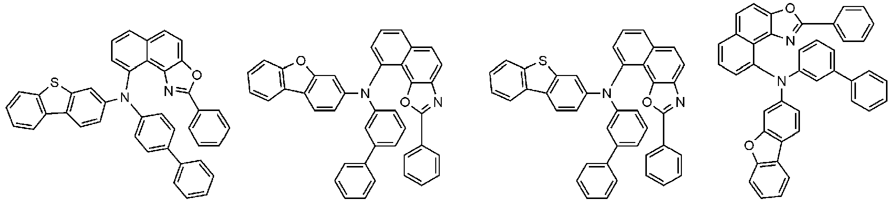

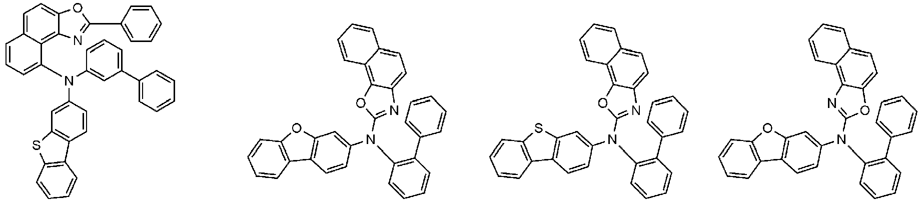

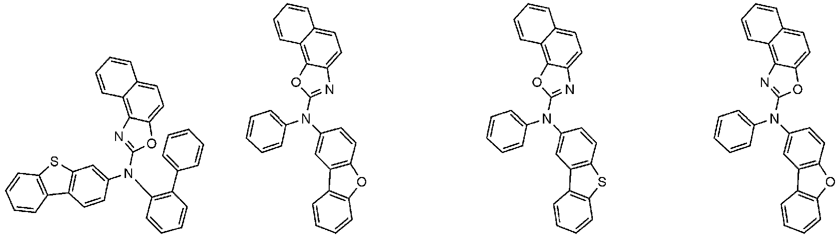

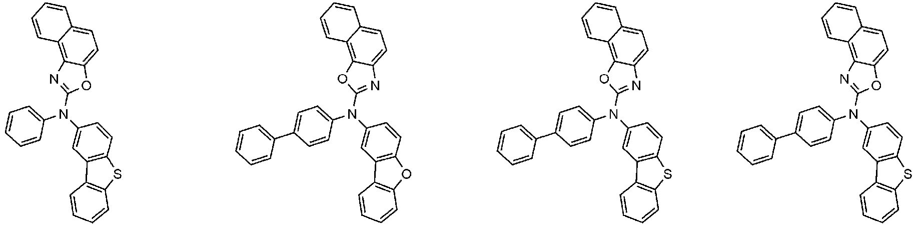

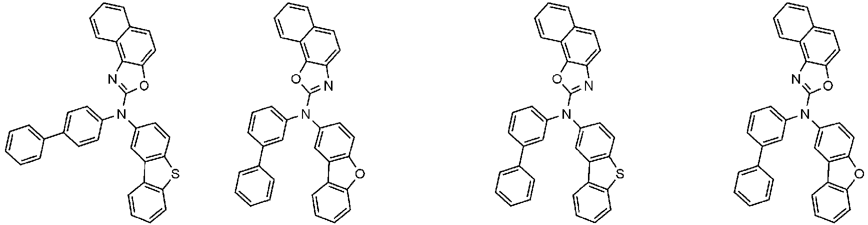

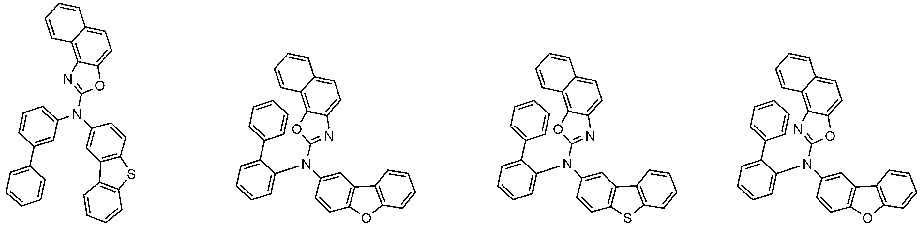

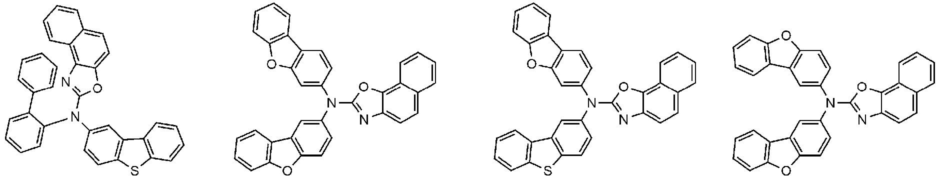

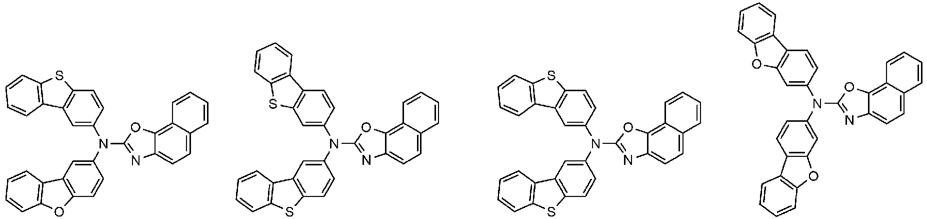

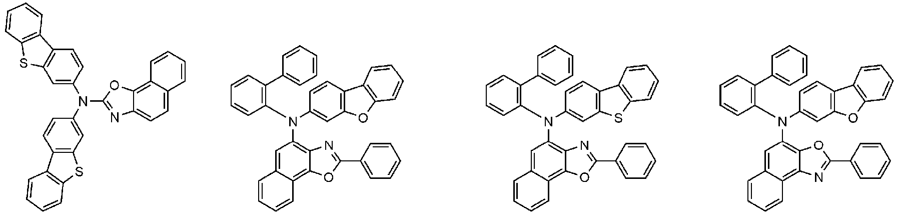

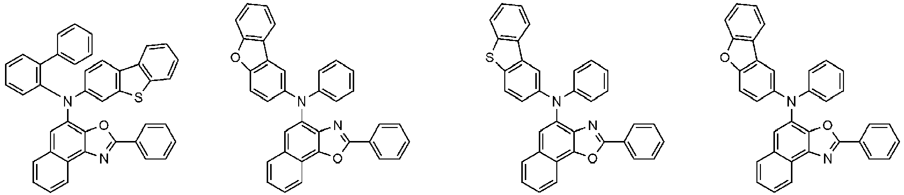

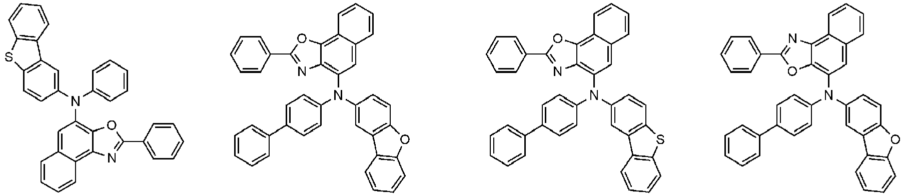

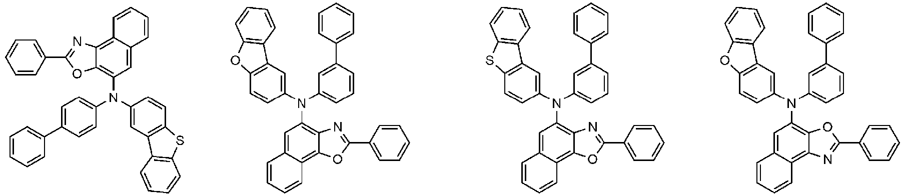

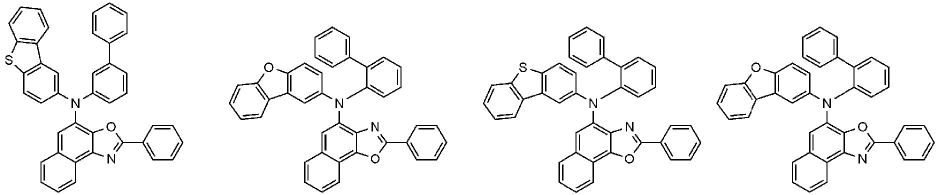

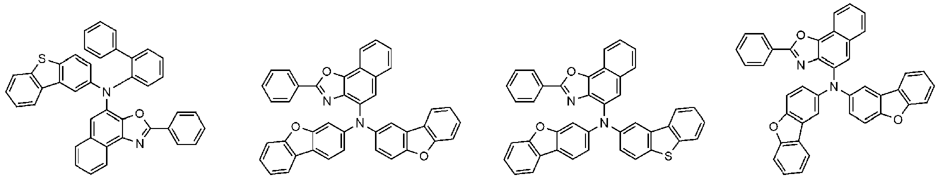

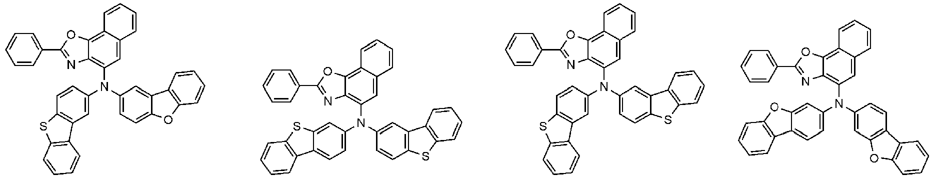

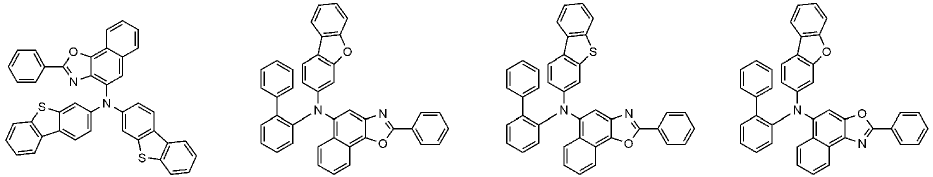

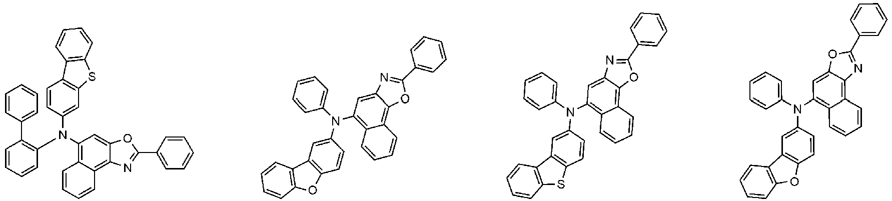

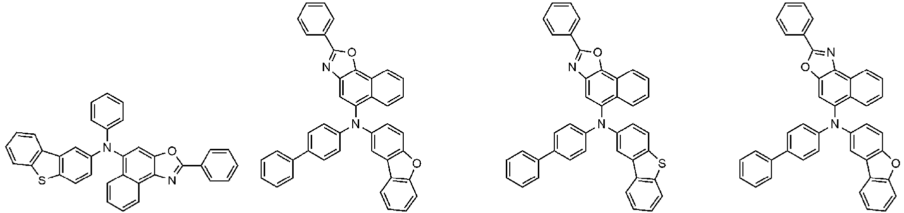

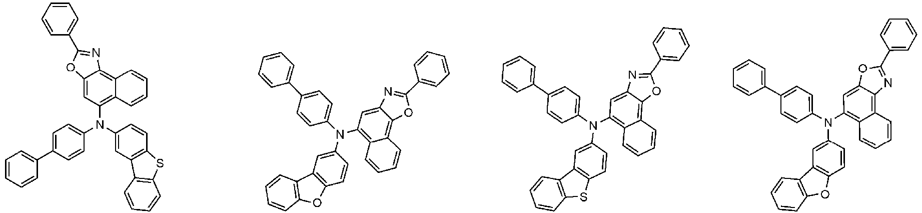

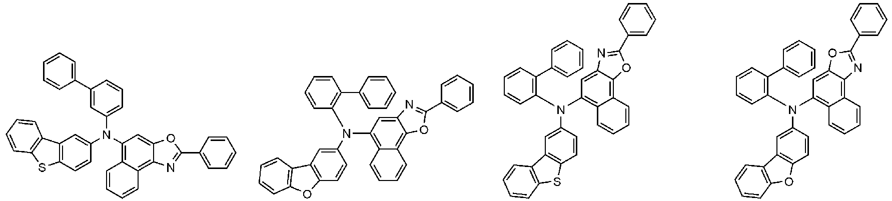

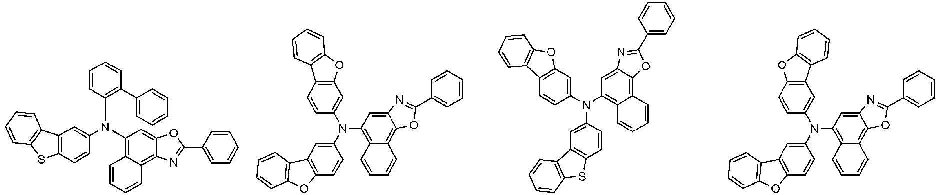

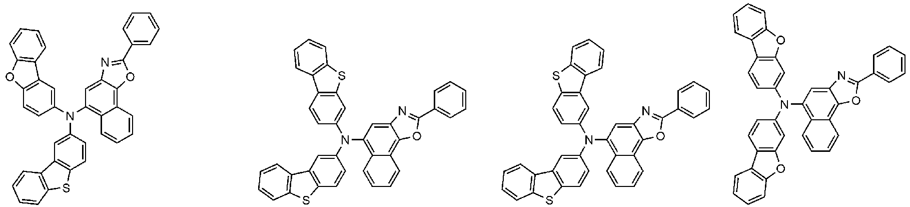

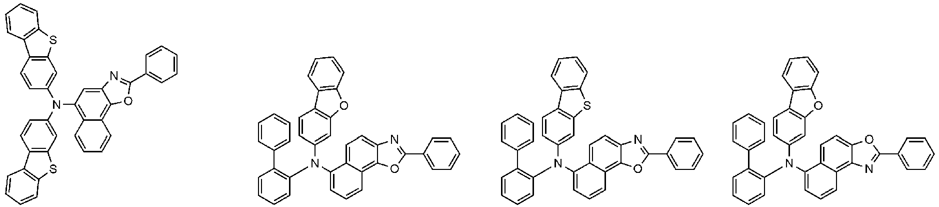

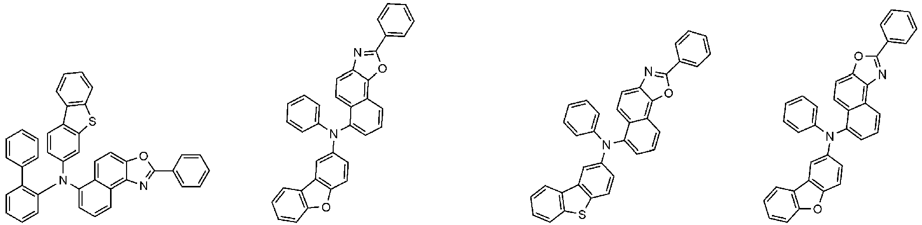

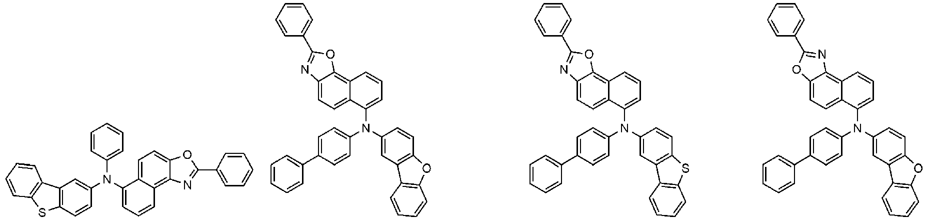

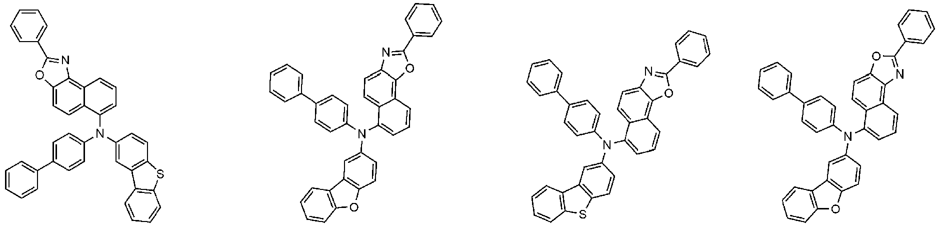

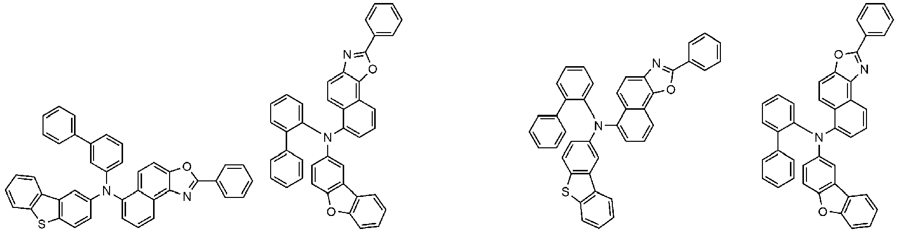

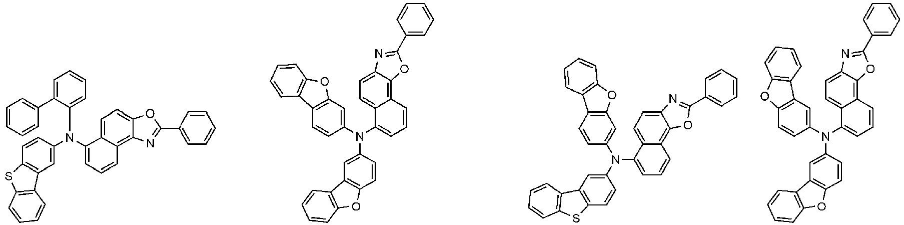

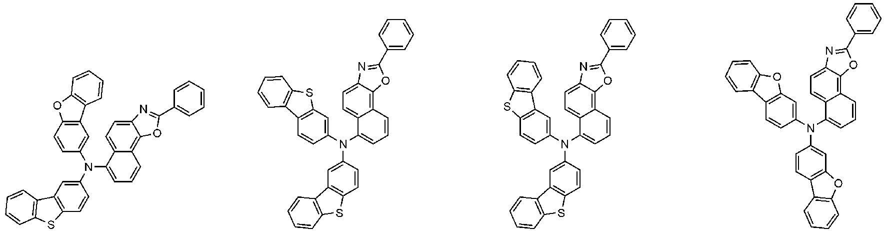

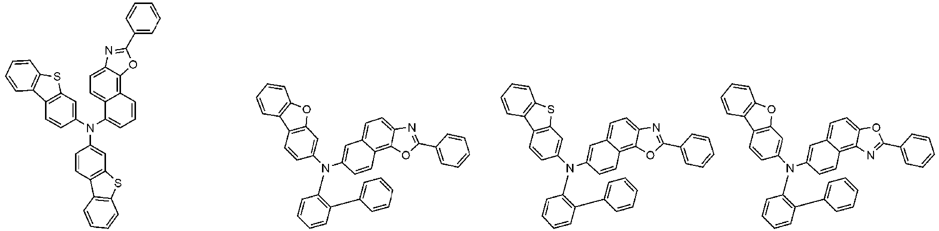

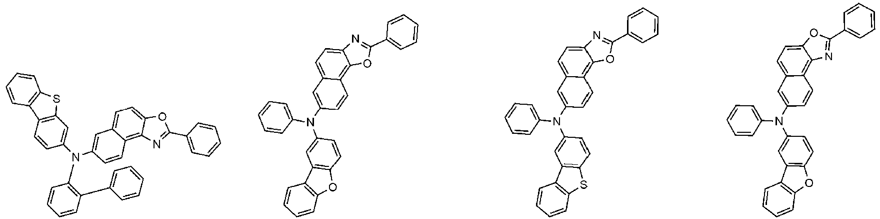

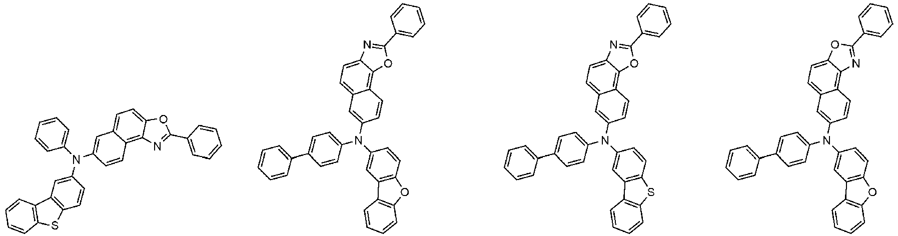

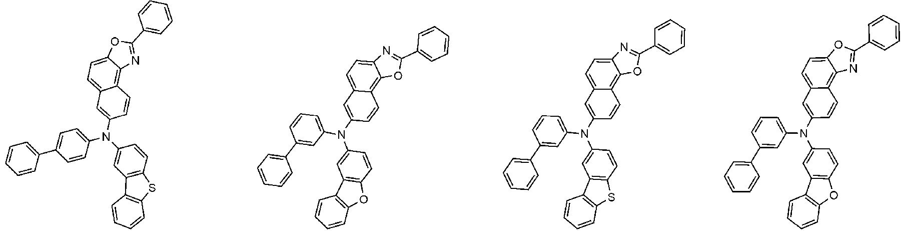

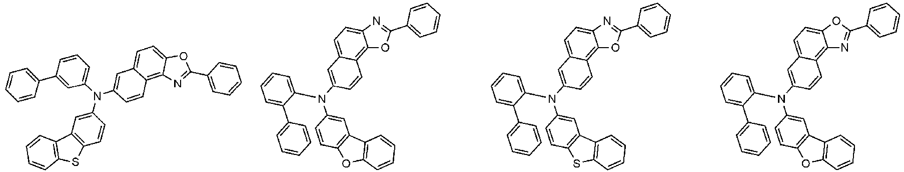

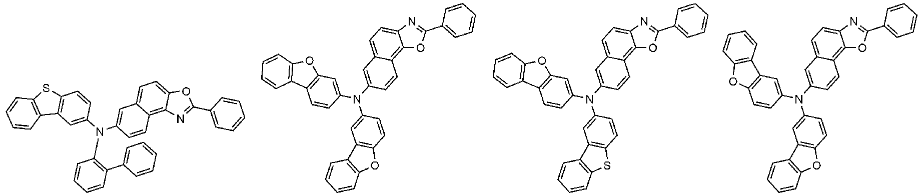

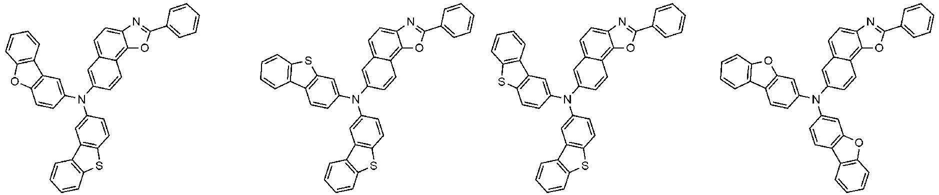

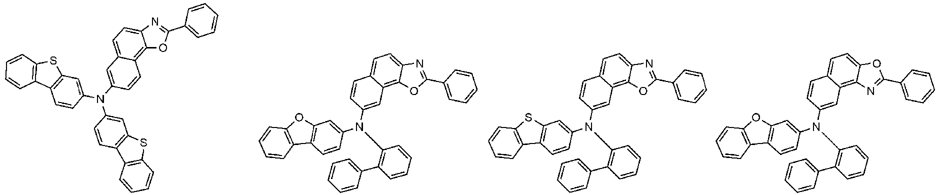

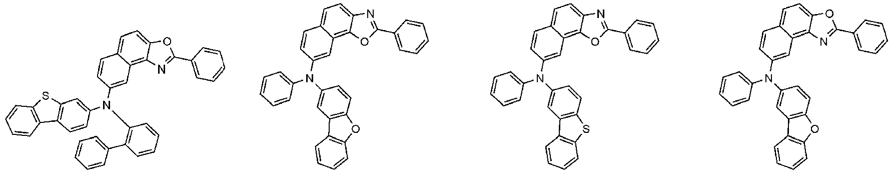

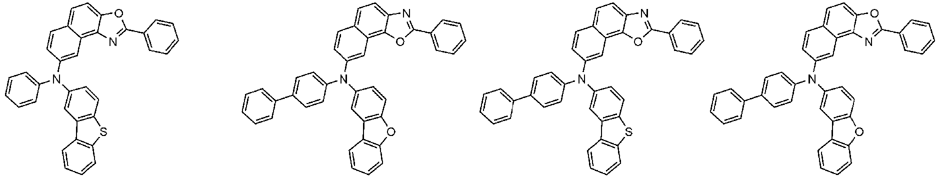

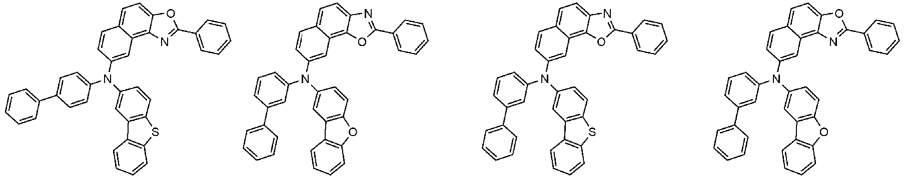

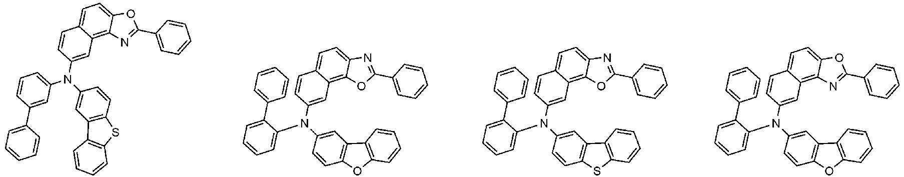

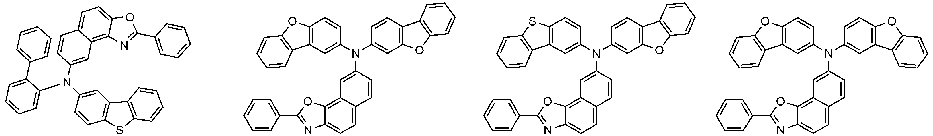

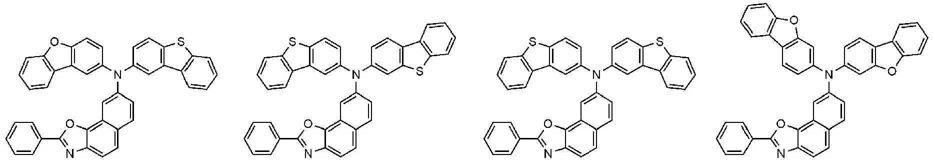

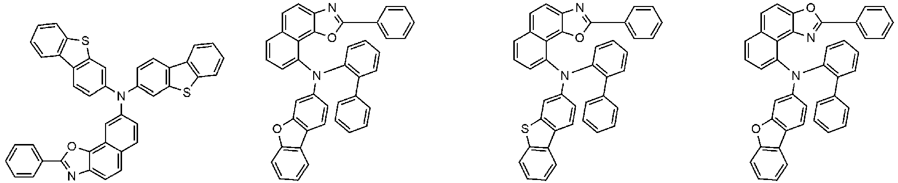

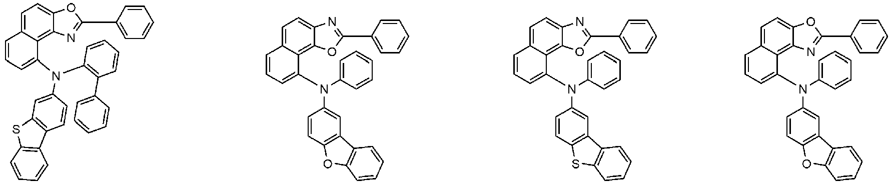

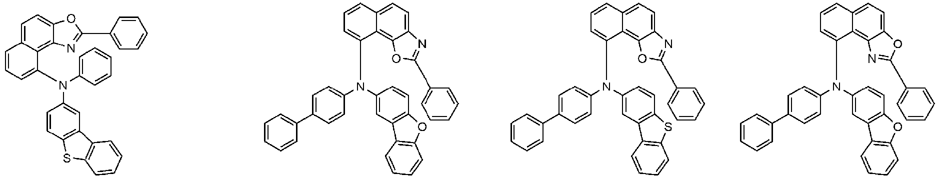

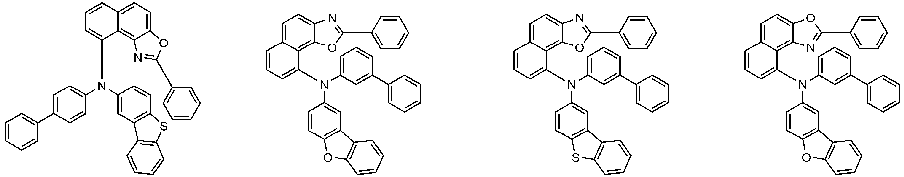

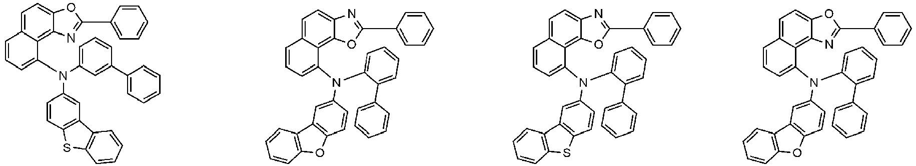

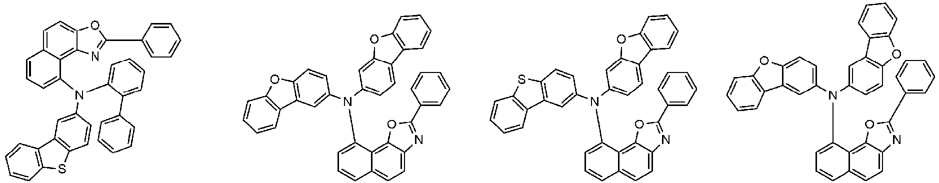

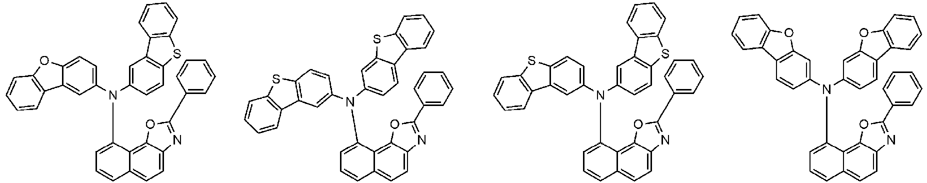

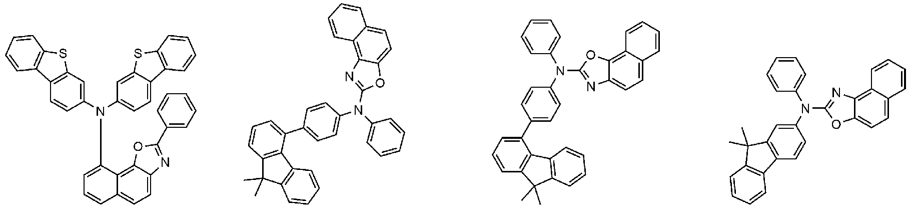

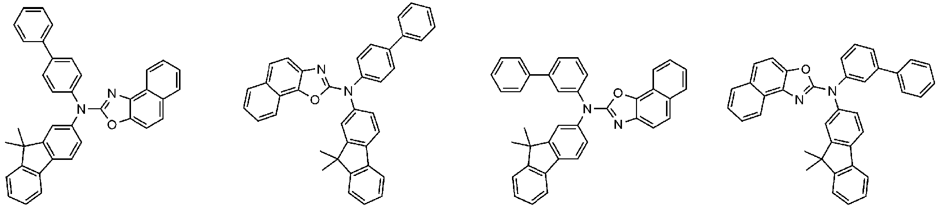

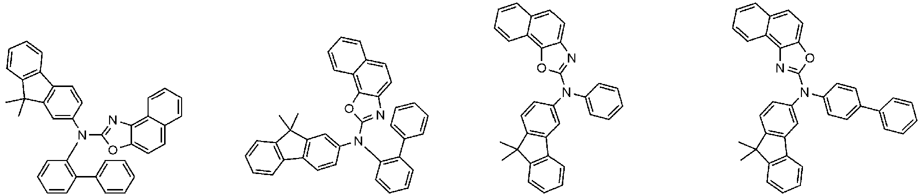

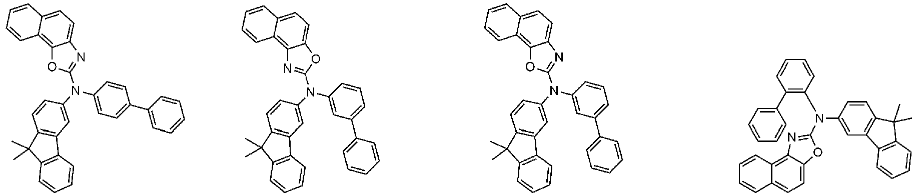

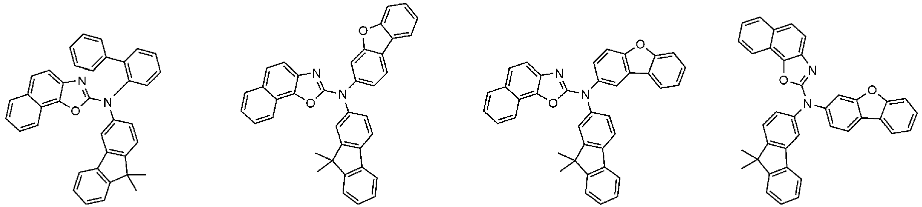

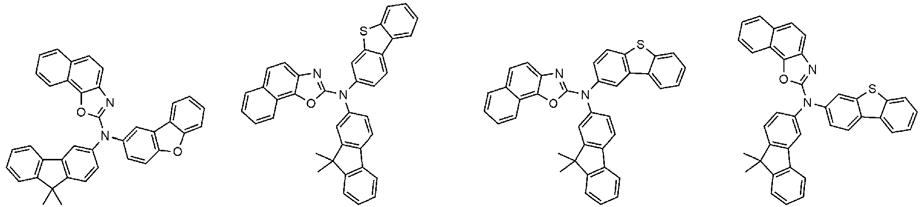

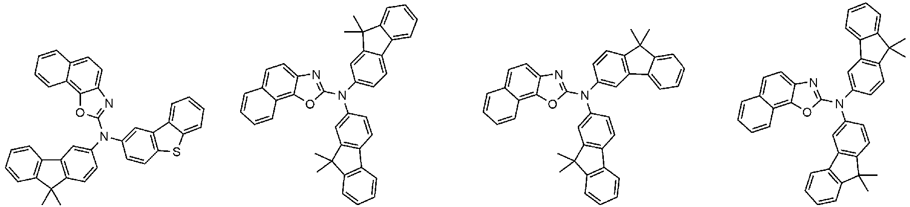

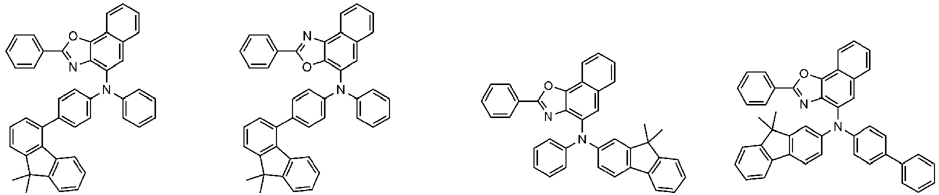

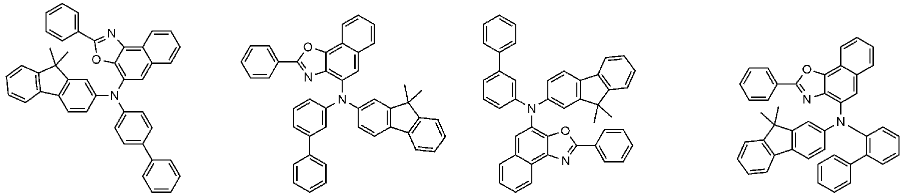

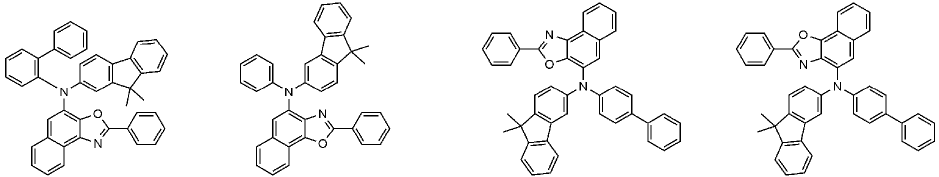

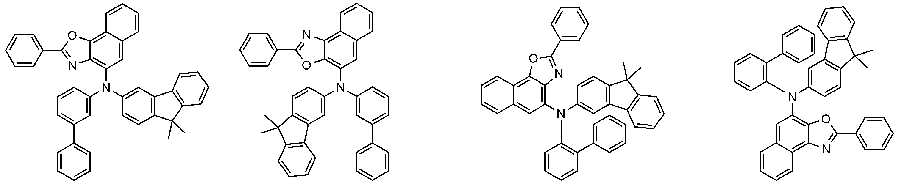

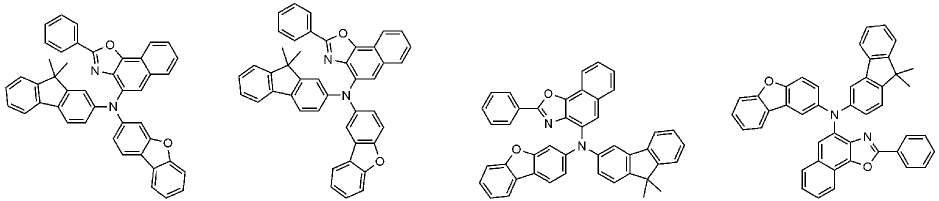

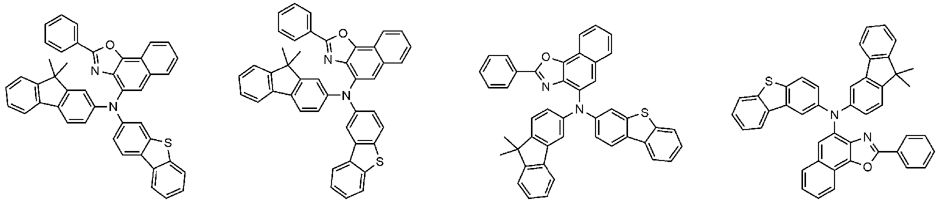

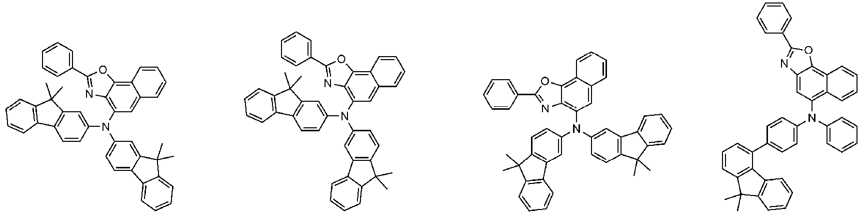

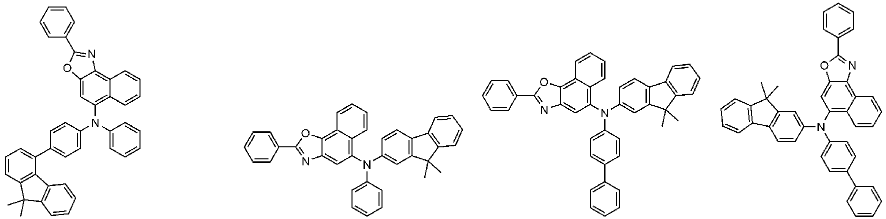

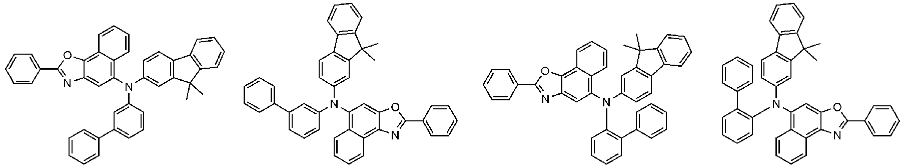

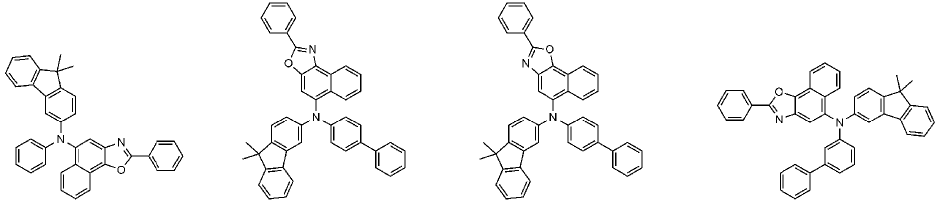

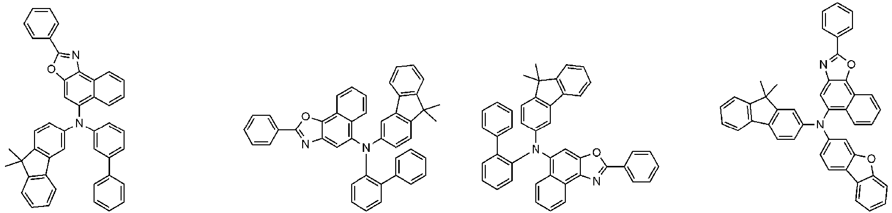

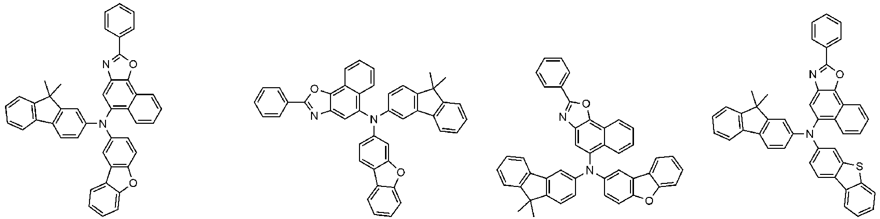

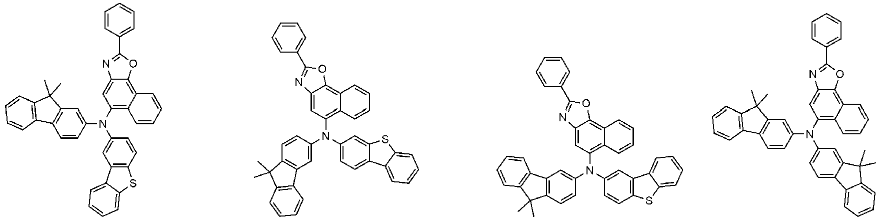

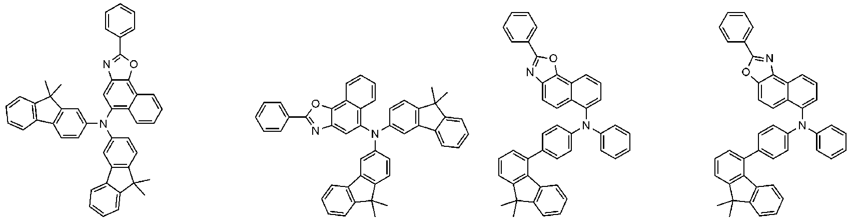

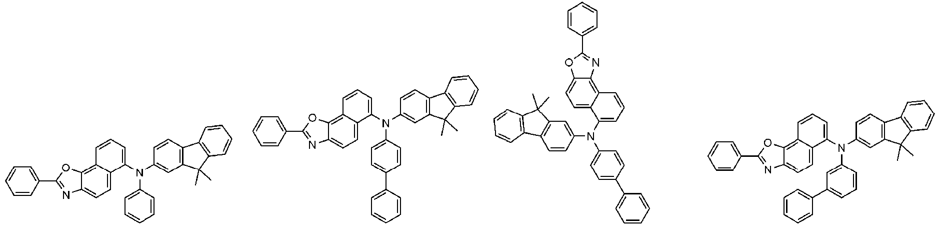

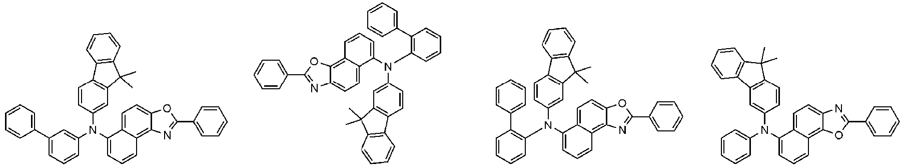

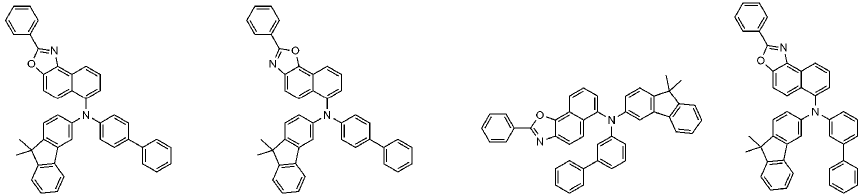

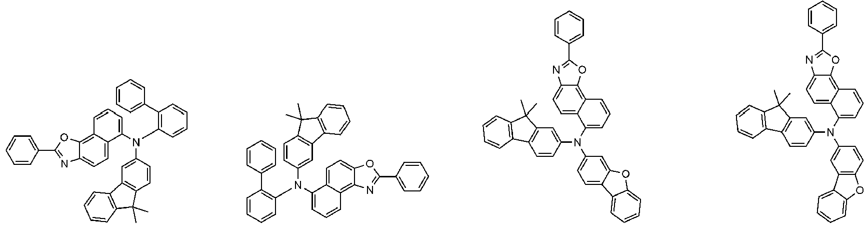

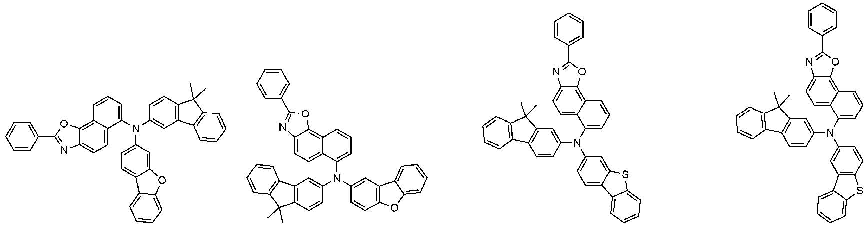

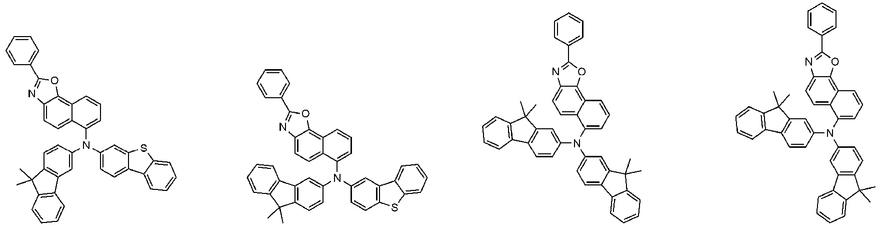

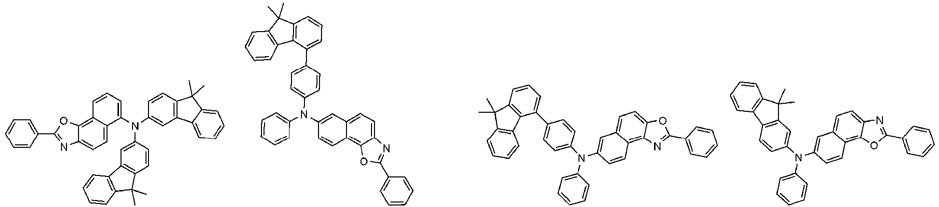

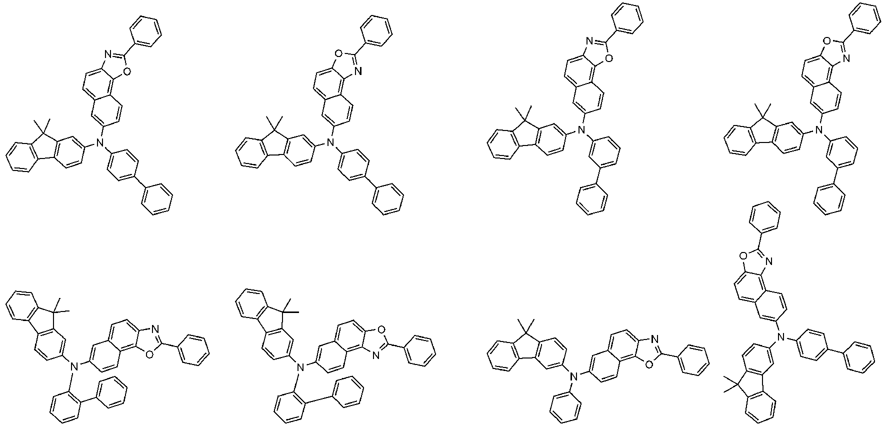

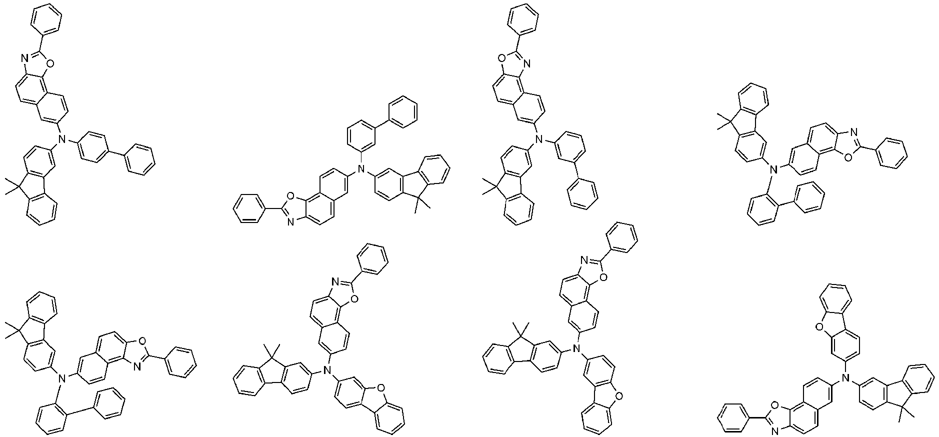

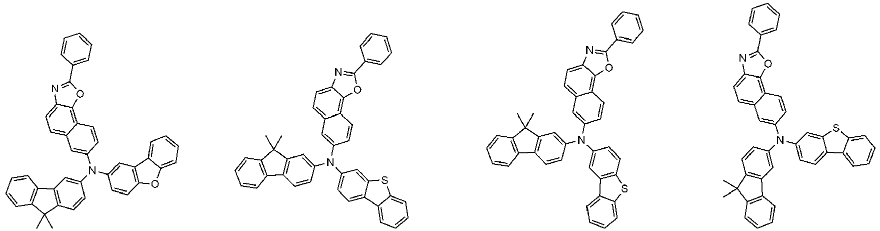

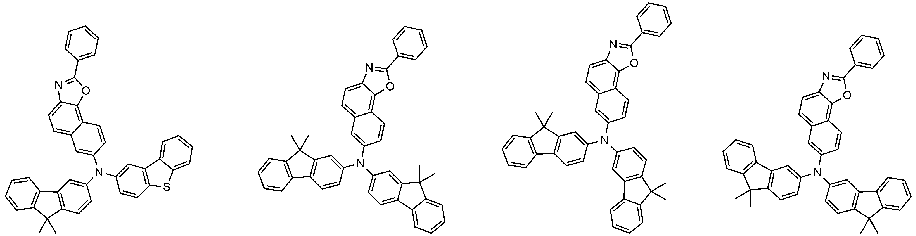

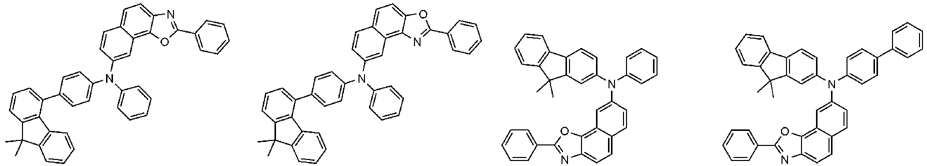

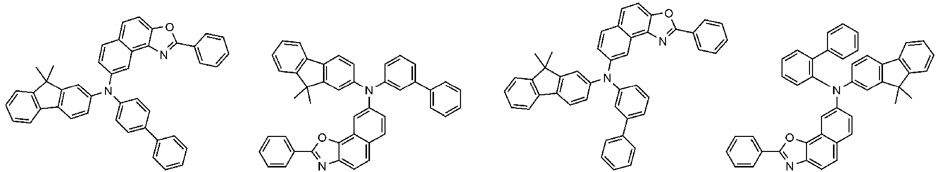

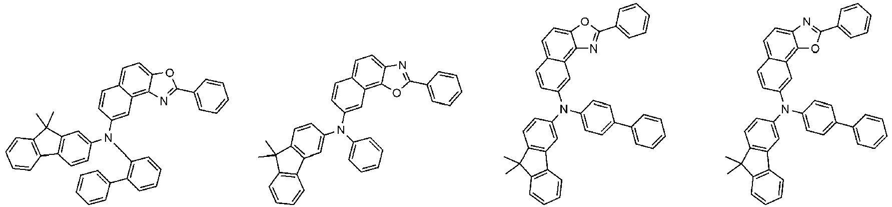

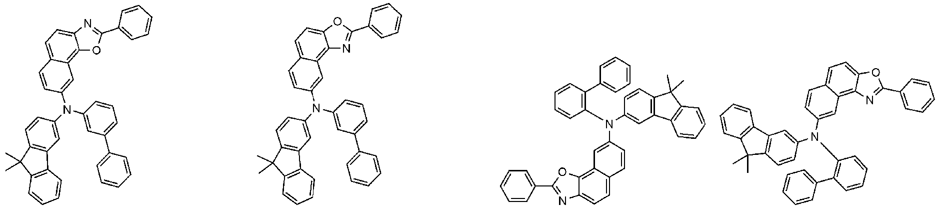

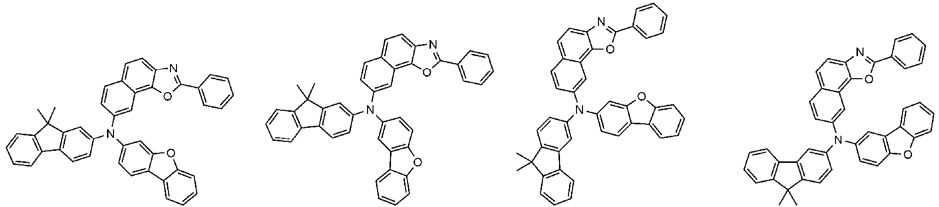

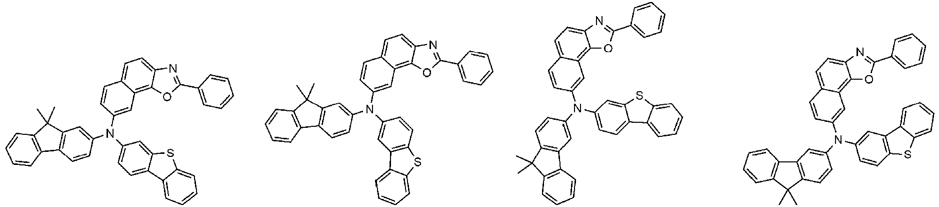

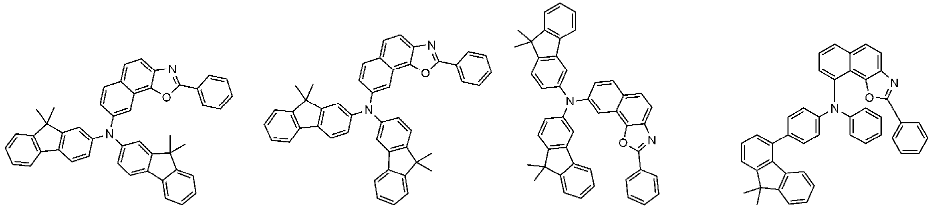

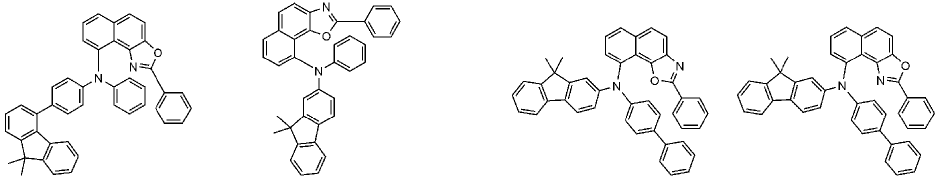

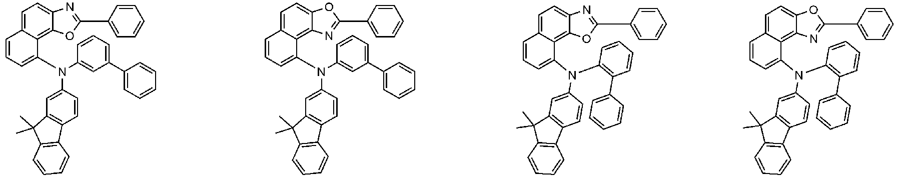

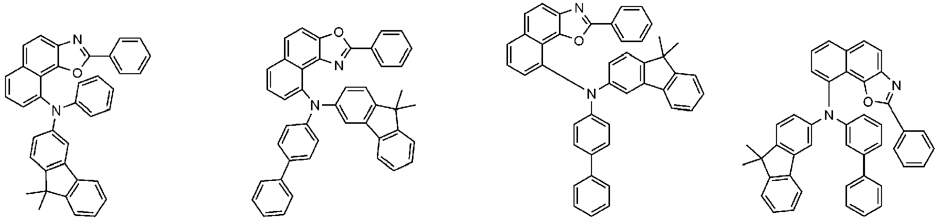

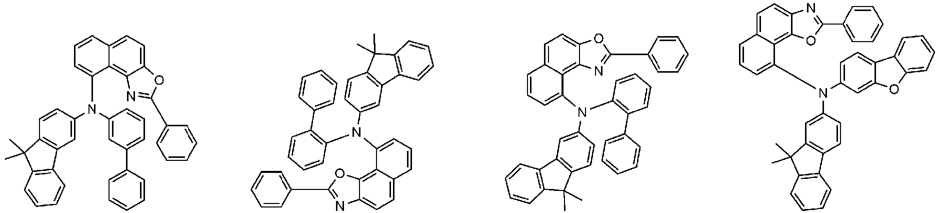

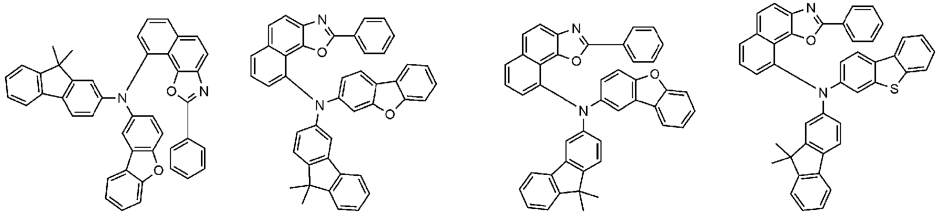

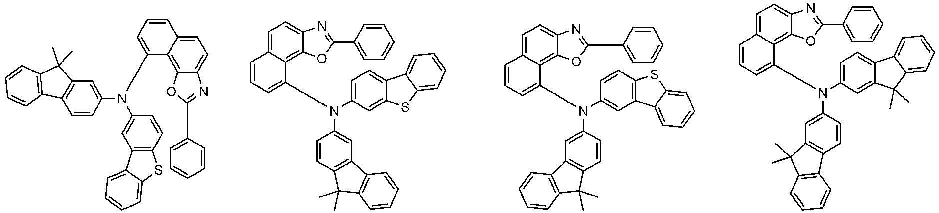

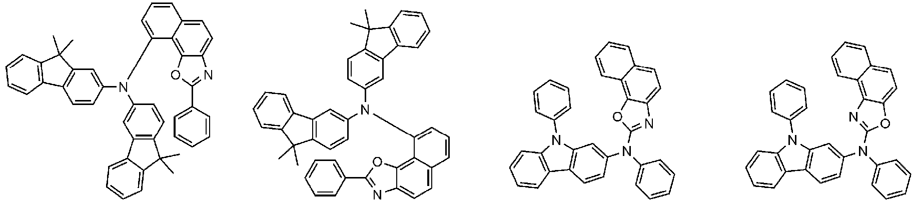

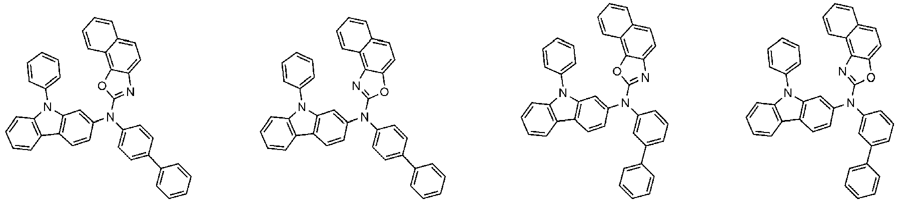

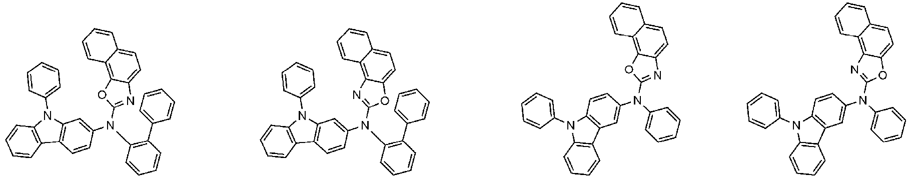

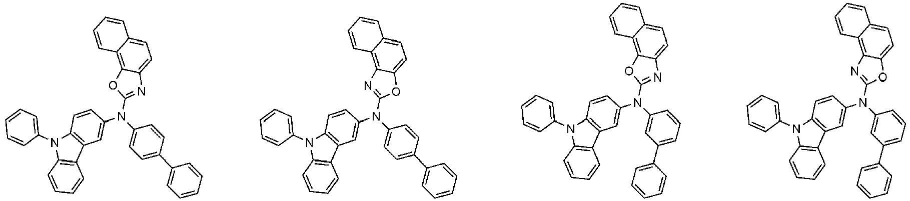

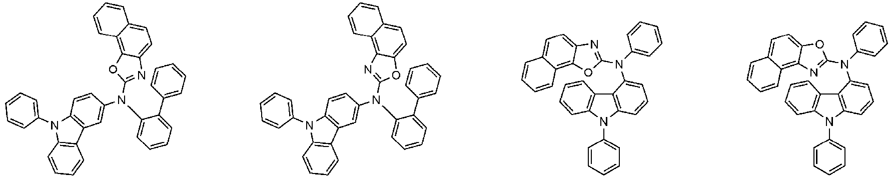

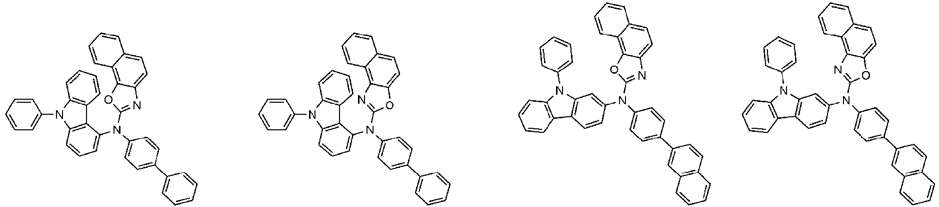

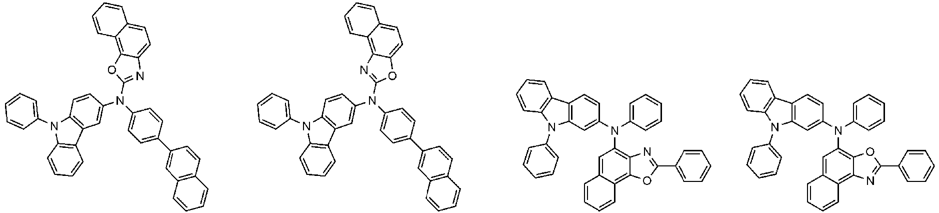

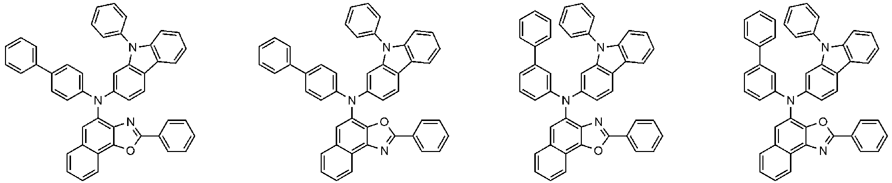

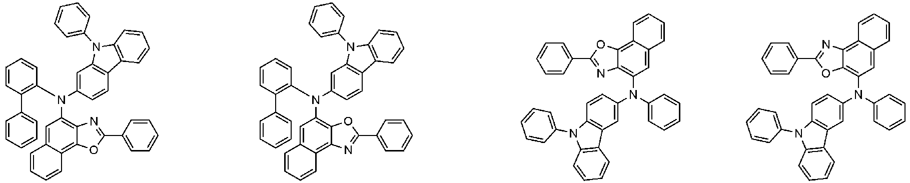

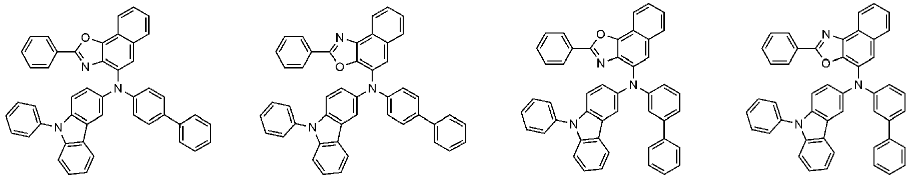

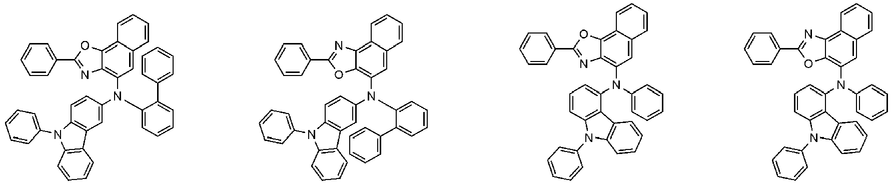

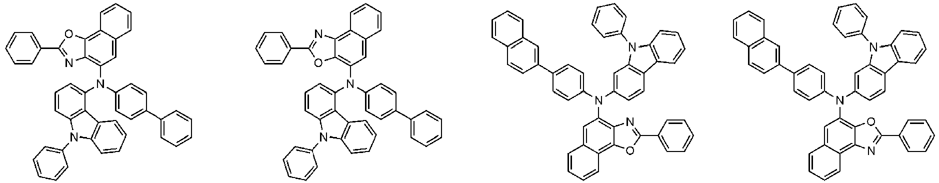

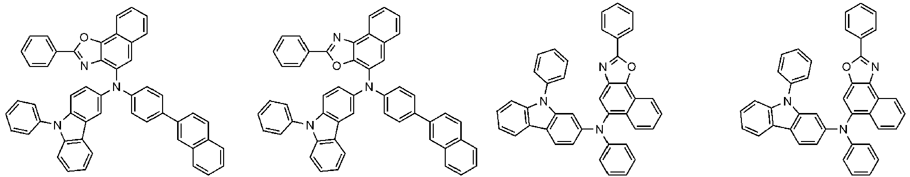

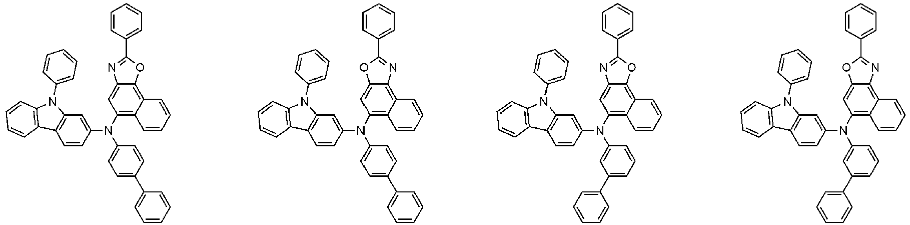

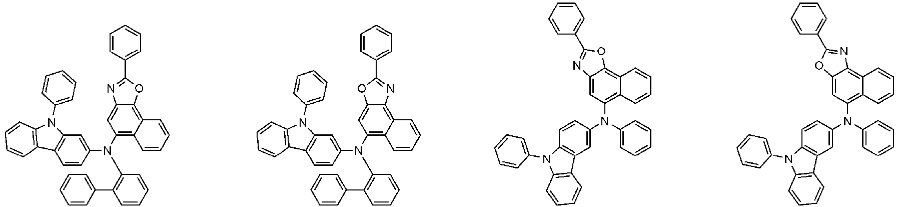

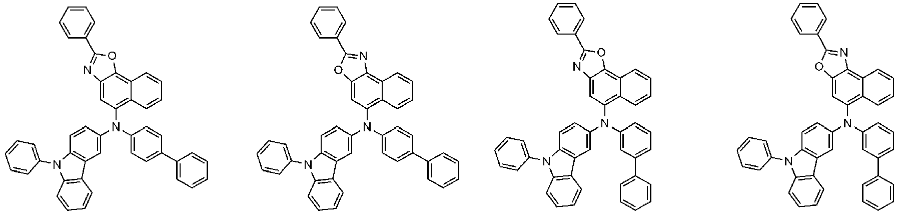

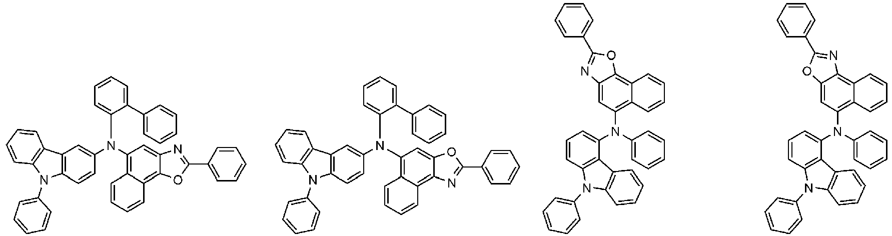

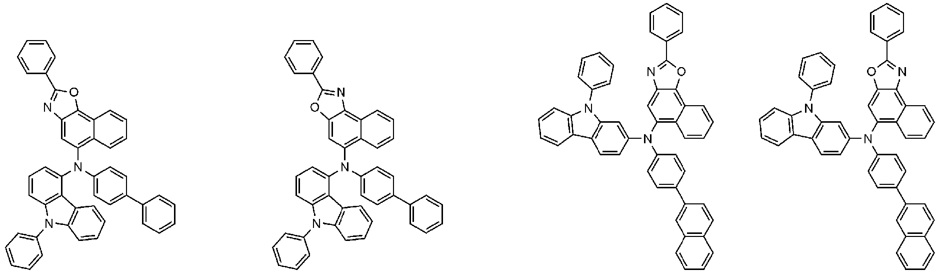

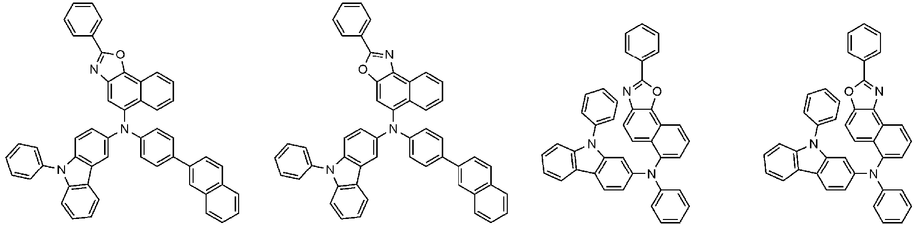

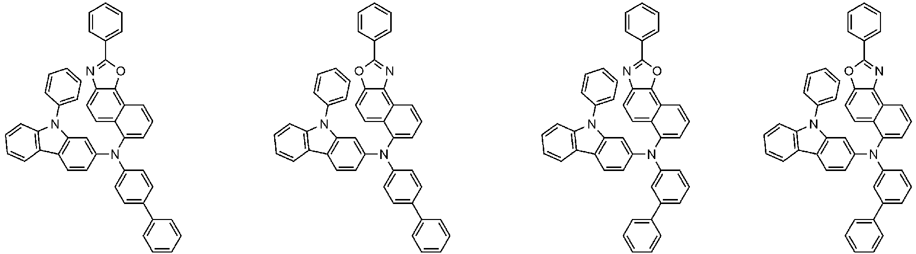

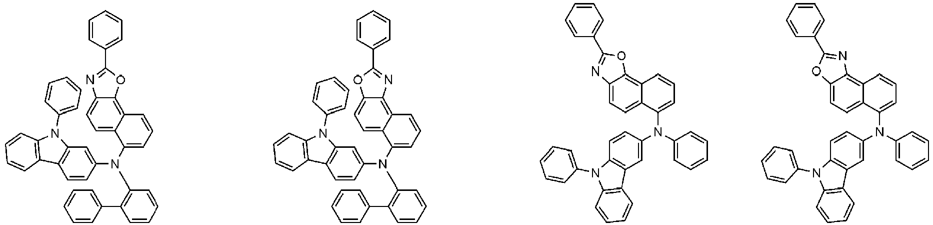

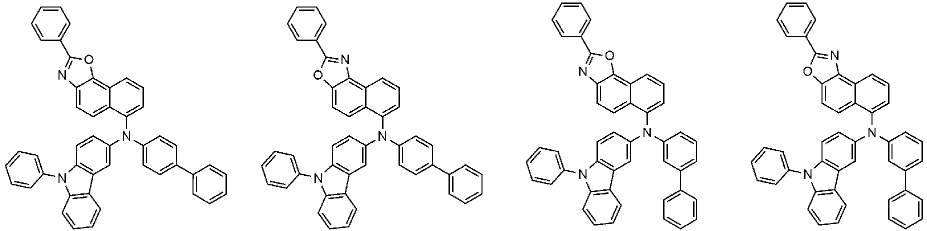

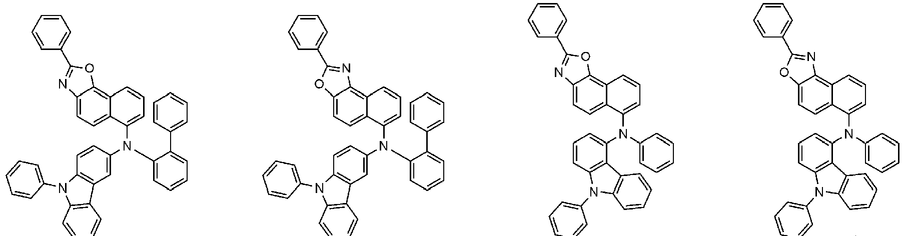

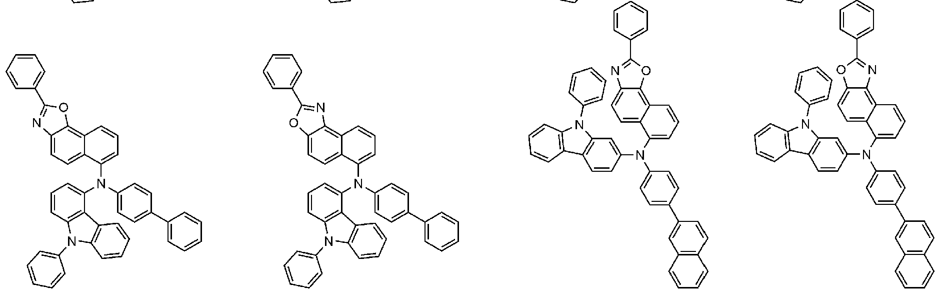

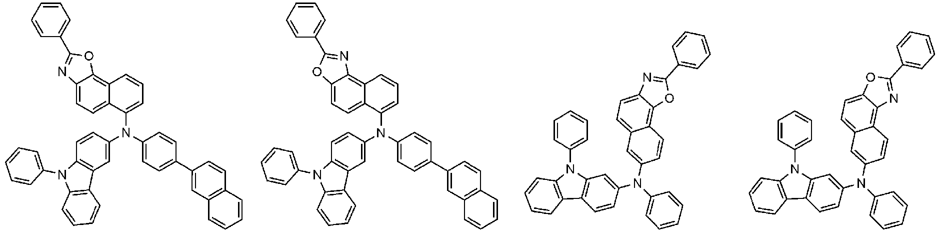

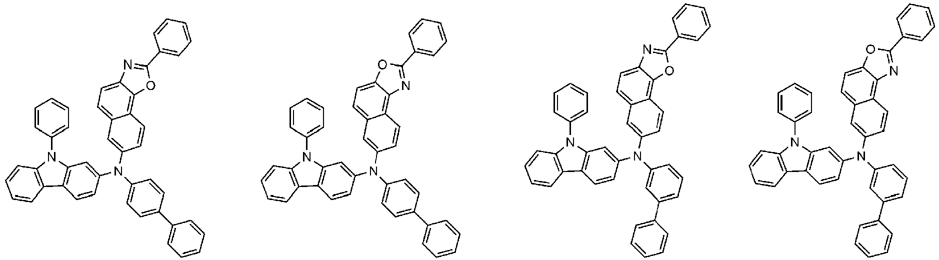

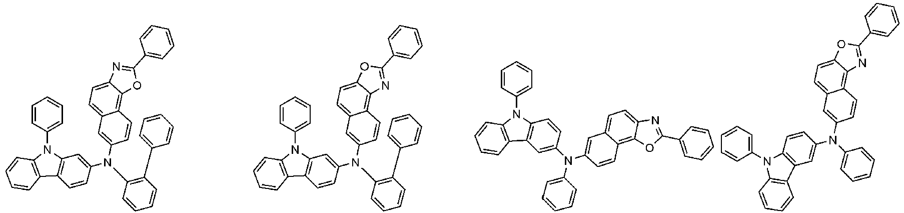

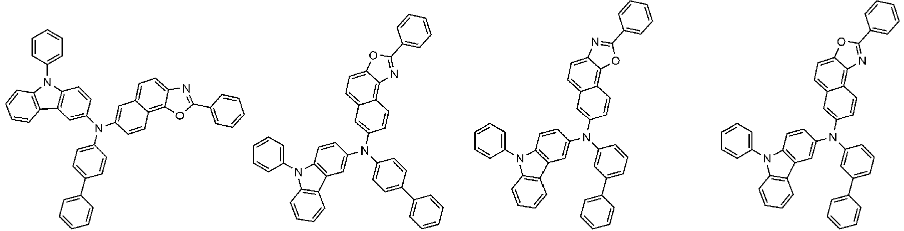

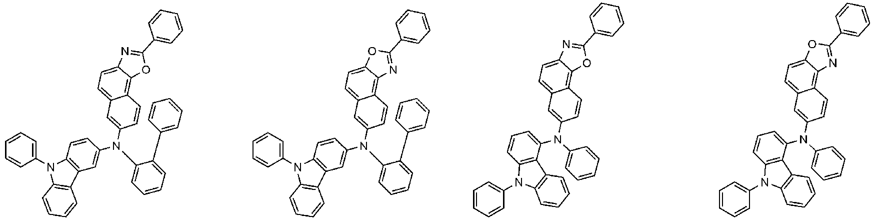

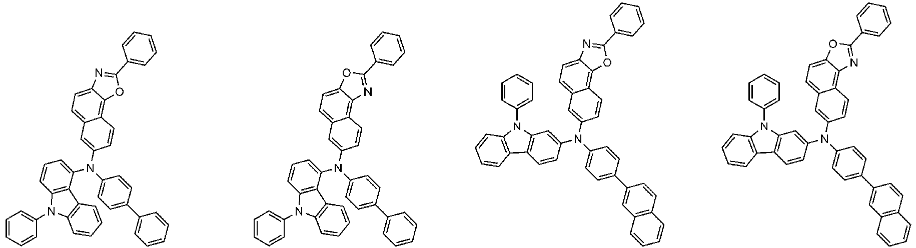

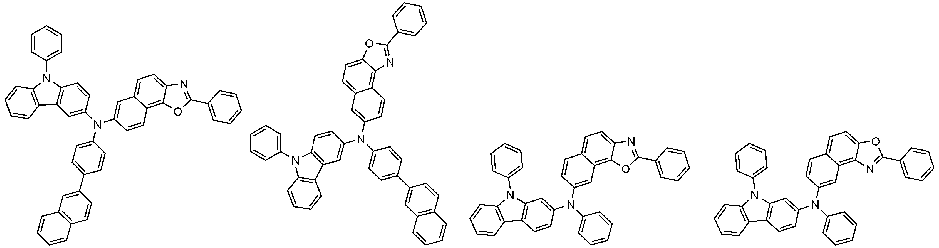

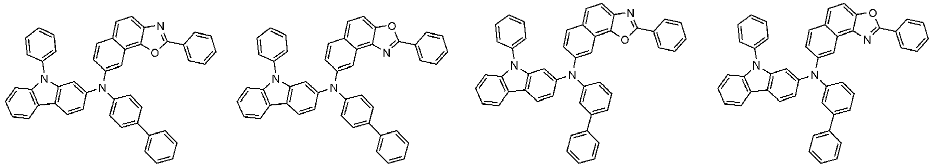

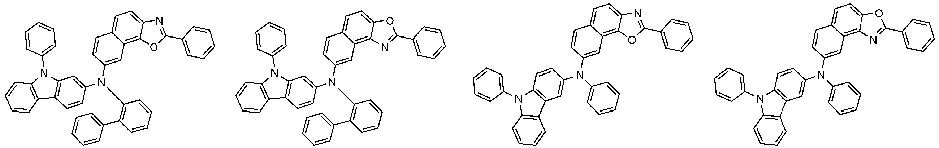

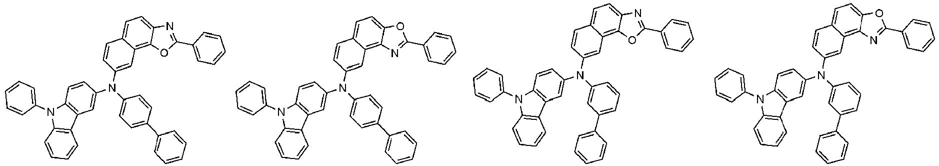

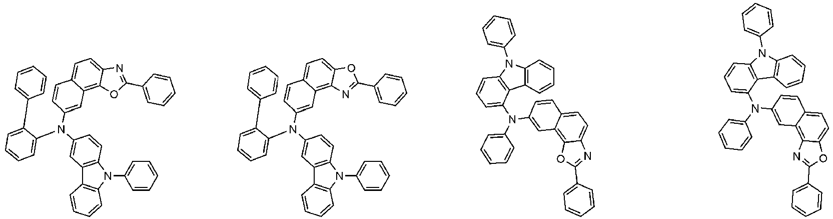

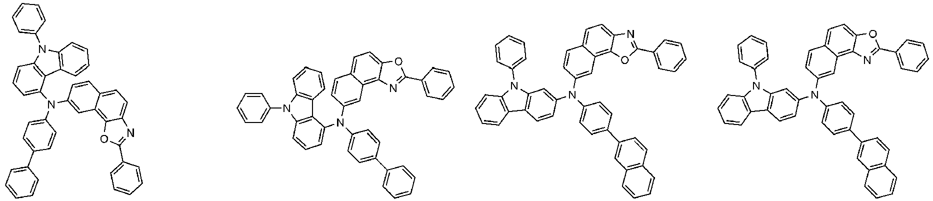

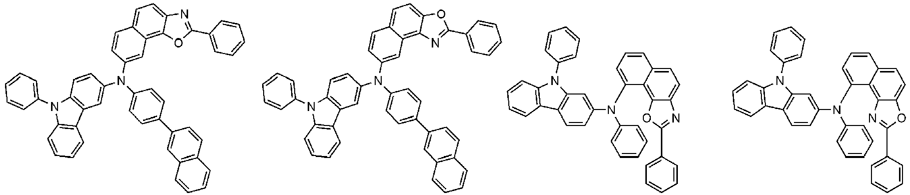

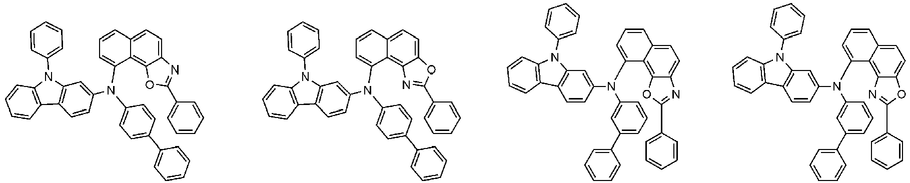

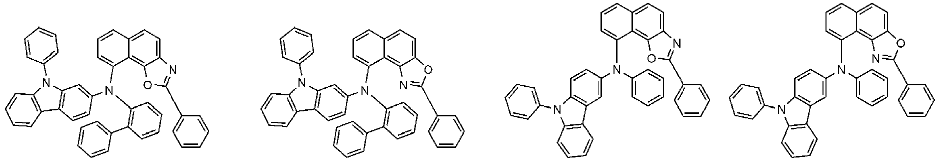

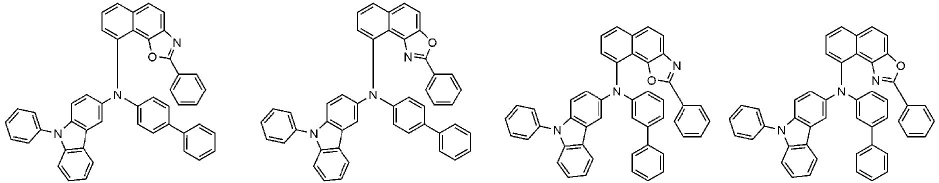

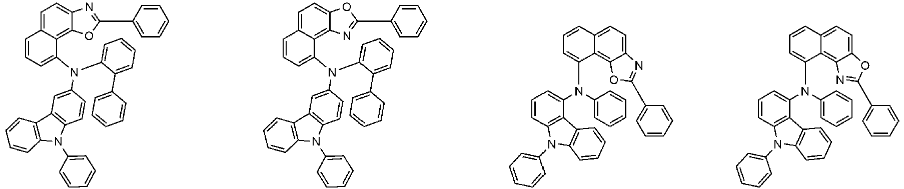

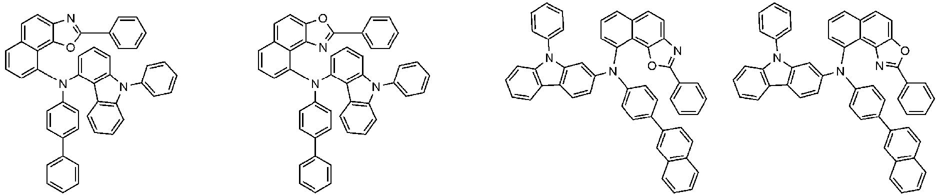

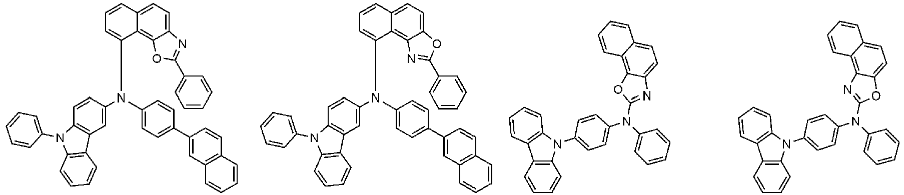

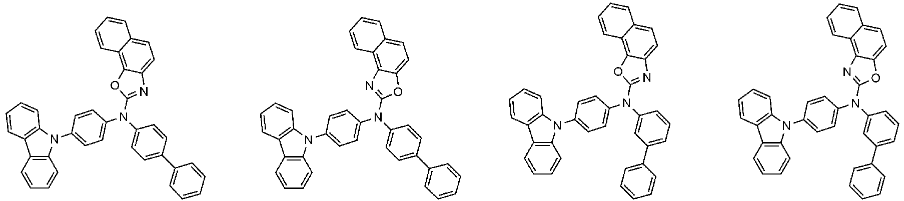

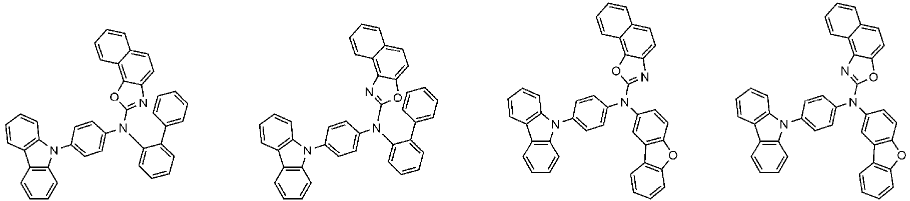

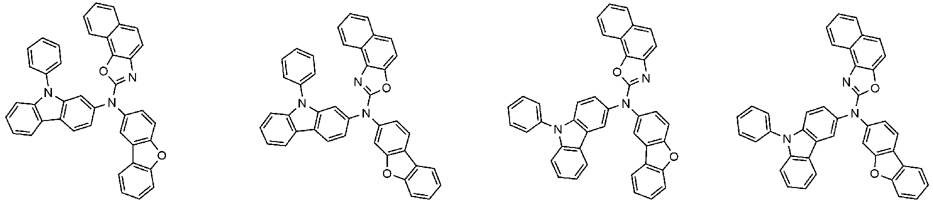

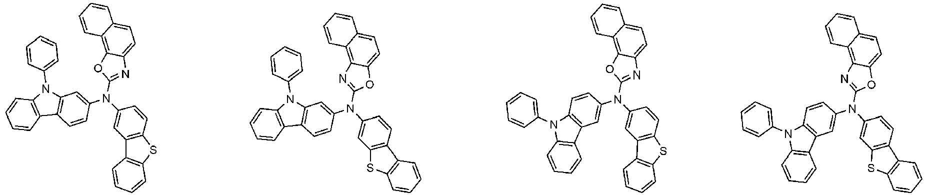

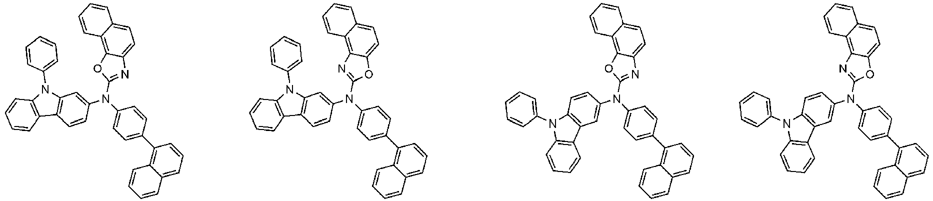

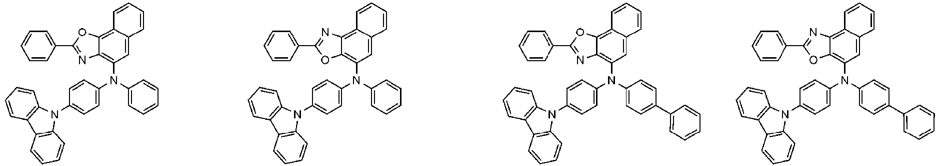

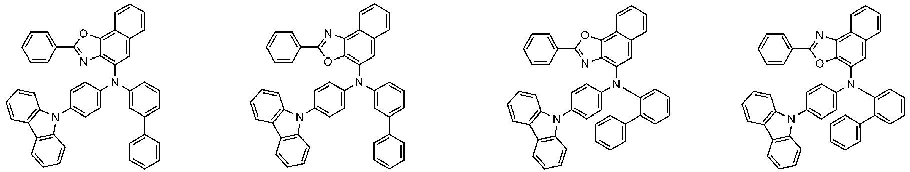

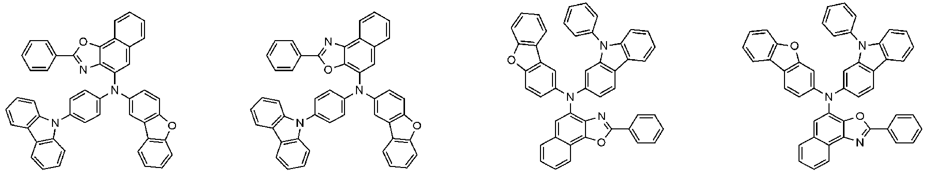

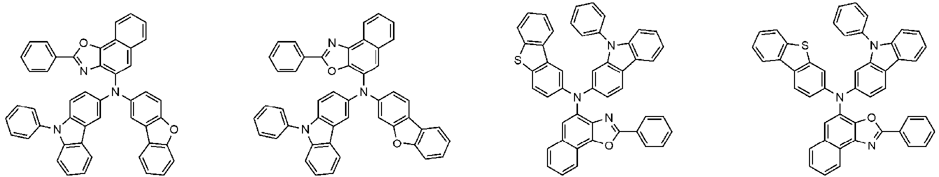

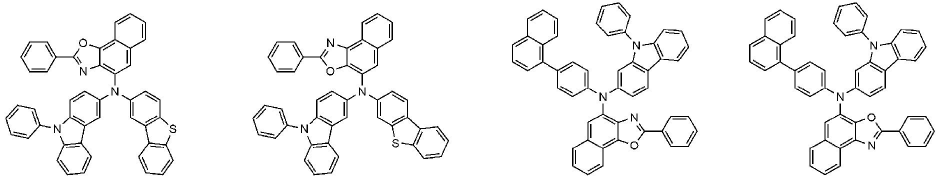

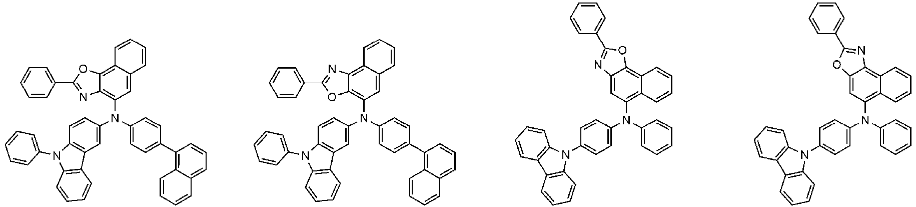

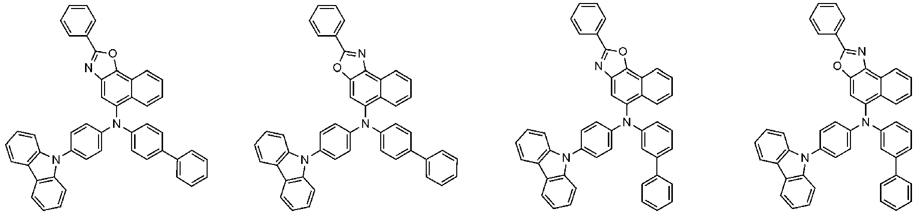

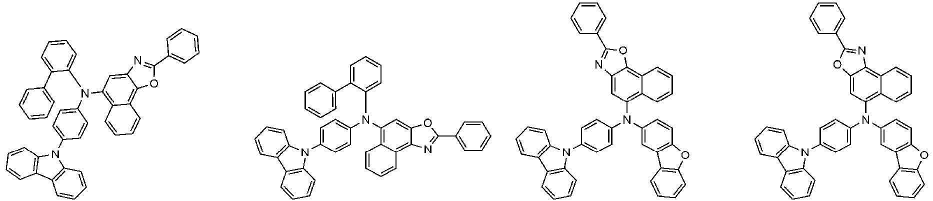

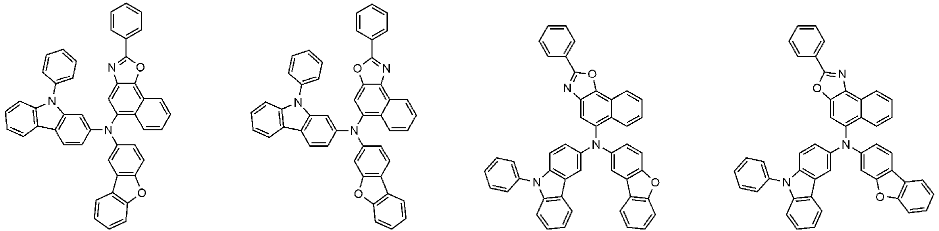

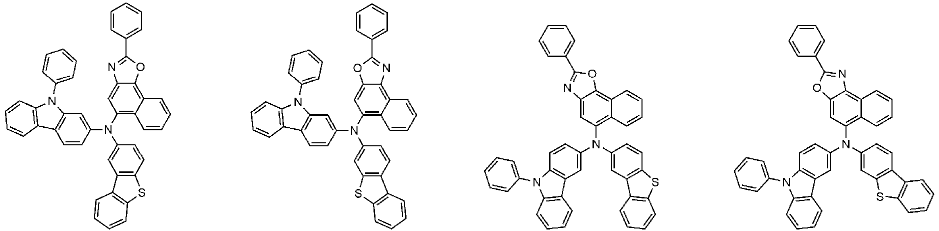

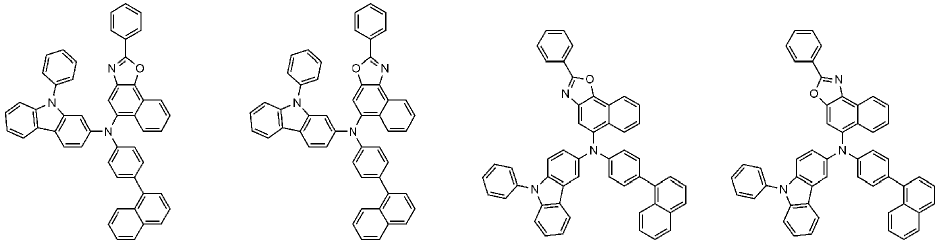

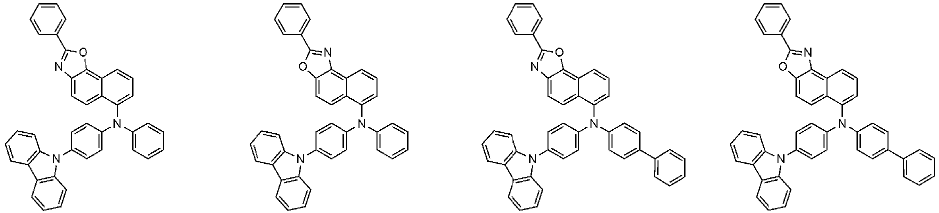

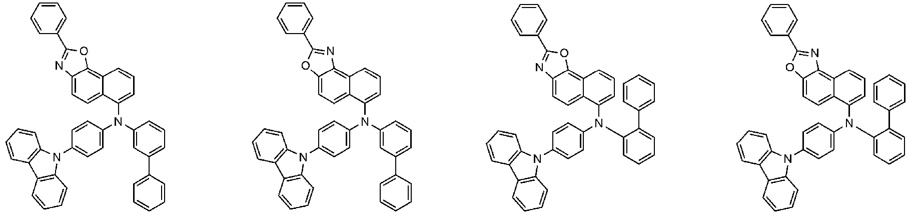

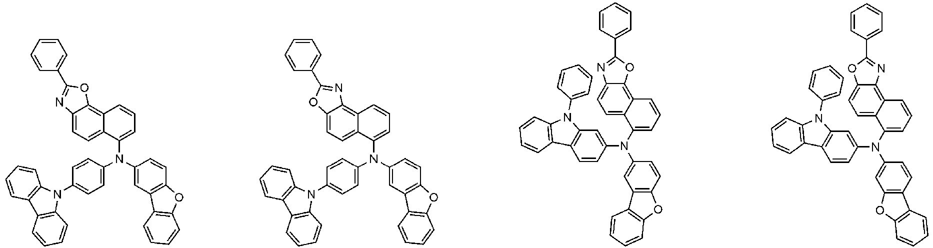

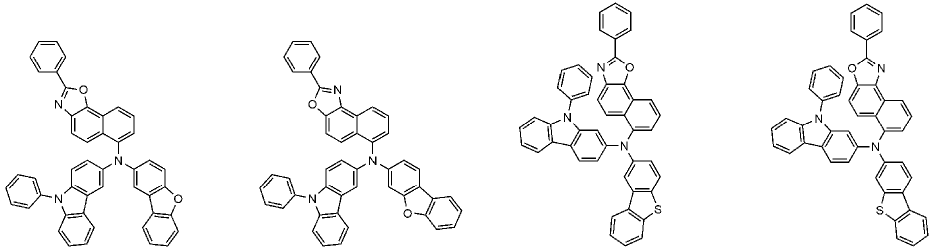

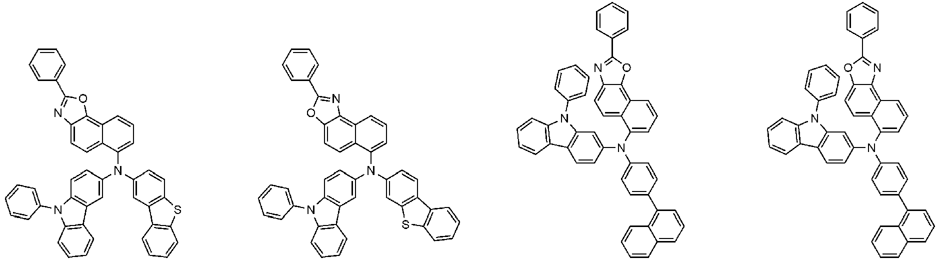

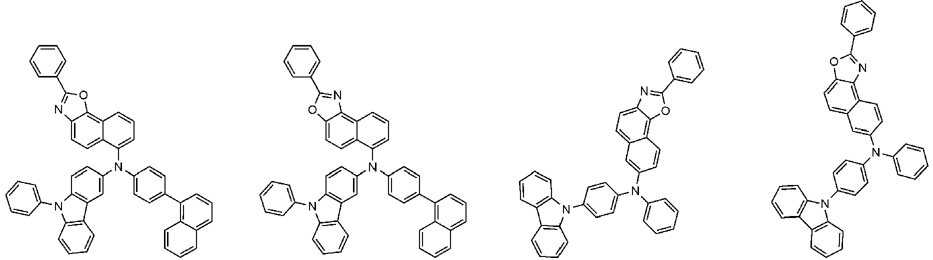

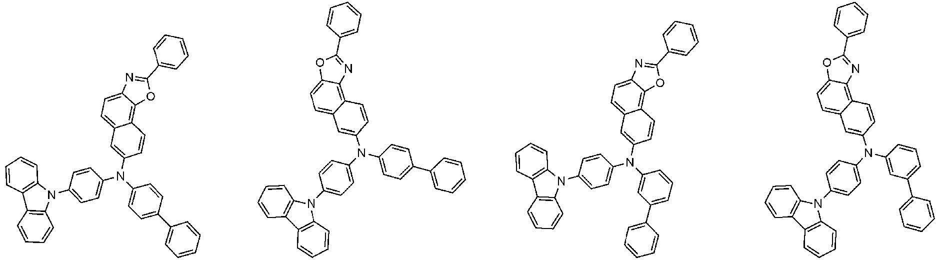

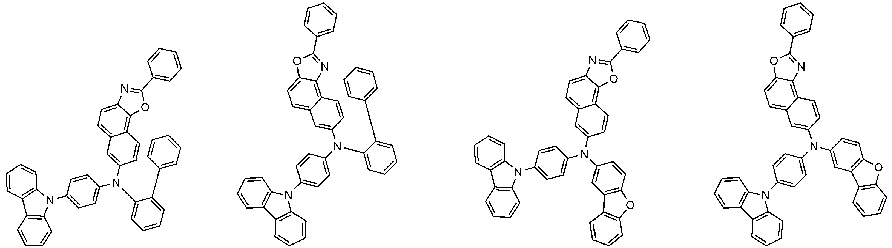

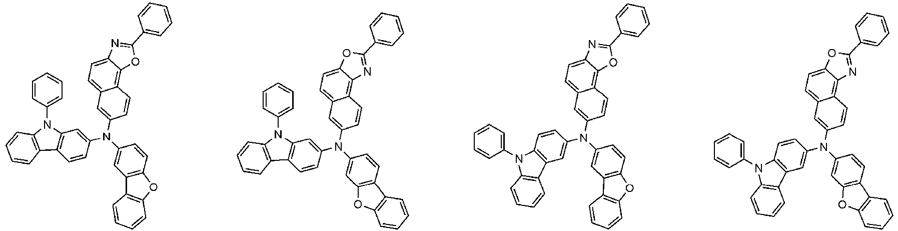

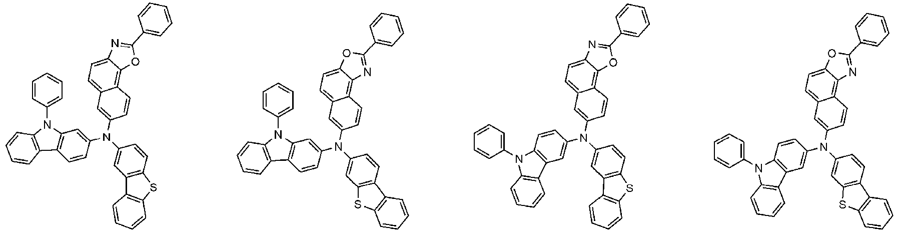

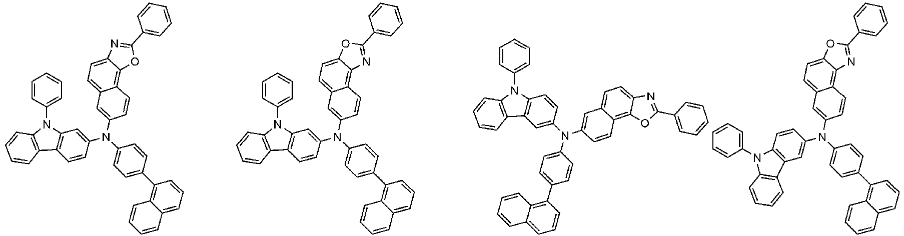

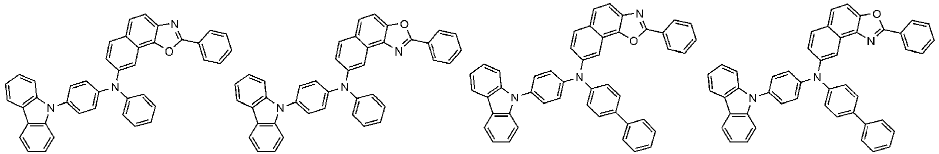

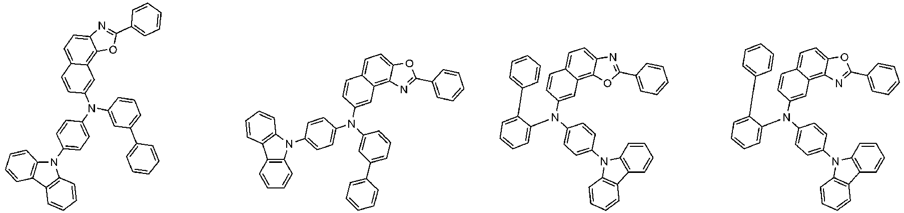

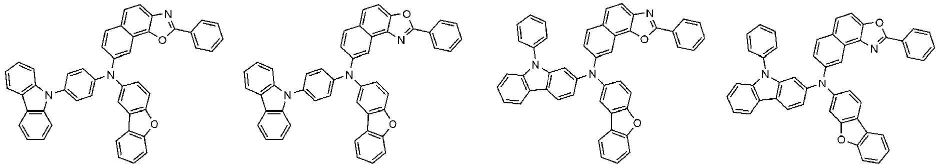

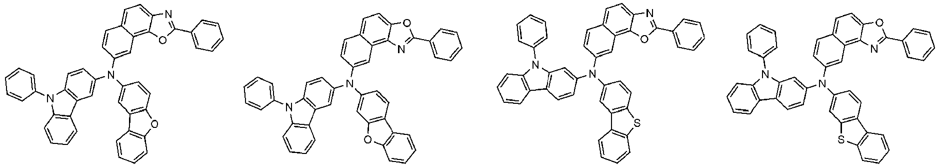

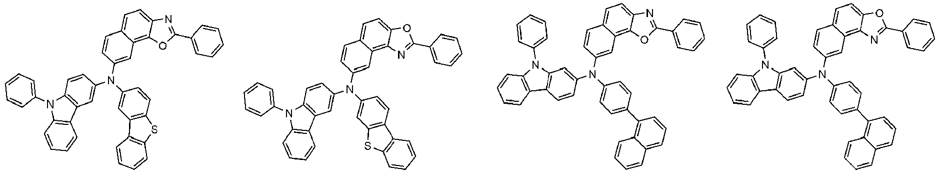

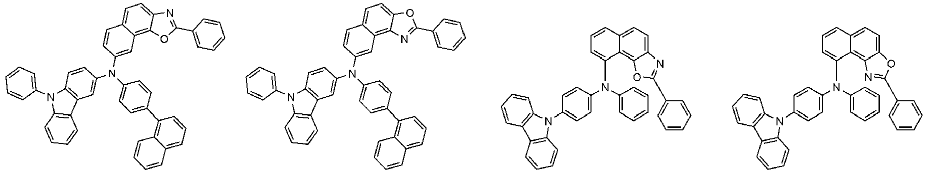

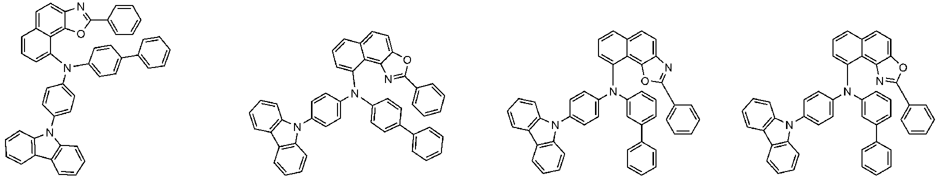

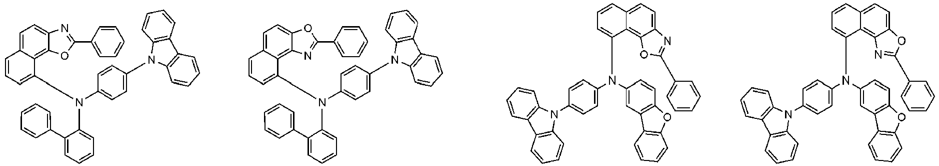

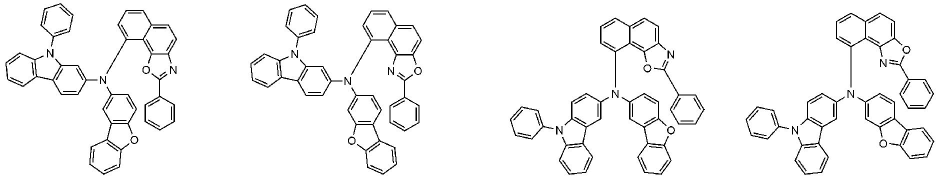

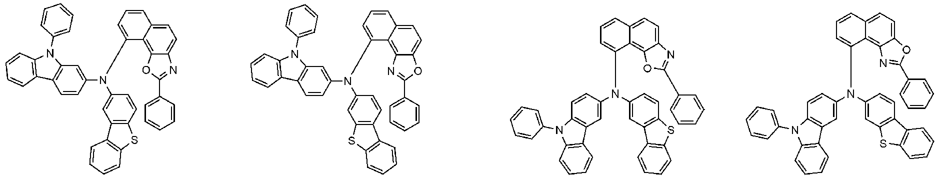

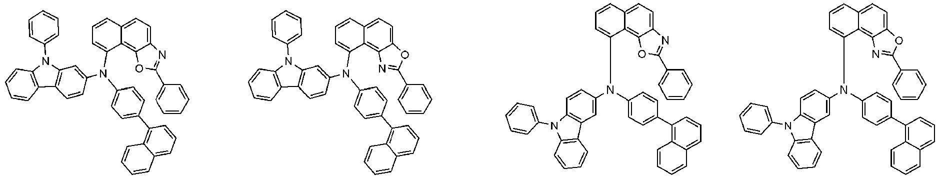

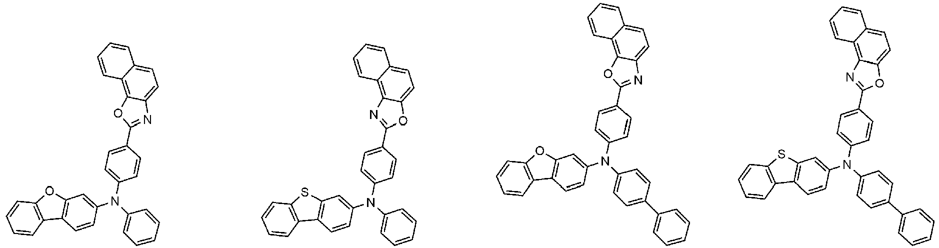

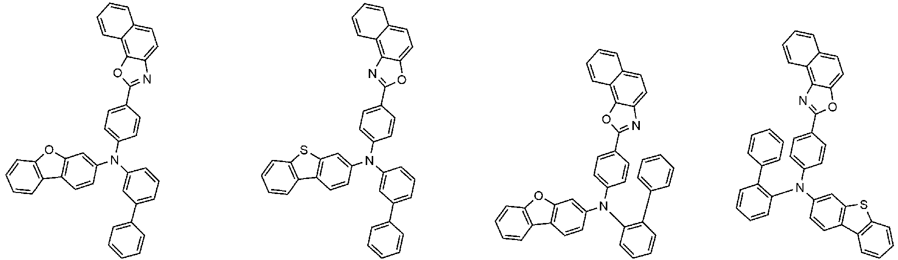

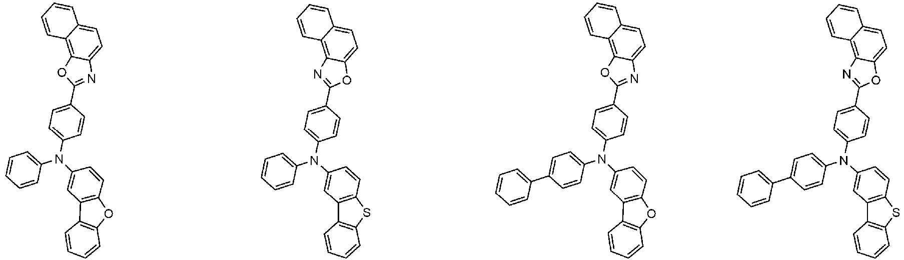

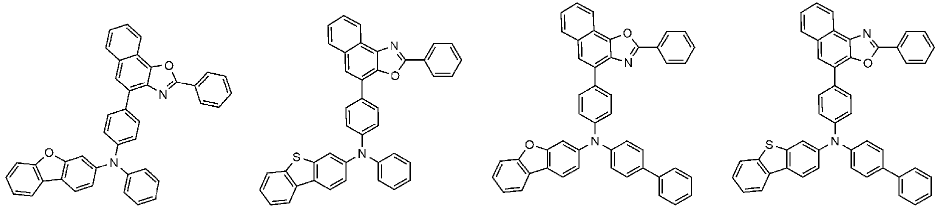

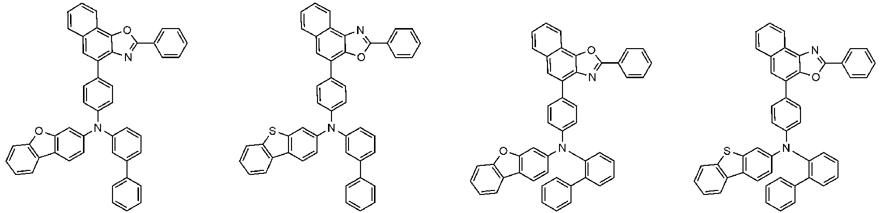

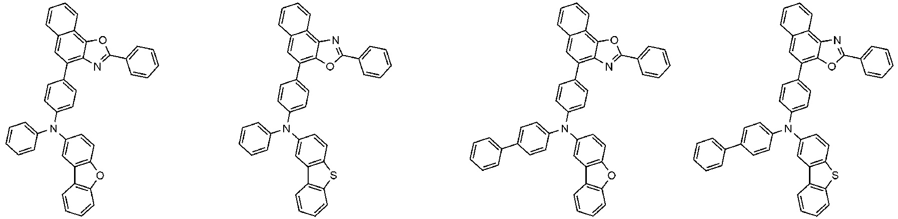

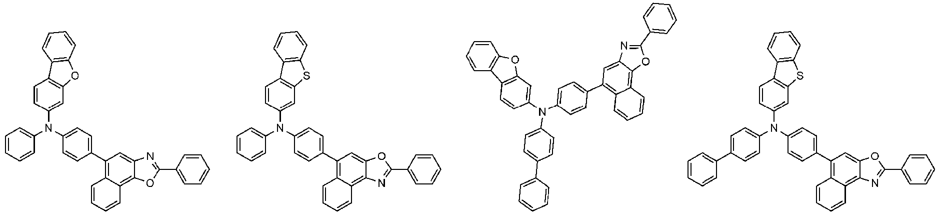

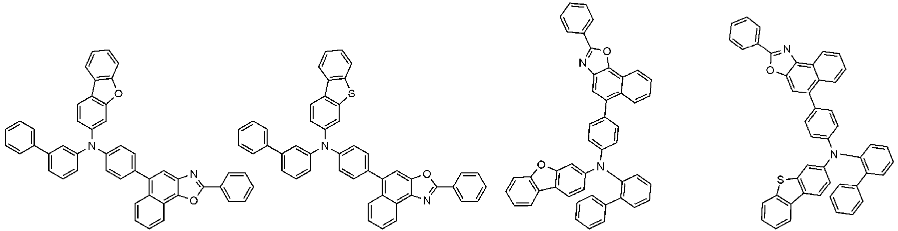

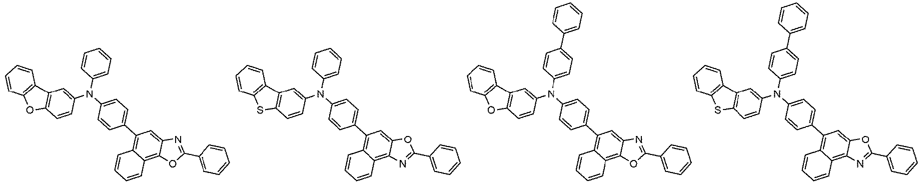

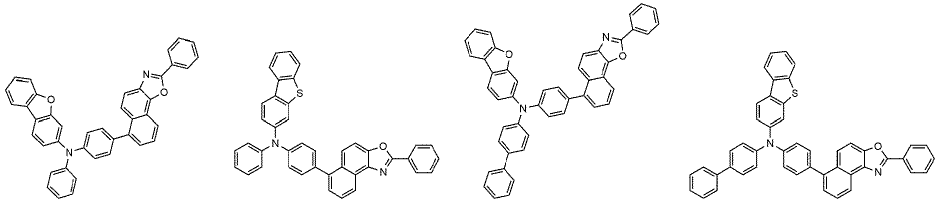

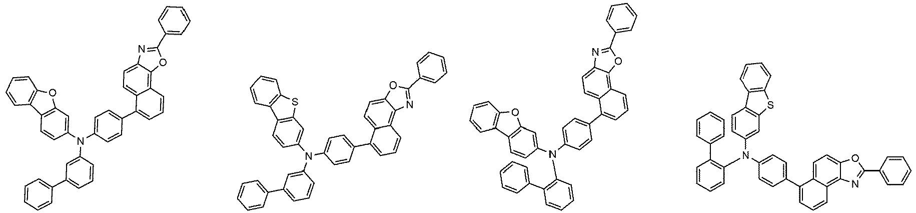

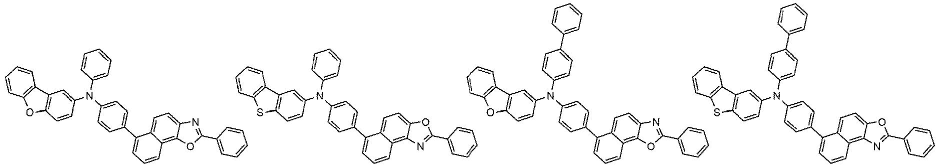

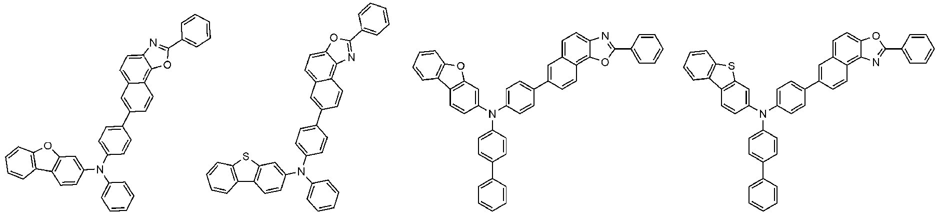

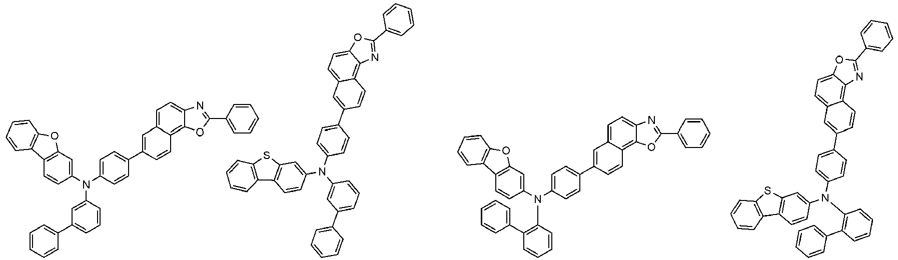

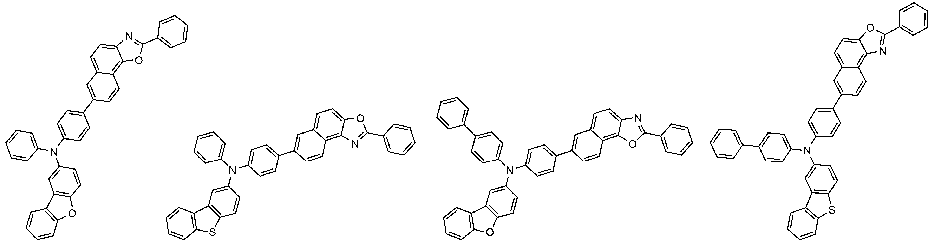

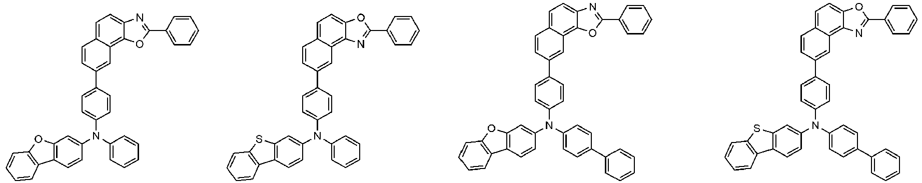

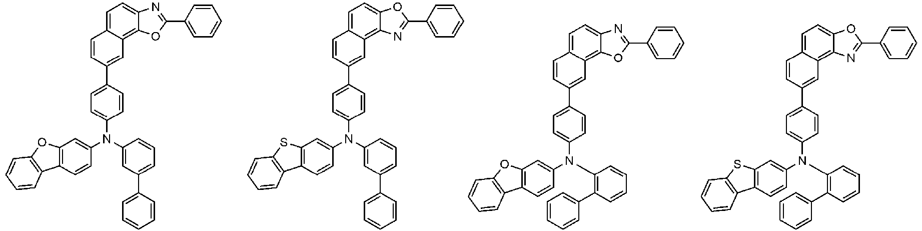

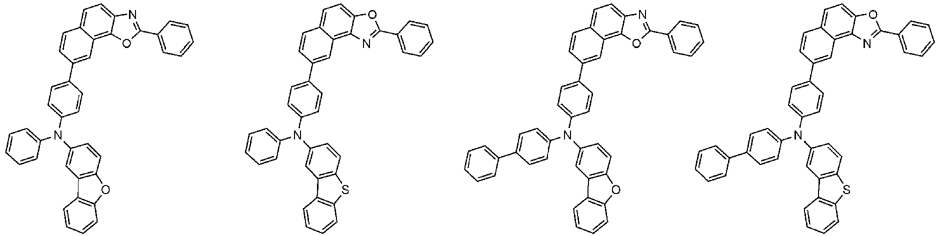

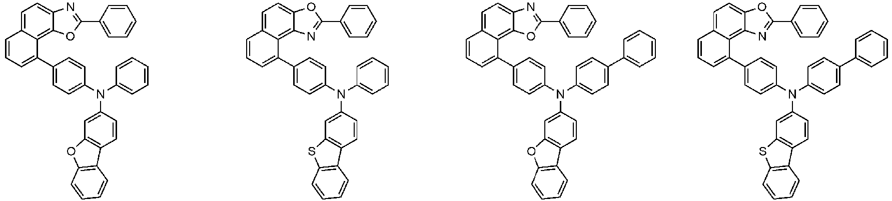

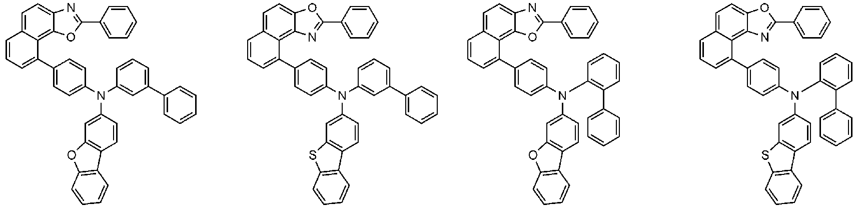

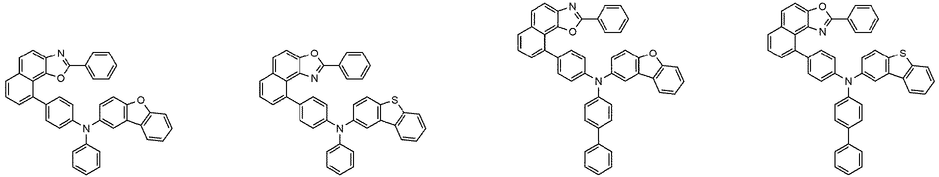

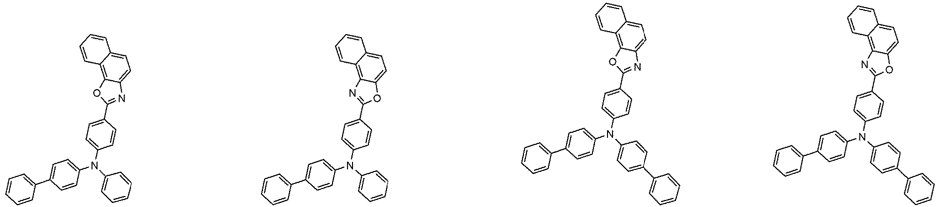

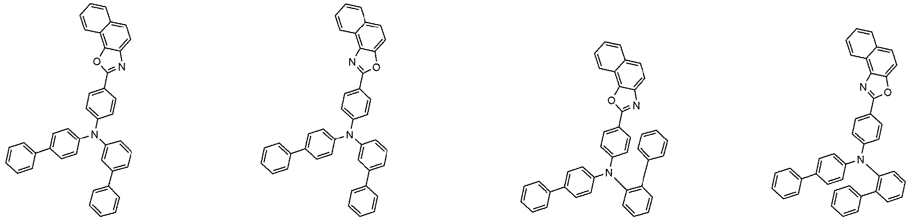

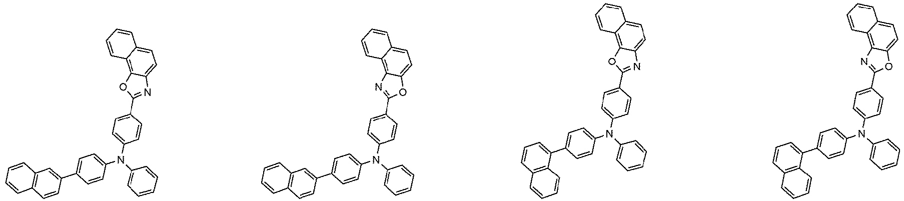

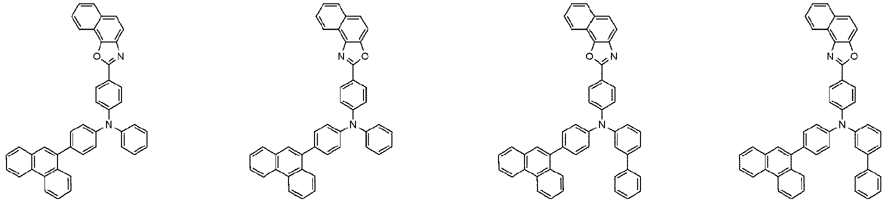

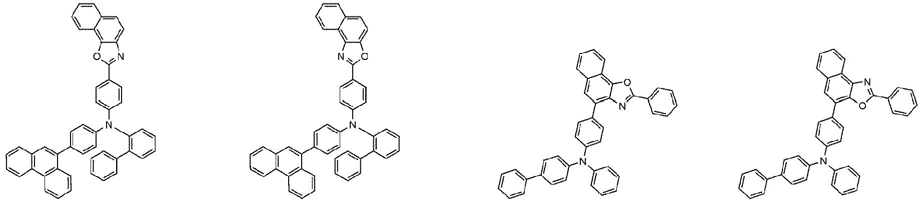

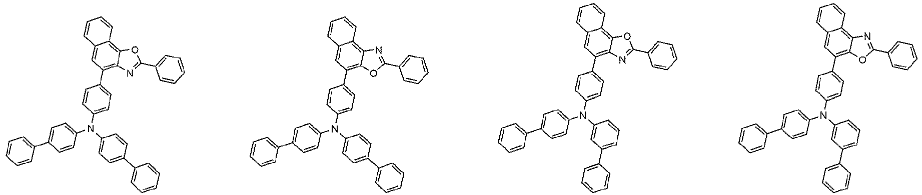

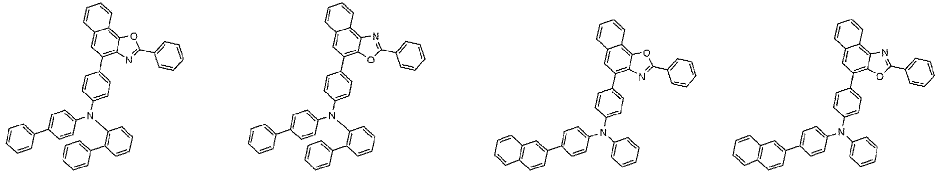

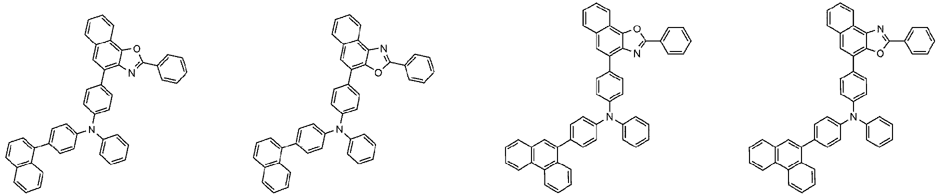

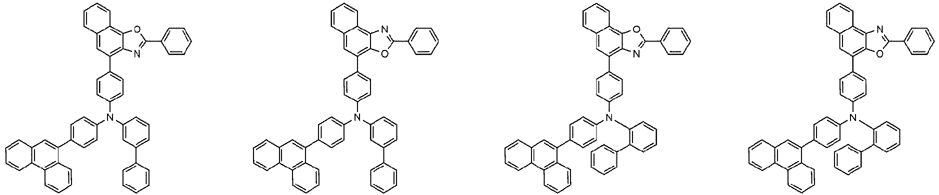

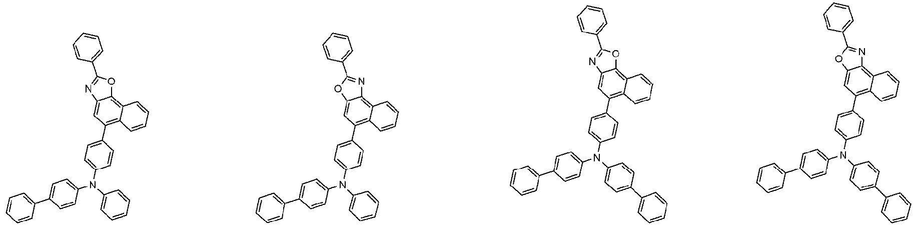

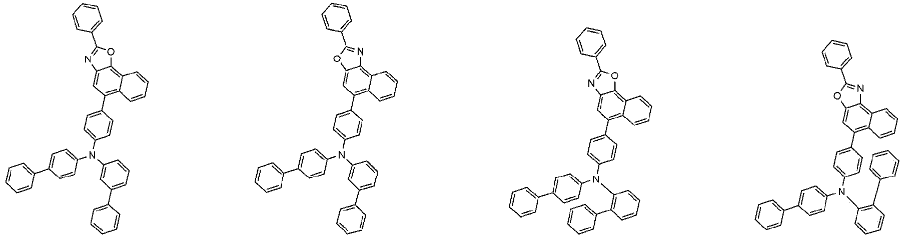

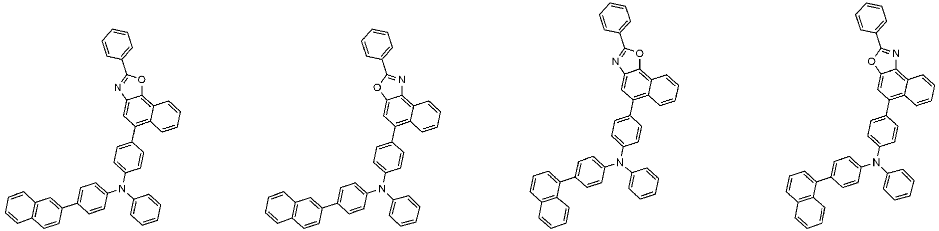

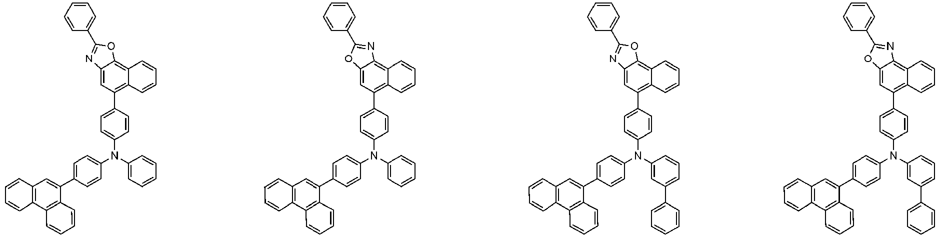

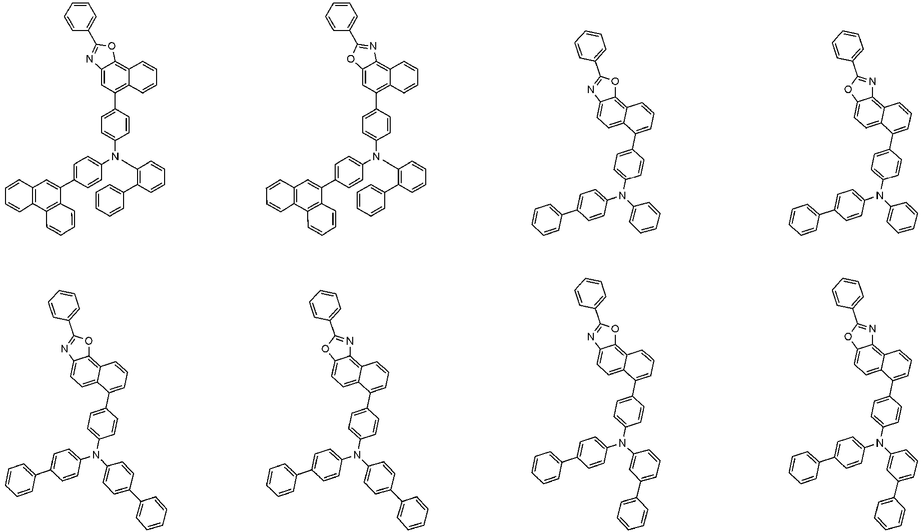

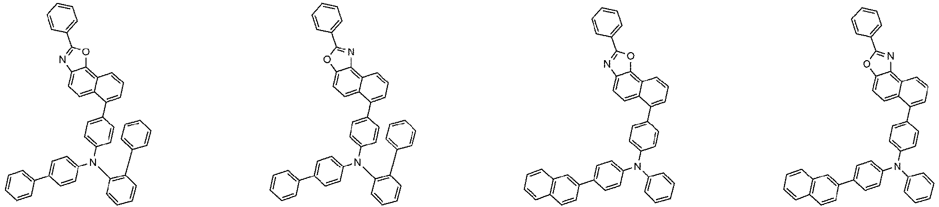

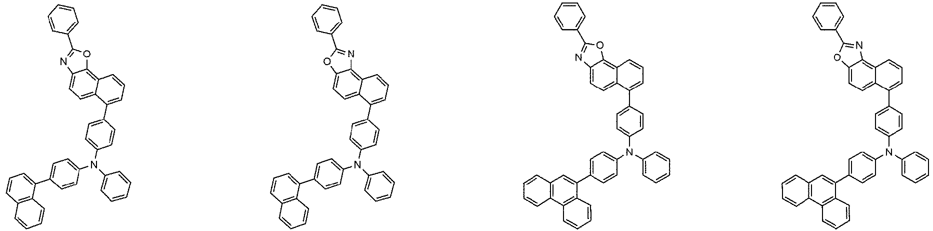

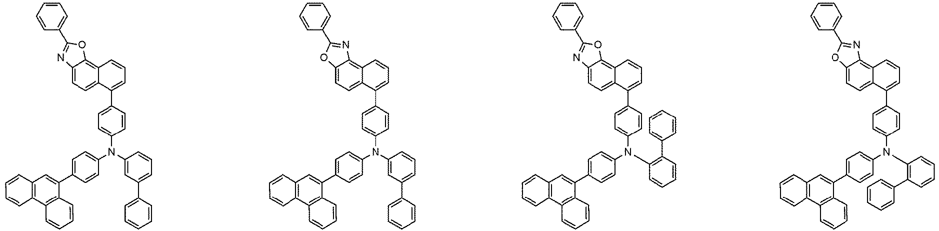

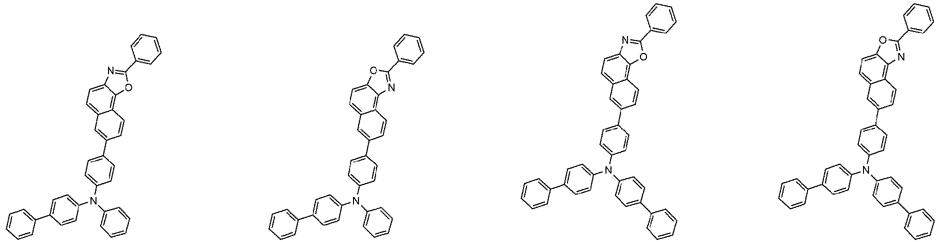

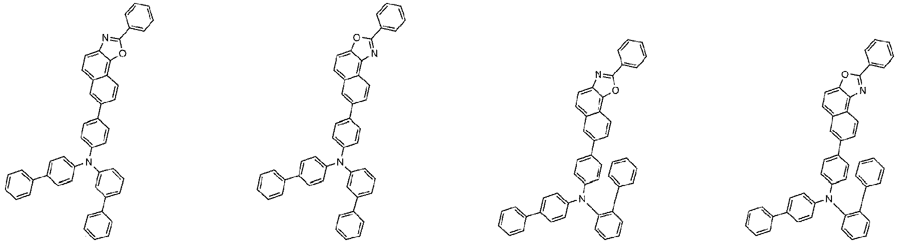

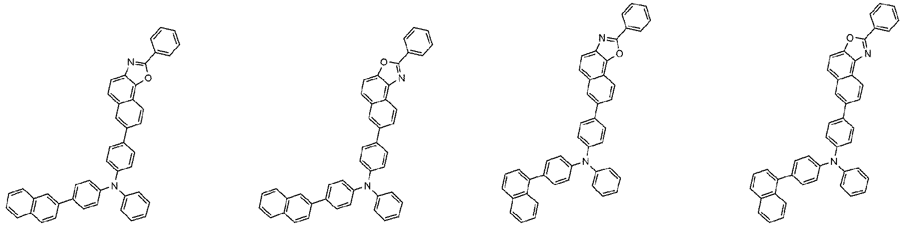

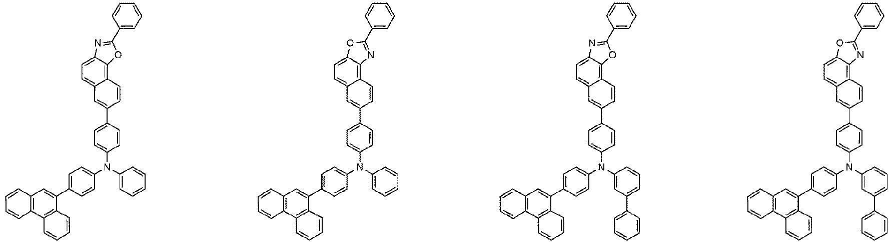

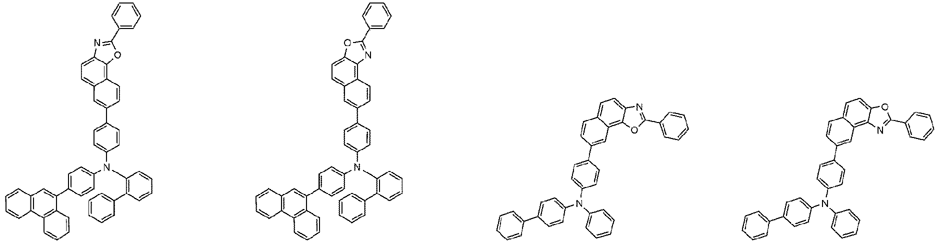

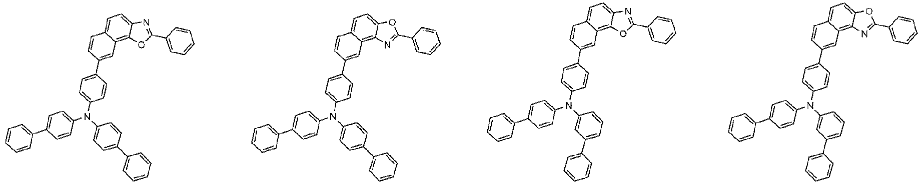

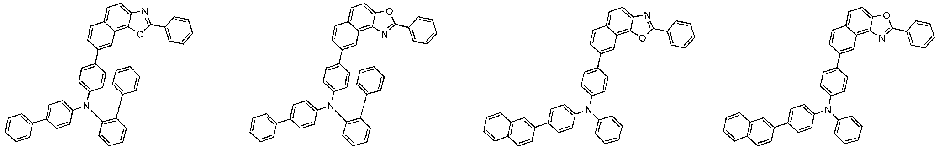

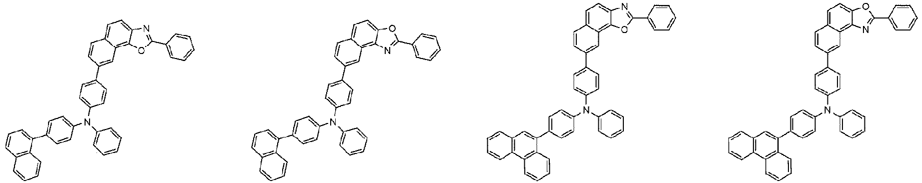

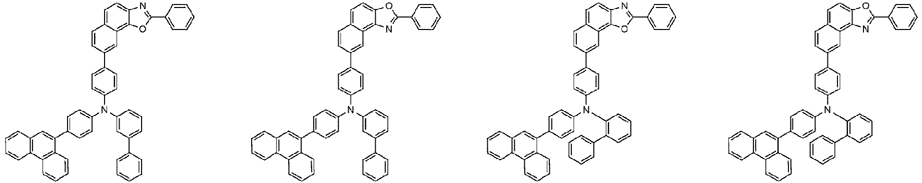

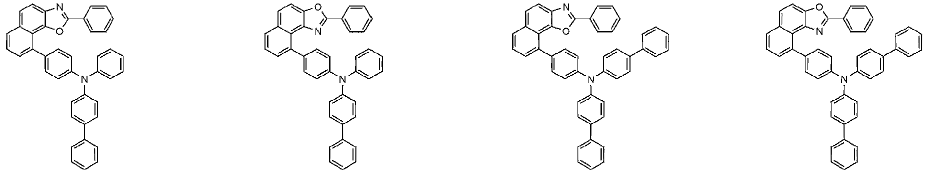

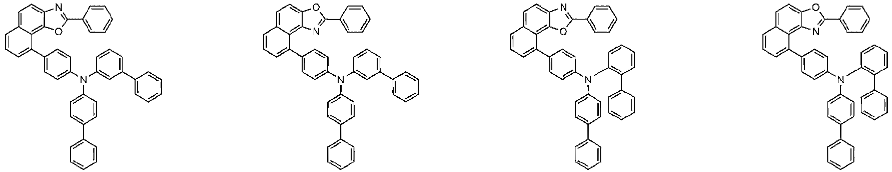

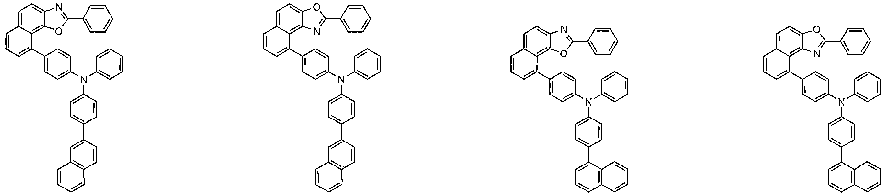

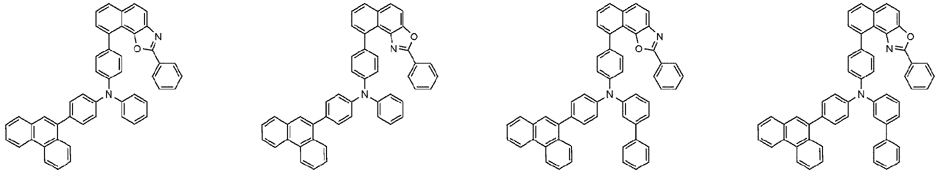

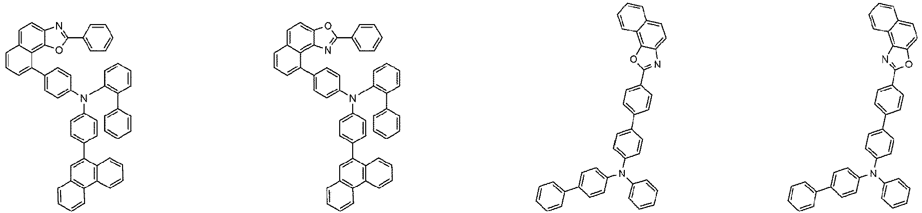

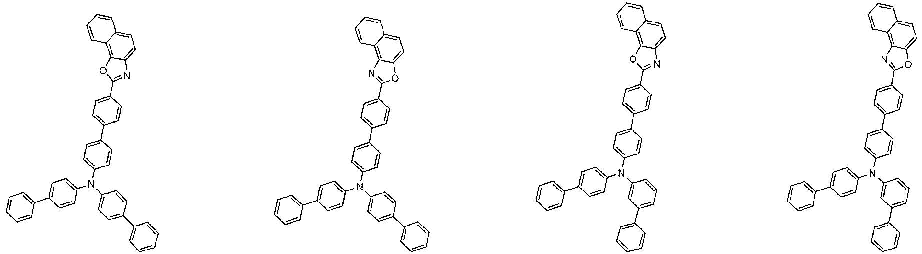

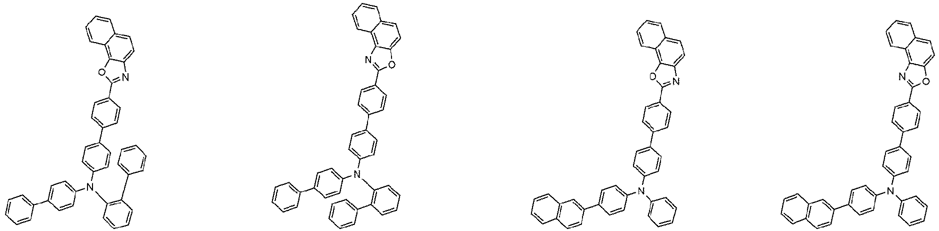

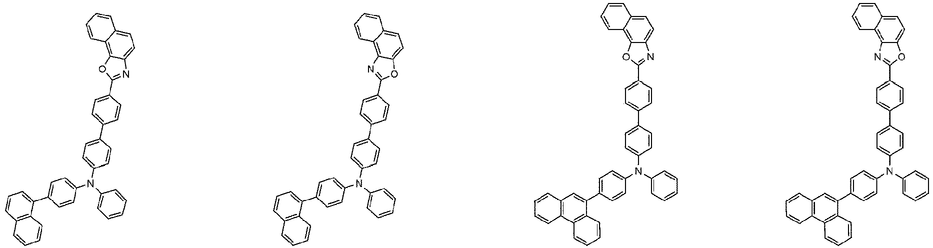

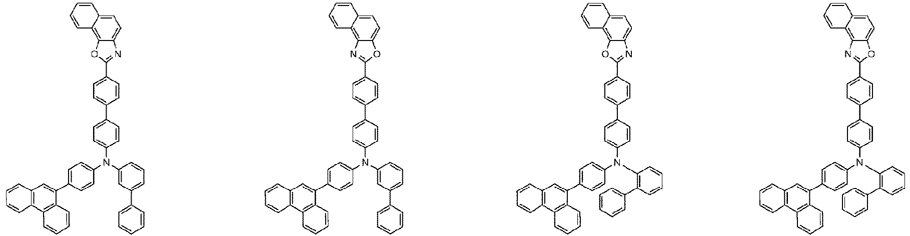

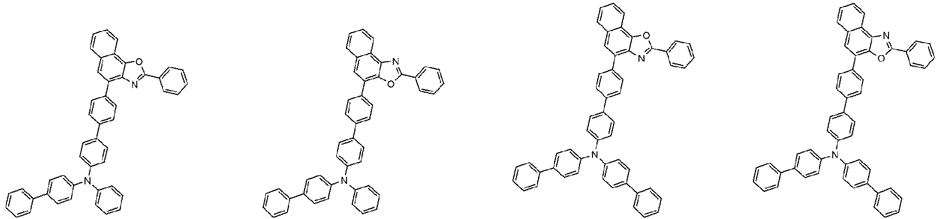

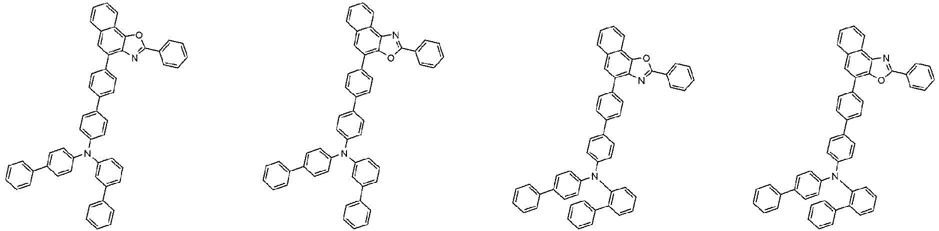

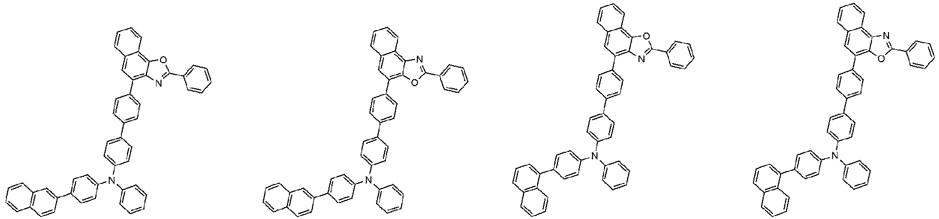

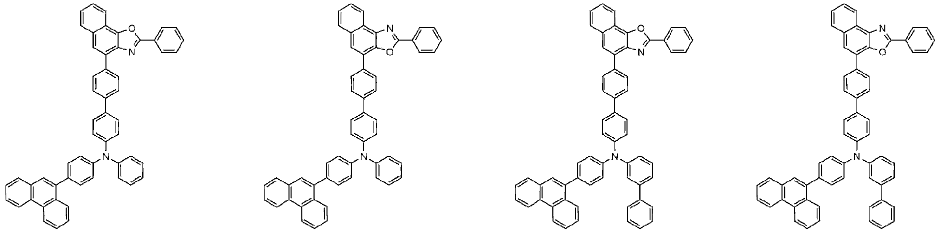

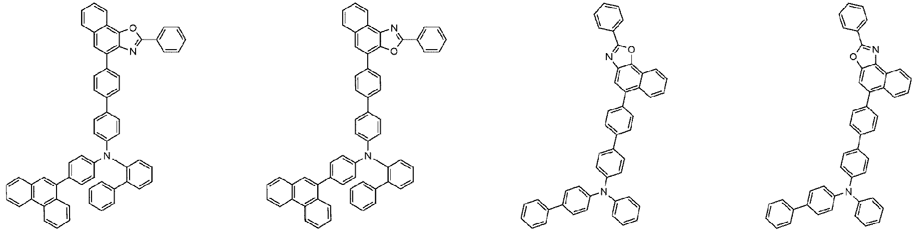

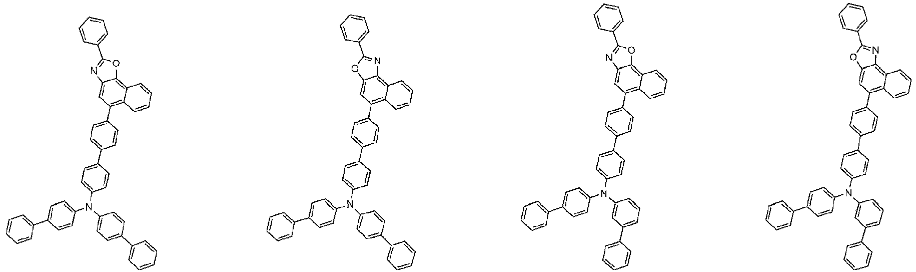

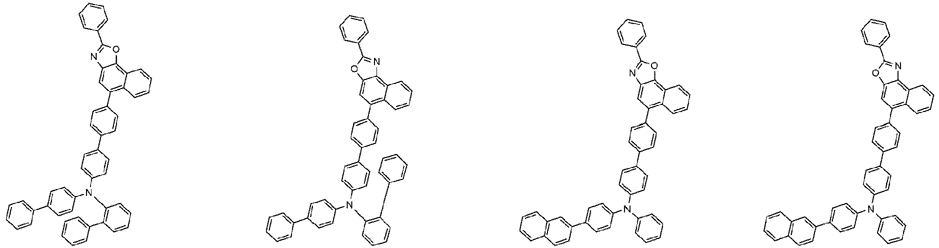

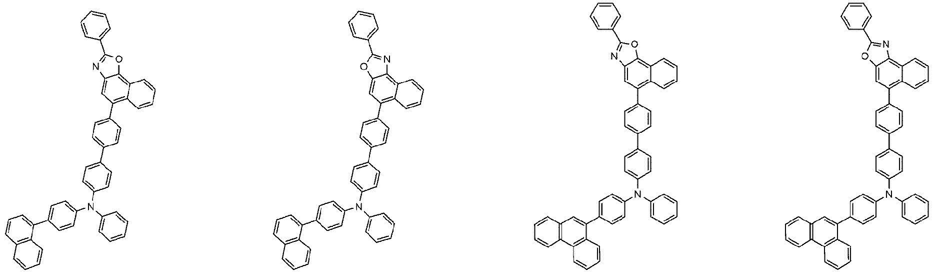

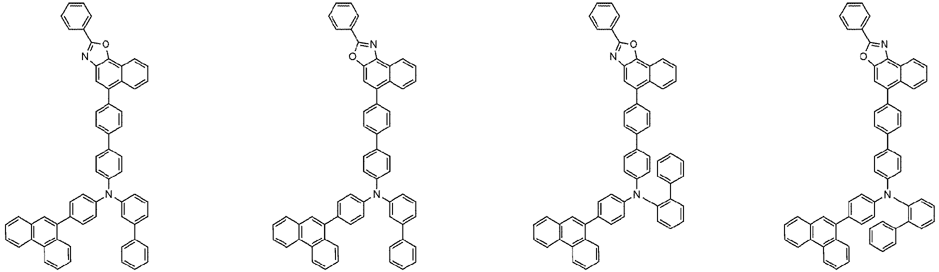

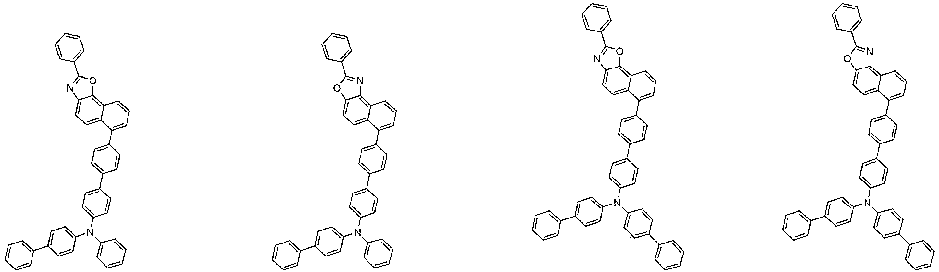

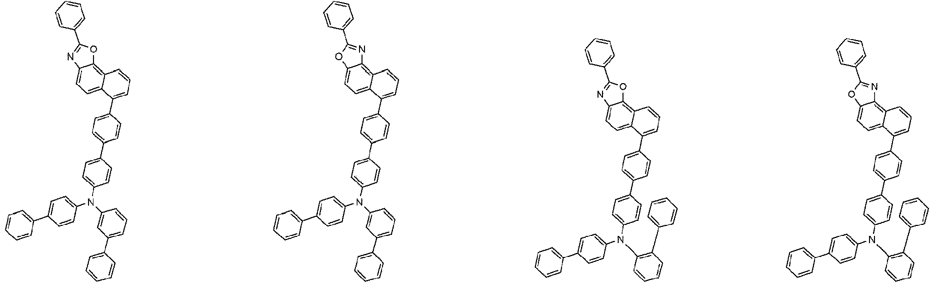

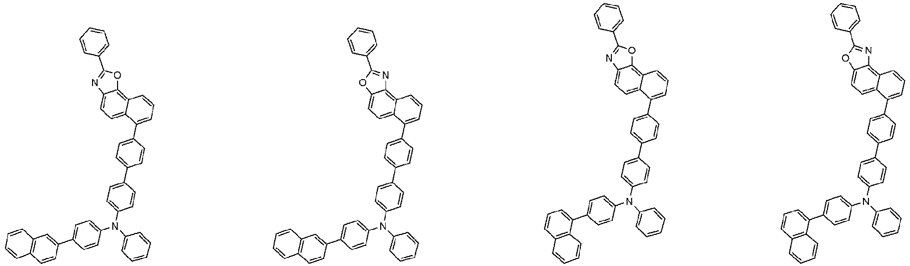

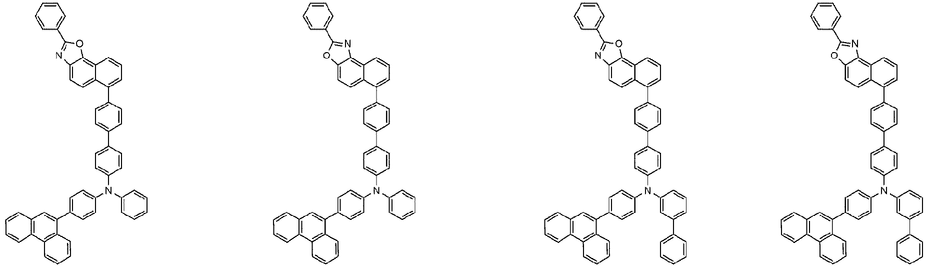

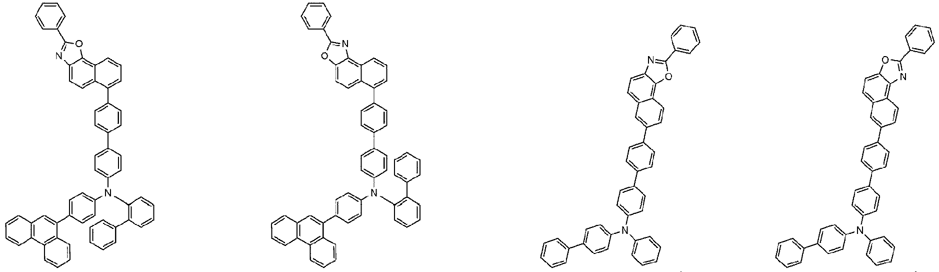

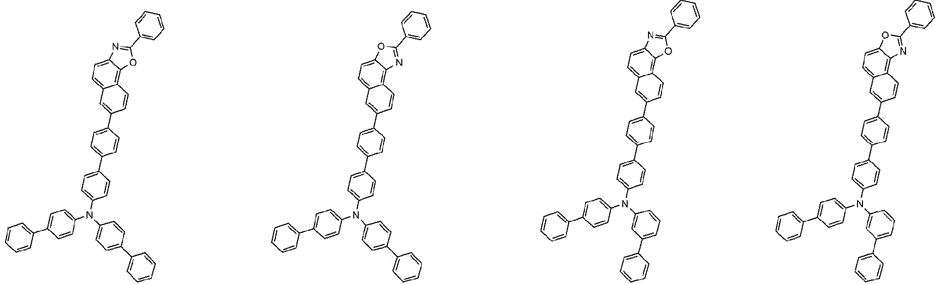

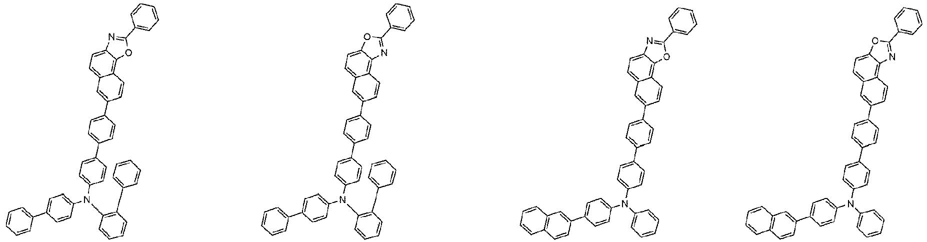

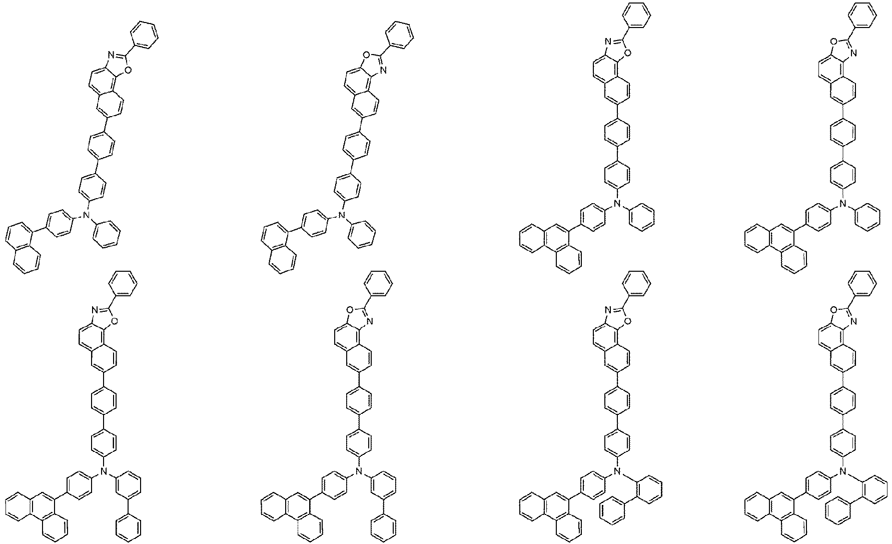

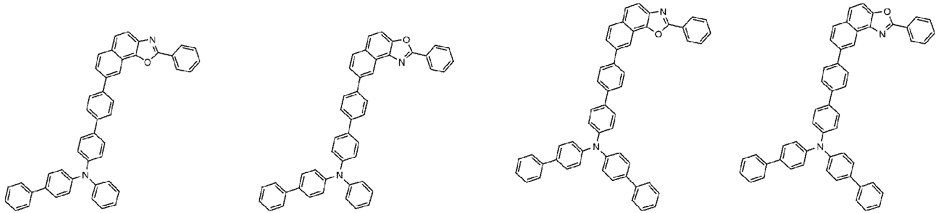

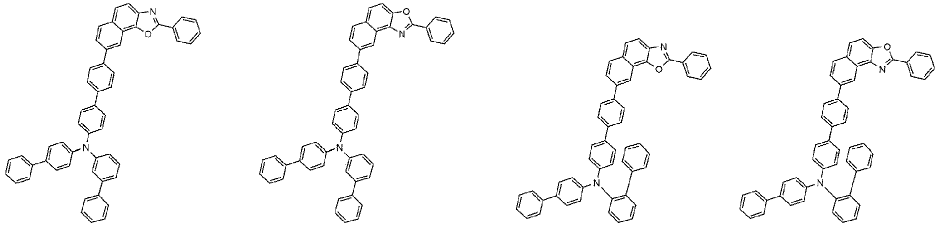

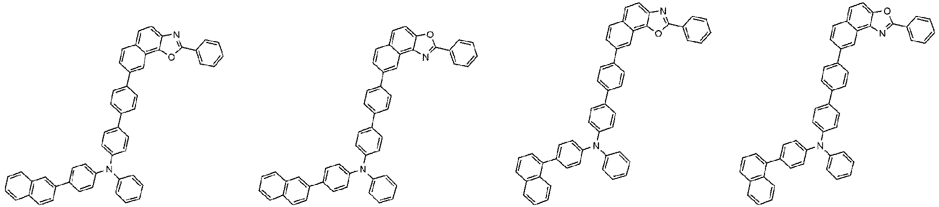

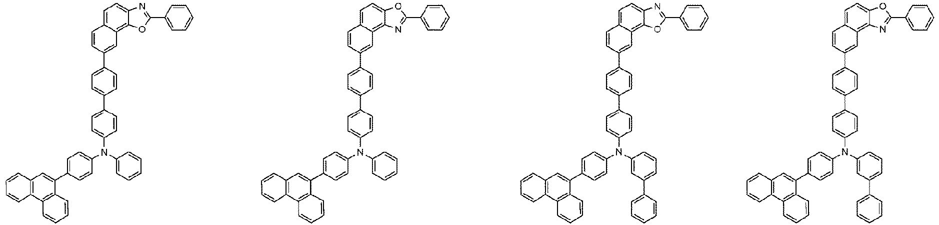

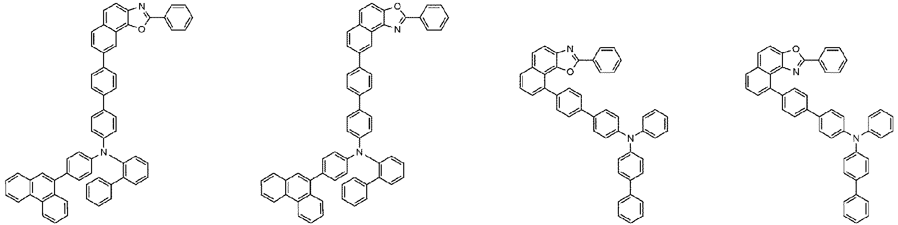

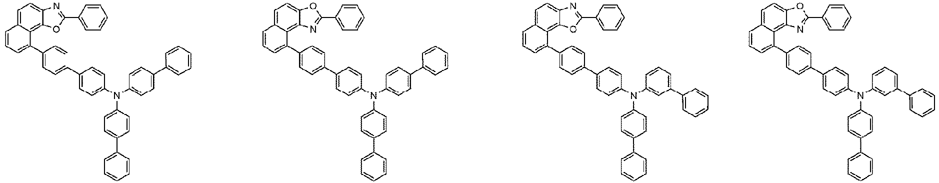

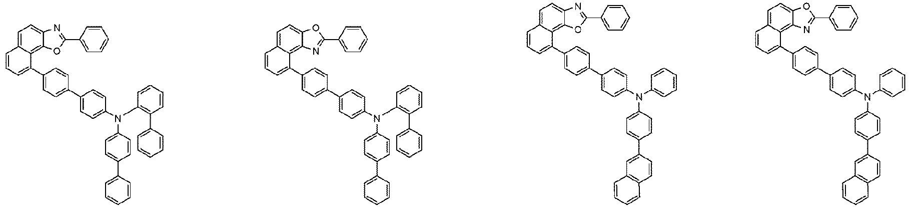

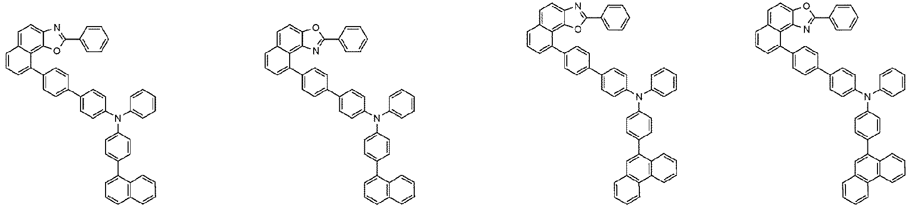

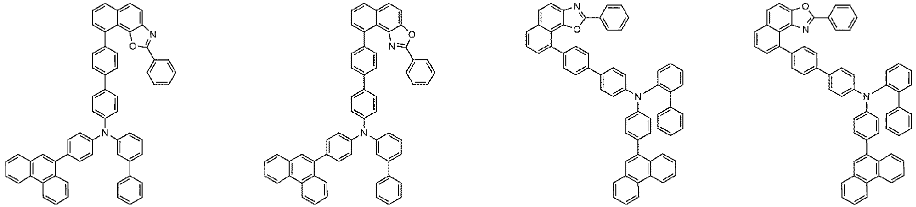

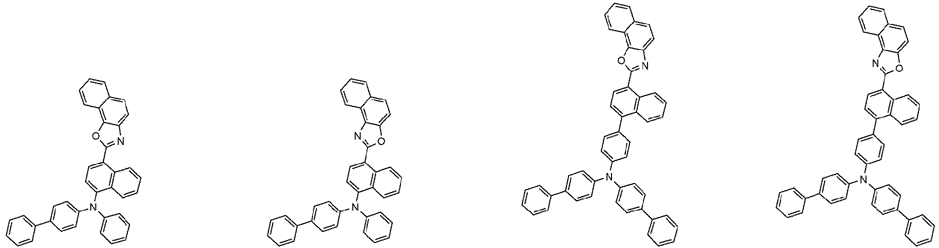

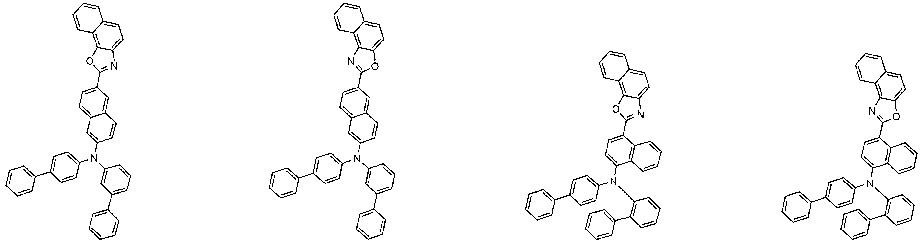

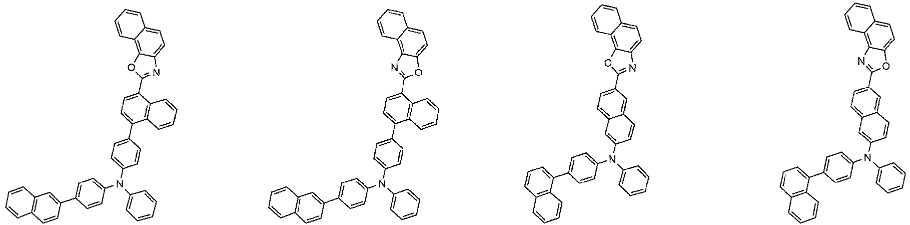

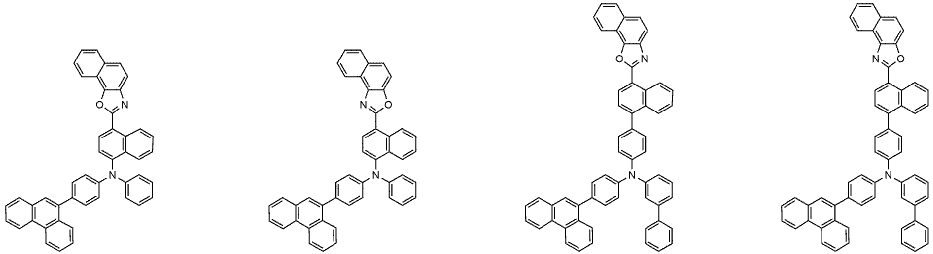

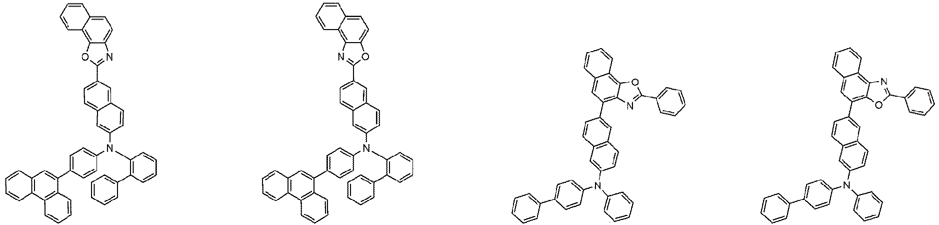

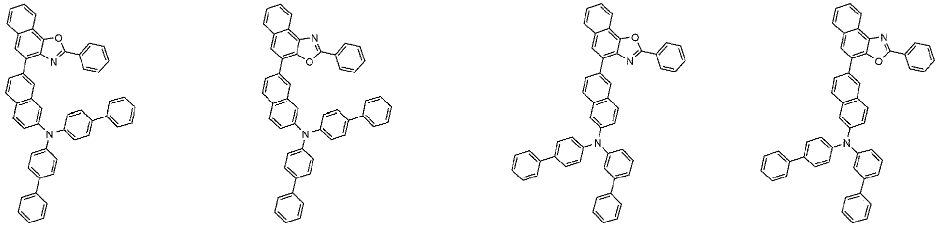

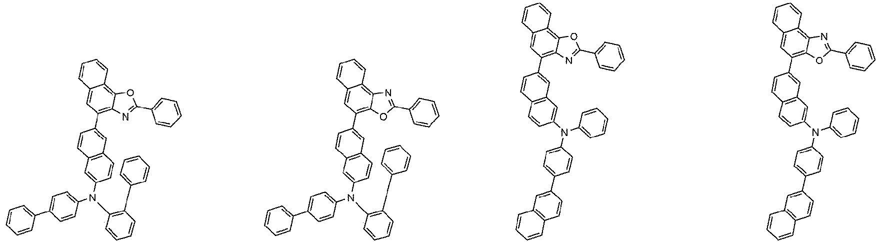

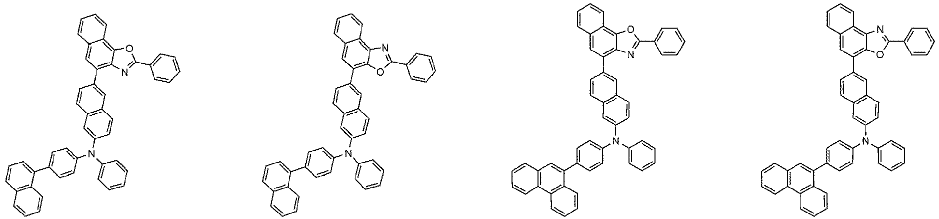

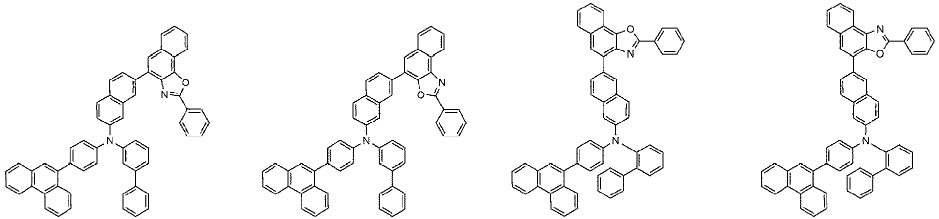

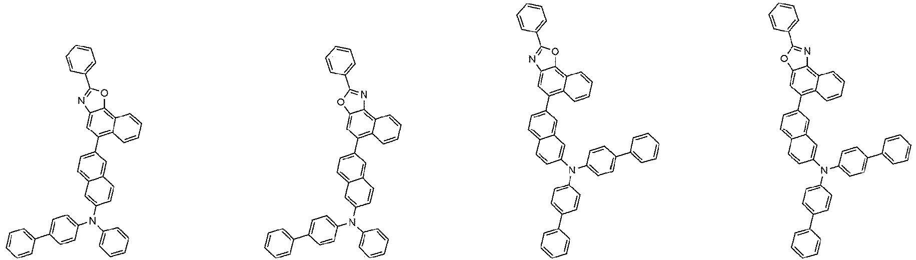

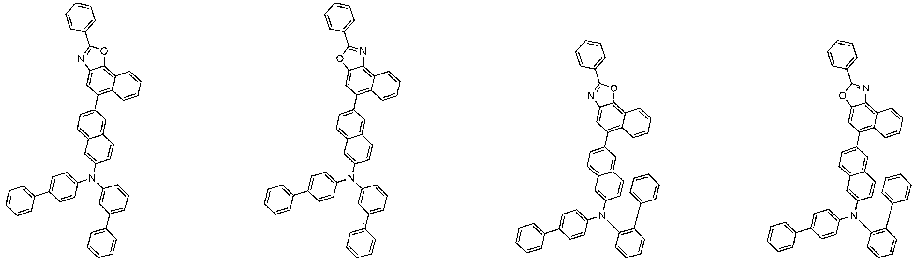

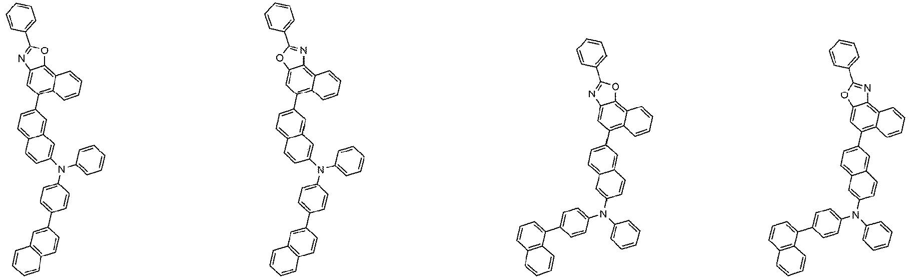

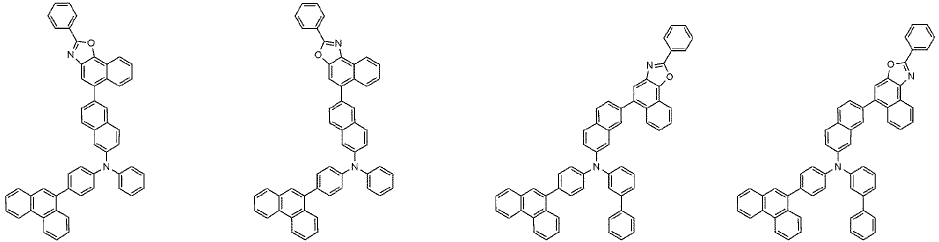

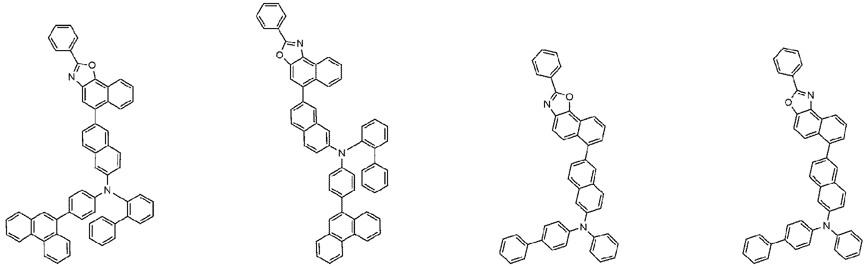

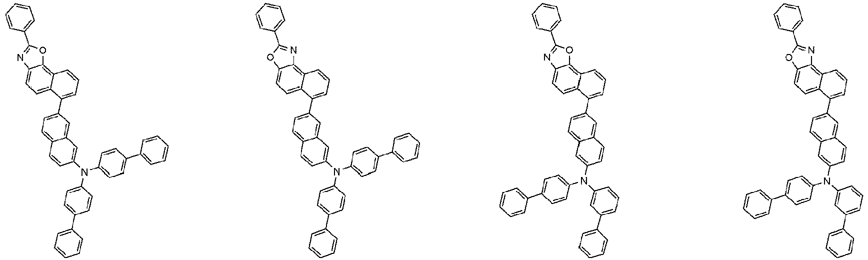

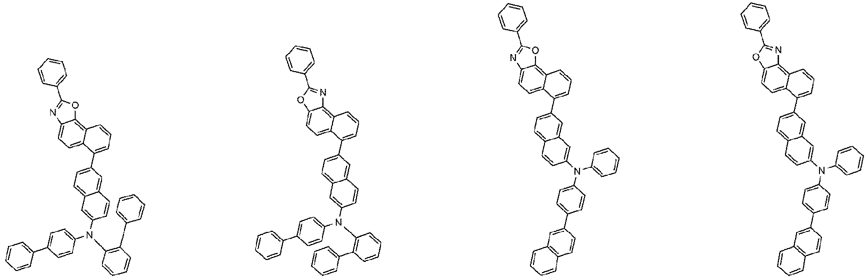

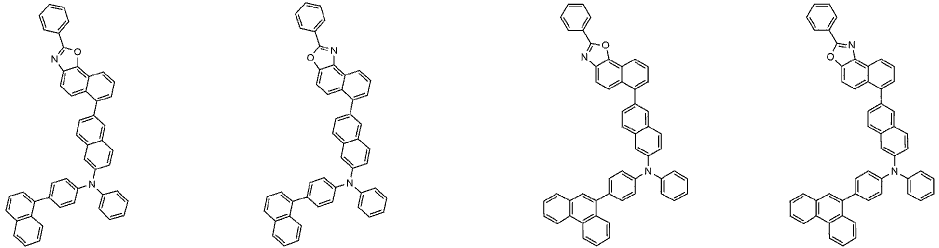

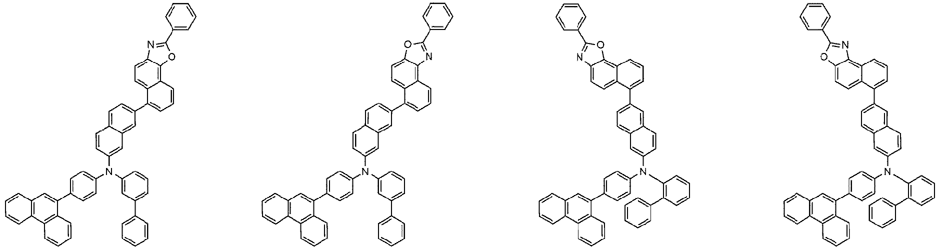

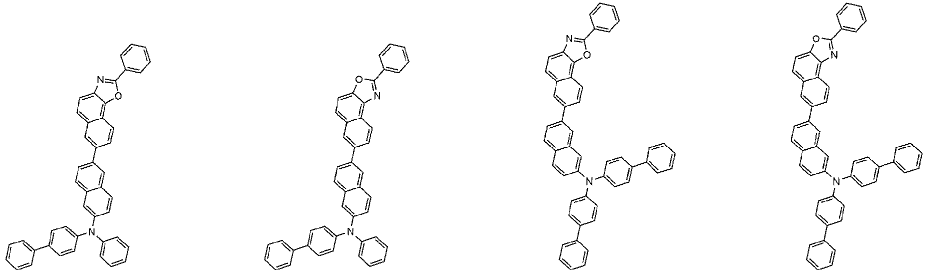

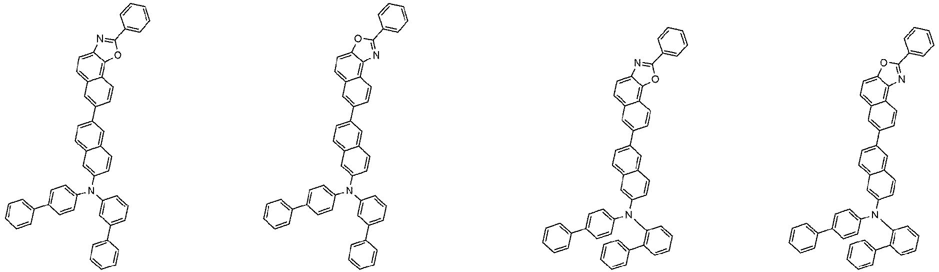

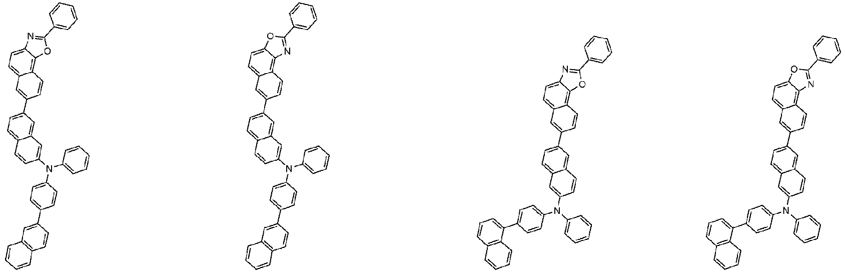

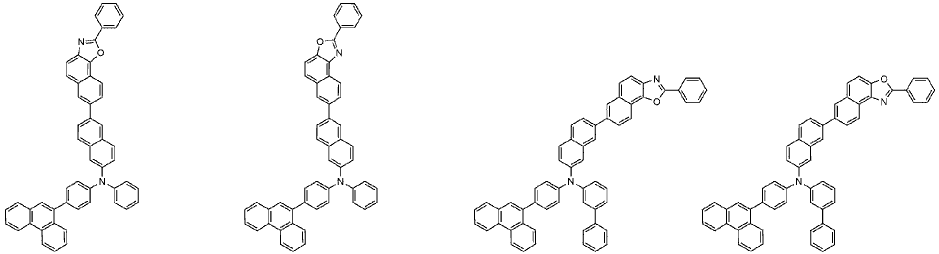

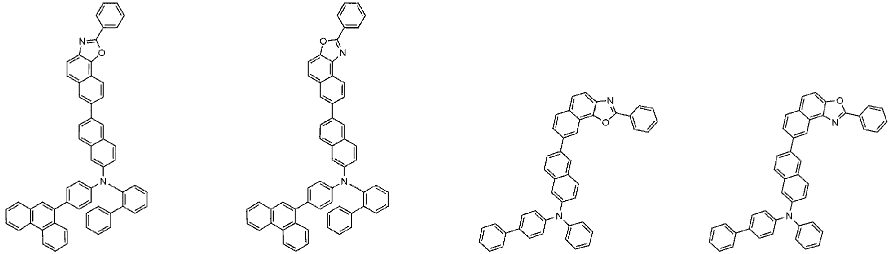

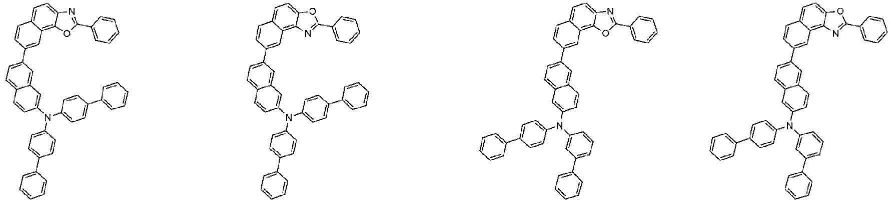

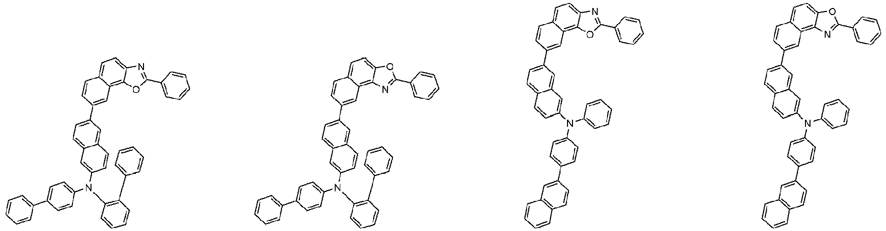

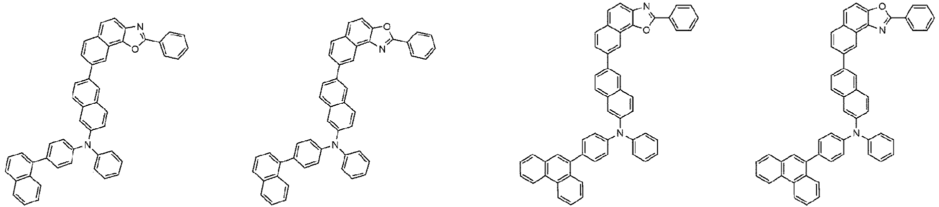

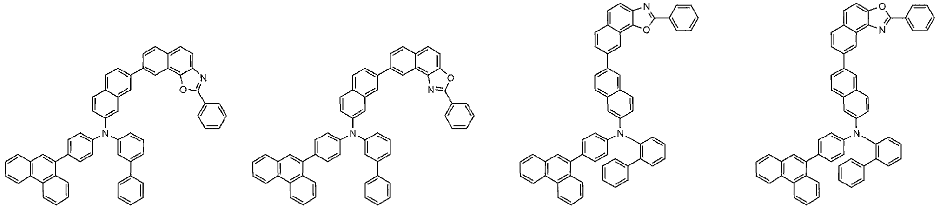

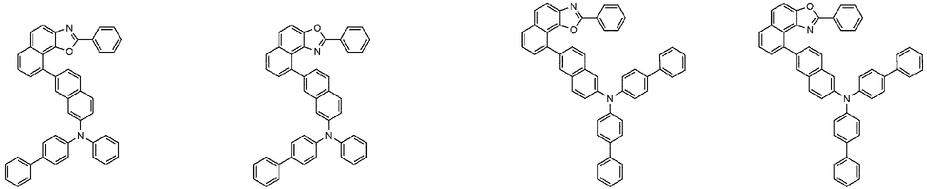

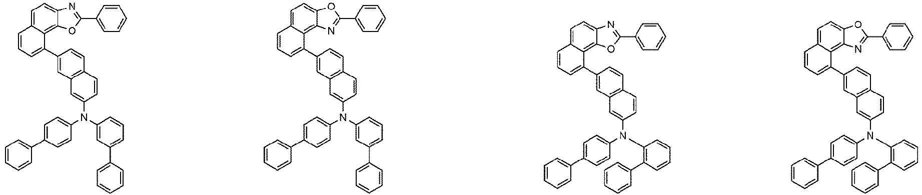

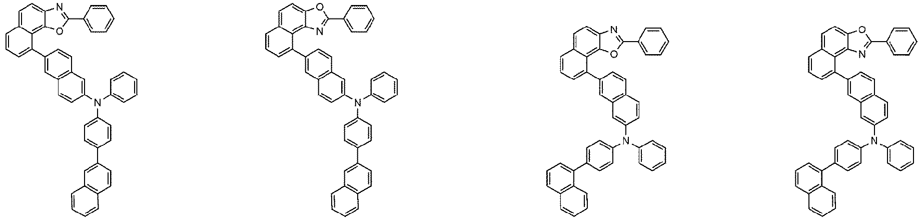

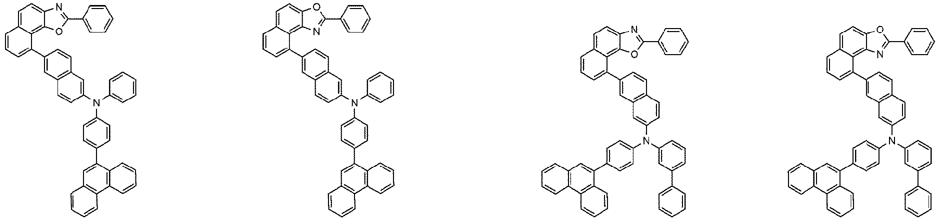

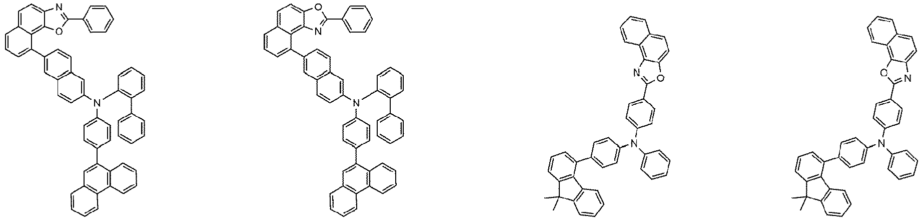

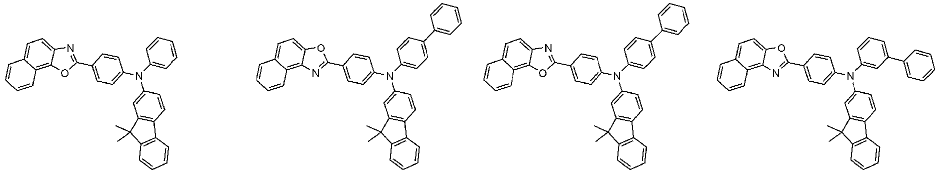

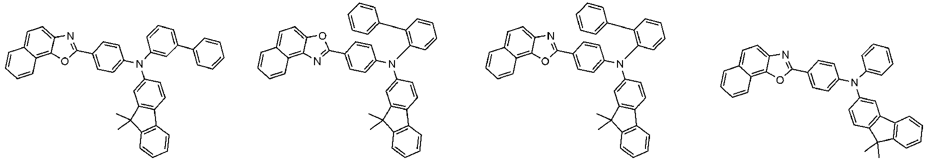

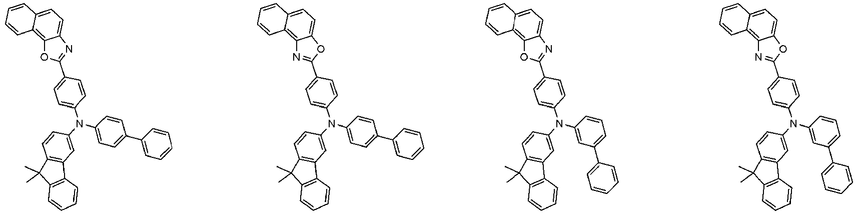

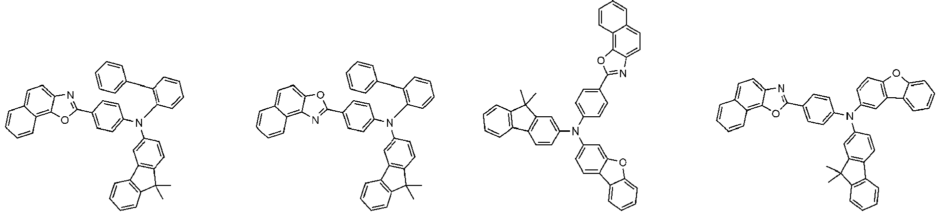

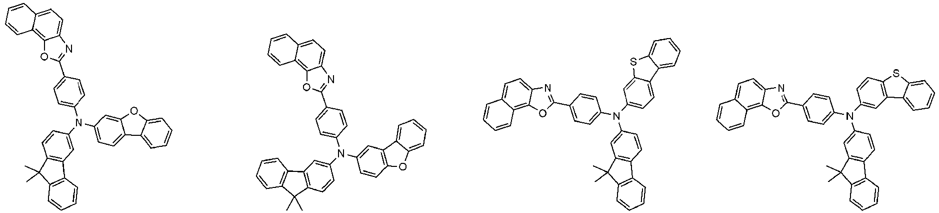

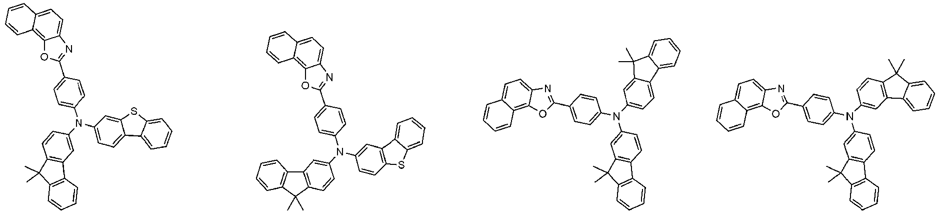

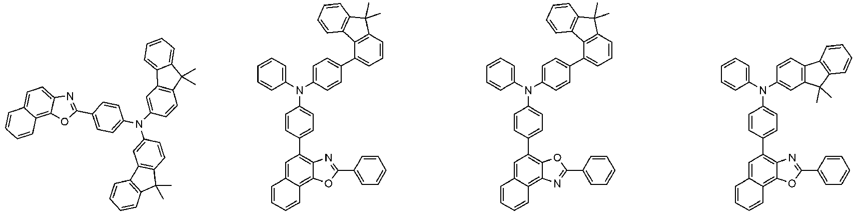

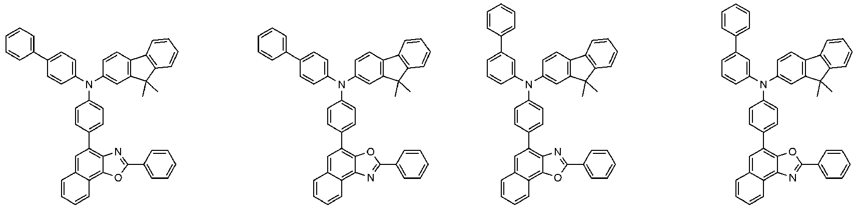

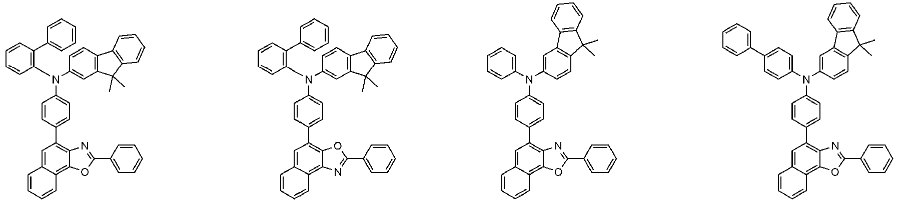

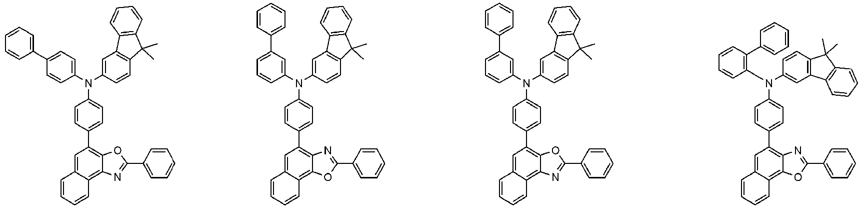

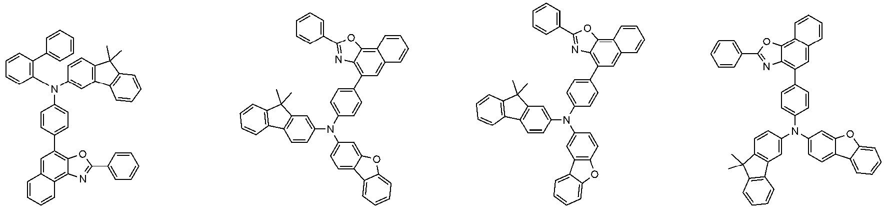

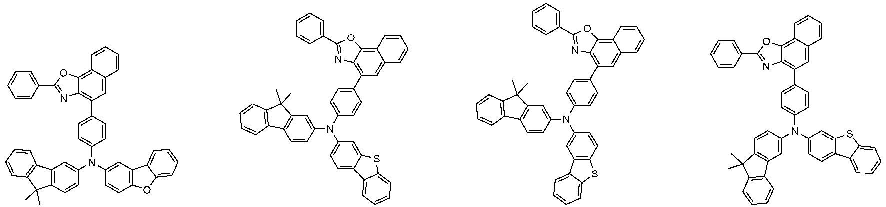

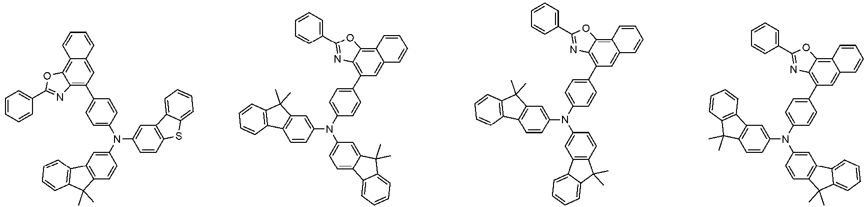

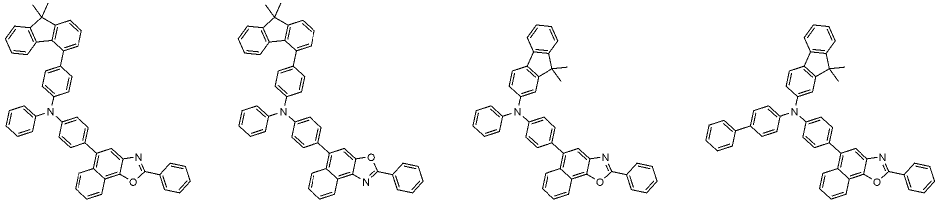

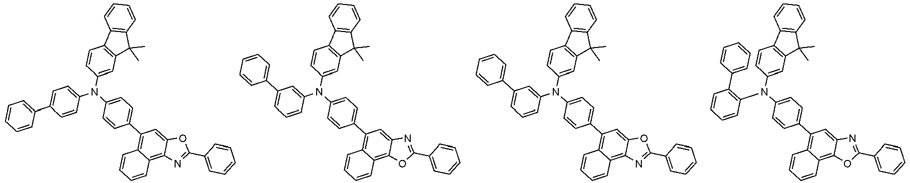

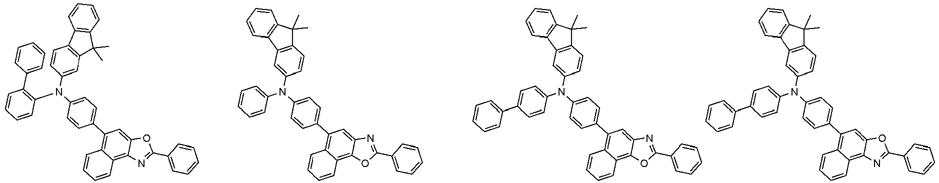

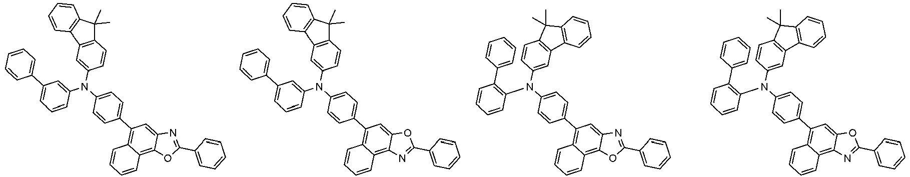

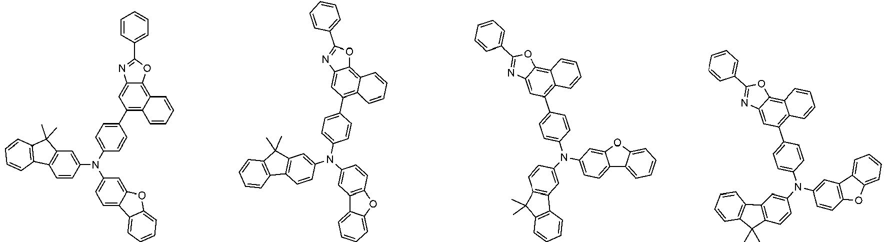

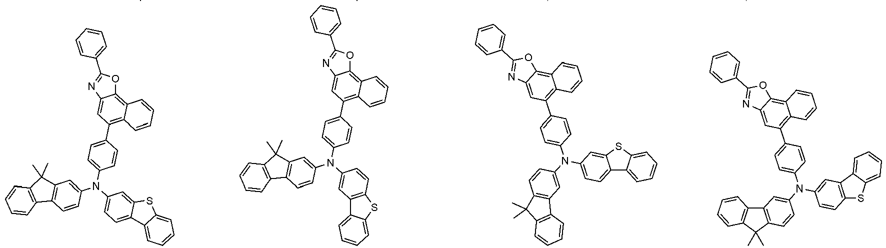

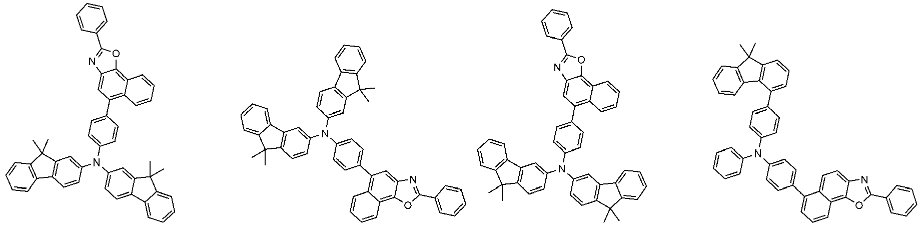

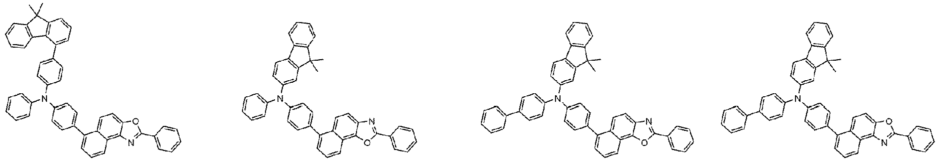

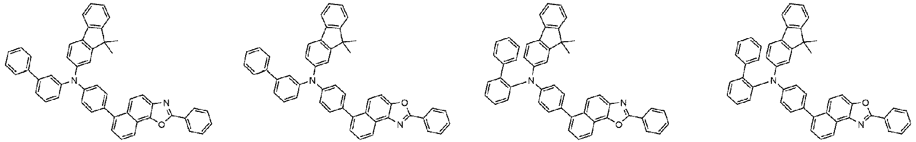

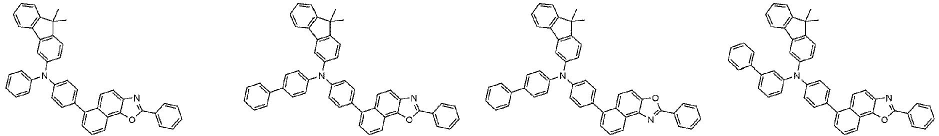

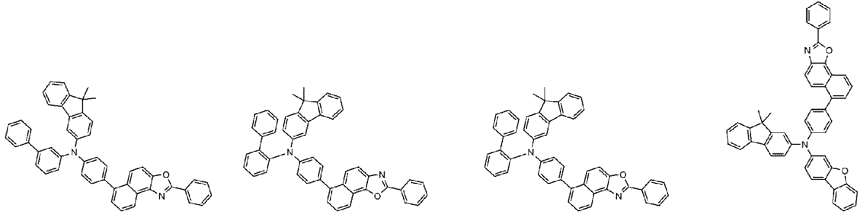

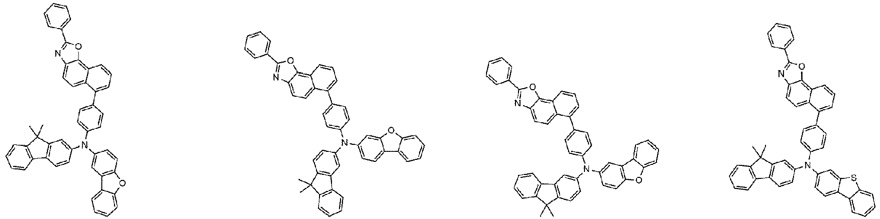

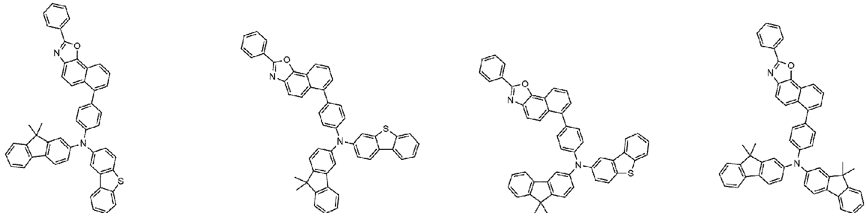

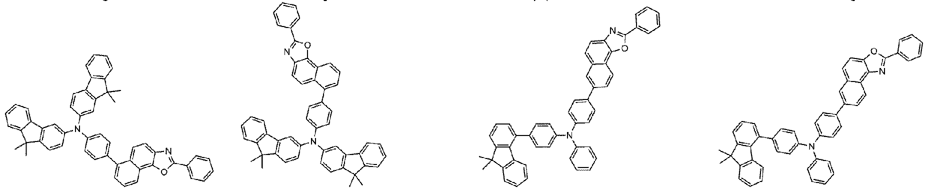

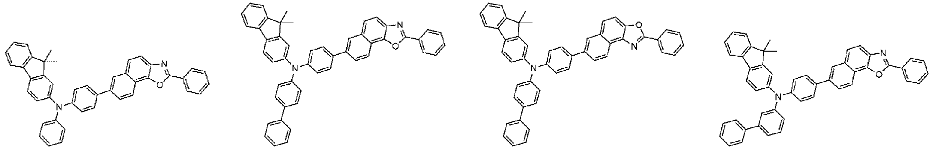

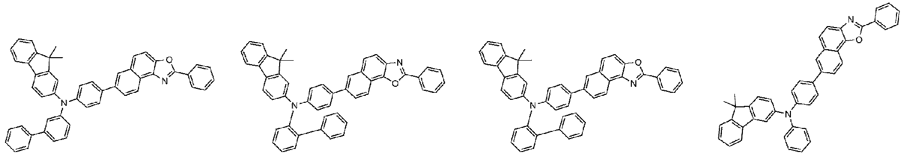

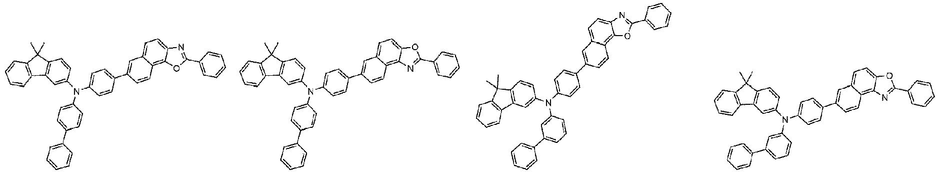

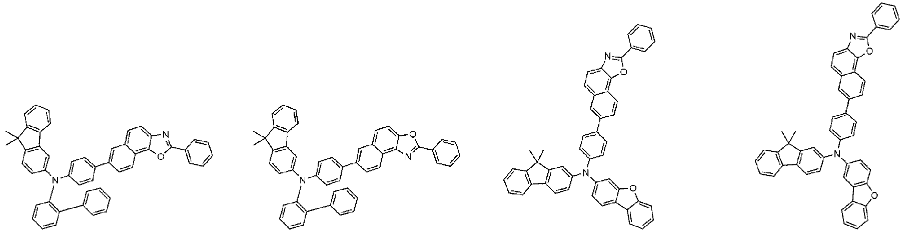

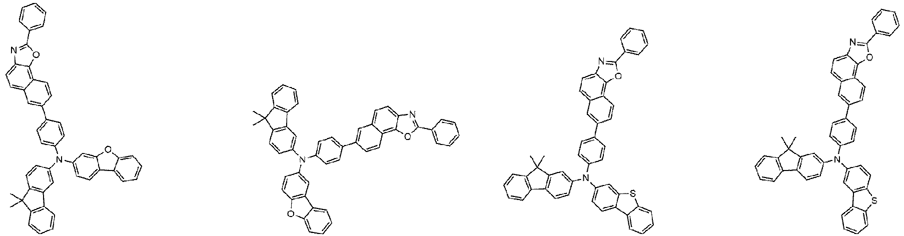

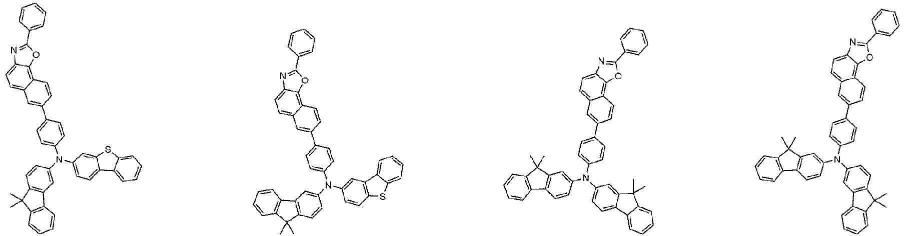

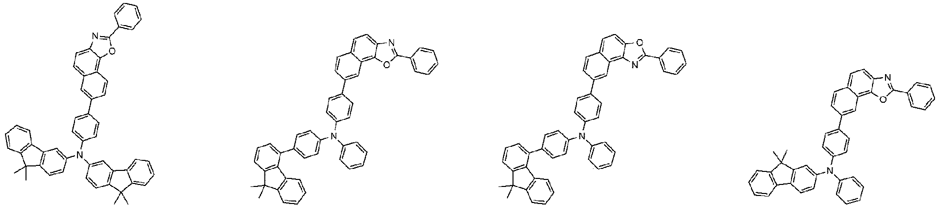

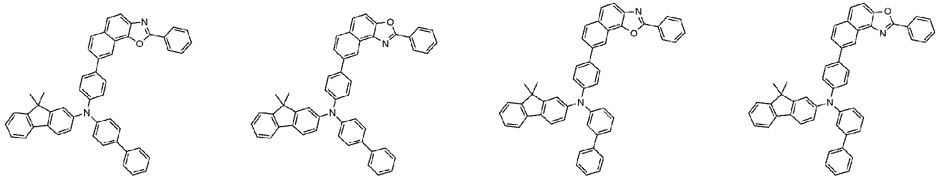

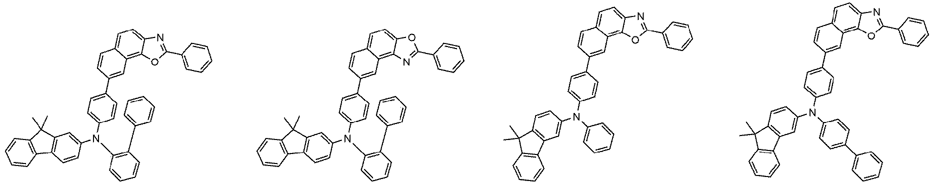

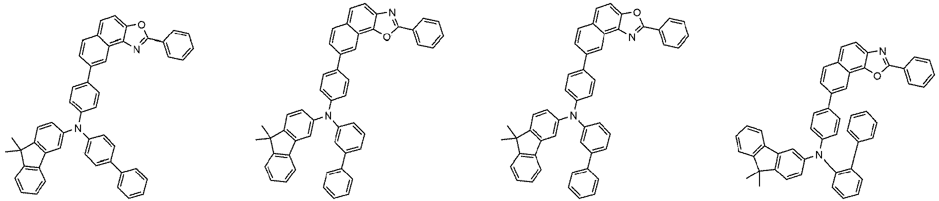

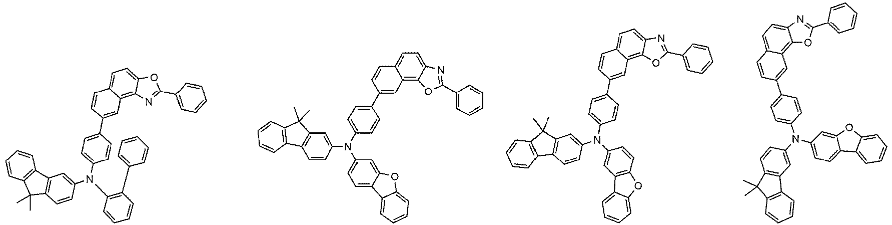

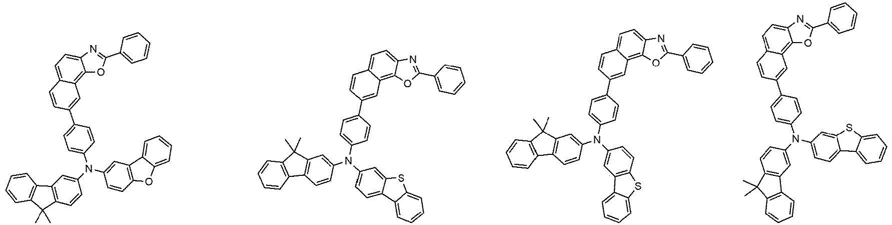

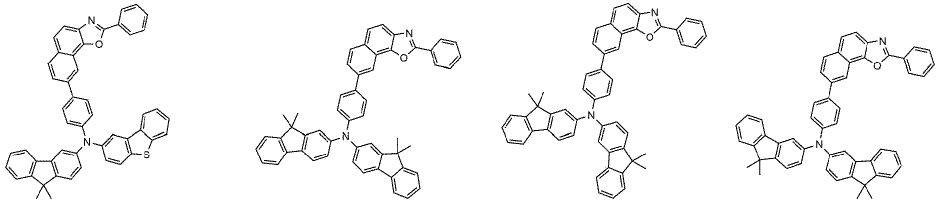

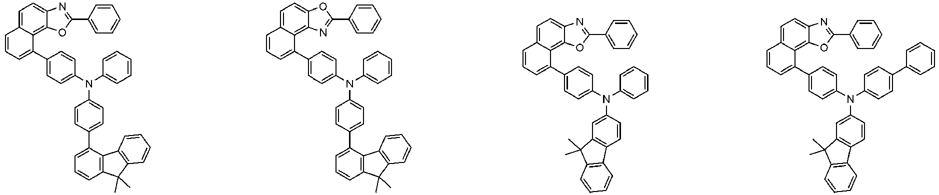

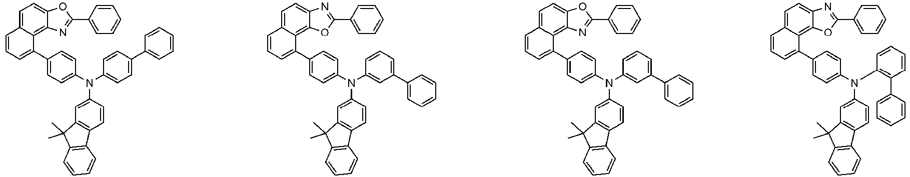

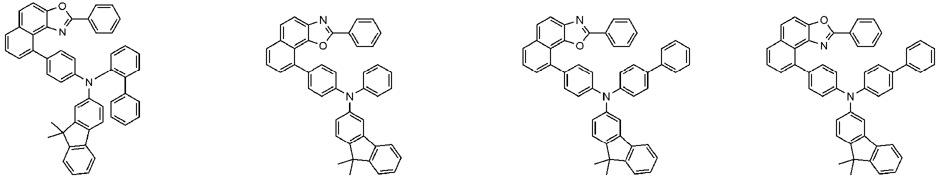

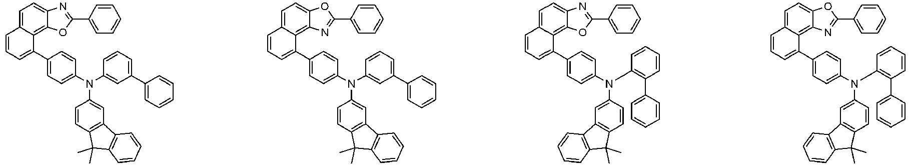

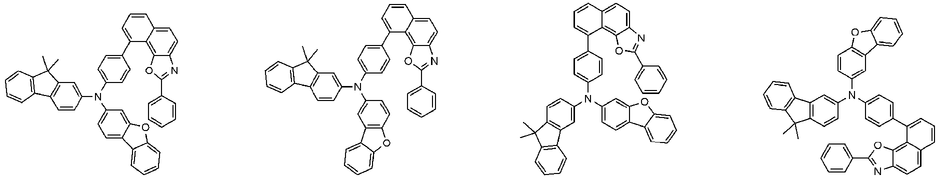

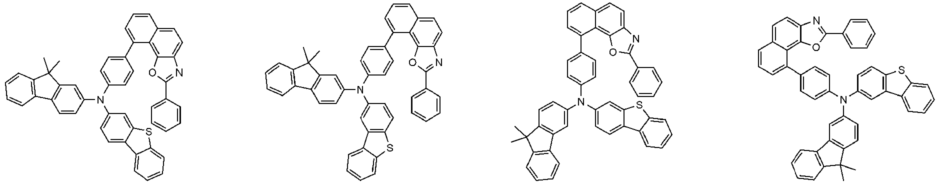

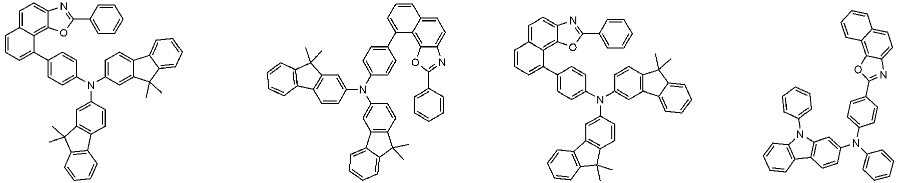

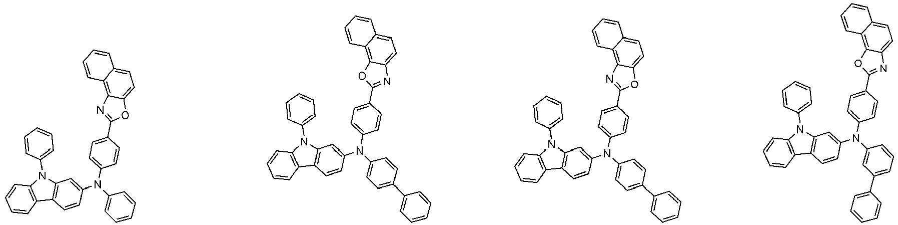

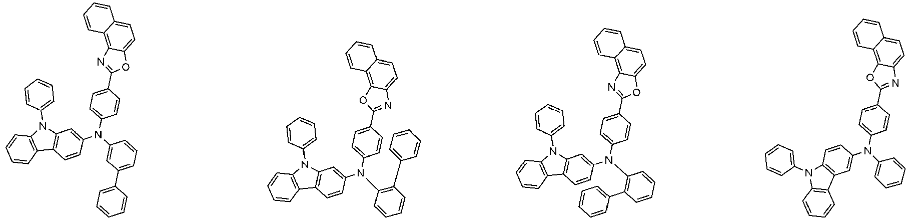

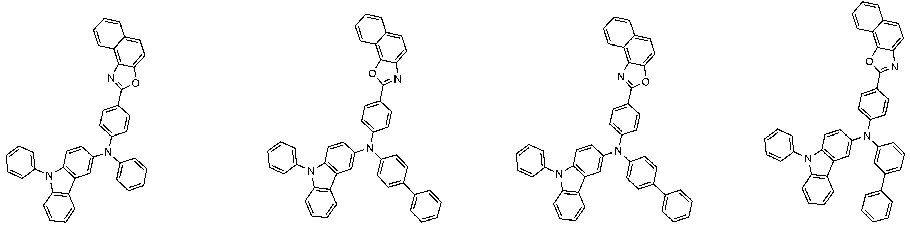

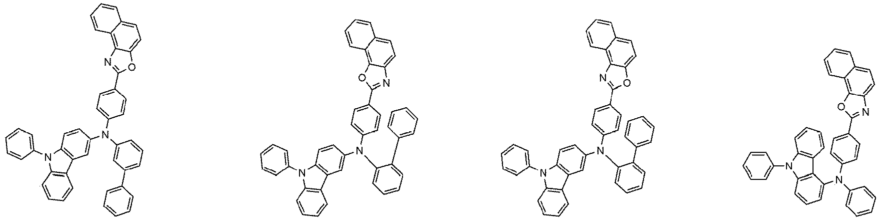

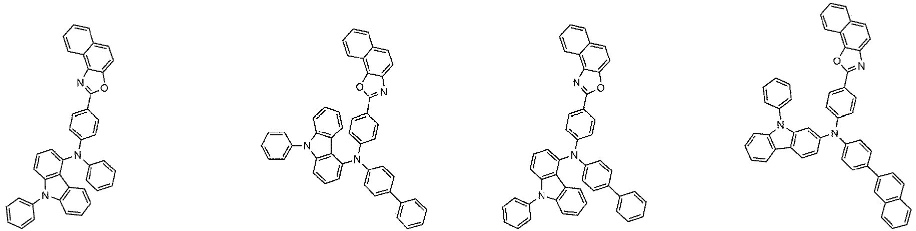

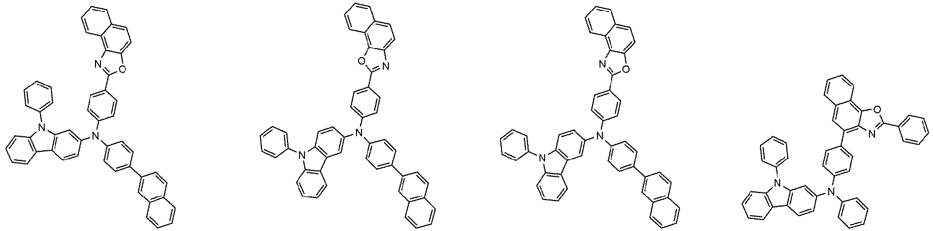

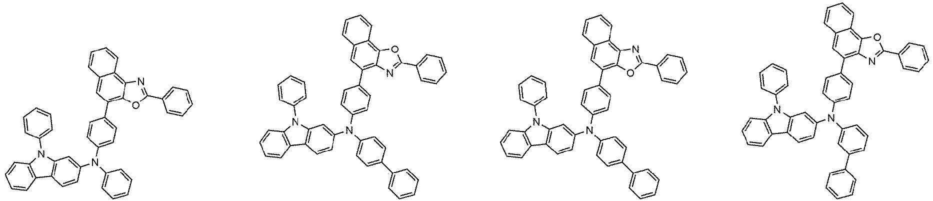

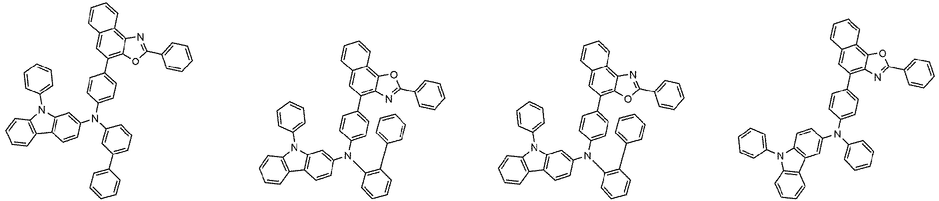

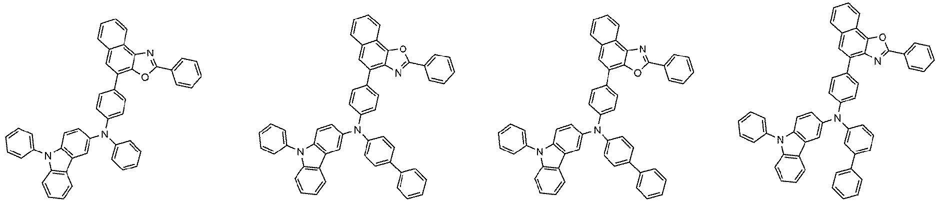

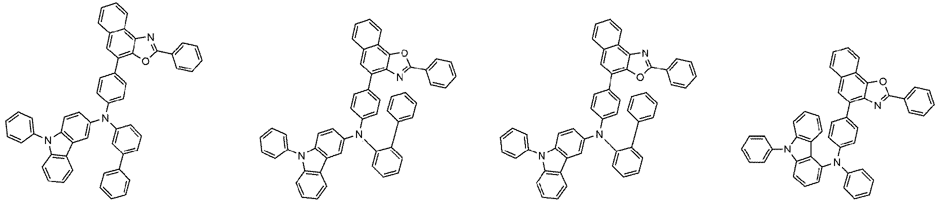

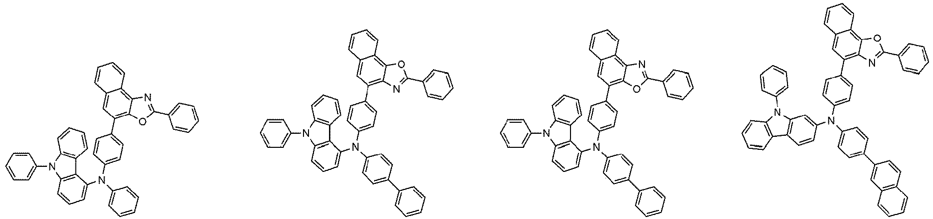

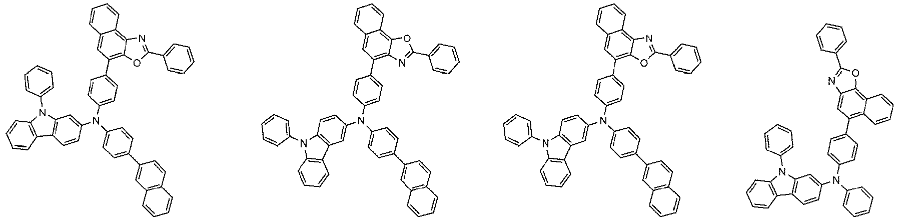

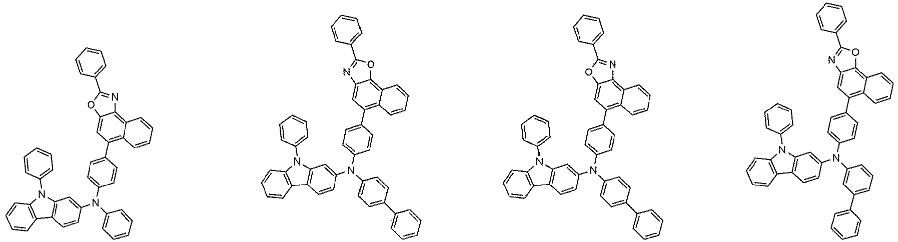

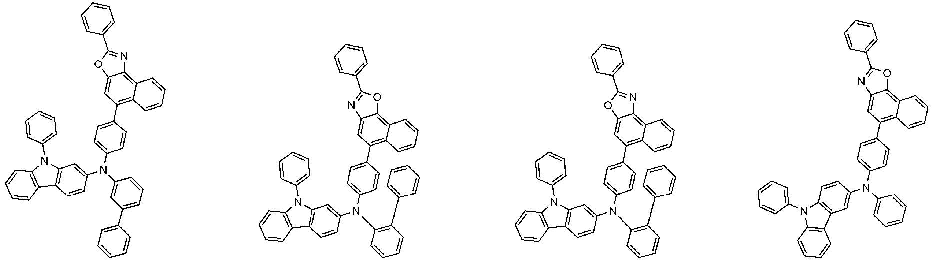

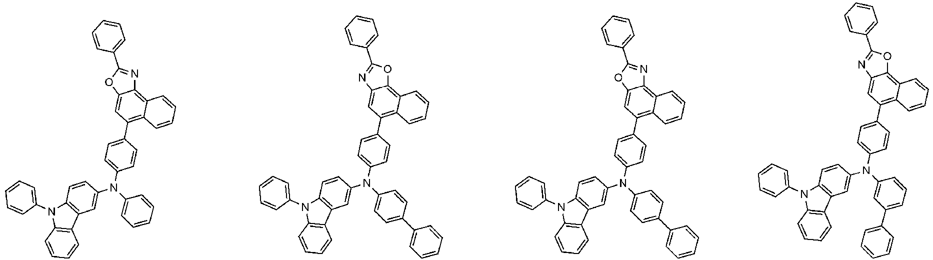

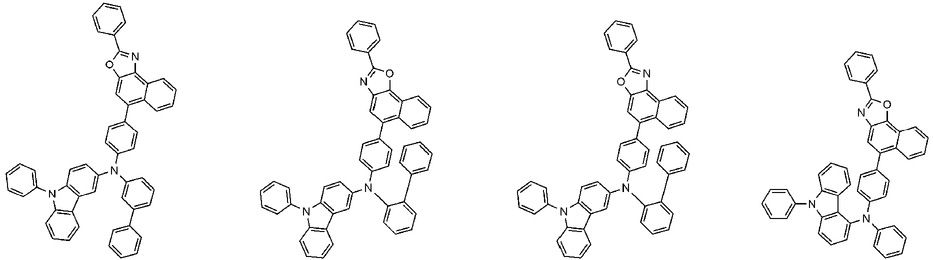

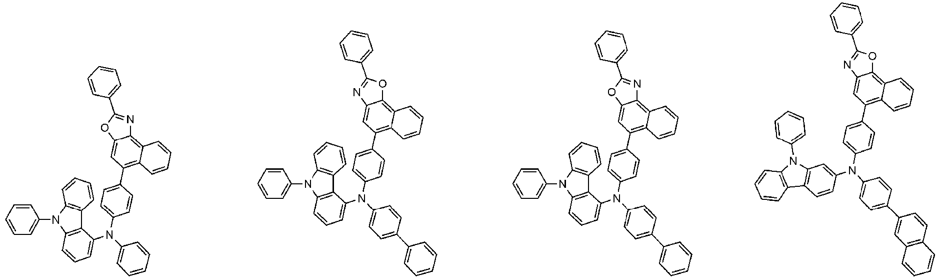

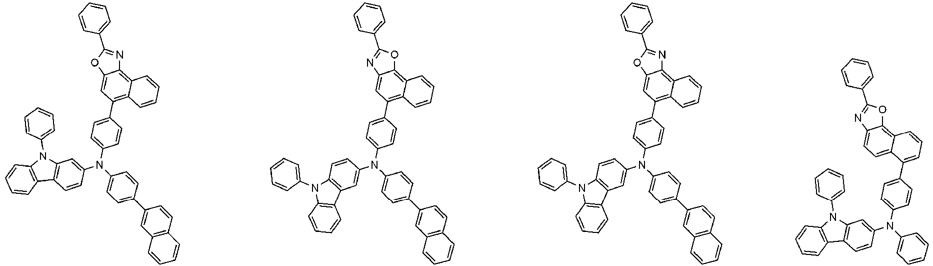

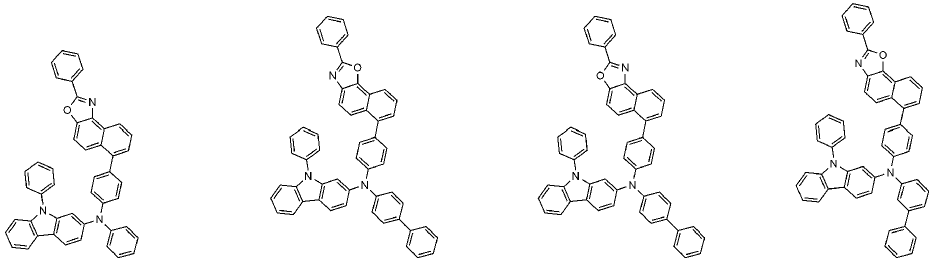

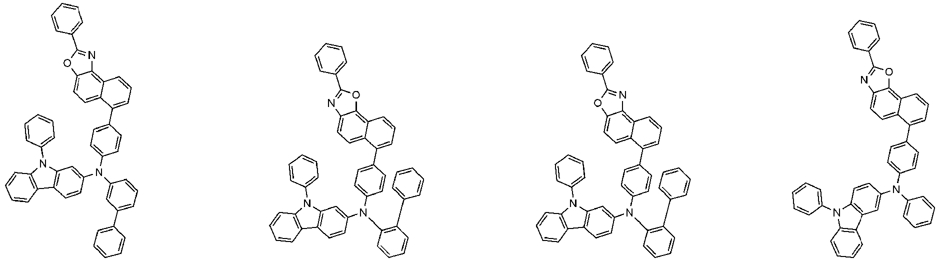

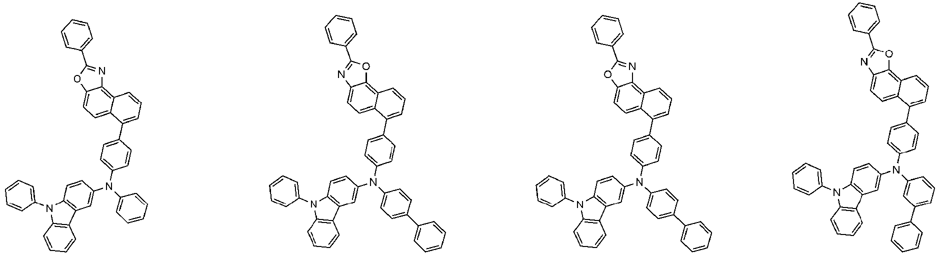

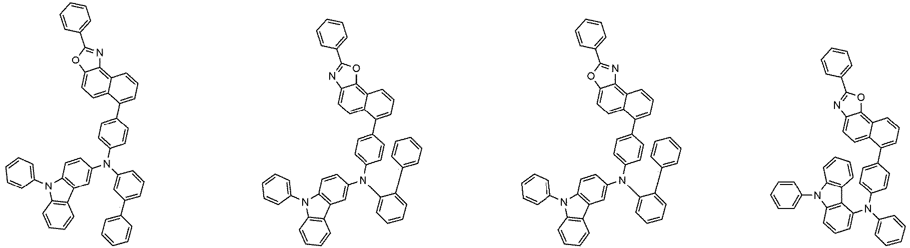

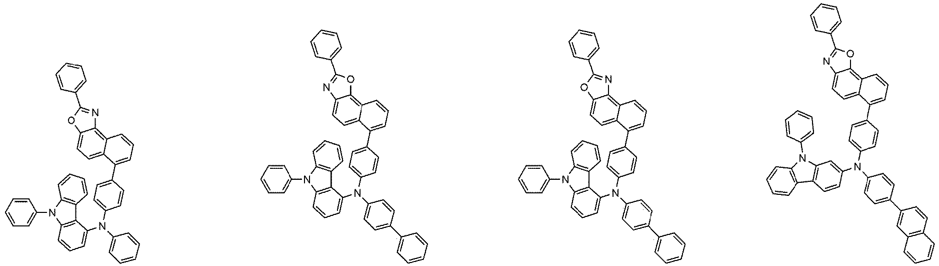

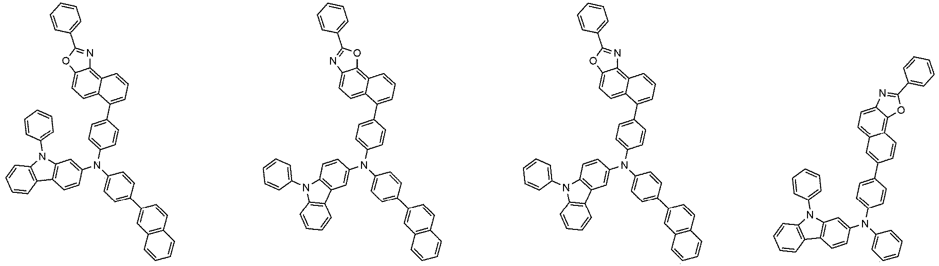

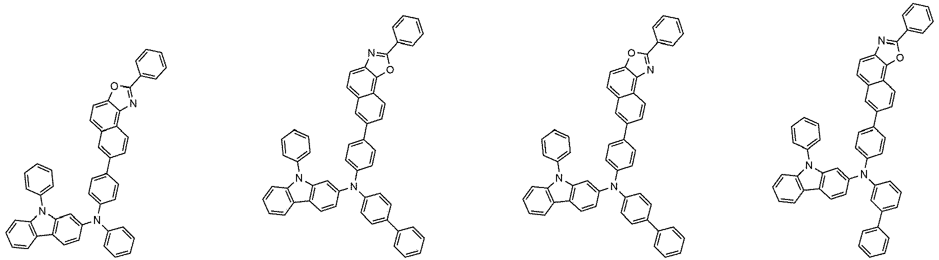

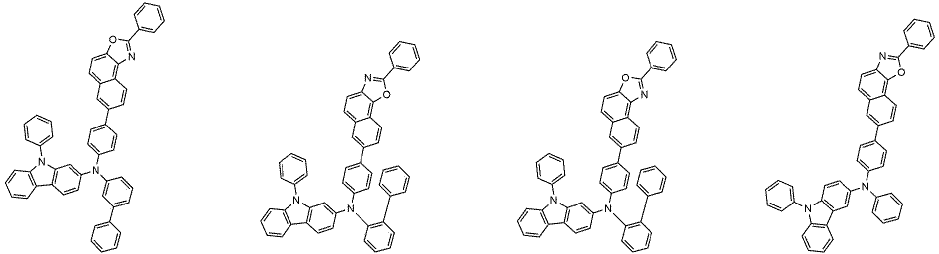

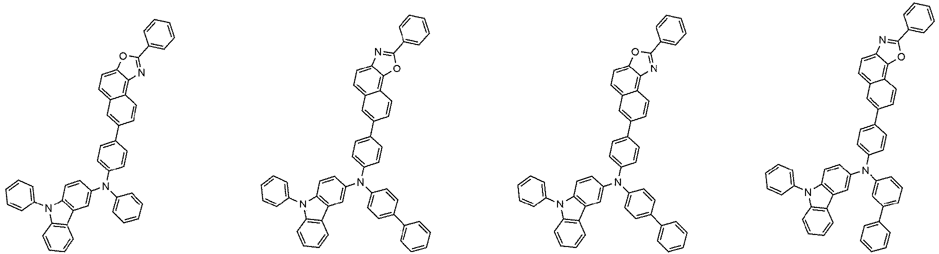

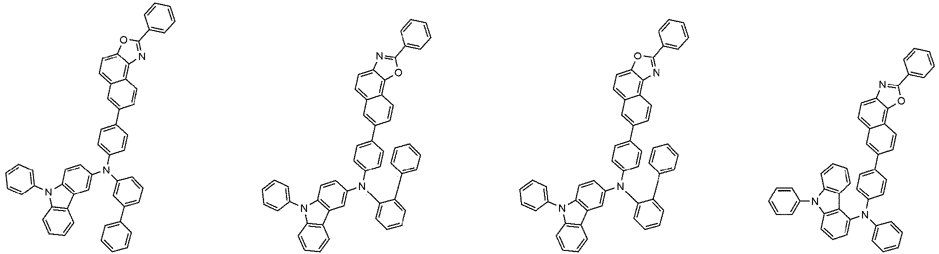

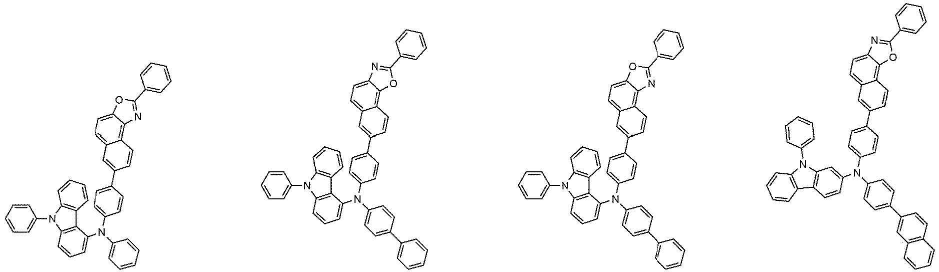

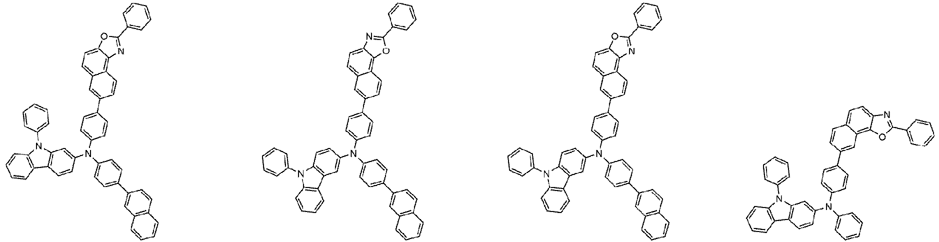

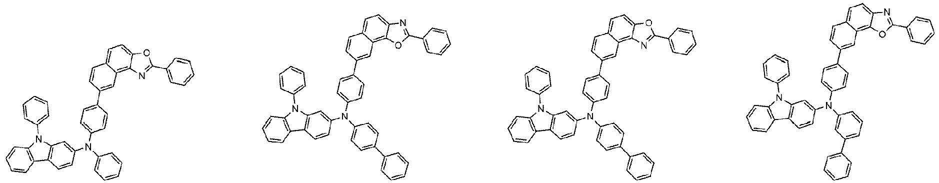

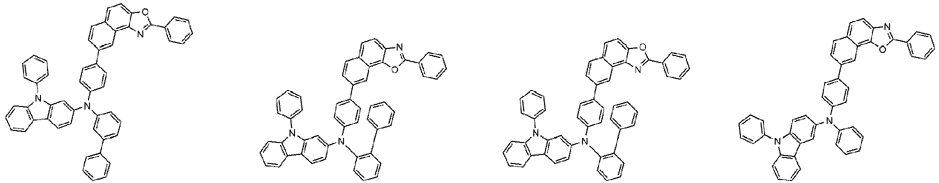

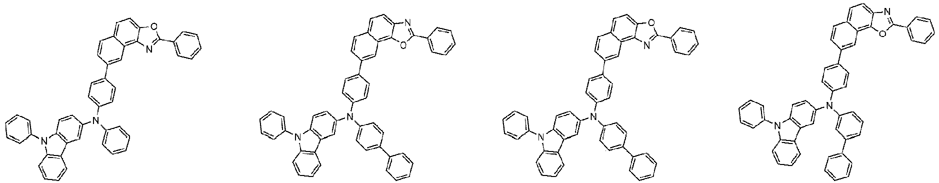

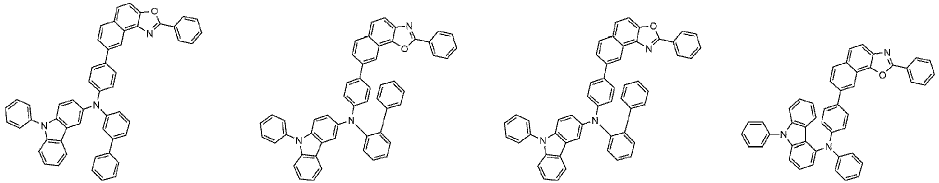

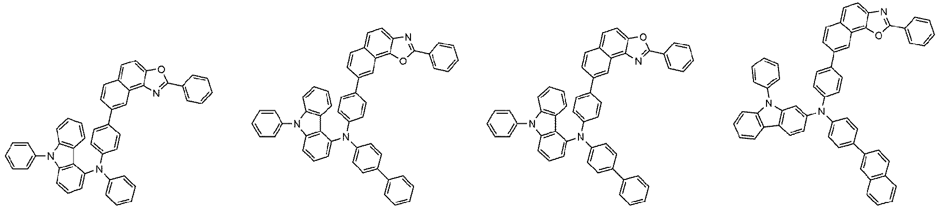

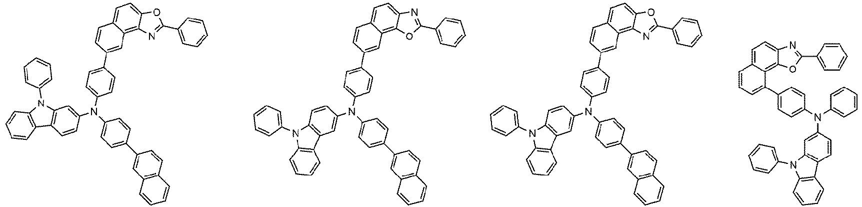

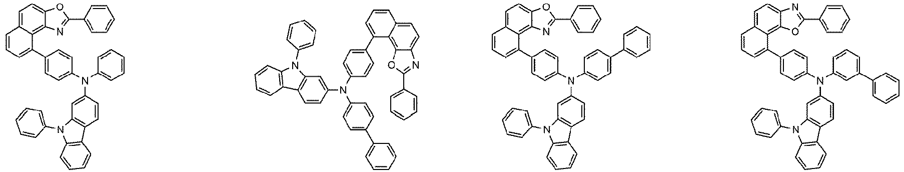

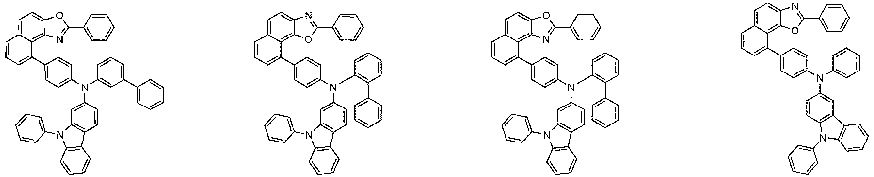

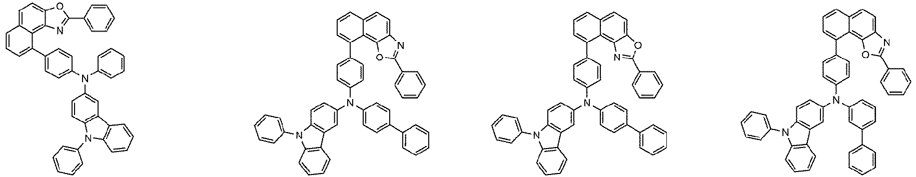

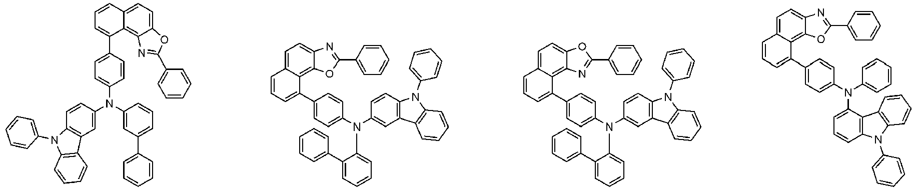

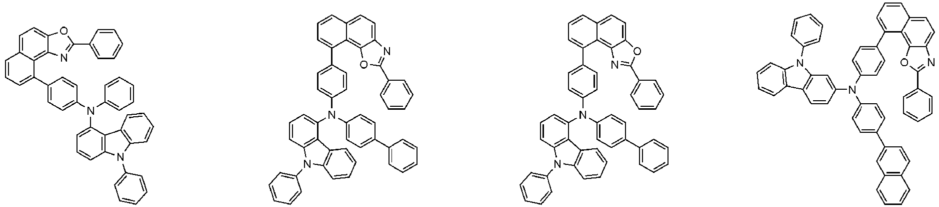

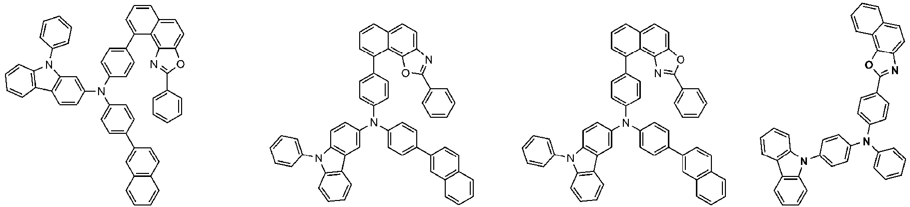

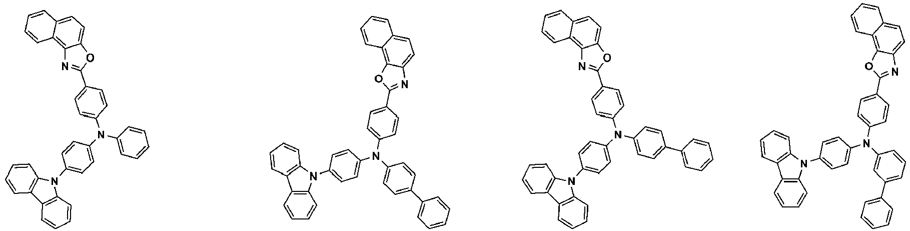

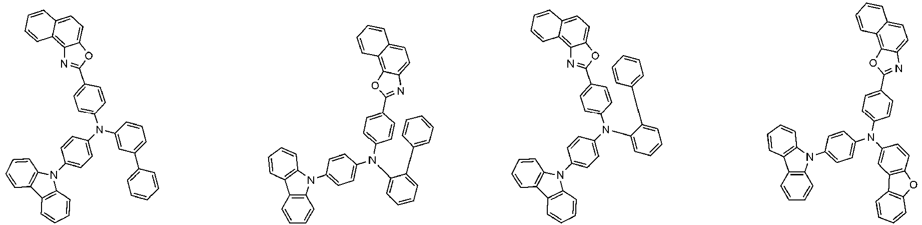

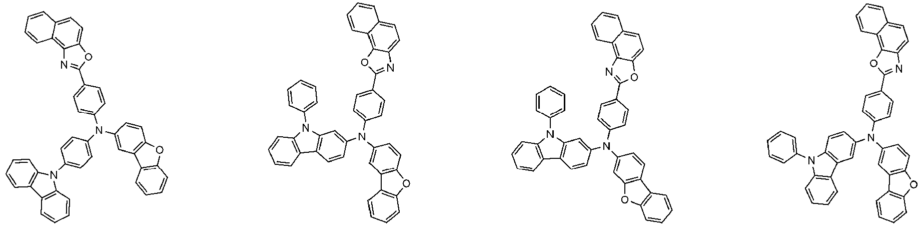

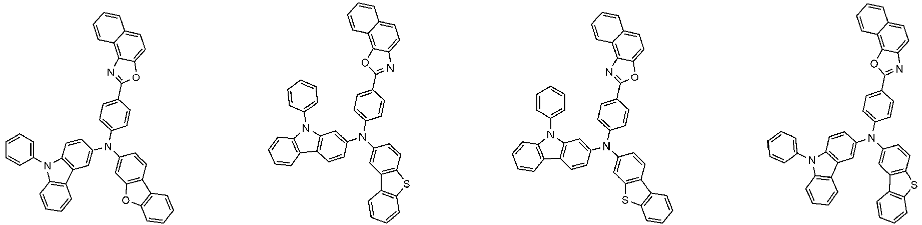

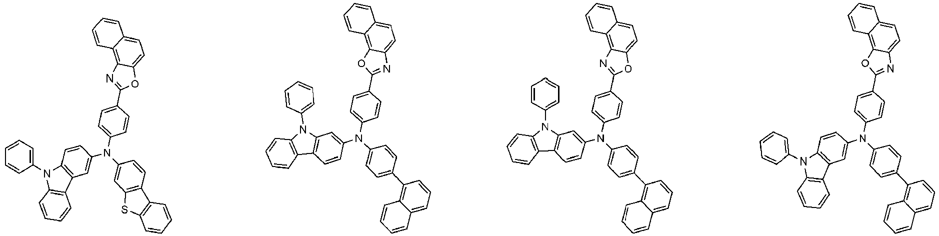

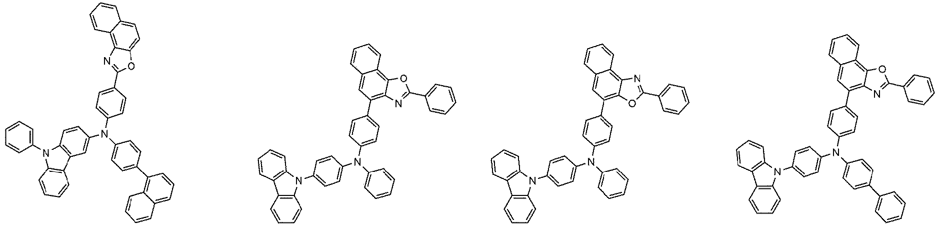

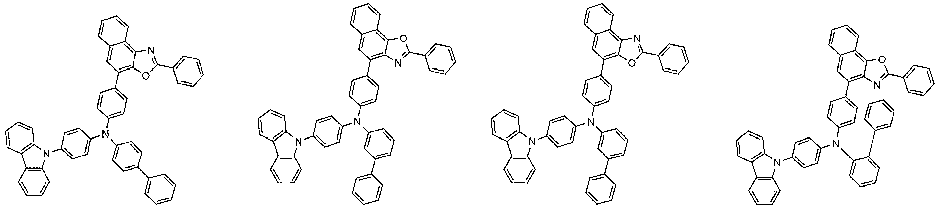

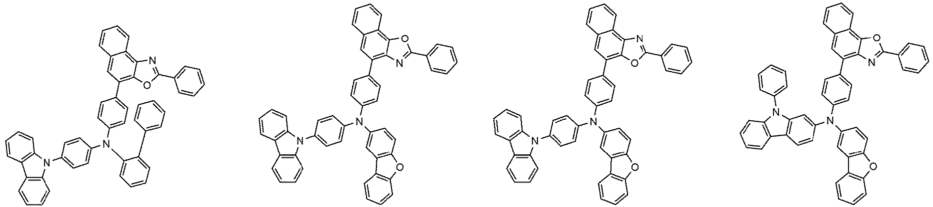

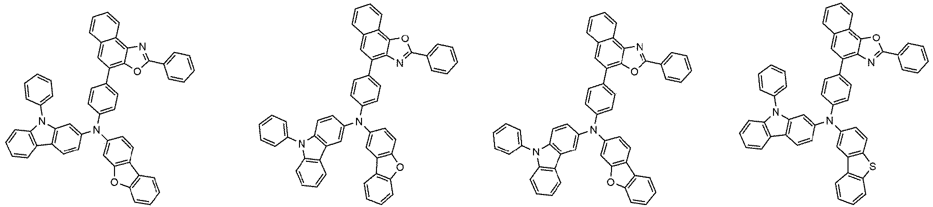

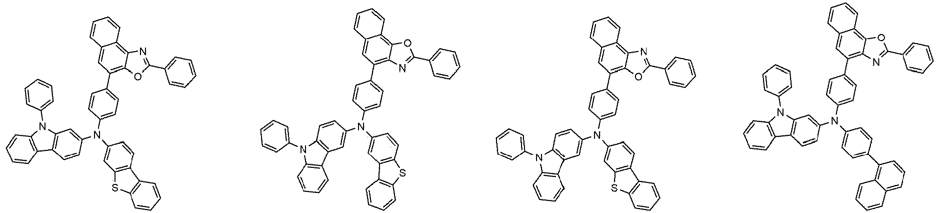

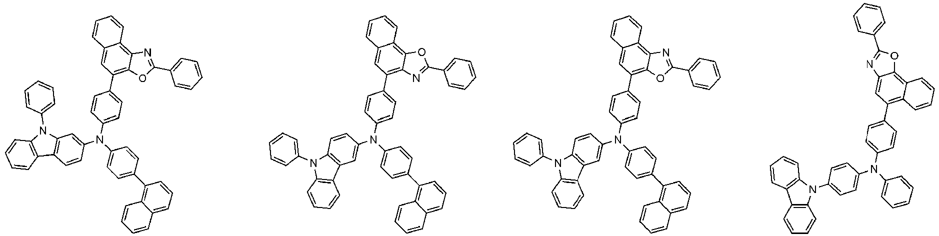

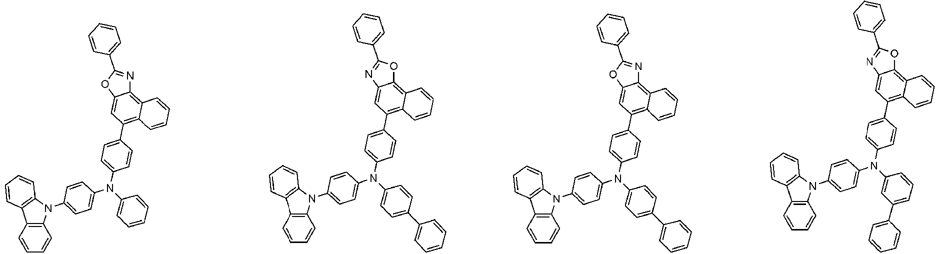

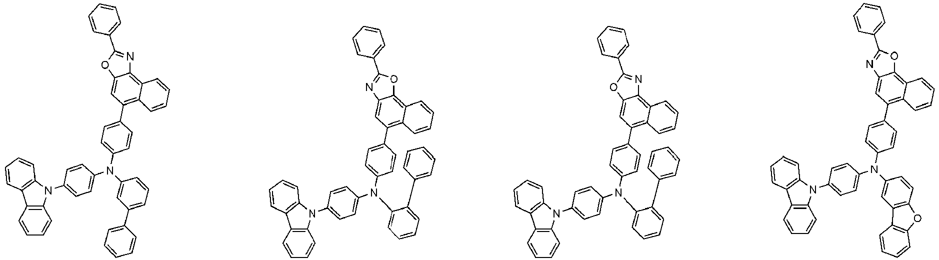

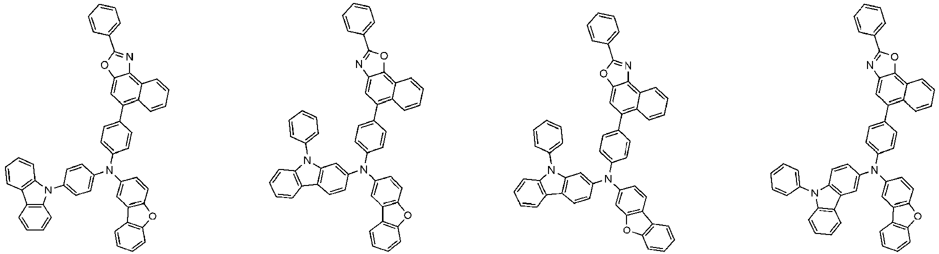

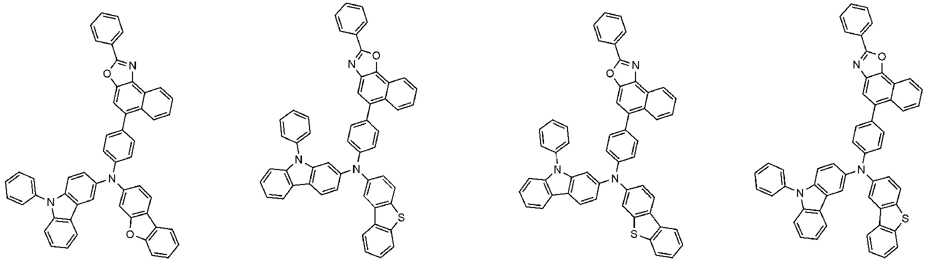

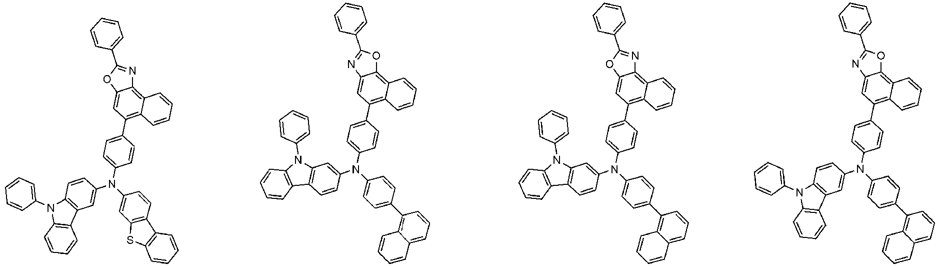

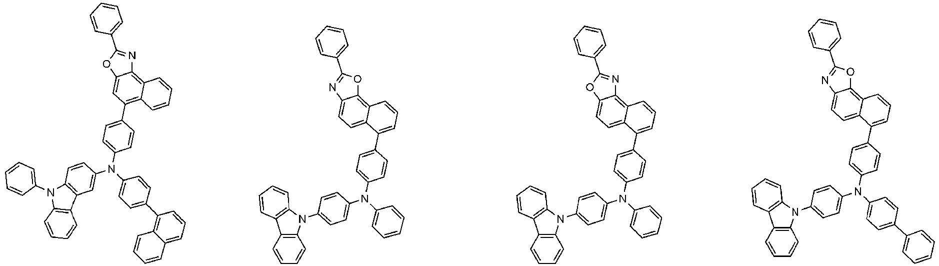

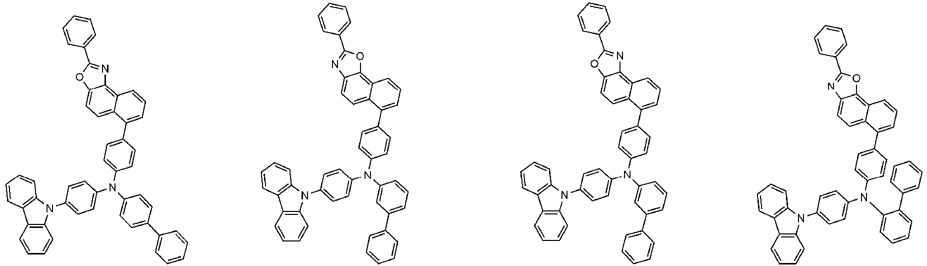

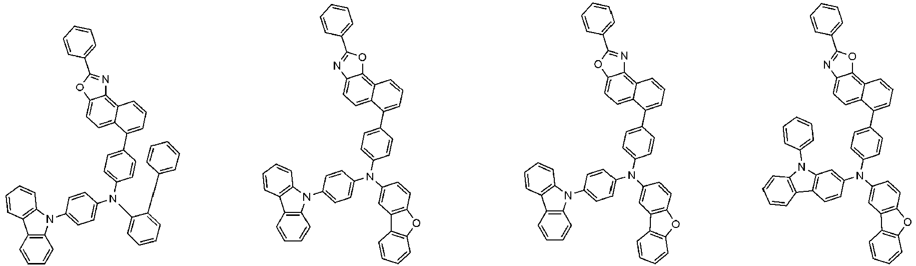

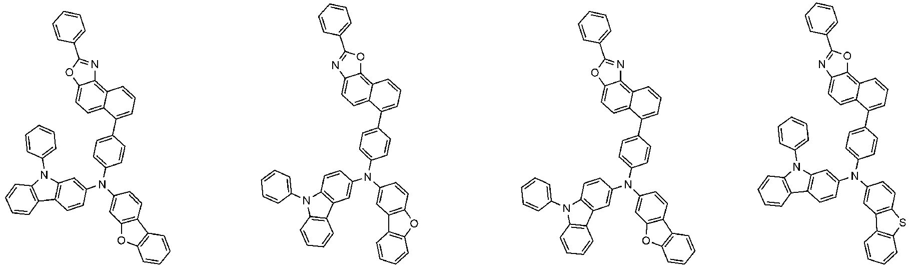

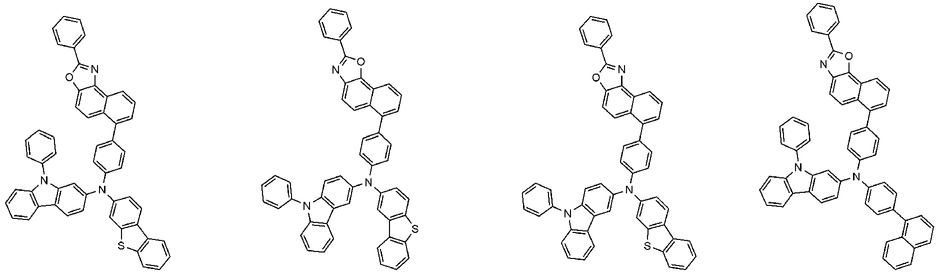

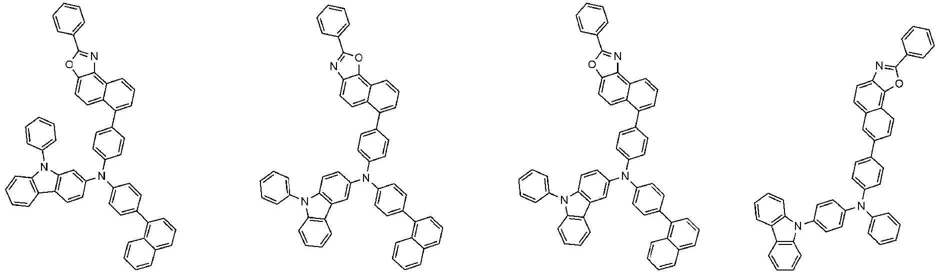

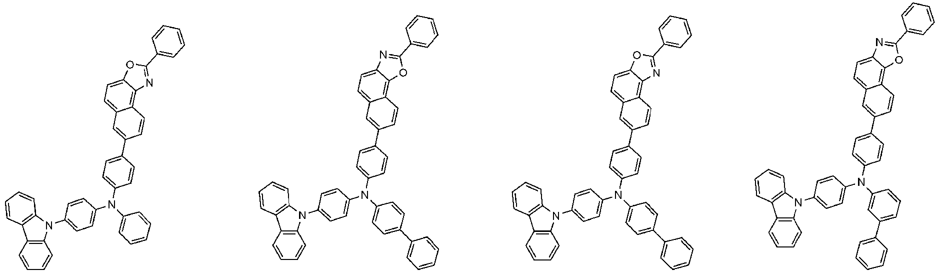

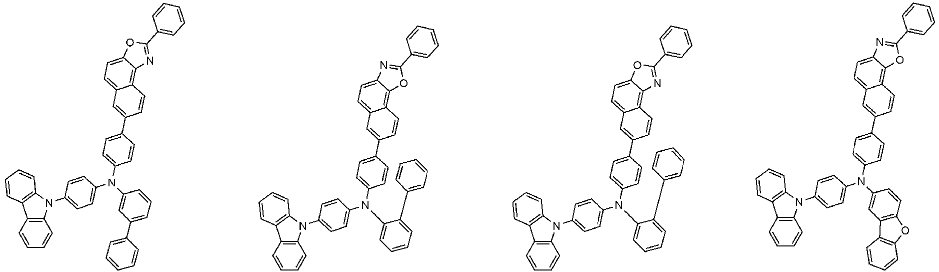

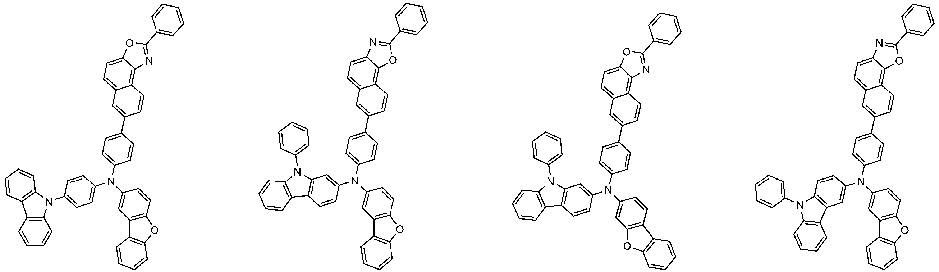

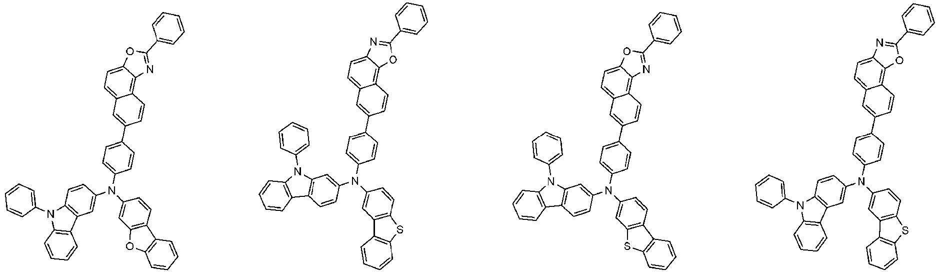

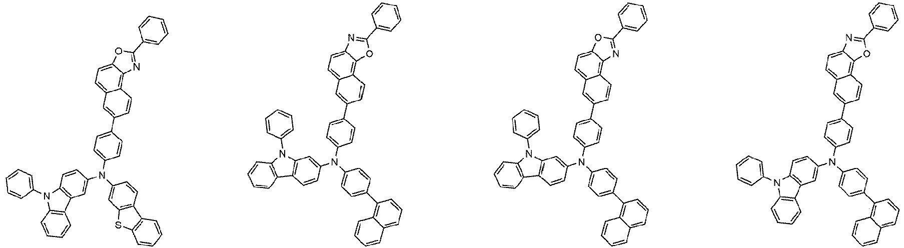

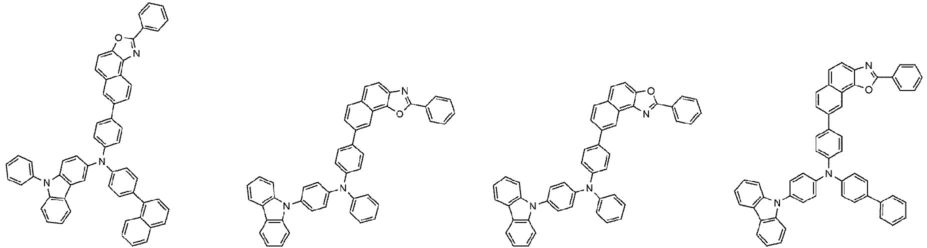

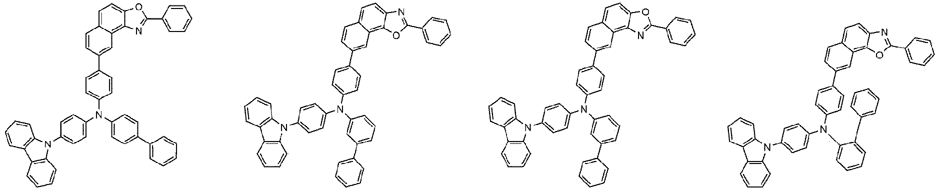

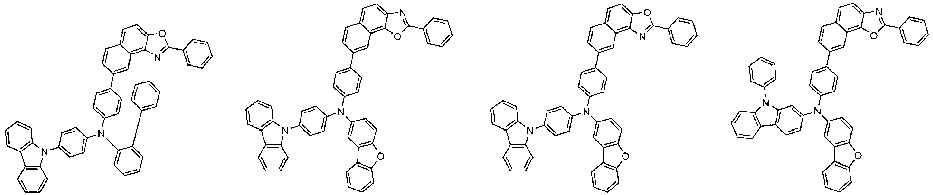

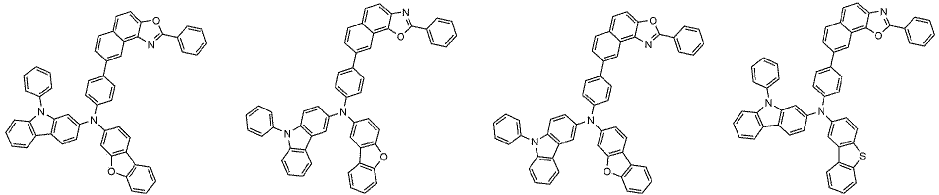

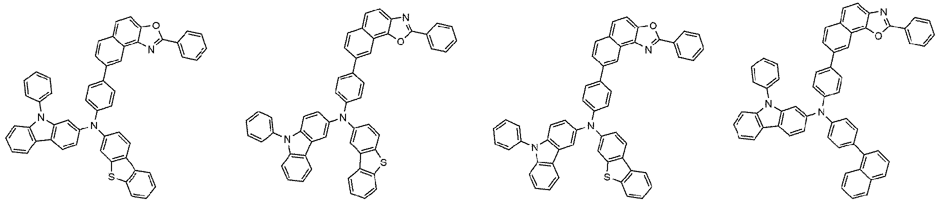

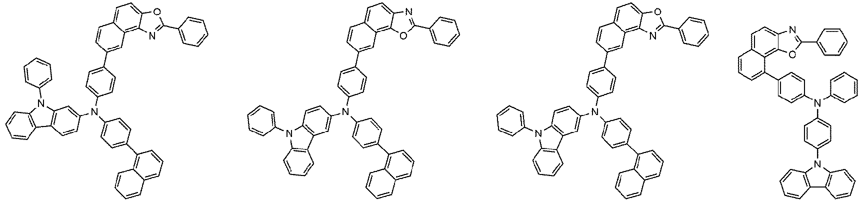

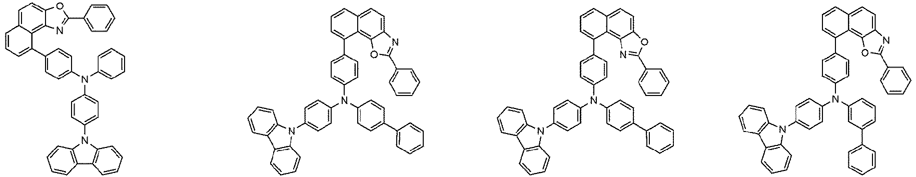

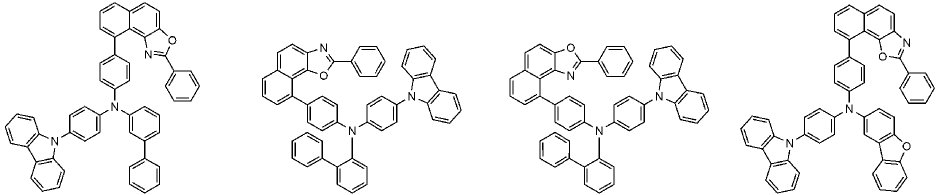

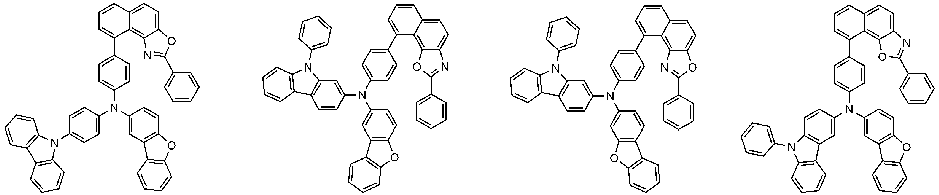

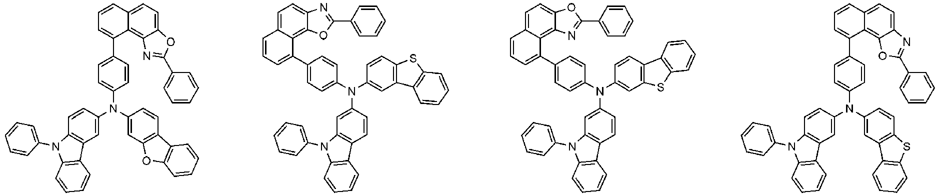

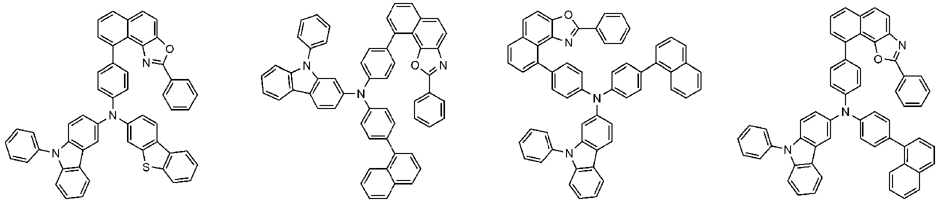

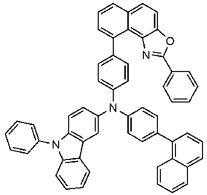

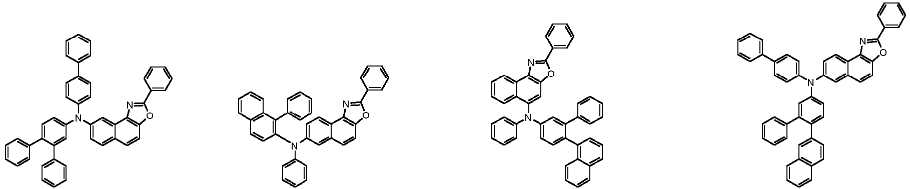

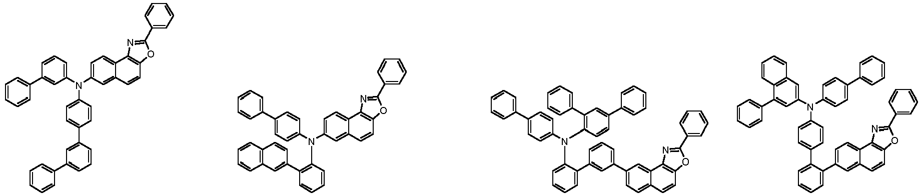

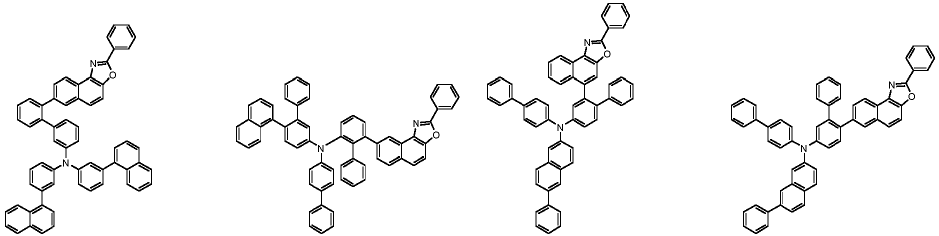

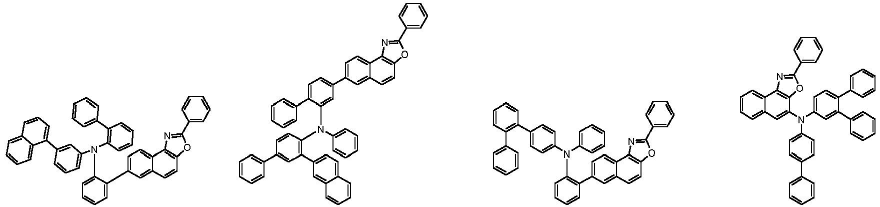

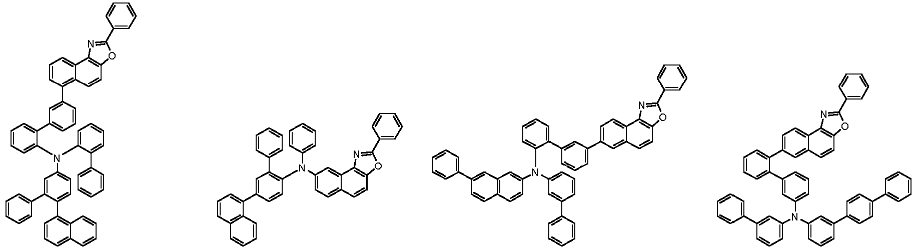

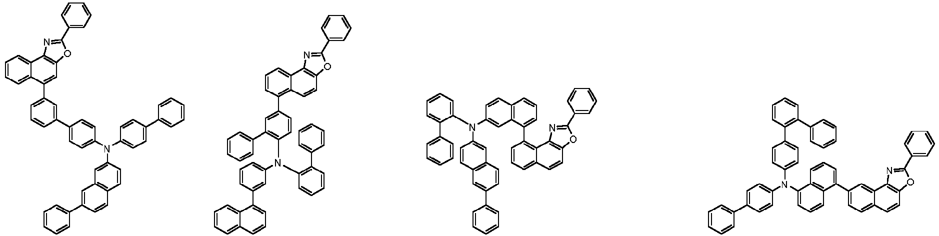

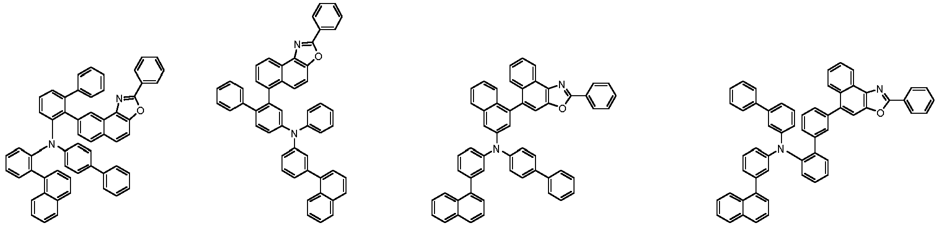

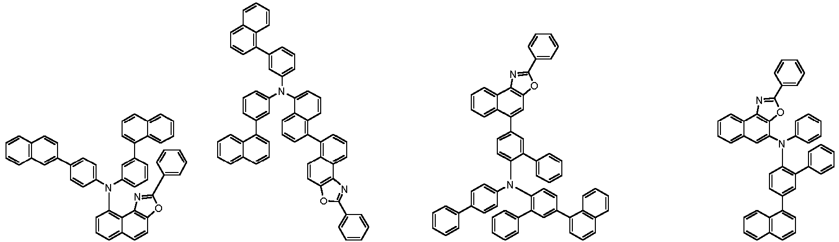

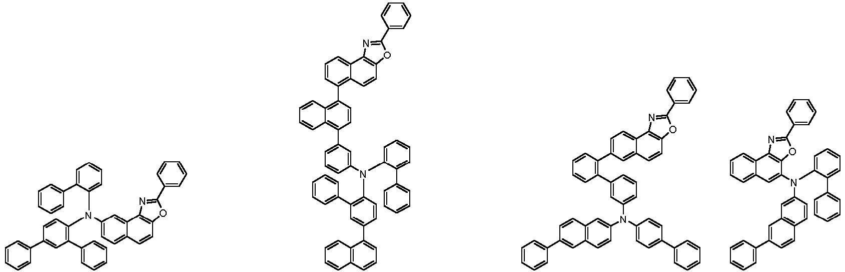

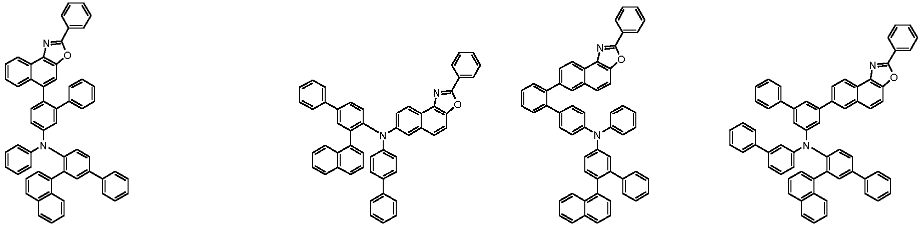

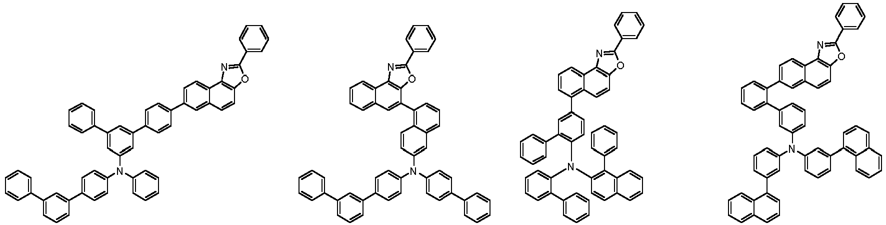

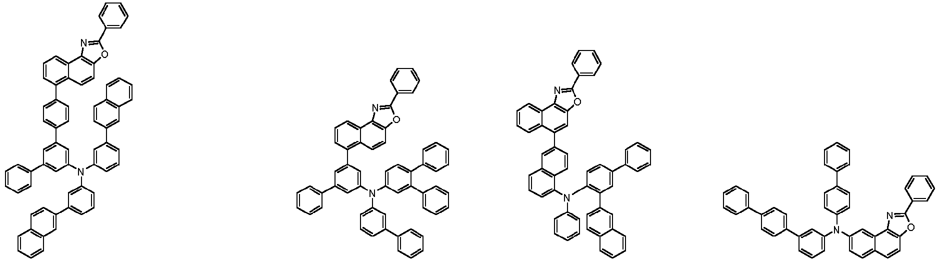

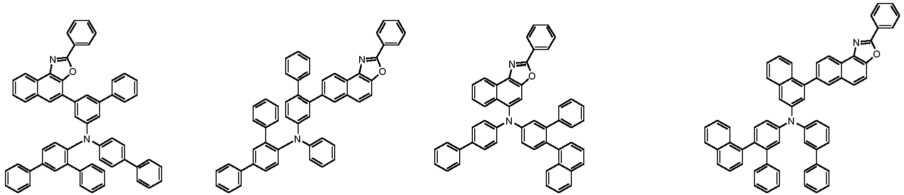

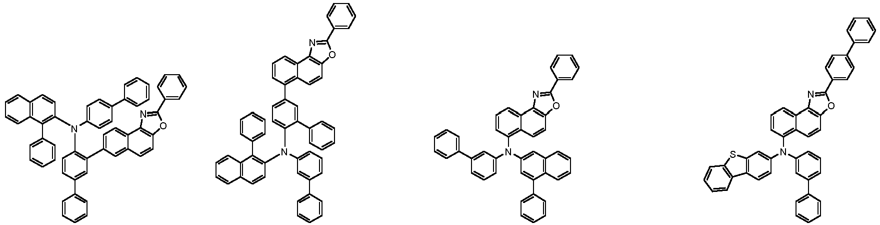

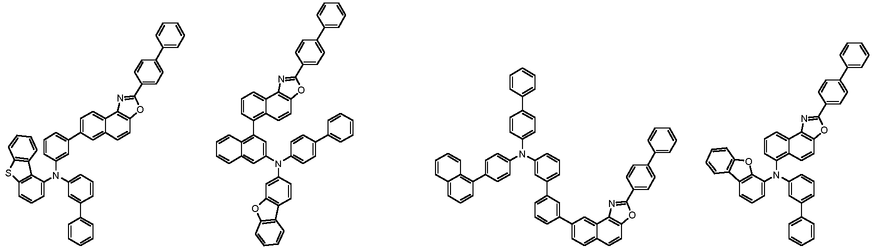

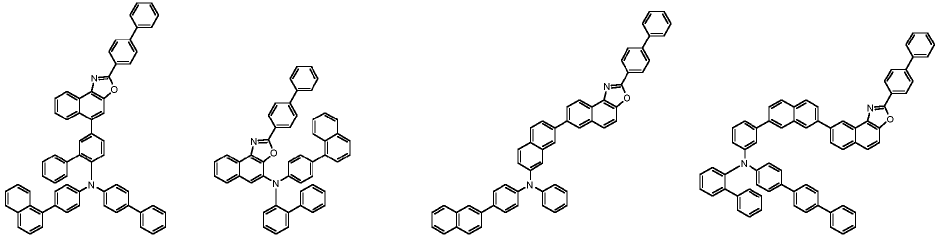

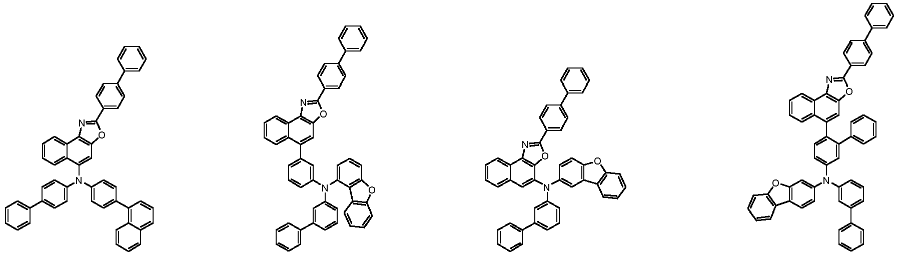

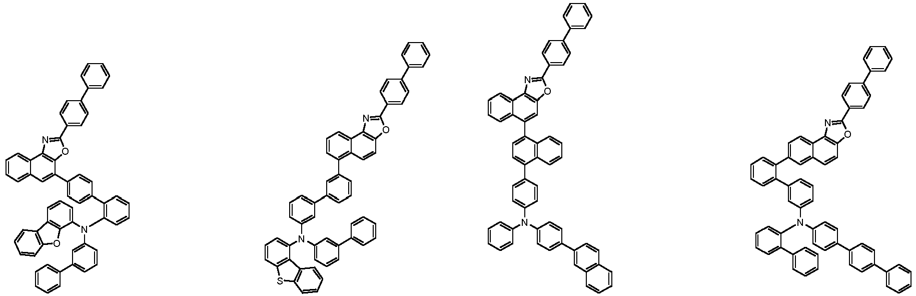

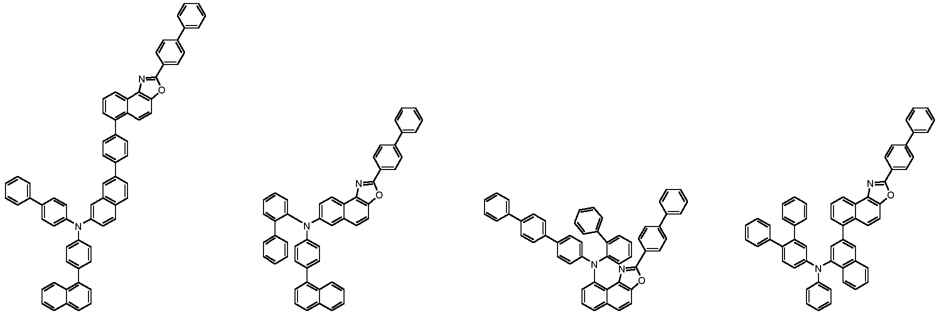

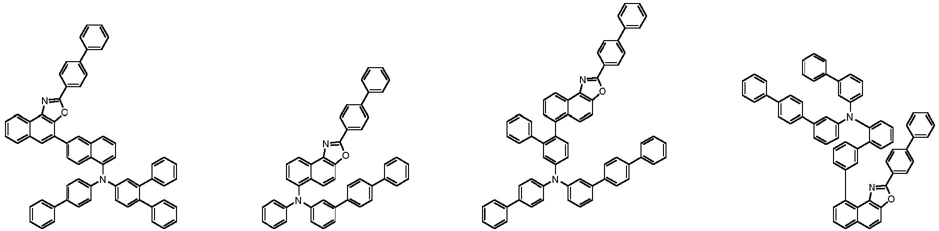

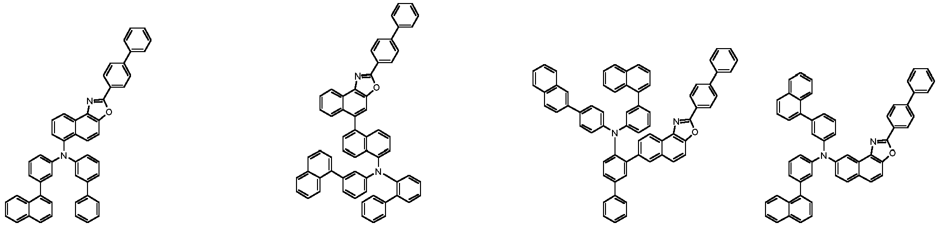

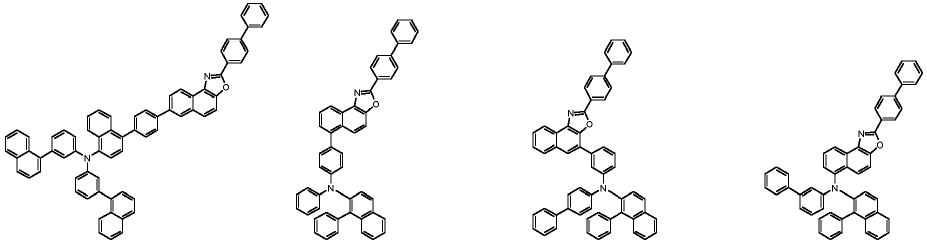

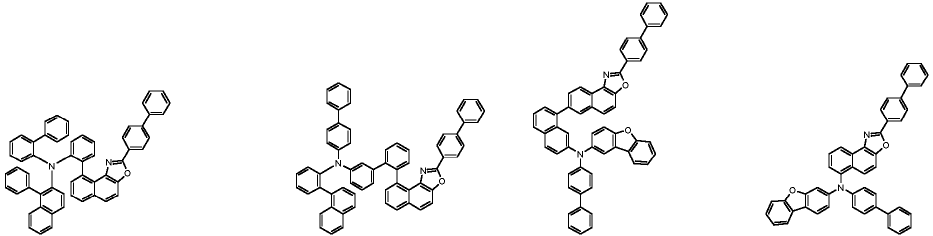

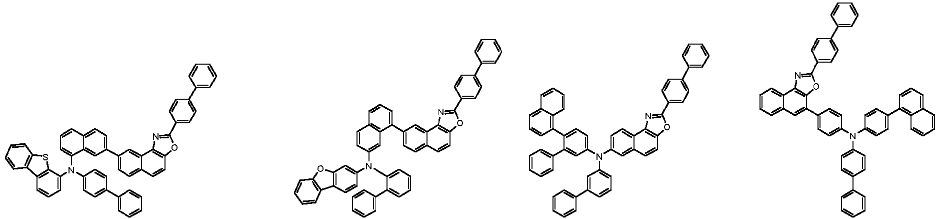

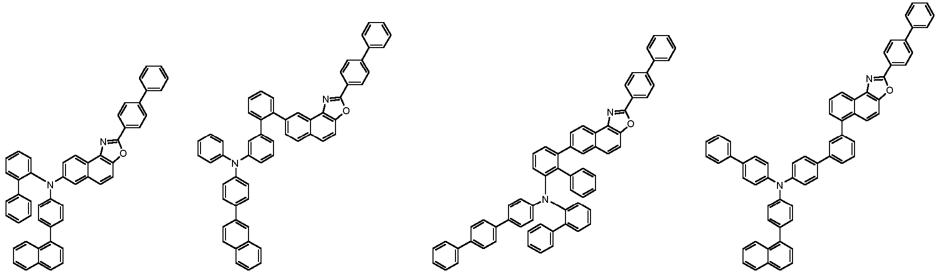

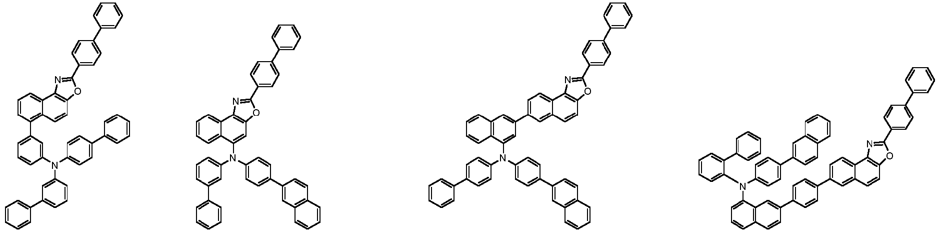

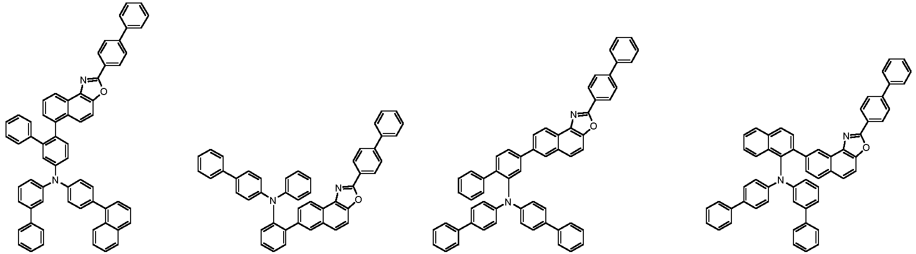

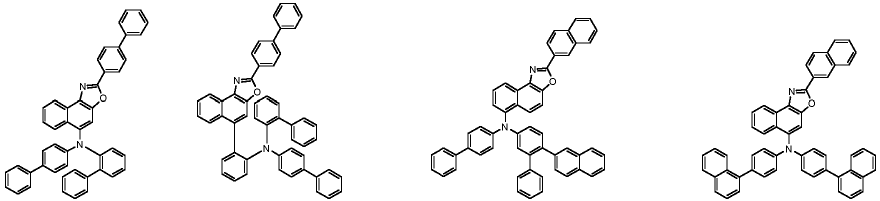

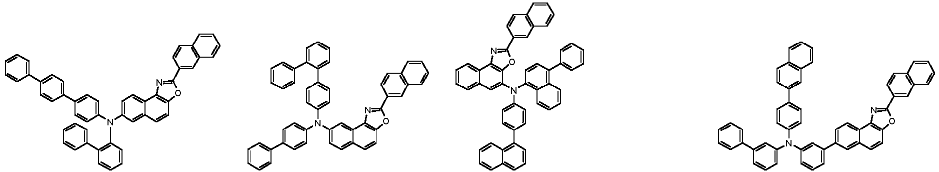

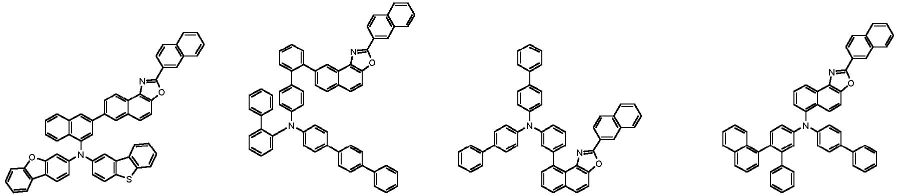

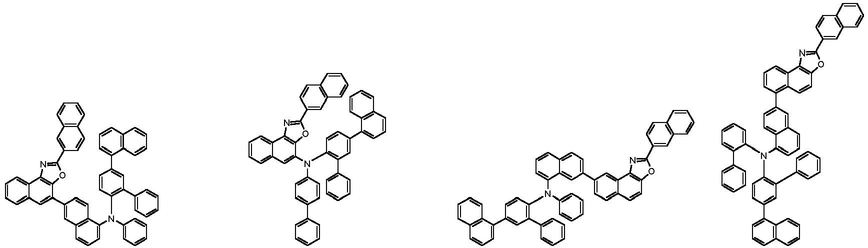

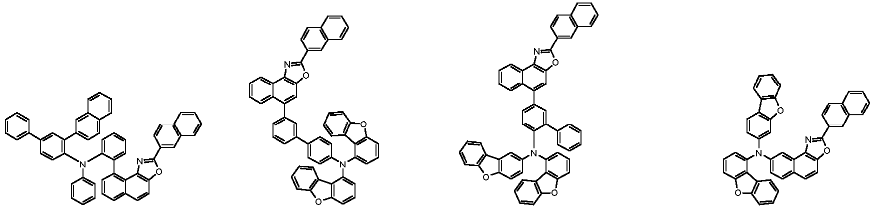

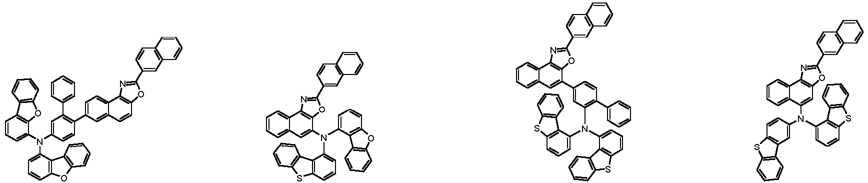

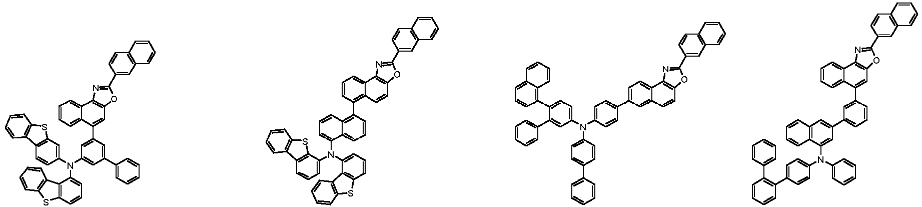

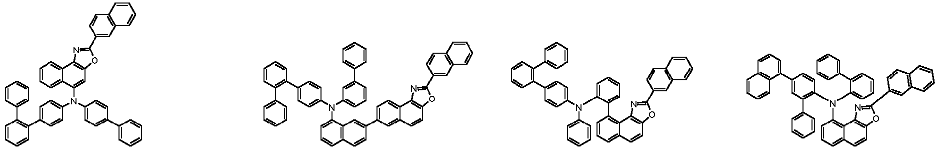

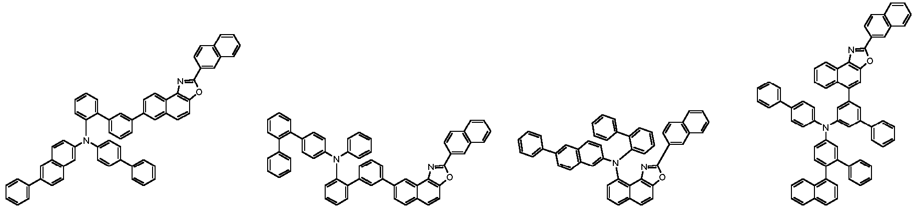

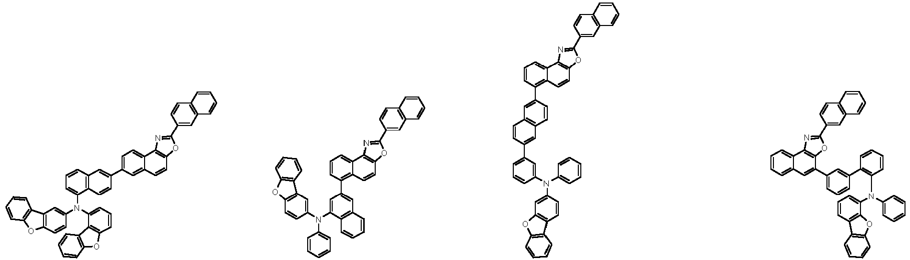

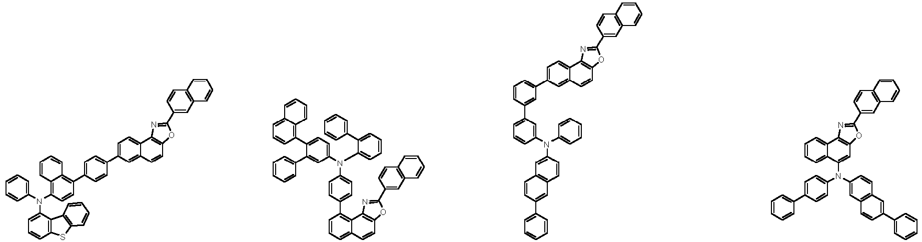

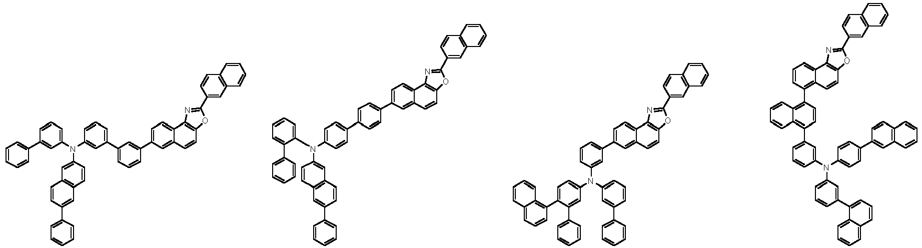

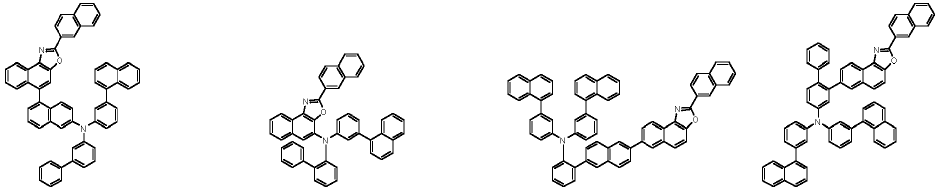

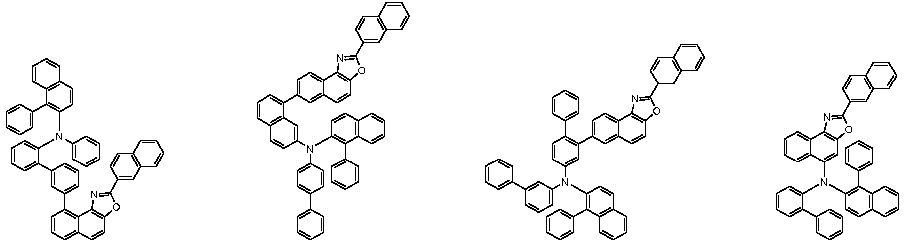

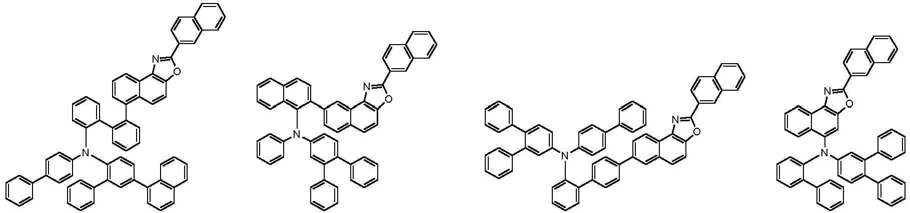

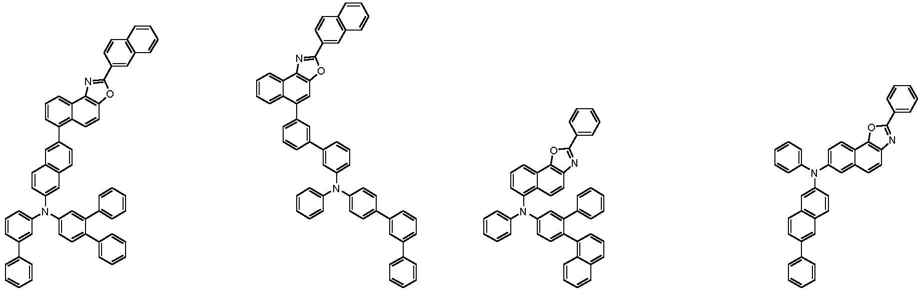

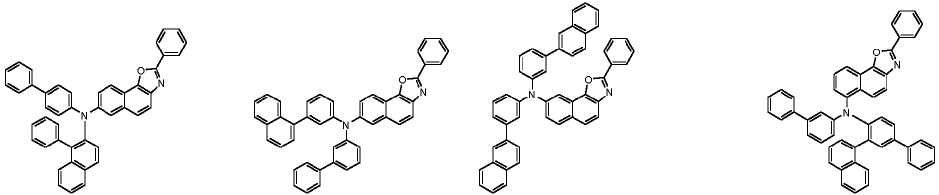

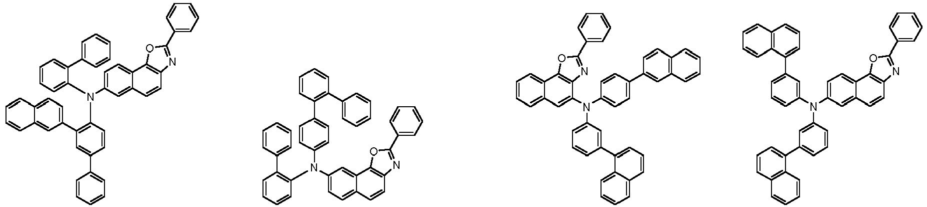

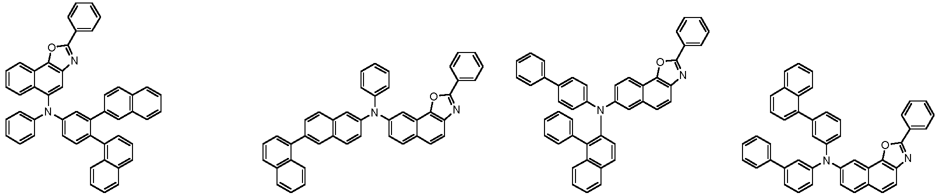

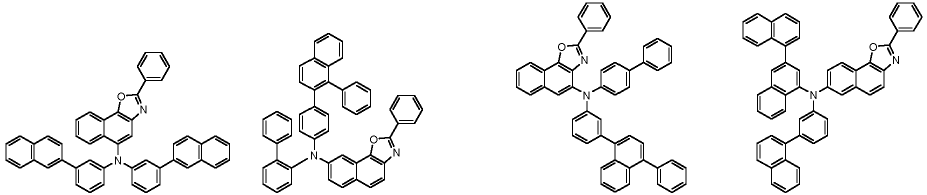

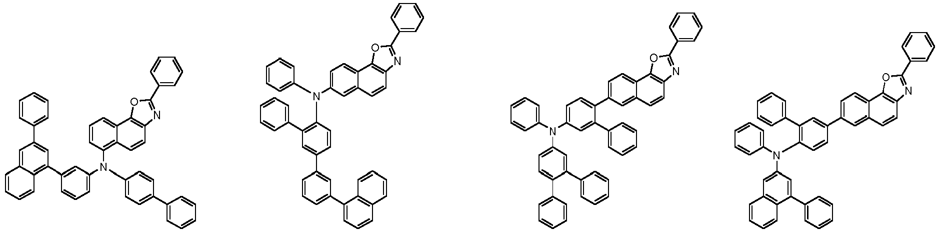

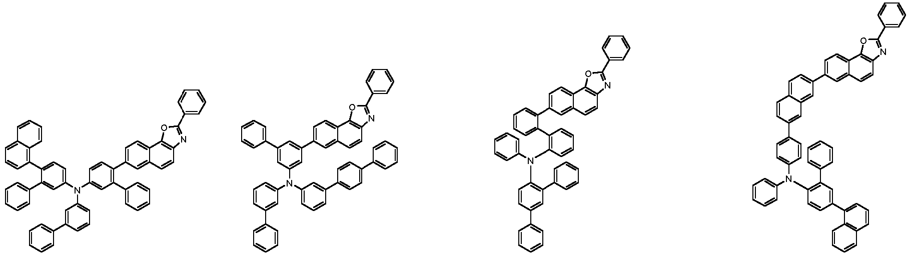

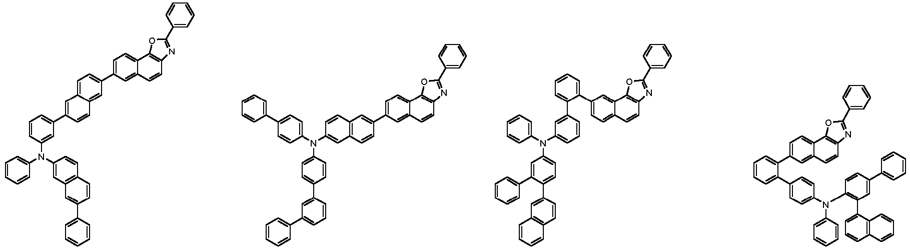

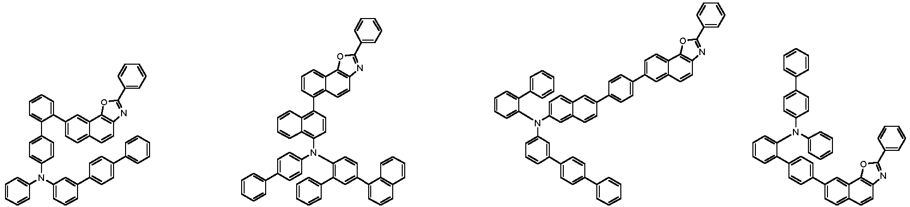

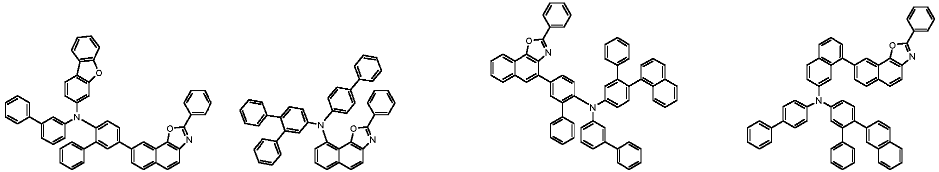

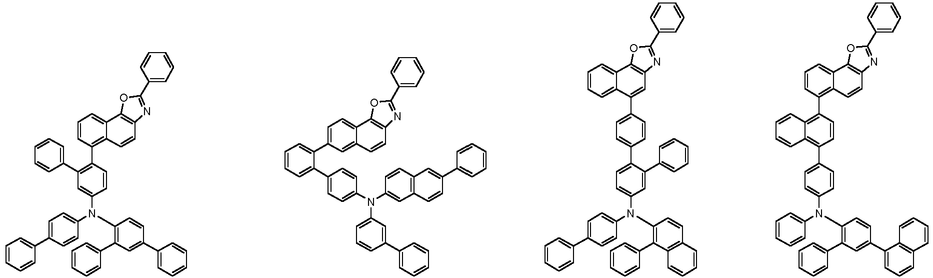

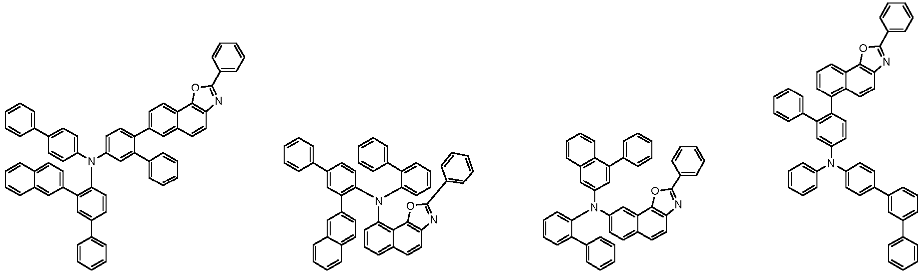

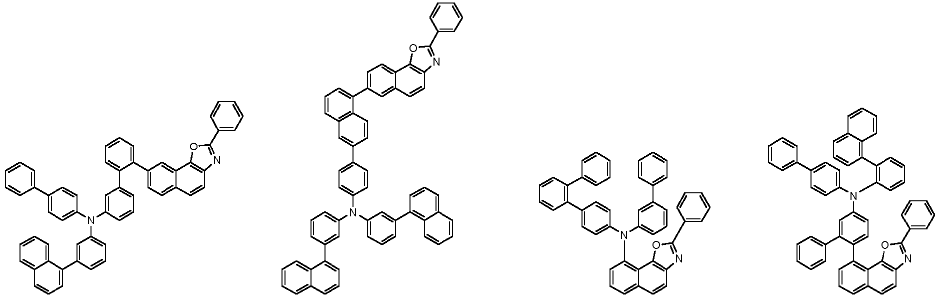

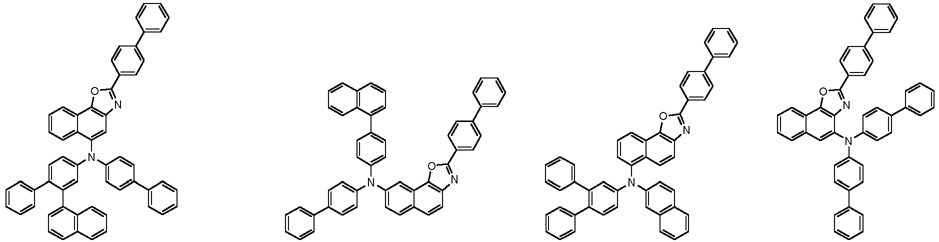

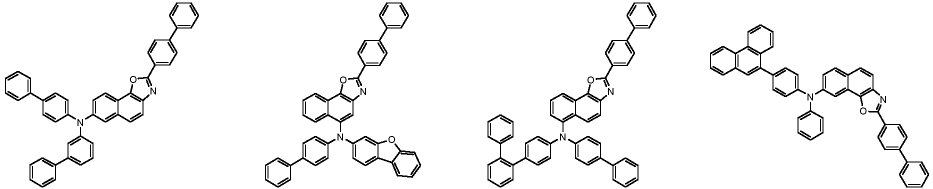

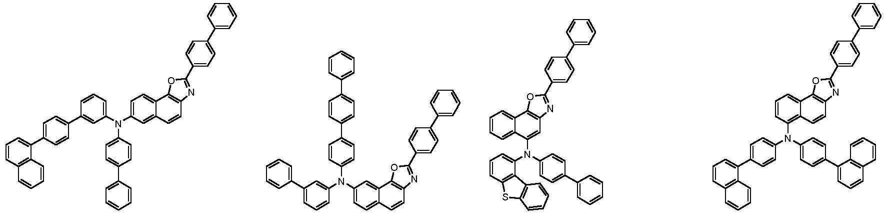

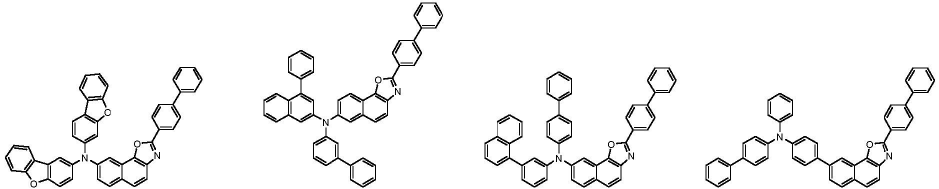

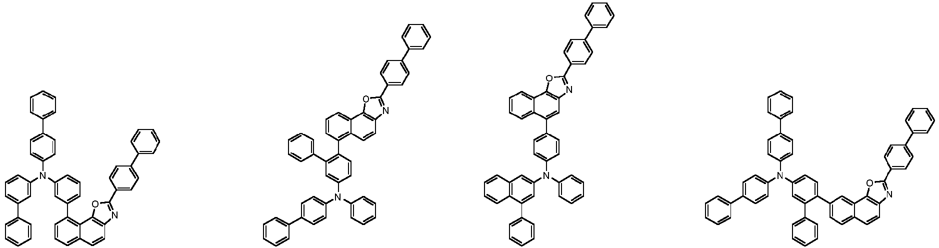

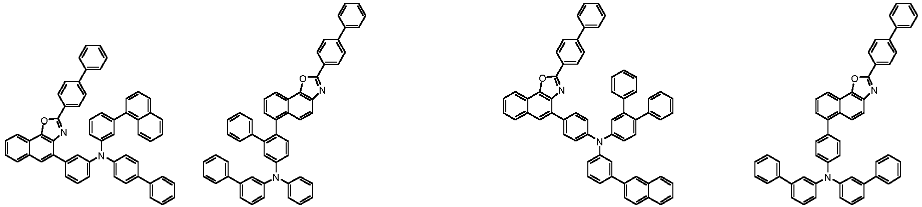

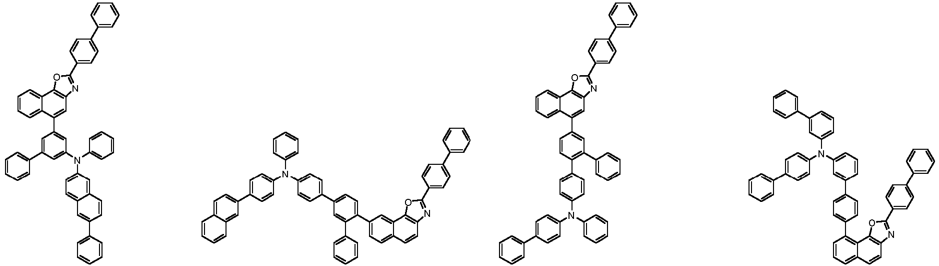

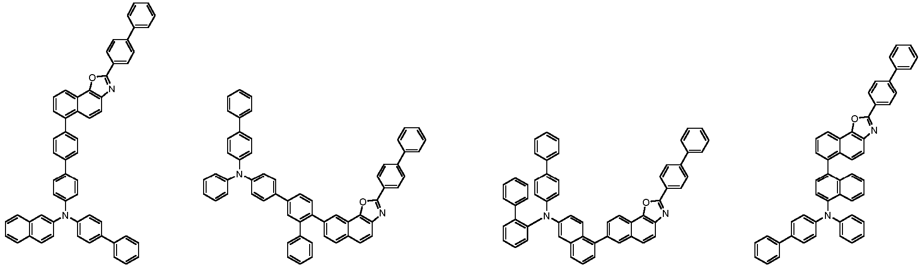

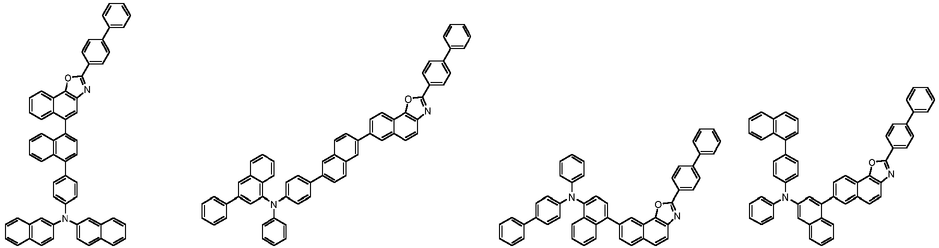

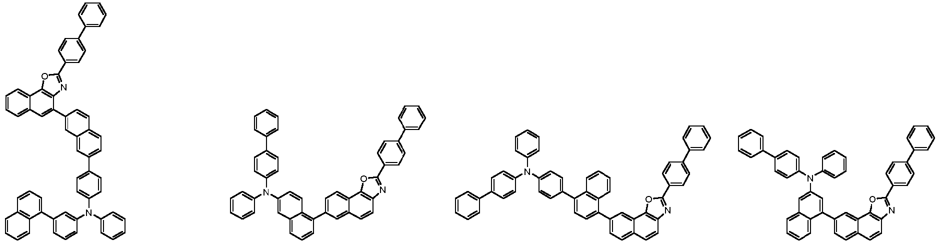

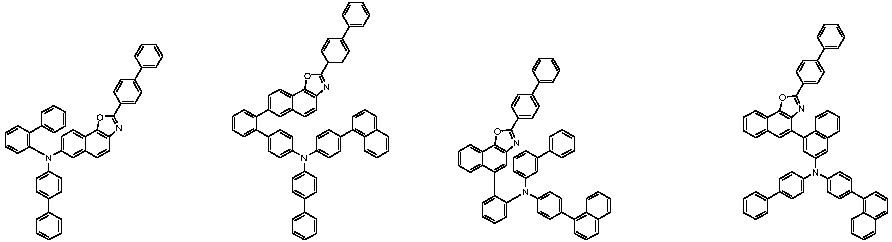

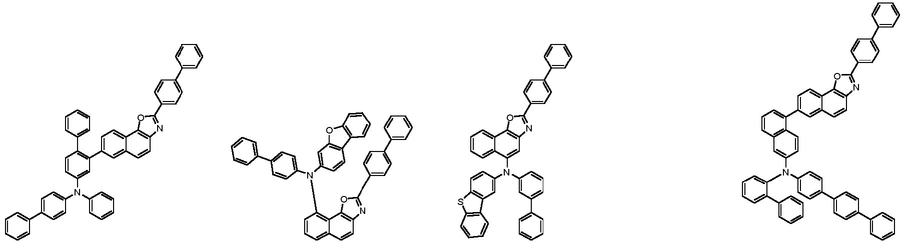

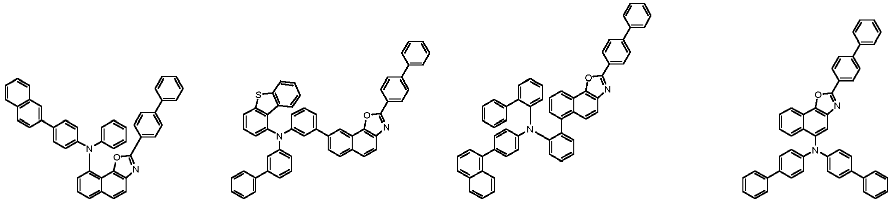

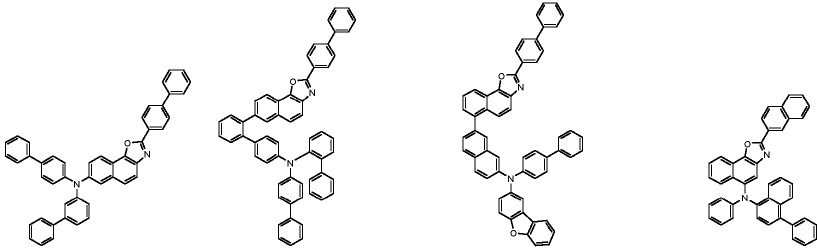

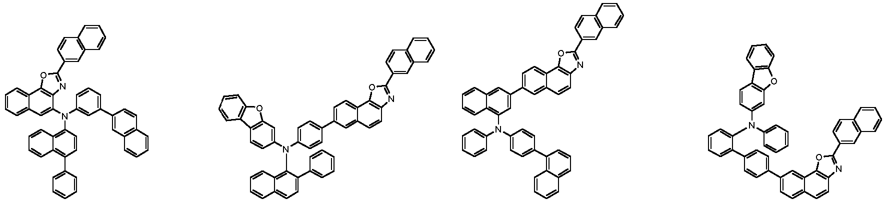

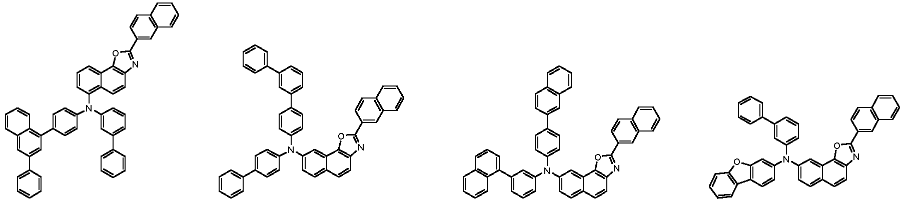

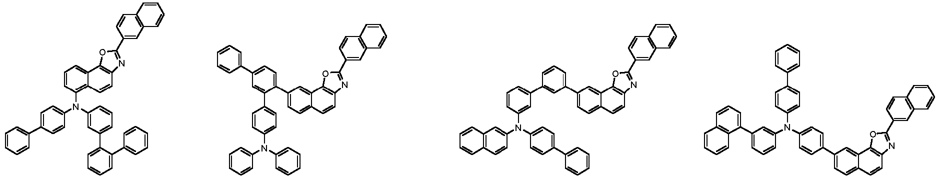

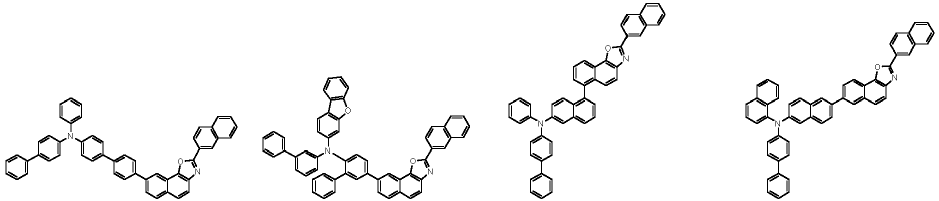

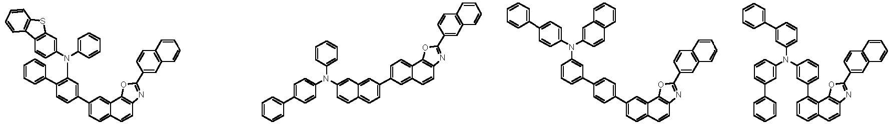

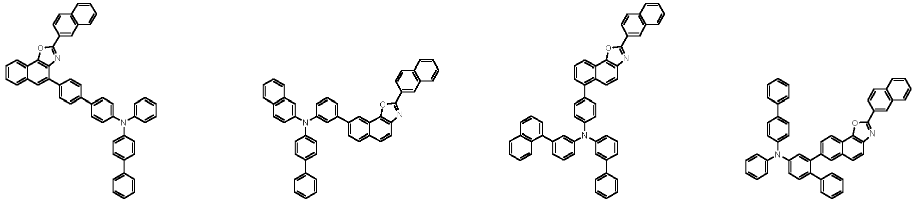

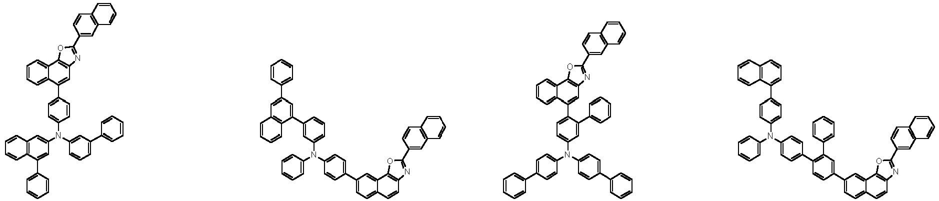

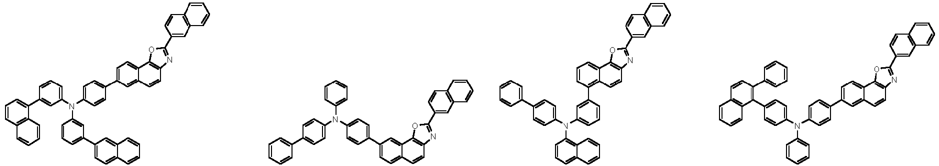

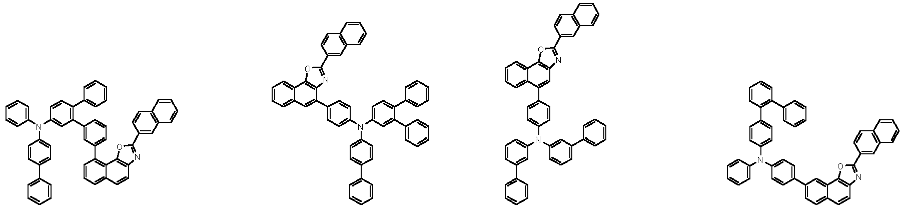

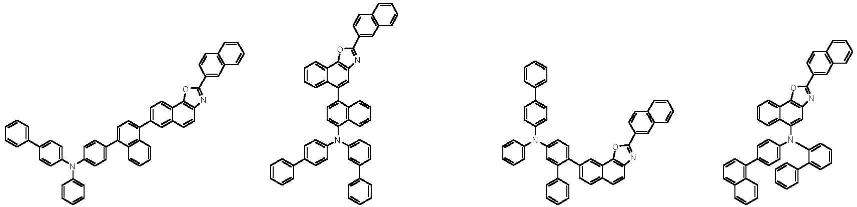

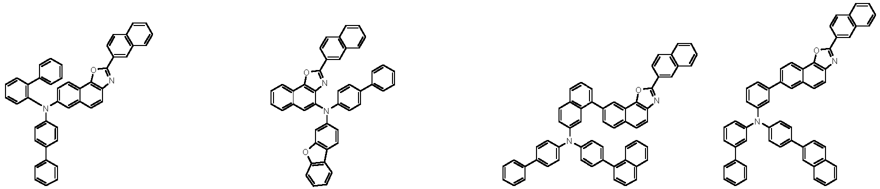

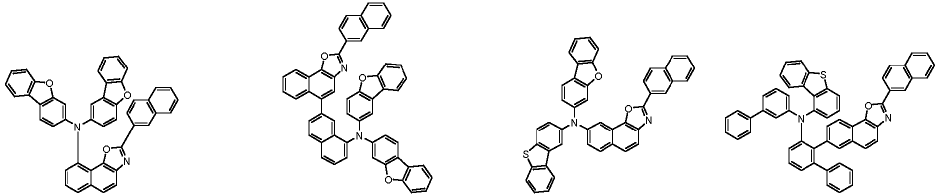

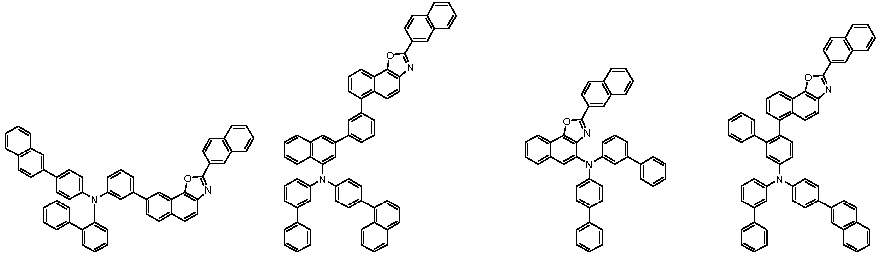

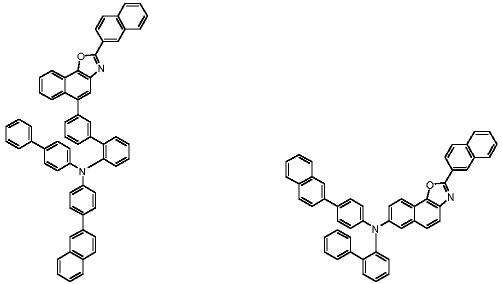

## Revendications

1. Dispositif électroluminescent organique comprenant :
une anode (2) ;
une cathode (4) ; et
une couche électroluminescente (3) interposée entre l'anode et la cathode
dans lequel la couche électroluminescente comprend (i) un composé représenté par la Formule chimique 1 suivante, et (ii) un composé représenté par la Formule chimique 2 suivante, ou la Formule chimique 3 suivante : 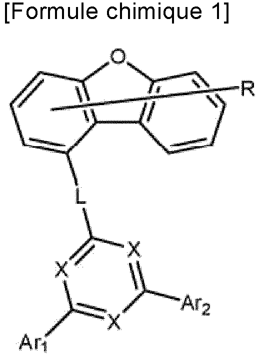
dans lequel dans la Formule chimique 1,
L est une liaison simple ; ou un arylène en C₆₋₆₀ substitué ou non substitué,
les X sont N ; ou CH, à condition qu'au moins deux X ou plus soient N,
R est de l'hydrogène, du deutérium, un aryle en C₆₋₆₀ substitué ou non substitué ; ou un hétéroaryle en C₂₋₆₀ substitué ou non substitué contenant un composé quelconque ou plusieurs composés sélectionnés parmi le groupe consistant en N, O et S,
Ar₁ et Ar₂ sont chacun indépendamment un aryle en C₆₋₆₀ substitué ou non substitué ; ou un hétéroaryle en C₂₋₆₀ substitué ou non substitué contenant un composé quelconque ou plusieurs composés sélectionnés parmi le groupe consistant en N, O et S, 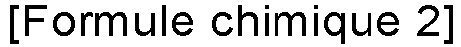 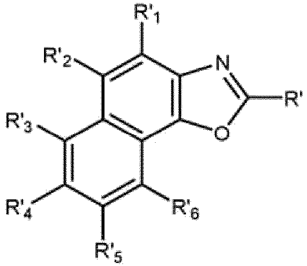 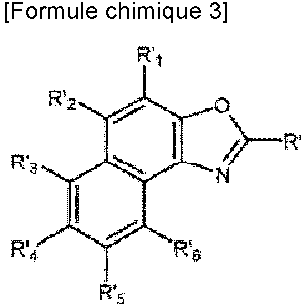
dans lequel dans les Formules chimiques 2 et 3,
R' est un substituant représenté par la Formule chimique 4 suivante, ou un aryle en C₆₋₆₀ substitué ou non substitué,
dans lequel R' est un substituant représenté par la Formule chimique 4 suivante, R'₁ à R'₆ sont chacun indépendamment de l'hydrogène ou du deutérium,
dans lequel R' n'est pas un substituant représenté par la Formule chimique 4 suivante, l'un quelconque de R'₁ à R'₆ est un substituant représenté par la Formule chimique 4 suivante, et le reste sont chacun indépendamment de l'hydrogène ou du deutérium ; 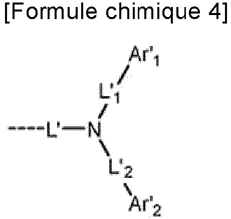
dans lequel dans la Formule chimique 4,
L' est une liaison simple, un arylène en C₆₋₆₀ substitué ou non substitué, ou un hétéroarylène en C₂₋₆₀ substitué ou non substitué contenant un composé quelconque ou plusieurs composés sélectionnés parmi le groupe consistant en N, O et S,
L'₄ et L'₂ sont chacun indépendamment une liaison simple, un arylène en C₆₋₆₀ substitué ou non substitué ; ou un hétéroarylène en C₂₋₆₀ substitué ou non substitué contenant un composé quelconque ou plusieurs composés sélectionnés parmi le groupe consistant en N, O et S, et
Ar'₁ et Ar'₂ sont chacun indépendamment un aryle en C₆₋₆₀ substitué ou non substitué, ou un hétéroaryle en C₂₋₆₀ substitué ou non substitué contenant un composé quelconque ou plusieurs composés sélectionnés parmi le groupe consistant en N, O et S.

2. Dispositif électroluminescent organique selon la revendication 1, dans lequel :
L est une liaison simple ; un phénylène ; un biphényldiyle ; ou un naphtylène.

3. Dispositif électroluminescent organique selon la revendication 1, dans lequel :
tous les X sont N.

4. Dispositif électroluminescent organique selon la revendication 1, dans lequel :
R est de l'hydrogène, du deutérium, un phényle, un biphénylyle, un terphénylyle, un naphtyle, un phénylnaphtyle, un naphtylphényle, un phénanthrényle, un triphénylényle, un fluoranthényle, un dibenzofuranyle, un benzonaphtofuranyle, un dibenzothiophényle, ou un benzonaphtothiophényle.

5. Dispositif électroluminescent organique selon la revendication 1, dans lequel :
Ar₁ et Ar₂ sont chacun indépendamment un phényle, un biphénylyle, un terphénylyle, un naphthyle, un naphthylphényle, un phénylnaphthyle, un phénanthrényle, un dibenzofuranyle, ou un dibenzothiophényle.

6. Dispositif électroluminescent organique selon la revendication 1, dans lequel :
le composé représenté par la Formule chimique 1 est un composé quelconque sélectionné parmi le groupe consistant en :

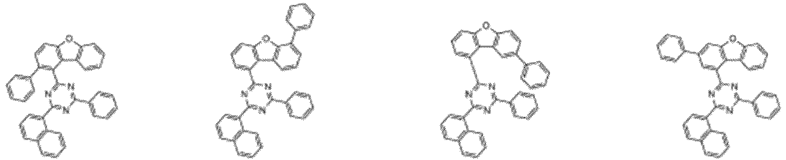

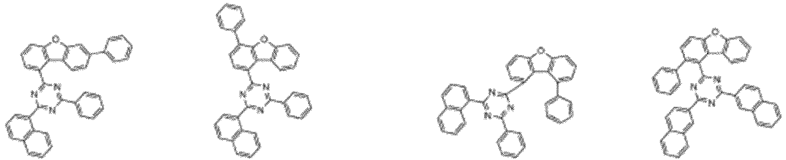

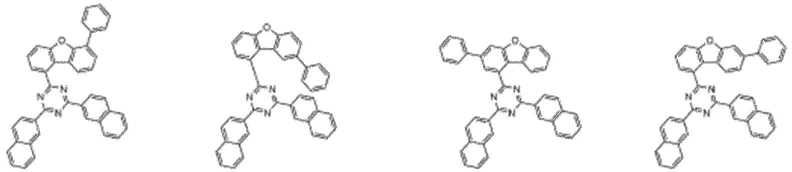

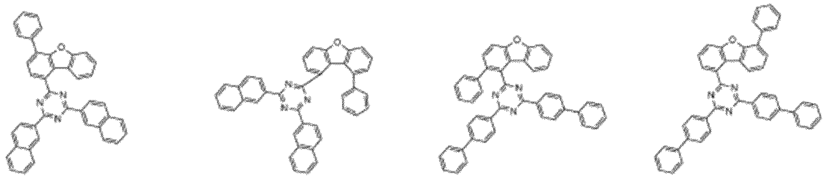

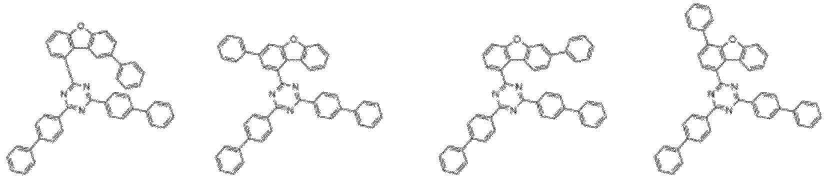

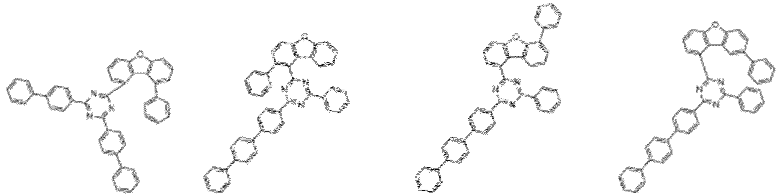

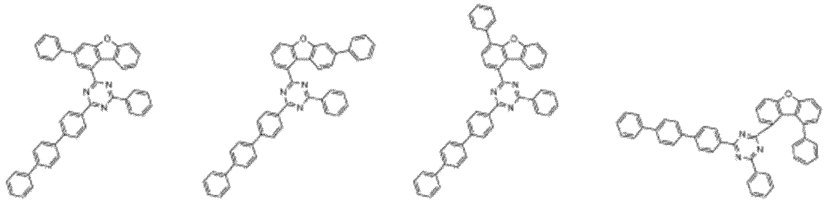

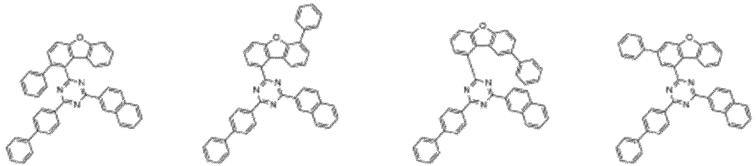

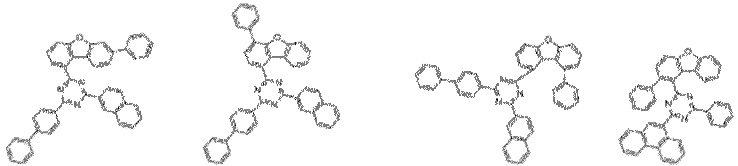

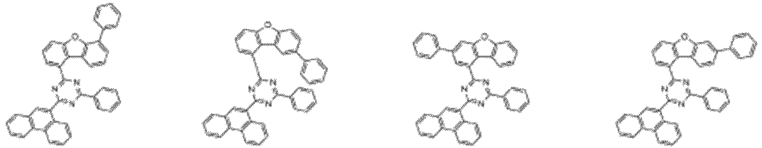

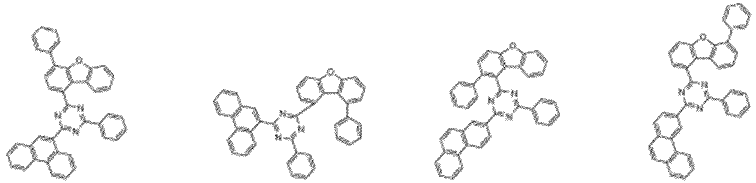

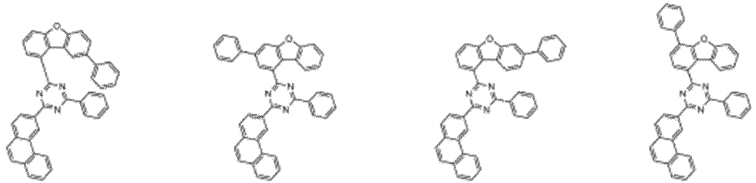

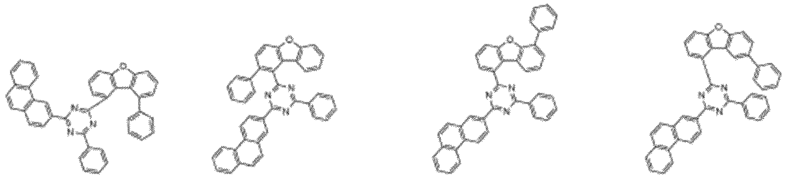

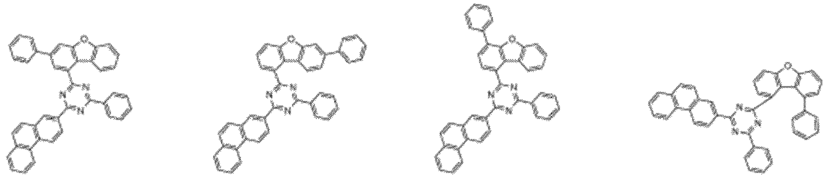

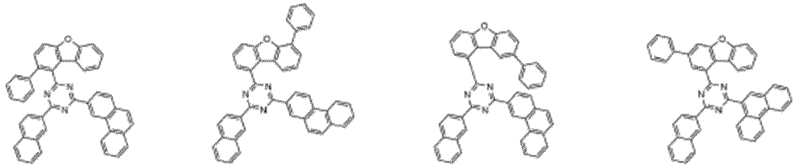

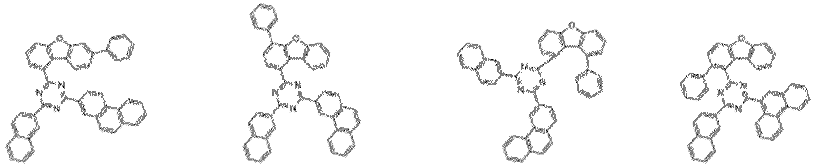

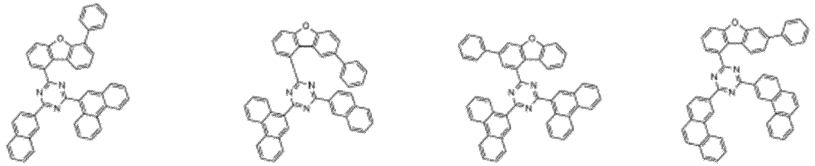

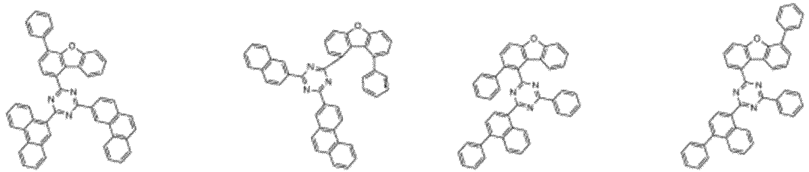

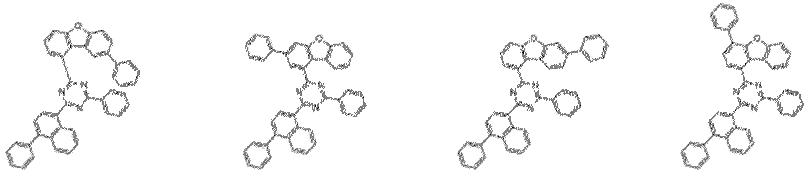

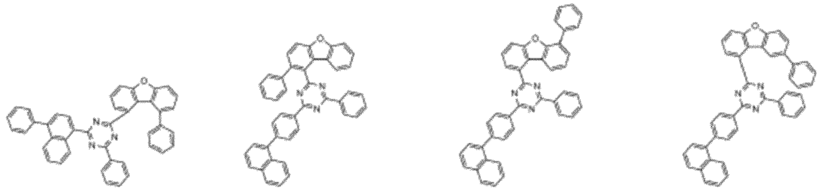

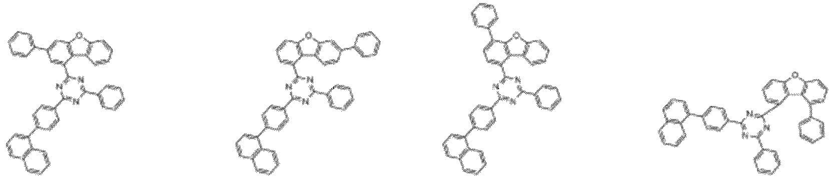

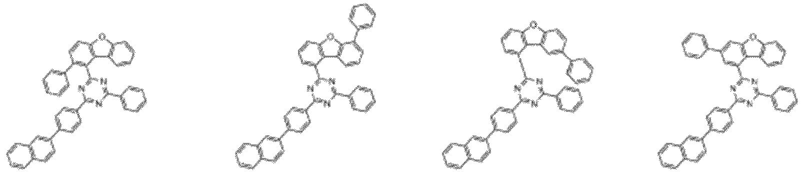

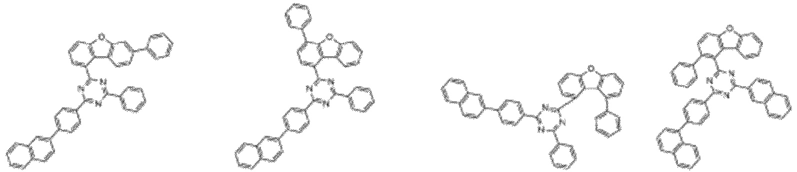

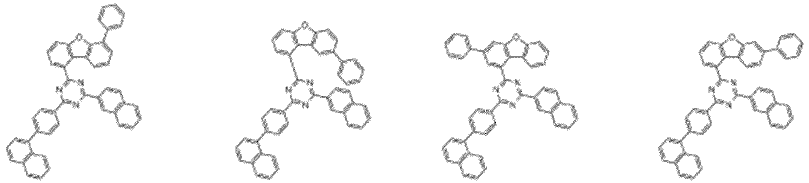

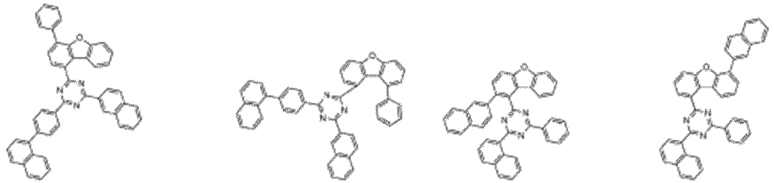

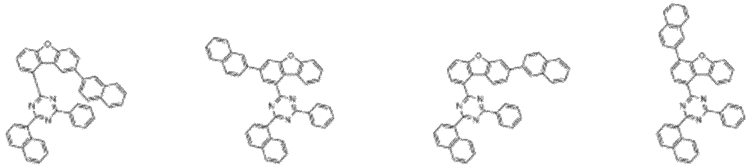

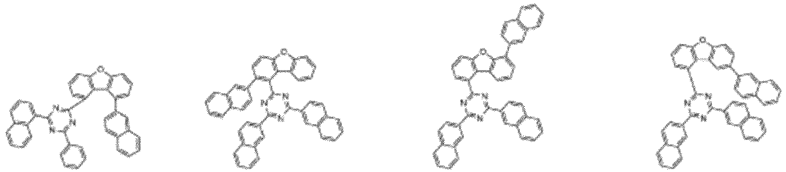

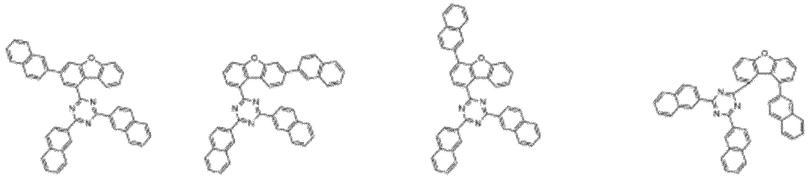

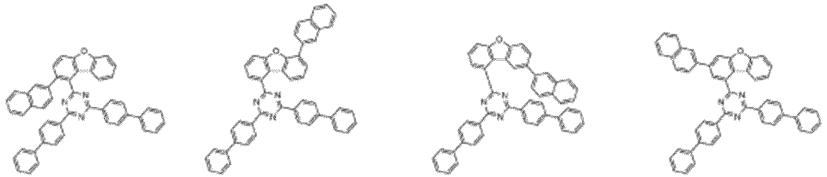

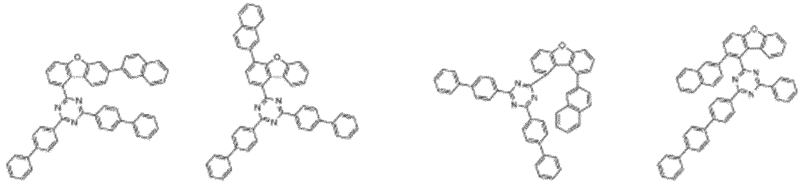

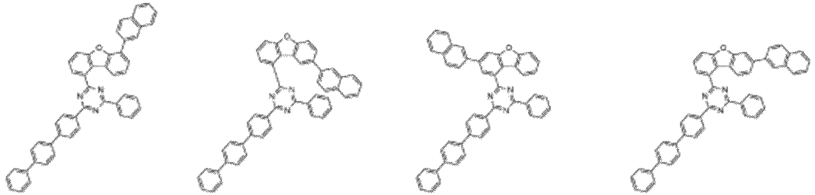

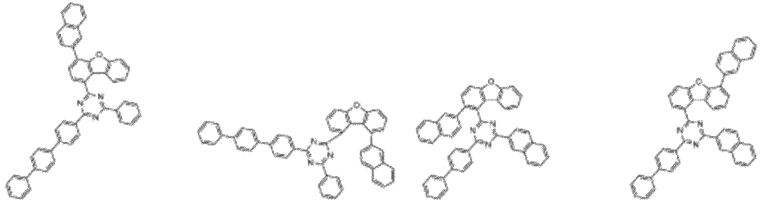

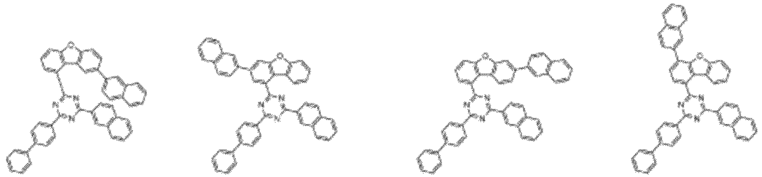

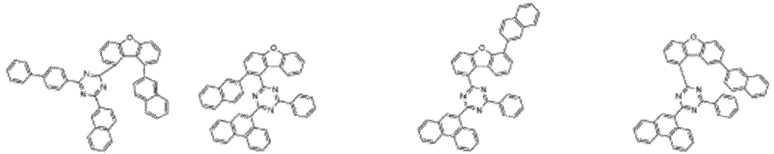

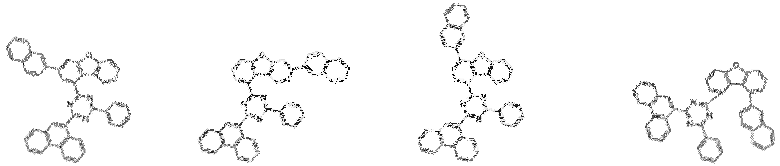

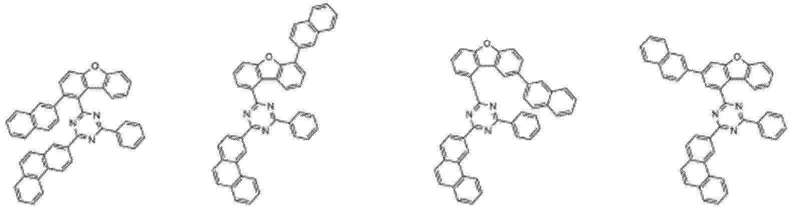

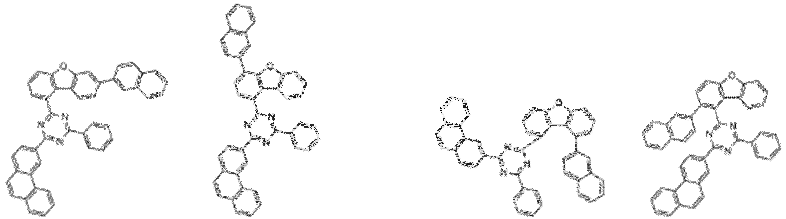

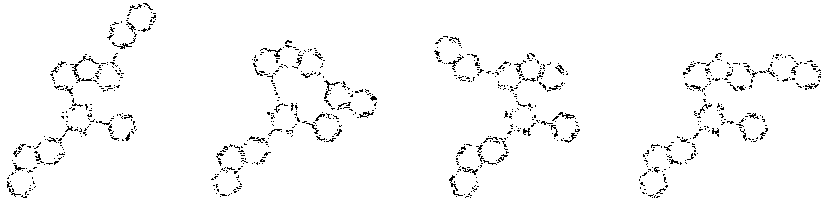

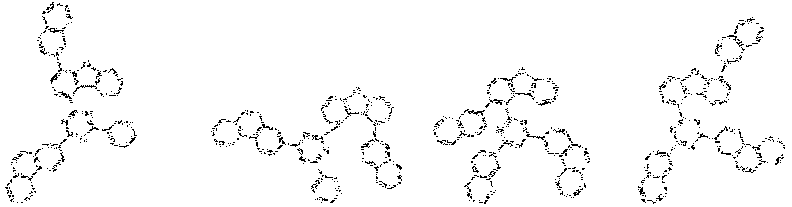

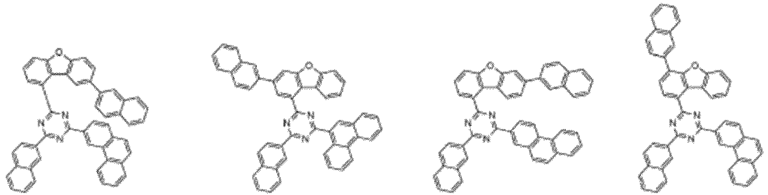

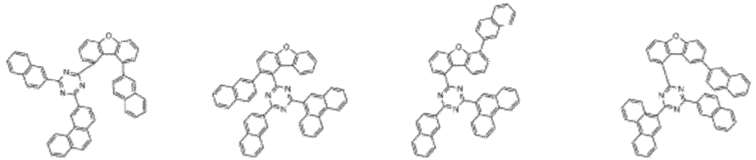

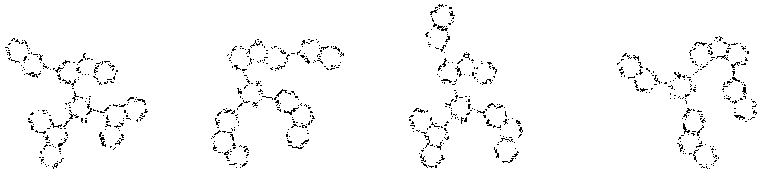

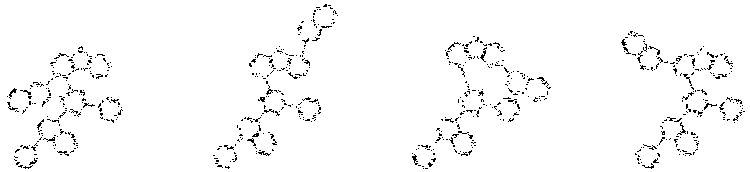

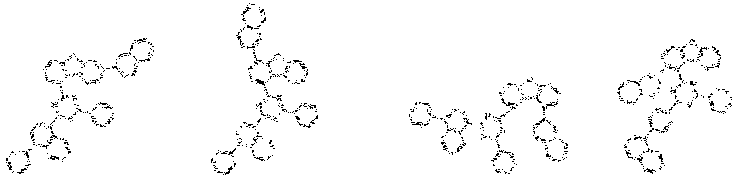

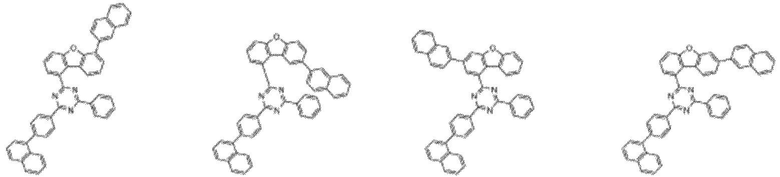

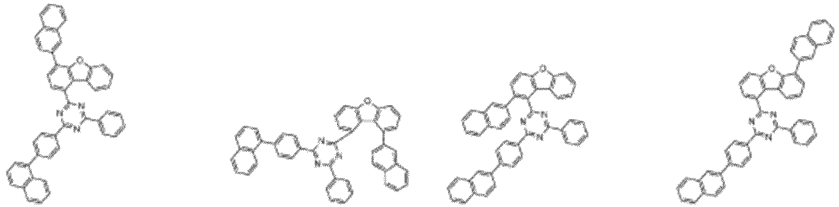

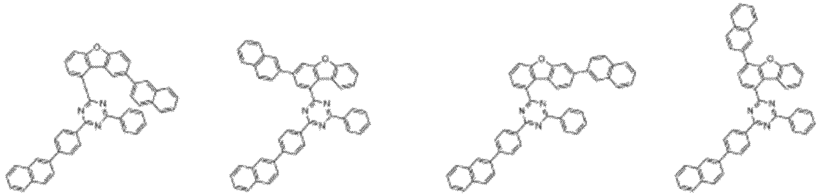

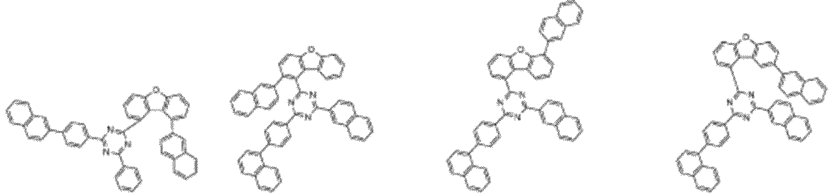

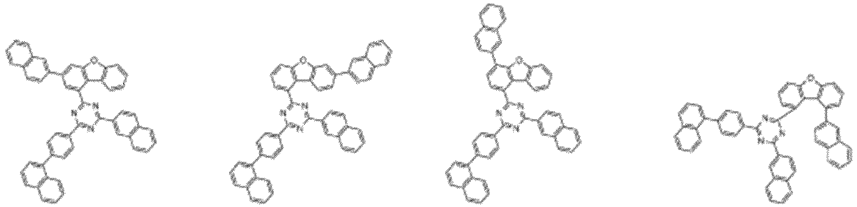

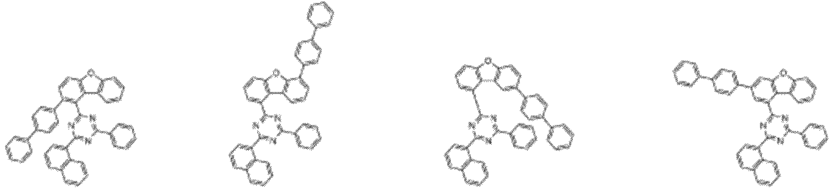

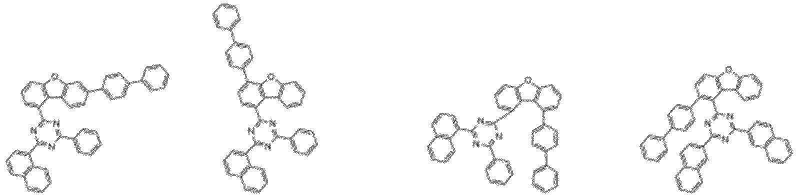

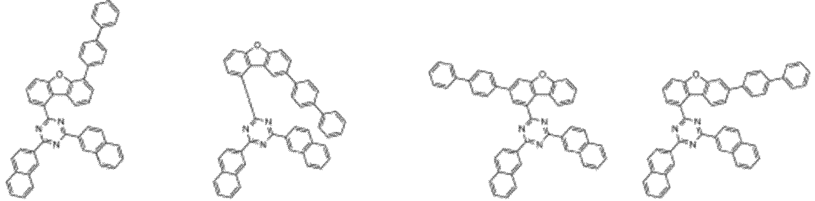

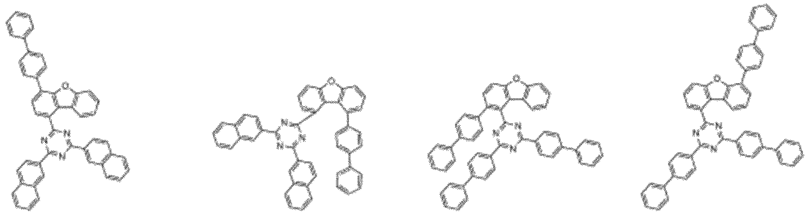

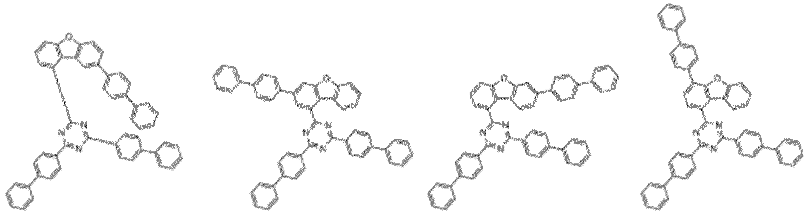

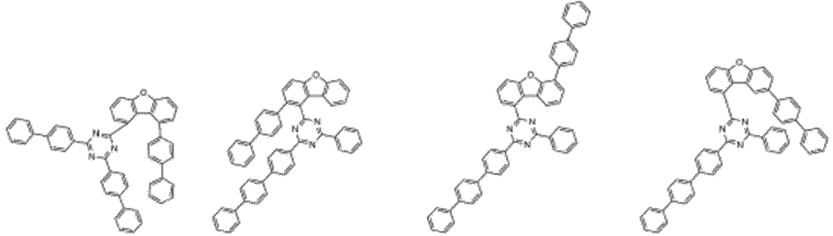

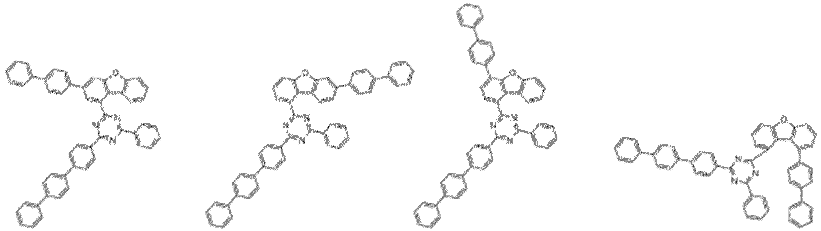

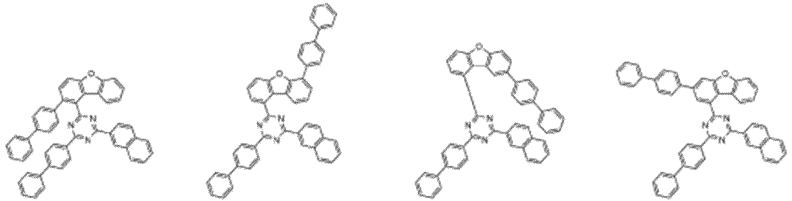

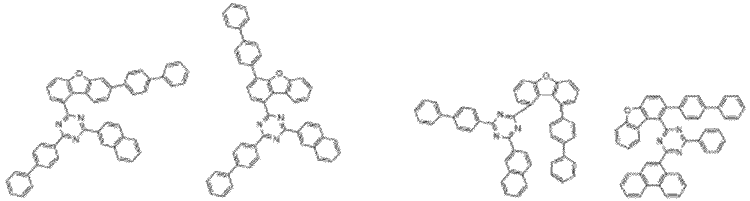

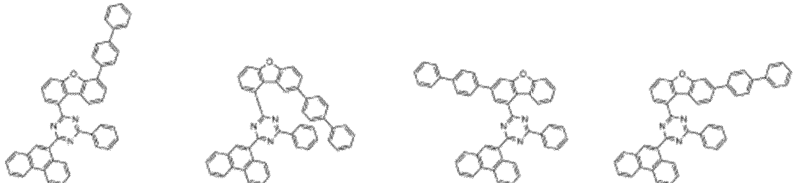

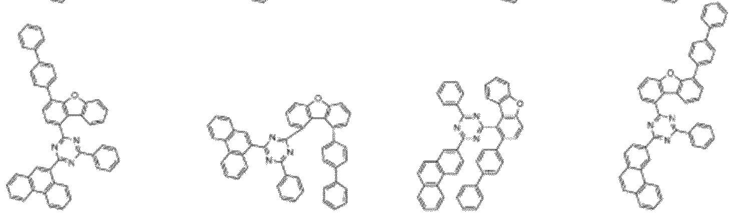

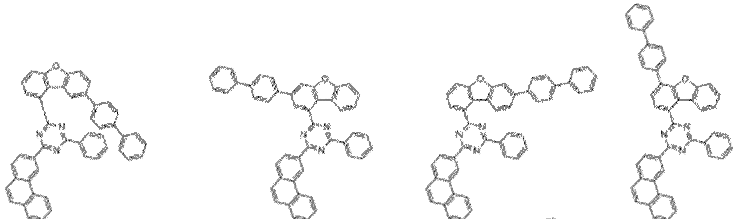

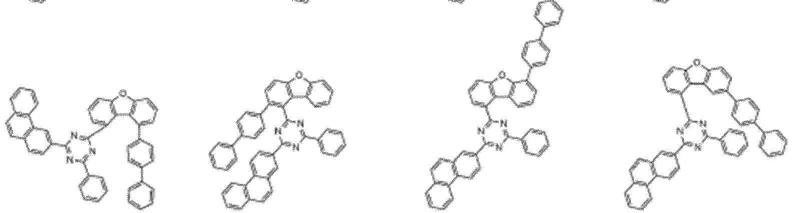

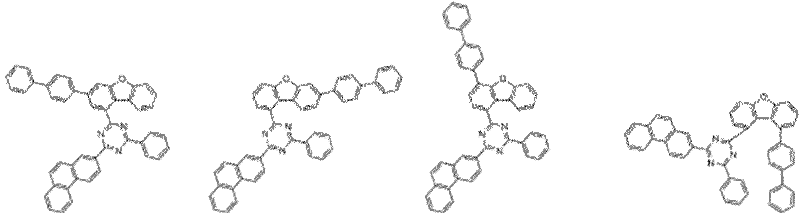

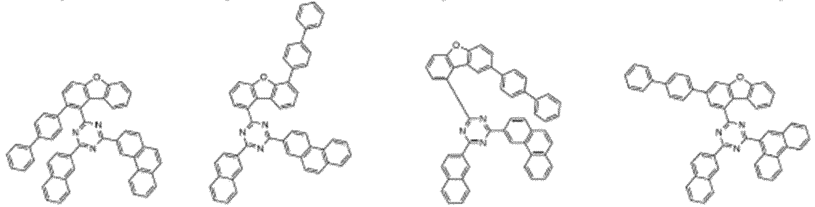

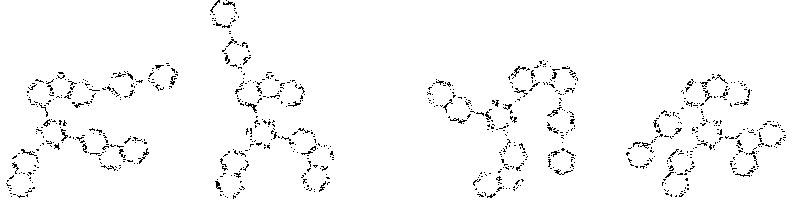

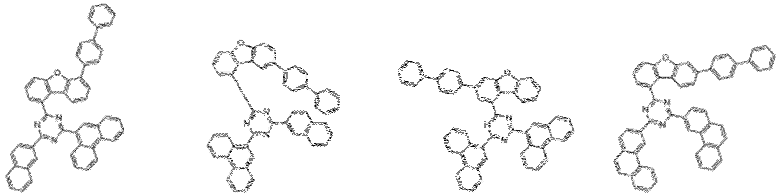

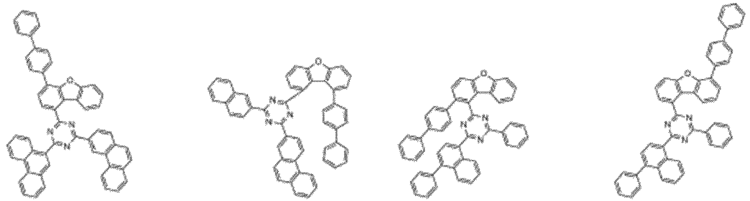

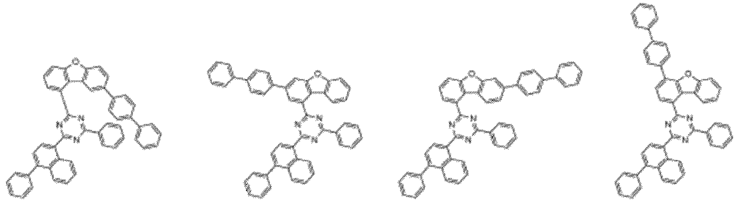

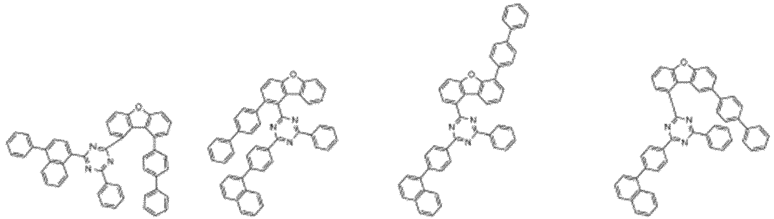

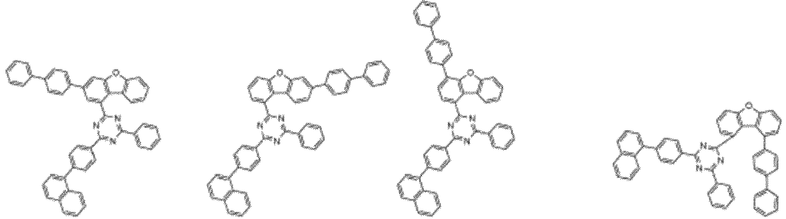

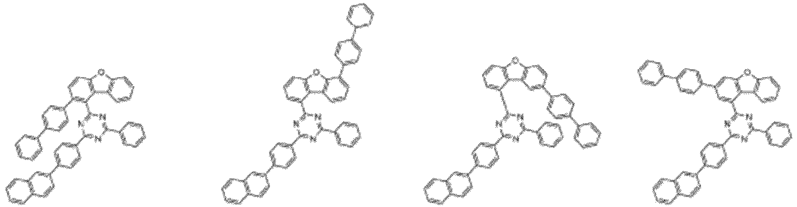

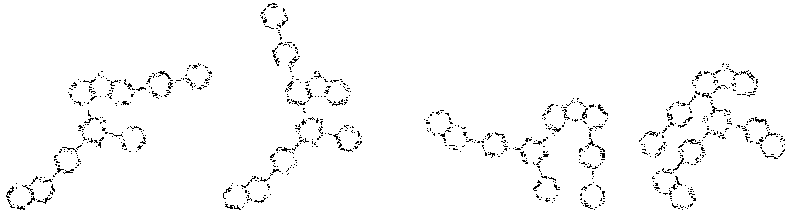

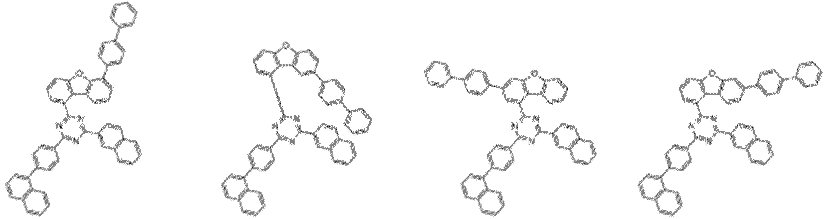

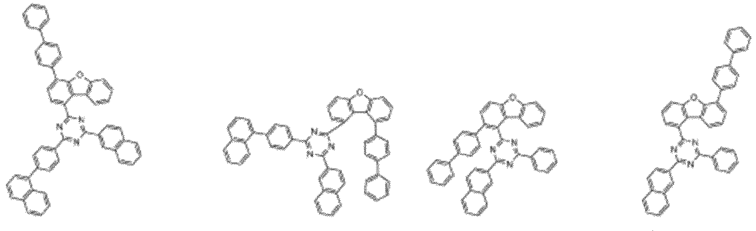

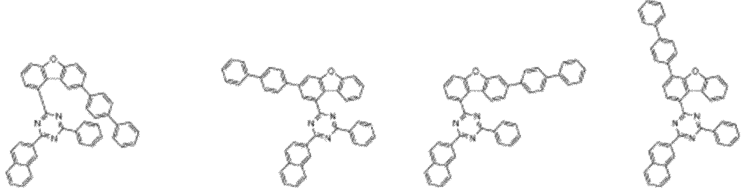

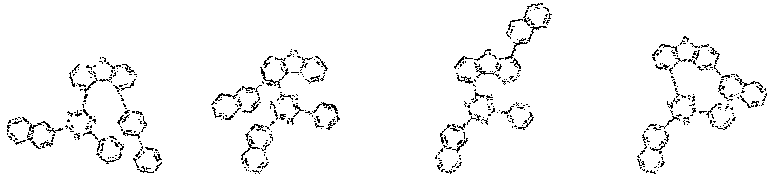

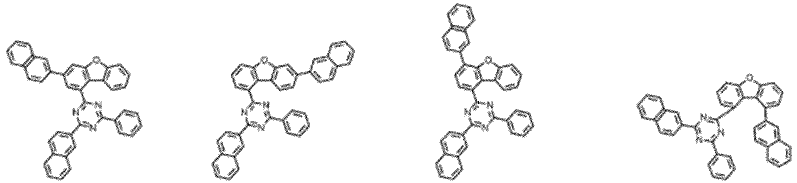

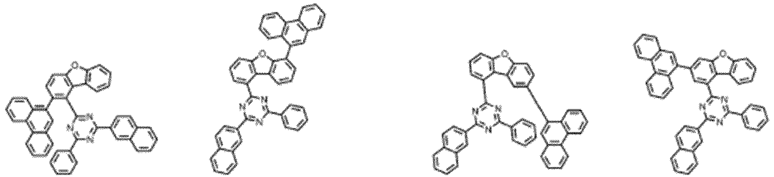

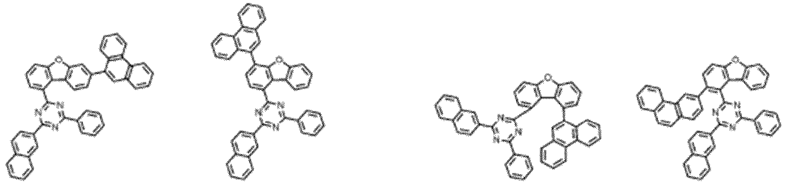

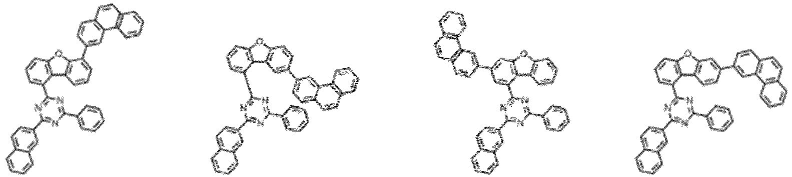

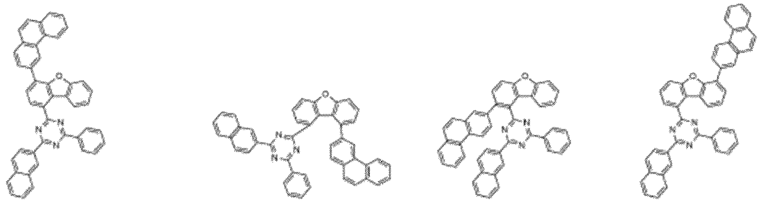

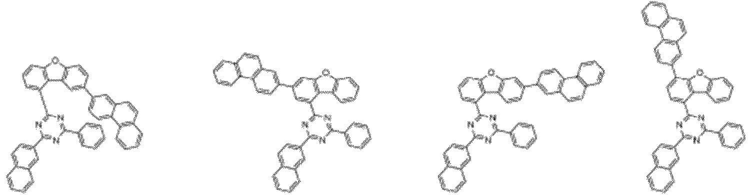

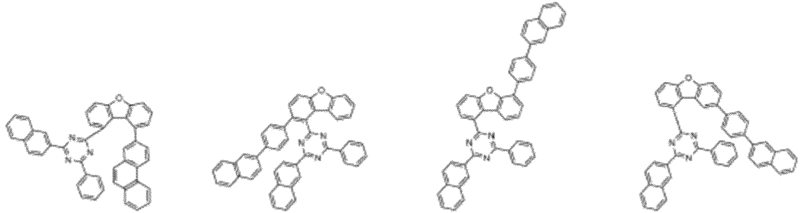

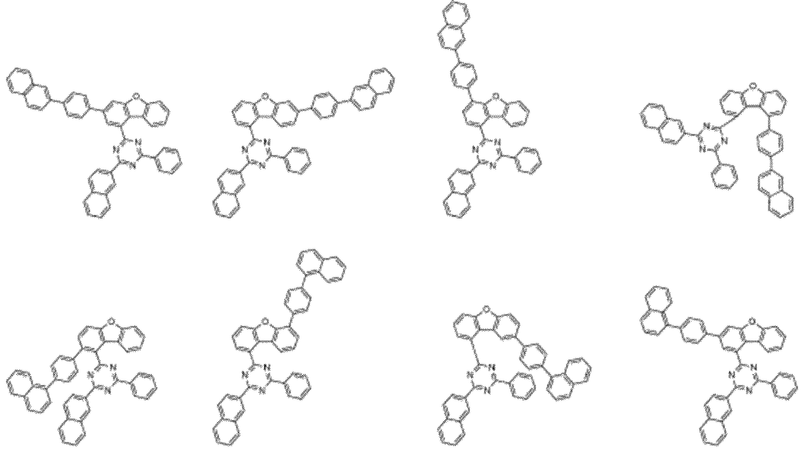

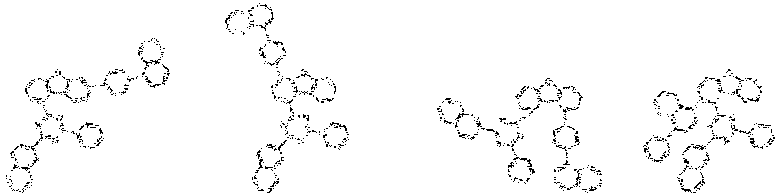

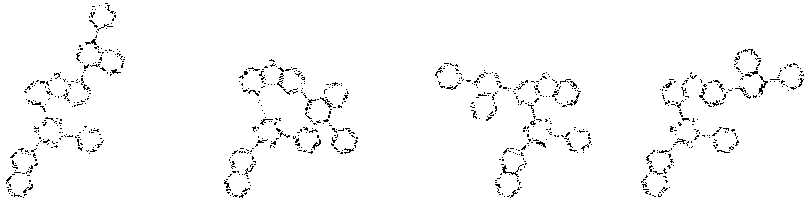

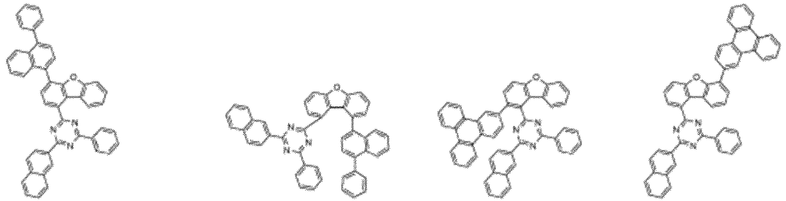

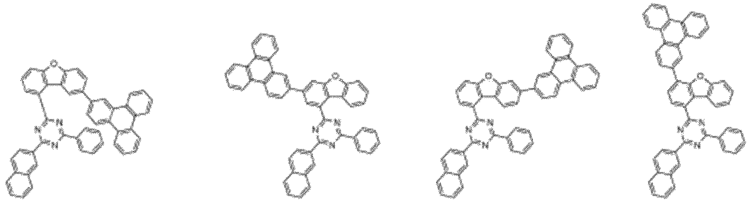

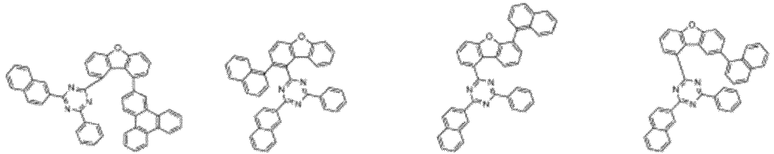

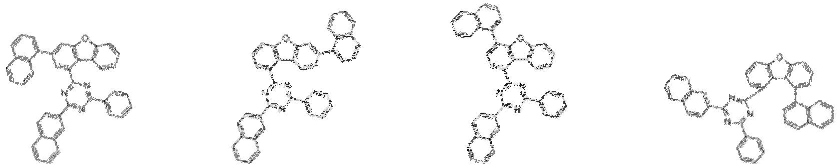

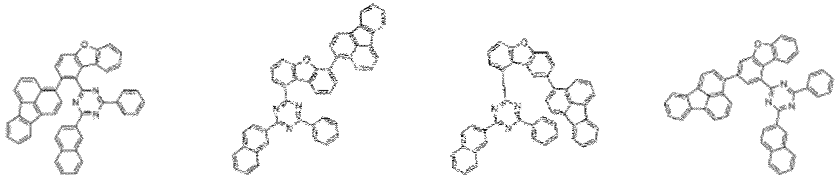

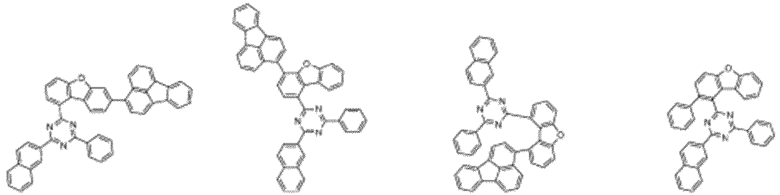

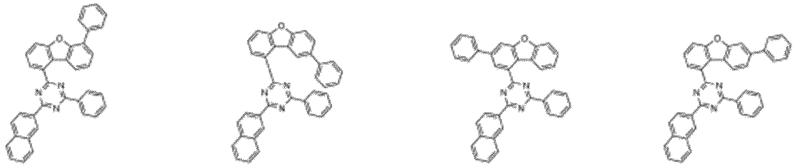

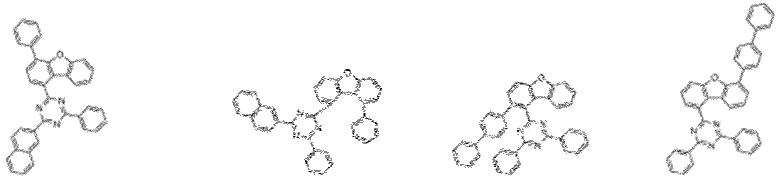

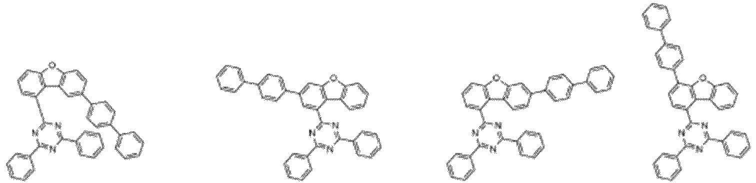

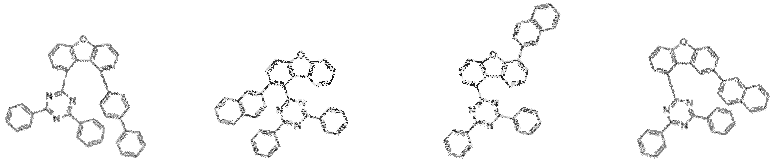

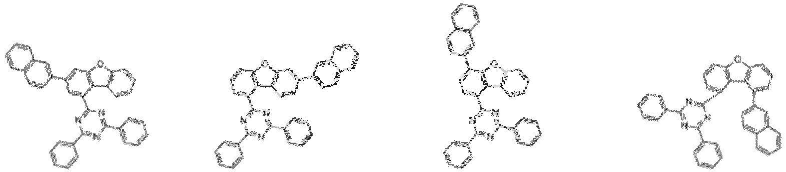

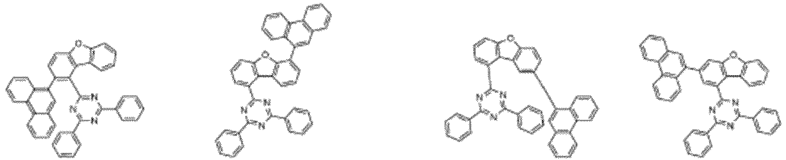

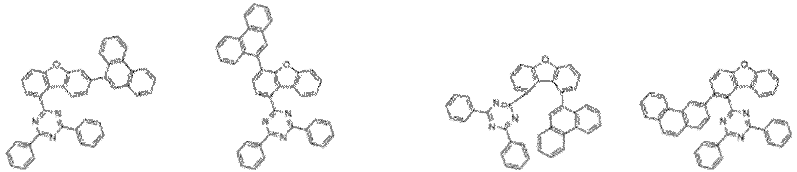

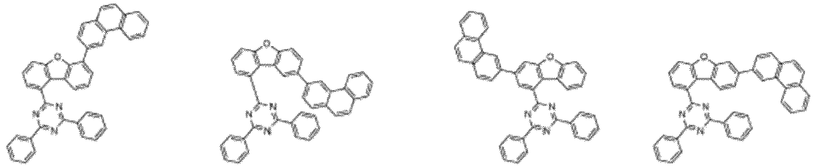

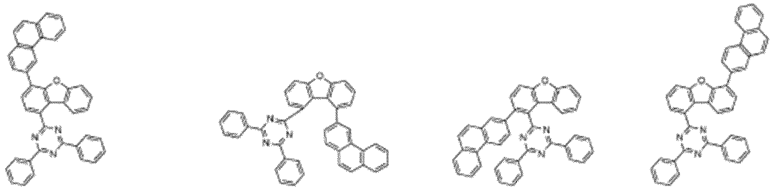

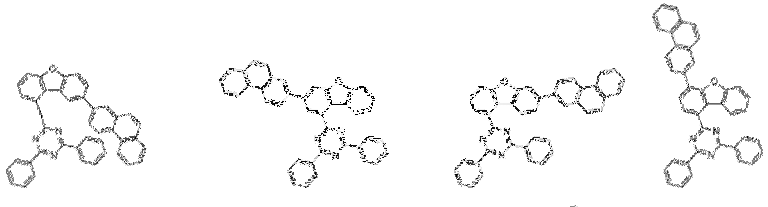

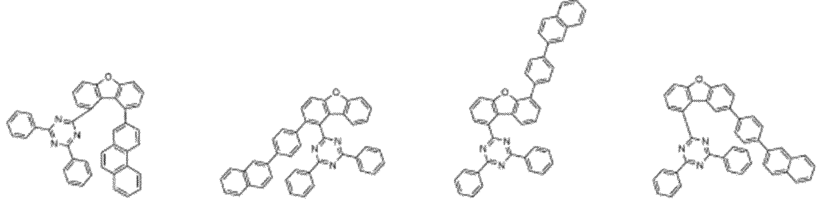

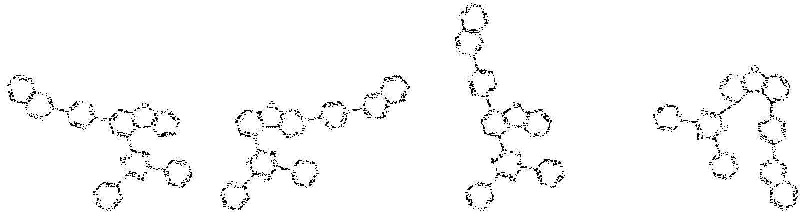

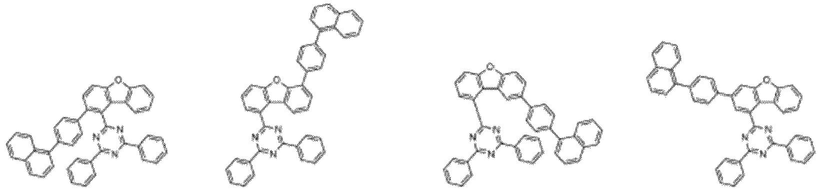

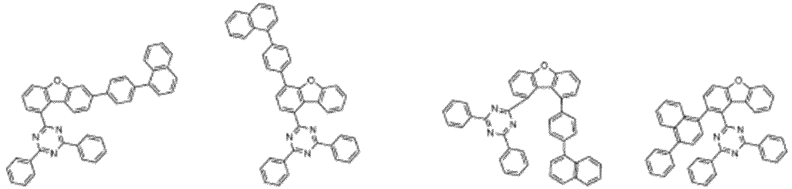

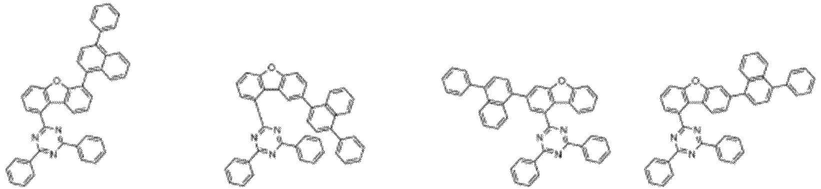

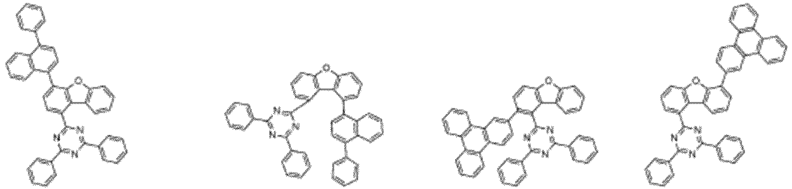

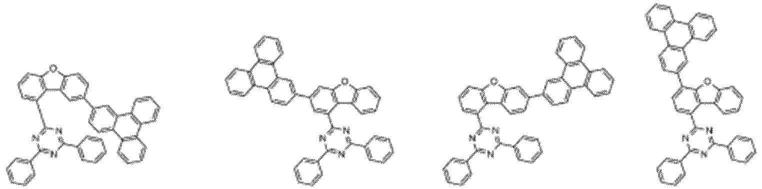

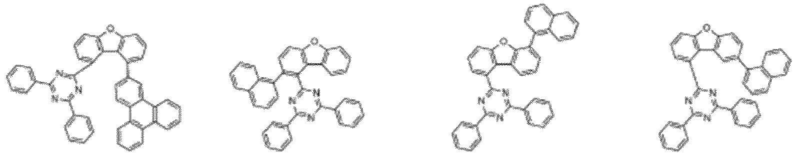

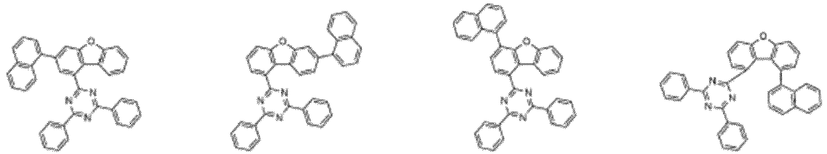

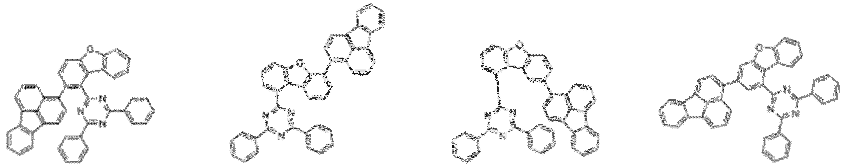

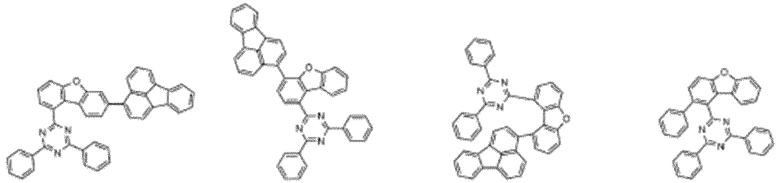

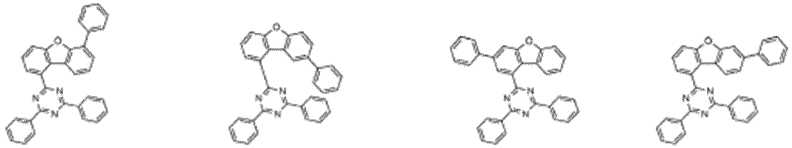

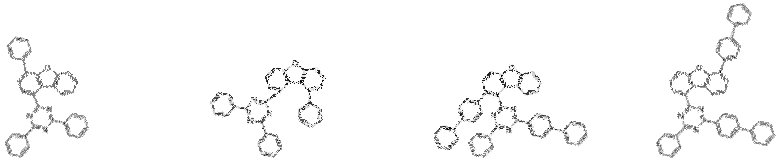

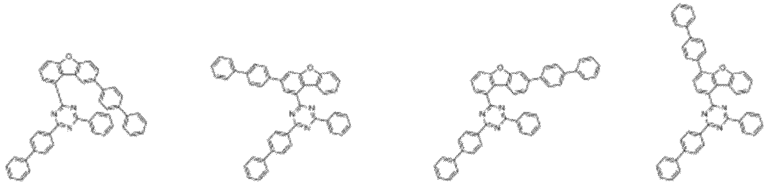

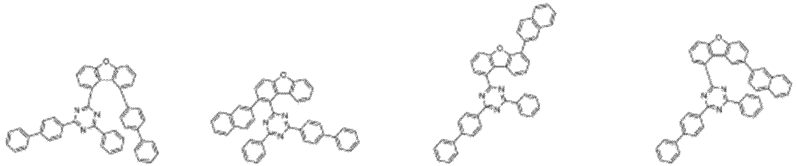

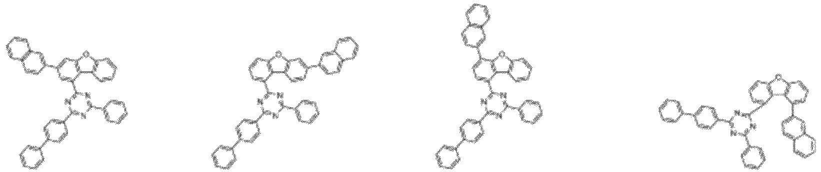

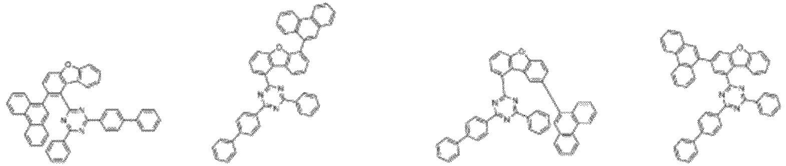

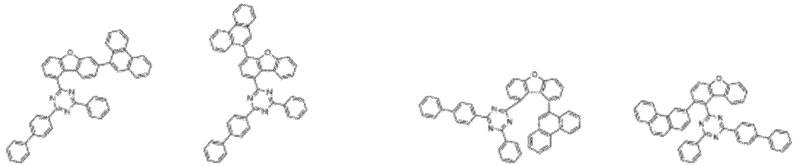

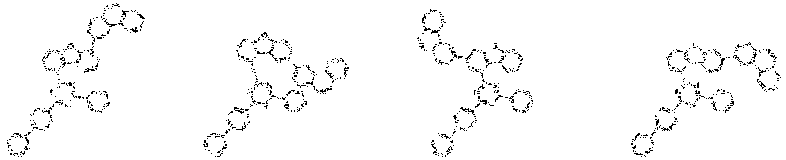

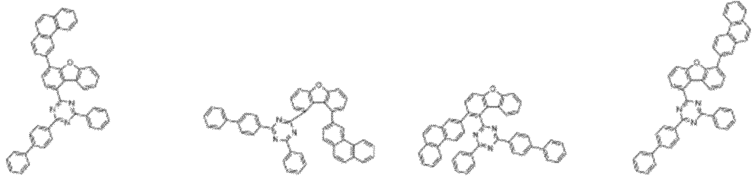

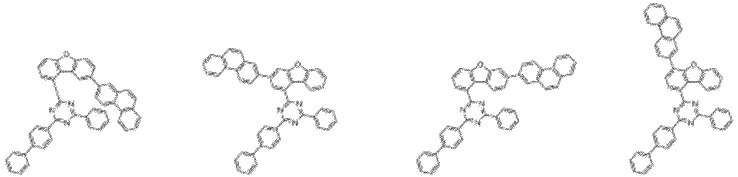

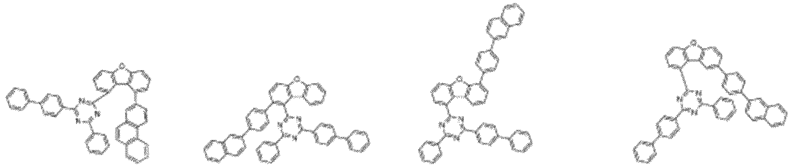

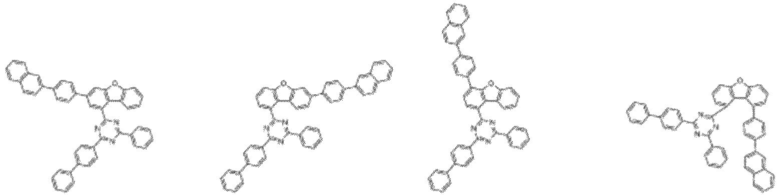

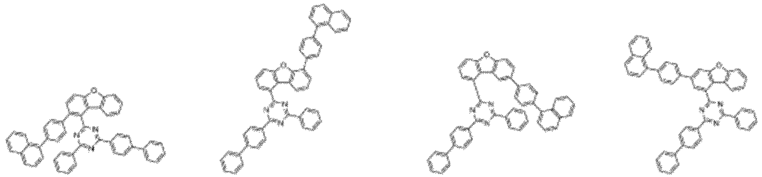

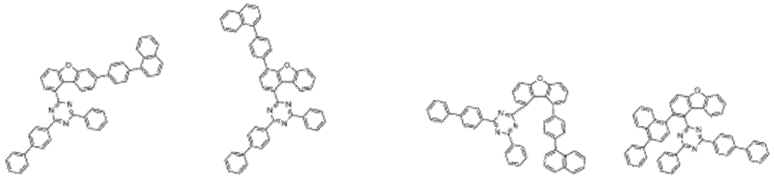

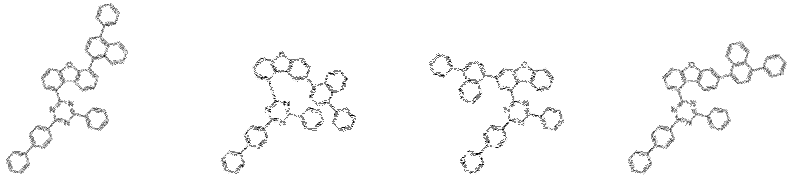

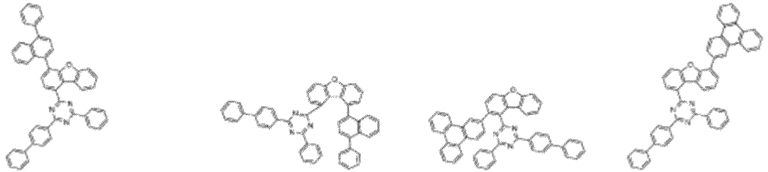

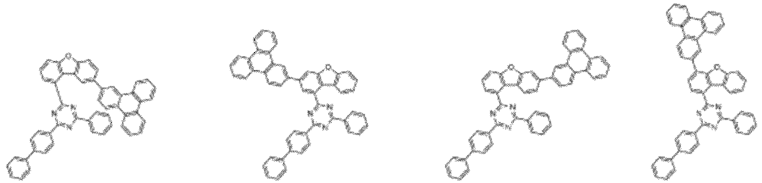

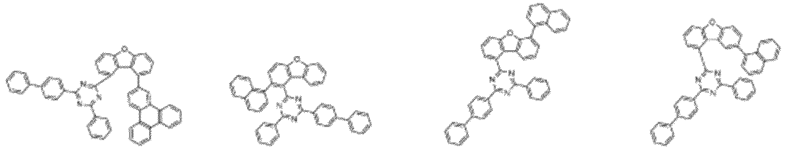

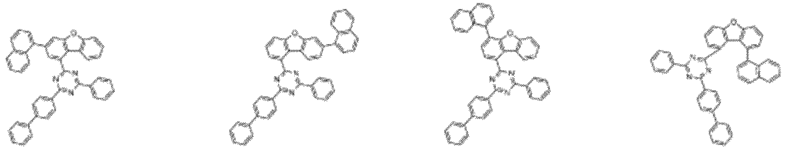

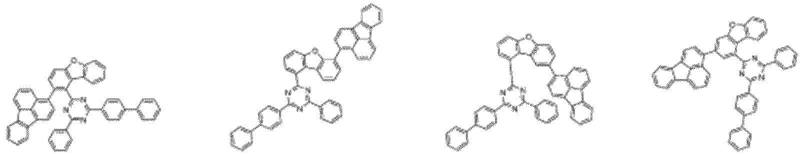

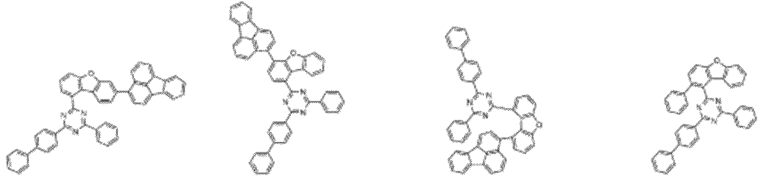

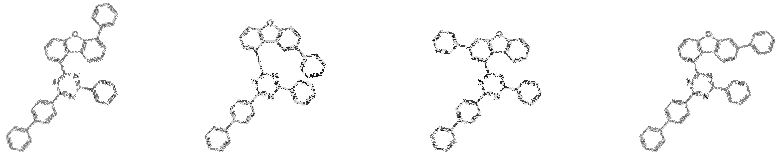

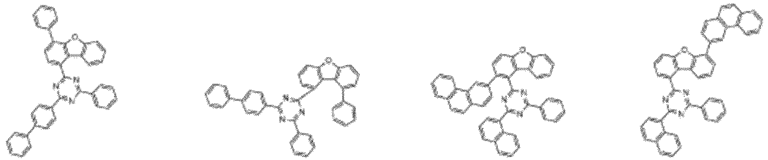

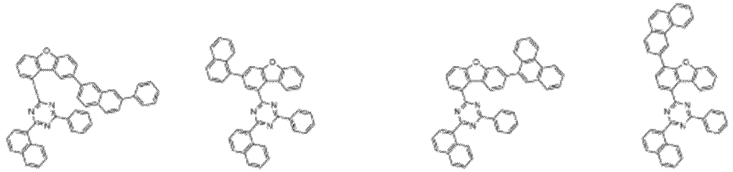

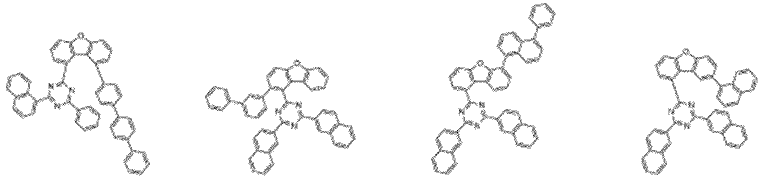

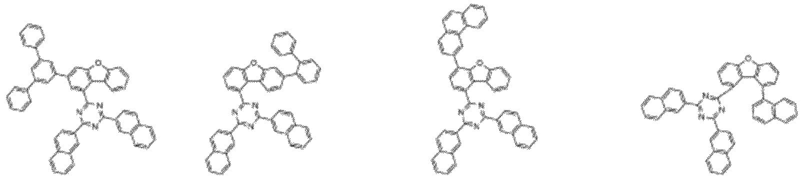

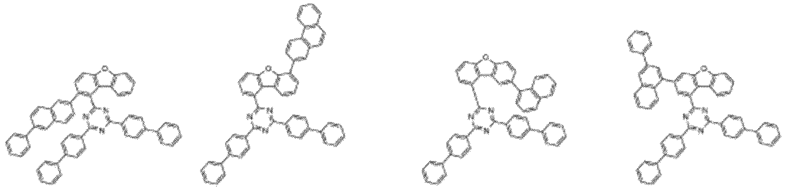

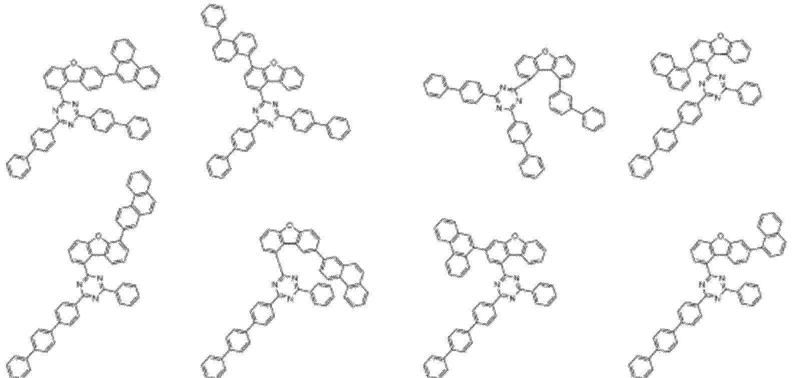

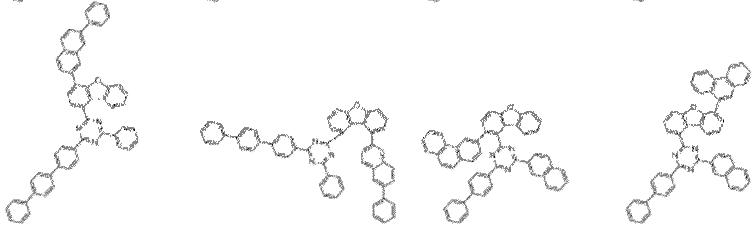

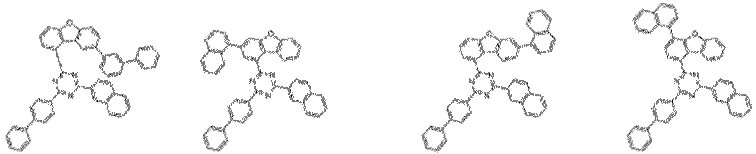

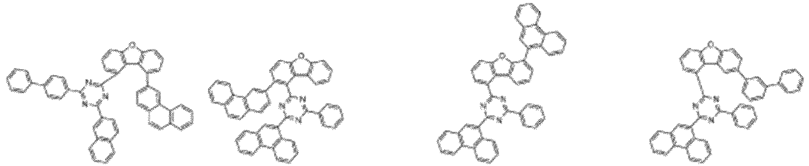

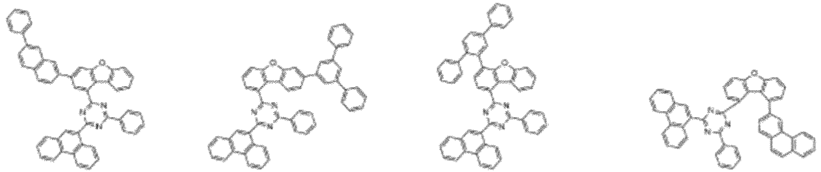

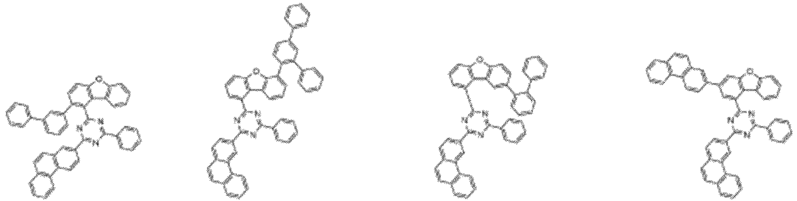

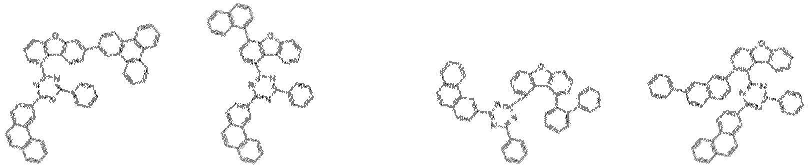

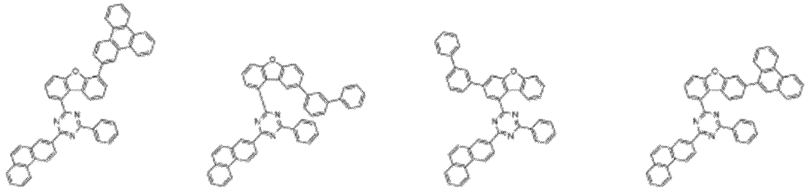

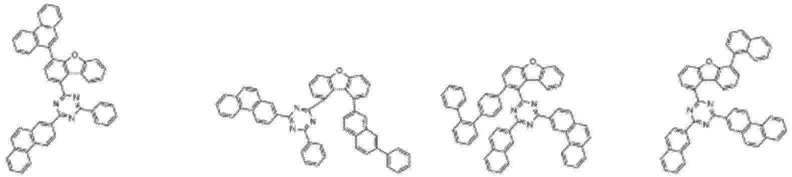

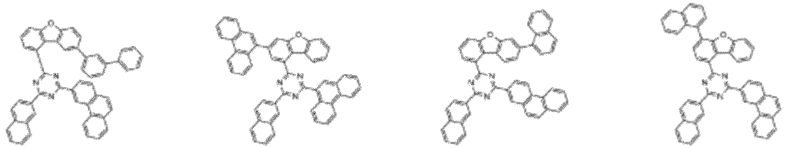

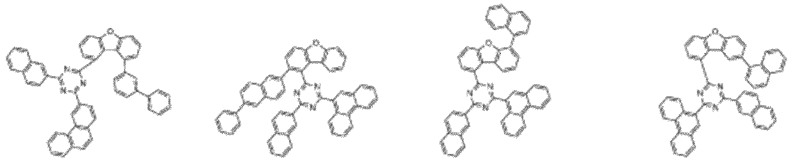

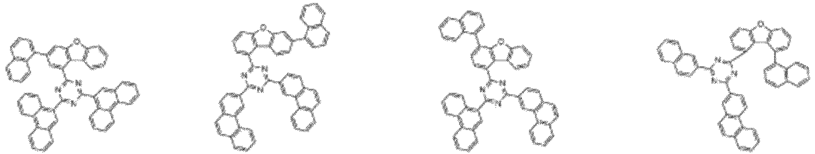

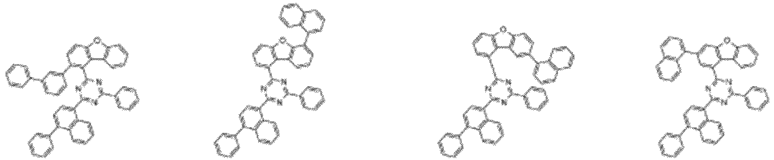

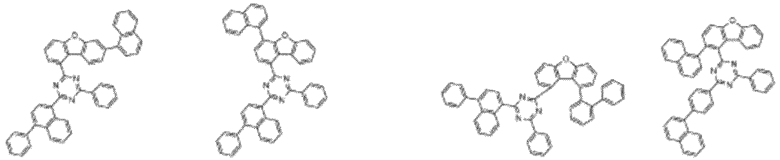

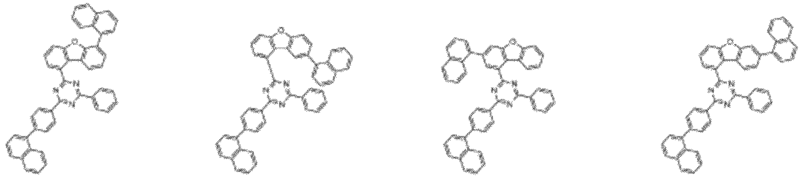

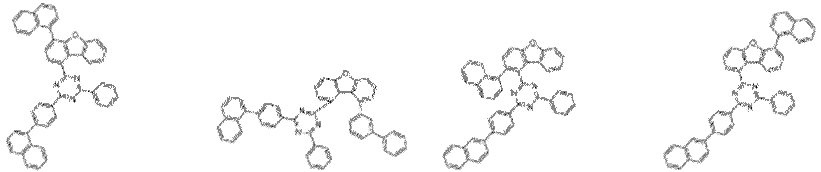

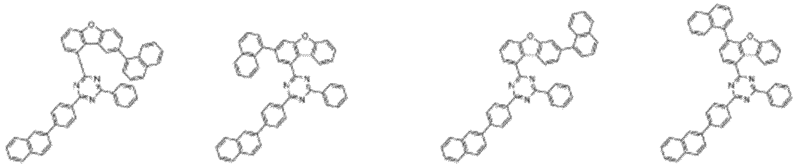

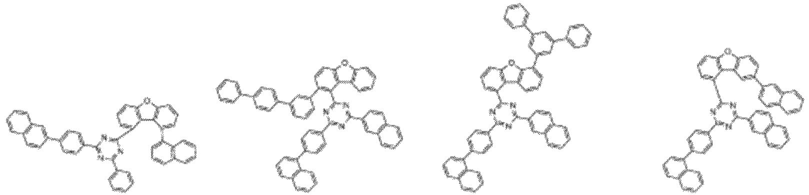

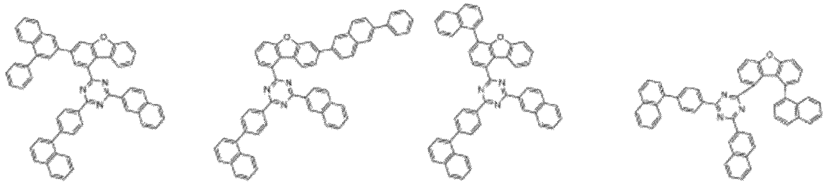

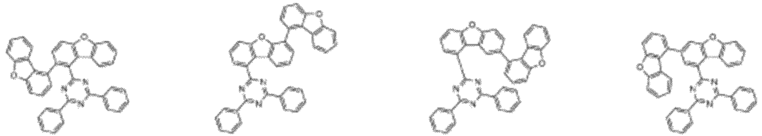

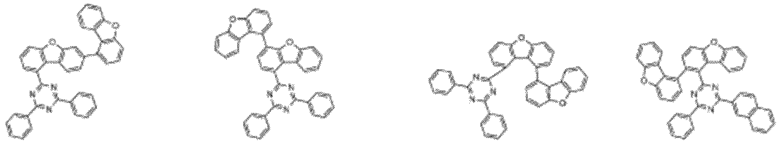

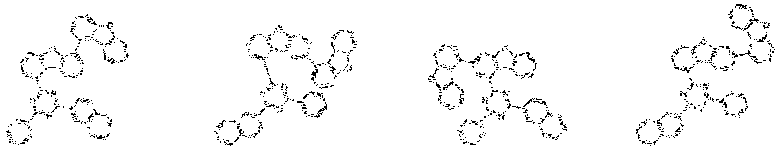

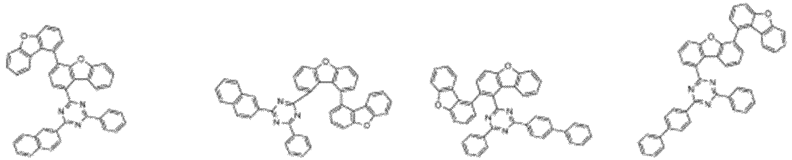

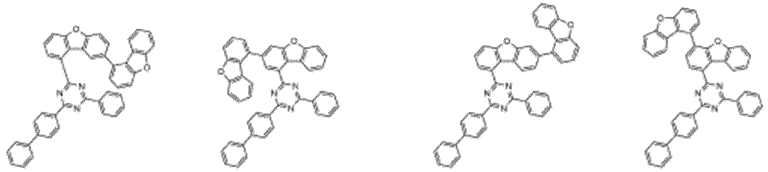

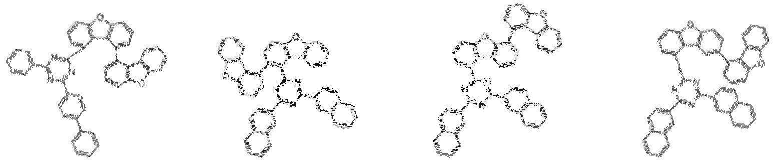

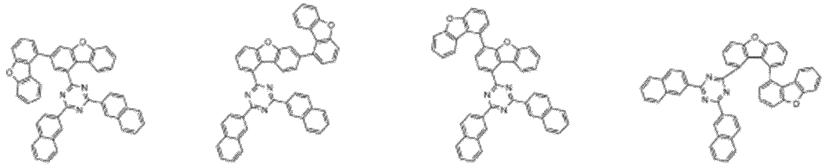

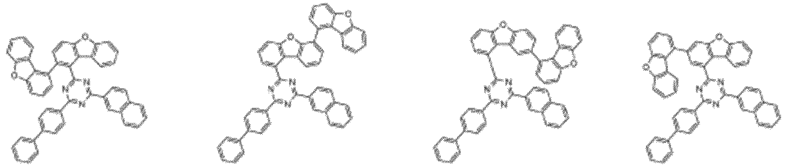

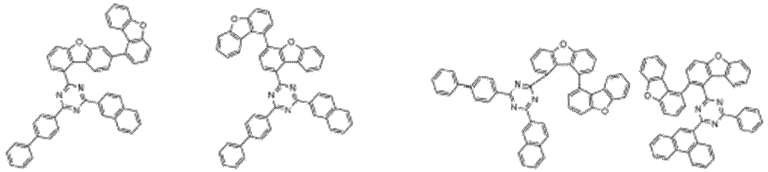

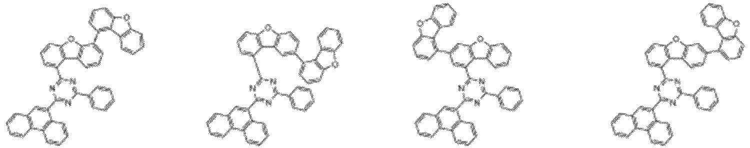

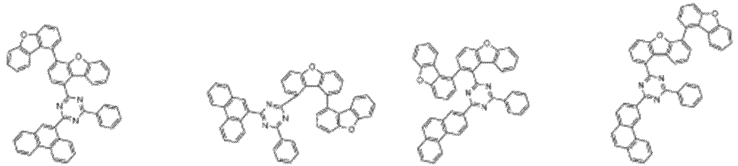

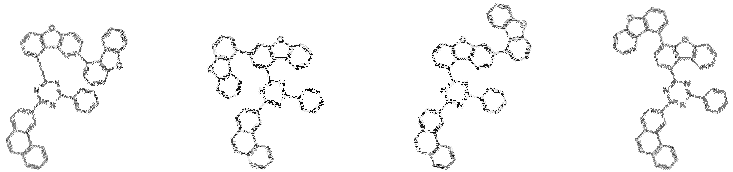

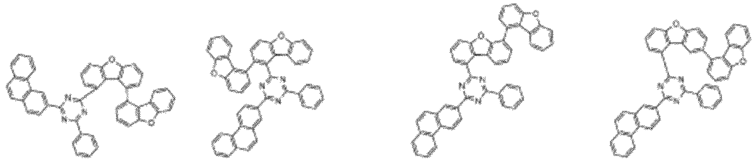

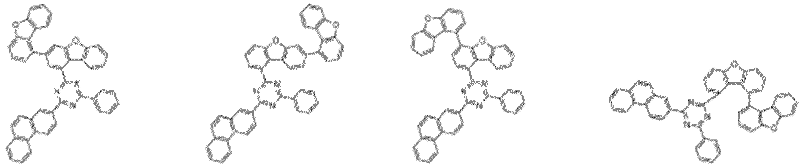

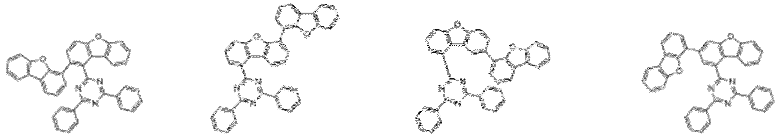

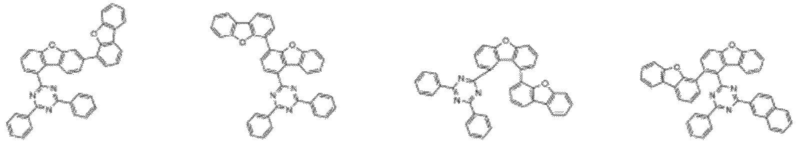

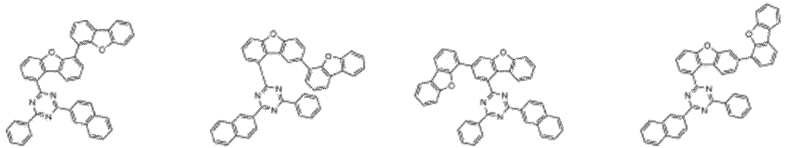

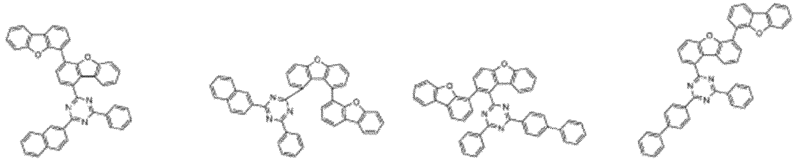

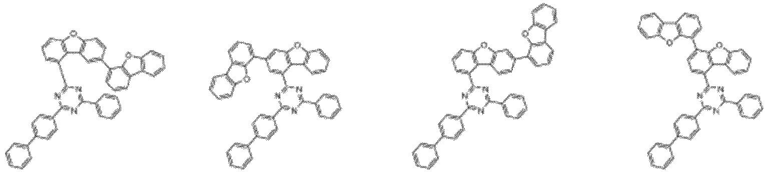

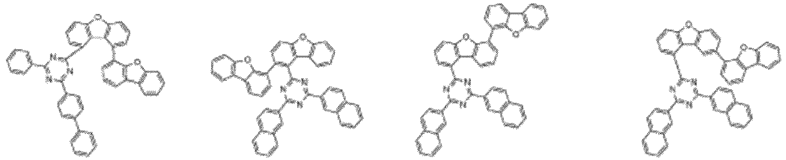

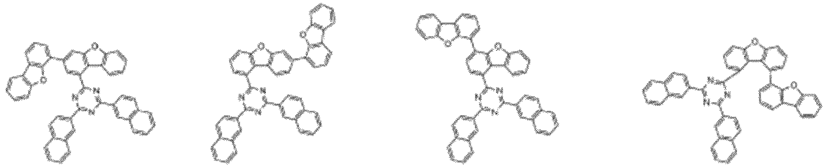

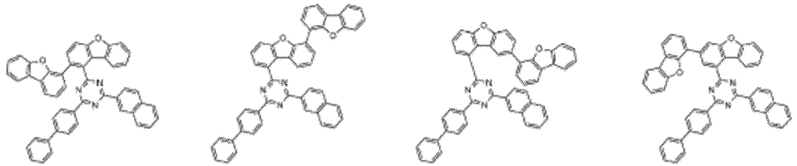

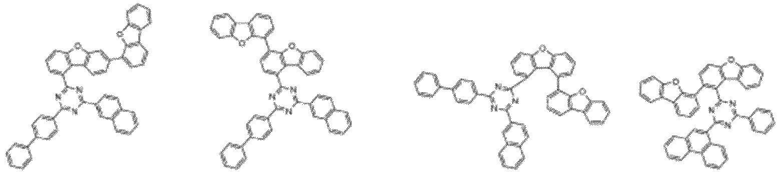

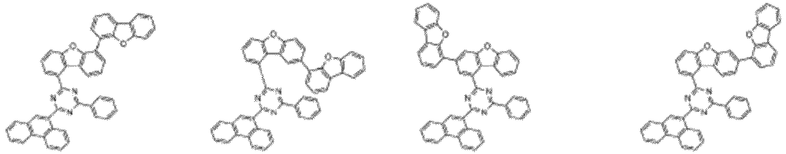

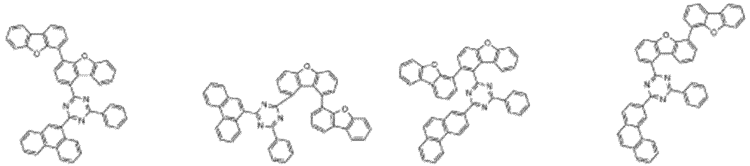

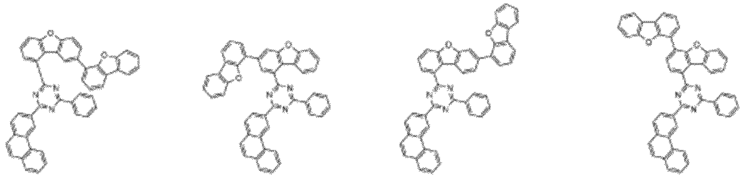

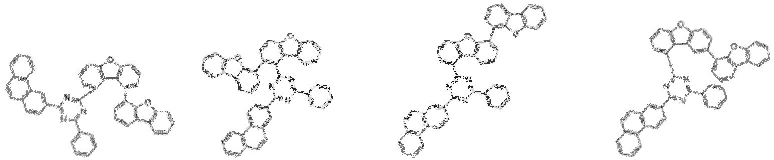

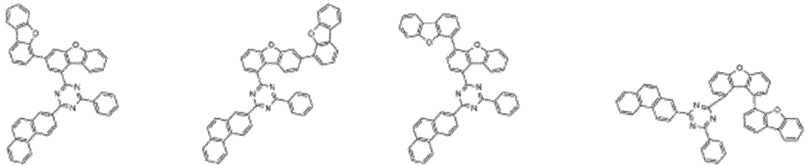

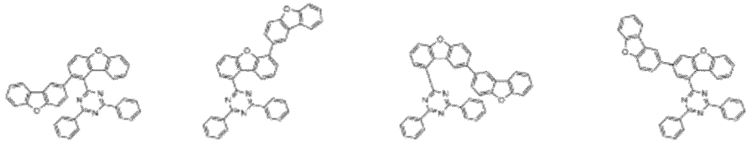

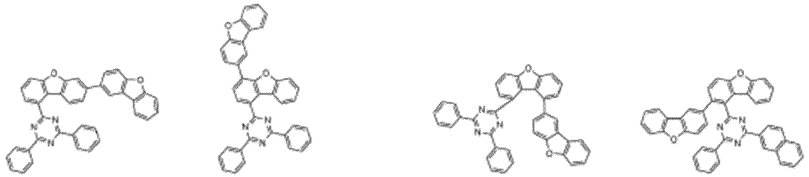

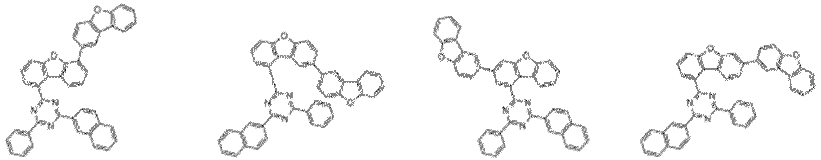

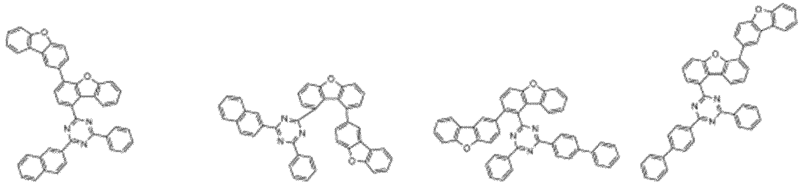

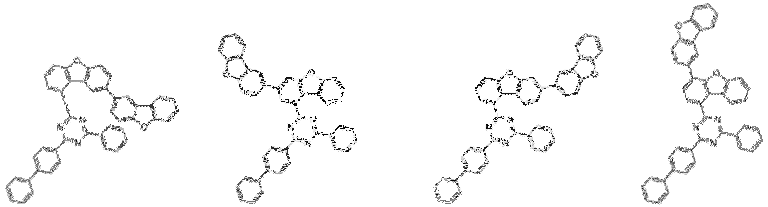

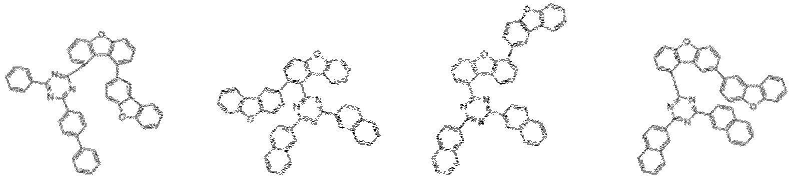

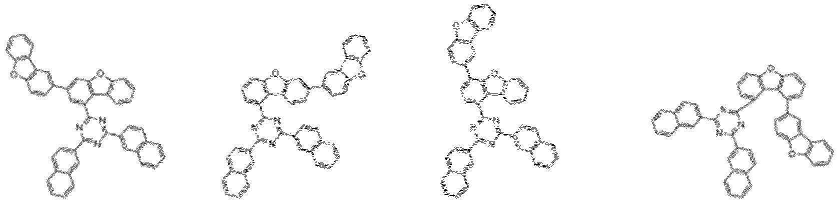

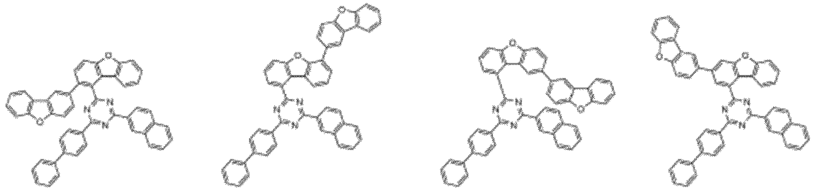

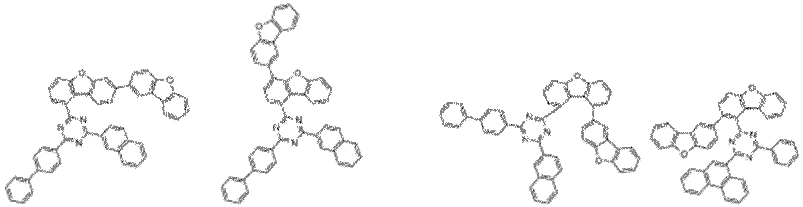

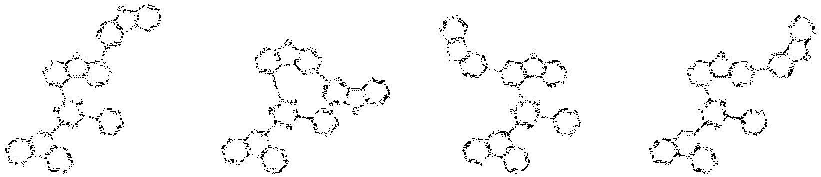

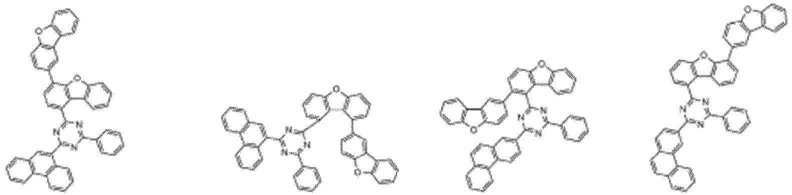

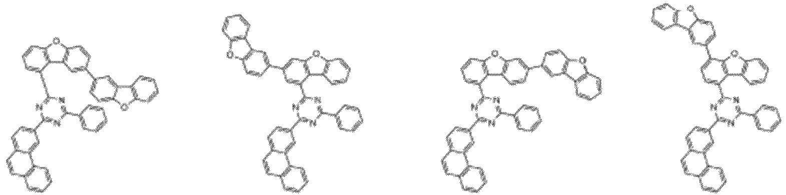

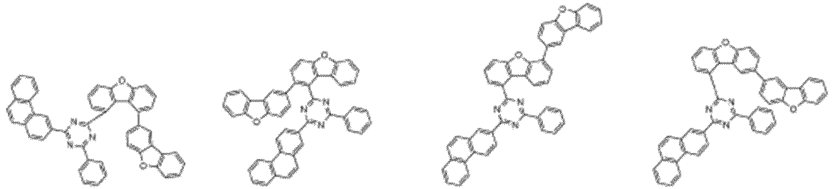

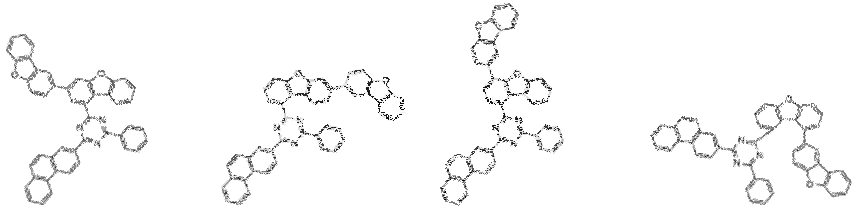

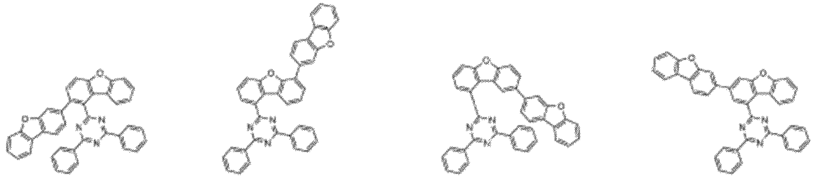

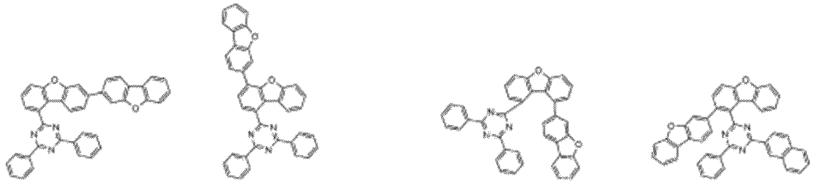

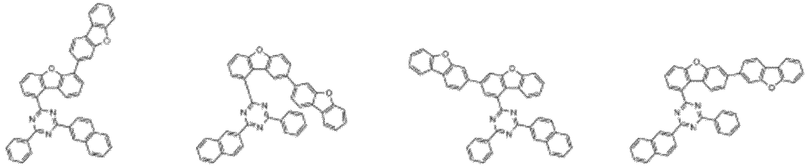

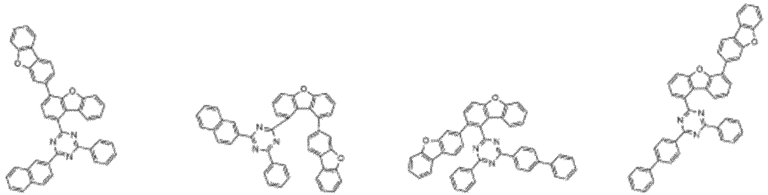

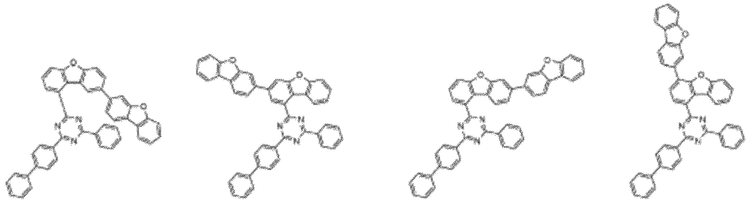

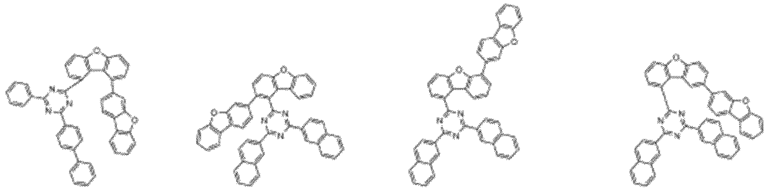

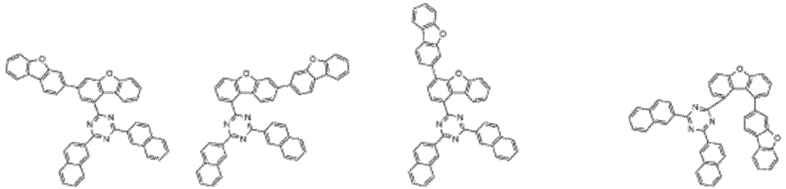

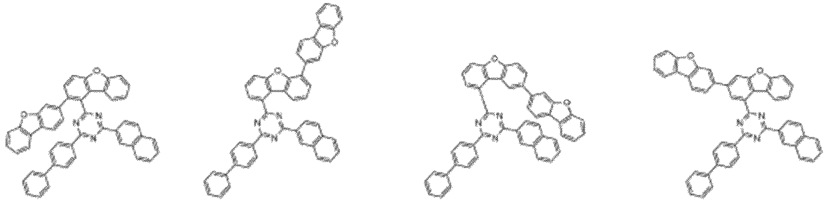

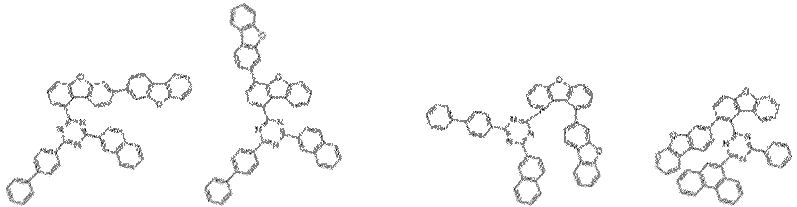

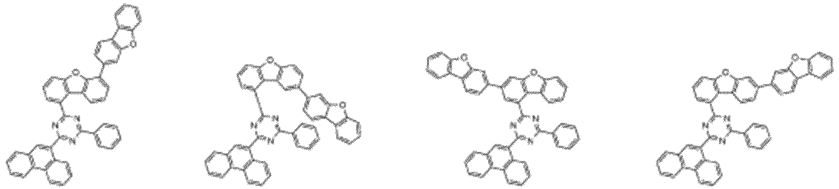

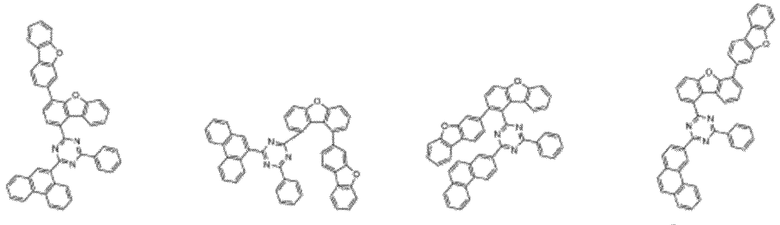

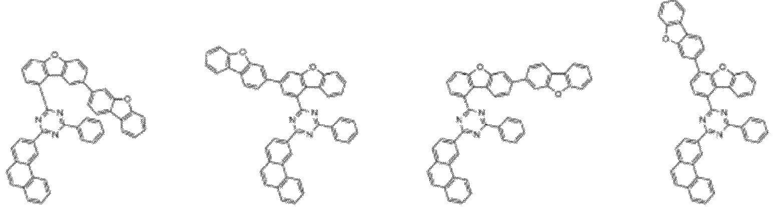

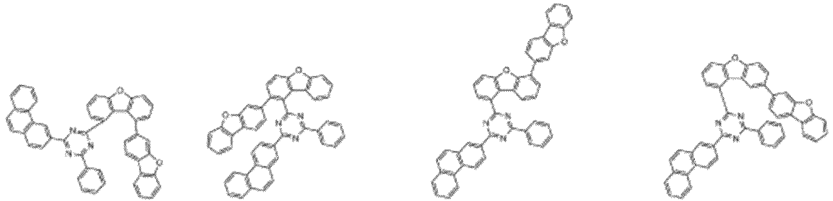

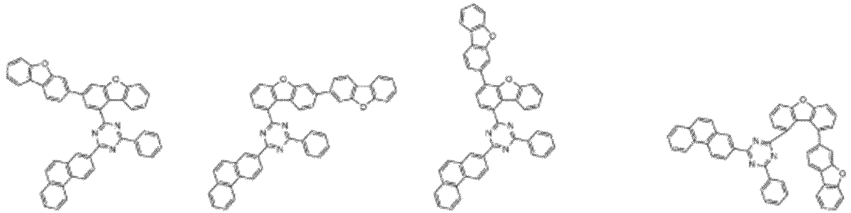

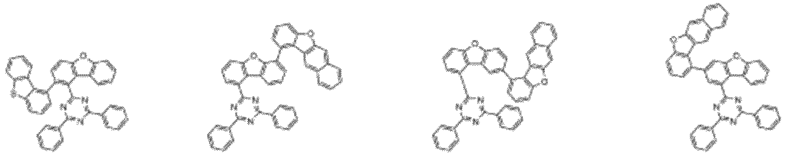

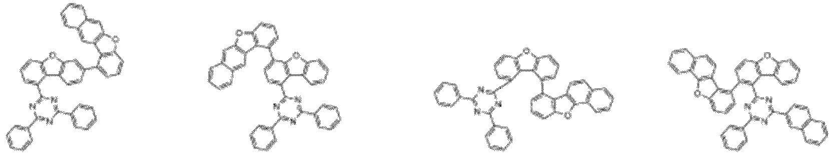

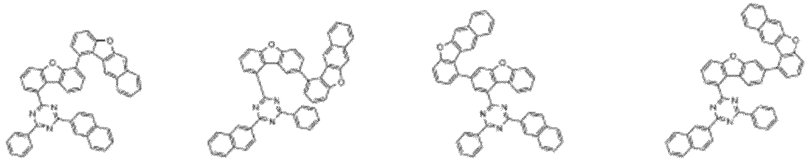

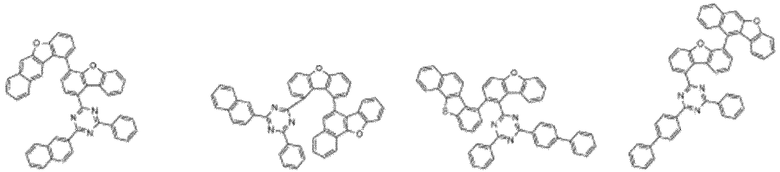

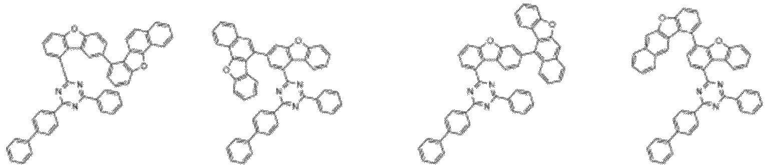

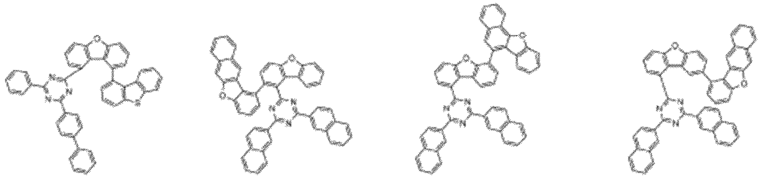

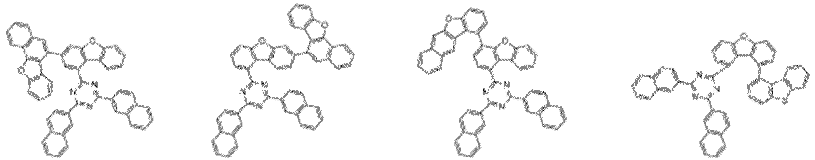

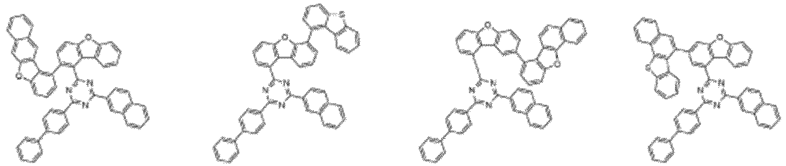

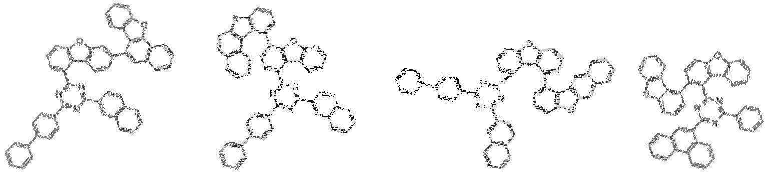

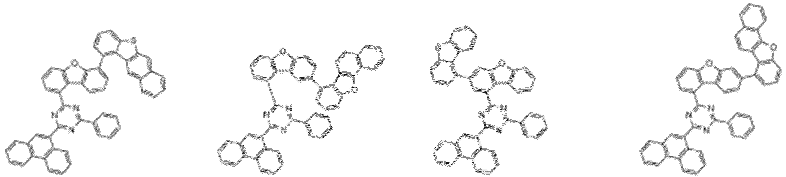

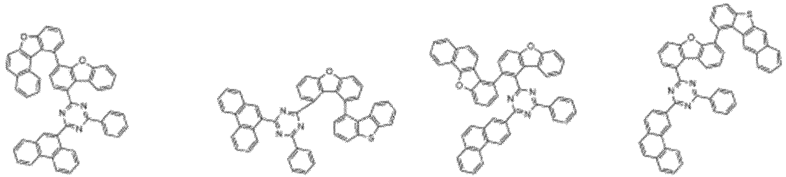

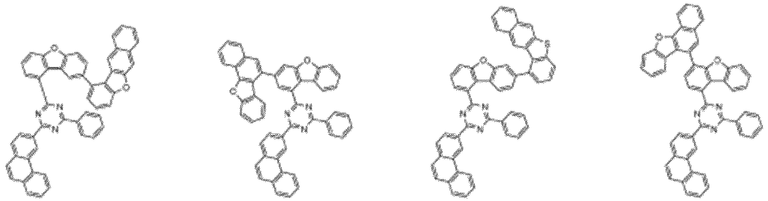

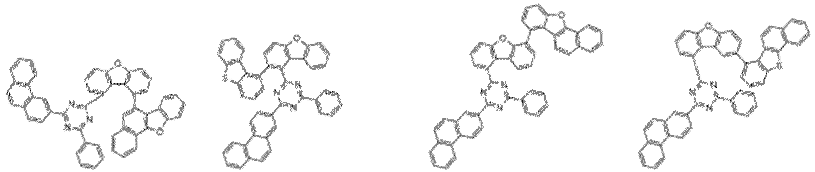

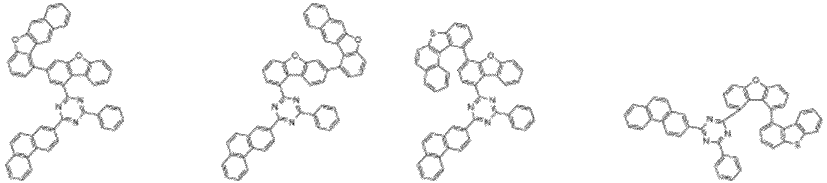

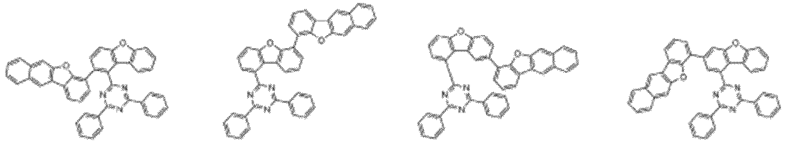

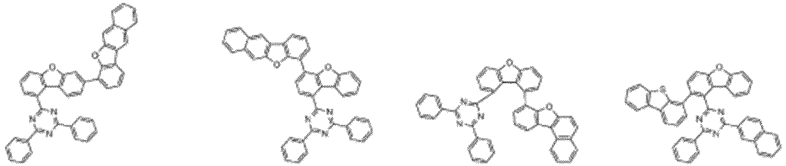

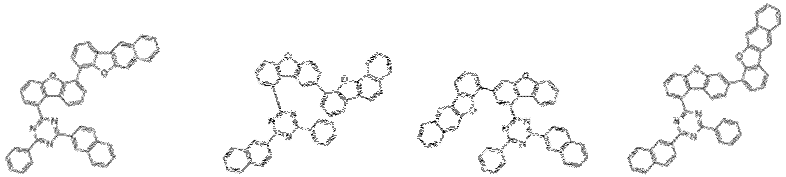

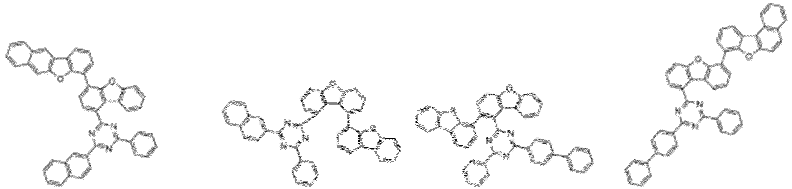

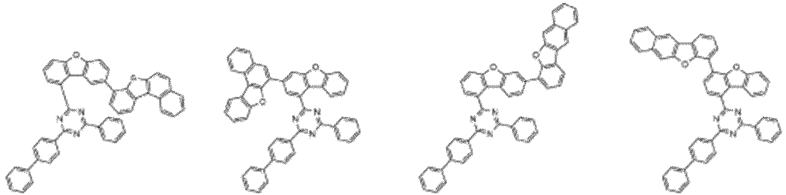

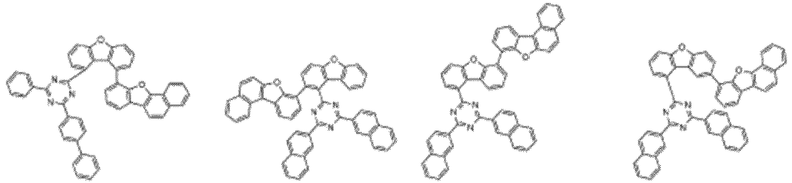

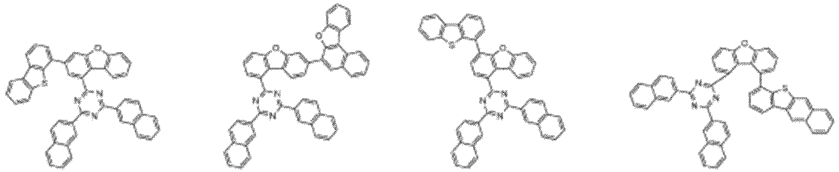

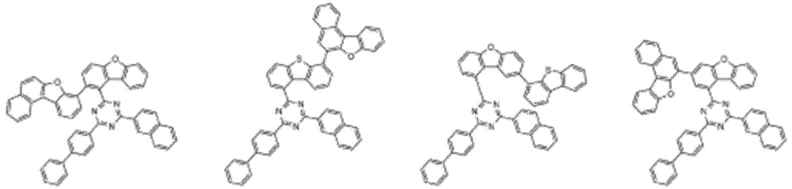

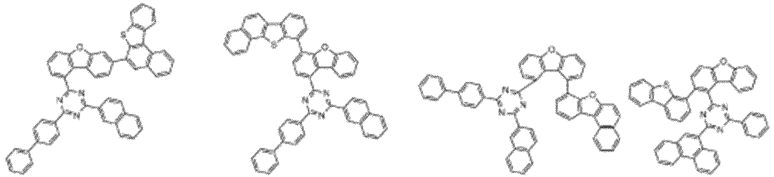

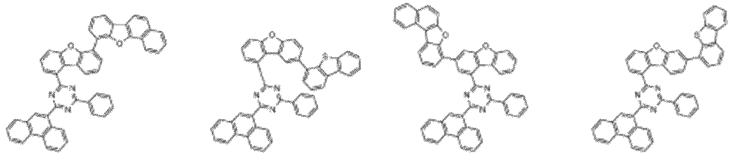

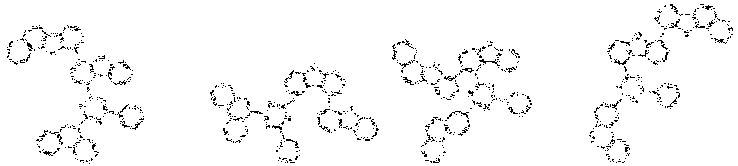

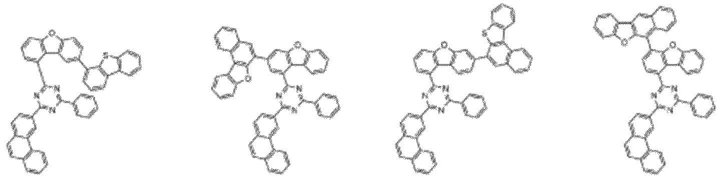

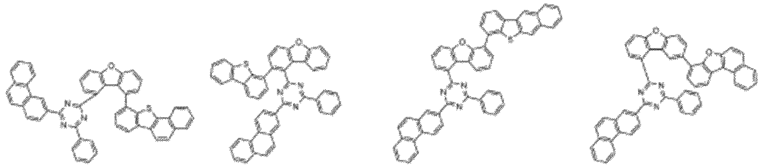

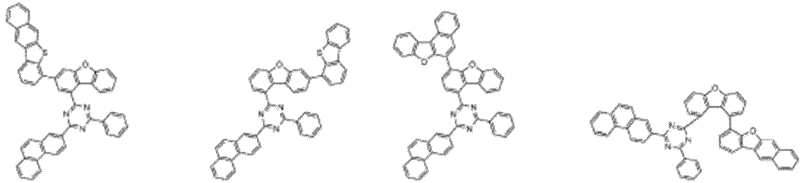

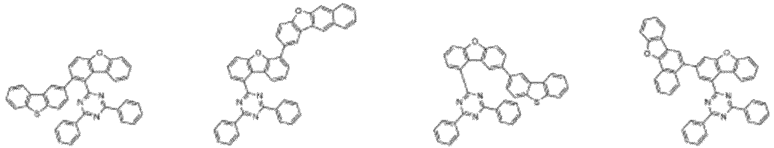

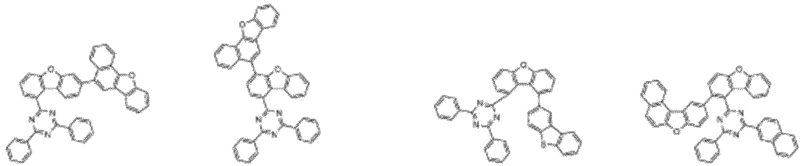

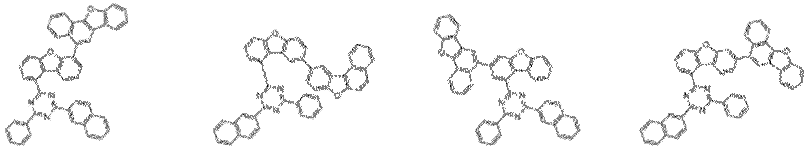

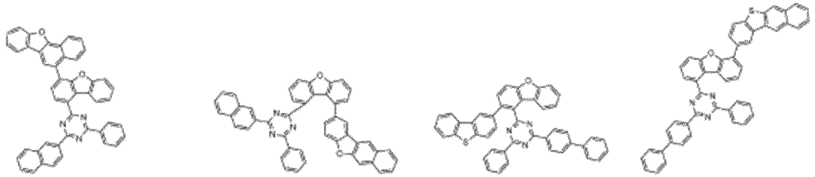

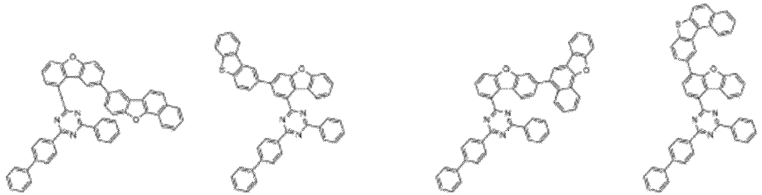

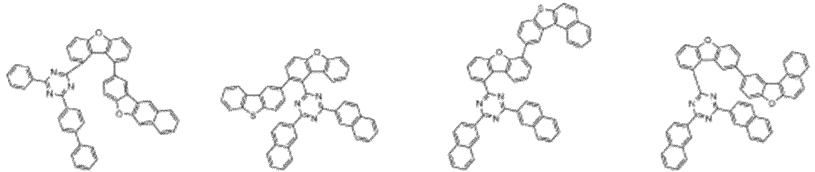

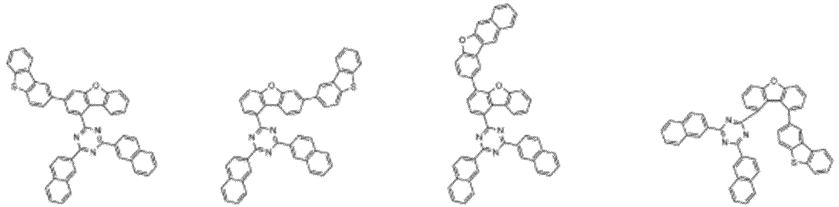

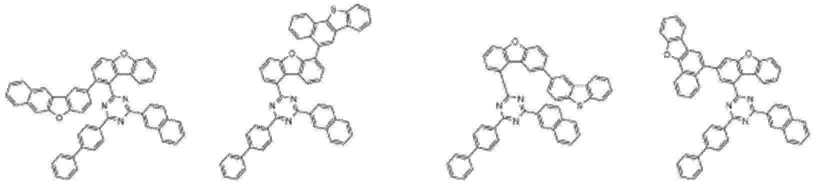

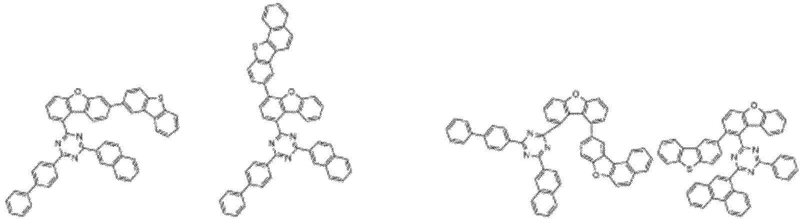

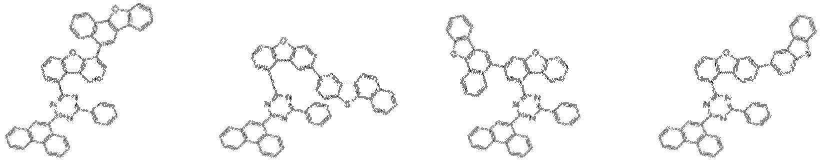

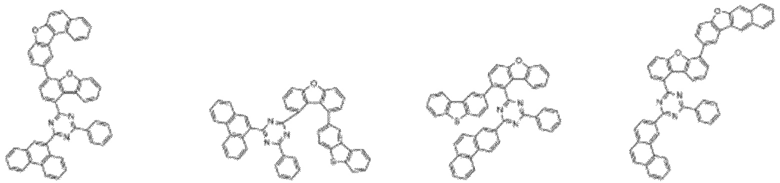

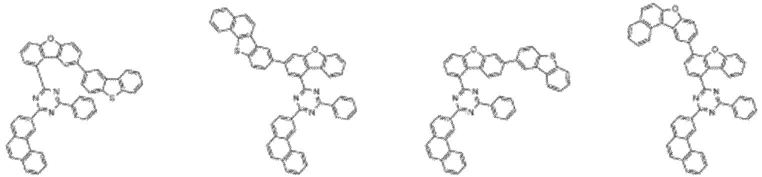

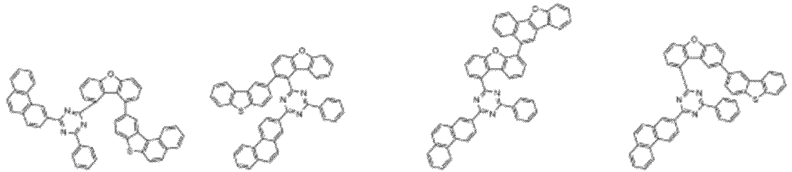

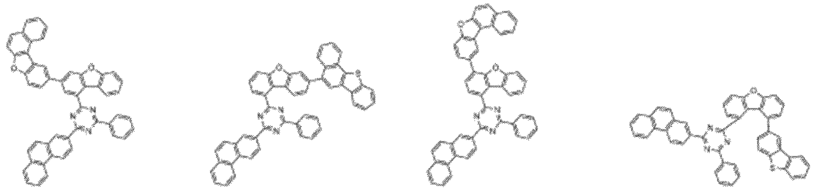

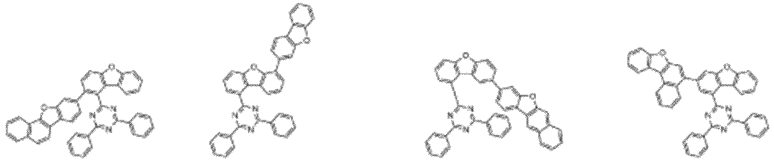

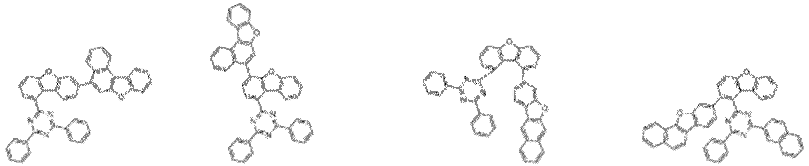

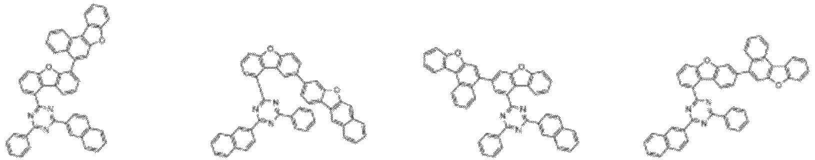

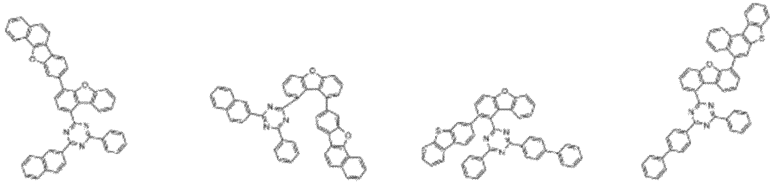

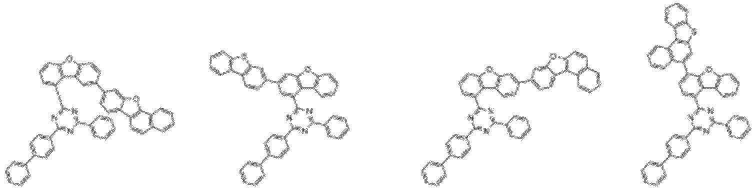

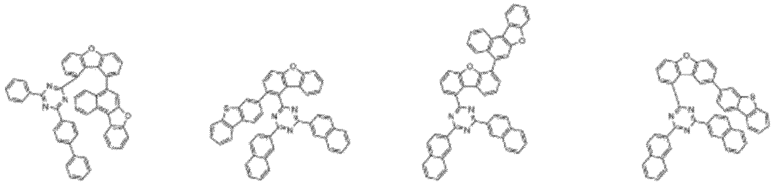

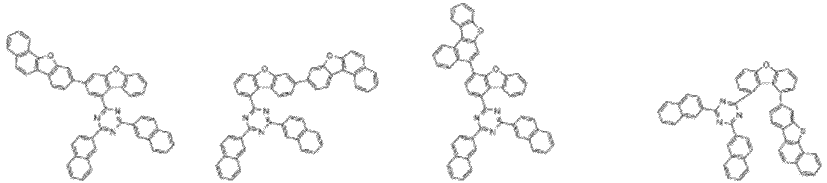

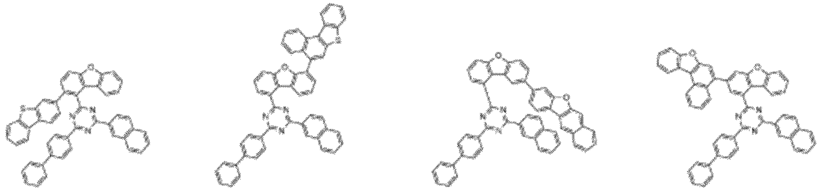

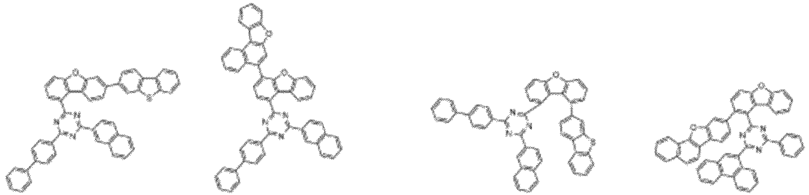

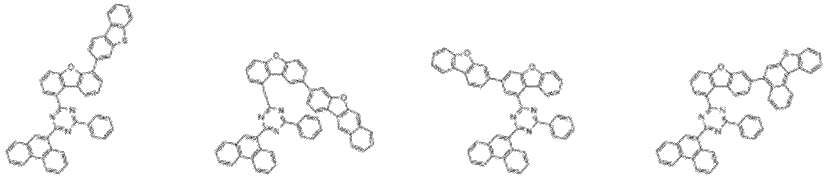

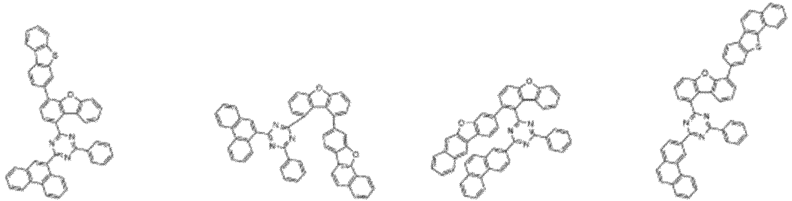

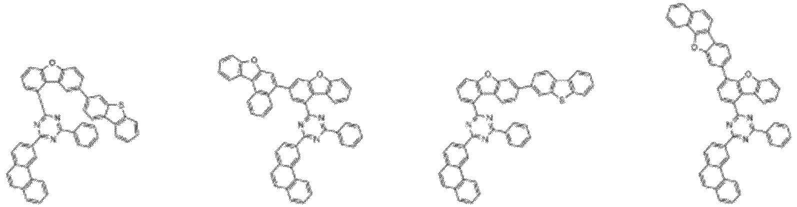

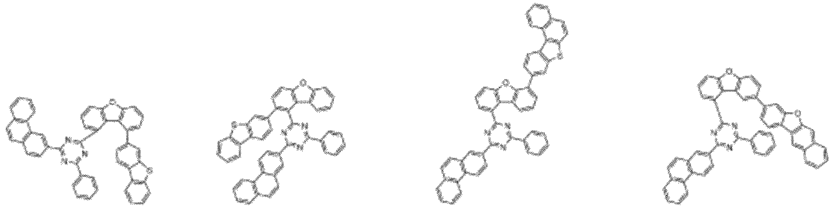

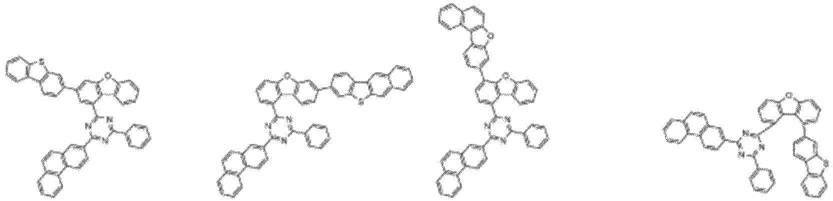

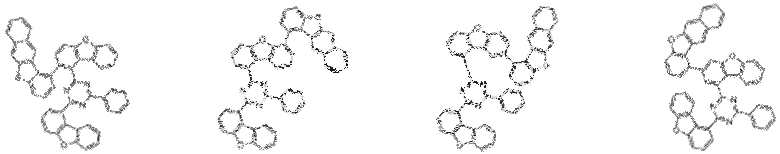

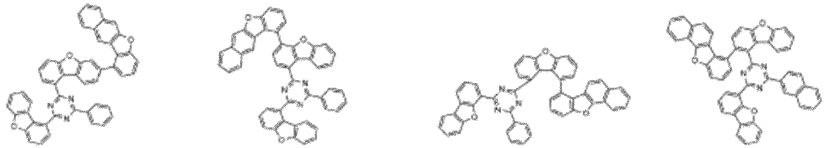

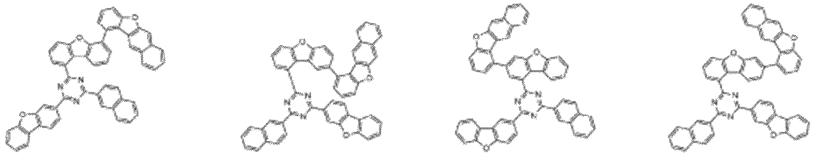

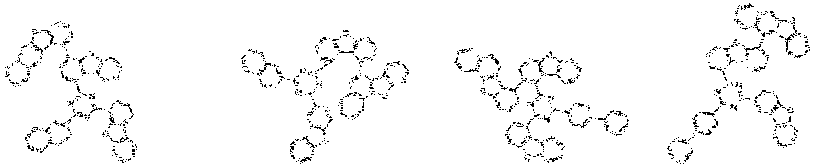

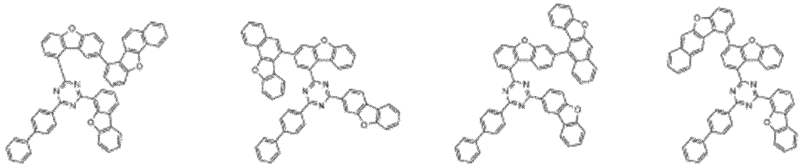

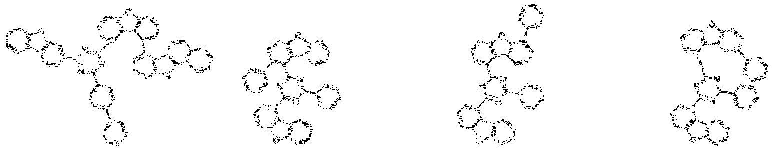

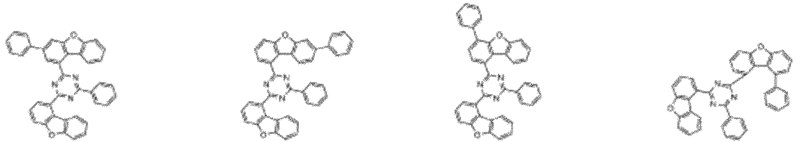

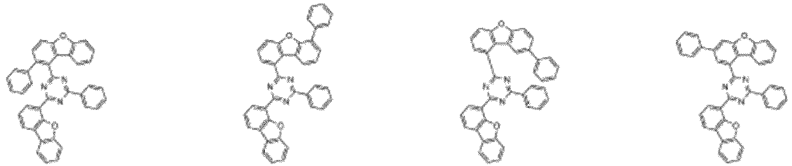

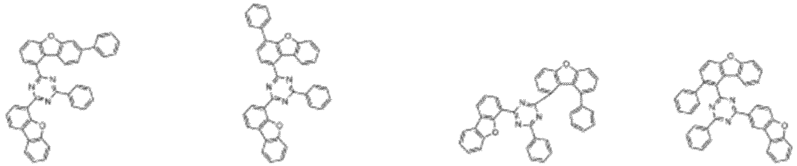

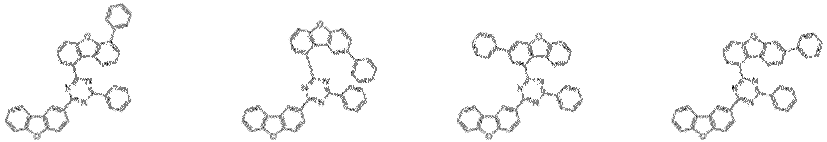

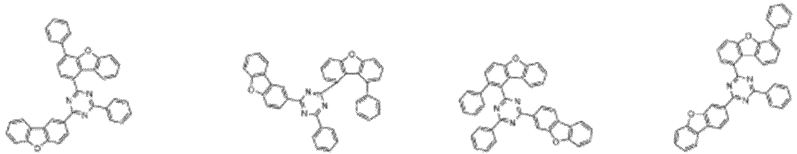

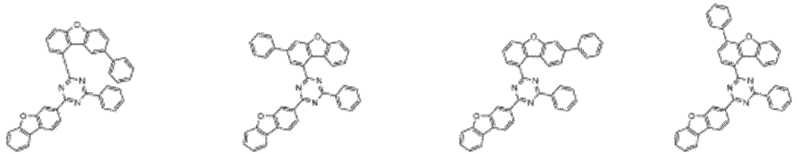

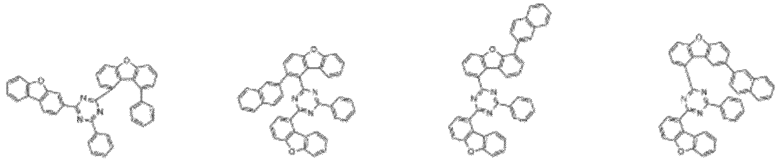

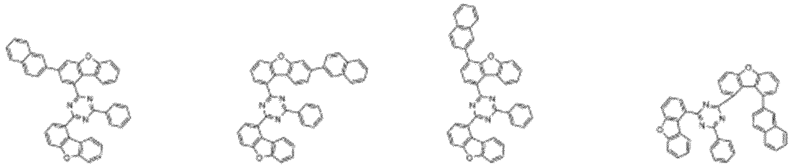

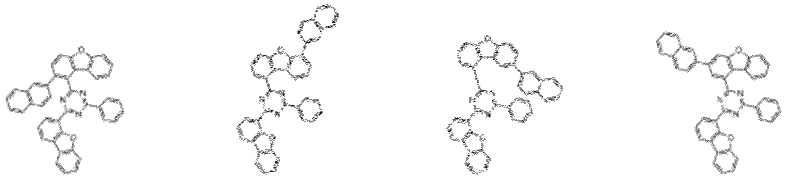

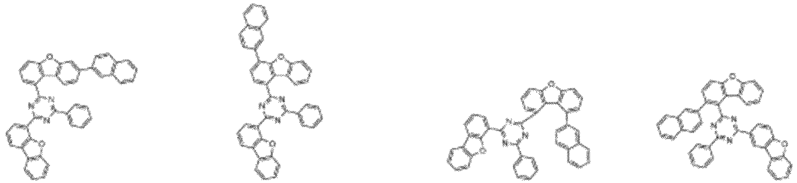

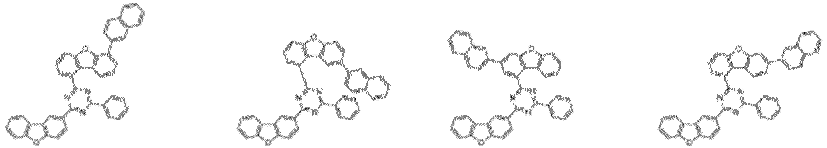

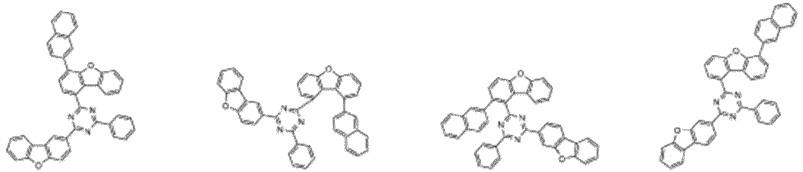

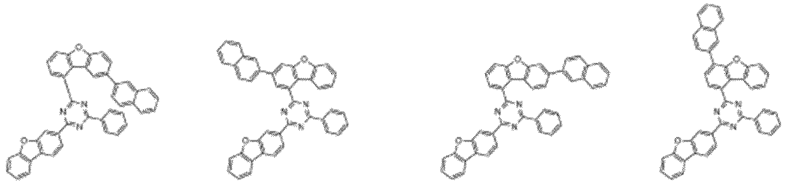

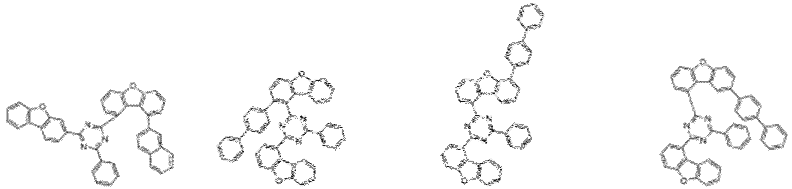

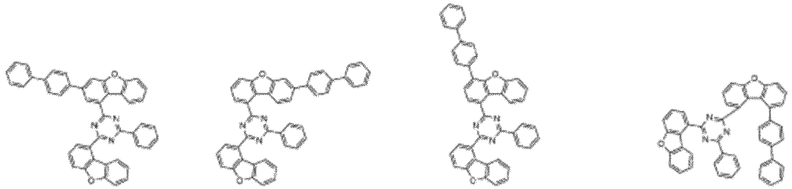

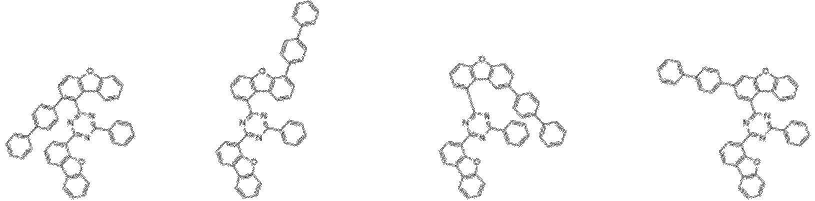

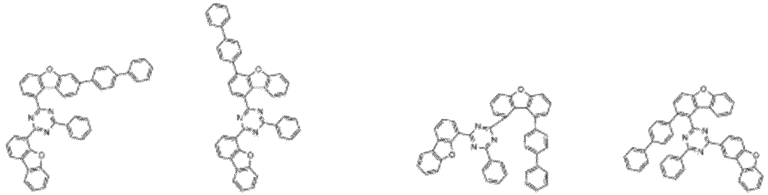

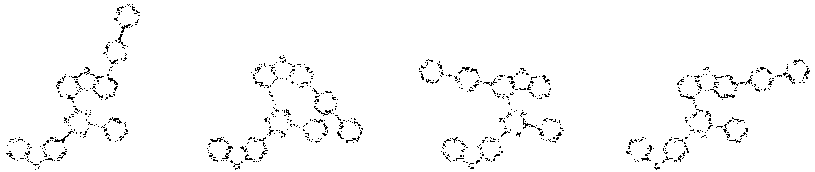

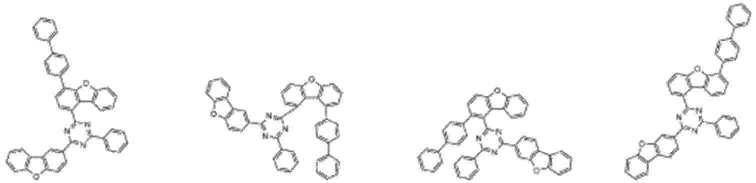

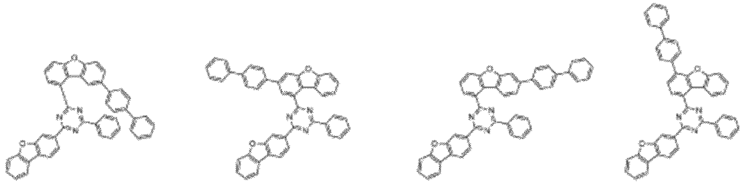

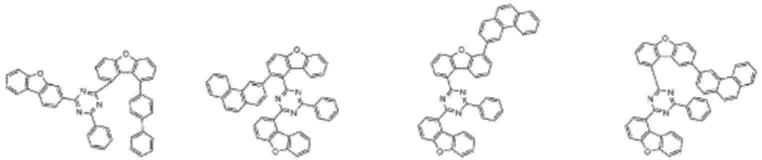

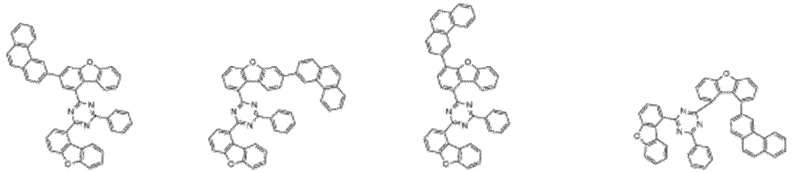

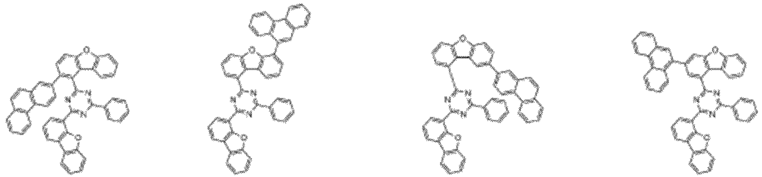

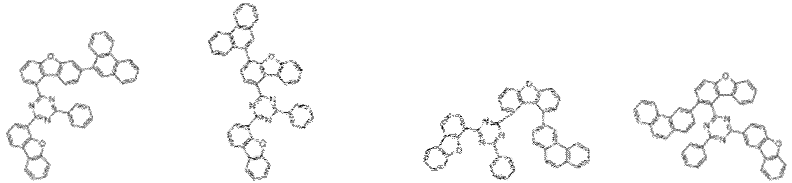

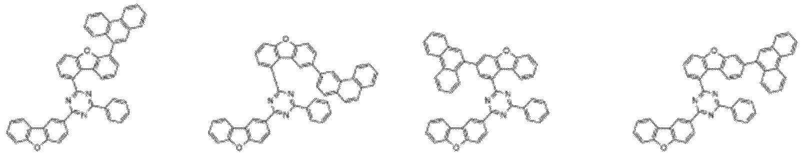

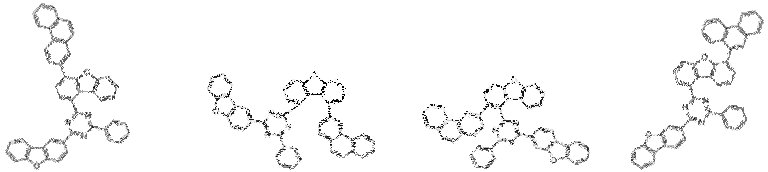

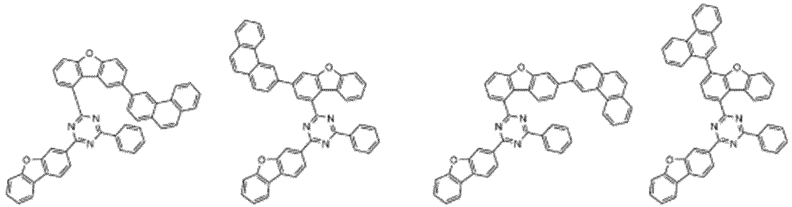

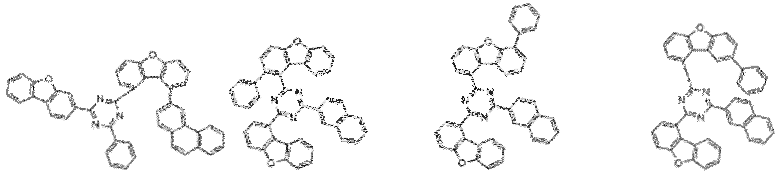

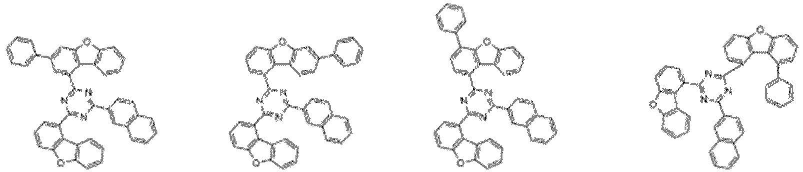

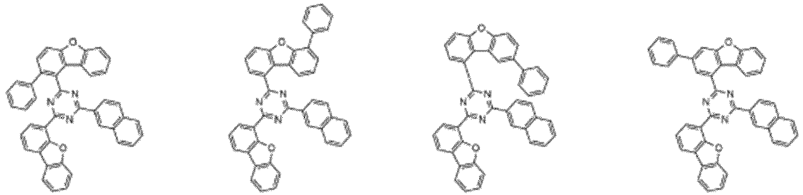

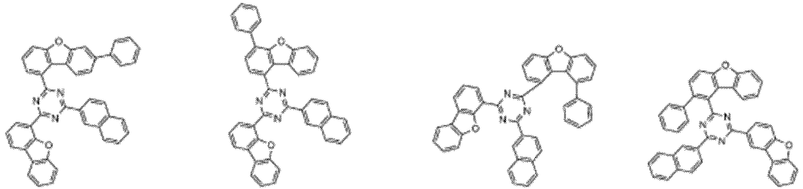

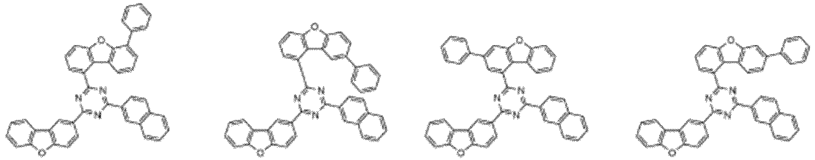

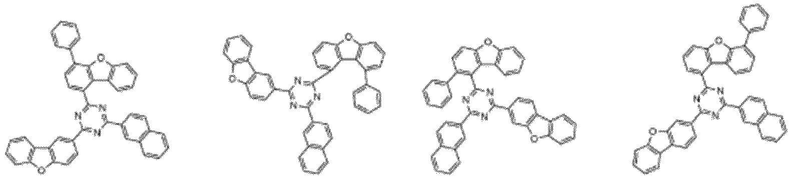

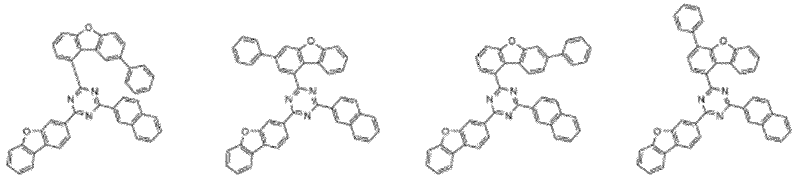

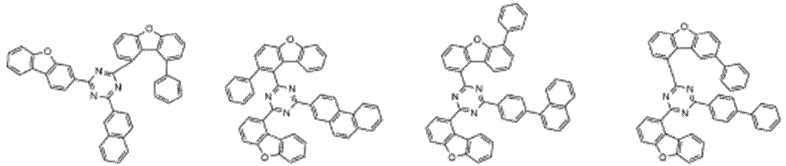

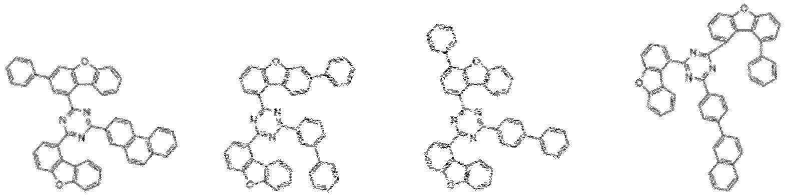

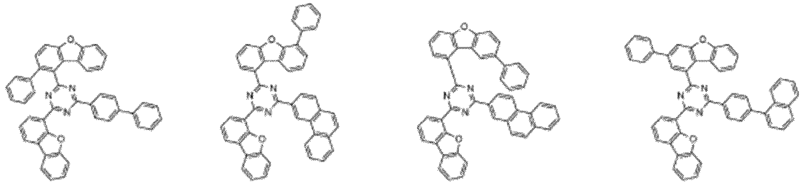

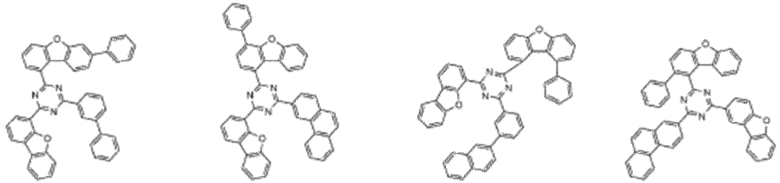

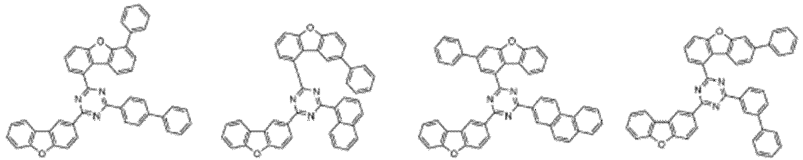

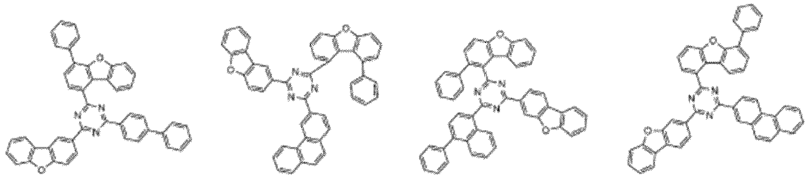

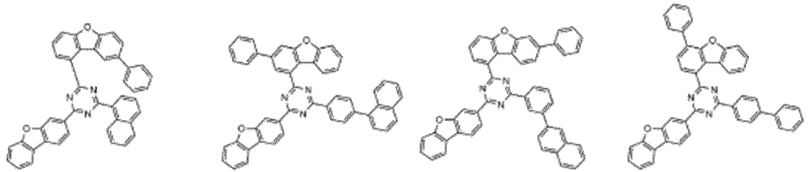

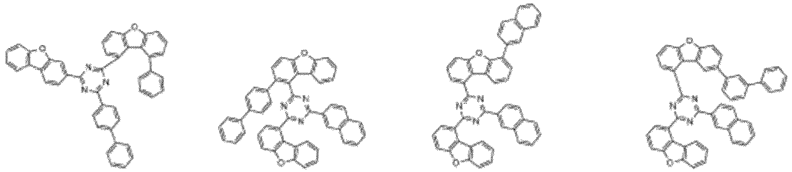

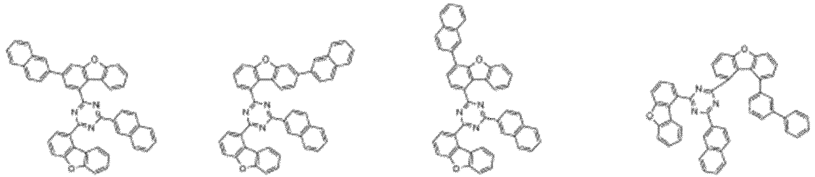

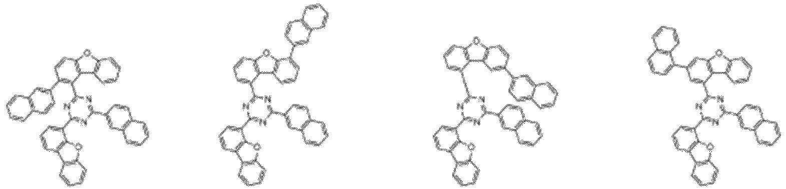

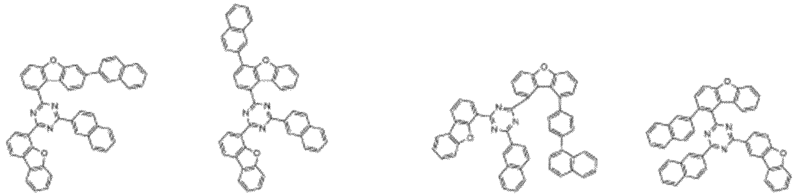

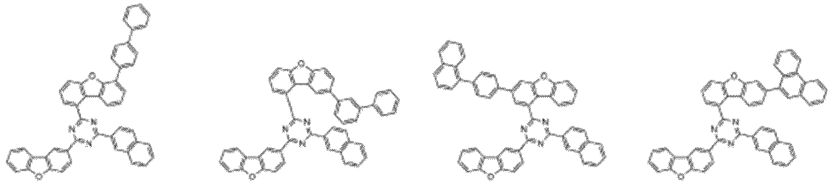

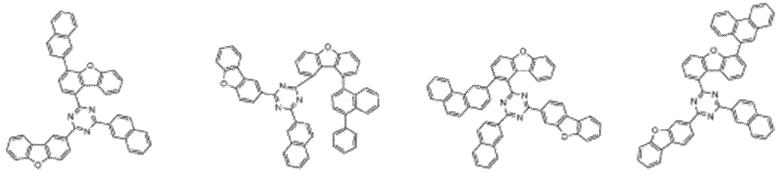

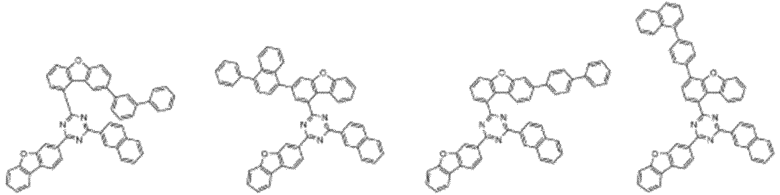

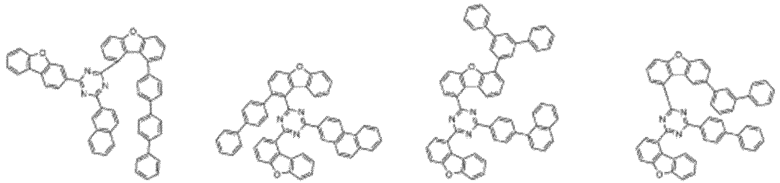

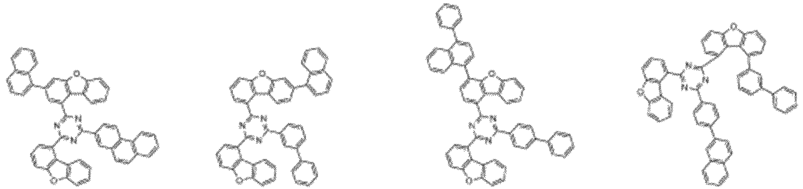

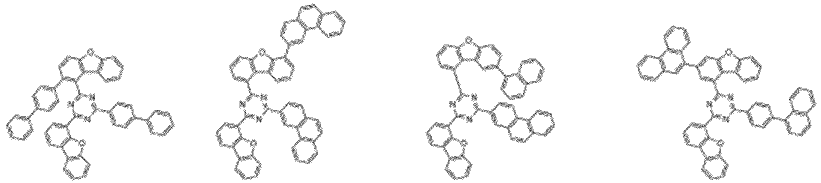

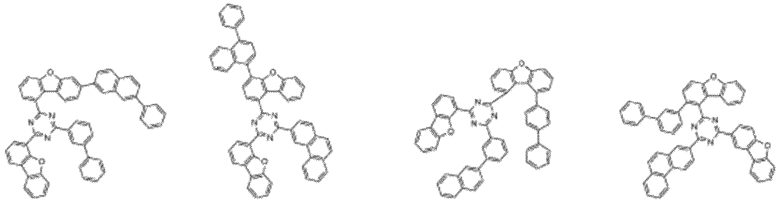

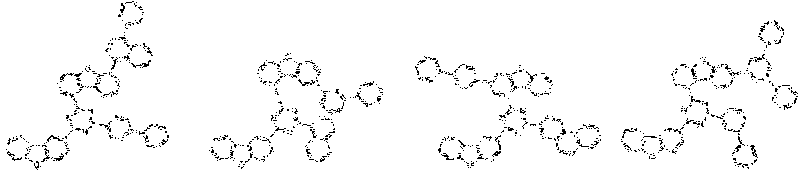

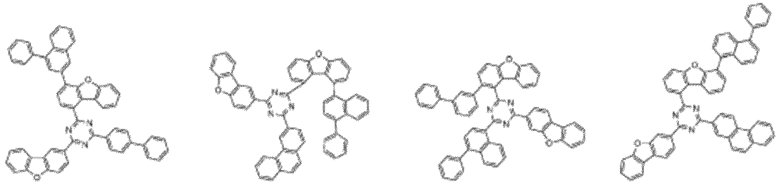

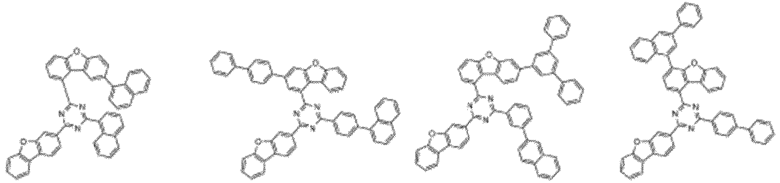

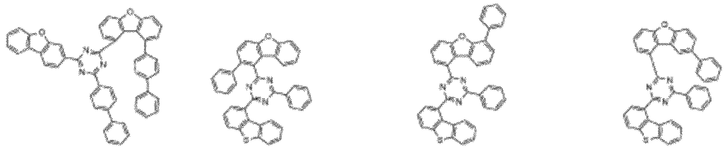

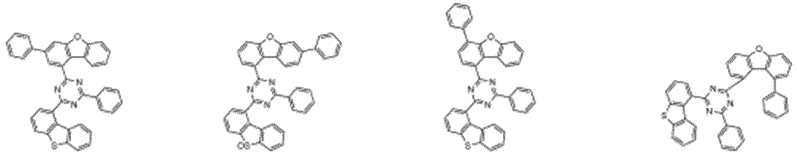

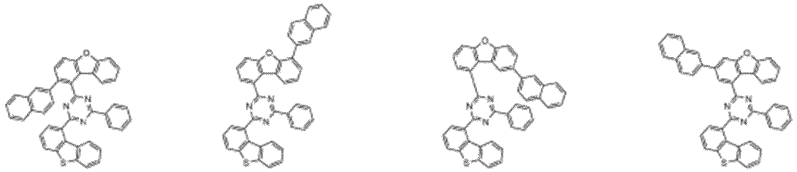

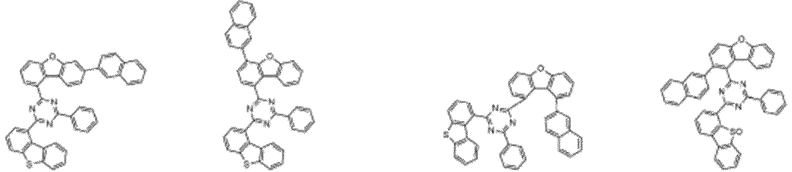

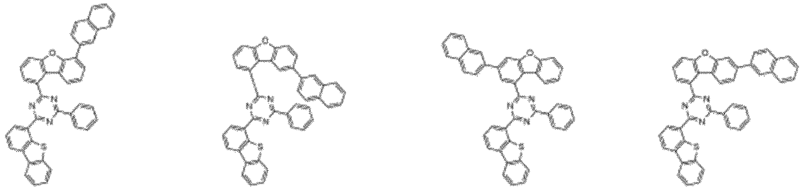

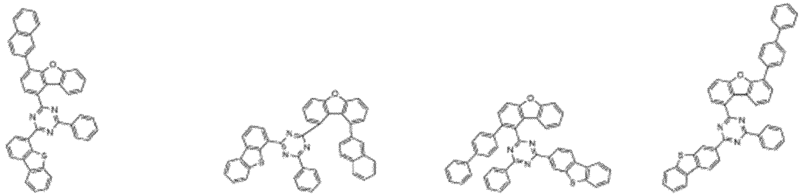

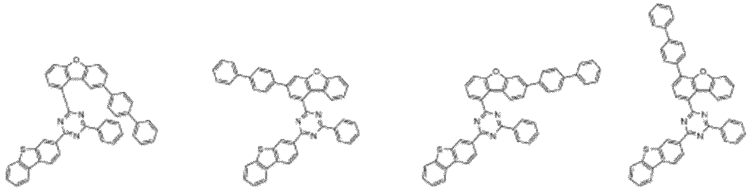

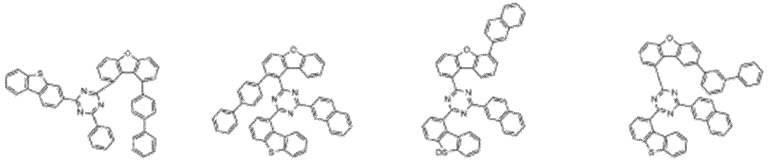

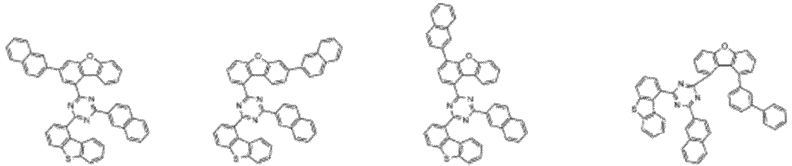

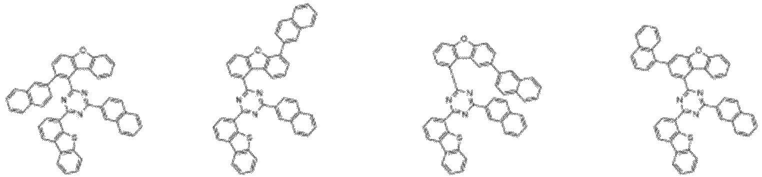

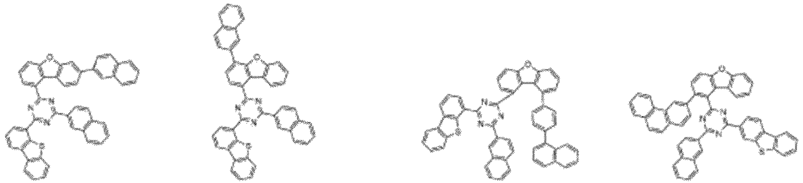

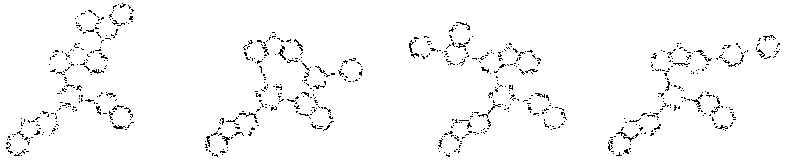

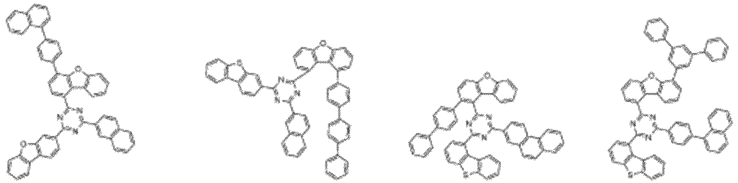

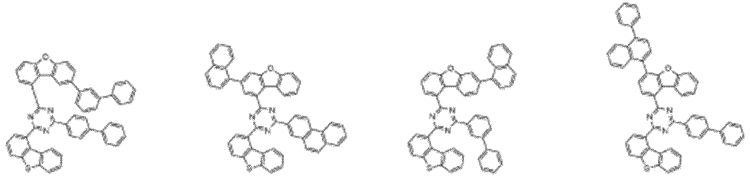

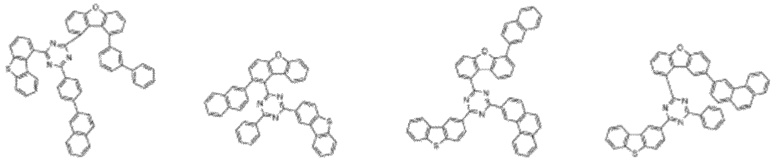

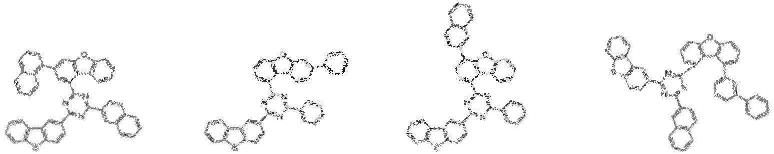

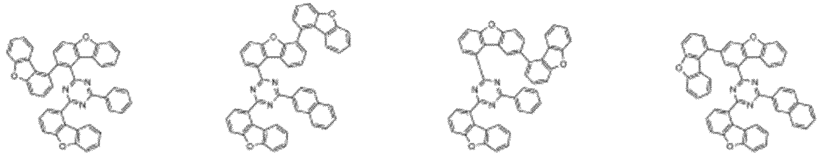

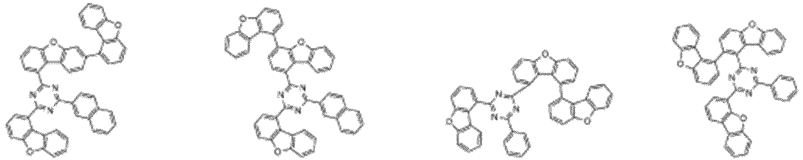

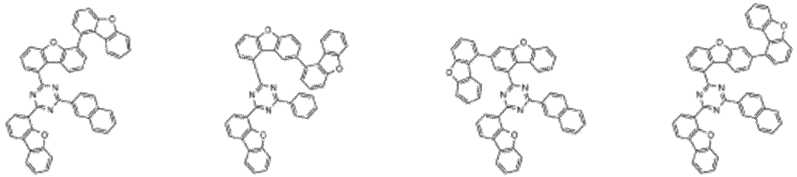

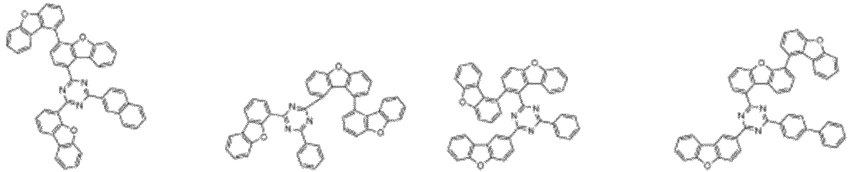

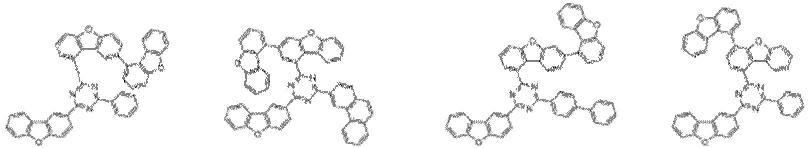

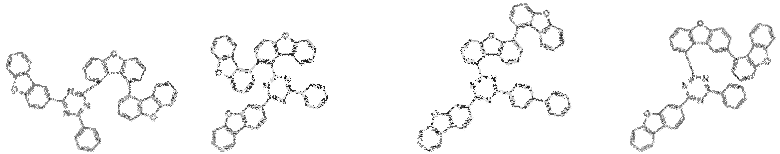

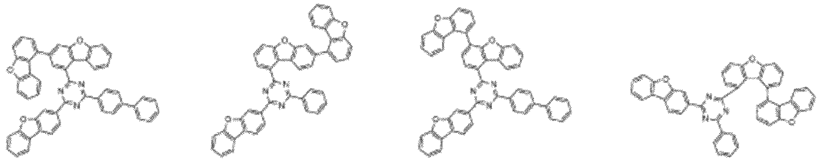

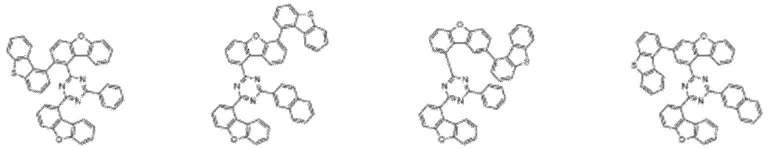

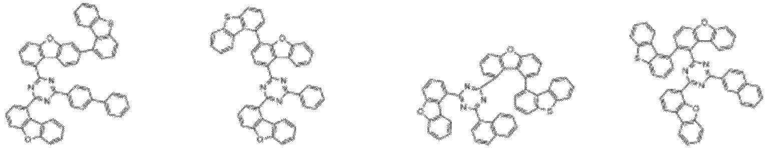

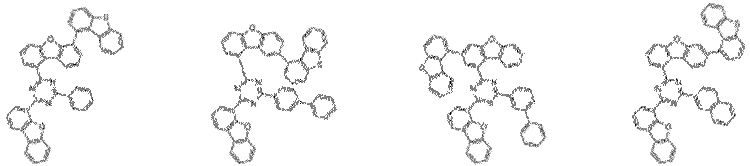

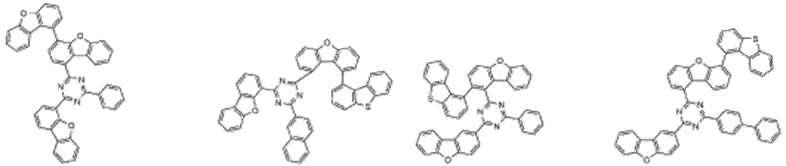

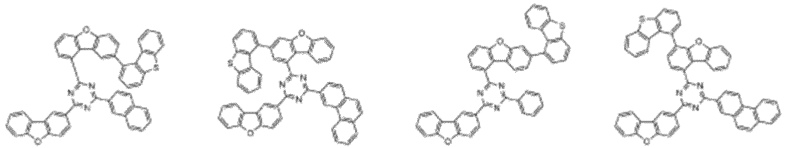

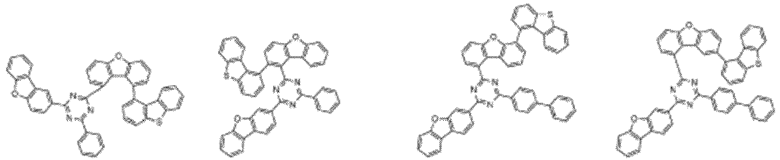

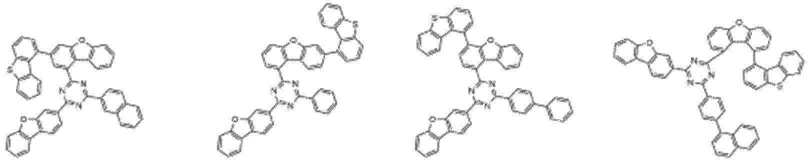

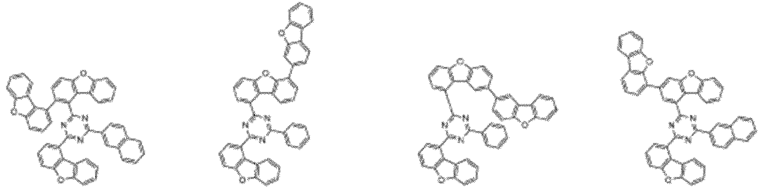

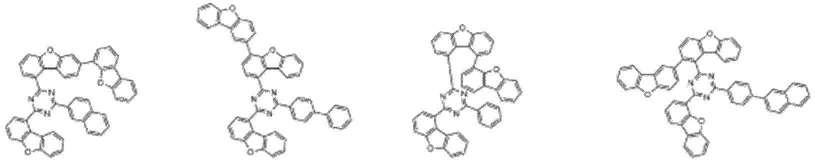

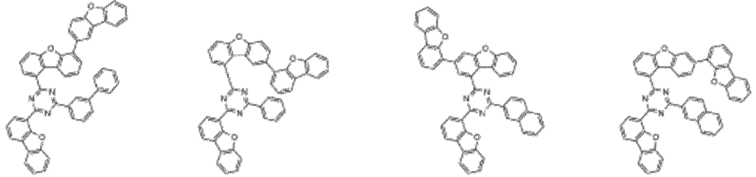

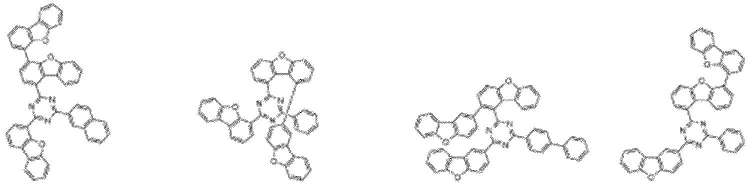

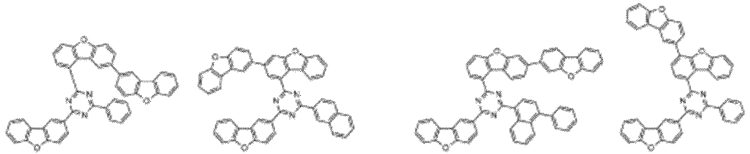

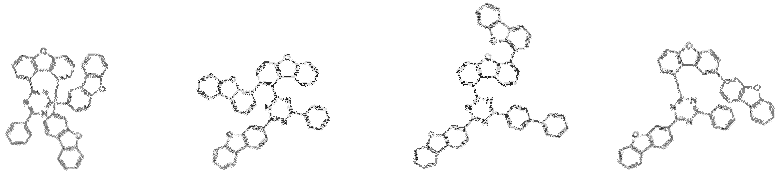

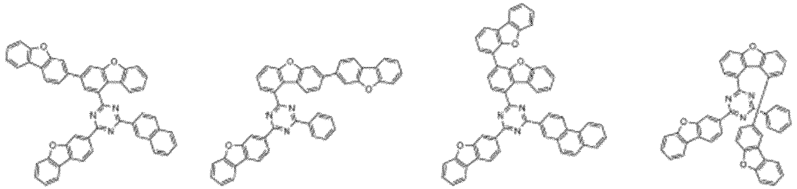

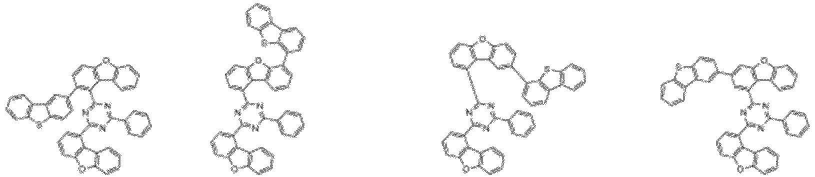

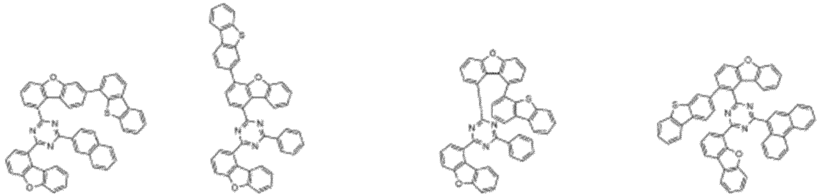

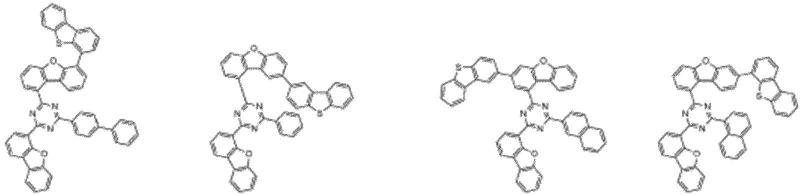

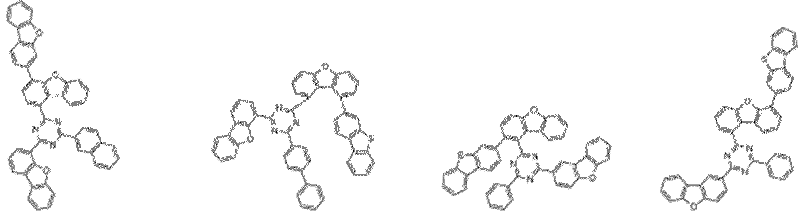

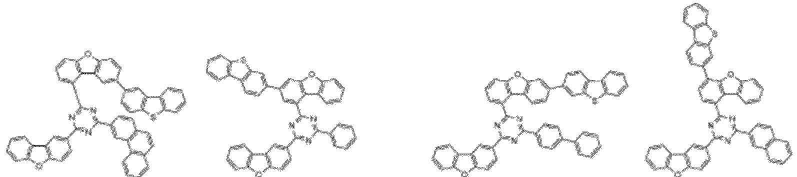

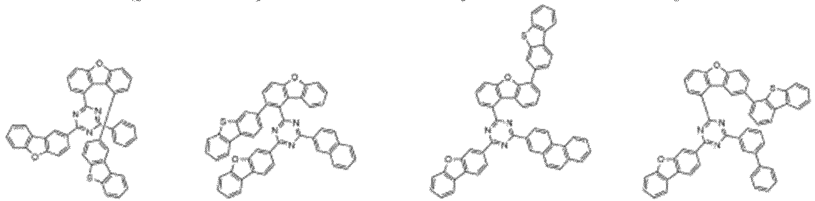

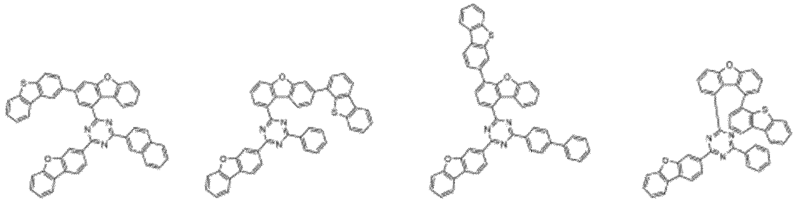

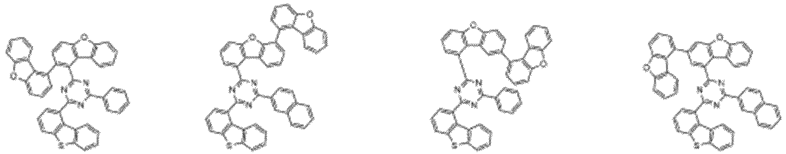

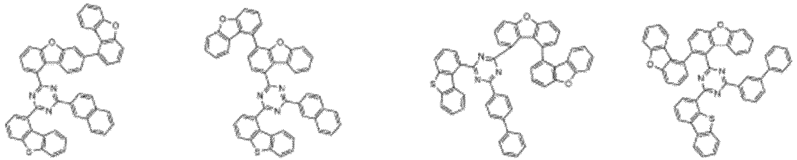

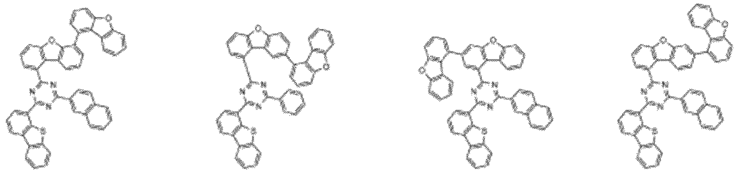

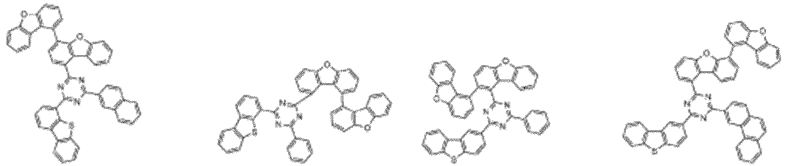

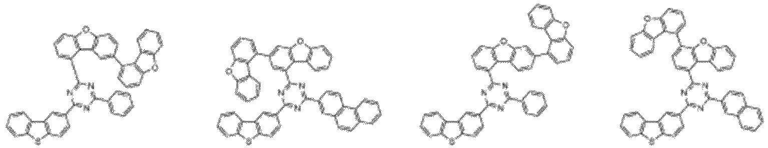

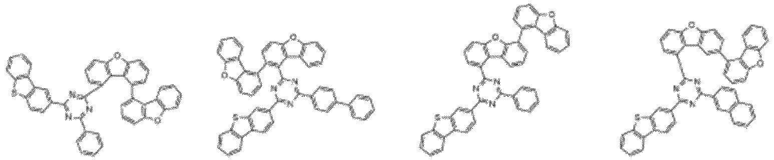

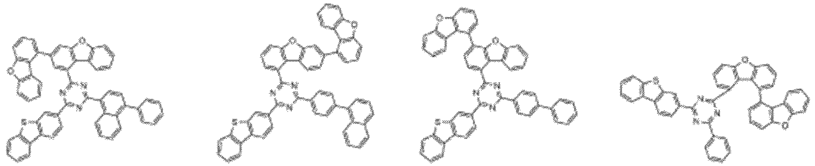

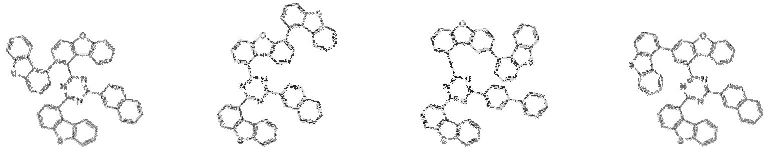

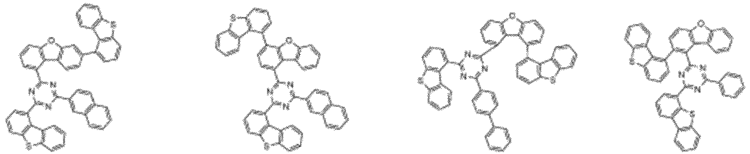

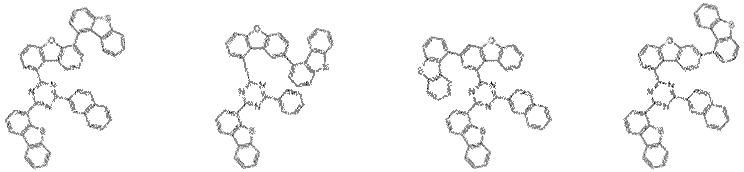

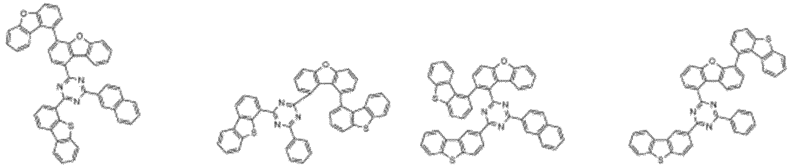

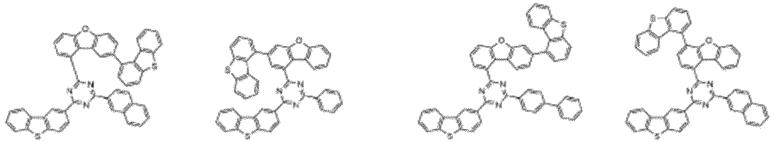

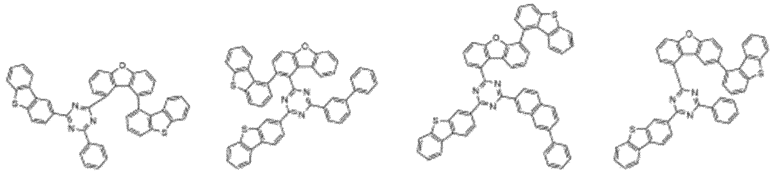

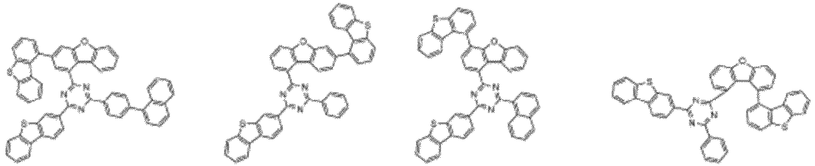

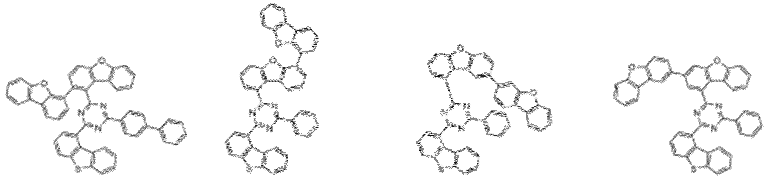

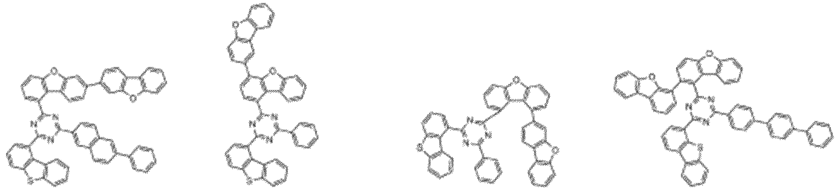

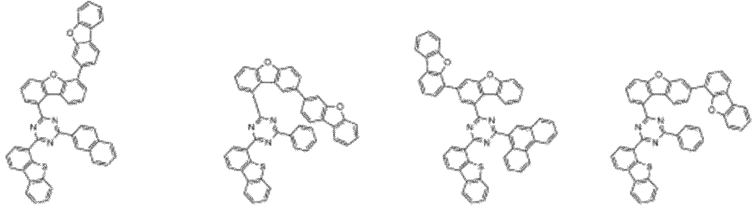

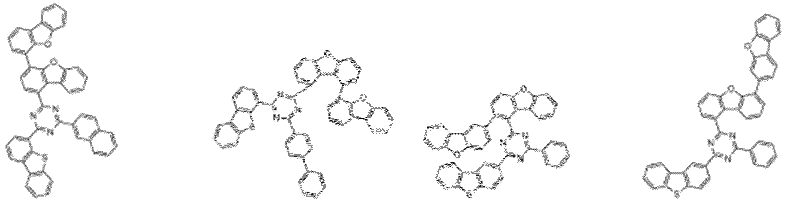

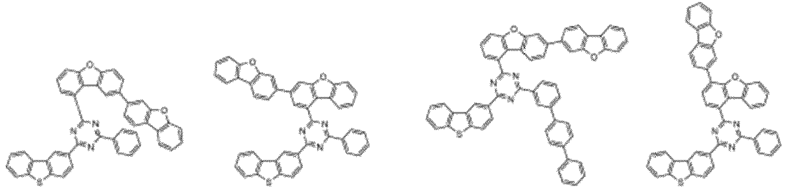

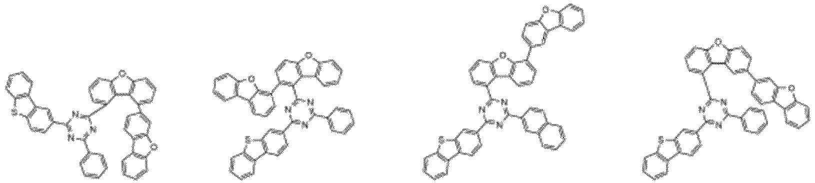

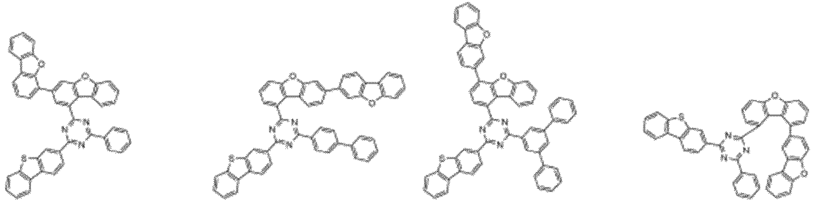

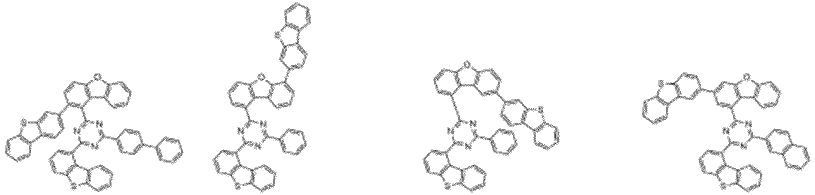

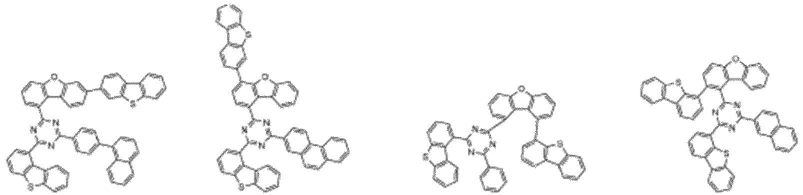

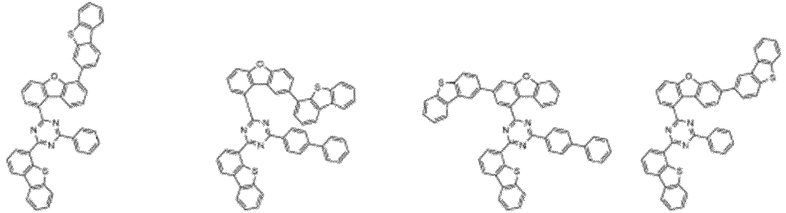

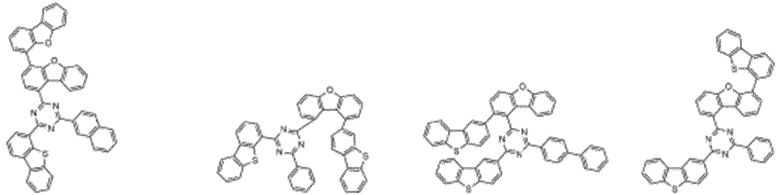

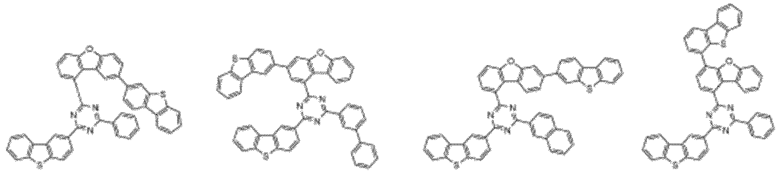

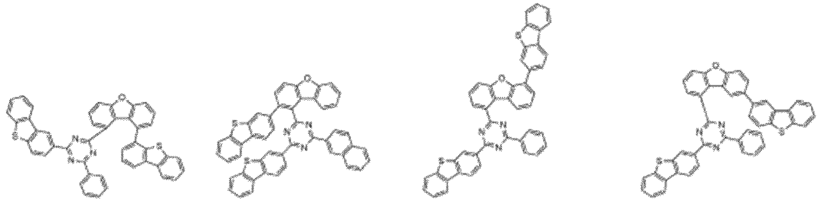

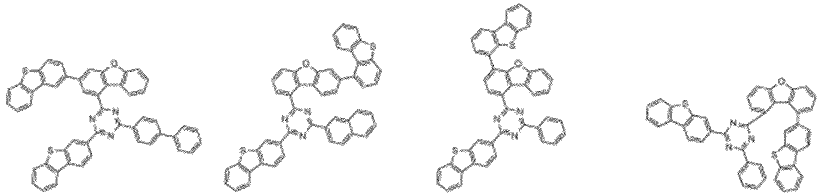

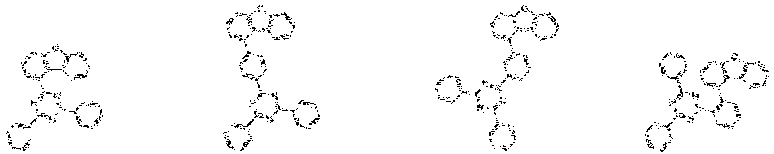

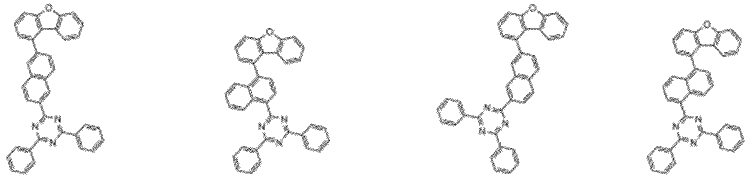

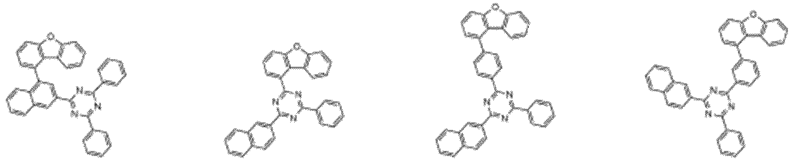

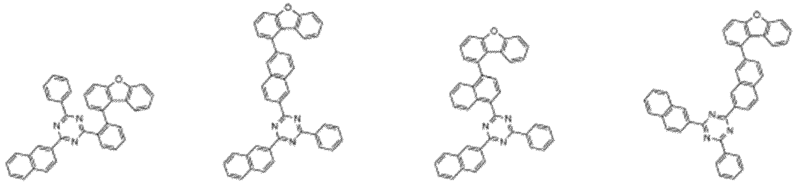

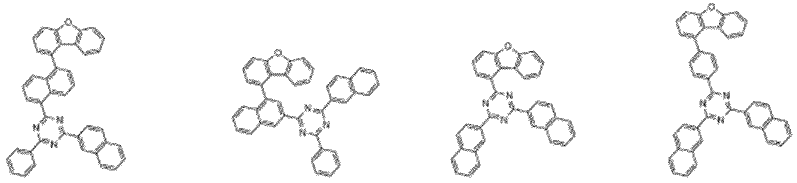

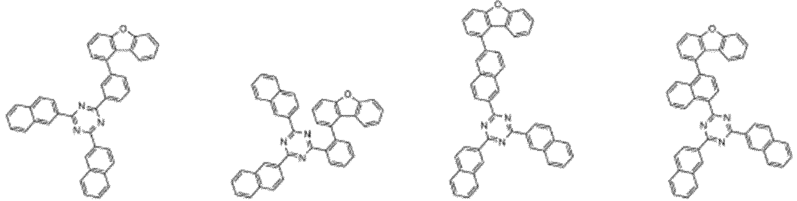

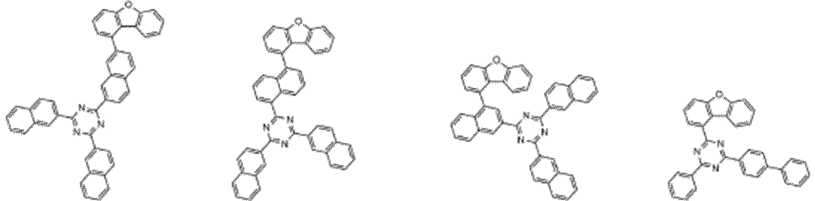

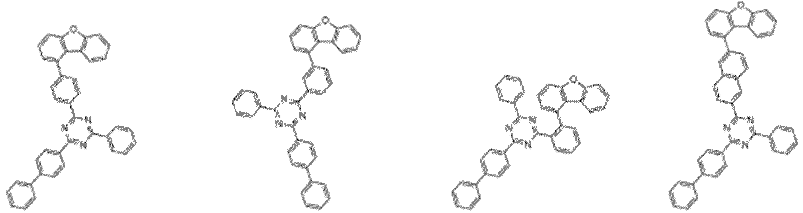

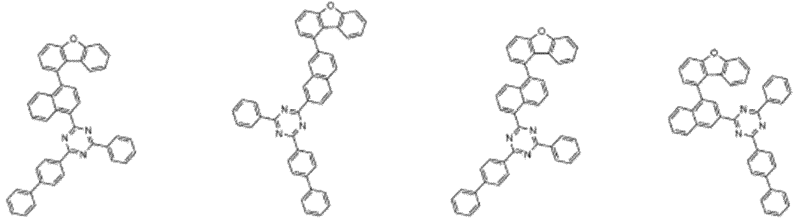

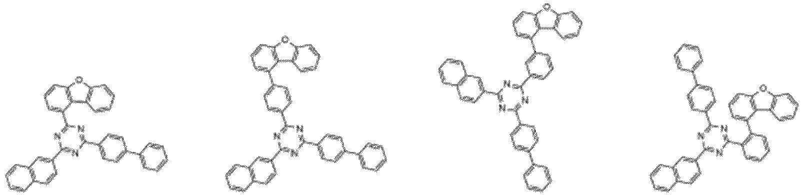

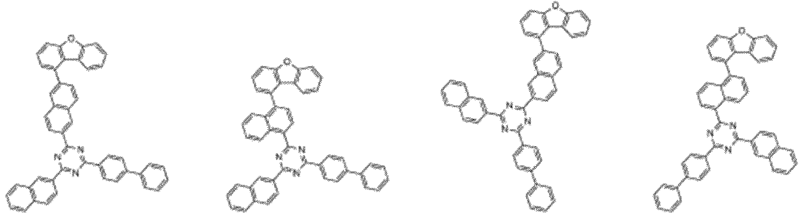

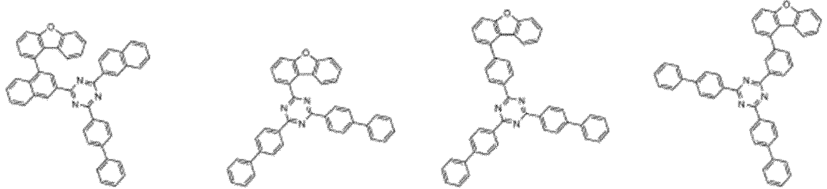

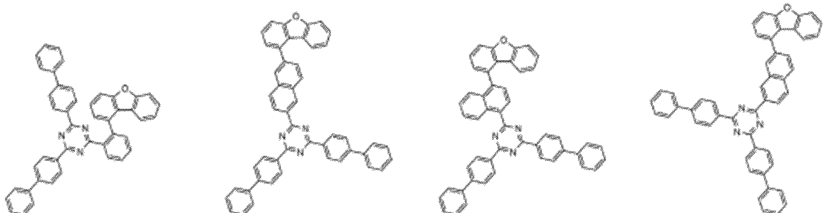

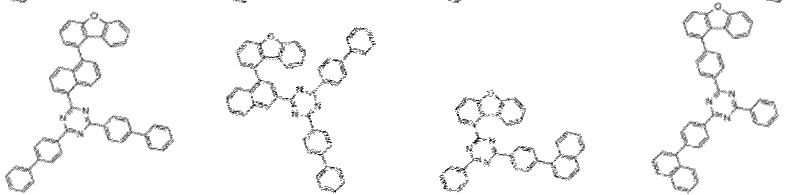

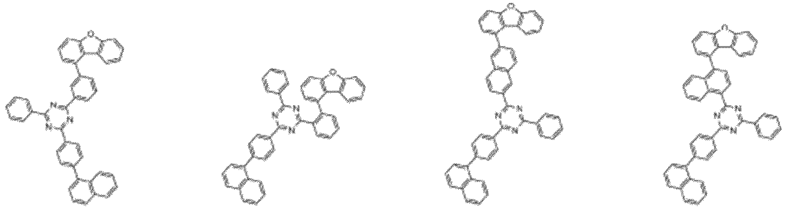

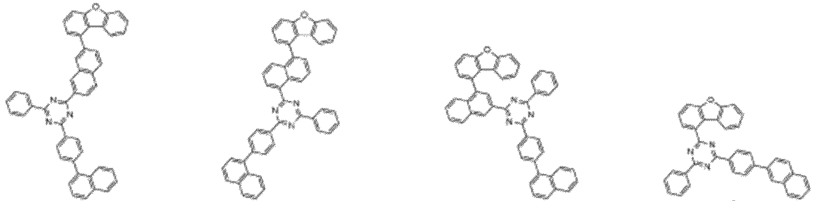

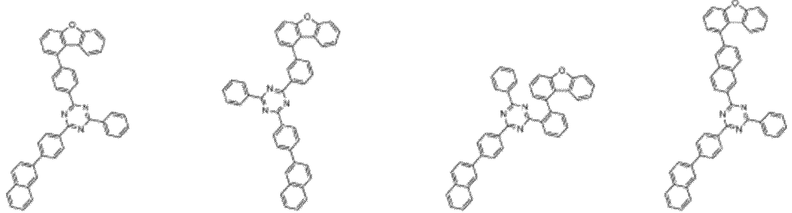

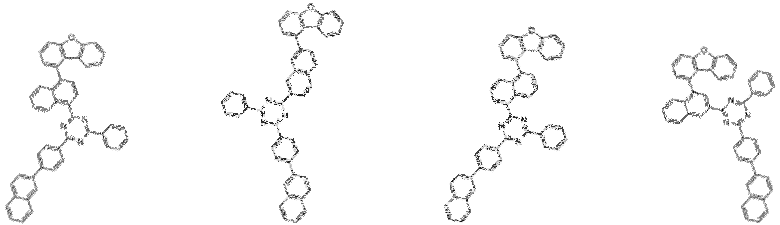

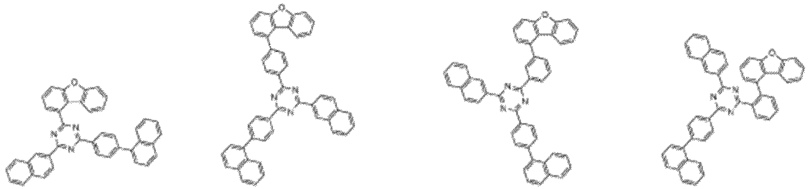

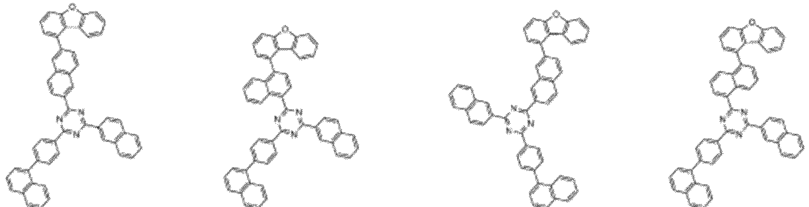

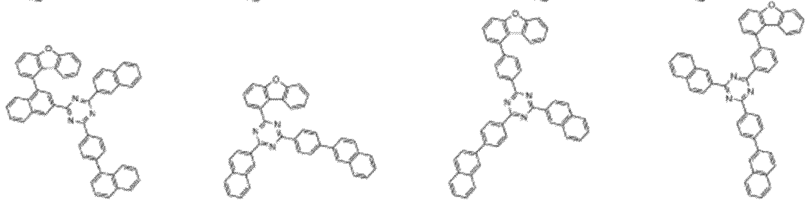

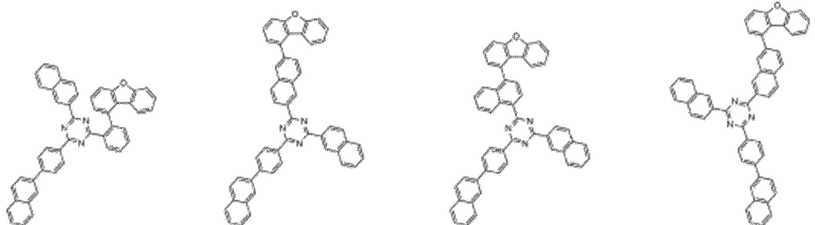

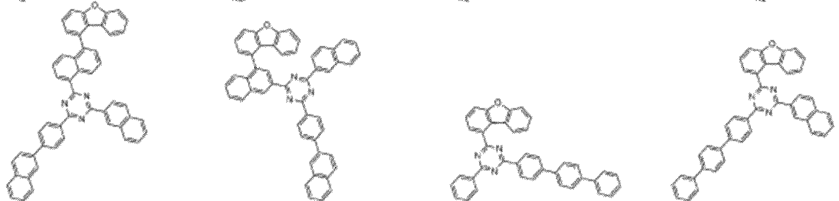

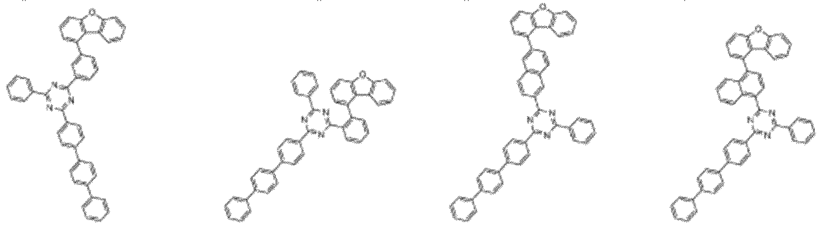

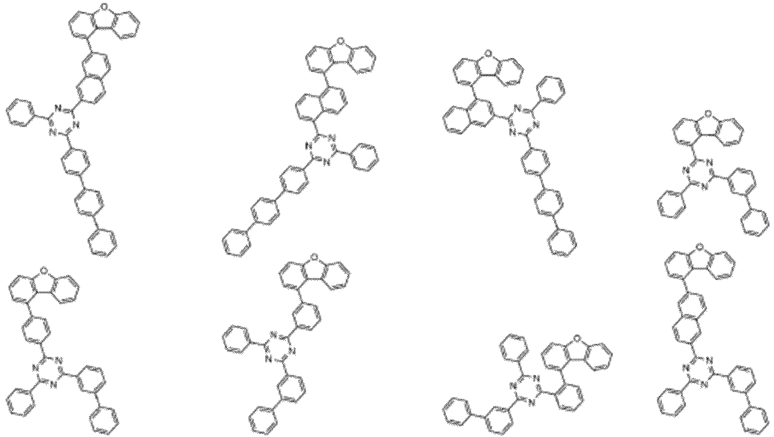

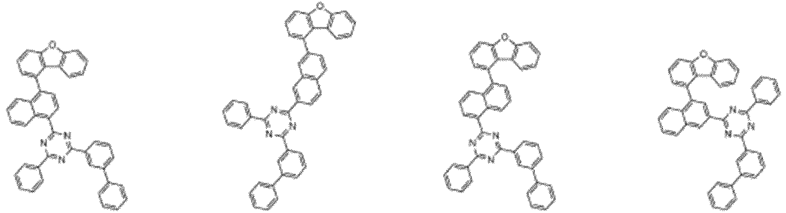

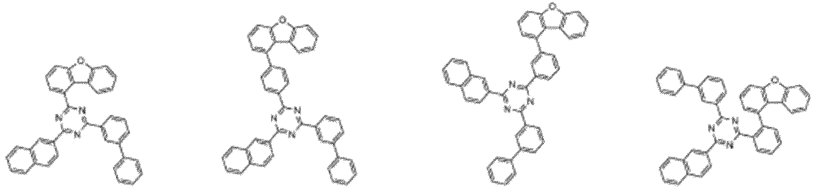

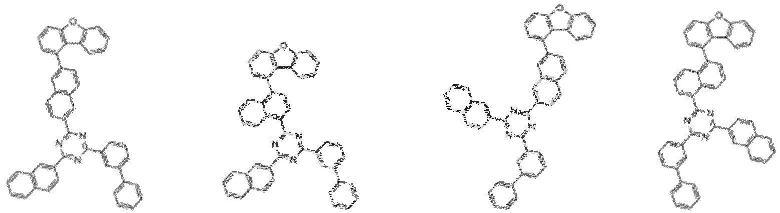

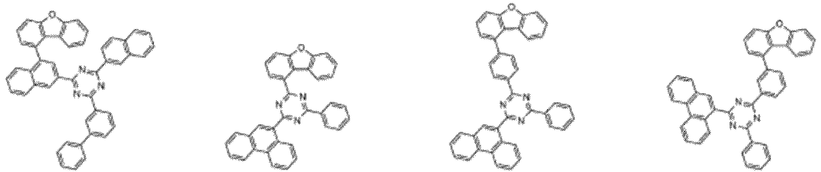

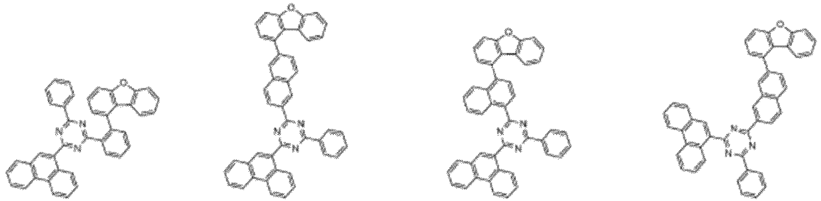

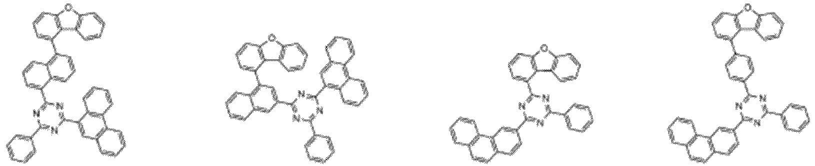

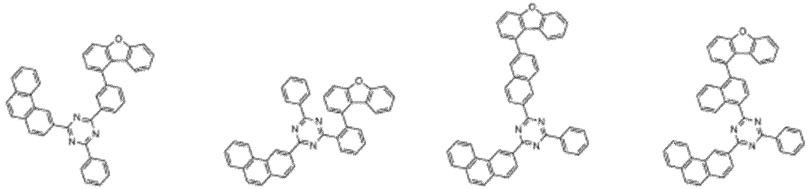

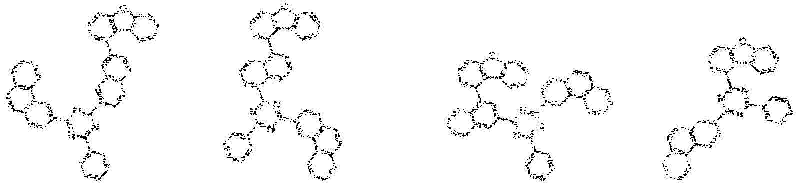

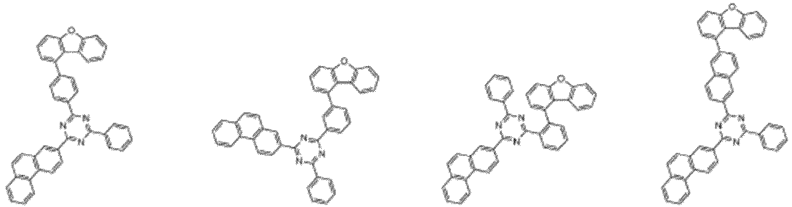

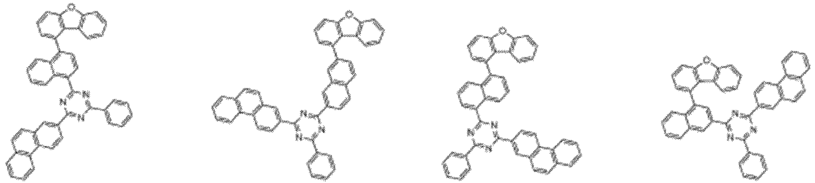

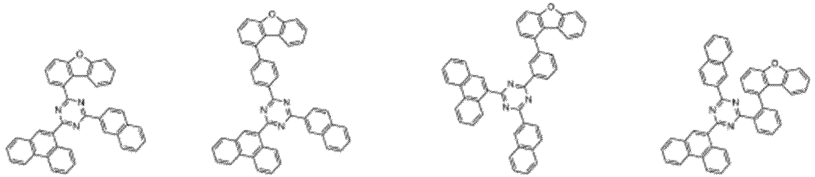

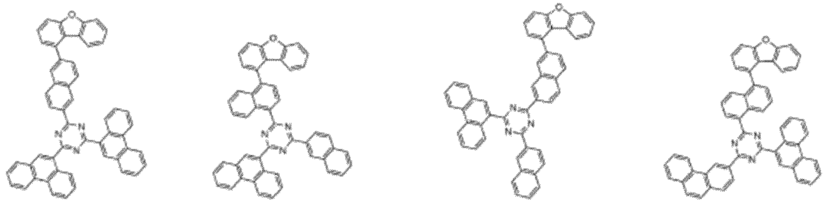

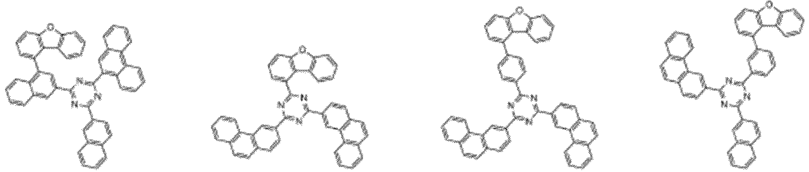

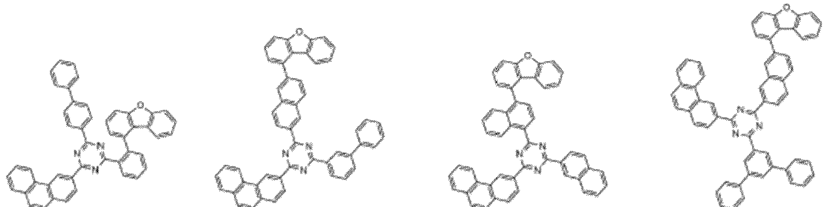

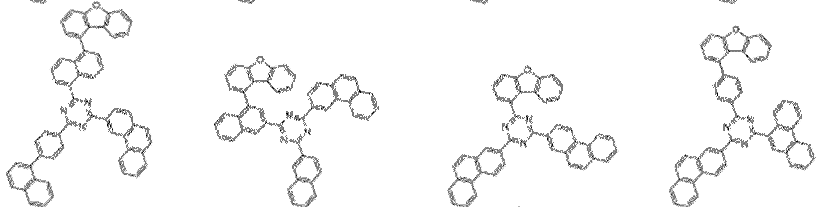

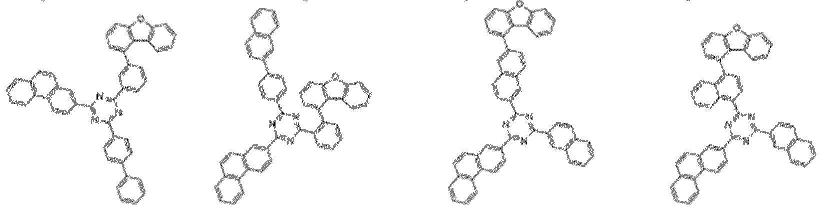

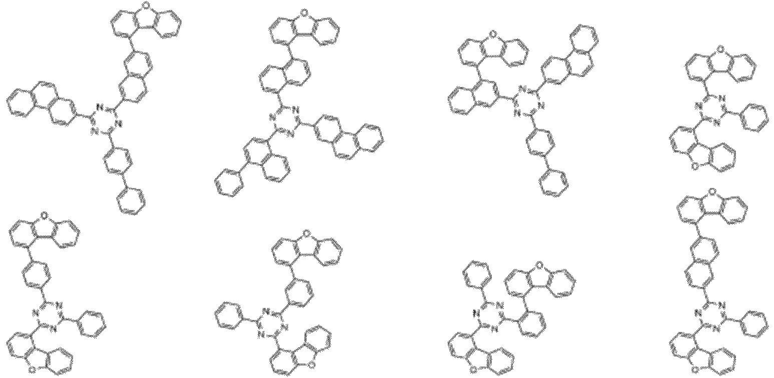

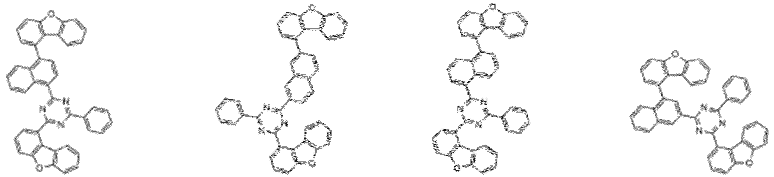

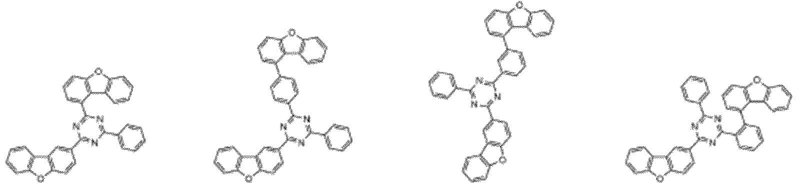

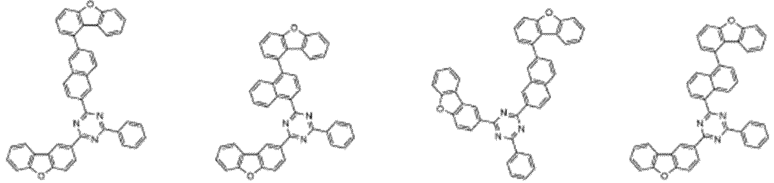

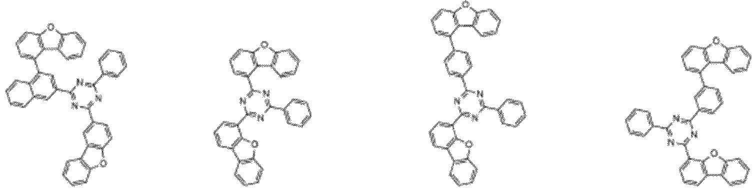

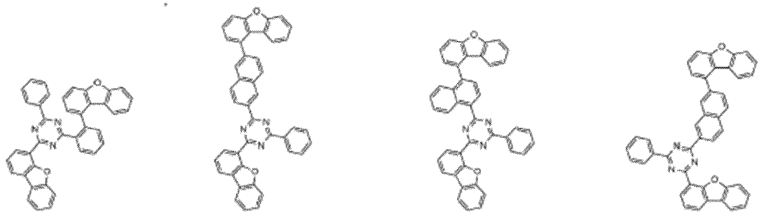

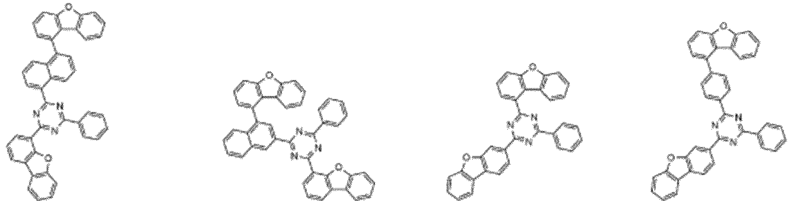

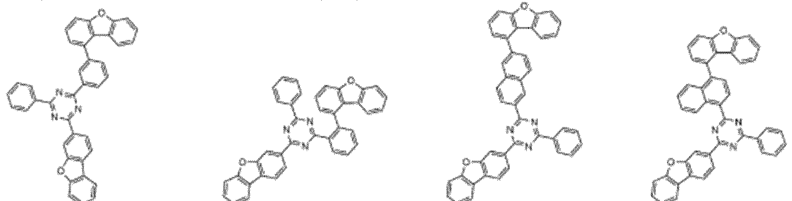

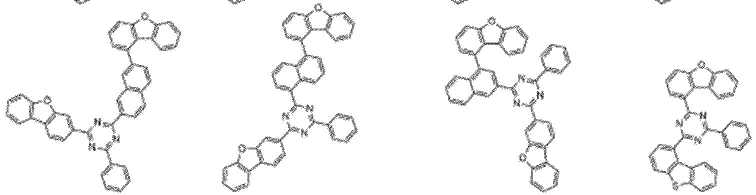

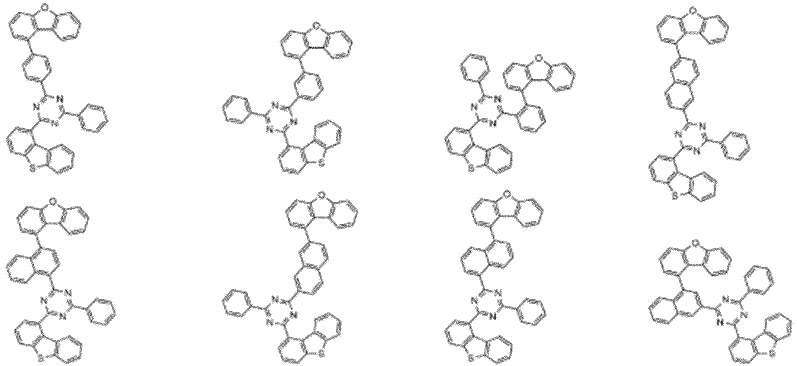

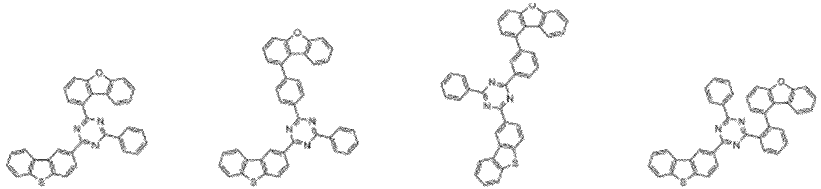

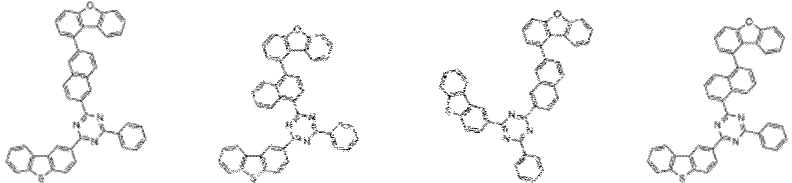

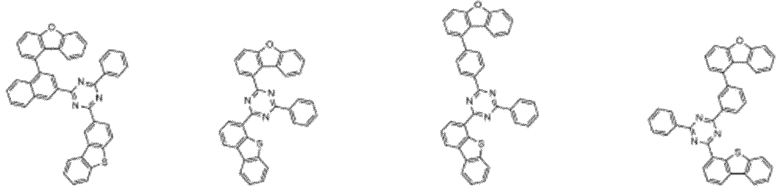

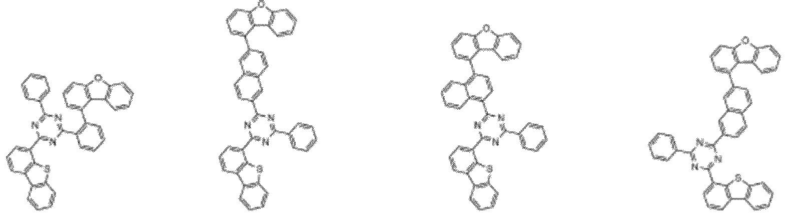

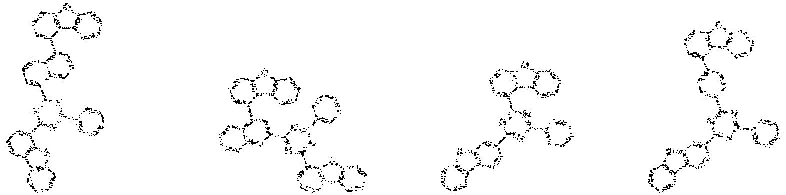

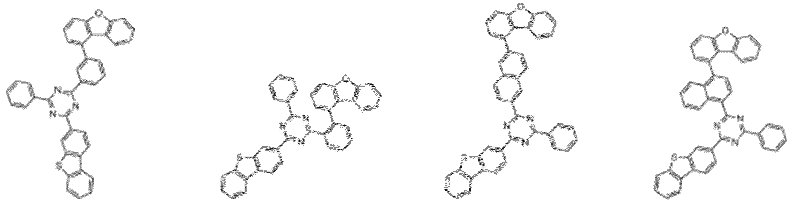

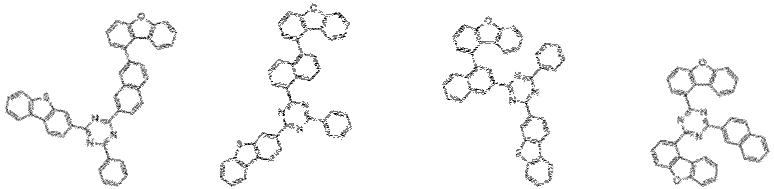

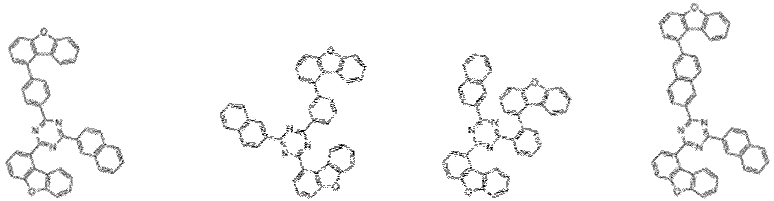

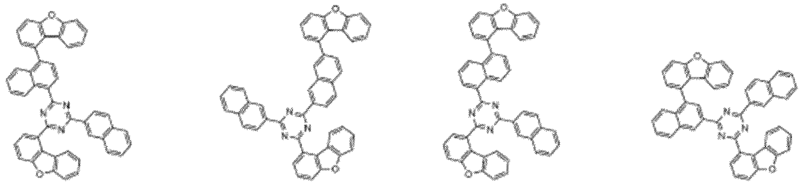

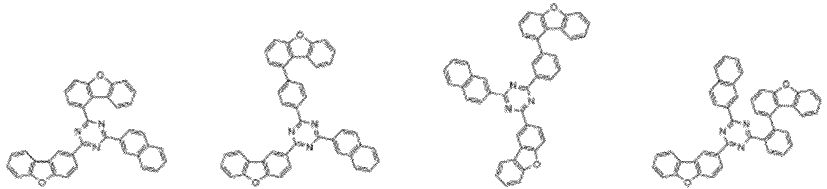

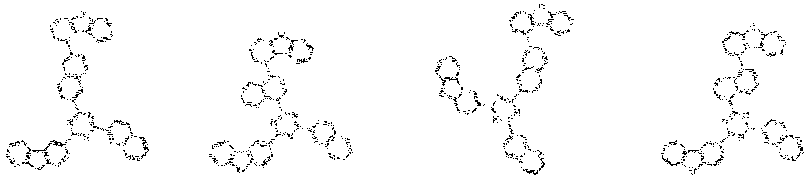

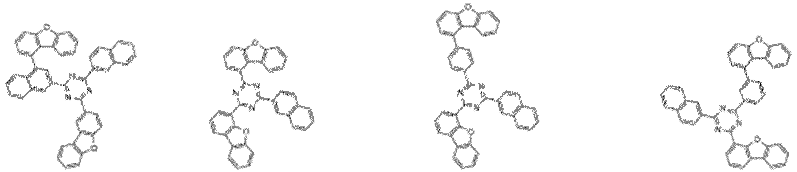

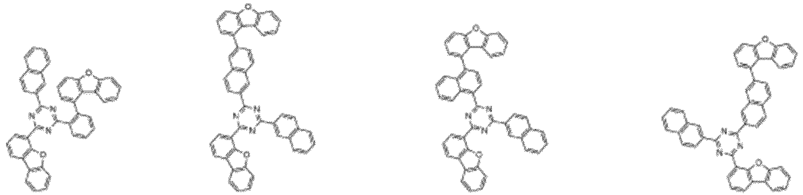

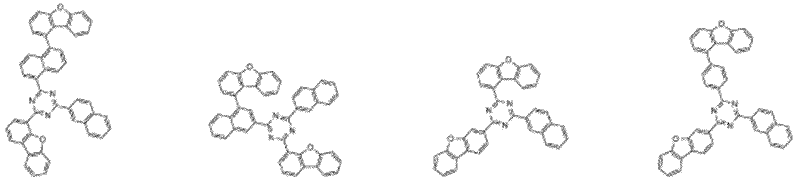

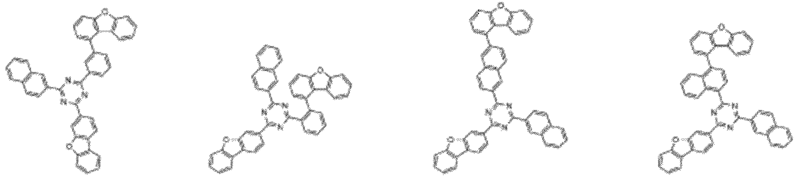

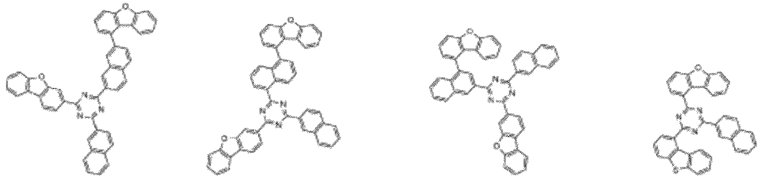

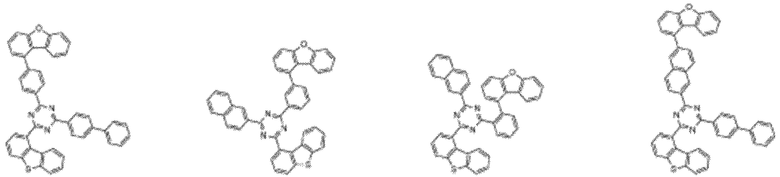

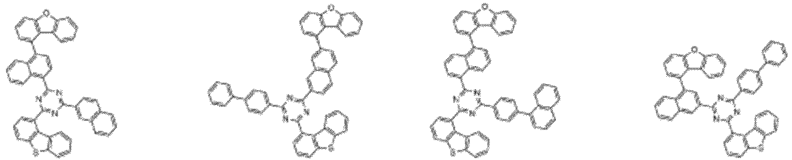

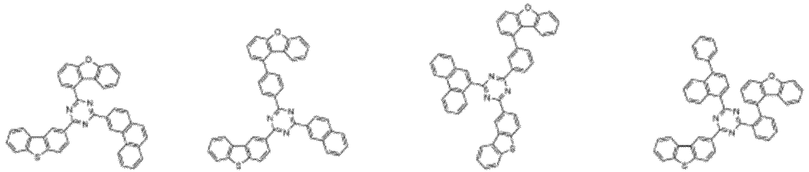

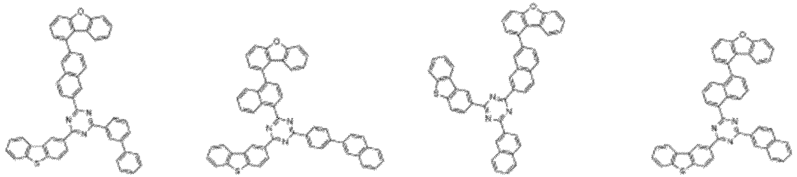

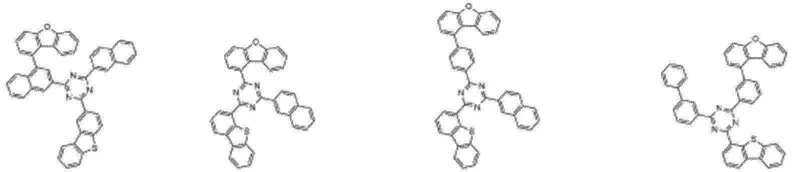

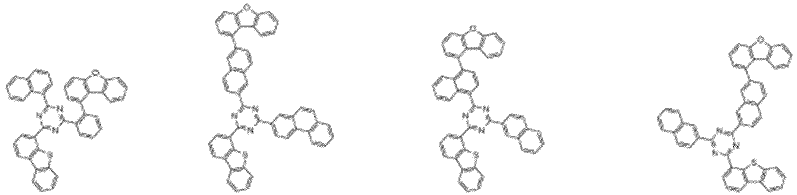

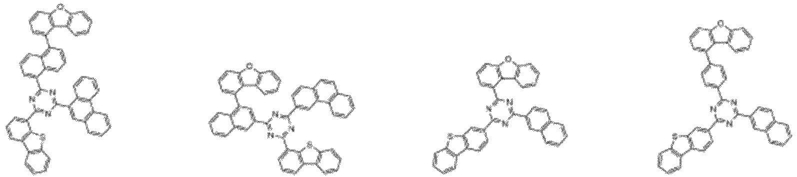

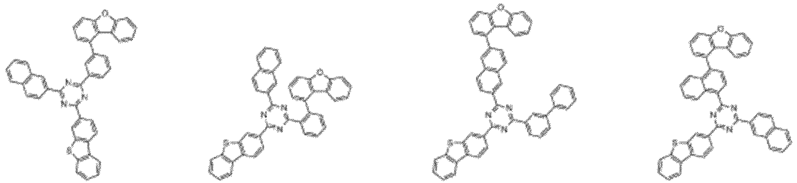

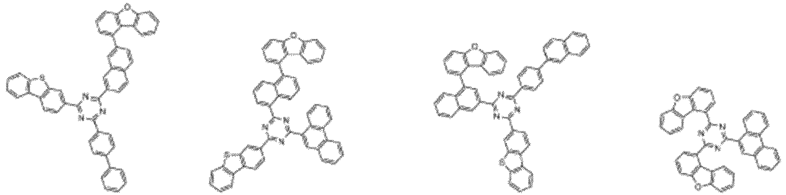

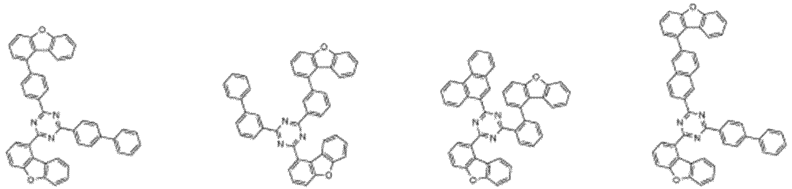

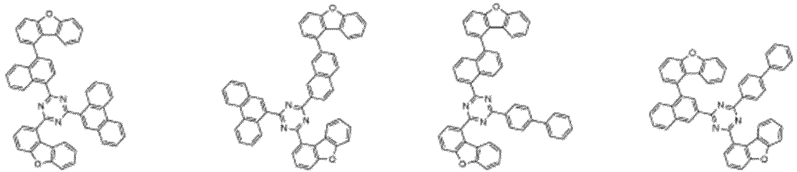

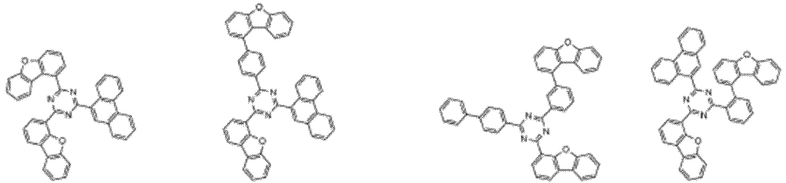

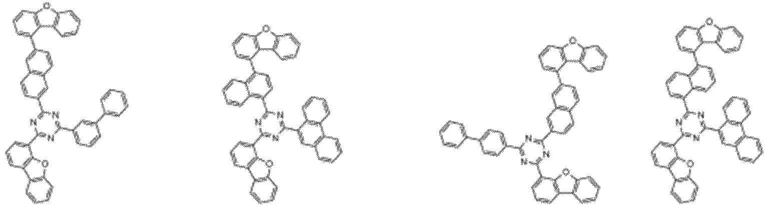

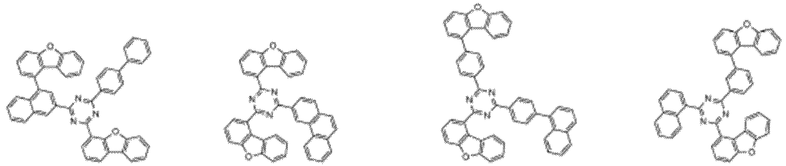

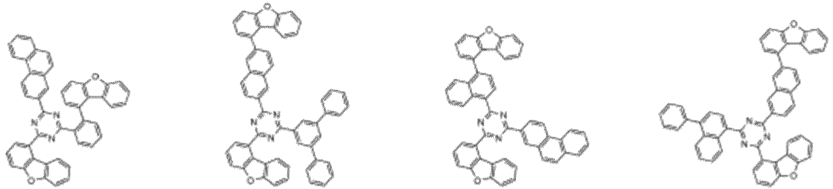

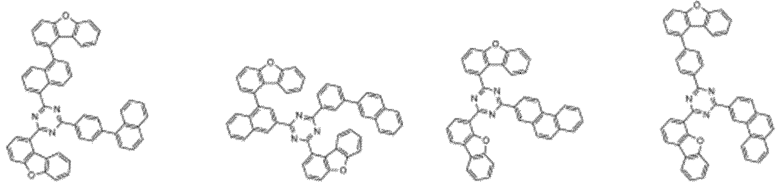

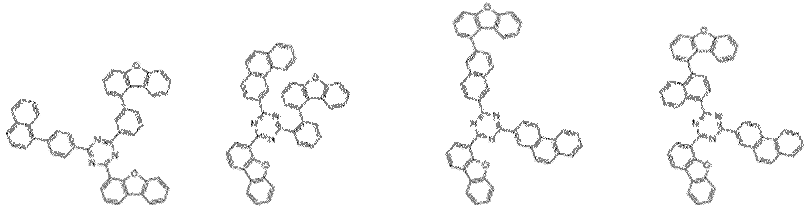

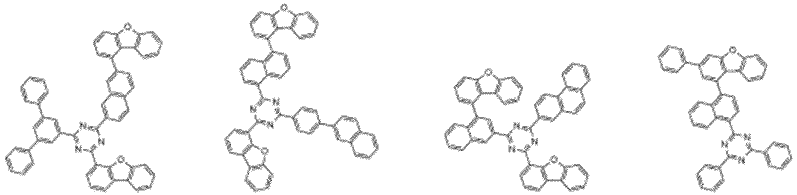

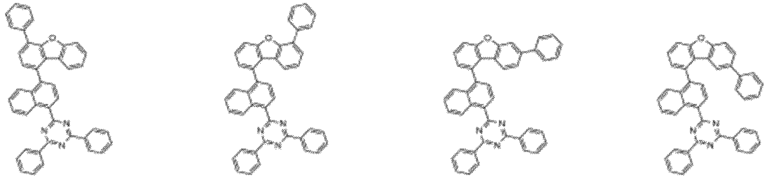

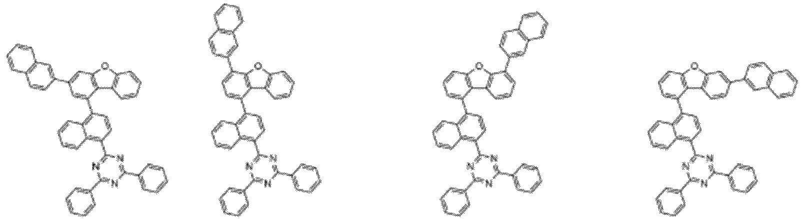

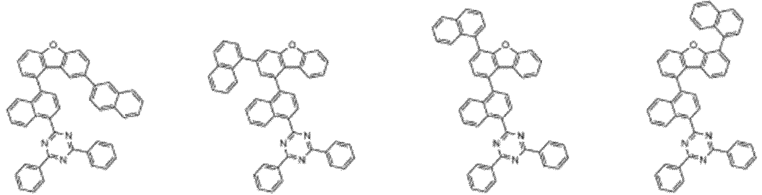

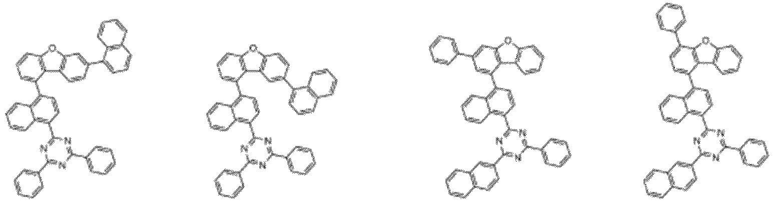

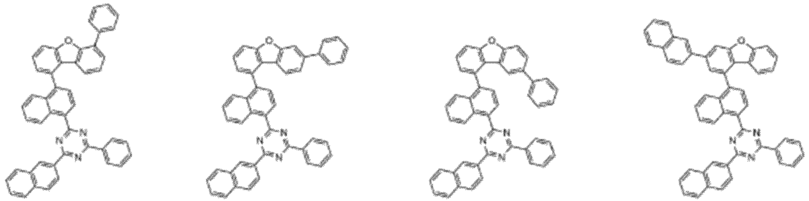

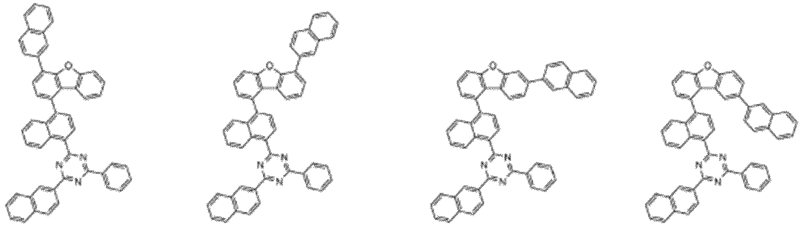

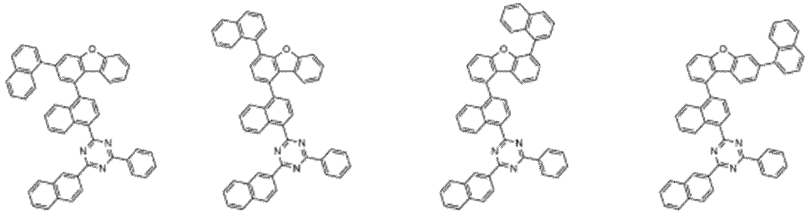

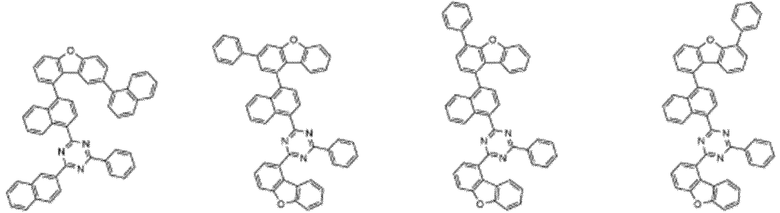

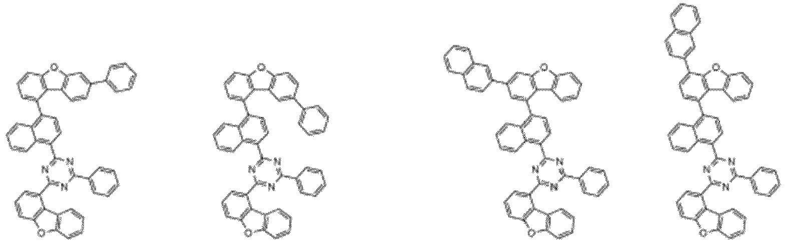

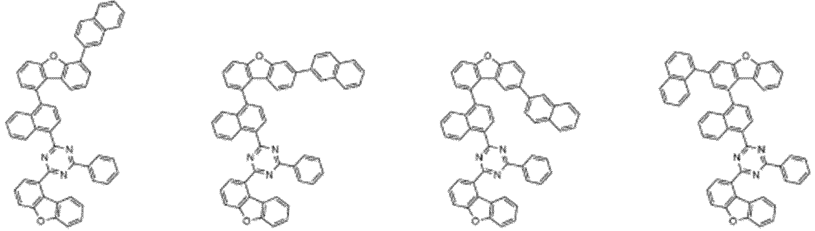

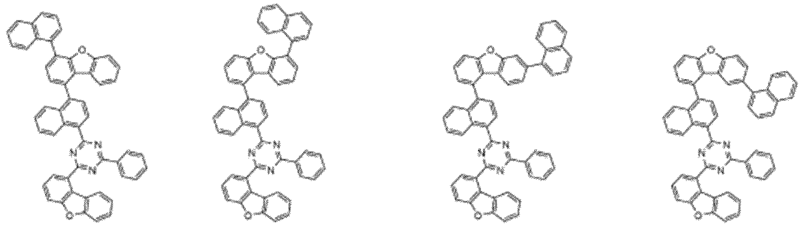

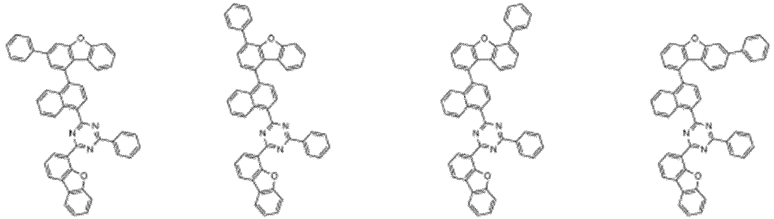

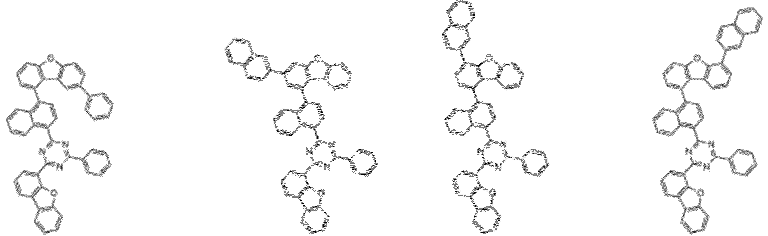

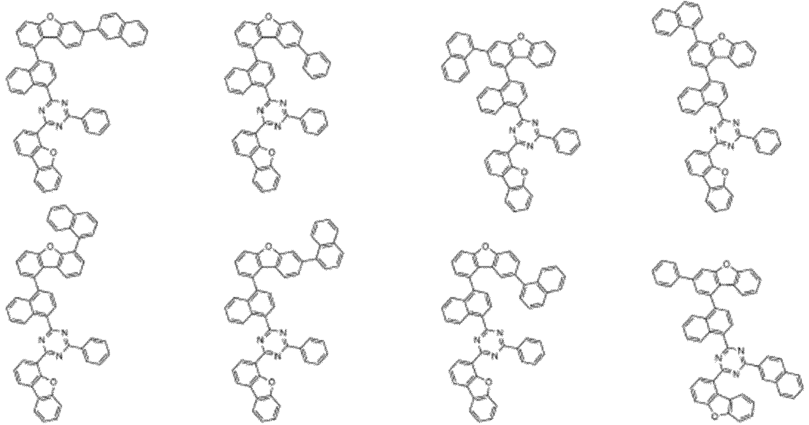

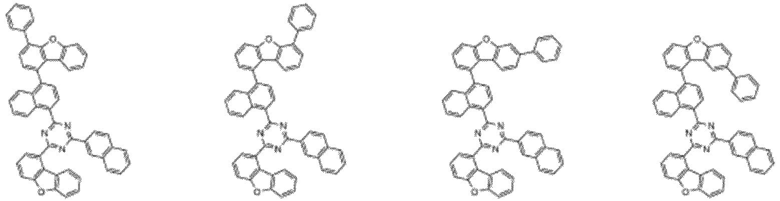

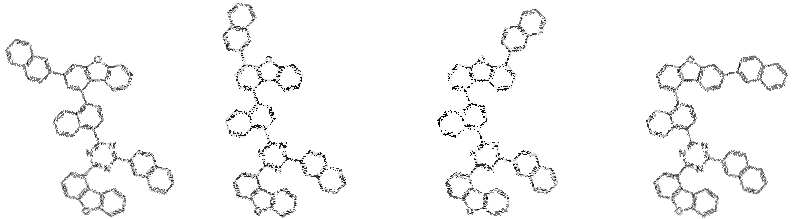

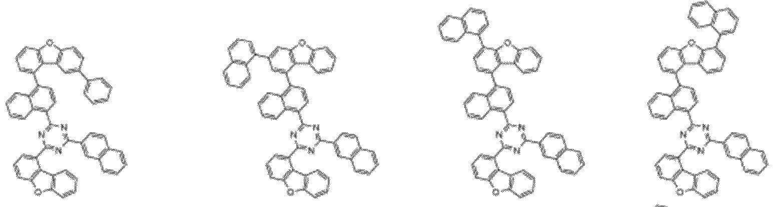

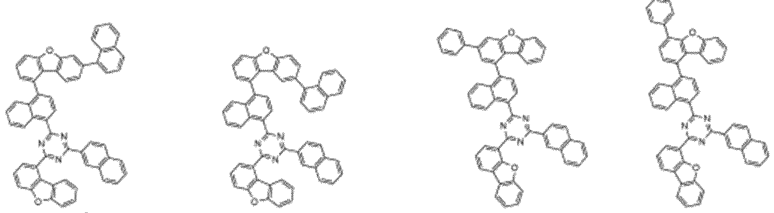

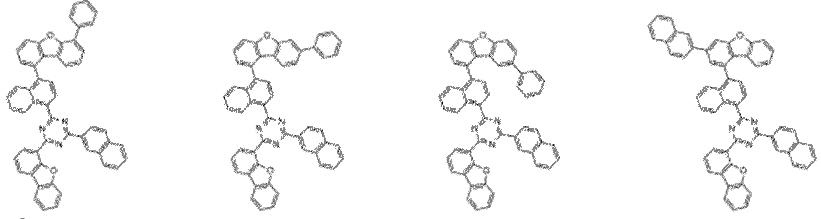

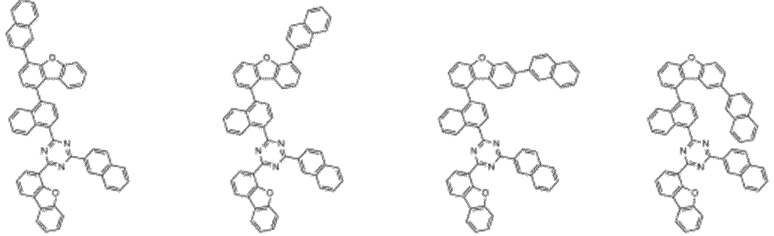

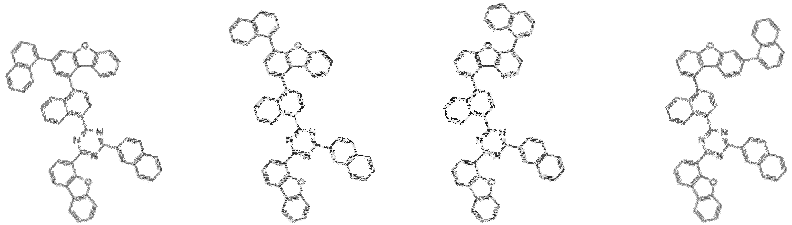

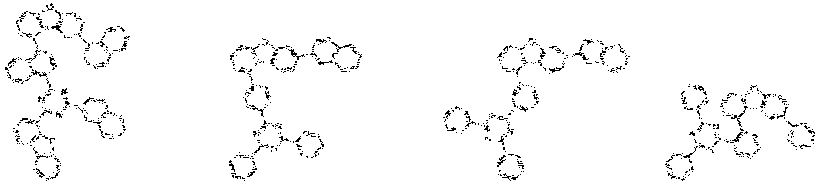

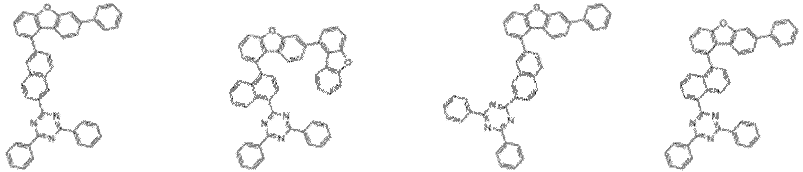

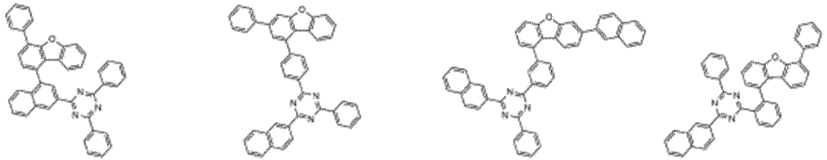

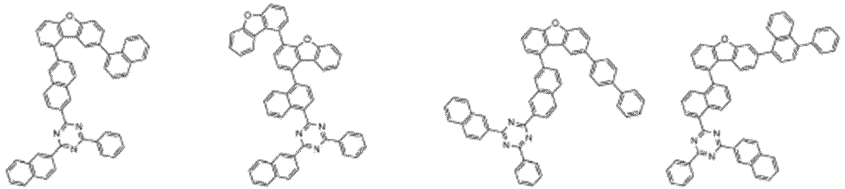

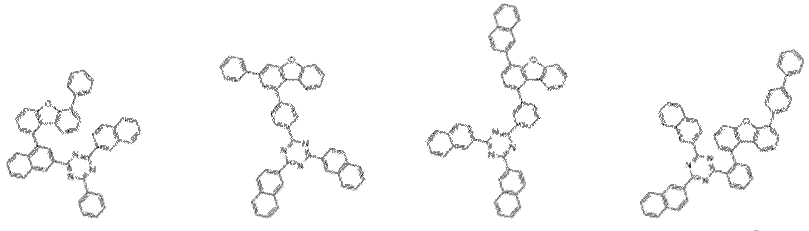

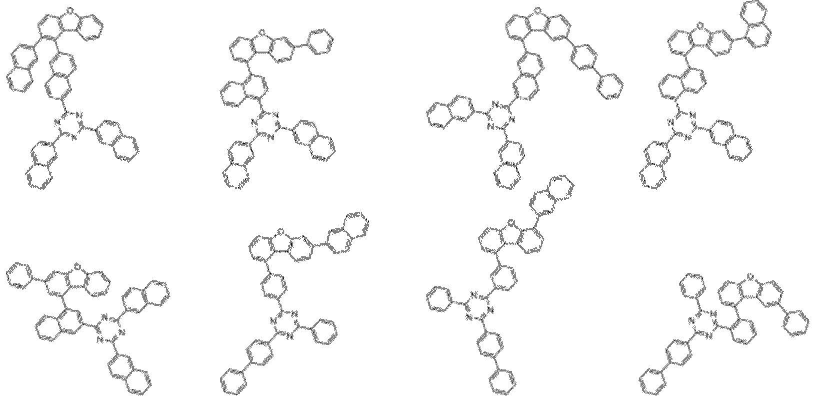

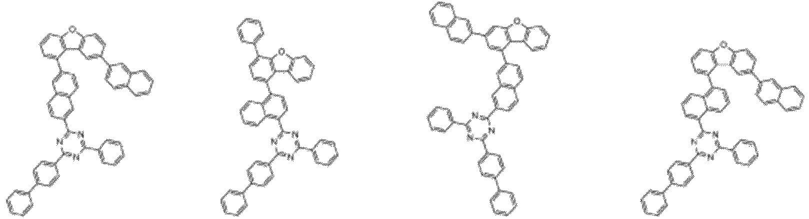

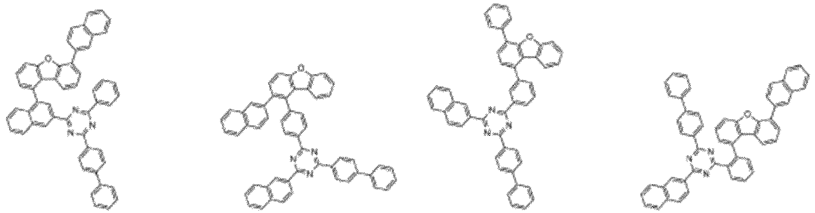

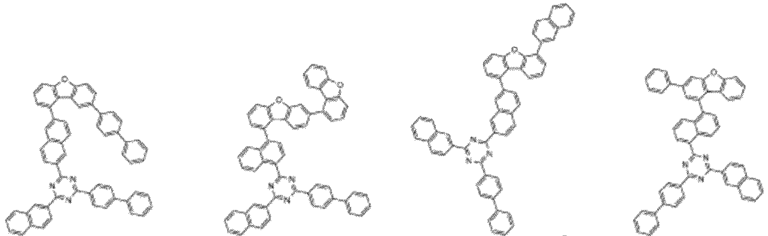

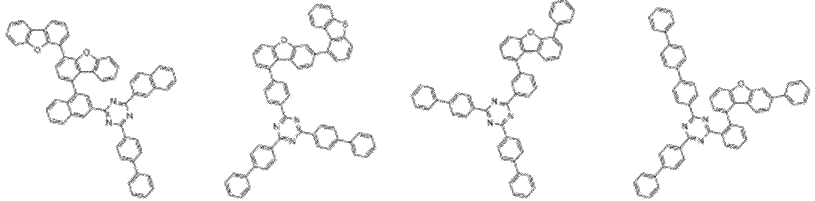

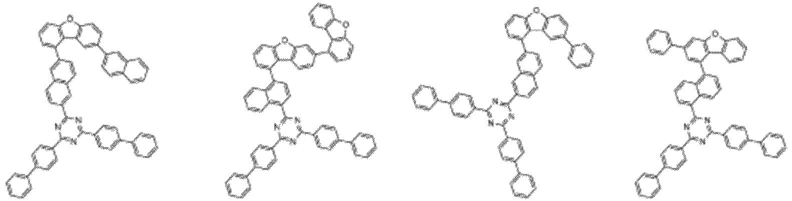

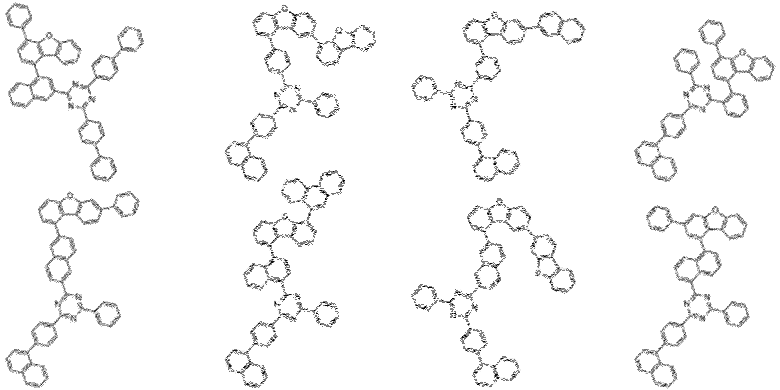

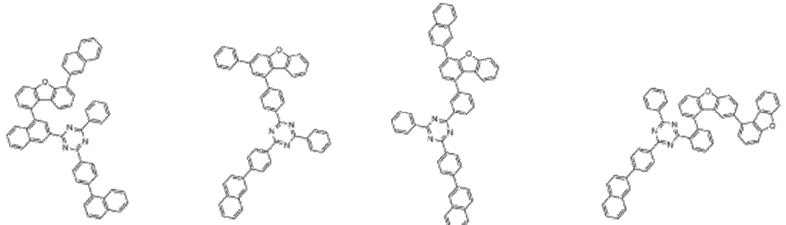

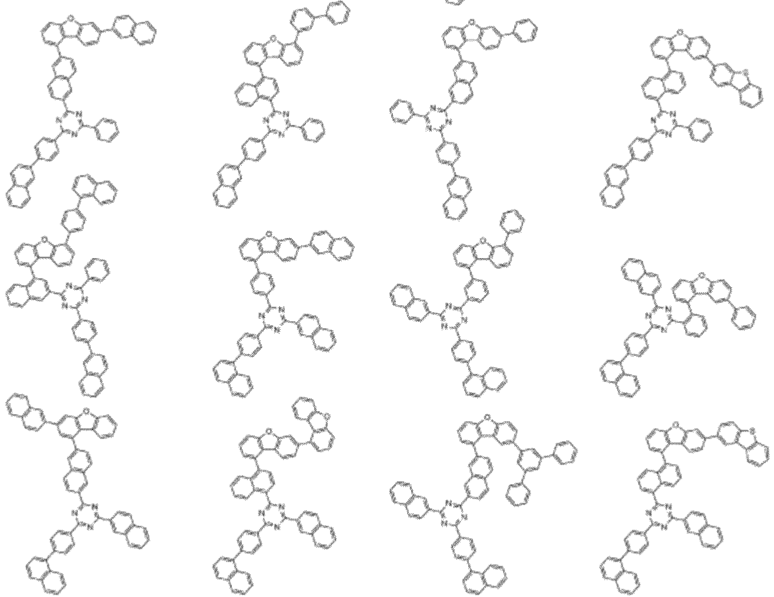

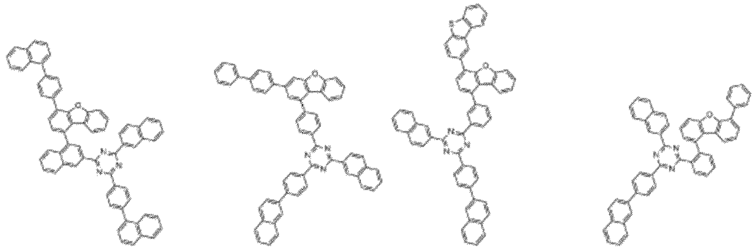

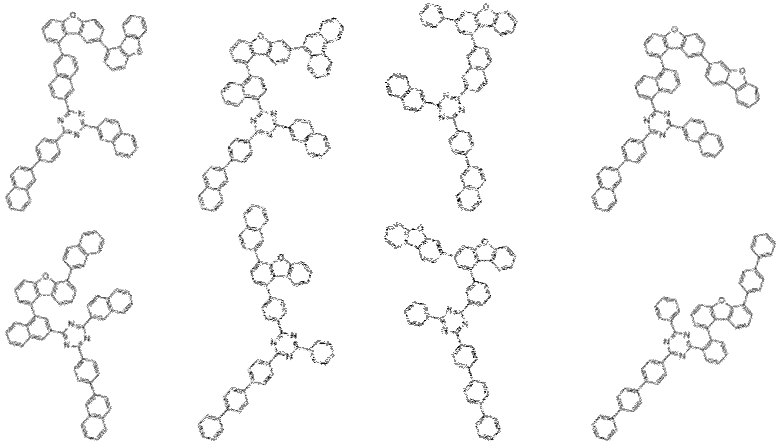

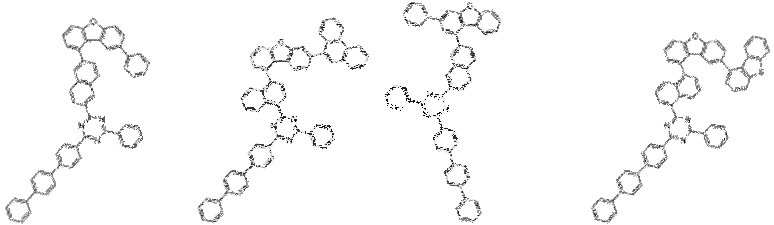

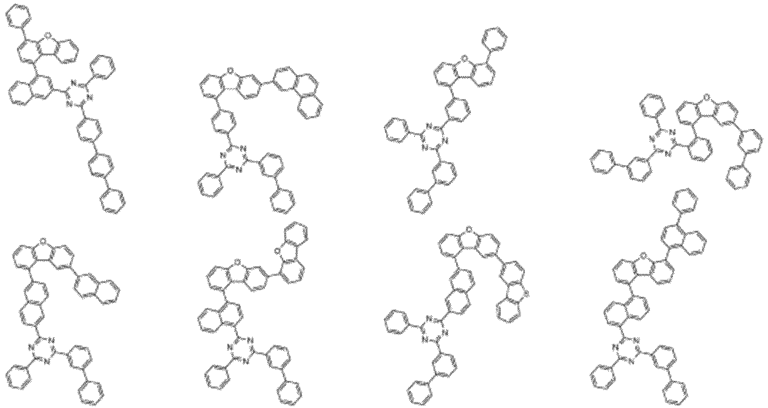

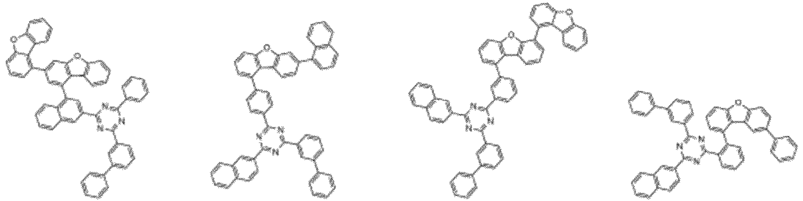

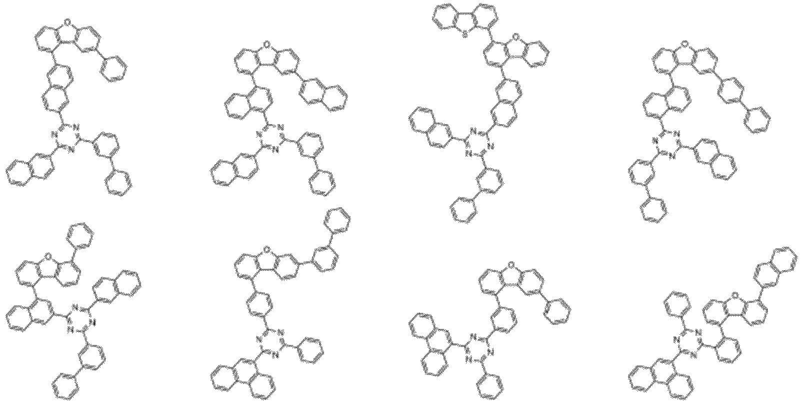

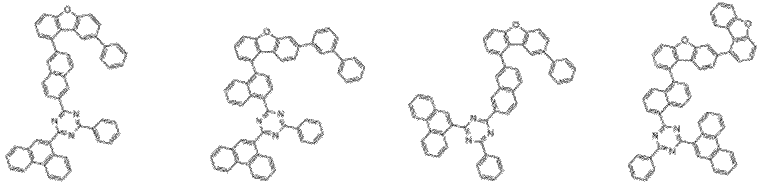

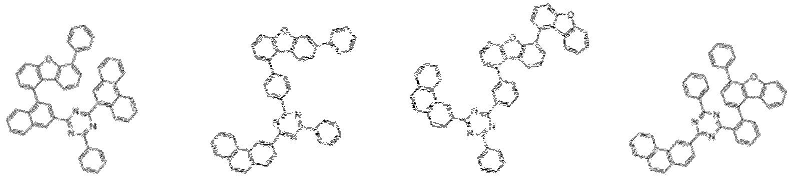

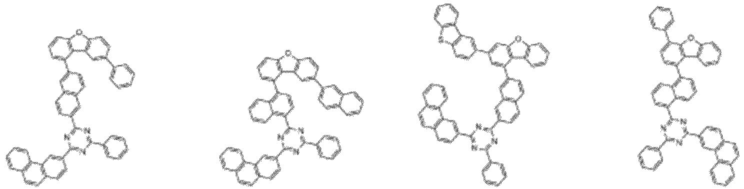

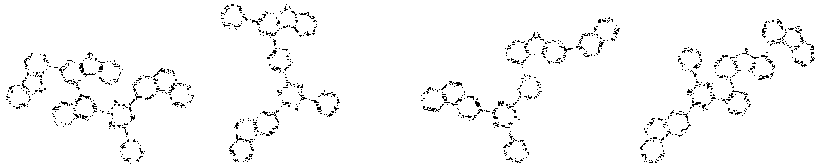

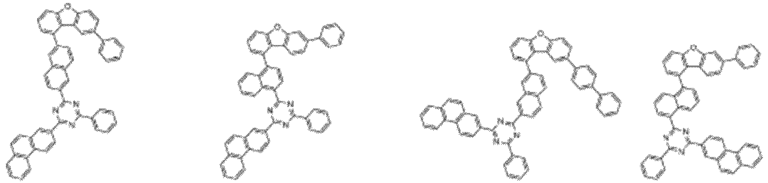

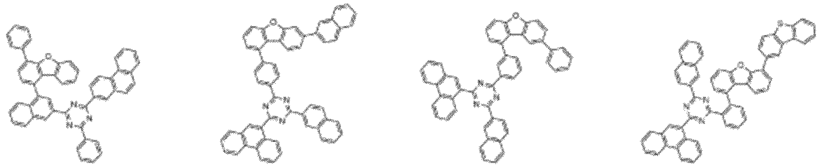

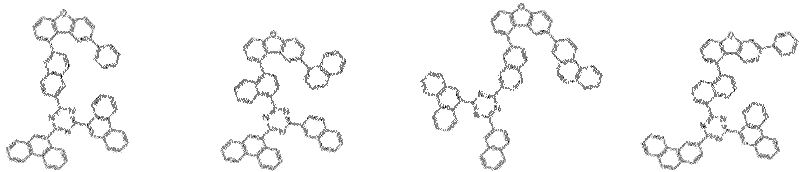

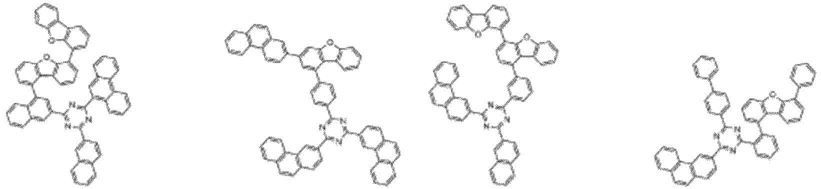

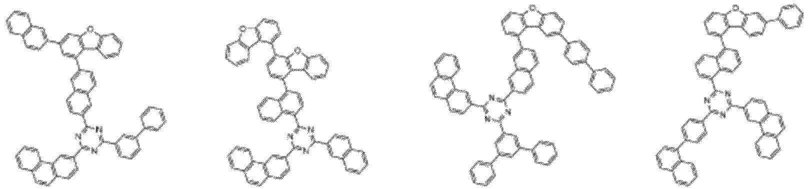

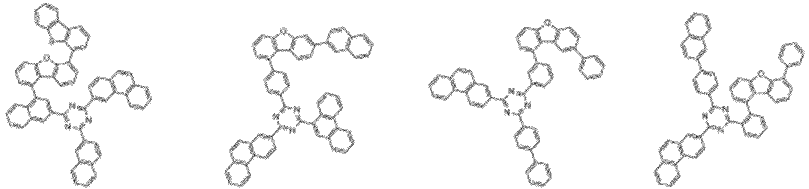

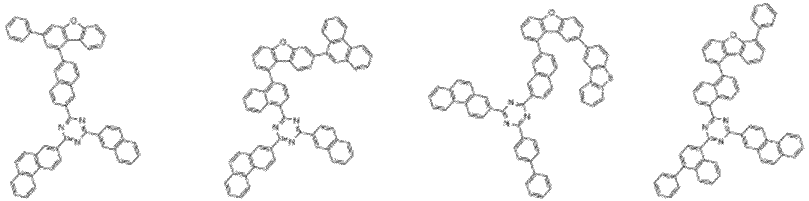

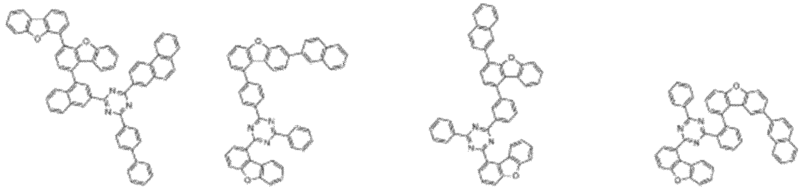

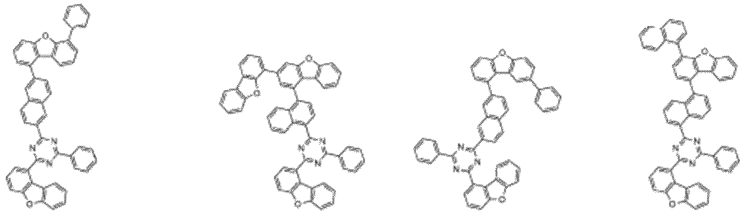

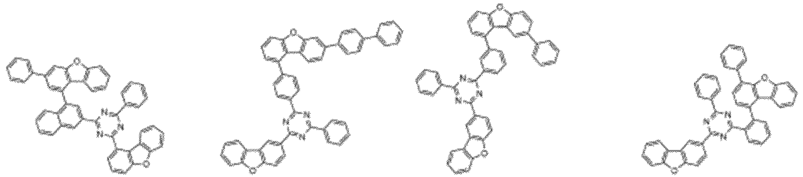

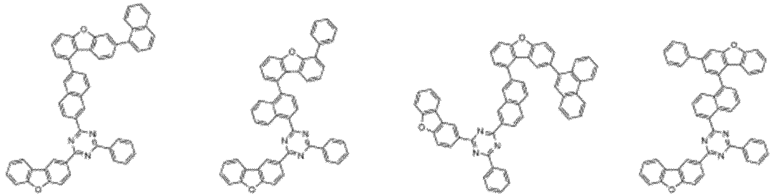

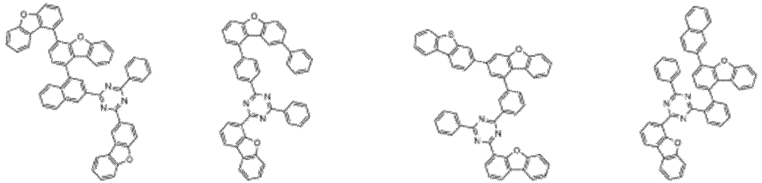

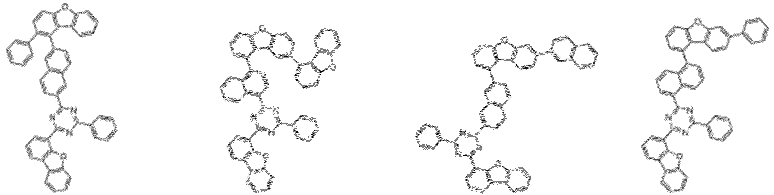

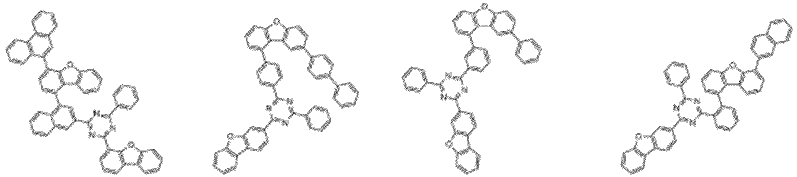

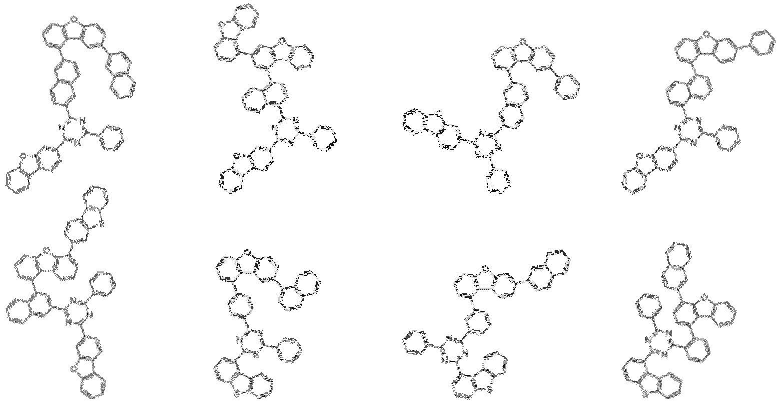

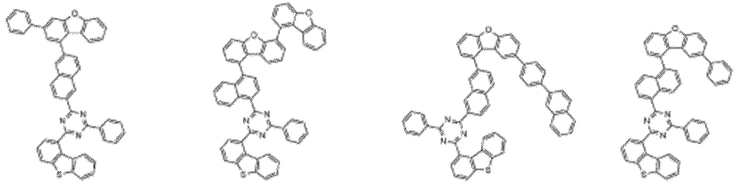

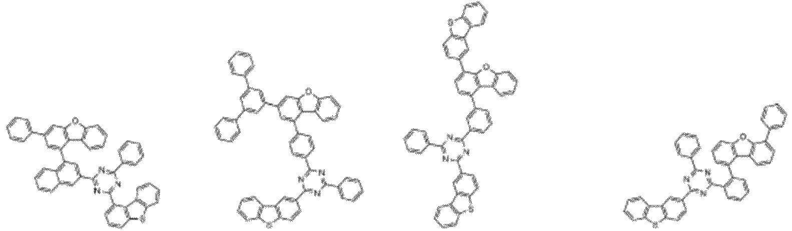

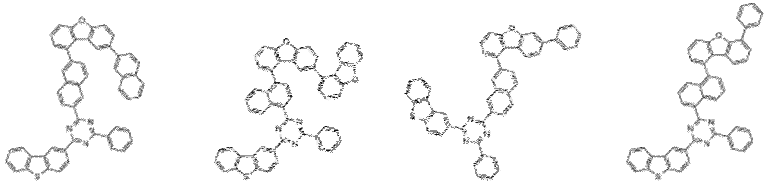

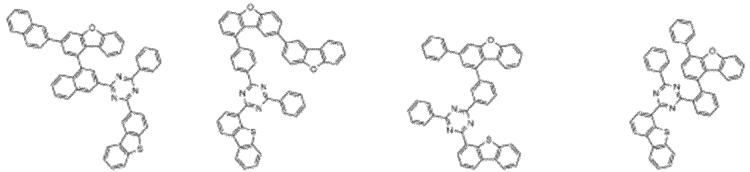

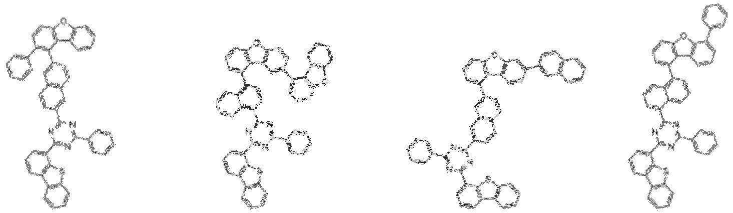

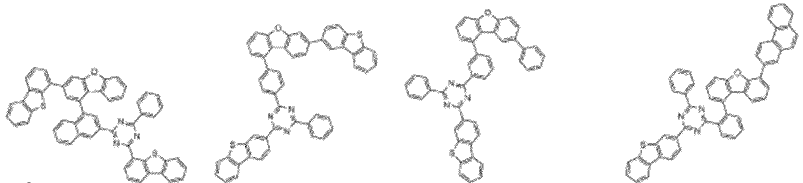

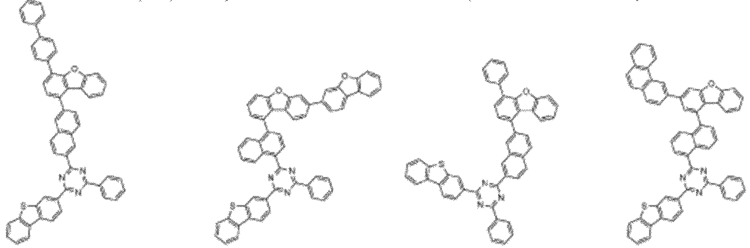

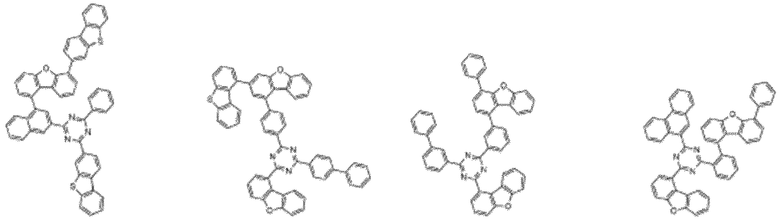

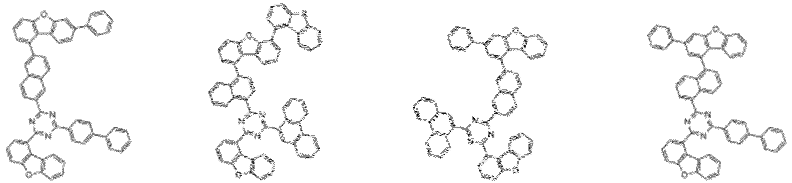

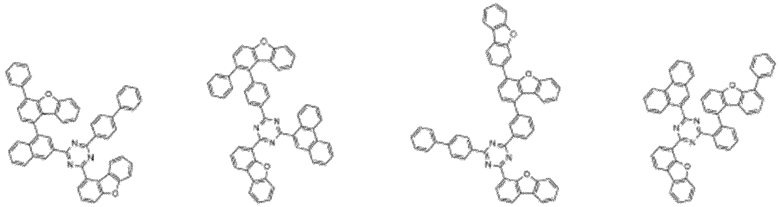

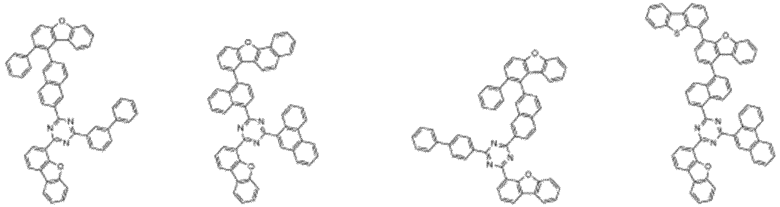

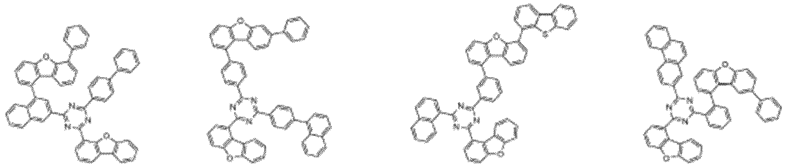

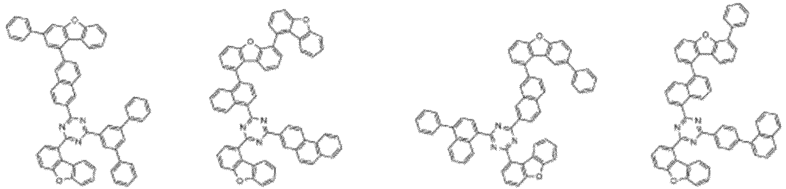

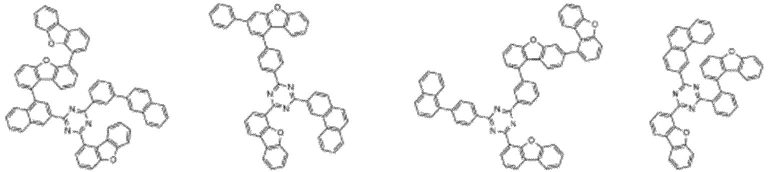

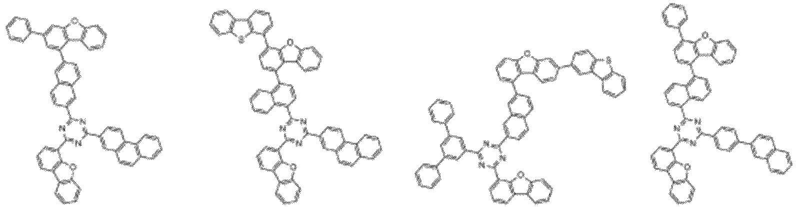

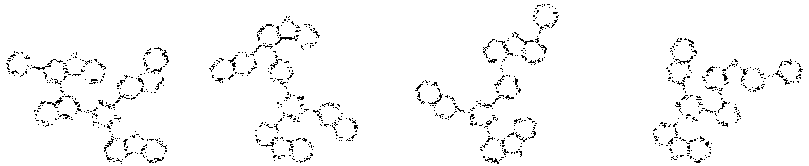

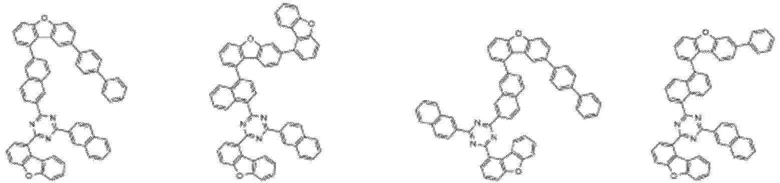

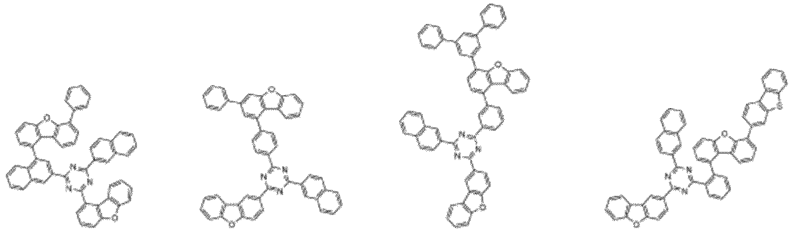

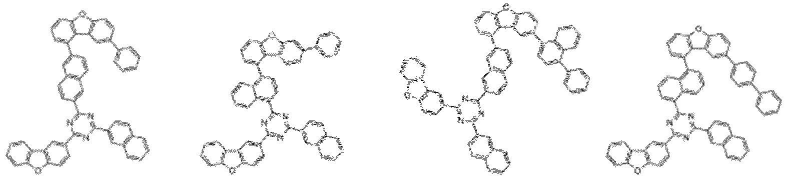

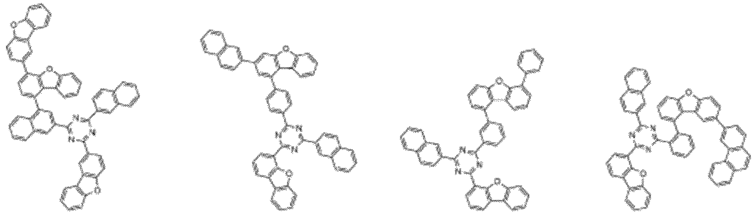

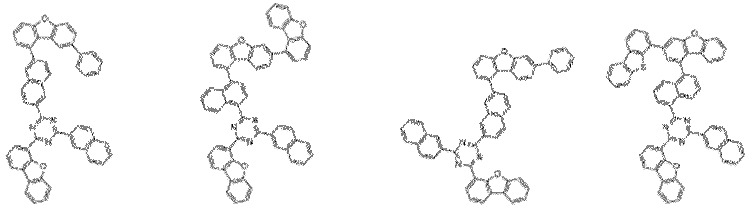

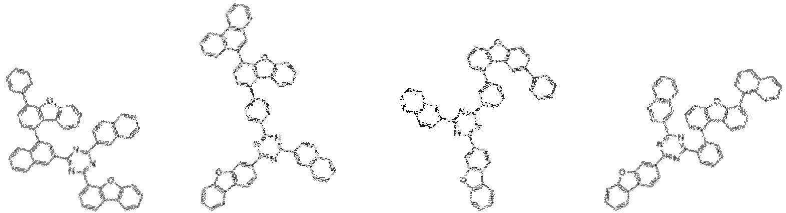

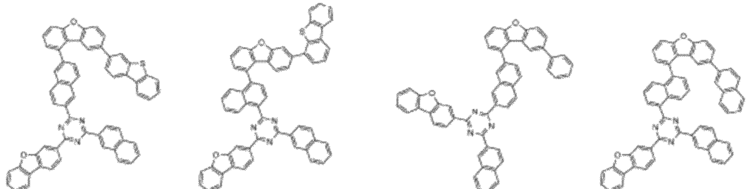

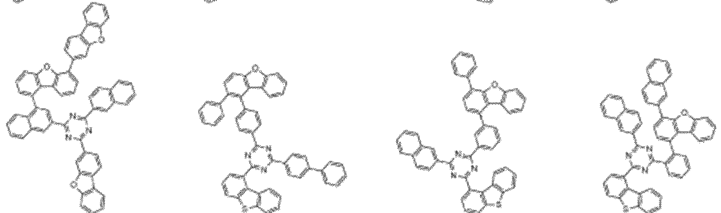

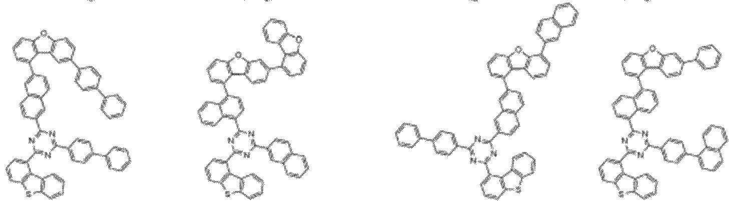

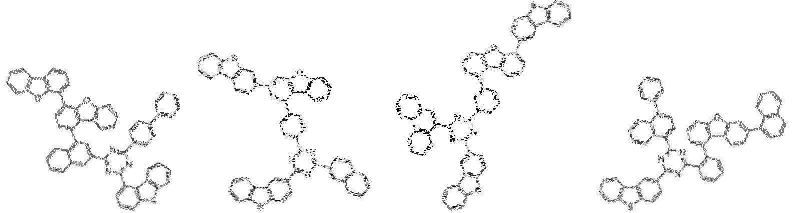

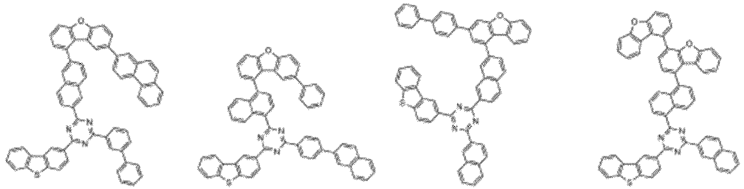

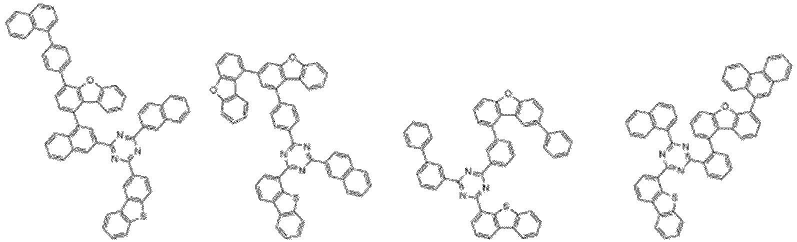

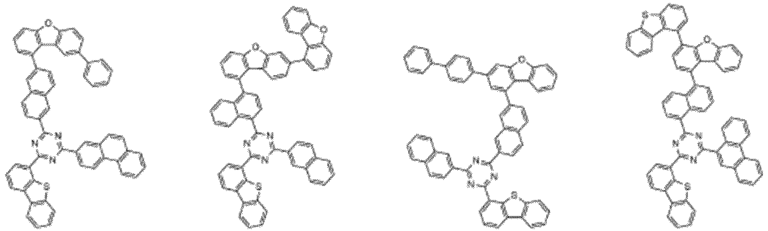

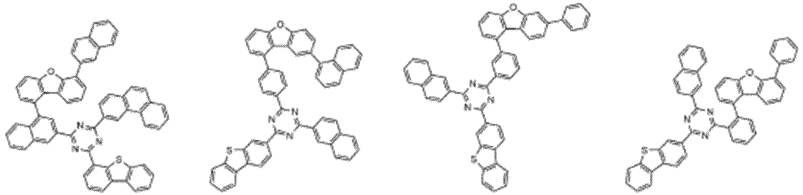

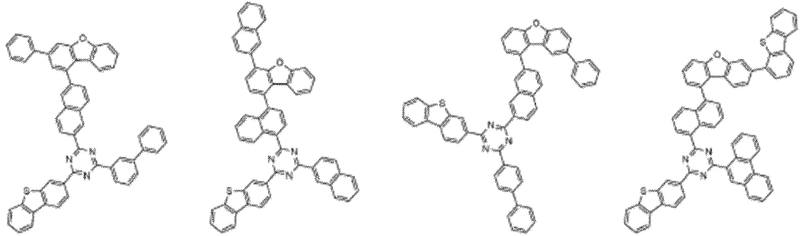

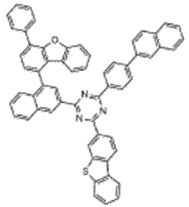

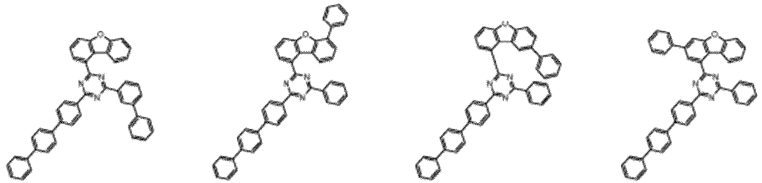

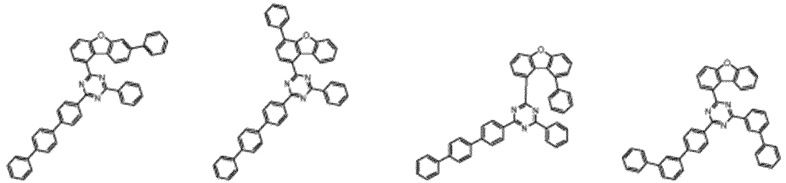

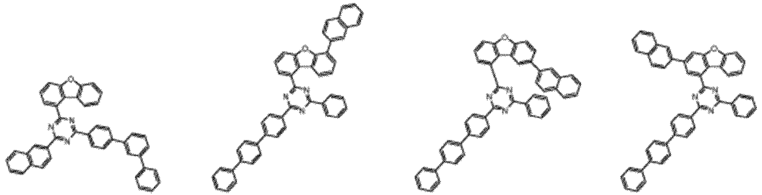

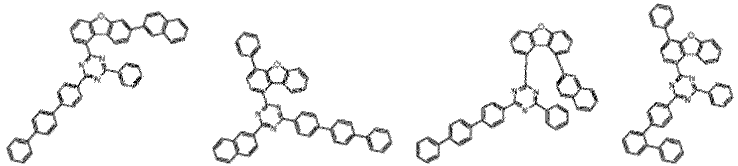

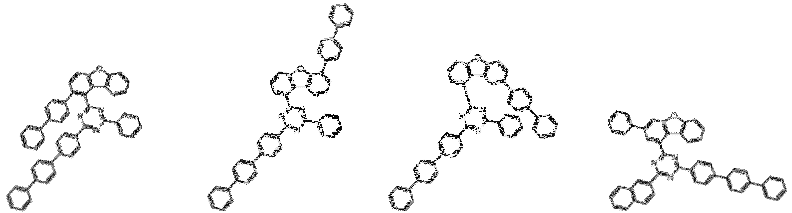

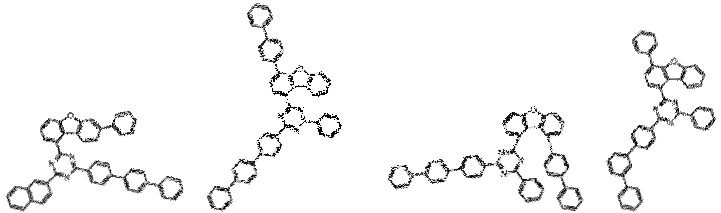

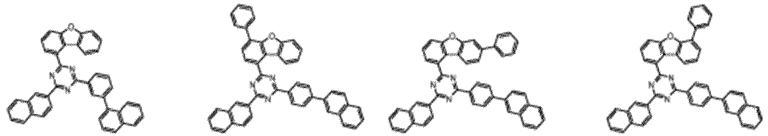

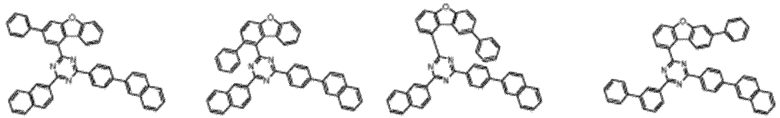

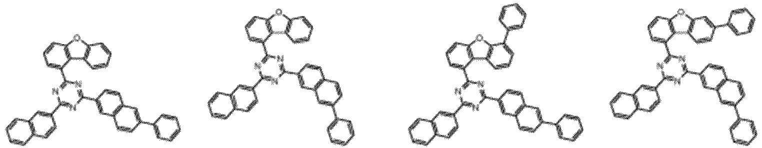

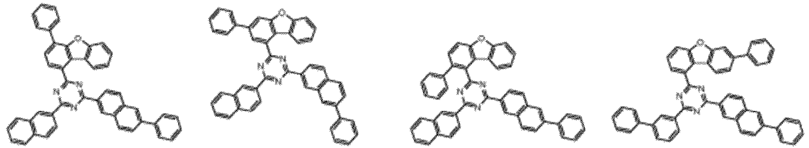

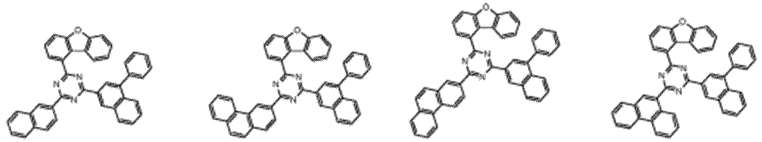

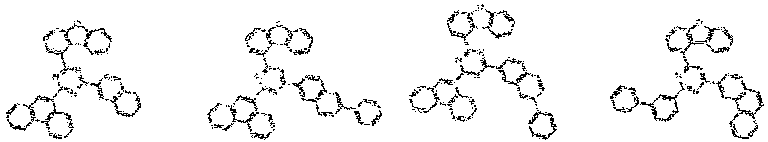

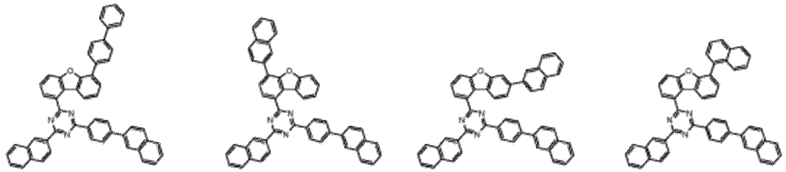

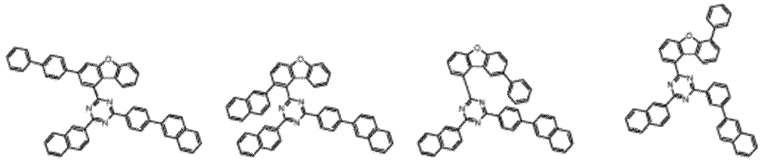

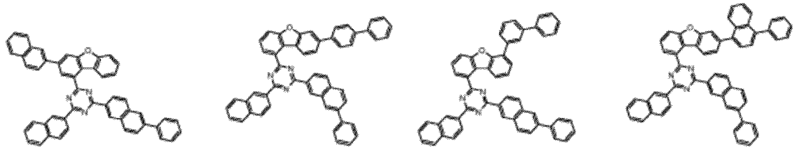

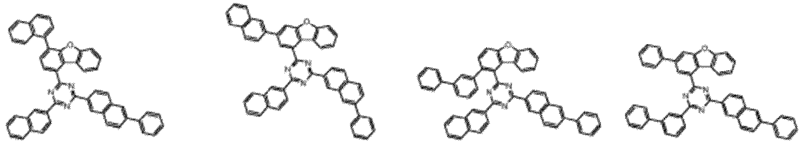

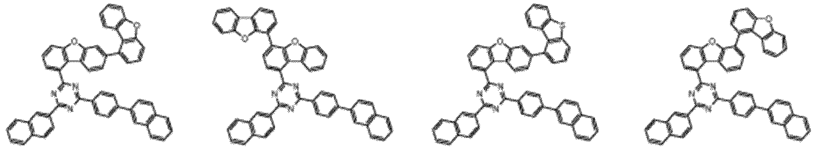

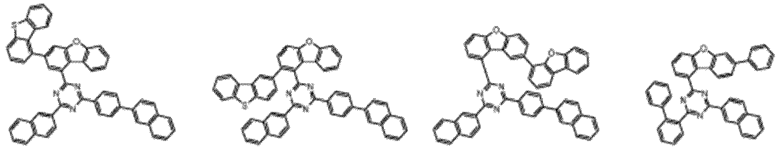

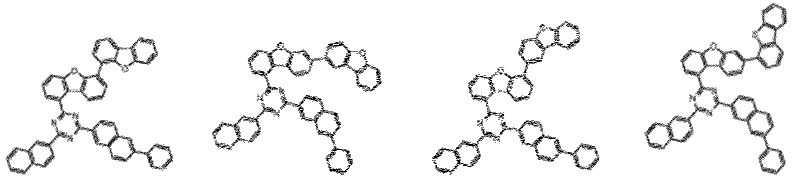

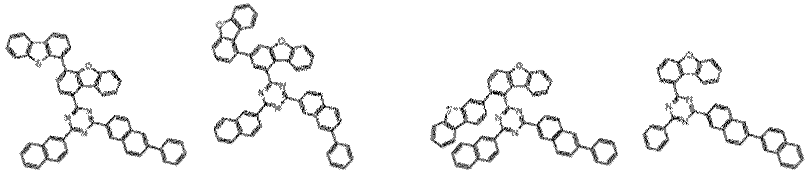

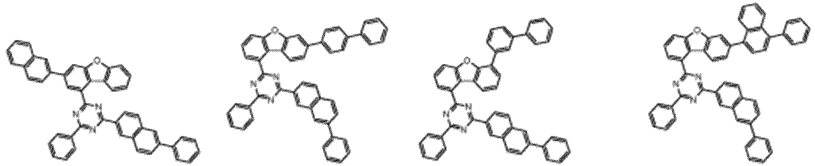

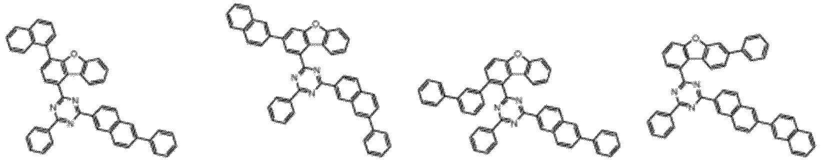

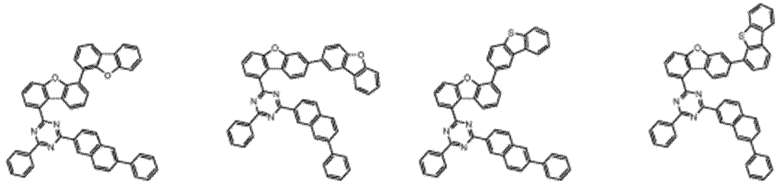

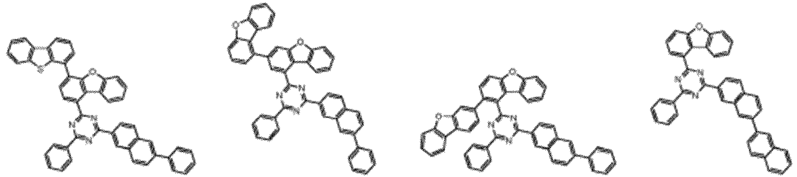

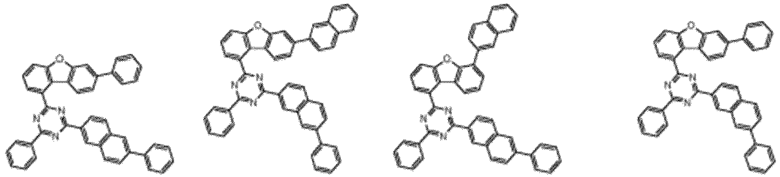

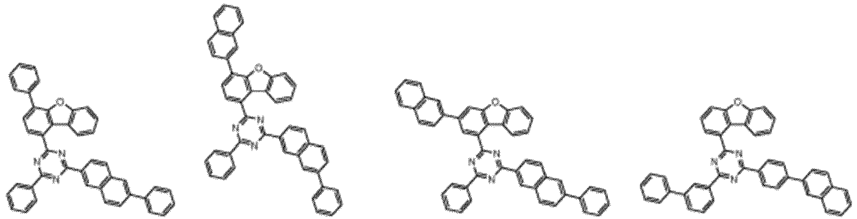

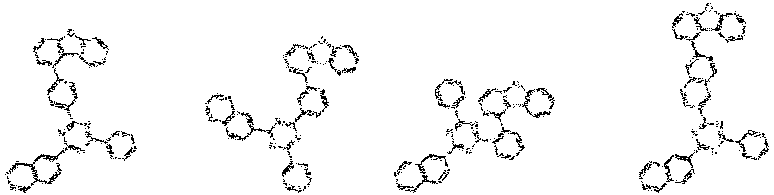

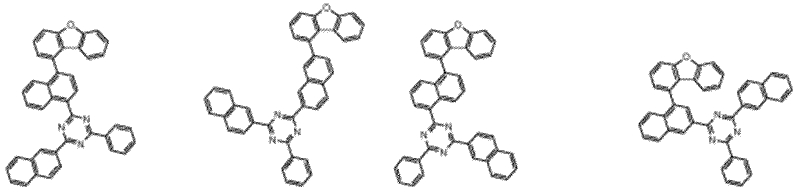

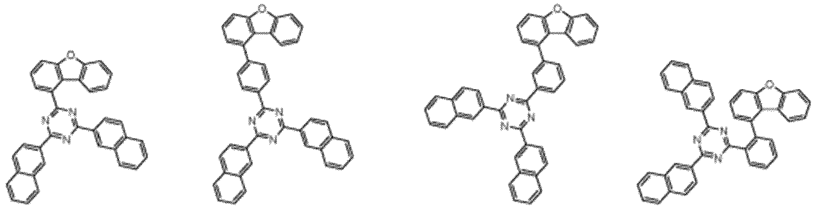

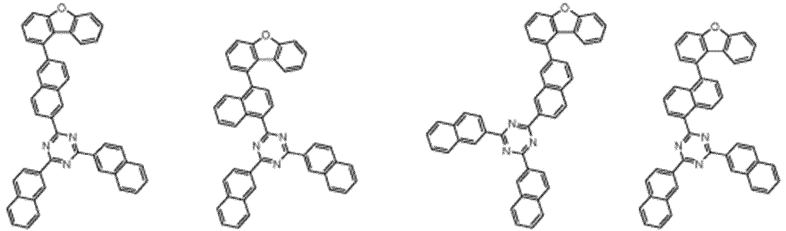

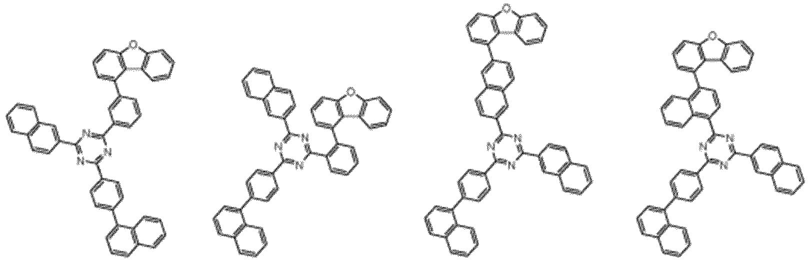

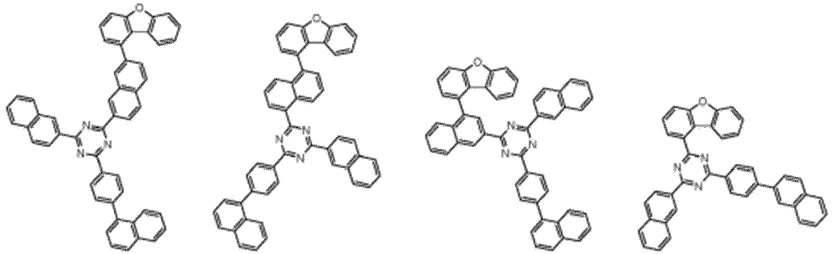

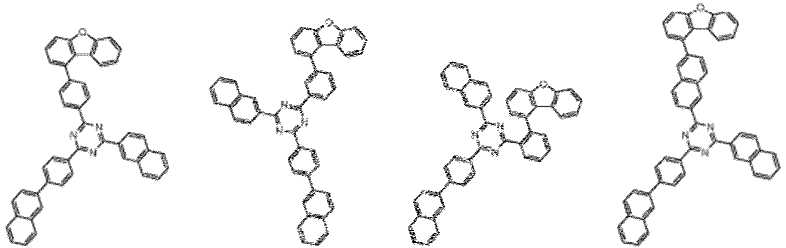

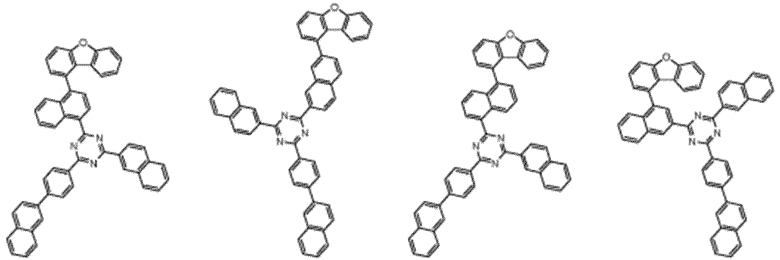

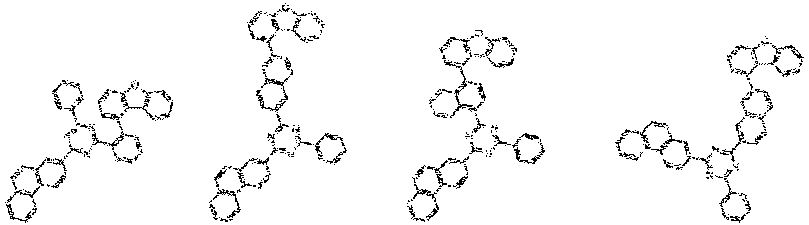

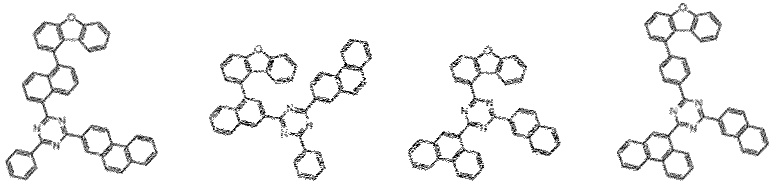

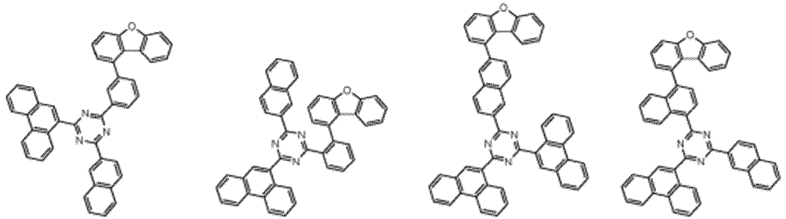

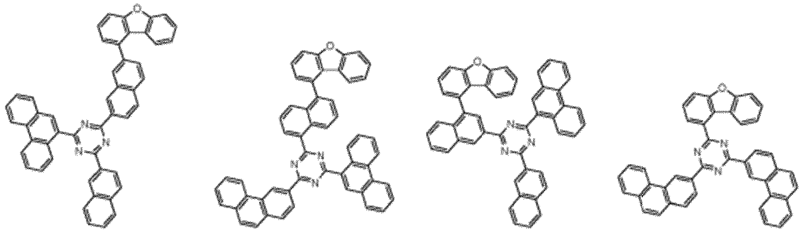

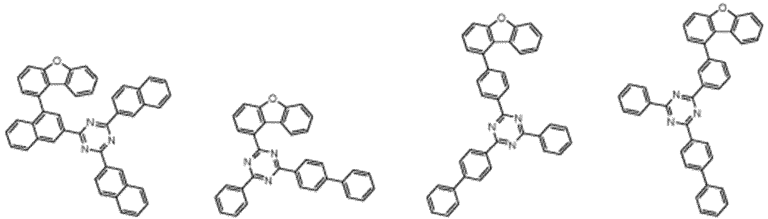

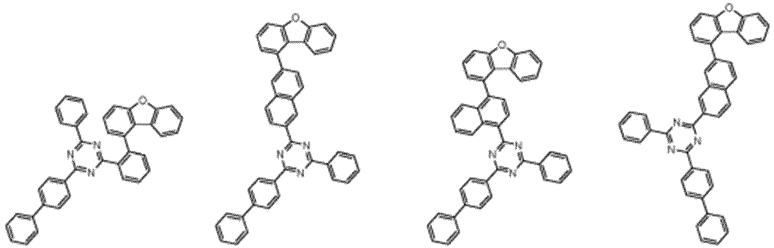

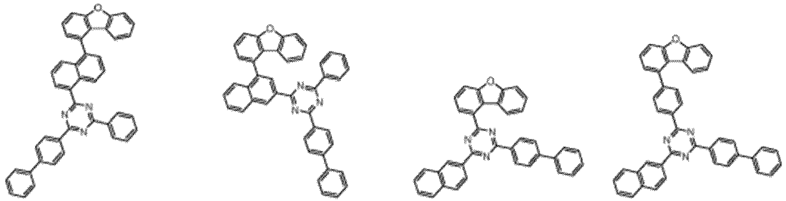

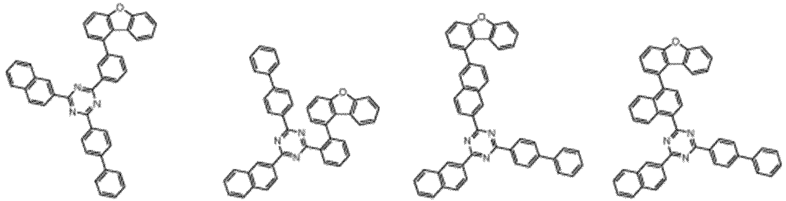

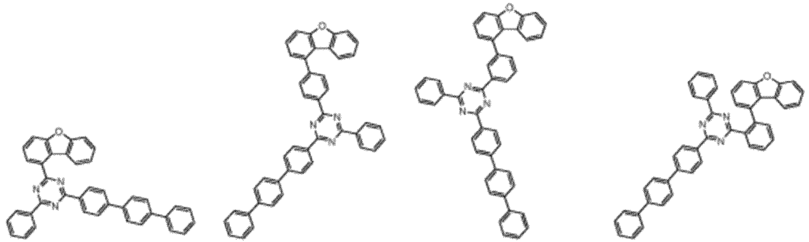

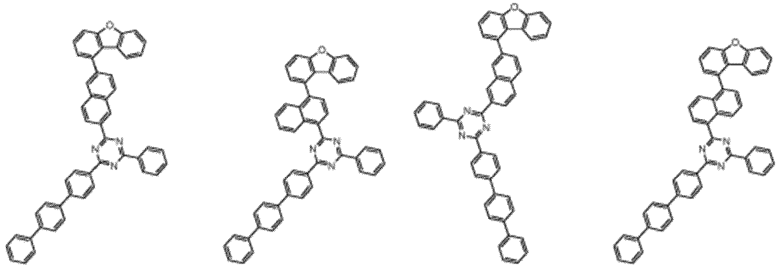

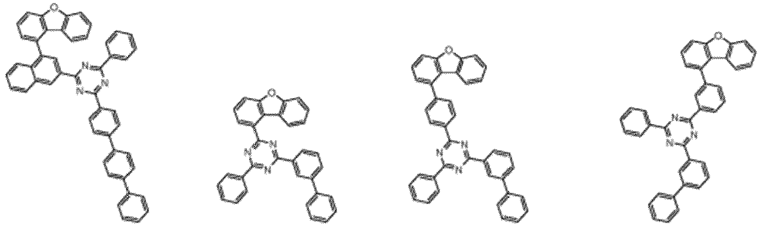

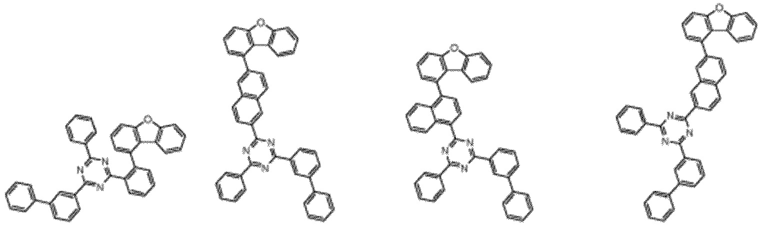

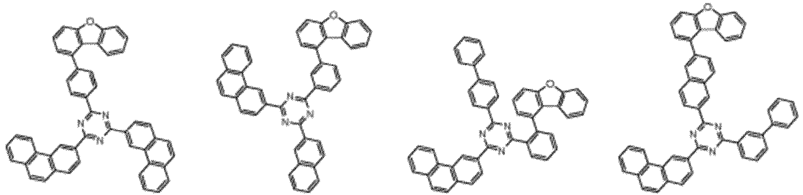

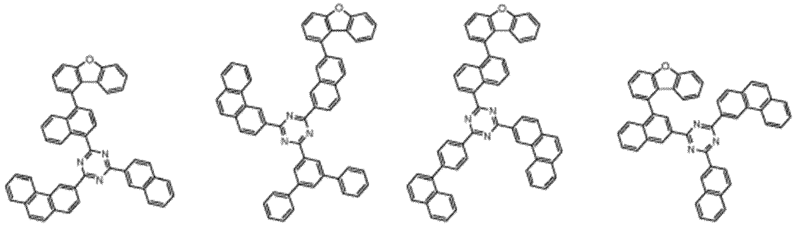

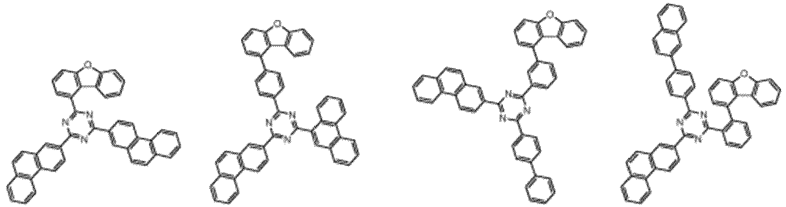

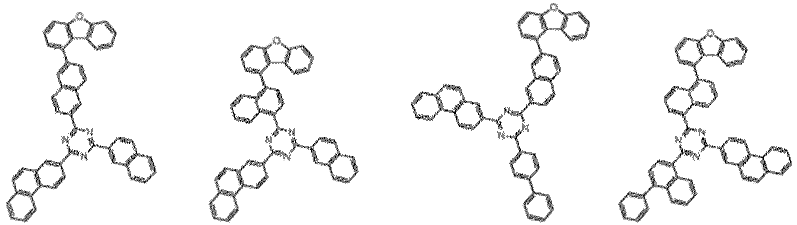

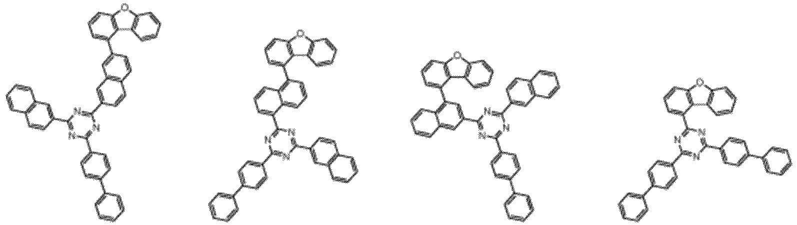

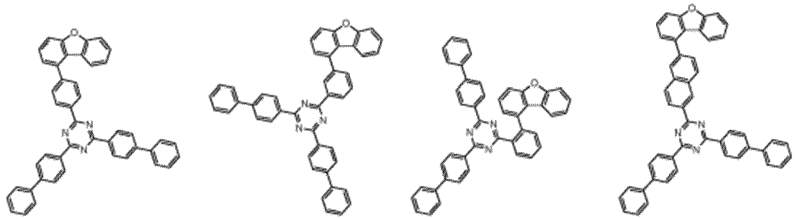

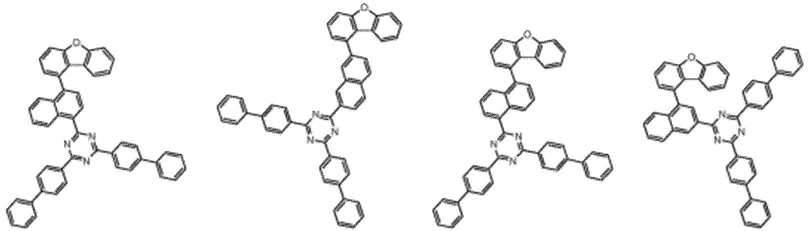

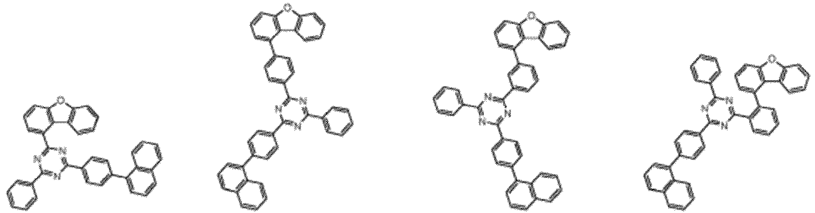

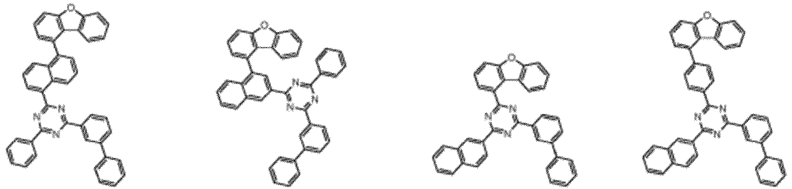

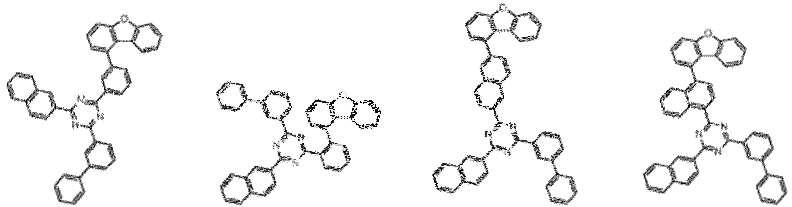

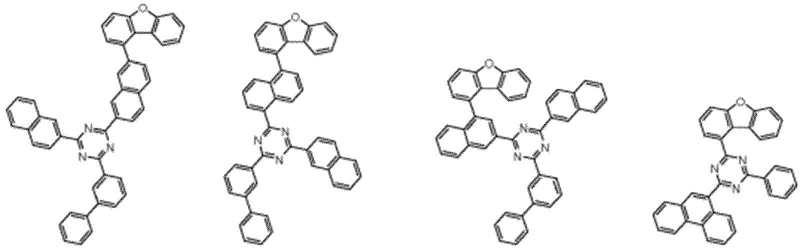

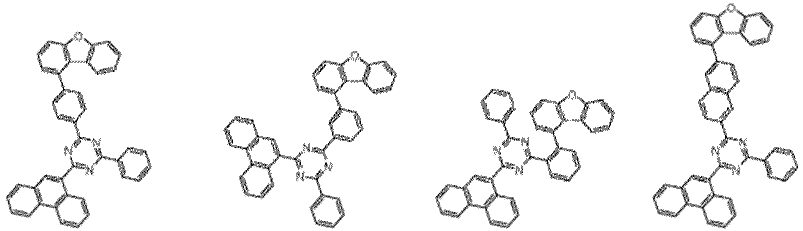

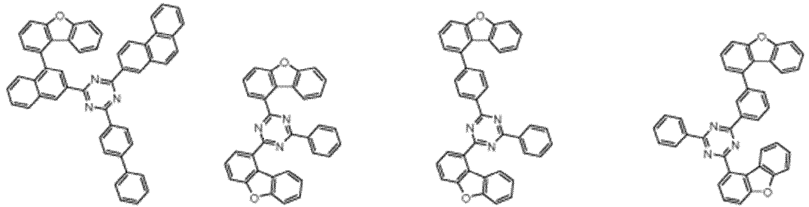

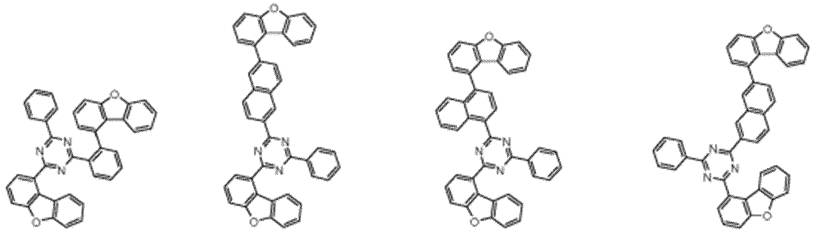

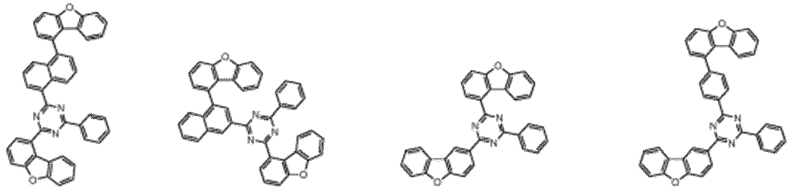

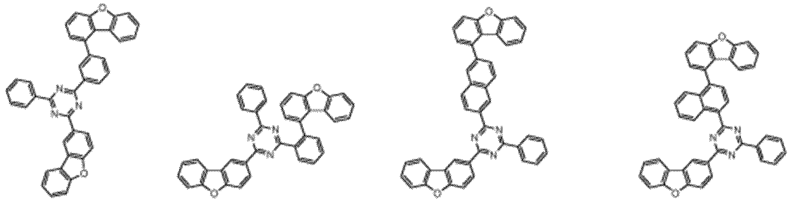

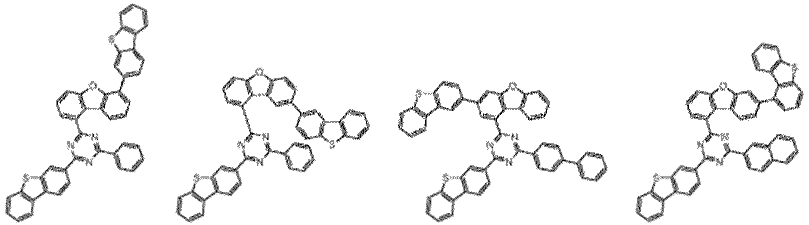

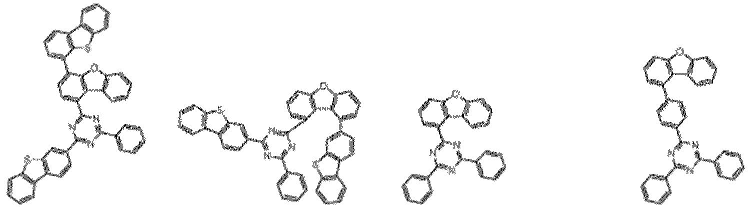

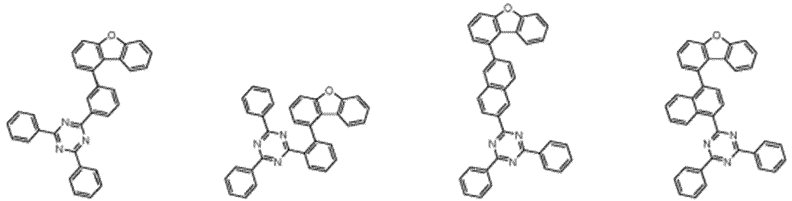

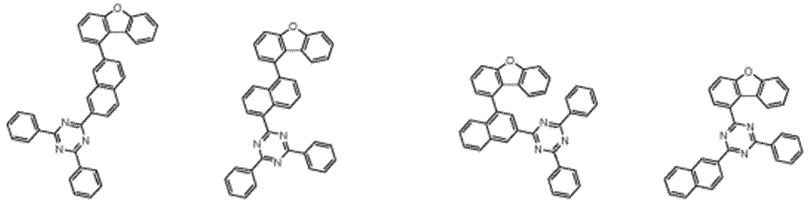

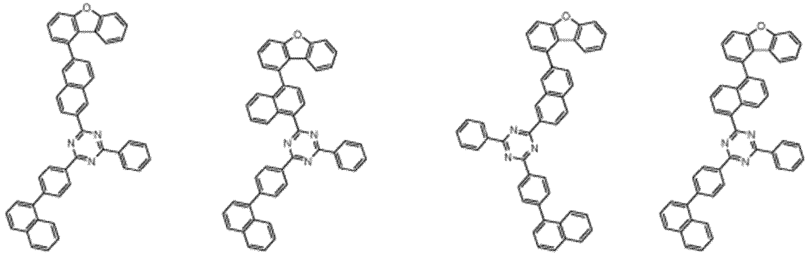

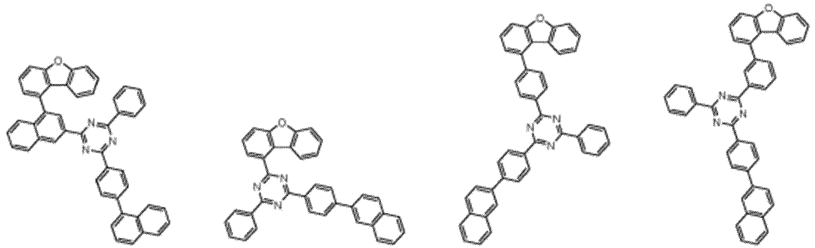

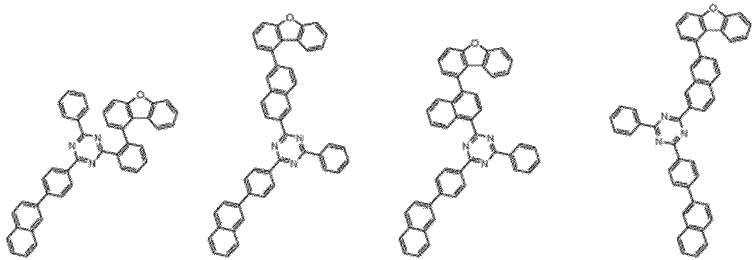

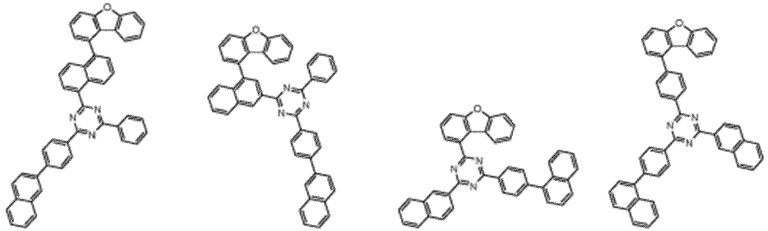

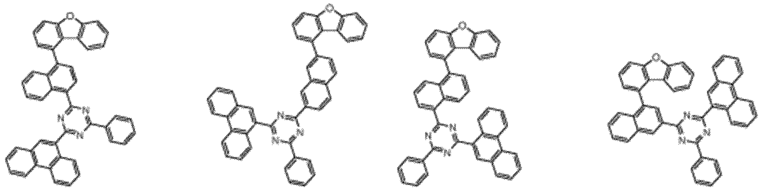

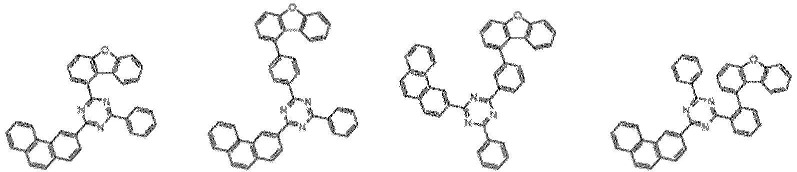

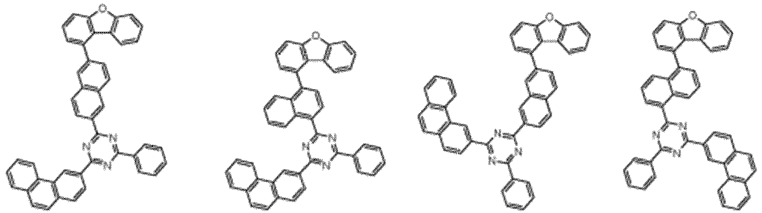

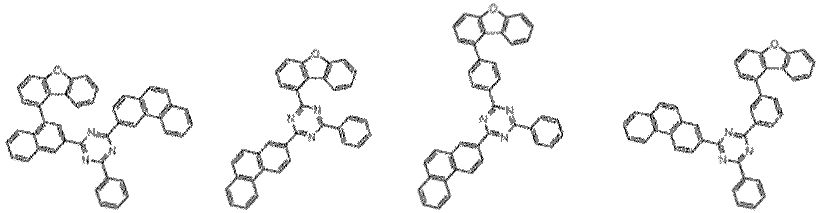

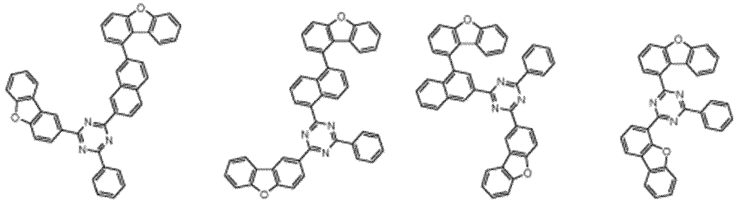

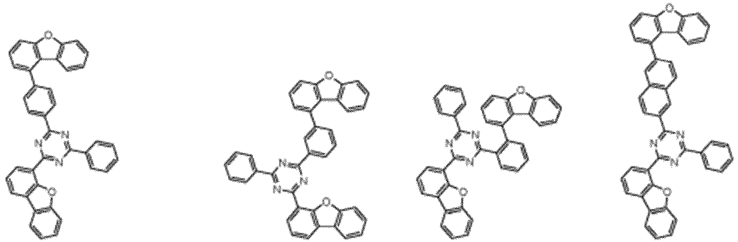

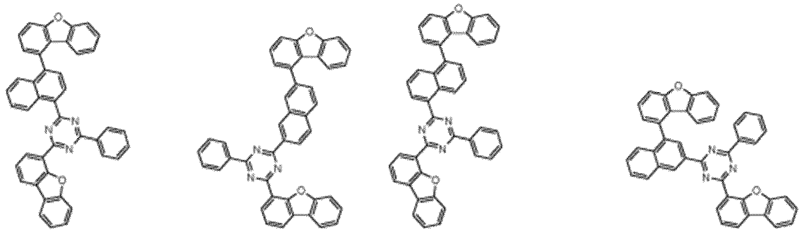

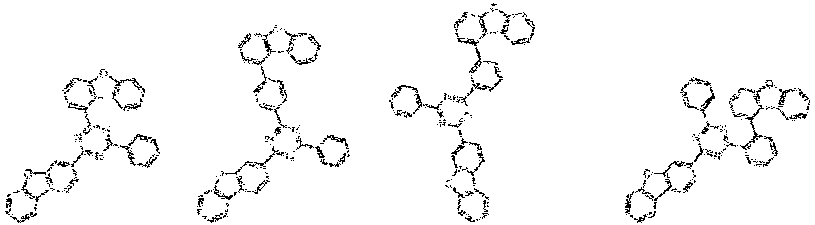

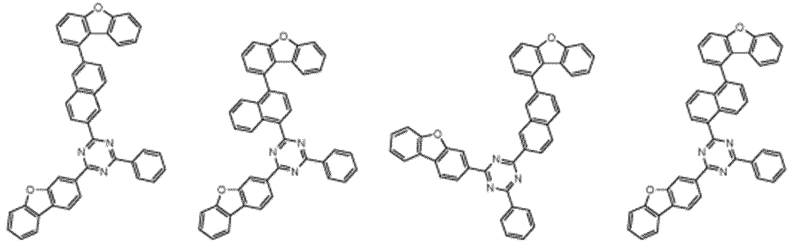

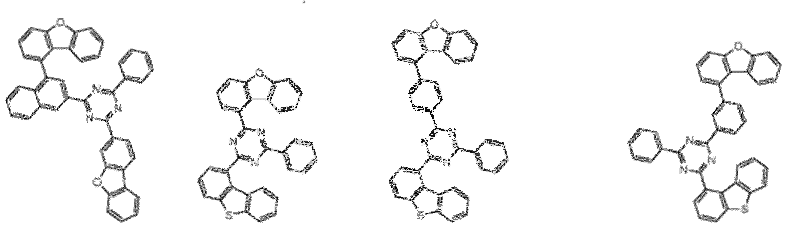

7. Dispositif électroluminescent organique selon la revendication 1, dans lequel :
R' est un substituant représenté par la Formule chimique 4, ou un phényle, un biphényle, ou un naphtyle.

8. Dispositif électroluminescent organique selon la revendication 1, dans lequel :
L' est une liaison simple, un phénylène, un biphényldiyle, un terphényldiyle, un naphtylène, ou un -(phénylène)-(naphtylène)-.

9. Dispositif électroluminescent organique selon la revendication 1, dans lequel :
L'₁ et L'₂ sont chacun indépendamment une liaison simple, un phénylène, ou un biphényldiyle.

10. Dispositif électroluminescent organique selon la revendication 1, dans lequel :
Ar'₁ et Ar'₂ sont chacun indépendamment un phényle, un biphénylyle, un terphénylyle, un naphthyle, un naphthylphényle, un phénylnaphthyle, un phénanthrényle, un diméthylfluorényle, un diphénylfluorényle, un dibenzofuranyle, un dibenzothiophényle, un 9H-carbazol-9-yle, ou un 9-phényl-9H-carbazolyle.

11. Dispositif électroluminescent organique selon la revendication 1, dans lequel :
le composé représenté par la Formule chimique 2 ou la Formule chimique 3 est un composé quelconque sélectionné parmi le groupe consistant en :
